(19)

**Europäisches Patentamt**
**European Patent Office**
**Office européen des brevets**

(11)  **EP 4 683 149 A2**

(12)  **EUROPÄISCHE PATENTANMELDUNG**

(43) Veröffentlichungstag:
21.01.2026  Patentblatt 2026/04

(21) Anmeldenummer: 25220321.1

(22) Anmeldetag: **17.11.2022**

(51) Internationale Patentklassifikation (IPC):
**H02H 3/08** $^{(2006.01)}$

(52) Gemeinsame Patentklassifikation (CPC):
**G01R 31/006; G01R 31/3647; H02H 7/261; H02H 7/263;** B60R 16/03; H02H 1/0061; H02H 1/0092; H02H 3/046; H02H 3/05

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **18.11.2021  DE 102021130107**
**02.05.2022  DE 102022110713**
**04.10.2022  DE 102022125574**
**05.10.2022  DE 102022125617**
**06.10.2022  DE 102022125768**
**27.10.2022  DE 102022128524**
**08.11.2022  DE 102022129487**

(62) Dokumentnummer(n) der früheren Anmeldung(en) nach Art. 76 EPÜ:
**22818386.9 / 4 433 331**

(71) Anmelder: **Elmos Semiconductor SE**
**51379 Leverkusen (DE)**

(72) Erfinder:
• **Sudhaus, André**
**45665 Recklinghausen (DE)**

• **Schmitz, Christian**
**44575 Castrop-Rauxel (DE)**
• **Seiler, Hanno**
**33739 Bielefeld (DE)**
• **Abaza, Fikret**
**47169 Duisburg (DE)**
• **Maurer, Peter**
**42555 Velbert (DE)**
• **Stehr, Frank**
**40822 Mettmann (DE)**

(74) Vertreter: **dompatent**
**Partnerschaft von**
**Patentanwälten und Rechtsanwälten mbB**
**Deichmannhaus am Dom**
**Bahnhofsvorplatz 1**
**50667 Köln (DE)**

Bemerkungen:
Diese Anmeldung ist am 03-12-2025 als Teilanmeldung zu der unter INID-Code 62 erwähnten Anmeldung eingereicht worden.

(54)  **ELEKTRONISCHE SICHERUNG FÜR EIN FAHRZEUG UND IHRE VERWENDUNG IN EINEM FAHRZEUG**

(57)  Beschrieben wird eine elektronische Sicherung für ein Fahrzeug, mit der sich Betriebsparameter beispielsweise des Versorgungsnetzwerks des Fahrzeugs überwachen lassen, um beispielsweise Rekonfigurationen am Versorgungsnetzwerk vorzunehmen oder elektrische Verbraucher des Fahrzeugs abzukoppeln, wenn absehbar ist, dass die elektrische Leistung, die aktuell zur Verfügung gestellt werden kann, nicht ausreichend ist, um beispielsweise sämtliche betriebenen Verbraucher mit Elektrizität zu versorgen oder wenn dies für einzelne der Verbraucher gelten sollte.

Fig. 1

**EP 4 683 149 A2**

**Beschreibung**

Prioritäten

Die vorliegende Anmeldung nimmt die Prioritäten folgender deutscher Patentanmeldungen in Anspruch:

10 2021 130 107.6 vom 18.11.2021
10 2022 110 713.2 vom 02.05.2022
10 2022 125 574.3 vom 04.10.2022
10 2022 125 617.0 vom 05.10.2022
10 2022 125 768.1 vom 06.10.2022
10 2022 128 524.3 vom 27.10.2022
10 2022 129 487.0 vom 08.11.2022.

Ihre Inhalte gehören hiermit durch Bezugnahme zum Gegenstand der vorliegenden Anmeldung.

Einleitung

Das hier vorgelegte Dokument befasst sich mit "intelligenten" elektronischen Sicherungen für Fahrzeuge und die Verwendung solcher Sicherungen in Fahrzeugen für die verschiedensten Anwendungen.

Die Dekarbonisierung des mobilen Straßenverkehrs wird eine effiziente Energieverteilung innerhalb der Fahrzeuge (Power Distribution) notwendig machen.

Heute verwenden die Automobilhersteller in ihren Fahrzeugen zentrale Sicherungskästen (Switch-Boxes oder Sicherungs-Boxen) mit den Sicherungen eines Autos, die sie typischerweise an einer zugänglichen Stelle im Auto platzieren. Von dort zentral ausgehend verteilen aufwendige Kabelbäume die elektrische Energie weiter. Dezentrale Sicherungsboxen mit Versorgungsteilnetzen (Sub-Networks) sollen diese sternförmige Struktur langfristig ablösen.

Dabei steht ein Plattformgedanke im Vordergrund. Die Automobilhersteller können hierdurch die Kabelbäume leichter an individuelle Kundenwünsche anpassen. Ein Plug&Play-Konzept ist dabei wünschenswert. Gedacht ist an eine Plattform mit einem zentralen Versorgungsnetzwerk. Ziel ist ein Baukastensystem für elektrische Versorgungsnetzwerke im Auto. Dies verkleinert die Versorgungsnetzwerke im Auto in der Folge und ermöglicht ein Baukastensystem für die Versorgungsnetzwerke. Die elektronischen Sicherungen sollen entsprechend dem hier in diesem Dokument diskutierten Konzept auf die Platinen übergeordneter Rechnersysteme, der Steuergeräte, gesetzt werden. Diese Platinen sollen ggf. Steckplätze für die Sicherungsgehäuse der elektronischen Sicherungen umfassen.

Bisherige Topologien eines Energieverteilungssystems der Versorgungsnetze wiesen eine Zentralsternform mit einer Switch-Box mit den elektronischen Sicherungen im Sternmittelpunkt des Versorgungsnetzes auf. Außerdem wiesen bisherige Topologien eines Energieverteilungssystems der Versorgungsnetze Energieverbraucher an den Sternstrahlenenden des Versorgungsnetzes auf. Zukünftige Topologien eines Energieverteilungssystems der Versorgungsnetze sollen bevorzugt eine Baumstruktur aufweisen. Bevorzugt sind dabei mehrere elektronisch steuerbare elektronische Sicherungen seriell hinter einander geschaltet. Eine Baumstruktur des Versorgungsnetzwerks verästelt sich von dem zentralen Startpunkt des Versorgungsnetzwerks hin zu den Verbrauchern. Die Zweige (Versorgungszweige) des Baumes des Versorgungsnetzwerks sind die Versorgungsleitungen. Dabei haben die verschiedenen Versorgungszweige bzw. verschiedene Versorgungsteilnetze eine unterschiedliche Wichtigkeit insbesondere im Sinne der funktionalen Sicherheit. Bevorzugt ist jeder oder zumindest eine Mehrzahl der Leitungsabschnitte der Versorgungszweige bzw. Versorgungsteilnetze mit elektronischen Sicherungen versehen. Diese elektronischen Sicherungen führen bevorzugt ein Verfahren zur Absicherung des ihnen jeweils nachgelagerten Versorgungsteilbaumes des Versorgungsnetzwerks bzw. des jeweils nachgelagerten Versorgungsteilnetzes durch. Die Schutzstrategie dieser elektronischen Sicherungen richtet sich nach der Wichtigkeit des nachgelagerten Versorgungsteilbaums bzw. des nachgelagerten Versorgungsteilnetzes und dessen Bedeutung für die Sicherheit des Betriebs des Fahrzeugs hinsichtlich Zustands und Verfügbarkeit. Je nach Bedeutung und Wichtigkeit der angeschlossenen Verbraucher führt jede elektronische Sicherung ein Verfahren aus, dass elektrische Parameter des Stromflusses in dem betreffenden Leitungsabschnitt des betreffenden Versorgungszweiges bzw. des betreffenden Versorgungteilnetzes und ggf. des Potenzials auf der Zuleitungsseite gegen ein Bezugspotenzial erfasst. Ggf. tauscht der Rechnerkern der Steuervorrichtung der elektronischen Sicherung Daten mit anderen den Rechnerkernen der Steuervorrichtungen anderer elektronischer Sicherungen in nachfolgenden und vorausgehenden Zweigen des vorgeschlagenen Versorgungsbaumes bzw. in nachfolgenden und vorausgehenden Versorgungsteilnetzen des Versorgungsnetzwerks aus. Dieser Datenaustausch kann über einen speziellen Sicherungsdatenbus (im Folgenden auch Sicherungsdatenbus genannt) oder einen anderen Datenbus erfolgen. Ein solcher Datenbus kann beispielsweise einen Lin-Datenbus oder einen DSI3- Datenbus oder einen PSI5-Datenbus oder einen CAN-Datenbus oder einen CAN-FD-Datenbus oder einen Ethernet-Datenbus oder einen Flexray-Datenbus oder einen LVDS-Datenbus oder sonst wie drahtgebunden Datenbus umfassen. Wenn das hier vorgelegte Dokument von dem Datenbus 9 redet, so ist von dem Datenbus 9 auch eine drahtlose Datenübertragungsstrecke als Realisierungsmöglichkeit umfasst, die drahtlos, beispielsweise über Bluetooth oder WLAN oder dergleichen kommuniziert. Bisher wurde der Kabelbaum eines Versorgungsnetzwerks eines Fahrzeugs als ein Monolith gefertigt, der als eine Komponente geliefert und in das Fahrzeug montiert wurde. Das hiermit vorgelegte Dokument schlägt nun vor, flexiblere Strukturen zu ermöglichen. Diese Flexibilität kann zum ersten durch Software-Flags und zum zweiten durch das Zustecken weiterer Komponenten und Versorgungsunterbäume und Versorgungsteilnetze erfolgen.

Ein Elektrofahrzeug wird typischerweise einen ersten Versorgungsbaum bzw. ein erstes Versorgungsteilnetz aufweisen, den das Fahrzeug dann bei ca. 48V, also weniger als 50V, betreiben wird.

Ein Elektrofahrzeug wird typischerweise einen zweiten Versorgungsbaum bzw. ein zweites Versorgungsteilnetz aufweisen, den das Fahrzeug dann aber bei ca. 800V, also bei wesentlich mehr als 50V betreibt.

Eine Idee der Nutzung der elektronischen Sicherungen (E-Fuses) ist die Ermöglichung der Hinzubuchung der Stromlieferung an Unterkomponenten und/oder Teilvorrichtungen des Fahrzeugs. Bevorzugt übermittelt dazu der Besteller, der typischerweise ein Nutzer oder Fahrer des Fahrzeugs sein dürfte, einen Befehl an einen Server, beispielsweise an den Server des Automobilherstellers. Bevorzugt authentifiziert sich der Besteller bei dem Server. Beispielsweise kann der Besteller Identifikationsdaten seines Mobiltelefons oder seines Fahrzeugs oder eines anderen personalisieren Geräts bereitstellen, die den rechtssicheren Abschluss eines Vertrages ermöglichen.

Eine typische Steuervorrichtung für den Betrieb einer elektronischen Sicherung umfasst auch die sogenannte System Basis Chip Funktionalität. Diese Funktionalität stellt alle Funktionen bereit, um einen Rechnerkern, beispielsweise einen Mikrocontroller, betreiben zu können. Hierzu können beispielsweise die Spannungsversorgung, die Notenergieversorgung, die Bereitstellung einer Datenbusschnittstelle in Form eines Bus-Transceivers und ein Watch-Dog-Timer (auch kurz als Watchdog bezeichnet) zur Überwachung der korrekten Funktion des Rechnerkerns der Steuervorrichtung der Sicherung gehören. Diese sind vorzugsweise Teil der Steuervorrichtung der Sicherung. Der Watch-Dog-Timer übernimmt dabei al generelle Überwachungsvorrichtung ggf. weiter Überwachungsvorgaben im Sinne des hier vorgelegten Dokuments.

Das Erkennen von nicht verlöschenden Lichtbögen im 48V Netz ist eine wichtige Funktion, die eine solche integrierte Steuervorrichtung für eine elektronische Sicherung erfüllen muss. Der Rechnerkern einer solchen Steuervorrichtung einer Sicherung soll daher

- einzeln und/oder
- im Zusammenwirken mit den Rechnerkernen der anderen Steuervorrichtungen der anderen Sicherungen und/oder
- im Zusammenwirken mit einem oder mehreren übergeordneten Rechnersystemen

einen solchen nicht verlöschenden Lichtbogen selbstständig erkennen. Der Rechnerkern einer solchen Steuervorrichtung einer Sicherung soll daher des Weiteren

- einzeln und/oder
- im Zusammenwirken und/oder i
- m Zusammenwirken mit den Rechnerkernen der anderen Steuervorrichtungen der anderen Sicherungen und/oder
- im Zusammenwirken mit einem oder mehreren übergeordneten Rechnersystemen

durch Gegenmaßnahmen, wie das zeitweise Abschalten von Energiequellen, Verbrauchern und/oder Versorgungsteilnetzen, das erkannte Problem eindämmen und vorzugsweise bekämpfen.

Aus dem Stand der Technik ist hier eine Spektralanalyse des elektrischen Stroms auf dem abzusichernden Leitungsabschnitt, in dem die elektronische Sicherung eingefügt ist, bekannt. Hierzu erfasst die elektronische Sicherung mittels eines Strommessmittels, beispielsweise eines Shunt-Widerstands 24, den zeitlichen Verlauf von typischerweise aufeinanderfolgenden Werte des elektrischen Stroms durch den abzusichernden Leitungsabschnitt und führt eine spektrale Analyse dieses Werteverlaufes durch. Liegen bestimmte Strukturen im so ermittelten Frequenzspektrum vor, so schließt der Rechnerkern der Steuervorrichtung der elektronischen Sicherung auf einen Lichtbogen und schaltet ggf. den Stromfluss mittels des Leistungsschalters der Sicherung ab, der typischerweise ein Sicherungstransistor ist. Statt des Rechnerkerns der Steuervorrichtung der Sicherung kann ggf. auch ein übergeordnetes Rechnersystem, beispielsweise ein Steuergerät des Fahrzeugs, oder ein Rechnerkern einer Steuervorrichtung einer anderen elektronischen Sicherung diese Bewertung durchführen und die ggf. notwendigen Gegenmaßnahmen einleiten, durchführen und/oder koordinieren. Dazu überträgt der Rechnerkern der Steuervorrichtung der elektronischen Sicherung geeignete Daten an diese andere Vorrichtung, also beispielsweise das übergeordnete Steuergerät des Fahrzeugs oder den anderen Rechnerkern der Steuervorrichtung der anderen elektronischen Sicherung. Geeignete Daten können beispielsweise die Rohmesswerte oder weiterverarbeitete Messwerte, insbesondere Spannungs- und/oder Stromwerte, sein.

Für die notwendige zeitliche Auflösung des zeitlichen Stromwerteverlaufs ist zur Anwendung eines solchen spektralen Analyse dann aber typischerweise eine erhöhte Abtastrate von Analog-zu-Digital-Wandlern der Steuervorrichtungen der betreffenden Sicherungen notwendig.

Bevorzugt sind auch verteilte Messverfahren sinnvoll und notwendig. Dabei erfassen vorzugsweise die Steuervorrichtungen mehrerer elektronischer Sicherungen einen oder mehrere Messwerte mittels entsprechender Messvorrichtungen dieser Steuervorrichtungen dieser Sicherungen. Bevorzugt verfügen die elektronischen Sicherungen jeweils über einen jeweiligen Zeitgeber. Die Steuervorrichtung der jeweiligen elektronischen Sicherung ermittelt vorzugsweise mit Hilfe des jeweiligen Zeitgebers einen Zeitstempelwert für vorzugsweise jeden Messwert oder für eine Gruppe von Messwerten, die sie ermitteln. Die Steuervorrichtung der betreffenden Sicherung überträgt diese Messwerte zusammen mit den zugehörigen Zeitstempeln vorzugsweise an eine übergeordnete Rechnereinheit, z.B. ein übergeordnetes Steuergerät, oder an den Rechnerkern einer anderen elektronischen Sicherung. Die übergeordnete Rechnereinheit oder der Rechnerkern der Steuervorrichtung der anderen elektronischen Sicherung vergleichen die Messwerte vorzugsweise ähnlicher Zeitstempel miteinander und können so beispielsweise auf Energieverluste in Leitungsabschnitten zwischen zwei elektronischen Sicherungen schließen. Ein solcher Energieverlust kann ggf. auf den besagten Lichtbogen hindeuten. Vorzugsweise berücksichtigen die Steuervorrichtungen der Sicherungen bzw. das übergeordnete Rechnersystem dabei einen ggf. auftretenden Masseversatz des Bezugspotenzialanschlusses. Entsprechen die Messwerte oder das Verhältnis der Messwerte zueinander oder eine Differenz von solchen Messwerten oder daraus abgeleiteter Größen nicht einem oder mehreren Erwartungswerten, so kann die übergeordnete Rechnereinheit bzw. der Rechnerkern der auswertenden Steuervorrichtung der auswertenden elektronischen Sicherung die Gegenmaßnahmen ergreifen. Diese können den bereits beschriebenen Gegenmaßnahmen entsprechen. Die Datenkommunikation kann dabei wieder über den Sicherungsdatenbus oder einem der oben genannten Datenbusse oder über eine drahtlose Schnittstelle je nach Anforderungen ablaufen.

Das Monitoring der Strom und/oder Spannungsverläufe ermöglicht ein sogenanntes Health-Management für das Fahrzeug. Beispielsweise kann das System des Versorgungsnetzes dann Veränderungen der Stromaufnahme oder der Spektren von Spannungsverlauf, Stromverlauf oder Energietransport erkennen, die ggf. nicht den erwarteten Verläufen oder Werten entsprechen. Ggf. kann das System des Versorgungsnetzwerks hierdurch die Werkstatt oder der Fahrzeughalter oder eine andere Person oder Institution über das Internet etc. oder eine Anzeige über den Zustand oder den Verschleiß oder potenzielle Schäden oder den bevorstehenden Ausfall von elektrischen Verbrauchern informieren. Von besonderem Interesse sind solche Daten für den Fahrzeughersteller. Es ist daher denkbar, dass der Rechnerkern einer Steuervorrichtung einer Sicherung erfasste Messwerte und/oder Betriebsdaten über den Datenbus und über ein übergeordnetes Rechnersystem und das Internet an einen Server des Automobilherstellers sendet. Der Server des Automobilherstellers beispielsweise sammelt diese Daten, verarbeitet die Daten weiter und wertet die Daten bevorzugt aus. Auf diese Weise kann der Automobilhersteller z.B. Daten für vorbeugende Wartungsarbeiten zu und Hinweise auf zukünftige Verbesserungen seiner Fahrzeuge erlangen.

Im Sinne des hier vorgelegten Dokuments sind energieerzeugende Komponenten Verbraucher, bei denen entweder die Stromrichtung oder die Spannungsrichtung gegenüber diesen Richtungen bei einem energievernichtenden Verbraucher umgedreht sind.

Für Autos sind besondere zustände, sogenannte ECO-Modes, bekannt, bei denen ein übergeordnetes Rechnersystem des Fahrzeugs einzelne Verbraucher gezielt abschaltet. Das übergeordnete Rechnersystem schaltet diese einzelnen Verbraucher heute mittels eines Befehls über den Datenbus an den Verbraucher ab. Vorschlagsgemäß kann das übergeordnete Rechnersystem diese Abschaltung einzelner Verbraucher aber auch so durchführen, dass das übergeordnete Rechnersystem die komplette Versorgung eines Versorgungsbaumzwigs oder eines Versorgungsteilnetzwerks durch eine elektronische Sicherung unterbricht, die ihren Leistungsschalter auf Kommando des übergeordneten Rechnersystems hin öffnet. Hierdurch entfallen für dieses Versorgungsteilnetz die sogenannten Stand-By-Ströme der Vielzahl von Verbrauchern, die dieser Versorgungsunterzweig bzw. dieses Versorgungsteilnetzwerk mit elektrischer Energie versorgt.

Sofern eine ein Verbraucher an einer anderen, höher priorisierten Stelle im Versorgungsnetzwerk des Fahrzeugs kurzfristig eine größere Menge an Energie benötigt, kann das übergeordnete Rechnersystem eines übergeordneten Steuergeräts oder der Rechnerkern einer Steuervorrichtung einer elektronischen Sicherung über den Datenbus, an dem die Rechnerkerne der Steuervorrichtungen der betreffenden Sicherungen angeschlossen sind, oder eine funktionsäquivalente andere Datenübertragungsstrecke andere Versorgungsteilbäume des Versorgungsbaums bzw. andere Versorgungsteilnetze des Versorgungsnetzwerks zeitweise abschalten. Ein Versorgungsbaum ist übrigens ein Versorgungsnetzwerk im Sinne des hier vorgelegten Dokuments.

Sofern an anderer, höher priorisierter Stelle im Versorgungsnetzwerk des Fahrzeugs kurzfristig das Versorgungsnetzwerk eine größere Menge an Energie über einen Leitungsabschnitt zu einem oder mehreren ersten Verbrauchern transportieren soll, kann das übergeordnete Rechnersystem eines übergeordneten Steuergeräts oder der Rechnerkern einer Steuervorrichtung einer elektronischen Sicherung über den Datenbus, an dem die Rechnerkerne der Steuervorrichtungen der betreffenden Sicherungen angeschlossen sind, oder eine funktionsäquivalente andere Datenübertragungsstrecke andere Versorgungsteilbäume des Versorgungsbaums bzw. andere Versorgungsteilnetze des Versorgungsnetzes zeitweise abschalten. Dieses Abschalten vergrößert den Anteil der Stromtragfähigkeit des betroffenen Leitungsabschnitts, den die ersten Verbraucher bei der Energieversorgung nutzen, zu Gunsten der ersten Verbraucher. Ist der kurzzeitige Mehrbedarf vorbei, so kann das übergeordnete Rechnersystem des übergeordneten Steuergeräts oder der Rechnerkern der Steuervorrichtung der elektronischen Sicherung über den Datenbus bzw. die besagte Datenverbindung den Ursprungszustand ggf. wiederherstellen. Es handelt sich also um ein zeitweises Wegschalten von Verbrauchern, um z.B. einen Kick-Down zu erreichen.

Aus dem Stand der Technik ist bekannt, dass beispielsweise Relais für die Trennung eines Hochspannungsversorgungsteilnetzes (HV-Netzes) mittels solcher Relais ungeeignet sind. Hier sind Versorgungsteilnetze gemeint, die auf Spannungen oberhalb von 400V über dem Bezugspotenzial liegen. Es können bei solchen Trennungen Abschaltströme von 5kA auftreten. Heute schalten die Relais in Elektroautos nur zwischen Betriebszuständen "Charge-Mode" (Laden) und Drive-Mode (Fahren) um.

Die heute üblichen SiC-Transistoren werden im Stand der Technik typischerweise über Smart-FETs geschaltet. Es handelt sich dabei um FET-Transistoren mit wenig integrierter Logik. Es besteht also ein Bedarf an einer adäquaten Ansteuerung von SiC-Transistoren durch geeignete Steuervorrichtungen der Sicherungen bei der Verwendung solcher SiC Transistoren als Leistungsschalter in Sicherungen.

Motivationsfaktoren

Folgende Motivationsfaktoren sind für den Einsatz einer elektronischen Sicherung (E-Fuse) relevant:

- Gewichtsreduktion des Autos,
- Flexibilität der Architektur,
- Kreatives Power-Management,
- Funktionale Sicherheit,
- Bessere Systemzuverlässigkeit.

Folgende Nachteile ergeben sich bei der Benutzung elektronsicher Sicherungen:

- Die Schmelzsicherung ist immer billiger.

Zur Gewichtsreduktion des Autos

Die Herstellung elektronischen Sicherungen ist mit hoher Präzision möglich. Die Rechnersysteme eines Fahrzeugs können das Schaltverhalten der elektronischen Sicherungen im Gegensatz zu dem Schaltverhalten konventioneller Schmelzsicherungen genau modellieren. Diese genaue Vorhersagbarkeit des Schaltverhaltens ermöglicht die Reduktion der Sicherheitsmargen bei der Auslegung der Leiterquerschnitte der Leitungsabschnitte im Versorgungsbaum und die Reduktion ähnlicher Toleranzen, was den Materialeinsatz für den Kabelbaum im Fahrzeug und damit das Fahrzeuggewicht verringern kann. Ein geringeres Fahrzeuggewicht führt zu einem verringerten Energieverbrauch.

Bevorzugt können Werkstätten und Endnutzer die Versorgungsbäume und Versorgungsnetzwerke im Fahrzeug durch Steckmodule vergrößern.

Dieses voll modulare und nichthierarchische Versorgungsnetzwerkskonzept ist aber noch Zukunftsmusik. In einem ersten Schritt behalten die ersten Versorgungsnetze, die elektronische Sicherungen umfassen den zentralen Sicherungskasten (Junction-Box) im Fahrzeug bei. Es ist daran gedacht, die elektronischen Sicherungen als steckbare Module vorzusehen. Der Verbau der elektronischen Sicherungen als steckbare Module an Stelle der bisherigen Schmelzsicherungen in der Junction-Box ist dabei möglich. Bevorzugt weisen diese steckbaren Sicherungsmodule einen steckbaren Anschluss für einen Datenbusstecker auf, der den Datenbus des Rechnerkerns der Steuervorrichtung der elektronischen Sicherung über eine Datenschnittstelle der Steuervorrichtung der elektronischen Sicherung mit einem Datenbus der Junction-Box oder des Fahrzeugs und damit mit einem übergeordneten Rechnersystem des Fahrzeugs, beispielsweise einem Steuergerät des Fahrzeugs, verbindet.

Es handelt sich somit vorzugsweise um ein evolutionäres Vorgehen, dass die Funktionalität der Junction-Box dadurch weiterentwickelt, dass die Junction-Box in einem ersten Schritt intelligenter wird. Später ist es denkbar, die Junction Box in verschiedene kleiner Junction-Boxes innerhalb des Fahrzeugs aufzuteilen und schließlich im letzten Schritt die Verbraucher und Energiequellen des Fahrzeugs mit individuellen elektronischen Sicherungen auszustatten. Eine elektronische Sicherung im Sinne des hier diskutierten Vorschlags erfüllt somit nicht nur die Sicherungsfunktion an sich, die die Unterbrechung des Stromkreises, in dem die Sicherung eingefügt ist, bei Überschreiten eines durchgeleiteten Stromes über einen längeren Zeitraum durchführt. Eine elektronische Sicherung im Sinn des hier vorgelegten Dokuments stellt darüber hinaus a) auch Messvorrichtungen beispielsweise zur die Erfassung von Strommesswerten des betreffenden Leitungsabschnitts und/oder b) auch Messvorrichtungen zur Erfassung von Spannungsmesswerten des betreffenden Leitungsabschnitts und c) Aktoren zur Veränderung des Zustands des betreffenden Leitungsabschnitts und d) Kommunikationsmöglichkeiten mit anderen elektronischen Sicherungen und d) Kommunikationsmöglichkeiten mit übergeordneten Rechnersystemen und e) Kommunikationsmöglichkeiten mit anderen Vorrichtungsteilen des Fahrzeugs, insbesondere Steuergeräten, und f) zeitbezogene Daten und ggf. weitere vorteilhafte Dienste und Vorrichtungsteile bereit.

Insbesondere für sehr hohe Impulsströme reagiert die Schmelzsicherung nicht adäquat. Die Toleranzen erfordern einen großen Sicherheitsbereich, der eine Vergrößerung des Leitungsquerschnitts und damit mehr Material und Fahrzeuggewicht erfordert.

Die Einfügung elektronischer Sicherungen kann verschiedene Bedürfnisse des Marktes absichern.

Zum Ersten kann die elektronische Sicherung in Abhängigkeit vom elektrischen Strom, der die durch die elektronische Sicherung abgesicherte Leitung durchfließt, das Verhalten einer Schmelzsicherung präzise im Vergleich zur Schmelzsicherung praktisch toleranzfrei simulieren. Hierzu erfasst oder ermittelt die elektronische Sicherung mittels eines Messhilfsmittels innerhalb der elektronischen Sicherung fortlaufend immer wieder den Wert des elektrischen Stroms durch den Leistungsschalter der elektronischen Sicherung in dem betreffenden Versorgungsleitungsabschnitt. Bevorzugt berechnet der Rechnerkern der Steuervorrichtung der elektronischen Sicherung mit Hilfe eines Polynoms nullten, ersten, zweiten oder dritten Grades einen Zwischenwert. Ein Polynom eines Grades größer als eins ist hierbei bevorzugt, um die quadratische Abhängigkeit der in den abgesicherten Leitungsabschnitt eingespeisten elektrischen Energie von dem Stromwert des elektrischen Stromes präziser zu modellieren. Die Variable dieses Polynoms sind typischerweise die durch die Messmittel der elektronischen Sicherung erfassten Stromwerte des elektrischen Stromes. Bevorzugt intergiert der Rechnerkern der Steuervorrichtung der elektronischen Sicherung diesen Zwischenwert über die Zeit zu einem zweiten Zwischenwert. Bevorzugt ist das Polynom ein Polynom zweiten Grades. Dieser zweite Zwischenwert kann dann beispielsweise bei richtiger Parametrierung mit geeigneten Polynomkloeffizienten die thermische Aufheizung des Sicherungsdrahtes einer Schmelzsicherung emulieren. Der Vorteil ist, dass durch eine geeignete Kalibration das Verhalten der elektronischen Sicherung praktisch toleranzfrei ist. Überschreitet der zweite Zwischenwert einen vorgebbaren Schwellwert, so schaltet der Rechnerkern der Steuervorrichtung der elektronischen Sicherung den in die zu schützende Leitung des Versorgungszweigs des Versorgungsbaums geschalteten Leistungsschalter der elektronischen Sicherung in diesem Modell ab. In dieser Variante umfasst als die elektronische Sicherung vorzugsweise eine oder mehrere Vorrichtungen, die eine Schmelzsicherung emulieren. Hierbei ist typischerweise kennzeichnend, dass die elektronische Sicherung einen oder mehrere Vorrichtungsteile umfasst, die die Werte des elektrischen Stromes vorzugsweise quadrieren und integrieren. Dies ist im Sinne der hier vorgelegten Beschreibung der Fall, wenn der Vorrichtungsteil eine Funktion aufweist, die der Verarbeitung der Messwerte des Stromes durch den Leistungsschalter der Sicherung in dem zu schützenden Leitungsabschnitt mittels eines Polynoms eines zumindest zweiten Grades und einer anschließenden Integration entspricht oder funktionsäquivalent ist. D.h. eine analoge und/oder digitale Schaltung und/oder einen Analog- oder Hybridrechner können diese Funktion ausdrücklich wahrnehmen. Diese analoge und/oder digitale Schaltung und/oder der Analog- oder Hybridrechner können Teil der Steuervorrichtung der elektronischen Sicherung sein. Bevorzugt weist die elektronische Sicherung dabei einen oder mehrere Vorrichtungsteile auf, die eine Überwachung wesentlicher Parameter durchführen. Bevorzugt sind diese Teile einer Steuervorrichtung der Sicherung. Hierbei ist typischerweise kennzeichnend, dass die elektronische Sicherung einen oder mehrere Vorrichtungsteile umfasst, die die Werte des elektrischen Stromes und/oder der Spannung des Potenzials des abzusichernden Leitungsabschnitts gegen ein Bezugspotenzial nur mittels eine Polynoms ersten Grades, also linear verarbeiten. Dies ist im Sinne der hier vorgelegten Beschreibung der Fall, wenn der Vorrichtungsteil eine Funktion aufweist, die der Verarbeitung der Messwerte des Stromes und/oder der Spannung in dem zu schützenden Leitungsabschnitt mittels eines Polynoms eines Grades kleiner als dem zweiten Grad entspricht oder funktionsäquivalent ist. D.h. eine analoge und/oder digitale Schaltung und/oder ein Analog- oder Hybridrechner können diese Funktion ausdrücklich wahrnehmen, wobei dieses Teil der Steuervorrichtung der elektronischen Sicherung sein können. Bevorzugt umfassen diese Teile zeitliche Filter, die diese Signale zeitlich Filtern und/oder zeitlich integrieren. Typischerweise kann von einer besonders günstigen Filterzeit von 500ns als Filterzeitkonstante eines Tiefpassfilters (Filtering Time) ausgegangen werden.

Neben der Emulation einer Schmelzsicherung führt die vorgeschlagene elektronische Sicherung bevorzugt auch eine schnelle Abschaltung des Leistungsschalters der elektronischen Sicherung durch, wenn der Wert des Stroms, den das Messmittel der Steuervorrichtung der elektronischen Sicherung erfasst, einen erlaubten Maximalwert übersteigt oder zur Nutzungssituation nicht plausibel ist. Die Plausibilitäts- überwachung führen bevorzugt ein Rechnerkern der Steuervorrichtung der Sicherung und/oder ein übergeordnetes Rechnersystem außerhalb der elektronischen Sicherung durch. Bevorzugt kann ein übergeordnetes Rechnersystem eines übergeordneten Steuergeräts oder der Rechnerkern einer anderen elektronischen Sicherung diesen Maximalwert je nach der Nutzungssituation und/oder der benötigten Energieverteilung innerhalb des Fahrzeugs mittels eines Steuerbefehls über eine drahtlose und/oder drahtgebundene Datenübertragungsstrecke an die elektronische Sicherung ändern. Das hier vorgelegte Dokument bezeichnet diese drahtlose und/oder drahtgebundene Datenübertragungsstrecke im Folgenden nur zusammenfassend als Datenbus.

Wichtig ist dabei, dass die Steuervorrichtung der elektronischen Sicherung, also typischerweise der Rechnerkern der Steuervorrichtung oder ein funktionsäquivalenter Vorrichtungteil der elektronischen Sicherung den Leistungsschalter der Sicherung ausgeschaltet oder einschaltet und nicht den elektrischen Strom durch den Leistungsschalter durch Änderung des Innenwiderstands des Leistungsschalters begrenzt, da dies zu einer hohen Verlustleistung im Leistungsschalter führen würde. Bevorzugt soll ein Ausschalten des Leistungsschalters in solchen Abschaltsituationen des Versorgungsnetzwerks, dessen Teil die elektronische Sicherung ist, in wenigen ns erfolgen.

Die Automobilhersteller beachten derzeit dieses schnelle Abschalten weniger und gehen derzeit typischerweise noch von einem Abschalten innerhalb eines Zeitraums von mehreren ms aus.

Die Automobilhersteller und die relevanten automobilen Zulieferer haben es im Fahrzeug typischerweise mit dynamischen Lasten zu tun. Diese haben daher das Bedürfnis, dass sich die elektronische Sicherung wie eine Schmelzsicherung verhalten soll, um unvorhergesehene Kreuzeffekte zu vermeiden, wenn in neuen, moderneren Konstruktionen elektronische Sicherungen Schmelzsicherungen ersetzen. Daher soll die Sicherung in einem gewissen Rahmen auch Überschreitung der Stromwerte bis zu einem maximalen Stromwert des elektrischen Stromes in der zu schützenden elektrischen Leitung zulassen. D.h. die Abschaltkurve der elektronischen Sicherung sollte im wesentlichen Nutzungsbereich im Wesentlichen parabelförmig sein.

Ein wichtiger Vorschlag innerhalb des hier vorgelegten Dokuments ist daher eine elektronische Sicherung mit einer Schnellabschaltung des Leistungsschalters der Sicherung in einer Zeit weniger als 200ms, besser, weniger als 100ms, besser weniger als 50ms, besser weniger als 20ms, besser weniger als 10ms, besser weniger als 5ms, besser weniger als 2ms, besser weniger als 1ms, besser weniger als $500\mu s$, besser weniger als $200\mu s$, besser weniger als $100\mu s$ , besser weniger als $50\mu s$, besser weniger als $20\mu ms$, besser weniger als $10\mu s$ , besser weniger als $5\mu s$, besser weniger als $2\mu s$, besser weniger als $1\mu s$, besser weniger als 500ns, besser weniger als 200ns, besser weniger als 100ns, besser weniger als 50ns, besser weniger als 20ns, besser weniger als 10ns, besser weniger als 5ns, besser weniger als 2ns, besser weniger als 1ns. Dabei ist der Leistungsschalter in die abzusichernde elektrische Leitung innerhalb der elektronischen Sicherung als Trennelement eingefügt. Dieses Ausschalten führt der Rechnerkern der Steuervorrichtung der elektronischen Sicherung bevorzugt bei Überschreitung eines maximal zulässigen Stromes über einen maximalen Stromwert hinaus und/oder bei Unterschreitung einer Spannung der Leitung gegen ein Bezugspotenzial unter einen Mindestspannungswert mittels entsprechender Teilvorrichtungen der Steuervorrichtung der elektronischen Sicherung durch. Das Besondere des hier beschriebenen Vorschlags ist, dass und gleichzeitig ansonsten ein Ausschalten nach einer zulässigen Zeit aufgrund der Emulation einer Schmelzsicherungs-Charakteristik erfolgt, wie oben beschrieben.

Die der Rechnerkern der Steuervorrichtung der elektronischen Sicherung könnte die Strom-Messung mittels eines Shunt-Widerstands in der Leitung und eines Analog-zu-Digital-Wandlers der Steuervorrichtung der Sicherung durchführen. Dies ist jedoch mit vielen Nachteilen verbunden.

Bevorzugt erfasst der Rechnerkern der Steuervorrichtung der elektronischen Sicherung mittels des Analog-zu-Digital-Wandlers der Steuervorrichtung der Sicherung Spannungen zwischen den Anschlüssen des Leistungsschalters und/oder Spannungen zwischen den Anschlüssen eines Hilfsleistungsschalters, der dem Leistungsschalter parallelgeschaltet ist und mit einem Shunt-Widerstand in Serie geschaltet ist, oder funktionsäquivalenter Werte physikalischer Parameter und ermittelt daraus einen Wert für einen elektrischen Strom durch den Leistungsschalter der Sicherung, der in die elektrische Leitung, die zu schützen ist, eingeschaltet ist.

Bei einer Messung des Stroms durch den Leistungsschalter der Sicherung kann der Rechnerkern der Steuervorrichtung der elektronischen Sicherung mittels einer ersten Teststromquelle einen zusätzlichen Teststrom in den Leistungsschalter der elektronischen Sicherung einspeisen. Bevorzugt ist der zeitliche Verlauf des Stromwerts dieses zusätzlichen Teststroms mit einem Modulationssignal moduliert. Bevorzugt hat das Modulationssignal eine bekannte Amplitude und eine bekannte Frequenz und Phase. Damit hat bevorzugt der modulierte zusätzliche Strom eine maximale Amplitude. Die Steuervorrichtung der elektronischen Sicherung erfasst den zeitlichen Verlauf des elektrischen Stroms durch den Leistungsschalter und überprüft, ob das Signal des zeitlichen Verlaufs der Messwerte dieses elektrischen Stromes Signalanteile umfasst, deren Modulation mit der Modulation des Modulationssignals korreliert. Hierzu kann beispielsweise ein Synchrondemodulator die Korrelation zwischen dem zeitlichen Verlauf der Messwerte dieses elektrischen Stromes einerseits und dem zeitlichen Verlauf des Modulationssignals durchführen. Dies kann beispielsweise so aussehen, dass der Synchrondemodulator das Modulationssignal oder ein daraus abgeleitetes Signal oder ein Signal, das mit dem Modulationssignal in einem festen zeitlichen Zusammenhang steht, mit dem Signal des zeitlichen Verlaufs der Messwerte dieses elektrischen Stromes oder einem daraus abgeleiteten Signal andererseits multipliziert und das aus der Multiplikation resultierende Signal anschließend filtert, vorzugsweise tiefpassfiltert. Statt eines Synchrondemodulators kann die Steuervorrichtung auch ein auf das Modulationssignal optimiertes Matched-Filter und/oder ein Optimalfilter und/oder ein Kalman-Filter oder ein anderes Schätzfilter umfassen.

Folgende Bedürfnisse bestehen bei den Automobilherstellern und deren Zulieferern

1. Es darf kein Überstrom in dem abgesicherten Versorgungsleitungsabschnitt auftreten. Diese Funktion ist neu, da eine Schmelzsicherung nur den thermischen Überlastungsschutz, nicht aber einen Schutz vor kurzzeitigen Überströmen gewährleistet.

2. Es darf keine Überlastung der Leitung in dem abgesicherten Versorgungsleitungsabschnitt auftreten. Dabei soll sich die elektronische Sicherung so verhalten, wie eine Schmelzsicherung aus dem Stand der Technik, um eine Plug&Play-Funktionalität sicherzustellen und keine neuen Probleme durch Seiteneffekte zu erzeugen. Neue Konstruktionen sollen die SOA (safe operating area) der Leitung, als den sicheren Betriebsbereich, maximal ausnutzen, um den Materialeinsatz in Form des Leitungsdurchmessers der abzusichernden Leitung zu minimieren. (Schutzfunktion der elektronischen Sicherung d.h. der E-Fuse)

3. Die oben genannten Organisationen haben ein Interesse an einer Erfassung weiterer Parameter im Versorgungsnetzwerk, um beispielsweise eine Strommessung ohne Temperatursensor durchführen zu können und so ggf. auf die Temperatur der Leitungen im Versorgungsnetzwerk zurückschließen zu können.

4. Die Versorgung der Vorrichtungteile eines Fahrzeugs soll im Parkzustand mit möglichst geringer Ruhestromaufnahme erfolgen. Für eine elektronische Sicherung bedeutet das, dass diese geringe Reststromaufnahme bei einem minimalen Schutz zu erfolgen hat und dass die der elektronischen Sicherung im Versorgungsteilbaum nachfolgenden Verbraucher von Zeit zu Zeit aufwachen können sollen.

5. Die Automobilhersteller wünschen sich ideale Dioden, um den Rückstrom elektrischer Energie kontrollieren und/oder verhindern zu können.

Die hier vorgelegte Schrift schlägt für die Realisierung idealer Dioden vor, dass der Rechnerkern der Steuervorrichtung einer elektronischen Sicherung den elektrischen Strom durch den Leistungsschalter in Richtung auf von der Energiequelle auf die Verbraucher aber auch in umgekehrter Stromrichtung durch geeignete Messmittel der Sicherung und/oder der Steuervorrichtung der Sicherung bevorzugt erfassen kann. Der Rechnerkern der Steuervorrichtung einer elektronischen Sicherung kann dazu beispielsweise den Spannungsabfall über den Leistungsschalter mittels eines Analog-zu-Digital-Wandlers oder dergleichen erfassen und bei einer Umkehrung des elektrischen Stromes durch den Leistungsschalter diesen Leistungsschalter ausschalten. Die vorgeschlagene elektronische Sicherung und/oder die Steuervorrichtung der elektronischen Sicherung sollte daher Mittel zur Erfassung und zur Detektion eines rückwärtsfließenden Stromes umfassen. Typischerweise wertet der Rechnerkern der Steuervorrichtung der elektronischen Sicherung die so erfassten Messwerte aus, und gibt diese oder daraus abgeleitete Messwerte an andere Rechnerkerne anderer elektronischen Sicherungen des Versorgungsnetzwerks über einen Sicherungsdatenbus oder dergleichen oder an ein übergeordnetes Rechnersystem, beispielsweise ein Steuergerät des Fahrzeugs, weiter.

Gegenstand der Erfindung sind unter anderem eine elektrische Sicherungsvorrichtung mit alternativ den Merkmalen nach Anspruch 1, 4 und 5, wobei einzelne Ausgestaltungen dieser erfindungsgemäßen elektrischen Sicherungsvorrichtung Gegenstand der Ansprüche 2, 3 und 6 sind, ein Versorgungsnetzwerk nach Anspruch 7, eine elektronische Sicherung nach Anspruch 9, wobei einzelne Ausgestaltungen dieser elektronischen Sicherung Gegenstand der Ansprüche 10 bis 20 sind, eine elektronische Sicherung nach Anspruch 21, wobei einzelne Ausgestaltungen dieser elektronischen Sicherung Gegenstand der Ansprüche 22 bis 38 sind, ein Versorgungssystem mit den Merkmalen des Anspruchs 39, wobei einzelne Ausgestaltungen dieses Versorgungssystems Gegenstand der Ansprüche 40 bis 45 sind, eine elektronische Sicherung mit den Merkmalen nach Anspruch 46 oder 47, wobei einzelne Ausgestaltungen dieser elektronischen Sicherung Gegenstand der Ansprüche 48 bis 52 sind, eine elektronische Sicherung mit den Merkmalen des Anspruchs 53, eine elektronische Sicherung mit den Merkmalen des Anspruchs 54, wobei einzelne Ausgestaltungen dieser elektronischen Sicherung Gegenstand der Ansprüche 55 bis 60 sind, und eine elektronische Sicherung nach Anspruch 61, wobei eine Ausgestaltung dieser elektronischen Sicherung Gegenstand des Anspruchs 62 ist.

Ein Merkmal der elektronischen Sicherungsvorrichtung gemäß den Ansprüchen 1 bis 8 ist darin zu sehen, dass diese Sicherungsvorrichtung in ein Versorgungsnetzwerk eines Fahrzeugs ein- oder mehrfach integriert werden kann, um die Topologie des Versorgungsnetzwerks rekonfigurieren zu können. Die eingangs- und ausgangsseitig angeschlossenen Leitungen des Versorgungsnetzwerks lassen sich beliebig miteinander verschalten, wobei ein Vorteil darin besteht, dass innerhalb der Sicherungsvorrichtung die Betriebsparameter durch die elektronischen Sicherungen erfasst und überwacht werden. Zu diesem Zweck sind die elektronischen Sicherungen mit einem übergeordneten Steuerungs- bzw. Rechnersystem verbunden. Dieses System steuert die elektronischen Sicherungen entsprechend der für den aktuell benötigten Transfer von elektrischer Leistung bzw. elektrischer Energie durch das Netzwerk gegebenen Anforderungen. Die Leistungsschalter, die erfindungsgemäß eingesetzt werden, werden zum Ein- und Ausschalten also in Abhängigkeit von aktuellen Betriebsparametern gesteuert. Aktuelle Betriebsparameter können sein die Größe des über den betreffenden Leistungsschalter fließenden Stroms und/oder der über dem betreffenden Leistungsschalter abfallenden Spannung oder einer anderen Spannung in der elektrischen Verbindung, die elektrische Leistung (nach Zeit integriert), die elektrische Energie, die transportiert wird, die Temperatur insbesondere der Leitung bzw. elektrischen Verbindung (Stichwort $i^2$t-Belastung) und/oder die Verformung der elektrischen Leitung, die sich beispielsweise unter Wärmeeinfluss dehnen könnte, was über elektrische Parameter wie Strom bzw. Spannung erfasst werden kann.

Eine Besonderheit der elektronischen Sicherung nach einem der Ansprüche 9 bis 38 ist in der galvanischen Trennung des Versorgungsnetzwerks, in dem der Leistungsschalter der elektronischen Sicherung geschaltet ist, und der Ansteuerung der elektronischen Sicherung. Beide Systeme (Datenkommunikation und übergeordnetes Steuerungs- bzw. Rechnersystem einerseits und Versorgungsnetzwerk andererseits) können bei deutlich verschiedenen Spannungen betrieben werden. So ist es insbesondere in Fahrzeugen üblich, nicht nur Kleinspannungen im Bereich von <= 50V AC oder <=120V DC, insbesondere im Bereich von 40V bis 120V DC und/oder Niederspannungen im Bereich von <= 1000V AC oder <= 1500V DC und insbesondere im Bereich von 400V bis 1500V DC zu schalten und zu verarbeiten (siehe beispielsweise Wikipedia https://de.wikipedia.org/wiki/Kleinspannung), während die Datenkommunikation bei deutlich kleineren Spannungen betrieben wird. Sollte es innerhalb einer elektronischen Sicherung zu einer Durchlegierung elektronischer Bauteile und damit zu Kurzschlüssen o.dgl. Situation mit erhöhtem Strom kommen, so kann durch die galvanische Trennung (die Datenschnittstelle arbeitet nicht-elektrisch) nicht zu einer Beeinträchtigung der Funktionalität des Kommunikationssystems kommen.

Die nicht-elektrisch arbeitende Datenschnittstelle der Steuervorrichtung der elektronischen Sicherung arbeitet vorzugsweise optisch oder induktiv. Die optische Strahlung kann so ausgebildet sein, wie in den zuvor genannten Ansprüchen beschrieben. Insbesondere kann die optische Datenübertragung durch Partikelstrahlung bzw. sogar Einzelpartikelstrahlung erfolgen. So lassen sich nun PQK (Post Quantum Kryptografie-) bzw. QKD (Quantum Key Distribution-)Konzepte verwirklichen (wie beispielsweise hinsichtlich QKD beschrieben in der PCT-Anmeldung der Anmelderin PCT/DE2022/100724).

Eine Besonderheit des Versorgungsnetzwerks gemäß den Merkmalen eines der Ansprüche 39 bis 45 ist im aktiven Power-Management zu sehen. Durch die verteilt über das Versorgungsnetzwerk angeordneten elektronischen Sicherungen werden laufend für verschiedene Punkte bzw. Bereiche des Versorgungsnetzwerks die dort gegebenen Betriebsparameter wie Strom, Spannung, Temperatur, Leistung, Energie etc. überwacht und an das übergeordnete Steuerungs- bzw. Rechnersystem gemeldet. Es wird abgewägt zwischen dem aktuellen Energiebedarf sämtlicher Verbraucher bzw. einiger Verbraucher oder Gruppen von Verbraucher einerseits und der aktuellen Energielieferfähigkeit sämtlicher Energiequellen oder ausgewählter Energiequellen, um in Abhängigkeit von drohenden Notsituationen auf Grund beispielsweise zu hoher thermischer Belastungen oder zu hoher elektrischer Belastungen von Teilen des Versorgungsnetzwerks einzelne Verbraucher oder auch einzelne Teile des Versorgungsnetzwerks abzukoppeln. Berücksichtigt werden kann hier auch die Tatsache, dass während des Betriebs des Fahrzeugs durch beispielsweise Rekuperation oder Solaranlagen zusätzlich elektrische Energie zur Verfügung gestellt wird.

Die elektronische Sicherung mit den Merkmalen nach einem der Ansprüche 46 bis 60 zeichnet sich beispielsweise dadurch aus, dass eine thermische Überwachung erfolgt, und zwar nicht zwingend auf die elektronische Sicherung selbst bezogen, sondern auf ihre Umgebung bzw. auch auf die Leitung, in die die elektronische Sicherung geschaltet ist. Bei zu hohen Temperaturen kann die elektronische Sicherung selbsttätig abschalten, was an das Steuerungs- bzw. Rechnersystem gemeldet wird. Auch die Temperaturwerte werden an dieses System gemeldet bzw. werden erst dann gemeldet, wenn eine bestimmte Temperaturschwelle, die vorzugsweise unterhalb der Abschaltschwelle liegt, überschritten ist. Hier wird also insoweit eine gewisse Vorwarnung abgegeben.

Die thermische Absicherung kann als thermische Sicherung mit der Einmal-Abschaltung (irreversible Abschaltung) realisiert werden oder aber durch einen Thermoschalter, der reversible aus- und dann wieder eingeschaltet werden kann.

Schließlich ist ein Wesensmerkmal der elektronischen Sicherung nach Anspruch 60 oder 61 darin zu sehen, dass dort durch entweder einen Bypass-Schalter oder aber einen Ableitschalter bzw. Stromableitschalter die elektronische Sicherung in einen anderen Betriebsmodus überführt werden kann als Absicherung der betreffenden elektrischen Verbindung bzw. Leitung bzw. Energiequelle bzw. des betreffenden Verbrauchers. So kann die elektronische Sicherung mit Bypass-Schalter, der vorzugsweise parallel zum Leistungsschalter liegt, dazu genutzt werden, immer noch für einen Stromfluss zu sorgen, also eine Unterbrechung zu verhindern, obwohl der Leistungsschalter ausgeschaltet ist. Eine derartige elektronische Sicherung kann beispielsweise eingesetzt werden in einer Batterie, bei der einzelne Batteriezellen oder einzelne Gruppen von Batteriezellen (Batteriemodule) durch elektronische Sicherungen abgesichert sind und, bei einem Defekt, durch Öffnen des Leistungsschalters und Schließen des Bypass-Schalter derartige Defekte Zellen bzw. Module überbrückt werden können. Alternativ kann der Bypass-Schalter beispielsweise verbraucherseitig an einen anderen Anschluss der elektronischen Sicherung angeschlossen sein als der Leistungsschalter. So kann ein an den Leistungsschalter angeschlossener Verbraucher durch Öffnen des Leistungsschalters vom Versorgungsnetz getrennt werden, während die elektronische Sicherung selbst über ihren Bypass-Schalter weiterhin über diesen Bypass-Schalter angeschlossene Leitungen weiterhin elektrische Energie zu anderen Bereichen des Versorgungsnetzwerks bzw. zu anderen Verbrauchern liefern. Insoweit ist die elektronische Sicherung dann also als eigentliche elektronische Sicherung mit einem zusätzlichen Schalter zu verstehen.

Eine weitere Möglichkeit der elektronischen Sicherung besteht darin, dass bei rückwärts fließenden Strömen, also vom Verbraucher aus zur elektronischen Sicherung fließenden Strömen, derartige Ströme bereits am verbraucherseitigen Anschluss der elektronischen Sicherung zu einer Stromsenke hin abgeführt werden. Damit wird eine Beschädigung der elektronischen Sicherung und von Komponenten des Versorgungsnetzwerks, die direkt oder indirekt mit dem energiequellenseitigen Anschluss der elektronischen Sicherung verbunden sind, verhindert.

Sämtliche Aspekte der zuvor beschriebenen Varianten der Erfindung sowie der nachfolgend noch zu beschreibenden Varianten basieren auf der Verwendung ein oder mehrerer elektronischer Sicherungen, die mindestens einen Leistungsschalter aufweisen, der über eine Steuervorrichtung ansteuerbar ist. Die Steuervorrichtung ist dabei über eine Datenschnittstelle mit einem übergeordneten Steuerungs- bzw. Rechnersystem verbunden. Die Steuerungsvorrichtung muss nicht zwingend Bestandteil der elektronischen Sicherung sein; sie kann auch extern der elektronischen Sicherung angeordnet sein und insbesondere die Leistungsschalter mehrerer elektronischer Sicherungen steuern. Sofern die Steuervorrichtung Bestandteil der elektronischen Sicherung ist, kann über diese, vorzugsweise vermittels des Datenkommunikationsbusses, auch auf die Ansteuerung der Leistungsschalter anderer elektronischer Sicherungen eingewirkt werden. In gewisser ähnlich verhält es sich mit der Messvorrichtung der elektronischen Sicherung zur Erfassung eines Betriebsparameters des Leistungsschalters und/oder einer elektrischen Verbindung bzw. einer Leitung, in der der Leistungsschalter angeordnet ist, wobei der Betriebsparameter die Größe eines Stroms und/oder einer Spannung und/oder einer elektrischen Leistung und/oder einer elektrischen Energie ist oder aber es sich um die Temperatur und/oder um einen die Verformung der elektrischen Verbindung repräsentierenden Messwert handelt. Eine derartige Messvorrichtung kann pro elektronischer Sicherung vorgesehen sein; wenn die elektronische Sicherung mehrere Leistungsschalter aufweist, dient eine Messvorrichtung zweckmäßigerweise zur Erfassung der Betriebsparameter jedes der Leistungsschalter bzw. jeder elektrischen Verbindung, in die der betreffende Leistungsschalter geschaltet ist. Aber auch die Messvorrichtung muss nicht zwingend integraler Bestandteil der elektronischen Sicherung sein. So könnte die Messvorrichtung auch extern vorgesehen sein, um, vorzugsweise über die Datenschnittstelle, mit den Steuervorrichtungen mehrerer elektronischer Sicherungen zu kommunizieren.

Die Erfindung betrifft ein Verfahren (7600) zum Betreiben eines Versorgungsnetzwerks (200), mit einer Komprimierung und Verschlüsselung der ersten Sicherungsdaten einer ersten elektronischen Sicherung (1) in der ersten elektronischen Sicherung (1) und einer Komprimierung und Verschlüsselung der Sensordaten eines weiteren Sensors und mit einer Übertragung der komprimierten und verschlüsselten ersten Sicherungs- und Sensordaten an ein übergeordnetes Rechnersystem (12) und mit einer Entschlüsselung und einer Dekomprimierung der komprimierten und verschlüsselten ersten Sicherungs- und Sensordaten zu empfangenen ersten Sicherungs- und Sensordaten im über-geordneten Rechnersystem (12) Außerdem umfasst das Verfahren die Fusion der empfangenen ersten Sicherungs- und Sensordaten im übergeordneten Rechnersystem (12).

Nachfolgend werden verschiedene Anwendungsfälle für elektronische Sicherungen in Fahrzeugen sowie verschiedene Ausgestaltungen solcher Sicherungen beschrieben.

Batterie

Elektronische Sicherungen eignen sich in hervorragender Weise auch zur Überwachung von Batterien. Die hier vorgelegte Schrift schlägt daher eine Batterie mit Diagnosefunktion vor. Bevorzugt ist zumindest ein Anschluss der Batterie mit einer elektronischen Sicherung, wie hier vorgeschlagen, versehen. Beispielsweise kann die Batterie einen Versorgungsbaum und/oder ein Versorgungsnetzwerk mit einem oder mehr Versorgungszweigen umfassen. Beispielsweise können mehrere elektronische Sicherungen innerhalb der Batterie in Serie in einen Versorgungszweig eines Versorgungsbaums und/oder eines Versorgungsnetzwerks geschaltet sein. Beispielsweise können ein Versorgungsbaum und/oder ein Versorgungsnetzwerk auch nur einen Versorgungszweig mit einer Mehrzahl von elektronischen Sicherungen, die in den Versorgungszweig eingefügt sind, umfassen. Bevorzugt umfasst eine Batterie eine oder mehr Batteriezellenmodule. Bevorzugt sind eine oder mehr Batteriezellenmodule elektrisch in Serie geschaltet. Bevorzugt sind eine oder mehrere elektronische Sicherungen zwischen Batteriezellenmodulen der Batterie geschaltet. Bevorzugt ist genau eine elektronische Sicherung zwischen zwei Batteriezellenmodulen geschaltet, die miteinander in Serie verschaltet sind. Ganz besonders bevorzugt sind ist je Batteriezellenmodul eine elektronische Sicherung vorgesehen. Ganz besonders bevorzugt ist bevorzugt jedem Batteriezellenmodul oder einer oder mehreren Gruppen, insbesondere in Serie verschalteter Batteriezellenmodule eine elektronische Sicherung zugeordnet. Ganz besonders bevorzugt weisen eine oder mehrere oder alle dieser elektronischen Sicherungen einen ersten Leistungsschalter auf, der dazu geeignet ist, den Stromfluss durch das Batteriezellenmodul bzw. die betreffende Gruppe an Batteriezellenmodulen zu verhindern, also die elektrische Verbindung zwischen einem ersten Batteriezellenmodul und einem zweiten Batteriezellenmodul oder einer ersten Gruppe von Batteriezellenmodulen und einer zweiten Gruppe von Batteriezellenmodulen, die miteinander in Serie geschaltet sind, aufzutrennen, wenn der erste Leistungsschalter geöffnet ist. Ganz besonders bevorzugt weisen eine oder mehrere oder alle dieser elektronischen Sicherungen der Batterie einen zweiten Leistungsschalter auf, der dazu geeignet ist, das Batteriezellenmodul oder die Gruppe von Batteriezellenmodulen bei einem geschlossenen zweiten Leistungsschalter zu überbrücken.

Dabei kann bevorzugt der Rechnerkern der Steuerungsvorrichtung der elektronischen Sicherung nur dann den zweiten Leistungsschalter schließen, wenn der erste Leitungsschalter sicher geöffnet ist. Hierfür untersucht der Rechnerkern der Steuervorrichtung der elektronischen Sicherung bevorzugt vor dem Schließen des zweiten Leistungsschalters den Schaltzustand des ersten Leistungsschalters beispielsweise durch Einspeisung eines Teststromes in den ersten Leistungsschalter und durch Entnahme dieses Teststromes hinter dem ersten Leistungsschalter und durch Erfassung und Überprüfung der Spannungen an den Anschlüssen des Leistungsschalters.

Dabei kann bevorzugt der Rechnerkern der Steuerungsvorrichtung der elektronischen Sicherung nur dann den ersten Leistungsschalter schließen, wenn der zweite Leitungsschalter sicher geöffnet ist. Hierfür untersucht Der Rechnerkern der Steuerungsvorrichtung der elektronischen Sicherung bevorzugt vor dem Schließen des ersten Leistungsschalters den Schaltzustand des zweiten Leistungsschalters beispielsweise durch Einspeisung eines Teststromes in den zweiten Leistungsschalter und durch Entnahme dieses Teststromes hinter dem zweiten Leistungsschalter und durch Erfassung und Überprüfung der Spannungen an den Anschlüssen des zweiten Leistungsschalters.

Bevorzugt weist die Zusammenschaltung zwischen dem Batteriezellenmodul bzw. Der Gruppe der Batteriezellenmodule und dem ersten Leistungsschalter und dem zweiten Leistungsschalter drei elektrische Knoten aus. Dabei ist bevorzugt der erste Leistungsschalter mit einem ersten Anschluss des ersten Leistungsschalters mit einem ersten Knoten verbunden. Dabei ist bevorzugt der erste Leistungsschalter mit einem zweiten Anschluss des ersten Leistungsschalters mit einem zweiten Knoten verbunden. Dabei ist bevorzugt der zweite Leistungsschalter mit einem ersten Anschluss des zweiten Leistungsschalters mit einem dritten Knoten verbunden. Dabei ist bevorzugt der zweite Leistungsschalter mit einem zweiten Anschluss des zweiten Leistungsschalters mit dem zweiten Knoten verbunden. Dabei ist bevorzugt ein erster Anschluss der Batteriezelle bzw. der Gruppe von Batteriezellen mit dem dritten Anschluss verbunden. Dabei ist bevorzugt ein zweiter Anschluss der Batteriezelle bzw. der Gruppe von Batteriezellen mit dem ersten Anschluss verbunden. Bevorzugt weisen die elektronischen Sicherungen für die Verwendung in einer Batterie ein Gehäuse auf. Bevorzugt weisen elektronische Sicherungen für die Verwendung in einer Batterie eine optische Schnittstelle auf. Bevorzugt umfasst das besagte Gehäuse einer elektronischen Sicherung ein optisches Fenster oder ein optisches Teilsystem für den Zutritt elektromagnetischer Strahlung für den Transport von Daten zu dieser elektronischen Sicherung. Bevorzugt umfasst das besagte Gehäuse einer elektronischen Sicherung ein optisches Fenster oder ein optisches Teilsystem für den Ausritt elektromagnetischer Strahlung für den Transport von Daten von dem Rechnerkern der Steuervorrichtung der elektronischen Sicherung zu dem Rechnerkern der Steuervorrichtung einer anderen elektronischen Sicherung oder zu einem übergeordneten Rechnersystem. Bevorzugt handelt es sich bei der elektromagnetischen Strahlung um Laser-Strahlung und/oder um Strahlung einer LED. Bevorzugt umfasst die elektronische Sicherung insbesondere zu diesem Zweck einen Laser oder eine LED. Bevorzugt umfasst die elektronische Sicherung einen Fotodetektor, beispielsweise eine Fotodiode zum Empfang optischer Signale, die Daten transportieren. Die optischen Fenster sind hierbei Teilvorrichtungen einer oder mehrerer optischer Datenschnittstellen der Steuerungsvorrichtung der betreffenden elektronischen Sicherung. Bevorzugt verbinden Lichtwellenleiter und/oder andere optische Funktionselemente die Rechnerkerne der Steuervorrichtungen einer oder mehrerer elektronischer Sicherungen über diese optischen Datenschnittstellen dieser elektronischen Sicherungen miteinander. Bevorzugt sind eine oder mehrere elektronische Sicherungen mit einem übergeordneten Rechnersystem über eine solche optische Schnittstelle und einen Lichtwellenleiter mit einer optischen Schnittstelle des übergeordneten Rechnersystems verbunden. Eine oder mehrere elektronische Sicherungen können auch mittels einer anderen Datenschnittstelle, insbesondere mittels der oben erwähnten, mit dem übergeordneten Rechnersystem datentechnisch verbunden sein. Bevorzugt versorgen das Batteriezellenmodul bzw. die Gruppe von Batteriezellenmodulen die Steuervorrichtung der elektronischen Sicherung und die sonstigen Teile der elektronischen Sicherung, die diesem Batteriezellenmodul bzw. dieser Gruppe von Batteriezellenmodulen zugeordnet ist, mit elektrischer Energie für den Betrieb derselben. Bevorzugt kann ein Batteriezellenmodul bzw. eine Gruppe von Batteriezellenmodulen zum Ersten die Steuervorrichtung der elektronischen Sicherung und zum Zweiten die sonstigen Teile der elektronischen Sicherung und zum Dritten die denjenigen Batteriezellenmodule bzw. derjenigen Gruppe von Batteriezellenmodulen, denen diese elektronische Sicherung zugeordnet ist und denen diese Sicherung im Versorgungszweig nachfolgt bzw. vorausgeht, mit elektrischer Energie für den Betrieb dieser elektronischen Sicherung versorgen. Bevorzugt umfasst somit die Batterie eine elektronische Sicherung pro Batteriezellenmodul oder pro Gruppe von Batteriezellenmodulen. Bevorzugt erfasst der Rechnerkern der Steuervorrichtung der elektronischen Sicherung mittels Messmitteln der Steuervorrichtung der elektronischen Sicherung dabei Spannungswerte und/oder Stromwerte. Bevorzugt führt die elektronische Sicherung dabei eine Sicherungsfunktion aus. Bevorzugt unterbricht der Rechnerkern der Steuervorrichtung der elektronischen Sicherung mittels des Leistungsschalters der elektronischen Sicherung den Stromfluss durch den Leistungsschalter der elektronischen Sicherung, wenn eine Auftrennbedingung erfüllt ist. Eine solche Auftrennbedingung kann beispielsweise das Überschreite eines Maximalstromwertes des elektrischen Stromes durch den Leistungsschalter der Sicherung oder dergleichen sein. Bevorzugt unterbricht der Rechnerkern der Steuervorrichtung der elektronischen Sicherung mittels des Leistungsschalters der elektronischen Sicherung den Stromfluss und überbrückt das Batteriezellenmodul oder die Gruppe von Batteriezellenmodulen, wenn eine Auftrennbedingung erfüllt ist und eine Überbrückungsbedingung erfüllt ist. Bevorzugt übermitteln die Rechnerkerne der Steuervorrichtungen einer oder mehrerer elektronischer Sicherungen ein oder mehrere Messwerte und/oder daraus abgeleitete Werte und/oder Zustandswerte und/oder Zustandsinformationen der jeweiligen elektronischen Sicherungen an ein übergeordnetes Rechnersystem. Bevorzugt umfassen eine oder mehrere Steuervorrichtungen der elektronischen Sicherungen eine oder mehrere Temperatursensorauswertevorrichtungen bevorzugt mit einem oder mehreren Temperatursensoren 586. Bevorzugt umfasst die elektronische Sicherung einen oder mehrere Temperatursensoren 586. Die elektronische Sicherung kann eine Thermosicherung zusätzlich umfassen, die eine Schmelzsicherung mit einer gespannten Feder umfasst, die den Leistungsschalter der elektronischen Sicherung stromlos schaltet, wenn der Leistungsschalter eine maximale Temperatur überschreitet. Bevorzugt wertet der Rechnerkern der Steuervorrichtung der Schmelzsicherung Temperaturmesswerte der einen oder der mehreren Temperatursensorauswertevorrichtungen aus, die diese mit Hilfe von zur elektronischen Sicherung externen Temperatursensoren und/oder mit Hilfe von Temperatursensoren der elektronischen Sicherung erfassen.

Bevorzugt umfassen ein oder mehrere elektronische Sicherungen zwei Datenschnittstellen die optisch sein können. Bevorzugt sind die Rechnerkerne der Steuervorrichtungen der elektronischen Sicherungen in Vorrichtungen mit erhöhten Anforderungen an die galvanische Trennung durch einen optischen Datenbus datentechnisch verbunden, in den die Datenschnittstellen der Steuervorrichtungen der elektronischen Sicherungen jeweils eingefügt sind.

Bevorzugt sind Datenschnittstelen der Steuervorrichtungen der elektronischen Sicherungen zumindest durch einen elektronischen Eindrahtdatenbus und/oder durch einen Zweidrahtdatenbus und/oder einen anderen Datenbus und/oder ein anderes Datenkommunikationsmittel datentechnisch drahtgebunden und/oder drahtlos verbunden. In einen solchen Datenbus sind die Datenschnittstellen der Steuervorrichtungen der elektronischen Sicherungen eingefügt. Die Zusammenschaltung der Datenbusse kann sternförmig oder linear in einer Kette oder einem geschlossenen Ring erfolgen. Die Datenbusse können je nach Datenbustyp ggf. auch Abzweigungen aufweisen. Bei einem besonders bevorzugten Datenbus innerhalb einer Batterie kann es sich um einen optischen Datenbusring von in einem Ring verschalteten optischen Datenbussen handeln. Bevorzugt sind die Lichtwellenleiter des optischen Datenbusses elektrisch isolierend ausgeführt. Bevorzugt kann die Steuervorrichtung einer elektronischen Sicherung als LED eine siliziumbasierende LED umfassen. Auch eine optische Datenschnittstelle der Steuervorrichtung einer elektronischen Sicherung kann ebenfalls beispielsweise als LED eine siliziumbasierende LED umfassen. Bei einer solchen siliziumbasierenden LED kann es sich um eine Silizium-Lawinen-LED handeln. Beispielsweise kann es sich bei der siliziumbasierenden LED um eine SPAD-Diode handeln, die die Steuervorrichtung der Sicherung als LED mit ausreichender Sperrspannung im Sperrbetrieb im Durchbruchsbereich betreibt. Bevorzugt umfasst die Steuervorrichtung der elektronischen Sicherung dann eine Ansteuervorrichtung, die aus der Betriebsspannung der elektronischen Sicherung mittels eines Spannungsumsetzers die Betriebsspannung für die Silizium LED, insbesondere die SPAD-Diode, erzeugt. Die hier vorgestellte technische Lehre schlägt u.a. auch vor, die Silizium-LED zweitweise auch als Empfänger zu betreiben. Hierzu trennt der Rechnerkern der Steuervorrichtung der elektronischen Sicherung mittels eines Trennschalters der Steuervorrichtung der elektronischen Sicherung die Silizium LED von der elektrischen Versorgung des Spannungsumsetzers ab und verwendet das Spannungssignal und/oder Fotostromsignal der Silizium-LED als Eingangssignal für einen optischen Datenempfänger der Steuervorrichtung der elektronischen Sicherung.

Flexibilität der Architektur

Eine elektronische Sicherung, wie das hier vorgelegte Dokument sie hier vorschlägt, kann den Aufwand bei der Konstruktion des automobilen Sicherungskastens (der Junction Box) reduzieren. Dadurch, dass insbesondere ein übergeordnetes Rechnersystem mittels Datenbussen auf die Rechnerkerne der Steuervorrichtungen der elektronischen Sicherungen durch die Steuergeräte des Fahrzeugs zugreifen kann, können neu Konstruktionen die elektronischen Sicherungen an verschiedenen Stellen im Fahrzeug positionieren und so den Verdrahtungsaufwand für das Versorgungsnetzwerk minimieren. Dies ermöglicht eine Dezentralisierung der elektronischen Sicherungen. Bevorzugt führen neue Konstruktionen ein oder mehrere Versorgungszweige des Versorgungsnetzwerks zur Versorgung von elektrischen Verbrauchern innerhalb des Fahrzeugs mit elektrischer Energie als Ring einer Versorgungsleitung aus, wenn die Karosserie als Rückleitermasseleitung dient, und/oder im anderen Fall als zwei Ringe von zwei Versorgungsleitungen ausgeführt. Bevorzugt sind die jeweiligen Leistungsschalter der jeweiligen elektronischen Sicherungen in die jeweilige Versorgungsleitung des Versorgungsnetzwerks eingefügt. Bevorzugt sind für jeden Verbraucher zwei Sicherungen in die jeweilige Versorgungsleitung am jeweiligen Anzapfpunkt der elektrischen Energie für diesen Verbraucher in die jeweilige Versorgungsleitung eingefügt. Dies führt dazu, dass bei einem Fehler an einem Versorgungsleitungsabschnitt typischerweise die jeweiligen Rechnerkerne der jeweiligen Steuervorrichtungen der zwei diesem fehlerhaften Verbraucher zugeordneten elektronischen Sicherungen ihre jeweiligen Leistungsschalter öffnen, sodass dieses Öffnen der Leistungsschalter der Sicherungen den fehlerhaften Leitungsabschnitt isoliert. Dies führt dazu, dass bei einem Fehler an einem Verbraucher typischerweise die jeweiligen Rechnerkerne der jeweiligen Steuervorrichtungen der diesem Verbraucher zugeordneten zwei elektronischen Sicherungen ihre jeweiligen Leistungsschalter öffnen, sodass dieses Öffnen der Leistungsschalter den fehlerhaften Verbraucher isoliert. Somit beeinträchtigt ein solcher Fehlerfall die Versorgung der anderen Verbraucher mit elektrischer Energie nicht.

Aktive Energieerzeugungskonfigurierung und aktive Energieverteilungskonfigurierung (Active-Power-Management)

Das sogenannte Active-Power-Management umfasst beispielsweise:

- Adaptives Management des Leitungszustands,
- Adaptives Strom-Management mittels adaptiver Abschaltschwellen,
- Reduktion des Ruhestroms in HV-Domänen,
- Effiziente Park Systemzustände,
- Remote-Recovery,
- Preventive Maintenance (KI).

Besonders bevorzugt erfassen die jeweiligen Rechnerkerne der jeweiligen Steuervorrichtungen mehrerer elektronischer Sicherungen den jeweiligen elektrischen Strom durch ihren jeweiligen Leistungsschalter und ggf. das jeweilige Potenzial eines oder mehrerer Anschlüsse dieses Leistungsschalters untereinander und/oder gegen ein Bezugspotenzial eines Bezugspotenzialkontakts als Referenzpotenzial. Bevorzugt berechnet je nach Stromwert der Bestromung des jeweiligen Leistungsschalters der jeweiligen Sicherung der jeweilige Rechnerkern der jeweiligen Steuervorrichtung der jeweiligen Sicherung mittels Modellbildung einen theoretischen Masseversatz und korrigiert ggf. die von ihm erfassten entsprechenden Spannungsmesswerte.

Diese Berechnung des Rechnerkerns der Steuervorrichtung der Sicherung können auch andere Rechnerkerne anderer Steuervorrichtungen anderer elektronischer Sicherungen im Gesamtsystem vornehmen oder übergeordnete Rechnersysteme des Fahrzeugs etc. durchführen.

Einzelne oder mehrere Rechner des Gesamtsystems, die auch Rechnerkerne der Steuervorrichtungen der elektronischen Sicherungen und/oder das übergeordnete Rechnersystem sein können, können beispielsweise auf Zustandsparameter der Versorgungsleitungsabschnitte mit Hilfe der so erfassten Parameter wie Stromwerten und Spannungswerten schließen. Hierzu können beispielsweise Widerstandsbeläge und/oder Temperaturen und/oder thermische Durchbiegungen etc. der Versorgungsleitungsabschnitte gehören. Zu den Zustandsparametern eines Versorgungsleitungsabschnitts kann dessen Temperatur gehören. Die Rechnerkerne der Steuervorrichtungen können die Temperatur bei Kupferleitungen beispielsweise sehr gut mit Hilfe der bekannten Temperaturkoeffizienten von Kupfer und den bekannten Konstruktionsdaten des Versorgungsleitungsabschnitts und/oder mittels der in dem Versorgungsabschnitt eingespeisten Energie und/oder mittels der in dem Versorgungsleitungsabschnitt absorbierten Energie ermitteln. Gleiches gilt für andere Materialien.

Die Verwendung elektronischer Sicherungen ermöglicht die Programmierung von Ausstattungsvarianten. Um eine missbräuchliche Aktivierung bzw. Deaktivierung der Energieversorgungsmöglichkeit von Teilbäumen des Versorgungsbaums und/oder Teilversorgungsnetzen des Versorgungsnetzes zu verhindern, erfolgt die Kommunikation zwischen dem Rechnerkern einer Steuervorrichtung einer elektronischen Sicherung und dem Rechnerkern der Steuervorrichtung einer anderen elektronischen Sicherung bevorzugt verschlüsselt. Um eine missbräuchliche Aktivierung bzw. Deaktivierung der Energieversorgungsmöglichkeit von Teilbäumen des Versorgungsbaums und/oder Teilversorgungsnetzen des Versorgungsnetzes zu verhindern, erfolgt die Kommunikation zwischen dem Rechnerkern einer Steuervorrichtung einer elektronischen Sicherung und einem übergeordneten Rechnersystem bevorzugt verschlüsselt. Bevorzugt erfordern die Aktivierung und/oder die Deaktivierung einer elektronischen Sicherung, also das Einschalten oder Ausschalten des Leistungsschalters, die Übermittlung eines digitalen Passworts von dem Rechnerkern der Steuervorrichtung einer anderen elektronischen Sicherung oder vom übergeordneten Rechnersystem über einen Datenbus an den Rechnerkern der Steuervorrichtung einer elektronischen Sicherung. Bevorzugt ist die Kommunikation zwischen dem Rechnerkern der Steuervorrichtung einer elektronischen Sicherung und ihrer Umwelt über solche Datenverbindungen kryptografiert. Bevorzugt ist eine solche Datenverbindung mit einer PQC-Methode kryptografiert. (PQC=post quantum cryptography). Die Kommunikation über den Datenbus kann beispielsweise mittels eines PSI5 ähnlichen Protokloss oder dergleichen erfolgen. Bevorzugt kommunizieren die elektronischen Sicherungen die Teilvorrichtungen eines Versorgungsnetzwerks sind, auch mittels Power-Line-Kommunikation über das Versorgungsnetzwerk oder ihre ggf. separaten Versorgungsspannungsleitungen miteinander.

Nach einem wesentlichen Wechsel des Betriebszustands des Fahrzeugs, ändern bevorzugt nicht alle elektronischen Sicherungen gleichzeitig den Schaltzustand ihrer Leistungsschalter. Eine solche wesentliche Änderung des Betriebszustands des Fahrzeugs kann beispielsweise der Einschaltvorgang sein, wenn das Fahrzeug aus dem Park-Zustand in den Fahrzustand überführt wird. Bevorzugt erhalten elektronische Sicherungen ein Start-Signal von einem zentralen Steuergerät, z.B. einem übergeordneten Rechnersystem. Ggf. verteilt das übergeordnete Rechnersystem zuvor die Werte von Wartezeiten, die die elektronischen Sicherungen zwischen dem Eintreffen des Startsignals vom Steuergerät und dem Schließen ihres jeweiligen Leistungsschalters warten sollen. Diese jeweiligen Werte der jeweiligen Wartezeiten können auch in einen nichtflüchtigen Speicher der jeweiligen elektronischen Sicherung einprogrammiert sein. Diese Programmierung kann werksseitig oder durch das übergeordnete Rechnersystem oder einen anderen Rechner des Fahrzeugs, somit auch durch den Rechnerkern einer anderen elektronischen Sicherung, erfolgen. Hierdurch sinkt der typischerweise sehr hohe Startstrom des elektrischen Systems eines Fahrzeugs massiv ab. Dieser Startstrom wird auch englisch als In-Rush-Current bezeichnet. Da der In-Rush-Current geringer wird, können neue Konstruktionen mit elektronischen Sicherungen das Verdrahtungsnetzwerk zur Versorgung der elektrischen Verbraucher im Fahrzeug wiederum schwächer mit weniger dicken Kabeln ausführen. Hierdurch sinkt das Gewicht des Fahrzeugs.

Erhöhung der Systemzuverlässigkeit

Die hier vorgelegte Schrift schlägt vor, dass die Rechnerkerne der Steuervorrichtungen der elektronischen Sicherungen an den jeweiligen Anschlüssen ihrer jeweiligen Leistungsschalter, die auf der Energiequellenseite liegen, die jeweiligen Spannungen zwischen diesen Anschlüssen und einem Bezugsknoten und/oder untereinander überprüfen. Unterschreitet eine dieser jeweiligen Spannungen einen jeweiligen Mindestwert und übersteigt gleichzeitig der jeweilige elektrische Strom durch den jeweiligen Leistungsschalter der jeweiligen elektronischen Sicherung einen jeweils vorbestimmten Schwellwert, so liefert die jeweilige Energieversorgung mehr Energie als beabsichtigt in das, durch diese jeweilige elektronische Sicherung abgesicherte, jeweilige Versorgungsteilnetzwerk. Bevorzugt schaltet dann die jeweilige elektronische Sicherung die elektrische Versorgung dieses Versorgungsteilnetzwerks durch Ausschalten ihres jeweiligen Leistungsschalters ab. Hierdurch kommt es zu einer Begrenzung des jeweiligen Spannungseinbruchs durch die Schnelligkeit der jeweiligen elektronischen Sicherung.

Je nach Sicherheitsschema kann Der Rechnerkern der Steuerungsvorrichtung der elektronischen Sicherung ein oder mehrere Einschaltversuche nach einem Ausschalten durchführen. Sofern die Anzahl der erfolglosen Einschaltversuche eine vorgegebene Anzahl übersteigt, übermittelt die Der Rechnerkern der Steuerungsvorrichtung der elektronischen Sicherung vorzugsweise eine Fehlermeldung an den Rechnerkern der Steuerungsvorrichtung einer anderen elektronischen Sicherung oder an ein übergeordnetes Rechnersystem.

Elektronische Sicherungen für Versorgungsteilnetzwerke und Versorgungszweige mit einer möglichst hohen Verfügbarkeit sollen bei Abschaltungen infolge von Überstrom oder dergleichen diese Möglichkeit der einfachen oder mehrfachen Einschaltversuche (Retry) haben.

Sicherungsdatenbus (Fuse-Bus)

Wie bereits zuvor beschrieben, ist es sinnvoll, wenn die Rechnerkerne der Steuervorrichtungen der elektronischen Sicherungen mit anderen Rechnerkernen der Steuervorrichtungen anderer Sicherungen in dem Versorgungsnetzwerk des Fahrzeugs oder mit übergeordneten Rechnersystemen des Fahrzeugs kommunizieren können. Typischerweise besteht hier Kommunikationsbedarf für Konfigurationsdaten (Schreiben/Lesen), Schaltbefehle (Schreiben/Lesen), Diagnosedaten (Schreiben/Lesen), Messwerte (Lesen), Vergleichswerteinstellungen (Schreiben/Lesen).

Bevorzugt benutzen die Rechnerkerne der Steuerschaltungen der elektronischen Sicherungen zur Kommunikation untereinander in dem Fahrzeug bzw. innerhalb eines Sicherungskastens (Fuse-Box) einen Sicherungsdatenbus. Bevorzugt ist der Sicherungsdatenbus ein Zweidrahtdatenbus. Bevorzugt ist der Sicherungsdatenbus ein differenzieller Datenbus, da erhebliche Masseströme und Masseverätze in der Karosserie eines Fahrzeugs auftreten können. Bevorzugt ist der Sicherungsdatenbus ein CAN-Datenbus oder ein Datenbus mit einem Physical-Interface eines CAN-Datenbusses, ein CAN-FD-Datenbusses oder ein Flexray-Datenbus oder ein LVDS-Datenbus oder dergleichen. Bevorzugt ist der Sicherungsdatenbus bidirektional. Bevorzugt umfassen die Steuervorrichtungen der elektronischen Sicherungen zwei Datenbusschnittstellen für den Sicherungsdatenbus, sodass neue Konstruktionen die elektronischen Sicherungen mittels dieser zwei Datenbusschnittstellen in den Sicherungsdatenbus einfügen können. Hierdurch bilden die elektronischen Sicherungen eine lineare Kette von elektronischen Sicherungen entlang des Sicherungsdatenbusses bilden können, sodass ein übergeordnetes Rechnersystem - beispielsweise ein Steuergerät -, das am Anfang des Sicherungsdatenbusses angeschlossen ist, mittels Autoadressierung die Sicherungsadressen als Busknotenadressen zur Ansteuerung der Rechnerkerne der Steuervorrichtungen der elektronischen Sicherungen an die Rechnerkerne der Steuervorrichtungen der elektronischen Sicherungen übermittelt.

Bevorzugt übertragen die Rechnerkerne der Steuervorrichtungen der elektronischen Sicherungen Parameter der angeschlossenen Versorgungsteilnetzwerke und/oder einzelner Konten der Versorgungsteilnetzwerke und/oder einzelner Versorgungsleitungsabschnitte des Versorgungsnetzwerks der Versorgungsleitungen des Fahrzeugs an andere Rechnerkerne der Steuervorrichtungen anderer elektronischer Sicherungen und/oder ein oder mehrere übergeordnete Rechnersysteme - z.B. Steuergeräte des Fahrzeugs. Ggf. können solche Parameter direkt zugängliche Parameter, wie Temperatur eines Temperatursensors, Spannung eines Knotens des Versorgungsnetzwerkes gegen ein Bezugspotenzial, oder der Stromwert eines elektrischen Stromes in einem Versorgungsleitungsabschnitt des Versorgungsnetzwerks sein. Auch kann ein Rechnerkern einer Steuervorrichtung einer elektronischen Sicherung durch Anwendung der Kirchhoffschen Gleichungen auf Daten, die der Rechnerkern der Steuervorrichtung der elektronischen Sicherung mittels Messvorrichtungen dieser elektronischen Sicherung ermittelt hat oder die der Rechnerkern der Steuervorrichtung dieser elektronischen Sicherung von den Rechnerkernen der Steuervorrichtungen anderer elektronischer Rechnungen oder von übergeordneten Rechnersystemen (z.B. Steuergeräten des Fahrzeugs) erhalten hat, abgeleitete Parameter, wie beispielsweise Leckströme gegen andere elektrische Knoten im Fahrzeug oder elektrische Widerstände von Versorgungsspannungsleitungsabschnitten erfassen.

Insbesondere kann der Rechnerkern einer Steuerungsvorrichtung einer elektronischen Sicherung die Temperatur eines nachfolgenden Versorgungsspannungsabschnitts schätzen, wenn dessen ohmscher Widerstand, dessen Wärmekapazität, thermischen Ableitwiderstände und die Umgebungstemperatur im Bereich des Versorgungsleitungsabschnitts näherungsweise, z.B. durch Schätzung, dem Rechnerkern bekannt sind. Dieses Vorgehen nutzt typischerweise aus, dass die in den Versorgungsleitungsabschnitt eingespeiste Energie im Wesentlichen dem zeitlichen Integral der eingespeisten elektrischen Leistung des Versorgungsleitungsabschnitts entspricht. Diese ist typischerweise proportional zum Quadrat des Strombetrags des elektrischen Stromes, der in den Versorgungsleitungsabschnitt hineinfließt.

Weitere Ideen die dieses Dokument vorstellt

Zubuchen der Stromversorgung

Eine erste Idee ist das Zubuchen der Stromversorgung bisher nicht versorgter Verbraucher elektrischer Energie im Versorgungsnetzwerk durch Nutzer. Dabei kauft der Nutzer z.B. über eine Datenverbindung mit dem Server eines Dienstanbieters einen Freischaltcode von einem Anbieter, der diesen Freischaltcode mit Hilfe von Authentifizierungsdaten nach einem feststehenden Verfahren erzeugt und/oder erzeugt hat und bereithält und an den Nutzer über einen Datenübertragungskanal übermittelt. Bevorzugt erfassen eine oder mehrere Rechnerkerne der Steuervorrichtungen einer oder mehrerer elektronischer Sicherungen dabei die Energie, die beispielsweise die Batterie eines Elektroautos in einen Versorgungsteilzweig des Versorgungsnetzwerkes einspeist. In diesem Modell ist die Batterie das Eigentum des Energieversorgers. Bevorzugt liest ein übergeordnetes Rechnersystem, beispielsweise ein Steuergerät des Fahrzeugs die ermittelte Energiemenge aus dem Rechnerkern und/oder einem Speicher der Steuervorrichtung der elektronischen Sicherung und/oder die zugrundeliegenden Messwerte aus und übermittelt über eine Datenübertragungsstrecke, die bevorzugt verschlüsselt ist, diese Daten an den Energieversorger oder einen Erfüllungsgehilfen, der auf Basis dieser Daten dann eine Rechnung erstellt. Es ist denkbar, dass das Versorgungsteilnetz auch Dienstleistungen weiterer Dienstanbieter ermöglicht, die ggf. auf ähnliche Weise ihre Rechnungsdaten ermitteln und dem Nutzer in Rechnung stellen.

Diagnosefähiger Ring

Bevorzugt sehen neue Konstruktionen ein in Teilen ringförmiges Versorgungsnetz vor, bei dem bevorzugt die Verbraucher an verschiedenen Stellen des ringförmigen Versorgungsnetzes elektrische Energie aus dem Versorgungsnetz entnehmen. Bevorzugt ist die Versorgungsleitung des ringförmigen Versorgungsnetzes links und rechts des Entnahmepunkts elektrischer Energie durch jeweils eine elektronische Sicherung, zumindest aber eine elektronische Sicherung unterbrochen, die mit ihrem jeweiligen Leistungsschalter in die Versorgungsleitung des Versorgungsleitungsabschnitts zwischen zwei Entnahmepunkten für elektrische Verbraucherenergie eingefügt ist. Tritt ein Fehler auf, so können diese Sicherungen zum Ersten den betroffenen Versorgungsleitungsabschnitt und/oder den betroffenen Verbraucher isolieren. Ein übergeordnetes Steuergerät kann den Status der elektronischen Sicherungen durch Ansprache der Rechnerkerne der Steuervorrichtungen der elektronischen Sicherungen ermitteln und damit die Ursache einer Störung eingrenzen ohne dass sich diese Störung auf weitere Verbraucher auswirken kann. Typischerweise erfolgt der Eingriff der Sicherungen so schnell, dass die Störung nur wenige Sensorwerte von Sensoren und/oder Messvorrichtungen, die an dem Versorgungsnetzwerk hängen, so beeinträchtigt, dass deren Werte unbrauchbar sind. Bevorzugt zeichnen die elektronischen Sicherungen die Störungen in Form einer Log-Tabelle, die auch nur wenige Bits umfassen kann, auf. Bevorzugt versehen die Steuereinrichtungen der elektronischen Sicherungen die Einträge der Log-Tabelle mit Zeitstempeln einer Zeitgebereinheit der Steuervorrichtung der elektronischen Sicherung. Dabei zeichnet die Steuervorrichtung der elektronischen Sicherung bevorzugt auch mit einem Zeitstempel auf, ab wann die Störung nicht mehr bestand. Bevorzugt fragt ein übergeordnetes Rechnersystem regelmäßig oder bei einer Störung diese Daten ab. Das übergeordnete Rechnersystem kann somit feststellen, wann welches Versorgungsteilnetz bzw. welche Versorgungsleitung wie gestört war und wie lange diese Störung bestand. Hierdurch kann das übergeordnete Rechnersystem potenziell betroffene Sensoren und Messsysteme identifizieren und die im relevanten Zeitraum von diesen akquirierten Messwerten als potenziell fehlerhaft markieren oder gleich verwerfen. Ein weiterer Vorteil einer Ringstruktur eines solchen Versorgungsnetzes mit elektronischen Sicherungen ist eine verbesserte Ausfallsicherheit durch Redundanz. Es kommt daher besonders für sicherheitsrelevante Anwendungen in Frage.

Satelliten mit Stromzähler

Wie bereits erläutert ist es in vielen Fällen sinnvoll, wenn einzelne Verbraucher mit einem Wattmeter oder dergleichen ausgestattet sind. Hierzu erfasst eine elektronische Sicherung mittels eines Voltmeters die Spannung eines Knotens am Leistungsschalter der elektronischen Sicherung oder eines damit in Zusammenhang stehenden Knotens und bevorzugt den Strom durch den Leistungsschalter der elektronischen Sicherung und ermittelt dadurch die in den Verbraucher oder einen nachfolgenden Versorgungsbaum oder einen nachfolgenden Versorgungsleitungsabschnitt fließenden elektrischen Strom. Der Rechnerkern der Steuervorrichtung der elektronischen Sicherung übermittelt diese Daten bevorzugt über einen Datenbus an den Rechnerkern der Steuervorrichtung einer anderen elektronischen Sicherung oder den ein übergeordnetes Rechnersystem.

Freischalten einzelner Verbraucher

Es ist denkbar, die elektrische Versorgung einzelner Verbraucher im Versorgungsnetzwerk eines Fahrzeugs mittels Freischaltcodes wie oben beschrieben, freizuschalten. Hierbei übermittelt ein Server des Automobilherstellers oder eines Dienstanbieters aufgrund von Authentifizierungsdaten, die Daten des Fahrzeugs, des Autoschlüssels, einer SIM-Karte, einer Passworteingabe, biometrische Nutzerdaten etc. umfassen können, an das Fahrzeug oder den Nutzer, der diese Daten dann im Fahrzeug über ein Terminal oder eine Datenschnittstelle auf das Fahrzeug überträgt. Je nach Freischaltcode überträgt dann ein übergeordnetes Rechnersystem des Fahrzeugs Befehle zum Schließen der Leistungsschalter an ausgewählte elektronische Sicherungen des Versorgungsnetzwerks, wodurch das Versorgungsnetzwerk dann freischaltcode-spezifische Versorgungsteilnetzwerke mit elektrischer Energie versorgt.

Übermittlung der Energienutzungsdaten an Strom-Provider und/oder Automobilhersteller

Wie oben beschrieben, kann ein übergeordnetes Rechnersystem des Fahrzeugs die so ermittelten Nutzungs- und Konfigurationsdaten des Systems aus elektronischen Sicherungen und Versorgungsteilnetzen und Versorgungsleitungsabschnitten als Übermittlung von Energienutzungsdaten an Strom-Provider und/oder Automobilhersteller und/oder andere Serviceanbieter übermitteln.

Erkennen eines Hot-Plug-Ereignisses

Bevorzugt ist eine elektronische Sicherung in der Nähe eines Steckers zur Versorgung eines elektrischen Verbrauchers im Fahrzeug mit elektrischer Energie platziert. Ein Problem kann nun entstehen, wenn Nutzer und/oder Werkstätten etc. vor dem Entfernen des Geräts dieses Gerät nicht, wie vorgeschrieben, vor dem Steck- oder Trennvorgang stromlos und/oder spannungslos schalten. Ein solches Ereignis bezeichnet dieses Dokument im Folgenden als Hot-Plug-Ereignis. Dieses Stromlos- bzw. Spannungslosschalten erfolgt bevorzugt mittels eines Software-Befehls über einen Datenbus von einem Steuergerät, also einem übergeordneten Rechnersystem, an einen Rechnerkern einer Steuervorrichtung einer elektronischen Sicherung, die daraufhin ihren Leistungsschalter öffnet. Ist dies nicht zuvor erfolgt und löst eine Fehlbedienung trotzdem ein Hot-Plug-Ereignis aus, so kann die Steuerschaltung der zugehörigen elektronischen Sicherung durch Überwachung des transienten Zeitverlaufs der Spannung des Potenzials eines Knotens des Leistungsschalters gegen das Potenzial eines Bezugsknotens und/oder durch Beobachtung des transienten Verlaufs des Stromes durch den Leistungsschalter ein solches Hot-Plug-Ereignis erfassen und den Leistungsschalter so schnell ausschalten, sodass diese Schnellabschaltung eine Plasmabildung minimiert. Außerdem kann die elektronische Sicherung ein solches Ereignis an das zugehörige Steuergerät, beispielsweise ein übergeordnetes Rechnersystem, über eine Datenleitung melden. Das übergeordnete Rechnersystem kann dieses Ereignis ggf. weitermelden, sodass es zum Ersten ggf. in einem Terminal (z.B. mittels einer Mensch-Maschine-Schnittstelle) angezeigt wird oder dem Automobilhersteller über eine Datenübertragungsstrecke übermittelt wird.

Verteilte Messverfahren

Es wurde erkannt, dass es sinnvoll ist, dass die Steuervorrichtung einer elektronischen Sicherung die oben genannten Messwerte mit anderen Steuervorrichtungen anderer elektronischer Sicherungen über einen Datenbus austauscht. Dabei kann die Steuervorrichtung in der Regel nicht sicherstellen, dass die Datenübermittlung sehr schnell erfolgt. Daher ist es sinnvoll, wenn die Steuervorrichtung der Sicherung außer den Messwerten jeweils auch ein Zeitstempel für einen oder mehrere Messwerte mitgesendet. Bevorzugt verfügen die elektronischen Sicherungen hierfür über eine Uhr oder einen Zeitgeber. Bevorzugt ermittelt ein übergeordnetes Rechnersystem einmalig Korrekturfaktoren für die Korrektur der Zeitstempelwerte der nicht synchronlaufenden Uhren der verschiedenen Steuervorrichtungen der verschiedenen elektronischen Sicherungen. Eine andere Methode ist die wiederkehrende Synchronisation dieser Uhren und/oder Zeitgeber. Die Synchronisation kann zum Ersten ein Rücksetzen auf einen gemeinsamen Startwert umfassen. Die Synchronisation kann zum anderen die Korrektur der Frequenzen der Oszillatoren und/oder Takte umfassen, die der Synchronisationsvorgang beispielsweise über die Einstellung der Teiler einer Basisfrequenz einstellen kann. Ein übergeordnetes Rechnersystem kann beispielsweise mittels eines Datenbusbefehls im Broadcasting-Modus in dem Fall die verschiedenen Steuervorrichtungen der verschiedenen elektronischen Sicherungen dazu veranlassen, zu gleichen Zeitpunkten bevorzugt gleiche Messungen auszuführen, wobei gleich sich hierbei auf die Gleichheit der Uhrenstände der jeweiligen Uhren der verschiedenen Steuervorrichtungen der verschiedenen elektronischen Sicherungen bezieht. Es handelt sich somit dann um ein verteiltes Messverfahren mit synchroner Messung mittels synchronisierten lokalen Uhren innerhalb der Steuervorrichtungen der verschiedenen elektronischen Sicherungen. Dies ermöglicht die im Wesentlichen zeitsynchrone Messung ohmscher Widerstände von Versorgungsleitungsabschnitten.

Kopplung Kommunikationsnetzwerk und Versorgungsnetzwerk

Es ist zweckmäßig ein Kommunikationsnetzwerk mit einem Versorgungsnetzwerk zu koppeln. Hier wird auf den oben beschriebenen Sicherungsdatenbus verwiesen.

Dynamische Zuordnung von Stromwegen

Bei der Ausarbeitung wurde erkannt, dass bei Redundanz die dynamische Zuweisung von Energie und Energietransportwergen innerhalb eines Fahrzeugs sinnvoll sein kann. Hierzu ermittelt ein übergeordnetes Rechnersystem des Fahrzeugs die Energiebedarfe, der potenziellen Energieverbraucher des Fahrzeugs. Bevorzugt sind die Versorgungsleitungen als Versorgungsnetz ausgeführt, wobei zwei oder mehrere Versorgungsleitungen zumindest streckenweise parallelgeführt sind und oder sich an zumindest zwei Punkten im Fahrzeug kreuzen. Beispielhaft studieren wir nun die Kreuzung einer ersten Versorgungsleitung mit einer zweiten Versorgungsleitung. Bevorzugt umfasst das Versorgungsnetz an diesen Kreuzungspunkten jeweils zwei elektrische Knoten. Das hier vorgelegte Dokument bezeichnet zur besseren Klarheit diese zwei elektrischen Konten am Kreuzungspunkt als ersten Knoten des ersten Kreuzungspunkts und zweiten Knoten des Kreuzungspunkts. Der Kreuzungspunkt teilt die erste Versorgungsleitung in einen energiequellenseitigen ersten Teil der ersten Versorgungsleitung und einen verbraucherseitigen Teil der ersten Versorgungsleitung. Der Kreuzungspunkt teilt die zweite Versorgungsleitung in einen energiequellenseitigen ersten Teil der zweiten Versorgungsleitung und einen verbraucherseitigen Teil der zweiten Versorgungsleitung.

Im Folgenden beschreiben wir nun eine elektronische Kreuzungssicherung, die vier elektronische Sicherungen umfasst. In dem nun folgenden Beispiel sind die elektronischen Sicherungen der elektronischen Kreuzungssicherung energiequellenseitig ausgeführt. Es ist ebenso denkbar, die elektronischen Sicherungen umgekehrt verbraucherseitig auszuführen. Die Konstruktionen können verbraucherseitige und energiequellenseitige elektronische Sicherungen vorsehen.

- Eine erste elektronische Sicherung verbindet oder trennt je nach Schaltzustand des Leistungsschalters der ersten elektronischen Sicherung den energiequellenseitigen ersten Teil der ersten Versorgungsleitung mit dem ersten Knoten.
- Eine zweite elektronische Sicherung verbindet oder trennt je nach Schaltzustand des Leistungsschalters der zweiten elektronischen Sicherung den energiequellenseitigen ersten Teil der zweiten Versorgungsleitung mit dem ersten Knoten.
- Der Leistungsschalter der ersten Sicherung ist bevorzugt nur dann geschlossen, wenn der Leistungsschalter der zweiten Sicherung geöffnet ist. Der Leistungsschalter der zweiten Sicherung ist bevorzugt nur dann geschlossen, wenn der Leistungsschalter der ersten Sicherung geöffnet ist.
- Eine dritte elektronische Sicherung verbindet oder trennt je nach Schaltzustand des Leistungsschalters der dritten elektronischen Sicherung den energiequellenseitigen ersten Teil der ersten Versorgungsleitung mit dem zweiten Knoten.
- Eine vierte elektronische Sicherung verbindet oder trennt je nach Schaltzustand des Leistungsschalters der vierten elektronischen Sicherung den energiequellenseitigen ersten Teil der zweiten Versorgungsleitung mit dem zweiten Knoten.
- Der Leistungsschalter der dritten Sicherung ist bevorzugt nur dann geschlossen, wenn der Leistungsschalter der vierten Sicherung geöffnet ist. Der Leistungsschalter der vierten Sicherung ist bevorzugt nur dann geschlossen, wenn der Leistungsschalter der dritten Sicherung geöffnet ist.
- Der verbraucherseitige Teil der ersten Versorgungsleitung ist mit dem ersten Knoten verbunden.
- Der verbraucherseitige Teil der zweiten Versorgungsleitung ist mit dem zweiten Knoten verbunden.

Eine alternative Ausführung der Kreuzungssicherung führt die elektronischen Sicherungen verbraucherseitig aus:

- Eine erste elektronische Sicherung verbindet oder trennt je nach Schaltzustand des Leistungsschalters der ersten elektronischen Sicherung den verbraucherseitigen ersten Teil der ersten Versorgungsleitung mit dem ersten Knoten.
- Eine zweite elektronische Sicherung verbindet oder trennt je nach Schaltzustand des Leistungsschalters der zweiten elektronischen Sicherung den verbraucherseitigen ersten Teil der zweiten Versorgungsleitung mit dem ersten Knoten.

- Der Leistungsschalter der ersten Sicherung ist bevorzugt nur dann geschlossen, wenn der Leistungsschalter der zweiten Sicherung geöffnet ist. Der Leistungsschalter der zweiten Sicherung ist bevorzugt nur dann geschlossen, wenn der Leistungsschalter der ersten Sicherung geöffnet ist.
- Eine dritte elektronische Sicherung verbindet oder trennt je nach Schaltzustand des Leistungsschalters der dritten elektronischen Sicherung den verbraucherseitigen ersten Teil der ersten Versorgungsleitung mit dem zweiten Knoten.
- Eine vierte elektronische Sicherung verbindet oder trennt je nach Schaltzustand des Leistungsschalters der vierten elektronischen Sicherung den verbraucherseitigen ersten Teil der zweiten Versorgungsleitung mit dem zweiten Knoten.
- Der Leistungsschalter der dritten Sicherung ist bevorzugt nur dann geschlossen, wenn der Leistungsschalter der vierten Sicherung geöffnet ist. Der Leistungsschalter der vierten Sicherung ist bevorzugt nur dann geschlossen, wenn der Leistungsschalter der dritten Sicherung geöffnet ist.
- Der energiequellenseitige Teil der ersten Versorgungsleitung ist mit dem ersten Knoten verbunden.
- Der energiequellenseitige Teil der zweiten Versorgungsleitung ist mit dem zweiten Knoten verbunden.

Diese Kreuzungssicherungen können je nach ermitteltem Energiebedarf alternative und redundante Stromwege bestimmten Verbrauchern dynamisch zuordnen. Hierzu übermittelt ein Steuergerät des Fahrzeugs den elektronischen Sicherungen der Kreuzungssicherungen des Versorgungsnetzwerks geeignete Konfigurationsbefehle, die das Öffnen und Schließen von Leistungsschaltern der elektronischen Sicherungen bewirken und so die elektrisch wirksame Topologie des Versorgungsnetzes der Versorgungsleitungen dynamisch entsprechend dem Leistungsbedarf und entsprechend den aktuellen Sicherheitsanforderungen anpassen.

Abschalten von Teilbereichen des Versorgungsnetzes innerhalb eines Fahrzeugs

Eine weitere Idee ist das Abschalten von Teilbereichen des Netzes für Wartung und sicheren Zugriff. Hierfür gibt die Person, die eine Wartung durchführen will, einen vorbestimmten Sicherheitscode in ein übergeordnetes Rechnersystem mittels eines Terminals oder einer anderen Mensch-Maschine-Schnittstelle (HMI) ein. Ggf. erhält die Person diesen Sicherheitscode von einem Server des Automobilherstellers oder eines Dienstleistungsanbieters. Hierzu übermittelt die Person dem Server Authentifizierungsdaten, die beispielsweise Authentifizierungsdaten der Person, der Organisation für die die Person tätig ist, oder Authentifizierungsdaten des Fahrzeugs oder Autoschlüssels oder der gleichen umfasst. Ein Steuergerät schaltet dann mit Hilfe elektronischer Sicherungen Teile des Versorgungsnetzes stromlos. Bevorzugt ist in jedem so isolierbaren Teilversorgungsnetz zumindest eine elektronische Sicherung vorgesehen, die das dann durch das Öffnen der Leistungsschalter der abtrennenden elektronischen Sicherungen isolierte Teilversorgungsnetz durch Schließen des Leistungsschalters dieser einen Sicherung mit einer Bezugsspannungsleitung, beispielsweise Masse kurzschließt und so entlädt.

Abhängigkeit der Leistung der Satelliten in Abhängigkeit von der versorgenden Leitung

Oben wurde die Rekonfiguration der Netztopologie beispielsweise mittels unterschiedlich konfigurierbarer Knotensicherungen beschrieben. Für einen Systemnotlauf ist es nun sinnvoll, wenn die Stromaufnahme eines betreffenden Verbrauchers an die schwächste Versorgungsleitung im Pfad zwischen Energiequelle und dem betreffenden Verbraucher angepasst wird. Dazu signalisiert das übergeordnete Rechnersystem, dass die Rekonfiguration des Versorgungsnetzes durch entsprechende Befehle über einen oder mehrere Datenbusse an die elektronischen Sicherungen initiiert hat dem betreffenden Verbraucher, wieviel Energie dieser Verbraucher aufnehmen darf, um diese schwächste Leitung nicht zu überlassen. Im einfachsten Fall kann der Verbraucher zwei Zustände aufweisen. Einen Zustand, in dem er mehr Energie aufnimmt und einen Zustand, in dem er weniger Energie aufnimmt.

Netzwerk mit verringertem Querschnitt des Kabelbaums

Vorschlagsgemäß können die verbesserten Konstruktionen aufgrund der vorgenommenen Optimierungen Versorgungsleitungen des Versorgungsnetzwerks mit einem geringeren Querschnitt vorsehen, als dies normalerweise ohne elektronische Sicherungen möglich wäre.

Schnellabschaltung

Eine wesentliche Idee ist die Schnellabschaltung eines Leistungsschalters einer elektronischen Sicherung bei Überschreitung eines maximal zulässigen Stromes durch den Leistungsschalter. Wird dieser maximal zulässige Strom durch den Leistungsschalter einer elektronischen Sicherung nicht überschritten, so erfolgt bevorzugt die Abschaltung des Leistungsschalters erst nach einiger Zeit, wobei diese Zeit in der Regel parabelförmig fallend von der Höhe des Stromes durch den Leistungsschalter abhängt. Bevorzugt emuliert die Steuervorrichtung der elektronischen Sicherung das Verhalten einer Schmelzsicherung. Dazu erfasst die Steuervorrichtung der elektronischen Sicherung den Stromwert des elektrischen Stromes durch den Leistungsschalter. Bevorzugt quadriert die Steuervorrichtung den Wert des elektrischen Stromes durch den Leistungsschalter und integriert diesen Wert über die Zeit. In der Regel ist die Integration eine Tiefpassfilterung oder dergleichen. Sofern der Filterausgangswert einen Schwellwert überschreitet, öffnet die Steuervorrichtung den Leistungsschalter der elektronischen Sicherung. Es handelt sich hier also um eine elektronische Sicherung mit Emulation einer Schmelzsicherungs-Charakteristik.

Sicherung mit Verhinderung des rückwärtsfließenden Stroms.

Bevorzugt verhindert die elektronische Sicherung den Rückfluss elektrischer Energie vom Verbraucher weg zur Energiequelle. Hierzu erfasst die elektronische Sicherung bevorzugt die Richtung des fließenden elektrischen Stromes. Fließt der Strom nicht zum Verbraucher, sondern in Richtung Energiequelle, so öffnet bevorzugt die elektronische Sicherung den Leistungsschalter, wodurch dieser Stromfluss unterbunden wird. Es ist denkbar, dass die Steuervorrichtung in einem solchen Fall einen dritten Leistungsschalter der elektronischen Sicherung schließt, der im Normalbetrieb ansonsten geöffnet ist. Bevorzugt schließ der dann geschlossene dritte Leistungsschalter dann die verbraucherseitige Versorgungsleitung durch das Schließen des dritten Leistungsschalters beispielsweise mit der Bezugspotenzialleitung, also der Masse kurz, wodurch der zurückfließende Strom nun in der Systemmasse vernichtet wird.

Verwendung von Silizium LEDs

Bevorzugt umfasst die elektronische Sicherung eine oder mehrere Silizium LEDS. Bevorzugt sind die Silizium LEDs Teil einer optischen Datenschnittstelle des Rechnerkerns der Steuervorrichtung der elektronischen Sicherung. Bevorzugt finden diese Silizium-LEDs auch als Fotodetektoren der optischen Datenschnittstelle Verwendung. Der Einsatz solcher Silizium-LEDs ist besonders vorteilhaft für den Einsatz von elektronischen Sicherungen in Batterien.
Bevorzugt weisen die Gehäuse der elektronischen Sicherungen in diesem Fall optische Fenster auf, damit das Licht der Silizium-LEDs austreten kann.

Elektronische Sicherung mit Authentifizierung

Bevorzugt verfügt die elektronische Sicherung über Mittel zur Verifikation der Zulässigkeit eines Kommandos, das die Steuervorrichtung der elektronischen Sicherung über einen Datenbus erhalten hat. Beispielsweise kann es sich um Methoden der Verschlüsselung und Entschlüsselung handeln, die eine sichere Kommunikation zwischen einem übergeordneten Rechnersystem und der Steuervorrichtung einer elektronischen Sicherung absichert. Es handelt sich also um eine elektronische Sicherung mit Authentifikation für moderne Geschäftsmodelle wie die Zuschaltung von Komponenten per Software gegen Bezahlung.

Plausibilisierung der Konfiguration zur Identifikation

Ein weiterer erkannter Punkt ist die Plausibilisierung der Konfiguration zur Identifikation von Manipulationen an dem Versorgungsnetzwerk. Die elektrischen Ströme innerhalb des Versorgungsnetzwerks auf den Versorgungsleitungen liegen je nach Aufgabe in mehr oder weniger bekannten bzw. vorberechenbaren Bereichen. Verlässt der Stromwert einer Versorgungsleitung nun den erwarteten Wertebereich, so liegt entweder ein Fehler oder eine Manipulation vor.

Detektion der Schaltbarkeit der elektronischen Sicherung

Bevorzugt umfasst eine elektronische Sicherung auch Mittel zur Detektion der Schaltbarkeit der elektronischen Sicherung. Hierbei kann es sich beispielsweise um die Einspeisung eines Teststromes in einen ersten Anschluss des Leistungsschalters aus einem zweiten Anschluss des Leistungsschalters handeln. Kann die Steuervorrichtung der elektronischen Sicherung diesen elektrischen Strom aus dem anderen Anschluss des Leistungsschalters nicht entnehmen, so ist der Leistungsschalter nicht geöffnet oder nicht vorhanden. Bevorzugt ändert die Steuervorrichtung der elektronischen Sicherung ein oder mehrmals den Schaltzustand des Leistungsschalters. Die Stromleitfähigkeit des Leistungsschalters, die die Steuervorrichtung der elektronischen Sicherung jeweils ermittelt sollte mit dem erwarteten Schaltzustand des Leistungsschalters korrelieren.
Ist keine Schaltbarkeit gegeben, so signalisiert die Steuervorrichtung der elektronischen Sicherung bevorzugt einem übergeordneten Rechnersystem des Fahrzeugs einen Fehler.

Selbstkonfigurierende Sicherung mit Autoadressierung

Bevorzugt sind die elektronischen Sicherungen in einen linear wie eine Perlenkette angeordneten Datenbus eingefügt. Hierdurch haben die elektronischen Sicherungen bezogen auf diesen linearen Datenbus eine eindeutige und vom übergeordneten Rechnersystem, das den Datenbus treibt, aus durchzählbare physikalische Busposition. Mittels eines Autoadressierungsverfahrens kann das übergeordnete Rechnersystem nun jeder elektronischen Sicherung eine Sicherungsadresse zuordnen, sodass das übergeordnete Rechnersystem diese Sicherung jeweils eineindeutig ansprechen kann. Damit können die elektronischen Sicherungen nun erkennen, an welcher Stelle sie sich im Datenbus physikalisch befinden. Bevorzugt ist den elektronischen Sicherungen für jede denkbare physikalische Datenbusposition innerhalb des Fahrzeugs eine Konfiguration an Schwellwerten und Abschaltschwellen vorgegeben. Durch die Kenntnis der physikalischen Datenbusposition können sich diese elektronischen Sicherungen nun entsprechend ihrer Datenbusposition unter Zuhilfenahme der besagten werksseitigen Daten konfigurieren. Es handelt sich somit um selbstkonfigurierende elektronische Sicherungen mit einer Autoadressierung, bei der die Konfiguration der elektronischen Sicherung von der erkannten physikalischen Datenbusposition abhängt.

Elektronische Sicherung mit KI

Erfindungsgemäß wurde erkannt, dass die Vielzahl an Werten, die die elektronischen Sicherungen erfassen, die Auswertung durch einen Rechnerkern der Steuervorrichtung einer elektronischen Sicherung oder einen Rechner eines übergeordneten Rechnersystems ermöglichen. Hierzu verwendet die auswertende Einheit die Werte die eine oder mehrere Steuervorrichtungen einer oder mehrerer elektronsicher Sicherungen mittels entsprechender Messmittel ermittelt als Eingangswerte eines neuronalen Netzwerkmodells, das der Rechner der auswertenden Einheit ausführt. Bevorzugt ist das neuronale Netzwerkmodell mit geeigneten Trainingsdaten aus der Entwicklungszeit trainiert. Beispielsweise kann es sinnvoll, sein, auf diesem Wege einen Ausfall eines oder mehrerer Verbraucher oder andere Defekte des Systems zu erkennen, bevor diese sich tatsächlich ausprägen.

Powerline-Kommunikation über eine elektronische Sicherung (E-Fuse)

Eine weitere Idee ist die Kommunikation über die Datenleitung, wobei der Leistungsschalter der elektronischen Sicherung als Sendetransistor dient. Es handelt sich also um eine Powerline-Kommunikation über die elektronische Sicherung (E-Fuse).

Spektralanalyse für den Last-Strom einer elektronischen Sicherung (E-Fuse) für vorausschauende Wartung (Predictive-Maintenance)

Eine weitere Idee ist die Erfassung des zeitlichen Verlaufs des elektrischen Stroms durch den Leistungsschalter einer elektronischen Sicherung und ggf. des zeitlichen Verlaufs der Spannung zwischen einem Anschluss des Leistungsschalters und einem Bezugspotenzial. Bevorzugt führt eine Vorrichtung eine Spektralanalyse dieser Daten der elektronischen Sicherung durch. Bei wesentlichen Abweichungen von Erwartungswerten kann die auswertende Vorrichtungen Rückschlüsse ziehen, die u.a. der Nutzer und/oder Werkstätten für eine präventive Wartung des Fahrzeugs nutzen können.

Systemverfügbarkeit über das Spektrum an der elektronischen Sicherung (E-Fuse) prüfen, erwartete Charakteristik (positiv Prüfung)

In analoger Weise kann mittels der ermittelten Spektren die auswertende Vorrichtung die Systemverfügbarkeit über das Spektrum an der elektronischen Sicherung prüfen. Stimmt die Charakteristik der Spektren mit den Erwartungswerten innerhalb erlaubter Bandbreiten überein, so ist der betreffende Verbraucher wahrscheinlich verfügbar. Es handelt sich somit um eine Positivprüfung.

Reduktion des Inrush-Currents

Eine weitere Idee ist es, bei einem Systemstart, die Leistungsschalter der elektronischen Sicherungen nicht gleichzeitig, sondern zeitversetzt zu schließen. Dies hat zur Folge, dass die an den jeweiligen elektronischen Sicherungen angeschlossenen elektrischen Vorrichtungen nicht gleichzeitig starten. Hierdurch reduziert sich der sogenannte Inrush-Currents durch die Verschiebung und De-synchronisierung der Einschaltkurven der Versorgungsteilnetze.

Begrenzung der Spannungseinbrüche

Bevorzugt vermessen die elektronischen Sicherungen nicht nur den elektrischen Strom durch deren Leistungsschalter, sondern auch die Spannung an einem Anschluss des Leistungsschalters gegen ein Bezugspotenzial. Besonders gefährlich ist beispielsweise ein Spannungseinbruch durch einen Kurzschluss in einem Versorgungsteilnetz. Bevorzugt schaltet daher eine elektronische Sicherung bei einem Spannungsabfall in den gemessenen Spannungswerten und einem gleichzeitigen Stromanstieg besonders schnell ab. Dies vermeidet Störungen von Sensoren des Fahrzeugs. Eine solche elektronische Sicherung ist somit eine Vorrichtung zur Begrenzung des Spannungsabfalls bei Störfällen im Spannungssystem des Einzelnetzwerks. Die elektronische Sicherung schaltet bevorzugt so schnell ab, dass die Spannung nicht zu weit abfällt und somit ein solches Ereignis andere Systeme nicht oder nur wenig stört. Bevorzugt schaltet eine elektronische Sicherung unter solchen Abschaltbedingungen schneller als innerhalb $1\mu s$ den Leistungs-schalter aus und öffnet diesen damit. Auch kann die Abschaltung von der zeitlichen Ableitung der Spannungsänderung abhängen (dU/dt-Empfindlichkeit.)

Unfallsicherung

Bevorzugt schaltet das übergeordnete Rechnersystem mittels elektronsicher Sicherungen nicht benötigte oder gefährliche Versorgungsteilnetze mittels entsprechender Befehle an elektronische Sicherungen über den Datenbus ab, wenn ein übergeordnetes Rechnersystem des Fahrzeugs zu dem Schluss gekommen ist, dass ein Unfall des Fahrzeugs wahrscheinlich ist. Es handelt sich also um die Abschaltung von Systemen des Fahrzeugs mittels einer oder mehrerer elektronischen Sicherungen vor einem prognostizierten Unfall, wobei die ermittelte Wahrscheinlichkeit für einen solchen Unfall über einem Schwellwert liegen sollte.

Erwartung eines hohen Stromverbrauches

In analoger Weise kann ein übergeordnetes Rechnersystem, beispielsweise ein Steuergerät, über einen Datenbus ein oder mehrere Leistungsschalter ein oder mehrerer elektronischer Sicherungen ein oder mehrerer Teilbäume des Versorgungsnetzwerks öffnen, wenn aus welchen Gründen auch immer dieses übergeordnete Rechnersystem eine erhöhte Stromaufnahme einer anderen Vorrichtung erwartet. Hierdurch entfallen die abgeschalteten elektrischen Verbraucher und deren nun ungenutzte Energiemarge am gesamt Energie-Budget steht dann dieser anderen Vorrichtung mit erwarteter erhöhter Stromaufnahme zur Verfügung. Es handelt sich also um eine präventive Abschaltung von elektrischen Verbrauchern, wenn ein hoher Stromverbrauch der anderen Vorrichtung erwartet wird.

Abschaltung von Systemen nach Spannungspegel

Die hier vorgelegte Schrift schlägt vor, dass die elektronischen Sicherungen die Spannung zwischen einem ersten Anschluss des Leistungsschalters, der bevorzugt energiequellenseitig liegt, und einem Bezugspotenzial mittels geeigneter Messmittel erfassen. Da bei der Konstruktion des Fahrzeugs in der Regel bereits bekannt ist, welche Verbraucher mit welcher Funktion und welcher Wichtigkeit dieser Funktion das Versorgungsnetzwerk über welche Versorgungsleitung welcher elektronischen Sicherung mit elektrischer Energie versorgt, ist es Sinnvoll, dass die Steuervorrichtungen der elektronischen Sicherungen die gemessenen Spannungswerte mit vorgegebenen Schwellwerten vergleichen und bei Unterschreitung dieser Schwellwerte den Leistungsschalter der elektronischen Sicherung öffnen. Hierdurch kommt es zu einer Abschaltung von elektrischen Verbrauchern des Fahrzeugs je nach Spannungspegel. Bevorzugt betreibt dann das Fahrzeug bei sehr niedrigen Spannungspegeln nur noch die notwendigsten Systeme. Hierdurch kann das Fahrzeug die Mindestfunktionalitäten bis zur letzten Sekunde, in der noch ein Minimum an Energie vorhanden ist, bereitstellen.

Begrenzung des Spannungseinbruchs

Eine wichtige Anforderung ist die Begrenzung eines Spannungseinbruchs. Dies geschieht durch die Schnelligkeit des Abschaltvorgangs des Leistungsschalters der elektronischen Sicherung. Bei einer elektronischen Sicherung mit einer Spannungsauslösung erfolgt diese Abschaltung im Bereich von $\mu s$.

Sicherungsdatenbus in Elektroautos

In Elektroautos verwenden heute typischerweise Versorgungsnetze mit Spannungen kleiner 50V (NV-Netze) und Versorgungsnetze mit Spannungen größer 50V (HV-Netze). Ein Problem entsteht nun dadurch, dass die elektronischen Sicherungen über die Domain-Grenzen der NV-Netze und der HV-Netze hinweg über Datenbusse kommunizieren können sollten. Sofern keine optische Datenbusse Verwendung finden, ist es sinnvoll an der Domain-Grenze zwischen einem HV-Versorgungsnetz und einen NV-Versorgungsnetz einen Datenbus mit einer galvanischen Trennung beispielsweise durch Übertrager vorzusehen. Es handelt sich dann um einen Sicherungs-Datenbus mit Potenzialtrennung zwischen NV-Netz und HV-Netz.

Kaskadierung

Besonders vorteilhaft ist die Kaskadierung von elektronischen Sicherungen. Diese Kaskadierung ermöglicht beispielsweise die Aufteilung einer Versorgungsleitung in unterschiedliche Teilversorgungsleitungen. Bevorzugt sind die wichtigeren Verbraucher in dem näher zur Energiequelle liegenden Teil der Versorgungsleitung angeordnet, während die weniger wichtigen Verbraucher in dem weiter von der Energiequelle liegenden Teil angeordnet sind. Fällt nun einer der weniger wichtigen Verbraucher aus und stört die Energieverteilung über die Versorgungsleitung, so kann eine in die Versorgungsleitung eingefügte elektronische Sicherung diesen schafhaften Teil der Versorgungsleitung abtrennen und damit die anderen Vorrichtungen weiter betriebsfähig halten. Eine Anzahl von mehr als einer elektronischen Sicherung kann die Anzahl der unnötig abgeworfenen Verbraucher verringern. Die hier vorgelegte Schrift offenbart somit die Verkettung von mindestens zwei oder mehr elektronischen Sicherungen. Der Vorteil ist dabei, dass neue Konstruktionen in verschiedenen Abschnitten einer Versorgungsleitung dünnere Leitungen als Versorgungsleitungen vorsehen können. Damit können die notwendigen Abschaltzeiten der elektronischen Sicherungen je nach Position der elektronischen Sicherung unterschiedlich sein. Ist der Abstand zur Energiequelle weiter, so sollte die entsprechende elektronische Sicherung schneller abschalten. Bevorzugt erfolgt also eine Anpassung an die Abschaltcharakteristik der jeweiligen elektronischen Sicherung an die Position dieser elektronischen Sicherung im Versorgungsnetzwerk.

Elektronische Sicherung mit Zeitgeber oder Zähler

Bevorzugt umfasst die elektronische Sicherung einen Zeitgeber oder Zähler, der beispielsweise die Synchronisation von Messungen, wie oben beschrieben ermöglicht. Des Weiteren umfasst die elektronische Sicherung bevorzugt auch Elemente zur Entprellung der elektronischen Sicherung.

Kirchhoffsche Gleichungen

Bevorzugt ermitteln verschiedene elektronische Sicherungen an verschiedenen Stellen im Versorgungsnetz beispielsweise für Strom und/oder Spannung, wie oben beschrieben. Bevorzugt versehen die Steuervorrichtungen diese Messwerte mit einem Zeitstempel basierend auf dem Zählerstandswert eines internen Zählers oder einer internen Uhr. Alternativ ist die Synchronisation dieser Uhren möglich und ein übergeordnetes Rechnersystem gibt den Steuervorrichtungen der elektronischen Sicherungen vor, wann die Messungen zu erfolgen haben. Mit solchen Daten lassen sich beispielsweise geringe Leckströme von Versorgungsleitungen zu anderen elektrischen Knoten des Fahrzeugs erfassen.

Elektronische Sicherungen ohne Rechnerkern

Es ist denkbar, dass nicht alle Steuervorrichtungen aller elektronischer Sicherungen einen Rechnerkern aufweisen. D.h. in der Regel steuert dann der Rechnerkern einer anderen elektronischen Sicherung die Steuervorrichtung eine solchen abgespeckten elektronischen Sicherung ohne Rechnerkern. Da die Kommunikation zwischen dem Rechnerkern der steuernden elektronischen Sicherung und der Steuervorrichtung der elektronischen Sicherung ohne Rechnerkern verlorengehen kann, verfügt diese abgespeckte Version einer elektronischen Sicherung ohne Rechnerkern bevorzugt über Fail-Safe Eigenschaften, die dieser elektronischen Sicherung erlauben, eine zumindest grundlegende Absicherung der angeschlossenen Versorgungsleitung sicherzustellen.

Funktionalitätssignalisierung (Alive Signalisierung)

Wie bereits erwähnt ist es sinnvoll, wenn die elektronischen Sicherungen über einen ggf. vorhandenen Sicherungsdatenbus ein Signal an eine Steuervorrichtung senden, das signalisiert, dass a) die entsprechende elektronische Sicherung noch vorhanden und b) betriebsbereit ist. Es handelt sich um eine sogenannte Alive-Signalisierung auf dem Sicherungsdatenbus.
Es ist vorteilhaft, wenn der Sicherungsdatenbus differenziell ausgeführt ist. Dies führt zu einer vergrößerten Robustheit gegen einen Masseversatz. Außerdem ist eine Verpolfestigkeit sinnvoll, um eine Robustheit gegen negative Spannung an den Ein- und Ausgängen der Steuervorrichtung sicherzustellen. Beispielhafte Datenbusse mit einer solchen Common-Mode Festigkeit wären der PSI5 Datenbus und der LVDS-Datenbus.
**Bevorzugt** weist der Sicherungsdatenbus eine sogenannte Collision-Detection (Buskollisionserkennung) auf, um Buskollisionen zu detektieren. Auch kann das Datenbusprotokoll für den Betrieb des Datenbusses ein Zeitscheibenverfahren für die Bus-Arbitrierung verwenden.

## Schmelzsicherungssimulation

Besonders sinnvoll ist die Simulation einer Schmelzsicherung durch die elektronische Sicherung. Diese Simulation basiert bevorzugt auf einer Temperatur Energie Simulation.

In dem Beispiel der obigen Figur erfasst ein Eingangsverstärker den Spannungsabfall über einen Shunt-Widerstand, der den Strom durch die Versorgungsleitung in eine Messspannung wandelt. Ein nachfolgender Analog-zu-Digitalwandler wandelt diesen Wert in ein digitales Signal um Dieser Wert wird dann quadriert und dann integriert. Ggf. folgen weitere Filter. In dem obigen Beispiel vergleichen mehrere Vergleicher die Werte mit Schwellwerten.

## Temperaturschätzung der Leitungen

Wie oben beschrieben führt der Rechnerkern der Steuervorrichtung einer elektronischen Sicherung bevorzugt eine Temperaturschätzung der geschützten Versorgungsleitung durch.

## Quantenzufallszahlengenerator

Der Quantenzufallszahlengenerator der Steuervorrichtung der Sicherung, den der Rechnerkern der Sicherung über den internen Datenbus ansprechen kann weist bevorzugt zumindest eine erste SPAD-Diode und zumindest eine zweite SPAD-Diode und zumindest einen optischen Lichtwellenleiter auf. Ein solcher Quantenzufallszahlengenerator kann sich beispielsweise auch im übergeordnete Rechnersystem des Versorgungsnetzwerks befinden. Der Quantenzufallszahlengenerator ist bevorzugt ein quantenprozessbasierender Generator für echte Zufallszahlen (QRNG). Der quantenprozessbasierende Generator für echte Zufallszahlen (QRNG) umfasst bevorzugt eine erste SPAD-Diode als Lichtquelle für ein optisches Quantensignal und eine zweite SPAD-Diode als Fotodetektor für das optische Quantensignal. Des Weiteren umfasst der quantenprozessbasierende Generator für echte Zufallszahlen (QRNG) bevorzugt zumindest die Verarbeitungsschaltung und den optischen Lichtwellenleiter. Bevorzugt koppelt der zumindest eine optische Lichtwellenleiter die zumindest eine erste SPAD-Diode mit der zumindest einen zweiten SPAD-Diode optisch. Eine Betriebsschaltung vorzugsweise in Form der besagten Spannungsversorgung versorgt die erste SPAD-Diode in der Art mit elektrischer Energie, dass die erste SPAD-Diode Licht emittiert. Die Abstrahlung von Licht erfordert dabei, dass die Spannungsversorgung (Betriebsschaltung) eine ausreichende elektrische Vorspannung der ersten SPAD-Diode zur Verfügung stellt. Eine Verarbeitungsschaltung erfasst das Signal der zweiten SPAD-Diode und bildet daraus die Zufallszahl. Die Verarbeitungsschaltung stellt dann bevorzugt die so gebildete Zufallszahl einem oder mehreren der einen oder mehreren Rechnerkernen von Steuerschaltungen von Sicherungen im Versorgungsnetzwerk und/oder dem übergeordneten Rechnersystem des Versorgungsnetzwerks und ggf. weiteren Vorrichtungen im Versorgungsnetzwerk und/oder im Fahrzeug über einen Datenbus zur Verfügung.

Bevorzugt ist die Steuerschaltung der Sicherung monolithisch als mikrointegrierter CMOS-Schaltkreis ausgeführt. Ein Halbleiterkristall, der bevorzugt ein Siliziumkristall ist, umfasst bevorzugt die Steuerschaltung und ggf. den Shunt-Widerstand zur Messung des Stromes durch den Hilfsleistungsschalter der Sicherung.

Bevorzugt weist der Halbleiterkristall eine Oberfläche auf. Typischerweise weist der Halbleiterkristall ein halbleitendes Material unterhalb seiner Oberfläche auf. Insbesondere bei der Anwendung konventioneller Halbleiterschaltungsherstellprozesse, wie CMOS-Prozessen, Bipolarprozessen und BiCMOS-Prozessen weist die Oberfläche des Halbleiterkristalls typischerweise einen Metallisierungsstapel als strukturierten Metallschichten und elektrischen Isolationsschichten auf. Die strukturierten Metallschichten, beispielsweise aus Aluminium oder Kupfer oder dergleichen, bilden dabei typischerweise die Leiterbahnen, die durch die optisch transparenten Isolationsschichten, beispielsweise aus Siliziumdioxid oder dergleichen, voneinander elektrisch getrennt sind. Somit weist der Metallisierungsstapel eine oder mehrere typischerweise strukturierte und optisch transparente und elektrisch isolierende Schichten als Isolationsschichten auf. Zumindest ein Teil dieser typischerweise strukturierten, transparenten und elektrisch isolierenden Schichten und zumindest Teile dieser Schichten der Oberfläche bilden bevorzugt den optischen **Lichtwellenleiter** zur optischen Verbindung der ersten SPAD-Diode mit der zweiten SPAD-Diode. Die erste SPAD-Diode strahlt typischerweise aus dem halbleitenden Material des Halbleitersubstrats heraus in diesen optischen Lichtwellenleiter Licht hinein ein. D. h. in der Regel strahlt die erste SPAD-Diode im Gegensatz zum Stand der Technik senkrecht zur Oberfläche des Halbleitmaterials im Wesentlichen nach oben und nicht zur Seite in das Halbleitersubstrat des Halbleiterkristalls hinein, das eine hohe Dämpfung aufweist. Trotzdem ist die Abstrahlung der Photonen der ersten SPAD-Diode im Lichtwellenleiter nicht gerichtet. Insbesondere ist die Ausstrahlung über das Substrat des Halbleitermaterials sehr gedämpft, da sichtbares Licht eine sehr hohe Absorption im Halbleitermaterial besitzt. Durch die Konstruktion mit dem Lichtwellenleiter im Metallisierungsstapel des mikrointegrierten Schaltkreises kann die Vorrichtung mehr Photonen der ersten SPAD-Diode direkt mit der zweiten SPAD-Diode koppeln und in die zweite SPAD-Diode einstrahlen. Der optische Lichtwellenleiter transportiert diese Photonen der ersten SPAD-Diode im Lichtwellenleiter im Vergleich zum Stand der Technik praktisch verlustfrei zur zweiten SPAD-Diode. Der Lichtwellenleiter bestrahlt mit diesen Photonen der ersten SPAD-Diode die zweite SPAD-Diode in der Art, dass das Licht von innerhalb des Lichtwellenleiters wieder in das halbleitende Material des Halbleitersubstrats von der Oberfläche aus eindringt und dort Vorrichtungsteile der zweiten SPAD-Diode trifft. Die zweite SPAD-Diode erzeugt dann in Abhängigkeit von der Bestrahlung mit diesen Photonen ein Empfangssignal.

Typischerweise versorgt zumindest eine Betriebsschaltung, also beispielsweise die Spannungsversorgung der Steuerschaltung der Sicherung, die zumindest eine erste SPAD-Diode zumindest zeitweise mit elektrischer Energie. Die zumindest eine erste SPAD-Diode speist dann bei Versorgung mit ausreichender elektrischer Energie Photonen in den zumindest einen Lichtwellenleiter ein. Der Lichtwellenleiter transportiert diese Photonen dann weiter. Der zumindest eine Lichtwellenleiter strahlt dann die transportierten Photonen als im Wesentlichen senkrecht sich bewegende Photonen in die zweite SPAD-Diode ein. Da dieser Transport der Photonen von der ersten SPAD-Diode 54 zur zweiten SPAD-Diode aufgrund der geringen Dämpfung im Lichtwellenleiter wesentlich weniger Photonen verliert als in der Konstruktion aus dem Stand der Technik, die das stark absorbierende Halbleitersubstrat benutzt, ist der Quantenwirkungsgrad massiv höher. Damit steigt die Bit-Rate, mit der die Vorrichtung Zufallszahlen erzeugen kann, an. Daher reicht bei der hier vorgestellten Konstruktion bereits ein Paar aus einer einzigen ersten SPAD-Diode und einer einzigen zweiten SPAD-Diode aus. Der Stand der Technik verwendet immer mehrere SPAD-Dioden.

Sicher Software-Download

Das hier vorgelegte Dokument beschreibt darüber hinaus ein System für ein Fahrzeug, das es ermöglicht, SW-Programme, insbesondere SW-Programme von Drittanbietern, in sicherer Weise in dem Versorgungsnetzwerk des Fahrzeugs, und zwar in den elektronischen Sicherungen des Versorgungsnetzwerks auszuführen. Des Weiteren betrifft die Erfindung ein Verfahren zur Ausführung von SW-Programmen in diesen elektronischen Sicherungen.

Bei der Integration eines SW-Programms in der Steuervorrichtung der Sicherung eines Versorgungsnetzwerks und/oder im übergeordneten Rechnersystem des Versorgungsnetzwerks eines Fahrzeugs muss sichergestellt sein, dass durch das SW-Programm die Sicherheit des Versorgungsnetzwerks nicht beeinträchtigt wird. Andererseits kann es erforderlich sein, zumindest Teile des SW-Programms (z.B. Teile mit vertraulichen Informationen, wie z.B. Abrechnungsdaten, Freischaltcodes, verschlüsselte Programmbefehle und verschlüsselte Konfigurations- und Zugangsdaten) vor unzulässigen lesenden und/oder schreibenden Zugriffen zu schützen. Diese Anforderungen können zu einem relativ hohen Integrationsaufwand führen.

Das vorliegende Dokument befasst sich daher auch mit der technischen Aufgabe, ein System und ein Verfahren bereitzustellen, die eine flexible und sichere Integration von SW-Programmen in Steuervorrichtungen von Sicherungen eines Versorgungsnetzes und/oder eines übergeordneten Rechnersystems eines Versorgungsnetzes eines Fahrzeugs zu ermöglichen.

Das hier vorgelegte Dokument beschreibt ein System zur Bereitstellung einer Anwendung mittels eines SW (Software)-Programms in einem Versorgungsnetzwerk. Die Anwendung kann z.B. darauf ausgelegt sein, das Fahrzeug mit einem Server 710 eines Dienstleistungsanbieters und/oder mit einem elektronischen Gerät (z.B. einem Smartphone) außerhalb des Fahrzeugs über das übergeordnete Rechnersystem des Versorgungsnetzwerks oder eine andere Datenschnittstelle im Versorgungsnetzwerk zu vernetzten. Des Weiteren kann die Anwendung darauf ausgelegt sein, das Versorgungsnetzwerk und/oder Versorgungsteilnetze automatisch in eine Dienstleistung einzubinden (z.B. Freischaltung von speziellen Verbrauchern etc.). Das SW-Programm kann dabei durch einen Server 710 eines Dienstleisters für die jeweilige Dienstleistung / Ausstattungsvariante des Fahrzeugs bereitgestellt werden.

Das System umfasst eine erste HW (Hardware)-Plattform und eine zweite HW-Plattform. Dabei können die erste HW-Plattform und die zweite HW-Plattform zur Bereitstellung einer besonders zuverlässigen Isolation zwischen den beiden HW-Plattformen separate Rechner umfassen. Beispielsweise kann die erste HW-Plattform Teil eines übergeordneten Rechnersystems des Versorgungsnetzwerks des Fahrzeugs sein. Andererseits kann die zweite HW-Plattform von dem übergeordneten Rechnersystem des Fahrzeugs, insbesondere von einem Betriebssystem des übergeordneten Rechnersystems des Versorgungsnetzwerks getrennt sein. Typischerweise ist die zweite HW-Plattform eine Steuervorrichtung einer Sicherung des Versorgungsnetzwerks.

Alternativ oder ergänzend kann die zweite HW-Plattform einen nichtflüchtigen Speicher (z.B. zur Speicherung von Daten) und/oder einen flüchtigen Speicher (z.B. für den Betrieb eines SW-Moduls) umfassen, der von der ersten HW-Plattform getrennt ist. Des Weiteren kann der Speicher der zweiten HW-Plattform, also der Steuerungsvorrichtung der Sicherung, mittels ein oder mehrerer Sicherheitsmaßnahmen geschützt sein. Dabei kann der Speicher der der Steuerungsvorrichtung der Sicherung mit ein oder mehreren Sicherheitsmaßnahmen geschützt sein, die nicht zum Schutz der ersten HW-Plattform verwendet werden. Der Speicher (sowohl der "runtime" Speicher als auch der "storage" Speicher) der zweiten Steuerungsvorrichtung der Sicherung können derart durch ein oder mehrere Sicherheitsmaßnahmen geschützt sein, dass der Speicher nicht von außen (bzw. von einer unsicheren Applikation) manipulierbar ist.

Die Steuerungsvorrichtung der Sicherung unterliegt ein oder mehreren Sicherheitsmaßnahmen, denen die erste HW-Plattform nicht unterliegt. Die ein oder mehreren Sicherheitsmaßnahmen können z.B. eine Überprüfung von SW-Code eines SW-Moduls umfassen, das auf der Steuerungsvorrichtung der Sicherung durch den rechnerkern der Steuerungsvorrichtung ausgeführt wird. Insbesondere kann der SW-Code von einem Hersteller des Fahrzeugs und/oder durch eine von dem Bereitsteller des SW-Programms separate Einheit der Steuerungsvorrichtung der Sicherung überprüft werden. So kann gewährleistet werden, dass durch ein SW-Modul auf der Steuerungsvorrichtung der Sicherung keine sicherheitsrelevanten Daten freigegeben werden und/oder keine sicherheitsrelevante Funktion (des Versorgungsnetzwerks) beeinträchtigt wird. Alternativ oder ergänzend können die ein oder mehreren Sicherheitsmaßnahmen eine Beschränkung von Daten umfassen, die an ein SW-Modul oder von einem SW-Modul übergeben werden können, das auf der Steuerungsvorrichtung der Sicherung ausgeführt wird. Es können somit der Fluss von Daten zu der Steuerungsvorrichtung der Sicherung hin und/oder von der Steuerungsvorrichtung der Sicherung weg beschränkt werden.

Das SW-Programm umfasst zumindest ein Basis-Modul und zumindest ein sicherheitsrelevantes Modul. Dabei greift das sicherheitsrelevante Modul auf sicherheitsrelevante Daten und/oder auf eine sicherheitsrelevante Funktion zu. Andererseits greift das Basis-Modul typischerweise nicht oder nur über definierte Schnittstellen auf sicherheitsrelevante Daten und/oder auf eine sicherheitsrelevante Funktion zu. Das SW-Programm kann somit in ein oder mehrere sicherheits-kritische Teile und in ein oder mehrere sicherheits-unkritische Teile ausgeteilt werden.

Das Basis-Modul (d.h. die ein oder mehreren sicherheits-unkritischen Teile) kann dann auf der ersten HW-Plattform ausgeführt werden, und das sicherheitsrelevante Modul (d.h. die ein oder mehreren sicherheits-kritischen Teile) kann auf der Steuerungsvorrichtung der Sicherung ausgeführt werden.

Das System ermöglicht es somit, in zuverlässiger, sicherer und effizienter Weise SW-Programme für Anwendungen in einem Versorgungsnetzwerk eines Fahrzeugs bereitzustellen.

Das zumindest eine, sicherheitsrelevante Modul (d.h. die ein oder mehreren sicherheits-kritischen Teile) umfasst bevorzugt 20%, 10% oder weniger des SW-Codes des SW-Programms und das zumindest eine Basis-Modul (d.h. die ein oder mehreren sicherheits-unkritischen Teile) umfasst bevorzugt 80%, 90% oder mehr des SW-Codes des SW-Programms. So können die ein oder mehreren Sicherheitsmaßnahmen bezüglich der Steuerungsvorrichtung der Sicherung in effizienter Weise umgesetzt werden.

Die erste HW-Plattform ist bevorzugt derart ausgelegt, dass ein auf der ersten HW-Plattform ausgeführtes SW-Modul (d.h. ein Basis-Modul) keinen Zugriff oder nur Zugriff über eine definierte Schnittstelle auf eine sicherheitsrelevante Funktion des Versorgungsnetzwerks hat. Andererseits ist die Steuerungsvorrichtung der Sicherung bevorzugt derart ausgelegt, dass ein auf der Steuerungsvorrichtung der Sicherung ausgeführtes SW-Modul einen Zugriff auf eine sicherheitsrelevante Funktion des Versorgungsnetzwerks hat. So kann in zuverlässiger Weise eine sichere Ausführung von SW-Programmen in einem dem Versorgungsnetzwerk ermöglicht werden.

Das Basis-Modul kann eingerichtet sein, bei der Ausführung des SW-Programms das sicherheitsrelevante Modul aufzurufen und eine Ausführung des sicherheitsrelevanten Moduls auf der Steuerungsvorrichtung der Sicherung zu veranlassen. Dabei können bei der Ausführung des SW-Programms Daten von dem Basis-Modul an das sicherheitsrelevante Modul übergeben werden. Des Weiteren können Daten von dem sicherheitsrelevanten Modul an das Basis-Modul übergeben werden. Dabei kann das sicherheitsrelevante Modul eine standardisierte Schnittstelle aufweisen, über die die Daten an das sicherheitsrelevante Modul oder von dem sicherheitsrelevanten Modul übergeben werden können. So kann eine sichere Ausführung von SW-Programmen von externen SW Anbietern in einer Steuerungsvorrichtung der Sicherung ermöglicht werden. Insbesondere wird hierdurch das Mischen von Sicherungen unterschiedlicher Hersteller in dem Versorgungsnetzwerk eines Fahrzeugs möglich.

Gemäß einem weiteren Aspekt wird ein Verfahren zur Ausführung eines SW-Programms in einem Versorgungsnetzwerk beschrieben. Das Verfahren umfasst das Ausführen eines Basis-Moduls des SW-Programms auf einer ersten HW-Plattform, beispielsweise dem übergeordneten Rechnersystem des Fahrzeugs. Außerdem umfasst das Verfahren das Aufrufen, aus dem Basis-Modul heraus, eines sicherheitsrelevanten Moduls des SW-Programms, wobei das sicherheitsrelevante Modul auf sicherheitsrelevante Daten und/oder auf eine sicherheitsrelevante Funktion zugreift. Das Verfahren umfasst weiter das Ausführen des sicherheitsrelevanten Moduls auf einer Steuerungsvorrichtung der Sicherung des Fahrzeugs, wobei die Steuerungsvorrichtung der Sicherung ein oder mehreren Sicherheitsmaßnahmen unterliegt, denen die erste HW-Plattform nicht unterliegt.

Gemäß einem weiteren Aspekt wird ein Fahrzeug (insbesondere ein Straßenkraftfahrzeug z.B. ein Personenkraftwagen, ein Lastkraftwagen oder ein Motorrad) beschrieben, das das in diesem Dokument beschriebene Versorgungsnetzwerk umfasst.

Wie eingangs dargelegt, befasst sich das vorliegende Dokument mit der flexiblen und sicheren Integration von SW-Programmen für unterschiedliche Anwendungen auf einer HW-Plattform eines Fahrzeugs.

Ein SW-Programm für eine Anwendung kann z.B. auf einem Smartphone eines Nutzers installiert werden, und das Smartphone kann mit dem Fahrzeug über eine Datenverbindung verbunden werden. Andererseits kann ein SW-Programm direkt auf einem Steuergerät (z.B. der Head Unit) eines Fahrzeugs installiert und ausgeführt werden. Diese beiden Möglichkeiten sind mit Nachteilen verbunden. Beispielsweise kann es für einen Nutzer unerwünscht sein, Software von ggf. unbekannten Anbietern auf einem persönlichen Smartphone zu installieren. Andererseits erfordert die direkte Integration von SW-Programmen auf dem übergeordneten Rechnersystem eines Fahrzeugs typischerweise hohe Integrationsaufwendungen. Dabei ist eine vollständige Kontrolle und/oder Überprüfung der aufgespielten SW aufgrund der hohen Komplexität ggf. nicht möglich. Des Weiteren kann die Sicherheit von Daten aus einem SW Programm innerhalb einer Head Unit ggf. nicht ausreichend gewährleistet werden.

Es wird daher vorgeschlagen, in einem Fahrzeug eine vertrauenswürdige Umgebung (d.h. ein sicheres Ökosystem) für Software von Drittanbietern bereitzustellen. Durch die Bereitstellung einer derartigen vertrauenswürdigen Umgebung kann einem externen Anbieter eines SW-Programms gewährleistet werden, dass sicherheitsrelevante Teile des SW-Programms (z.B. kryptographische Schlüssel) vor Zugriff geschützt sind. Des Weiteren kann in effizienter Weise sichergestellt werden, dass ein SW-Programm eines externen Anbieters nicht die Sicherheit des Fahrzeugs beeinträchtigt.

Brandschutz

Im Falle eines Durchlegierens des Leistungstransistors 17 ist der Leistungstransistor 17 nicht mehr schaltbar und kann mit einem nicht unwesentlichen Restwiderstand weiterhin leitfähig sein. Ist die Last beispielsweise eine ohmsche Last, die auch bei einer Spannungsverminderung aus welchen Gründen auch immer nicht oder noch nicht abschaltet, so kann eine große Leistung in dem Leistungsschalter 17 umgesetzt werden. Dies kann zu einer Plasmaentwicklung und/oder zu einem Brand führen. Dies ist insbesondere dann möglich, wenn aus welchen Gründen auch immer brandfähige Verschmutzungen in Kontakt mit dem Leistungsschalter und/oder dem dann typischerweise aufgeheizten Sicherungsgehäuse 535 sind.

Das hier vorgelegte Dokument schlägt daher eine elektronische Sicherung 1 mit einem ersten Anschluss 18 und einem zweiten Anschluss 19 und mit einem Leistungsschalter 17) mit einem ersten Anschluss (26) des Leistungsschalters 17 und mit einem zweiten Anschluss 28 des Leistungsschalters 17 vor. Der Leistungsschalter 17 ist dabei mit seinem ersten Anschluss 26 mit dem ersten Anschluss 18 der elektronischen Sicherung 1 und mit seinem zweiten Anschluss 28 mit dem zweiten Anschluss 19 der elektronischen Sicherung 1 elektrisch verbunden. Eine thermische Absicherung 5710, 5740 ist nun zur zusätzlichen Absicherung in den Strompfad zwischen dem ersten Anschluss 18 der Sicherung 1 und dem zweiten Anschluss 19 der Sicherung 1 eingefügt. Die thermische Absicherung 5710, 5740 unterbricht vorschlagsgemäß den Strompfad zwischen dem ersten Anschluss 18 der Sicherung 1 und dem zweiten Anschluss 19 der Sicherung 1, wenn die Temperatur des Leistungsschalters 17 und/oder die Temperatur innerhalb des Gehäuses 535 der Sicherung 1 und/oder die Temperatur des Gehäuses 535 der Sicherung 1 eine Abschalttemperatur überschreitet. Die Absicherung kann eine Temperatursicherung 5740) oder ein Temperaturschalter 5710 sein, wobei eine Temperatursicherung 5740 bevorzugt ist, da sie sich nach dem Auslösen nicht mehr einschaltet. Die Sicherung weist einen Temperaturwirkpfad 5720 zwischen dem Leistungsschalter 17 und der Absicherung 5710, 5740 mit einem vorzugsweise niedrigen thermischen Widerstand auf, sodass die Temperatur des Leistungsschalters 17 einen Schaltzustand der Absicherung 5710, 5740 ändern kann, sodass eine Übertemperatur zum Abschalten der der Absicherung 5710, 5740 führt. Dieser Temperaturwirkpfad kann beispielsweise ein direkter thermischer Kontakt zwischen dem Leistungsschalter 17 und dem Temperaturschalter 5710 sein und/oder eine thermische Brücke in Form eines gemeinsamen Kühlkörpers oder dergleichen.

Die vorgeschlagene Sicherung 1 umfasst bevorzugt eine Steuervorrichtung 4, die den Schaltzustand der Absicherung 5710, 5740 beispielsweise mittels einer Temperatuschalter / Thermosicherung-Überwachungsvorrichtung 5750 der Steuervorrichtung 4 erfasst.

Die Steuervorrichtung 4 signalisiert vorzugsweise einen erfassten Zustand der Absicherung 5710, 5740 (z.B. geschlossen / geöffnet) und/oder aus diesen Daten abgeleitete Daten, insbesondere Alarmierungen, an ein übergeordnetes Rechnersystem 12 und/oder den Server 710 eines Dienstleistungsanbieters und/oder den Server 710 eines Automobilherstellers oder dergleichen oder an ein Terminal 740 eines Nutzers 730 und/oder an ein Terminal 740 der Feuerwehr oder einen Server 710 die Feuerwehr oder ähnlicher Rettungskräfte über einen Datenbus des Versorgungsnetzwerk 200, dessen Teil die elektronische Sicherung 1 ist, wobei diese Signalisierung von anderen Rechnern im Signalisierungspfad ggf. modifiziert werden kann.

Das Versorgungsnetzwerk 200 und/oder die Sicherung können beispielsweise bezogen auf diese Idee des Brandschutzes mittels einer zusätzlichen Absicherung 5710, 5740 Teil eines Fahrzeugs sein können.

Beispielsweise können ein Rechnerkern 2 der Steuervorrichtung 4 einer Sicherung 1 im Versorgungsnetzwerk 200 und/oder ein übergeordnetes Rechnersystem 12 im Versorgungsnetzwerk 200 und/oder ein anderer Rechner in dem besagten Fahrzeug mittels eines Positionserfassungssystems, beispielsweise mittels eines GPS-Sensors, und/oder einer anderen im Versorgungsnetzwerk vorhandenen Information die Position des Versorgungsnetzwerks bzw. des Fahrzeugs ermitteln. Dieser Rechnerkern 2 der Steuervorrichtung 4 jener Sicherung 1 im Versorgungsnetzwerk 200 und/oder das übergeordnete Rechnersystem 12 im Versorgungsnetzwerk 200 und/oder der erwähnte andere Rechner in dem besagten Fahrzeug können dann diese Positionsinformation an das übergeordnete Rechnersystem 12 und/oder den Server 710 eines Dienstleistungsanbieters und/oder den Server 710 des Automobilherstellers oder dergleichen oder an das Terminal 740 des Nutzers 730 und/oder an das Terminal 740 der Feuerwehr oder den Server 710 der Feuerwehr oder ähnlicher Rettungskräfte, wie zuvor beschrieben, signalisieren.

Datenkompression

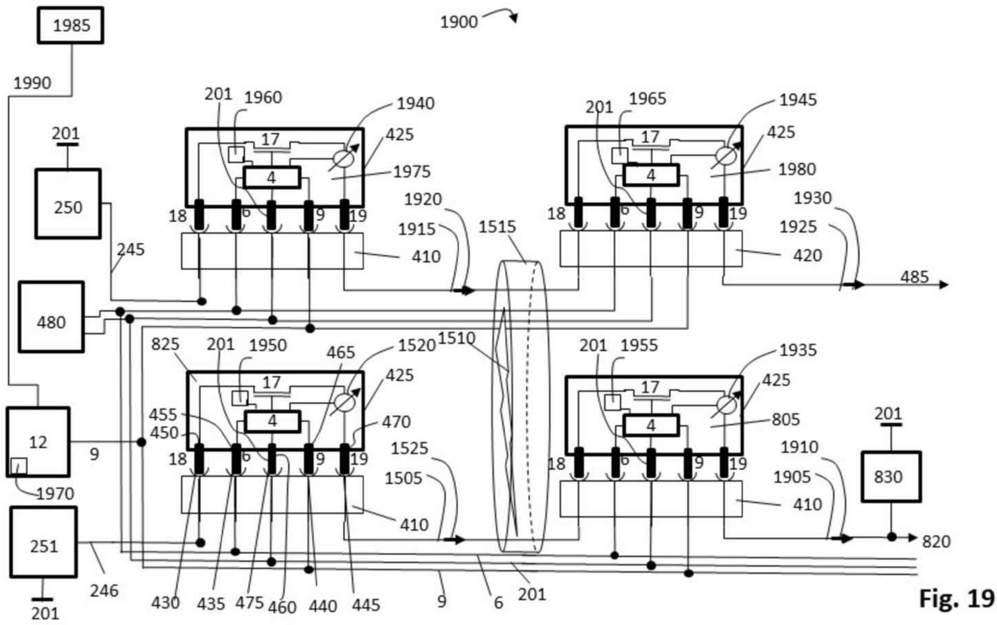

Wie oben beschrieben ist es denkbar, dass die Steuervorrichtung 4 die Abtastwerte physikalischer Parameter der Sicherung 1 direkt an das übergeordnete Rechnersystem 12 über den Datenbus 9 übermittelt. Solche physikalischen Parameter der Sicherung 1 können im Sinne des hier vorgelegten Dokuments beispielsweise Spannungswerte an Knotenpaaren von Konten, die die Steuervorrichtung 4 beispielsweise mittels ihres Analog-zu-Digital-Wandlers 570 erfassen kann, sein. Solche physikalischen Parameter der Sicherung 1 können im Sinne des hier vorgelegten Dokuments beispielsweise Stromwerte der Ströme (32, 24), die die Steuervorrichtung 4 beispielsweise mittels ihres Analog-zu-Digital-Wandlers 570 in Leitungsabschnitten innerhalb und/oder außerhalb der Sicherung 1 erfassen kann, sein. Besonders bevorzugt soll die Steuervorrichtung 4 der Sicherung 1 nicht nur einzelne sporadisch erfassten Werte dieser physikalischen Parameter der Sicherung 1, sondern auch deren zeitliche Verläufe an das übergeordnete Rechnersystem 12 übermitteln. Dies versetzt das übergeordnete Rechnersystem 12 in die Lage durch Korrelation zweier Signalverläufe verschiedener Sicherungen 1975, 1980, 825, innerhalb eines Versorgungsnetzwerks 1900 (siehe Figur 19) auf Störungen wie beispielsweise Kurzschlüsse 1510 oder Lichtbögen zwischen verschiedenen Leitungsabschnitten 1505, 1905 zu schließen.

Eine weitere Idee des hier vorgelegten Dokuments ist es somit nun, dass die Steuervorrichtung 4 der Sicherung 1 einem oder mehrere zeitlichen Signalverläufe eines oder mehrerer physikalischer Parameter vorzugsweise innerhalb eines zeitlichen Abtastfensters in einem ersten Schritt als einen Datensatz von Abtastwerten der Werte dieses physikalischen Parameters in diesem zeitlichen Abtastfenster erfasst. Das Abtastfenster weist dabei einen zeitlichen Anfang und ein zeitliches Ende auf. Nach der Erfassung der zu übertragenden zeitlichen Verläufe der betreffenden physikalischen Parameter in dem ersten zeitlichen Abtastfenster erfasst die Steuervorrichtung 4 der Sicherung die zeitlichen Signalverläufe der physikalischen Parameter vorzugsweise innerhalb eines nachfolgenden weiteren zeitlichen Abtastfensters in einem neuen ersten Schritt als einen weiteren Datensatz von Abtastwerten der Werte dieses physikalischen Parameters in diesem weiteren zeitlichen Abtastfenster. Bevorzugt fährt die Steuervorrichtung 4 der Sicherung mit der Erfassung der Abtastfenster Abtastfenster um Abtastfenster fort, sodass die Steuervorrichtung 4 der Sicherung 1 den jeweiligen zeitlichen Verlauf der jeweiligen physikalischen Parameter, die die Sicherung erfasst mehr oder weniger quasikontinuierlich erfasst. Die Abtastfenster können spezifisch für den jeweiligen physikalischen Parameter gewählt sein. Die Steuervorrichtung tastet dabei den Wert des jeweiligen physikalischen Parameters jeweils mit einer Abtastrate ab, die typischerweise von einem Takt der Steuervorrichtung 4 der Sicherung abhängt. Die Abtastraten unterschiedlicher physikalischer Parameter können unterschiedlich sein. Die Abtastraten können vom Zustand der Sicherung 1 und/oder von Zuständen im Versorgungsnetzwerk 1900 (siehe Figur 19) abhängen. Es ist möglich, dass das zeitliche Ende des vorausgehenden zeitlichen Abtastfensters im Wesentlichen gleich dem zeitlichen Beginn des Weiteren, nachfolgenden zeitlichen Abtastfensters ist. Bevorzugt überlappt sich das unmittelbar vorausgehende Abtastfenster mit dem diesem nachfolgenden Abtastfenster um eine zeitliche Überlappungslänge. Diese zeitliche Überlappungslänge ist bevorzugt für alle Abtastfenster der Abtastung des Werteverlaus eines physikalischen Parameters im Wesentlichen gleich. Vorzugsweise übermittelt die Steuervorrichtung 4 der Sicherung 1 den Wert der zeitlichen Überlappungslänge an ein übergeordnetes Rechnersystem 12 oder das übergeordnete Rechnersystem 12 gibt der Steuervorrichtung 4 der Sicherung 1 über den Datenbus 9 den Wert dieser zeitlichen Überlappungslänge mittels einer Datenbotschaft vor. Zeitliche Überlappungslängen, die negativ (=Lücken zwischen den Abtastfenstern) oder null sind, sind möglich. Zeitliche Überlappungslängen, die positiv sind, sind bevorzugt. Bevorzugt legt die Steuervorrichtung 4 die erfassten Abtastwerte der zeitlichen Verläufe der Werteverläufe der physikalischen Parameter in einem Speicher der Steuervorrichtung 4 währen dieses ersten Schritts ab.

Entsprechend der weiteren Idee des hier vorgelegten Dokuments komprimiert in einem zweiten Schritt die Steuervorrichtung 4 der Sicherung 1 die Abtastwerte der zu übertragenden zeitlichen Verläufe der von der Steuervorrichtung 4 erfassten physikalischen Parameter zu komprimierten Signalverläufen.

Bevorzugt überträgt in einem dritten Schritt die die Steuervorrichtung 4 der Sicherung 1 einen oder mehrere dieser komprimierten Signalverläufe an ein übergeordnetes Rechnersystem 12.

Bevorzugt dekomprimiert in einem vierten Schritt das übergeordnete Rechnersystem 12 die von der Steuervorrichtung 4 der Sicherung 1 über den Datenbus 9 empfangenen einen oder mehreren komprimierten Signalverläufe zu einem oder mehreren dekomprimierten Signalverläufen.

Bevorzugt analysiert das übergeordnete Rechnersystem in einem fünften Schritt das übergeordnete Rechnersystem 12 einen oder mehrere dekomprimierte Signalverläufe und erzeugt dabei ein Analyseergebnis.

In einem sechsten Schritt ergreift das übergeordnete Rechnersystem 12 je nach Analyseergebnis Maßnahmen oder keine Maßnahmen. Die Maßnahmen können verschiedene Maßnahmenebenen betreffen.

i) Auf der untersten Ebene, wenn das Analyseergebnis keine oder nur unbedeutende Ereignisse offenbart, erfolgt keine Maßnahme. Auf einer weiteren beispielhaften Maßnahmenebene, wenn das Analyseergebnis unbedeutende Ereignisse offenbart, die aber für Analysezwecke bereitgehalten werden sollten, speichert das übergeordnete Rechnersystem 12 das Analyseergebnis in einem Speicher oder der gleichen beispielsweise in einer Log-Datei vorzugsweise mit einem Zeitstempel ab und hält das Analyseergebnis auf diese Weise bevorzugt für eine spätere Abfrage und/oder Auswertung bereit.

ii) Auf einer weiteren beispielhaften Maßnahmenebene, wenn das Analyseergebnis meldepflichtige Ereignisse offenbart, die zentral für eine Mehrzahl von Versorgungsnetzwerken, beispielsweise mehrerer Fahrzeuge, analysiert werden sollten, speichert zum Ersten bevorzugt das übergeordnete Rechnersystem 12 das Analyseergebnis in einem Speicher oder der gleichen beispielsweise in einer Log-Datei vorzugsweise mit einem Zeitstempel ab und hält das Analyseergebnis auf diese Weise bevorzugt für eine spätere Abfrage und/oder Auswertung bereit und das übergeordnete Rechnersystem 12 überträgt bevorzugt zum Zweiten über das Analyseergebnis vorzugsweise mit einem Zeitstempel zur geeigneten Darstellung und/oder Ausgabe in einer durch Menschen wahrnehmbaren Form an eine Mensch-Maschine-Schnittstelle eines Terminals 740, beispielsweise auf die Anzeige eines Armaturenbretts des Fahrzeugs, sodass der Nutzer 730 des Fahrzeugs Kenntnis über das Analyseergebnis des übergeordneten Rechnersystems 12 erlangt und ggf. Maßnahmen vornehmen kann.

iii) Auf einer weiteren beispielhaften Maßnahmenebene, wenn das Analyseergebnis meldepflichtige Ereignisse offenbart, die zentral für eine Mehrzahl von Versorgungsnetzwerken, beispielsweise mehrerer Fahrzeuge, analysiert werden sollten, speichert zum Ersten bevorzugt das übergeordnete Rechnersystem 12 das Analyseergebnis in einem Speicher oder der gleichen beispielsweise in einer Log-Datei vorzugsweise mit einem Zeitstempel ab und hält das Analyseergebnis auf diese Weise bevorzugt für eine spätere Abfrage und/oder Auswertung bereit und das übergeordnete Rechnersystem 12 überträgt bevorzugt zum Zweiten über eine Datenverbindung 720 das Analyseergebnis i vorzugsweise mit einem Zeitstempel an einen Server 710, beispielsweise eines Fahrzeugherstellers, der Analyseergebnis auf diese Weise bevorzugt für eine spätere Abfrage und/oder Auswertung über die Daten mehrerer Versorgungsnetzwerke hinweg bereit hält.

Im Folgenden erläutert das hier vorgelegte Dokument nun Möglichkeiten der Kompression des zeitlichen Werteverlaufs der physikalischen Parameter. Eine erste Möglichkeit ist die Reduktion der Datenmenge durch Weglassen von Abtastwerten je nach physikalischem Parameter. Bevorzugt überträgt die Steuervorrichtung 4 der Sicherung 1 dann die Abtastwerte dieser physikalischen Parameter zusammen mit einem Zeitstempel an das übergeordnete Rechnersystem 12 des Versorgungsnetzwerks 1900. Eine weitere Möglichkeit zur Kompression ist die Reduktion der Bitbreite der Abtastwerte. Ein Mittel zur Reduktion der Bitbreite ist, dass die Steuervorrichtung anstelle aller Bits eines Abtastwerts eines physikalischen Parameters nur die signifikanten Bits der Abtastwerte dieses physikalischen Parameters überträgt. Dies sind typischerweise die Bits, die in der Erprobungsphase der Sicherung und/oder des Sicherungstyps und/oder des Versorgungsnetzwerks und/oder des Versorgungsnetzwerkstyps und/oder des Fahrzeugs und/oder des Fahrzeugtyps einen Wechsel des logischen Werts dieses Bits überhaupt zeigten. Auch ist die Übertragung solcher Bits unnötig, deren Bitwechsel niemals in der Erprobungsphase der Sicherung und/oder des Sicherungstyps und/oder des Versorgungsnetzwerks und/oder des Versorgungsnetzwerkstyps und/oder des Fahrzeugs und/oder des Fahrzeugtyps zu der Notwendigkeit der Einleitung einer Maßnahme durch das über geordnete Rechnersystem 12 führte und bei denen aufgrund theoretischer Überlegungen eine solche Notwendigkeit einer Maßnahme des übergeordneten Rechnersystems 12 aufgrund eines Bit-Wechsels des betreffenden Bits sicher ausgeschlossen werden kann. Dies kann beispielsweise LSB des Wandlungsergebnisses des Analog-zu-Digital-Wandlers 570 der Steuervorrichtung 4 der Sicherung 1 betreffen, die ggf. nur irrelevantes Rauschen zeigen können.

Eine weitere Idee der technischen Lehre des hier vorgelegten Dokuments ist es, dass die Steuervorrichtung 4 der Sicherung 1 die Kompressionsmethode ändert und an die notwendige Präzision anpasst, wenn die Steuervorrichtung 4 der Sicherung oder das übergeordnete Rechnersystem 12 des Versorgungsnetzwerks 1900 die Notwendigkeit einer informationsverlustärmeren Kompression aus welchen Gründen auch immer erkennen. Beispielsweise kann die Methode und/oder der Grad dieser Kompression vom Zustand der Sicherung 1 und/oder vom Zustand anderer Sicherungen im Versorgungsnetzwerk 1900 und/oder von Parameterwerten und/oder zeitlichen Parameterwertverläufen physikalischer Parametern, die die Sicherung 1 oder andere Sicherungen im Versorgungsnetzwerk 1900 erfassen abhängen. Beispielhafte Parameter, die die Steuervorrichtung 4 der elektronischen Sicherungen 1 im Versorgungsnetzwerk 1900 erfassen, erwähnt die technische Lehre dieses Dokuments an verschiedenen Stellen der Beschreibung.

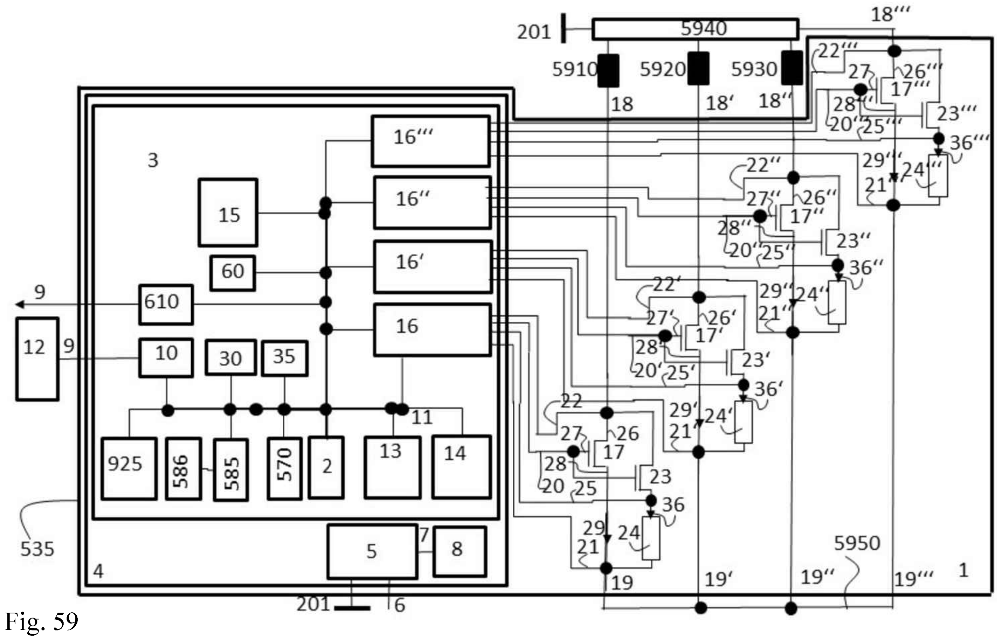

Eine weitere vorschlagsgemäße Kompressionsmethode ist die Kompression durch Reduktion des zeitlichen Parameterverlaufs eines durch die Steuervorrichtung 4 der Sicherung 1 erfassten physikalischen Parameters auf vordefinierte Parameterverläufe. Bei diesen kann es sich beispielsweise um Wavelets handeln. Das hier vorgelegte Dokument schlägt somit vor, dass Steuervorrichtung 4 der Sicherung 1 die Erkennung von Strukturen im zeitlichen Parameterwertverlauf dieser Parameter oder anderer Ereignisse mit Hilfe der bereits in der Sicherung 1 durchzuführt. Das hier vorgelegte Dokument nennt diese Strukturen im Parameterwerteverlauf der erfassten Parameter im Folgenden Objekte. Beispielsweise kann ein solches Objekt ein dreiecksförmiger Signalverlauf sein, mit dem ein Spike infolge eines Lichtbogens modelliert werden kann. Ein solches Dreiecksobjekt hat eine Zeitliche Position, Breite und Höhe, die das Dreieck kennzeichnen. Der Vorteil ist, dass dann die Steuervorrichtung nur noch die Art des Objekts - hier ein Dreieck - und dessen Parameter - hier Position, Breite und Höhe an das übergeordnete Rechnersystem 12 übertragen muss, um dem übergeordneten Rechnersystem zu ermöglichen in einem rekonstruierten Parameterwerteverlauf den Parameterwertverlauf dieses Parameters im zeitlichen Bereich dieses Objekts durch ein solches, entsprechend den von der Sicherung 1 empfangenen Objektparameterdaten parametrisiertes Objekt zu approximieren. Die Steuervorrichtung 4 der Sicherung überträgt diese Objektdaten (Objekttyp, und Objektparameter) nach Erkennung der Objekte an das übergeordnete Rechnersystem 12. Im Rahmen der Ausarbeitung der Technischen Lehre des hier vorgelegten Dokuments haben die Erfinder erkannt, dass Synergieeffekte bei der Verwendung der Daten mehrerer Sicherungen verloren gehen würden, wenn das übergeordnete Rechnersystem 12 immer nur die Daten einer Sicherung für sich alleine analysieren würde. Vielmehr haben die Erfinder als sinnvoll erkannt, dass es nicht sinnvoll ist, dass die Steuervorrichtung 4 der Sicherung 1 nur die Auswertungsergebnisse der Parameterverläufe der erfassten Parameter, sondern alle Daten zu übertragen und erst in dem übergeordneten Rechnersystem 12 die Daten mehrerer Steuervorrichtungen 4 mehrerer elektronischer Sicherungen 1 auszuwerten. Hierfür muss die Kompression der Daten der elektronischen Sicherungen für die Übertragung über den Datenbus 9 mit geringerer Busbandbreite aber bevorzugt anders erfolgen nur durch Bitreduktion und Abtastratenanpassung. Hierdurch kann das vorschlagsgemäße Versorgungsnetzwerk 1900 dann Synergieeffekte erschließen. So ist es beispielsweise, denkbar, dass ein Fahrzeug mehr als eine elektronische Sicherung 1 in seinem Versorgungsnetzwerk 1900 aufweist. Im Gegensatz zum Stand der Technik sollen beide Sicherungen aber nun miteinander korrelierende Objekte in den Parameterverläufen der von den Steuervorrichtungen 4 dieser Sicherungen 1 erfassten physikalischen Parameter aufweisen. Diese deuten dann auf Ereignisse hin, die sowohl die durch die eine der beiden Sicherungen abgesicherte Versorgungsleitung als auch die durch die andere Sicherung abgesicherte andere Versorgungsleitung betreffen. Dies können beispielsweise Lichtbögen zwischen den Versorgungsleitungen sein. Eine Versorgungsleitung im Sinne des hier vorgelegten Dokuments kann auch die Karosserie eines Fahrzeugs sein. Bevorzugt ist die Stromentnahme aus der Bezugspotenzialleitung 201, also beispielsweise der Karosserie eines Fahrzeugs, im Sinne des hier vorgelegten Dokuments durch eine eigene elektronische Sicherung 1 abgesichert. Bevorzugt erfassen die Steuervorrichtungen 4 der beiden Sicherungen jeweils beispielsweise einen oder mehrere Parameterverläufe eines oder mehrerer physikalischer Werte und/oder daraus abgeleiteter Werte. Bevorzugt erfassen die Steuervorrichtungen 4 der beiden Sicherungen jeweils beispielsweise den gleichen, einen Parameterwertverlauf oder die gleichen, mehreren Parameterwertverläufe eines oder mehrerer physikalischer Werte und/oder daraus abgeleiteter Werte bevorzugt in gleichen zeitlichen Abtastfenstern. Bevorzugt versenden die Steuervorrichtungen 4 der beiden Sicherungen die erfassten einen oder mehrere Parameterverläufe eines oder mehrerer physikalischer Werte und/oder daraus abgeleiteter Werte komprimiert an das übergeordnete Rechnersystem 12 als einen oder mehrere komprimierte Parameterverläufe. Das übergeordnete Rechnersystem 12 dekomprimiert die von den Steuervorrichtungen 4 der Sicherungen 1 über den Datenbus 9 empfangenen einen oder mehrere komprimierte Parameterverläufe zu einem oder mehreren rekonstruierten - d.h. dekomprimierten Parameterverläufen. Erst nach der Rekonstruktion (Dekompression) führt das übergeordnete Rechnersystem 12 die Erkennung der Zustände des Versorgungsnetzwerks 200, 1900 und/oder der Vorfälle im Versorgungsnetzwerk 200, 1900 durch. Dies ermöglicht zudem die Fusion der so erhaltenen Sicherungsdaten (rekonstruierter Parameterwerteverläufe) mit den Parameterwertverläufen weiterer Sensoren und Sensorsysteme, die Daten direkt oder indirekt über Datenbusse, Datenübertragungsstrecken und/oder den Datenbus 9 an das übergeordnete Rechnersystem 12 übermitteln. Beispielsweise kann eine Sensorfusion so aussehen, dass das übergeordnete Rechnersystem 12 die zeitlichen Verläufe von Wertverläufen von Parametern, die weiteren Sensoren und Sensorsysteme erfassen, mit rekonstruierten Parameterwertverläufen von Steuervorrichtungen 4 von Sicherungen korreliert. Hierzu interpoliert das übergeordnete Rechnersystem 12 auf Basis gültiger Abtastwerte der rekonstruierten Parameterwertverläufe fehlende Abtastwerte zu interpolierten, rekonstruierten Parameterwertverläufen. Des Weiteren interpoliert das übergeordnete Rechnersystem 12 auf Basis gültiger Abtastwerte der Wertverläufe jener Parameter, die die weiteren Sensoren und Sensorsysteme erfassen, interpolierte Wertverläufe jener Parameter, die die weiteren Sensoren und Sensorsysteme erfassen. Bevorzugt korrespondiert dabei zeitlich zu jedem Abtastwert der interpolierten, rekonstruierten Parameterwertverläufe zumindest ein Abtastwert der interpolierten Wertverläufe jener Parameter, die die weiteren Sensoren und Sensorsysteme erfassen. Hierdurch kann das übergeordnete Rechnersystem 12 Korrelationen in Form von auffälligen, typischerweise mehr oder weniger synchronen Ereignissen sowohl in den rekonstruierten Parameterwertverläufen als auch in den Wertverläufen jener Parameter, die die weiteren Sensoren und Sensorsysteme erfassen, suchen. Beispielsweise können mechanische Defekte von mechanischen Vorrichtungen - z.B. Elektromotoren - sich in Beschleunigungswerten - z.B. Vibrationen, Drehmomentschwingungen etc. - bemerkbar machen und gleichzeitig in damit korrespondierenden Schwankungen von Strömen 29, 36 durch die diesen mechanischen Vorrichtungen zugeordneten elektronischen Sicherungen. (Siehe auch Figur 59). Das hier vorgelegte Dokument weist in diesem Zusammenhang auf das Dokument Wolfgang Koch, "Tracking and Sensor Data Fusion: Methodological Framework and Selected Applications (Mathematical Engineering)", Springer 1st ed. 2014 Edition (23. August 2016) ISBN-10: 3662520168, ISBN-13: 978-3662520161 als willkürliches Beispiel aus der unüberschaubaren Menge an Veröffentlichungen zur Sensorfusion hin.

Das hier vorgelegte Dokument schlägt somit ein Verfahren zur Übertragung von Sicherungsdaten von einer Steuervorrichtung 4 einer Sicherung zu einem übergeordneten Rechnersystem 12 über den Datenbus 9 vor. Besonders geeignet ist das Verfahren für die Verwendung zur Übertragung von Daten eines zeitlichen Parameterwerteverlaufs von einer Steuervorrichtung 4 einer Sicherung 1 an ein Steuergerät als übergeordnetes Rechnersystem 12 eines Versorgungsnetzwerks 1900 in einem Fahrzeug.

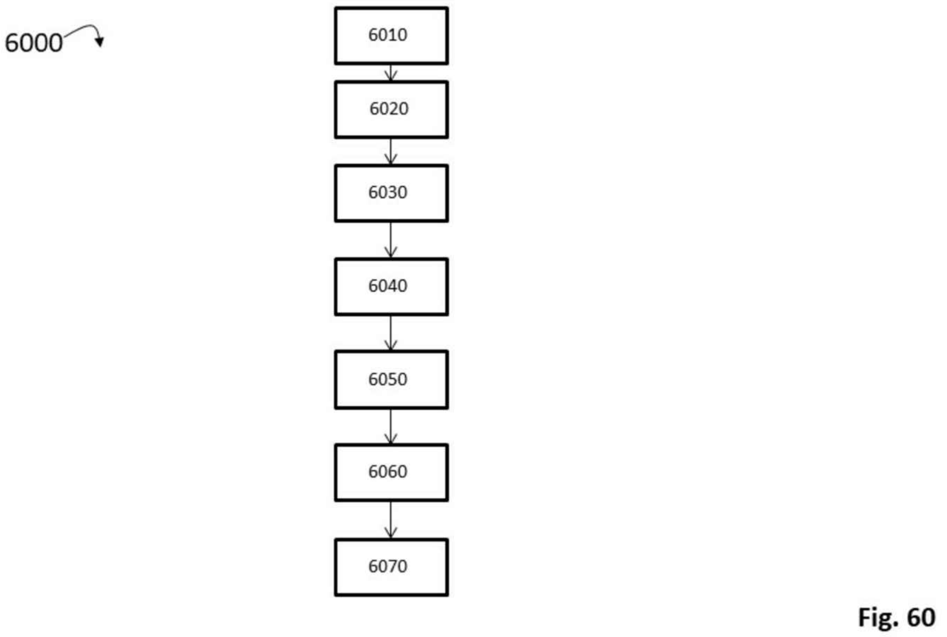

Das Verfahren wird anhand der Figur 60 erläutert.

Gemäß dem vorgeschlagenen Verfahren schließt in einem ersten Schritt 6010 eine Steuervorrichtung 4 einer Sicherung 1 den Leistungsschalter 17 der Sicherung 1.

In einem zweiten Schritt 6020 erfasst die Steuervorrichtung 4 der Sicherung durch erste Mittel, die beispielsweise den Analog-zu-Digital-Wandler 570 der Steuervorrichtung 4 und/oder den Shunt-Widerstand 24 und/oder den Hilfsleistungsschalter 23 umfassen können, den zu erfassenden physikalischen Parameter. Die zu erfassenden physikalischen Parameter können dabei beispielsweise Spannungen zwischen Schaltungsknoten innerhalb und außerhalb der Sicherung 1 und/oder elektrische Ströme durch Leitungen innerhalb der Sicherung 1 und/oder Temperaturen in und/oder im Umfeld der Sicherung 1 umfassen.

Die Steuervorrichtung 4 der elektronischen Sicherung 4 analysiert und komprimiert in einem dritten Schritt 6030 nun den so erfassten zeitlichen Parameterwerteverlauf des erfassten physikalischen Parameters, um die für die Datenübertragung notwendige Datenbuskapazität des Datenbusses 9 zu minimieren und Freiraum für Statusmeldungen und weitere Steuerbefehle des übergeordneten Rechnersystems 12 an die Steuervorrichtung 4 der Sicherung 1 bzw. für Statusmeldungen und weitere Datenübertragungen der Steuervorrichtung 4 der Sicherung 1 an übergeordnete Rechnersystem 12 an die zu schaffen.

Anschließend überträgt die Steuervorrichtung 4 der elektronischen Sicherung 1 in einem vierten Schritt 6040 den komprimierten, erfassten zeitlichen Parameterwerteverlauf des zu meldenden physikalischen Parameters an das übergeordnete Rechnersystem 12 über den Datenbus 9.

In einem fünften Schritt 6050 dekomprimiert das übergeordnete Rechnersystem 12 den über den Datenbus 9 von der Steuervorrichtung 4 der Sicherung 1 empfangenen, komprimierten, erfassten zeitlichen Parameterwerteverlauf zu einem dekomprimierten, erfassten zeitlichen Parameterwerteverlauf, der letztlich ein rekonstruierter, erfasster zeitlicher Parameterwerteverlauf ist, der der Steuervorrichtung 4 der Sicherung 1 innerhalb des übergeordneten Rechnersystems 12 zugeordnet ist.

In einem sechsten Schritt 6060 vergleicht und/oder korreliert das übergeordnete Rechnersystem 12 den rekonstruierten, erfassten zeitlichen Parameterwerteverlauf, der der Steuervorrichtung 4 der Sicherung 1 innerhalb des übergeordneten Rechnersystems 12 zugeordnet ist, mit einem oder mehreren anderen rekonstruierten, erfassten zeitlichen Parameterwerteverläufen, die den Steuervorrichtungen 4 anderer Sicherungen 1 innerhalb des übergeordneten Rechnersystems 12 zugeordnet sind. Dabei detektiert das übergeordnete Rechnersystem 12 vorzugsweise Ereignisse, die auf gleiche Ursachen vorzugsweise in zeitlicher Korrelation zurückführbar sind.

In einem siebten Schritt 6070 ergreift das übergeordnete Rechnersystem 12 sofern notwendig dann Maßnahmen in Abhängigkeit von den detektieren Ereignissen.

Das zugehörige Verfahren dient somit zur Übertragung von Parameterwertverlaufsdaten, insbesondere einer Steuervorrichtung 4 einer Sicherung 1, von einer Steuervorrichtung 4 einer Sicherung 1 zu einem übergeordneten Rechnersystem 4 eines Versorgungsnetzwerks 1900, 200, insbesondere in einem Fahrzeug.

Bevorzugt erfasst in dem besagten zweiten Schritt 6020 die Steuervorrichtung 4 der elektronischen Sicherung durch besagte Mittel und vorzugsweise zeitdiskrete Abtastung basierend auf einem Takt der Steuervorrichtung 4 der elektronischen Sicherung 1 zwei oder mehr zeitliche Parameterverläufe zweier oder mehrerer physikalischer Parameters im Erfassungsbereich der Sicherung 1 in besagtem zeitlichen Abtastfenster. Mit Erfassungsbereich eines physikalischen Parameters ist hierbei gemeint, dass die Sicherung Werte des betreffenden physikalischen Parameters erfassen kann.

Bevorzugt analysiert und komprimiert in dem besagten dritten Schritt 6030 die Steuervorrichtung 4 der elektronischen Sicherung die zwei oder mehrere erfasste zeitliche Parameterwerteverläufe und bildet daraus ein oder mehrere komprimierte zeitliche Parameterwerteverläufe.

Das hier vorgelegte Dokument schlägt somit vor, die zeitlichen Parameterverläufe zweier oder dreier oder mehrerer zeitlicher Parameterverläufe oder der zeitlichen Verläufe daraus abgeleiteter zeitlicher Parameterverläufe zu erfassen und an das übergeordnete Rechnersystem in komprimierter Form zu übermitteln.

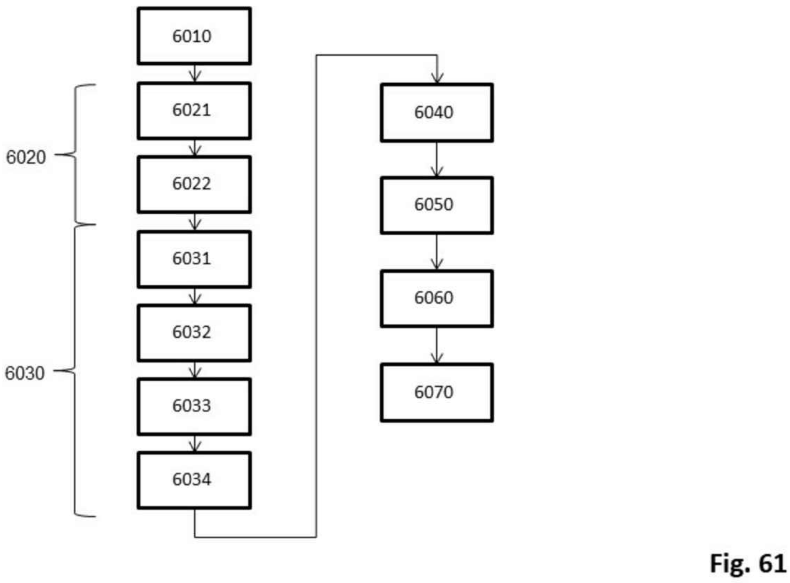

Bevorzugt wandelt die Steuervorrichtung 4 der elektronischen Sicherung 1 die elektrischen analogen Signale, die die Mittel zur Erfassung der physikalischen Parameter (z.B. Temperatursensoren 586 für die Erfassung der Temperatur, Shunt-Widerstände 24 zur Erfassung elektrischer Ströme 36, Potenzialleitungen zur Erfassung elektrischer Potenziale, Analog-zu-Digital-Wandler 570 etc.) erzeugen, durch Abtastung in einem ersten Unterschritt 6021 des zweiten Schritts 6020 (siehe Figur 61) in abgetastete zeitliche Parameterwertverläufe, die einen zeitdiskreten Strom von Abtastwerten der Parameterwerte des betreffenden physikalischen Parameters und ggf. zugehörige Zeitstempel dieser Abtastwerte umfassen. Bevorzugt ordnet die Steuervorrichtung 4 der Sicherung 1 vorzugsweise jedem Abtastwert und/oder Abtastwerten in bevorzugt gleichen Zeitabständen kann dabei typischerweise einen Abtastzeitpunkt als Zeitstempel dieses Abtastwertes zu.

Die Steuervorrichtung 4 der Sicherung kann in einem zweiten Unterschritt 6022 des zweiten Schritts 6020 beispielsweise durch eine Wavelet-Transformation oder eine andere Kompressionsmethode durchführen und die abgetasteten zeitlichen Parameterwertverläufe in komprimierte zeitliche Parameterwertverläufe wandeln.

Hierfür kann die Steuervorrichtung 4 der Sicherung 1 die erfassten Parameterwertverläufe der physikalischen Parameter und/oder aus diesen abgeleitete zeitliche Verläufe abgeleiteter Parameter mit vorbestimmten Parameterwertverlauf-Grundformen, die beispielsweise in einer Bibliothek in einer Prototypendatenbank 62115 in einem Speicher der Steuervorrichtung 4 der Sicherung abgelegt sind, durch Bildung eines Korrelationsintegrals (siehe auch Wikipedia zu diesem Begriff) zwischen den vorbestimmten Parameterwertverlauf -Grundformen einerseits und den erfassten Parameterwertverläufe der physikalischen Parameter und/oder den aus diesen abgeleiteten zeitlichen Verläufen abgeleiteter Parameter andererseits vergleichen. Das hier vorgelegte Dokument benennt im Folgenden die vorbestimmten Parameterwertverlauf -Grundformen im Folgenden auch als "Signalobjektklassen". Bevorzugt sind diese prototypischen Parameterwertverläufe der physikalischen Parameter und/oder den aus diesen abgeleiteten zeitlichen Verläufen abgeleiteter Parameter als voraufgezeichnete Abtastwerte als prototypspezifischer Datensatz (Prototypendaten) der Parameterwertverlauf-Grundformen in der besagten Bibliothek - also einer Prototypendatenbank 62115 - in einem Speicher der Steuervorrichtung 4 der Sicherung 1 für bevorzugt jede einzelne Signalobjektklasse hinterlegt. Bevorzugt ist einem solchen Eintrag der Bibliothek, also den Prototypendaten der Signalobjektklasse ein individueller prototypspezifischer Indexwert zugeordnet, der in der ganzen Prototypendatenbank 62115 nur einmal verwendet ist und damit eineindeutig die Signalobjektklasse und den zugehörigen Datensatz der voraufgezeichneten Abtastwerte identifiziert. Durch die Bildung des Korrelationsintegrals zwischen den vorbestimmten voraufgezeichneten Abtastwerten der prototypspezifischen Datensätze (Prototypendaten) der Parameterwertverlauf-Grundformen einerseits und den erfassten Parameterwertverläufe der physikalischen Parameter und/oder den aus diesen abgeleiteten zeitlichen Verläufen abgeleiteter Parameter andererseits ermittelt bevorzugt die Steuervorrichtung 4 der Sicherung 1 für jeden dieser prototypischen Signalobjektklassen jeweils zugehörige Spektralwerte dieser prototypischen Signalobjektklasse. Da dies fortlaufend Abtastfenster für Abtastfenster geschieht, stellen die Spektralwerte selbst einen Strom von zeitdiskreten momentanen Spektralwerten dar, wobei die Steuervorrichtung 4 der Sicherung 1 bevorzugt jedem Spektralwert wieder ein Zeitstempel zuordnet.

Die zuvor beschriebene Methode der Abspeicherung der Abtastwerte in der Prototypendatenbank 62115 hat den Nachteil, dass die notwendige Größe der Prototypendatenbank 62115 sehr schnall die Größe der physikalisch oder kommerziell realisierbaren Speicher in der Steuervorrichtung 4 sprengen kann. Es ist daher sinnvoll, diese Prototypendatenbank 62115 mittels sogenannter "Merkmalsvektoren" zu komprimieren. Dabei enthält dann nicht die zeitlichen Verläufe der Parameterwerte, sondern die Merkmalsvektoren, die diesen entsprechen. Das hier vorgelegte Dokument erläutert diese Komprimierung der Prototypendatenbank 62115 und deren Verwendungen im Folgenden genauer.

Eine alternative, aber mathematisch äquivalente Methode ist die Verwendung von einem, besser mehreren Optimalfilter (Englisch: Matched-Filter) je vorbestimmter Signalobjektklasse (Signal-Grundform) durch die Steuervorrichtung 4 der Sicherung. Die Optimalfilter der Steuervorrichtung 4 der elektronischen Sicherung 1 analysieren in einem ersten Unterschritt 6031 des dritten Schritts den zeitlichen Parameterwertverlauf der durch die Steuervorrichtung 4 der elektronischen Sicherung 1 erfassten Parameter und/oder des zeitlichen Verlaufs daraus abgeleiteter Parameter. Bevorzugt bildet bevorzugt jeder Optimalfilter bevorzugt jeweils einen Wert bevorzugt jeweils einer Vektorkomponente eines aktuellen Merkmalsvektors.

Diese Optimalfilter sind bevorzugt Vorrichtungsteile der Steuervorrichtung 4 der Sicherung 1 oder werden durch Vorrichtungsteile der Steuervorrichtung 4 der Sicherung, beispielsweise dem Rechnerkern 2 der Steuervorrichtung 4 der Sicherung 1 emuliert. Da die Steuervorrichtung 4 der Sicherung 1 in der Regel mehrere prototypische Signalobjektklassen in ihrem Speicher aufweist und für die Kompression verwendet, die zudem noch unterschiedlichen zeitlichen Spreizungen unterworfen werden können (siehe auch "Wavelet-Analyse"), ergibt sich auf diese Weise typischerweise ein zeitdiskreter Strom multidimensionaler Vektoren von Spektralwerten unterschiedlicher prototypischer Signalobjektklassen und deren unterschiedlicher jeweiligen zeitlicher Spreizungen, die der aktuellen Merkmalsvektor als Vektorkomponenten bevorzugt umfasst. Bevorzugt ordnet die Steuervorrichtung 4 der Sicherung 12 jedem dieser multidimensionalen aktuellen Merkmalsvektoren wieder einen Zeitstempel als Teil des aktuellen Merkmalsvektors zu, den die Steuervorrichtung 4 der Sicherung 1 in nachvollziehbarer und bevorzugt für das übergeordnete Rechnersystem 12 bekannter Weise erzeugt. Jeder dieser multidimensionalen Vektoren ist ein sogenannter Merkmalsvektor. (Englisch: Feature-Vector). (Siehe auch https://de.wikipedia.org/wiki/Mustererkennung".) Es handelt sich somit um einen zeitdiskreten Strom von Merkmalsvektoren. Der jeweils letzte, durch die Steuervorrichtung 4 der elektronischen Sicherung erzeugte Merkmalsvektor ist im Sinne des hier vorgelegten Dokuments der aktuelle Merkmalsvektor. Die Steuervorrichtung 4 der Sicherung ordnet bevorzugt jedem dieser Merkmalsvektoren bevorzugt jeweils wieder den jeweiligen Zeitstempel in einem zweiten Unterschritt 6032 des dritten Schritts 6030 zu. Der aktuelle Merkmalsvektor kann beispielsweise Spektralwerte als Vektorkomponenten umfasst.

Dadurch, dass die Steuervorrichtung 4 der Sicherung 1 die Abtastfenster fortlaufend zeitlich verschiebt, ergibt sich somit auch eine zeitliche Dimension. Hierdurch kann die Steuervorrichtung 4 der Sicherung 1 ggf. den aktuellen Merkmalsvektor auch um Werte der nicht mehr aktuellen Merkmalsvektoren der Vergangenheit oder Werte, die von diesen abhängen, ergänzen. Werte der nicht mehr aktuellen Merkmalsvektoren der Vergangenheit oder Werte, die von diesen abhängen, können beispielsweise zeitliche Integrale oder Ableitungen oder Filterwerte von einem oder mehreren dieser Werte etc. sein. Hierdurch kann die Steuervorrichtung 4 der Sicherung 1 die Dimension dieser Merkmalsvektoren innerhalb des Merkmalsvektor-Datenstroms weiter erhöhen. Um den Aufwand im Folgenden klein zu halten, ist daher die Beschränkung auf wenige prototypische Signalobjektklassen während der Extraktion der aktuellen Merkmalsvektoren aus den erfassten Parameterwertverläufen der physikalischen Parameter und/oder den aus diesen abgeleiteten zeitlichen Verläufen abgeleiteter Parameter sinnvoll.

Somit kann die Steuervorrichtung 4 der Sicherung 1 dann beispielsweise die besagten Optimalfilter (Englisch Matched-Filter) verwenden, um fortlaufend das Auftreten der prototypischen Signalobjektklassen in den erfassten Parameterwertverläufen der physikalischen Parameter und/oder in den aus diesen abgeleiteten zeitlichen Verläufen abgeleiteter Parameter zu überwachen. Informationen über Optimalfilter sind beispielsweise unter "https://de.wikipedia.org/wiki/Optimalfilter" zu finden.

Als besonders einfache prototypische Signalobjektklassen benennt das hier vorgelegte Dokument beispielhaft einen zeitlichen Parameterwerteverlauf in Form eines gleichschenkligen Dreiecks und einen Parameterwerteverlauf in Form einer Doppelspitze, um die Vorstellung zu konkretisieren. Eine prototypische Signalobjektklasse besteht bei der Verwendung von Optimalfilter oder dergleichen in der Regel aus einem vorgegebenen Spektralkoeffizientenvektor als Teil des aktuellen Merkmalsvektors, also einem vorgegebenen prototypischen Merkmalsvektor. In dem Fall umfasst der Merkmalsvektor bevorzugt eine Mehrzahl von Werten als Vektorkomponenten, wobei jeder der jeweiligen Werte des Spektralkoeffizientenvektors innerhalb des aktuellen Merkmalsvektors dann typischerweise der Wert eines jeweiligen Spektralkoeffizienten ist, den dann ein jeweiliger Optimalfilter, der diesem jeweiligen Spektralkoeffizienten zugeordnet ist, aus den erfassten Parameterwertverläufen der physikalischen Parameter und/oder den aus diesen abgeleiteten zeitlichen Verläufen abgeleiteter Parameter ermittelt.

Die Steuervorrichtung 4 der elektronischen Sicherung 1 bestimmt als nächstes die Relevanz der Spektralkoeffizienten eines aktuellen Merkmalsvektors der erfassten Parameterwertverläufe der physikalischen Parameter und/oder der aus diesen abgeleiteten zeitlichen Verläufen abgeleiteter Parameter. Die Steuervorrichtung 4 der elektronischen Sicherung 1 kann hierzu beispielsweise den Betrag eines Abstands des aktuell ermittelten aktuellen Merkmalsvektors zu einem der prototypischen Merkmalsvektoren der Prototypendatenbank 62115 in einem dritten Unterschritt 6033 des dritten Schritts 6030 ermitteln.

Bevorzugt umfasst die Prototypendatenbank 62115 dabei wieder indizierte prototypische Merkmalsvektoren. Jeder dieser prototypischen Merkmalsvektoren der Prototypendatenbank 62115 entspricht einem Merkmalsvektor den die zuvor beschriebene Merkmalsvektorextraktion im zweiten Unterschritt 6032 des dritten Schritts 6030 erzeugt, wenn ihr und den Optimalfiltern der Steuervorrichtung 4 der zugeordnete prototypischer zeitliche Parameterwertverlauf und/oder prototypische zeitliche Verlauf des aus diesen Parameterwertverläufen abgeleiteten Parameters als Eingabe präsentiert wird. Somit handelt es sich letztlich bei den Werten der Prototypendatenbank 62115 um komprimierte, prototypische zeitliche Parameterwertverläufe und/oder komprimierte prototypische zeitliche Verläufe der aus diesen Parameterwertverläufen abgeleiteten Parameter. Jedem dieser prototypischen zeitlichen Parameterwertverläufe und/oder prototypischen zeitlichen Verläufe der aus diesen Parameterwertverläufen abgeleiteten Parameter entspricht dabei wieder einem der zuvor erwähnten Signalobjekte, die die Steuervorrichtung 4 der Sicherung in den aktuellen zeitlichen Parameterwertverläufen und/oder den aktuellen zeitlichen Verläufen der aus diesen Parameterwertverläufen abgeleiteten Parameter erkennen soll, wobei die Steuervorrichtung 4 der Sicherung 1 diese aktuellen zeitlichen Parameterwertverläufe und/oder diese aktuellen zeitlichen Verläufe der aus diesen Parameterwertverläufen abgeleiteten Parameter erfasst. Damit repräsentiert der Index, den die Steuervorrichtung 4 der Sicherung 1 einem prototypischen Merkmalsvektor der Prototypendatenbank 62115 zugeordnet hat, somit wieder dem einen der zuvor erwähnten Signalobjekte, die die Steuervorrichtung 4 der Sicherung in den aktuellen zeitlichen Parameterwertverläufen und/oder den aktuellen zeitlichen Verläufen der aus diesen Parameterwertverläufen der physikalischen Parameter abgeleiteten Parameter erkennen soll, die die Steuervorrichtung 4 der Sicherung 1 erfasst. Damit repräsentiert der Index, den die Steuervorrichtung 4 der Sicherung 1 einem prototypischen Merkmalsvektor der Prototypendatenbank 62115 zugeordnet hat, somit dem entsprechenden prototypischen zeitlichen Parameterwertverlauf und/oder dem entsprechenden prototypischen zeitlichen Verlaufen der aus prototypischen Parameterwertverläufen der physikalischen Parameter abgeleiteten Parameter. Bevorzugt bildet die Steuervorrichtung 4 der Sicherung 1 einen euklidischen Abstand zwischen dem aktuellen Merkmalsvektor, der aus den aktuellen zeitlichen Parameterwertverläufen und/oder den aktuellen zeitlichen Verläufen der aus diesen Parameterwertverläufen der physikalischen Parameter abgeleitet ist, einerseits und jedem prototypischen Merkmalsvektor der Prototypendatenbank 62115 andererseits. Stattdessen kann beispielsweise die Steuervorrichtung 4 der Sicherung 1 auch den Wert des jeweiligen Skalarproduktquadrats vorzugsweise jedes möglichen jeweiligen Merkmalsdifferenzvektors zwischen dem aktuellen Merkmalsvektor, der aus den aktuellen zeitlichen Parameterwertverläufen und/oder den aktuellen zeitlichen Verläufen der aus diesen Parameterwertverläufen der physikalischen Parameter abgeleiteten Parametern extrahiert ist, einerseits minus jeweils einem prototypischen Merkmalsvektor der prototypischen Merkmalsvektoren der Prototypendatenbank 62115 andererseits bilden. Vorzugsweise verwendet die Steuervorrichtung 4 der Sicherung 1 diesen Wert des jeweiligen Skalarproduktquadrats oder eine mathematisch äquivalente Implementierung als Abstand im weiteren Verfahren. Dies hat den Vorteil, dass die Steuervorrichtung 4 der Sicherung 1 keine Wurzel bilden muss. Außerdem kann die Steuervorrichtung 4 der elektronischen Sicherung 1 die Berechnung abbrechen, wenn bei der Aufsummierung der Quadrate der einzelnen Vektorkomponenten des jeweiligen Merkmalsdifferenzvektors zur Bildung des Skalarproduktquadrats eine Zwischensumme dieser Quadrate einen Schwellwert überschreitet. Ein solcher Prototyp der Prototypendatenbank 62115 mit dem entsprechenden prototypischen Merkmalsvektor der Prototypendatenbank 62115 und dem zugehörigen Index für diesen prototypischen Merkmalsvektor in der Prototypendatenbank 62115 repräsentiert dann nicht den aktuellen Merkmalsvektor. Auf diese Weise sucht die Steuervorrichtung 4 der Sicherung 1 dann bevorzugt den prototypischen Merkmalsvektor der Prototypendatenbank 62115 mit dem kleinsten Abstand zwischen dem prototypischen Merkmalsvektor der Prototypendatenbank 62115 und dem aktuellen Merkmalsvektor. Bevorzugt umfasst die Prototypendatenbank 62115 auch Prototypen in Form prototypische Merkmalsvektoren, die protypische zeitliche Parameterwertverläufe und/oder aus diesen abgeleitete protypische zeitliche Verläufe aus einem Normalbetrieb ohne besondere Ereignisse repräsentieren.

In dem hier in diesem Dokument diskutierten Beispiel umfassen die Vektorkomponenten (Werte) des aktuellen Merkmalsvektors bevorzugt u.a. die momentanen Spektralkoeffizienten (Merkmalsvektor). Bevorzugt kann die Steuervorrichtung mittels gewichteter Vektorsummenbildung aus mehreren, jeweils mit einem jeweiligen zugeordneten realen skalaren Gewichtungsfaktor skalar-multiplizierten prototypischen Merkmalsvektoren der Prototypendatenbank 62115 den aktuellen Merkmalsvektor annähern. Typischerweise kann also der aktuelle Merkmalsvektor näherungsweise als Kombination mehrerer prototypischer Merkmalsvektoren der besagten Prototypendatenbank 62115 angesehen werden. Jeder dieser prototypischen Merkmalsvektoren der Prototypendatenbank 62115 stellt dabei eine prototypische Signalobjektklasse dar. Der Index des prototypischen Merkmalsvektors der Prototypendatenbank 62115 der Steuervorrichtung 4 der Sicherung in der Prototypendatenbank 62115 repräsentiert damit diesen prototypischen Merkmalsvektor der Prototypendatenbank. Die Menge der Indices der Prototypendatenbank, deren Merkmalsvektoren in gewichteter Summe dem aktuellen Merkmalsvektor besonders nahekommen, stellen daher zusammen mit den besagten Gewichtungsfaktoren, die diesen Indices zugeordnet sind, eine gute Kompression des aktuellen Merkmalsvektors dar. Bevorzugt normiert die Steuervorrichtung 4 der Sicherung 1 die Spektralkoeffizienten bzw. die Vektorkomponenten des aktuellen Merkmalsvektors vor den Korrelationen mit den prototypischen Merkmalsvektoren der Prototypendatenbank. Dies bedeutet, dass die Steuervorrichtung 4 der elektronischen Sicherung 1 bevorzug aber nicht notwendigerweise die Struktur der von ihr erfassten Parameterwertverläufe der erfassten Parameter bzw. der zeitlichen Verläufe der Werte daraus abgeleiteter Parameter analysiert und nicht die absolute Amplitude. Die Steuervorrichtung 4 der Sicherung 1 kann in der vorbeschriebenen Abstandsbestimmung den Abstand des aktuellen Merkmalsvektors zu einem der prototypischen Merkmalsvektoren der Prototypendatenbank 62115 z.B. auch aus der Summe der Beträge aller Differenzen zwischen jeweils einem Spektralkoeffizienten des vorgegebenen prototypischen Merkmalsvektors (Prototypen oder Prototypenvektors) der Prototypendatenbank 62115 einerseits minus dem entsprechenden normierten Spektralkoeffizienten bzw. Vektorkomponenten des aktuellen Merkmalsvektors ermitteln. In diesem Fall fällt sogar die Quadrierung weg. Es hat sich gezeigt, dass dies die notwendige Rechenleistung, die die Steuervorrichtung 4 benötigt, weiter absenkt und typischerweise zu ausreichenden Ergebnissen führt. Ein euklidischer Abstand würde dem gegenüber die Steuervorrichtung 4 der Sicherung 1 durch die Wurzel aus der Summe der Quadrate aller Differenzen zwischen jeweils einem Spektralkoeffizienten bzw. einer Vektorkomponente des vorgegebenen prototypischen Merkmalsvektors (Prototypen oder Prototypenvektors) der Prototypendatenbank 62115 und dem entsprechenden normierten Spektralkoeffizienten bzw. der entsprechenden normieren Vektorkomponente des aktuellen Merkmalsvektors bilden müssen. Diese Abstandsbildung ist aber in der Regel zu aufwändig. Es ist auch denkbar, dass die Steuervorrichtung 4 andere Methoden der Abstandsbildung verwendet. Die Steuervorrichtung 4 der elektronischen Sicherung 1 kann dann jedem vorgegebenen prototypischen Merkmalsvektor (Prototyp oder Prototypenvektor) der Prototypendatenbank 62115 dann den Index dieses prototypischen Merkmalsvektors als ein Symbol für diesen prototypischen Merkmalsvektor und ggf. auch einen Parameter, z.B. den zuvor ermittelten Abstandswert und/oder die euklidische Länge des aktuellen Merkmalsvektors vor der Normierung zugeordnet werden. Unterschreitet der so ermittelte Abstand des aktuellen Merkmalsvektors zu einem der vorgegebenen prototypischen Merkmalsvektoren (Prototypen oder Werte der Prototypenvektoren) einen ersten Schwellwert und ist der Betrag dieses Abstands der kleinste Betrag eines Abstands des aktuellen Merkmalsvektors zu einem der vorgegebenen prototypischen Merkmalsvektoren (Prototypen oder Werte der Prototypenvektoren) bevorzugt aller vorgegebenen prototypischen Merkmalsvektoren (Prototypen oder Werte der Prototypenvektoren) in der Prototypendatenbank, so wird der Index dieses prototypischen Merkmalsvektors, im Folgenden der erkannte prototypische Merkmalsvektor, in der Prototypendatenbank 62115 als Symbol des erkannten Prototyps eines oder mehrerer Parameterverläufe eines oder mehrerer durch die Steuervorrichtung zu erfassender physikalischer Parameter verwendet. Es entsteht somit ein Tripple aus erkannten Prototypen in Form eines erkannten prototypischen Merkmalsvektors und dem Index des erkannten prototypischen Merkmalsvektors in der Prototypendatenbank 62115 und einem Zeitstempel des aktuellen Merkmalsvektors. Bevorzugt bestimmt die Steuervorrichtung auch das Skalar-Produkt zwischen dem aktuellen Merkmalsvektor und dem erkannten prototypischen Merkmalsvektor als Gewichtungsfaktor des erkannten prototypischen Merkmalsvektors.

Es erfolgt dann bevorzugt die Übertragen der Daten in besagtem viertem Schritt 6040. Bevorzugt überträgt die Steuervorrichtung 4 der Sicherung 1 das ermittelte Symbols, das den Index des erkannten prototypischen Merkmalsvektors in der Prototypendatenbank 62115 der Steuervorrichtung 4 der Sicherung 1 repräsentiert, über den Datenbus 9 an das übergeordnete Rechnersystem 12. Beispielsweise kann die Steuervorrichtung 4 der Sicherung 1 auch den Zeitpunkt des Auftretens (Zeitstempels) des erkannten prototypischen Merkmalsvektors im Strom der extrahierten Merkmalsvektoren an das übergeordnete Rechnersystem 12 über den Datenbus 9 übermitteln. Beispielsweise kann die Steuervorrichtung auch den Gewichtungsfaktor für diesen erkannten prototypischen Merkmalsvektor der Prototypendatenbank 62115 an das übergeordnete Rechnersystem 12 übermitteln, der beschreibt, mit welcher Intensität das Signalmuster, das dem erkannten prototypischen Merkmalsvektor entspricht, im Signalverlauf des Parameterwerteverlaufs der durch die Steuervorrichtung 4 der Sicherung 1 erfassten Parameter oder daraus abgeleiteter Parameterwertverläufe zum Zeitpunkt der Mustererkennung vorhanden war.

Bevorzugt übermittelt die Steuervorrichtung 4 der elektronischen Sicherung die komprimierten Werte nur dann im vierten Schritt 6040 an das übergeordnete Rechnersystem 12 nur dann, wenn der Betrag des Abstands des erkannten prototypischen Merkmalsvektors der Prototypendatenbank 62115 zum aktuellen Merkmalsvektor unter dem ersten Schwellwert liegt und der erkannte prototypische Merkmalsvektor der Prototypendatenbank 62115 ein zu übertragendes Signalobjekt repräsentiert. Bevorzugt umfasst jeder Datensatz für jeweils einen Prototyp in der Prototypendatenbank 62115 der Steuervorrichtung 4 jeweils nicht nur den jeweiligen Index und den jeweiligen prototypischen Merkmalsvektor, sondern ggf. weitere Daten. Diese Daten können beispielsweise eine Information umfassen, ob die Steuervorrichtung 4 der Sicherung 1 bei erkennen dieses prototypischen Merkmalsvektors im aktuellen Merkmalsvektor als erkannten prototypischen Merkmalsvektor u.a. die oben angegebenen Informationen (Index, Zeitstempel, Gewichtungsfaktor an das übergeordnete Rechnersystem 12 übertragen soll. Es kann nämlich sein, dass auch nicht zu erkennende Prototypen in Form von nicht zu erkennenden prototypischen Merkmalsvektoren der Prototypendatenbank 62115 beispielsweise für Rauschen, also z.B. das nicht Vorhandensein von Störungen, Schwankungen, Kurzschlüssen etc. in der Prototypendatenbank 62115 der Steuervorrichtung 4 der Sicherung 1 hinterlegt sind. Diese Daten sind typischerweise für die Problemerkennung irrelevant und sollen daher ggf. auch nicht von der Steuervorrichtung 4 der Sicherung 1 an das übergeordnete Rechnersystem 12 übertragen werden.

Beispielsweise können Datensätze für einen Prototypen in der Prototypendatenbank 62115 der Steuervorrichtung 4 jeweils nicht nur den jeweiligen Index und den jeweiligen prototypischen Merkmalsvektor, sondern ggf. auch Zeiger auf Programmanweisungen und/oder entsprechende Maßnahmenindices umfassen, die den Rechnerkern 2 der Steuervorrichtung 4 veranlassen, bei Erkennen eines erkannten prototypischen Merkmalsvektors ein Verfahren auszuführen, das durch den Zeiger auf Programmanweisungen für den Rechnerkern 2 der Steuervorrichtung 4 der elektronischen Sicherung und/oder durch den entsprechenden Maßnahmenindex des Datensatzes des erkannten prototypischen Merkmalsvektors festgelegt ist. Hierdurch kann der erkannte prototypische Merkmalsvektor beispielsweise den Rechnerkern 2 der Steuervorrichtung 4 der Sicherung 1 veranlassen, einen Signalobjektzähler für das Auftreten des Signalobjekts entsprechend diesem erkannten prototypischen Merkmalsvektor beispielsweise um eine spezifische, für diesen prototypischen Merkmalsvektor in dem zugehörigen Datensatz der Prototypendatenbank 62115 festgelegte Signalobjektzählerschrittweite zu erhöhen, wobei die Signalobjektzählerschrittweite auch eins, null und/oder negativ sein kann. Bei Erreichen und/oder Kreuzen eines vorzugsweise ebenfalls für diesen prototypischen Merkmalsvektor in dem zugehörigen Datensatz der Prototypendatenbank 62115 festgelegten Signalobjektzählerschwellwerts führt der Rechnerkern 2 der Steuervorrichtung 1 bevorzugt ein Verfahren aus, dass ebenfalls beispielsweise auf die vorbeschriebene Weise in dem besagten Datensatz der Prototypendatenbank 62115 festgelegt ist. Beispielsweis kann der Rechnerkern 2 der Steuervorrichtung 4 der Sicherung 1 dann eine vordefinierte Datenbotschaft mit vorgegebenem Inhalt an das übergeordnete Rechnersystem 12 senden.

Die Steuervorrichtung 4 der Sicherung erkennt einen prototypischen Merkmalsvektor der Prototypendatenbank 62115 also bevorzugt dann als erkannten prototypischen Merkmalsvektor in einem vierten Unterschritt 6034 des dritten Schritts 6030, wenn der Betrag des ermittelten Abstands zwischen aktuellem Merkmalsvektor und vorgegebenen prototypischen Merkmalsvektor (Prototyp oder Wert des Prototypenvektors) unter diesem ersten Abstandsschwellwert liegt.

Entsprechend der technischen Lehre des hier vorgelegten Dokuments überträgt also die Steuervorrichtung 4 der elektronischen Sicherung 1 nicht mehr die Abtastwerte der Parameterwertverläufe der Parameterwerte der zu erfassenden Parameter an das übergeordnete Rechnersystem 12. Stattdessen überträgt in einem vierten Schritt 6040 die Steuervorrichtung 4 der Sicherung nur eine Folge von Symbolen (Indices) für erkannte typische zeitliche Parameterwertverläufe der Parameterwerte der zu überwachenden physikalischen Parameter und ggf. diesen Parameterwertverläufen zugehörige Zeitstempel und ggf. diesen Parameterwertverläufen zugehörige Gewichtungen in einem bestimmten Zeitabschnitt. Somit überträgt statt dessen in dem vierten Schritt 6040 die Steuervorrichtung 4 der Sicherung 1 nur eine Folge von Symbolen (Indices) für erkannte prototypische Merkmalsvektoren, die diese typischen, zeitlichen Parameterwertverläufe der Parameterwerte der zu überwachenden physikalischen Parameter repräsentieren, und ggf. dem Auftretenszeitpunkt dieser prototypische Merkmalsvektoren zugehörige Zeitstempel und ggf. der Auftretensintensität dieser prototypische Merkmalsvektoren zugehörige Gewichtungen in einem bestimmten Zeitabschnitt des betreffenden zeitlichen Abtastfensters.

Die Steuervorrichtung 4 der elektronischen Sicherung 1 überträgt dann bevorzugt jeweils je erkanntem Signalobjekt (erkanntem prototypischen Merkmalsvektor der Prototypendatenbank) nur ein Symbol (Index) für den erkannten prototypischen Merkmalsvektor der Prototypendatenbank 62115 (erkannten Signalformprototypen), dessen Parameter (z.B. Gewichtungsfaktor und/oder zeitliche Streckung) und einen zeitlicher Referenzpunkt des Auftretend dieses erkannten Signalformprototypen (der Zeitstempel) als erkanntes Signalobjekt an das übergeordnete Rechnersystem.

Die Übertragung der einzelnen Abtastwerte etc. entfällt. Auf diese Weise führt diese Selektion der relevanten prototypischen Merkmalsvektoren der Prototypendatenbank 62115 zu einer massiven Datenkompression und zu einer Reduktion der benötigten Busbandbreite auf dem Datenbus zur Übertragung der Parameterwerteverläufe an das übergeordnete Rechnersystem 12.

Es erfolgt also eine quantitative Erfassung des Vorliegens einer Kombination von Eigenschaften unter Bildung eines Schätzwertes - hier z.B. des inversen Abstands zwischen dem Repräsentanten der prototypischen Signalobjektklasse in Form des vorgegebenen prototypischen Merkmalsvektors (Prototyp oder Prototypenvektor) der Prototypendatenbank- und das anschließende Übertragen der komprimierten Daten an das übergeordnete Rechnersystem 12, wenn der Betrag dieses Schätzwertes (z.B. inverser Abstand) über einem zweiten Schwellwert bzw. der inverse Schätzwert unter einem ersten Schwellwert liegt. Die Steuervorrichtung 4 der Sicherung 1 führt somit eine Datenkompression der Parameterwerteverläufe der erfassten Parameterwerte der erfassen physikalischen Parameter der Sicherung 1 zur Erzeugung komprimierter Daten aus.

Bevorzugt umfasst das übergeordnete Rechnersystem 12 eine Prototypendatenbank, die bevorzugt den gleichen Inhalt, wie die Prototypendatenbank 62115 der Steuervorrichtung 4 der Sicherung 1 aufweist.

Bevorzugt signalisiert die Steuervorrichtung 4 der Sicherung 1 dem übergeordneten Rechnersystems 12 den Beginn der Übertragung der komprimierten Daten eines zeitlichen Abtastfensters.

Das übergeordnete Rechnersystem 12 stellt bevorzugt rekonstruierte Abtastwerte des rekonstruierten Parameterwerteverlaufs der rekonstruierten Parameterwerte der rekonstruierten physikalischen Parameter bereit. Zu Anfang des Dekompressionsprozesses entsprechen diese rekonstruierten Parameterwerte typischerweise vorgegebenen Startwerten für diese rekonstruierten Parameterwerte.

In einem beispielhaften Rekonstruktionsverfahren empfängt nun das übergeordnete Rechnersystem 12 von der Steuervorrichtung 4 der Sicherung Datensätze, die jeweils den Index eines erkannten prototypischen Merkmalsvektors der Prototypendatenbank 62115 und einen Gewichtungsfaktor und einen Zeitstempel umfassen. Das übergeordnete Rechnersystem multipliziert einen prototypischen Verlauf des rekonstruierten Parameterwerteverlaufs der rekonstruierten Parameterwerte der rekonstruierten physikalischen Parameter aus der Prototypendatenbank, dessen Index in der Prototypendatenbank 62115 mit dem von der Steuervorrichtung 4 der Sicherung 1 übermittelten Index übereinstimmt, und verschiebt diesen zeitlich um einen zeitlichen Verschiebungsvektor, der von dem Zeitstemple abhängt, den das übergeordnete Rechnersystem 12 von der Steuervorrichtung 4 der Sicherung erhalten hat, sodass das Rechnersystem einen erkannten und gewichteten und zeitlich verschobenen rekonstruierten Parameterwerteverlauf der rekonstruierten Parameterwerte der rekonstruierten physikalischen Parameter für diesen erkannten Merkmalsvektor der Prototypendatenbank 62115 erhält, der mit dem empfangenen Index korrespondiert. Der erkannte und gewichtete und zeitlich verschobene rekonstruierte Parameterwerteverlauf der rekonstruierten Parameterwerte der rekonstruierten physikalischen Parameter für diesen erkannten Merkmalsvektor der Prototypendatenbank 62115 umfasst im Wesentlichen rekonstruierte Abtastwerte dieses erkannten und gewichteten und zeitlich verschobenen rekonstruierten Parameterwerteverlaufs der rekonstruierten Parameterwerte der rekonstruierten physikalischen Parameter für diesen erkannten Merkmalsvektor der Prototypendatenbank. Das übergeordnete Rechnersystem 12 addiert nun den erkannten und gewichteten und zeitlich verschobenen rekonstruierten Parameterwerteverlauf der rekonstruierten Parameterwerte der rekonstruierten physikalischen Parameter für diesen erkannten Merkmalsvektor der Prototypendatenbank 62115 für jeden der erkannten rekonstruierten Abtastwerte zu den vorbeschrieben rekonstruierten Abtastwerte des rekonstruierten Parameterwerteverlaufs der rekonstruierten Parameterwerte der rekonstruierten physikalischen Parameter, die das übergeordnete Rechnersystem 12 bereitgestellt hat.

Danach empfängt das Rechnersystem den nächsten Datensatz und addiert den dann auf Basis des dann empfangenen Datensatzes erkannten und gewichteten und zeitlich verschobenen rekonstruierten Parameterwerteverlauf der rekonstruierten Parameterwerte der rekonstruierten physikalischen Parameter für den dann übermittelten erkannten Merkmalsvektor der Prototypendatenbank 62115 für jeden der erkannten rekonstruierten Abtastwerte zu den vorbeschrieben rekonstruierten Abtastwerte des rekonstruierten Parameterwerteverlaufs der rekonstruierten Parameterwerte der rekonstruierten physikalischen Parameter, die das übergeordnete Rechnersystem 12 bereitgestellt hat.

Dies setzt das Rechnersystem 12 fort, bis die Steuervorrichtung 4 der Sicherung 1 das Ende der Übertragung der komprimierten Daten für dieses Abtastfenster signalisiert.

Zur besseren Klarheit erläutert das hier vorgelegte Dokument die Abstandermittlung hier nochmals:
Diese Abstandsermittlung ist auch als Klassifikation aus der Signalverarbeitung statistischer Signale bekannt. Als Klassifikatorbeispiele seien hier die logistische Regression, der Quader-Klassifikator, der Abstandsklassifikator, der Nächste-Nachbarn-Klassifikator, der Polynomklassifikator, das Clusterverfahren, künstliche neuronale Netze, latente Klassenanalyse genannt.

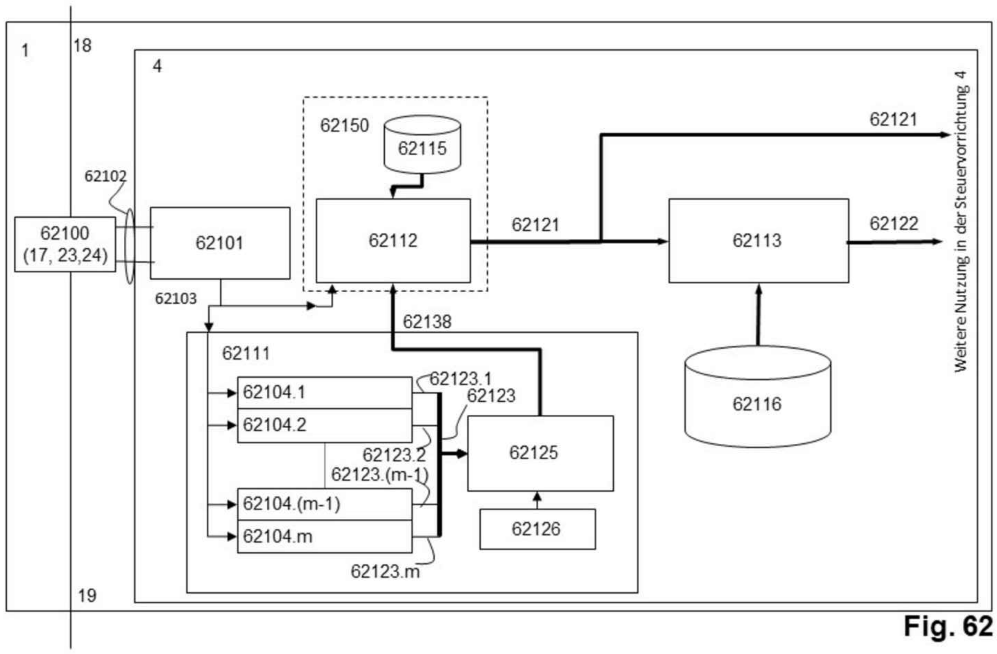

Ein Klassifikator-Beispiel ist in Figur 62 dargestellt.

Eine beispielhafte physikalische Schnittstelle 62101 der Steuervorrichtung 4 steuert Mittel 62100 zur Erfassung der physikalischen Parameter der Sicherung 1 an. Diese Mittel 62100 können beispielsweise Shunt-Widerstände 24 und/oder der Leistungsschalter 17 und/oder der Hilfsleistungsschalter 23 und andere Vorrichtungteile der Sicherung 1 und/oder der Steuervorrichtung 4 sein. Die physikalische Schnittstelle 62101 kann beispielsweise den Analog-zu-Digital-Wandler 570 der Steuervorrichtung 4 und/oder die Gate-Ansteuerschaltung 16 der Steuervorrichtung 4 für die Ansteuerung und Überwachung des Leistungsschalters 17 umfassen. Wie oben bereits beschrieben, kann es sich bei den physikalischen Parametern beispielsweise um Stromwerte elektrischer Ströme 29, 36 und/oder Spannungswerte und/oder Leistungswerte und/oder Temperaturen handeln. Vorrichtungsteile der Steuervorrichtung 4 der Figur 62 können in Hardware ausgeführt sein oder als Software durch den Rechnerkern 2 der Steuervorrichtung emuliert werden. Die Programmbefehle und Programmdaten dieser Software befinden sich bevorzugt in einem Speicher der Steuervorrichtung 4.

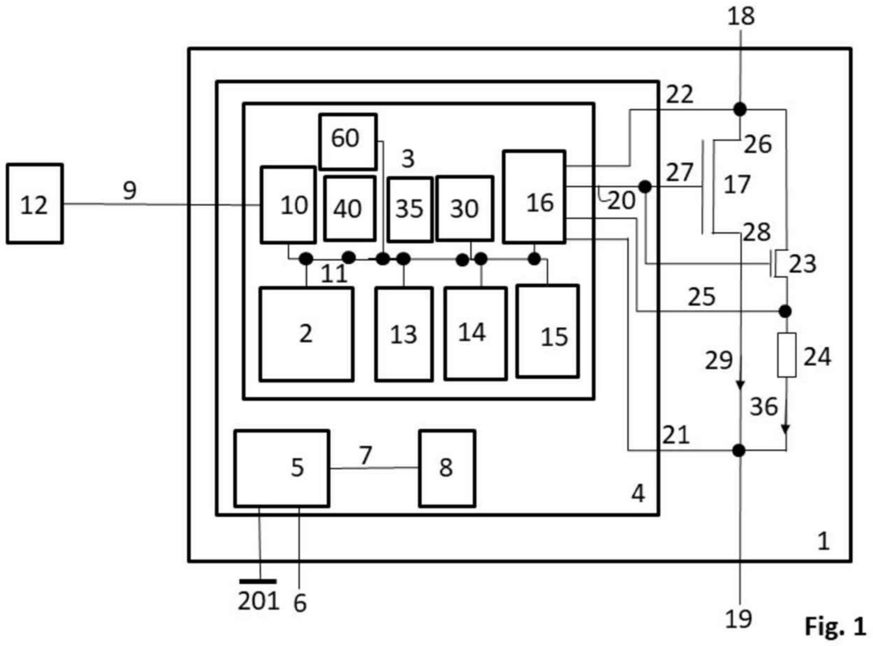

In der Figur 62 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 62 je nach Anwendung vorhanden annehmen kann, finden sich beispielsweise in den Figuren 1, 5, 6, 9, 24, 41, 42, 52, 53, 54, 55, 57, 58. Die Kombination der Vorrichtungteile der hier beschriebenen Figur mit solchen dieser Figuren ist ausdrücklich Teil der Offenbarung des hier vorgelegten Dokuments.

Die Mittel 62100 zur Erfassung der physikalischen Parameter der Sicherung 1 wandelt die Werte der physikalischen Parameter, die die Sicherung 1 erfassen soll, in Signale 62102 der zeitlichen Parameterwertverläufe und/oder die entsprechenden zeitlichen Verlaufen der aus diesen Parameterwertverläufen der physikalischen Parameter abgeleiteten Parameter um. Die physikalische Schnittstelle 62101 wandelt diese Signale 62102 der zeitlichen Parameterwertverläufe und/oder die entsprechenden zeitlichen Verlaufen der aus diesen Parameterwertverläufen der physikalischen Parameter abgeleiteten Parameter, typischerweise durch Filterung und/oder Verstärkung in ein Parametersignal 62103 um. Bevorzugt bilden Folgen von Abtastwerten das Parametersignal 62103. Die Merkmalsvektorextraktion 62111 extrahiert aus diesem Parametersignal 62103 den aktuellen Merkmalsvektor. Bevorzugt übermittelt die physikalische Schnittstelle 62101 an die Merkmalsvektorextraktion 62111 das Parametersignal 62103 als ein zeitdiskretes Signal bestehend aus einer Folge von Abtastwerten. Jedem Abtastwert ist dabei bevorzugt ein zeitliches Datum (Zeitstempel) zugeordnet. Die Merkmalsvektorextraktion 62111 weist in dem Beispiel der Figur 62 eine Mehrzahl von m Optimalfiltern 62104.1 bis 62104.m auf. Die Zahl m ist dabei eine ganze positive Zahl. Diese m Optimalfilter 62104.1 bis 62104.m dienen der Bestimmung von m Zwischenparametersignalen 62123.1 bis 62123.m. Die m Zwischenparametersignalen 62123.1 bis 62123.m signalisieren jeweils das Vorliegen jeweils bevorzugt genau eines dem jeweiligen Zwischenparametersignal der m Zwischenparametersignalen 62123.1 bis 62123.m bevorzugt zugeordneten Signalgrundobjekts bevorzugt mit Hilfe eines geeigneten Filters (z.B. eines Optimalfilters) aus der Folge von Abtastwerten des Parametersignal 62103. Das hier vorgelegte Dokument meint zum Ersten mit Signalgrundobjekt einen zeitlichen prototypischen Parameterwertverlauf und/oder den zeitlichen Verlauf eines aus diesen Parameterwertverläufen der physikalischen Parameter abgeleiteten Parameters der Prototypendatenbank, wenn die Prototypendatenbank 62115 solche zeitlichen prototypischen Parameterwertverläufe und/oder solche zeitlichen Verläufe eines aus diesen Parameterwertverläufen der physikalischen Parameter abgeleiteten Parameters als Teil der Datensätze der Prototypendatenbank 62115 umfasst. Das hier vorgelegte Dokument meint zum Zweiten mit Signalgrundobjekt einen prototypischen Merkmalsvektor der Prototypendatenbank, wenn die Prototypendatenbank 62115 solche prototypischen Merkmalsvektoren als Teil der Datensätze der Prototypendatenbank 62115 umfasst. In der Figur 62 sind die m Zwischenparametersignale 62123.1 bis 62123.m zu einem Zwischenparametersignalbündel 62123 beispielhaft zur besseren Übersicht zusammengefasst. Die sich ergebenden m Zwischenparametersignale 62123.1 bis 62123.m sind bevorzugt als zeitdiskrete Folge von jeweiligen Zwischenparametersignalwerten eines jeweiligen Zwischenparametersignals der m Zwischenparametersignale 62123.1 bis 62123.m ausgebildet. Bevorzugt sind diese Zwischenparametersignalwerten des jeweiligen Zwischenparametersignals der m Zwischenparametersignale 62123.1 bis 62123.m jeweils mit einem Datum (Zeitstempel) korreliert. Somit ist bevorzugt jedem Zwischenparametersignalwert der jeweiligen Zwischenparametersignals der m Zwischenparametersignale 62123.1 bis 62123.m genau ein zeitliches Datum (Zeitstempel) zugeordnet. Zwischenparametersignalwerte der m Zwischenparametersignale 62123.1 bis 62123.m des Zwischenparametersignalbündels 62123 mit gleichem Zeitstempel bilden jeweils einen Zwischenparametersignalwertvektor. Das Zwischenparametersignalbündel 62123 überträgt somit einen Strom von Zwischenparametersignalwertvektoren an den nachfolgenden Signalverarbeitungsblock, die Signifikanzsteigerungseinheit 62125;

Die nachfolgende Signifikanzsteigerungseinheit 62125 führt bevorzugt eine Matrixmultiplikation des aktuellen Zwischenparametersignalwertvektors mit einer sogenannten LDA-Matrix 62126 durch. Die Konstrukteure einer solchen Sicherung 1 bestimmen typischerweise zum Konstruktionszeitpunkt mittels statistischer Methoden der statistischen Signalverarbeitung und der Mustererkennung die LDA-Matrix 62126. Hierzu führen die Konstrukteure, die die hier in diesem Dokument vorgestellte technische Lehre nacharbeiten wollen, beispielsweise eine Diskriminanzanalyse durch. (siehe auch https://de.wikipedia.org/wiki/Diskriminanzanalyse) Im englischen Sprachraum ist der Begriff "linear discriminant analysis" (https://en.wikipedia.org/wiki/Linear_discriminant_analysis) üblich. Das hier vorgelegte Dokument verweist hier beispielhaft auf das Buch Mohssen Mohammed, "Machine Learning: Algorithms and Applications" CRC Press (30. Juni 2020), ISBN-10: 0367574675; ISBN-13: 978-0367574673 und das Buch Alan J. Izenman, "Modern Multivariate Statistical Techniques: Regression, Classification, and Manifold Learning (Springer Texts in Statistics)" Springer; 1st ed. 2008, Corr. 2nd printing 2013 Edition (28. August 2008); ISBN-10 038778188; ISBN-13 978-0387781884. Die Signifikanzsteigerungseinheit 62125 erzeugt auf diese Weise das Signal des aktuellen Merkmalsvektors 62138. Hierbei bildet die Signifikanzsteigerungseinheit 62125 die aktuellen m Zwischenparametersignalwerte des aktuellen Zwischenparametersignalwertvektors auf n Parametersignalwerte des Signals des aktuellen Merkmalsvektors 62138 ab. Hierbei steht n für eine ganze, positive Zahl, die von m abweichen kann oder gleich m sein kann. Bevorzugt gilt jedoch n<m. Typischerweise umfasst also das Signal des aktuellen Merkmalsvektors 62138 n Parametersignale. Das Signal des aktuellen Merkmalsvektors 62138 ist somit u.a. als zeitdiskrete Folge von ermittelten Merkmalsvektoren. Jeder dieser Merkmalsvektoren umfasst n Vektorkomponenten des betreffenden Merkmalsvektors. Diese n Vektorkomponenten des betreffenden Merkmalsvektors stellen jeweils n Parametersignalwerte der bevorzugt n Parametersignale des Signals des aktuellen Merkmalsvektors 62138 dar, die die Parametersignalwerte als Vektorkomponenten des betreffenden Merkmalsvektors und weitere Parametersignalwerte mit jeweils gleichem zeitlichem Datum (Zeitstempel) umfassten. Hierbei ist n die Dimension der einzelnen Merkmalsvektoren, Diese Dimension n der Merkmalsvektoren ist bevorzugt von einem Merkmalsvektor zum nächsten nachfolgenden Merkmalsvektor gleich. Ein Merkmalsvektor ist in diesem Sinne ein Vektor mit einem Zeitstempel, der mehrere, bevorzugt n, Parametersignalwerte als Vektorkomponenten dieses Merkmalsvektors umfasst. Jedem so gebildeten Merkmalsvektor ordnet die Merkmalsvektorextraktion 62111 der Steuerungsvorrichtung 4 der Sicherung 1 dieses jeweilige zeitliche Datum, also diesen Zeitstempel zu.

Im Signalpfad folgt nun die Auswertung des zeitlichen Verlaufs des Signals des aktuellen Merkmalsvektors 62138 in dem sich ergebenden n-dimensionalen Phasenraum. Außerdem folgt das das Schließen auf ein erkanntes Signalgrundobjekt unter Ermittlung eines Bewertungswerts (z.B. des Abstands). Zu dem Verständnis des Begriffs "Signalgrundobjekt" verweist das hier vorgelegte Dokument auf den vorausgehenden Text.

Das hier vorgelegte Dokument meint zum Ersten mit Signalgrundobjekt einen zeitlichen prototypischen Parameterwertverlauf und/oder den zeitlichen Verlauf eines aus diesen Parameterwertverläufen der physikalischen Parameter abgeleiteten Parameters der Prototypendatenbank, wenn die Prototypendatenbank 62115 solche zeitlichen prototypischen Parameterwertverläufe und/oder solche zeitlichen Verläufe eines aus diesen Parameterwertverläufen der physikalischen Parameter abgeleiteten Parameters als Teil der Datensätze der Prototypendatenbank 62115 umfasst. Das hier vorgelegte Dokument meint zum Zweiten mit Signalgrundobjekt einen prototypischen Merkmalsvektor der Prototypendatenbank, wenn die Prototypendatenbank 62115 solche prototypischen Merkmalsvektoren als Teil der Datensätze der Prototypendatenbank 62115 umfasst.

Ein Abstandsermittler (oder Klassifikator) 62112 vergleicht nun den aktuellen Merkmalsvektor des Signals des aktuellen Merkmalsvektors 62138 mit einer Mehrzahl von prototypischen, den zuvor typischerweise während der Konstruktionsphase in der Prototypendatenbank 62115 61115 abgespeicherten prototypischen Merkmalsvektoren. Das hier vorgelegte Dokument erläutert dies im Folgenden noch detaillierter. Der Abstandsermittler oder Klassifikator 62112 ermittelt beispielsweise dabei einen Bewertungswert für jeden der untersuchten prototypischen Merkmalsvektoren der Prototypendatenbank 62115 62115, der angibt, inwieweit der jeweilige prototypische Merkmalsvektor der Prototypendatenbank 62115 dem aktuellen Merkmalsvektor gleicht. Das hier vorgelegte Dokument bezeichnet diesen Bewertungswert auch im Text der Beschreibung als Abstand. Der Abstand kann ein euklidischer Abstand sein, muss es aber nicht. Bevorzugt sind die prototypischen Merkmalsvektoren der Prototypendatenbank 62115 jeweils bevorzugt genau einem Signalgrundobjekt zugeordnet. Derjenige prototypische Merkmalsvektor der Prototypendatenbank 62115 mit dem kleinsten Abstand zu dem aktuellen Merkmalsvektor gleicht diesen dann am besten. Ist dessen Abstand kleiner als ein vorgegebener Schwellwert, so repräsentiert dieser prototypischen Merkmalsvektoren der Prototypendatenbank 62115 das mit höchster Wahrscheinlichkeit erkannte Signalgrundobjekt 62121. Dieser prototypischen Merkmalsvektoren der Prototypendatenbank 62115 ist dann der erkannte prototypische Merkmalsvektor der Prototypendatenbank 62115 62115.

Dieser Erkennungsprozess wird zeitlich mehrmals hintereinander ausgeführt, sodass sich typischerweise eine ermittelte Signalgrundobjektfolge aus der zeitlichen Folge der erkannten Signalgrundobjekte 62121 in Form einer zeitlichen Folge nacheinander erkannter Merkmalsvektoren ergibt. Dies ermöglicht es, Störungen zu erkennen und zu eliminieren.

Vorzugsweise folgt dann die Ermittlung des wahrscheinlich vorliegenden Signalobjekts 62122 durch Ermittlung derjenigen Folge vorgegebener Signalgrundobjektfolgen einer Signalobjektsequenzdatenbank 62116, die der ermittelten Signalgrundobjektfolge aus der zeitlichen Folge der erkannten Signalgrundobjekte 62121 am ähnlichsten ist. Die Signalobjektsequenzdatenbank 62116 stellt ein Lexikon bekannter prototypischer zeitlicher Folgen prototypischer Signalgrundobjekte der Prototypendatenbank 62115 dar. Eine solche, bekannte, prototypische, zeitliche Folge von Signalgrundobjekten der Prototypendatenbank 62115 ist ein prototypisches Signalobjekt der Signalobjektsequenzdatenbank 62116 im Sinne des hier vorgelegten Dokuments.

Im Sinne des hier vorgelegten Dokuments besteht dabei ein Signalobjekt, aus einer zeitlichen, definierten Abfolge von Signalgrundobjekten. Das hier vorgelegte Dokument bezeichnet diese zeitliche, definierte Abfolge von Signalgrundobjekten auch als Signalobjektsequenz.

Dem Signalobjekt ist dabei typischerweise vordefiniert ein Signalobjektsymbol in der Signalobjektsequenzdatenbank 62116 zugeordnet. Ein Datensatz der Signalobjektsequenzdatenbank 62116 umfasst beispielsweise das Signalobjektsymbol, die Anzahl der Signalgrundobjekte dieser Signalobjektsequenz dieses Signalobjekts und für jedes Signalgrundobjekt der Signalobjektsequenz der Signalgrundobjekte dieses Signalobjekts jeweils ein Signalgrundobjektsymbol, das das betreffende Signalgrundobjekt der Prototypendatenbank 62115 bezeichnet. Die Signalobjektsequenzdatenbank 62116 umfasst also Datensätze, die prototypische Signalobjektsequenzen aus Signalgrundobjekten umfassen. Jeder der Datensätze der Signalobjektsequenzdatenbank 62116 beschreibt dabei ein Signalobjekt als Sequenz von Signalgrundobjekten. Bevorzugt handelt es sich bei dem Signalgrundobjektsymbol um den betreffenden Index des betreffenden Signalgrundobjekts in der Prototypendatenbank 62115 62115. Bevorzugt handelt es sich bei dem Signalobjektsymbol um den Index des Signalobjekts in der Signalobjektsequenzdatenbank 62116.

Beispielsweise kann ein Viterbi-Schätzer 62113 der Steuervorrichtung 4 diese Schätzung der Signalobjektsequenz der Signalgrundobjekte des Signalobjekts durchführen. Der Viterbi-Schätzer 62113 ist bevorzugt ein Vorrichtungsteil der Steuervorrichtung 4 der Sicherung 1. Alternativ kann ein Vorrichtungsteil der Steuervorrichtung 4 der Sicherung 1, beispielsweise der Rechnerkern 2 der Steuervorrichtung 4 der Sicherung 1, den Viterbi-Schätzer 62113 auch emulieren.

Im Sinne des hier vorgelegten Dokuments sind korrekt platzierte und erkannte Signalgrundobjekte solche, die entsprechend ihrer Position in der ermittelten Signalgrundobjektfolge 62121 aus der zeitlichen Folge der erkannten Signalgrundobjekte mit der Position eines erwarteten Signalgrundobjekts in einer in der Signalobjektdatenbank 62116 als vorgegebenes Signalobjekt vorgegebenen erwarteten Folge von Signalgrundobjekten an dieser Position in der Folge übereinstimmen.

Im Sinne des hier vorgelegten Dokuments sind NICHT korrekt platzierte und erkannte Signalgrundobjekte solche, die entsprechend ihrer Position in der ermittelten Signalgrundobjektfolge 62121 aus der zeitlichen Folge der erkannten Signalgrundobjekte NICHT mit der Position eines erwarteten Signalgrundobjekts in einer in der Signalobjektdatenbank 62116 als vorgegebenes Signalobjekt vorgegebenen erwarteten Folge von Signalgrundobjekten an dieser Position in der Folge übereinstimmen.

Im einfachsten Fall verwendet der Viterbi-Schätzer 62113 die Anzahl der innerhalb eines vorgegebenen Zeitraums korrekt platzierte und erkannten Signalgrundobjekte minus der Anzahl der innerhalb des vorgegebenen Zeitraums NICHT korrekt platzierten erkannten Signalgrundobjekte als Bewertungswert für die Übereinstimmung der ermittelten Signalgrundobjektfolge 62121 mit einer in der Signalobjektdatenbank 62116 als vorgegebenes Signalobjekt vorgegebenen erwarteten Folge von Signalgrundobjekten.

Auf diese Weise ermittelt der Viterbi-Schätzer 62133 vorzugsweise für bevorzugt jedes der vorgegebenen Signalobjekte der Signalobjektdatenbank 62116 einen solchen Bewertungswert. Dabei bestehen die Signalobjekte der Signalobjektdatenbank 62116 aus vorgegebenen Folgen von erwarteten Signalgrundobjekten und sind mit einem jeweiligen Signalobjektsymbol korreliert sind.

Bildlich gesprochen prüft der der Viterbi-Schätzer 62133 hier, ob der Punkt, auf den das n-dimensionale Signal des aktuellen Merkmalsvektors 62138 im n-dimensionalen Phasenraum zeigt, bei seinem Wege durch den n-dimensionalen Phasenraum in vorbestimmter zeitlicher Abfolge sich vorbestimmten Punkten in diesem n-dimensionalen Phasenraum näher als ein vorgegebener Maximalabstand nähert. Das Signal des aktuellen Merkmalsvektors 62138 hat also einen zeitlichen Verlauf. Der Viterbi-Schätzer 62133 berechnet dann einen Bewertungswert (z.B. einen Abstand) bevorzugt für jedes der prototypischen Signalobjekte der Signalobjektsequenzdatenbank 62116. Diese Bewertungswerte bilden also einen Bewertungswertvektor. Die Dimension des Bewertungswertvektors entspricht bevorzugt der Anzahl der prototypischen Signalobjekte in der Signalobjektsequenzdatenbank 62116. Der Viterbi-Schätzer 62133 berechnet bevorzugt die Wahrscheinlichkeit für das Vorliegen einer bestimmten prototypischen Sequenz der Signalgrundobjekte eines Signalobjekts der Signalobjektdatenbank 62116, also eines prototypischen Signalobjekts der Signalobjektsequenzdatenbank 62116. Bevorzugt ordnet der Viterbi-Schätzer 62133 diesem Bewertungswertvektor wieder ein zeitliches Datum (Zeitstempel) zu. Der Viterbi-Schätzer 62113 vergleicht diesen Bewertungswertvektor mit einem vorzugsweise vorgegebenen oder eingestellten Schwellwertvektor unter Bildung Resultats. Bevorzugt ist das Resultat boolesch. D.h. bevorzugt kann das Resultat einen ersten und einen zweiten Wert aufweisen. Wenn dieses boolesche Resultat für dieses zeitliche Datum (Zeitstempel) den ersten Wert hat, prüft die Steuerungsvorrichtung, ob das Signalobjektsymbol des erkannten prototypischen Signalobjekts der Signalobjektsequenzdatenbank 62116 das Ausführen eines typischerweise vorbestimmten Verfahrens verlangt und welches typischerweise vorbestimmte Verfahren mit welchen Parametern die Steuervorrichtung 4 und/oder der Rechnerkern 2 der Steuervorrichtung 4 der Sicherung ausführen sollen. Diese Information ist typischerweise Teil des Datensatzes des erkannten prototypischen Signalobjekts der Signalobjektsequenzdatenbank 62116.

Ein mögliches Verfahren, dass die Steuervorrichtung 4 der Sicherung nach dem Erkennen des erkannten prototypischen Signalobjekts der Signalobjektsequenzdatenbank 62116 durch den Viterbi-Schätzer 62113 der Steuervorrichtung 4 der Sicherung 1 beispielsweise ausführen kann, kann das Übertragen des erkannten Signalobjektsymbols des erkannten prototypischen Signalobjekts der Signalobjektsequenzdatenbank 62116 mit dem diesem Signalobjektsymbol zugeordneten zeitlichen Datum (Zeitstempel) von der der Steuervorrichtung 4 der Sicherung 1 zu dem übergeordneten Rechnersystem 12 sein.

Ein mögliches Verfahren, dass die Steuervorrichtung 4 der Sicherung nach dem Erkennen des erkannten prototypischen Signalobjekts der Signalobjektsequenzdatenbank 62116 durch den Viterbi-Schätzer 62113 der Steuervorrichtung 4 der Sicherung 1 beispielsweise ausführen kann, kann das Übertragen des erkannten Signalobjektsymbols des erkannten prototypischen Signalobjekts der Signalobjektsequenzdatenbank 62116 mit dem diesem Signalobjektsymbol zugeordneten zeitlichen Datum (Zeitstempel) von der der Steuervorrichtung 4 der Sicherung 1 zu der Steuervorrichtung 4 einer anderen Sicherung sein.

Ein mögliches Verfahren, dass die Steuervorrichtung 4 der Sicherung nach dem Erkennen des erkannten prototypischen Signalobjekts der Signalobjektsequenzdatenbank 62116 durch den Viterbi-Schätzer 62113 der Steuervorrichtung 4 der Sicherung 1 beispielsweise ausführen kann, kann das Übertragen des erkannten Signalobjektsymbols des erkannten prototypischen Signalobjekts der Signalobjektsequenzdatenbank 62116 mit dem diesem Signalobjektsymbol zugeordneten zeitlichen Datum (Zeitstempel) von der der Steuervorrichtung 4 der Sicherung 1 zu einem Server 710 sein. Hierdurch erhält der Betreiber des Servers 710 Kenntnis von solchen Ereignissen.

Vorzugsweise kann dann der Betreiber des Servers diese Daten zur weiteren statistischen Auswertung verwenden.

Die Steuervorrichtung 4 der Sicherung 1 überträft das erkannte prototypische Signalobjekt 62122 der Signalobjektsequenzdatenbank 62116 bevorzugt mit seinen Parametern. Ggf. kann die Steuervorrichtung 4 der Sicherung 1 je nach erkanntem prototypischen Signalobjekt der Signalobjektsequenzdatenbank 62116 weitere Parameter übertragen.

An dieser Stelle geht das hier vorgelegte Dokument zur besseren Klarheit nochmals auf die Verarbeitung des Signals des aktuellen Merkmalsvektors 62138 ein.

Bevorzugt signalisiert das Parametersignal 62103 eine Folge von Quantisierungsvektoren in Form von Abtastwerten der Werte der physikalischen Parameter in diesem zeitlichen Abtastfenster, die die physikalische Schnittstelle 62101 der Steuervorrichtung 4 der Sicherung im Zusammenwirken mit den Mittel 62100 zur Erfassung physikalischen Parameter der Sicherung 1 ermitteln. Wie oben erläutert wandelt nämlich die physikalische Schnittstelle 62101 die Signale 62102 der zeitlichen Parameterwertverläufe und/oder die entsprechenden zeitlichen Verlaufen der aus diesen Parameterwertverläufen der physikalischen Parameter abgeleiteten Parameter, die die Mittel 62100 zur Erfassung physikalischen Parameter der Sicherung 1 erfassen, typischerweise durch Filterung und/oder Verstärkung in ein Parametersignal 62103 um. Bevorzugt bilden Folgen von Abtastwerten das Parametersignal 62103, deren Komponenten, die gemessenen Parameter, im Allgemeinen aber nicht vollkommen unabhängig voneinander sein werden. Jeder Abtastwert des Parametersignals 62103 für sich weist in der Regel eine zu geringe Selektivität für die genaue Signalobjektermittlung in komplexen Zusammenhängen auf. Durch die Erstellung eines oder mehrerer solcher Quantisierungsvektoren aus dem kontinuierlichen Strom abgetasteter analoger physikalischer Werte des Parametersignals 62103 in typischerweise regelmäßigen oder regulären Zeitabständen durch das physikalische Interface 62101 (siehe Figur 62) entsteht der zeitlich und wertemäßig quantisierter mehrdimensionaler Parameterwertverlaufsdatenstrom in Form des Parametersignals 62103.

Dieses so gewonnene mehrdimensionale Parametersignal 62103 in Form eines oder mehrerer Ströme von Quantisierungsvektoren wird in einem ersten beispielhaften Bearbeitungsschritt zunächst in einzelne Frames definierter Länge, den besagten Abtastfenstern, unterteilt, gefiltert, normiert, dann orthogonalisiert und ggf. durch eine nichtlineare Abbildung - z.B. Logarithmierung und Cepstrum-Analyse etc. -geeignet verzerrt. Dies ist durch den Block der m Optimalfilter 62104.1 bis 62104.m in der Merkmalsvektorextraktion 62111 der Figur 62 angedeutet. Statt des Blocks der Optimalfilter 62104.1 bis 62104.m kann man sich hier also auch andere Signalaufbereitungsstrukturen zur Erzeugung der Zwischenparametersignale 62123.1 bis 62123.m des Zwischenparametersignalbündels 62123 vorstellen. Beispielsweise können hier auch Ableitungen der so generierten Abtastwerte des mehrdimensionalen Parametersignals 62103 gebildet werden. Schließlich führt die Signifikanzsteigerungseinheit 62125 eine Signifikanzsteigerung des ermittelten Zwischenparametersignale 62123.1 bis 62123.m des Zwischenparametersignalbündels 62123 zum eigentlichen Signal des aktuellen Merkmalsvektors 62138 durch. Die Signifikanzsteigerungseinheit 62125 kann eine Signifikanzsteigerung des ermittelten Zwischenparametersignale 62123.1 bis 62123.m des Zwischenparametersignalbündels 62123, wie beschrieben, beispielsweise durch Multiplikation des mehrdimensionalen Quantifizierungssektors des Zwischenparametersignalbündels 62123 mit einer so genannten, vorgegebenen LDA-Matrix 62126 vornehmen.

Der nun folgende Schritt der Erkennung in dem Abstandsermittler (bzw. Klassifikator) 62112, kann dieser Abstandsermittler (bzw. Klassifikator) 62112 beispielsweise mittels unterschiedlicher Methoden durchführen:

a) durch ein Neuronales Netz oder
b) durch einen HMM-Erkenner oder
c) durch ein Petri-Netz

Das hier vorgelegte Dokument beschreibt beispielhaft einen HMM-Erkenner (Figur 62):
Mit Hilfe der besagten vordefinierten LDA-Matrix 62126 bildet die Signifikanzsteigerungseinheit 62125 die Zwischenparametersignale 62123.1 bis 62123.m des Zwischenparametersignalbündels 62123 des Zwischenparameterdatenstroms 62123 von dem mehrdimensionalen Eingangsparameterraum auf einen neuen Parameterraum ab. Die Matrixelemente der LDA-Matrix 62126 sind dabei so gewählt, dass die Signifikanz möglichst maximiert ist und so die Selektivität maximal wird. Die Komponenten der dabei gewonnenen neuen transformierten Merkmalsvektoren des Signals des aktuellen Merkmalsvektors 62138 werden hierbei nicht nach realen physikalischen oder sonstigen Parametern, sondern nach maximaler Signifikanz ausgewählt, was besagte maximale Selektivität zur Folge hat.

Die Konstrukteure einer solchen Sicherung 1 berechnen die LDA-Matrix (126) bevorzugt in der Regel zuvor zum Konstruktionszeitpunkt durch einen Trainingsschritt offline unter Benutzung von Beispieldatenströmen mit bekannten Signalobjektdatensätzen. Solche bekannten Signalobjektdatensätze sind im Sinne des hier vorgelegten Dokuments Datensätze, die mit vorgegeben Strukturen der Signalverläufe der zeitlichen Parameterwertverläufe und/oder der entsprechenden zeitlichen Verläufe der aus diesen Parameterwertverläufen der physikalischen Parameter abgeleiteten Parameter gewonnen wurden.

Wenn Sorge getragen wird, dass alle Elemente der des vom Abstandsermittler (bzw. dem Klassifikator) 62112 durchgeführten Verfahren zumindest lokal umkehrbare Funktionen ausführen, so können Abweichungen des Signalverlaufs in Form einer annähernd linearen Transformationsfunktion berücksichtigt werden.

Die prototypischen Merkmalsvektoren aus Beispieldatenströmen für die vorgegebenen prototypischen Signalverläufe (prototypische Signalgrundobjekte) der zeitlichen Parameterwertverläufe und/oder der entsprechenden zeitlichen Verläufe der aus diesen Parameterwertverläufen der physikalischen Parameter abgeleiteten Parameter in den Koordinaten des neuen Parameterraumes werden in der Konstruktionsphase berechnet und in der Prototypendatenbank 62115 für die spätere Wiedererkennung hinterlegt. Diese kann neben diesen statistischen Daten auch Anweisungen für die Steuervorrichtung 4 der Sicherung 1 und/oder das übergeordnete Rechnersystem 12 enthalten, was bei einer erfolgreichen bzw. fehlgeschlagenen Erkennung des jeweiligen prototypischen Signalgrundobjekts, also beispielsweise eines prototypischen Merkmalsvektors, geschehen soll.

Die Konstrukteure einer nachgearbeiteten Vorrichtung gemäß der technischen Lehre des hier vorgelegten Dokuments sichern die Werte der Vektorkomponenten des Signals des aktuellen Merkmalsvektors 62138, die von der Merkmalsvektorextraktion 62111 für diese prototypischen Signalverläufe der vorgegebenen Signalgrundobjekte des Parametersignals 62103 im Labor ausgegeben werden, in der Prototypendatenbank 62115 als Signalgrundobjektprototypen beispielsweise in Form prototypischer Merkmalsvektoren.

Die Steuervorrichtung 4 der Sicherung 1 vergleicht im späteren Betrieb den aktuellen Merkmalsvektor des Signals des aktuellen Merkmalsvektors 62138 nun mit diesen vorab eingespeicherten, d.h. erlernten Signalgrundobjektprototypen in Form prototypischer Merkmalsvektoren der Prototypendatenbank 62115 62115. Die Steuervorrichtung 4 der Sicherung 1 führt diesen Vergleich beispielsweise durch Berechnung des euklidischen Abstands zwischen einem Quantisierungsvektor in Form eines aktuellen Merkmalsvektors des Signals des aktuellen Merkmalsvektors 62138 in den Koordinaten des neuen Parameterraumes durch. Die Steuervorrichtung 4 der Sicherung 1 vergleicht den Quantisierungsvektor in Form eines aktuellen Merkmalsvektors des Signals des aktuellen Merkmalsvektors 62138 bevorzugt mit allen diesen zuvor abgespeicherten Signalgrundobjektprototypen in Form prototypischer Merkmalsvektoren der Prototypendatenbank 62115 62115. Hierzu berechnet der Abstandsermittler oder Klassifikator 62112 bevorzugt für bevorzugt jedes mögliche Paar aus dem Quantisierungsvektor in Form eines aktuellen Merkmalsvektors des Signals des aktuellen Merkmalsvektors 62138 einerseits und jeweils einem der zuvor abgespeicherten Signalgrundobjektprototypen in Form prototypischer Merkmalsvektoren der Prototypendatenbank 62115 einen jeweiligen Abstand. Hierbei leistet die Steuervorrichtung 4 der Sicherung bevorzugt mindestens zwei Erkennungen:

1. Entspricht der erkannte aktuelle Merkmalsvektor des Signal des aktuellen Merkmalsvektors 62138 einem der vorgespeicherten Signalgrundobjektprototypen in Form prototypischer Merkmalsvektoren der Prototypendatenbank 62115 oder entspricht er diesem nicht und wenn ja: Mit welcher Wahrscheinlichkeit und/oder Zuverlässigkeit entspricht der erkannte aktuelle Merkmalsvektor des Signal des aktuellen Merkmalsvektors 62138 einem der vorgespeicherten Signalgrundobjektprototypen in Form prototypischer Merkmalsvektoren der Prototypendatenbank 62115 62115?
2. Wenn es einer der bereits gespeicherten Signalgrundobjektprototypen in Form prototypischer Merkmalsvektoren der Prototypendatenbank 62115 ist, welcher der bereits gespeicherten Signalgrundobjektprototypen in Form prototypischer Merkmalsvektoren der Prototypendatenbank 62115 ist es und mit welcher Wahrscheinlichkeit und Zuverlässigkeit?

Um die erste Erkennung zu leisten, werden in der Regel auch Dummy-Prototypen in Form prototypischer Dummy-Merkmalsvektoren in der Prototypendatenbank 62115 der Signalgrundobjektprototypen abgespeichert. Bevorzugt decken die prototypischer Dummy-Merkmalsvektoren in der Prototypendatenbank 62115 alle im Betrieb vorkommenden parasitären Parameterkombinationen im Normalbetrieb ohne zu erkennende Ereignisse weitestgehend ab. Die Abspeicherung besagter Signalgrundobjektprototypen geschieht in Form prototypischer Merkmalsvektoren und/oder prototypischer Dummy-Merkmalsvektoren in der Prototypendatenbank 62115 62115.

Für die Signalgrundobjektprototypen in Form prototypischer Merkmalsvektoren und/oder prototypischer Dummy-Merkmalsvektoren der Prototypendatenbank 62115 können die Konstrukteure einer Sicherung 1 entsprechend der technischen Lehre des hier vorgelegten Dokumentes zum Konstruktionszeitpunkt den jeweiligen Abstand für jede Paarung aus zwei verschiedenen Signalgrundobjektprototypen in Form zweier verschiedener prototypischer Merkmalsvektoren und/oder prototypischer Dummy-Merkmalsvektoren der Prototypendatenbank 62115 entsprechend dem im Abstandsermittler 62112 angewandten Verfahren ermitteln. Auf diese Weise ermitteln die Konstrukteure einer Sicherung 1 im Konstruktionszeitraum einen minimalen Prototypenabstand zwischen zwei verschiedenen prototypischer Merkmalsvektoren und/oder prototypischer Dummy-Merkmalsvektoren der Prototypendatenbank 62115 der mit der vorliegenden Prototypendatenbank 62115 62155 möglich ist. Die Konstrukteure hinterlegen diesen minimalen Abstand in der Prototypendatenbank 62115 oder im Abstandsermittler 62112 bevorzugt halbiert als halben minimalen Prototypenabstand. Es ist denkbar, dass alternativ und/oder zusätzlich die Steuervorrichtung 4 der Sicherung 1 beim Systemstart der Sicherung 1 und/oder aufgrund eines Ereignisses, wie beispielsweise eines Rücksetzvorgangs, und/oder aufgrund eines Befehls des übergeordneten Rechnersystems 12 oder eines Rechnerkerns 2 einer Steuervorrichtung 4 einer anderen Sicherung diesen minimalen Abstand der zweier verschiedener prototypischer Merkmalsvektoren und/oder prototypischer Dummy-Merkmalsvektoren der Prototypendatenbank 62115 bestimmt und in der Prototypendatenbank 62115 oder im Abstandsermittler 62112 bevorzugt halbiert als halben minimalen Prototypenabstand ablegt.

Wird beispielsweise dieser minimale halbe Prototypenabstand durch den von der Abstandsermittlung 62112 ermittelten Abstand zwischen dem aktuellen Merkmalsvektor des Signals des aktuellen Merkmalsvektors 62138 und einem Signalgrundobjektprototypen in Form eines prototypischen Merkmalsvektors der Prototypendatenbank 62115 unterschritten, so wird dieser Signalgrundobjektprototyp als erkannt gewertet und dieser prototypische Merkmalsvektor ist der erkannte prototypische Merkmalsvektor für diesen aktuellen Merkmalsvektor. Die Steuervorrichtung 4 der Sicherung 1 kann ab diesem Zeitpunkt ausschließen, dass weitere im Verlauf einer weiter fortgesetzten Suche berechnete Abstände zu anderen Signalgrundobjektprototypen in Form prototypischer Merkmalsvektoren der Prototypendatenbank 62115 noch kleinere Abstände liefern können. Die Steuervorrichtung 4 der Sicherung 1 kann dann die Suche abbrechen. Dieses Vorgehen der Steuervorrichtung 4 der Sicherung 1 halbiert die Zeit im Mittel und schont somit die Ressourcen der Steuervorrichtung der Sicherung schont.

Die Steuervorrichtung 4 der Sicherung 1 kann die Berechnung des minimalen euklidischen Abstands dabei beispielsweise nach der folgenden Formel durchführen:

$$Dist_{FV\_CbE} = \underset{Cb\_cnt=Cb\_anz}{\overset{1}{Min}}\left[\sum_{\dim\_cnt=\dim}^{1}\left(FV_{\dim\_cnt} - Cb_{Cb\_cnt,\,din\_cnt}\right)^2\right]$$

Dabei steht dim_cnt für den Dimensions-Index der von 1 bis zur maximalen Dimension dim des aktuellen Merkmalsvektors des Signals des Merkmalsvektors 62138 durchläuft.

$FV_{dim\_cnt}$ steht für die den Parameterwert der Vektorkomponente des aktuellen Merkmalsvektors des Signals des Merkmalsvektors 62138 entsprechend des Index dim_cnt.

Cb_cnt steht für den Indexwert des Indexes eines Signalgrundobjektprototyps in Form eines prototypischen Merkmalsvektors der Prototypendatenbank 62115 62115.

$Cb_{CB\_cnt,dim\_cnt}$ steht dementsprechend für den dim_cnt entsprechenden Parameterwert der Vektorkomponente des Eintrags des Signalgrundobjektprototypen in Form des prototypischen Merkmalsvektors der Prototypendatenbank 62115 62115, der dem Cb_cnt entsprechenden Signalgrundobjektprototypen in Form des prototypischen Merkmalsvektors der Prototypendatenbank 62115 zugeordnet ist.

$Dist_{FV\_CbE}$ steht für den erhaltenen, hier beispielhafte minimalen euklidischen Abstand. Bei der Suche nach dem kleinsten euklidischen Abstand merkt die Steuervorrichtung 4 der Sicherung 1 sich die Nummer Cb_cnt des Indexes desjenigen prototypischen Merkmalsvektors der Prototypendatenbank 62115 62115, der den kleinsten Abstand zu dem aktuellen Merkmalsvektor produziert.

Zur Verdeutlichung führt das hier vorgestellte Dokument einen beispielhafter Assembler-Code an:

```
Anfang des Codes
Mov Cb_cnt,#Cb_anz          initialisiere Prototypendatenbank-Vector-Counter
Mov C, #0                   initialisiere Register C mit 0
Mov dist, maxvalue          initialisiere den Abstand mit Maximalwert
Mov num, not_valid_num      initialisiere die Nummer des nächsten Nachbarn mit nicht gültigem Wert
Mov Cb_adr, Cb_badr         initialisiere Prototypendatenbankadresse mit der Basisadresse der Prototypendatenbank
Label_A: // next vector
Mov SP, #0                  initialisiere Zwischenspeicher
Mov dim_cnt, #dim           initialisiere Dimensionszähler mit der Dimension des Merkmalsvektors
   Label B: // next dimension
MovA, $Cb_adr              lade Wert absolut von der Prototypendatenbank 62115 - Adresse
SubA, $FV_adr, dim_cnt     subtrahiere den Wert absolut relativ von dem Merkmalsvektorwert der Vektorkomponente des Merkmalsvektors
   Mov B A                 lade B Register mit Ergebnis
   MulA B                  multipliziere A und B (=A²)
AddA, SP                   addiere Ergebnis zum Zwischenergebnis
   Mov SP, A               und merken
   Dec dim_cnt             nächste Vektorkomponente des Merkmalsvektors
   Inc Cb_adr              erhöhe Prototypendatenbankzeiger um eins
jnz dim_cnt, Label B       aber nur, wenn es nicht die letzte war
Cmp SP, dist               bewerte den Prototypendatenbank-Eintrag (Signalgrundobjektprototypen)
jmpgt Label C
Mov dist, SP               falls besserer Eintrag als bisheriges Optimum
   Mov num, Cb_cnt         Eintragsnummer (Index) und Abstand merken
Label C:
   dec_Cb_cnt              nächster Prototypendatenbank-Eintrag
   jnz Cb_cnt,Label A      aber nur wenn es nicht der letzte war
Ende des Codes
```

Das Vertrauensmaß für eine richtige Erkennung leitet sich aus der Streuung der zugrunde gelegten Basisdatenströme für einen Signalgrundobjektprototypen, also einen prototypischen Merkmalsvektor der Prototypendatenbank 62115 62115, und dem Abstand des aktuellen Merkmalsvektors des Signals des Merkmalsvektors 62138 von deren Schwerpunkt her.

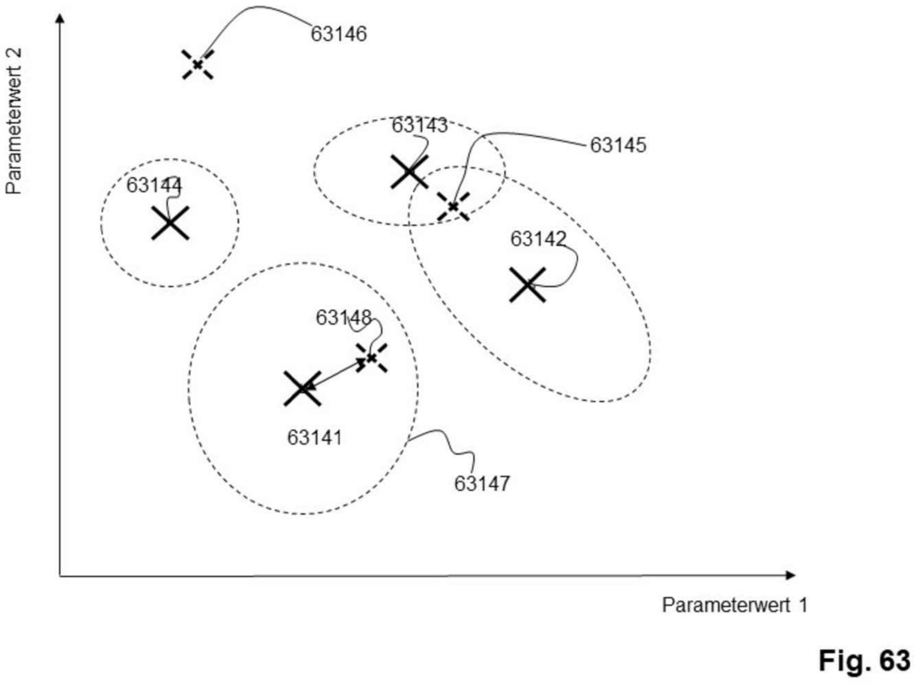

Figur 63 veranschaulicht verschiedene Erkennungsfälle. Zur Vereinfachung ist die Darstellung für einen zweidimensionalen Merkmalsvektor mit zwei Parameterwerten als Vektorkomponenten dargestellt. Jeder Merkmalsvektor umfasst einen ersten Parameterwert und einen zweiten Parameterwert als Vektorkomponenten des jeweiligen Merkmalsvektors. Die Beschränkung auf zwei Dimensionen für die Dimensionen der Merkmalsvektoren dient hier nur dazu, die Methodik auf einem zweidimensionalen Blatt Papier besser darstellen zu können In der Realität sind die Merkmalsvektoren des Signals der Merkmalsvektoren 62138 typischerweise immer multidimensional mit einer wesentlich höheren Anzahl an Dimensionen.

Figur 63 stellt darüber hinaus die Schwerpunkte verschiedener beispielhafter und willkürlicher prototypischer Merkmalsvektoren (63141, 63142, 63143, 63144) beispielhaft dar. In der Die Prototypendatenbank 62115 63115 kann nun, wie oben beschrieben, den halben minimalen Abstand dieser Signalgrundobjektprototypen, also der prototypischen Merkmalsvektoren der Prototypendatenbank 62115 62115, als Datum umfassen. Dieser halbe minimale Abstand dieser Signalgrundobjektprototypen ist dann bevorzugt ein globaler Parameter, der für alle Signalgrundobjektprototypen der Prototypendatenbank 62115 gleichermaßen typischerweise gültig ist. Die Steuervorrichtung 4 der Sicherung führt die vorbeschriebene Entscheidung, ob ein Abstand kleiner als der minimale halbe Abstand ist, mit Hilfe dieses minimalen Abstands durch. Dies setzt aber voraus, dass die Streuungen der bei der Ermittlung der Signalgrundobjektprototypen - dem Training - verwendeten realen Repräsentanten dieser Signalgrundobjektprototypen kleiner als dieser minimale halbe Abstand sind. Für das Training erfassen die Konstrukteure oder andere möglichst aller möglichen Signalverläufe (Signalgrundobjekte) der zeitlichen Parameterwertverläufe und/oder der entsprechenden zeitlichen Verläufe der aus diesen Parameterwertverläufen der physikalischen Parameter abgeleiteten Parameter. Diese erfassten Daten der erfassten Signalverläufe (Signalgrundobjekte) der zeitlichen Parameterwertverläufe und/oder der entsprechenden zeitlichen Verläufe der aus diesen Parameterwertverläufen der physikalischen Parameter abgeleiteten Parameter bilden den sogenannten Trainingsdatensatz. Für diese Erfassung zeichnen bevorzugt die Konstrukteure das Parametersignal 62101 für möglichst viele reale Verwendungssituationen der Sicherung im realen Betrieb und/oder in Laborsituationen auf. Anschließend verwenden die Konstrukteure eine Merkmalsvektorextraktion 62111 entsprechend der Merkmalsvektorextraktion 62111 der Steuervorrichtung 4 der Sicherung 1, um für vorzugsweise jeden der zeitlichen Parameterwertverläufe und/oder der entsprechenden zeitlichen Verläufe der aus diesen Parameterwertverläufen der physikalischen Parameter abgeleiteten Parameter das Signal des aktuellen Merkmalsvektors 62138 zu erzeugen. Bevorzugt clustern die Konstrukteure die so erhaltenen Merkmalsvektoren des Signals des aktuellen Merkmalsvektors 62138 zu Signalgrundprototypen. Bevorzugt ist jeder der Signalgrundprototypen durch einen prototypischen Merkmalsvektor und ein Streuellipsoid gekennzeichnet, dass die Streuung der erhaltenen Merkmalsvektoren gegenüber dem prototypischen Merkmalsvektor angibt. Da die Benutzung eines Streuellipsoid zu komplex ist, empfiehlt das hier vorgelegte Dokument, das Streuellipsoid zu einer Streusphäre zu vereinfachen. In dem Fall ist nur noch ein Schwellwert pro prototypischen Merkmalsvektor der Prototypendatenbank 62115 zu beachten. Das hier vorgelegte Dokument schlägt vor, zur weiteren Vereinfachung Schwellwertellipsoide mit gleichen Abständen für alle prototypischen Merkmalsvektoren der Prototypendatenbank 62115 zu verwenden.

Die prototypischen Merkmalsvektoren der Signalgrundprototypen markieren bevorzugt die Schwerpunktlagen (63141, 63142, 63143, 63144) der erhaltenen Merkmalsvektoren, die zur Bildung des prototypischen Merkmalsvektors beitragen. Ist die Abstandsermittlung (oder sonstige Bewertung) durch den Abstandsermittler 62112 (oder Klassifikator) optimal, so ist dies auch der Fall. Dies entspräche einem Kreis um den Schwerpunkt (63141, 62142, 63142, 63144), also den prototypischen Merkmalsvektor jedes der Signalgrundobjektprototypen der Prototypendatenbank 62115 62115.

Das lässt sich in der Realität aber nur selten erzielen. Eine Verbesserung der Erkennungsleistung lässt sich daher erzielen, wenn die Streubreite der erhaltenen Merkmalsvektoren, die zu einem prototypischen Merkmalsvektor der Prototypendatenbank 62115 62115, also dem jeweiligen Signalgrundobjektprototypen der Prototypendatenbank 62115 62115, beitragen, jeweils mit dem prototypischen Merkmalsvektor zusammen in einem Datensatz mit in der der Prototypendatenbank 62115 abgespeichert würde. Dies entspräche einem prototypspezifischen Kreis um jeden der Signalgrundobjektprototypen der Prototypendatenbank 62115 mit einem für den Signalgrundobjektprototypen spezifischen Radius. Der Nachteil ist jedoch ein Anstieg der notwendigen Rechenleistung.

Eine weitere Verbesserung der Erkennungsleistung lässt sich erzielen, wenn die Steuervorrichtung 4 der Sicherung 1 die Streubreite für den Signalgrundobjektprototypen der Prototypendatenbank 62115 durch eine Ellipse modelliert. Umfasst die Prototypendatenbank 62115 statt des Radius wie zuvor nun die Hauptachsendurchmesser der Streuellipse und deren Verkippung gegen das Koordinatensystem in der Prototypendatenbank 62115 für bevorzugt jeden der Signalgrundobjektprototypen der Prototypendatenbank 62115 abgespeichert werden. Der Nachteil ist ein weiterer, massiver Anstieg der Rechenleistung und des Speicherbedarfes.

Natürlich lässt sich die Berechnung noch weiter verkomplizieren, was aber in der Regel den Aufwand nur massiv steigert und die Erkennerleistung für die Signalgrundobjektprototypen der Prototypendatenbank 62115 nicht mehr wesentlich anhebt.

Es wird daher hier empfohlen, auf die einfachste der beschriebenen Möglichkeiten zurückgreifen.

Die Lage der durch die Abstandsermittlung 62112 in dem beispielhaft zweidimensionalen Parameterraum der Figur 63 ermittelten aktuellen Merkmalsvektor des Signals des Merkmalsvektors 62138 kann nun höchst unterschiedlich sein. So ist es denkbar, dass ein solcher erster solcher beispielhafter Merkmalsvektor 63146 zu weit von den Schwerpunktkoordinaten (63141, 63142, 63143, 63144) des Schwerpunkts irgendeines Signalgrundobjektprototypen der Prototypendatenbank 62115 entfernt liegt. Dieser Abstandsschwellwert kann beispielsweise der besagte minimale halbe Prototypenabstand sein. Auch kann es sein, dass sich die Streubereiche der Signalgrundobjektprototypen um ihre jeweiligen Schwerpunkte 63143, 63142 überlappen und ein zweiter beispielhafter ermittelter aktueller Merkmalsvektor 63145 des Signals des Merkmalsvektors 63138 in dem Überlappungsbereich liegt. Im späteren Betrieb kann dann die Steuervorrichtung 4 der Sicherung 1 zwei verschiedene Ereignisse erkennen, wenn ein aktueller Merkmalsvektor im Streubereich zweier prototypischer Merkmalsvektoren der Prototypendatenbank 62115 liegt. Die Figur 63 zeigt einen solchen Fall als Beispiel. Der beispielhafte aktuelle Merkmalsvektor 63145 des Signals der Merkmalsvektoren 62138 liegt dort in dem Überlappungsbereich der Streubereiche der beiden beispielhaften Signalgrundobjekte der Prototypendatenbank 62115 mit den beispielhaften Schwerpunktkoordinaten 63142 und 63143. In diesem Fall erstellt die Steuervorrichtung bevorzugt eine Hypothesenliste. Die Hypothesenlist umfasst bevorzugt mehrere Datensätze der Hypothesenliste. Jeder Datensatz der Hypothesenliste umfasst bevorzugt den Index genau eines Signalgrundobjektprototypen, also eines prototypischen Merkmalsvektors der Prototypendatenbank 62115. Damit ist dieser Signalgrundobjektprototyp, also der prototypische Merkmalsvektor der Prototypendatenbank 62115, diesem Datensatz zugeordnet. Des Weiteren umfasst jeder Datensatz der Hypothesenliste bevorzugt einen Wahrscheinlichkeitswert, der grob angibt, mit welcher Wahrscheinlichkeit der aktuelle Merkmalsvektor dem durch den Index des Datensatzes zugeordneten Signalgrundobjektprototyp, also der prototypische Merkmalsvektor der Prototypendatenbank 62115, entspricht. Typischerweise verwendet die Steuervorrichtung 4 der Sicherung den Abstand zwischen dem aktuellen Merkmalsvektor einerseits und dem durch den Index des Datensatzes zugeordneten Signalgrundobjektprototyp, also der prototypische Merkmalsvektor der Prototypendatenbank 62115 andererseits als solchen Wahrscheinlichkeitswert. Hierbei handelt es sich typischerweise allerdings nicht um die echte, präzise Wahrscheinlichkeit. Vielmehr lassen kürzere Abstände auf eine höhere Wahrscheinlichkeit schließen als größere. Bevorzugt sortiert die Steuervorrichtung 4 der Sicherung die Hypothesenliste nachdem sie alle Signalgrundobjektprototypen, also alle prototypischen Merkmalsvektoren der Prototypendatenbank 62115 hinsichtlich des Abstands untersucht hat oder sonst wie diese Untersuchung beendet hat. In dem Beispiel der zwei Signalgrundprototypen 63143 und 63142 als Repräsentanten des aktuellen Merkmalsvektors 63145 ist der wahrscheinlichere Signalgrundprototyp, der den aktuellen Merkmalsvektor 63145 besser repräsentiert der Signalgrundprototyp 63143, da sein Abstand zum aktuellen Merkmalsvektor 63145 kleiner ist. In dem Beispiel der zwei Signalgrundprototypen 63143 und 63142 als Repräsentanten des aktuellen Merkmalsvektors 63145 ist der weniger wahrscheinlichere Signalgrundprototyp, der den aktuellen Merkmalsvektor 63145 schlechter repräsentiert der Signalgrundprototyp 63142, da sein Abstand zum aktuellen Merkmalsvektor 63145 größer ist.

Die Hypothesenliste kann also beispielsweise so aussehen

| Anzahl der pot. repräsentierenden prototypischen Merkmalsvektoren der Prototypendatenbank 62115 | 2 | aktueller Merkmalsvektor | 63145 |
|---|---|---|---|
| Zeitstempel | YYYY-MM-DD, HH:MM:SS.SSSSS | | |
| Hypothesenlistenindex | Index des prototypischen Merkmalsvektors der Prototypendatenbank 62115 | Abstand | Wertung |
| 1 | Index von 63143 | Abstandswert 63143 zu 63145 | Gefährlichkeit 63143 |
| 2 | Index von 63142 | Abstandswert 63142 zu 63145 | Gefährlichkeit 63143 |

Bevorzugt umfassen die Datensätze der Prototypendatenbank 62115 je Datensatz eines prototypischen Merkmalsvektors einen Gefährlichkeitswert. Es ist ja so, dass ein erstes Ereignis, das ein erster prototypischer Merkmalsvektor 63143 der Prototypendatenbank 62115 repräsentiert weniger gefährlich sein kann, als ein zweites Ereignis, das ein zweiter prototypischer Merkmalsvektor 63142 der Prototypendatenbank 62115 repräsentiert. Die Steuervorrichtung 4 kann dann nach der Erstellung der Hypothesenliste trotzdem Maßnahmen gegen das unwahrscheinlichere zweite Ereignis, dass durch den zweiten prototypischen Merkmalsvektor 63142 repräsentiert wird, ergreifen, obwohl es nicht das wahrscheinlichste ist, weil seine Wirkung gefährlicher oder sonst wie bedeutender ist als die Wirkung eines Ereignisses, das dem ersten prototypischen Merkmalsvektor 63143 entspricht.

In der so durch die Steuerungsvorrichtung 4 durch Abstandsbestimmung zwischen dem aktuellen Merkmalsvektor 63145 und den prototypischen Merkmalsvektoren der Prototypendatenbank 62115 ermittelten Hypothesenliste sind dann nach Abschluss dieser Abstandsbestimmungen alle die prototypischen Merkmalsvektoren der Prototypendatenbank 62115 enthalten, deren Betrag des Abstands kleiner als ein Schwellwert ist. In dem Beispiel der Figur 63 umfasst die Hypothesenliste für den aktuellen Merkmalsvektor 63145 zwei Signalgrundobjektprototypen 63143 und 63142 mit einem jeweiligen Wert für die unterschiedlichen Wahrscheinlichkeiten. Beispielsweise kann der Wert für die unterschiedlichen Wahrscheinlichkeiten als beigefügtem Parameter, die unterschiedlichen Abstände enthalten. Der Abstandsermittler oder Klassifikator 62112 der Steuervorrichtung 4 der Sicherung 1 übergibt dann in dieser Variante also nicht ein Signalgrundobjekt, den besagten erkannten Merkmalsvektor, als das wahrscheinlichste Signalgrundobjekt an den Viterbi-Schätzer 62113. Der Abstandsermittler oder Klassifikator 62112 der Steuervorrichtung 4 der Sicherung 1 übergibt dann in dieser Variante die besagte Hypothesenliste oder einen Zeiger auf diese. Diese Hypothesenliste umfasst, wie beschrieben, möglicherweise vorliegende Signalgrundobjekte und Werte, die die Wahrscheinlichkeit modellieren. Da die Steuervorrichtung 4 der Sicherung 1 immer wieder neue aktuelle Merkmalsvektoren im Signal der Merkmalsvektoren 62138 erzeugt, erzeugt der Abstandsermittler oder Klassifikator 62112 der Steuervorrichtung 4 der Sicherung 1 eine entsprechende zeitliche Abfolge von Hypothesenlisten. Eine Hypothesenliste kann auch nur einen prototypischen Merkmalsvektor der prototypischen Merkmalsvektoren der Prototypendatenbank 62115 aufweisen. Sofern die Erkennung komplett fehlschlägt kann eine Hypothesenliste auch keinen einen prototypischen Merkmalsvektor der prototypischen Merkmalsvektoren der Prototypendatenbank 62115 aufweisen. Aus dieser Folge von erzeugten Hypothesenlisten sucht dann der Viterbi-Schätzer 62113 eine mögliche Abfolge prototypischer Merkmalsvektoren der Prototypendatenbank 62115 heraus, die die größte Wahrscheinlichkeit zu einer der vorgegebenen Signalgrundobjektfolgen in der Signalobjektsequenzdatenbank 62116 haben. Im Sinne des hier vorgelegten Dokuments bedeutet dies, dass die Wahrscheinlichkeit, dass die mögliche Abfolge prototypischer Merkmalsvektoren der Prototypendatenbank 62115 die richtige ist, gegenüber den Wahrscheinlichkeiten aller anderen möglichen Pfaden durch die als möglich erkannten Signalgrundobjekte der erkannten Hypothesenlisten 62121 die größte ist. Hierbei handelt es sich um die Folge von Hypothesenlisten, die der Abstandsermittler 621122 an den den Viterbi-Schätzer 62113 als ermittelte Signalgrundobjektfolge 62121 aus der zeitlichen Folge der erkannten Signalgrundobjekte übermittelt. Dabei durchläuft dieser Pfad der Folge von prototypischen Merkmalsvektoren, die der Viterbi-Schätzer 62113 ermittelt, je Hypothesenliste genau einen erkannten Signalgrundobjektprototyp dieser Hypothesenliste.

Im besten Fall liegt der aktuelle Merkmalsvektor 63148 im Streubereich (Schwellwertellipsoid) 63147 um den Schwerpunkt 63141 eines einzigen Signalgrundobjektprototyps 63141 der Prototypendatenbank 62115. Der Abstandsermittler 62112 erkennt damit diesen Signalgrundobjektprototyps 63141 der Prototypendatenbank 62115 und als erkanntes Signalgrundobjekt 62121, das den aktuellen Merkmalsvektor am besten repräsentiert. Der Abstandsermittler 62112 erzeugt so eine ermittelte Signalgrundobjektfolge 62121 aus der zeitlichen Folge der erkannten Signalgrundobjekte und gibt diese an den Viterbi-Schätzer

(113) weiter. Die Signalgrundobjekte entsprechen dabei prototypischen Merkmalsvektoren der Prototypendatenbank 62115.

Es ist denkbar, zur verbesserten Modellierung des Streubereichs eines einzelnen Signalgrundobjektprototyps der Prototypendatenbank 62115, diesen durch mehrere hier kreisförmige Signalgrundobjektprototypen, als mehrere prototypische Merkmalsvektoren der Prototypendatenbank 62115, mit zugehörigen Streubereichen zu modellieren. Es können also mehrere Signalgrundobjektprototypen der Prototypendatenbank 62115 denselben Signalgrundobjektprototypen im Verständnis einer Signalgrundobjektklasse darstellen. Die Gefahr dabei ist, dass sich Aufgrund der Aufteilung der Wahrscheinlichkeit eines Signalgrundobjektprototypens auf mehrere solcher Subsignalgrundobjektprototypen die Wahrscheinlichkeit des einzelnen Subsignalgrundobjektprototyps kleiner werden kann als die eines anderen Signalgrundobjektprototyp, deren Wahrscheinlichkeit kleiner war als die des Ursprungssignalgrundobjektprototyps. Somit kann sich dieser andere Signalgrundobjektprototyp möglicherweise fälschlich durchsetzen.

Ein wesentliches Problem stellt des Weiteren die Rechenleistung dar, die die Steuervorrichtung 4 der Sicherung 1 zur Verfügung stellen muss, um die Signalgrundobjektprototypen der Prototypendatenbank 62115 sicher zu erkennen. Dies soll noch ein wenig diskutiert werden:

Ein entscheidender Punkt ist, dass der Rechenaufwand mit Cb_anz * dim steigt.

Bei einem nicht optimierten HMM-Erkenner beträgt die Anzahl der Assemblerbefehle, die der Rechnerkern 2 der Steuervorrichtung 4 der Sicherung 1 ausführen muss, um eine Vektorkomponente des Merkmalsvektors zu berechnen, ca. 8 Schritte.

Die Anzahl A_Abst der notwendigen Assembler-Schritte zur Berechnung des Abstands eines einzelnen Signalgrundobjektprototyps (CbE) der Prototypendatenbank 62115, also eines prototypischen Merkmalsvektors der Prototypendatenbank 62115 zu einem einzelnen Merkmalsvektor (FV) berechnet der Rechnerkern 2 der Steuervorrichtung 4 der Sicherung 1 bevorzugt in etwa wie folgt:

$$A\_Abst = FV\_Dimension * 8 + 8$$

Dies führt zur Anzahl A_CB der Assembler-Schritte für die Ermittlung des Signalgrundobjektprototyps der Prototypendatenbank 62115 mit dem geringsten Abstand:

$$A\_CB = Cb\_anz * (A\_Abst) + 4 = Cb\_anz * (FV\_Dimension * 8 + 8) + 4$$

Am Beispiel eines mittlerer HMM-Erkenners mit 50000 Signalgrundobjektprototypen (Anzahl der Signalgrundobjektprototyp-Einträge in der Prototypendatenbank=CB_anz) und beispielhaft 24 FV_Dimensionen (Anzahl der Parameterwerte in einem Merkmalsvektor=Merkmalsvektor-Dimension= FV_Dimension) beträgt die Anzahl der Schritte: 50000*(24*8+8)+4~10 Millionen Operationen pro Merkmalsvektor des Signals der Merkmalsvektoren 62138

Bei einer relativ niedrigen Abtastrate von 8kHz = 8000 Merkmalsvektoren pro Sekunde (Merkmalsvektoren des Signals der Merkmalsvektoren 62124 pro Sekunde) benötigt der Rechnerkern 2 der Steuervorrichtung 4 der Sicherung 1 schon eine Rechenleistung von 8GIpS (8 Milliarden Instruktionen pro Sekunde).

In Anbetracht der Herausforderungen zur Energieeinsparung in der Elektromobilität und/oder zur Reduktion des $CO_2$-Fotprints ist dies nicht akzeptabel.

Im Falle der Durchführung eines optimierten HMM-Erkennungsverfahrens durch den Abstandsermittler 62112 bzw. den Klassifikator 62112 wird daher, wie bereits erwähnt, der kleinste Abstand zwischen zwei Signalgrundobjektprototypen der Prototypendatenbank 62115 vorberechnet und in der Prototypendatenbank 62115 oder im Abstandsermittler bzw. im Klassifikator 62112 abgelegt. Dies hat den Vorteil, dass die Suche dann durch den Abstandsermittler bzw. den Klassifikator 62112 abgebrochen werden kann, wenn ein Abstand zwischen einem aktuellen Merkmalsvektor des Signals der Merkmalsvektoren 62138 und einem Signalgrundobjektprototypen der Prototypendatenbank 62115 durch den Abstandsermittler bzw. den Klassifikator 62112 gefunden wurde, der kleiner als die Hälfte dieses kleinsten Abstands ist. Damit halbiert sich die mittlere Suchzeit für den Abstandsermittler bzw. Klassifikator 62112. Weitere Optimierungen können vorgenommen werden, wenn die Prototypendatenbank 62115 nach dem statistischen Vorkommen der Signalgrundobjektprototypen in realen Parametersignalen 62103 einer realen Sicherung 1 sortiert wird. Hierdurch kann sichergestellt werden, dass die Steuervorrichtung 4 der Sicherung 1 die häufigsten Signalgrundobjektprototypen in der Prototypendatenbank 62115 wesentlich schneller findet. Dies senkt die Rechenzeit des Abstandsermittlers 62112 bzw. Klassifikators 62112 weiter und senkt den Stromverbrauch weiter. Da in der Regel der Rechnerkern 2 der Steuervorrichtung 4 der Sicherung den Abstandsermittler bzw. Klassifikator 61112 emuliert senkt dies ach die Rechenzeit des Rechnerkerns 2 der Steuervorrichtung 4 der Sicherung 1 weiter und senkt damit den Stromverbrauch der Sicherung 1 weiter.

Für einen Abstandsermittler 62112 bzw. Klassifikator 62112, der einen dermaßen optimierten HMM-Erkennungsprozess ausführt, stellt sich der Rechenleistungsbedarf nun wie folgt dar:

Wieder sind es 8 Schritte zur Berechnung des Abstands einer Vektor-Komponente des aktuellen Merkmalsvektors zu der entsprechenden Vektorkomponente des prototypischen Merkmalsvektors der Prototypendatenbank 62115. Die Schritte zur Berechnung des Abstands A_Abst eines Signalgrundobjektprototyp-Eintrags (CbE) - des prototypischen Merkmalsvektors, in der Prototypendatenbank 62115 zum aktuellen Merkmalsvektor des Signals der Merkmalsvektors 62138 sind wieder:

$$A\_Abst = FV\_Dimension *8+8$$

Die Anzahl der Schritte für die Ermittlung des Signalgrundobjektprototypen-Eintrags, also des Datensatzes des prototypischen Merkmalsvektors der Prototypendatenbank 62115 mit dem geringsten Abstand A_CB mit Optimierung ist ein wenig höher:

$$A\_CB = Cb\_anz*(A\_Abst)+4 = Cb\_anz*(FV\_Dimension*8+10)+4$$

Die zwei zusätzlichen Assembler-Befehle sind notwendig, um zu prüfen, ob sich der ermittelte Abstand zwischen dem aktuellen Merkmalsvektor und dem gerade untersuchten prototypischen Merkmalsvektor des Signalgrundobjektprototypen der Prototypendatenbank 62115 unterhalb des halben kleinsten Abstands zwischen den prototypischen Merkmalsvektoren der Signalgrundobjektprototypen der Prototypendatenbank 62115 befindet.

Des Weiteren wird entsprechen der hier vorgestellten technischen Lehre, die Anzahl CB_Anz der Signalgrundobjektprototyp-Einträge, also der Datenbankeinträge, der Prototypendatenbank 62115 für auf 4000 Prototypendatenbank-Einträge, also Datensätze, von Signalgrundobjektprototypen in der Prototypendatenbank 62115 oder noch geringer auf 2000 Prototypendatenbank-Einträge auf 1000 Prototypendatenbank-Einträge beschränkt oder höher auf 8000 Einträge oder höher auf 16000 Einträge beschränkt. 400 Einträge haben sich bei der Ausarbeitung der technischen Lehre bewährt. In der Regel wird hier eine Anpassung an den konkreten Anwendungsfall des konkreten Versorgungsnetzwerks notwendig sein.

Außerdem wird die Anzahl der Merkmalsvektoren pro Sekunde innerhalb des Signals der Merkmalsvektoren 62138 durch die Filterung in dem der Merkmalsextraktion 62111 und durch Absenkung der Abtastrate in der Merkmalsextraktion 62111 abgesenkt.

Dies wird an einem einfachen Beispiel erläutert:

Die Steuervorrichtung 4 der Sicherung 1 betreibt den besagten Abstandsermittler 62112 oder Klassifikator 62112 der Steuervorrichtung 4 der Sicherung 1, der ein mittleres HMM-Erkennungsverfahren ausführt, nun mit einer Prototypendatenbank 62115 mit nur noch einem knappen Zehntel der Einträge (Datensätzen) z.B. mit 4000 Einträgen (CbE) und weiterhin mit 24 Dimensionen des Signals der Merkmalsvektoren 62138 (also 24 Parametersignalen).

Die Anzahl der Schritte beträgt nun 4000*(24*8+10)+4~<u>808004</u> Operationen pro Merkmalsvektor des Signals der Merkmalsvektoren 62138

Bei einer Absenkung der Merkmalsvektor-Rate auf 100 Merkmalsvektoren pro Sekunde extrahiert aus einem 10ms Zeitfenstern (Abtastfenstern) in der Merkmalsvektorextraktion 62111 über beispielsweise je 80 Abtastwerte und Abbruch der Suche wenn der Abstand des aktuellen Merkmalsvektors zur dem bearbeiteten prototypischen Merkmalsvektor des bearbeiteten Signalgrundobjektprototypens der Prototypendatenbank 62115 unterhalb des halben kleinsten Prototypendatenbank-Eintrag-Abstands liegt, ergibt sich mindestens eine Halbierung des Aufwands bei geeigneter Sortierung der Datensätze der prototypischen Merkmalsvektoren der Prototypendatenbank 62115.

Die erforderliche Rechenleistung des Rechnerkerns 2 der Steuervorrichtung 4 der Sicherung 1 sinkt dann auf <33DSP-Mips (33 Millionen Operationen pro Sekunde). In der Realität führt die Sortierung der Datensätze der Prototypendatenbank 62115 zu noch geringeren Rechenleistungsbedarfen von beispielsweise 30Mips. Damit wird das System der elektronischen Sicherung real-time fähig und in einen einzelnen mikrointegrierten Schaltkreis für die Steuervorrichtung 4 der Sicherung 1 und damit in eine Sicherung 1 überhaupt erst integrierbar.

Durch Vorselektion von Datensätzen der Prototypendatenbank 62115 kann die Steuervorrichtung 4 der Sicherung 1 den Suchraum einschränken. Eine Voraussetzung ist dabei eine Gleichverteilung der Daten = Schwerpunkte der Quadranten im geometrischen Quadrantenzentrum.

Die notwendige Verringerung des Umfangs der Prototypendatenbank 62115 hat Vor- und Nachteile:
Eine Verringerung der Eintragsanzahl der Prototypendatenbank 62115 erhöht zum Ersten die False-Acceptance-Rate (FAR), also die falschen Signalgrundobjektprototypen - prototypischen Merkmalsvektoren - der Prototypendatenbank 62115, die die Steuervorrichtung 4 der Sicherung 1 als erkannte Signalgrundobjektprototypen auf Basis des aktuellen Merkmalsvektors erkennt.

Eine Verringerung der Eintragsanzahl der Prototypendatenbank 62115 erhöht zum Zweiten als auch die False-Rejection-Rate (FRR), also die Signalgrundobjektprototypen - prototypischen Merkmalsvektoren - der Prototypendatenbank 62115, die die Steuervorrichtung 4 der Sicherung 1 als erkannte Signalgrundobjektprototypen auf Basis des aktuellen Merkmalsvektors eigentlich akzeptieren müsste, sie jedoch nicht akzeptiert.

Auf der anderen Seite verringert sich hierdurch der Ressourcenbedarf (Rechenleistung, Chip-Flächen, Speicher, Stromverbrauch etc.).

Darüber hinaus kann die Vorgeschichte, d.h. die zuvor erkannten Signalgrundobjektprototypen, bei der Hypothesenbildung durch den Abstandsermittler oder Klassifikator 62112 herangezogen werden. Ein geeignetes Modell hierfür ist beispielsweise das so genannte Hidden-Markov-Model (HMM).

Für jeden Signalgrundobjektprototypen, also jeden prototypischen Merkmalsvektor der Prototypendatenbank 62115, kann Abstandsermittler oder Klassifikator 62112 somit ein Vertrauensmaß und ein Abstand zum gemessenen aktuellen Merkmalsvektor des Signals der Merkmalsvektoren 62138 herleiten. Der Viterbi-Schätzer (113) kann das Vertrauensmaß und den Abstand auch weiterverarbeiten. Wie zuvor in diesem Dokument beschrieben ist es sinnvoll, dass der Abstandsermittler oder Klassifikator 62112 jeweils eine Hypothesenliste für die erkannten Signalgrundobjektprototypen, also jeden prototypischen Merkmalsvektor der Prototypendatenbank 62115, ausgibt. Der Abstandsermittler oder Klassifikator 62112 übermittelt diese Hypothesenliste als Teil der ermittelten Signalgrundobjektfolge 62121 aus der zeitlichen Folge der erkannten Signalgrundobjektprototypen an den Viterbi-Schätzer 62113. Beispielsweise kann eine Hypothesenliste die zehn wahrscheinlichsten Signalgrundobjektprototypen mit der jeweiligen Wahrscheinlichkeit und Zuverlässigkeit der Erkennung umfassen, die den aktuellen Merkmalsvektor mehr oder weniger gut repräsentieren können.

Nicht jede auftretende ermittelte Signalgrundobjektfolge 62121 aus der zeitlichen Folge der erkannten Signalgrundobjekte kann als zeitliche wie räumliche Signalgrundobjektsequenz einem Signalobjekt der Signalobjektsequenzdatenbank 62116 zugeordnet werden. Daher ist typischerweise nicht jede auftretende ermittelte Signalgrundobjektfolge 62121 aus der zeitlichen Folge der erkannten Signalgrundobjekte somit sinnvoll. Um diesen Mangel zu beheben, ist es sinnvoll, die zeitliche Aufeinanderfolge der Hypothesenlisten der zeitlich aufeinanderfolgenden Abtastfenster durch einen Viterbi-Schätzer 62113 auszuwerten. Bevorzugt ist übrigens jedem zeitlichen Abtastfenster eine Hypothesenliste zugeordnet.

Hierbei hat der Viterbi-Schätzer 62113 die Aufgabe, denjenigen Sequenzpfad einer Signalobjektsequenz von Signalgrundobjektprototypen der Prototypendatenbank 62115 durch die Datensätze der aufeinanderfolgenden Hypothesenlisten zu finden, der die höchste Wahrscheinlichkeit hat und eine prototypische Signalobjektsequenz der Signalobjektdatenbank 62116 des Viterbi-Schätzers 62113 ist.

Auch hierbei leistet der Viterbi-Schätzer 62113 wiederum mindestens zwei Erkennungen:

1. Ist die wahrscheinlichste Signalobjektsequenz von Signalgrundobjektprototypen der Prototypendatenbank 62105 eine der bereits in die Signalobjektsequenzdatenbank 62116 eingespeicherten Signalobjektsequenzen von Signalgrundobjektprototypen oder nicht und mit welcher Wahrscheinlichkeit und Zuverlässigkeit?
2. Wenn sie eine der bereits gespeicherten Signalobjektsequenzen von Signalgrundobjektprototypen ist, welche ist es und mit welcher Wahrscheinlichkeit und Zuverlässigkeit?

Ein Anlernprogramm kann hierzu eine solcher Signalobjektsequenz in Form eines Eintrags (Datensatzes) bestehend aus einer vorgegeben Signalobjektsequenz von Signalgrundobjektprototypen der Prototypendatenbank 62115 in eine Signalobjektsequenzdatenbank 62116 einspeisen. Zum anderen kann ein Anwender mittels eines Terminals 740 ggf. dies auch manuell über ein sogenanntes Type-In-Tool eine solcher Signalobjektsequenz in Form eines Eintrags (Datensatzes) bestehend aus einer vorgegeben Signalobjektsequenz von Signalgrundobjektprototypen der Prototypendatenbank 62105 in eine Signalobjektsequenzdatenbank 62116 eingeben. Somit wird die Eingabe dieser Signalobjektsequenzen von Signalgrundobjektprototypen der Prototypendatenbank 62115 über eine Tastatur des Terminals 740 ermöglicht.

Der Viterbi-Schätzer 62113, kann aus der Abfolge der Hypothesenlisten des Abstandsermittlers bzw. Klassifikators 62112 die wahrscheinlichste der vordefinierten Signalobjektsequenzen von Signalgrundobjektprototypen der Prototypendatenbank 62115 für eine ermittelte Signalgrundobjektfolge 62121 der zeitlichen Folge der erkannten Signalgrundobjekte 62121 ermitteln. Die gilt insbesondere auch dann, wenn der Abstandsermittler 62112 bzw. der Klassifikator 62112 einzelne Signalgrundobjektprototypen aufgrund von Messfehlern falsch erkannt hat. Insofern ist eine Übernahme von Folgen von Hypothesenliste vom Abstandsermittler 62112 bzw. Klassifikator 62112, wie oben beschrieben, durch den Viterbi-Schätzer 62113 sehr sinnvoll. Das Ergebnis ist das als wahrscheinlichstes erkannte Signalobjekt 62122 oder analog zur zuvor beschriebenen Emissionsberechnung des Abstandsschätzers 62112 bzw. Klassifikators 62112 eine Signalobjekthypothesenliste.

Die Signalobjekthypothesenliste kann also beispielsweise so aussehen

| Anzahl der pot. repräsentierenden prototypischen Signalobjekte der Signalobjektsequenz-datenbank 62116 | 2 | aktuelles zeitliches Abtastfenster | Abtastfensternummer |
|---|---|---|---|
| Zeitstempel | YYYY-MM-DD, HH:MM:SS.SSSSS | | |
| Signalobjekt-hypothesen-Listenindex | prototypischen Signalobjekte der SignalobjektSequenzdatenbank 62116 | Abstand | Wertung |
| 1 | Index von des ersten prototypi-schen Signalobjekts | Bewertungswert des ers-ten prototypi-schen Signalobjekts bezo-gen auf die ermittelte Sig-nalgrundobjektfolge 62121 der zeitlichen Folge der erkannten Signalgrundob-jekte 62121 | Gefährlichkeit des ers-ten prototypischen Signalobjekts |
| 2 | Index des zweiten prototypischen Signalobjekts | Bewertungswert des zwei-ten prototypischen Signal-objekts bezogen auf die ermittelte Signalgrundob-jektfolge 62121 der zeitli-chen Folge der erkannten Signalgrundobjekte 62121 | Gefährlichkeit des zweiten prototypischen Signalobjekts |

Bevorzugt umfassen die Datensätze der Signalobjektsequenzdatenbank 62116 je Datensatz eines prototypischen Signalobjekts einen Gefährlichkeitswert. Es ist ja so, dass ein erstes Ereignis, das ein erstes prototypisches Signalobjekt der Signalobjektsequenzdatenbank 62116 repräsentiert, weniger gefährlich sein kann als ein zweites Ereignis, das ein zweites prototypisches Signalobjekt der Signalobjektsequenzdatenbank 62116 repräsentiert. Die Steuervorrichtung 4 kann dann nach der Erstellung der Signalobjekthypothesenliste trotzdem Maßnahmen gegen das unwahrscheinlichere zweite Ereignis, dass durch das zweite prototypische Signalobjekt repräsentiert wird, ergreifen, obwohl es nicht das wahrscheinlichste ist, weil seine Wirkung gefährlicher oder sonst wie bedeutender ist als die Wirkung eines Ereignisses, das dem ersten prototypischen Signalobjekt entspricht.

Als letztes betrachten wir die funktionalen Komponenten der Signalobjekt-Erkennungs-Maschine. Diese ist im in Figur 62 als Viterbi-Schätzer 62113 eingetragen. Diese Suche des Viterbi-Schätzers 62113 der Steuervorrichtung 4 der Sicherung 1 greift auf die Signalobjektsequenzdatenbank 62116 zu. Eine Anlernsoftware eines übergeordneten Rechnersystems 12 oder eines Terminals 740 und zum anderen eine Software des übergeordneten Rechnersystems 12 oder des Terminals 740, bei denen ein Nutzer 730 diese Folgen von Signalgrundobjektprototypen durch textuelle der Eingabe festgelegen kann, erzeugen die Datensätze für die Signalobjektsequenzdatenbank 62116 und/oder ermöglichen das Editieren des Inhalts der Datensätze der Signalobjektsequenzdatenbank 62116.

In der Produktion lädt bevorzugt ein Testsystem bevorzugt am Bandende bevorzugt die Daten der Signalobjektsequenzdatenbank 62116 in einen Speicher der Steuervorrichtung 4 der Sicherung 1.

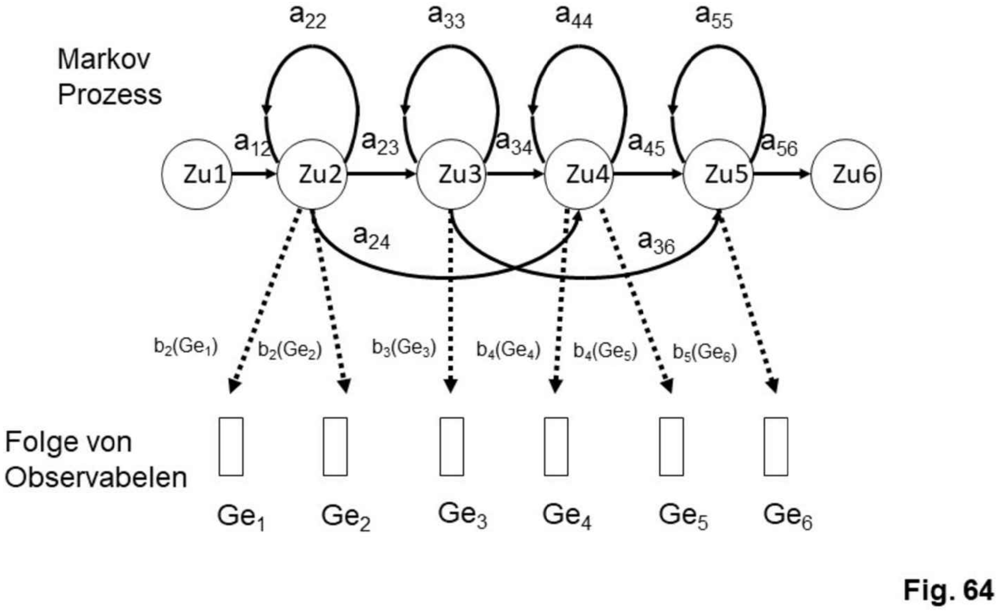

Basis der Signalobjektsequenzerkennung für die zeitliche Folge der Signalgrundobjektprototypen im Viterbi-Schätzer 62119 ist bevorzugt ein Hidden-Markov-Modell. Das Modell baut sich aus verschiedenen Zuständen auf. In dem in Figur 64 angegebenen Beispiel symbolisieren diese Zustände nummerierte Kreise. In dem besagten Beispiel in Figur 64 sind die Kreise von Zu1 bis Zu6 nummeriert. Zwischen den Zuständen Zu1 bis Zu6 bestehen Übergänge. Diese Übergänge werden in der Figur 64 mit dem Buchstaben a und zwei Indizes i, j bezeichnet. Der erste Index i bezeichnet die Nummer des Ausgangsknotens der zweite Index j die Nummer des Zielknotens. Neben den Übergängen zwischen zwei verschiedenen Knoten bestehen auch Übergänge $a_{ii}$ oder $a_{jj}$ die wieder auf den Startknoten zurückführen. Darüber hinaus gibt es Übergänge, die es ermöglichen, Knoten zu überspringen aus der Sequenz ergibt sich somit jeweils eine Wahrscheinlichkeit, eine k-te Observable $b_k$ tatsächlich zu beobachten. Somit ergeben sich Folgen von Observablen, die mit vorberechenbaren Wahrscheinlichkeiten $b_k$ zu beobachten sind.

Wichtig ist dabei, dass ein jedes Hidden-Markov-Modell nicht beobachtbare Zuständen $q^i$ umfasst. Zwischen zwei Zuständen $q^i$ und $q^j$ besteht die Übergangswahrscheinlichkeit $a_{ij}$.

Somit lässt sich die Wahrscheinlichkeit p für den Übergang von $q^i$ auf $q^j$ schreiben als:

$$p\left(q_n^j \middle| q_{n-1}^i\right) \equiv a_{ij}$$

Dabei steht n für einen diskreten Zeitpunkt. Der Übergang findet also zwischen dem Schritt n mit Zustand $q^i$ und dem Schritt n+1 mit dem Zustand $q^j$ statt.

Die Emissionsverteilung $b_i(Ge)$ hängt vom Zustand $q^i$ ab. Wie bereits erläutert, ist dies die Wahrscheinlichkeit, die Signalgrundobjekt Ge (die Observable) zu beobachten, wenn sich das System (Hidden-Markov-Modell) im Zustand $q^i$ befindet:

$$p\left(Ge \middle| q^i\right) \equiv b_i\left(Ge\right)$$

Um das System starten zu können, müssen die Anfangszustände festgelegt sein. Dies geschieht durch einen Wahrscheinlichkeitsvektor $\pi_i$. Danach lässt sich angeben, dass ein Zustand $q^i$ mit der Wahrscheinlichkeit $\pi_i$ ein Anfangszustand ist:

$$p\left(q^i{}_1\right) \equiv \pi_i$$

Wichtig ist, dass für jede Folge von Signalgrundobjektprototypen ein neues Modell erstellt werden muss. In einem Modell M soll die Beobachtungswahrscheinlichkeit für eine zeitliche Beobachtungsfolge von Signalgrundobjektprototypen

$$\vec{Ge} = \left(Ge_1, Ge_2, ... Ge_N\right)$$

bestimmt werden

Dies entspricht einer nicht unmittelbar beobachtbaren zeitlichen Zustandsfolge, die der folgenden Folge entspricht:

$$\vec{Q} = \left(q_1, q_2, .... q_N\right)$$

Die von dem Modell M, der zeitlichen Zustandsfolge Q und der zeitlichen Beobachtungsfolge Ge abhängige Wahrscheinlichkeit p, diese Zustandsfolge Q zu beobachten, ist:

$$p\left(G\vec{e}\middle|\vec{Q},M\right) = p\left(Ge_1, Ge_2, \ldots Ge_N \middle| q_1, q_2, \ldots q_N\right)$$
$$= p\left(Ge_1\middle|q_1\right)\cdot p\left(Ge_2\middle|q_2\right)\cdot\ldots\ldots p\left(Ge_N\middle|q_N\right)$$
$$= \prod_{n=1}^{N} p\left(Ge_n\middle|q_n\right)$$
$$= \prod_{n=1}^{N} b_n\left(Ge_n\right)$$

Damit ergibt sich als Wahrscheinlichkeit einer Zustandsfolge $\vec{Q} = (q_1, q_2, \ldots q_N)$ im Modell M:

$$p\left(\vec{Q}\middle|M\right) = p\left(q_1, q_2, \ldots q_N \middle| M\right)$$
$$= p(q_1)\cdot p\left(q_2\middle|q_1\right)\cdot p\left(q_3\middle|q_1,q_2\right)\cdot\ldots p\left(q_N\middle|q_1,q_2,\ldots q_{N-1}\right)$$
$$= p(q_1)\prod_{n=2}^{N} p\left(q_n\middle|q_{n-1}\right)$$
$$= \pi_1 \prod_{n=2}^{N} a_{(n-1)n}$$

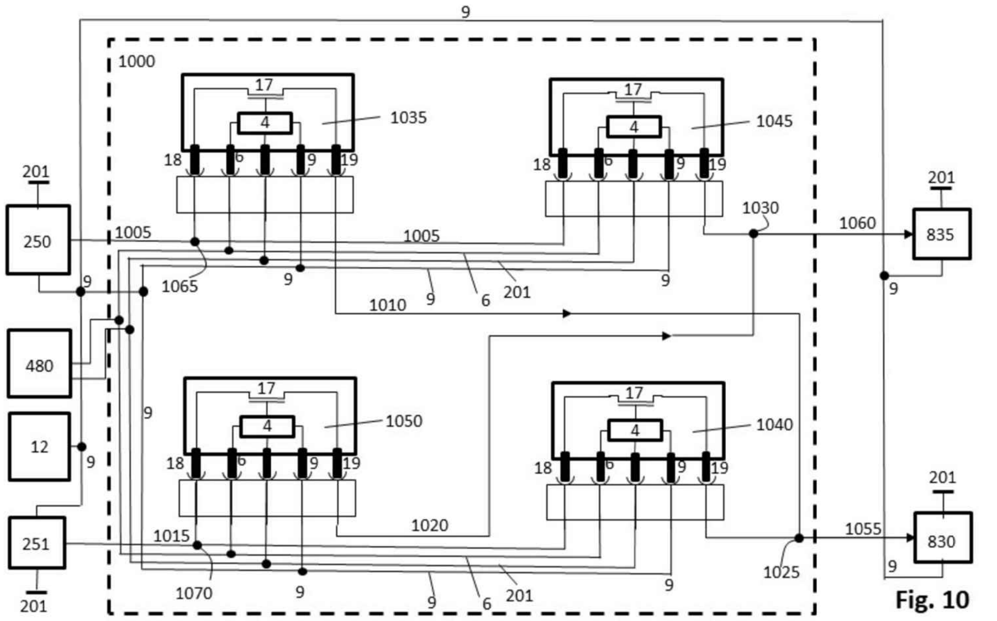

Somit ergibt sich als Wahrscheinlichkeit für die Erkennung eines Signalobjekts gleich einer Folge von Signalgrundobjektprototypen (siehe auch Figur 10):

$$p\left(G\vec{e}\middle|M_j\right) = \sum_{all\,Q_k} p\left(G\vec{e}\middle|Q_k,M_j\right)p\left(\vec{Q}_k\middle|M_j\right)$$
$$= \sum_{all\,Q_k}\left(\prod_{n=1}^{N} b_n\left(Ge_n\right)\right)\left(\pi_1 \prod_{n=2}^{N} a_{(n-1)n}\right)$$

Dabei erfolgt die Bestimmung des wahrscheinlichsten Signalobjekt-Modells (Signalobjekt) für die beobachtete Emission Ge durch diese Summation der Einzelwahrscheinlichkeiten über alle möglichen Pfade $Q_k$, die zu dieser beobachteten Folge von Signalgrundobjektprototypen Ge führen.

$$p\left(G\vec{e}\middle|M_j\right) = \sum_{all\,Q_k} p\left(G\vec{e}\middle|Q_k,M_j\right)p\left(\vec{Q}_k\middle|M_j\right)$$
$$= \sum_{all\,Q_k}\left(\prod_{n=1}^{N} b_n\left(Ge_n\right)\right)\left(\pi_1 \prod_{n=2}^{N} a_{(n-1)n}\right)$$

Die Summierung über alle möglichen Pfade Q ist aufgrund des möglichen Rechenaufwands nicht unproblematisch. In der Regel wird daher sehr frühzeitig abgebrochen. Es wird daher vorgeschlagen, nur den wahrscheinlichsten Pfad $Q_k$ zu nutzen. Dies wird im Folgenden diskutiert.

Die Berechnung erfolgt durch rekursive Berechnung. Die Wahrscheinlichkeit $a_n(i)$ zum Zeitpunkt n das System im Zustand $q^i$ zu beobachten lässt sich wie folgt berechnen:

$$\alpha_n(i) = p\left(Ge_1, Ge_2, \ldots Ge_n; q_n = q^i\right) \equiv p\left(Ge_i^n, q_n^i\right)$$

$$\alpha_{n+1}(j) = \left[\sum_{i=1}^{S} \alpha_n(i)\cdot a_{ij}\right] b_j\left(Ge_{n+1}\right)$$

Hierbei wird über alle S möglichen Pfade summiert, die in den Zustand $q^{i+1}$ hineinführen

Es wird dabei angenommen, dass die Gesamtwahrscheinlichkeit in den Zustand $q^i_{n+1}$ zu gelangen vom besten Pfad dominiert wird. Dann kann die Summe mit geringem Fehler vereinfacht werden.

$$\alpha_{n+1}{}^*(j) = \left[\max_i \left(\alpha_n{}^*(i) \cdot a_{ij}\right)\right] b_j\left(c_{n+1}\right)$$

Durch Rückverfolgung vom letzten Zustand aus erhält man nun den besten Pfad.

Die Wahrscheinlichkeit dieses Pfades ist ein Produkt. Daher reduziert eine logarithmische Berechnung das Problem auf ein reines Summationsproblem. Dabei entspricht die Wahrscheinlichkeit für die Erkennung eines Signalobjekts, was der Erkennung eines Modells $M_j$ entspricht, der Bestimmung des wahrscheinlichsten Signalobjekt-Modells für die beobachtete Emission X. Diese erfolgt nun ausschließlich über den besten möglichen Pfad $Q_{best}$

$$p\left(G\vec{e}\,|M_j\right) = \sum_{all\,Q_k} \left(\prod_{n=1}^{N} b_n\left(Ge_n\right)\right)\left(\pi_1 \prod_{n=2}^{N} a_{(n-1)n}\right)$$

Diese wird damit zu

$$p\left(G\vec{e}\,|M_j\right) = p\left(G\vec{e}\,|Q_{best}, M_j\right) p\left(\vec{Q}_{best}\,|M_j\right)$$

$$= \exp\left(\ln(\pi_1) + \ln(b_1(Ge_1)) + \sum_{n=2}^{N} \ln(b_n(Ge_n)) + \ln(a_{(n-1)n})\right)$$

Es ist nun von besonderer Bedeutung, dass die Prototypendatenbank 62115 nur Signalgrundobjektprototypen, also prototypische Merkmalsvektoren, enthält.

Die Steuervorrichtung 4 der Sicherung 1 überträgt die Indices der erkannten Signalobjekte vorzugsweise zusammen mit den ggf. erkannten Parametern anstelle der Abtastwerte an das übergeordnete Rechnersystem 12 und/oder eine Steuervorrichtung 4 einer anderen Sicherung. Dies führt zu einer massiven Kompression der Daten, ohne den Signalcharakter zu verlassen.

Die Steuervorrichtung 4 der Sicherung 1 überträgt also nicht die Abtastwerte der Parameterverläufe oder der Verläufe daraus abgeleiteter Parameter, sondern vielmehr die Strukturen innerhalb dieser Verläufe. Die Steuervorrichtung 4 der Sicherung 1 nutzt also eine Signalstrukturerkennung zur Übertragung der Parameterverläufe der physikalischen Parameter bzw. der Verläufe daraus abgeleiteter Parameter an das übergeordnete Rechnersystem 12 oder die Steuervorrichtung 4 einer anderen Sicherung. Erst dies ermöglicht die bewertungsfreie Rekonstruktion des Signals im übergeordneten Rechnersystem nach dem Empfang der Daten.

Die technische Lehre der hier vorgelegten Schrift verfolgt somit mehrere Ziele. Zum Ersten sollen prototypische Signalgrundobjekte in den Parameterverläufen der physikalischen Parameter bzw. der Verläufe daraus abgeleiteter Parameter erkannt und ggf. bewertet werden, um kritische Signalgrundobjekte, die mit kritischen Ereignissen korrelieren, sofort zu erkennen. Die Steuervorrichtung 4 der Sicherung 1 soll dann sofort geeignete Maßnahmen einleiten. Zum Zweiten sollen kritische prototypische Signalobjekte, die einer vordefinierten, prototypischen Folge von prototypischer Signalgrundobjekte entsprechen, erkannt und ggf. bewertet werden, um kritische prototypische Signalobjektsequenzen, die mit kritischen Ereignissen korrelieren, sofort zu erkennen. Die Steuervorrichtung 4 der Sicherung 1 soll dann sofort geeignete Maßnahmen einleiten. Zum Dritten soll die Steuervorrichtung die Parameterverläufe der physikalischen Parameter bzw. der Verläufe daraus abgeleiteter Parameter mit möglichst wenig Busbandbreite an das übergeordnete Rechnersystem und/oder eine Steuervorrichtung 4 einer anderen Sicherung 1 übertragen können. Hierfür komprimiert die Steuervorrichtung 4 der Sicherung die Daten der Abtastwerte der Parameterverläufe der physikalischen Parameter bzw. der Verläufe daraus abgeleiteter Parameter. Hierzu ermittelt die Steuervorrichtung 4 der Sicherung die prototypischen Signalgrundobjekte der Prototypendatenbank 62115, die Abschnitte der Parameterverläufe der physikalischen Parameter bzw. der Verläufe daraus abgeleiteter Parameter am besten entsprechen. Die Steuervorrichtung kann bereits die Indices dieser Signalgrundobjekte und deren Abstände an ein übergeordnetes Rechnersystem 12 und/oder eine Steuervorrichtung 4 einer anderen Sicherung über den Datenbus 9 übertragen. Die Steuervorrichtung 4 der Sicherung 1 kann diese bereits komprimierten Daten dadurch noch weiter komprimieren, dass sie für Folgen von Signalgrundobjekten erkannte Signalobjekte der Signalobjektsequenzdatenbank 62116 ermittelt, die diese Folgen von Signalgrundobjekten besonders gut repräsentieren. Die Steuervorrichtung 4 der Sicherung überträgt dann bevorzugt nur noch den Index des erkannten Signalobjekts in der Signalobjektsequenzdatenbank 62116 an das übergeordnete Rechnersystem 12 und/oder die Steuervorrichtung 4 einer anderen Sicherung.

Ziel des vorliegenden Vorschlags ist somit auch sondern das Parametersignal 62103 selbst möglichst verlustfrei durch Beschränkung auf Anwendungsrelevante Signalformbestanteile zu komprimieren und zu übertragen.

Die Steuervorrichtung 4 der Sicherung überträgt dann die so komprimierten Daten, bevorzugt nur die Kodierungen (Symbole) der so erkannten Prototypen, deren Amplitude und/oder zeitliche Streckung und den Auftretenszeitpunkt (Zeitstempel), an das übergeordnete Rechnersystem 12 und/oder die Steuerungsvorrichtung 4 einer anderen Sicherung. Dies minimiert auch die EMV Belastung durch die Datenübertragung über den Datenbus 9 zwischen Sicherung 1 und übergeordnetem Rechnersystem 12. Außerdem können die Sicherung 1 und das übergeordnete Rechnersystem 12 und ggf. weitere Sicherungen können Statusdaten der Sicherungen und/oder des übergeordneten Rechnersystems 12 zur Systemfehlererkennung in den zeitlichen Zwischenräumen an das übergeordnete Rechnersystem 12 und/oder die anderen Sicherungen über den Datenbus 9 zwischen Sicherung und übergeordnetem Rechnersystem 12 und/oder den anderen Sicherungen übertragen werden, was die Latenzzeit verbessert. Bei der Ausarbeitung des Vorschlags wurde erkannt, dass die Übertragung der Daten über den Datenbus 9 priorisiert erfolgen muss. Diese Priorisierung betrifft aber nicht die Priorisierung gegenüber anderen Busteilnehmern. Hier ist daher vielmehr die Priorisierung dahingehend zu verstehen, welches Datum der von der Steuervorrichtung 4 der Sicherung 1 ermittelten Daten zeitlich als erstes zum übergeordneten Rechnersystem 12 übertragen werden muss. Meldungen sicherheitskritischer Fehler der Sicherung 1 oder von Leitungsabschnitten an das übergeordnete Rechnersystem 12 und/oder andere Sicherungen haben dabei die höchste Priorität, da diese die Gültigkeit der Messdaten der Sicherung mit hoher Wahrscheinlichkeit beeinträchtigen. Diese Daten werden von der Sicherung an das übergeordnete Rechnersystem 12 und/oder andere Sicherungen gesendet. Die zweithöchste Priorität haben Anfragen des übergeordneten Rechnersystems 12 und/oder von andren Sicherungen zur Durchführung sicherheitsrelevanter Selbsttests der Sicherung. Solche Befehle werden vom übergeordneten Rechnersystem 12 und/oder den Steuervorrichtungen 4 anderer Sicherungen an die Steuervorrichtung 4 der Sicherung über den Datenbus 9 gesendet. Die dritthöchste Priorität haben die Daten der Sicherung 1 selbst, da die Latenzzeit typischerweise nicht erhöht werden darf. Alle anderen Daten haben niedrigere Priorität für die Übertragung über den Datenbus 9.

Es ist besonders vorteilhaft, wenn das Verfahren zur Übertragung von Daten der Sicherung 1 von der Steuervorrichtung 4 der Sicherung 1 zum übergeordneten Rechnersystem 12 und/oder zur Steuervorrichtung 4 einer anderen Sicherung, insbesondere in einem Fahrzeug, typischerweise umfassend

ggf. das Schließen 6010 des Leistungsschalters 17 der Sicherung 1 durch die Steuervorrichtung 4 und
das Erfassen 6020 der Parameterwerteverläufe und/oder der Verläufe daraus abgeleiteter Parameter und das Bilden 6020 eines Parametersignals 62103 und
das Analysieren und Komprimieren 6030 des Parametersignals 62103 und
das Übertragen 6040 der komprimierten Daten der Sicherung 1 über einen Datenbus 9, insbesondere einen Eindrahtdatenbus oder insbesondere differenziellen Zweidrahtdatenbus, an das übergeordnete Rechnersystem 12 und/oder die Steuervorrichtung 4 einer anderen Sicherung durch die Steuervorrichtung 4 der Sicherung 1.

Vorzugsweise beginnt die Übertragung der Daten von der Steuervorrichtung 4 der Sicherung 1 an das übergeordnete Rechnersystem 12 und/oder eine Steuervorrichtung 4 einer anderen elektronischen Sicherung mit einem Startbefehl des übergeordneten Rechnersystems 12 und/oder der Steuervorrichtung 4 der anderen Sicherung von dem übergeordneten Rechnersystem 12 bzw. von der Steuervorrichtung 4 der anderen Sicherung an die Steuervorrichtung 4 der Sicherung 1 über den Datenbus 9 Beispielsweise kann die Steuervorrichtung 4 der Sicherung nach dem Empfang des Startbefehls die Übertragung periodisch fortlaufend bis zu einem Ende der Datenübertragung durchführen. Hierdurch überträgt die Steuervorrichtung 4 der Sicherung bevorzugt die komprimierten Daten der Parameterverläufe eines zeitlichen Abtastfensters bevorzugt burstartig an das übergeordnete Rechnersystem und/oder an die Steuervorrichtung einer anderen Sicherung.

Eine weitere Variante des vorgeschlagenen Verfahrens sieht somit als ersten Schritt der Datenkompression das Bilden eines Signals von Merkmalsvektoren 62138 (Strom von Merkmalsvektoren mit n Vektorkomponenten und n als Dimension der Merkmalsvektoren) aus dem Parametersignal 62103 vor. Ein solches Signal der Merkmalsvektoren 62138 kann mehrere Datensignale umfassen. Es stellt also eine zeitliche Folge von mehr oder weniger komplexen Daten/Signal-Strukturen dar. Im einfachsten Fall kann es als vektorielles Signal bestehend aus mehreren Teilsignalen aufgefasst werden.

Beispielsweise kann es sinnvoll sein, eine erste und/oder höhere zeitliche Ableitung des Parametersignals 62103 oder das einfache oder mehrfache Integral des Parametersignals zu bilden, die dann Teilsignale innerhalb des Signals der Merkmalsvektoren 62138 sind.

Schließlich kann es sinnvoll sein, durch Optimalfilter (englisch matched filter) 62104.1 bis 62104.n das Auftreten vorbestimmter Signalobjekte im Parametersignal 62105 zu detektieren und ein Zwischenparametersignalbündel 62123 aus beispielsweise n Zwischenparametersignalen 62123.1 bis 62123.n zu bilden. Bevorzugt signalisiert ein Zwischenparametersignal der Zwischenparametersignale 62123.1 bis 62123.n das Erscheinen des jeweiligen Signalobjekts einiger der vorbestimmter Signalobjekte. Da die Anzahl der Signalobjekte, die die Steuervorrichtung 4 der Sicherung 1 erkennen können soll, jedoch in der Regel sehr groß ist, signalisiert typischerweise ein Zwischenparametersignal der Zwischenparametersignale 62123.1 bis 62123.n das Erscheinen eines Signalobjekts, das Element einer Menge vorbestimmter Signalobjekte ist. Typischerweise spricht ein zu erkennendes Signalobjekt die Zwischenparametersignale mehrerer Optimalfilter an. Unter Optimalfilter (engl. matched filter) versteht das hier vorgelegte Dokument hierbei ein Filter, welches das Signal-Rausch-Verhältnis (engl. signal to noise ratio, SNR) optimiert. In dem gestörten Parametersignal 62103 soll die Steuervorrichtung 4 der Sicherung 1 die vordefinierten Signalobjekte erkennen. In der Literatur findet man auch häufig die Bezeichnungen Korrelationsfilter, Signal-angepasstes Filter (SAF) oder nur angepasstes Filter für das Optimalfilter. Das Optimalfilter dient zur optimalen Bestimmung des Vorhandenseins (Detektion) der Amplitude und/oder der Lage einer bekannten Signalform, hier des vorbestimmten Signalobjekts, in Gegenwart von Störungen (Parameterschätzung). Diese Störungen können beispielsweise Signale EMV-Einkopplungen anderer Leitungen oder elektromagnetischer Strahler etc. sein.

Die n Optimalfilter-Ausgangssignale der n Optimalfilter bilden dann die n Zwischenparametersignale 62123.1 bis 62123.n des Zwischenparametersignalbündels 62123, das dann vorzugsweise nach einer Affinen Abbildung dann bevorzugt zumindest Teilsignale innerhalb des Signals der Merkmalsvektoren 62138 bildet.

Bestimmte Ereignisse kann die Merkmalsvektorextraktion 62111 in gesonderten zusätzlichen Teilsignalen des Zwischenparametersignalbündels 62123 signalisieren. Diese Ereignisse sind vorzugsweise ebenfalls Signalgrundobjekte der im Sinne des hier vorgelegten Dokuments. Signalgrundobjekte umfassen also nicht nur Signalformen, wie beispielsweise Rechteck-Pulse oder Wavelets oder Wellenzüge, sondern auch markante Punkte im Verlauf des Parametersignals 60103 und/oder im Verlauf von daraus abgeleiteten Signalen, die die Merkmalsextraktion 62111 beispielsweise durch Filterung aus dem Parametersignal 62103 gewinnen kann.

Ein anderes Signal, das ein zusätzliches Teilsignal des Zwischenparametersignalbündels 62123 sein kann, kann beispielsweise detektieren, ob ein gefiltertes Parametersignal 62103 einen vorgegeben Schwellwert kreuzt. Auch hierbei handelt sich also um ein Signal, das das Vorliegen eines Signalgrundobjekts innerhalb des Parametersignals mittels eines Zwischenparametersignals des Zwischenparametersignalbündels 62123 signalisiert.

Ein anderes Signal, das ein zusätzliches Teilsignal des Zwischenparametersignalbündels 62123 sein kann, kann beispielsweise detektieren, ob ein gefiltertes Parametersignal 62103 einen vorgegeben Schwellwert, der mit dem vorgenannten Schwellwert identisch sein kann, aufsteigend kreuzt. Es handelt sich also um ein Signal, das das Vorliegen eines Signalgrundobjekts innerhalb des Parametersignals 62103 mittels eines Zwischenparametersignals des Zwischenparametersignalbündels 62123 signalisiert.

Ein anderes Signal, das ein zusätzliches Teilsignal des Zwischenparametersignalbündels 62123 sein kann, kann beispielsweise detektieren, ob ein gefiltertes Parametersignal 62103 einen vorgegeben Schwellwert, der mit einem oder beiden der unmittelbar vorbenannten Schwellwerte identisch sein kann, abfallend kreuzt. Es handelt sich also um ein Signal, das das Vorliegen eines Signalgrundobjekts innerhalb des Parametersignals 62103 mittels eines Zwischenparametersignals des Zwischenparametersignalbündels 62123 signalisiert.

Ein anderes Signal, das ein zusätzliches Teilsignal des Zwischenparametersignalbündels 62123 sein kann, kann beispielsweise detektieren, ob ein gefiltertes Parametersignal 62103 ein Maximum oberhalb eines Schwellwerts aufweist, der mit einem oder mehreren der vorgenannten drei Schwellwerte identisch sein kann. Es handelt sich also um ein Signal, das das Vorliegen eines Signalgrundobjekts innerhalb des Parametersignals 62103 mittels eines Zwischenparametersignals des Zwischenparametersignalbündels 62123 signalisiert.

Ein anderes Signal, das ein zusätzliches Teilsignal des Zwischenparametersignalbündels 62123 sein kann, kann beispielsweise detektieren, ob ein gefiltertes Parametersignal 62103 ein Minimum oberhalb eines Schwellwerts aufweist, der mit einem oder mehreren der vorgenannten vier Schwellwerte identisch sein kann. Es handelt sich also um ein Signal, das das Vorliegen eines Signalgrundobjekts innerhalb des Parametersignals 62103 mittels eines Zwischenparametersignals des Zwischenparametersignalbündels 62123 signalisiert.

Dabei wertet die Merkmalsextraktion 62111 bevorzugt aus, ob das zumindest eine, vorausgehende Maximum des Parametersignals 62103 einen Mindestabstand zu dem Minimum hat, um eine Detektion von Rauschen zu vermeiden. Andere Filterungen durch die Merkmalsextraktion 62111 sind an dieser Stelle denkbar. Auch kann die Merkmalsextraktion 62111 ggf. prüfen, ob der zeitliche Abstand zwischen diesem Minimum und einem vorausgehenden Maximum größer ist als ein erster zeitlicher Mindestabstand. Bei Erfüllung dieser Bedingungen setzt die Merkmalsextraktion 62111 bevorzugt jeweils ein Flag oder Signal, dessen Wert selbst wieder bevorzugt ein zusätzliches Zwischenparametersignals des Zwischenparametersignalbündels 62123 ist.

Ebenso sollte die Merkmalsextraktion 62111 in analoger Weise prüfen, ob die zeitlichen und amplitudenmäßigen und sonstigen Abstände der anderen Signalobjekte gewissen Plausibilitätsanforderungen, wie zeitliche Mindestabstände und/oder Mindestabstände genügen. Auch aus diesen Prüfungen kann ggf. die Merkmalsextraktion 62111 weitere Teilsignale als zusätzliche Zwischenparametersignale des Zwischenparametersignalbündels 62123 ableiten, die somit das Zwischenparametersignalbündels 62123 in seiner Dimensionalität weiter vergrößern.

Ggf. kann die besagte Signifikanzsteigerungseinheit 62125 das Zwischenparametersignalbündel 62123 zu einem in der Signifikanz gesteigerten Signal der Merkmalsvektoren 62138 z.B. durch eine lineare Abbildung oder ein Matrix-Polynom höherer Ordnung noch transformieren. Das hier vorgelegte Dokument erwähnte zuvor bereits die besagte LDA-Matrix 62126 in diesem Zusammenhang.

Gemäß dem vorgeschlagenen Verfahren bzw. der technischen Lehre des hier vorgelegten Dokuments führt der Abstandsermittler oder Klassifikator 62112 das Erkennen und das Klassifizieren von Signalobjekten in erkannte Signalobjektklassen innerhalb des Parametersignals 62103 im Zusammenwirken mit der Merkmalsextraktion 62111 auf Basis des Zwischenparametersignalbündels 62123 oder des signifikanten Signals der Merkmalsvektoren 62138 durch.

Liegt beispielsweise die Amplitude des Ausgangssignals eines Optimalfilters in Form eines Zwischenparametersignals, und damit eines Teilsignals des Zwischenparametersignalbündels 62123 oberhalb eines ggf. Optimalfilter spezifischen Schwellwerts, so kann die Steuervorrichtung 4 das Signalobjekt, für dessen Detektion der Optimalfilter vorzugsweise hauptsächlich ausgelegt ist, bereits als erkannt bewerten. Dabei berücksichtigt die Steuervorrichtung 4 vorzugsweise auch andere Parameter. Hat das übergeordnete Rechnersystem 12 beispielsweise einen Verbraucher an anderer Stelle im Versorgungsnetzwerk ein- oder ausgeschaltet, dessen elektrischer Strom durch die Sicherung fließt, und hat das übergeordnete Rechnersystem 12 zuvor alle Sicherungen, die von dem elektrischen Strom dieses Verbrauchers über die Absicht diesen Verbraucher ein- bzw. auszuschalten informiert, so erwartet die Sicherung dann eine Stromveränderung innerhalb eines festgelegten Zeitraums nach dem Empfang dieser Mitteilung bzw. innerhalb eines Zeitraumes, den das übergeordnete Rechnersystem 12 vorzugsweise mit der Mitteilung über das anstehende Ereignis angibt. Stimmt die Änderung der Signalform des Parametersignals 62103, beispielsweise das Auftreten eines Sprungs im Parametersignal 62103, zeitlich lokal mit einer erwarteten Signalform überein, so handelt es sich um das entsprechende Ereignis.

Das übergeordnete Rechnersystem 12 kann beispielsweise die Steuervorrichtung 4 mittels eines Datenbefehls über den Datenbus 9 anweisen, das Auftreten des angekündigten Ereignisses an das übergeordnete Rechnersystem 12 mittels einer Datenbotschaft über den Datenbus 9 zu melden.

Das übergeordnete Rechnersystem 12 kann beispielsweise die Steuervorrichtung 4 mittels eines Datenbefehls über den Datenbus 9 anweisen, das Nicht-Auftreten des angekündigten Ereignisses innerhalb eines vereinbarten oder vorgegebenen Zeitfensters an das übergeordnete Rechnersystem 12 mittels einer Datenbotschaft über den Datenbus 9 zu melden.

Das übergeordnete Rechnersystem 12 kann beispielsweise die Steuervorrichtung 4 mittels eines Datenbefehls über den Datenbus 9 anweisen, das Nicht-Auftreten des angekündigten Ereignisses innerhalb eines vereinbarten oder vorgegebenen Zeitfensters mit vorgegebenen Parametern an das übergeordnete Rechnersystem 12 mittels einer Datenbotschaft über den Datenbus 9 zu melden.

Das übergeordnete Rechnersystem 12 kann beispielsweise die Steuervorrichtung 4 mittels eines Datenbefehls über den Datenbus 9 anweisen, das Auftreten des angekündigten Ereignisses in der Log-Datei der Sicherung 1 beispielsweise zusammen mit einem Zeitstempel abzuspeichern.

Das übergeordnete Rechnersystem 12 kann beispielsweise die Steuervorrichtung 4 mittels eines Datenbefehls über den Datenbus 9 anweisen, das Nicht-Auftreten des angekündigten Ereignisses innerhalb eines vereinbarten oder vorgegebenen Zeitfensters in der Log-Datei der Sicherung 1 beispielsweise zusammen mit einem Zeitstempel abzuspeichern.

Das übergeordnete Rechnersystem 12 kann beispielsweise die Steuervorrichtung 4 mittels eines Datenbefehls über den Datenbus 9 anweisen, das Nicht-Auftreten des angekündigten Ereignisses innerhalb eines vereinbarten oder vorgegebenen Zeitfensters mit vorgegebenen Parametern in der Log-Datei der Sicherung 1 beispielsweise zusammen mit einem Zeitstempel abzuspeichern.

Das übergeordnete Rechnersystem 12 kann beispielsweise die Steuervorrichtung 4 mittels eines Datenbefehls über den Datenbus 9 anweisen, bei Nicht-Auftreten des angekündigten Ereignisses innerhalb eines vereinbarten oder vorgegebenen Zeitfensters bestimmte Maßnahmen, beispielsweise das Öffnen des Leistungsschalters 17, zu ergreifen.

Vorzugsweise signalisiert das übergeordnete Rechnersystem 12 der Steuervorrichtung 4 der Sicherung, mit welcher Priorität die Steuervorrichtung 4 der Sicherung diese Datenbotschaften je nach Überwachungsergebnis zum übergeordneten Rechnersystem 12 über den Datenbus senden soll. Bevorzugt umfassen die Datenbotschaften der Steuervorrichtungen 4 der Sicherungen im Versorgungsnetzwerk 200 und die Datenbotschaften des übergeordneten Rechnersystems 12 eine Information über die Priorität der jeweiligen Datenbotschaft. Bevorzugt handelt es sich bei dem Datenbus und dem Datenbusprotokoll um ein Datenbussystem, dass eine Wired-Or-Verknüpfung zulässt. Die Busteilnehmer des Datenbusses 9 können dann gleichzeitig auf den Datenbus 9 senden, ohne dass es zu einer physikalischen Beschädigung der Datenbusschnittstellen 10, 610 der Steuervorrichtungen 4 der Sicherungen bzw., des übergeordneten Rechnersystems 12 kommt. Übertragen die Busteilnehmer die Information über die Priorität der jeweiligen Datenbotschaft zu Beginn der Datenbotschaft. Bevorzugt setzt sich die Information über die Priorität der jeweiligen Datenbotschaft der Datenbotschaft mit der höheren Priorität durch. Die Datenbusschnittstelle desjenigen Busteilnehmers, der gerade eine Datenbotschaft mit niedriger Priorität sendet, detektiert diese Buskollision, da die Information über die Priorität seiner Datenbotschaft durch die Information über die Priorität der Datenbotschaft mit der höheren Priorität unterdrückt wird. Die Datenbusschnittstelle dieses Busteilnehmers stellt also fest, dass es eine Buskollision gegeben hat und dass offensichtlich ein Busteilnehmer mit höherer Priorität sendet und stellt die Sendung seines Datenpakets sofort ein, um die Übertragung der Datenbotschaft eines anderen Busteilnehmers mit höherer Priorität nicht zu gefährden. Detektiert der betroffene Busteilnehmer das Ende der höher priorisierten Datenbotschaft, so startet er den nächsten Sendeversuch.

Die Übertragung der Daten der komprimierten Parametersignalverläufe der physikalischen Parameter über den Datenbus 9 von der Steuervorrichtung 4 der Sicherung 1 zum übergeordneten Rechnersystem 12 und/oder zu Steuervorrichtungen 4 anderer Sicherungen erfolgt dabei vorzugsweise mit unterschiedlich priorisierten Datenbotschaften. Die Übertragung von Daten der komprimierten Parametersignalverläufe der physikalischen Parameter, die sicherheitsrelevante Informationen sind, erfolgt über den Datenbus 9 von der Steuervorrichtung 4 der Sicherung 1 zum übergeordneten Rechnersystem 12 und/oder zu Steuervorrichtungen 4 anderer Sicherungen höher priorisiert. Ebenfalls höher priorisiert erfolgt die Übertragung von Kommandos von dem übergeordneten Rechnersystem 12 zu den Sicherungen sehr hoch priorisiert, wenn es sich um Kommandos handelt, die sicherheitsgefährdende Zustände beenden oder eingrenzen sollen oder die sonst wie sicherheitsrelevant sind. Vorzugsweise erfolgt die Kommunikation über den Datenbus 9 kryptografiert.

Typischerweise ordnet die Steuervorrichtung 4 bei der Erkennung jedem erkannten Signalobjekt zumindest einen zugeordneten Signalobjektparameter zu oder bestimmt diesen für dieses Signalobjekt. Bevorzugt handelt es sich bei dem zugeordneten Signalobjektparameter bevorzugt um einen Zeitstempel, der beispielsweise angibt, wann die Steuervorrichtung 4 das Signalobjekt erfasst hat. Dabei kann der Zeitstempel sich beispielsweise auf den zeitlichen Beginn des Signalobjekts im Parametersignal 62103 oder das zeitliche Ende oder die zeitliche Lage des zeitlichen Schwerpunkts des Signalobjekts im Parametersignal 62103 etc. beziehen. Auch sind andere Signalobjektparameter, wie Amplitude, Streckung etc. denkbar. In einer Variante des vorgeschlagenen Verfahrens überträgt die Steuervorrichtung 4 somit zumindest einen der zugeordneten Signalobjektparameter mit einem Symbol für bevorzugt zumindest ein erkanntes Signalobjekt der Signalobjektsequenzdatenbank 62116. Der Signalobjektparameter ist beispielsweise bevorzugt ein Zeitwert als Zeitstempel und gibt eine zeitliche Position an, die geeignet ist, daraus auf die Zeit eines Ereignisses im Versorgungsnetzwerk versorgungsnetzwerkweit schließen zu können.

Anschließend überträgt die Steuervorrichtung 4 der Sicherung schließlich priorisiert die erkannten Signalobjekte in Form zugeordneter Symbole mit Zeitstempeln vorzugsweise jeweils zusammen mit den zugeordneten Signalobjektparametern. Die Übertragung kann auch in komplexeren Datenstrukturen (englisch: Records) erfolgen. Beispielsweise ist es denkbar, zuerst die Zeitpunkte der erkannten sicherheitsrelevanten Signalobjekte zu übertragen und dann die erkannten Signalobjekte der sicherheitsrelevanten Signalobjekte. Hierdurch wird die Latenzzeit weiter verringert.

Die Auswertung des Zwischenparametersignalbündels 62123 und/oder des signifikanten Signals der Merkmalsvektoren 62138 kann in einer Variante des vorgeschlagenen Verfahrens so erfolgen, dass ein oder mehrere Abstände zwischen dem Signal der Merkmalsvektoren 62138 und einem oder mehreren Signalgrundobjektprototypen für erkennbare Signalgrundobjekte gebildet werden. Ein solcher Abstand kann boolesch, binär, diskret, digital oder analog sein. Vorzugsweise werden alle Abstandswerte in einer nichtlinearen Funktion miteinander verknüpft. So kann die Steuervorrichtung 4 bestimmte Kombinationen von Werten von Vektorkomponenten eines Merkmalsvektors des Signals der Merkmalsvektoren 62138 diesen Merkmalsvektor verwerfen. Dieses Verwerfen ist im Sinne dieser Offenlegung ein nichtlinearer Vorgang.

Umgekehrt auch können Signalgrundobjekte und/oder Signalobjekte im Parametersignal 62103 unterschiedlich ausgeprägt sein. Dies betrifft zuallererst die Amplitude eines Signalobjekts und/oder Signalgrundobjekts im Parametersignal 62103. Ist die Amplitude im Parametersignal 62103 hinreichend, so liefert beispielsweise ein auf die Erkennung einer Klasse von Signalgrundobjekten und/oder Signalobjekten im Wesentlichen optimierter Optimalfilter ein Zwischenparametersignal oberhalb eines vorgegeben Schwellwerts. In dem Fall kann dann beispielsweise dieser Klasse von Signalobjekten und/oder Signalgrundobjekten (z.B. Dreieckssignal) ein erkanntes Signalobjekt bzw. Signalgrundobjekt zu diesem Zeitpunkt des Überschreitens bereits zugeordnet werden. In dem Fall unterschreitet der Abstand zwischen dem aktuellen Merkmalsvektor des Signals der Merkmalsvektoren 62138 und dem prototypischen Merkmalsvektor der Prototypendatenbank 62115 einen oder mehrere vorbestimmte Abstandswerte.

Bei einer weiteren Variante des Verfahrens handelt es sich bei mindestens einer Signalobjektklasse um Wavelets, deren Vorhandensein im Parametersignal 62103 Schätzvorrichtungen (z.B. Optimalfilter) und/oder Schätzverfahren (z.B. Schätzprogramme, die in einem digitalen Signalprozessor ablaufen), die die Steuervorrichtung 4 der Sicherung ausführt, schätzt und damit detektiert. Mit dem Begriff Wavelet bezeichnet das hier vorgelegte Dokument Funktionen, die einer kontinuierlichen oder einer diskreten Wavelet-Transformation zugrunde gelegt werden können. Das Wort "Wavelet" ist eine Neuschöpfung aus dem französischen "ondelette", das "kleine Welle" bedeutet und teils wörtlich ("onde"→"wave"), teils phonetisch ("-lette"→"-let") ins Englische übertragen wurde. Der Ausdruck "Wavelet" wurde in den 1980er Jahren in der Geophysik (Jean Morlet, Alex Grossmann) für Funktionen geprägt, welche die Kurzzeit-Fourier-Transformation verallgemeinern, wird jedoch seit Ende der 1980er Jahre ausschließlich in der heute üblichen Bedeutung verwendet. In den 1990er Jahren entstand ein regelrechter Wavelet-Boom, ausgelöst durch die Entdeckung von kompakten, stetigen (bis hin zu beliebiger Ordnung der Differenzierbarkeit) und orthogonalen Wavelets durch Ingrid Daubechies (1988) und die Entwicklung des Algorithmus der schnellen Wavelet-Transformation (FWT) mit Hilfe der Multiskalenanalyse (MultiResolution Analysis - MRA) durch Stéphane Mallat und Yves Meyer (1989).

Im Gegensatz zu den Sinus- und Kosinus-Funktionen der Fourier-Transformation besitzen die meistverwendeten Wavelets nicht nur Lokalität im Frequenzspektrum, sondern auch im Zeitbereich. Dabei ist "Lokalität" im Sinne kleiner Streuung zu verstehen. Die Wahrscheinlichkeitsdichte ist das normierte Betragsquadrat der betrachteten Funktion bzw. von deren Fourier-Transformierten. Dabei ist das Produkt beider Varianzen immer größer als eine Konstante, analog zur Heisenberg'schen Unschärferelation. Aus dieser Einschränkung heraus entstanden in der Funktionalanalysis die Paley-Wiener-Theorie (Raymond Paley, Norbert Wiener), ein Vorläufer der diskreten Wavelet-Transformation, und die Calderón-Zygmund-Theorie (Alberto Calderón, Antoni Zygmund), die der kontinuierlichen Wavelet-Transformation entspricht.

Das Integral einer Wavelet-Funktion ist im Fachgebrauch zwar immer 0, daher nimmt in der Regel die Wavelet-Funktion die Form von nach außen hinauslaufenden (kleiner werdenden) Wellen (also "Wellchen" = Ondelettes = Wavelets) an. Im Sinne dieser Offenbarung sollen aber auch Wavelets zulässig sein, die ein von 0 verschiedenes Integral besitzen. Hier sei beispielhaft die im Folgenden beschriebenen Rechteck und Dreiecks-Wavelets genannt. Diese weitere Interpretation des Begriffs "Wavelet" ist im amerikanischen Sprachraum verbreitet und von daher bekannt. Diese weitere Interpretation soll auch hier in diesem Dokument gelten.

Wichtige Beispiele für Wavelets mit 0-Integral sind das Haar-Wavelet (Alfréd Haar 1909), die nach Ingrid Daubechies benannten Daubechies-Wavelets (um 1990), die ebenfalls von ihr konstruierten Coiflet-Wavelets und das eher theoretisch bedeutsame Meyer-Wavelet (Yves Meyer, um 1988).

Wavelets gibt es für Räume beliebiger Dimension, meist wird ein Tensorprodukt einer eindimensionalen Wavelet-Basis verwendet. Aufgrund der fraktalen Natur der Zwei-Skalen-Gleichung in der MRA haben die meisten Wavelets eine komplizierte Gestalt, die meisten haben keine geschlossene Form. Dies ist deswegen von besonderer Bedeutung, da das zuvor erwähnte Feature-Vektor-Signal ja mehrdimensional ist und daher die Verwendung multidimensionaler Wavelets zur Signalobjekterkennung zulässt.

Eine besondere Variante des vorgeschlagenen Verfahrens ist daher die Verwendung multidimensionaler Wavelets mit mehr als zwei Dimensionen zur Signalobjekterkennung durch die Steuervorrichtung 4 der Sicherung. Die Wavelets sind Signalgrundobjekte im Sinne des hier vorgelegten Dokuments. Insbesondere schlägt das hier vorgelegte Dokument die Verwendung entsprechender Optimalfilter zur Erkennung solcher Wavelets mit mehr als zwei Dimensionen vor, um die Merkmalsvektoren des Signals der Merkmalsvektoren 62138 um weitere zur Erkennung geeignete Teilsignale ggf. zu ergänzen. Bevorzugt nutzt die Merkmalsextraktion 62111 daher Methoden der Wavelet-Transformation zur Erzeugung des Signals der Merkmalsvektoren 62138.

Ein besonders geeignetes Wavelet für die Analyse und Kompression des Parametersignals ist beispielsweise ein Dreiecks-Wavelet. Dieses zeichnet sich durch einen Startzeitpunkt des Dreiecks-Wavelets, einen dem Startzeitpunkt des Dreiecks-Wavelets zeitlich nachfolgenden, zeitlich im Wesentlichen linearen Anstieg der Wavelet-Amplitude bis zu einem Maximum der Amplitude des Dreiecks-Wavelets und einen dem Maximum des Dreiecks-Wavelets und einem zeitlich nachfolgenden, zeitlich im Wesentlichen linearen Abfall der Wavelet-Amplitude bis zu einem Ende des Dreiecks-Wavelets aus.

Ein weiteres besonders geeignetes Wavelet ist ein Rechteckwavelet, das im Sinne dieser Offenbarung auch trapezförmige Wavelets miteinschließt. Ein Rechteck-Wavelet zeichnet sich durch einen Startzeitpunkt des Rechteck-Wavelets aus, dem ein Anstieg der Wavelet-Amplitude des Rechteckwavelet mit einer ersten zeitlichen Steilheit des Rechteck-Wavelets bis zu einem ersten Plateau-Zeitpunkt des Rechteck-Wavelets folgt. Dem ersten Plateau-Zeitpunkt des Rechteck-Wavelets folgt ein Verharren der Wavelet-Amplitude mit einer zweiten Steilheit der Wavelet-Amplitude bis zu einem zweiten Plateau-Zeitpunkt des Rechteck-Wavelets. Dem zweiten Plateau-Zeitpunkt des Rechteck-Wavelets folgt ein Abfall mit einer dritten zeitlichen Steilheit bis zum zeitlichen Ende des Rechteck-Wavelets. Dabei beträgt der Betrag der zweiten zeitlichen Steilheit weniger als 10% des Betrags der ersten zeitlichen Steilheit und weniger als 10% des Betrags der dritten zeitlichen Steilheit.

Statt der zuvor beschriebenen Wavelets ist auch die Verwendung anderer zweidimensionaler Wavelets, wie beispielsweise eines Sinushalbwellen-Wavelets möglich, das ebenfalls ein Integral ungleich 0 aufweist.

Es wird vorgeschlagen, dass bei Verwendung von Wavelets durch die Merkmalsextraktion 62111 die zeitliche Verschiebung des betreffenden Wavelet des erkannten Signalgrundobjekts als ein Signalgrundobjektparameter verwendet wird. Beispielsweise kann die Steuervorrichtung 4 durch Korrelation diese Verschiebung ermitteln Eine Korrelation kann die Steuervorrichtung 4 beispielsweise mittels eines Korrelationsintegrals oder dergleichen berechnen. Das hier vorgelegte Dokument verweist hier auf die Webseite https://de.wikipedia.org/wiki/Korrelation_(Signalverarbeitung). Das hier vorgelegte Dokument schlägt weiter vor, dass die Steuervorrichtung 4 bei Verwendung von Wavelets der Zeitpunkt der Überschreitung des Pegels des Ausgangs eines zur Detektion des betreffenden Wavelet geeigneten Optimalfilters, also des korrespondierenden Zwischenpegelsignals, über einen vordefinierten zehnten Schwellwert für dieses Signalgrundobjekt bzw. dieses Wavelet bevorzugt verwendet.

Ein weiterer möglicher Signalobjektparameter, den die Steuervorrichtung 4 ermitteln kann, ist eine zeitliche Kompression oder Dehnung des betreffenden Wavelet des Signalgrundobjekts. Ebenso kann die Steuervorrichtung 4 eine Amplitude des Wavelet des Signalgrundobjekts ermitteln.

Es wurde bei der Ausarbeitung des Vorschlags für das hier offenbarte Verfahren erkannt, dass es vorteilhaft ist, die Daten der erkannten Signalgrundobjekte und erkannten Signalobjekte pot. sicherheitsrelevanter Ereignisse zuerst von der Steuervorrichtung 4 zum übergeordneten Rechnersystem 12 über den Datenbus 9 zu übertragen und dann erst die nachfolgenden Daten der mit weniger kritischen Ereignissen assoziierten Signalgrundobjekte und Signalobjekte. Im Rahmen des Erkennungsprozesses kann die Steuervorrichtung 4 den verschiedenen Signalobjekten und Signalgrundobjekten, die für einen Abschnitt des Parametersignals in Frage kommen, Scores zugeordnet, die angeben, welche Wahrscheinlichkeit entsprechend dem verwendeten Schätzalgorithmus die Steuervorrichtung 4 dem Vorliegen dieses Signalobjekts bzw. Signalgrundobjekt im Parametersignal 62103 zuordnet. Ein solcher Score ist im einfachsten Fall binär. Vorzugsweise handelt es sich jedoch um eine komplexe, reelle oder Integer-Zahl. Es kann sich beispielsweise um den ermittelten Abstand handeln. Sofern mehrere Signalobjekte bzw. Signalgrundobjekte einen hohen Score-Wert haben, ist es sinnvoll, dass in manchen Fällen die Steuerungsvorrichtung 4 auch die Daten erkannter Signalobjekte und/oder Signalgrundobjekte mit niedrigeren Score-Werten an das übergeordnete Rechnersystem überträgt. Um dem übergeordneten Rechnersystem die richtige Handhabung zu ermöglichen, sollte die Steuervorrichtung 4 für diesen Fall nicht nur das Datum (Symbol) des erkannten Signalobjekts bzw. des erkannten Signalgrundobjekts und der Zeitstempel für das jeweilige Signalobjekt übertragen, sondern auch den ermittelten Score-Wert. Statt nur Datum (Symbol, Index) des erkannten Signalobjekts bzw. des erkannten Signalgrundobjekts und der Zeitstempel für das diesem Symbol entsprechende Signalobjekt bzw. Signalgrundobjekt zu übertragen, kann die Steuervorrichtung 4 zusätzlich auch das Datum (Symbol, Index) des Signalobjekts bzw. Signalgrundobjekts mit dem zweit kleinsten Abstand und dessen Zeitstempel für das diesem zweitwahrscheinlichsten Symbol entsprechende Signalobjekt bzw. Signalgrundobjekt mit übertragen werden. Somit überträgt in diesem Fall die Steuervorrichtung 4 eine Hypothesenliste aus zwei Signalgrundobjekten bzw. eine Signalobjekthypothesenliste aus zwei erkannten Signalobjekten und deren zeitlichen Positionen sowie zusätzlich zugeordneten Score-Werten an das übergeordnete Rechnersystem 12. Natürlich ist auch die Übertragung einer Hypothesenliste bestehend aus mehr als zwei Symbolen für mehr als zwei erkannte Signalgrundobjekte und deren zeitlichen Positionen sowie zusätzlich zugeordneten Score-Werte an das übergeordnete Rechnersystem 12 denkbar. Natürlich ist auch die Übertragung einer Signalobjekthypothesenliste bestehend aus mehr als zwei Symbolen für mehr als zwei erkannte Signalobjekte und deren zeitlichen Positionen sowie zusätzlich zugeordneten Score-Werte an das übergeordnete Rechnersystem 12 denkbar.

Vorzugsweise erfolgt die Übertragung der Daten der erkannten Signalobjekte bzw. der erkannten Signalgrundobjekte und der zugeordneten Daten wie beispielsweise Zeitstemple und Score-Werte der jeweiligen erkannten Signalobjekte bzw. der erkannten Signalgrundobjekte, also der zugeordneten Signalobjektparameter bzw. der zugeordneten Signalgrundobjektparameter, nach dem FIFO-Prinzip. Dies stellt sicher, dass die Steuervorrichtung 4 stets die Daten der Ereignisse bei gleicher Priorität mit geringster Verzögerung an das übergeordnete Rechnersystem 12 überträgt.

Neben der Übertragung von Messdaten physikalischer Parameter und/oder der zugehörigen zeitlichen Parameterverläufe kann die Steuervorrichtung 4 einer Sicherung 1 auch die Übertragung von Fehlerzuständen der Sicherung 1 vornehmen. Die Steuervorrichtung 4 der Sicherung signalisiert das Auftreten eines Fehlerzustands an das übergeordnete Rechnersystem 4 bevorzugt insbesondere dann, wenn der die Steuervorrichtung 4 der Sicherung durch eine oder mehrere Selbsttestvorrichtungen der Steuervorrichtung 4 und/oder der Sicherung feststellt, dass ein Defekt vorliegt und die zuvor an das übergeordnete Rechnersystem 12 übertragenen Daten potenziell fehlerhaft sein könnten. Somit stellt die Steuervorrichtung 4 der Sicherung 1 sicher, dass das übergeordnete Rechnersystem 12 zum frühesten möglichen Zeitpunkt über eine Änderung der Bewertung der Messdaten der Sicherung Kenntnis erlangen kann und diese verwerfen oder anders behandeln kann. Dies ist von besonderer Bedeutung für sicherheitskritische Eingriffe, die das übergeordnete Rechnersystem 12 vornehmen könnte. Solche sicherheitskritischen Eingriffe darf das übergeordnete Rechnersystem 12 wenn überhaupt nur vornehmen, wenn die zugrundeliegenden Daten der Sicherungen des Versorgungsnetzwerks 200 einen entsprechenden Vertrauenswert besitzen. Dem gegenüber wird daher die Übertragung der Messdaten, also beispielsweise des Datums des erkannten Signalobjekts bzw. des erkannten Signalgrundobjekts und/oder die Übertragung des einen zugeordneten Signalobjektparameters bzw. eines zugeordneten Signalgrundobjektparameters zurückgestellt und damit niedriger priorisiert. Natürlich ist ein Abbruch der Übertragung bei Auftreten eines Fehlers in der Steuervorrichtung 4 der Sicherung 1 denkbar. In manchen Fällen kann es aber vorkommen, dass ein Fehler möglich erscheint, aber nicht sicher vorliegt. Insofern ist in solchen Fällen unter Umständen die Fortsetzung einer Übertragung durch die Steuervorrichtung 4 der Sicherung 1 angezeigt. Die Übertragung sicherheitskritischer Fehler der Sicherung und/oder angeschlossener Versorgungsleitungen erfolgt somit vorzugsweise höher priorisiert.

Neben den bereits beschriebenen Wavelets mit einem Integrationswert von 0 und den zusätzlich hier als Wavelet bezeichneten Signalabschnitten mit einem Integrationswert verschieden von 0 können auch bestimmte Zeitpunkt im Verlauf des Parametersignals als Signalgrundobjekt im Sinne dieses Dokuments aufgefasst werden, die die Steuervorrichtung 4 der Sicherung zu einer Datenkompression verwenden kann und die die Steuervorrichtung 4 anstelle von Abtastwerten des Parametersignals an das übergeordnete Rechnersystem übertragen kann. Diese Untermenge in der Menge möglicher Signalgrundobjekte bezeichnen wir im Folgenden als Signalzeitpunkte. Die Signalzeitpunkte sind also im Sinne des her vorgelegten Dokuments eine spezielle Form der Signalgrundobjekte.

Ein erster möglicher Signalzeitpunkt und damit ein Signalgrundobjekt ist ein Kreuzen der Amplitude eines Parametersignals 62103 mit der Amplitude eines Schwellwertsignals innerhalb der Steuervorrichtung 4 der Sicherung 1 in aufsteigender Richtung.

Ein zweiter möglicher Signalzeitpunkt und damit ein Signalgrundobjekt ist ein Kreuzen der Amplitude eines Parametersignals 62103 mit der Amplitude eines Schwellwertsignals innerhalb der Steuervorrichtung 4 der Sicherung 1 in absteigender Richtung.

Ein dritter möglicher Signalzeitpunkt und damit ein Signalgrundobjekt ist ein Maximum der Amplitude eines Parametersignals 62103 oberhalb der Amplitude eines Schwellwertsignals innerhalb der Steuervorrichtung 4 der Sicherung 1.

Ein vierter möglicher Signalzeitpunkt und damit ein Signalgrundobjekt ist ein Minimum der Amplitude eines Parametersignals 62103 oberhalb der Amplitude eines Schwellwertsignals innerhalb der Steuervorrichtung 4 der Sicherung 1.

Ggf. kann es sinnvoll sein, dass die Steuervorrichtung 4 der Sicherung 1 für diese vier beispielhaften Typen von Signalzeitpunkten und weitere Typen von Signalzeitpunkten Signalzeitpunkttyp-spezifische Schwellwertsignale verwendet.

Die zeitliche Abfolge von Signalgrundobjekten ist typischerweise nicht beliebig. Dies wird in der technischen Lehre des hier vorgelegten Dokuments ausgenutzt, da bevorzugt nicht die Signalgrundobjekte, die einfacherer Natur sind, übertragen werden sollen, sondern erkannte Muster von Abfolgen dieser Signalgrundobjekte, die dann die eigentlichen Signalobjekte darstellen. Erwartet die Steuervorrichtung 4 der Sicherung 1 beispielsweise ein Dreiecks-Wavelet in einem Parametersignal 62103 ausreichender Amplitude, so kann die Steuervorrichtung 4 zusätzlich zu einem entsprechenden Mindestpegel am Ausgang eines für die Detektion eines solchen Dreiecks-Wavelets geeigneten Optimal-Filters

1. das Auftreten eines ersten möglichen Signalzeitpunkts mit einem Kreuzen der Amplitude des Parametersignals 62103 mit der Amplitude eines Schwellwertsignals in aufsteigender Richtung und daran zeitlich anschließend
2. das Auftreten eines dritten möglichen Signalzeitpunkts mit einem Maximum der Amplitude des Parametersignals 62103 oberhalb der Amplitude eines Schwellwertsignals und daran zeitlich anschließend
3. das Auftreten eines zweiten möglichen Signalzeitpunkts mit einem Kreuzen der Amplitude des Parametersignals 62103 mit der Amplitude eines Schwellwertsignals in absteigender Richtung

in zeitlicher Korrelation zum Überschreiten des besagten Mindestpegels am Ausgang des besagten Optimal-Filters erwarten. Das beispielhafte Signalobjekt eines Dreiecks-Wavelets besteht in diesem Beispiel also in der vordefinierten Abfolge von vier Signalgrundobjekten. Diese vier Signalgrundobjekte sind als Erstes der Mindestpegel des Zwischenparametersignals am Ausgang des zugehörigen Optimalfilters und als Zweites bis Viertes die erkannten drei Signalzeitpunkte. Die Steuervorrichtung 4 ersetzt dieses Signalgrundobjekt dann durch ein Symbol, das typischerweise der Index der Signalobjektsequenzdatenbank für dieses Signalobjekt ist. Die Steuervorrichtung 4 überträgt dann dieses Symbol bevorzugt zusammen mit seinem Auftretenszeitpunkt, dem Zeitstempel, an das übergeordnete Rechnersystem 12. Dieses Überschreiten des besagten Mindestpegels am Ausgang des besagten Optimal-Filters ist übrigens ein weiteres Beispiel für einen fünften möglichen Signalzeitpunkt und damit ein weiteres mögliches Signalgrundobjekt.

Die sich somit ergebende Gruppierung und zeitliche Abfolge von erkannten Signalgrundobjekten kann selbst, beispielsweise durch den Viterbi-Schätzer 62113, als eine vordefinierte, erwartete Gruppierung oder zeitliche Abfolge von Signalgrundobjekten erkannt werden und kann somit selbst wieder ein Signalgrundobjekt darstellen. Somit ist ein sechster möglicher Signalzeitpunkt und damit ein Signalgrundobjekt das Auftreten einer solchen vordefinierten Gruppierung und/oder zeitliche Abfolge von anderen Signalgrundobjekten. Es ist also denkbar, mehrere Viterbi-Schätzer 62113 und zugehörige Datenbanken hintereinander im Signalpfad anzuordnen.

Erkennt die Steuervorrichtung 4 einer Sicherung 1 eine solche Gruppierung von Signalgrundobjekten oder zeitliche Abfolge solcher Signalobjektklassen in Form eines Signalobjekts, so folgt das Übertragen des Symbols dieses erkannten zusammenfassenden prototypischen Signalobjekts der Signalobjektsequenzdatenbank 62116 und zumindest des einen zugeordneten Signalobjektparameters vorzugsweise an Stelle der Übertragung der einzelnen Signalgrundobjekte, da hierdurch erhebliche Datenbuskapazität auf dem Datenbus 9 gespart wird. Es mag jedoch auch Fälle geben, in denen die Steuervorrichtung 4 beides an das übergeordnete Rechnersystem 12 überträgt. Hierbei überträgt die Steuervorrichtung 4 das Datum (Symbol) des prototypischen Signalobjekts, das eine vordefinierte zeitliche Abfolge und/oder Gruppierung von anderen Signalgrundobjekten ist. Um eine Kompression zu erreichen, ist es vorteilhaft, wenn zumindest ein Signalobjekt (Symbol) zumindest eines dieser anderen Signalgrundobjekte dann nicht übertragen wird.

Eine zeitliche Gruppierung von Signalgrundobjekten in Form eines Signalobjekts liegt insbesondere dann vor, wenn der zeitliche Abstand dieser Signalgrundobjekte einen vordefinierten Abstand nicht überschreitet. Im zuvor erwähnten Beispiel sollte die Laufzeit des Signals im Optimalfilter bedacht werden. Typischerweise dürfte das Optimalfilter langsamer als die Komparatoren sein. Daher sollte der Wechsel im Ausgangssignal des Optimalfilters in einem festen zeitlichen Zusammenhang zu dem zeitlichen Auftreten der relevanten Signalzeitpunkte stehen.

Es wird hier also ein Verfahren zur Übertragung von Sicherungsdaten von einer Sicherung zu einem übergeordneten Rechnersystem 12, insbesondere in einem Fahrzeug, und/oder der Steuervorrichtung 4 einer anderen Sicherung vorgeschlagen, das mit dem Bilden eines zeitdiskreten Parametersignals 62103 bestehend aus einer Folge von Abtastwerten beginnt. Jedem Abtastwert ist dabei bevorzugt ein zeitliches Datum (Zeitstempel) zugeordnet. Es folgt die Bestimmung von mindestens zwei Zwischenparametersignalen jeweils betreffend das Vorliegen jeweils eines dem jeweiligen Zwischenparametersignal im Wesentlichen zugeordneten Signalgrundobjekts mit Hilfe mindestens eines geeigneten Filters (z.B. eines Optimal-filters) aus der Folge von Abtastwerten des Parametersignals 62103. Die sich ergebenden Zwischenparametersignale sind ebenfalls als zeitdiskrete Folge von jeweiligen Zwischenparametersignalwerten ausgebildet, die jeweils mit einem Datum (Zeitstempel) korreliert sind. Somit ist bevorzugt jedem Zwischenparametersignalwert genau ein zeitliches Datum (Zeitstempel) zugeordnet. Diese Zwischenparametersignale zusammen werden im Folgenden als Zwischenparametersignalbündel 62123 bezeichnet. Das Zwischenparametersignalbündel 62123 ist somit als zeitdiskrete Folge von Signalwerten des Zwischenparametersignalbündels 62123 mit jeweils $n$ Zwischenparametersignalwerten ausgebildet ist, die aus den Zwischenparametersignalwerten und weiteren Zwischenparametersignalwerten mit jeweils gleichem zeitlichem Datum (Zeitstempel) bestehen. Hierbei ist $n$ die Dimensionalität der einzelnen Signalwerte des Zwischenparametersignalbündels 62123, die bevorzugt von einem Vektorwert des Zwischenparametersignalbündels 62123 -zum nächsten Vektorwert des Zwischenparametersignalbündels 62123 gleich sind. Jedem so gebildeten Signalwert des Zwischenparametersignalbündels 62123 ordnet die Steuervorrichtung 4 der Sicherung 1 dieses jeweilige zeitliche Datum (Zeitstempel) zu. Es folgt die Auswertung des zeitlichen Verlaufs des Signals des Zwischenparametersignalbündels 62123 in dem sich ergebenden $n$-dimensionalen Phasenraum sowie das Schließen auf ein erkanntes Signalobjekt unter Ermittlung eines Bewertungswerts (z.B. des Abstands). Wie zuvor erläutert, besteht dabei ein Signalobjekt typischerweise aus einer zeitlichen Abfolge von Signalgrundobjekten. Dem Signalobjekt ist dabei typischerweise vordefiniert ein Symbol zugeordnet. Bildlich gesprochen prüft hier die Steuervorrichtung 4 der Sicherung 1, ob der Punkt, auf den das $n$-dimensionale Signal des Zwischenparametersignalbündels 62123 im $n$-dimensionalen Phasenraum zeigt, bei seinem Wege durch den $n$-dimensionalen Phasenraum in vorbestimmter zeitlicher Abfolge sich vorbestimmten Punkten in diesem $n$-dimensionalen Phasenraum näher als ein vorgegebener Maximalabstand nähert. Das Signal des Zwischenparametersignalbündels 62123 hat also einen einem zeitlichen Verlauf. Es die Steuervorrichtung 4 der Sicherung 1 berechnet dann einen Bewertungswert (z.B. ein Abstand), der beispielsweise der Wahrscheinlichkeit für das Vorliegen einer bestimmten Abfolge von Signalgrundobjekten wiedergeben kann. Es erfolgt dann der Vergleich dieses Bewertungswerts, dem wieder ein zeitliches Datum (Zeitstempel) zugeordnet ist, mit einem Schwellwertvektor unter Bildung eines booleschen Resultats, dass einen ersten und einen zweiten Wert haben kann. Wenn dieses boolesche Resultat für dieses zeitliche Datum (Zeitstemple) den ersten Wert hat, erfolgt ein Übertragen des Symbols des Signalobjekts und des diesem Symbol zugeordneten zeitlichen Datums (Zeitstempel) durch die Steuervorrichtung 4 der Sicherung 1 von der Steuervorrichtung 4 der Sicherung 1 zu dem Rechnersystem. Ggf. kann die Steuervorrichtung 4 je nach erkanntem Signalobjekt weitere Parameter übertragen.

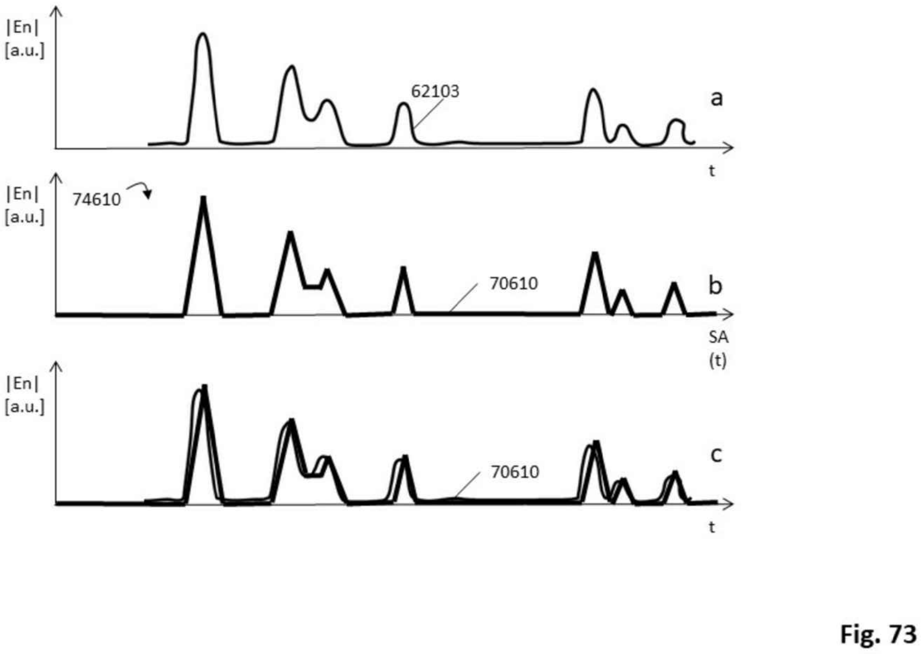

Rekursive Datenkompression (Figur 73)

Besonders vorteilhaft ist die Rekonstruktion eines rekonstruierten Parameter-Signal-Modellvektors 74610 aus den erkannten Signalobjekten 62122 und den Signalgrundobjekten 62121 während der Kompression.

Hierzu speichert die Steuervorrichtung der Sicherung 1 bevorzugt die $q$ Abtastwerte des Parametersignals 62103 eines zeitlichen Abtastfensters, die die Steuervorrichtung 4 in dem zeitlichen Abtastfenster erfasst hat, in einem ersten Abtastwertespeicher 74601. Die Zahl $q$ ist hierbei eine positive ganze Zahl, die die Anzahl der Abtastwerte im ersten Abtastwertespeicher 74601 der Steuervorrichtung 4 der Sicherung 1 angibt. Sobald das Abtastfenster zeitlich zu Ende ist, löscht der Abtastwertespeicher 74601 $r$ älteste Abtastwerte in seinen Speicherzellen. Die Zahl $r$ ist dabei eine ganze positive Zahl. Dann verschiebt bevorzugt der erste Abtastwertespeicher 74601 alle Abtastwerte um die jeweils gleiche Anzahl $r$ an Speicherzellen in dem ersten Abtastspeicher 74601 in der Art, dass der älteste nicht gelöschte Abtastwert in der Speicherzelle des ersten Abtastspeichers 74601 liegt, in der zuvor der älteste, zuvor gelöschte Abtastwert gespeichert war. Hierdurch wird nach dem Ende eines Abtastfensters in einem neuen zeitlichen Abtastfenster der erste Abtastwertespeicher 74601 mit den neuen Abtastwerten des neuen Abtastfensters wieder sukzessive aufgefüllt, während er immer die ältesten Abtastwerte verwirft, um Platz für diese neuen, nachrückenden Abtastwerte zu schaffen.

Die $q$ Abtastwerte im ersten Abtastwertespeicher 74601 bilden einen $q$-dimensionalen ersten Abtastwertevektor 74620, den der erste Abtastwertespeicher 74601 bevorzugt ausgibt. Da während des Einschreibens der Abtastwerte des Parametersignals 62103 in den ersten Abtastwertespeicher 73607 der Inhalt des ersten Abtastwertevektors 74620 instabil ist, übernimmt am zeitlichen Ende eines jeden Abtastzeitfensters ein zweiter Abtastspeicher 74625 den Abtastwertevektor 74620 von dem ersten Abtastwertespeicher 74601

Die Steuervorrichtung 4 der Sicherung 1 erzeugt den Parameter-Signal-Modellvektor 74610 aus den summierend linear überlagerten Signalverlaufsmodellen der einzelnen erkannten Signalobjekte und/oder Signalgrundobjekten.

Die Steuervorrichtung 4 subtrahiert mittels eines Vektorsubtrahierers 74602 die Werte der Vektorkomponenten des gespeicherten Parametersignal-Modellvektors 74635 von dem zweiten Abtastwertevektor 74630 ab und bildet hierdurch ein Vektorrestsignal 73660. Dies unterdrückt dem mit höherer Wahrscheinlichkeit erkanntem selektieren Signalobjekt ähnliche Signalobjekte besser. Die schwächeren Signalobjekte und Signalgrundobjekte treten in dem Vektorrestsignal 73660 hierdurch außerdem besser hervor. Die Steuervorrichtung 4 kann dann die schwächeren Signalobjekte und Signalgrundobjekte in dem Restsignal 73660 besser erkennen. (Siehe auch Figur 73). Das in der technischen Lehre des hier vorgelegten Dokuments vorgeschlagene Verfahren umfasst somit bevorzugt auch eine Subtraktion des aus den bereits erkannten Signalobjekten und Signalgrundobjekten gespeicherten Parametersignal-Modell 74635 von dem zweiten Abtastwertevektor 74630 im zweiten Abtastwertespeicher 74625 zur Bildung des Vektorrestsignals 73660. Die Steuervorrichtung 4 verwendet das so gebildete Vektorrestsignal 73660 dann wieder für die die Bildung des Signals der Merkmalsvektoren 62138 mittels der Merkmalsextraktion 62111. Mittels der Merkmalsextraktion 62111 und mittels der Abstandsberechnung 62112 bzw. des Klassifikators 62112 und ggf. des Viterbi-Schätzers 62113 ermittelt die Steuervorrichtung dann dasjenige Signalobjekt der Signalobjektsequenzdatenbank 62116 bzw. dasjenige Signalgrundobjekt der Prototypendatenbank 62115 mit der nächstniedrigeren Wahrscheinlichkeit. Da das zuerst erkannte Signalobjekt bzw. Signalgrundobjekt entsprechend seiner Gewichtung aus dem zweiter Abtastwertevektor des zweiten Abtastwertespeichers 74625 entfernt wurde und dadurch im Vektorrestsignal 73660 im Wesentlichen nicht mehr vorhanden ist, kann das zuerst erkannte Signalobjekt bzw. Signalgrundobjekt diese Erkennung nicht mehr beeinflussen. Somit liefert diese Form der Erkennung ein besseres Ergebnis in Form einer Liste erkannter Signalobjekte bzw. Signalgrundobjekte.

Ein Rekonstruierer 74600 rekonstruiert mit Hilfe der erkannten Signalgrundobjekte 62121 und den erkannten Signalobjekte 62122 und mittels der mit ermittelten Signalgrundobjektparameter und der mitermittelten Signalobjektparameter und den Daten aus der Prototypendatenbank 62155 und den Daten aus der Signalobjektsequenzdatenbank 62116 und mittels der zugehörigen Zeitstempel das Parameter-signal so, als wenn es nur aus den erkannten Signalobjekte 62122 mit den mitermittelten Signalobjektparametern und den ermittelten Signalgrundobjektparameter mit den mitermittelten Signalgrundobjektparametern unter Berücksichtigung der zugehörigen Zeitstempel durch Addition der korrespondierenden Vektorwerte zusammengesetzt wäre. Ein Rekonstruierer 74600 rekonstruiert auf diese Weise das den rekonstruierten Parametersignal-Modellvektor mit q Werten an Vektorkomponenten, die zu den q Werten der Vektorkomponenten des zweiten Abtastwertevektors der im zweiten Abtastwertespeicher 74625 korrespondieren, als rekonstruierten Parametersignal-Modellvektor 74610. Der Rekonstruktionsspeicher 74603 speichert den rekonstruierten Parametersignal-Modellvektor 74610 zwischen. Der Rekonstruierer 74600 umfasst bevorzugt den Rekonstruktionsspeicher 74603. Der Rerekonstruktionsspeicher 74603 gibt den in seinen Speicherzellen gespeicherten rekonstruierten Parametersignal-Modellvektor 74610 als gespeicherten Parametersignal-Modellvektor 74635 an den Vektorsubtrahierer 74602 aus, was den Kreis schließt.

Diese Erkennungsmethode ist aber in der Regel langsamer. Daher ist es sinnvoll, erst eine direkte erste Signalobjekterkennung ohne Subtraktion schon während der noch laufenden Messung durchzuführen und dann nach Erfassung aller Abtastwerte eines Abtastfensters eine nochmalige Mustererkennung mit Subtraktion des Parametersignal-Modells 74610 durchzuführen, die zwar länger dauert, dafür aber präziser ist.

Bevorzugt wird diese reduzierende Klassifikation des Parametersignals 62103 und die Zerlegung in prototypische Signalobjekte bzw. Signalgrundobjekte mit Hilfe des Parametersignal-Modellvektors 74610 dann beendet, wenn die Beträge der Abtastwerte des Vektorrestsignals 73660 unter den Beträgen einer vorgegebenen Schwellwertkurve und/oder eines Schwellwerts liegen.

Besonders führt die Steuervorrichtung 4 der Sicherung die Datenübertragung im Fahrzeug über einen seriellen bidirektionalen Eindrahtdatenbus oder einen bidirektionalen, bevorzugt differenziellen Zweidrahtdatenbus als Datenbus 9 aus. Die Karosserie des Fahrzeugs stellt bevorzugt bei einem Eindrahtdatenbus die elektrische Rückleitung wird bevorzugt sicher. Vorzugsweise überträgt die Steuervorrichtung 4 der Sicherung 1 die Sicherungsdaten strommoduliert an das übergeordnete Rechnersystem 4. Das übergeordnete Rechnersystem 12 überträgt hingegen die Daten zur Steuerung der Sicherungen an die Steuervorrichtungen 4 der Sicherungen 1 bevorzugt spannungsmoduliert. Die Ausarbeitung der technischen Lehre dieses Dokuments ergab, dass die Verwendung von Datenbussen wie der PSI5-Datenbus und/oder der DSI3-Datenbus oder ein Lin-Datenbus 9 oder ein CAN-Datenbus 9 oder ein CAN-FD-Datenbus 9 oder ein Ethernet-Datenbus oder ein Flexray-Datenbus 9 oder ein LVDS-Datenbus 9 oder eine sonst wie drahtgebundener Datenbus geeignet ist. Auch kommen drahtlose Datenübertragungsstrecken, beispielsweise über eine Bluetooth- oder eine WLAN-Datenverbindung oder eine optische Datenverbindung (540) für die Datenkommunikation der Steuervorrichtung 4 der Sicherung 1 mit dem übergeordneten Rechnersystem 12 in Frage. Die Datenkommunikation des Rechnerkerns 2 der Steuervorrichtung 4 der Sicherung 1 läuft dabei jeweils bevorzugt über eine drahtgebundene oder drahtlose Schnittstelle (610, 10, 551, 550) der Steuervorrichtung 4 ab.

Des Weiteren wurde erkannt, dass es besonders vorteilhaft ist, die Übertragung der Daten an das übergeordnete Rechnersystem mit einer Übertragungsrate von > 200 kBit/s und vom übergeordneten Rechnersystem zu der mindestens einer elektronischen Sicherung mit einer Übertragungsrate > 10 kBit/s, vorzugsweise 20 kBit/s vorzunehmen. Des Weiteren wurde erkannt, dass die Übertragung von Daten von der Sicherung 1 an das übergeordnete Rechnersystem 12 mit einem Sendestrom auf den Datenbus moduliert werden sollte, dessen Stromstärke weniger als 50 mA, bevorzugt weniger als 5 mA, bevorzugt weniger als 2,5mA betragen sollte. Für diese Betriebswerte müssen diese Busse entsprechend angepasst werden. Das Grundprinzip bleibt aber bestehen.

Für die Durchführung der zuvor beschriebenen Verfahren wird ein übergeordnetes Rechnersystem 12 mit einer Datenschnittstelle zu dem besagten Datenbus 9 benötigt, das die Dekompression der dermaßen komprimierten Daten unterstützt. In der Regel wird das übergeordnete Rechnersystem 12 jedoch keine vollständige Dekompression vornehmen, sondern beispielsweise lediglich den Zeitstempel und das von der betreffenden Sicherung 1 erkannte Signalobjekt bzw. Signalgrundobjekt auswerten. Die Sicherung 1, die zur Durchführung eines der zuvor beschrieben Verfahren benötigt wird, weist vorzugsweise Mittel zur Erfassung des Parameterverlaufs durch die Sicherung zu erfassender physikalischer Parameter und/oder des Verlaufs von Werten von Parameter, die aus diesen abgeleitet sind. Diese Mittel zur Erfassung des Parameterverlaufs durch die Sicherung zu erfassender physikalischer Parameter und/oder des Verlaufs von Werten abgeleiteter Parameter erzeugen korrespondierende Signale 62102 der zeitlichen Parameterwertverläufe und/oder die entsprechenden zeitlichen Verlaufen der aus diesen Parameterwertverläufen der physikalischen Parameter abgeleiteten Parameter. Diese Signale 62602 der zeitlichen Parameterwertverläufe und/oder die entsprechenden zeitlichen Verläufe der aus diesen Parameterwertverläufen der physikalischen Parameter abgeleiteten Parameter bezeichnet das hier vorgelegte Dokument auch als Messwertsignale. Des Weiteren weist die vorschlagsgemäße Sicherung 1 Vorrichtungen zur Verarbeitung und Kompression dieser Messwertsignale auf sowie eine Datenschnittstelle 10, 610 zur Übertragung der Daten der verarbeiteten und komprimierten Messwertsignale über den Datenbus 9 an das übergeordnete Rechnersystem 12 auf. Für die Kompression weist die Sicherung 1 zur Kompression vorzugsweise zumindest eine der folgenden Teilvorrichtungen auf:

- Optimalfilter,
- Komparatoren,
- Schwellwertsignalerzeugungsvorrichtungen zur Erzeugung eines oder mehrerer Schwellwertsignale,
- Differenzierer zur Bildung von Ableitungen,
- Integrierer zur Bildung integrierter Signale,
- sonstige Filter,
- Korrelationsfilter zum Vergleich von Messwertsignalen oder von daraus abgeleiteten Signalen mit Referenzsignalen.

In einer besonders einfachen Form wird das vorgeschlagene Verfahren zur Übertragung von Sicherungsdaten von einer Sicherung zu einem übergeordneten Rechnersystem, insbesondere in einem Fahrzeug, wie folgt ausgeführt: Es beginnt mit dem Einschalten oder ggf. dem Ausschalten eines Leistungsschalters 17 der Sicherung 1 durch die Steuervorrichtung 4 der Sicherung. Es folgt das Erfassen der Parameterverläufe der Werte der zu erfassenden physikalischen Parameter der Sicherung durch die Steuervorrichtung 4 der Sicherung 1 und das Bilden eines zeitdiskreten Messsignals bestehend aus einer zeitlichen Folge von Abtastwerten, das Parametersignal 62103. Dabei ist vorzugsweise jedem Abtastwert ein zeitliches Datum (Zeitstempel) zugeordnet. Dieses zeitliche Datum (Zeitstempel) gibt den Zeitpunkt der Abtastung typischerweise wieder. Auf Basis dieses Datenstroms des Parametersignals 62103 erfolgt beispielsweise die Bestimmung eines ersten Zwischenparametersignals einer ersten Eigenschaft durch die Steuervorrichtung 4 der Sicherung 1 mit Hilfe eines ersten Filters einer Merkmalsvektorextraktion 62111 aus der Folge von Abtastwerten des Parametersignals 62103. Bevorzugt wird dabei das Zwischenparametersignal durch die Steuervorrichtung 4 der Sicherung 1 wieder als zeitdiskrete Folge von Zwischenparametersignalwerten ausgebildet. Jedem Zwischenparametersignalwert wird durch die Steuervorrichtung 4 der Sicherung 1 wieder genau ein zeitliches Datum (Zeitstempel) zugeordnet. Bevorzugt entspricht dieses Datum dem jüngsten zeitlichen Datum eines Abtastwertes, der zur Bildung dieses jeweiligen Zwischenparametersignalwertes benutzt wurde. Zeitlich parallel dazu erfolgt bevorzugt durch die Steuervorrichtung 4 der Sicherung 1 die Bestimmung mindestens eines weiteren Zwischenparametersignals einer diesem weiteren Zwischenparametersignal zugeordneten Eigenschaft mit Hilfe eines diesem weiteren Zwischenparametersignal zugeordneten weiteren Filters aus der Folge von Abtastwerten des Parametersignals 62103. Bevorzugt sind die weiteren Zwischenparametersignale jeweils wieder als zeitdiskrete Folgen von weiteren Zwischenparametersignalwerten ausgebildet. Auch hier wird bevorzugt durch die Steuervorrichtung 4 der Sicherung 1 jedem weiteren Zwischenparametersignalwert jeweils das gleiche zeitliche Datum (Zeitstempel) wie dem entsprechenden Zwischenparametersignalwert zugeordnet.

Das erste Zwischenparametersignal 62123.1 und die weiteren m-1 Zwischenparametersignale 62123.2 bis 62123.m bezeichnet das hier vorliegende Dokument zusammen im Folgenden als Zwischenparametersignalbündel 62123. Dieses Zwischenparametersignalbündel 62123 (oder auch Zwischenparametervektorsignal) stellt somit eine zeitdiskrete Folge von vektoriellen Zwischenparametersignalwerten dar, die die Zwischenparametersignalwerten und

61

weitere Zwischenparametersignalwerten mit jeweils gleichem zeitlichem Datum (Zeitstempel) umfassen. Somit kann jedem so gebildeten vektoriellen Wert des Zwischenparametersignalbündels 62123 (=Parametersignalwert) dieses jeweilige zeitliche Datum (Zeitstempel) zugeordnet werden.

Bevorzugt führt durch die Steuervorrichtung 4 der Sicherung 1 dann quasikontinuierlich den Vergleich der Werte der Vektorkomponenten des Zwischenparametersignalbündels 62123 eines zeitlichen Datums (Zeitstempels) mit einem Schwellwertvektor aus, dessen Vektorkomponenten Schwellwerte sind und der die gleiche Dimension wie das Zwischenparametersignalbündels 62123 aufweist, unter Bildung eines booleschen Resultats, dass einen ersten und einen zweiten Wert haben kann. Auch ist es denkbar, dass die Steuervorrichtung 4 das Zwischenparametersignalbündels 62123 mittels einer affinen Transformation auf einen Merkmalsvektor eines Signals der Merkmalsvektoren 62138 abbildet. Es ist als ausdrücklich auch denkbar, dass das Signal der Merkmalsvektoren 62138 mit dem Zwischenparametersignalbündel 62123 identisch sein kann, wenn die Steuervorrichtung 4 keine Signifikanzsteigerung mittels der LDA-Matrix 63126 vornimmt.

Beispielsweise ist es denkbar, den Betrag einer ersten Vektorkomponente des aktuellen Merkmalsvektors des Signals der Merkmalsvektoren 62138 mit einem Schwellwert, der eine erste Vektorkomponente des Schwellwertvektors darstellt, zu vergleichen und das boolesche Resultat auf einen ersten Wert zusetzen, wenn der Betrag der ersten Vektorkomponente des aktuellen Merkmalsvektors des Signals der Merkmalsvektoren 62138 kleiner ist als dieser Schwellwert, und auf einen zweiten Wert, wenn dies nicht der Fall ist. Hat das boolesche Resultat einen ersten Wert, so ist es dann weiter denkbar, den Betrag einer weiteren Vektorkomponente des aktuellen Merkmalsvektors des Signals der Merkmalsvektoren 62138 mit einem weiteren Schwellwert, der eine weitere Komponente des Schwellwertvektors darstellt, zu vergleichen und das boolesche Resultat auf dem ersten Wert zu belassen, wenn der Betrag der weiteren Vektorkomponente des aktuellen Merkmalsvektors des Signals der Merkmalsvektoren 62138 kleiner ist als dieser weitere Schwellwert, und das boolesche Resultat auf den zweiten Wert zu setzen, wenn dies nicht der Fall ist. Auf diese Weise können alle weiteren Vektorkomponenten des aktuellen Merkmalsvektors des Signals der Merkmalsvektoren 62138 durch die Steuervorrichtung 4 überprüft werden. Natürlich sind auch andere Klassifikatoren denkbar. Auch ist der Vergleich mit mehreren verschiedenen Schwellwertvektoren möglich. Diese Schwellwertvektoren stellen also die Prototypen vorgegebener Signalformen dar. Sie entstammen vorzugsweise der besagten Bibliothek. Jedem Schwellwertvektor ist wieder bevorzugt ein Symbol zugeordnet.

Als letzter Schritt folgt dann in diesem Fall das Übertragen des Symbols und ggf. auch der Feature-Vektor-Signalwerte und des diesem Symbol bzw. Feature-Vektor-Signalwert zugeordneten zeitlichen Datums (Zeitstempels) von der Sicherung 1 zu dem übergeordneten Rechnersystem 12, wenn das boolesche Resultat für dieses zeitliche Datum (Zeitstempel) den ersten Wert hat.

Somit werden alle anderen Daten nicht mehr übertragen. Des Weiteren werden durch die mehrdimensionale Auswertung Störungen vermieden.

Auf dieser Basis wird somit ein Versorgungsnetzwerk 200 vorgeschlagen, mit mindestens einem übergeordneten Rechnersystem 12, das zur Durchführung eines der zuvor vorgestellten Verfahren in der Lage ist und mit mindestens zwei Sicherung die ebenfalls zur Durchführung eines der zuvor vorgestellten Verfahren in der Lage sind, sodass diese mindestens zwei Sicherung mit dem übergeordneten Rechnersystem 12 durch Signalobjekterkennung und/oder Signalgrundobjekterkennung kommunizieren können und auch in die Lage versetzt sind vermeintliche Störsignale kompaktiert zu übertragen und diese Informationen zusätzlich dem übergeordneten Rechnersystem zur Verfügung zu stellen. Das Versorgungsnetzwerk 200 ist dementsprechend dazu typischerweise vorgesehen, dass die Datenübertragung zwischen den mindestens zwei Sicherungen und dem übergeordneten Rechnersystem 12 entsprechend den zuvor beschriebenen Verfahren abläuft oder ablaufen kann. Innerhalb der mindestens zwei Sicherungen des Versorgungsnetzwerks 100 wird also typischerweise jeweils ein Parametersignal 62103 mittels eines der zuvor vorgeschlagenen Verfahren komprimiert und an das übergeordnete Rechnersystem 12 übertragen. Dabei werden rekonstruiert das übergeordnete Rechnersystem die von den zwei Sicherungen empfangenen mindestens zwei komprimierten Parametersignale zu rekonstruierten Parametersignalen. Das übergeordnete Rechnersystem 12 behandelt dann diese rekonstruierten Parametersignale wie ein einziges Parametersignal für das Versorgungsnetzwerk 200.

Das übergeordnete Rechnersystem 12 führt dann mit Hilfe von rekonstruierten Parametersignalen eine Erkennung von Zuständen und/oder Ereignissen im Versorgungsnetzwerk 200 durch. Hierdurch kann das übergeordnete Rechnersystem somit z.B. Ereignisse erkennen, die in mehreren Sicherungen gleichzeitig auftauchen. Solche Ereignisse können sicherheitsrelevant sein und für die einzelne Sicherung unbedeutend und nicht sicherheitsrelevant erscheinen. Durch die Korrelation zweier oder mehr rekonstruierter Parametersignals miteinander ist das übergeordnete Rechnersystem in der Lage beispielsweise schwache Kurzschlüsse als Vorläufer schwerwiegender Kurzschlüsse zwischen Leitungen zu erkennen, die eigentlich gegeneinander isoliert sein sollten.

Das übergeordnete Rechnersystem 12 führt bevorzugt zusätzlich mit Hilfe der rekonstruierten Parametersignale und zusätzlicher Signale weiterer Sensoren und/oder Sicherungen, insbesondere der Signale von Beschleunigungssensoren, Temperatursensoren 586, Gassensoren, Rauchsensoren etc. eine Zustandsanalyse für das Fahrzeug durch.

Als letzter Schritt erstellt bevorzugt das übergeordnete Rechnersystem 12 aus Basis der erkannten Objekte eine Zustandskarte für das Versorgungsnetzwerk und die darin befindlichen Verbraucher, Energiequellen, Leitungsabschnitte und Sicherungen.

Eine weitere, leicht abgewandelte, vorgeschlagene Sicherung 1, wie es beispielhaft in den Figuren 62 und 73 dargestellt ist, umfasst somit bevorzugt ein Mittel zur Erfassung des Parameterwertverlaufs der von der Sicherung 1 zu erfassenden physikalischen Parameter und/oder der Verläufe der Werte daraus abgeleiteter Parameter 62100, eine Physikalische Schnittstelle 62101, eine Merkmalsextraktion 62111 und mit einem Schätzer 62122, 67151, 62113 oder Klassifikator. Die Sicherung 1 ist bevorzugt dazu vorgesehen und/oder eingerichtet, eine Leitung zwischen einem ersten Leitungsanschluss 18 der Sicherung 1 und einem zweiten Anschluss 19 der Sicherung 1 zu überwachen und Parameterverläufe physikalischer Parameter der Sicherung 1 zu erfassen. Die Sicherung bildet dann in Abhängigkeit von den erfassten Werten Signale 62102 der zeitlichen Parameterwertverläufe und/oder die entsprechenden zeitlichen Verlaufen der aus diesen Parameterwertverläufen der physikalischen Parameter abgeleiteten Parameter. Die Merkmalsextraktion 62111 ist vorzugsweise dazu vorgesehen und/oder eingerichtet, aus dem Signal 62102 der zeitlichen Parameterwertverläufe und/oder die entsprechenden zeitlichen Verlaufen der aus diesen Parameterwertverläufen der physikalischen Parameter abgeleiteten Parameter ein Signal der Merkmalsvektoren 62138 im Zusammenwirken mit einer physikalischen Schnittstelle 62101 zu bilden. Die physikalische Schnittstelle 62101 wandelt das erfasste Signal 62102 der zeitlichen Parameterwertverläufe und/oder die entsprechenden zeitlichen Verläufe der aus diesen Parameterwertverläufen der physikalischen Parameter abgeleiteten Parameter in ein Parametersignal 62103 um. Das Sie Sicherung 1 ist bevorzugt dazu eingerichtet und vorgesehen, mittels des Schätzers 67151 Signalobjekte und/oder Signalgrundobjekte in dem Parametersignal 62103 zu erkennen und zu klassifizieren. Bevorzugt werden durch die Steuervorrichtung 4 dabei jedem somit erkannten und klassifizierten Signalobjekt 62122 und/oder Signalgrundobjekt zumindest ein zugeordneter Signalobjektparameter bzw. ein zugeordneter Signalgrundobjektparameter und ein Symbol entsprechend dem diesem Signalobjekt zugeordneten Index entsprechend dem diesem Signalgrundobjekt zugeordneten Index zugeordnet. Bevorzugt werden durch die Steuervorrichtung 4 für jedes somit erkannte und klassifizierte Signalobjekt (122) zumindest ein zugeordneter Signalobjektparameter und ein Symbol für dieses Signalobjekt bestimmt. Zumindest das Symbol eines erkannten Signalobjekts 62122 und zumindest des einen zugeordneten Signalobjektparameters dieses erkannten Signalobjekts 62122 werden an ein übergeordnetes Rechnersystem 12 über den Datenbus 9 durch die Steuervorrichtung 4 der Sicherung 1 übertragen.

Bevorzugt weist der Schätzer 62150 einen Abstandsermittler 62112 und eine Prototypendatenbank 62115 auf, die die Signalgrundobjekte entweder als Sequenzen prototypischer Abtastwerte oder als prototypische Merkmalsvektoren definiert. Ebenso weist bevorzugt der Schätzer 62150 einen Viterbi-Schätzer 62113 und eine Signalobjektsequenzdatenbank 62116 auf, die die Zusammensetzung der prototypischen Signalobjekte du den prototypischen Signalgrundobjekten der Prototypendatenbank 62155 definiert. Auch kann der Schätzer 62150) ein neuronales Netzwerkmodell 67151 verwenden. Bevorzugt emuliert der Rechenerkern 2 der Steuervorrichtung 4 der Sicherung 1 das neuronale Netzwerkmodell 67151. Die Merkmalsvektoren des Signals der Merkmalsvektoren 62138 dienen typischerweise als Eingangswert des neuronalen Netzwerkmodells 67151. Die erkannten Signalgrundobjekte 62121 und/oder die erkannten Signalobjekte 62122 sind bevorzugt die Ausgangssignale des neuronalen Netzwerkmodells 67151. Natürlich kann die Steuervorrichtung 4 der Sicherung 1 auch Ausgangssignale des neuronalen Netzwerkmodells direkt als Signale interpretieren, die die Steuervorrichtung 4 der elektronischen Sicherung dazu veranlassen vorbestimmte Verfahren und/oder Verfahrensschritt wie beispielsweise das Schließen oder Öffnen eines Leistungsschalters 17 der Sicherung durchzuführen. Des Weiteren kann beispielsweise ein Viterbi-Schätzer 62113 von dem neuronalen Netzwerkmodell 67151 ermittelte Signalgrundobjekte auswerten und Signalobjekte 62122 in dem Strom der Signalgrundobjekte 62121 erkennen. In dem Fall stellt bevorzugt zumindest ein Teil der Ausgangssignale des neuronalen Netzwerkmodels 67151 das Eingangssignal des Viterbi-Schätzers 62113 dar.

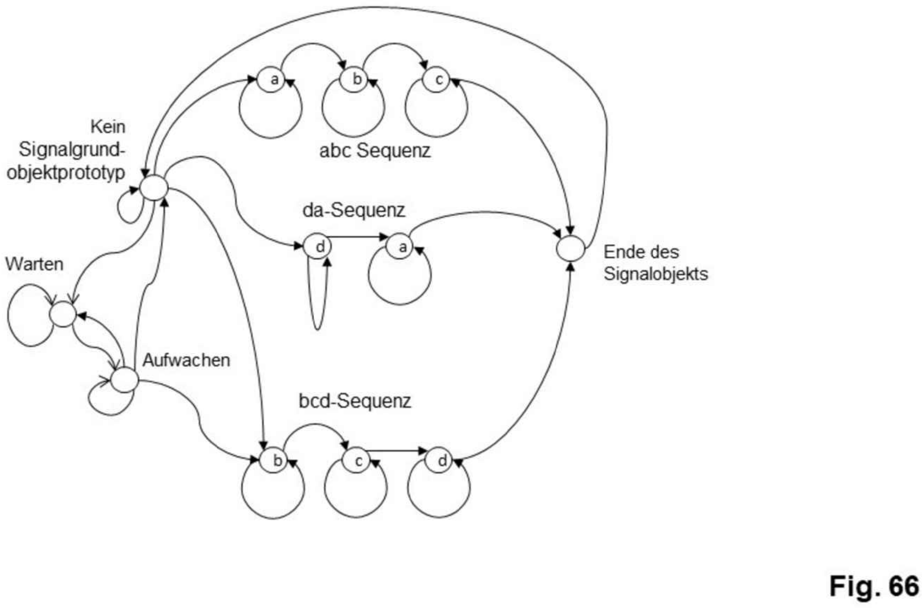

Ein vorgeschlagenes Verfahren zum Betreiben einer Sicherung 1, insbesondere durch die Steuervorrichtung 4 der Sicherung 1, umfasst daher die Schritte entsprechend Figur 66:

- Warten auf einen Verlauf in einem Parametersignal 62103 eines zeitlichen Parameterwerteverlaufs eines physikalischen Parameters oder eines daraus abgeleiteten Parameters, der vom Grundrauschen verschieden ist,
- Wechsel in einen Zustand "kein Signalobjektgrundprototyp" falls der Verlauf des Parametersignals 62103 von Grundrauschen verschieden ist, und Durchführung eines Verfahrens zum Erkennen von Signalgrundprototypen 62121, insbesondere einer Prototypendatenbank 62115, in dem Parametersignal 62103 und zum Klassifizieren dieser Signalgrundprototypen durch die Steuervorrichtung 4 der Sicherung 1;
- Wechsel in eine Folge von Zuständen, die den Signalgrundprototypen einer vorgegebenen Folge von Signalgrundprototypen, insbesondere einer Signalobjektsequenzdatenbank 62116, zugeordnet sind, wenn der erste Signalgrundprototyp einer solchen Folge von Signalobjektgrundprototypen durch die Steuervorrichtung 4 der Sicherung 1 erkannt wird;
- Folgen der Folge der Signalgrundprototypen bis das Ende der Folge von Signalgrundprototypen erreicht ist;
- Schließen auf das Vorliegen eines dieser Folge von Signalgrundprototypen und auf ein dieser Folge zugeordnetes Signalobjekt, wenn das Ende dieser Folge von Signalgrundprototypen erreicht ist und Signalisierung dieses Signalobjekts;

- Abbruch (nicht in Figur 66 eingezeichnet) dieser Folge bei Zeitüberschreitung und/oder bei einfacher oder mehrfacher Detektion eines Signalgrundprototypen an einer Position dieser Folge, an der dieser detektierte Signalgrundprototyp nicht erwartet wird oder an der in der folgenden Position dieser detektierte Signalgrundprototyp nicht erwartet wird.

- Rücksprung in den Zustand "kein Signalobjektgrundprototyp".

Dem oben beschriebenen Kompressionsverfahren entspricht ein zugehöriges Dekompressionsverfahren 70000, das das übergeordnete Rechnersystem 12 bevorzugt zur Dekompression von auf diese signalobjektorientierte und/oder signalgrundobjektorientierte Weise komprimierten und übertragenen Sicherungsdaten der Steuervorrichtung 4 der Sicherung 1 im übergeordneten Rechnersystem 12 nach deren Empfang von der Steuervorrichtung 4 der Sicherung 1 über den Datenbus 9 und die besagten Datenschnittstellen 10, 610, 555 verwendet.

In einem ersten Schritt 70010 erfolgt das Empfangen neuer zu dekomprimierenden Daten 70160 im übergeordneten Rechnersystem 12, die vom Steuerrechner 4 der Sicherung 1 stammen. Dieser Empfang ist quasi das Startsignal für das Dekompressionsverfahren. Die zu dekomprimierenden Daten umfassen die zu komprimierenden Daten 70160 zumindest eines Abtastfensters. Bevorzugt erfolgt die Dekompression Abtastfensterweise.

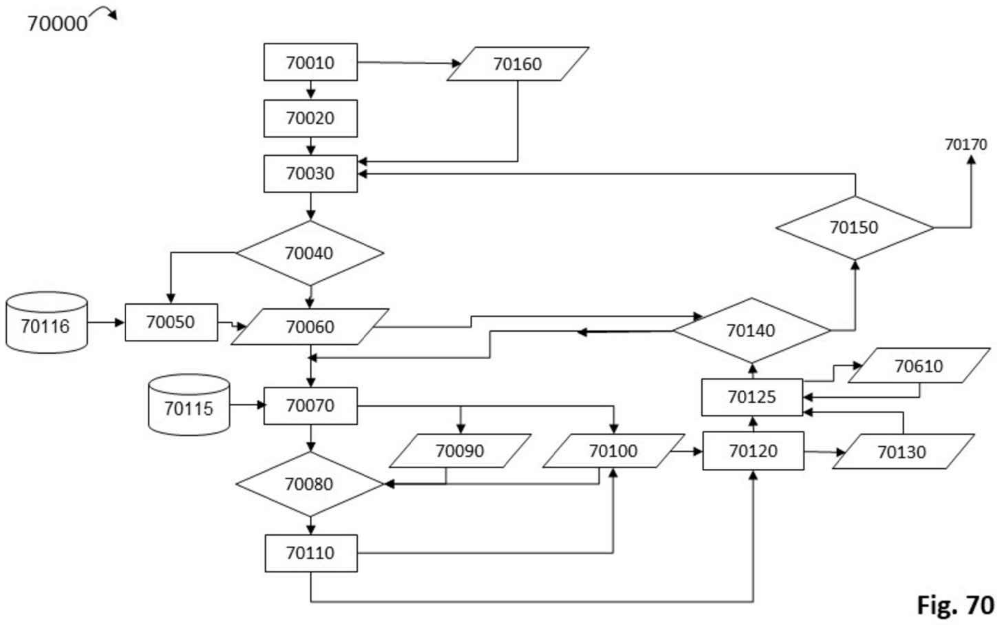

Nach dem Empfangen neuer zu dekomprimierenden Daten 70160 zumindest eines Abtastfensters im übergeordneten Rechnersystem 12, die vom Steuerrechner 4 der Sicherung 1 stammen, erfolgt in einem weiteren Schritt 70020 ein Bereitstellen eines rekonstruierten Parametersignal-Modells 69610 für ein Abtastfenster. Dieses rekonstruierte Parametersignal-Modell des Abtastfensters soll später die den rekonstruierten Parameterwerteverlauf und/oder die rekonstruierten Parameterwertverläufe von aus diesen Parametern abgeleiteten Parametern für dieses rekonstruierte Abtastfenster umfassen. Bevorzugt befindet sich das Parametersignal-Modell 69610 in einem Speicher des übergeordneten Rechnersystems 12. Dieses initiale, rekonstruierte Parametersignal-Modell 69610 umfasst zunächst nur ein initiales Dummy-Signal 70010, das zunächst im Wesentlichen typischerweise kein Signal, als vorzugsweise nur Nullen oder nur einen konstanten Wert aufweist (Figur 70a).

Das übergeordnete Rechnersystem 12 füllt dieses Parametersignal-Modell 69610 nun signalobjektweise durch aufeinander folgende Addition des jeweiligen prototypischen, parametrisierten Signalverlaufs des jeweils nächsten Signalobjekts auf. Hierbei handelt es sich um diejenigen Signalobjekte bzw. Signalgrundobjekte, die die Steuervorrichtung 4 der Sicherung 1 zuvor dem übergeordneten Rechnersystem 12 über den Datenbus für dieses Abtastfenster signalisiert hat.

In einem nächsten Schritt 70030 ermittelt das übergeordnete Rechnersystem 12 das nächste zu rekonstruierende Objekt in den empfangenen Daten des Steuervorrichtung 4 der Sicherung 1. Dieses nächste Objekt kann ein Signalobjekt oder ein Signalgrundobjekt sein. In der Regel repräsentieren das Datum eines Index der Prototypendatenbank 62115 oder ein Index der Signalobjektsequenzdatenbank 62116 der Steuervorrichtung 4 der Sicherung 1 das zu rekonstruierende Objekt.

In einem nachfolgenden Schritt 70040 prüft ggf. das übergeordnete Rechnersystem 12, ob das nächste zu rekonstruierende Objekt ein Signalobjekt ist. Ist es ein Signalgrundobjekt, so behandelt das übergeordnete Rechnersystem dieses Signalgrundobjekt bevorzugt wie ein Signalobjekt, das eine Folge 70060 von Signalgrundobjekten mit nur einem Signalgrundobjekt, nämlich genau dem einen zu erkennenden Signalgrundobjekt, ist.

Handelt es sich um ein Signalobjekt, so muss das übergeordnete Rechnersystem 12 feststellen, welche Signalgrundobjekte u.a. das zu rekonstruierende Signalobjekt umfasst. Hierzu ermittelt in einem weiteren Schritt 70050 das übergeordnete Rechnersystem 12 die Folge von Signalgrundobjekten, die dem Index der Signalobjektsequenzdatenbank 62116 der Steuervorrichtung 4 der Sicherung 1 entspricht. Hierzu umfasst das übergeordnete Rechnersystem 12 bevorzugt eine Signalobjektsequenzdatenbank 70116 des übergeordneten Rechnersystems 12. Typischerweise entspricht der Inhalt der Signalobjektsequenzdatenbank 70116 des übergeordneten Rechnersystems 12 dem Inhalt der Signalobjektsequenzdatenbank 62116 der Steuervorrichtung 4 der Sicherung 1. Typischerweise sind die Relationen zwischen den Indices der Signalobjektsequenzdatenbank 62116 der Steuervorrichtung 4 der Sicherung 1 und der Signalobjektsequenzdatenbank 70116 des übergeordneten Rechnersystems 12 eineindeutig. Bevorzugt sind die Relationen zwischen den Indices der Signalobjektsequenzdatenbank 62116 der Steuervorrichtung 4 der Sicherung 1 und der Signalobjektsequenzdatenbank 70116 des übergeordneten Rechnersystems 12 einerseits und den zugehörigen Sequenzen von Signalgrundobjekten in den Datensätzen der Signalobjektsequenzdatenbank 62116 der Steuervorrichtung 4 der Sicherung 1 und der Signalobjektsequenzdatenbank 70116 des übergeordneten Rechnersystems 12 bijektiv.

Hierdurch kann das übergeordnete Rechnersystem 12 das zu rekonstruierende Signalobjekt nun durch eine Sequenz 70060 von Signalgrundobjekten ersetzen, die zu rekonstruieren sind.

In einem nächsten Schritt 70070 ermittelt das übergeordnete Rechnersystem 12 das nächste Signalgrundobjekt der Sequenz 70060 von Signalgrundobjekten, das das übergeordnete Rechnersystem 12 rekonstruieren soll. Typischerweise repräsentiert jeweils ein Index der Prototypendatenbank 62115 der Steuervorrichtung 4 der Sicherung 1 bzw. ein Index einer Prototypendatenbank 70115 des übergeordneten Rechnersystems 12 ein jeweiliges zu rekonstruierendes Signalobjekt dieser der Sequenz 70060 von Signalgrundobjekten. Bevorzugt umfassen die Prototypendatenbank 62115 der Steuervorrichtung 4 der Sicherung 1 und die Prototypendatenbank 70115 des übergeordneten Rechnersystems 12 zumindest in dem für die Rekonstruktion wichtigen Anteil ihrer Daten im wesentlichen entsprechende Datenbankeinträge, da nur dann eine Rekonstruktion im übergeordneten Rechnersystem 12 möglich ist.

In einem nächsten Schritt 70070 rekonstruiert das übergeordnete Rechnersystem 12 dieses nächste, zu rekonstruierende Signalgrundobjekt der Sequenz 70060 von Signalgrundobjekten. Hierzu ermittelt das übergeordnete Rechnersystem 12 den Signalverlauf des zu rekonstruierenden Signalgrundobjekts entsprechend den Einträgen der Prototypendatenbank 70115 des übergeordneten Rechnersystems 12. Dabei repräsentiert das zu rekonstruierenden Signalgrundobjekts in der Regel einen Index eines Datensatzes 70090, 70100 der Prototypendatenbank 70115 des übergeordneten Rechnersystems 12. Bevorzugt umfasst dieser Datensatz 70090, 70100 der Prototypendatenbank 70115 des übergeordneten Rechnersystems 12, den das zu rekonstruierende Signalgrundobjekt markiert, einen prototypischen Merkmalsvektor 70090 oder prototypische Parameterwertverläufe 70100 für die Parameterwertverläufe der physikalischen Parameter und/oder der aus diesen abgeleiteten Parameter. Vorzugsweise umfasst die Prototypendatenbank 70115 des übergeordneten Rechnersystems 12 in ihren Datensätzen entweder nur prototypische Merkmalsvektoren oder alternativ prototypische Parameterwertverläufe für die Parameterwertverläufe der physikalischen Parameter und/oder der aus diesen abgeleiteten Parameter. Trotzdem ist es denkbar, dass die Prototypendatenbank 70115 des übergeordneten Rechnersystems 12 beide Datenformen umfasst. Ggf. prüft das übergeordnete Rechnersystem in einem Prüfschritt 70080, ob der relevante Datensatz 70090, 70100 der Prototypendatenbank 70115 des übergeordneten Rechnersystems 12 einen prototypischen Merkmalsvektor 70090 umfasst und keine oder prototypische Parameterwertverläufe 70100 für die Parameterwertverläufe der physikalischen Parameter und/oder der aus diesen abgeleiteten Parameter. Sofern das übergeordnete Rechnersystem 12 in seiner Prototypendatenbank 70115 nur über einen prototypischen Merkmalsvektor 70090 verfügt, wandelt das übergeordnete Rechnersystem 12 den prototypischen Merkmalsvektor 70100, beispielsweise mittels einer Signalkonstruktionsvorrichtung oder einem Signalrekonstruktionsverfahren 70110, in prototypische Parameterwertverläufe 70100 für die Parameterwertverläufe der physikalischen Parameter und/oder der aus diesen abgeleiteten Parameter.

Im nächsten Schritt 70120 parametrisiert das übergeordnete Rechnersystem 12 die prototypische Parameterwertverläufe 70100 für die Parameterwertverläufe der physikalischen Parameter und/oder der aus diesen abgeleiteten Parameter

a) entsprechend den Parametern des Datensatzes für dieses Signalgrundobjekt aus der Prototypendatenbank 70115 des übergeordneten Rechnersystems 12 und
b) entsprechend den Parametern des Datensatzes für dieses Signalobjekt Signalobjektsequenzdatenbank 70116 des übergeordneten Rechnersystems 12 und
c) entsprechend den von der Steuervorrichtung 4 der Sicherung 1 für dieses Signalobjekt übermittelten Daten.

Diese Parameter betreffen typischerweise im Wesentlichen Zeitpunkte bezogen auf einen jeweiligen zeitlichen Referenzpunkt und/oder Amplituden relativ zu anderen Komponenten der jeweiligen Signale. Bei den Referenzzeitpunkten der Daten, die die Steuervorrichtung 4 der Sicherung 1 übermittelt, handelt es sich typischerweise um einen vordefinierten Referenzzeitpunkt innerhalb des zeitlichen Abtastfensters, beispielsweise den Beginn oder die Mitte oder das Ende des Abtastfensters. Bei einem Referenzzeitpunkt eines Signalobjekts handelt es sich typischerweise um einen vordefinierten Referenzzeitpunkt innerhalb des Signalobjekts, beispielsweise den Beginn oder die Mitte oder das Ende des Signalobjekts.

In diesem Schritt 70120 parametrisiert das übergeordnete Rechnersystem 12 die prototypische Parameterwertverläufe 70100 für die Parameterwertverläufe der physikalischen Parameter und/oder der aus diesen abgeleiteten Parameter somit zu parametrisierten Parameterwertverläufen 70130 für die Parameterwertverläufe der physikalischen Parameter und/oder der aus diesen abgeleiteten Parameter.

Im nächsten Schritt 70125 addiert das übergeordnete Rechnersystem 12 diese parametrisierten Parameterwertverläufen 70130 für die Parameterwertverläufe der physikalischen Parameter und/oder der aus diesen abgeleiteten Parameter zu dem Parametersignal-Modell 69610. Hierdurch füllt sich das Parametersignal-Modell 69610 um ein weiteres Signalgrundobjekt.

Im nächsten Schritt 70140 prüft das übergeordnete Rechnersystem 12, ob es alle Signalgrundobjekte der Sequenz 70060 von Signalgrundobjekten bereits bearbeitet hat. Wenn dies nicht der Fall ist, ermittelt in dem Schritt 70070 das übergeordnete Rechnersystem 12 das nächste, noch nicht berücksichtigte Signalgrundobjekt der Sequenz 70060 von Signalgrundobjekten, das das übergeordnete Rechnersystem 12 rekonstruieren soll und setzt dann das Verfahren ,wie oben beschrieben, mit der dem Prüfschritt 70080 fort, der prüft, ob der relevante Datensatz 70090, 70100 der Prototypendatenbank 70115 des übergeordneten Rechnersystems 12 einen prototypischen Merkmalsvektor 70090 umfasst und ggf. keine oder prototypische Parameterwertverläufe 70100 für die Parameterwertverläufe der physikalischen Parameter und/oder der aus diesen abgeleiteten Parameter umfasst.

Hat das übergeordnete Rechnersystem 12 alle Signalgrundobjekte der Sequenz 70060 von Signalgrundobjekten bereits bearbeitet, so prüft in einem Prüfschritt 70150 das übergeordnete Rechnersystem 12, ob es alle Signalobjekte der zu dekomprimierenden Daten 70160 bereits für das rekonstruierte Parametersignal-Modell 69610 für dieses Abtastfenster berücksichtig hat.

Hat das übergeordnete Rechnersystem 12 alle Signalobjekte der zu dekomprimierenden Daten 70160 bereits für das rekonstruierte Parametersignal-Modell 69610 für dieses Abtastfenster berücksichtig, so ist das rekonstruierten Parametersignal-Modell 69610 für dieses Abtastfenster fertiggestellt (Ende 70170). Das rekonstruierten Parametersignal-Modell 69610 umfasst dann die rekonstruierten Parameterwertverläufe der physikalischen Parameter und der Verläufe der Parameterwerte der daraus abgeleiteten Parameter, wobei es sich bevorzugt nur um die dekomprimierten Parameterwertverläufe der physikalischen Parameter und der Verläufe der Parameterwerte der daraus abgeleiteten Parameter handelt, die die Steuervorrichtung 4 der Sicherung 1 erfasst hat.

Hat das übergeordnete Rechnersystem 12 nicht alle Signalobjekte der zu dekomprimierenden Daten 70160 bereits für das rekonstruierte Parametersignal-Modell 69610 für dieses Abtastfenster berücksichtig, so ermittelt das übergeordnete Rechnersystem 12 in einem nächsten Schritt 70030 das nächste zu rekonstruierende Objekt in den empfangenen Daten des Steuervorrichtung 4 der Sicherung 1, das das übergeordnete Rechnersystem 12 noch nicht für die Rekonstruktion für das rekonstruierte Parametersignal-Modell 69610 für dieses Abtastfenster berücksichtig hat und setzt das Verfahren von dort an weiter fort.

Auf diese Weise füllt das übergeordnete Rechnersystem 12 das Parametersignal-Modell 69610 langsam auf und nähert das Parametersignal-Modell 69610 dem gemessenen Signalverlauf des Parametersignal 62105 langsame an. Bevorzugt addiert, wie oben beschrieben, das übergeordnete Rechnersystem 12 nur die Signalverläufe prototypischer Signalobjekte der Signalobjektsequenzdatenbank 70116 des übergeordneten Rechnersystems 12 auf und/oder die Signalverläufe der prototypischen Signalgrundobjekte der Prototypendatenbank 70115 des übergeordneten Rechnersystems 12 zum Parametersignal-Modell 69610 für bevorzugt jeweils ein Abtastfenster auf.

Das übergeordnete Rechnersystem 12 bildet aus den so aufsummierten Signalverläufen der durch die Steuervorrichtung 4 der Sicherung 1 erkannten prototypischen Parameterwertsignalverläufe der prototypischen Signalobjekte bzw. der prototypischen Signalgrundobjekte auf Basis des Parametersignal-Modell 69610 der Steuervorrichtung 4 der Sicherung 1 bevorzugt das rekonstruierte Parametersignal, was in Form der Bildung von rekonstruierten Abtastwerten der Signale 62102 der zeitlichen Parameterwertverläufe und/oder die entsprechenden zeitlichen Verlaufen der aus diesen Parameterwertverläufen der physikalischen Parameter abgeleiteten Parameter geschehen kann. Das Ergebnis ist ein Parameter-Signal-Modellvektor 74610 aus den erkannten Signalobjekten 62122 und den Signalgrundobjekten 62121, dessen Inhalt im Wesentlichen rekonstruierten Abtastwerten der Signale 62102 der zeitlichen Parameterwertverläufe und/oder die entsprechenden zeitlichen Verlaufen der aus diesen Parameterwertverläufen der physikalischen Parameter abgeleiteten Parameter als rekonstruiertes Parametersignal 70610 (Figur 73b) entspricht. Dieses rekonstruierte Parametersignal 70610 (Figur 73b) kann dann im übergeordneten Rechnersystem 12 für kompliziertere nachfolgende Signalverarbeitungsverfahren wie Sensorfusion wesentlich besser verwendet werden als die Daten der Signalobjekte und/oder Signalgrundobjekte, die die Steuervorrichtung 4 der Sicherung 1 an das übergeordnete Rechnersystem überträgt.

Liste der Figuren

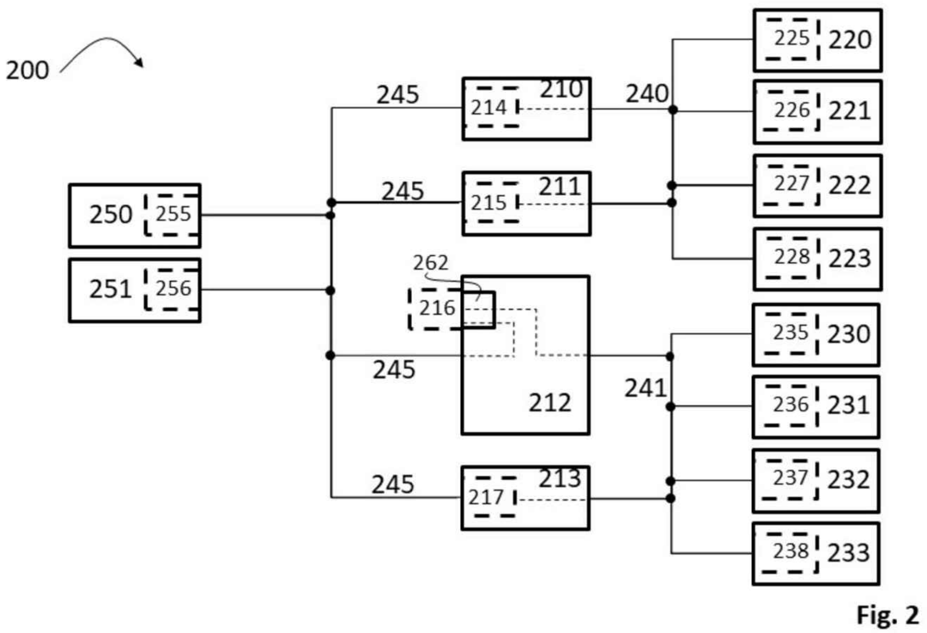

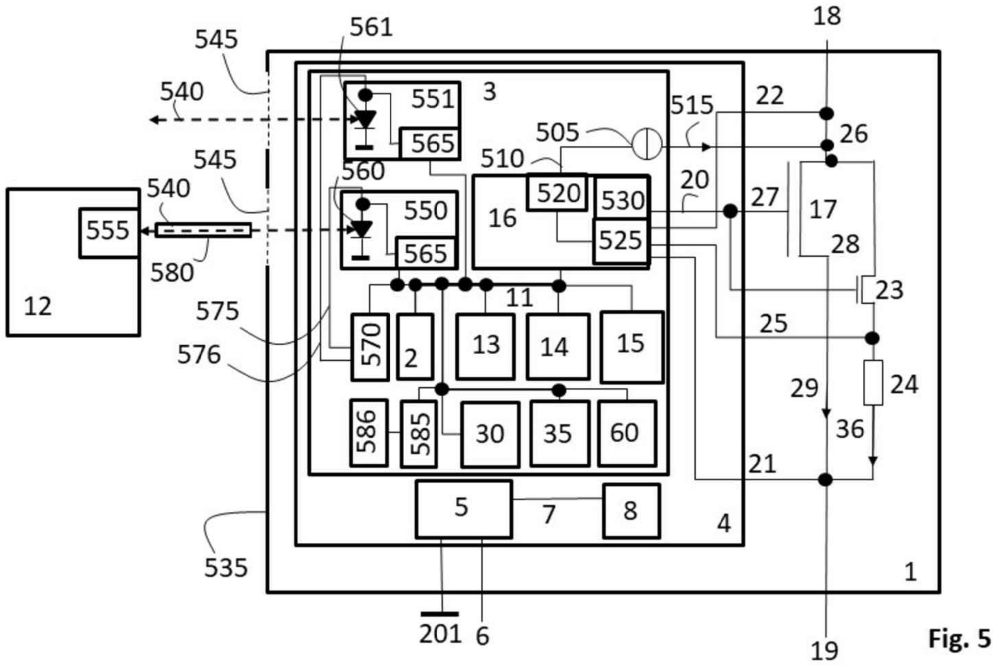

Figur 1
zeigt ein vereinfachtes und schematisches System 50 aus elektronischer Sicherung 1, Datenbus 9 und übergeordnetem Rechnersystem 12. Die elektronische Sicherung 1 umfasst vorschlagsgemäß bevorzugt einen Leistungsschalter 17 und eine Steuervorrichtung 4, die diesen Leistungsschalter 17 steuert.
Figur 2
zeigt vereinfacht und beispielhaft ein Versorgungsnetzwerk 200 mit elektronischen Sicherungen.
Figur 3
zeigt ein Datenbussystem mit einem gestrichelt eingezeichneten Datenbus 9 für das beispielhafte Versorgungsnetzwerk 200 der Figur 2.
Figur 4
zeigt schematisch vereinfacht eine beispielhafte Sicherungsbox 400 mit Steckplätzen 410 und 420 für die Aufnahme von elektronischen Sicherungen 405 und Schmelzsicherungen 415.
Figur 5
basiert auf der Figur 1 und stellt eine Modifikation der Figur 1 dar, wobei die Sicherung 1 der Figur 5 umfasst zusätzliche eine erste Teststromquelle 505, die einen elektrischen Teststrom 515 in den ersten Anschluss 26 des Leistungsschalters 17 der Sicherung 1 einspeist.

Figur 6

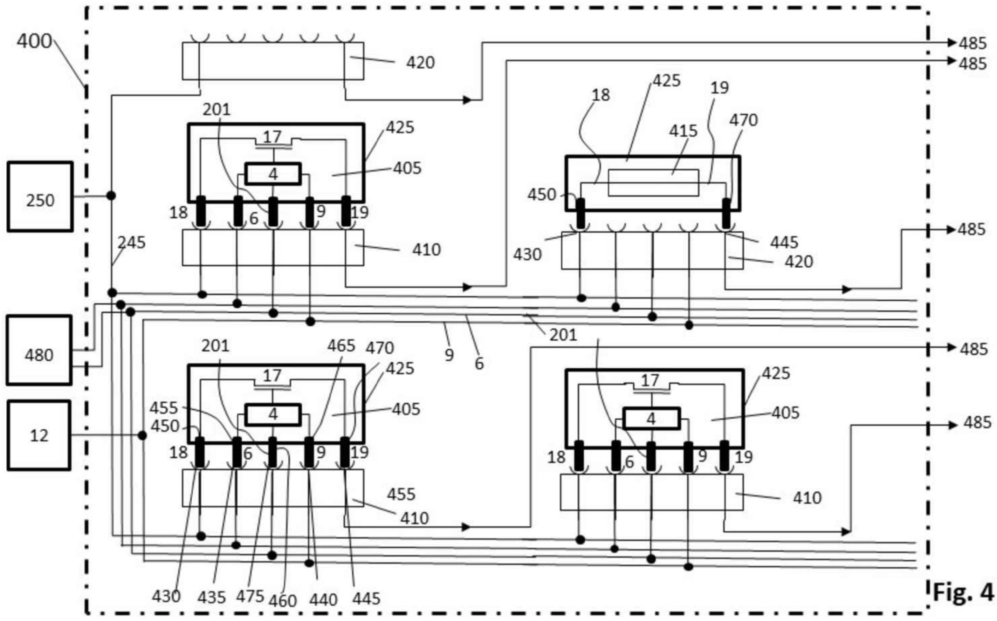

entspricht im Wesentlichen der Figur 1, wobei die Steuervorrichtung 4 der Sicherung 1 der Figur 4 eine zusätzliche zweite Datenschnittstelle 610 aufweist.

Figur 7

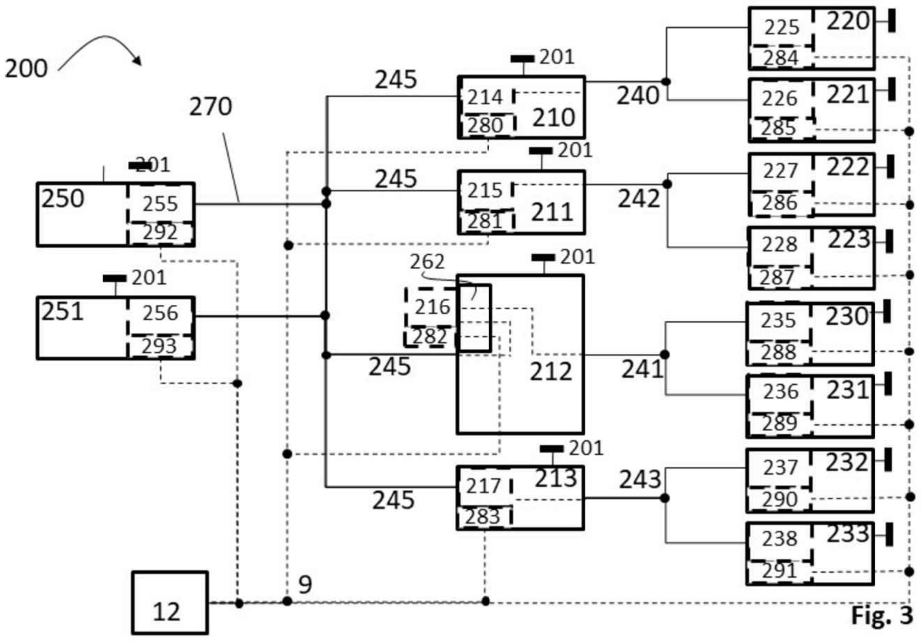

entspricht in wesentlichen Teilen der Figur 3, wobei der Datenbus 9 als ringförmiger Datenbusring 9' ausgebildet ist.

Figur 8

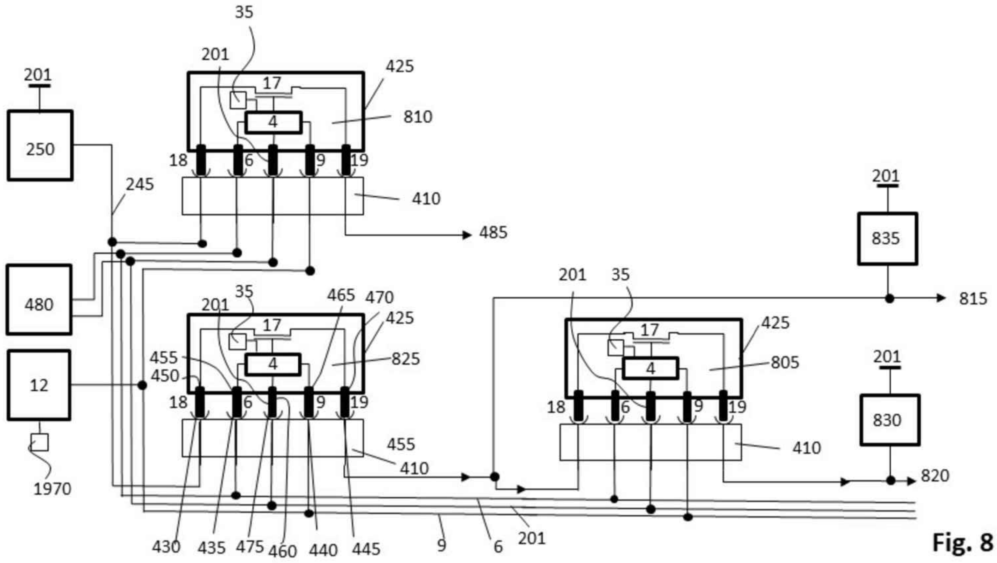

entspricht in den wichtigsten Teilen der Figur 4, wobei das Versorgungsteilnetzwerk der Figur 8 eine weitere Sicherung 805, eine zweite weitere Sicherung 810, einen ersten angeschlossenen Verteilungsbaum 815, einen zweiten angeschlossenen Verteilungsbaum 820, eine elektronische Sicherung 825, Verbraucher 830 und weitere Verbraucher 835 umfasst.

Figur 9

zeigt eine Sicherung 1, die gegenüber der Sicherung 1 der Figur 5 zusätzliche zur ersten Teststromquelle 505 eine zweite Teststromquelle 905 aufweist, deren Teststrom 915 mittels des Steuersignals 910 mit einem Modulationssignal {505} eines zweiten Signalgenerators 920 moduliert ist.

Figur 10

zeigt eine vorschlagsgemäße energiequellenseitige Kreuzungssicherung 1000.

Figur 11

zeigt ein vorschlagsgemäßes Versorgungsnetzwerk 1100 mit einem übergeordneten Rechnersystem 12 und mit einer Vielzahl von Versorgungsleitungen und mit einer Mehrzahl von Kreuzungssicherungen 1110 bis 1118, die ein flexible last- und versorgungsabhängiges Rekonfigurieren des Versorgungsnetzwerks 1100 ermöglichen.

Figur 12

zeigt den grundsätzlichen Ablauf eines Verfahrens 1200 zum Betreiben eines Versorgungsnetzwerkes.

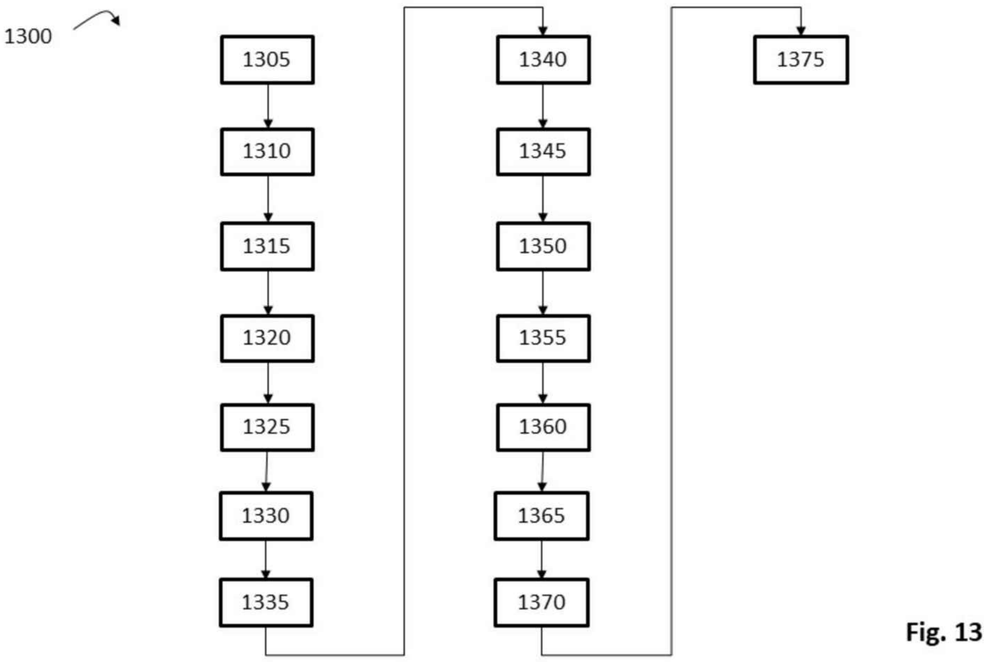

Figur 13 skizziert ein Verfahren 1300 zum Betreiben eines Fahrzeugs (verbraucherseitige Merkmalsversion).

Figur 14

zeigt ebenfalls ein weiteres vereinfacht beschriebenes Verfahren 1400 zum Betreiben eines Fahrzeugs unter Freischaltung von Energiequellen im Fahrzeug.

Figur 15

entspricht weitestgehend der Figur 8, wobei nun jedoch das Versorgungsnetzwerk in ein erstes Versorgungsteilnetzwerk und ein zweites Versorgungsteilnetzwerk unterteilt ist.

Figur 16

zeigt schematisch vereinfacht und beispielhaft ein Verfahren 1600 zu Erkennung von nicht verlöschenden Lichtbögen 1510 im Kabelbaum 1515 eines Fahrzeugs.

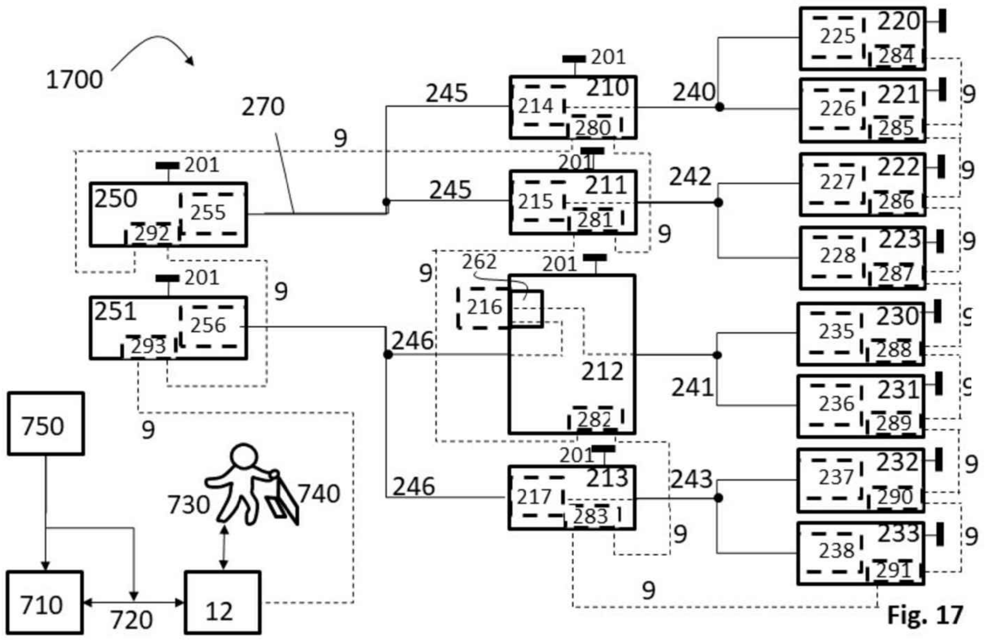

Die Figur 17

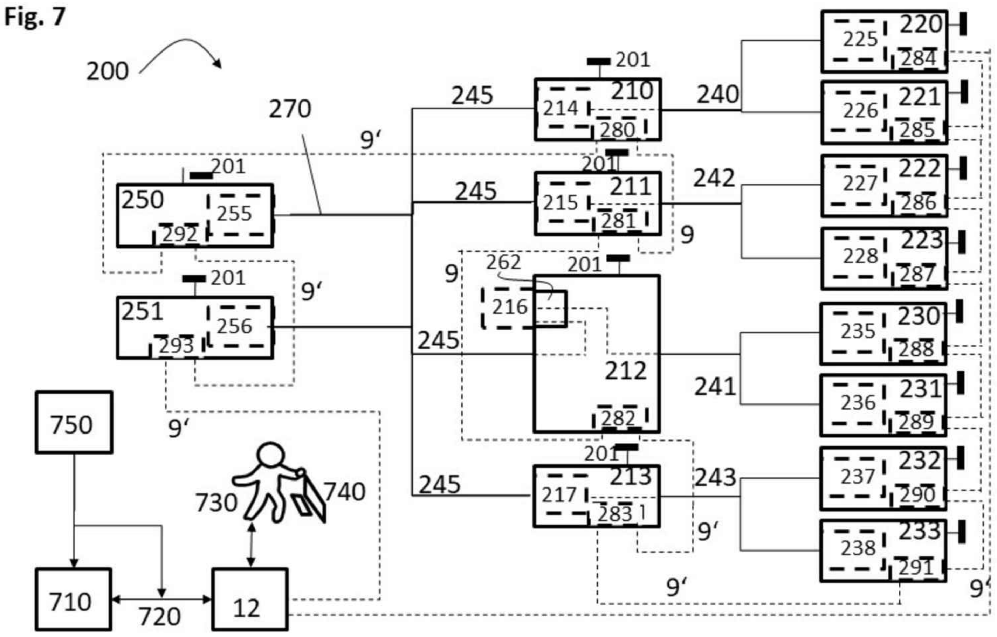

entspricht im Wesentlichen der Figur 7, wobei hier die dritte Versorgungsleitungsabschnitt 245 in den dritten Versorgungsleitungsabschnitt 245 und den vierten Versorgungsleitungsabschnitt 246 getrennt ist.

Figur 18

stellt schematisch vereinfacht ein beispielhaftes Verfahren 1800 zum Betreiben eines Versorgungsnetzwerks 1700 der Figur 17 dar.

Figur 19

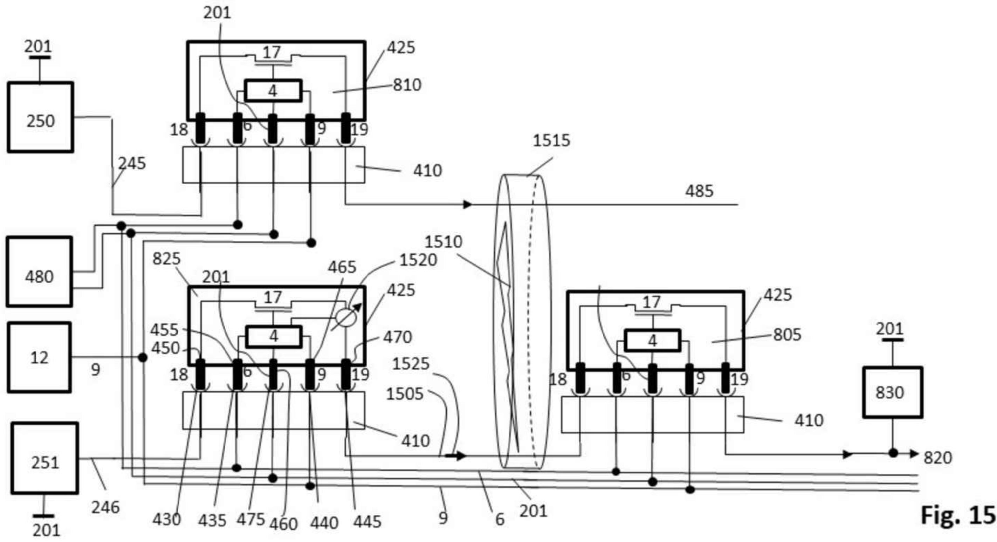

entspricht in wesentlichen Teilen der Figur 15 und der Figur 10, wobei während Figur 10 einen Sicherungskasten 1000 zeigt, Figur 19 zwei abzusichernde Leitungen 1915 und 1505 zeigt, die Teile eines Kabelbaums 1515 sind.

Figur 20

beschreibt schematisch und vereinfacht ein verteiltes Messverfahren 2000 zur Erfassung des Zustands eines Kabelbaums 1515 eines Fahrzeugs in Anlehnung an die Darstellung der Figur 19.

Figur 21

zeigt schematisch vereinfacht eine vorschlagsgemäße Batterie 2100 mit Diagnosefunktion für ein Fahrzeug unter Verwendung von Versorgungsnetzwerken 200 wie sie das hier vorgelegte Dokument sie in den vorausgehenden Figuren beschreibt.

Figur 22

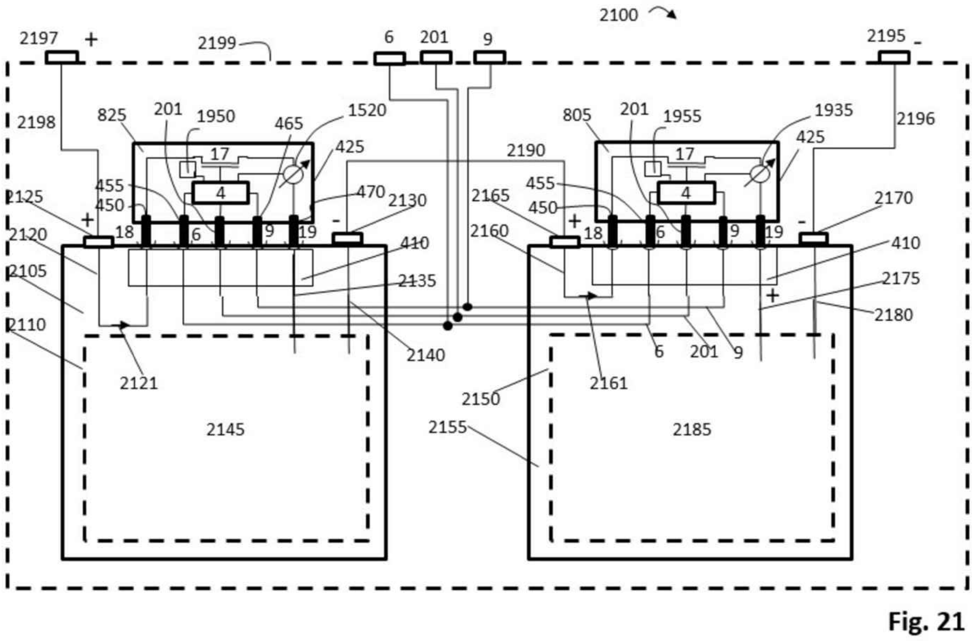

entspricht der Figur 21 mit dem Unterschied, dass die erste elektronische Sicherung 825 einen zusätzlichen Kontakt 2210 aufweist, um im Falle eines fehlerhaften Vorzeichens des Stromes 2121 durch die erste Sicherung 825 diesen Strom an der elektrochemischen Batteriezelle 2145 vorbeizuleiten.

Figur 23

zeigt ein Batteriezellenmodul 2300, das zumindest eine Batteriezelle 2145 und/oder eine Zusammenschaltung von Batteriezellen, einen ersten Leistungsschalter 17, einen zweiten Leistungsschalter 17', einen ersten elektrischen Knoten 2120, einen zweiten elektrischen Knoten 2135, einen dritten elektrischen Knoten 2140, einen ersten Batteriezellenanschluss 2305 und einen zweiten Batteriezellenanschluss 2310 umfasst.

Figur 24

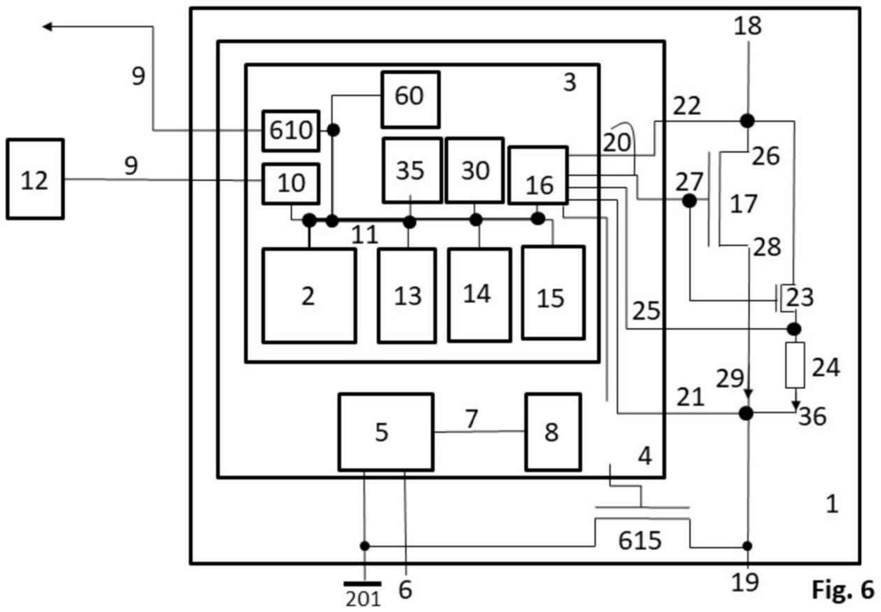

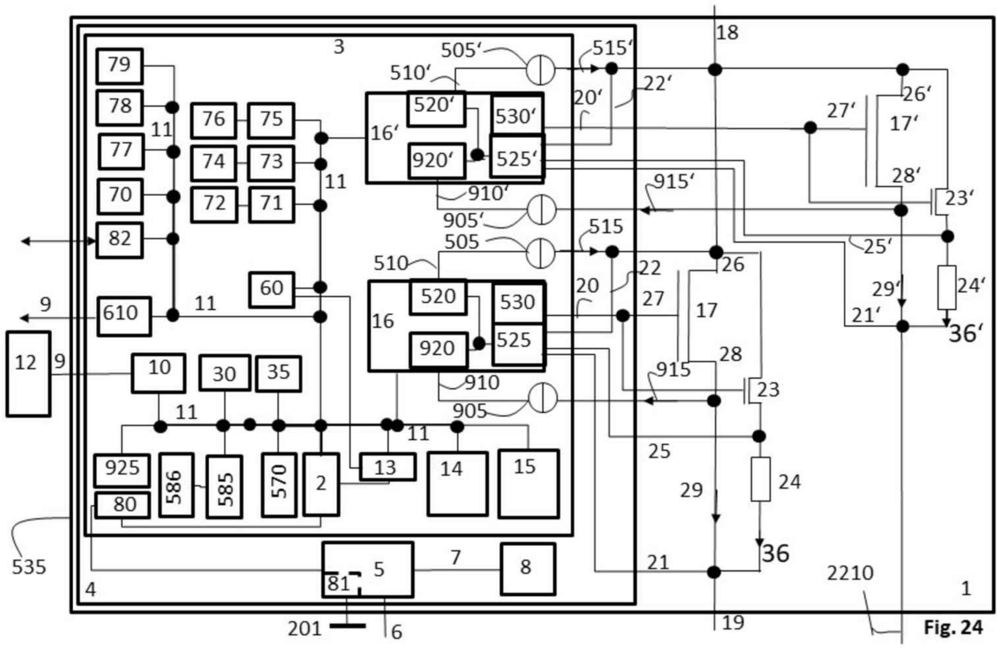

entspricht der Figur 6, wobei die Sicherung 1 der Figur 24 einen zweiten Leistungsschalter 17' aufweist.

Figur 25

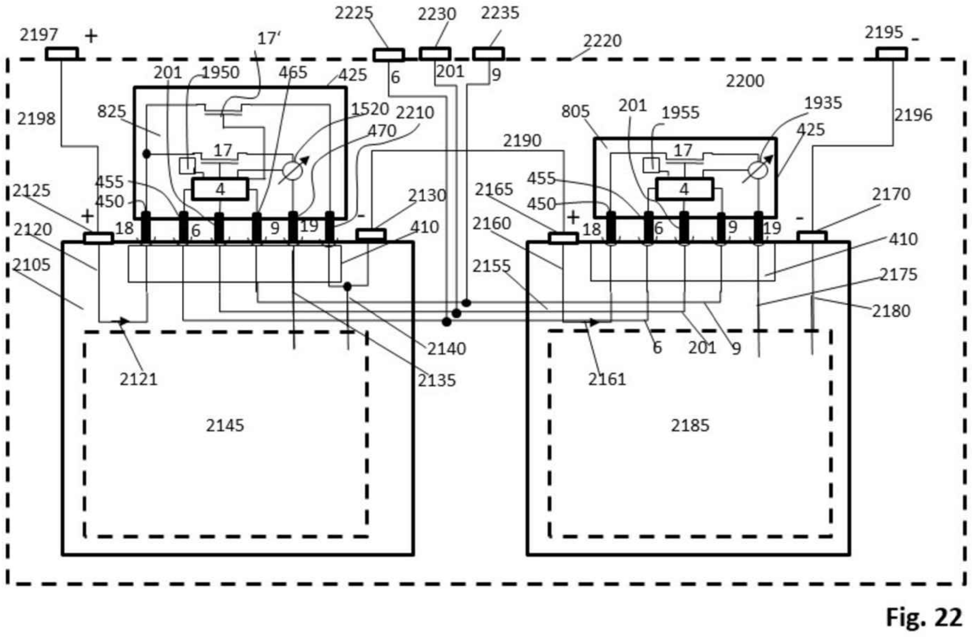

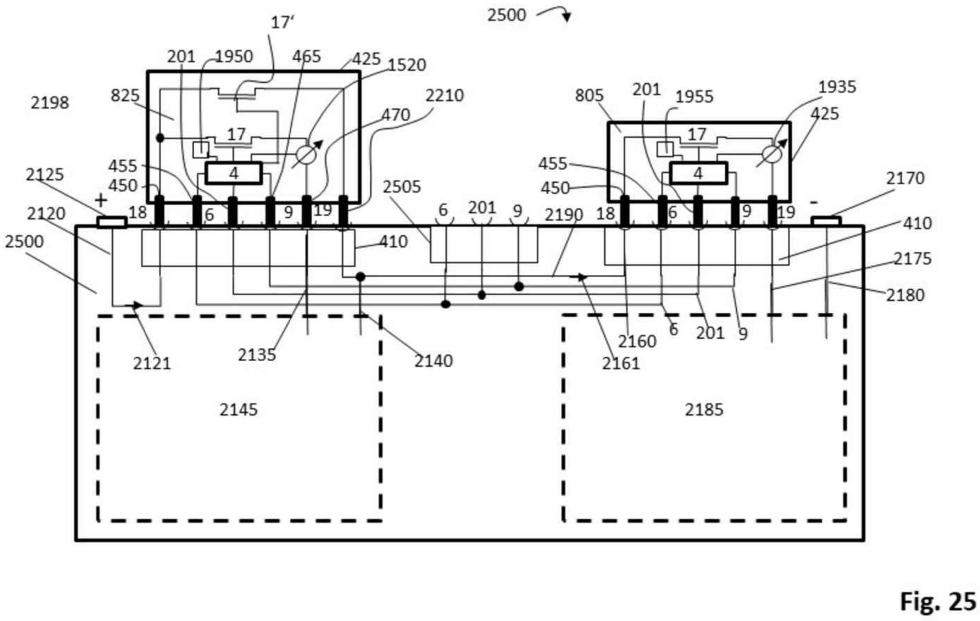

entspricht der Batterie der Figur 22, wobei die Figur 25 ein Batteriezellenmodul 2500 mit mehreren Batteriezellen 2145, 2185 zeigt.

Figur 26

zeigt ein gehäustes Batteriezellenmodul 2600 mit einem gemeinsamen Gehäuse 2605 des Batteriezellemoduls 2600 für eine elektronische Sicherung 825 und ein inneres Batteriezellenmodul 2105.

Figur 27

zeigt eine Batterie 2700, bei der eine elektronische Sicherung 825 der Batterie 2200 einen zweiten Leistungsschalter 17' aufweist, der dazu geeignet ist, das der Sicherung zugeordnete Batteriezellenmodul 2105 bei einem geschlossenen zweiten Leistungsschalter 17' zu überbrücken und bei der die Steuervorrichtung aus der Batteriezelle 2145 versorgt wird, aber nur wenn der Leistungsschalter 17 geschlossen ist.

Figur 28

zeigt eine Batterie 2800, bei der eine elektronische Sicherung 825 der Batterie 2200 einen zweiten Leistungsschalter 17' aufweist, der dazu geeignet ist, das der Sicherung zugeordnete Batteriezellenmodul 2105 bei einem geschlossenen zweiten Leistungsschalter 17' zu überbrücken und bei der die Steuervorrichtung 4 aus der Batteriezelle 2145 weiter versorgt wird, auch wenn der Leistungsschalter 17 geöffnet ist.

Figur 29

zeigt ein Versorgungsnetzwerk 2900, wobei ein oder mehrere Versorgungszweige des Versorgungsnetzwerks 2900 zur Versorgung von elektrischen Verbrauchern 2930 bis 2933 mit elektrischer Energie als Ring einer Versorgungsleitung 2910 bis 2915, insbesondere wenn eine Karosserie als Rückleitermasseleitung dient, und/oder als zwei Ringe von zwei Versorgungsleitungen ausgeführt sind.

Figur 30

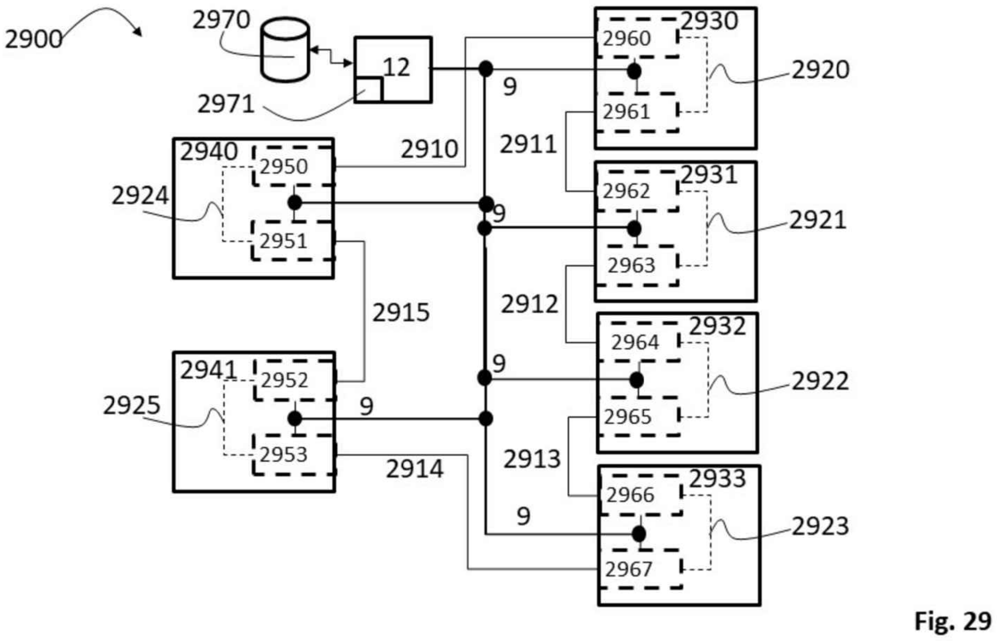

entspricht der Figur 29 mit dem Unterschied, dass Energiequellen und Verbraucher steckbar sind.

Figur 31

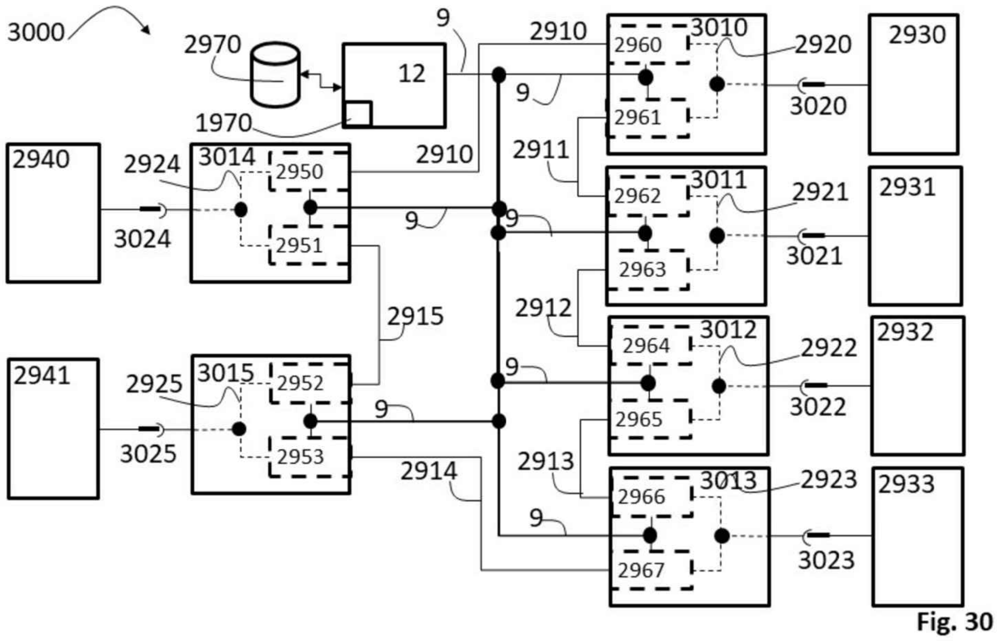

zeigt schematisch und vereinfacht dargestellt ein Versorgungsnetzwerk 3100, das im Wesentlichen dem Versorgungsnetzwerk 3000 der Figur 30 entspricht, wobei nun die Steckverbindungen mit eigenen Sicherungen abgesichert sind.

Figur 32

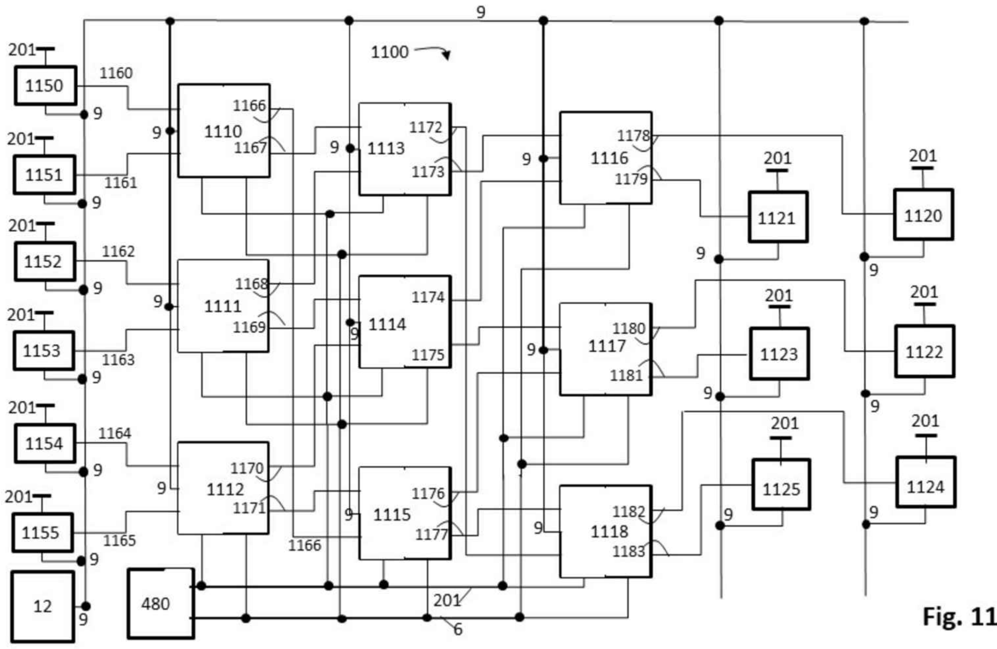

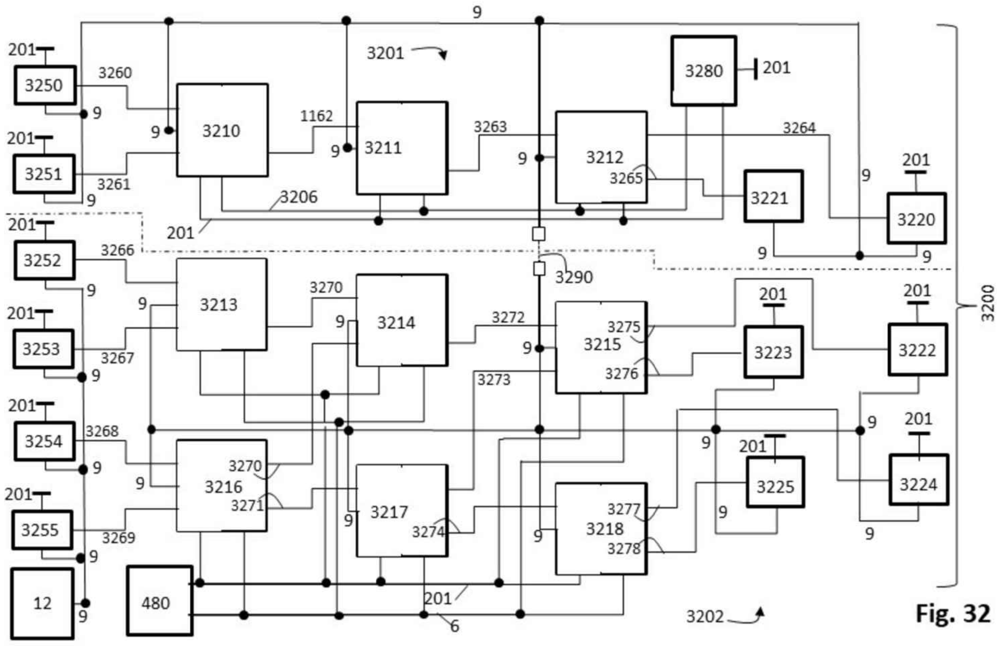

entspricht in großen Teilen der Figur 11, wobei das Versorgungsnetzwerk 3200 der Figur 32 ein erstes Teilversorgungsnetz 3201 und ein zweites Teilversorgungsnetz 3202 aufweist.

Figur 33

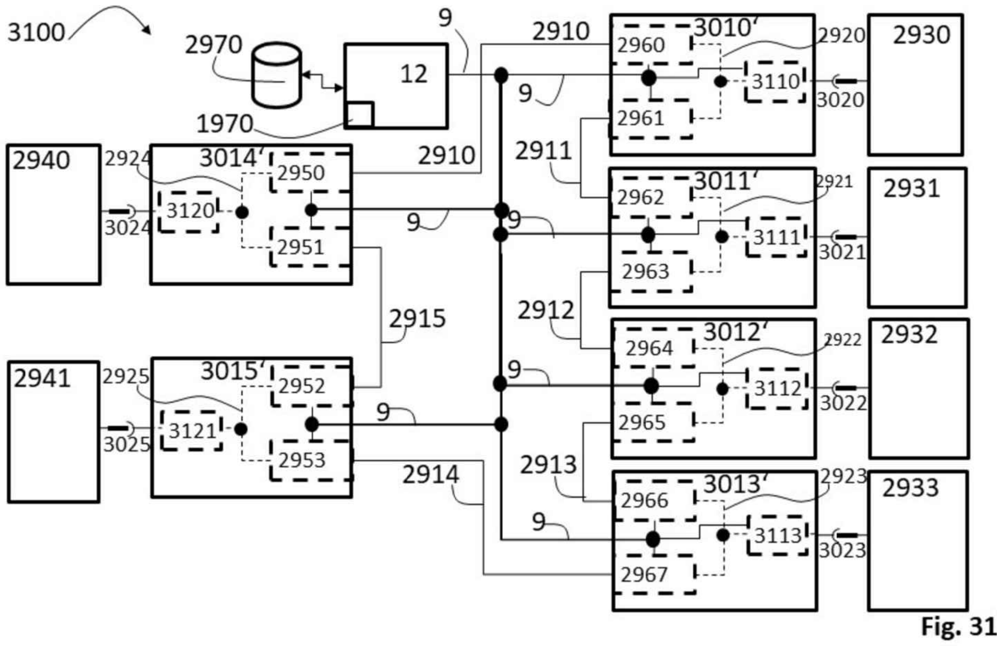

zeigt ein Versorgungsnetzwerk 3300 ähnlich Figur 31 zur Erläuterung der Priorisierung von Verbrauchern und Energiequellen und einer günstigen Topologie des Versorgungsnetzwerks 3300 zur Unterstützung dieser Priorisierbarkeit.

Figur 34

veranschaulicht beispielhaft und vereinfacht ein Verfahren 3400 zum aktiven Power-Management in einem Versorgungsnetzwerk 1100 (siehe Figur 11) mit elektrischen Sicherungen 1110 bis 1118 zur Versorgung elektrischer Verbraucher 1121 bis 1125 in diesem Versorgungsnetzwerk 1100 mit elektrischer Energie aus einer oder mehreren elektrischen Energiequellen 1150 bis 1155.

Figur 35

veranschaulicht vereinfacht und schematisch ein Verfahren 3500 zum Betrieb eines Fahrzeugs mit Ausstattungsvarianten, wobei das Aktivieren und Deaktivieren der Ausstattungsvarianten des Fahrzeugs zumindest zum Teil bevorzugt mittels des Versorgungsnetzwerks und mittels der elektronischen Sicherungen und deren Leistungsschalter 17 erfolgt.

Figur 36

soll mögliche Pegel eines Datenprotokolls auf dem Datenbus 9 des Versorgungsnetzwerks 200 darstellen.

Figur 37

zeigt die heutige Absicherung des Kabels eines Versorgungsleitungsabschnitts.

Figur 38

zeigt die Vorteile einer Absicherung eines Versorgungsleitungsabschnitts mit einer elektronischen Sicherung;

Figur 39

zeigt die Kombination zweier vorschlagsgemäßer SPAD-Dioden im Querschnitt.

Figur 40

zeigt die Kombination zweier vorschlagsgemäßer SPAD-Dioden im Querschnitt, wobei nun mehrere Isolationslagen den Lichtwellenleiter 44 ausbilden.

Figur 41

zeigt die Einbindung der SPAD-Dioden und des Lichtwellenleiters in eine Auswerte- und Betriebsschaltung

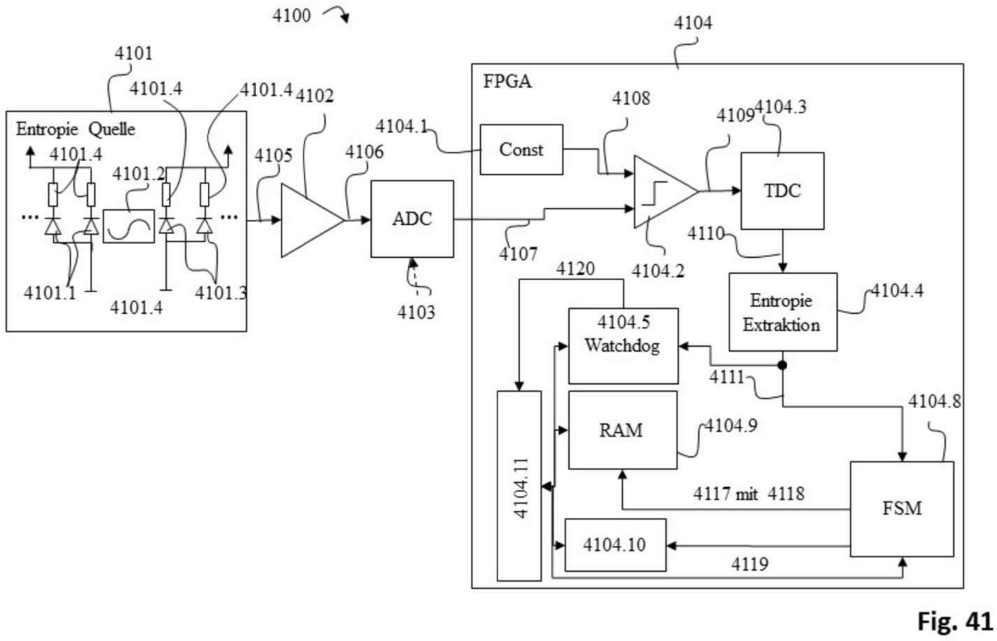

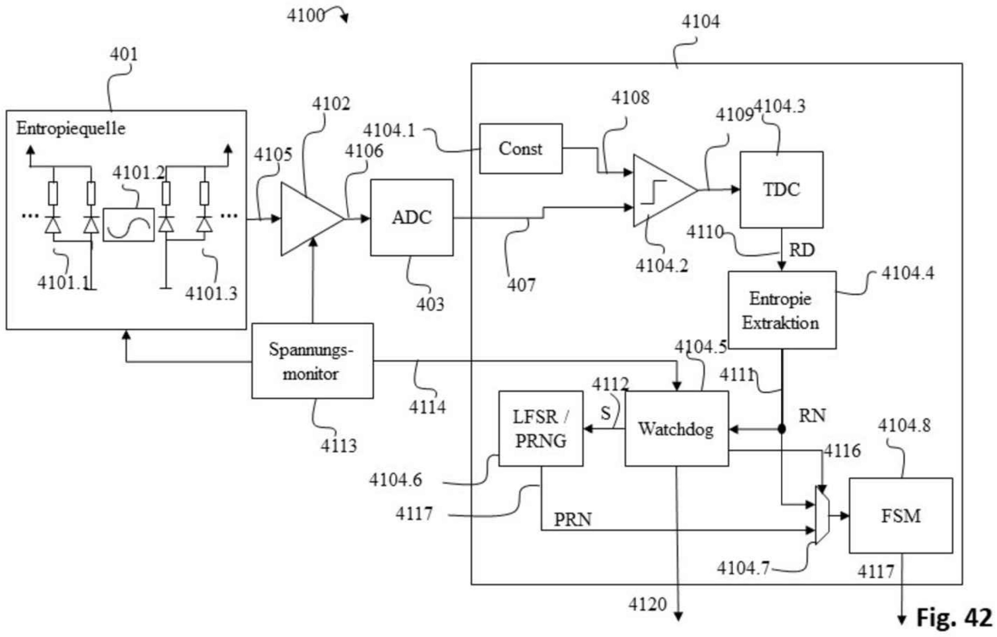

Figur 42 entspricht der Figur 41, die nun um Überwachungsschaltkreise ergänzt ist.

Figur 43

zeigt ein typisches Ausgangssignal der zweiten SPAD-Diode.

Figur 44

zeigt ein beispielhaftes Oszillogramm des Spannungssignals 4104 der Entropie Quelle 4101.

Figur 45

zeigt den schematischen Ablauf einer Server-Client-Kommunikation unter Nutzung eines vorschlaggemäßen Quantenzufallszahlengenerators.

Figur 46

zeigt den schematischen Ablauf der Funktionen KeyExchangeServer() und KeyExchangeClient().

Figur 47

zeigt schematischen Ablauf der Funktion setPrimes().

Figur 48

zeigt den schematischen Ablauf der Funktion setE().

Figur 49

zeigt den schematischen Ablauf der Funktion findD().

Figur 50

zeigt den schematische Ablauf einer sicheren Übertragung von quantenbasierten Zufallszahlen zwischen einem Rechnerkern 2 der Steuervorrichtung 4 der Sicherung 1 (Server) und einem Rechnerkern 2 der Steuervorrichtung 4 der anderen Sicherung 1 (Client).

Figur 51

zeigt schematisch das vorschlagsgemäße Verfahren 5200 zur Erzeugung einer Quantenzufallszahl.

Figur 52

zeigt eine allgemeine Vierfachsicherung mit nur einer Steuervorrichtung 4.

Figur 53

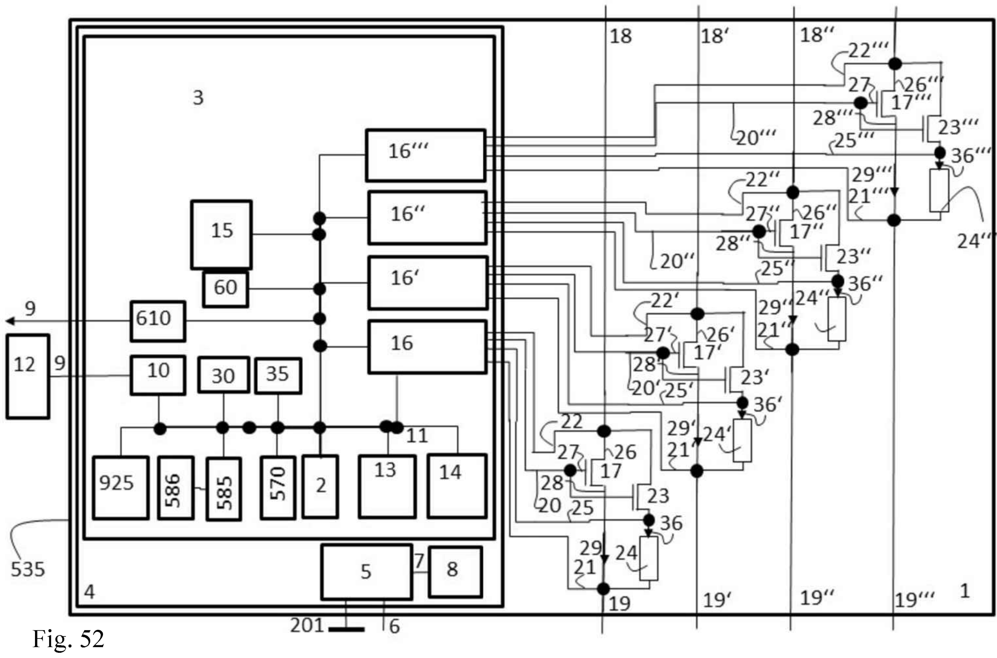

zeigt die allgemeine Vierfachsicherung der Figur 52 als allgemeine Dreifachsicherung, wobei die drei Leistungsschalter 17, 17' und 17" im Stern zusammengeschaltet sind, so dass sie z. B. als Dreifachsicherung 3010' der Figur 31 einsetzbar ist.

Figur 54

zeigt die allgemeine Vierfachsicherung der Figur 52 wobei die vier Leistungsschalter 17, 17', 17" und 17''' zur Kreuzsicherung 1000 verschaltet sind.

Figur 55a

zeigt ein beispielhaftes System zur Integration von SW-Programmen.

Figur 55b

zeigt einen beispielhaften Aufbau eines SW-Programms.

Figur 56

zeigt ein Ablaufdiagramm eines beispielhaften Verfahrens zur Ausführung eines SW-Programms in einem Fahrzeug.

Figur 57

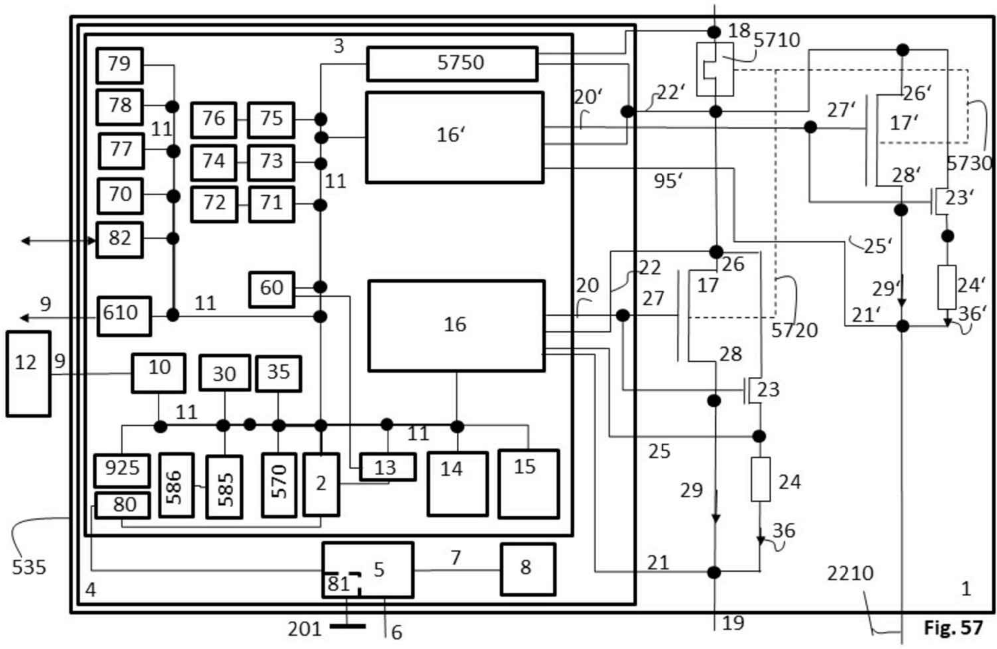

entspricht der Figur 24, wobei zur besseren Übersicht die Teststromquellen und deren Ansteuerungen nicht eingezeichnet sind und wobei in Figur 57 ein Temperaturschalter 5710 in den Strompfad zwischen dem ersten Anschluss 18 der Sicherung 1 und dem zweiten Anschluss der Sicherung 1 eingefügt ist.

Figur 58

entspricht der Figur 24, wobei zur besseren Übersicht die Teststromquellen und deren Ansteuerungen nicht eingezeichnet sind und wobei anders als in der 57 die Sicherung 1 statt eines Thermoschalters 5710 eine Thermosicherung 5740 verwendet.

Figur 59

entspricht einer Anwendung der Mehrfachsicherung 1 der Figur 52 zur Absicherung der drei Motorphasen eines beispielhaften Dreiphasenmotors.

Figur 60

zeigt schematisch vereinfacht den Ablauf eines Verfahren zur Übertragung komprimierter Daten, von der Sicherung 1 zum übergeordneten Rechnersystem 12, wobei im Sinne der hier vorgestellten technischen Lehre im Zusammenhang mit dieser Datenübertragung eine komprimierte Übertragung von der Steuervorrichtung 4 der Sicherung zur einer anderen Steuervorrichtung 4 einer anderen Sicherung von der Offenbarung des hier vorgelegten Dokuments eingeschlossen ist.

Figur 62

ist eine Verfeinerung der Figur 60, bei der die Schritte 6020 der Erfassung des zu erfassenden physikalischen Parameters die Steuervorrichtung 4 der Sicherung 1 und 6030 des Analysierens und des Komprimierens des erfassten zeitlichen Parameterwerteverlaufs des erfassten physikalischen Parameters in weitere beispielhafte Unterschritte verfeinert sind.

Figur 63

dient der Erläuterung der Selektion der Signalgrundobjektprototypen der Prototypendatenbank 62115 durch den Abstandsermittler 62112.

Figur 64

dient der Erläuterung des HMM-Verfahrens, das durch den Viterbi-Schätzer 62113 angewandt wird, um das Signalobjekt als wahrscheinlichste Folge von Signalgrundobjektprototypen aufgrund einer Folge von erkannten Signalgrundobjektprototypen 62121 als erkanntes Signalobjekt 62122 zu identifizieren.

Figur 65

zeigt eine beispielhafte Zustandsabfolge im Viterbi-Schätzer 62113 für die Erkennung eines einzelnen Signalobjekts.

Figur 66

zeigt eine beispielhafte, bevorzugte Zustandsabfolge im Viterbi-Schätzer 62113 für die kontinuierliche Erkennung eines von Signalobjekte, wie sie typischerweise für die Erkennung bei Aufgaben des autonomen Fahrens notwendig ist.

Figur 67

entspricht weitestgehend der Figur 62 mit dem Unterscheid, dass ein neuronales Netzwerkmodell 67151 die Merkmalsvektoren des Signals der Merkmalsvektoren 62138 klassifiziert und analysiert.

Figur 68

zeigt die beispielhafte Dekompression eines übertragenen beispielhaften Teilsignals des Parametersignals 62103, wobei nur Signalanteile mit einer ersten Eigenschaft in die Rekonstruktion einbezogen werden.

Figur 69

zeigt die beispielhafte Dekompression eines übertragenen beispielhaften Teilsignals des Parametersignals 62103, wobei nur Signalanteile ohne die erste Eigenschaft in die Rekonstruktion einbezogen werden.

Figuren 71a bis 71g und 72h

zeigen die Dekompression des Parametersignals 62103.

Figur 73

zeigt ein beispielhaftes, willkürliches Teilsignal des Parametersignals 62103 als Originalsignal (Figur 73a), das rekonstruierte Parametersignal 70610 (Figur 73b) und deren Überlagerung (Figur 73c).

Figur 74

zeigt eine verbesserte Vorrichtung zur verbesserten rekursiven Kompression.

Figur 75

zeigt eine Vorrichtung zur Auswertung der entkomprimierten Sicherungsdaten mehrerer Sicherungen, hie beispielhaft zwei zweier Sicherungen (805, 825).

Figur 76

zeigt ein Verfahren 7600 zum Betreiben eines Versorgungsnetzwerks 200 mit Komprimierung und Verschlüsselung der Sicherungsdaten in der elektronischen Sicherung 1 und Entschlüsselung und Dekomprimierung der Sicherungsdaten im übergeordneten Rechnersystem 12.

Figur 77

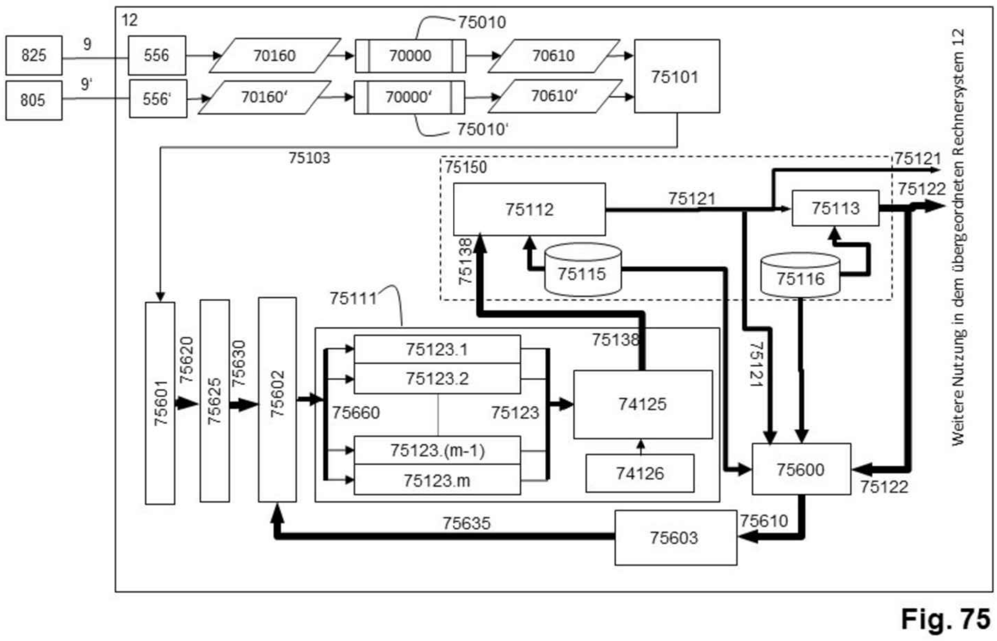

entspricht der Figur 75 mit dem Unterschied, dass der Kombinierer 75101 die rekonstruierten Parametersignale 70610 und 70610' nun nicht nur miteinander, sondern auch mit einem Parametersignal 77610 eines weiteren Sensors 77010 zum fusionierten Parametersignal 75103 fusioniert.

Figur 78

zeigt eine Vorrichtung entsprechend Figur 75, wobei nun das übergeordnete Rechnersystem 12 ein beispielhaftes neuronales Netzwerkmodell 778151 ausführt.

Figur 79

zeigt ein Beispiel für ein Versorgungssystem für ein Fahrzeug mit mindestens einer Energiequelle und mehreren elektrischen Verbrauchern sowie einem übergeordneten Steuerungs- bzw. Rechnersystem für über das Versorgungsnetzwerk verteilt angeordnete elektronische Sicherungen.

Figur 80

zeigt ein Beispiel für ein Versorgungssystem für ein Fahrzeug mit mindestens einer Energiequelle und mehreren elektrischen Verbrauchern sowie einem übergeordneten Steuerungs- bzw. Rechnersystem für über das Versorgungsnetzwerk verteilt angeordnete elektronische Sicherungen.

Figur 81

zeigt ein weiteres Beispiel für ein Versorgungssystem für ein Fahrzeug mit mindestens einer Energiequelle und mehreren elektrischen Verbrauchern sowie einem übergeordneten Steuerungs- bzw. Rechnersystem für über das Versorgungsnetzwerk verteilt angeordnete elektronische Sicherungen.

Beschreibung der Figuren

Figur 1

Figur 1 zeigt ein vereinfachtes und schematisches System 50 aus elektronischer Sicherung 1, Datenbus 9 und übergeordnetem Rechnersystem 12. Die elektronische Sicherung 1 umfasst vorschlagsgemäß bevorzugt einen Leistungsschalter 17 und eine Steuervorrichtung 4, die diesen Leistungsschalter 17 steuert. Bei dem Leistungsschalter 17 handelt es sich vorzugsweise um einen MOS-Transistor oder dergleichen. Andere Halbleiterbauelemente wie Thyristoren, Bipolartransistoren, Thyristoren etc. sind denkbar, aber zurzeit weniger gebräuchlich.

Der Leistungstransistor 17 kann mit Vorrichtungsteilen der Steuervorrichtung 4 in einem Halbleitersubstrat integriert werden. Bevorzugt werden aber unterschiedliche Technologien für den Leistungsschalter 17 und die Steuervorrichtung 4 verwendet. Die Steuervorrichtung 4 wird bevorzugt in einer CMOS Technologie gefertigt. Der Leistungsschalter 17 wird bevorzugt in einer MOS-Technologie für Leistungstransistoren oder einer anderen Halbleitertechnologie für Leistungstransistoren gefertigt. Der Shunt-Widerstand 24 kann sowohl mit der Steuervorrichtung 4 auf einem gemeinsamen Halbleitersubstrat integriert werden als auch mit dem Leistungsschalter 17 zusammen auf einem gemeinsamen Substrat integriert werden.

In der Figur 1 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 5, 6, 9, 24, 41, 42, 52, 53, 54, 55, 57, 58, 62. Die Kombination der Vorrichtungteile der hier beschriebenen Figur mit solchen dieser Figuren ist ausdrücklich Teil der Offenbarung des hier vorgelegten Dokuments.

Das übergeordnete Rechnersystem 12 tauscht mit der Steuervorrichtung 4 Daten über den Datenbus 9 aus. Typischerweise fragt das übergeordnete Rechnersystem 4 Zustandsdaten der elektronischen Sicherung 1 über den Datenbus 9 und eine Datenbusschnittstelle 10 von einem Rechnerkern 2 der Steuervorrichtung 4 der elektronischen Sicherung 1 ab. Dabei greift bevorzugt der Rechnerkern 2 über einen internen Datenbus 11 auf die Peripheriekomponenten der Steuervorrichtung 4 zu. Diese Peripheriekomponenten können beispielsweise aber nicht beschränkt darauf die Datenbusschnittstelle 10, einen Watch-Dog, 13, nicht flüchtige Speicher 14, flüchtige Schreib-Lese-Speicher 15 und eine Gate-Ansteuerschaltung 16 für die Ansteuerung und Überwachung des Leistungsschalters 17 handeln.

Bevorzugt überwacht und steuert die eine Gate-Ansteuerschaltung 16 den Leistungsschalter 17. Eine Steuerleitung 20 zur Steuerung des Leistungsschalters 17 verbindet bevorzugt die Gate-Ansteuerschaltung 16 mit dem ersten Anschluss des Leistungsschalters 17. Die Gate-Ansteuerschaltung 16 steuert bevorzugt mittels der Steuerleitung 20 den Schaltzustand des Leistungsschalters 17. Die Gate-Ansteuerschaltung 16 erfasst bevorzugt ein oder mehrere Spannungen zwischen dem ersten Anschluss 26 des Leistungsschalters 17 und/oder dem zweiten Anschluss 28 des Leistungsschalters 17 und/oder dem Steueranschluss 27 des Leistungsschalters 17 einerseits und einem Bezugspotenzial 201 andererseits. Die Gate-Ansteuerschaltung 16 erfasst bevorzugt ein oder mehrere Spannungen zwischen dem ersten Anschluss 26 des Leistungsschalters 17 und/oder dem zweiten Anschluss 28 des Leistungsschalters 17 und/oder dem Steueranschluss 27 des Leistungsschalters 17 untereinander. Bevorzugt umfasst die elektronische Sicherung 1 einen Hilfsleistungsschalter 23. Der Hilfsleistungsschalter 23 dient vorzugsweise zur Erfassung eines Stromes, der dem Strom durch den Leistungsschalter 17 proportional ist oder auf andere Weise entspricht. Bevorzugt umfasst die elektronische Sicherung 1 einen Shunt-Widerstand 24. Der Betrag des Werts des elektrische Stroms 36 durch den Shunt-Widerstand 24 und den Hilfsleistungsschalter 23 ist typischerweise proportional zu dem Betrag des elektrischen Stroms 29 durch den Leistungsschalter 17. Eine Messleitung 25 dient zur Erfassung des Spannungsabfalls über den Shunt-Widerstand 24. Eine Überwachungsleitung 21 dient zur Erfassung der Spannung zwischen dem zweiten Anschluss 19 des Leistungsschalters 17 und der Steuerleitung 20 des Leistungsschalters 17. Bevorzugt erfasst die Gate-Ansteuerschaltung 16 mittels der Messleitung 25 und einer Überwachungsleitung 21 den Spannungsabfall über den Shunt-Widerstand 24. Typischerweise steuert der Rechner 2 der Steuervorrichtung 4 der elektronischen Sicherung 1 den Leistungsschalter 17 in Abhängigkeit von den so erfassten Werten dieser Spannungen und in Abhängigkeit von Kommandos, die der Rechner 2 der Steuervorrichtung 4 beispielsweise von einemübergeordneten Rechnersystem 12 beispielsweise über den besagten Datenbus 9 erhält.

Im Sinne der hier vorgelegten Schrift ist der erste Anschluss 18 der elektronischen Sicherung 1 bevorzugt der energiequellenseitige Anschluss der elektronischen Sicherung. Im Sinne der hier vorgelegten Schrift ist der zweite Anschluss 19 der elektronischen Sicherung 1 bevorzugt der verbraucherseitige Anschluss der elektronischen Sicherung. Da Verbraucher, wie z.B. Motoren, oft in bestimmten Betriebslagen, beispielsweise einer Bremsung, Energie nicht verbrauchen, sondern zurückgewinnen, kann diese Zuordnung sich ggf. im Betrieb umkehren. Insofern ist sie nur eine Vorstellung über den überwiegenden Einsatz des ersten Anschlusses 18 der Sicherung 1 und des zweiten Anschlusses 19 der Sicherung 1.

Ein Watchdog 13 dient bevorzugt der Überwachung des Mikrokontrollers, also des Rechners 2. Im einfachsten Fall handelt es sich bei dem Watch-Dog um einen Zeitgeber, der beispielsweise mit dem Systemtakt der Steuervorrichtung 4 zählt. Typischerweise signalisiert der Rechner 2 dem Watchdog 13 in mehr oder weniger regelmäßigen Zeitabständen, dass er noch funktionstüchtig ist. Vorzugsweise setzt mit jeder Signalisierung des Rechners 2 der Watchdog 13 seinen Zählerstand auf einen vorgegebenen Startwert zurück. Erreicht der Watchdog 13 jedoch einen vorgegebenen Watchdog-Schwellwert, so geht der Watchdog 13 typischerweise von einer Störung der Abarbeitung des Betriebsprogramms durch den Rechner 2 aus. Der Watchdog 13 ergreift dann typischerweise Gegenmaßnahmen. Eine Gegenmaßnahme kann beispielsweise das Zurücksetzten der Programmausführung des Rechners 2 auf eine vorgegebene Programmstartadresse sein. Eine andere Gegenmaßnahme kann das Anhalten des Rechners 2 sein. Eine andere Gegenmaßnahme kann das Öffnen des Leistungsschalters 17 sein. Eine andere Gegenmaßnahme kann beispielsweise eine Signalisierung des Watchdogs 13 an ein übergeordnetes Rechnersystem 12 über den internen Datenbus 11, die Datenschnittstelle 10 und den externen Datenbus 9 an ein übergeordnetes Rechnersystem 12 sein. Typischerweise kann der Rechner 2 der Steuervorrichtung 4 der elektronischen Sicherung 1 den Watchdog 13 über den internen Datenbus 11 mittels Register des Watchdogs 13 konfigurieren und über Watchdog-Register den Status des Watchdogs 13 auslesen.

Der nicht flüchtige Speicher 14 kann z.B. einen Flash-Speicher oder ein EEPROM oder ein Rom oder dergleichen umfassen. Der nicht flüchtige Speicher 14 umfasst bevorzugt Daten und/oder Programmcode. Der Rechner 2 der elektronischen Sicherung 1 greift vorzugsweise über den internen Datenbus 11 auf diese Daten und den Programmcode zu. Insbesondere umfassen die Daten im nichtflüchtigen Speicher 14 vorzugsweise auch Konfigurationsdaten der elektronischen Sicherung 2.

Des Weiteren umfasst die vorgeschlagene elektronische Sicherung 1 vorzugsweise einen flüchtiger Schreib-Lese-Speicher 15. Bei dem flüchtigen Schreiblesespeicher 15 kann es sich beispielsweise um ein RAM oder ein SRAM oder ein DRAM oder ein FRAM oder ein MRAM oder dergleichen handeln. Der Rechner 2 der elektronischen Sicherung 1 nutzt diesen flüchtigen Schreiblesespeicher 15 bevorzugt zur Zwischenspeicherung von Zwischenergebnissen.

Ein Oszillator 30 mit einer Taktversorgung erzeugen bevorzugt den Systemtakt der Steuervorrichtung 4 der elektronischen Sicherung 1. Bevorzugt kann das übergeordnete Rechnersystem 12 über den internen Datenbus 11 und die Datenbusschnittstelle 10 und den Datenbus 9 auf die Konfigurationsregister des Oszillators 30 und der Taktversorgung zugreifen und diese konfigurieren und deren Status auslesen. Ebenso kann bevorzugt der Rechner 2 den internen Datenbus 11 auf diese Konfigurationsregister des Oszillators 30 und der Taktversorgung zugreifen und diese konfigurieren und deren Status aus Statusregistern auslesen.

Bevorzugt umfasst die Steuervorrichtung 4 einen Zeitgeber und/oder eine Uhr der Steuervorrichtung 4. Der Rechner 2 kann dann Messwerte der Gate-Ansteuerschaltung 16 für die Ansteuerung und Überwachung des Leistungsschalters 17 mit einem Zeitstempel aus einem Zeitwert des Zeitgebers 16 und Messwerten von Spannungen und/oder anderen physikalischen Parametern etc. kombinieren.

Beispielsweise kann eine Temperaturmessvorrichtung 40 die Temperatur der Steuervorrichtung 4 und/oder die Temperatur von Vorrichtungsteilen der Steuervorrichtung 4 bestimmen. Auch kann die Steuervorrichtung 4 der Sicherung 1 einen Analog-zu-Digital-Wandler 570 umfassen, der in einer folgenden Figur beispielhaft dargestellt ist. Beispielsweise kann ein solcher Analog-zu-Digital-Wandler eine Messleitung zu einem hier zur besseren Übersichtlichkeit nicht dargestellten Temperatursensor 586 bereitstellen, über den der Analog-zu-Digital-Wandler 570 die Temperatur des Leistungsschalters 17 oder anderer Vorrichtungsteile der Sicherung 1 ermitteln kann und dem Rechner 2 über den Datenbus 11 zur Verfügung stellen kann. Vorzugsweise ist dazu dieser Temperatursensor 586 thermisch eng mit dem Leistungsschalter 17 gekoppelt. Vorzugsweise ist der Temperatursensor 586 eine Teilvorrichtung des Leistungsschalters 17. Die elektronische Sicherung kann mehrere Temperatursensoren 586 aufweisen, deren Messwertsignale der Analog-zu-Digitalwandler 570 erfassen und dem Rechner 2 zur Verfügung stellen kann. Beispielsweise kann der Temperatursensor 586 auch die Temperatur der Leitung am ersten Anschluss 18 oder am zweiten Anschluss 19 der elektronischen Sicherung 1 feststellen.

Bevorzugt weist die elektronische Sicherung 1 eine Spannungsversorgung 5 für die Steuervorrichtung 4 und den Betrieb der ggf. vorhandenen sonstigen Vorrichtungsteile der elektronischen Sicherung 1 auf. Bevorzugt versorgen eine Leitung für die Betriebsspannung 6 und eine Leitung für das Bezugspotenzial 201 die elektronische Sicherung 1 mit elektrischer Energie. Es ist auch denkbar, dass die elektronische Sicherung ihre Energie aus dem ersten Anschluss 18 und/oder dem zweiten Anschluss 19 einerseits und der Bezugspotenzialleitung 201 bezieht. Bevorzugt lädt die Spannungsversorgung 5 im Normalbetrieb eine Energiereserve 8. Dabei handelt es sich typischerweise um einen Kondensator und/oder einen Akkumulator und dergleichen.

Im Falle eines Ausfalls der Energiezufuhr über die Betriebsspannung 6 versorgt die Energiereserve 8 über eine Notenergieversorgung 7 die Steuervorrichtung 4 und damit den Leistungsschalter 17 mit der notwendigen Energie. Vorzugsweise trennt die Spannungsversorgung 5 die Betriebsspannung 6 und ggf. auch das Bezugspotenzial 201 im Falle eines solchen Ausfalls mittels Trennschaltern ab, um die Energiereserve 8 nicht zu entladen.

Bevorzugt umfasst die Spannungsversorgung 5 die notwendigen Spannungsregler und/oder Spannungswandler, um die von der Steuervorrichtung 4 benötigten Spannungen aus der Energiereserve 8 oder aus der Betriebsspannung 6 für den Betrieb der Steuervorrichtung 4 bereitzustellen.

Die hier vorgestellte Steuervorrichtung 4 für den Betrieb einer elektronischen Sicherung 1 eines Fahrzeugs besitzt bevorzugt eine System Basis Chip Funktionalität. Diese System Basis Chip Funktionalität stellt alle Funktionen bereitstellt, um einen Mikro-Controller als Rechnerkern 2 in der Steuervorrichtung 4 der elektronischen Sicherung 1 und zumindest eine Datenschnittstelle 1 betreiben zu können, sodass der Rechnerkern 2 zumindest Fehler und/oder Störungen der Steuervorrichtung 4 und/oder anderer Vorrichtungteile der Sicherung sicher an ein übergeordnetes Rechnersystem 12 über den Datenbus 9 übertragen kann. Diese System Basis Chip Funktionalität umfasst einen Boost-Konverter 5 für die Spannungsversorgung 5 der sicherheitsrelevanten Vorrichtungteile der Steuervorrichtung 4 der Sicherung 1 und für das Laden und ggf. Entladen einer internen oder externen Energiereserve 8. Die Energiereserve 8 kann ein Akkumulator und/oder eine Kapazität umfassen. Im Normalbetrieb bereitet der Boost-Konverter 5 vorzugsweise eine extern bereit gestellten Betriebsspannung 6 einer oder mehrerer externer Energiequellen auf und stellt die not-wendigen internen Betriebsspannungen den Vorrichtungteilen der Steuervorrichtung 4 und/oder anderen Vorrichtungsteilen der Sicherung 1 zur Verfügung. Der Rechnerkern 2 der Steuervorrichtung 4 der Sicherung 1 überwacht beispielsweise mittels eines Analog-zu-Digitalwandlers 570 die Betriebsspannung 6 des Boost-Konverters 5. Der Rechnerkern 2 der Steuervorrichtung 4 der Sicherung 1 wechselt bei einem Ausfall der extern bereit gestellten Betriebsspannung 6 in einen Notlaufbetrieb. Bevorzugt versorgt in einem solchen Notlaufbetrieb der Boost-Konverter 5 die Steuervorrichtung 4 und oder weitere Vorrichtungteile der Sicherung, soweit dies unbedingt erforderlich ist, mit elektrischer Energie aus der Energiereserve 8. Im Normalbetrieb lädt der Boost-Konverter 5 die Energiereserve 8 mit elektrischer Energie. Im Notlaufbetrieb übernimmt die Energiereserve 8 die Energieversorgung der Steuervorrichtung 4 der Sicherung 1. Somit stellen im Notlaufbetrieb der Boost-Konverter 5 und/oder eine funktionsäquivalente zweite Spannungsregelvorrichtung eine Notenergieversorgung 7 der sicherheitsrelevanten Vorrichtungteile der Steuervorrichtung 4 der Sicherung 1 und oder der Sicherung 1 zur Verfügung.

Figur 2

Figur 2 zeigt vereinfacht und beispielhaft ein Versorgungsnetzwerk 200 mit elektronischen Sicherungen. Das Versorgungsnetzwerk zeigt den Bezugspotenzialknoten 201 nur symbolisch. Bei dem Bezugspotenzialknoten kann es sich beispielsweise um die Karosseriemasse einer Fahrzeugkarosserie aus Metall oder dergleichen handeln. Das vorschlagsgemäße Versorgungsnetzwerk nutzt also beispielsweise eine elektrisch leitende Fahrzeugkarosserie als elektrische Rückleitung. Diese elektrische Rückleitung ist in dem Beispiel der Figur 2 der Bezugspotenzialknoten 201. Der Bezugspotenzialknoten 201 ist typischerweise die Masse des Fahrzeugs. In den Figuren des hier vorgelegten Dokuments ist der Bezugspotenzialknoten 201 zur besseren Übersichtlichkeit nicht immer eingezeichnet und auch nicht immer mit dem Bezugszeichen bezeichnet. Das Schaltsymbol für die Masse bezeichnet den Bezugspotenzialknoten 2021 in den Figuren dieses Dokuments, wenn es in einer Figur eingezeichnet ist. Das Versorgungsnetzwerk 200 weist in dem Beispiel der Figur 2 verschiedene Vorrichtungteile (210 bis 213) auf. Diese verbrauchen typischerweise elektrische Energie.

Eine erste Sicherung 214 des ersten Vorrichtungsteils 210 des Versorgungsnetzwerks 200 sichert den ersten Leitungsabschnitt 240 und die an ihm angeschlossenen Verbraucher in Formweiterer, abhängiger Vorrichtungteile (220 bis 223) des Versorgungsnetzwerks 200 ab. Die erste Sicherung 214 entspricht bevorzugt in ihrer inneren Struktur einer elektrischen Sicherung der Figur 1. In dem Beispiel der Figur 2 kann die erste Sicherung 214 den dritten Leitungsabschnitt 245 mit dem ersten Leitungsabschnitt 240 mittels ihres Leistungsschalters 17 elektrisch verbinden oder den dritten Leitungsabschnitt (245) von dem ersten Leitungsabschnitt 240 mittels ihres Leistungsschalters 17 lokal trennen. Typischerweise ist die erste Sicherung 214 an einen Datenbus 9 angeschlossen, der zu Vereinfachung in der Figur 1 nicht eingezeichnet ist. Figur 3 zeigt eine beispielhafte Verdrahtung des Datenbusses 9, die in der Form auch in Figur 1 anwendbar wäre.

Eine zweite Sicherung 215 des zweiten Vorrichtungsteils 211 des Versorgungsnetzwerks 200 sichert den ersten Leitungsabschnitt 240 und die an ihm angeschlossenen Verbraucher in Form weiterer, abhängiger Vorrichtungteile (220 bis 223) des Versorgungsnetzwerks 200 ab. Die zweite Sicherung 215 entspricht bevorzugt in ihrer inneren Struktur einer elektrischen Sicherung der Figur 1. In dem Beispiel der Figur 2 kann die zweite Sicherung 215 den dritten Leitungsabschnitt 245 mit dem ersten Leitungsabschnitt 240 mittels ihres Leistungsschalters 17 elektrisch verbinden oder den dritten Leitungsabschnitt 245 von dem ersten Leitungsabschnitt 240 mittels ihres Leistungsschalters 17 lokal trennen. Typischerweise ist die zweite Sicherung 215 an einen Datenbus 9 angeschlossen, der zu Vereinfachung in der Figur 1 nicht eingezeichnet ist. Figur 3 zeigt eine beispielhafte Verdrahtung des Datenbusses 9, die in der Form auch in Figur 1 anwendbar wäre.

Eine dritte Sicherung 216 des dritten Vorrichtungsteils 212 des Versorgungsnetzwerks 200 sichert den zweiten Leitungsabschnitt 241 und die an ihm angeschlossenen Verbraucher in Form weiterer, abhängiger Vorrichtungteile (230 bis 233) des Versorgungsnetzwerks 200 ab. Die dritte Sicherung 216 entspricht bevorzugt in ihrer inneren Struktur einer elektrischen Sicherung der Figur 1. In dem Beispiel der Figur 2 kann die dritte Sicherung 216 den dritten Leitungsabschnitt 245 mit dem zweiten Leitungsabschnitt 241 mittels ihres Leistungsschalters 17 elektrisch verbinden oder den dritten Leitungsabschnitt 245 von dem zweiten Leitungsabschnitt 241 mittels ihres Leistungsschalters 17 lokal trennen. Typischerweise ist die dritte Sicherung 216 an einen Datenbus 9 angeschlossen, der zu Vereinfachung in der Figur 1 nicht eingezeichnet ist. Figur 3 zeigt eine beispielhafte Verdrahtung des Datenbusses 9, die in der Form auch in Figur 1 anwendbar wäre.

Eine vierte Sicherung 217 des vierten Vorrichtungsteils 213 des Versorgungsnetzwerks 200 sichert den zweiten Leitungsabschnitt 241 und die an ihm angeschlossenen Verbraucher in Form weiterer, abhängiger Vorrichtungsteile (230 bis 233) des Versorgungsnetzwerks 200 ab. Die vierte Sicherung 217 entspricht bevorzugt in ihrer inneren Struktur einer elektrischen Sicherung der Figur 1. In dem Beispiel der Figur 2 kann die vierte Sicherung 217 den dritten Leitungsabschnitt 245 mit dem zweiten Leitungsabschnitt 241 mittels ihres Leistungsschalters 17 elektrisch verbinden oder den dritten Leitungsabschnitt 245 von dem zweiten Leitungsabschnitt 241 mittels ihres Leistungsschalters 17 lokal trennen. Typischerweise ist die vierte Sicherung 217 an einen Datenbus 9 angeschlossen, der zu Vereinfachung in der Figur 1 nicht eingezeichnet ist. Figur 3 zeigt eine beispielhafte Verdrahtung des Datenbusses 9, die in der Form auch in Figur 1 anwendbar wäre.

Bei der Verschaltung der ersten Sicherung 214 parallel zur zweiten Sicherung 215, wie in dem Beispiel der Figur 1, müssen die Leistungsschalter 17 beider Sicherungen (214, 215) geöffnet sein, um den ersten Leitungsabschnitt 240 vom dritten Leitungsanschnitt 245 zu trennen. Ist der erste Leitungsabschnitt 240 vom dritten Leitungsabschnitt 245 durch geöffnete Leistungsschalter 17 getrennt, so versorgen die erste Energiequelle 250 und die zweite Energiequelle 251 die weiteren Vorrichtungsteile (220 bis 223) nicht mehr mit elektrischer Energie. Ist der erste Leitungsabschnitt 240 mit dem dritten Leitungsabschnitt 245 elektrisch über geschlossene Leistungsschalter 17 verbunden, so versorgen die erste Energiequelle 250 und die zweite Energiequelle 251 die weiteren Vorrichtungsteile (220 bis 223) mit elektrischer Energie, wenn diese Energiequellen (250, 251) Energie in den dritten Leitungsabschnitt 245 einspeisen.

Bei der Verschaltung der dritten Sicherung 216 parallel zur vierten Sicherung 217, wie in dem Beispiel der Figur 1, müssen die Leistungsschalter 17 beider Sicherungen (216, 217) geöffnet sein, um den ersten Leitungsabschnitt 240 vom dritten Leitungsanschnitt zu 245 trennen. Ist der zweite Leitungsabschnitt 241 vom dritten Leitungsabschnitt 245 durch geöffnete Leistungsschalter 17 getrennt, so versorgen die erste Energiequelle 250 und die zweite Energiequelle 251 die weiteren Vorrichtungsteile (230 bis 233) nicht mehr mit elektrischer Energie. Ist der zweite Leitungsabschnitt 241 mit dem dritten Leitungsabschnitt 245 elektrisch über geschlossene Leistungsschalter 17 verbunden, so versorgen die erste Energiequelle 250 und die zweite Energiequelle 251 die weiteren Vorrichtungsteile (230 bis 233) mit elektrischer Energie, wenn diese Energiequellen (250, 251) Energie in den dritten Leitungsabschnitt 245 einspeisen.

Eine fünfte Sicherung 225 kann den fünften Vorrichtungsteil 220 des Versorgungsnetzwerks 200 vom ersten Leitungsabschnitt 240 mittels ihres Leistungsschalters 17 trennen und damit eine Energieversorgung des fünften Vorrichtungsteils 220 unterbinden oder den fünften Vorrichtungsteil 220 des Versorgungsnetzwerks 200 mit dem ersten Leitungsabschnitt 240 mittels ihres Leistungsschalters 17 verbinden und damit eine Energieversorgung des fünften Vorrichtungsteils 220 ermöglichen.

Eine sechste Sicherung 226 kann den sechsten Vorrichtungsteil 221 des Versorgungsnetzwerks 200 vom ersten Leitungsabschnitt 240 mittels ihres Leistungsschalters 17 trennen und damit eine Energieversorgung des sechsten Vorrichtungsteils 221 unterbinden oder den sechsten Vorrichtungsteil 221 des Versorgungsnetzwerks 200 mit dem ersten Leitungsabschnitt 240 mittels ihres Leistungsschalters 17 verbinden und damit eine Energieversorgung des sechsten Vorrichtungsteils 221 ermöglichen.

Eine siebte Sicherung 227 kann den siebten Vorrichtungsteil 222 des Versorgungsnetzwerks 200 vom ersten Leitungsabschnitt 240 mittels ihres Leistungsschalters 17 trennen und damit eine Energieversorgung des siebten Vorrichtungsteils 222 unterbinden oder den siebten Vorrichtungsteil 222 des Versorgungsnetzwerks 200 mit dem ersten Leitungsabschnitt 240 mittels ihres Leistungsschalters 17 verbinden und damit eine Energieversorgung des siebten Vorrichtungsteils 222 ermöglichen.

Eine achte Sicherung 228 kann den achten Vorrichtungsteil 223 des Versorgungsnetzwerks 200 vom ersten Leitungsabschnitt 240 mittels ihres Leistungsschalters 17 trennen und damit eine Energieversorgung des achten Vorrichtungsteils 223 unterbinden oder den achten Vorrichtungsteil 223 des Versorgungsnetzwerks 200 mit dem ersten Leitungsabschnitt 240 mittels ihres Leistungsschalters 17 verbinden und damit eine Energieversorgung des achten Vorrichtungsteils 223 ermöglichen.

Eine neunte Sicherung 235 kann den neunten Vorrichtungsteil 230 des Versorgungsnetzwerks 200 vom zweiten Leitungsabschnitt 241 mittels ihres Leistungsschalters 17 trennen und damit eine Energieversorgung des neunten Vorrichtungsteils 230 unterbinden oder den neunten Vorrichtungsteil 230 des Versorgungsnetzwerks 200 mit dem zweiten Leitungsabschnitt 241 mittels ihres Leistungsschalters 17 verbinden und damit eine Energieversorgung des neunten Vorrichtungsteils 230 ermöglichen.

Eine zehnte Sicherung 236 kann den zehnten Vorrichtungsteil 231 des Versorgungsnetzwerks 200 vom zweiten Leitungsabschnitt 241 mittels ihres Leistungsschalters 17 trennen und damit eine Energieversorgung des zehnten Vorrichtungsteils 231 unterbinden oder den zehnten Vorrichtungsteil 231 des Versorgungsnetzwerks 200 mit dem zweiten Leitungsabschnitt 241 mittels ihres Leistungsschalters 17 verbinden und damit eine Energieversorgung des zehnten Vorrichtungsteils 231 ermöglichen.

Eine elfte Sicherung 237 kann den elften Vorrichtungsteil 232 des Versorgungsnetzwerks 200 vom zweiten Leitungsabschnitt 241 mittels ihres Leistungsschalters 17 trennen und damit eine Energieversorgung des elften Vorrichtungsteils 232 unterbinden oder den elften Vorrichtungsteil 232 des Versorgungsnetzwerks 200 mit dem zweiten Leitungsabschnitt 241 mittels ihres Leistungsschalters 17 verbinden und damit eine Energieversorgung des elften Vorrichtungsteils 232 ermöglichen.

Eine zwölfte Sicherung 238 kann den zwölften Vorrichtungsteil 233 des Versorgungsnetzwerks 200 vom zweiten Leitungsabschnitt 241 mittels ihres Leistungsschalters 17 trennen und damit eine Energieversorgung des zwölften Vorrichtungsteils 232 unterbinden oder den zwölften Vorrichtungsteil 233 des Versorgungsnetzwerks 200 mit dem zweiten Leitungsabschnitt 241 mittels ihres Leistungsschalters 17 verbinden und damit eine Energieversorgung des zwölften Vorrichtungsteils 233 ermöglichen.

Eine dreizehnte Sicherung 255 kann den zwölften Vorrichtungsteil 233 des Versorgungsnetzwerks 200 vom zweiten Leitungsabschnitt 241 mittels ihres Leistungsschalters 17 trennen und damit eine Energieversorgung des zwölften Vorrichtungsteils 232 unterbinden oder den zwölften Vorrichtungsteil 233 des Versorgungsnetzwerks 200 mit dem zweiten Leitungsabschnitt 241 mittels ihres Leistungsschalters 17 verbinden und damit eine Energieversorgung des zwölften Vorrichtungsteils 233 ermöglichen.

Eine dreizehnte Sicherung 255 kann die erste Energiequelle 250 des Versorgungsnetzwerks 200 mittels ihres Leistungsschalters 17 vom dritten Leitungsabschnitt 245 trennen oder die erste Energiequelle 250 des Versorgungsnetzwerks 200 mittels ihres Leistungsschalters 17 mit dem dritten Leitungsabschnitt 245 verbinden. Hierdurch kann die dreizehnte Sicherung 255 die Energieversorgung der an die erste Energiequelle 250 angeschlossenen Teilnetzwerke, hier der Vorrichtungsteile 210 bis 213 und 220 bis 223 und 230 bis 233, durch die ersten Energiequelle 250 mittels Öffnen des ersten Leistungsschalters 17 der dreizehnten Sicherung 255 unterbinden oder die Energieversorgung der an die erste Energiequelle 250 angeschlossenen Teilnetzwerke, hier der Vorrichtungsteile 210 bis 213 und 220 bis 223 und 230 bis 233, durch die ersten Energiequelle 250 mittels Schließen des ersten Leistungsschalters 17 der dreizehnten Sicherung 255 ermöglichen.

Eine vierzehnte Sicherung 256 kann die zweite Energiequelle 251 des Versorgungsnetzwerks 200 mittels ihres Leistungsschalters 17 vom dritten Leitungsabschnitt 245 trennen oder die erste Energiequelle 251 des Versorgungsnetzwerks 200 mittels ihres Leistungsschalters 17 mit dem dritten Leitungsabschnitt 245 verbinden. Hierdurch kann die vierzehnte Sicherung 256 die Energieversorgung der an die zweite Energiequelle 251 angeschlossenen Teilnetzwerke, hier der Vorrichtungsteile 210 bis 213 und 220 bis 223 und 230 bis 233, durch die zweite Energiequelle 251 mittels Öffnen des ersten Leistungsschalters 17 der vierzehnten Sicherung 256 unterbinden oder die Energieversorgung der an die zweite Energiequelle 251 angeschlossenen Teilnetzwerke, hier der Vorrichtungsteile 210 bis 213 und 220 bis 223 und 230 bis 233, durch die zweite Energiequelle 251 mittels Schließen des ersten Leistungsschalters 17 der vierzehnten Sicherung 256 ermöglichen.

In der Figur 2 ist beispielhaft der dritte Vorrichtungsteil 212 mit einer Steckmöglichkeit 262 für die dritte elektronische Sicherung 216 des dritten Vorrichtungsteils 212 versehen. Hierdurch kann beispielsweise eine Werkstatt die dritte elektronische Sicherung 216 manuell beispielsweise im Falle eines Fehlers der Sicherung austauschen. Sofern die Steckmöglichkeit kompatibel zu Schmelzsicherungen ausgeführt ist, kann die beispielsweise eine Werkstatt die dritte elektronische Sicherung 216 durch eine Schmelzsicherung ersetzen. Umgekehrt kann beispielsweise die Werkstatt eine Schmelzsicherung, die sich in der Steckmöglichkeit 262 befindet durch eine dritte elektronische Sicherung 216 ersetzen.

Bevorzugt wären alle Vorrichtungen 210 bis 213 und 220 bis 223 und 230 bis 233 mit einer Steckmöglichkeit für eine elektronische Sicherung wie die Steckmöglichkeit 262 für die elektronische Sicherung 216 des dritten Vorrichtungsteils 212 versehen. Der Nachteil ist, dass solche Steckverbindungen typischerweise zu einer verringerten Zuverlässigkeit zu führen.

Figur 3

Figur 3 zeigt ein Datenbussystem mit einem gestrichelt eingezeichneten Datenbus 9 für das beispielhafte Versorgungsnetzwerk 200 der Figur 2. Jede der elektronischen Sicherungen 214 bis 217 und 225 bis 228 und 235 bis 238 entspricht bevorzugt einer elektronischen Sicherung entsprechend der Figur 1. Daher weist bevorzugt weist jede der elektronischen Sicherungen 214 bis 217 und 225 bis 228 und 235 bis 238 typischerweise eine Steuervorrichtung 4 mit einer Datenschnittstelle 10 auf. Diese Steuervorrichtungen 4 sind in der Figur 3 beilspielhaft mit separaten Bezugszeichen 280 bis 293 je elektronischer Sicherung 214 bis 217 und 225 bis 228 und 235 bis 238 versehen. Das übergeordnete Rechnersystem 12 kommuniziert bevorzugt über die jeweilige Datenschnittstelle 10 der jeweiligen Steuervorrichtung 4 der jeweiligen elektronischen Sicherung der elektronischen Sicherungen 214 bis 217 und 225 bis 228 und 235 bis 238 mit dem jeweiligen Rechnerkern 2 der jeweiligen Sicherung. Dieser jeweilige Rechnerkern 2 der jeweiligen Sicherung kann mittels der Gate-Ansteuerschaltung 16 den Leistungsschalter 17 der jeweiligen Sicherung der elektronischen Sicherungen 214 bis 217 und 225 bis 228 und 235 bis 238 öffnen oder schließen. Vorzugsweise kann das übergeordnete Rechnersystem 12 mittels einer Datenbotschaft an einen Rechnerkern 2 einer Steuervorrichtung 4 einer Sicherung der elektronischen Sicherungen 214 bis 217 und 225 bis 228 und 235 bis 238 diesen Rechnerkern 2 dazu veranlassen, mittels Steuersignalen an die Gate-Ansteuerschaltung 16 der betreffenden elektronischen Sicherung den Leistungsschalter 17 dieser elektronischen Sicherung zu öffnen oder zu schließen. Bevorzugt erfassen die Rechnerkerne 2 der elektronischen Sicherungen 214 bis 217 und 225 bis 228 und 235 bis 238 des Versorgungsnetzwerks 200 mittels Hilfsmittel (16, 520, 530, 525, 23, 24, 21, 25, 505, 905, 920 etc.) Betriebsparameter der zugehörigen elektronischen Sicherung. Ein erster besonders wichtiger Parameter ist typischerweise der elektrische Strom 29 durch den Leistungsschalter 17 der betreffenden elektronischen Sicherung. Bevorzugt erfassen einige Teilvorrichtungen der elektronischen Sicherung einen Strommesswert dieses elektrischen Stroms oder modellieren einen elektrischen Strom, der diesem elektrischen Strom 29 durch den Leistungsschalter 17 proportional ist. Ein weiterer wichtiger Parameter, den die Rechnerkerne 2 der elektronischen Sicherungen 214 bis 217 und 225 bis 228 und 235 bis 238 bevorzugt mit weiteren Hilfsvorrichtungen dieser Sicherungen jeweils sicherungsspezifisch ermitteln sind vorzugsweise die Spannung zwischen dem ersten Anschluss 18 der betreffenden elektronischen Sicherung und dem Bezugspotenzial 201 und/oder die Spannung zwischen dem zweiten Anschluss 19 der betreffenden elektronischen Sicherung und dem Bezugspotenzial und/oder weitere Spannungen zwischen internen elektrischen Konten und/oder externen elektrischen Knoten der jeweiligen elektronischen Sicherung der elektronischen Sicherungen 214 bis 217 und 225 bis 228 und 235 bis 238. Bevorzugt übermitteln die Rechnerkerne 2 der Steuervorrichtungen 4 einiger oder besser aller elektronischen Sicherungen der elektronischen Sicherungen 214 bis 217 und 225 bis 228 und 235 bis 238 einen Teil oder alle diese Messwerte an das übergeordnete Rechnersystem 2 über den Datenbus 9. Das übergeordnete Rechnersystem 12 kann diese Daten dann auswerten. Beispielsweise ist das übergeordnete Rechnersystem dann in der Lage, durch Anwendung der Kirchhoffschen Maschen und Knotenregeln den Spannungsabfall über einen Leitungsabschnitt der Leitungsabschnitte 240 bis 245 zu ermitteln. Um einen Masseversatz zu vermeiden, wenn die Karosserie als Rückleitung des elektrischen Stromes benutzt wird, ist es vorteilhaft, wenn die Bezugspotenzialleitung im Wesentlichen stromfrei ist. Eine solche zusätzliche Bezugspotenzialleitung lässt sich jedoch in der Regel aus Kostengründen nicht realisieren. Daher ist es sinnvoll, wenn eine oder mehrere oder besser jede der Sicherungen jeweils dazu eingerichtet sind, einen Masseversatz der Bezugspotenzialleitung 201 beispielsweise durch Erfassung eines Ruhepotenzials des Datenbusses 9 zu Zeiten, in denen der Datenbus nicht benutzt wird, zu erfassen. Es ist offensichtlich, dass eine Steuervorrichtung 4 einer Sicherung der elektronischen Sicherungen 214 bis 217 und 225 bis 228 und 235 bis 238 mit ihrem rechnerkern 2 die Rolle des übergeordneten Rechnersystems 12 übernehmen kann. In dem Fall wäre anders als in der Figur 3 dargestellt kein separates übergeordnetes Rechnersystem 12 mehr notwendig.

Im beispielhaften Unterschied zur Figur 2 speist der erste Vorrichtungsteil 210 nun den ersten Leitungsabschnitt 240, der nur noch den fünften Vorrichtungsteil 220 und den sechsten Vorrichtungsteil 221 mit elektrischer Energie aus den Energiequellen 250 und 251 über die erste Sicherung 214 des ersten Vorrichtungsteils 210 versorgt.

Im beispielhaften Unterschied zur Figur 2 speist der zweite Vorrichtungsteil 211 nun einen vierten Leitungsabschnitt 242, der an Stelle des ersten Leitungsabschnitts 240 nun den siebten Vorrichtungsteil 222 und den achten Vorrichtungsteil 223 mit elektrischer Energie aus den Energiequellen 250 und 251 über die zweite Sicherung 215 des zweiten Vorrichtungsteils 211 versorgt.

Im beispielhaften Unterschied zur Figur 2 speist der dritte Vorrichtungsteil 212 nun den zweiten Leitungsabschnitt 241, der nur noch den neunten Vorrichtungsteil 230 und den zehnten Vorrichtungsteil 231 mit elektrischer Energie aus den Energiequellen 250 und 251 über die dritte Sicherung 216 des dritten Vorrichtungsteils 212 versorgt.

Im beispielhaften Unterschied zur Figur 2 speist der vierte Vorrichtungsteil 213 nun einen fünften Leitungsabschnitt 243, der an Stelle des zweiten Leitungsabschnitts 241 nun den elften Vorrichtungsteil 232 und den zwölften Vorrichtungsteil 233 mit elektrischer Energie aus den Energiequellen 250 und 251 über die vierte Sicherung 217 des vierten Vorrichtungsteils 213 versorgt.

Wird nun ein einzelner der Leistungsschalter 17 einer einzelnen der Scherung der Sicherungen 214 bis 217 durch ihren Rechnerkern 2 ihrer Steuervorrichtung 4 geöffnet, so versorgen die Energiequellen 250 und 251 das dieser Sicherung nachgelagerte Teilnetzwerk nicht mehr mit elektrischer Energie. Bevorzugt weisen die Sicherungen eine Stand-By-Fähigkeit auf, die eine begrenzte Lieferung elektrischer Energie für den Zweck eines Stand-By-Betriebes weiterhin zulässt.

Figur 4

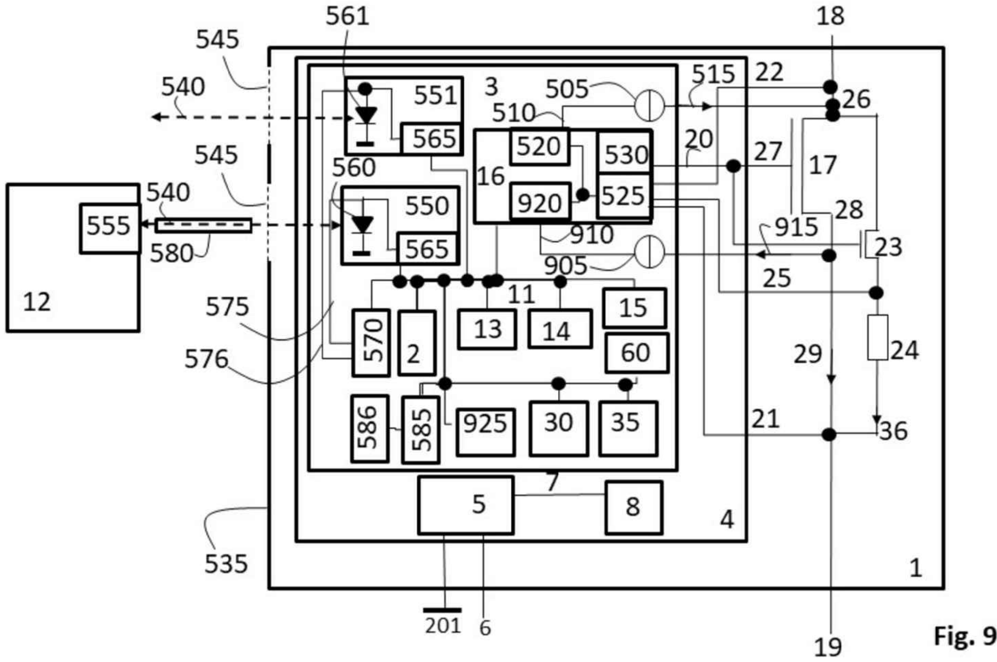

Figur 4 zeigt schematisch vereinfacht eine beispielhafte Sicherungsbox 400 mit Steckplätzen 410 und 420 für die Aufnahme von elektronischen Sicherungen 405 und Schmelzsicherungen 415. Ein Steckplatz 410 für eine elektronische Sicherung 405 weist vorzugsweise einen ersten Kontakt 430 für den ersten Anschluss 18 des Leistungsschalters 17 der dort einsteckbaren elektronischen Sicherung 405 auf. Der Steckplatz 410 für eine elektronische Sicherung 405 weist des Weiteren bevorzugt einen zweiten Kontakt 435 für den Betriebsspannungsanschluss 6 der elektronischen Sicherung 405 auf. Hierbei ist die Voraussetzung, dass die elektronische Sicherung 405 die Betriebsspannung zu ihrem Betrieb nicht aus dem Potenzial an ihrem ersten Anschluss 18 ihres Leistungsschalters 17 ableitet. In dem Fall entfällt die Notwendigkeit für den zweiten Kontakt 435, da diese Funktion dann der erste Kontakt 430 übernehmen kann. Der Steckplatz 410 für eine elektronische Sicherung 405 weist des Weiteren bevorzugt einen dritten Kontakt 475 für den Bezugspotenzialanschluss 201 der elektronischen Sicherung 405 auf. Der Steckplatz 410 für eine elektronische Sicherung 405 weist des Weiteren bevorzugt einen vierten Kontakt 440 für den Anschluss des externen Datenbusses 9 der elektronischen Sicherung 405 auf. In dem Beispiel der Figur 9 ist der Datenbus 9 ein sogenannter Eindrahtdatenbus, bei dem die Rückleitung des Datenbusses typischerweise identisch mit der Bezugspotenzialleitung 201 ist. Der hier vorgestellte Datenbus 9 ist somit typischerweise ein Sicherungsdatenbus 9 oder ein Fuse-Datenbus 9. Im Automobilbereich ist der Datenbus 9 beispielsweise ein Lin-Datenbus 9 oder ein DSI3-Datenbus 9 oder ein PSI5-Datenbus 9 oder ein CAN-Datenbus 9 oder ein CAN-FD-Datenbus 9 oder ein Ethernet-Datenbus oder ein Flexray-Datenbus 9 oder ein LVDS-Datenbus 9 oder eine sonst wie drahtgebundene oder drahtlose Datenübertragungsstrecke, beispielsweise über eine Bluetooth- oder eine WLAN-Datenverbindung oder eine optische Datenverbindung (540). Die Datenkommunikation des Rechnerkerns 2 der Steuervorrichtung 4 der Sicherung 1 läuft dabei über eine drahtgebundene oder drahtlose Schnittstelle (610, 10, 551, 550) ab.

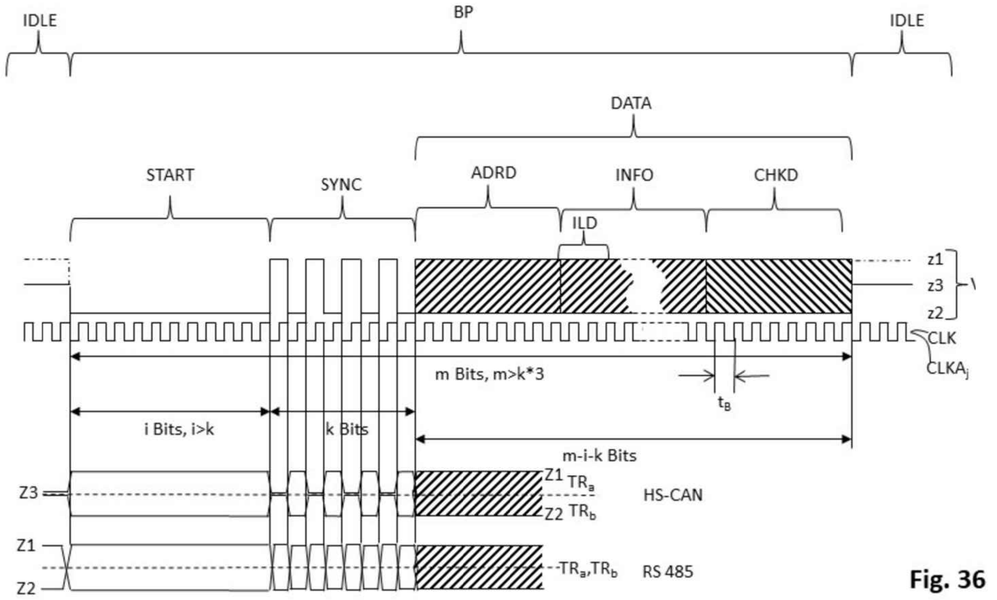

Es ist insbesondere denkbar, dass der Datenbus 9 ein differenzieller Datenbus 9 ist. In dem Fall umfasst der Kontakt 440 des Datenbusses 9 in der Realität einen ersten elektrischen Kontakt für die erste Leitung des differentiellen Zweidrahtdatenbusses und einen zweiten elektrischen Kontakt für die zweite Leitung des differenziellen Zweidrahtdatenbusses. Ein solcher differenzieller Zweidrahtdatenbus kann beispielsweise ein CAN- Datenbus und/oder ein CAN-FD-Datenbus sein, der als Datenbus 9 eingesetzt wird. Da das CAN-Datenbusprotokoll bzw. das CAN-FD-Datenbus-Protokoll einen sehr guten lokalen Oszillator erfordert, würde die Verwendung eines CAN-Datenbusses bzw. eines CAN-FD-Datenbusses zu einem erhöhten Aufwand für die Takterzeugung in jeder einzelnen Sicherung führen, was die Kosten eines solchen Datenbussystems explodieren lassen würde. Die hier vorgestellte Schrift schlägt daher für einen solchen Fall eines differenziellen Sicherungsdatenbusses 9 die Verwendung eines CAN-Physical-Layers mit einem speziellen Sicherungsdatenprotokoll vor. Hierzu signalisiert das übergeordnete Rechnersystem 12 über den Datenbus 9 den Oszillatoren 30 der Steuervorrichtungen 4 der elektronischen Sicherungen 405 ein Synchronisationssignal. Bevorzugt handelt es sich bei dem Synchronisationssignal um einen sogenannten Clock-Run-In bei dem beispielsweise ein übergeordnetes Rechnersystem beispielsweise für eine kurze Zeit eine vordefinierte alternierende 1-0-Bitfolge vom übergeordneten Rechnersystem 12 beispielsweise an ein oder mehrere oder alle Steuervorrichtungen 4 elektronischer Sicherungen 405 des Versorgungsnetzwerks 200 sendet. (In den Figuren 2 und 3 wären diese die elektronischen Sicherungen 214 bis 217 und 225 bis 225 und 235 bis 238 und255 und 256). Die Steuervorrichtungen 4 synchronisieren ihre Oszillatoren 30 vorzugsweise in Frequenzbetrag und Phasenlage auf dieses Synchronisationssignal. Ein Datenpaket weist bevorzugt ein Startsignal auf. Typischerweise ist das Startsignal so gestaltet, dass es von der Datenschnittsteller 10 der Steuervorrichtung 4 einer elektronischen Sicherung 405 auch dann erkannt wird, wenn der lokale Oszillator 30 der Steuervorrichtung 4 betreffenden elektronischen Sicherung nicht synchron zum Oszillator des übergeordneten Rechnersystems 12 ist. Die Oszillatoren 30 der Steuervorrichtungen 4 der Sicherungen 405 stellen jeweils den Steuervorrichtungen 4, deren teil diese Oszillatoren 30 jeweils sind, zumindest einen jeweiligen Takt zum Betrieb dieser jeweiligen Steuervorrichtung 4 bereit. Typischerweise erzeugen die Datenschnittstelle 10 oder eine andere Teilvorrichtung der Steuervorrichtung 4 einer elektronischen Sicherung 405 aus diesem Takt einen Abtasttakt, mit dem die Datenschnittstelle 10 die logischen Werte auf dem Datenbus 9 abtastet, wenn sie Daten über den Datenbus von dem übergeordneten Rechnersystem oder von der Steuervorrichtung 4 einer anderen Sicherung oder einer anderen an den Datenbus 9 angeschlossenen Vorrichtung empfängt. Bevorzugt versendet der sendende Busteilnehmer werden die Daten über den Datenbus als Datenpaket mit m Datenbits. Bevorzugt beginnt ein solches Datenpaket mit einem Startsignal. Mit der Detektion des Startsignals durch eine Datenschnittstelle 10 einer Sicherung 405 beginnt die Synchronisationsphase für den Oszillator 30 dieser Sicherung 405. Nach der Synchronisation des Oszillators 30 friert die Steuervorrichtung 4 bevorzugt die Frequenz- und Phasenregelung ihres Oszillators 30 ein. Die Datenschnittstelle 10 tastet dann die folgenden Bits bis zum Ende des Datenpakets mit konstanter Frequenz und Phase des Takts des Oszillators 30 der Steuervorrichtung 4 ab. Das Ende des Datenpakets erkennt die Datenschnittstelle 10 der Steuervorrichtung 4 einer Sicherung 405 bevorzugt mit Hilfe eines Stopp-Symbols am Ende des Datenpakets. Das Ende der Synchronisationsphase erkennt die Datenschnittstelle bevorzugt an einem Startsymbol. Dies ist bevorzugt eine vordefinierte Bitfolge. Bevorzugt erlaubt die Datenschnittstelle das Erkennen eines solchen Startsymbols erst eine vorbestimmte Zeit nach dem Beginn der Synchronisationsphase. Bevorzugt endet die Regelung von Frequenz und Phase des Oszillators 30 einer Steuervorrichtung 4 einer elektronischen Sicherung 405 mit diesem Zeitablauf. Die Erzeugung des Abtasttakts der Datenschnittstelle 10 aus diesem Takt des Oszillators 30. Das hier vorgelegte Dokument offenbart dementsprechend eine Vorrichtung zur Ansteuerung elektrischer und/oder elektronischer Datenschnittstellen 10 von Steuervorrichtungen 4 von Sicherungen eines Versorgungsnetzwerks 200 mit einem seriellen, bidirektionalen, differentiellen Datenbus 9 und mit n Datenschnittstellen 10 von n Steuervorrichtungen 4 von n Sicherungen mit n als ganzer positiver Zahl größer 1 und mit einem übergeordneten Rechnersystem 12. Der serielle, bidirektionale, differentielle Datenbus 9 weist dabei einen ersten Eindrahtdatenbus und einen zweiten Eindrahtdatenbus auf. Der Spannungswert zwischen dem ersten Eindrahtdatenbus und dem zweiten Eindrahtdatenbus repräsentiert typischerweise die ggf. übertragene logische Information - das ggf. vorhandene Datum. Bevorzugt weist jede der n Sicherungen zumindest eine differentielle, serielle Datenbusschnittstelle 10 als Teil ihrer jeweiligen Steuervorrichtung 4 auf. Jede Steuervorrichtung 4 jeder dieser Sicherungen umfasst bevorzugt einen Oszillator 30 der einen Sicherungsspezifischen Takt CLKj zum Betrieb der Steuervorrichtung 4 dieser Sicherung - hier die j-te Sicherung genannt - erzeugt. Bevorzugt umfasst die jeweilige Datenschnittstelle 10 einer Steuervorrichtung 4 einer Sicherung eine Abtastvorrichtung, die den Datenbus 9 mit einem Abttasttakt abtastet, der aus dem Takt des Oszillators 30 der Steuervorrichtung 4 dieser Sicherung vorzugsweise abgeleitet ist. Bevorzugt umfasst die Steuervorrichtung 4 einer Sicherung eine Adresserkennungseinheit und ein Sicherungsadressregister. Hierbei können beispielsweise die Datenbusschnittstelle 10 oder der Rechnerkern 2 das Sicherungsadressregister umfassen. Der serielle, bidirektionale, differentielle Datenbus 9 kann sich bevorzugt zumindest in einem ersten differentiellen logischen Zustand (High, z1) und in einem zweiten differentiellen logischen Zustand (Low, z2) befinden. Die serielle Datenbusschnittstelle 10 der Steuervorrichtung 4 der mindestens einen Sicherung der n Sicherungen ist jeweils mit dem seriellen, bidirektionalen, differentiellen Datenbus 9 verbunden, um Daten über diesen seriellen, bidirektionalen, differentiellen Datenbus 9 zu senden und/oder über diesen Datenbus 9 von anderen Rechnerkernen 2 anderer Steuervorrichtungen 4 anderer Sicherungen oder einem übergeordneten Rechnersystem 12 zu empfangen. Typischerweise erhält die übergeordnete Steuervorrichtung 12 auch von extern Steuerbefehle zur Steuerung der n Sicherungen. Typischerweise setzt die übergeordnete Steuervorrichtung 12 diese von Extern initiierten Steuerbefehle in über den seriellen, bidirektionalen, differentiellen Datenbus 9 an die Rechnerkerne 2 der Steuervorrichtungen 4 der Sicherungen über deren Datenbusschnittstellen 10 zu versendende Bitströme und Busstrompakete BP um. Das übergeordnete Rechnersystem 12 sendet dann typischerweise in Abhängigkeit von einem Takt CLK innerhalb des übergeordneten Rechnersystems 12 die Bits der durch das übergeordnete Rechnersystem 12 zu versendenden Bitströme und Bitstrompakete über den seriellen, bidirektionalen, differentiellen Datenbus 9 Das übergeordnete Rechnersystem 12 empfängt von den Rechnerkernen 2 der Steuervorrichtungen 4 der elektronischen Sicherungen erzeugte Bitströme und/oder Bitstrompakete BP über den seriellen, bidirektionalen, differentiellen Datenbus 9. Der jeweilige Oszillator 30 der jeweiligen Steuervorrichtung 4 der jeweiligen Sicherung erzeugt typischerweise aus dem jeweiligen Takt des jeweiligen Oszillators 30 der jeweiligen Steuervorrichtung 4 der jeweiligen Sicherung bevorzugt ein jeweiliges Abtastsignal CLKAj für die jeweilige Datenbusschnittstelle 10 Steuervorrichtung 4 der jeweiligen Sicherung. Die Abtastvorrichtung ATj der jeweiligen Datenbusschnittstelle 10 der jeweiligen Steuervorrichtung 4 der jeweiligen Sicherung tastet dann vorzugsweise in Abhängigkeit von ihrem jeweiligen Abtastsignal CLKAj des Oszillators 30 der Steuervorrichtung 4 dieser Sicherung die über den seriellen, bidirektionalen, differentiellen Datenbus 9 versendeten Bitströme und/oder Bitstrompakete BP ab, um in der jeweiligen Steuervorrichtung 4 der jeweiligen elektronischen Sicherung einen lokalen Bitstrom aus dem empfangenen Bitstrom und/oder Bitstrompaket BP zu gewinnen. Das übergeordnete Rechnersystem 12 versendet bevorzugt die zu versendeten Bitströme als Folgen von Bits in Bit-Strom-Paketen (englisch Frames, BP). Gemäß der technischen Lehre des hier vorgelegten Dokuments umfassen die Bit-Strom-Pakete BP eine zeitliche Abfolge von m Einzelbits des Bit-Strom-Pakets BP mit gleicher zeitlicher Länge $t_B$. Hierbei ist m eine ganze, positive Zahl. Die zeitliche Länge $t_B$ der Einzelbits variiert dabei um nicht mehr als einen Faktor von +/- $(0,4/m)*t_B$ innerhalb eines Bit-Strom-Pakets BP. Nach dem Ende der Synchronisationsphase für ein Bitstrompaket tatet die Abtastvorrichtung der Datenbusschnittstelle 10 einer Steuervorrichtung 4 einer Sicherung die Einzelbits auf dem Datenbus 9 bevorzugt in deren zeitlicher Mitte ab. Danach ist die Regelung der Frequenz und Phasenlage des Taktsignals, das der Oszillator 10 erzeugt und/oder des Abtastsignals CLKj für den Rest des Empfangs des Bitstrompakets BP eingefroren. Bevorzugt weicht die zeitliche Länge von m Perioden des Abtastsignals CLKj um nicht mehr als +/- $(0,4/m)*t_B$ von der Länge $m*t_B$ von m Einzelbits eines empfangenen Bitstrompakets ab, sodass die Abtastvorrichtung der Datenbusschnittstelle 10 der Steuervorrichtung 4 der elektronischen Sicherung auch das letzte Einzelbit noch zuordnungsgerecht abtastet und eine Doppelabtastung eines Einzelbits oder eine Nichtabtastung eines Einzelbits nicht stattfindet. Damit dies möglich ist, weist bevorzugt zumindest ein Teil der von dem übergeordneten Rechnersystem 12 versendeten Bit-Strom-Pakete BP folgende Inhalte auf (siehe auch Figur 36):

- Ein Startsignal START in Form von i Bits mit i als ganzer positiver Zahl mit i-1>m der m Bits des jeweiligen Bit-Strom-Paketes BP mit einem zweiten differentiellen logischen Zustand z2 auf dem seriellen, bidirektionalen, differentiellen Datenbus 9;
- eine Synchronisationsinformation SYNC aus k Synchronisationsbits, mit k als positiver ganzer Zahl und k<m/3, zur Synchronisation des jeweiligen Abtastsignals CLKAj der jeweiligen Abtastvorrichtung der jeweiligen Datenbusschnittstelle 10 der jeweiligen Steuervorrichtung 4 der jeweiligen elektronischen Sicherung und/oder des jeweiligen Oszillators 30 der jeweiligen Steuervorrichtung 4 der jeweiligen Sicherung mit dem Takt CLK des übergeordneten Rechnersystems 12;
- Dateninformationen DATA aus den restlichen Bits der m-i-k Bits der m Bits des jeweiligen Bit-Strom-Paketes BP, wobei die Dateninformationen vorzugsweise DATA Adressinformationen ADRD und Nutzinformationen INFO und Prüfinformationen CHKD umfassen.

Bei den Prüfinformationen CHKD kann es sich beispielsweise um CRC-Checksummen und/oder Parity-Bits handeln. Zumindest ein Teil der Nutzinformationen INFO umfasst bevorzugt Konfigurationsinformationen ILD. Diese Konfigurationsinformationen ILD können beispielsweise Schwellwerte und Werte von Abschaltschwellen umfassen, die ggf. beispielsweise bestimmen können, wann der Rechnerkern 2 einer Steuervorrichtung 4 einer elektronischen Sicherung den Leistungsschalter 17 dieser elektronischen Sicherung öffnet oder schließt. Bevorzugt übermittelt das übergeordnete Rechnersystem 12 den Rechnerkernen 2 der Steuervorrichtungen 4 der Sicherungen mittels dieser Konfigurationsinformationen ILD Konfigurationsbefehle über den Sicherungsdatenbus 9. Beispielsweise können solche Konfigurationsbefehle von einem ermittelten Energiebedarf von Verbrauchern in Teilnetzwerken des Versorgungsnetzwerks 200 und von einer ermittelten Energielieferfähigkeit von Energiequellen in Teilnetzwerken des Versorgungsnetzwerks 200 abhängen. Solche Konfigurationsbefehle in diesen Konfigurationsinformationen ILD können beispielsweise ggf. das Öffnen und Schließen von Leistungsschaltern 17 elektronischer Sicherungen des Versorgungsnetzwerks 200 durch die Rechnerkerne 2 dieser elektronischen Sicherungen bewirken. Bevorzugt passt das übergeordnete Rechnersystem 12 mittels solcher Konfigurationsbefehle über den Sicherungsdatenbus 9 an die Sicherungen des Versorgungsnetzwerks 200 die elektrisch wirksame Topologie des Versorgungsnetzes 200 der Versorgungsleitungen dynamisch entsprechend dem ermittelten Energiebedarf und/oder entsprechend der ermittelten Energielieferfähigkeit und/oder entsprechend dem aktuellen Sicherheitsbedarf an. Die Rechnerkerne 2 der Steuervorrichtungen 4 elektronischer Sicherungen empfangen und Senden somit über ihre jeweilige Datenschnittstelle 10 der jeweiligen Steuervorrichtung 4 der jeweiligen elektronischen Sicherung Daten über den Datenbus, wobei diese Daten Konfigurationsinformationen ILD wie beispielsweise Konfigurationsdaten (Schreiben/Lesen) und/oder Schaltbefehle (Schreiben/Lesen), aber auch Diagnosedaten (Schreiben/Lesen), Messwerte (Lesen), Vergleichswerteinstellungen (Schreiben/Lesen) umfassen können. Bevorzugt ist der Datenbus 9 direkt oder indirekt, z.B. über Gateways oder dergleichen, mit einem Terminal (740) für eine Eingabe zur Umkonfiguration des Versorgungsnetzwerks 200 mittels der elektronischen Sicherungen verbunden. Das übergeordnete Rechnersystem 12 passt im Falle eines Systemnotlaufszenarios die Stromaufnahme eines Verbrauchers der Verbraucher des Versorgungsnetzwerks 300 an die schwächste Versorgungsleitung im Pfad zwischen einer oder mehreren Energiequellen der Energiequellen des Versorgungsnetzwerks 200 einerseits und diesem Verbraucher der Verbraucher andererseits durch Umkonfiguration oder Betriebsparameteränderung dieses Verbrauchers an. Darüber hinaus passt das übergeordnete Rechnersystem 12 im Falle eines Systemnotlaufszenarios die Stromlieferfähigkeit einer Energiequelle der Energiequellen des Versorgungsnetzwerks 200 an die schwächste Versorgungsleitung im Pfad zwischen dieser Energiequelle der Energiequellen des Versorgungsnetzwerks 200 einerseits und Verbrauchern der Verbraucher des Versorgungsnetzwerks 200 durch Umkonfiguration oder Betriebsparameteränderung dieser Energiequelle der Energiequellen des Versorgungsnetzwerks 200 an. Dabei initiiert das übergeordnete Rechnersystem 12 eine Konfigurationsänderung des Versorgungsnetzwerks 200 durch entsprechende Befehle über einen oder mehrere Datenbusse 9 an elektronische Sicherungen des Versorgungsnetzwerks 200. Das übergeordnete Rechnersystem 12 ermittelt bevorzugt zum Ersten, wieviel ein Verbraucher der Verbraucher des Versorgungsnetzwerks 200, der von der Konfigurationsänderung des Versorgungsnetzwerks 200 betroffen ist, an Energie verbrauchen darf, um das Versorgungsnetzwerk 200 an keiner Stelle zu überlasten. Das übergeordnete Rechnersystem 12 teilt dann vorzugsweise diesem betreffenden Verbraucher der Verbraucher des Versorgungsnetzwerks 200 mitteilt, wieviel Energie dieser Verbraucher der Verbraucher des Versorgungsnetzwerks 200 aus dem Versorgungsnetzwerk 200 aufnehmen darf. Zum Zweiten ermittelt bevorzugt das übergeordnete Rechnersystem 12, wieviel eine Energiequelle der Energiequelle der Energiequellen des Versorgungsnetzwerks 200, die von der Konfigurationsänderung des Versorgungsnetzes 200 betroffen ist, an Energie liefern darf, um das Versorgungsnetzwerk 200 an keiner Stelle zu überlasten. Das übergeordnete Rechnersystem 12 teilt bevorzugt dieser betreffenden Energiequelle der Energiequellen des Versorgungsnetzwerks 200 mit, wieviel Energie diese Energiequelle der Energiequellen des Versorgungsnetzwerks 200 liefern darf.

Somit dienen die Konfigurationsinformationen ILD vorzugsweise zur Steuerung der Energieversorgung der Vorrichtungteile und zur Steuerung der Energieentnahme aus den Energiequellen und zur Steuerung der Belastung der Versorgungsleitungen des Versorgungsnetzwerks 200. Diese Steuerung erfolgt entsprechend der technischen Lehre des hier vorgelegten Dokuments durch den Rechnerkern 2 einer Steuervorrichtung 4 einer elektronischen Sicherung des Versorgungsnetzwerks 200 bevorzugt in Abhängigkeit von diesen Konfigurationsinformationen ILD eines Bit-Strom-Pakets BP, wenn der logische Inhalt der Adressinformationen ADRD dieses bit-Strom-Pakets BP mit dem Inhalt des Sicherungsadressregisters des Rechnerkerns 2 bzw. der Datenbusschnittstelle 10 der Steuervorrichtung 4 der Sicherung übereinstimmt. Hierbei werten die jeweiligen Adresserkennungseinheiten der jeweiligen Datenbusschnittstellen 10 bzw. der Rechnerkerne 2 der Steuervorrichtungen 4 der elektronischen Sicherungen die Adressinformationen ADRD der Bit-Strom-Pakete BP aus und lassen nur dann eine Verwendung der in dem betreffenden Bit-Strom-Paket BP enthaltenen Nutzinformationen INFO durch den jeweiligen Rechnerkern 2 der jeweiligen Steuervorrichtung 4 der jeweiligen Sicherung zu, wenn der Inhalt der Adressinformationen ADRD des Bit-Strom-Pakets BP mit dem aktuellen Inhalt des Sicherungsadressregisters der betreffenden Sicherung korrespondiert. Bevorzugt weisen die Steuerungsvorrichtungen 4 der elektronischen Sicherungen und deren Datenschnittstellen 10 Mittel auf, um ein Autoadressierungsverfahren durchzuführen, um das Sicherungsadressregister mit einer logischen Sicherungsadresse zu füllen, die mit der physikalischen Position dieser Sicherung innerhalb des seriellen, bidirektionalen, differentiellen Datenbusses 9 korrespondiert. Bevorzugt schließen das übergeordnete Rechnersystem 12 und/oder Rechnerkerne 2 von Steuervorrichtungen 4 von Sicherungen aufgrund der Auswertung der empfangenen Prüfinformationen CHKD auf einen nicht korrekt laufenden Oszillators 30 einer oder mehrerer Sicherungen. Ggf. regeln diese Sicherungen dann ihre Oszillatoren 30 nach. Bevorzugt weisen die Oszillatoren 30 der Steuervorrichtungen 4 der Sicherungen 405 eines Versorgungsnetzwerks 200 jeweils eine Frequenzstabilität nach der Synchronisation dieser Oszillatoren 30 mit dem Synchronisationssignal SYNC in der Synchronisationsphase auf, die so groß ist, dass ein solcher Fehler im CRC-Check nicht auftreten sollte.

Vorzugsweise weist der Steckplatz 410 einer elektronischen Sicherung 405 der Sicherungsbox 400 einen ersten Kontakt 430 für den ersten Anschluss 18 des Leistungsschalters 17 der elektronischen Sicherung 405 auf. Dieser erste Kontakt 430 ist bevorzugt mit der Energiequelle 250 über den dritten Versorgungsleitungsabschnitt 245 zur Energieversorgung der entsprechenden, durch diese Sicherung 405 abgesicherten Versorgungsleitung 485 verbunden. Der erste Kontakt 430 des Steckplatzes 410 für die elektronische Sicherung 405 dient bevorzugt dem Anschluss des ersten Anschlusses 18 der elektronischen Sicherung 405. Der erste Kontakt 450 des Sicherungskörpers 425 korrespondiert zu dem ersten Kontakt 430 des Steckplatzes 410 der elektronischen Sicherung 405 der Sicherungsbox 400. Der erste Kontakt 450 des Sicherungskörpers 425 dient dem Anschluss des ersten Anschlusses 18 der elektronischen Sicherung 405.

Vorzugsweise weist der Steckplatz 410 einer elektronischen Sicherung 405 der Sicherungsbox 400 einen zweiten Kontakt 445 für den zweiten Anschluss 19 des Leistungsschalters 17 der elektronischen Sicherung 405 auf. Dieser zweite Kontakt 445 ist bevorzugt mit dem korrespondierenden Ausgang 485 der Sicherungsbox 400 zur Versorgung eines Verbrauchers des Versorgungsnetzwerks 200 über einen nachfolgenden Versorgungsleitungsabschnitt der Versorgungsleitungsabschnitte (240 bis 243) des Versorgungsnetzwerks 200 elektrisch verbunden. Der zweite Kontakt 445 des Steckplatzes 410 für die elektronische Sicherung 405 dient bevorzugt dem Anschluss des zweiten Anschlusses 19 der elektronischen Sicherung 405. Der zweite Kontakt 470 des Sicherungskörpers 425 korrespondiert zu dem zweiten Kontakt 445 des Steckplatzes 410 der elektronischen Sicherung 405 der Sicherungsbox 400. Der zweite Kontakt 470 des Sicherungskörpers 425 dient dem Anschluss des zweiten Anschlusses 19 der elektronischen Sicherung 405.

Vorzugsweise weist der Steckplatz 410 einer elektronischen Sicherung 405 der Sicherungsbox 400 einen dritten Kontakt 440 für den Anschluss des Datenbusses 9 der Datenbusschnittstelle 10 der Steuervorrichtung 4 der elektronischen Sicherung 405 auf. Dieser dritte Kontakt 440 ist bevorzugt mit dem Datenbus 9 der Sicherungsbox 400 und des Versorgungsnetzwerks 200 datentechnisch verbunden. Der dritte Kontakt 440 des Steckplatzes 410 für die elektronische Sicherung 405 dient bevorzugt dem Anschluss des Datenbusses 9 an die Datenbusschnittstelle 10 der Steuervorrichtung 4 der elektronischen Sicherung 405. Der dritte Kontakt 465 des Sicherungskörpers 425 korrespondiert zu dem dritten Kontakt 440 des Steckplatzes 410 der elektronischen Sicherung 405 der Sicherungsbox 400. Der dritte Kontakt 465 des Sicherungskörpers 425 dient dem Anschluss des Datenbusses 9 des Versorgungsnetzwerks 200 an die Datenschnittstelle 10 der Steuerungsvorrichtung 4 der elektronischen Sicherung 405.

Vorzugsweise weist der Steckplatz 410 einer elektronischen Sicherung 405 der Sicherungsbox 400 einen vierten Kontakt 435 für den Anschluss einer Versorgungsspannungsleitung zur Energieversorgung der Steuervorrichtung 4 der elektronischen Sicherung 405 auf. Dieser vierte Kontakt 435 ist bevorzugt mit der Versorgungsspannungsleitung zur Energieversorgung der Steuervorrichtung 4 der elektronischen Sicherung 405 elektrisch verbunden. Die Versorgungsspannungsleitung ist beispielsweise über einen dritten Versorgungsleitungsabschnitt 245 mit einer Energiequelle 250 verbunden. Der vierte Kontakt 435 des Steckplatzes 410 für die elektronische Sicherung 405 dient bevorzugt dem Anschluss der Versorgungsspannungsleitung zur Energieversorgung der Steuervorrichtung 4 der elektronischen Sicherung 405. Der vierte Kontakt 455 des Sicherungskörpers 425 korrespondiert zu dem vierten Kontakt 435 des Steckplatzes 410 der elektronischen Sicherung 405 der Sicherungsbox 400. Der vierte Kontakt 455 des Sicherungskörpers 425 dient dem Anschluss der Energiequelle 250 mittels des beispielhaften, dritten Versorgungsleitungsabschnitts 245 an die Versorgungsspannungsleitung zur Energieversorgung der Steuervorrichtung 4 der elektronischen Sicherung 405.

Vorzugsweise weist der Steckplatz 410 einer elektronischen Sicherung 405 der Sicherungsbox 400 einen fünften Kontakt 475 für den Anschluss einer Versorgungsspannungsleitung 201 - hier der Bezugspotenzialleitung 201 - zur Energieversorgung der Steuervorrichtung 4 der elektronischen Sicherung 405 auf. Dieser fünfte Kontakt 475 ist bevorzugt mit der Versorgungsspannungsleitung 201 zur Energieversorgung der Steuervorrichtung 4 der elektronischen Sicherung 405 elektrisch verbunden. Die Versorgungsspannungsleitung - hier die Bezugspotenzialleitung 201 - ist beispielsweise über die Karosserie des Fahrzeugs mit der Energiequelle 250 verbunden. Der fünfte Kontakt 475 des Steckplatzes 410 für die elektronische Sicherung 405 dient bevorzugt dem Anschluss der zweiten Versorgungsspannungsleitung - hier der Bezugspotenzialleitung 201 - zur Energieversorgung der Steuervorrichtung 4 der elektronischen Sicherung 405. Der fünfte Kontakt 460 des Sicherungskörpers 425 korrespondiert zu dem fünften Kontakt 475 des Steckplatzes 410 der elektronischen Sicherung 405 der Sicherungsbox 400. Der fünfte Kontakt 460 des Sicherungskörpers 425 dient dem Anschluss der Bezugspotenzialleitung 201 der Energiequelle 250 an die Versorgungsspannungsleitung - hier die Bezugspotenzialleitung 201 - zur Energieversorgung der Steuervorrichtung 4 der elektronischen Sicherung 405. Der fünfte Kontakt 460 des Sicherungskörpers 425 dient der Steuervorrichtung 4 der elektronischen Sicherung 405 vorzugsweise als Referenzpotenzialpunkt.

Eine Betriebsspannungsquelle 480 für den Betrieb der Steuervorrichtungen 4 der elektronischen Sicherungen 405 speist die elektrische Energie zum Betreiben der Steuervorrichtungen 4 der Sicherungen 405 in die Versorgungsspannungsleitung für die Betriebsspannung 6 ein. Als Rückleitung dient hier vorzugsweise wieder die Karosseriemasse der Bezugspotenzialleitung 201 dar.

Vorzugsweise sind die Steckplätze 420 für die Schmelzsicherungen 415 so ausgeführt, dass diese zumindest mechanisch zu den Steckplätzen 410 kompatibel sind. Bevorzugt sind die Steckplätze 410 für die elektronischen Sicherungen 405 so ausgeführt, dass die Fertigung und/oder Wartungs- und/oder Reparaturarbeiten diese alternativ auch mit konventionellen Schmelzsicherungen 415 bestücken können. Bevorzugt sind die Schmelzsicherungen 415 mechanisch so ausgeführt, dass sie mechanisch und bevorzugt auch elektrisch in einen Steckplatz 410 für eine elektronische Sicherung 405 passen.

Bevorzugt sind die elektronischen Sicherungen 405 so ausgeführt, dass sie mechanisch auch in einen Steckplatz 420 für eine konventionelle Sicherung passen. Für den Fall, dass ein solcher Steckplatz 420 für eine konventionelle Sicherung 415 keine Kontakte 435, 475 für die Versorgung der elektronischen Sicherung 405 mit elektrischer Energie aufweist, so muss die elektronische Sicherung 405 eine Energiereserve 8 aufweise, die vor dem Einbau der elektronischen Sicherung 405 in die Steckverbindung 420 mit Energie versehen sein muss. Beispielsweise kann es sich in dem Fall bei der Energiereserve 8 um eine Batterie oder einen Akkumulator handeln. Bevorzugt umfasst eine solche elektronische Sicherung 405 dann ein Signalisierungsmittel, beispielsweise eine LED, um den Ladezustand zumindest auf Anfrage über eine - vorzugsweise optische - Datenschnittstelle 550 abfragen zu können.

Die technische Lehre des hier vorgelegten Dokuments schlägt eine Sicherungsbox 400 für ein Versorgungsnetzwerk 200 eines Fahrzeugs vor. Die vorgeschlagene Sicherungsbox 400 umfasst elektronische Sicherungen 405 und/oder Steckplätze 410 für elektronische Sicherungen 405. Die vorgeschlagene Sicherungsbox weist Schmelzsicherungen 415 und/oder Steckplätze 420 für Schmelzsicherungen 415 auf. Bevorzugt weist zumindest eine elektronische Sicherung 405 der elektronischen Sicherungen der vorgeschlagenen Sicherungsbox 400 einen ersten Anschluss 18 und einen zweiten Anschluss 19 auf, wobei diese mindestens eine elektronische Sicherung 405 dazu eingerichtet ist, das Verhalten einer Schmelzsicherung 415 zu emulieren. Hierzu erfasst diese elektronische Sicherung bevorzugt den Wert des elektrischen Stromes 29 durch ihren Leistungsschalter 17 und ermittelt das zeitliche Intergral eines Polynoms mindestens zweiten Grades dieses Stromwerts. Bevorzugt ist die elektronische Sicherung 405 dazu eingerichtet ist, den Stromwert des Betrags des diese elektronische Sicherung 405 vom ersten Anschluss 18 zum zweiten Anschluss 19 oder umgekehrt durchfließenden elektrischen Stromes 29 zu erfassen. Diese elektronische Sicherung 405 ist bevorzugt dazu eingerichtet, mittels eines Polynoms mindestens zweiten Grades einen Zwischenwert aus diesem erfassten Stromwert zu ermitteln und zu einem integrierten Zwischenwert zeitlich zu integrieren. Bevorzugt ist die elektronische Sicherung dazu eingerichtet, den Stromfluss des Stromes 29 zwischen dem ersten Anschluss 18 und dem zweiten Anschluss 19 durch Öffnen ihres Leistungsschalters 17 zu unterbinden, wenn der integrierte Zwischenwert einen Maximalwert überschreitet. Dies entspricht dem Durchschmelzen einer konventionellen thermischen Sicherung. Die elektronische Sicherung 405 ist bevorzugt in einem Sicherungskörper 425 mit Steckverbindern untergebracht, der in einem der Steckplätze 410 für elektronische Sicherungen 405 mechanisch und vorzugsweise auch elektrisch passt. Bevorzugt umfasst die Sicherungsbox 400 zusätzlich zumindest Abschnitte des Sicherungsdatenbusses 9.

Bevorzugt weist ein Steckplatz 410 für eine elektronische Sicherung 405 einen ersten Kontakt 430 des Steckplatzes 410 und einen zweiten Kontakt 445 des Steckplatzes 410 auf. Der erste Kontakt 430 des Steckplatzes 410 ist vorzugsweise dazu eingerichtet, eine elektrische Verbindung zwischen diesem ersten Kontakt 410 des Steckplatzes 410 und einem ersten Kontakt 450 eines Steckverbinders eines Sicherungskörpers 425 herzustellen, um den ersten Anschluss 18, 450 der Sicherung 405 des Sicherungskörpers 425 mit dem ersten Kontakt 430 des Steckplatzes 410 elektrisch zu verbinden.

Der zweite Kontakt 445 des Steckplatzes 410 ist bevorzugt dazu eingerichtet, eine elektrische Verbindung zwischen diesem zweiten Kontakt 445 des Steckplatzes 410 und einem zweiten Kontakt 470 des Steckverbinders 410 des Sicherungskörpers 425 herzustellen, um den zweiten Anschluss 19, 470 der Sicherung 405 des Sicherungskörpers 425 mit dem zweiten Kontakt (445) des Steckplatzes 405 elektrisch zu verbinden.

Bevorzugt weist in der vorgeschlagenen Sicherungsbox 400 ein Steckplatz 410 für eine elektronische Sicherung 405 einen dritten Kontakt 440 des Steckplatzes 410 auf, wobei der dritte Kontakt 440 des Steckplatzes 405 dazu eingerichtet ist, eine elektrische Verbindung zwischen diesem dritten Kontakt 440 des Steckplatzes 405 und einem dritten Kontakt 465 des Steckverbinders 410 des Sicherungskörpers 425 herzustellen, um die Datenleitung 9 der Datenschnittstelle 10 einer Steuerungsschaltung 4 der elektronischen Sicherung 405 des Sicherungskörpers 425 mit dem dritten Kontakt 440 des Steckplatzes 405 elektrisch zu verbinden.

Bevorzugt weist die vorgeschlagene Sicherungsbox 400 einen Steckplatz 410 für eine elektronische Sicherung 405 mit einem vierten Kontakt 435 des Steckplatzes 410 auf. Der vierte Kontakt 435 des Steckplatzes 410 ist vorzugsweise dazu bestimmt, eine elektrische Verbindung zwischen diesem vierten Kontakt 435 des Steckplatzes 410 und einem vierten Kontakt 455 des Steckverbinders des Sicherungskörpers 425 herzustellen, um eine Energieversorgung der Steuervorrichtung 4 der elektronischen Sicherung 405 mit dem vierten Kontakt 455 des Steckplatzes 410 elektrisch zu verbinden.

Das hier vorgelegte Dokument schlägt einen Sicherungskörper 425 einer elektronischen Sicherung 405 für eine vorschlagsgemäße Sicherungsbox 400 vor, bei dem der Steckverbinder des Sicherungskörpers 425 einen ersten Kontakt 450 für den ersten Anschluss 18 der elektronischen Sicherung 405 und einen zweiten Kontakt 470 für den zweiten Anschluss 19 der elektronischen Sicherung 405 aufweist. Vorzugsweise passt der Steckverbinder mechanisch in zumindest einen der Steckplätze 410 für elektronische Sicherungen 405.

Vorzugsweise weist der Steckverbinder des Sicherungskörpers 425 einen dritten Kontakt 465 für einen Sicherungsdatenbus 9 auf, wobei der dritte Kontakt 465 elektrisch mit der Datenleitung 9 einer Datenschnittstelle 10 für die Steuerungsschaltung 4 der elektronischen Sicherung 405 des Sicherungskörpers 425 elektrisch verbunden ist.

Bevorzugt weist der Steckverbinder des Sicherungskörpers 425 zumindest einen vierten Kontakt 455 für eine Spannungsversorgung 6 der Steuervorrichtung 4 der elektronischen Sicherung 405 aufweist.

Das hier vorgelegte Dokument schlägt eine Schmelzsicherung 415 für eine Sicherungsbox 400 vor, bei der der Steckverbinder 410 des Sicherungskörpers 425 einen ersten Kontakt 455 für den ersten Anschluss 18 der Schmelzsicherung 415 aufweist und einen zweiten Kontakt 470 für den zweiten Anschluss 19 der Schmelzsicherung 415 aufweist. Der Steckverbinder der Schmelzsicherung 415 ist vorzugsweise dazu eingerichtet, mechanisch in zumindest einen der Steckplätze 410 für elektronische Sicherungen 405 zu passen, und mechanisch in zumindest einen der Steckplätze 420 für Schmelzsicherungen 415 zu passen.

Figur 5

Die Figur 5 basiert auf der Figur 1 und stellt eine Modifikation der Figur 1 dar. Die Sicherung 1 der Figur 5 umfasst zusätzliche eine erste Teststromquelle 505, die einen elektrischen Teststrom 515 in den ersten Anschluss 26 des Leistungsschalters 17 der Sicherung 1 einspeist. Der zusätzliche erste elektrische Teststrom 515 ist vorzugsweise mittels des ersten Steuersignals 510 mit einem ersten Modulationssignal {505} eines ersten Signalgenerators 520 versehen. Hierbei sollen die geschweiften Klammern signalisieren, dass es sich um bei {505} das erste Modulationssignal handelt, mit dem der erste Strom 515 der ersten Teststromquelle 505 moduliert ist.

In der Figur 5 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 6, 9, 24, 41, 42, 52, 53, 54, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Bevorzugt umfasst die Steuervorrichtung 4 eine erste Gate-Ansteuerung 530 des Steuerkontakts 27 des ersten Leistungsschalters 17 und eine erste Steuersignalerzeugung für das Steuersignal der Steuerleitung 20 des ersten Leistungsschalters 17 zur Steuerung des ersten Leistungsschalters 17. Bevorzugt steuert der Rechnerkern 2 die erste Gate-Ansteuerung 530 über den internen Datenbus 11.

Die vorgeschlagene Sicherung 1 umfasst bevorzugt einen ersten Korrelator 525. Bevorzugt steuert der Rechnerkern 2 der Steuervorrichtung 4 der Sicherung 1 über den internen Datenbus 11 den ersten Korrelator 525. Der erste Korrelator 525 umfasst bevorzugt einen oder mehrere Eingangsverstärker, die die Spannungen zwischen den ersten Messkontakten (21, 25, 27, 28, 22) erfassen, filtern und aufbereiten. Bevorzugt umfasst der erste Korrelator 525 beispielsweise einen ersten Synchrondemodulator, der eine der messbaren Spannungen auf erste Anteile des ersten Modulationssignals {505} des ersten Stroms 515 der ersten Teststromquelle 505 untersucht. Bevorzugt nutzt dabei der erste Synchrondemodulator des ersten Korrelators eine Korrelation in Form eines Skalarprodukts, beispielsweise gemäß der Form

$$A = \langle \{505\} | V_{xy}(t) \rangle = \int_0^T \{505\} \times V_{xy}(t)\,dt$$

Hierbei stehen A für den Wert des ersten Anteils und $V_{xy}$ für eine Spannung zwischen den ersten Messkontakten (21, 25, 27, 28, 22). Bevorzugt verwendet der erste Korrelator 525 eine Spannung $V_{xy}$ zwischen dem zweiten Anschluss 28 des ersten Leistungsschalters 17 und dem ersten Steueranschluss 27 des ersten Leistungsschalters 17. Vorzugsweise weist die vorgeschlagenes Sicherung 1 ein Gehäuse 535 der Sicherung 1 auf. Vorzugsweise weist das Gehäuse 535 der Sicherung 1 ein oder mehrere optische Fenster 545 auf, über die die Steuervorrichtung 4 der Sicherung 1 Signalisierungen an andere Vorrichtungen und/oder Menschen vornehmen kann.

Das hier vorgelegte Dokument schlägt eine elektronischen Sicherung 1 vor, die einen ersten Anschluss 18 und einen zweiten Anschluss 19 aufweist. Die vorgeschlagene elektronische Sicherung 1 weist darüber hinaus einen Leistungsschalter 17 und eine Steuervorrichtung 4 auf. Der Leistungsschalter 17 weist vorschlagsgemäß einen ersten Anschluss 26, einen Steueranschluss 27 und einen zweiten Anschluss 28 auf. Bevorzugt handelt es sich um einen MOS-Transistor. Der erste Anschluss 26 des Leistungsschalters 17 ist vorzugsweise mit dem ersten Anschluss 18 der Sicherung 1 elektrisch verbunden und der zweite Anschluss 28 des Leistungsschalters 17 ist vorzugsweise mit dem zweiten Anschluss 19 der Sicherung 1 elektrisch verbunden. Der Steueranschluss 27 des Leistungsschalters 17 ist typischerweise mit der Steuervorrichtung 4 elektrisch verbunden. Die Steuervorrichtung 4 der elektronischen Sicherung 1 erfasst vorschlagsgemäß elektrische Spannungen zwischen den Anschlüssen (26, 27, 28) des Leistungsschalters 17 und/oder funktionsäquivalenter Werte physikalischer Parameter innerhalb der Sicherung 1 und ermittelt daraus einen Wert für einen elektrischen Strom 29 durch den Leistungsschalter 17 zwischen dem ersten Anschluss 26 des Leistungsschalters 17 und dem zweiten Anschluss 28 des Leistungsschalters 17.

Die elektronische Sicherung 1 weist eine elektronische Teststromquelle 505 auf, die so mit dem Leistungsschalter 17 verschaltet ist, dass sie einen zusätzlichen Strom 515 in den Leistungsschalter 17 zwischen dem ersten Anschluss 26 des Leistungsschalters 17 und dem zweiten Anschluss 28 des Leistungsschalters 17 in Abhängigkeit von einem ersten Steuersignal 510 der Steuervorrichtung 4 einspeisen kann. Dabei moduliert die Steuervorrichtung 4 das Steuersignal 510 vorzugsweise mit einem ersten Modulationssignal {505}. Dieses Modulationssignal {505} moduliert wiederum den zeitlichen Werteverlauf des Stromwerts des zusätzlichen Stroms 515. Die Steuervorrichtung 4 erfasst oder ermittelt vorzugweise den zeitlichen Werteverlauf des Stromwerts des elektrischen Stroms 29 durch den Leistungsschalter 17. Vorzugsweise überprüft die Steuervorrichtung 4, ob der zeitliche Werteverlauf des Stromwerts des elektrischen Stromes 29 Signalanteile umfasst, deren Modulation mit der Modulation des Modulationssignals korreliert. Um nun den Anteil des dermaßen modulierten Teststroms 515 im Strom 29 durch den Leistungsschalter 17 erfassen zu können, umfasst die Steuervorrichtung 4 einer vorschlagsgemäßen Sicherung 1 bevorzugt einen Synchrondemodulator 525 oder eine funktionsäquivalente Vorrichtung, wie beispielsweise ein Optimalfilter oder Matched-Filter. Der Synchrondemodulator 525 ermittelt typischerweise die Korrelation zwischen dem Signal des zeitlichen Werteverlaufs des elektrischen Stromes 29 durch den Leistungsschalter 17 einerseits und dem zeitlichen Werteverlauf des Modulationssignals {505} andererseits. Beispielsweise kann ein Synchrondemodulator 525 den Wert der Funktion $C_{29m} = \int I_{29}(t) \times M(t)dt$ bestimmen, wobei $I_{29}(t)$ für den Werteverlauf des elektrischen Stromes 29 durch den Leistungsschalter 17 und M(t) für den zeitlichen Werteverlauf des Modulationssignals {505} und $C_{29m}$ für den Korrelationswert steht, den der Synchrondemodulator 525 bestimmt. Andere Korrelationsmethoden sind denkbar. In dem hier vorgeschlagenen multipliziert der Synchrondemodulator 525 das Modulationssignal {505} oder ein daraus abgeleitetes Signal oder ein Signal, das mit dem Modulationssignal {505} in einem festen zeitlichen Zusammenhang steht, einerseits vorzugsweise mit den zeitlichen Werteverlauf $I_{29}(t)$ des elektrischen Stroms 29 oder einem daraus abgeleiteten Signal andererseits. Der Synchrondemodulator 525 filtert das aus der Multiplikation resultierende Signal anschließend zu einem Korrelationssignal. Vorzugsweise handelt es sich bei dieser Filterung um eine Tiefpassfilterung, sodass der Synchrondemodulator 525 dann auf diese Weise die Funktion $C_{29m} = \int I_{29}(t) \times M(t)dt$ realisiert. Zumindest sollte der Synchrondemodulator zumindest frequenzbereichsweise die integrierende Wirkung eines Tiefpassfilters zeigen. Der Synchrondemodulator 525 bzw. die Steuervorrichtung 4 können zur Bestimmung des Korrelationssignals $C_{29m}(t)$ ein auf das Modulationssignal {505} optimiertes Matched-Filter und/oder ein Optimalfilter und/oder ein Kalman-Filter oder ein anderes Schätzfilter umfassen, das den zeitlichen Werteverlauf $I_{29}(t)$ des elektrischen Stroms 29 zu dem Korrelationssignal $C_{29m}(t)$wandelt.

Typischerweise schaltet die Steuervorrichtung 4 den Leistungsschalter 17 nichtleitend, wenn das Vorzeichen das Vorzeichen der elektrischen Spannung zwischen dem ersten Anschluss 18 der Sicherung 1 und dem zweiten Anschluss 19 der Sicherung 1 nicht einem Vorgabewert entspricht. Hierzu erfasst die Steuervorrichtung 4 die elektrische Spannung zwischen dem ersten Anschluss 18 der Sicherung 1 und dem zweiten Anschluss 19 der Sicherung 1. Beispielsweise kann der Rechnerkern 2 der Steuervorrichtung 4 einen Analog-zu-Digitalwandler 570 benutzen, um über entsprechende Messleitungen 22, 21, 25 die Potenziale an dem Leistungsschalter 17 bzw. an einem Hilfsleistungsschalter 23 zu erfassen. Der Hilfsleistungsschalter 23 dient dabei bevorzugt zur Erfassung eines Hilfsstromes, der dem Strom durch den Leistungsschalter (17) proportional ist oder auf andere Weise entspricht. Ein Shunt-Widerstand 24 ermöglicht dem Rechnerkern 2 der Steuervorrichtung 4 der Sicherung 1 dann die Messung dieses Hilfsstromes mittels der entsprechenden Messleitungen 25, 21 und mittels des Analog-zu-Digital-Wandlers 570. In der Figur 5 sind zur besseren Übersicht die Verbindungen zwischen dem Analog-zu-Digitalwandler 570 und den Messleitungen 20, 21, 22, 25 nicht eingezeichnet. Der Leser soll sie als vorhanden und offenbart annehmen. Vorzugsweise schaltet der Rechnerkern 2 der Steuervorrichtung 4 der Sicherung 1 den Leistungsschalter 17 nichtleitend, wenn die elektrische Spannung zwischen dem ersten Anschluss 18 der Sicherung 1 und dem zweiten Anschluss 19 der Sicherung 1 einen ersten Vorgabewert unterschreitet. Vorzugsweise schaltet der Rechnerkern 2 der Steuervorrichtung 4 der Sicherung 1 den Leistungsschalter 17 nichtleitend, wenn die elektrische Spannung zwischen dem ersten Anschluss 18 der Sicherung 1 und dem zweiten Anschluss 19 der Sicherung 1 einen zweiten Vorgabewert überschreitet. Typischerweise weist die elektronische Sicherung 1 einen Bezugspotenzialanschluss 201 auf. Vorzugsweise schaltet der Rechnerkern 2 der Steuervorrichtung 4 der Sicherung 1 den Leistungsschalter 17 nichtleitend, wenn die elektrische Spannung zwischen dem ersten Anschluss 19 der Sicherung 1 und dem Bezugspotenzialanschluss 201 der Sicherung 1 einen dritten Vorgabewert unterschreitet. Vorzugsweise schaltet der Rechnerkern 2 der Steuervorrichtung 4 der Sicherung 1 den Leistungsschalter 17 nichtleitend, wenn die elektrische Spannung zwischen dem zweiten Anschluss 19 der Sicherung 1 und dem Bezugspotenzialanschluss 201 der Sicherung 1 einen vierten Vorgabewert unterschreitet. Vorzugsweise schaltet der Rechnerkern 2 der Steuervorrichtung 4 der Sicherung 1 den Leistungsschalter 17 nichtleitend, wenn die elektrische Spannung zwischen dem ersten Anschluss 18 der Sicherung 1 und dem Bezugspotenzialanschluss 201 der Sicherung) einen fünften Vorgabewert überschreitet. Vorzugsweise schaltet der Rechnerkern 2 der Steuervorrichtung 4 der Sicherung 1 den Leistungsschalter 17 nichtleitend, wenn die elektrische Spannung zwischen dem zweiten Anschluss 19 der Sicherung 1 und dem Bezugspotenzialanschluss 201 der Sicherung 1 einen sechsten Vorgabewert überschreitet. Hierdurch stellt die Steuervorrichtung 4 der elektronischen Sicherung 1 sicher, dass das nachfolgende Versorgungsteilnetzwerk nur in einem vorbestimmten Spannungsbereich betrieben wird.

Vorzugsweise sind der Leistungsschalter 17 und die Steuervorrichtung 4 in einem gemeinsamen Gehäuse 535 untergebracht. Dies hat den Vorteil, dass die EMV-Verträglichkeit erhöht wird.

Die Steuervorrichtung 4 der elektronischen Sicherung kann beispielsweise eine optische Datenschnittstelle 550 aufweisen, um eine gute galvanische Trennung zwischen der abgesicherten Versorgungsleitung am ersten Anschluss 18 der Sicherung 1 und/oder am zweiten Anschluss 19 der Sicherung 1 zu erreichen. Um diese optische Datenschnittstelle 550 ansteuern zu können, weist das Gehäuse 535 vorzugsweise ein optisches Fenster 545, das den Eintritt elektromagnetischer Strahlung in das Gehäuse 535 zulässt und so eine Wechselwirkung der optischen Datenschnittstelle 550 mit dieser eingetretenen elektromagnetischen Strahlung zulässt, sodass die optische Datenschnittstelle 550 auf diese Weise ein optisch übermitteltes Signal 540 empfangen kann. Umgekehrt kann die optische Datenschnittstelle 550 eine elektromagnetische Strahlung 540 emittieren, die dann über dieses optische Fenster 545 in dem Gehäuse 535 der Sicherung 1 das Gehäuse 535 verlassen kann. Somit sind vorzugsweise solche optischen Fenster 545 Teilvorrichtungen einer oder mehrerer optischer Datenschnittstellen 550 der Steuerungsvorrichtung 4 der betreffenden elektronischen Sicherung 1. Ein solches optisches Fenster 545 erlaubt somit den Zutritt und/oder Austritt elektromagnetischer Strahlung für den Transport von Daten von und zur Steuervorrichtung 4 der Sicherung und ermöglicht es somit, dass über dieses optische Fenster 545 eine optische Schnittstelle 550 der Steuervorrichtung 4 der Sicherung 1 innerhalb des Gehäuses 535 mit einer optischen Schnittstelle 555 einer anderen Vorrichtung 12 , beispielsweise einem übergeordneten Rechnersystem 12, außerhalb des Gehäuses 535 über eine optische Datenverbindung 540 kommunizieren kann. Optische Funktionselemente 580 können die optische Datenverbindung 540 führen und/oder gestalten. Solche optischen Funktionselemente können ablenkende Funktionselemente wie Spiegel und/oder Prismen und dergleichen sein und/oder Querschnittsmodifizierende Funktionselemente wie Blenden und/oder fokussierende Funktionselemente wie Linsen und/oder Hohlspiegel und/oder lichtführende optische Funktionselemente wie Lichtwellenleiter und dergleichen sein. Bevorzugt verfügt eine solche Sicherung mit einer optischen Datenschnittstelle 550 über eine optische Steckverbindung, die die mechanische Herstellung der optischen Verbindung zwischen optischer Datenbusschnittstelle 550 und optischer Datenverbindung 540 erlaubt. Ein derartiges optisches Fenster 545 erlaubt dem Rechnerkern 4 der Steuervorrichtung 4 bzw. der Steuervorrichtung 4 der Sicherung 1 darüber hinaus eine Signalisierung mittels eines optische sichtbaren Signals an einen Menschen. Beispielsweise kann die Sicherung ein rotes Licht durch das optische Fenster 545 abstrahlen, wenn der Leistungsschalter 17 geöffnet ist. Ebenso kann die Sicherung 1 über ein solches optische Fenster 545 ein optisches und für einen Menschen erkennbares Signal abstrahlen, dass den Ladezustand der Energiereserve 8 angibt. Vorzugsweise handelt es sich bei der elektromagnetischen Strahlung für den Transport von Daten, die die optische Schnittstelle 550 abstrahlt und/oder empfängt, um Laser-Strahlung eines Lasers 560 oder um Strahlung einer LED 560 handelt. Das hier vorgelegte Dokument schlägt daher vor, dass die vorgeschlagene Sicherung 1 bevorzugt einen Laser 560 oder eine LED 560 umfasst. Vorzugsweise verwendet der Rechnerkern 2 der Steuervorrichtung 4 der Sicherung 1 diesen Laser bzw. diese LED als Sender von Daten der optischen Datenschnittstelle 550 der Steuervorrichtung 4 der Sicherung 1. In bestimmten Realisierungsfällen mag das Bedürfnis bestehen, keinen separaten Laser bzw. keine separate LED in das Gehäuse 545 der Sicherung 1 einzubauen, sondern die LED mit dem Rest der Steuerschaltung 4 der Sicherung monolithisch in einem Halbleiterkristall zu fertigen. In dem Fall ist es besonders günstig, wenn die Steuerschaltung 4 der elektronischen Sicherung 1 als LED eine siliziumbasierende LED 560 aufweist. Typischerweise umfasst die Steuerschaltung dann zum Betrieb der siliziumbasierenden LED eine Ansteuerungsvorrichtung 565, die die Betriebsspannung für die siliziumbasierende LED bereitstellt. Bevorzugt handelt es sich bei der siliziumbasierenden LED 560 um eine Silizium-Lawinen-LED 560, insbesondere eine als LED betriebene SPAD-Diode 560. Die Ansteuervorrichtung 656 betreibt diese vorzugsweise oberhalb der Durchbruchspannung in Sperrrichtung. Die Ansteuerungsvorrichtung 565 erzeugt aus der Betriebsspannung der elektronischen Sicherung 1 zwischen den Anschlüssen 6, 201 mittels eines Spannungsumsetzers einer Spannungsversorgung 5 die notwendige Betriebsspannung für die siliziumbasierende LED 560.

Vorzugsweise umfasst die optische Datenbusschnittstelle 550 auch einen optischen Empfänger. Bevorzugt ist dieser optische Empfänger der Datenbusschnittstelle 550 eine Fotodiode. Zur Erreichung einer maximalen Synergie kann es sinnvoll sein, wenn die Steuervorrichtung der elektronischen Sicherung 1 die siliziumbasierende LED 560 zumindest zeitweise als Empfänger der optischen Datenbusschnittstelle 550 betreibt. Bevorzugt kann der Rechnerkern 2 der Steuervorrichtung 4 der elektronischen Sicherung 4 beispielsweise mittels eines Trennschalters der Steuervorrichtung 4 der elektronischen Sicherung 1 die Silizium LED 560 von der elektrischen Versorgung des Spannungsumsetzers der Spannungsversorgung 5 abtrennen und so das abgestrahlte Lichtsignal der Silizium LED 560 zum Zweck der Datenübertragung modulieren oder die Silizium-LED vom Sendebetrieb in den Empfangsbetrieb umschalten. Im Empfangsbetrieb erfasst der Rechnerkern 2 vorzugsweise mittels des Analog-zu-Digitalwandlers 570 der Steuervorrichtung 4 der elektronischen Sicherung 1 das Spannungssignal 575 der Silizium-LED 560 und erzeugt so ein digitalisiertes Eingangsdatensignal. Der Rechnerkern 2 der Steuervorrichtung 4 der Sicherung 1 verwendet den so erfassten Wert als Eingangsdatensignal der optischen Datenschnittstelle 550 und extrahiert die ihm übermittelten Daten aus diesem Eingangsdatensignaldatenstrom. Natürlich kann die Steuervorrichtung 4 der elektronischen Sicherung 1 auch einen separaten Fotodetektor, beispielsweise eine Fotodiode 560, und eine Auswerteelektronik des Fotodetektors 560 umfassen. Bevorzugt Ist die elektronische Sicherung 1 dazu eingerichtet, dass Lichtwellenleiter 580 und/oder andere optische Funktionsmittel die elektronische Sicherung 1 mit einer oder mehreren anderen elektronischen Sicherungen (214 bis 217, 225 bis 223, 230 bis 235, 225 bis 256) über die jeweilige optische Datenschnittstelle 550 dieser elektronischen Sicherungen verbinden. Bevorzugt umfasst ein Versorgungsnetzwerk 200 ein optisches Datennetzwerk als Datenbus 9, mit dem die optischen Datenschnittstelle 555 eines übergeordneten Rechnersystems 12 und/oder die Datenschnittstellen 550 der Steuervorrichtungen 4 der Sicherungen des Versorgungsnetzwerks 200 miteinander kommunizieren können. Die vorschlagsgemäße elektronische Sicherung 1 ist, insbesondere, wenn eine erhöhte Anforderung zur galvanischen Trennung besteht, vorzugsweise über ihre optische Schnittstelle 550 und einen Lichtwellenleiter 580 mit einer optischen Schnittstelle 555 eines übergeordneten Rechnersystems 12, beispielsweise eines übergeordneten Rechnersystems (12), und ggf. mit einer oder mehreren weiteren elektronischen Sicherungen (214 bis 217, 225 bis 223, 230 bis 235, 225 bis 256) verbunden ist. Neben der Datenkommunikation über diese optische Datenschnittstelle 550 oder die drahtgebundene Datenschnittstelle 10 kann die Steuervorrichtung 4 der Sicherung 1 über eine weitere, andere optische Datenschnittstelle 551 oder andere Datenschnittstelle 610 mit einem übergeordneten Steuergerät und/oder einem übergeordneten Rechnersystem 12 und ggf. mit den Steuervorrichtungen 4 einer oder mehrerer weiterer elektronischen Sicherungen (1, 214 bis 217, 225 bis 223, 230 bis 235, 225 bis 256) verbunden sein. Ein typischer auftretender Fehler ist eine Überhitzung der Sicherung 1. Hierbei können sich sowohl der Leistungsschalter 17 als auch die Steuervorrichtung 4 überhitzen. Bevorzugt umfasst die Steuervorrichtung 4 der elektronischen Sicherung eine oder mehrere Temperatursensorauswertevorrichtungen 585. Bevorzugt umfasst die Steuervorrichtung 4 der Sicherung 1 einen Temperatursensor 586, beispielsweise einen PN-Übergang oder einen PTC-Widerstand oder einen NTC-Widerstand, die die Temperatur der Steuervorrichtung 4 der Sicherung 1 erfassen und in ein elektrisches Signal wandeln, dass die Temperatursensorauswertevorrichtung 585 und/oder der Analog-zu-Digital-Wandler 570 in eine Messgröße für den Rechnerkern 2 der Steuervorrichtung 4 der elektronischen Sicherung 1 wandeln. Bevorzugt umfasst der Leistungsschalter 17 der Sicherung 1 einen Temperatursensor 586, beispielsweise einen PN-Übergang oder einen PTC-Widerstand oder einen NTC-Widerstand, die die Temperatur des Leistungsschalters 17 der Sicherung 1 erfassen und in ein elektrisches Signal wandeln, dass die Temperatursensorauswertevorrichtung 585 und/oder der Analog-zu-Digital-Wandler 570 in eine Messgröße für den rechnerkern 2 der Steuervorrichtung 4 der elektronischen Sicherung 1 wandeln. auf diese Weise kann der Rechnerkern 2 der Steuerungsvorrichtung 4 der Sicherung1 eine thermische Überlastung des Leistungsschalters 17 und/oder der Steuerungsvorrichtung 4 erkennen und den Leistungsschalter 17 vor dem Eintritt von Schäden öffnen und/oder über den Datenbus 9 dem übergeordneten Rechnersystem 12 eine bevorstehende Überlastung des Leistungsschalters 17 und/oder der Steuervorrichtung 4 der Sicherung 1 übermitteln. Somit umfasst die elektronische Sicherung 1 bevorzugt einen oder mehrere Temperatursensoren 586 zur Überwachung des sicheren Betriebs der Sicherung 1. Die Steuervorrichtung 4 der Sicherung 1 wertet Temperaturmesswerte der einen oder der mehreren Temperatursensorauswertevorrichtungen 585, die die Temperatursensoren 586 vermessen, aus. Die Temperatursensorauswertevorrichtungen 585 erfassen mit Hilfe von zur elektronischen Steuervorrichtung 4 externen Temperatursensoren und/oder mit Hilfe von Temperatursensoren 586 der elektronischen Sicherung 1 diese Temperaturmesswerte.

In vielen Anwendungsfällen ist es sinnvoll, wenn die Sicherung 1 einen energiequellenseitigen ersten Anschluss 18 und einen verbraucherseitigen zweiten Anschluss 18 aufweist. In vielen Anwendungen ist eine Rückspeisung elektrischer Energie in Richtung Energiequelle nicht gewünscht. Der elektrische Strom 29 durch den Leistungsschalter 17 soll also bevorzugt in solchen Anwendungen nur vom ersten Anschluss 18 der Sicherung 1 zum zweiten Anschluss 19 der Sicherung 1 fließen. In dem Fall umfasst die elektronische Sicherung 1 Mittel (20, 21, 22, 23, 24, 25, 525, 570) zur Erfassung und zur Detektion eines rückwärtsfließenden Stromes 29 umfasst. Beispielsweise kann der Analog-zu-Digital-Wandler 570 die Spannungen der Messleitungen (20, 21, 22, 25) untereinander und/oder gegenüber dem bezugspotenzial 201 erfassen und die erfassten Werte dem Rechnerkern 2 der Steuervorrichtung 4 des Sicherung 1 über den internen Datenbus 11 übermitteln. Der Rechnerkern 2 der Steuervorrichtung 4 der Sicherung 1 kann dann z.B. auf den Wert des Hilfsstroms 36 durch den Shunt-Widerstand 24 schließen, den der Hilfsleistungsschalter 23 proportional zum Strom 29 erzeugt und so auf das Vorzeichen des Stromes 29 schließen. Beispielsweise kann der Rechnerkern 2 der Steuervorrichtung 4 der Sicherung 1 den Leistungsschalter 1 öffnen, wenn das geschätzte und/oder ermittelte Vorzeichen des elektrischen Stromes 29 nicht einem erwarteten Vorzeichen entspricht. Dies kann beispielsweise dann der Fall sein, wenn Energie unerlaubterweise vom zweiten Anschluss 19 der Sicherung 1 zum ersten Anschluss 18 der Sicherung transportiert wird, obwohl die umgekehrte Energietransportrichtung die erwartete Energietransportrichtung ist.

Der Rechnerkern 2 der Steuervorrichtung 4 der elektronischen Sicherung 1 wertet dann die so erfassten Messwerte der Spannungen der Messleitungen (20, 21, 22, 25) aus und gibt vorzugsweise die Messwerte und/oder oder daraus abgeleitete Messwerte an andere Rechnerkerne 2 anderer elektronischen Sicherungen (1, 214 bis 217, 225 bis 223, 230 bis 235, 225 bis 256) über einen Sicherungsdatenbus (9, 540) oder dergleichen oder an ein übergeordnetes Rechnersystem 12, beispielsweise an ein übergeordnetes Rechnersystem 12, weiter.

In vielen Fällen ist es sinnvoll, wenn die elektronische Sicherung 1 zwei Datenschnittstellen 10 und 610 umfasst. Es kann sich bei den Datenschnittstellen auch um mehrere optische Datenschnittstellen 550 und 551 handeln. Auch ist es denkbar, dass die elektronische Sicherung 1 ein oder mehrere drahtgebundene Datenschnittstellen 10, 610 und/oder gleichzeitig ein oder mehrere optische Datenschnittstellen 550, 551 umfasst. Ein Lichtwellenleiter 580 kann beispielsweise die eine elektronische Sicherung 1 oder die mehreren elektronischen Sicherungen (1, 214 bis 217, 225 bis 223, 230 bis 235, 225 bis 256) über die optischen Datenschnittstellen 551, 550 der einen elektronischen Sicherung 1 oder der mehreren elektronischen Sicherungen mit einer anderen Vorrichtung 12, beispielsweise mit einem übergeordneten Rechnersystem 12, oder mit den Rechnerkernen 2 der Steuervorrichtungen 4 anderer elektronischer Sicherungen und/oder untereinander verbinden.

Die in dem hier vorgelegten Dokument offengelegte elektronische Sicherung 1 weist bevorzugt eine Steuervorrichtung 4 und einen Leistungsschalter 17 als Leistungsschalter der elektronischen Sicherung 1 auf. Der Rechnerkern 2 der Steuervorrichtung 4 steuert mittels einer Gate-Ansteuerschaltung 16 für die Ansteuerung und Überwachung des Leistungsschalters 17, ob der Leistungsschalter 17 leitend ist und somit als geschlossener Leistungsschalter arbeitet, oder ob der Leistungsschalter 17 nicht leitet und somit als offener Leistungsschalter arbeitet. Die Steuervorrichtung 4 der elektronischen Sicherung weist bevorzugt eine Datenschnittstelle 10 für einen Sicherungsdatenbus 9 auf. Der Rechnerkern 2 der Steuervorrichtung 4 der Sicherung 1 empfängt und/oder sendet über den Sicherungsdatenbus 9 und die Datenschnittstelle 10 Datenbotschaften. Vom Inhalt dieser Datenbotschaften hängt zumindest teilweise und zumindest zeitweise ab, ob der Rechnerkern 2 der Steuervorrichtung 4 der Sicherung 1 mittels der Gate-Ansteuerschaltung 16 den Leistungsschalter 17 schließt oder öffnet. Um nun ein ungewünschtes Öffnen und/oder Schließen des Leistungsschalters 17 zu verhindern, ändert der Rechnerkern 2 der Steuervorrichtung 4 der elektronischen Sicherung 1 den Schaltzustand des Leistungsschalters 17 aufgrund einer Datenbotschaft nur dann ändert, wenn die Steuervorrichtung 4 eine Datenbotschaft mit einem Passwort empfängt. Dazu umfasst das bit-Strom-Paket BP, dass die Datenbotschaft umfasst in dem Datenteil INFO bevorzugt zum Ersten die Konfigurationsdaten ILD und zum Zweiten ein Passwort zur Authentifizierung dieses Kommandos. Der rechnerkern 2 vergleicht in einem vorgegebenen Verfahren das empfangene Passwort mit einem erwarteten Passwort oder verifiziert auf andere Weise die Gültigkeit des empfangenen Passworts. Ist das Ergebnis dieser Verifikation so, dass das Passwort gültig ist, so führt der Rechnerkern 2 der Steuervorrichtung 4 der Sicherung 2 das empfangene Kommando aus und öffnet bzw. schließt je nach Inhalt des Kommandos den Leistungsschalter 17 der elektronischen Sicherung 1.

Das hier vorgelegte Dokument beschreibt somit eine elektronische Sicherung 1 mit einen Leistungsschalter 17, wobei die elektronische Sicherung 1 an dem Anschluss 26 ihres Leistungsschalters 17, der auf der Energiequellenseite liegt, die Spannung zwischen diesem Anschluss 26 und einem Bezugsknoten 201 erfasst und überprüft und wobei die elektronische Sicherung 1 den Strom 29 durch den Leistungsschalter 17 erfasst und/oder ermittelt und überprüft. Die elektronische Sicherung 1 schaltet vorzugsweise die elektrische Versorgung des nachfolgenden Teilbaums des Versorgungsnetzwerks 200 durch Ausschalten ihres Leistungsschalters 17 ab, wenn der Betrag des erfassten Werts der Spannung einen Mindestwert unterschreitet und wenn gleichzeitig der der Betrag des erfassten Werts des elektrischen Stroms 23 durch den Leistungsschalter 17 der elektronischen Sicherung 1 einen vorbestimmten Schwellwert überschreitet. Dies ist nämlich ein klares Anzeichen für einen Kurzschluss, den abzufangen die Aufgabe der Sicherung 1 ist.

Da es sich um eine temporäre Störung, beispielsweise in Folge der Kommutierung einer induktiven Last handeln kann, kann es sinnvoll sein, einen Wiedereinschaltversuch zu unternehmen. Der Rechnerkern 2 der Steuervorrichtung 4 der elektronischen Sicherung 1 führt dann nach Eintritt eines Kurzschlussereignisses, wie zuvor beschrieben, vorzugsweise einen oder mehrere Einschaltversuche des Leistungsschalters 17 durch. Nun kann es sich ja um einen echten Kurzschluss handeln. Es ist daher sinnvoll, wenn der Rechnerkern 2 der Steuervorrichtung 4 der Sicherung 1 die Anzahl der Wiedereinschaltversuche und die Durchführung der Wiedereinschaltversuche genau kontrolliert und ggf. auch deren Durchführung und Ergebnis protokolliert. Der Rechnerkern 2 der Steuervorrichtung 4 der elektronischen Sicherung 1 erhöht daher vorzugsweise bei Eintritt eines Kurzschlussereignisses bei einem Einschaltversuch des Leistungsschalters 17 einen Einschaltversuchszähler der Steuervorrichtung 4, insbesondere einen Registerwert des Rechnerkerns 2, um eine Einschaltversuchszählschrittgröße, die auch negativ sein kann und von 0 verschieden ist. Der Rechnerkern 2 der Steuerungsvorrichtung 4 der elektronischen Sicherung 1 übermittelt bevorzugt eine Fehlermeldung an den Rechnerkern 2 der Steuerungsvorrichtung 4 einer anderen elektronischen Sicherung oder an ein übergeordnetes Rechnersystem 12 über den Datenbus 9, wenn die Anzahl der erfolglosen Einschaltversuche in Form des Zählerstands des Einschaltversuchszählers eine vorgegebene maximale Anzahl an Einschaltversuchen kreuzt oder erreicht. Der Rechnerkern 2 der Steuervorrichtung 4 der vorgeschlagenen elektronischen Sicherung 1 sendet und empfängt über eine Datenschnittstelle (10, 550) bzw. über den Sicherungsdatenbus (9, 540) Daten wie Konfigurationsdaten (Schreiben/Lesen), Schaltbefehle (Schreiben/Lesen), Diagnosedaten (Schreiben/Lesen), Messwerte (Lesen), Vergleichswerteinstellungen (Schreiben/-Lesen). Der entsprechende Datenbus 9 kann beispielsweise in Teilen oder ganz ein Zweidrahtdatenbus, insbesondere in bidirektionaler und/oder differenzieller Zweidrahtdatenbus 9 sein. Besonders vorteilhaft ist, wenn der Datenbus 9 ein üblicher automobiler Datenbus wie beispielsweise ein CAN-Datenbus oder ein Datenbus mit einem Physical-interface eines CAN-Datenbusses, eines CAN-FD-Datenbusses oder eines Flexray-Datenbusses oder eines LVDS-Datenbusses oder dergleichen ist. Die Sicherungen können als Daisy-Chain miteinander verkettet sein. Zu diesem Zweck können beispielsweise Steuervorrichtungen 4 von Sicherungen 1 des Versorgungsnetzwerks 200 zwei Datenschnittstellen 610, 10 für den Sicherungsdatenbus (9) umfassen. Die Steckverbinder 410 und die Sicherungskörper 425 der Sicherungen 405, 1 sollten dann entsprechende zusätzliche Stecker und Kontakte aufweisen. Bevorzugt führen die Rechnerkerne 2 der Steuervorrichtungen 4 der elektronischen Sicherungen (1, 214 bis 217, 225 bis 223, 230 bis 235, 225 bis 256) eines Versorgungsnetzwerks 200 und das übergeordnete Rechnersystem 12, die an den Datenbus 9 angeschlossen sind, ein Autoadressierungsverfahren durch, um jeder Datenschnittstelle 10 jeder Steuervorrichtung 4 jeder Sicherung am Datenbus 9 eine eindeutige Sicherungsadresse zuzuweisen. Ein mögliches beispielhaftes Autoadressierungsverfahren beschreibt die EP 1 490 772 B1. Die hier vorgelegte Schrift beschreibt erstmals die Verwendung eines Autoadressierungsverfahrens zur Vergabe eindeutiger Sicherungsadressen an die elektronischen Sicherungen eines Versorgungsnetzwerks 200, die an einen Sicherungsdatenbus 9 angeschlossen sind.

Bevorzugt sind die Datenschnittstellen 10, 610 der Steuerungsvorrichtung 4 der elektronischen Sicherungen 1 dazu eingerichtet, ein Autoadressierungsverfahren zur Ermittlung einer Sicherungsadresse durzuführen oder an einem solche Autoadressierungsverfahren teilzunehmen.

Die Figur 5 zeigt u.a. die optische Datenverbindung 540 zwischen der ersten optischen Datenschnittstelle 550 der Steuervorrichtung 4 der Sicherung 1 und der optischen Schnittstelle 555 des übergeordneten Rechnersystems 12. Ein Lichtwellenleiter 580 führt die elektromagnetische Strahlung der optischen Datenverbindung 540. Bevorzugt weist das Gehäuse 535 der elektronischen Sicherung 1 einen optischen Steckverbinder auf, der die mechanische und optische Verbindung der elektronischen Sicherung 1 mit dem Lichtwellenleiter 580 erlaubt. Hierdurch kann eine LED 560 elektromagnetische Strahlung in den Lichtwelleneiter 580 als optische Datenverbindung 540 einspeisen. Ein Fotodetektor der optischen Datenschnittstelle 550 kann hierdurch elektromagnetische Strahlung als Datenverbindung 540 aus dem Lichtwellenleiter 580 empfangen. Der optische Steckverbinder umfasst bevorzugt ein optisches Fenster 545, wodurch das Gehäuse 535 der Sicherung 1 ein solches optisches Fenster 545 umfasst. Bevorzugt umfasst die optische Datenschnittstelle 550 eine Ansteuerungsvorrichtung 565 für die Ansteuerung der LED 560. Wenn die LED 560 nicht von der Ansteuerungsvorrichtung 565 mit elektrischer Energie versorgt wird, kann die Steuervorrichtung 4 sie auch als Fotodetektor zum Empfang der optischen Datenverbindung 540 der optischen Datenschnittstelle 555 des übergeordneten Rechnersystems 12 verwenden. In dem Fall kann beispielsweise ein Analog-zu-Digital-Wandler 570 der Steuervorrichtung 4 der Sicherung das Spannungssignal 575 der Silizium-LED 560 erfassen und dem Rechnerkern 2 über den internen Datenbus 11 zur Auswertung zuführen. Selbstverständlich können diese Auswertung und ein Analog-zu-Digital-Wandler auch Teil der optischen Datenschnittstelle 550 sein.

Die Figur 5 zeigt u.a. eine zweite optische Datenverbindung 540 zwischen der zweiten optischen Datenschnittstelle 552 der Steuervorrichtung 4 der Sicherung 1 und eine nicht gezeichneten optischen Schnittstelle eines anderen übergeordneten Rechnersystems oder einer anderen Steuervorrichtung 4 einer anderen Sicherung 1. Bevorzugt weist das Gehäuse 535 der elektronischen Sicherung 1 einen weiteren optischen Steckverbinder auf, der die mechanische und optische Verbindung der elektronischen Sicherung 1 mit einem zweiten, nicht gezeichneten Lichtwellenleiter erlaubt. Hierdurch kann eine LED 561 elektromagnetische Strahlung in den weiteren Lichtwelleneiter als optische Datenverbindung 540 der zweiten optischen Datenschnittstelle 551 einspeisen. Ein Fotodetektor der zweiten optischen Datenschnittstelle 551 kann hierdurch elektromagnetische Strahlung als Datenverbindung 540 aus dem weiteren, nicht gezeichneten Lichtwellenleiter empfangen. Der zweite optische Steckverbinder umfasst bevorzugt ebenfalls ein zweites optisches Fenster 545, wodurch das Gehäuse 535 der Sicherung 1 ein solches, zweites optisches Fenster 545 umfasst. Bevorzugt umfasst die zweite optische Datenschnittstelle 552 eine Ansteuerungsvorrichtung 565 für die Ansteuerung der zweiten LED 561. Wenn die zweite LED 561 nicht von der Ansteuerungsvorrichtung 565 der zweiten optischen Datenschnittstelle 551 mit elektrischer Energie versorgt wird, kann die Steuervorrichtung 4 sie auch als Fotodetektor zum Empfang der zweiten optischen Datenverbindung 540 der optischen Datenschnittstelle des weiteren übergeordneten Rechnersystems bzw. der optischen Datenschnittstelle der anderen elektronischen Sicherung 1 verwenden. In dem Fall kann beispielsweise ein Analog-zu-Digital-Wandler 570 der Steuervorrichtung 4 der Sicherung das Spannungssignal 576 der zweiten Silizium-LED 561 erfassen und dem Rechnerkern 2 über den internen Datenbus 11 zur Auswertung zuführen. Selbstverständlich können diese Auswertung und ein Analog-zu-Digital-Wandler auch Teil der zweiten optischen Datenschnittstelle 551 sein. Bei dem zweiten Laser oder der zweite LED 561 kann es sich beispielsweise wieder um eine siliziumbasierende LED, insbesondere eine Silizium-Lawinen-LED, insbesondere eine als LED betriebene SPAD-Diode, handeln.

Bevorzugt weist die Steuervorrichtung 4 der Sicherung 1 Temperatursensorauswertevorrichtungen 585, die beispielsweise Temperaturmesswerte mittels Temperatursensoren 586 ermittelt und dem Rechnerkern 2 der Steuervorrichtung 4 der Sicherung 1 über den internen Datenbus 11 zur Verfügung stellt.

Bevorzugt umfasst die Steuervorrichtung 4 der Sicherung 1 einen Zufallszahlengenerator 60 Zufallszahlengenerator (RNG=random number generator). Der Rechnerkern 2 der Steuervorrichtung 4 der Sicherung 1 kann über den internen Datenbus 11 der Steuervorrichtung 4 der Sicherung 1 den Zufallswert des Zufallszahlengenerators 60 lesen. Eine Liste von Zufallszahlengeneratoren findet sich beispielsweise unter https://en.wikipedia.org/wiki/List_of_random_ number_generators. Implementierung in Hardware sind beispielsweise in https://en.wikipedia.org/wiki/Hardware_ran dom_number_generator skizziert. Besonders weist da hier vorgelegte Dokument auf die Entropieextraktion hin, die beispielsweise in https://en.wikipedia.org/wiki/Randomness_extractor angerissen ist. Bevorzugt verwendet der Rechnerkern 2 der Steuervorrichtung diese Zufallszahl dann anschließend für die Verschlüsselung der Datenkommunikation über die Datenschnittstelle 10 oder die optische Datenschnittstelle 550 mit anderen Rechnerkernen 2 anderer Steuervorrichtungen 4 anderer Sicherungen 1 im Versorgungsnetzwerk 200 und/oder für die Verschlüsselung der Datenkommunikation mit einem übergeordneten Rechnersystem 12. Bevorzugt ist der Zufallsgenerator 60 ein sogenannter echter Zufallszahlengenerator (TRNG=true random number generator). Ganz besonders bevorzugt ist der Zufallsgenerator 60 ein Quantenzufallszahlengenerator (QRNG=quantum random number generator). Ein solcher Quantenzufallszahlengenerator 60 nutzt quantenzufällige Eigenschaften zur Erzeugung der Quantenzufallszahl als Zufallszahl. Es gibt im Stand der Technik zwei grundlegende Quellen praktischer quantenmechanischer physikalischer Zufälligkeit: die Quantenmechanik auf atomarer oder subatomarer Ebene und thermisches Rauschen (das zum Teil quantenmechanischen Ursprungs ist). Die Quantenmechanik sagt voraus, dass bestimmte physikalische Phänomene, wie z. B. der Kernzerfall von Atomen und/oder, wie hier vorgeschlagen, die spontane Emission eines Photons durch ein energetisch angeregtes Elektron, grundsätzlich zufällig sind und im Prinzip nicht vorhergesagt werden können. Das hier vorgelegte Dokument verweist hinsichtlich der empirischen Überprüfung der Unvorhersehbarkeit der Quantenmechanik auf die bekannten Bell-Test-Experimente. Da die üblichen Umweltbedingungen eine Temperatur über dem absoluten Nullpunkt erfordern, weist jedes reale System eine gewisse Zufallsvariation in seinem Zustand auf.

Da das Ergebnis von quantenmechanischen Ereignissen nicht einmal im Prinzip vorhergesagt werden kann, sind sie der "Goldstandard" für die Erzeugung von Zufallszahlen. Einige Quantenphänomene, die für die Erzeugung von Zufallszahlen verwendet werden, sind:

Eine quantenmechanische Rauschquelle in elektronischen Schaltungen verursacht das typische Schrotrauschen. Ein einfaches Beispiel ist eine Lampe - hier eine erste SPAD-Diode, die auf eine Fotodiode, hier eine zweite SPAD-Diode, scheint. Aufgrund der Unschärferelation erzeugen die eintreffenden Photonen Rauschen in der Schaltung. Das Detektieren des Rauschens zur Erzeugung von Zufallsbits wirft dabei einige Probleme auf. Der hier vorgeschlagene Quantenzufallszahlengenerator ist eine besonders einfache und kompakte Zufallsrauschquelle. Allerdings ist die Energie des Schrotrauschens nicht immer gut über die interessierende Bandbreite verteilt. Bis zur Entropieextraktion erzeugen alle Stufen incl. der Lichtquelle und des Detektors thermisches Rauschen, das die Auswerteschaltung des Quantenzufallszahlengenerators 60 unterdrücken muss. Die Auswerteschaltung des Quantenzufallszahlengenerators 60 zur Aufbereitung des Signals des Detektors - hier der zweiten SPAD-Diode - erfordern eine Filterstufe für eine sorgfältige Filterung, um eine gleichmäßige Verteilung der Zufallsereignisse über ein breites Spektrum zu erreichen.

Der hier in dem hier vorgelegten Dokument vorgestellte Quantenzufallszahlengenerator basiert auf der spontanen Emission eines Photons durch eine in Sperrrichtung vorgespannte erste SPAD-Diode und der stimulierten Emission einer zweiten SPAD-Diode. Beide SPAD-Dioden sind bevorzugt über beispielsweise je einen Vorwiderstand mit bevorzugt der gleichen Spannungsquelle in Sperrrichtung mit einer Spannung oberhalb der Durchbruchspannung vorgespannt. Eine spontane oder stimulierte Emission eines Photons ist mit der Bildung eines Strom-Spikes verbunden. Der Vorwiderstand verhindert, dass die jeweilige SPAD-Diode dass ein solcher Stromspike durch Nachlieferung von Energie aus der Spannungsquelle zu einer dauerhaften Entladung und damit zu einem zu hohen Energieeintrag in die jeweilige SPAD-Diode führen würde. Solche paarweisen quasi gleichzeitigen Ereignisse in der Ersten SPAD-Diode und der zweiten SPAD-Diode zeichnen sich durch einen doppelt so hohen Strom-Spike aus als einfache Ereignisse spontaner Emission einer der beiden SPAD-Dioden.

Vorschlagsgemäß weist der Quantenzufallsgenerator 60 eine erste SPAD-Diode auf, die in Sperrrichtung mit einer Spannung oberhalb der Sperrspannung vorgespannt wird. Die Sperrspannung liefert bevorzugt die Spannungsversorgung 5 oder ein Vorrichtungteil derselben. Hierdurch beginnt die erste SPAD-Diode einzelne, typischerweise sehr kurze Lichtpulse auszusenden. Bevorzugt leitet ein Lichtwellenleiter der Steuervorrichtung diese Lichtpulse der ersten SPAD-Diode an eine zweite SPAD-Diode weiter. Der Lichtwellenleiter ist von besonderer Bedeutung, da er die Anzahl der Photonen, die die zweite SPAD-Diode erreichen, maximiert. Die beiden SPAD-Dioden sind bevorzugt monolithisch in einem Siliziumhalbleiterkristall in einer CMOS-Technologie gefertigt. Bevorzugt ist der Lichtwellenleiter im Metallisierungsstapel des CMOS-Schaltkreises gefertigt, der die erste SPAD-Diode und die zweite SPAD-Diode umfasst. Der Metallisierungsstapel umfasst bevorzugt mehrere strukturierte metallische Verdrahtungsebenen und mehrere isolierende Isolationsebenen. Die metallischen Verdrahtungsebenen können beispielsweise aus einer Aluminium-Legierung gefertigt sein, die mittels Fotolithografie in Leiterbahnen etc. strukturiert sein können. Die optisch transparenten Isolationsebenen zwischen diesen Leitungsebenen des Metallisierungsstapels können beispielsweise aus Siliziumdioxid oder einem anderen optisch transparenten und geeigneten Isolator gefertigt sein. Auch die Isolationsebenen sind typischerweise fotolithografisch strukturiert und zur Verbindung von Leitungen verschiedener Leitungsebenen mit Durchkontaktierungen versehen. Bevorzugt ist der Metallisierungsstapel im Bereich der beiden SPAD-Dioden so strukturiert und konstruiert, dass von den Photonen, die die ersten SPAD-Diode in Richtung Metallisierungsstapel emittiert, eine größere Menge die zweite SPAD-Diode erreichen kann und Leiterbahnen des Metallisierungsstapels die Photonen nicht daran hindern. Bevorzugt schirmen Leiterbahnen des Metallisierungsstapels den Lichtwellenleiter nach oben und zu den Seiten hin in der Art ab, sodass diese Leiterbahnen zumindest einen Teil der Photonen, die in diese Richtung entweichen wollen, wieder in Richtung der zweiten SPAD-Diode reflektieren. Der Lichtwellenleiter umfasst in seinem Innern daher bevorzugt nur Material der Isolationsschichten und bevorzugt kein Material der Leiterbahnen. Der Lichtwellenleiter des Quantenzufallszahlengenerators 60 verbindet bevorzugt die erste SPAD-Diode mit der zweiten SPAD-Diode optisch. Bevorzugt bedeckt der Lichtwellenleiter des Quantenzufallszahlengenerators 60 sowohl die erste SPAD-Diode als auch die zweite SPAD-Diode um maximal viele Photonen der ersten SPAD-Diode zu erfassen und der zweiten SPAD-Diode zuzuführen. Diese Konstruktion ermöglicht eine maximale Bit-Rate pro Sekunde für die erzeugten Zufallsbits. Die zweite SPAD-Diode ist bevorzugt ebenfalls in Sperrrichtung mit einer Detektionsspannung vorgespannt. Die Detektionsspannung liefert bevorzugt wieder die Spannungsversorgung 5 und/oder eine Teilvorrichtung derselben. Die zweite SPAD-Diode erzeugt ebenfalls durch spontane Emission einzelner Photonen Strompulse einer ersten Maximalhöhe. Wenn nun ein Photon der ersten SPAD-Diode die zweite SPAD-Diode erreicht, so kommt es zu einer stimulierten Emission. Der resultierende Strompuls des SPAD-Diodenstroms der zweiten SPAD-Diode hat dann eine zweite Höhe. Typischerweise ist die erste Höhe in etwa doppelt so hoch wie die zweite Höhe. Vorzugsweise verstärkt ein Transimpedanzverstärker den SPAD-Diodenstrom der zweiten SPAD-Diode und damit die Strompulse der zweiten SPAD-Diode. Ein Komparator vergleicht das verstärkte SPAD-Ausgangssignal mit einem Schwellwert. Der Schwellwert ist vorzugsweise so eingestellt, dass der Komparator für Strompulse der zweiten Höhe eine logische 1 an seinem Ausgang liefert und für Strompulse der ersten Höhe und für den Fall keiner Strompulse eine logische 0 an seinem Ausgang liefert. Bevorzugt zählt ein Zähler, der vorzugsweise mit dem Takt des Oszillators 30 oder eines Takts des Taktsystems der Steuervorrichtung läuft die Zeit zwischen dem Auftreten zweier Einsen am Ausgang des Komparators. Der Zähler stellt einen Zeit-zu-Digital-Wandler dar. Dieser wird Folgenden als Time-to-Digital-Converter bezeichnet. Da die zweite SPAD-Diode eine Totzeit für die Detektion von Photonen aufweist, verwirft der Time-to-Digital-Converter des Quantenzufallszahlengenerators vorzugsweise alle Pulspaare von Eins-Pulsen am Ausgang des Komparators, die zu dicht, also kürzer als diese Totzeit aufeinander folgen. Auf diese Weise erzeugt der Time-to-Digital-Converter des Quantenzufallszahlengenerators 60 eine erste Zahl, die bereits wesentlich von einem Quantenvorgang, nämlich der spontanen Emission der ersten SPAD-Diode und einem zweiten Quantenvorgang, nämlich der stimulierten Emission der zweiten SPAD-Diode, abhängt. Die nachfolgende Entropieextraktionsvorrichtung verwendet nun eine erste Zahl des Time-to-Digital-Converters und eine zweite Zahl des Time-to-Digital-Konverters, wenn die erste Zahl des Time-to-Digital-Konverters und die zweite Zahl des Time-to-Digital-Konverters verschieden sind. Ist die erste Zahl des Time-to-Digital-Converters größer als die zweite Zahl des Time-to-Digital-Converters, so erzeugt die Entropieextraktion ein Zufallsbit mit einem ersten logischen Wert und im anderen Fall ein Zufallsbit mit einem zweiten logischen Wert, der vom ersten Wert verschieden ist. Aus mehreren dieser Zufallsbits erzeugt die Entropieextraktionsvorrichtung des Quantenzufallszahlengenerators dann eine Zufallszahl, die die Entropieextraktionsvorrichtung dann in einem Register des Quantenzufallszahlengenerators 60 dem Rechnerkern 2 der Steuervorrichtung 4 der Sicherung 1 zur Verfügung stellt.

Bevorzugt erzeugt der Rechnerkern 2 der Steuervorrichtung 4 der Sicherung 1 mittels einer dermaßen erzeugten Zufallszahl einen privaten und einen öffentlichen Schlüssel.

Der Rechnerkern 2 der Steuervorrichtung 4 der elektronischen Sicherung 1 übermittelt diesen öffentlichen Schlüssel dann über den Datenbus 9 an einen oder mehrere Rechnerkerne 2 anderer Steuervorrichtungen 4 anderer Sicherungen und/oder an ein übergeordnetes Rechnersystem 12. Diese können dann diesen öffentlichen Schlüssel zur Verschlüsselung von Datenbotschaften in Bitstrom-Paketen BP an den Rechnerkern 2 der Steuervorrichtung 4 der Sicherung 1 über die Datenbusschnittstelle (10, 610, 550, 551) verwenden und dem Rechnerkern 2 der Steuervorrichtung 4 der Sicherung1 auf diese Weise verschlüsselt Daten zusenden.

Bevorzugt erzeugt der Rechnerkern 2 der Steuervorrichtung 4 der Sicherung von Zeit zu Zeit, bevorzugt regelmäßig, ein neues Schlüsselpaar mit Hilfe des Zufallszahlengenerators 30 und verteilt den öffentlichen Schlüssel über den Datenbus 9 dann wieder an einen oder mehrere Rechnerkerne 2 anderer Steuervorrichtungen 4 anderer Sicherungen und/oder an ein übergeordnetes Rechnersystem 12. Der Rechnerkern 2 der Steuervorrichtung 4 der Sicherung 1 kann dann mit seinem privaten Schlüssel die empfangenen verschlüsselten Datenbotschaften entschlüsseln.

Auch das übergeordnete Rechnersystem 12 des Versorgungsnetzwerks 200 umfasst bevorzugt einen oder mehrere solche Zufallszahlengeneratoren 60. Auch hier kann es sich um RNGs oder QRNGs (Quantenzufallszahlengeneratoren) handeln, die dem übergeordneten Rechnersystem 12 Zufallszahlen für die Schlüsselpaarerzeugung zur Verfügung stellen.

Bevorzugt erzeugt das übergeordnete Rechnersystem 12 mittels einer dermaßen erzeugten Zufallszahl eines solchen Zufallszahlengenerators einen privaten und einen öffentlichen Schlüssel.

D das übergeordnete Rechnersystem 12 übermittelt diesen öffentlichen Schlüssel dann über den Datenbus 9 an einen oder mehrere Rechnerkerne 2 anderer Steuervorrichtungen 4 anderer Sicherungen und/oder an ein anderes ggf. vorhandenes übergeordnetes Rechnersystem 12. Diese können dann diesen öffentlichen Schlüssel zur Verschlüsselung von Datenbotschaften in Bitstrom-Paketen BP an das übergeordnete Rechnersystem 12 verwenden und dem übergeordneten Rechnersystem 12 auf diese Weise verschlüsselt Daten zusenden.

Bevorzugt erzeugt das übergeordnete Rechnersystem 12 von Zeit zu Zeit, bevorzugt regelmäßig, ein neues Schlüsselpaar mit Hilfe seines eigenen Zufallszahlengenerators und verteilt den öffentlichen Schlüssel über den Datenbus 9 dann wieder an einen oder mehrere Rechnerkerne 2 anderer Steuervorrichtungen 4 anderer Sicherungen und/oder an das andere übergeordnete Rechnersystem 12. Das übergeordnete Rechnersystem 12 kann dann mit seinem privaten Schlüssel die empfangenen verschlüsselten Datenbotschaften entschlüsseln.

Figur 6

Die Figur 6 entspricht im Wesentlichen der Figur 1, wobei die Steuervorrichtung 4 der Sicherung 1 der Figur 4 eine zusätzliche zweite Datenschnittstelle 610 aufweist. Für die zweite Datenschnittstelle 610 soll das über die erste Datenschnittstelle 10 bereits geschriebene auch zutreffen. insbesondere kann es sich um eine Datenschnittstelle für einen Eindrahtdatenbus und/oder einen differenziellen bidirektionalen Datenbus handeln. Im Automobilbereich kann der Datenbus 9 der zweiten Datenbusschnittstelle 610 beispielsweise ein Lin-Datenbus 9 oder ein DSI3-Datenbus 9 oder ein PSI5-Datenbus 9 oder ein CAN-Datenbus 9 oder ein CAN-FD-Datenbus 9 oder ein Ethernet-Datenbus oder ein Flexray-Datenbus 9 oder ein LVDS-Datenbus 9 oder eine sonst wie drahtgebundene oder drahtlose Datenübertragungsstrecke, beispielsweise über eine Bluetooth- oder eine WLAN-Datenverbindung oder eine optische Datenverbindung 540. Die Datenkommunikation des Rechnerkerns 2 der Steuervorrichtung 4 der Sicherung 1 läuft dabei zusätzlich zur Datenkommunikation über die erste Datenbusschnittstelle 10, 550 über eine drahtgebundene oder drahtlose zweite Schnittstelle 610, 551 ab.

In der Figur 6 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 9, 24, 41, 42, 52, 53, 54, 55, 57, 58, 62. Die Kombination der Vorrichtungteile der hier beschriebenen Figur mit solchen dieser Figuren ist ausdrücklich Teil der Offenbarung des hier vorgelegten Dokuments.

In vielen Fällen ist es gewünscht, dass die Steuervorrichtung 4 einer Sicherung 1 mehr als eine einzige Datenschnittstelle 10 aufweist. Dies kann beispielsweise dann der Fall sein, wenn durch Redundanz eine erhöhte Kommunikationssicherheit erforderlich ist oder durch eine Daisy-Chain beispielsweise eine sichere Adressierung erfolgen soll. Der Rechnerkern 2 der Steuervorrichtung 4 der kann über den internen Datenbus 11 auf diese zweite Datenschnittstelle 610 zugreifen und mit anderen Rechnersystemen 12 und/oder anderen Rechnerkernen 2 anderer Steuervorrichtungen 4 anderer Sicherungen 1 im Versorgungsnetzwerk 200 kommunizieren. Das hier vorgelegte Dokument schlägt daher elektronische Sicherungen 1 mit Steuervorrichtungen 4 vor, die zwei Datenbusschnittstellen (610, 10) für den Sicherungsdatenbus 9 umfassen. Einige dieser zweiten Datenbusschnittstellen 10, 610 können optische Datenschnittstellen 550, 551 sein. Bevorzugt sind einige solcher Sicherungen 1 mit zweit Datenschnittstellen 10, 610 an diesen Sicherungsdatenbus 9 angeschlossen oder mittels jeweils zweier solcher Datenschnittstellen (10, 551, 550, 610) in den Sicherungsdatenbus 9 eingefügt. Es ergibt sich dann ein Versorgungsnetzwerk 200 bei dem ein oder mehrere elektronische Sicherungen (1, 214 bis 217, 225 bis 228, 235 bis 238, 250, 251) jeweils zwei Datenschnittstellen (214 bis 217, 225 bis 228, 235 bis 238, 250, 251, 610, 10) je elektronischer Sicherung (1, 214 bis 217, 225 bis 228, 235 bis 238, 250, 251) aufweisen und die vorzugsweise in den Datenbus 9 eingefügt sind. (Siehe auch Figur 7). Die Rechnerkerne 2 der Steuervorrichtungen (4) der elektronischen Sicherungen der Sicherungen (1, 214 bis 217, 225 bis 228, 235 bis 238, 250, 251) eines solchen Versorgungsnetzwerks 200 über empfangen und senden über eine Datenschnittstelle (10, 610, 550, 551) über diesen Datenbus 9 dann Daten wie Konfigurationsdaten (Schreiben/Lesen), Schaltbefehle (Schreiben/Lesen), Diagnosedaten (Schreiben/Lesen), Messwerte (Lesen), Vergleichswerteinstellungen (Schreiben/Lesen). Beispielsweise ist es denkbar, dass der rechnerkern 2 der Steuervorrichtung 4 einer Sicherung 1 über die erste Datenschnittstelle 10 Daten von einem Rechnerkern 2 der Steuervorrichtung 4 einer anderen Sicherung 1 oder von einem übergeordneten Rechnersystem 12 empfängt und diese Daten dann direkt oder nach Modifikation der Daten über die zweite Datenschnittstelle 610 an einen Rechnerkern 2 einer anderen Steuervorrichtung 4 einer anderen Sicherung 1 und/oder ein oder das übergeordnete Rechnersystem 12 weitersendet. Auf diese Weise kann das übergeordnete Rechnersystem 12 beispielsweise die Funktionstüchtigkeit des Rechnerkerns 2 der Steuervorrichtung 4 der Sicherung 1 überprüfen. Beispielsweise können elektronische Sicherungen (1, 214 bis 217, 225 bis 228, 235 bis 238, 250, 251) eines solchen Versorgungsnetzwerks 200 zwei solche Datenschnittstellen 10 und 610 für den Datenbus 9 umfassen und in den Datenbus 9 eingefügt sein. Auf diese Weise bilden die Sicherungen dann eine lineare Kette von Sicherungen (1, 214 bis 217, 225 bis 228, 235 bis 238, 250, 251) eines solchen Versorgungsnetzwerks 200 entlang zumindest eines Teils des Datenbusses 9. Hierdurch haben die Sicherungen (1, 214 bis 217, 225 bis 228, 235 bis 238, 250, 251) eines solchen Versorgungsnetzwerks 200 dann eine eindeutige physikalische Position, die der Rechnerkern 2 einer Steuervorrichtung 4 einer Sicherung 1 im Rahmen eines Autoadressierungsverfahrens dann für seine Sicherung 1 ermitteln kann und in eine logische Sicherungsadresse seiner Sicherung 1 zur Adressierung von Datenbotschaften in Bit-Strom-Paketen BP an diese Sicherung wandeln kann. Bevorzugt übermittelt der Rechnerkern 2 die von ihm ermittelte Sicherungsadresse nach Abschluss des Autoadressierungsverfahrens zu Betriebsbeginn des Versorgungsnetzwerks 200 an das übergeordnete Rechnersystem 12. Das übergeordnete Rechnersystem 12 prüft dann bevorzugt, ob die übermittelten Sicherungsadressen den Erwartungswerten entsprechen. Sofern dies nicht der Fall ist, wiederholt das übergeordnete Rechnersystem 12 bevorzugt das Autoadressierungsverfahren, was typischerweise zur Folge hat, dass die Rechnerkerne 2 der Steuervorrichtungen 4 der Sicherungen des Versorgungsnetzwerks 200 die bereits ermittelten Sicherungsadressen zugunsten der neu zu ermittelnden Sicherungsadressen verwerfen. Bevorzugt ermittelt ein übergeordnetes Rechnersystem 12, das vorzugsweise am Anfang dieses Teils des Datenbusses 9 angeschlossen ist, mittels Autoadressierung im Zusammenwirken mit den Rechnerkernen 2 der Steuervorrichtungen 4 der elektronischen Sicherungen für jeden der Rechnerkerne 2 der Steuervorrichtungen 4 der elektronischen Sicherungen eine Sicherungsadresse zur Ansteuerung der Rechnerkerne 2 der Steuervorrichtungen 4 der Sicherungen des Versorgungsnetzwerks 200 und übermittelt diese ggf. an die Rechnerkerne 2 der Steuervorrichtungen 4 der elektronischen Sicherungen des Versorgungsnetzwerks 200 übermittelt. Die Datenkommunikation des Rechnerkerns 2 der Steuervorrichtung 4 der Sicherung 1 läuft dabei über eine drahtgebundene oder drahtlose Schnittstelle 610, 10 ab.

Figur 7

Die Figur 7 entspricht in wesentlichen Teilen der Figur 3, wobei der Datenbus 9 als ringförmiger Datenbusring 9' ausgebildet ist. Die Datenschnittstellen 280 bis 293 der Sicherungen (214 bis 217 und 225 bis 228 und 235 bis 238 und 255 und 256) umfassen hier die zwei Datenschnittstellen 10, 610 der Figur 6. Das übergeordnete Rechnersystem 12 steuert wieder das Versorgungsnetzwerk 200.

Das übergeordnete Rechnersystem 12 ist mit einer zweiten Datenbusschnittstelle über den Datenbusring 9' mit der ersten Datenbusschnittstelle der Datenbusschnittstellen 284 der Sicherung 225 des Verbrauchers 220 verbunden.

Die zweite Datenbusschnittstelle der Datenbusschnittstellen 284 der Sicherung 225 des Verbrauchers 220 ist über den Datenbusring 9' mit der ersten Datenbusschnittstelle 285 der Sicherung 226 des Verbrauchers 221 verbunden.

Die zweite Datenbusschnittstelle der Datenbusschnittstellen 285 der Sicherung 226 des Verbrauchers 221 ist über den Datenbusring 9' mit der ersten Datenbusschnittstelle 286 der Sicherung 227 des Verbrauchers 222 verbunden.

Die zweite Datenbusschnittstelle der Datenbusschnittstellen 286 der Sicherung 227 des Verbrauchers 222 ist über den Datenbusring 9' mit der ersten Datenbusschnittstelle 287 der Sicherung 228 des Verbrauchers 223 verbunden.

Die zweite Datenbusschnittstelle der Datenbusschnittstellen 287 der Sicherung 228 des Verbrauchers 223 ist über den Datenbusring 9' mit der ersten Datenbusschnittstelle 288 der Sicherung 235 des Verbrauchers 230 verbunden.

Die zweite Datenbusschnittstelle der Datenbusschnittstellen 288 der Sicherung 235 des Verbrauchers 230 ist über den Datenbusring 9' mit der ersten Datenbusschnittstelle 289 der Sicherung 236 des Verbrauchers 231 verbunden.

Die zweite Datenbusschnittstelle der Datenbusschnittstellen 289 der Sicherung 236 des Verbrauchers 231 ist über den Datenbusring 9' mit der ersten Datenbusschnittstelle 290 der Sicherung 237 des Verbrauchers 232 verbunden.

Die zweite Datenbusschnittstelle der Datenbusschnittstellen 290 der Sicherung 237 des Verbrauchers 232 ist über den Datenbusring 9' mit der ersten Datenbusschnittstelle 291 der Sicherung 238 des Verbrauchers 233 verbunden.

Die zweite Datenbusschnittstelle der Datenbusschnittstellen 291 der Sicherung 238 des Verbrauchers 233 ist über den Datenbusring 9' mit der ersten Datenbusschnittstelle 283 der Sicherung 217 des Verbrauchers 213 verbunden.

Die zweite Datenbusschnittstelle der Datenbusschnittstellen 283 der Sicherung 217 des Verbrauchers 213 ist über den Datenbusring 9' mit der ersten Datenbusschnittstelle 282 der Sicherung 216 des Verbrauchers 212 verbunden.

Die zweite Datenbusschnittstelle der Datenbusschnittstellen 282 der Sicherung 216 des Verbrauchers 212 ist über den Datenbusring 9' mit der ersten Datenbusschnittstelle 281 der Sicherung 215 des Verbrauchers 211 verbunden.

Die zweite Datenbusschnittstelle der Datenbusschnittstellen 281 der Sicherung 215 des Verbrauchers 211 ist über den Datenbusring 9' mit der ersten Datenbusschnittstelle 280 der Sicherung 214 des Verbrauchers 210 verbunden.

Die zweite Datenbusschnittstelle der Datenbusschnittstellen 280 der Sicherung 214 des Verbrauchers 210 ist über den Datenbusring 9' mit der ersten Datenbusschnittstelle 292 der Sicherung 255 der Energiequelle 250 verbunden.

Die zweite Datenbusschnittstelle der Datenbusschnittstellen 292 der Sicherung 255 der Energiequelle 250 ist über den Datenbusring 9' mit der ersten Datenbusschnittstelle 293 der Sicherung 256 der Energiequelle 251 verbunden.

Die zweite Datenbusschnittstelle der Datenbusschnittstellen 293 der Sicherung 256 der Energiequelle 251 ist über den Datenbusring 9' mit der ersten Datenbusschnittstelle des übergeordneten Rechnersystems 12 verbunden.

Dadurch ist der Datenbusring 9' geschlossen. Ein Versorgungsnetzwerk 200 mit einem Datenbusring 9' als Datenbus 9 at den Vorteil, dass bei einer Unterbrechung des Datenbusrings 9' durch einen Fehler oder einen Unfall an einer Stelle die Kommunikation aller Busteilnehmer mit allen anderen Busteilnehmern immer noch möglich ist. Dies ist von besonderer Wichtigkeit, weil typischerweise Versorgungsnetzwerke 200 sicherheitsrelevant sind.

Das hier vorgelegte Dokument verweist hier auch auf die Beschreibung zur Figur 6, die im Wesentlichen die Sicherungen der Figur 7 wiedergibt.

Das hier vorgelegte Dokument erläutert an dem Beispiel der Figur 7 das gezielte Abwerfen von Versorgungsteilnetzen. Das Versorgungsnetzwerk 200 des Fahrzeugs umfasst u.a. Vorrichtungsteile 210, einen Kabelbaum mit Leitungsabschnitten 240, 241, 245, zumindest eine Energiequelle 250, 251, zumindest einen Steuerrechner 12 - beispielsweise ein übergeordnetes Rechnersystem 12 - und zumindest zwei elektronische Sicherungen 214, 225. Typischerweise sind die Vorrichtungteile 220 elektrische Verbraucher. Zumindest eine oder mehrere Energiequellen 250, 251 des Versorgungsnetzwerks 200 versorgen zumindest zwei der Vorrichtungteile 210, 220 mit elektrischer Energie über den Kabelbaum mit den Leitungsabschnitten 240, 241, 245. Die elektronischen Sicherungen 214, 225 sind in den Kabelbaum mit Leitungsabschnitten 240, 241, 245 eingefügt. Vorzugsweise jede der elektrischen Sicherungen 214, 225 ist zumindest einem, als Zahl 1, elektrischen Verbraucher (210, 225) zugeordnet, der im Folgenden als der jeweiligen elektronischen Sicherung zugeordneter elektrischer Verbraucher bezeichnet wird. Eine Sicherung der Sicherungen 214, 215 kann dabei die Energieversorgung des dieser Sicherung zugeordneten elektrischen Verbrauchers in Abhängigkeit von einem Steuersignal des Steuerrechners, also des übergeordneten Rechnersystems 12, ermöglichen oder unterbinden kann. Ein solches Steuersignal erhält der Rechnerkern der Steuervorrichtung der betreffenden Sicherung typischerweise über den Datenbus 9, hier über den Datenringbus 9'. Eine diesem Verbraucher zugeordnete Sicherung kann dann die Energieversorgung des dieser Sicherung zugeordneten elektrischen Verbrauchers mittels der entsprechenden Sicherung, die diesem Verbraucher zugeordnet ist, unterbinden. Vorzugsweise stellt der Steuerrechner 12, also beispielsweise das übergeordnete Rechnersystem 12 eine verschlüsselte Datenverbindung 720 zwischen dem Steuerrechner 12 des Fahrzeugs, also beispielsweise dem übergeordneten Rechnersystem 12, und einem Rechner 710 eines Dienstanbieters, insbesondere einem Rechnersystem des Automobilherstellers des Fahrzeugs, her. Der Steuerrechner 12 des Fahrzeugs, also beispielsweise das übergeordnete Rechnersystem 12, authentifiziert das Fahrzeug vorzugsweise beim Rechner 710 des Dienstanbieters. Die Authentifizierungsdaten des Fahrzeugs können dabei beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen. Typischerweise authentifiziert der Rechner 710 des Dienstanbieters sich im Gegenzug beim Steuerrechner 12 des Fahrzeugs, beispielsweise bei einem übergeordneten Rechnersystem 12 des Fahrzeugs. Ggf. authentifiziert sich die anfordernde Person 730 mittel Eingaben und/oder biometrische Sensordaten wie eine Fingerabdruckerkennung über den Steuerrechner 12 des Fahrzeugs, beispielsweise über das übergeordnete Rechnersystem 12, beim Rechner 710 des Dienstanbieters. Dabei können die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen. Der Rechner 710 des Dienstanbieters erzeugt dann bevorzugt einen Freischaltcode oder stellt diesen bereit. Der Rechner 710 des Dienstanbieters übermittelt den Freischaltcode über die sichere Datenverbindung 720 an den Steuerrechner 12 des Fahrzeugs, beispielsweise an das übergeordnete Rechnersystem 12. Der Steuerrechner 12 des Fahrzeugs, also das übergeordnete Rechnersystem 12 verifiziert bevorzugt die Zulässigkeit und/oder die syntaktische Korrektheit und/oder die situative Zulässigkeit des Freischaltcodes. Sofern diese Verifikation erfolgreich war, ermöglicht der Steuerrechner 12 des Fahrzeugs, also das übergeordnete Rechnersystem 12 des Fahrzeugs die Energieversorgung eines der Sicherung zugeordneten elektrischen Verbrauchers 220 mittels der entsprechenden Sicherung 225, wenn der Freischaltcode zulässig und/oder syntaktisch Korrekt und/oder der situativ zulässig ist. Hierzu setzt der übergeordnete Steuerrechner 12 des Fahrzeugs, als das übergeordnete Rechnersystem 12, über den Datenbus 9 ein Kommando an den Rechnerkern 2 der Steuervorrichtung 4 der entsprechenden Sicherung ab. Vorzugsweise ist dieses Kommando verschlüsselt, so dass der Rechnerkern 2 der Steuervorrichtung 4 der Sicherung verifizieren kann, ob das Kommando von einem zuverlässigen übergeordneten Rechnersystem 12 abgesetzt wurde. Empfängt der Rechnerkern 2 der Steuervorrichtung 4 der entsprechenden Sicherung ein dermaßen abgesichertes Kommando, so schließt der Rechnerkern 12 der Steuervorrichtung 4 der entsprechenden Sicherung den Leistungsschalter 17 dieser Sicherung und erlaubt damit die Energieversorgung des nachfolgenden Versorgungteilnetzwerkes über diesen Leistungsschalter 17. Bevorzugt übermittelt das übergeordnete Rechnersystem 12 über die Datenverbindung 720 Abrechnungsdaten an einen oder den Rechner 710 eines oder des Dienstanbieters, insbesondere an ein oder das Rechnersystem des Automobilherstellers, wobei vorzugsweise eine Speicherinformation im Rechner 710 des Dienstanbieters markiert, dass die Rechnung noch nicht bezahlt ist. Vorzugsweise erstellt der Rechner 710 des Dienstanbieters bzw. des Automobilherstellers eine Rechnung in Abhängigkeit von den übermittelten Abrechnungsdaten. Der Rechner 710 des Dienstanbieters übermittelt die Rechnung dann bevorzugt an ein oder das Rechnersystem 740 der bestellenden Person 730, oder an die bestellende Person 730. Die bestellende Person 730 oder ein Rechner (710) eines oder des Dienstanbieters begleichen dann bevorzugt diese Rechnung. Der Rechner des Dienstanbieters 740 markiert dann die Speicherinformation im Rechner des Dienstanbieters (740), dass die Rechnung bezahlt ist.

Ein vorschlagsgemäßes Fahrzeug umfasst Vorrichtungteile 210, zumindest einen Kabelbaum 1515 mit Leitungsabschnitten 240, 241, 245, zumindest eine Energiequelle 250, 251, zumindest einen Steuerrechner 12 - beispielsweise ein übergeordnetes Rechnersystem 12 - zumindest zwei elektronische Sicherungen 214, 225. Die Vorrichtungteile (220) sind typischerweise elektrische Verbraucher. Die zumindest zwei Energiequellen 250, 251 des Versorgungsnetzwerks 200 des Fahrzeugs versorgen ein oder mehrere der Vorrichtungsteile 210, 220 mit elektrischer Energie über den Kabelbaum mit Leitungsabschnitten 240, 241, 245. Die elektronischen Sicherungen 255, 256 sind in den Kabelbaum des Versorgungsnetzwerks, das Leitungsabschnitte 240, 241, 245 umfasst, eingefügt. Bevorzugt ist im Wesentlichen jeder der elektrischen Sicherungen 255, 256 zumindest eine, als Zahl 1, elektrische Energiequelle 250, 251 zugeordnet, die im Folgenden als zugeordnete elektrische Energiequelle 250, 251 bezeichnet wird. Das Wort "eingefügt" kann hier bedeuten, dass die elektronische Sicherung 255, 256 einen Leitungsabschnitt 240, 241, 241 mit der dieser Sicherung 255, 256 zugeordneten elektrischen Energiequelle 250, 251 verbinden kann oder die dieser Sicherung 255, 256 zugeordnete elektrische Energiequelle 250, 251 von diesem Leitungsabschnitt 240, 241, 241 trennen kann. Eine jeweilige Sicherung der Sicherungen 255, 256 kann die Energielieferung der jeweils zugeordneten elektrischen Energiequelle 250, 251 in Abhängigkeit von einem Steuersignal des Steuerrechners 12 - beispielsweise des übergeordneten Rechnersystems 12 - ermöglichen oder unterbinden. Die entsprechende zugeordnete Sicherung 255, 260 kann die Energielieferung einer zugeordneten elektrischen Energiequelle 250, 251 unterbinden. Der Steuerrechner 12 stellt eine verschlüsselte Verbindung 720 zwischen dem Steuerrechner 12 des Fahrzeugs, beispielsweise dem übergeordneten Rechnersystem 12, und einem Rechner 710 eines Dienstanbieters, insbesondere einem Rechnersystem 710 des Automobilherstellers her. Der Steuerrechner 12 des Fahrzeugs -beispielsweise das übergeordnete Rechnersystem 12 -authentifiziert das Fahrzeugs beim Rechner 710 des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können. Der Rechner 710 des Dienstanbieters authentifiziert sich ebenfalls beim Steuerrechner 12 des Fahrzeugs, beispielsweise beim übergeordneten Rechnersystem 12. Ggf. authentifiziert sich die anfordernden Person 730 unter Benutzung des Steuerrechners 12 des Fahrzeugs, beispielsweise unter Benutzung des übergeordneten Rechnersystems 12, beim Rechner 710 des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen können. Der Rechner 710 des Dienstanbieters erzeugt einem Freischaltcodes oder stellt diesen Freischaltcode bereit. Der Rechner 710 des Dienstanbieters übermittelt dann den Freischaltcode an den Steuerrechner 12 des Fahrzeugs, beispielsweise an das übergeordnete Rechnersystem 12. Der Steuerrechner 12 des Fahrzeugs, also beispielsweise das übergeordnete Rechnersystem 12, verifiziert dann die Zulässigkeit und/oder syntaktischen Korrektheit und/oder der situativen Zulässigkeit des Freischaltcodes. Bei erfolgreicher Verifikation des Freischaltcodes ermöglicht der Steuerrechner 12 des Fahrzeugs die Energielieferung einer zugeordneten elektrischen Energiequelle (250, 251) mittels der entsprechenden, zugeordneten Sicherung 255, 260. Hierzu sendet der Steuerrechner 12 des Fahrzeugs ein entsprechendes Kommando über den Datenbus 9 an die betreffende Sicherung 255, 260. Bevorzugt ist die Kommunikation zwischen dem Steuerrechner 12 und der Sicherung 255, 260 verschlüsselt. Bevorzugt ist die Kommunikation PQC verschlüsselt. Bevorzugt hat sich der Steuerrechner 12 des Fahrzeugs zuvor bei dem Rechnerkern 2 der Steuervorrichtung 4 der betreffenden Sicherung 250, 260 zumindest einmalig authentifiziert. Bevorzugt hat sich der Rechnerkern 2 der Steuervorrichtung 4 der betreffenden Sicherung 250, 260 zuvor bei dem Steuerrechner 12 des Fahrzeugs, also dem übergeordneten Rechnersystem 12, authentifiziert. Bevorzugt übermittelt der Steuerrechner 12 des Fahrzeugs Abrechnungsdaten an einen oder den Rechner 710 eines oder des Dienstanbieters, insbesondere an ein oder das Rechnersystem des Automobilherstellers, wobei eine Speicherinformation im Rechner 710 des Dienstanbieters markiert, dass die Rechnung nicht bezahlt ist. Bevorzugt erstellen dann ein Rechner 710 oder der Rechner 710 eines Dienstanbieters oder des Dienstanbieters, insbesondere an ein Rechnersystem des Automobilherstellers oder das Rechnersystem des Automobilherstellers eine Rechnung in Abhängigkeit von diesen übermittelten Abrechnungsdaten. Die Abrechnungsdaten können beispielsweise die Dauer der Nutzung bestimmter Verbraucher oder Energiequellen oder bestimmter Leitungsabschnitt oder die Ermittlung bestimmter Betriebsparameter oder die Zurverfügungstellung bestimmter Verfahren zum Betrieb des Fahrzeugs oder dessen Vorrichtungsteilen betreffen. Ein Rechner 710 oder der Rechner 710 eines Dienstanbieters oder des Dienstanbieters übermitteln die so erstellte Rechnung dann bevorzugt an einem Rechner 750 oder den Rechner 750 eines Dienstanbieters oder des Dienstanbieters, insbesondere an ein Rechnersystem oder das Rechnersystem der bestellenden Person, oder an die bestellende Person 730. Ein Rechner 750 oder der Rechner 750 eines Dienstanbieters oder des Dienstanbieters und/oder die anfordernde Person 730 begleichen dann bevorzugt die Rechnung. Bevorzugt ist hierfür eine Eingabe der anfordernden Person 730 erforderlich. Vorzugsweise markiert der Rechner 710 des Dienstanbieters die Speicherinformation im Rechner 710 des Dienstanbieters, dass die Rechnung bezahlt ist.

Beispielsweise kann ein Rechner 710 eines Dienstanbieters oder des Automobilherstellers mit Hilfe der übermittelten Abrechnungsdaten eine Prognose der Ausfallwahrscheinlichkeit eines Vorrichtungsteils des Fahrzeugs mittels der Fahrzeugdaten und/oder Betriebsdaten und/oder Messwerten und/oder Schadensdaten erstellen. Dieser Rechner 710 kann diese Prognoseergebnisse dann an einen Server 1985 und/oder ein Terminal der Werkstatt und/oder ein Terminal 740 und/oder einen Rechner eines Fahrzeughalters 730 und/oder ein Terminal 740 und/oder einen Rechner eines Fahrzeugführers 730 oder ein Terminal und/oder einen Server 710 eines Automobilherstellers und/oder ein Terminal und/oder Server eines Logistikunternehmens und/oder ein Terminal und/oder einen Server eines sonstigen Nutzers dieser Daten übermitteln und dort ggf. zur Anzeige bringen.

Das Fahrzeug kann ein solches System auch zur Erkennung von Fehlbedienungen nutzen. Beispielsweise kann der Rechnerkern 2 einer Steuervorrichtung 4 einer elektronischen Sicherung im Falle eines Hot-Plug-Ereignisses im Versorgungsnetzwerk 3100, also dem insbesondere unerlaubten Lösen oder Schließen einer elektrischen Steckverbindung unter Strom und/oder Spannung, eine Meldung an einen Rechner 710, 750 eines Dienstanbieters und/oder des Automobilherstellers übermitteln. Der Rechnerkern 2 der Steuervorrichtung 4 einer elektronischen Sicherung kann im Falle eines Hot-Plug-Ereignisses im Versorgungsnetzwerk 200 eines Fahrzeugs eine Meldung an einen Rechner 710 eines Fahrzeugherstellers oder eines Dienstanbieters unmittelbar oder zeitversetzt übermitteln oder solche Informationen beispielsweise in einem Speicher eines übergeordneten Rechners 12 bereitstellen.

Vorzugsweise tauschen die Rechner in dem Versorgungsnetzwerk 200 Sicherheitscodes verschlüsselt mittels Datenbotschaften in den über den Datenbus 9 ausgetauschten Bit-Strom-Paketen BP aus. Diese Sicherheitscodes sind besondere Freischaltcodes, die das Einschalten oder Ausschalten einzelner Leistungsschalter 17 einzelner Sicherungen im Versorgungsnetzwerk 200 ermöglichen. Bevorzugt prüft der Rechnerkern 2 der Steuervorrichtung 4 einer Sicherung einen erhaltenen Einschalt- bzw. Ausschaltbefehl für den Leistungsschalter 17 seiner Sicherung auf Zulässigkeit mit Hilfe eines ebenfalls an diesen Rechnerkern 2 der Steuervorrichtung 4 der Sicherung übermittelten Sicherheitscodes. Dabei kann der Rechnerkern 2 der Steuervorrichtung 4 der Sicherung Faktoren wie Zeit der Übermittlung, durch den Leistungsschalter 17 fließende Stromstärke, Spannung von Anschlüssen 18, 19 des Leistungsschalters 17 gegen ein Bezugspotenzial, Zustand anderer Sicherungen im Versorgungsnetzwerk 200, Priorität des nachgelagerten Versorgungsteilnetzwerks und/oder darin enthaltener Verbraucher und/oder darin enthaltener Energiequellen und/oder Ursprungsrechner des Sicherheitscodes und/oder übermittelnder Rechner des Sicherheitscodes, Nutzereingaben, Mitteilungen anderer Rechner 710, 750 etc. berücksichtigen.

Beispielsweise kann ein Dienstleistungsanbieter oder der Automobilhersteller oder ein Erfüllungsgehilfe des Automobilherstellers mittels eines Servers 710 den Sicherheitscode oder Daten zur Erzeugung des Sicherheitscodes durch das übergeordnete Rechnersystem 12 oder durch Rechnerkerne 2 der Steuervorrichtungen 4 der elektronischen Sicherungen an das übergeordnete Rechnersystem 12 oder einen Rechnerkern 2 einer Steuervorrichtung 4 der elektronischen Sicherung übermitteln.

Beispielsweise kann der Sicherungsdatenbus 9 direkt oder indirekt z.B. über Gateways oder dergleichen mit einem Terminal 740 für eine manuelle Nutzer-Eingabe zur Umkonfiguration des Versorgungsnetzwerks 200 mittels der elektronischen Sicherungen des Versorgungsnetzwerks versehen sein.

Das Terminal 740 kann dazu eingerichtet sein, auch der Übermittlung von Authentifizierungsdaten, an einen Server 710 des Automobilherstellers oder eines Erfüllungsgehilfen des Automobilherstellers zu dienen, wobei die die Authentifizierungsdaten insbesondere Authentifizierungsdaten der bedienenden Person 730 und/oder Authentifizierungsdaten der Organisation, für die die Person 730 tätig ist, und/oder Authentifizierungsdaten des Fahrzeugs oder und/oder Authentifizierungsdaten des Autoschlüssels des Fahrzeugs und/oder der ähnliche Authentifizierungsdaten umfassen können. Insbesondere kann es sich bei den Authentifizierungsdaten um Daten einer Signaturkarte oder dergleichen und/oder biometrische Daten wie beispielsweise Daten eines Fingerabdruckscanners und/oder eines Retina-Scanners oder dergleichen oder Daten, die aus solchen Daten abgeleitet sin, handeln. Das Terminal 740 ist dann vorzugsweise dazu eingerichtet, den Sicherheitscode von dem Server 710 des Automobilherstellers oder eines Erfüllungsgehilfen des Automobilherstellers in Abhängigkeit von den so ermittelten Authentifizierungsdaten zu erhalten.

Vorzugsweise sind ein oder mehrere Rechnerkerne 2 von Steuervorrichtungen 4 elektronischer Sicherungen der elektronischen Sicherungen im Versorgungsnetzwerk 200 dazu eingerichtet, Messwerte mittels Messmitteln dieser elektronischen Sicherungen zu ermitteln und diese Messwerte über den Sicherungsdatenbus 9 an ein übergeordnetes Rechnersystem 12 zu übertragen.

Bevorzugt ist das übergeordnete Rechnersystem 12 dazu eingerichtet, ein neuronales Netzwerkmodell auszuführen und die ermittelten Messwerte und/oder davon abhängige Werte als Eingangswerte des neuronalen Netzwerkmodells zu verwenden. Bevorzugt hängen dann zumindest der Schaltzustand eines Leistungsschalters 17 einer elektronischen Sicherung im Versorgungsnetzwerk 200 und/oder die Schaltzustände mehrerer Leistungsschalters 17 mehrerer elektronischer Sicherungen im Versorgungsnetzwerk 200 und/oder zumindest eine Datenbotschaft des übergeordneten Rechnersystems 12 an ein anderes Rechnersystem 710, 750, 740) oder eine Signalisierung des übergeordneten Rechnersystems 12 an einen Nutzer 730 von einem Ausgangssignal und/oder Ausgangswert des neuronalen Netzwerkmodells ab.

Das übergeordnete Rechnersystem 12 kann auch dazu eingerichtet sein, Spektralanalysen der Daten der Verläufe von Messwerten der Messvorrichtungen der Sicherungen im Versorgungsnetzwerk, beispielsweise durch Fourier- oder Laplace-Transformation oder Wavelet-Transformation, durchzuführen und Werte der Spektren zu ermitteln. Das übergeordnete Rechnersystem 12 kann dann dazu eingerichtet sein, bei wesentlichen Abweichungen der Werte der Spektren von Erwartungswertintervallen für die Werte der Spektren auf die Notwendigkeit einer präventiven Wartung zu schließen oder eine Signalisierung an ein anderes Rechnersystem 750, 710 oder eine Anzeige 740 vorzunehmen. Das übergeordnete Rechnersystem 12 kann auch dazu eingerichtet sein, Spektralanalysen der Daten der Verläufe, beispielsweise durch Fourier- oder Laplace-Transformation oder Wavelet-Transformation, durchzuführen und Werte der Spektren zu ermitteln und die Systemverfügbarkeit von Vorrichtungsteilen des Versorgungsnetzwerks und/oder des Versorgungsnetzwerks 200 selbst mittels ermittelter Spektren zu bewerten und ggf. das Bewertungsergebnis an andere Rechnersysteme 710, 750, 740, 4 zu signalisieren und/oder Parameter des Fahrzeugs in Abhängigkeit von dieser Bewertung zu ändern. Die anderen Rechnersysteme können Terminals 740 eines Nutzers 730 und/oder Rechner 710 eines Fahrzeugherstellers oder Rechner 710, 750 eines oder mehrerer Dienstanbieter und/oder einer Werkstatt oder ein übergeordnetes Rechnersystem 12 des Fahrzeugs oder ein Rechnerkern 2 einer Steuervorrichtung 4 einer Sicherung des Versorgungsnetzwerks 200 sein.

Bevorzugt umfasst das vorgestellte Versorgungsnetzwerk zumindest zeitweise einen Rechner (Server) 710 eines Dienstanbieters, insbesondere ein Rechnersystem eines Automobilherstellers und somit ggf. auch einer Werkstatt. Eine vorzugsweise verschlüsselte Datenverbindung 720 zwischen dem Steuerrechner des Fahrzeugs - z. B. einem übergeordneten Rechnersystem 12 -und einem Rechner 710) eines Dienstanbieters, insbesondere einem Rechnersystem des Automobilherstellers des Fahrzeugs stellt die Kommunikation sicher. Eine anfordernde / bedienende Person bzw. Nutzer 730 kann über ein Dateneingabemittel und/oder Datenausgabemittel - beispielsweise ein Terminal 740 - Zugriff auf die Rechner 4, 12 des Versorgungsnetzwerks 200 und damit auf den Schaltzustand der Leistungsschalter 17 der Sicherungen nehmen. Neben dem Rechner 710 des Fahrzeugherstellers oder eines Dienstleistungsanbieters können weitere Rechner 750 weiterer Dienstanbieter oder weiterer Rechner des Dienstanbieters, der den Rechner 710 kontrolliert, mit den Rechnern des Versorgungsnetzwerks 200 über den Datenbus 9 und das übergeordnete Rechnersystem 12 über drahtgebundene und/oder drahtlose Datenverbindungen in Verbindung treten.;

Figur 8

Die Figur 8 entspricht in den wichtigsten Teilen der Figur 4.

Das Versorgungsteilnetzwerk der Figur 8 umfasst eine weitere Sicherung 805, eine zweite weitere Sicherung 810, einen ersten angeschlossenen Verteilungsbaum 815, einen zweiten angeschlossenen Verteilungsbaum 820, eine elektronische Sicherung 825, Verbraucher 830 und weitere Verbraucher 835. Die anderen Teile der Figur 8 wurden bereits im Zusammenhang mit der Figur 4 erläutert.

Bevorzugt überträgt ein Rechnerkern 2 einer Steuervorrichtung 4 einer elektronischen Sicherung 825 Parameter der an die elektronische Sicherung 825 angeschlossenen Versorgungsteilbäume 815 und/oder einzelner Knoten der angeschlossenen Versorgungsteilbäume 815 und/oder einzelner angeschlossener Versorgungsleitungsabschnitte des Versorgungsbaums der Versorgungsleitungen des Fahrzeugs an einen Rechnerkern 2 einer Steuervorrichtung 4 einer anderen elektronischen Sicherung 805 und/oder ein oder mehrere Steuergeräte des Fahrzeugs und/oder ein übergeordnetes Rechnersystem 12. Solche Parameter können insbesondere Messwerte, die der Rechnerkern 2 der Steuervorrichtung 4 einer Sicherung mittels Messvorrichtungen der Steuervorrichtung 4 der Sicherung erfasst sein. Solche Parameter können beispielsweise ein direkt zugänglicher Parameter, wie Temperatur eines Temperatursensors 40, 586, die Spannung eines Knotens 26, 27, 28 innerhalb der Sicherung gegen ein Bezugspotenzial 201 und/oder die Spannung eines Knotens des Versorgungsbaumes gegen ein Bezugspotenzial 201, und/oder der Stromwert eines elektrischen Stromes in einem Versorgungsleitungsabschnitt des angeschlossenen Versorgungsbaumes 820 sein.

Mittels dieses Austausches von erfassten Messwerten und/oder Parametern kann der Rechnerkern 2 der Steuervorrichtung 4 einer elektronischen Sicherung 825, 805 insbesondere durch Anwendung der Kirchhoffschen Gleichungen auf Daten, die der Rechnerkern 2 der Steuervorrichtung 4 der elektronischen Sicherung 825, 805 mittels Messvorrichtungen der Steuervorrichtung 4 dieser elektronischen Sicherung 825, 805 ermittelt hat oder die der Rechnerkern 2 der Steuervorrichtung 4 dieser elektronischen Sicherung 825 von den Rechnerkernen 2 der Steuervorrichtungen 4 anderer elektronischer Sicherungen 805 oder von übergeordneten Rechnersystemen 12, beispielsweise einem über- geordneten Rechnersystem 12, erhalten hat, abgeleitete Parameter, wie beispielsweise Leckströme gegen andere elektrische Knoten im Fahrzeug oder elektrische Widerstände von Versorgungsspannungsleitungsabschnitten, erfassen bzw. ermitteln.

Bevorzugt schätzt der Rechnerkern 2 der Steuervorrichtung 4 der elektronischen Sicherung 825 die Temperatur eines nachfolgenden Versorgungsleitungsabschnitts, die infolge des elektrischen Stromes 29 in diesen Versorgungsleitungsabschnitt hinein und den Spannungsabfall über diesen Versorgungsleitungsabschnitt erhöht ist. Eine solche Schätzung ist auch möglich, wenn dessen ohmscher Widerstand und dessen Wärmekapazität und dessen thermische Ableitwiderstände und die Umgebungstemperatur im Bereich des Versorgungsleitungsabschnitts näherungsweise, z.B. durch Schätzung durch den rechnerkern 2 der Steuervorrichtung 4 der elektronischen Sicherung 825 und/oder per Datenübermittlung vom übergeordneten Rechnersystem 12 her und/oder per Datenübermittlung vom übergeordneten Rechnersystem 12 her dem rechnerkern 2 der Steuervorrichtung 4 der Sicherung 825 bekannt sind.

Vorzugsweise ermittelt der Rechnerkern 2 der Steuervorrichtung 4 der elektronischen Sicherung 825 mittels einer Spannungsmessvorrichtung 16 den Spannungswert der Spannung eines Knotens 22, 25, 21 am Leistungsschalter 17 der elektronischen Sicherung 825 oder eines damit in Zusammenhang stehenden Knotens gegenüber einem Bezugspotenzial 201, um solche Abschätzungen, wie die vorstehende zu ermöglichen und/oder um Über- oder Unterspannungen detektieren zu können und an ein übergeordnetes Rechnersystem 12 über den Datenbus 9 melden zu können. Bevorzugt ermittelt der Rechnerkern der Steuervorrichtung 4 der elektronischen Sicherung 825 den Stromwert des Stroms 29 durch den Leistungsschalter 17 der elektronischen Sicherung 825. Der Rechnerkern 2 der Steuervorrichtung 4 der elektronischen Sicherung 825 und/oder ein übergeordnetes Rechnersystem 12 ermitteln bevorzugt aus dem Stromwert und/oder dem Spannungswert den Leistungswert der in den Verbraucher oder einen nachfolgenden Versorgungsbaum 815, 820 oder in einen nachfolgenden Versorgungsleitungsabschnitt eingespeisten elektrischen Leistung. Übersteigt diese Leistungseinspeisung einen Leistungseinspeisungsschwellwert, so öffnet der Rechnerkern 2 der Steuervorrichtung 4 der Sicherung 825 vorzugsweise den Leistungsschalter 17 der Sicherung 825 und signalisiert vorzugsweise über den Datenbus 9 diese Öffnung des Leistungsschalters 17 an das übergeordnete Rechnersystem 12.

Typischerweise ermittelt der Rechnerkern 2 der Steuervorrichtung 4 der elektronischen Sicherung 825 mittels einer Spannungsmessvorrichtung den Spannungswert der Spannung eines Knotens 22, 25, 21 am Leistungsschalter 17 der elektronischen Sicherung 805 oder eines damit in Zusammenhang stehenden Knotens gegenüber einem Bezugspotenzial 201 und den Stromwert des Stroms 29 durch den Leistungsschalter 17 der elektronischen Sicherung. Der Rechnerkern 2 der Steuervorrichtung 4 der elektronischen Sicherung 825 und/oder ein übergeordnetes Rechnersystem 12 ermitteln aus dem Stromwert und dem Spannungswert den Leistungswert der aus der Energiequelle oder aus einem vorausgehenden Versorgungsbaum oder aus einen vorausgehenden Versorgungsleitungsabschnitt fließende elektrische Leistung. Übersteigt diese Leistungsentnahme einen Leistungsentnahmeschwellwert, so öffnet der Rechnerkern 2 der Steuervorrichtung 4 der Sicherung 825 vorzugsweise den Leistungsschalter 17 der Sicherung 825 und signalisiert vorzugsweise über den Datenbus 9 diese Öffnung des Leistungsschalters 17 an das übergeordnete Rechnersystem 12.

Vorzugsweise übermittelt der rechnerkern 2 der Steuervorrichtung 4 der elektronischen Sicherung 805 diesen Leistungswert über den Sicherungsdatenbus 9 an die Steuervorrichtung 4 einer anderen elektronischen Sicherung 825 oder das übergeordnete Rechnersystem 12 des Versorgungsnetzwerks 200. Bei dem übergeordneten Rechnersystem 12 kann es sich auch um einen Server 710, 750 eines Energieanbieters oder eines der Erfüllungsgehilfen eines Energieanbeters oder des Fahrzeugherstellers oder eines anderen Dienstanbieters handelt.

Vorzugsweise umfasst eine vorschlaggemäße elektronische Sicherung 825, 1 eine Steuervorrichtung 4 mit einer Uhr oder einem Zeitgeber 35. Der Rechnerkern 2 der Steuervorrichtung 4 der Sicherung 1, 85 verwendet diesen Zeitgeber 35 bevorzugt für die Erzeugung von Zeitstempeln einer Log-Tabelle, die der Rechnerkern 2 der Steuervorrichtung 4 der Sicherung 825 bevorzugt in einem Speicher der Steuervorrichtung 4 der Sicherung 825 anlegt oder die das übergeordnete Rechnersystem 12 bevorzugt in einem Speicher des übergeordneten Rechnersystems 12 anlegt oder die der Rechnerkern 2 einer Steuervorrichtung 4 einer anderen Sicherung 805 in dem Speicher dieser Steuervorrichtung 4 der anderen Sicherung 805 anlegt.

Vorzugsweise weisen die Uhr bzw. der Zeitgeber 35 der Steuervorrichtung 4 der elektronischen Sicherung 1, 825 eine Synchronisationsmöglichkeit mit den Uhren und Zeitgebern 35 der Steuervorrichtungen 4 anderer elektronischer Sicherungen 805, 810 und/oder mit den Uhren und/oder Zeitgebern 1970 eines übergeordneten Rechnersystems 12 aufweist.

Bei einer vorschlagsgemäßen elektronischen Sicherung 825 führt der Rechnerkern 2 der Steuervorrichtung 4 dieser elektronischen Sicherung 825 vorzugsweise eine Abschaltung des Leistungsschalters 17 nach Empfang eines Abschaltsignals und/oder eines Abschaltkommandos über den Sicherungsdatenbus 9 erst nach Ablauf einer Abschaltverzögerungszeit durch. Vorzugswiese bestimmt der Rechnerkern 2 der Steuervorrichtung 4 der elektronischen Sicherung 825 die Zeit seit dem Empfang des Abschaltsignals bzw. Abschaltkommandos mit Hilfe des Zeitgebers 35 der Steuerungsvorrichtung 4 der elektronischen Sicherung 825. Vorzugsweise führt der Rechnerkern 2 der Steuerungsvorrichtung 4 der elektronischen Sicherung 825 die Abschaltung des Leistungsschalters 9 unverzüglich aus, wenn der Betrag des Werts des elektrischen Stromes 29 durch den Leistungsschalter 17 der elektronischen Sicherung 825 einen Schwellwert und/oder wenn der Betrag der Leistungseinspeisung in das nachfolgende Versorgungsteilnetzwerk und/oder in den nachfolgenden Versorgungsleitungsabschnitt oder in einen nachfolgenden Verbraucher einen Leistungseinspeisungsschwellwert überschreitet und/oder wenn der Betrag der Leistungsentnahme aus dem vorausgehenden Versorgungsteilnetzwerk und/oder in dem vorausgehenden Versorgungsleitungsabschnitt oder aus einer vorausgehenden Energiequelle einen Leistungsentnahmeschwellwert überschreitet. unverzüglich bedeutet dabei, dass der Rechnerkern 2 die Abschaltung in weniger als 100µs, besser in weniger als 50µs, besser in weniger als 20µs, besser in weniger als 10µs, besser in weniger als 5µs, besser in weniger als 2µs, besser in weniger als 1µs, besser in weniger als 500ns, besser in weniger als 200ns, besser in weniger als 100ns durchführt.

Vorzugsweise hängt die Abschaltverzögerungszeit von dem Betrag des Werts des elektrischen Stroms 29 durch den Leistungsschalter 17 und/oder von dem der Betrag der Leistungseinspeisung in das nachfolgende Versorgungsteilnetzwerk und/oder in den nachfolgenden Versorgungsleitungsabschnitt oder in einen nachfolgenden Verbraucher einen Leistungseinspeisungsschwellwert überschreitet und/oder von dem Betrag der Leistungsentnahme aus dem vorausgehenden Versorgungsteilnetzwerk und/oder in dem vorausgehenden Versorgungsleitungsabschnitt oder aus einer vorausgehenden Energiequelle ab.

Vorzugsweise hängt die Abschaltverzögerungszeit darüber hinaus von dem Betrag des Werts des elektrischen Stroms 29 durch den Leistungsschalter 17 mit zunehmendem Betrag des Werts des elektrischen Stroms 29 durch den Leistungsschalter 17 parabelförmig fallend ab.

Vorzugsweise integriert zeitlich der Rechnerkern 2 der Steuervorrichtung 4 der elektronischen Sicherung 825 das Betragsquadrat des Werts des elektrischen Stromes 29 durch den Leistungsschalter 17 der elektronischen Sicherung 825 und emuliert auf diese Weise das Verhalten einer Schmelzsicherung. Vorzugsweise öffnet der Rechnerkern 2 der Steuervorrichtung 4 der elektronischen Sicherung 825 den Leistungsschalter 17 der elektronischen Sicherung 825, wenn der Betrag des zeitlichen Integrals des Quadrats des Betrags des Stromes 29 durch den Leistungtransistor 17 einen Stromquadratschwellwert überschreitet. Statt des Quadrats des Betrags des elektrischen Stromes 29 durch den Leistungsschalter 17 der elektronischen Sicherung 825 kenn der Rechnerkern 2 der Steuervorrichtung 4 der elektronischen Sicherung auch das Integral eines Polynoms von mindestens zweitem Grade des Werts des Stromes 29 durch den Leistungsschalter 17 der elektronischen Sicherung 825 bilden und diesen Wert dann für den Vergleich mit dem Stromquadratschwellwert zum Abschalten des Leistungsschalters 17 bei Überschreiten des Stromquadratschwellwerts verwenden.

Der Rechnerkern 2 der Steuervorrichtung 4 der elektronischen Sicherung 825 erfasst mittels entsprechender Messmittel 16 vorzugsweise den Betrag des Werts des elektrischen Stromes 29 durch den Leistungsschalter 17, quadriert diesen oder wendet ein Polynom mindestens zweiten Grades auf diesen an und integriert das Ergebnis über die Zeit. Diese Integration kann auch eine Filterung und zwar insbesondere eine Tiefpassfilterung sein. Der rechnerkern 2 der Steuervorrichtung 4 der elektronischen Sicherung vergleicht dann den erfassten, quadrierten und gefilterten Betrag des Werts des elektrischen Stromes 29 mit einem Schwellwert, insbesondere dem besagten Stromquadratschwellwert. Der Schaltzustand des Leistungsschalters 17 der elektronischen Sicherung 825 hängt dann zumindest zeitweise von dem Ergebnis dieses Vergleiches ab. Beispielsweise ist es aber möglich, dass der Leistungsschalter 17 der elektronischen Sicherung 825 unabhängig davon per Kommando über den Datenbus 9 durch das übergeordnete Rechnersystem 12 geöffnet wird.

Wie bereits angedeutet kann der rechnerkern 2 der Steuervorrichtung 4 der elektronischen Sicherung 825 den Betrag des Werts des elektrischen Stromes 29 durch den Leistungsschalter 17 durch entsprechende Mittel 16 erfassen, den erfassten Betrag des Werts des elektrischen Stromes 29 durch den Leistungsschalter 17 mittels eines Polynoms mit einer Ordnung des Polynoms größer als eins in einen abgebildeten Wert umwandeln und diesen abgebildeten Wert des elektrischen Stromes 29 durch den Leistungsschalter 17 über die Zeit integrieren, wobei diesen über die Zeit integrierten Wert des elektrischen Stromes 29 filtern, insbesondere tiefpassfiltern. Bevorzugt vergleicht der Rechnerkern 2 der Steuervorrichtung 4 der elektronischen Sicherung 825 den abgebildeten und gefilterten Wert des elektrischen Stromes 29 mit einem Schwellwert, insbesondere dem Stromquadratschwellwert, wobei der Schaltzustand des Leistungsschalters 17 der elektronischen Sicherung 825 bevorzugt wie zuvor zumindest zeitweise von dem Ergebnis dieses Vergleiches abhängt.

Vorzugsweise lässt der Rechnerkern 2 der Steuervorrichtung 4 der elektronischen Sicherung 825 den Transport elektrischer Energie von einer oder mehreren Energiequellen 250 zum Verbraucher 835, 830 zumindest zeitweise zu, in dem der rechnerkern 2 der Steuervorrichtung 4 der Sicherung 825 ihren Leistungsschalters 17 schließt. Typischerweise unterbindet der Rechnerkern 2 der Steuervorrichtung 4 der elektronischen Sicherung 825 den Transport elektrischer Energie vom Verbraucher 835, 830 zu einer oder mehreren oder allen Energiequellen 250 unterbindet.

Vorzugsweise umfassen die elektronische Sicherung 825 und/oder die Steuervorrichtung 4 der elektronischen Sicherung 825 Mittel 24, 23 zur Erfassung der Richtung des elektrischen Stroms 29 durch den Leistungsschalter 17. Vorzugsweise erfasst der Rechnerkern 2 der Steuervorrichtung 4 der elektronischen Sicherung 825 die Richtung des fließenden elektrischen Stromes 29 mit Hilfe dieser Mittel 24, 23. Sofern ein Energierückfluss in Richtung Energiequelle 250 nicht erwünscht ist, öffnet der rechnerkern 2 der Steuervorrichtung 4 der elektronischen Sicherung 825 den Leistungsschalter 17 der elektronischen Sicherung 825, wenn der elektrische Strom 29 vom Verbraucher 830 zu einer oder mehreren Energiequellen 250 durch den Leistungsschalter 17 der elektronischen Sicherung 825 fließt.

Die Steuervorrichtung 4 der elektronischen Sicherung oder die Sicherung 825 umfassen vorzugsweise einen dritten Leistungsschalter, der vom Leistungsschalter 17 der elektronischen Sicherung 825 verschieden ist. Der Rechnerkern 2 der Steuervorrichtung 4 der Sicherung 825 schließt typischerweise diesen dritten Leistungsschalter 615, wenn der elektrische Strom 29 vom Verbraucher 835 zu einer oder mehreren Energiequellen 250 durch den Leistungsschalter 17 der elektronischen Sicherung 825 fließt. Dieser dritte Leistungsschalter 615 leitet dann in diesem Fall, wenn der dritte Leistungsschalter 615 geschlossen ist, den elektrischen Strom 29 vom Verbraucher 835 in eine Stromsenke, insbesondere eine Bezugspotenzialleitung 201, ab.

Figur 9

Vorzugsweise umfassen die elektronische Sicherung 1, und zwar insbesondere die Steuervorrichtung 4 der elektronischen Sicherung 1 Mittel 505, 905 zur Detektion der Schaltbarkeit des Leistungsschalters 17 der elektronischen Sicherung 1.

In der Figur 9 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 24, 41, 42, 52, 53, 54, 55, 57, 58, 62. Die Kombination der Vorrichtungteile der hier beschriebenen Figur mit solchen dieser Figuren ist ausdrücklich Teil der Offenbarung des hier vorgelegten Dokuments.

Die Sicherung 1 der Figur 9 weist gegen über der Sicherung 1 der Figur 5 zusätzliche zur ersten Teststromquelle 505 eine zweite Teststromquelle 905, deren Teststrom 915 mittels des Steuersignals 910 mit einem Modulationssignal {505} eines zweiten Signalgenerators 920 moduliert ist. Bevorzugt entspricht der zweite Teststrom 915 dem ersten Teststrom 515. Hierdurch kann die Steuervorrichtung 4 den Teststrom 515 in den Leistungsschalter 17 einspeisen und nach dem Durchgang durch den Leistungsschalter 17 wieder aus dem Strompfad als zweiten Teststrom 915 wieder entnehmen. Ist der Leistungsschalter 17 nicht in dem erwarteten Zustand z.B. geöffnet oder geschlossen, so entsprechen der zweite Teststrom 915 und/oder der erste Teststrom 515 und/oder die Spannungsabfälle zwischen den Anschlüssen 26, 27, 28 des Leistungsschalters 17 nicht den erwarteten Werten. Hieraus kann dann der Rechnerkern 2 der Steuervorrichtung 4 der elektronischen Sicherung 1 auf einen Fehler des Leistungsschalters 1 schließen. In einem solchen Fehlerfall kann der Rechnerkern 2 der Steuervorrichtung 4 der elektronischen Sicherung 1 beispielsweise einem übergeordneten Rechnersystem 12 oder den Rechnerkernen 2 der Steuervorrichtungen 4 anderer elektronischer Sicherungen einen solchen Fehler signalisieren. Für die Steuerung der zweiten Teststromquelle 905 erzeugt ein zweiter Signalgenerator 920 bevorzugt ein zweites Steuersignal 910 der zweiten elektronischen Teststromquelle 905, das dafür sorgt, dass der zweite Teststrom 915, den die zweite Teststromquelle (910) aus dem Leistungsschalter (17) entnimmt, mit dem Modulationssignal {505} moduliert ist.

Das hier vorgelegte Dokument schlägt vor, dass die Steuervorrichtung 4 der elektronischen Sicherung 1 eine erste Teststromquelle 505 und eine zweite Teststromquelle 905 umfasst. Die Steuerungsvorrichtung 4 der elektronischen Sicherung 1 steuert die erste Teststromquelle 505 und die zweite Teststromquelle 905. Die erste Teststromquelle 505 speist auf Veranlassung durch die Steuervorrichtung 4 den Teststrom 515 in den ersten Anschluss 26 des Leistungsschalters 17 ein. Die zweite Teststromquelle 905 entnimmt dann diesen Teststrom 915 aus dem zweiten Anschluss 28 des Leistungsschalters 17. Die zweite Teststromquelle 905 umfasst bevorzugt Mittel, um die Entnahme des Teststroms zu detektieren. Der Rechnerkern 2 der Steuerungsvorrichtung 4 schließt auf einen Fehler des Leistungsschalters 17 der elektronischen Sicherung 1, wenn die zweite Stromquelle 905 entgegen der jeweiligen Erwartung eine Entnahme eines Teststroms 915 nicht detektiert bzw. detektiert. Hierbei kann z.B. die Steuervorrichtung 4 auch eine Abweichung des Betrags des zweiten Teststroms 915 außerhalb eines Erwartungswertintervalls als Fehler bewerten. Der Rechnerkern 2 der Steuervorrichtung 4 der elektronischen Sicherung 1 ändert vorzugsweise ein oder mehrmals den Schaltzustand des Leistungsschalters 17 und prüft den Schaltzustand des Leistungsschalters 17.

Hierzu ermittelt der Rechnerkern 2 der Steuervorrichtung 4 der elektronischen Sicherung 1 vorzugsweise Messwerte mittels Messmitteln der elektronischen Sicherung 1 und/oder der Steuervorrichtung 4 der elektronischen Sicherung 1. Vorzugsweise führen der Rechnerkern 2 der Steuervorrichtung 4 und/oder das übergeordnete Rechnersystem 2 ein neuronales Netzwerkmodell aus. Der Rechnerkern 2 der Steuervorrichtung 4 und/oder das übergeordnete Rechnersystem 2 verwenden die ermittelten Messwerte als Eingangswerte des von ihnen ausgeführten neuronalen Netzwerkmodells. Um dies zu ermöglichen übertragen vorzugsweise die Rechnerkerne 2 der Steuervorrichtungen 4 einer oder mehrerer Sicherungen und/oder das übergeordnete Rechnersystem 12 die notwendigen Daten für die Eingangssignale des neuronalen Netzwerks an den Rechnerkern 2 der Steuervorrichtung 4 der Sicherung 1 und/oder das übergeordnete Rechnersystem 12, je nachdem, welcher Rechner gerade das neuronale Netzwerkmodell ausführt.

Der Schaltzustand des Leistungsschalters 17 der elektronischen Sicherung 1 und/oder zumindest eine Datenbotschaft des Rechnerkerns 2 der Steuervorrichtung 4 der elektronischen Sicherung 1 an ein übergeordnetes Rechnersystem 12 oder einen Rechnerkern 2 einer anderen Steuervorrichtung 4 einer anderen elektronischen Sicherung 805 hängt dann bevorzugt von einem Ausgangssignal des neuronalen Netzwerkmodells ab.

Das neuronale Netzwerkmodell ist bevorzugt mit geeigneten Trainingsdaten aus der Entwicklungszeit trainiert.

Beispielsweise kann der Rechnerkern 2 der Steuervorrichtung 4 der elektronischen Sicherung 825 mittels eines Ausgangssignals des neuronalen Netzwerkmodells einen Ausfall eines oder mehrerer Verbraucher 835 oder einen Ausfall einer oder mehrerer Energiequellen 250 oder einen anderen Defekt des Systems der Gesamtvorrichtung erkennen.

Der rechnerkern 2 der Steuervorrichtung 4 der elektronischen Sicherung 825 kann mit einem anderen Rechnersystem 12 und/oder mit der Steuervorrichtung 4 einer anderen elektronischen Sicherung 805 beispielsweise auch über eine Versorgungsspannungsleitung (6, 241, 242, 245) Daten mittels Power-Line-Communication austauschen.

Für die Realisierung einer Power-Line-Communication kann der Rechnerkern 2 der Steuervorrichtung 4 der elektronischen Sicherung 1 den Leistungsschalter 17 der elektronischen Sicherung 825 als Sendetransistor für die Datenkommunikation über die Versorgungsspannungsleitung (6, 241, 242, 245) verwenden.

Der Rechnerkern 2 der Steuervorrichtung 4 der elektronischen Sicherung 1 kann beispielsweise zur Übertragung eines Bits eines ersten logischen Werts den Leistungsschalter 17 der elektronischen Sicherung 1 öffnen. Der Rechnerkern 2 der Steuervorrichtung 4 der elektronischen Sicherung 1 kann beispielsweise zur Übertragung eines Bits eines zweiten logischen Werts, der vom ersten logischen Wert verschieden ist, den Leistungsschalter 17 der elektronischen Sicherung 1 schließen.

Statt dieser Modellierung über ein vollständiges Öffnen und Schließen ist eine Kommunikation über unterschiedliche Innenwiderstände des Leistungsschalters 17 möglich.

Der Rechnerkern 2 der Steuervorrichtung 4 der elektronischen Sicherung 1 kann beispielsweise zur Übertragung eines Bits eines ersten logischen Werts den Leistungsschalter 17 der elektronischen Sicherung 1 in einen ersten Zustand mit einem ersten elektrischen Widerstandswert zwischen dem ersten Anschluss 26 des Leistungsschalters 17 und dem zweiten Anschluss 28 des Leistungsschalters 17 bringen. Der Rechnerkern 2 der Steuervorrichtung 4 der elektronischen Sicherung 1 kann beispielsweise zur Übertragung eines Bits eines zweiten logischen Werts, der vom ersten logischen Wert verschieden ist, den Leistungsschalter 17 der elektronischen Sicherung 1 in einen zweiten Zustand mit einem zweiten elektrischen Widerstandswert zwischen dem ersten Anschluss 26 des Leistungsschalters 17 und dem zweiten Anschluss 28 des Leistungsschalters 17 bringen, der vom zweiten Widerstandswert verschieden ist.

Um Daten über die Versorgungsspannungsleitung empfangen zu können weist die Steuervorrichtung 4 der elektronischen Sicherung 1 vorzugsweise Mittel zur Erfassung des zeitlichen Verlaufs des elektrischen Stroms 29 durch den Leistungsschalter 17 der elektronischen Sicherung 1 auf. Diese Mittel erfassten bevorzugt zumindest zeitweise den zeitlichen Verlauf des elektrischen Stroms 29 durch den Leistungsschalter 17 der elektronischen Sicherung 1. Diese Mittel können insbesondere einen Analog-zu-Digital-Wandler 570 und/oder einen Speicher des Rechnerkerns 2 der Steuervorrichtung 4 der elektronischen Sicherung 1 bzw. der Steuervorrichtung 4 der elektronischen Sicherung 1 umfassen.

Die Steuervorrichtung 4 der elektronischen Sicherung 1 umfasst vorzugsweise Mittel zur Erfassung des zeitlichen Verlaufs der Spannung zwischen einem Anschluss (26, 27, 28) des Leistungsschalters 17 der elektronischen Sicherung 1 und einem Bezugspotenzial 201. Diese Mittel erfassen typischerweise zumindest zeitweise den zeitlichen Verlauf der Spannung zwischen einem Anschluss (26, 27, 28) des Leistungsschalters 17 der elektronischen Sicherung 1 und einem Bezugspotenzial 201.

Der Rechnerkern 2 der Steuervorrichtung 4 der elektronischen Sicherung 1 führt bevorzugt eine Spektralanalyse der Daten der zeitlichen Verläufe, beispielsweise durch Fourier- oder Laplace-Transformation oder Wavelet-Transformation, durch und ermittelt Werte des Spektrums. Der Rechnerkern 2 der Steuervorrichtung 4 der elektronischen Sicherung 1 schließt vorzugsweise bei wesentlichen Abweichungen der Werte dieser Spektren von zugehörigen Erwartungswertintervallen für diese Werte dieser Spektren auf die Notwenigkeit einer präventiven Wartung und/oder signalisiert diese Abweichung an ein übergeordnetes Rechnersystem 12.

Die elektronische Sicherung 1 umfasst bevorzugt Mittel zur Erfassung des Werts des elektrischen Stroms 29 durch den Leistungsschalter 17 der elektronischen Sicherung 1 und zur Erfassung einer Spannung an einem Anschluss (26, 27, 28) des Leistungsschalters 17 der elektronischen Sicherung 1 gegen ein Bezugspotenzial 201. Der Rechnerkern 2 der Steuervorrichtung 4 der elektronischen Sicherung 1 schaltet vorschlagsgemäß bei einem Spannungsabfall in den gemessenen Spannungswerten unter einem Mindestspannungswert UND einem gleichzeitigen Stromanstieg des Werts des Stroms 29 durch den Leistungsschalter 17 über einen Maximalstromwert den Leistungsschalter 17 der elektronischen Sicherung 1 aus, öffnet den Leitungsschalter 17 in diesem Fall also. Dies ist also der Fall,

wenn a) der gemessene Spannungswert einen Spannungsschwellwert unterschreitet UND gleichzeitig der gemessene Strommesswert einen Stromschwellwert überschreitet und/oder

wenn b) der der Betrag einer Geschwindigkeit einer gemessenen zeitlichen Änderung des Spannungswertabfalls eine Spannungsabfallgeschwindigkeitsschwelle überschreitet UND gleichzeitig der Betrag der Geschwindigkeit einer gemessenen zeitlichen Änderung des Betrags des elektrischen Stromes 29 durch den Leistungsschalter 17, der Stromanstieg also, eine Stromanstiegsgeschwindigkeitsschwelle überschreitet.

Bevorzugt schaltet der Rechnerkern 2 der Steuervorrichtung 4 der elektronischen Sicherung 1 unter solchen Abschaltbedingungen schneller als innerhalb von $1\mu s$ den Leistungsschalter 17 der elektronischen Sicherung 1 aus. Dies hat den Vorteil, dass in vielen Fällen diese sehr kurze Zeit ausreicht, um Schäden zu vermeiden.

Vorzugsweise verfügt die vorgeschlagene elektronische Sicherung 1 über eine Notlaufsteuerung 925. Die Notlaufsteuerung 925 kann vorzugsweise Daten über einen Datenbus 540, 9 senden und über diesen Datenbus 9, 540 empfangen. Die Steuervorrichtung 4 der elektronischen Sicherung 1, 825 kann beispielsweise im Notlauf die Steuervorrichtung 4 einer anderen elektronischen Sicherung 805 sein, die mittels einer Datenkommunikation über den Datenbus 9, 540 und mittels der Notlaufsteuerung 925 der anderen elektronischen Sicherung 805 die andere elektronische Sicherung 805 bei einem Ausfall der Steuervorrichtung 4 der anderen elektronischen Sicherung 805 steuert. (Siehe auch Figur 8) Die Notlaufsteuerung 925 überwacht vorzugsweise die Datenkommunikation zwischen der Steuervorrichtung 4 und der Notlaufsteuerung 925 der anderen Sicherung 805. Die Notlaufsteuerung 925 emuliert bevorzugt im Falle eines Ausfalls der Datenkommunikation der Sicherung 1 einfache Funktionen der Steuervorrichtung 4 und stellt so bevorzugt eine zumindest grundlegende Absicherung der angeschlossenen Versorgungsleitung 19, 815, 820 und/oder Versorgungsteilnetzen und/oder Verbraucher und/oder Energiequellen sicher.

Der Rechnerkern 2 der Steuervorrichtung 4 der elektronischen Sicherung 1 sendet über den Sicherungsdatenbus 9, 540 ein Signal an ein übergeordnetes Rechnersystem 12, das signalisiert, dass a) die entsprechende elektronische Sicherung 1 noch vorhanden ist und/oder dass b) die entsprechende elektronische Sicherung 1 betriebsbereit ist und/oder welche Sicherungsidentifikationsinformation die Sicherung 1 aufweist und/oder welche Betriebsparameter die elektronische Sicherung 1 aufweist.

Figur 10

Figur 10 zeigt eine vorschlagsgemäße energiequellenseitige Kreuzungssicherung 1000. Die beispielhafte Kreuzungssicherung 1000 umfasst einen energiequellenseitigen ersten Versorgungsleitungsabschnitt 1005 einer ersten Versorgungsleitung, einen verbraucherseitigen zweiten Versorgungsleitungsabschnitt 1010 einer ersten Versorgungsleitung, einen energiequellenseitigen ersten Versorgungsleitungsabschnitt 1015 einer zweiten Versorgungsleitung, einen verbraucherseitigen zweiten Versorgungsleitungsabschnitt 1020 einer zweiten Versorgungsleitung, einen ersten elektrischen Knoten 1025, einen zweiten elektrischen Knoten 1030, eine erste elektronische Sicherung 1035, wie zuvor beschrieben, eine zweite elektronische Sicherung 1040, wie zuvor beschrieben, eine dritte elektronische Sicherung 1045, wie zuvor beschrieben, und eine vierte elektronische Sicherung 1050, wie zuvor beschrieben. Die erste elektronische Sicherung 1035 verbindet je nach Schaltzustand des Leistungsschalters 17 der ersten elektronischen Sicherung 1035 den energiequellenseitigen ersten Versorgungsleitungsabschnitt 1005 der ersten Versorgungsleitung mit dem ersten Knoten 1025 oder trennt den energiequellenseitigen ersten Versorgungsleitungsabschnitt 1005 der ersten Versorgungsleitung von dem ersten Knoten 1025. Die zweite elektronische Sicherung 1040 verbindet je nach Schaltzustand des Leistungsschalters 17 der zweiten elektronischen Sicherung 1040 den energiequellenseitigen ersten Versorgungsleitungsabschnitt 1015 der zweiten Versorgungsleitung mit dem ersten Knoten 1025 oder trennt den energiequellenseitigen ersten Versorgungsleitungsabschnitt 1015 der zweiten Versorgungsleitung von dem ersten Knoten 1025. Die zweite elektronische Sicherung 1040 verbindet den energiequellenseitigen ersten Versorgungsleitungsabschnitt 1015 der zweiten Versorgungsleitung nicht mit dem ersten Knoten 1025, wenn die erste elektronische Sicherung 1035 den energiequellenseitigen ersten Versorgungsleitungsabschnitt 1005 der ersten Versorgungsleitung mit dem ersten Knoten 1025 verbindet. Die erste elektronische Sicherung 1040 verbindet den energiequellenseitigen ersten Versorgungsleitungsabschnitt 1005 der ersten Versorgungsleitung nicht mit dem ersten Knoten 1025, wenn die zweite elektronische Sicherung 1040 den energiequellenseitigen ersten Versorgungsleitungsabschnitt 1015 der zweiten Versorgungsleitung mit dem ersten Knoten 1025 verbindet. Die dritte elektronische Sicherung 1045 verbindet je nach Schaltzustand des Leistungsschalters 17 der dritten elektronischen Sicherung 1045 den energiequellenseitigen ersten Versorgungsleitungsabschnitt 1005 der ersten Versorgungsleitung mit dem zweiten Knoten 1030 oder trennt den energiequellenseitigen ersten Versorgungsleitungsabschnitt 1005 der ersten Versorgungsleitung von dem zweiten Knoten 1030. Die vierte elektronische Sicherung 1050 trennt je nach Schaltzustand des Leistungsschalters 17 der vierten elektronischen Sicherung 1050 den energiequellenseitigen ersten Versorgungsleitungsabschnitt 1015 der zweiten Versorgungsleitung mit dem zweiten Knoten 1030 oder trennt den energiequellenseitigen ersten Versorgungsleitungsabschnitt 1030 der zweiten Versorgungsleitung von dem zweiten Knoten 1030. Die vierte elektronische Sicherung 1050 verbindet den energiequellenseitigen ersten Versorgungsleitungsabschnitt 1015 der zweiten Versorgungsleitung nicht mit dem zweiten Knoten 1030, wenn die dritte elektronische Sicherung 1045 den energiequellenseitigen ersten Versorgungsleitungsabschnitt 1005 der ersten Versorgungsleitung mit dem zweiten Knoten verbindet. Die dritte elektronische Sicherung 1045 verbindet den energiequellenseitigen ersten Versorgungsleitungsabschnitt der ersten Versorgungsleitung nicht mit dem zweiten Knoten 1030, wenn die vierte elektronische Sicherung 1050 den energiequellenseitigen ersten Versorgungsleitungsabschnitt 1015 der zweiten Versorgungsleitung mit dem zweiten Knoten 1030 verbindet. Der verbraucherseitige zweite Versorgungsleitungsabschnitt 1055 der ersten Versorgungsleitung ist mit dem ersten Knoten 1025 verbunden. Der verbraucherseitige zweite Versorgungsleitungsabschnitt 1060 der zweiten Versorgungsleitung ist mit dem zweiten Knoten 1030 verbunden.

Eine vorschlagsgemäße verbraucherseitige Kreuzungssicherung 1000 umfasst einen energiequellenseitigen ersten Versorgungsleitungsabschnitt 1005 einer ersten Versorgungsleitung, einen verbraucherseitigen zweiten Versorgungsleitungsabschnitt 1015 einer ersten Versorgungsleitung, einen energiequellenseitigen ersten Versorgungsleitungsabschnitt 1055 einer zweiten Versorgungsleitung, einen verbraucherseitigen zweiten Versorgungsleitungsabschnitt 1060 einer zweiten Versorgungsleitung, einen dritten elektrischen Knoten 1065, einen vierten elektrischen Knoten 1070, eine erste elektronische Sicherung 1035, wie zuvor beschrieben, eine zweite elektronische Sicherung 1040, wie zuvor beschrieben, eine dritte elektronische Sicherung 1045, wie zuvor beschrieben, und eine vierte elektronische Sicherung 1050, wie zuvor beschrieben. Die erste elektronische Sicherung 1035 verbindet je nach Schaltzustand des Leistungsschalters 17 der ersten elektronischen Sicherung 1035 den verbraucherseitigen zweiten Versorgungsleitungsabschnitt 1055 der ersten Versorgungsleitung mit dem dritten Knoten 1065 oder trennt den verbraucherseitigen zweiten Versorgungsleitungsabschnitt 1055 der ersten Versorgungsleitung von dem dritten Knoten 1065. Die zweite elektronische Sicherung 1040 verbindet je nach Schaltzustand des Leistungsschalters 17 der zweiten elektronischen Sicherung 1040 den verbraucherseitigen zweiten Versorgungsleitungsabschnitt 1055 der ersten Versorgungsleitung mit dem vierten Knoten 1070 oder trennt den verbraucherseitigen zweiten Versorgungsleitungsabschnitt 1055 der ersten Versorgungsleitung 1055 von dem vierten Knoten 1070. Die zweite elektronische Sicherung 1040 verbindet den verbraucherseitigen zweiten Versorgungsleitungsabschnitt 1055 der ersten Versorgungsleitung nicht mit dem vierten Knoten 1070, wenn die erste elektronische Sicherung 1035 den verbraucherseitigen zweiten Versorgungsleitungsabschnitt 1055 der ersten Versorgungsleitung mit dem dritten Knoten 1065 verbindet. Die erste elektronische Sicherung 1035 verbindet den verbraucherseitigen zweiten Versorgungsleitungsabschnitt 1055 der ersten Versorgungsleitung nicht mit dem dritten Knoten 1055, wenn die zweite elektronische Sicherung 1040 den verbraucherseitigen zweiten Versorgungsleitungsabschnitt der ersten Versorgungsleitung 1055 mit dem vierten Knoten 1070 verbindet. Die dritte elektronische Sicherung 1045 verbindet je nach Schaltzustand des Leistungsschalters 17 der dritten elektronischen Sicherung 1045 den verbraucherseitigen zweiten Versorgungsleitungsabschnitt 1060 der zweiten Versorgungsleitung mit dem dritten Knoten 1065 oder trennt den verbraucherseitigen zweiten Versorgungsleitungsabschnitt 1060 der zweiten Versorgungsleitung von dem dritten Knoten 1065. Die vierte elektronische Sicherung 1050 verbindet je nach Schaltzustand des Leistungsschalters 17 der vierten elektronischen Sicherung 1050 den verbraucherseitigen zweiten Versorgungsleitungsabschnitt der zweiten Versorgungsleitung 1060 mit dem vierten Knoten 1070 oder trennt den verbraucherseitigen zweiten Versorgungsleitungsabschnitt 1060 der zweiten Versorgungsleitung von dem vierten Knoten 1070. Die vierte elektronische Sicherung 1050 verbindet den verbraucherseitigen zweiten Versorgungsleitungsabschnitt 1060 der zweiten Versorgungsleitung nicht mit dem vierten Knoten 1070, wenn die dritte elektronische Sicherung 1045 den verbraucherseitigen zweiten Versorgungsleitungsabschnitt 1060 der zweiten Versorgungsleitung mit dem dritten Knoten 1065 verbindet. Die dritte elektronische Sicherung 1045 verbindet den verbraucherseitigen zweiten Versorgungsleitungsabschnitt 1060 der zweiten Versorgungsleitung nicht mit dem dritten Knoten verbindet 1065, wenn die vierte elektronische Sicherung 1050 den verbraucherseitigen zweiten Versorgungsleitungsabschnitt 1060 der zweiten Versorgungsleitung mit dem vierten Knoten 1070 verbindet. Der energiequellenseitige erste Versorgungsleitungsabschnitt 1005 der ersten Versorgungsleitung ist mit dem dritten Knoten 1065 verbunden. Der energiequellenseitige erste Versorgungsleitungsabschnitt 1015 der zweiten Versorgungsleitung ist mit dem vierten Knoten 1070 verbunden.

Bei den vorbeschriebenen Kreuzungssicherungen hängt der Schaltzustand der Leistungsschalter 17 der elektronischen Sicherungen (1035, 1040, 1045, 1050) der Kreuzungssicherung 1000 von einem ermittelten Energiebedarf von einem oder mehreren Verbrauchern (830, 835) und/oder von einer ermittelten Energielieferfähigkeit von einer oder mehrerer Energiequellen (250, 251) abhängt.

Vorzugsweise sind die Rechnerkerne 2 der Steuervorrichtungen 4 der elektronischen Sicherungen (1035, 1040, 1045, 1050) der Kreuzungssicherung 1000 über einen Sicherungsdatenbus 9 untereinander und mit einem übergeordneten Rechnersystem 12 verbunden. Das übergeordnete Rechnersystem 12 ermittelt vorzugsweise den Energiebedarf von einem oder mehreren Verbrauchern 835, 830, die die Versorgungsleitungen (1005, 1010: 1015, 1020, 1055, 1060) der Kreuzungssicherung 1000 mit elektrischer Energie versorgen können. Das übergeordnete Rechnersystem 12 ermittelt die Energielieferfähigkeit von einer oder mehreren Energiequellen 250, 251, die über die Versorgungsleitungen (1005, 1010: 1015, 1020, 1055, 1060) der Kreuzungssicherung 1000 elektrische Energie liefern können. Das Rechnersystem 12 übermittelt den Rechnerkernen 2 der Steuervorrichtungen 4 der Sicherungen (1035, 1040, 1045, 1050) der Kreuzungssicherung 1000 Konfigurationsbefehle über den Sicherungsdatenbus 9, die von dem ermittelten Energiebedarf dieser Verbraucher 830, 831 abhängen und/oder die von der ermittelten Energielieferfähigkeit dieser Energiequellen 250, 251 abhängen. Diese Konfigurationsbefehle des übergeordneten Rechnersystems 12 bewirken vorzugsweise das Öffnen und Schließen von Leistungsschaltern 17 der elektronischen Sicherungen (1035, 1040, 1045, 1050) der Kreuzungssicherung 1000.

Figur 11

Figur 11 zeigt ein vorschlagsgemäßes Versorgungsnetzwerk 1100 mit einem übergeordneten Rechnersystem 12 und mit einer Vielzahl von Versorgungsleitungen und mit einer Mehrzahl von Kreuzungssicherungen 1110 bis 1118, die ein flexible last- und versorgungsabhängiges Rekonfigurieren des Versorgungsnetzwerks 1100 ermöglichen.

Die Kreuzungssicherungen 1110 bis 1118 sind in Versorgungsleitungspaare der Versorgungsleitungen des Versorgungsnetzwerks 1100 jeweils eingefügt. Das übergeordnete Rechnersystem 12 ist mittels eines Sicherungsdatenbusses 9 mit den Rechnerkernen 2 der Steuervorrichtungen 4 der elektronischen Sicherungen der Kreuzsicherungen 1110 bis 1118 verbunden.

Die elektronischen Sicherungen der Kreuzsicherungen 1110 bis 1118 weisen jeweils Steuervorrichtungen 4 mit einem jeweiligen Rechnerkern auf. Diese Sicherungen sind bevorzugt elektronische Sicherungen der vorbeschriebenen Art.

Zur Vereinfachung des Aufbaus können die beispielhaft vier elektronischen Sicherungen einer jeweiligen Kreuzsicherung der Kreuzsicherungen 1110 bis 1118 auch eine gemeinsame Steuervorrichtung (4) gemeinsam aufweisen, sodass diese einzelne Steuervorrichtung 4 vier Leistungsschalter 17 der vier Sicherungen gleichzeitig steuert.

Bevorzugt ermittelt das übergeordnete Rechnersystem 12 den Energiebedarf von elektrischen Energieverbrauchern 1121 bis 1124 in dem Versorgungsnetzwerk 1100. Das übergeordnete Rechnersystem 12 ermittelt bevorzugt ebenfalls die Energielieferfähigkeit von elektrischen Energiequellen 1150 bis 1155 in dem Versorgungsnetzwerk 1100.

Das übergeordnete Rechnersystem 12 ermittelt bevorzugt den aktuellen Sicherheitsbedarf aufgrund der aktuellen Fahrsituation des Fahrzeugs, was bedeutet, dass das übergeordnete Rechnersystem aufgrund von Messdaten, die insbesondere Messdaten elektronischer Sicherungen im Versorgungsnetzwerl 1100 umfassen können, beispielsweise auf die zukünftige Energielieferfähigkeit und den zukünftigen Energieverbrauch schließt.

Das übergeordnete Rechnersystem 12 passt bevorzugt mittels Konfigurationsbefehlen über den Sicherungsdatenbus 9 an die Rechnerkerne 2 der Steuervorrichtungen 4 der Sicherungen der Kreuzungssicherungen (1110 bis 1118) die elektrisch wirksame Topologie des Versorgungsnetzes der Versorgungsleitungen dynamisch entsprechend dem ermittelten Energiebedarf und/oder entsprechend der ermittelten Energielieferfähigkeit und/oder entsprechend den aktuellen Sicherheitsbedarf an.

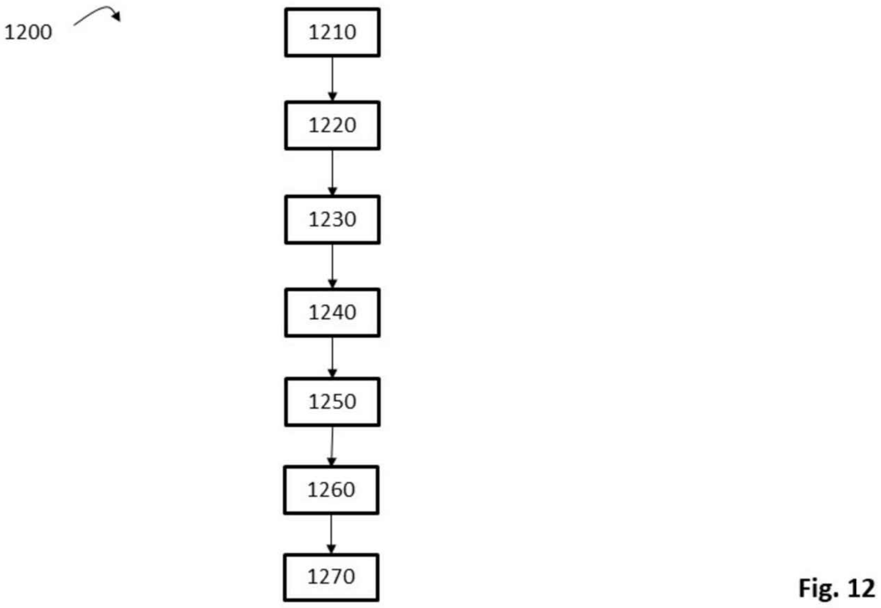

<u>Figur 12</u>

Figur 12 zeigt den grundsätzlichen Ablauf eines Verfahrens 1200 zum Betreiben eines Versorgungsnetzwerkes. Das Verfahren umfasst die Schritte:

Schritt 1: Bereitstellen 1210 eines Versorgungsnetzwerks (250, 251, 210 bis 213, 245) mit einem Vorrichtungsteil des Fahrzeugs, im Folgenden als energieversorgender Vorrichtungsteil 210 bezeichnet, wobei der energieversorgende Versorgungsteil 210 eine Steuervorrichtung 280, 4 und einen Speicher in einem ersten logischen Zustand umfasst;

Schritt 2: Versorgen 1220 des energieversorgenden Vorrichtungsteils 210 mit elektrischer Energie aus einer Energiequelle 251, 250 des Fahrzeugs;

Schritt 3: Verbinden 1230 eines ersten Anschlusses eines weiteren Leitungsabschnitts 240 mit dem energieversorgenden Vorrichtungsteil 210 des Fahrzeugs;

Schritt 4: Verbinden 1240 eines zweiten Anschlusses des Weiteren Leitungsabschnitts 240 mit einem weiteren Vorrichtungsteil 220, 221 des Fahrzeugs;

Schritt 5: Signalisierung 1250 eines Einschaltsignals an die Steuervorrichtung 280, 4 des energieversorgenden Vorrichtungsteils 210;

Schritt 6: Ändern 1260 des logischen Zustands des Speichers in einen zweiten logischen Zustand in Abhängigkeit von dem logischen Zustand des Speichers;

Schritt 7: Versorgen 1270 des Weiteren Vorrichtungsteils 220 bis 221 des Fahrzeugs mit elektrischer Energie über den weiteren Leitungsabschnitt 240 in Abhängigkeit von dem logischen Zustand des Speichers.

Bevorzugt erfolgt die Signalisierung 1250 des Einschaltsignals über einen Sicherungsdatenbus 9.

Vorzugsweise weist der energieversorgende Vorrichtungsteil 210 eine elektronische Sicherung 215 des energieversorgenden Vorrichtungsteils 250, 251 auf. Das Versorgen 1270 des Weiteren Vorrichtungsteils 220, 221 des Fahrzeugs mit elektrischer Energie erfolgt vorzugsweise über den weiteren Leitungsabschnitt 240 mittels des Einschaltens der elektronischen Sicherung 215 des energieversorgenden Vorrichtungsteils 210 in Abhängigkeit von dem logischen Zustand des Speichers.

Eine Variante des Verfahrens 1200 zum Betreiben eines Versorgungsnetzwerkes 200 umfasst die Schritte:

Schritt 1: Bereitstellen 1210 eines Versorgungsnetzwerks 200 mit einem Vorrichtungsteil 210 des Fahrzeugs, im Folgenden als energieversorgender Vorrichtungsteil 210 bezeichnet.

Schritt 2: Versorgen 1220 des energieversorgenden Vorrichtungsteils 210 mit elektrischer Energie aus einer Energiequelle 250, 251 des Fahrzeugs;

Schritt 3: Verbinden 1230 eines ersten Anschlusses eines weiteren Leitungsabschnitts 240 mit dem energieversorgenden Vorrichtungsteil 210 des Fahrzeugs;

Schritt 4: Verbinden 1240 eines zweiten Anschlusses eines weiteren Leitungsabschnitts 240 mit einem weiteren Vorrichtungsteil der Vorrichtungsteile 220 bis 221 des Fahrzeugs, wobei der weitere Versorgungsteil der Vorrichtungsteile 220 bis 221 des Fahrzeugs eine Steuervorrichtung 280, 4 umfasst und wobei der weitere Versorgungsteil der Vorrichtungsteile 220 bis 221 des Fahrzeugs einen Speicher in einem ersten logischen Zustand umfasst;

Schritt 5: Signalisierung 1250 eines Einschaltsignals an die Steuervorrichtung 280, 4 des weiteren Vorrichtungsteils der Vorrichtungsteile (220 bis 221) des Fahrzeugs;

Schritt 6: Ändern 1260 des logischen Zustands des Speichers in einen zweiten logischen Zustand in Abhängigkeit von dem logischen Zustand des Speichers;

Schritt 7: Versorgen 1270 des weiteren Vorrichtungsteils der Vorrichtungsteile 220 bis 221 des Fahrzeugs mit elektrischer Energie über den weiteren Leitungsabschnitt 240 in Abhängigkeit von dem logischen Zustand des Speichers. Vorzugsweise erfolgt die Signalisierung des Einschaltsignals auch hier über einen Sicherungsdatenbus 9. Vorzugsweise weist der weitere Vorrichtungsteil eine elektronische Sicherung 225 zur Absicherung des weiteren Vorrichtungsteils 220 auf. Das Versorgen des weiteren Vorrichtungsteils 220 des Fahrzeugs mit elektrischer Energie erfolgt bevorzugt über den weiteren Leitungsabschnitt 240 mittels des Einschaltens des Leistungsschalters 17 der elektronischen Sicherung 225 des weiteren Vorrichtungsteils 220 in Abhängigkeit von dem logischen Zustand des Speichers erfolgt.

Figur 13

Figur 13 skizziert ein Verfahren 1300 zum Betreiben eines Fahrzeugs (verbraucherseitige Merkmalsversion). Es umfasst die Schritte:

Schritt 1: Bereitstellen 1305 des Fahrzeugs, (siehe auch Figur 7), wobei das Fahrzeug u.a. Vorrichtungsteile 210 und zumindest einen Kabelbaum mit Leitungsabschnitten 240, 241, 245 und zumindest eine Energiequelle 250, 251 umfasst und zumindest einen Steuerrechner 12, beispielsweise ein übergeordnetes Rechnersystem 12, und zumindest zwei elektronische Sicherungen 214, 225 umfasst. Die Vorrichtungsteile 220 sind hier elektrische Verbraucher. Zumindest eine oder mehrere Energiequellen 250, 251 versorgen zumindest zwei der Vorrichtungsteile 210, 220 mit elektrischer Energie über den Kabelbaum mit Leitungsabschnitten 240, 241, 245. Die elektronischen Sicherungen 214, 225 sind vorzugsweise in den Kabelbaum mit Leitungsabschnitten 240, 241, 245 eingefügt. Bevorzugt jeder der elektrischen Sicherungen 214, 225 ist vorzugsweise zumindest ein, als Zahl 1, elektrischer Verbraucher 210, 225 zugeordnet, der im Folgenden als der jeweiligen elektronischen Sicherung zugeordneter elektrischer Verbraucher bezeichnet wird. Eine Sicherung der Sicherungen 214, 215 kann die Energieversorgung des dieser Sicherung zugeordneten elektrischen Verbrauchers in Abhängigkeit von einem Steuersignal des Steuerrechners, beispielsweise eines übergeordneten Rechnersystems 12, ermöglichen oder unterbinden.
Schritt 2: Unterbinden 1310 der Energieversorgung eines zugeordneten elektrischen Verbrauchers mittels der entsprechenden Sicherung, der dieser Verbraucher zugeordnet ist;
Schritt 3: Herstellen 1315 einer verschlüsselten Datenverbindung 720 zwischen dem Steuerrechner 12 des Fahrzeugs, beispielsweise dem übergeordneten Rechnersystem 12, und einem Rechner 710 eines Dienstanbieters, insbesondere einem Rechnersystem des Automobilherstellers des Fahrzeugs;
Schritt 4: Authentifizierung 1320 des Fahrzeugs durch den Steuerrechner 12 des Fahrzeugs, beispielsweise durch ein übergeordnetes Rechnersystem 12, beim Rechner 710 des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können;
Schritt 4: Authentifizierung 1325 des Rechners 710 des Dienstanbieters beim Steuerrechner 12 des Fahrzeugs, beispielsweise bei einem übergeordneten Rechnersystem 12;
Schritt 5: Ggf. Authentifizierung 1330 der anfordernden Person 730 durch den Steuerrechner 12 des Fahrzeugs, beispielsweise durch das übergeordnete Rechnersystem 12, beim Rechner 710 des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen können;
Schritt 6: Erzeugen 1335 oder Bereitstellen eines Freischaltcodes durch den Rechner 710 des Dienstanbieters;
Schritt 7: Übermitteln 1340 des Freischaltcodes durch den Rechner des Dienstanbieters 710 an den Steuerrechner 12 des Fahrzeugs, beispielsweise an das übergeordnete Rechnersystem 12;
Schritt 8: Verifikation 1345 der Zulässigkeit und/oder syntaktischen Korrektheit und/oder der situativen Zulässigkeit des Freischaltcodes durch den Steuerrechner 12 des Fahrzeugs, beispielsweise durch das übergeordnete Rechnersystem 12;
Schritt 9: Ermöglichen 1350 der Energieversorgung eines zugeordneten elektrischen Verbrauchers 220 mittels der entsprechenden Sicherung 225, wenn der Freischaltcode zulässig und/oder syntaktisch Korrekt und/oder der situativ zulässig ist;
Schritt 10: Übermittlung 1355 von Abrechnungsdaten an einen oder den Rechner 710 eines oder des Dienstanbieters, insbesondere an ein oder das Rechnersystem des Automobilherstellers, wobei eine Speicherinformation im Rechner 710 des Dienstanbieters markiert, dass die Rechnung nicht bezahlt ist;
Schritt 11: Erstellung 1360 einer Rechnung in Abhängigkeit von den übermittelten Abrechnungsdaten durch einen oder den Rechner 710 eines oder des Dienstanbieters, insbesondere an ein oder das Rechnersystem des Automobilherstellers;

Schritt 12: Übermittlung 1365 der Rechnung an einem oder den Rechner 710 eines oder des Dienstanbieters, insbesondere an ein oder das Rechnersystem 740 der bestellenden Person 730, oder an die bestellende Person 730;

Schritt 13: Begleichung 1370 der Rechnung durch einen oder den Rechner 710 eines oder des Dienstanbieters und/oder die anfordernde Person 730;

Schritt 14: Markierung 1375 der Speicherinformation im Rechner des Dienstanbieters 740, dass die Rechnung bezahlt ist.

Figur 14

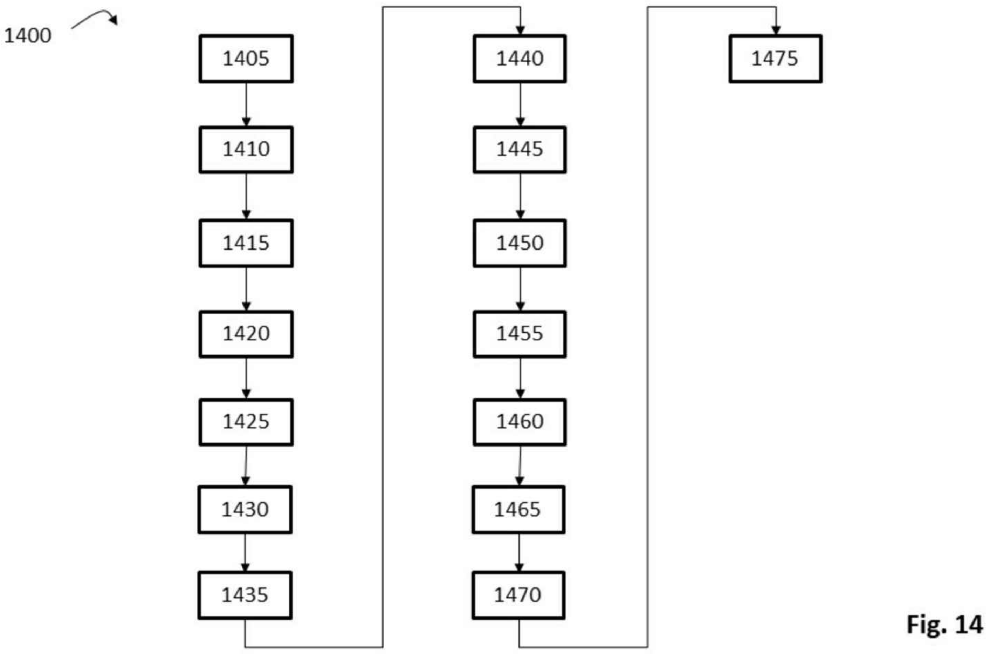

Figur 14 zeigt ebenfalls ein weiteres vereinfacht beschriebenes Verfahren 1400 zum Betreiben eines Fahrzeugs unter Freischaltung von Energiequellen im Fahrzeug. Das Verfahren umfasst die Schritte:

Schritt 1: Bereitstellen 1405 des Fahrzeugs;

Schritt 2: Unterbinden 1410 der Energielieferung einer zugeordneten elektrischen Energiequelle 250, 251 in dem z.B. das übergeordnete Rechnersystem 12 dem Rechnerkern 2 der Steuervorrichtung 4 der entsprechenden Sicherung 255, 260 signalisiert, den Leistungsschalter 17 dieser elektronischen Sicherung 255, 260 zu öffnen, woraufhin dieser Rechnerkern 2 dieser Steuervorrichtung 4 dieser zugeordneten elektronischen Sicherung 255,260 den Leistungsschalter 17 dieser Sicherung 255, 260 öffnet;

Schritt 3: Herstellen 1415 einer verschlüsselten Verbindung 720 zwischen dem Steuerrechner des Fahrzeugs, also dem übergeordneten Rechnersystem 12, und einem Rechner 710 eines Dienstanbieters, insbesondere einem Rechnersystem 710 des Automobilherstellers. Hierbei verwenden das übergeordnete Rechnersystem 12 und das Rechnersystem 710 des Dienstanbieters bzw. des Automobilherstellers vorzugsweise eine PQC-Verschlüsselung;

Schritt 4: Authentifizierung 1420 des Fahrzeugs durch den Steuerrechner des Fahrzeugs, also durch das übergeordnete Rechnersystem 12, beim Rechner 710 des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können;

Schritt 5: Authentifizierung 1430 des Rechners 710 des Dienstanbieters beim Steuerrechner des Fahrzeugs, also beim übergeordneten Rechnersystem 12;

Schritt 6: Authentifizierung 1430 der anfordernden Person 730 durch den Steuerrechner des Fahrzeugs, also durch das übergeordnete Rechnersystem 12, beim Rechner 710 des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten (z.B. Fingerprintsensordaten und/oder Retina-Scanner-Daten und/oder Gesichtserkennungsdaten und/oder Spracheingabedaten etc.) etc. umfassen können;

Schritt 7: Erzeugen 1435 oder Bereitstellen eines Freischaltcodes insbesondere durch den Rechner 710 des Dienstanbieters. Vorzugsweise hängt der Freischaltcode von den übermittelten Konfigurationsdaten des Fahrzeugs und/oder den übermittelten Authentifizierungsdaten und/oder dem Ort, an dem sich das Fahrzeug befindet und/oder von der anfordernden Person 730 und/oder von dem Halter des Fahrzeugs und/oder von Betriebsdaten des Fahrzeugs etc. ab;

Schritt 8: Vorzugsweise verschlüsseltes Übermitteln 1440 des Freischaltcodes durch den Rechner 710 des Dienstanbieters an den Steuerrechner des Fahrzeugs, also an das übergeordnete Rechnersystem 12;

Schritt 9: Verifikation 1445 der Zulässigkeit und/oder syntaktischen Korrektheit und/oder der situativen Zulässigkeit des Freischaltcodes durch den Steuerrechner 12 des Fahrzeugs, also durch das übergeordnete Rechnersystem 12. Dies soll verhindern, dass ein anderes Rechnersystem als das Rechnersystem 710 eines zulässigen Dienstleisters einen Freischaltcode erfolgreich in das System des Fahrzeugs einspeist;

Schritt 10: Ermöglichen 1450 der Energielieferung einer zugeordneten elektrischen Energiequelle 250, 251 mittels der entsprechenden, zugeordneten Sicherung 255, 260. Bei erfolgreicher Verifikation des Freischaltcodes in Schritt 10 schließt vorzugsweise der Rechnerkern 2 der Steuervorrichtung 4 der zugehörigen Sicherung 255, 260 den Leistungsschalter 17 dieser Sicherung 255, 260, sodass eine vorausgehende Energiequelle 250, 251 ein nachfolgendes Versorgungsteilnetz und/oder einen nachfolgenden Versorgungsleitungsabschnitt und/oder einen nachfolgenden elektrischen Verbraucher mit elektrischer Energie versorgen kann;

Schritt 11: Vorzugsweise erfassen Messmittel und/oder Sicherungen in dem Versorgungsnetzwerk 200 Messwerte und Parameter, die der Rechnungsersteller für die Leistungsabrechnung benötigt. In diesem Schritt 11 erfolgt bevorzugt eine Übermittlung 1455 von Abrechnungsdaten durch das übergeordnete Rechnersystem 12 an einen oder den Rechner 710 eines oder des Dienstanbieters, insbesondere an ein oder das Rechnersystem des Automobilherstellers, wobei eine Speicherinformation im Rechner 710 des Dienstanbieters markiert, dass die Rechnung noch nicht bezahlt ist;

Schritt 12: Erstellung 1460 einer Rechnung in Abhängigkeit von den übermittelten Abrechnungsdaten durch einem oder den Rechner 710 eines oder des Dienstanbieters, insbesondere an ein oder das Rechnersystem des Automobilherstellers;

Schritt 13: Übermittlung 1465 der Rechnung, insbesondere durch einen oder den Rechner 710 eines oder des Dienstanbieters an einem oder den Rechner 750 eines oder des Dienstanbieters, insbesondere an ein oder das Rechnersystem der bestellenden Person, oder an die bestellende Person 730;

Schritt 14: Begleichung 1470 der Rechnung durch einem oder den Rechner 750 eines oder des Dienstanbieters und/oder die anfordernde Person 730;

Schritt 15: Markierung 1475 der Speicherinformation im Rechner 710 des Dienstanbieters, dass die Rechnung bezahlt ist;

Figur 15

Figur 15 entspricht weitestgehend der Figur 8. Nun jedoch soll das Versorgungsnetzwerk in ein erstes Versorgungsteilnetzwerk und ein zweites Versorgungsteilnetzwerk unterteilt sein.

Im ersten Versorgungsteilnetzwerk versorgt eine erste Energiequelle 250 über den dritten Versorgungsleitungsabschnitt 245 und eine zweite weitere Sicherung 810 einen Ausgang 485 der Sicherungsbox 400 zur Versorgung eines Verbrauchers mit elektrischer Energie. Wir nehmen beispielhaft hier an, dass die erste Energiequelle 250 eine Ausgangsspannung in einem Bereich von 45V bis 80V liefert.

Im zweiten Versorgungsteilnetzwerk versorgt eine zweite Energiequelle 251 über den vierten Versorgungsleitungsabschnitt 246 und eine elektronische Sicherung 825 und über einen abzusichernder Leitungsabschnitt 1505 und eine weitere Sicherung 805 einen Verbraucher 830 mit elektrischer Energie. Wir nehmen beispielhaft hier an, dass die zweite Energiequelle 251 eine Ausgangsspannung in einem Bereich von 700V bis 900V liefert.

Der Ausgang 485 der Sicherungsbox 400 zur Versorgung eines Verbrauchers und der abzusichernder Leitungsabschnitt 1505 bilden zusammen einen Kabelbaum 1515. In dem abzusichernder Leitungsabschnitt 1505 fließt der elektrische Strom 1525 durch den abzusichernden Leitungsabschnitt 1505. Die Sicherung 825 weist bevorzugt eine Strommessvorrichtung 1520 auf, die in den abzusichernden Leitungsabschnitt 1505 eingefügt ist. Typischerweise verwendet die Sicherung 825 ihren Leistungsschalter 17 als Strommessvorrichtung 1520. Der Rechnerkern 2 der Steuervorrichtung 4 der Sicherung 825 nutzt dabei bevorzugt den Analog-zu-Digital-Wandler 570 der Steuervorrichtung 4 der Sicherung 825, um die Potenziale an den Anschlüssen 26, 27, 28 des Leistungsschalters 17 und/oder den Spannungsabfall über den Shunt-Widerstand 24 zu erfassen und hieraus auf den Strom 29 durch den Leistungsschalter 17 zu schließen. Wenn hier also davon die Rede ist, dass die Strommessvorrichtung 1520 in den abzusichernden Leitungsabschnitt 1505 eingefügt ist, so sind damit solche Konstruktionen aus Leistungsschalter 17, Hilfsleistungsschalter 23 und Shunt-Widerstand in Kombination mit einem Analog-Zu-Digital-Wandler 570 hiervon ausdrücklich mitumfasst und gelten als in den abzusichernden Leitungsabschnitt 1505 eingefügt. Solche Vorrichtungen sind daher dazu geeignet, den Wert des elektrischem Stroms 1525 durch den abzusichernden Leitungsabschnitt 1505 zu ermitteln und damit zu erfassen.

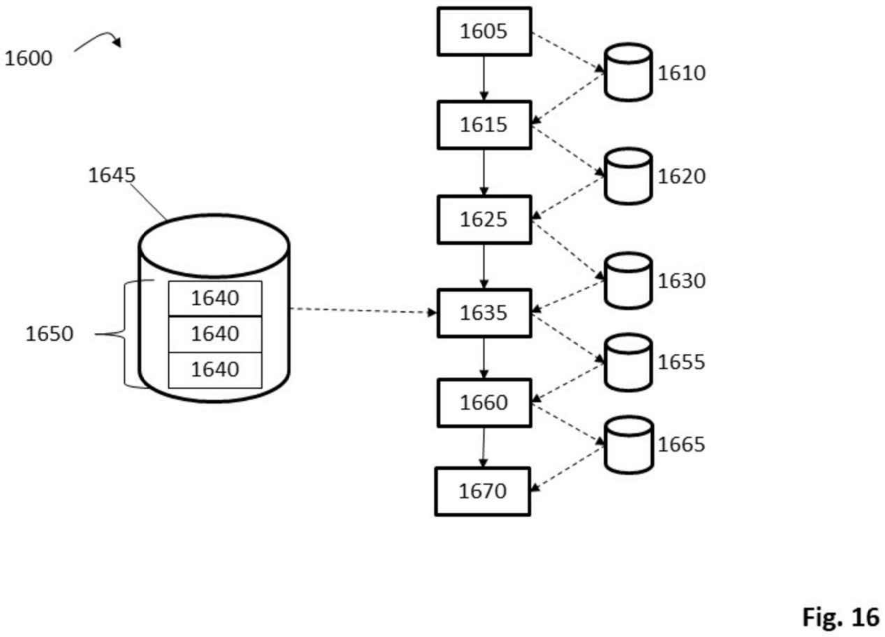

In dem Beispiel der Figur 15 wird angenommen, dass ein Lichtbogen 1510 sich in fehlerhafter Weise zwischen dem Ausgang 485 der Sicherungsbox 400 zur Versorgung eines Verbrauchers und dem abzusichernden Leitungsabschnitt 1505 gebildet hat. Das vorschlagsgemäße Versorgungsnetzwerk 200 soll diesen Lichtbogen erkennen. Hierzu verweist das hier vorgelegte Dokument auf die nachfolgende Figur 16.

Figur 16

Figur 16 zeigt schematisch vereinfacht und beispielhaft ein Verfahren 1600 zu Erkennung von nicht verlöschenden Lichtbögen 1510 im Kabelbaum 1515 eines Fahrzeugs. Der Kabelbaum 1515 umfasst verschiedene Leitungsabschnitte 485,1505, die sich beispielhaft auf unterschiedlichen elektrischen Potenzialen befinden sollen. Das hier vorgelegte Dokument verweist hier auch auf die vorausgehende Figur 15.

Im Kabelbaum 1510 sollen beispielhaft zumindest zeitweise Spannungen von mehr als 40V, beispielsweise 48V und/oder 800V zwischen den Leitungsabschnitten 485, 1505 auftreten. Ein nicht verlöschender Lichtbogen 1510 stellt daher dann eine nicht zu unterschätzende Brandgefahr dar. In Leitungsabschnitte 245, 246,485,1505 des Kabelbaums 1515 sind elektronische Sicherungen 810, 825, 805 beispielhaft eingefügt, die den Stromdurchfluss in einzelnen oder mehreren Leitungsabschnitten 245, 246,485,1505 des Kabelbaums 1515 mittels ihrer Leistungsschalter 17 unterbrechen können. Der beispielhafte Kabelbaum 1515 der Figur 16 ist in abzusichernde Leitungsabschnitte 485, 1505 unterteilt. Einem Leitungsabschnitt 1515 dieser Leitungsabschnitte 485, 1515 - im Folgenden als abzusichernder Leitungsabschnitt 1505 bezeichnet - ist zumindest eine elektronische Sicherung 825 der elektronischen Sicherungen zugeordnet, die den Stromfluss in diesem, ihr zugeordneten Leitungsabschnitt 1505 der Leitungsabschnitte 485, 1505 unterbrechen kann. Eine Steuervorrichtung 12 des Fahrzeugs, beispielsweise das übergeordnete Rechnersystem 12, steuert diese Sicherung 825 der elektronischen Sicherungen 810, 825, 805 mittels Datenkommandos in Bit-Strom-Paketen BP über den Sicherungsdatenbus 9. Dabei übermittelt das übergeordnete Rechnersystem 12 Kommandos an den Rechnerkern 2 der Steuervorrichtung 4 dieser Sicherung 825.

Das in dem hier vorgelegten Dokument vorgeschlagene Verfahren umfasst beispielsweise die folgenden Schritte:

In einem ersten Schritt 1606 erfasst der Rechnerkern 2 der Steuervorrichtung vorzugsweise mittels des Analog-zu-Digital-Wandlers 570 der Steuervorrichtung 4 der Sicherung 825 und des Shunt-Widerstands 24 oder mittels anderer Messmittel 1520 den zeitlichen Verlauf des elektrischen Stroms 1525 durch den abzusichernden Leitungsabschnitt 1505 für einen Zeitabschnitt. Der Rechnerkern 2 der Steuervorrichtung 4 der Sicherung 825 und/oder das übergeordnete Rechnersystem 12 erzeugen vorzugsweise einen zugehörigen Werteverlauf 1610 des erfassten Stromwerts des elektrischen Stroms 1525 durch den abzusichernden Leitungsabschnitt 1505 dieses Zeitabschnitts. Hierzu nutzt der Rechnerkern 2 der Steuervorrichtung 4 der Sicherung 825 insbesondere die besagte Strommessvorrichtung 1520, die in den Leitungsabschnitt 1505 eingefügt ist. Insbesondere kann die Strommessvorrichtung 1520, die dem abzusichernden Leitungsabschnitt 1505 zugeordnete Sicherung 825 oder eine Teilvorrichtung der dem abzusichernden Leitungsabschnitt 1505 zugeordneten Sicherung 825 sein. Beispielsweise kann es sich um den besagten Shunt-Widerstand 24 handeln. Insbesondere dieses Erfassen 1605 und/oder das Erzeugen des zugehörigen Werteverlaufs 1610 dieses Zeitabschnitts erfolgen bevorzugt mittels eines Rechnerkerns 2 einer Steuervorrichtung 4 einer elektronischen Sicherung, die von der elektronischen Sicherung 825 verschieden sein kann, und/oder mittels einer übergeordnete Steuervorrichtung 12 und/oder mittels eines übergeordneten Rechnersystems 12, die über einen Datenbus 9 mit dem Rechnerkern 2 der Steuervorrichtung 4 der Sicherung 825 kommunizieren.

Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, führen dann bevorzugt eine Spektralanalyse 1615 des erfassten Werteverlaufs 1610 dieses Zeitabschnitts in Abhängigkeit von dem erzeugten zeitlichen Werteverlauf 1610 des zeitlichen Verlaufs des elektrischen Stromes 1525 durch den abzusichernden Leitungsabschnitt 1505 durch. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, erzeugen hierdurch ein Spektralanalyseergebnis 1620. Hierbei können das übergeordnete Rechnersystem 12 und/oder die übergeordnete Steuervorrichtung 12 des Fahrzeugs und/oder der Rechnerkern 2 der Steuervorrichtung 4 der elektronischen Sicherung, die mit der elektronischen Sicherung 825 identisch sein kann, über den Datenbus (9) untereinander und/oder mit dem Rechnerkern 2 der Steuervorrichtung 4 der elektronischen Sicherung 828 kommunizieren;

Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, verwenden 1625 dann diese Werte des Spektralanalyseergebnisses 1620 des erfassten Werteverlaufs 1610 dieses Zeitabschnitts und/oder daraus abgeleiteter Werte als aktuellem Merkmalsvektor 1630 für ein Mustererkennungsverfahren, das das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, anschließend bevorzugt ausführen.

Zur Ausführung des Mustererkennungsverfahrens bilden 1635 das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, den aktuellen Merkmalsvektor 1630 der Werte des Spektralanalyseergebnisses 1620 des erfassten Werteverlaufs 1610 dieses Zeitabschnitts auf vordefinierte Merkmalsvektoren 1640 spektraler Basisstrukturen aus einer gespeicherten Menge von vordefinierten Merkmalsvektoren spektraler Basisstrukturen 1650 in einer Basisstrukturdatenbank 1645 ab. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, führen diese Abbildung 1635 insbesondere bevorzugt mittels einer Skalar-Produktbildung wie folgt durch: Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, erzeugen aus dem Merkmalsvektor 1640 einen spektralen Parametersatz 1655. Der spektrale Parametersatz 1655 setzt sich aus Ähnlichkeitswerten zusammen. Jeder Ähnlichkeitswert des Parametersatzes 1655 gibt die Ähnlichkeit zwischen dem Merkmalsvektor 1640 und zwischen jeweils einem vordefinierten Merkmalsvektor 1640 einer Basisstrukturdatenbank 1635 und dem aktuellen Merkmalsvektor 1640 wieder. Jeder der vordefinierten Merkmalsvektoren 1640 der Basisstrukturdatenbank 1635 ist ein Merkmalsvektor 1640, den eine zeitliche Basisstruktur eines zeitlichen Basisverlaufes der Messwerte des elektrischen Stromes 1525 bei der zuvor beschriebenen Verarbeitung erzeugen würde. Eine solche Basisstruktur kann beispielsweise der zeitliche Werteverlauf eines Strom-Spikes im Werteverlauf des Stromes 1525 sein, wie er bei einem Lichtbogen auftreten würde. Es kann sich aber auch um normale Ereignisse handeln, wie sie im fehlerfreien Normalbetrieb auftreten. Jeder vordefinierte Merkmalsvektor 1640 entspricht somit bevorzugt genau einer spektralen Basisstruktur einer in der Basisstrukturdatenbank 1635 gespeicherten Menge vordefinierter Merkmalsvektoren 1640 spektraler Basisstrukturen 1625 der Basisstrukturdatenbank 1635. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, berechnen nun bevorzugt für jedes Paar aus einem Merkmalsvektor 1640 der Basisstrukturdatenbank 1635 und dem aktuellen Merkmalsvektor 1640 einen Ähnlichkeitswert. Jeder dieser Ähnlichkeitswerte ist dann ein Wert des spektralen Parametersatzes 1655. Bevorzugt berechnen das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, einen solchen Ähnlichkeitswert durch eine Skalarproduktbildung zwischen einem Merkmalsvektor 1650 der Basisstrukturdatenbank 1635 einerseits und dem aktuellen Merkmalsvektor andererseits. Bevorzugt berechnen das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, dieses Skalarprodukt für vordefinierte, insbesondere alle vordefinierten Merkmalsvektoren spektraler Basisstrukturen aus der gespeicherten Menge von vordefinierten Merkmalsvektoren spektraler Basisstrukturen 1625 in der Basisstrukturdatenbank 1635.

Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, bewerten 1660 dann bevorzugt den so erhaltenen spektralen Parametersatz 1655 und erzeugen daraus ein Bewertungsergebnis 1665.

Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, führen hierzu vorzugsweise ein neuronales Netzwerkmodell aus. Bevorzugt bilden die Ähnlichkeitswerte des spektralen Parametersatzes 1655 und/oder weitere Werte, wie beispielsweise der aktuelle Merkmalsvektor, die Eingangswerte des neuronalen Netzwerkmodells. Die Ausgangswerte des neuronalen Netzwerkmodells stellen vorzugsweise das Bewertungsergebnis dar. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, können auch aus den Ausgangswerten des neuronalen Netzwerkmodells das Bewertungsergebnis ableiten. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, führen also diese Bewertung 1660 beispielsweise durch Anwendung eines neuronalen Netzwerkmodells durch. Das Bewertungsergebnis 1665 der Bewertung 1660 hängt somit typischer Weise von Ausgangswerten des neuronalen Netzwerkmodells ab.

In Abhängigkeit von dem Bewertungsergebnis 1665 unterbrechen 1670 das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, den Stromflusses 1525 durch den abzusichernden Leitungsabschnitt 1505. Das übergeordnete Rechnersystem 12 und/oder die übergeordnete Steuervorrichtung 12 des Fahrzeugs und/oder der Rechnerkern der Steuervorrichtung 4 der elektronischen Sicherung, die mit der elektronischen Sicherung 825 identisch sein kann, signalisieren über den Datenbus 9 hierzu dem Rechnerkern 2 der Steuervorrichtung 4 der elektronischen Sicherung 825, dass der Rechnerkern 2 der Steuervorrichtung 4 der elektronischen Sicherung 825 den Leistungsschalter 17 der elektronischen Sicherung 825 öffnen soll, wenn das Bewertungsergebnis 1665 des spektralen Parametersatzes 1640 dem Vorhandensein eines Kurzschlusses oder einer Plasmaentladung 1510, insbesondere eines Lichtbogens, entspricht oder dieses nahelegt.

Der Rechnerkern 2 der Steuervorrichtung 4 der elektronischen Sicherung 825 öffnet daraufhin typischerweise den Leistungsschalter 17 der elektronischen Sicherung 825, was die Energiezufuhr stoppt und den Lichtbogen zum Erlöschen bringt.

Figur 17

Die Figur 17 entspricht im Wesentlichen der Figur 7, wobei hier die dritte Versorgungsleitungsabschnitt 245 in den dritten Versorgungsleitungsabschnitt 245 und den vierten Versorgungsleitungsabschnitt 246 getrennt ist.

Die erste Energiequelle 250 versorgt dementsprechend über den dritten Versorgungsleitungsabschnitt 245 und den ersten Vorrichtungsteil 210 des Versorgungsnetzwerks 200 und den nachfolgenden ersten Versorgungsleitungsabschnitt 240 den ersten Vorrichtungsteil 210 des Versorgungsnetzwerks 200 und den fünften Vorrichtungsteil 220 des Versorgungsnetzwerks 200 und den sechsten Vorrichtungsteil 221 des Versorgungsnetzwerks 200 mit elektrischer Energie. Beispielsweise kann die erste Energiequelle 250 eine erste Betriebsspannung liefern.

Die erste Energiequelle 250 versorgt dementsprechend über den dritten Versorgungsleitungsabschnitt 245 und den zweiten Vorrichtungsteil 211 des Versorgungsnetzwerks 200 und den nachfolgenden fünften Versorgungsleitungsabschnitt 242 den zweiten Vorrichtungsteil 211 des Versorgungsnetzwerks 200 und den siebten Vorrichtungsteil 222 des Versorgungsnetzwerks 200 und den achten Vorrichtungsteil 223 des Versorgungsnetzwerks 200 mit elektrischer Energie.

Die zweite Energiequelle 251 versorgt dementsprechend über den vierten Versorgungsleitungsabschnitt 246 und den dritten Vorrichtungsteil 212 des Versorgungsnetzwerks 200 und den nachfolgenden zweiten Versorgungsleitungsabschnitt 241 den dritten Vorrichtungsteil 212 des Versorgungsnetzwerks 200 und den neunten Vorrichtungsteil 224 des Versorgungsnetzwerks 200 und den zehnten Vorrichtungsteil 225 des Versorgungsnetzwerks 200 mit elektrischer Energie. Beispielsweise kann die zweite Energiequelle 251 eine zweite Betriebsspannung liefern. Die zweite Betriebsspannung kann von der ersten Betriebsspannung abweichen. Das hier vorgelegte Dokument verweist in diesem Zusammenhang auf die beispielhaften Beschreibungen zu den beispielhaften Figuren 15 und 16 zur Detektion eines Lichtbogens zwischen einem Hochspannungsversorgungsnetz und einem Niederspannungsversorgungsnetz.

Die zweite Energiequelle 251 versorgt dementsprechend über den vierten Versorgungsleitungsabschnitt 246 und den vierten Vorrichtungsteil 213 des Versorgungsnetzwerks 200 und den nachfolgenden sechsten Versorgungsleitungsabschnitt 243 den vierten Vorrichtungsteil 213 des Versorgungsnetzwerks 200 und den elften Vorrichtungsteil 226 des Versorgungsnetzwerks 200 und den zwölften Vorrichtungsteil 226 des Versorgungsnetzwerks 200 mit elektrischer Energie.

Die Steuervorrichtungen 4 der Sicherungen (214 bis 217 und 225 bis 228 und 235 bis 238 und 292 und 293) der Teilvorrichtungen (210 bis 213 und 220 bis 223 und 230 bis 233 und 250 und 255) sind vorzugsweise mit jeweils zwei Datenschnittstellen 10, 610 in den Datenbus 9 eingefügt. Im Gegensatz zur Figur 7 ist der Datenbus 0 nun jedoch beispielhaft nicht ringförmig geschlossen. Die Rechnerkerne 2 der Steuervorrichtungen 4 der Sicherungen (214 bis 217 und 225 bis 228 und 235 bis 238 und 292 und 293) der Teilvorrichtungen (210 bis 213 und 220 bis 223 und 230 bis 233 und 250 und 255) sind entsprechend einer Daisy-Chain-Kette hintereinander in dem Datenbus 9 angeordnet. Dies hat den Vorteil, dass die Rechnerkerne 2 der Steuervorrichtungen 4 der Sicherungen (214 bis 217 und 225 bis 228 und 235 bis 238 und 292 und 293) der Teilvorrichtungen (210 bis 213 und 220 bis 223 und 230 bis 233 und 250 und 255) nach dem Systemstart des Versorgungsnetzwerks 200 oder auf Befehl der übergeordneten Rechnersystems 12 hin, das typischerweise als Busmaster fungiert, ein Autoadressierungsverfahren durchführen können, um aus ihrer physikalischen Position innerhalb dieser Datenbuskette des Datenbusses 9 eine logische Sicherungsadresse zu erzeugen.

Zur Vergabe einer Sicherungsadresse sendet das übergeordnete Rechnersystem 12 bevorzugt an alle Rechnerkerne 2 der Steuervorrichtungen 4 der Sicherungen (214 bis 217 und 225 bis 228 und 235 bis 238 und 292 und 293) der Teilvorrichtungen (210 bis 213 und 220 bis 223 und 230 bis 233 und 250 und 255) eine Datenbotschaft in Form eines vordefinierten Bit-Strom-Pakets BP, das vorzugsweise jeden der Rechnerkerne 2 der Steuervorrichtungen 4 der Sicherungen (214 bis 217 und 225 bis 228 und 235 bis 238 und 292 und 293) der Teilvorrichtungen (210 bis 213 und 220 bis 223 und 230 bis 233 und 250 und 255) dazu veranlasst, seinen eigen Zustand als ohne gültige Sicherungsadresse einzustufen.

Vorzugsweise geben alle Rechnerkerne 2 der Steuervorrichtungen 4 aller Sicherungen (214 bis 217 und 225 bis 228 und 235 bis 238 und 292 und 293) der Teilvorrichtungen (210 bis 213 und 220 bis 223 und 230 bis 233 und 250 und 255) einen solchen Befehl, den sie über die datenbusabwärts gelegene, BusMaster seitige Datenschnittstelle 10 der Steuervorrichtung 4 ihrer Sicherung erhalten über die zweite datenbusaufwärts gelegene Datenbusschnittstelle 610 an den datenbusaufwärts nachfolgenden Rechnerkern 2 der Steuervorrichtung der datenbusaufwärts unmittelbar nachfolgenden Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) weiter, sodass alle Rechnerkerne 2 aller Steuervorrichtungen 4 aller Sicherungen (214 bis 217 und 225 bis 228 und 235 bis 238 und 292 und 293) der Teilvorrichtungen (210 bis 213 und 220 bis 223 und 230 bis 233 und 250 und 255) letztlich in diesen initialen Zustand ohne gültige Sicherungsadresse gehen. Bevorzugt sind alle Leistungsschalter 17 aller Sicherungen (214 bis 217 und 225 bis 228 und 235 bis 238 und 292 und 293) der Teilvorrichtungen (210 bis 213 und 220 bis 223 und 230 bis 233 und 250 und 255) nach dieser Initialisierung geöffnet, sodass keine unkontrollierte Energieentnahme und/oder kein unkontrollierter Energieverbrauch erfolgen können. Besonders bevorzugt verfügen die Sicherungen (214 bis 217 und 225 bis 228 und 235 bis 238 und 292 und 293) der Teilvorrichtungen (210 bis 213 und 220 bis 223 und 230 bis 233 und 250 und 255) über eine eigene Energieversorgung über eine separate Versorgungsspannungsleitung 6 und eine Bezugspotenzialleitung 201, die mit der Karosseriemasse identisch sein kann, oder über eine temporäre Energieversorgung über eine Energiereserve 8 je Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255), sodass das Versorgungsnetzwerk 200 die Adressierung der logischen Sicherungsadressen zu den einzelnen Sicherungen (214 bis 217 und 225 bis 228 und 235 bis 238 und 292 und 293) der Teilvorrichtungen (210 bis 213 und 220 bis 223 und 230 bis 233 und 250 und 255) ohne Probleme auch bei geöffneten Leistungsschaltern 17 der Sicherungen (214 bis 217 und 225 bis 228 und 235 bis 238 und 292 und 293) der Teilvorrichtungen (210 bis 213 und 220 bis 223 und 230 bis 233 und 250 und 255) durchführen kann.

Zumindest muss aber die Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255), die dem übergeordneten Rechnersystem 12 im Datenbus 9 am nächsten ist, mit elektrischer Energie versorgt sein, damit der erste Schritt der Adressvergabe der Sicherungsadresse an diese Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) erfolgen kann.

Das übergeordnete Rechnersystem 12 vergibt dann im nächsten Schritt mittels eine speziellen Datenbotschaft in Form eines speziellen Bit-Strom-Pakets BP über den Datenbus 9 an den Rechnerkern 2 der Steuervorrichtung 4 dieser Sicherung 256, die im Datenbus 9 dem übergeordneten Rechnersystem 12 am nächsten ist, eine erste Sicherungsadresse. Der Rechnerkern 2 der Steuervorrichtung 4 dieser Sicherung 256 markiert seine Sicherungsadresse dann als gültige Sicherungsadresse. Bevorzugt sollte dann der Rechnerkern 2 der Steuervorrichtung 4 der Sicherung 256 den Leistungsschalter 17 dieser Sicherung 256 schließen. Damit versorgt dann die zweite Energiequelle 251 über den vierten versorgungsleitungsabschnitt 246 den dritten Vorrichtungsteil 212 und den vierten Vorrichtungsteil 213 des Versorgungsnetzwerks mit elektrischer Energie.

Vorzugsweise meldet sich der Rechnerkern 2 der Steuervorrichtung 4 der Sicherung 256 dann beim übergeordneten Rechnersystem 12 mit seiner neuen, gültigen Sicherungsadresse an. Hierdurch weiß dann das übergeordnete Rechnersystem 12, dass der Rechnerkern 2 der Steuervorrichtung 4 der nächstgelegenen Sicherung 256 eine gültige Sicherungsadresse erhalten hat.

Im nächsten Schritt vergibt das übergeordnete Rechnersystem 12 eine Sicherungsadresse an den Rechnerkern 2 der Steuervorrichtung 4 der Sicherungen der Sicherungen (214 bis 217 und 225 bis 228 und 235 bis 238 und 292 und 293) der Teilvorrichtungen (210 bis 213 und 220 bis 223 und 230 bis 233 und 250 und 255), die dem übergeordneten Rechnersystem 12 im Datenbus 9 am nächsten ist und deren Rechnerkern 2 ihrer Steuervorrichtung 4 dieser Sicherung noch keine gültige Sicherungsadresse hat. Das übergeordnete Rechnersystem 12 versendet hierzu im nächsten Schritt eine erneute spezielle Datenbotschaft in Form eines speziellen Bit-Strom-Pakets BP über den Datenbus 9. Die Rechnerkerne 2 der Steuervorrichtungen 4 derjenigen Sicherungen der Sicherungen (214 bis 217 und 225 bis 228 und 235 bis 238 und 292 und 293) der Teilvorrichtungen (210 bis 213 und 220 bis 223 und 230 bis 233 und 250 und 255), die bereits eine gültige Sicherungsadresse vom übergeordneten Rechnersystem 12 erhalten haben, empfangen über ihre erste Datenschnittstelle 10 diese Datenbotschaft des übergeordneten Rechnersystems 10 und ignorieren den Inhalt dieser Datenbotschaft des übergeordneten Rechnersystems 12 und leiten diese Datenbotschaft vorzugsweise über ihre zweite Datenbusschnittstelle 610 datenbusaufwärts an den nachfolgenden Rechnerkern 2 der Steuervorrichtung 4 der im Datenbus 9 nachfolgenden Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) weiter.

Sofern nun der Rechnerkern 2 einer Steuervorrichtung 4 einer Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) eine solche Datenbotschaft empfängt und noch keine gültige Sicherungsadresse besitzt, so erzeugt sich der Rechnerkern 2 der Steuerungsvorrichtung 4 dieser Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) unter Verwendung von Informationsinhalten der empfangenen Datenbotschaft eine Sicherungsadresse, die dann die gültige Sicherungsadresse des Rechnerkerns 2 der Steuervorrichtung 4 dieser Sicherung der Sicherungen (214 bis 217 und 225 bis 228 und 235 bis 238 und 292 und 293) der Teilvorrichtungen (210 bis 213 und 220 bis 223 und 230 bis 233 und 250 und 255) ist. Der Rechnerkern 2 der Steuervorrichtung dieser Sicherung speichert dann eine Information, dass seine Sicherungsadresse eine gültige Sicherungsadresse ist, womit der Rechnerkern 4 der Steuerungsvorrichtung 4 dieser Sicherung dann über eine gültige Sicherungsadresse verfügt. Der Rechnerkern 2 der Steuervorrichtung 4 dieser Sicherung 256 markiert somit seine Sicherungsadresse dann als gültige Sicherungsadresse. Bevorzugt sollte dann der Rechnerkern 2 der Steuervorrichtung 4 dieser Sicherung 256 den Leistungsschalter 17 dieser Sicherung 256 schließen. Damit versorgt dann die im Versorgungsnetzwerk dieser Sicherung vorausgehende Energiequelle über das nachfolgende Versorgungsteilnetzwerk die nachfolgenden Vorrichtungsteile des nachfolgenden Versorgungsteilnetzwerks des Versorgungsnetzwerks 200 mit elektrischer Energie. Vorzugsweise meldet sich der Rechnerkern 2 der Steuervorrichtung 4 dieser gerade adressierten Sicherung dann beim übergeordneten Rechnersystem 12 mit seiner neuen, gültigen Sicherungsadresse an. Hierdurch weiß dann das übergeordnete Rechnersystem 12, dass der Rechnerkern 2 der Steuervorrichtung 4 dieser gerade adressierten Sicherung ebenfalls eine gültige Sicherungsadresse erhalten hat. Diese neu adressierte Sicherung verhält sich dann nachfolgend so wie die anderen Sicherungen, deren Rechnerkerne 2 dieser Steuervorrichtungen dieser Sicherungen bereits eine gültige Sicherungsadresse erhalten haben.

Das übergeordnete Rechnersystem 12 führt diesen Vorgang fort, bis alle Rechnerkerne 2 aller Steuervorrichtungen 4 aller Sicherungen der Sicherungen (214 bis 217 und 225 bis 228 und 235 bis 238 und 292 und 293) der Teilvorrichtungen (210 bis 213 und 220 bis 223 und 230 bis 233 und 250 und 255) eine gültige Sicherungsadresse erhalten haben.

Vorzugsweise können die Rechnerkerne 2 der Steuervorrichtungen 4 der Sicherungen Informationen über die Vorrichtungsteile 210 bis 213 und 220 bis 223 und 230 bis 233 und 255 und 260) bereitstellen. Bevorzugt befinden sich solche Informationen in den nicht flüchtigen Speichern der Steuervorrichtungen 4 dieser Sicherungen (214 bis 217 und 225 bis 228 und 235 bis 238 und 292 und 293) der Teilvorrichtungen (210 bis 213 und 220 bis 223 und 230 bis 233 und 250 und 255). Die Rechnerkerne 2 der Steuervorrichtungen 4 dieser Sicherungen (214 bis 217 und 225 bis 228 und 235 bis 238 und 292 und 293) der Teilvorrichtungen (210 bis 213 und 220 bis 223 und 230 bis 233 und 250 und 255) können diese Informationen zusammen mit ihrer Sicherungsadresse dem übergeordneten Rechnersystem 12 im Datenbus 9 zur Verfügung stellen. Das übergeordnete Rechnersystem 12 kann dann überprüfen, ob die Anordnung und Konfiguration der Sicherungen (214 bis 217 und 225 bis 228 und 235 bis 238 und 292 und 293) der Teilvorrichtungen (210 bis 213 und 220 bis 223 und 230 bis 233 und 250 und 255) und der Vorrichtungteile (210 bis 213 und 220 bis 223 und 230 bis 233 und 250 und 251) einer erwarteten Anordnung und/oder einer durch einen Server 710 eines Dienstanbieters und/oder Automobilherstellers entsprechen. Sofern dies nicht der Fall ist, kann beispielsweise das übergeordnete Rechnersystem 12 zum Ersten eine entsprechende Mitteilung über eine verschlüsselte Datenleitung 720 beispielsweise an den Server 710 des Dienstanbieters senden und/oder eine Anzeige auf einem Benutzereingabegerät 740 initiieren und/oder einen Speichereintrag zum späteren Abruf in einer Werkstatt in einem nicht flüchtigen Speicher des übergeordneten Rechnersystems 12 vornehmen und/oder einzelne Leistungsschalter 17 einzelner Sicherungen der Sicherungen (214 bis 217 und 225 bis 228 und 235 bis 238 und 292 und 293) der Teilvorrichtungen (210 bis 213 und 220 bis 223 und 230 bis 233 und 250 und 255) im Versorgungsnetzwerk 200 wieder öffnen und/oder Betriebsparameter vor Vorrichtungsteilen im Versorgungsnetzwerk 200 ändern.

Figur 18

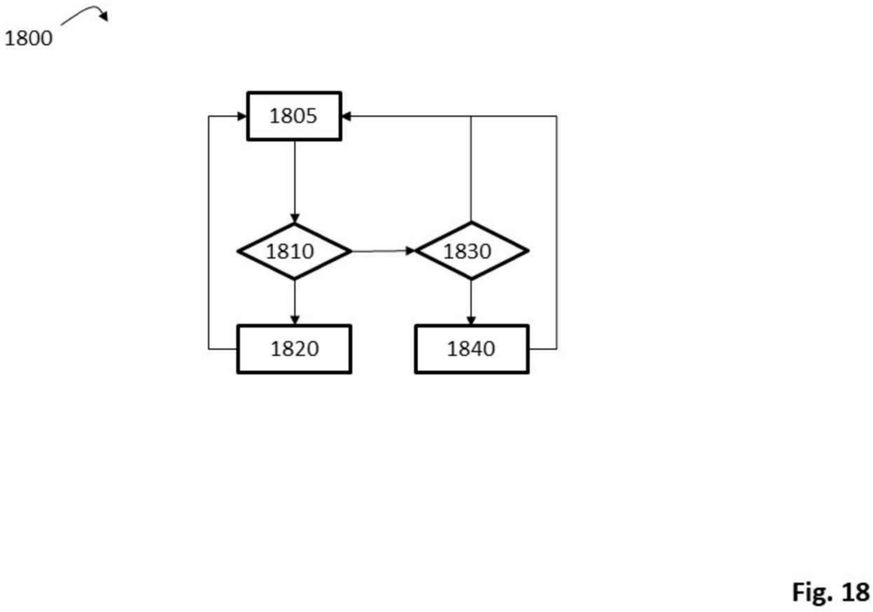

Figur 18 stellt schematisch vereinfacht ein beispielhaftes Verfahren 1800 zum Betreiben eines Versorgungsnetzwerks 1700 der Figur 17 dar.

In den beiden nachfolgenden Abschnitten beschreibt das hier vorgelegte Dokument ein erstes Verfahren, bei dem die Sicherung 255 einer Energiequelle 250 die Ausbalancierung des Versorgungsnetzwerks 1700 durchführt. In einem zweiten Abschnitt beschreibt das hier vorgelegte Dokument nachfolgend ein zu dem vorerwähnten Verfahren korrespondierendes zweites mögliches Verfahren 1800, bei dem die Sicherungen 214, 215 nachgelagerter Vorrichtungsteile 210, 211 die Ausbalancierung des Versorgungsnetzwerks 1700 im Fahrzeug vornehmen.

Das Versorgungsnetzwerk 1700 weist Leitungsabschnitte 245 und energieverbrauchende Vorrichtungsteile 210, 211 des Versorgungsnetzwerks 1700 auf, die das Versorgungsnetzwerk 1700 über einen Leitungsabschnitt 245 mit elektrischer Energie versorgt. Das Versorgungsnetzwerk 1700 umfasst des Weiteren energieliefernde Vorrichtungsteile 250 des Fahrzeugs, die Energie in das Versorgungsnetzwerk 1700 einspeisen. Das Versorgungsnetzwerk 1700 versorgt energieverbrauchende Vorrichtungsteile 210, 211 des Versorgungsnetzwerks 1700 des Fahrzeugs über zumindest einen Leitungsabschnitt 245 mit elektrischer Energie aus dem Versorgungsnetzwerk 1700. Energieverbrauchende Vorrichtungsteile 210 können wiederum über einen weiteren Leitungsabschnitt 240 einen weiteren Vorrichtungsteil 220 des Fahrzeugs mit elektrischer Energie versorgen. Die energieverbrauchenden Vorrichtungsteile 210 weisen jeweils bevorzugt eine elektronische Sicherung 214 auf. Die elektronische Sicherung 255 eines Vorrichtungsteils 250 kann die Versorgung dieses energieverbrauchenden Vorrichtungsteils 210 und der von diesem energieverbrauchenden Vorrichtungsteil 210 mit elektrischer Energie versorgten weiteren Vorrichtungsteile 220, 221 unterbinden. Dies kann so geschehen, dass der Rechnerkern 2 der Steuervorrichtung 4 dieser Sicherung 255 dieses Vorrichtungsteile 250 den Leistungsschalter 17 dieser Sicherung 255 öffnet, um die Versorgung dieses energieverbrauchenden Vorrichtungsteils 210 und der von diesem energieverbrauchenden Vorrichtungsteil 210 mit elektrischer Energie versorgten weiteren Vorrichtungsteile 220, 221 zu unterbinden. Das hier in dem hier vorgelegten Dokument beschriebene Verfahren umfasst dann die Schritte:

Schritt 1: Das übergeordnete Rechnersystem 12 und/oder ein Rechnerkern 2 einer Steuervorrichtung 4 einer Sicherung der Sicherungen (214 bis 217 und 225 bis 228 und 235 bis 238 und 255 und 260) überwacht den Gesamtenergiebedarf von Vorrichtungsteilen (210, 211, 220, 221, 222, 223) der Vorrichtungsteile des Fahrzeugs.

Hierzu erfasst 1805 das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die jeweiligen erwarteten aktuellen und/oder zukünftigen Energiebedarfe dieser Vorrichtungsteile (210, 211, 220, 221, 222, 223) durch Anfragen bei Rechnerkeren 2 der Steuervorrichtungen 4 der Sicherungen dieser Vorrichtungsteile (210, 211, 220, 221, 222, 223) und/oder bei anderen Rechnerkernen dieser Vorrichtungsteile (210, 211, 220, 221, 222, 223), die an den Datenbus 9 angeschlossen sind. Bevorzugt ermittelt aus den Antworten der Rechnerkerne 2 der Steuervorrichtungen 4 der Sicherungen dieser Vorrichtungsteile (210, 211, 220, 221, 222, 223) und/oder aus den Antworten der anderen Rechnerkerne dieser Vorrichtungsteile (210, 211, 220, 221, 222, 223), die an den Datenbus 9 angeschlossen sind, das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) den jeweiligen erwarteten, aktuellen und/oder zukünftigen Gesamtenergiebedarf dieser Vorrichtungsteile (210, 211, 220, 221, 222, 223).

Bevorzugt vergleicht 1810 das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) des so ermittelten Gesamtenergiebedarfes dieser Vorrichtungsteile (210, 211, 220, 221, 222, 223) des Fahrzeugs mit einem oberen Energieverbrauchsschwellwert.

Das Versorgungsnetzwerk 1700 auf eine Überschreitung des oberen Energieverbrauchsschwellwerts auf zwei verschiedene Arten reagieren. Zum Ersten kann das Versorgungsnetzwerk 1700 die bereitgestellte und/oder erzeugte Energie vergrößern und/oder zum Zweiten den Energiebedarf der Verbraucher im Versorgungsnetzwerk 1700 erniedrigen.

Liegt der ermittelte Gesamtenergiebedarf oberhalb des oberen Energieverbrauchsschwellwerts so kann das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Versorgung eines ersten energieverbrauchenden Vorrichtungsteils 210 mit elektrischer Energie und/oder der von diesem ersten Vorrichtungsteil 210 mit elektrischer Energie versorgten weiteren Vorrichtungsteile 220, 221 unterbinden 1820. Liegt der ermittelte Gesamtenergiebedarf oberhalb des oberen Energieverbrauchsschwellwerts so kann das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Energielieferfähigkeit einer Energiequelle 250 sofern möglich beispielsweise durch Umparametrisierung der Energiequelle 250 erhöhen 1820.

Dies Maßnahmen können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) ergreifen, wenn der ermittelte Gesamtenergiebedarf aller Vorrichtungsteile (210, 211, 220, 221, 222, 223) über dem oberen Energieverbrauchsschwellwert liegt oder liegen könnte oder der Betriebszustand und/oder die Fahrsituation dies insbesondere für die Zukunft erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) können die Versorgung eines ersten energieverbrauchenden Vorrichtungsteils 210 mit elektrischer Energie und/oder der von diesem ersten Vorrichtungsteil 210 mit elektrischer Energie versorgten weiteren Vorrichtungsteile 220, 221 unterbinden 1820 indem sie mittels einer Datenbotschaft über den Datenbus an einen Rechnerkren 2 einer Steuervorrichtung 4 einer Sicherung 255 den Rechnerkern 2 der Steuervorrichtung 4 dieser Sicherung 255 veranlassen, den Leistungsschalter 17 dieser Sicherung 255 des betreffenden Vorrichtungsteils 250 zu öffnen.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) können den ermittelten Gesamtenergiebedarf dieser Vorrichtungsteile (210, 211, 220, 221, 222, 223) des Fahrzeugs auch mit einem unteren Energieverbrauchsschwellwert vergleichen 1830.

Wie zuvor kann das Versorgungsnetzwerk auf eine Unterschreitung des unteren Energieverbrauchsschwellwerts auf zwei verschiedene Arten reagieren. Zum Ersten kann das Versorgungsnetzwerk 1700 die bereitgestellte und/oder erzeugte Energie vermindern und/oder zum Zweiten den Energiebedarf der Verbraucher im Versorgungsnetzwerk 1700 erhöhen.

Liegt der ermittelte Gesamtenergiebedarf unterhalb des unteren Energieverbrauchsschwellwerts so kann das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Versorgung eines ersten energieverbrauchenden Vorrichtungsteils 210 mit elektrischer Energie und/oder der von diesem ersten Vorrichtungsteil 210 mit elektrischer Energie versorgten weiteren Vorrichtungsteile 220, 221 ermöglichen 1840. Liegt der ermittelte Gesamtenergiebedarf unterhalb des unteren Energieverbrauchsschwellwerts so kann das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Energielieferfähigkeit einer Energiequelle 250 sofern möglich beispielsweise durch Umparametrisierung der Energiequelle 250 erniedrigen 1840.

Dies Maßnahmen können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) ergreifen, wenn der ermittelte Gesamtenergiebedarf aller Vorrichtungsteile (210, 211, 220, 221, 222, 223) unter dem unteren Energieverbrauchsschwellwert liegt oder liegen könnte oder der Betriebszustand und/oder die Fahrsituation dies insbesondere für die Zukunft erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) können die Versorgung eines ersten energieverbrauchenden Vorrichtungsteils 210 mit elektrischer Energie und/oder der von diesem ersten Vorrichtungsteil 210 mit elektrischer Energie versorgten weiteren Vorrichtungsteile 220, 221 ermöglichen 1840 indem sie mittels einer Datenbotschaft über den Datenbus an einen Rechnerkren 2 einer Steuervorrichtung 4 einer Sicherung 255 den Rechnerkern 2 der Steuervorrichtung 4 dieser Sicherung 255 veranlassen, den Leistungsschalter 17 dieser Sicherung 255 des betreffenden Vorrichtungsteils 250 zu schließen.

Vorzugsweise hat die Energieversorgung der Vorrichtungsteile 220, 221 des Versorgungsnetzwerks 1700 des Fahrzeugs, deren Energieversorgung ggf. unterbunden wird, eine geringere Priorität, als die Energieversorgung der Vorrichtungsteile 222, 223 des Versorgungsnetzwerks 1700 Fahrzeugs, deren Energieversorgung ggf. nicht unterbunden wird.

Vorzugsweise hat die Energieversorgung der Vorrichtungsteile 222, 223 des Versorgungsnetzwerks 1700 des Fahrzeugs, deren Energieversorgung ggf. verbessert wird, eine höhere Priorität, als die Energieversorgung der Vorrichtungsteile 220, 221 des Versorgungsnetzwerks 1700 Fahrzeugs, deren Energieversorgung ggf. nicht verbessert wird.

In dem vorhergehenden Abschnitt beschreibt das hier vorgelegte Dokument ein Verfahren, bei dem die Sicherung 255 einer Energiequelle 250 die Ausbalancierung des Versorgungsnetzwerks 1700 durchführt. Zu dem obigen Verfahren korrespondiert ein mögliches Verfahren 1800, bei dem die Sicherungen 214, 215 nachgelagerter Vorrichtungsteile 210, 211 die Ausbalancierung des Versorgungsnetzwerks 1700 im Fahrzeug vornehmen.

Dieses zweite Verfahren 1800 zum Ausbalancieren eines Versorgungsnetzwerks 1700 eines Fahrzeugs ist wie zuvor wieder ein Verfahren 1800 zum Betreiben eines Versorgungsnetzwerks 1700. Für dieses zweite Verfahren 1800 weist das Versorgungsnetzwerk 1700 wieder Leitungsabschnitte 245, 240, 241 auf. Das Versorgungsnetzwerk 1700 umfasst wieder energieverbrauchende Vorrichtungsteile 210, 211 des Versorgungsnetzwerks 1700, die das Versorgungsnetzwerk 1700 über einen Leitungsabschnitt 245 mit elektrischer Energie versorgt. Das Versorgungsnetzwerk 1700 umfasst darüber hinaus wieder energieliefernde Vorrichtungsteile 250 des Fahrzeugs, die Energie in das Versorgungsnetzwerk 1700 einspeisen. Das Versorgungsnetzwerk 1700 versorgt energieverbrauchende Vorrichtungsteile 210, 211 des Fahrzeugs über zumindest einen Leitungsabschnitt 245 mit elektrischer Energie aus dem Versorgungsnetzwerk 1700. Wie zuvor können wieder energieverbrauchende Vorrichtungsteile 210, 211 über einen weiteren Leitungsabschnitt 240, 241 einen weiteren Vorrichtungsteil 220, 221, 222, 223 des Fahrzeugs mit elektrischer Energie versorgen. Diese energieverbrauchenden Vorrichtungsteile 210, 211 weisen jeweils eine elektronische Sicherung 214, 215 auf, die vorzugsweise mit dem Datenbus 9 verbunden sind. Die elektronische Sicherung 255 eines Vorrichtungsteils 250 kann nun vorzugsweise die Versorgung dieses energieverbrauchenden Vorrichtungsteils 210, 211 und der von diesem Vorrichtungsteil 210, 211 mit elektrischer Energie versorgten weiteren Vorrichtungsteile 220, 221, 222, 223 unterbinden. Das vorgeschlagene zweite Verfahren umfasst dann die folgenden Schritte:

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) überwachen den Gesamtenergiebedarf von Vorrichtungsteilen (210, 211, 220, 221, 222, 223) der Vorrichtungsteile des Fahrzeugs. Hierzu erfassen 1805 das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) den Energiebedarf dieser Vorrichtungsteile (210, 211, 220, 221, 222, 223) durch Anfragen bei den Rechnerkernen 2 der Steuervorrichtungen 4 der Sicherungen (214 bis 217 und 225 bis 228 und 235 bis 238 und 255 und 260) dieser Vorrichtungsteile und/oder durch Anfragen bei anderen an den Datenbus 9 angeschlossenen Rechnerkernen über den Datenbus 9. Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) ermitteln auf Basis der Antworten der Rechnerkerne 2 der Steuervorrichtungen 4 der Sicherungen (214 bis 217 und 225 bis 228 und 235 bis 238 und 255 und 260) dieser Vorrichtungsteile und/oder der Antworten der anderen an den Datenbus 9 angeschlossenen Rechnerkernen, die das übergeordnete Rechnersystem 12 und/oder die der Rechnerkern 2 der Steuervorrichtung 4 jener Sicherung der Sicherungen (214 bis 217 und 225 bis 228 und 235 bis 238 und 255 und 260) über den Datenbus 9 erhalten, den Gesamtenergiebedarf dieser Vorrichtungsteile (210, 211, 220, 221, 222, 223).

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) können dann diesen ermittelten Gesamtenergiebedarf dieser Vorrichtungsteile (210, 211, 220, 221, 222, 223) des Fahrzeugs mit einem oberen Energieverbrauchsschwellwert vergleichen 1810.

Sofern der ermittelte Gesamtenergiebedarf oberhalb des oberen Energieverbrauchsschwellwert liegt, können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile unterbinden 1820. Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) unterbinden 1820 diese Energieversorgung, wenn der Gesamtenergiebedarf aller Vorrichtungsteile über dem oberen Energietransportschwellwert für diesen Leitungsabschnitt liegt oder liegen könnte oder der Betriebszustand und/oder die Fahrsituation dies erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) kann beispielsweise mittels einer geeigneten Datenbotschaft an den Rechnerkern 2 der Steuervorrichtung 4 der Sicherung 214 eines solchen Vorrichtungsteils 210 signalisieren, dass der Rechnerkern 2 der Steuervorrichtung 4 dieser Sicherung 214 durch Öffnen des Leistungsschalters 17 die Energieversorgung des nachfolgenden Versorgungsteilnetzwerkes 240, 220, 221 einstellen soll, sodass der Gesamtenergiebedarf des Versorgungsnetzwerks 1700 um den Energiebedarf der abgeworfenen Vorrichtungsteile 220, 221 sinkt.

Sofern der ermittelte Gesamtenergiebedarf oberhalb des oberen Energieverbrauchsschwellwert liegt, können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Energieeinspeisung einer Energiequelle in das betroffene Versorgungsteilnetzwerk des Versorgungsnetzwerks 1700 und in die von diesem Vorrichtungteil mit elektrischer Energie versorgten weiteren Versorgungsteilnetze erhöhen 1820. Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) erhöhen 1820 diese Energieeinspeisung, wenn der Gesamtenergiebedarf aller versorgten Vorrichtungsteile über dem oberen Energietransportschwellwert für diesen Leitungsabschnitt liegt oder liegen könnte oder der Betriebszustand und/oder die Fahrsituation dies erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) kann beispielsweise mittels einer geeigneten Datenbotschaft an den Rechnerkern 2 der Steuervorrichtung 4 der Sicherung 214 eines solchen Vorrichtungsteils 210 signalisieren, dass der Rechnerkern 2 der Steuervorrichtung 4 dieser Sicherung 214 durch Schließen des Leistungsschalters 17 die Energieversorgung des nachfolgenden Versorgungsteilnetzwerkes 240, 220, 221 ermöglichen soll, sodass die Energiequelle 250 den Gesamtenergiebedarf des nachfolgenden Versorgungsteilnetzwerks 240, 220, 221 decken kann.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) können dann diesen ermittelten Gesamtenergiebedarf dieser Vorrichtungsteile (210, 211, 220, 221, 222, 223) des Fahrzeugs mit einem unteren Energieverbrauchsschwellwert vergleichen 1810.

Sofern der ermittelte Gesamtenergiebedarf unterhalb des unteren Energieverbrauchsschwellwerts liegt, können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile ermöglichen 1820. Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) ermöglichen 1820 diese Energieversorgung, wenn der Gesamtenergiebedarf aller Vorrichtungsteile unter dem unteren Energietransportschwellwert für diesen Leitungsabschnitt liegt oder liegen könnte oder der Betriebszustand und/oder die Fahrsituation dies erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) kann beispielsweise mittels einer geeigneten Datenbotschaft an den Rechnerkern 2 der Steuervorrichtung 4 der Sicherung 214 eines solchen Vorrichtungsteils 210 signalisieren, dass der Rechnerkern 2 der Steuervorrichtung 4 dieser Sicherung 214 durch Schließen des Leistungsschalters 17 die Energieversorgung des nachfolgenden Versorgungsteilnetzwerkes 240, 220, 221 ermöglichen soll, sodass der Gesamtenergiebedarf des Versorgungsnetzwerks 1700 um den Energiebedarf der abgeworfenen Vorrichtungsteile 220, 221 steigt.

Sofern der ermittelte Gesamtenergiebedarf unterhalb des unteren Energieverbrauchsschwellwerts liegt, können das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) die Energieeinspeisung einer Energiequelle in das betroffene Versorgungsteilnetzwerk des Versorgungsnetzwerks 1700 und in die von diesem Vorrichtungsteil mit elektrischer Energie versorgten weiteren Versorgungsteilnetze erniedrigen 1820. Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) erniedrigen 1820 diese Energieeinspeisung, wenn der Gesamtenergiebedarf aller versorgten Vorrichtungsteile unter dem unteren Energietransportschwellwert für diesen Leitungsabschnitt liegt oder liegen könnte oder der Betriebszustand und/oder die Fahrsituation dies erwarten lässt.

Das übergeordnete Rechnersystem 12 und/oder der Rechnerkern 2 der Steuervorrichtung 4 jener Sicherung der Sicherungen (214 bis 217 und 225 bis 228 und 235 bis 238 und 255 und 260) kann beispielsweise mittels einer geeigneten Datenbotschaft an den Rechnerkern 2 der Steuervorrichtung 4 der Sicherung 214 eines solchen Vorrichtungsteils 210 signalisieren, dass der Rechnerkern 2 der Steuervorrichtung 4 dieser Sicherung 214 durch Öffnen des Leistungsschalters 17 die zusätzliche Energieversorgung des nachfolgenden Versorgungsteilnetzwerkes 240, 220, 221 unterbinden soll, sodass die Energiequelle 250 den Gesamtenergiebedarf des nachfolgenden Versorgungsteilnetzwerks 240, 220, 221 nicht mehr decken kann.

Vorzugsweise hat die Energieversorgung der Vorrichtungsteile des Fahrzeugs, deren Energieversorgung unterbunden wird, eine geringere Priorität als die Energieversorgung der Vorrichtungsteile des Fahrzeugs, deren Energieversorgung nicht unterbunden wird.

Vorzugsweise hat die Energieversorgung der Vorrichtungsteile des Fahrzeugs, deren Energieversorgung ermöglicht wird, eine höhere Priorität als die Energieversorgung der Vorrichtungsteile des Fahrzeugs, deren Energieversorgung nicht ermöglicht wird.

Figur 19

Die Figur 19 entspricht in wesentlichen Teilen der Figur 15 und der Figur 10.

Während Figur 10 einen Sicherungskasten 1000 zeigt, Zeigt Figur 19 zwei abzusichernde Leitungen 1915 und 1505, die Teile eines Kabelbaums 1515 sind.

Eine erste Energiequelle 250 speist Energie in den dritten Versorgungsleitungsabschnitt 245 ein.

Eine dritte elektronische Sicherung 1975 verbindet über ihren Leistungsschalter 17 ggf. den dritten Versorgungsleitungsabschnitt 245 mit dem dritten abzusichernder Leitungsabschnitt 1915. Mittels der dritten Strommessvorrichtung 1940 kann der Rechnerkern 2 der Steuervorrichtung 4 der dritten elektronische Sicherung 1975 den Wert des dritten Stromflusses 1920 in einen dritten, vorausgehenden, abzusichernden Leitungsabschnitt 1915 des Kabelbaums 1515 erfassen. Der Rechnerkern 2 der Steuervorrichtung 4 der dritten elektronische Sicherung 1975 kann mittels des dritten Zeitgebers 1960 der dritten elektronischen Sicherung 1975 jedem Messwert des dritten Stromflusses 1910 in dem dritten, vorausgehenden, abzusichernden Leitungsabschnitt 1915 des Kabelbaums 1515 einen Zeitstempelwert zuordnen. Bevorzugt überträgt der Rechnerkern 2 der Steuervorrichtung 4 dieser dritten elektronischen Sicherung 1975 die erfassten Wertepaare aus Zeitstempelwert und Messwert des dritten Stromflusses 1920 in einen dritten, vorausgehenden, abzusichernden Leitungsabschnitt 1915 des Kabelbaums 1515 über den Datenbus 9 an einen Rechnerkern 2 einer Steuervorrichtung 4 einer anderen Sicherung in dem Versorgungsnetzwerk und/oder an ein übergeordnetes Rechnersystem 12 zur Konsolidierung. Am anderen Ende des dritten abzusichernden Leitungsabschnitts 1915 verbindet der Leistungsschalter 17 einer vierten elektronischen Sicherung 1980 den dritten abzusichernden Leitungsabschnitt 1915 mit einem vierten abzusichernden Leitungsabschnitt 1925. Mittels der vierten Strommessvorrichtung 1945 kann der Rechnerkern 2 der Steuervorrichtung 4 der vierten elektronische Sicherung 1980 den Wert des vierten Stromflusses 1925 in einen vierten, nachfolgende, abzusichernden Leitungsabschnitt 1925 erfassen. Der Rechnerkern 2 der Steuervorrichtung 4 der vieren elektronische Sicherung 1980 kann mittels des vierten Zeitgebers 1965 der vierten elektronischen Sicherung 1980 jedem Messwert des vierten Stromflusses 1930 in dem vierten, nachfolgenden, abzusichernden Leitungsabschnitt 1925 einen Zeitstempelwert zuordnen. Bevorzugt überträgt der Rechnerkern 2 der Steuervorrichtung 4 dieser vierten elektronischen Sicherung 1980 die erfassten Wertepaare aus Zeitstempelwert und Messwert des vierten Stromflusses 1930 in einen vierten, nachfolgenden, abzusichernden Leitungsabschnitt 1925 über den Datenbus 9 an einen Rechnerkern 2 einer Steuervorrichtung 4 einer anderen Sicherung in dem Versorgungsnetzwerk und/oder an ein übergeordnetes Rechnersystem 12 zur Konsolidierung.

Eine zweite Energiequelle 251 speist Energie in den vierten Versorgungsleitungsabschnitt 246 ein.

Eine elektronische Sicherung 825 verbindet über ihren Leistungsschalter 17 ggf. den vierten Versorgungsleitungsabschnitt 246 mit dem ersten abzusichernder Leitungsabschnitt 1505. Mittels der ersten Strommessvorrichtung 1520 kann der Rechnerkern 2 der Steuervorrichtung 4 der ersten elektronische Sicherung 825 den Wert des ersten elektrischen Stromflusses 1525 in einen ersten, vorausgehenden, abzusichernden Leitungsabschnitt 1505 des Kabelbaums 1515 erfassen. Der Rechnerkern 2 der Steuervorrichtung 4 der ersten elektronische Sicherung 825 kann mittels des ersten Zeitgebers 1950 der ersten elektronischen Sicherung 825 jedem Messwert des ersten Stromflusses 1525 in dem ersten, vorausgehenden, abzusichernden Leitungsabschnitt 1505 des Kabelbaums 1515 einen Zeitstempelwert zuordnen. Bevorzugt überträgt der Rechnerkern 2 der Steuervorrichtung 4 dieser ersten elektronischen Sicherung 825 die erfassten Wertepaare aus Zeitstempelwert und Messwert des ersten Stromflusses 1525 in einen ersten, vorausgehenden, abzusichernden Leitungsabschnitt 1505 des Kabelbaums 1515 über den Datenbus 9 an einen Rechnerkern 2 einer Steuervorrichtung 4 einer anderen Sicherung in dem Versorgungsnetzwerk und/oder an ein übergeordnetes Rechnersystem 12 zur Konsolidierung. Am anderen Ende des ersten abzusichernden Leitungsabschnitts 1505 verbindet der Leistungsschalter 17 einer zweiten elektronischen Sicherung 805 den ersten abzusichernden Leitungsabschnitt 1505 mit einem zweiten, nachfolgenden, abzusichernden Leitungsabschnitt 1905. Mittels der zweiten Strommessvorrichtung 1935 kann der Rechnerkern 2 der Steuervorrichtung 4 der zweiten elektronische Sicherung 805 den Wert des zweiten Stromflusses 1910 in einem zweiten, nachfolgenden, abzusichernden Leitungsabschnitt 1905 erfassen. Der Rechnerkern 2 der Steuervorrichtung 4 der zweiten elektronische Sicherung 805 kann mittels des zweiten Zeitgebers 1955 der zweiten elektronischen Sicherung 805 jedem Messwert des zweiten Stromflusses 1910 in dem zweiten, nachfolgenden, abzusichernden Leitungsabschnitt 1905 einen Zeitstempelwert zuordnen. Bevorzugt überträgt der Rechnerkern 2 der Steuervorrichtung 4 dieser zweiten elektronischen Sicherung 805 die erfassten Wertepaare aus Zeitstempelwert und Messwert des zweiten Stromflusses 1910 in einen zweiten, nachfolgenden, abzusichernden Leitungsabschnitt 1905 über den Datenbus 9 an einen Rechnerkern 2 einer Steuervorrichtung 4 einer anderen Sicherung in dem Versorgungsnetzwerk und/oder an ein übergeordnetes Rechnersystem 12 zur Konsolidierung.

Bevorzugt verfügt das übergeordnete Rechnersystem 12 über einen Zeitgeber 1970 des übergeordneten Rechnersystems 12. Das übergeordnete Rechnersystem 12 synchronisier bevorzugt mittels einer speziellen Datenbotschaft über den Datenbus 9 an alle relevanten Rechnerkerne 2 der Steuervorrichtungen 4 der relevanten Sicherungen 805, 825, 1975, 1980 die Zeitgeber 1950, 1955, 1960, 1965 dieser Sicherungen 805, 825, 1975, 1080 mit dem Zeitgeber 1970 des übergeordneten Rechnersystems 12. Die Datenbotschaft hat dabei bevorzugt wieder die Form eines Bit-Strom-Pakets BP.

Bevorzugt kann das übergeordnete Rechnersystem 12 mit einem Server 1985, 710 und/oder einem Terminal 740 einer Werkstatt und/oder dem Server 710 eines Automobilherstellers und/oder eines Dienstleistungsanbieters und/oder oder eines sonstigen Nutzers 730 der von dem Versorgungsnetzwerk oder einem übergeordneten Rechnersystem (12) ermittelten Daten verbunden sein. Diese Datenverbindung stellen bevorzugt ein oder mehrere drahtgebundene und/oder drahtlose Datenverbindungen Datenverbindung 1990, 740 zu einem Server 1985, 710 einer Werkstatt und/oder eines Automobilherstellers und/oder eines Dienstleistungsanbieters her. Diese Datenverbindungen sind bevorzugt verschlüsselt. Diese Datenverbindungen sind bevorzugt PQC-verschlüsselt.

Figur 20

Das hier vorgelegte Dokument verweist hier auf die Beschreibung der Figur 19.

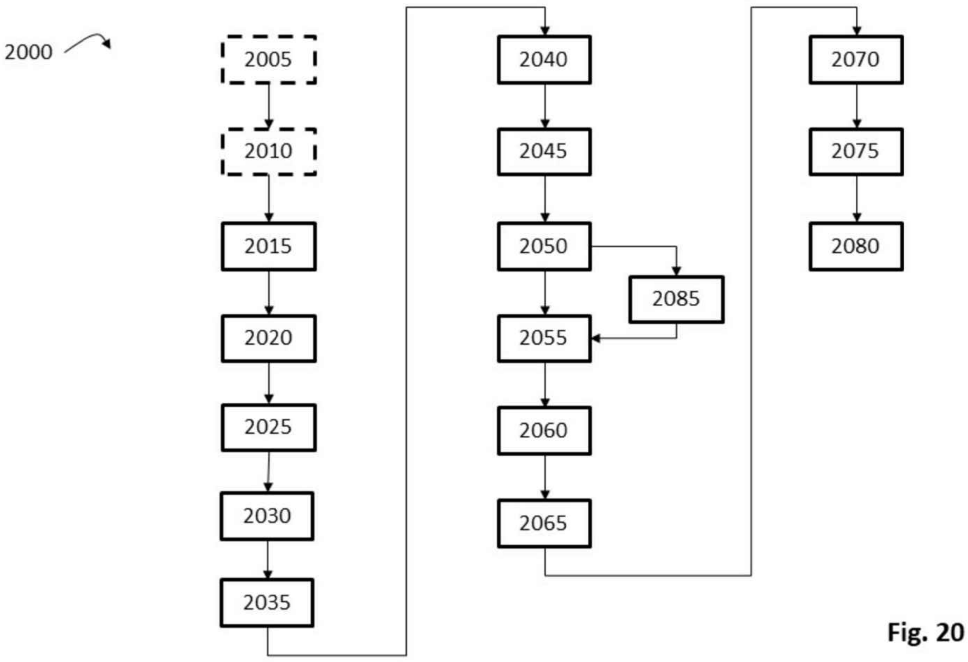

Figur 20 beschreibt schematisch und vereinfacht ein verteiltes Messverfahren 2000 zur Erfassung des Zustands eines Kabelbaums 1515 eines Fahrzeugs in Anlehnung an die Darstellung der Figur 19. Das vorgeschlagen Verfahren erfolgt beispielsweise mit den folgenden Schritten:

Vorzugsweise synchronisiert 2005 das übergeordnete Rechnersystem 12 oder ein anderes Rechnersystem und/oder ein Rechnerkern 2 einer Sicherung einen ersten Zeitgeber 1950 einer ersten elektronischen Sicherung 825 mit einem Zeitnormal, insbesondere einem Zeitgeber 1970 eines übergeordneten Rechnersystems 12. Auch der Zeitgeber 35 einer Steuerungsvorrichtung 4 einer Sicherung 1 des Versorgungsnetzwerks kann als Zeitnormal dienen. In gleicher Weise erfolgt bevorzugt ggf. die Synchronisation 2010 eines zweiten Zeitgebers 1955 einer zweiten elektronischen Sicherung 805 mit dem Zeitnormal, insbesondere dem Zeitgeber 1970 eines übergeordneten Rechnersystems 12.

Vorzugsweise initiieren 2015 das übergeordnete Rechnersystem 12 und/oder ein Rechnerkern 2 einer Steuervorrichtung 4 einer der Sicherungen 825, 805, 1975, 1980 die folgenden beiden Erfassungsvorgänge vorzugsweise synchronisiert zu gleichen Zeitwerten des ersten Zeitgebers 1950 der ersten elektronischen Sicherung 825 und des zweiten Zeitgebers 1955 der zweiten elektronischen Sicherung 805. Hierzu signalisieren das übergeordnete Rechnersystem 12 und/oder ein Rechnerkern 2 einer Steuervorrichtung 4 einer der Sicherungen 825, 805, 1975, 1980 über den Datenbus diese Initiierung 2015 bevorzugt über den Datenbus an den Rechnerkern 2 der Steuervorrichtung 4 der ersten Sicherung 825 und den Rechnerkern 2 der Steuervorrichtung 4 der zweiten Sicherung 825.

Der nächste Schritt ist das Erfassen 2020 eines ersten Stromwerts des Stromflusses 1525 in einen ersten abzusichernden Leitungsabschnitt 1505 des Kabelbaums 1515 hinein. Der Rechnerkern 2 der Steuervorrichtung 4 der ersten Sicherung 825 führt diese Erfassung 2020 vorzugsweise mittels der ersten Strommessvorrichtung 1520 der ersten Sicherung 825 durch. Bevorzugt umfasst die erste Strommessvorrichtung 1520 der ersten Sicherung 825 den Analog-zu-Digital-Wandler 570 und den Hilfsleistungsschalter 23 der ersten elektronischen Sicherung 825 und den Shunt-Widerstand 24 der ersten Sicherung 825. Bevorzugt erfasst der Rechnerkern 2 der Steuervorrichtung 4 der ersten Sicherung 825 mittels dieser Mittel (570, 20, 21, 22, 23, 24, 25) den ersten Stromwert des Stromflusses 1525 in einen ersten abzusichernden Leitungsabschnitt 1505 des Kabelbaums 1515 hinein. Vorzugsweise erfasst der Rechnerkern 2 der Steuervorrichtung 4 der ersten Sicherung 825 zeitgleich den ersten Zeitstempelwert als momentanen Zeitwert des ersten Zeitgebers 1950 der ersten Sicherung 825 zum Zeitpunkt der Erfassung des ersten Stromwerts des Stromflusses 1525 in einen ersten abzusichernden Leitungsabschnitt 1505 des Kabelbaums 1515.

Der nächste Schritt ist das Erfassen 2025 eines zweiten Stromwerts des Stromflusses 1920 in einen zweiten abzusichernden Leitungsabschnitt 1905. Der Rechnerkern 2 der Steuervorrichtung 4 der zweiten Sicherung 805 führt diese Erfassung 2025 vorzugsweise mittels der zweiten Strommessvorrichtung 1935 der ersten Sicherung 805 durch. Bevorzugt umfasst die zweite Strommessvorrichtung 1935 der zweiten Sicherung 805 den Analog-zu-Digital-Wandler 570 und den Hilfsleistungsschalter 23 der zweiten elektronischen Sicherung 805 und den Shunt-Widerstand 24 der zweiten Sicherung 805. Bevorzugt erfasst der Rechnerkern 2 der Steuervorrichtung 4 der zweiten Sicherung 805 mittels dieser Mittel (570, 20, 21, 22, 23, 24, 25) den zweiten Stromwert des Stromflusses 1935 in einen zweiten abzusichernden Leitungsabschnitt 1905. Vorzugsweise erfasst der Rechnerkern 2 der Steuervorrichtung 4 der zweiten Sicherung 805 zeitgleich den zweiten Zeitstempelwert als momentanen Zeitwert des zweiten Zeitgebers 1955 der zweiten Sicherung 805 zum Zeitpunkt der Erfassung des zweiten Stromwerts des Stromflusses 1910 in einen zweiten abzusichernden Leitungsabschnitt 1905.

Bevorzugt ermittelt 2030 der Rechnerkern 2 der Steuervorrichtung 4 der ersten Sicherung 825 den ersten Zeitstempelwert mit Hilfe des ersten Zeitgebers 1950 der ersten elektronischen Sicherung 825, für jeden Messwert oder für eine Gruppe von Messwerten der ersten Stromwerte des Stromflusses 1525.

Bevorzugt ermittelt 2035 der Rechnerkern 2 der Steuervorrichtung 4 der zweiten Sicherung 805 den zweiten Zeitstempelwert mit Hilfe des zweiten Zeitgebers 1955 der zweiten elektronischen Sicherung 805, für jeden Messwert oder für eine Gruppe von Messwerten der zweiten Stromwerte des Stromflusses 1910.

Der Rechnerkern 2 der Steuervorrichtung 4 der zweiten Sicherung 805 überträgt 2040 bevorzugt zumindest den erfassten zweiten Messwert für den zweiten Stromwert des Stromflusses 1910 in dem zweiten Leitungsabschnitt 1905 zusammen mit dem erfassten zweiten Zeitstempelwert von der zweiten Sicherung 805 über den Datenbus 9 an ein übergeordnetes Rechnersystem 12 und/oder an den Rechnerkern 2 der Steuervorrichtung 4 der ersten elektronischen Sicherung 825 und/oder an einen Rechnerkern 2 einer Steuervorrichtung 4 einer anderen Sicherung des Versorgungsnetzwerks.

Der Rechnerkern 2 der Steuervorrichtung 4 der ersten Sicherung 825 überträgt 2040 bevorzugt zumindest den erfassten ersten Messwert für den ersten Stromwert des Stromflusses 1505 in dem ersten Leitungsabschnitt 1505 zusammen mit dem erfassten ersten Zeitstempelwert von der ersten Sicherung 825 über den Datenbus 9 an ein übergeordnetes Rechnersystem 12 und/oder an einen Rechnerkern 2 einer Steuervorrichtung 4 einer anderen Sicherung des Versorgungsnetzwerks, wenn der Rechnerkern 2 der Steuervorrichtung 4 der zweiten Sicherung 805 zumindest den erfassten zweiten Messwert für den zweiten Stromwert des Stromflusses 1910 in dem zweiten Leitungsabschnitt 1905 zusammen mit dem erfassten zweiten Zeitstempelwert von der zweiten Sicherung 805 an ein übergeordnetes Rechnersystem 12 und/oder an einen Rechnerkern 2 einer Steuervorrichtung 4 einer anderen Sicherung des Versorgungsnetzwerks überträgt 2040.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks vergleicht 2045 den über den Datenbus 9 erhaltenen ersten Messwert mit dem zweiten Messwert.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks schließen 2050 auf einen Energieverlust in Leitungsabschnitten 1525 zwischen den zwei elektronischen Sicherungen 825, 805, wenn der die Differenz zwischen dem ersten Messwert und dem zweiten Messwert außerhalb eines erlaubten Differenzwertintervalls legt und/oder wenn ein Quotient aus dem ersten Messwert und dem zweiten Messwert außerhalb eines erlaubten Quotienten-Intervalls liegt.

Bevorzugt signalisieren das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks über den Datenbus 9 einen solchen Vorfall im Falle eines Fehlers an ein Terminal 740 eines Benutzers 730.

Ggf. ergreifen das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks Gegenmaßnahmen. Eine solche Gegenmaßnahme kann beispielsweise ein Kommando über den Datenbus an den Rechnerkern 2 der Steuervorrichtung 4 der ersten Sicherung 825 sein, dass der Rechnerkern 2 der Steuervorrichtung 4 der ersten Sicherung 825 den Leistungsschalter 17 der ersten Sicherung 825 öffnen soll. Bevorzugt übermitteln das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks dieses Kommando verschlüsselt über den Datenbus 9. Der Rechnerkern 2 der Steuervorrichtung 4 der ersten Sicherung 825 kann dann ggf. den ersten Leistungsschalter 17 öffnen. Dies schaltet ggf. bestehende Kurzschlüsse des ersten Versorgungsleitungsabschnitts 1505 mit anderen Leitungen und/oder Vorrichtungsteilen des Versorgungsnetzwerks 200 stromlos und bringt damit diese in einen ungefährlichen Zustand.

Ein besonderer Schritt, der möglich ist, ist daher das Ergreifen 2055 von Gegenmaßnahmen, insbesondere durch das übergeordnete Rechnersystem 12 bzw. durch den Rechnerkern 2 der auswertenden Steuervorrichtung 4 der auswertenden elektronischen Sicherung 825, wenn die Messwerte oder das Verhältnis der Messwerte zueinander oder eine Differenz von solchen Messwerten oder daraus abgeleiteter Größen nicht einem oder mehreren Erwartungswerten entsprechen und/oder nicht in einem Erwartungswertintervall liegen.

Die Datenkommunikation zwischen den Rechnerkernen 2 der Steuervorrichtungen 4 der Sicherungen des Versorgungsnetzwerks und/oder mit dem übergeordneten Rechnersystem 12 erfolgt bevorzugt über einen Sicherungsdatenbus 9 und/oder einen Fuse-Datenbus 9 und/oder einen Lin-Datenbus 9 und/oder einen DSI3- Datenbus 9 und/oder einen PSI5-Datenbus 9 und/oder einen CAN-Datenbus 9 und/oder einen CAN-FD-Datenbus 9 und/oder einen Ethernet-Datenbus 9 und/oder einen Flexray-Datenbus 9 und/oder einen LVDS-Datenbus 9 und/oder einen Ethernet-Datenbus 9 und/oder eine sonst wie drahtgebundene oder drahtlose Datenübertragungsstrecke, beispielsweise über eine Bluetooth- oder eine WLAN-Datenverbindung oder eine optische Datenverbindung 540, und/oder eine sonstige drahtgebundene oder drahtlose Schnittstelle (610, 10, 551, 550).

Bevorzugt erfassen das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks Veränderungen der Stromwerte der Ströme (1525, 1910, 1920, 1930) und/oder Veränderungen der Spektren des zeitlichen Spannungsverlaufs der Spannungen zwischen abzusichernden Leitungsabschnitten 1505, 1905, 1915, 1920 des Kabelbaums 1515 einerseits und einem Bezugspotenzial andererseits einer und/oder Veränderungen der Spektren des Stromverlaufs der Stromwerte der Ströme 1525, 1910, 1920, 1930 oder des Energietransports über die zusichernden Leitungsabschnitte 1505, 1905, 1915, 1920 des Kabelbaums 1515. Bevorzugt bewerten das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks diese Veränderungen durch Vergleich der Veränderungen mit erwarteten Verläufen und/oder erwarteten Werten.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks stellen 2060 bevorzugt eine Datenverbindung 1990 zu einem Server 1985 einer Werkstatt und/oder eines Automobilherstellers und/oder eines Dienstleistungsanbieters her, um die erfassten Werte und/oder Zeitstempel oder daraus abgeleitete Daten dort zur Verfügung zu stellen.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks übermitteln 2065 vorzugsweise Fahrzeugdaten und/oder Betriebsdaten und/oder Messwerten und/oder Schadensdaten, wenn der Vergleich der erfassten Veränderungen mit den erwarteten Verläufen und/oder erwarteten Werten eine Abweichung über ein vorgegebenes Maß hinaus ergab.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks übermitteln 2065 bevorzugt die Fahrzeugdaten und/oder Betriebsdaten und/oder Messwerten und/oder Schadensdaten an einen Server 1985 oder ein Terminal der Werkstatt oder eines sonstigen Nutzers dieser Daten.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks und/oder ein anderer Rechner 1985 erstellen auf Basis dieser Daten bevorzugt eine Prognose 2070 der Ausfallwahrscheinlichkeit eines Vorrichtungsteils des Fahrzeugs mittels der Fahrzeugdaten und/oder Betriebsdaten und/oder Messwerten und/oder Schadensdaten.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks und/oder der andere Rechner 1985 übermitteln 2075 vorzugsweise des Prognoseergebnisses an einen Server 1985 und/oder ein Terminal der Werkstatt und/oder ein Terminal 740 und/oder einen Rechner eines Fahrzeughalters 730 und/oder ein Terminal 740 und/oder einen Rechner eines Fahrzeugführers 730 oder ein Terminal und/oder einen Server 710 eines Automobilherstellers und/oder ein Terminal und/oder Server eines Logistikunternehmens und/oder ein Terminal und/oder einen Server eines sonstigen Nutzers dieser Daten.

Bevorzugt stellt 2080 einer der Nutzer dieser Daten, insbesondere ein voll- oder halbautomatisches Logistikzentrum ein Ersatzteil für das Vorrichtungsteil des Fahrzeugs bei einem Prognoseergebnis, das einen Ausfall des Vorrichtungsteils erwarten lässt. Hierbei identifiziert ein Rechner, der die übermittelten Daten nutzt das auszutauschende Vorrichtungsteil des Fahrzeugs. Ein Rechner eines halb- oder vollautomatischen Lagers lokalisiert das notwendige Ersatzteil. Ein Roboter und/oder eine voll- oder halbautomatische Versandvorrichtung stellt das notwendige Ersatzteil bereit und erstellt die notwendigen Versandpapiere und verpackt ggf. das Ersatzteil für den Versand. Bevorzugt versenden der Roboter und/oder die voll- oder halbautomatische Versandvorrichtung das Ersatzteil an eine durch den Fahrzeughalter 730 oder den Fahrzeugführer oder einen Mitarbeiter der Werkstatt vorbestimmte Adresse. Diese Adresse dürfte typischerweise die Adresse der Werkstatt sein, in der die vorsorgliche Reparatur typischerweise im Rahmen einer regelmäßigen Wartung erfolgen soll.

Das übergeordnete Rechnersystem 12 und/oder der Rechnerkern 2 der Steuervorrichtung 4 der ersten elektronischen Sicherung 825 und/oder der Rechnerkern 2 einer Steuervorrichtung 4 einer anderen Sicherung des Versorgungsnetzwerks schließen 2085 vorzugsweise auf die Temperatur eines Leitungsabschnitts 1915, 1925, 1505, 1905 und/oder eine Übertemperatur eines Leitungsabschnitts 1915, 1925, 1505, 1905 mittels der erfassten Stromwerte des Stromflusses 1920, 1925, 1525, 1910 in mehreren abzusichernden Leitungsabschnitten 1915, 1925, 1505, 1905 des Kabelbaums 1515.

Figur 21

Figur 21 zeigt schematisch vereinfacht eine vorschlagsgemäße Batterie 2100 mit Diagnosefunktion für ein Fahrzeug unter Verwendung von Versorgungsnetzwerken 200 wie sie das hier vorgelegte Dokument sie bereits oberhalb beschrieben hat. Die vorschlagsgemäße Batterie 2100 umfasst bevorzugt ein oder mehr Batteriezellenmodule 2105, 2155 und eine oder mehrere elektronische Scherungen 825, 805. Bevorzugt ist zumindest ein Anschluss 2197 der Batterie 2100 mit dem ersten Anschluss 26 des Leistungsschalters 17 einer ersten elektronischen Sicherung 825 verbunden. Die Batterie 2100 umfasst vorzugsweise einen Versorgungsbaum und/oder ein Versorgungsnetzwerk mit einem oder mehr Versorgungszweigen (2198, 2196, 2120, 2135, 2140, 2190, 2160,2175, 2180, 2196). Mehrere elektronische Sicherungen 825, 805 sind vorzugsweise in Serie in einen Versorgungszweig (2198, 2196, 2120, 2135, 2140, 2190, 2160,2175, 2180, 2196) des Versorgungsbaums bzw. des Versorgungsnetzwerks geschaltet. Ein solcher Versorgungsbaum bzw. ein solches Versorgungsnetzwerk kann auch nur einen Versorgungszweig mit einer Mehrzahl von elektronischen Sicherungen, die in den Versorgungszweig eingefügt sind, umfassen. Eine oder mehr Batteriezellenmodule 2105, 2155 der Batterie 2100 sind beispielsweise elektrisch in Serie geschaltet. Eine oder mehrere elektronische Sicherungen 805 sind zwischen Batteriezellenmodule 2105, 2155 der Batterie 2100 geschaltet.

Bevorzugt ist genau eine elektronische Sicherung 805 zwischen zwei Batteriezellenmodule 2105, 2155 geschaltet, die miteinander in Serie verschaltet sind.

Bevorzugt ist je Batteriezellenmodul 2105, 2155 jeweils eine diesem Batteriezellenmodul zugeordnete jeweilige elektronische Sicherung 825, 805 vorgesehen. Jedem Batteriezellenmodul 2105, 2155 oder jeweils einer oder mehreren Gruppen, insbesondere in Serie verschalteter, Batteriezellenmodule 2105, 2155 ist vorzugsweise je eine elektronische Sicherung 825, 805 zugeordnet.

Eine oder mehrere oder alle dieser elektronischen Sicherungen 825, 805 weisen vorzugsweise einen ersten Leistungsschalter 17 auf, der dazu geeignet ist, den Stromfluss 2121, 2161 durch ein oder mehrere Batteriezellenmodule 2105, 2155 und/oder die betreffende Gruppe an Batteriezellenmodulen zu verhindern, also die elektrische Verbindung 2140, 2190, 2160, 2175 zwischen eines ersten Batteriezellenmoduls 2105 und einem zweiten Batteriezellenmodul 2155 oder einer ersten Gruppe von Batteriezellenmodulen und einer zweiten Gruppe von Batteriezellenmodulen, die miteinander in Serie geschaltet sind, aufzutrennen, wenn der erste Leistungsschalter 17 geöffnet ist. Eine oder mehrere oder alle dieser elektronischen Sicherungen 825, 805 weist einen ersten Leistungsschalter 17 auf, der dazu geeignet ist, den Stromfluss 2121, 2161 durch ein oder mehrere Batteriezellenmodule 2105, 2155 und/oder die betreffende Gruppe von Batteriezellenmodulen zu ermöglichen, also die elektrische Verbindung (2140, 2190, 2160, 2175) zwischen einem ersten Batteriezellenmodul 2105 und einem zweiten Batteriezellenmodul 2155 oder einer ersten Gruppe von Batteriezellenmodulen und einer zweiten Gruppe von Batteriezellenmodulen, die miteinander in Serie geschaltet sind, herzustellen, wenn der erste Leistungsschalter 17 geschlossen ist.

Die Figur 21 zeigt eine Batterie 2100 mit Diagnosefunktion für ein Fahrzeug. Die Batterie umfasst ein erstes Batteriezellenmodul 2105 und ein zweites Batteriezellenmodul 2155. Das erstes Batteriezellenmodul 2105 umfasst eine erste elektrochemische Zelle 2145, die erste Batteriezelle, des ersten Batteriezellenmoduls (2105). Das zweite Batteriezellenmodul 2155 umfasst eine zweite elektrochemische Zelle 2185, die zweite Batteriezelle, des zweiten Batteriezellenmoduls (2155). Die Verbindung 2198 des ersten Anschlusses 2197 der Batterie 2100 verbindet den ersten Anschluss 2125 des ersten Batteriezellenmoduls 2105 mit dem ersten Anschluss 2197 der Batterie 2100. Die Verbindung 2120 verbindet den ersten Anschluss 2125 mit dem ersten Anschluss 18 des Leistungsschalters 17 der ersten Sicherung 825 der Batterie 2100. Der Steckverbinder 410 verbindet die erste Sicherung 825 mit dem ersten Batteriezellenmodul 2105. Die erste Sicherung 825 umfasst einen Rechnerkern 2 und eines Steuervorrichtung 4 und einen Zeitgeber 1950 und eine Messvorrichtung 1520 zur Erfassung des elektrischen Stromes in die erste elektrochemische Zelle 2145 des ersten Batteriezellenmoduls 2105 oder aus diesem heraus. Dieser Strom entspricht im Wesentlichen dem elektrischen Strom 2121 in der Verbindung 2120 zwischen dem ersten Anschluss 2125 und dem ersten Anschluss 18 des Leistungsschalters 17 der ersten Sicherung 825 der Batterie 2100. Der erste Anschluss 2135 der ersten elektrochemischen Zelle, der ersten Batteriezelle 2145, des ersten Batteriezellenmoduls 2105 ist bevorzugt mit dem zweiten Anschluss 19 der ersten Sicherung 825 verbunden. Der zweite Anschluss 2130 des ersten Batteriezellenmoduls 2105 ist bevorzugt mit dem zweiter Anschluss 2140 der ersten elektrochemischen Zelle, der ersten Batteriezelle 2145, des ersten Batteriezellenmoduls 2105 verbunden.

Die Verbindung 2190 verbindet den zweiten Anschluss 2130 des ersten Batteriezellenmoduls 2105 mit dem ersten Anschluss 2165 des zweiten Batteriezellenmoduls 2155. Die Verbindung 2160 verbindet den ersten Anschluss 2165 mit dem ersten Anschluss 18 des Leistungsschalters 17 der zweiten Sicherung 805 der Batterie 2100. In der Verbindung 2160 fließt der elektrische Strom 2161 in der Verbindung 2160 zwischen dem ersten Anschluss 2165 und dem ersten Anschluss 18 des Leistungsschalters 17 der zweiten Sicherung 805 der Batterie 2100.

Die Verbindung 2196 verbindet den zweiten Anschluss 2195 der Batterie 2100 mit dem zweiten Anschluss 2170 des zweiten Batteriezellenmoduls 2155. Der zweite Anschluss 19 der zweiten Sicherung 805 ist bevorzugt mit dem ersten Anschluss 2175 der zweiten elektrochemischen Zelle, der zweiten Batteriezelle 2184, des zweiten Batteriezellenmoduls 2155 verbunden. Der zweite Anschluss 2180 der zweiten elektrochemischen Zelle, der zweiten Batteriezelle 2185, des zweiten Batteriezellenmoduls 2155 ist bevorzugt mit dem zweiten Anschluss 2170 des zweiten Batteriezellenmoduls 2155 verbunden.

Die gesamte Batterie 2100 umfasst ein Batteriegehäuse 2199.

Der Datenbus 9 ist über einen ersten Steckverbinder 410 mit der ersten elektronischen Sicherung 825 verbunden. Der Datenbus 9 ist über einen zweiten Steckverbinder 410 mit der zweiten elektronischen Sicherung 805 verbunden. Bevorzugt weist das Batteriegehäuse 2199 einen Anschluss für den Datenbus 9 auf. Bevorzugt ist dieser Anschluss für den Datenbus 9 mit dem Datenbus 9 innerhalb der Batterie 210 verbunden.

Die Versorgungsspannungsleitung 6 für die Versorgung der ersten elektronischen Sicherung 825 und die Versorgung der zweiten elektronischen Sicherung 805 innerhalb der Batterie 2100 ist bevorzugt über einen ersten Steckverbinder 410 mit der ersten elektronischen Sicherung 825 verbunden und über einen zweiten Steckverbinder 410 mit der zweiten elektronischen Sicherung 805 verbunden, um dort die jeweiligen Steuervorrichtungen 4 mit elektrischer Energie zu versorgen.

Bevorzugt weist das

Die Bezugspotenzialleitung 201 für die Versorgung der ersten elektronischen Sicherung 825 und die Versorgung der zweiten elektronischen Sicherung 805 innerhalb der Batterie 2100 ist bevorzugt über einen ersten Steckverbinder 410 mit der ersten elektronischen Sicherung 825 verbunden und über einen zweiten Steckverbinder 410 mit der zweiten elektronischen Sicherung 805 verbunden, um dort die jeweiligen Steuervorrichtungen 4 mit elektrischer Energie und einem Referenzpotenzial zu versorgen.

Figur 22

Figur 22 entspricht der Figur 21 mit dem Unterschied, dass die erste elektronische Sicherung 825 einen zusätzlichen Kontakt 2210 aufweist, um im Falle eines fehlerhaften Vorzeichens des Stromes 2121 durch die erste Sicherung 825 diesen Strom an der elektrochemischen Batteriezelle 2145 vorbeizuleiten.

Zu diesem Zweck weist die erste Sicherung 825 in dem Beispiel der Figur 22 einen zweiten Leistungsschalter 17' auf, der ebenfalls von dem rechnerkern 2 der Steuervorrichtung 4 der ersten Sicherung 825 gesteuert wird.

Bevorzugt weisen eine oder mehrere oder alle dieser elektronischen Sicherungen 825 der Batterie 2200 einen solchen zweiten Leistungsschalter 17' aufweisen, der dazu geeignet ist, das Batteriezellenmodul 2105 und/oder die Gruppe von Batteriezellenmodulen bei einem geschlossenen zweiten Leistungsschalter 17' zu überbrücken.

Bevorzugt erfasst der Rechnerkern 2 der jeweiligen Steuervorrichtung 4 der jeweiligen elektronischen Sicherung 825 bevorzugt vor dem Schließen des zweiten Leistungsschalters 17' den Schaltzustand des ersten Leistungsschalters 17 und ob der erste Leitungsschalter 17 geöffnet ist. Der Rechnerkern 2 der Steuerungsvorrichtung 4 der elektronischen Sicherung 825 schließt nur dann den zweiten Leistungsschalter 17', wenn der erste Leitungsschalter 17 geöffnet ist.

Der Rechnerkern 2 der Steuervorrichtungen 4 der jeweiligen elektronischen Sicherung veranlasst die Einspeisung eines Teststromes 515 in den ersten Leistungsschalter 17 an einem Anschlusspunkt 26 vor dem ersten Leistungsschalter 17 und veranlasst die Entnahme dieses Teststromes 915 an einem zweiten Anschlusspunkt 28 hinter dem ersten Leistungsschalter 17. Der Rechnerkern 2 der Steuerungsvorrichtung 4 der jeweiligen elektronischen Sicherung bewertet, ob diese Einspeisung und Entnahme erfolgreich waren.

Die in Figur 22 zeigt somit eine Batterie 2200, bei der eine elektronische Sicherung 825 der Batterie 2200 einen zweiten Leistungsschalter 17' aufweist, der dazu geeignet ist, das der Sicherung zugeordnete Batteriezellenmodul 2105 bei einem geschlossenen zweiten Leistungsschalter 17' zu überbrücken. Die Batterie 2200 ist vorzugsweise in einem Gehäuse 2220 der Batterie 2200 bzw. des Batteriezellenmoduls untergebracht. Das Gehäuse 2220 der Batterie 2200 weist bevorzugt einen Anschluss 2225 der Batterie 2220 des Batteriezellenmoduls für die Betriebsspannung 6 der elektronischen Sicherungen 825, 805 innerhalb der Batterie 2200 auf. Das Gehäuse 2220 der Batterie 2200 weist bevorzugt einen Anschluss 2230 der Batterie 2200 des Batteriezellenmoduls für den Bezugspotenzialknoten 201 der elektronischen Sicherungen 825, 805 auf. Das Gehäuse 2220 der Batterie 2200 weist bevorzugt einen Anschluss 2235 der Batterie 2200 des Batteriezellenmoduls für den externen Datenbus 9 der elektronischen Sicherungen 825, 805 auf.

Figur 23

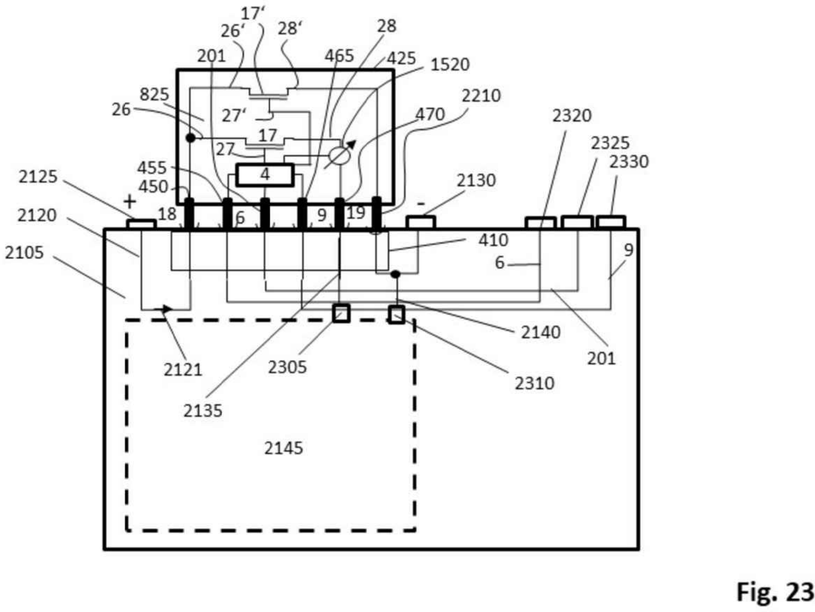

Figur 23 zeigt ein Batteriezellenmodul 2300, das zumindest eine Batteriezelle 2145 und/oder eine Zusammenschaltung von Batteriezellen, einen ersten Leistungsschalter 17, einen zweiten Leistungsschalter 17', einen ersten elektrischen Knoten 2120, einen zweiten elektrischen Knoten 2135, einen dritten elektrischen Knoten 2140, einen ersten Batteriezellenanschluss 2305 und einen zweiten Batteriezellenanschluss 2310 umfasst. Der erste Batteriezellenanschluss 2305 ist beispielsweise mit dem zweiten Knoten 2135 verbunden. Der zweite Batteriezellenanschluss 2310 ist beispielsweise mit dem dritten Knoten 2140 verbunden. Der erste Leistungsschalter 17 weist einen ersten Anschluss 26 und einen zweiten Anschluss 28 und einen Steueranschluss 27 auf. Der zweite Leistungsschalter 17' weist einen ersten Anschluss 26' und einen zweiten Anschluss 28' und einen Steueranschluss 27' auf. Die Batteriezelle 2105 und/oder die Zusammenschaltung von Batteriezellen umfassen einen ersten Anschluss 2125 und einen zweiten Anschluss 2130. Der erste Leistungsschalter 17 ist bevorzugt mit seinem ersten Anschluss 26 des ersten Leistungsschalters 17 mit dem ersten Knoten 2120 verbunden. Der erste Leistungsschalter 17 ist bevorzugt mit seinem zweiten Anschluss 28 des ersten Leistungsschalters 17 mit dem zweiten Knoten 2135 verbunden. Der zweite Leistungsschalter 17' ist bevorzugt mit seinem ersten Anschluss 26' des zweiten Leistungsschalters 17' mit dem ersten Knoten 2120 verbunden. Der zweite Leistungsschalter 17' ist bevorzugt mit seinem zweiten Anschluss 28' des zweiten Leistungsschalters 17' mit dem dritten Knoten 2140 verbunden. Ein erster Anschluss 2305 der Batteriezelle 2145 bzw. der Gruppe von Batteriezellen ist bevorzugt mit dem zweiten Knoten 2135 verbunden. Ein zweiter Anschluss 2310 der Batteriezelle 2145 bzw. der Gruppe von Batteriezellen ist vorzugsweise mit dem dritten Knoten 2140 verbunden. Wenn hier von "verbunden" die Rede ist, so ist damit gemeint, dass eine elektrische direkte oder indirekte Verbindung über weitere elektrische Bauteile besteht, die einer direkten Verbindung im Wesentlichen funktionsäquivalent ist.

Das Batteriezellenmodul 2105 umfasst bevorzugt eine Steuervorrichtung 4 einer Sicherung oder ist mit einer solchen Steuervorrichtung 4 verbunden. Diese Steuervorrichtung 4 steuert vorzugsweise den Steueranschluss 27 des ersten Leistungsschalters 17. Bevorzugt steuert ein Rechnerkern 2 der Steuervorrichtung 4 den Steueranschluss 27 des ersten Leistungsschalters 17. Die Steuervorrichtung 4 steuert darüber hinaus bevorzugt den Steueranschluss 27' des zweiten Leistungsschalters 17'. Der Rechnerkern 2 der Steuervorrichtung 4 steuert bevorzugt den Steueranschluss 27' des zweiten Leistungsschalters 17'. Die Steuervorrichtung 4 bzw. der Rechnerkern 2 der Steuervorrichtung 4 verriegeln den Steueranschluss 27 des ersten Leistungsschalters 17 vorzugsweise so gegenüber dem Steueranschluss 27' des zweiten Leistungsschalters 17' in der Form gegeneinander, dass ausgeschlossen ist, dass der erste Leistungsschalter 17 leitend, also geschlossen ist, ist, wenn der zweite Leistungsschalter 17' leitend, also geschlossen, ist.

Bevorzugt umfasst die Steuervorrichtung 4 Mittel (16, 525, 520, 920, 530, 21, 22, 28, 26, 27, 915, 515, 510, 910, 905 und 16', 525', 520', 920', 530', 21', 22', 28', 26', 27', 915', 515', 510', 910', 905') zum Erfassen des Schaltzustands der Leistungsschalter 17, 17'. Die Steuervorrichtung 4 und/oder der Rechnerkern 2 der Steuervorrichtung erfassen vorzugsweise mittels dieser Mittel (16, 525, 520, 920, 530, 21, 22, 28, 26, 27, 915, 515, 510, 910, 905 und 16', 525', 520', 920', 530', 21', 22', 28', 26', 27', 915', 515', 510', 910', 905') den Schaltzustand zumindest eines der Leistungsschalter 17, 17', insbesondere als "An" oder "Aus" oder als "geschlossen" oder "geöffnet".

Bevorzugt sind die Steuervorrichtung 4 und/oder der Rechnerkern 2 der Steuervorrichtung 4 zum Überbrücken des Batteriezellenmoduls 2105 eingerichtet. Zu diesem Zweck sind die Steuervorrichtung 4 und/oder der Rechnerkern 2 der Steuervorrichtung 4 bevorzugt dazu eingerichtet, zuerst den ersten Leistungsschalter 17 zu öffnen und somit einen Stromfluss 2121 durch die Batteriezelle 2145 zu unterbinden und dann insbesondere mittels der Mittel (16, 525, 520, 920, 530, 21, 22, 28, 26, 27, 915, 515, 510, 910, 905) zum Erfassen des Schaltzustands des ersten Leistungsschalters 17 zu überprüfen und festzustellen, ob der erste Leistungsschalter 17 geöffnet ist, und dann, wenn der zweite Leistungsschalter 17' geöffnet ist, den zweiten Leistungsschalter 17' zuschließen und dann mittels der Mittel (16', 525', 520', 920', 530', 21', 22', 28', 26', 27', 915', 515', 510', 910', 905') zum Erfassen des Schaltzustands des zweiten Leistungsschalters 17' zu überprüfen, ob der zweite Leistungsschalter 17' geschlossen ist.

Das Batteriezellenmodul 2200 kann ggf. selbst wieder zumindest ein erstes Batteriezellenmodul 2105 wie vorbeschrieben und selbst wieder zumindest ein zweites Batteriezellenmodul 2155, wie vorbeschrieben, umfassen. Der zweite Anschluss 2130 des ersten Batteriezellenmoduls 2105 ist dabei bevorzugt mit dem ersten Anschluss 2165 des zweiten Batteriezellenmoduls 2155 verbunden.

Der Leistungsschalter 17 und die Steuervorrichtung 4 der Sicherung 825 und die Sicherung 825 sind vorzugsweise mit dem eigentlichen Batteriezellenmodul 2105 in einem Gehäuse 2605 untergebracht.

Die Steuervorrichtung 4 der Sicherung 825 kann eine optische Datenschnittstelle 550, 551 aufweisen.

In dem Fall weist das Gehäuse 2605 vorzugsweise ein optisches Fenster 545 aufweist, das den Zutritt elektromagnetischer Strahlung 540 für den optischen Transport von Daten von optische Datenschnittstelle 550, 551 der Steuervorrichtung 4 weg und zu der optischen Datenschnittstelle 550, 551 der Steuervorrichtung 4 hin erlaubt.

Über die optische Schnittstelle 550, 551 der Steuervorrichtung 4 innerhalb des Gehäuses 2605 kann der Rechnerkern 2 der Steuervorrichtung 4 beispielsweise mit einer optischen Schnittstelle 555 einer anderen Vorrichtung, beispielsweise eines übergeordneten Rechnersystems 12 außerhalb des Gehäuses 2665 kommunizieren.

Das hier vorgelegte Dokument beschreibt somit u.a. auch ein Batteriezellenmodul 2300 mit einer Batteriezelle 2145, einem ersten Batteriezellenanschluss 2305, einem zweiten Batteriezellenanschluss 2310, einem Anschluss 2320 des Batteriezellenmoduls 2105 für die Betriebsspannung 6 der elektronischen Sicherung 825, einen Anschluss 2325 des Batteriezellenmoduls 2105 für den Bezugspotenzialknoten 201 der elektronischen Sicherung 825 und einen Anschluss 2330 des Batteriezellenmoduls 2105 für den externen Datenbus 9 der elektronischen Sicherung 825.

Figur 24

Figur 24 entspricht der Figur 6, wobei die Sicherung 1 der Figur 24 einen zweiten Leistungsschalter 17' aufweist.

In der Figur 24 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 41, 42, 52, 53, 54, 55, 57, 58, 62. Die Kombination der Vorrichtungteile der hier beschriebenen Figur mit solchen dieser Figuren ist ausdrücklich Teil der Offenbarung des hier vorgelegten Dokuments.

Bevorzugt weist die Steuerschaltung 4 der Sicherung 1 zusätzliche eine zweite Gate-Ansteuerschaltung 16' für die Ansteuerung und Überwachung des zweiten Leistungsschalters 17' auf. Bevorzugt ist der erste Anschluss 26' des zweiten Leistungsschalters 17' mit dem ersten Anschluss 18 der Sicherung 1 verbunden. Die zweite Gate-Ansteuerschaltung 16' für die Ansteuerung und Überwachung des zweiten Leistungsschalters 17' steuert über die Steuerleitung 20' zur Steuerung des zweiten Leistungsschalters 17' den zweiten Leitungsschalter 17'. Mittels der Überwachungsleitung 21' zur Erfassung der Spannung zwischen dem zweiten Anschluss 19' des zweiten Leistungsschalters 17' und der Steuerleitung 20' des zweiten Leistungsschalters 17' und mittels der Überwachungsleitung 22' zur Erfassung der Spannung zwischen dem ersten Anschluss 18' des zweiten Leistungsschalters 17' und der Steuerleitung 20' des zweiten Leistungsschalters 17' und mittels der Messleitung 25' zur Erfassung des Spannungsabfalls über den zweiten Shunt-Widerstand 24' überwacht die zweite Gate-Ansteuerschaltung 16' für die Ansteuerung und Überwachung des zweiten Leistungsschalters 17' den zweiten Leistungsschalter 17'. Die Sicherung 1 der Figur 24 umfasst darüber hinaus einen zweiten Hilfsleistungsschalter 23' zur Erfassung eines Stromes, der dem Strom 29' durch den zweiten Leistungsschalter 17' proportional ist oder auf andere Weise entspricht. Die Sicherung 1 der Figur 24 umfasst bevorzugt des Weiteren einen Shunt-Widerstand 24' zur Erfassung des Stromes durch den zweiten Hilfsleistungsschalter 23' des zweiten Leistungsschalters 17'. Eine dritte Teststromquelle 505' ist mittels des zweiten Steuersignals 510' mit einem zweiten Modulationssignal {505'} eines zweiten Signalgenerators 520' moduliert. Hierbei sollen die geschweiften Klammern signalisieren, dass es sich bei {505'} um das zweite Modulationssignal, handelt mit dem der zweite Strom 515' der dritten Teststromquelle 505' moduliert ist. Bevorzugt ist das zweite Modulationssignal {505'} orthogonal zum ersten Modulationssignal {505} bezüglich des Skalarprodukts

$$\langle\{505\}|\{505'\}\rangle = \int_0^T \{505\} \times \{505'\}dt$$ . Dabei soll T die Periode des ersten Modulationssignals {505} oder des zweiten Modulationssignals {505'} darstellen, die bevorzugt gleich sind oder ein ganzzahliges Vielfaches voneinander. Bevorzugt ist die Periode T des ersten Modulationssignals {505} gleich der Periode T des zweiten Modulationssignals {505'}. Dies ermöglicht die Trennung der beiden Modulationssignale ({505}, {505'}). Bevorzugt gilt also beispielsweise

$$\langle\{505\}|\{505'\}\rangle = \int_0^T \{505\} \times \{505'\}dt = 0,$$

was Orthogonalität bedeutet.

Der der zweite Strom 515' der dritten Teststromquelle 505' ist vorzugsweise mit dem zweiten Modulationssignal {505'} mittels des dritten Steuersignals 510' der dritten elektronischen Teststromquelle 505' moduliert. Die dritte Teststromquelle 505' speist den zweiten zusätzlichen Strom 515'in den zweiten Leistungsschalter 17 ein. Ein zweiter Signalgenerator 520' erzeugt das zweite Modulationssignals {505'}. Ein zweiter Korrelator 525' umfasst bevorzugt einen oder mehrere Eingangsverstärker, die die Spannungen zwischen den zweiten Messkontakten (21', 25',27', 28', 22') erfassen, filtern und aufbereiten. Bevorzugt umfasst der zweite Korrelator 525' beispielsweise einen zweiten Synchrondemodulator, der eine der messbaren Spannungen auf zweite Anteile des zweiten Modulationssignals {505'} des zweiten Stroms 515' der dritten Teststromquelle 505' untersucht. Bevorzugt nutzt dabei der zweite Synchrondemodulator des zweiten Korrelators 525' eine Korrelation in Form eines Skalarprodukts, beispielsweise gemäß der Form

$$A' = \langle\{505'\}|V'_{xy}(t)\rangle = \int_0^T \{505'\} \times V_{xy}(t')dt$$

Hierbei stehen A' für den Wert des zweiten Anteils und V'$_{xy}$ für eine Spannung zwischen den zweiten Messkontakten (21', 25', 27', 28', 22). Bevorzugt verwendet der zweite Korrelator 525' eine Spannung V$_{xy}$ zwischen dem zweiten Anschluss 28' des zweiten Leistungsschalters 17' und dem zweiten Steueranschluss 27' des zweiten Leistungsschalters 17'.

Eine zweite Gate-Ansteuerung 530' des Steuerkontakts 27' des zweiten Leistungsschalters 17' und zweite Steuersignalerzeugung für das Steuersignal der Steuerleitung 20' des zweiten Leistungsschalters 17' steuert den zweiten Leistungsschalter 17'.

Eine erste Teststromquelle 505', speist einen Teststrom 515' in den ersten Anschluss 26' des zweiten Leistungsschalters 17' ein, der mittels des Steuersignals 510' mit einem Modulationssignal {505'} eines ersten Signalgenerators 520' versehen ist.

Eine zweite Teststromquelle 905', entnimmt einen Teststrom 915' aus dem zweiten Anschluss 28' des zweiten Leistungsschalters 17', der mittels des Steuersignals 910' mit einem Modulationssignal {505'} eines zweiten Signalgenerators 920' versehen ist.

Ein drittes Steuersignal 510' steuert die dritte elektronische Teststromquelle 505'.

Ein viertes Steuersignal 910' steuert die vierte elektronische Teststromquelle 905'.

Bevorzugt entspricht der erste Teststrom 515' dem zweiten Teststrom 915'.

Der vierte Signalgenerator 920' erzeugt bevorzugt das Modulationssignal {505'}.

In dem Beispiel der Figur 24 sind noch einige Module mögliche Module der Steuervorrichtung 4 eingezeichnet, die zur besseren Übersichtlichkeit in den Figuren nicht eingezeichnet sind. Die Leserin bzw. der Leser möge diese Module in den Figuren als möglicherweise vorhanden und hiermit offenbart annehmen.

Figur 24 zeigt ein Diagramm eines Beispiels für eine elektronische Sicherung mit einer sicheren Steuervorrichtung 4 und einem sicheren Rechnerkern 2. Die sichere Steuervorrichtung 4 enthält beispielsweise Speicherelemente, die mit dem internen Datenbus 11 verbunden sind. Die Speicherelemente können beispielsweise ein oder mehrere Schreib/Lese-Speicher RAM 14 und/oder ein oder mehrere beschreibbare nicht flüchtige Speicher wie beispielsweise EEPROM-Speicher 15 und/oder Flash-Speicher 15 und/oder OTP-Speicher 15umfassen. Des Weiteren umfasst die sicher Steuervorrichtung 4 bevorzugt einen oder mehrere nicht flüchtige, reine Lese-Speicher 14, wie beispielsweise ein ROM. Außerdem umfasst die sichere Steuervorrichtung 4bevorzugt einen oder mehrere nicht flüchtige, beschreibbare und/oder nicht beschreibbare Hersteller-Speicher. Hierbei kann es sich beispielsweise um einen Herstellerspeicher 72 für Daten des Fahrzeugherstellers und/oder um einen Zulieferer -Herstellerspeicher 74 für Daten des Automobilzulieferers und/oder um einen Halbeiterhersteller -Herstellerspeicher 76 für Daten des Halbleiterherstellers handeln. Bevorzugt ist jeder dieser Datenspeicher durch ein jeweiliges Passwort geschützt. Der Herstellerspeicher 72 ist bevorzugt durch ein Herstellerpasswort geschützt. Der Zulieferer-Herstellerspeicher 74 ist bevorzugt durch ein Zuliefererpasswort geschützt. Der Halbeiterhersteller -Herstellerspeicher 76 ist bevorzugt durch ein Halbleiterherstellerpasswort geschützt.

Der Zulieferer kann sich Zugriff auf den Herstellerspeicher 72 mittels eines Zuliefereranalysepassworts verschaffen. Bei einem solchen Zugriff des Zulieferers auf den Herstellerspeicher 72 wird vorzugsweise der Inhalt des Herstellerspeichers 72 gelöscht, so dass der Zulieferer keine Kenntnis vom Inhalt des Herstellerspeichers 72 erhalten kann. Dabei werden bevorzugt auch die Passwörter des Herstellers gelöscht.

Der Halbleiterhersteller kann sich Zugriff auf den Herstellerspeicher 72 und/oder den Zuliefererspeicher 74 mittels eines Halbleiterherstelleranalysepassworts verschaffen. Bei einem solchen Zugriff des Halbleiterherstellers auf den Herstellerspeicher 72 wird vorzugsweise der Inhalt des Herstellerspeichers 72 gelöscht, so dass der Halbleiterhersteller keine Kenntnis vom Inhalt des Herstellerspeichers 72 erhalten kann. Bei einem solchen Zugriff des Halbleiterherstellers auf den Zuliefererspeicher 74 wird vorzugsweise der Inhalt des Zuliefererspeichers 74 gelöscht, so dass der Halbleiterhersteller keine Kenntnis vom Inhalt des Zuliefererspeichers 72 erhalten kann. Dabei werden bevorzugt auch die Passwörter des Herstellers bzw. des Zulieferers gelöscht.

Im Falle eines nicht beschreibbaren Hersteller-Speichers 72 bzw. eines nicht beschreibbaren Zuliefererspeichers bzw. eines nicht beschreibbaren Halbleiterherstellerspeichers 76 können diese Speicher jeweils ein jeweiliges Hersteller-ROM sein. D

er Zugriff auf den Herstellerspeicher 72 erfolgt bevorzugt über eine oder mehrere, vorzugsweise in Hardware ausgeführte Herstellerspeicherfirewalls 71. Der Rechnerkern 2 speichert für einen Zugriff das Herstellerpasswort über den internen Datenbus 11 in einem Register der Herstellerspeicherfirewall 71. Die Herstellerspeicherfirewall 71 überprüft den Inhalt des Registers und gibt den Zugriff auf die Register der Herstellerspeicherfirewall 71 und den Zugriff auf den Herstellerspeicher 72 für den rechnerkern 2 frei, wenn das Herstellerpasswort mit dem Inhalt in einem Herstellerpasswortvorgaberegister der Herstellerspeicherfirewall 71 in vorbestimmter Weise korrespondiert. Der Rechnerkern 2 kann dann auf den Herstellerspeicher 72 und das Herstellerpasswortvorgaberegister des Herstellerspeicherfirewalls 71 zugreifen.

Der Zugriff auf den Zuliefererspeicher 74 erfolgt bevorzugt über eine oder mehrere, vorzugsweise in Hardware ausgeführte Zuliefererspeicherfirewalls 73. Der Rechnerkern 2 speichert für einen Zugriff das Zuliefererpasswort über den internen Datenbus 11 in einem Register der Zuliefererspeicherfirewall 73. Die Zuliefererspeicherfirewall 73 überprüft den Inhalt des Registers und gibt den Zugriff auf die Register der Zuliefererspeicherfirewall 73 und den Zugriff auf den Zuliefererspeicher 74 für den Rechnerkern 2 frei, wenn das Zuliefererpasswort mit dem Inhalt in einem Zuliefererpasswortvorgaberegister der Zuliefererspeicherfirewall 73 in vorbestimmter Weise korrespondiert. Der Rechnerkern 2 kann dann auf den Zuliefererspeicher 74 und das Zuliefererpasswortvorgaberegister des Zuliefererspeicherfirewalls 73 zugreifen.

Der Zugriff auf den Halbleiterherstellerspeicher 76 erfolgt bevorzugt über eine oder mehrere, vorzugsweise in Hardware ausgeführte Halbleiterherstellerspeicherfirewalls 75. Der Rechnerkern 2 speichert für einen Zugriff das Halbleiterherstellerpasswort über den internen Datenbus 11 in einem Register der Halbleiterherstellerspeicherfirewall 75. Die Halbleiterherstellerspeicherfirewall 75 überprüft den Inhalt des Registers und gibt den Zugriff auf die Register der Halbleiterherstellerspeicherfirewall 75 und den Zugriff auf den Halbleiterherstellerspeicher 76 für den Rechnerkern 2 frei, wenn das Halbleiterherstellerpasswort mit dem Inhalt in einem Halbleiterherstellerpasswortvorgaberegister der Halbleiterherstellerspeicherfirewall 75 in vorbestimmter Weise korrespondiert. Der Rechnerkern 2 kann dann auf den Halbleiterherstellerspeicher 76 und das Halbleiterherstellerpasswortvorgaberegister des Halbleiterherstellerspeicherfirewalls 75 zugreifen.

Vorzugsweise verschlüsselt die Herstellerspeicherfirewall 71 die Daten des Rechnerkerns 2 vor der Abspeicherung in dem Herstellerspeicher 72 mittels eines PQC-fähigen Verschlüsselungsverfahren und/oder unter Benutzung einer Quantenzufallszahl des Quantenzufallszahlengenerators 60.

Vorzugsweise verschlüsselt die Zuliefererspeicherfirewall 73 die Daten des Rechnerkerns 2 vor der Abspeicherung in dem Zuliefererspeicher 74 mittels eines PQC-fähigen Verschlüsselungsverfahren und/oder unter Benutzung einer Quantenzufallszahl des Quantenzufallszahlengenerators 60.

Vorzugsweise verschlüsselt die Halbleiterherstellerspeicherfirewall 75 die Daten des Rechnerkerns 2 vor der Abspeicherung in dem Halbleiterherstellerspeicher 76 mittels eines PQC-fähigen Verschlüsselungsverfahren und/oder unter Benutzung einer Quantenzufallszahl des Quantenzufallszahlengenerators 60.

Bevorzugt umfasst ein Hersteller-ROM 72, 74, 76 die jeweilige Boot-Software. Die sichere Steuervorrichtung 4 umfasst beispielsweise einen oder mehrere Kryptografie-Beschleuniger 70, beispielsweise einen DES-Beschleuniger und/oder einen AES-Beschleuniger 70, der mit dem internen Datenbus 11 verbunden ist. Zum Beispiel ist bevorzugt eine oder mehrere Herstellerspeicherfirewalls 71, 73, 75 zwischen dem jeweiligen Herstellerspeicher 72, 74, 76 und dem internen Datenbus 11 vorgesehen. Der Rechnerkern 2 greift über den Datenbus 11 auf diese Speicher 72, 74, 76 zu. Die sichere Steuervorrichtung 4 umfasst beispielsweise Verarbeitungsmodule, die über den internen Datenbus 11 mit dem Rechnerkern 2 kommunizieren. Die Verarbeitungsmodule der Steuervorrichtung 4 der Sicherung 1 umfassen bevorzugt eines oder mehrere der folgenden Module: ein CRC-Modul (Cyclic Redundancy Check) 77, ein Oszillator- und Taktgeneratormodul 30, ein oder mehrere Zeitgeber-Module 78, eine Sicherheitsüberwachungsschaltung und Sicherheitssteuerungsschaltung 79, einen oder mehrere quantenprozessbasierende Generator für echte Zufallszahlen (Englisch: Quantum Random Number Generator: QRNG) 60, einen 8/16/32/15-Bit-Microkontrollerkern als Rechnerkern 2 und eine oder mehrere Datenschnittstellen 82, insbesondere eine oder mehrere Universelle- Asynchrone-Receiver-Transmitter (UART) zur Unterstützung serieller Hochgeschwindigkeitsdaten und/oder ein oder mehrerer sogenannte General Purpose IOs (GPIO). Zu den weiteren Schaltungsteilen der sicheren Steuervorrichtung 4 gehören beispielsweise eine -eine oder mehrere Basistakterzeugungen 30 (CLK) und/oder eine oder mehrere Taktgeneratormodule 30, eine Rücksetzschaltung 80, eine Stromversorgungs- oder Vcc-Schaltung 5 mit Spannungsreglern, die die Betriebsspannung bereitstellen, eine Masseschaltung 81, die Störungen der Masseleitung kompensiert, und eine Eingangs-/Ausgangsschaltung 82.

Bevorzugt ist die sichere Steuervorrichtung 4 so konfiguriert, dass sie eine sichere Authentifizierung ermöglicht. Dies betrifft zum Ersten die Authentifizierung der Steuervorrichtung 4 bei anderen Rechnern. Diese anderen Rechner können beispielsweise die übergeordnete Steuervorrichtung 12 als auch Server 710 von Dienstleistungsanbietern und/oder Server 710 von Automobilherstellern und/oder Terminals 740, beispielsweise Smartphones, sein. Dies betrifft zum Ersten die Authentifizierung die Authentifizierung solcher anderen Rechner bei der Steuervorrichtung 4 der Sicherung 1. Diese anderen Rechner können beispielsweise die übergeordnete Steuervorrichtung 12 als auch Server 710 von Dienstleistungsanbietern und/oder Server 710 von Automobilherstellern und/oder Terminals 740, beispielsweise Smartphones, sein. Dies betrifft aber auch die Authentifizierung eines Nutzers 730 bei der Steuervorrichtung 4 der Sicherung 1 beispielsweise mittels Dateneingaben an einem authentifizierten Terminal und/oder mittels Erfassung biometrischer Daten des Nutzers 730 mittels biometrischer Sensoren des Terminals 740. So speichert die sichere Steuervorrichtung 4 neben dem Authentifizierungscode weitere Daten, z. B. ein oder mehr Lebensdauer- und Benutzungsdaten und/oder z.B. logistische Daten und/oder z.B., kommerzielle Daten und/oder Website- und Email-Adressen und/oder Bilddaten, einen Satz von Anweisungen für Steuergeräte des Fahrzeugs und/oder des übergeordneten Rechnersystems 12 mit denen der Rechnerkern 2 der Steuervorrichtung 4 über eine Datenschnittstelle 10 kommuniziert. Daneben kann die sichere Steuervorrichtung 4 weitere Anwendungsdaten speichern.

Die Steuervorrichtung 4 der Figur 24 umfasst beispielhaft ein oder mehrere Kryptografie-Beschleuniger 70 beispielsweise einen DES-Beschleuniger und/oder einen AES-Beschleuniger 70.

Bevorzugt umfasst ein monolithischer integrierter Schaltkreis beispielsweise die sichere Steuervorrichtung 4, die vorzugsweise so konfiguriert ist, dass sie die sichere Authentifizierung und Verifizierung eines Produkts, eines Nutzers und/oder anderer Rechner und Nutzungssituationen erleichtert. Bevorzugt umfasst der integrierte Schaltkreis auch die Shunt-Widerstande 24 und 24'. Bevorzugt ist der integrierte Schaltkreis auf bzw. in einem ersten Halbleitersubstrat vorzugsweise in CMOS Technologie gefertigt.

Bevorzugt ist der erste Hilfsleistungsschalter 23 monolithisch auf bzw. in einem gemeinsamen zweiten Substrat mit dem ersten Leistungsschalter 17 gefertigt.

Bevorzugt ist der zweite Hilfsleistungsschalter 23' monolithisch auf bzw. in einem gemeinsamen dritten Substrat mit dem zweiten Leistungsschalter 17' gefertigt.

Das zweite Substrat und das dritte Substrat bilden vorzugsweise ein gemeinsames zweites Substrat.

Bevorzugt sind das erste Substrat und das zweite Substrat und - sofern nicht Teil des zweiten Substrats - das dritte Substrat in einem gemeinsamen Gehäuse 535 untergebracht.

Bevorzugt verfügt das Gehäuse 535 über eine zweite metallene Montagefläche, eine sogenannte Die-Insel- für die Montage des zweiten Substrats mittels Kleber oder Lot auf der Oberfläche dieser zweiten Montagefläche und ggf. über eine dritte metallene Montagefläche, eine sogenannte Die-Insel- für die Montage des dritten Substrats mittels Kleber oder Lot auf der Oberfläche dieser dritten Montagefläche. Vorzugsweise ist die Unterseite der zweiten Montagefläche nicht von dem Material des Gehäuses 535 bedeckt. Damit ist die Unterseite der zweiten Montagefläche vorzugsweise Teil der Oberfläche der Unterseite des Gehäuses 535. Ist das Lot oder der Kleber mit dem die Unterseite des zweiten Substrats mit dem ersten Leistungsschalter 17 und ggf. mit dem zweiten Leistungsschalter 17' auf der Oberfläche der Oberseite der zweiten Montagefläche befestigt ist, elektrisch leitend, so kann das zweite Substrat über die Unterseite dieser zweiten Montagefläche als sogenanntes Exposed-Die-Pad elektrisch und thermisch kontaktiert werden, sodass der erste Leistungsschalter 17 und ggf. der zweite Leistungsschalter 17' besonders gut gekühlt werden und kleiner ausgeführt werden können und schneller schalten. Dies ist somit eine wichtige Voraussetzung, um im Falle eines Kurzschlusses besonders schnell abschalten zu können, wie an anderer Stelle in diesem Dokument erwähnt.

Bevorzugt verfügt das Gehäuse 535 über eine dritte metallene Montagefläche, eine sogenannte Die-Insel- für die Montage des ggf. vorhandenen dritten Substrats mittels Kleber oder Lot auf der Oberfläche dieser dritten Montagefläche. Vorzugsweise ist die Unterseite der dritten Montagefläche nicht von dem Material des Gehäuses 535 bedeckt. Damit ist die Unterseite der dritten Montagefläche vorzugsweise Teil der Oberfläche der Unterseite des Gehäuses 535. Ist das Lot oder der Kleber mit dem die Unterseite des ggf. vorhanden dritten Substrats mit dem zweiten Leistungsschalter 17' auf der Oberfläche der Oberseite der dritten Montagefläche befestigt ist, elektrisch leitend, so kann das dritte Substrat über die Unterseite dieser dritten Montagefläche als sogenanntes Exposed-Die-Pad elektrisch und thermisch kontaktiert werden, sodass der zweite Leistungsschalter 17' besonders gut gekühlt wird und kleiner ausgeführt werden kann und schneller schaltet. Dies ist somit eine wichtige Voraussetzung, um im Falle eines Kurzschlusses besonders schnell abschalten zu können, wie an anderer Stelle in diesem Dokument erwähnt.

Figur 25

Die Figur 25 entspricht der Batterie der Figur 22, wobei die Figur 25 ein Batteriezellenmodul 2500 mit mehreren Batteriezellen 2145, 2185 zeigt. Das Batteriezellenmodul 2500 entspricht im Sinne des hier vorgelegten Dokuments dem Batteriezellenmodul 2105 der Figur 21.

Ein beispielhafter Steckverbinder 2505 weist einen ersten Kontakt 6 für den Betriebsspannungsanschluss 6 der elektronischen Sicherungen 825, 805 auf. Der Steckverbinder 2505 weist darüber hinaus einen zweiten Kontakt 201 für den Bezugspotenzialanschluss 201 der elektronischen Sicherungen 805, 815 auf. Der Steckverbinder weist einen dritten Kontakt 9 für den externer Datenbus 9 der elektronischen Sicherungen 805, 815 auf.

Figur 26

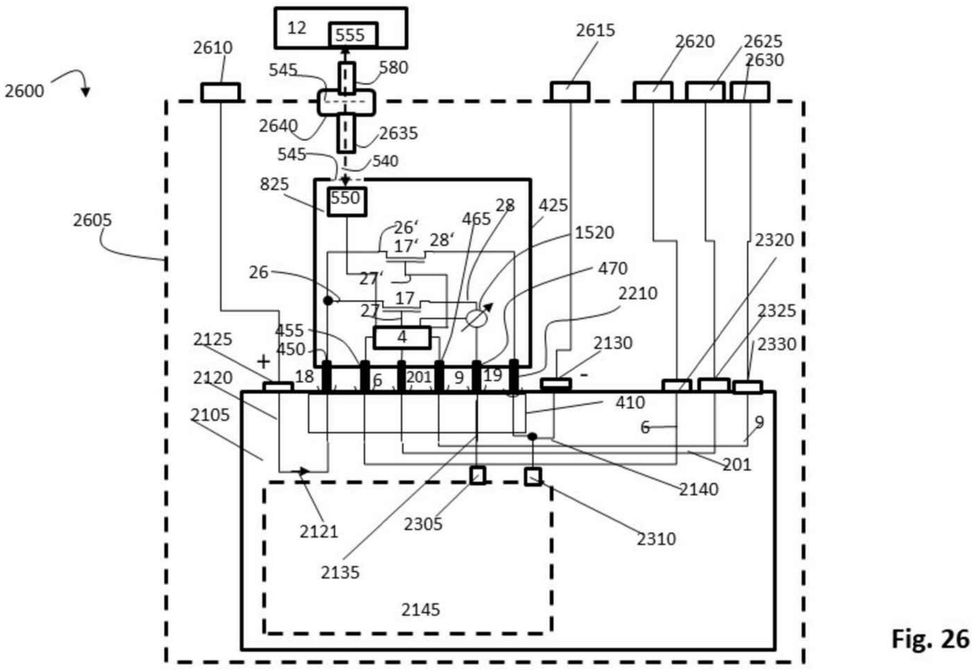

Figur 26 zeigt ein gehäustes Batteriezellenmodul 2600 mit einem gemeinsamen Gehäuse 2605 des Batteriezellenmoduls 2600 für eine elektronische Sicherung 825 und ein inneres Batteriezellenmodul 2105. Mittels eines optischen Stecksystems 2640 für die steckbare optische Verbindung zwischen dem externen Lichtwellenleiter 580 außerhalb des Gehäuses 2605 und dem optischer Lichtwellenleiter 2635 innerhalb des Gehäuses 2605 kann die optische Datenschnittstelle 550 der elektronischen Sicherung 825 über ein optisches Fenster 545 mit einer optischen Schnittstelle 555 eines übergeordneten Rechnersystems 12 Daten und Kommandos austauschen. Bevorzugt weist auch das Sicherungsgehäuse 425 ein optisches Fenster 545 auf.

Das vorschlagsgemäße Batteriezellenmodul 2600 umfasst einen beispielhaften, optischen Lichtwellenleiter 2635 innerhalb des Gehäuses 2605 des Batteriezellenmoduls 2600.

Der erste Anschluss 2610 des Batteriezellenmoduls 2600 ist vorzugsweise mit dem ersten Anschluss 2125 des inneren Batteriezellenmoduls 2105 innerhalb des Gehäuses 2605 des Batteriezellenmoduls 2600 verbunden.

Der zweite Anschluss 2615 des Batteriezellenmoduls 2600 ist vorzugsweise mit dem zweiten Anschluss 2130 des inneren Batteriezellenmoduls 2105 innerhalb des Gehäuses 2605 des Batteriezellenmoduls 2600 verbunden.

Das Batteriezellenmodul 2600 umfasst vorzugsweise einen Anschluss 2620 des Batteriezellenmoduls 2600 für die Betriebsspannung 6 der elektronischen Sicherung 825 des inneren Batteriezellenmoduls 2105.

Das Batteriezellenmodul 2600 umfasst vorzugsweise einen Anschluss 2625 des Batteriezellenmoduls 2600 für den Bezugspotenzialknoten 201 der elektronischen Sicherung 825 des inneren Batteriezellenmoduls 2105.

Das Batteriezellenmodul 2600 umfasst vorzugsweise einen Anschluss 2630 des Batteriezellenmoduls 2600 für den externen Datenbus 9 der elektronischen Sicherung 825 des inneren Batteriezellenmoduls 2105.

Figur 27

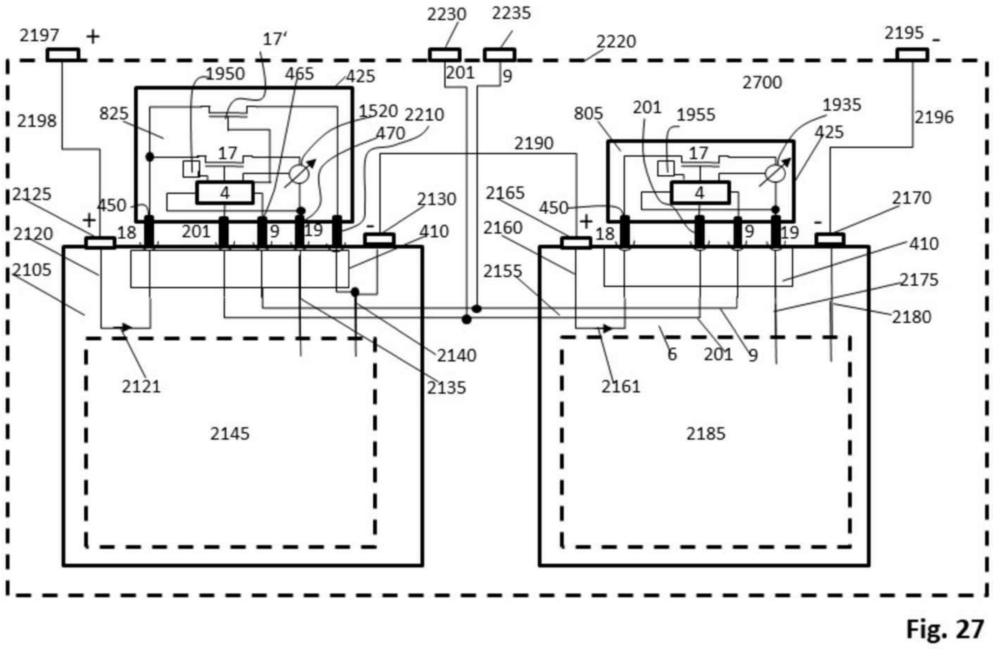

Figur 27 zeigt eine Batterie 2700, bei der eine elektronische Sicherung 825 der Batterie 2200 einen zweiten Leistungsschalter 17' aufweist, der dazu geeignet ist, das der Sicherung zugeordnete Batteriezellenmodul 2105 bei einem geschlossenen zweiten Leistungsschalter 17' zu überbrücken und bei der die Steuervorrichtung aus der Batteriezelle 2145 versorgt wird, aber nur wenn der Leistungsschalter 17 geschlossen ist. Ansonsten entspricht die Batterie 2700 im Wesentlichen der Batterie 2022 der Figur 22.

Figur 28

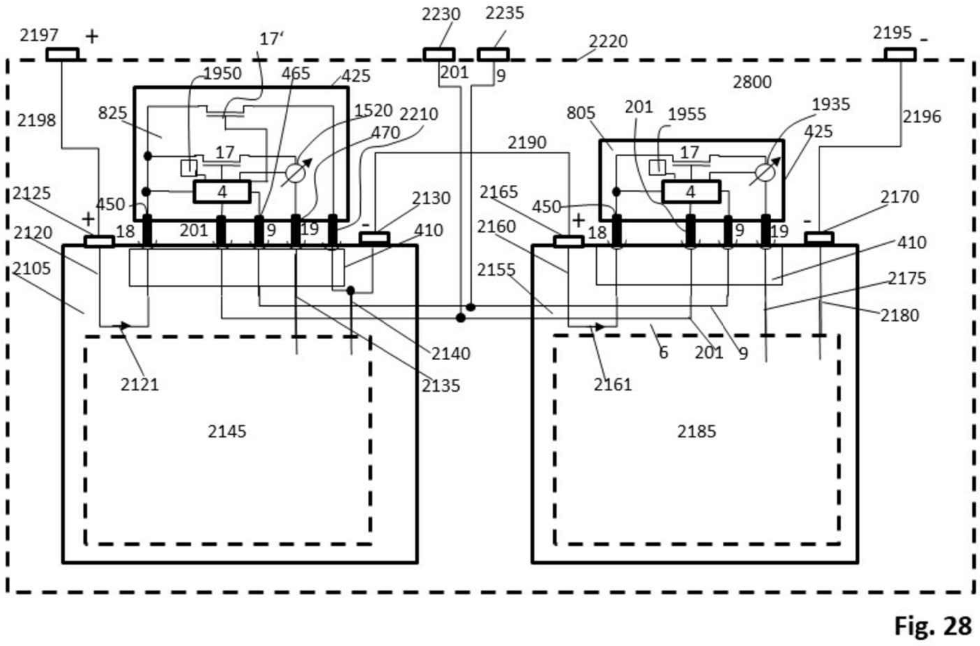

Figur 28 zeigt eine Batterie 2800, bei der eine elektronische Sicherung 825 der Batterie 2200 einen zweiten Leistungsschalter 17' aufweist, der dazu geeignet ist, das der Sicherung zugeordnete Batteriezellenmodul 2105 bei einem geschlossenen zweiten Leistungsschalter 17' zu überbrücken und bei der die Steuervorrichtung 4 aus der Batteriezelle 2145 weiter versorgt wird, auch wenn der Leistungsschalter 17 geöffnet ist.

Figur 29

Figur 29 zeigt ein Versorgungsnetzwerk 2900, wobei ein oder mehrere Versorgungszweige des Versorgungsnetzwerks 2900 zur Versorgung von elektrischen Verbrauchern 2930 bis 2933 mit elektrischer Energie als Ring einer Versorgungsleitung 2910 bis 2915, insbesondere wenn eine Karosserie als Rückleitermasseleitung dient, und/oder als zwei Ringe von zwei Versorgungsleitungen ausgeführt sind. Auch können ein oder mehrere Versorgungszweige des Versorgungsnetzwerks 2900 zur Energielieferung von elektrischer Energie aus elektrischen Energiequellen 2940, 2941 als Ring einer Versorgungsleitung 2910 bis 2915, insbesondere wenn eine Karosserie als Rückleitermasseleitung dient, und/oder als zwei Ringe von zwei Versorgungsleitungen ausgeführt sein.

Bevorzugt sind in das Versorgungsnetzwerk 2900 für einige Verbraucher der Verbraucher 2930 bis 2933 jeweils zwei Sicherungen 2960 bis 2967 in die Versorgungsleitung 2910 bis 2915 am jeweiligen Energieentnahmepunkt 2920 bis 2923 für diesen Verbraucher der Verbraucher 2930 bis 2933 in die Versorgungsleitung 2910 bis 2915 eingefügt und/oder für Energiequellen 2940, 2941 jeweils zwei Sicherungen 2950 bis 2953 in die Versorgungsleitung 2910 bis 2915 am Energieeinspeisepunkt 2924 bis 2925 der elektrischen Energie für diese Energiequellen 2940, 2941 in die Versorgungsleitung 2910 bis 2915 eingefügt.

Vorzugsweise sind genau diejenigen zwei elektronischen Sicherungen der Sicherungen 2950 bis 2953 und 2960 bis 2967, die einem fehlerhaften Leitungsabschnitt der Leitungsabschnitte 2910 bis 2915 zugeordnet sind, dazu eingerichtet, bei einem Fehler an dem Leitungsabschnitt ihre Leistungsschalter 17 öffnen, sodass genau diese beiden elektronischen Sicherungen der Sicherungen 2950 bis 2953 und 2960 bis 2967 diesen fehlerhaften Leitungsabschnitt der Leitungsabschnitte 2910 bis 2915 Vorzugsweise öffnen bei einem Fehler an einem Verbraucher der Verbraucher 2930 bis 2933 die zwei diesem fehlerhaften Verbraucher zugeordneten elektronischen Sicherungen der Sicherungen 2960 bis 2967 ihre Leistungsschalter 17, sodass diese beiden elektronischen Sicherungen den fehlerhaften Verbraucher hierdurch isolieren und/oder öffnen bei einem Fehler an einer Energiequelle der Energiequellen 2940, 2941 die zwei dieser fehlerhaften Energiequelle zugeordneten elektronischen Sicherungen der Sicherungen 2950 bis 2953 ihre Leistungsschalter, sodass diese beiden elektronischen Sicherungen die fehlerhafte Energiequelle hierdurch isolieren. Dies ist vorzugsweise insbesondere dann der Fall, wenn die vorstehenden Fehler die Energieversorgung anderer Verbraucher der Verbraucher 2930 bis 2933 und/oder hoch priorisierter Verbraucher der Verbraucher 2930 bis 2933 beeinträchtigen.

Das hier vorgestellte Dokument beschreibt unter anderem auch ein Versorgungsnetzwerk 2900 bei dem der Rechnerkern 2 der Steuervorrichtung 4 einer elektronischen Sicherung der Sicherungen 2950 bis 2953 und 2960 bis 2967 über eine Datenschnittstelle 10, 610, 550, 551 über einen Datenbus 9 Daten wie Konfigurationsdaten (Schreiben/Lesen), Schaltbefehle (Schreiben/Lesen), Diagnosedaten (Schreiben/Lesen), Messwerte (Lesen), Vergleichswerteinstellungen (Schreiben/Lesen) empfängt oder sendet.

Bevorzugt ist der Datenbus 9 in Teilen oder ganz ein Zweidrahtdatenbus und/oder ein differenzieller Datenbus 9 und/oder ein differenzieller bidirektionaler Datenbus 9.

Beispielsweise kann der Datenbus 9 ein CAN-Datenbus oder ein Datenbus 9 mit einem Physical-interface eines CAN-Datenbusses, eines CAN-FD-Datenbusses oder eines Flexray-Datenbusses oder eines LVDS-Datenbusses oder dergleichen sein.

Elektronische Sicherungen 2950 bis 2953 und 2960 bis 2967 des Versorgungsnetzwerks 2900 können jeweils zwei Datenschnittstellen 10, 610, 550, 551 für den Datenbus 9 umfassen, wobei diese in den Datenbus 9 eingefügt sind und eine lineare Kette von Sicherungen 2950 bis 2953 und 2960 bis 2967 entlang zumindest eines Teils des Datenbusses 9 bilden.

Ein übergeordnetes Rechnersystem 12, das am Anfang dieses Teils des Datenbusses 9 angeschlossen ist, kann mittels Autoadressierung im Zusammenwirken mit den Steuervorrichtungen 4 der elektronischen Sicherungen für jede der Steuervorrichtungen 4 der elektronischen Sicherungen (2950 bis 2953 und 2960 bis 2967) eine Sicherungsadresse zur Ansteuerung der Rechnerkerne 2 der Steuervorrichtungen 4 der Sicherungen ermitteln und ggf. an die Rechnerkerne 2 der Steuervorrichtungen 4 der elektronischen Sicherungen (2950 bis 2953 und 2960 bis 2967) übermitteln.

Das Versorgungsnetzwerk 2900 umfasst bevorzugt eine Versorgungsleitung 2910 bis 2915. Beispielsweise kann das Versorgungsnetzwerk 2900 in Teilen ringförmig sein. Die Verbraucher 2920 bis 2923 kann an verschiedenen Energieentnahmepunkten 2920 bis 2923 des ringförmigen Versorgungsnetzes 2900 elektrische Energie aus der Versorgungsleitung 2910 bis 2915 des Versorgungsnetzes 2900 entnehmen. Die Energiequellen 2940 bis 2941 können an verschiedenen Einspeisepunkten 2924 bis 2925 des ringförmigen Versorgungsnetzes 2900 elektrische Energie in die Versorgungsleitung 2910 bis 2915 des Versorgungsnetzes 2900 einspeisen. Die Versorgungsleitung 2910 bis 2915 des ringförmigen Versorgungsnetzes 2900 links oder rechts der jeweiligen Entnahmepunkte elektrischer Energie bzw. links oder rechts der jeweiligen Einspeisepunkte elektrischer Energie sind zumindest auf einer Seite jeweils durch eine jeweilige elektronische Sicherung der Sicherungen 2950 bis 2953 und 2960 bis 2967 unterbrochen. Die jeweilige elektronische Sicherung der Sicherungen 2950 bis 2953 und 2960 bis 2967 ist mit ihrem jeweiligen Leistungsschalter 17 in die Versorgungsleitung 2910 bis 2915 des Versorgungsleitungsabschnitts zwischen zwei jeweilige Entnahmepunkte der Entnahmepunkte 2920 bis 2923 für elektrische Verbraucherenergie der zugehörigen Verbraucher der Verbraucher

2930 bis 2933 eingefügt oder zwischen zwei jeweilige Einspeisepunkte der Einspeisepunkte 2924 bis 2924 für elektrische Energie der zugehörigen Energiequellen der Energiequellen 2940 bis 2941 oder zwischen einem jeweiligen Einspeisepunkt der Einspeisepunkte 2924 bis 2924 für elektrische Energie der zugehörigen Energiequelle der Energiequellen 2940 bis 2941 und einem jeweiligen Entnahmepunkt der Entnahmepunkte 2920 bis 2923 für elektrische Verbraucherenergie des zugehörigen Verbrauchers der Verbraucher 2930 bis 2933 eingefügt.

Die Versorgungsleitung des ringförmigen Versorgungsnetzes 2900 ist links und rechts der jeweiligen Entnahmepunkte 2920 bis 2923 elektrischer Energie auf jeder Seite jedes Entnahmepunkts der Entnahmepunkte 2920 bis 2923 jeweils durch eine jeweilige elektronische Sicherung der Sicherungen 2960 bis 2967 unterbrochen und/oder links und rechts der jeweiligen Einspeisepunkte 2924 bis 2925 elektrischer Energie auf jeder Seite jedes Einspeisepunkts der Einspeisepunkte 2924 bis 2925 jeweils durch eine jeweilige elektronische Sicherung der Sicherungen 2950 bis 2953 unterbrochen.

Bevorzugt isolieren die beiden elektronischen Sicherungen, die einem Einspeisepunkt der Einspeisepunkte 2924 bis 2925 oder einem Entnahmepunkt der Entnahmepunkte 2920 bis 2923 oder einem Versorgungsleitungsabschnitt der Versorgungsabschnitte 2910 bis 2915 am nächsten liegen, diesen Einspeisepunkt oder diesen Entnahmepunkt oder diesen Versorgungsleitungsabschnitt durch Öffnen ihrer Leistungsschalter 17, wenn ein Fehler eines Verbrauchers der Verbraucher 2930 bis 2933 an diesem Entnahmepunkt in diesem Versorgungsleitungsabschnitt der Versorgungsabschnitte 2910 bis 2915 und/oder wenn ein Fehler einer Energiequelle der Energiequellen 2940 bis 2941 an diesem Einspeisepunkt in diesem Versorgungsleitungsabschnitt der Versorgungsabschnitte 2910 bis 2915 auftritt.

Beispielsweise kann ein übergeordnetes Rechnersystem 12 den Status der elektronischen Sicherungen 2960 bis 2967 und 2950 bis 2953 durch Ansprache der Rechnerkerne 2 der Steuervorrichtungen 4 der elektronischen Sicherungen 2960 bis 2967 und 2950 bis 2953 über den Datenbus 9 ermitteln. Das übergeordnete Rechnersystem 12 kann bei Vorliegen einer Störung oder eines Fehlers die Position der Störung bzw. des Fehlers im Versorgungsnetzwerk 2900 ermitteln. Das übergeordnete Rechnersystem 9 kann dann die Störung bzw. den Fehler an der ermittelten Position mittels eines Eingriffs in das Versorgungsnetzwerk 2900 eingrenzen, in dem das übergeordnete Rechnersystem 12 die Rechnerkerne 2 der Steuervorrichtungen 4 der beiden elektronischen Sicherungen der Sicherungen 2960 bis 2967 und 2950 bis 2953 des Versorgungsnetzwerks 2900, die der Position der Störung am nächsten sind, veranlasst, ihre Leistungsschalter 17 zu öffnen.

Bevorzugt ist der Eingriff durch das übergeordnete Rechnersystem 12 schneller als das doppelte der längsten Zeitkonstante der Energieentnahmen der Verbraucher 2920 bis 2923, die zum Zeitpunkt des Eingriffs aus dem Versorgungsnetzwerk 2900 Energie beziehen. Ebenso bevorzugt ist der Eingriff durch das übergeordnete Rechnersystem 12 schneller als das doppelte der längsten Zeitkonstante der Energieeinspeisungen der Energiequellen 2940 bis 2941 ist, die in das Versorgungsnetzwerk 2900 Energie einspeisen.

Bevorzugt zeichnet der Rechnerkern 2 der Steuervorrichtung 4 einer elektronischen Sicherung der Sicherungen 2950 bis 2953 und 2960 bis 2967 die Störungen und/oder Fehler in Form einer Log-Tabelle 2970, die auch nur wenige Bits umfassen kann, oder einer Log-Datei 2970 oder in einer anderen Speicherform in einem vorzugsweise nicht flüchtigen Speicher der Steuervorrichtung 4 der Sicherung auf. In ähnlicher Weise kann ein übergeordnetes Rechnersystem 12 die Störungen und/oder die Fehler im Versorgungsnetzwerk 2900 und/oder die Störungen und/oder die Fehler der Sicherungen 2950 bis 2953 und 2960 bis 2967 in Form einer Log-Tabelle 2970, die auch nur wenige Bits umfassen kann, oder einer Log-Datei 2970 oder einer anderen Speicherform vorzugsweise in einem nicht flüchtigen Speicher des übergeordneten Rechnersystems 12 auf.

Der Rechnerkern 2 der Steuervorrichtung 4 der elektronischen Sicherung versieht vorzugsweise die Einträge der Log-Tabelle 2970 bzw. der Log-Datei 2970 mit einem Zeitstempeln einer Zeitgebereinheit 35 der Steuervorrichtung 4 der elektronischen Sicherung. Auch kann das übergeordnetes Rechnersystem 12 die Einträge der Log-Tabelle 2970 bzw. der Log-Datei 2970 mit einem Zeitstempeln einer Zeitgebereinheit 1970 des übergeordneten Rechnersystems 12 in analoger Weise versehen.

Vorzugsweise zeichnet der Rechnerkern 2 der Steuervorrichtung 4 der elektronischen Sicherung in der Log-Tabelle 2970 bzw. der Log-Datei 2970 mit einem Zeitstempel auch auf, ab wann die Störung nicht mehr bestand. In analoger Weise kann das übergeordnetes Rechnersystem 12 in der Log-Tabelle 2970 bzw. der Log-Datei 2970 mit einem Zeitstempel auch aufzeichnen, ab wann die Störung nicht mehr bestand.

Das übergeordnete Rechnersystem 12 liest bevorzugt regelmäßig oder bei einer Störung oder bei einem Fehler die Log-Tabelle 2970 bzw. die Log-Datei 2970 des Rechnerkerns 2 der Steuervorrichtung 4 einer Sicherung der Sicherungen 2950 bis 2953 und 2960 bis 2963 über den Datenbus (9) aus dem Speicher der Steuervorrichtung 4 dieser elektronischen Sicherung und/oder aus dem Speicher des Rechnerkerns 2 der Steuervorrichtung 4 dieser Sicherung aus.

Das übergeordnete Rechnersystem 12 identifiziert mit Hilfe einer oder mehrerer seiner Log-Tabellen 2970 bzw. einer oder mehrerer seiner Log-Dateien 2970 und/oder mit Hilfe einer oder mehrerer Log-Tabellen 2970 bzw. einer oder mehrerer Log-Dateien 2970 eines oder mehrerer Rechnerkerne 2 einer oder mehrerer Steuervorrichtungen 4 einer oder mehrerer elektronischer Sicherungen der Sicherungen (2950 bis 2953 und 2960 bis 2967) potenziell betroffene Sensoren und Messsysteme, die das Versorgungsnetzwerk 2900 mit elektrischer Energie versorgt. Das übergeordnete Rechnersystem 12 markiert dann bevorzugt die im relevanten Zeitraum von diesen Sensoren und Messsystemen akquirierten Messwerte als potenziell fehlerhaft oder verwirft die im relevanten Zeitraum von diesen Sensoren und Messsystemen akquirierten Messwerte gleich.

Die Figur 29 zeigt somit schematisch vereinfacht ein Versorgungsnetzwerk 2900. Dabei sind ein oder mehrere Versorgungszweige des Versorgungsnetzwerks 2900 zur Versorgung von elektrischen Verbrauchern 2930 bis 2933 mit elektrischer Energie als Ring einer Versorgungsleitung 2910 bis 2915 ausgeführt. Insbesondere kann bei einem Ring z.B. eine Karosserie als Rückleitermasseleitung dienen. Sofern die Karosseriemasse nicht in allen Teilen des Versorgungsnetzwerks 2900 als Rückleitung zur Verfügung steht kann das Versorgungsnetzwerk 2900 in diesen Bereichen in Form von zwei Ringen zweier Versorgungsleitungen ausgeführt sein. Dabei dienen dann ein oder mehrere Versorgungszweige des Versorgungsnetzwerks 2900 zur Energielieferung von elektrischer Energie aus elektrischen Energiequellen 2940 bis 2941 als Ring einer Versorgungsleitung 2910 bis 2915, wenn z.B. eine Karosserie als Rückleitermasseleitung dient, und/oder als zwei Ringe von zwei Versorgungsleitungen, wenn z.B. keine Karosserie als Rückleitermasseleitung dient.

Das Versorgungsnetzwerk 2900 umfasst in dem Beispiel der Figur 29 einen ersten Leitungsabschnitt 2910 des Versorgungsleitungsrings, wobei der erste Leitungsabschnitt 2910 den Energieeinspeisepunkt 2924 der ersten Energiequelle 2940 mit dem ersten Energieentnahmepunkt 2920 des ersten Verbrauchers 2930 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen zweiten Leitungsabschnitt 2911 des Versorgungsleitungsrings, wobei der zweite Leitungsabschnitt 2911 den ersten Energieentnahmepunkt 2920 des ersten Verbrauchers 2930 mit dem zweiten Energieentnahmepunkt 2921 des zweiten Verbrauchers 2931 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen dritten Leitungsabschnitt 2912 des Versorgungsleitungsrings, wobei der dritte Leitungsabschnitt 2912 den zweiten Energieentnahmepunkt 2921 des zweiten Verbrauchers 2931 mit dem dritten Energieentnahmepunkt 2922 des dritten Verbrauchers 2932 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen vierten Leitungsabschnitt 2913 des Versorgungsleitungsrings, wobei der vierte Leitungsabschnitt 2913 den dritten Energieentnahmepunkt 2922 des dritten Verbrauchers 2932 mit dem dritten Energieentnahmepunkt 2922 des dritten Verbrauchers 2933 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen fünften Leitungsabschnitt 2914 des Versorgungsleitungsrings, wobei der fünfte Leitungsabschnitt 2914 den vierten Energieentnahmepunkt 2923 des vierten Verbrauchers 2933 mit dem zweiten Energieeinspeisepunkt 2925 der zweiten Energiequelle 2941 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen sechsten Leitungsabschnitt 2915 des Versorgungsleitungsrings, wobei der sechste Leitungsabschnitt 2915 den zweiten Energieeinspeisepunkt 2925 der zweiten Energiequelle 2941 mit dem ersten Energieeinspeisepunkt 2924 der ersten Energiequelle 2940 im Beispiel der Figur 29 elektrisch verbindet und wobei die Rückleitung beispielsweise die Fahrzeugkarosserie sein kann.

Das Versorgungsnetzwerk 2900 umfasst in dem Beispiel der Figur 29 einen ersten Energieentnahmepunkt 2920 zur Versorgung des ersten Verbrauchers 2930 mit elektrischer Energie aus dem Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 einen zweiten Energieentnahmepunkt 2921 zur Versorgung des zweiten Verbrauchers 2931 mit elektrischer Energie aus dem Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 einen dritten Energieentnahmepunkt 2922 zur Versorgung des dritten Verbrauchers 2932 mit elektrischer Energie aus dem Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 einen vierten Energieentnahmepunkt 2923 zur Versorgung des vierten Verbrauchers 2933 mit elektrischer Energie aus dem Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 einen ersten Energieeinspeisepunkt 2924 zur Einspeisung der Energie der ersten Energiequelle 2940 in den Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 einen zweiten Energieeinspeisepunkt 2925 zur Einspeisung der Energie der zweiten Energiequelle 2941 in den Versorgungsleitungsring 2910 bis 2915, wobei die Rückleitung beispielsweise die Fahrzeugkarosserie sein kann.

Das Versorgungsnetzwerk 2900 umfasst in dem Beispiel der Figur 29 eine erste Sicherung 2950 der ersten Energiequelle 2940. Die erste Sicherung 2950 kann mittels ihres Leistungsschalters 17 den ersten Energieeinspeisepunkt 2924 von dem ersten Leitungsabschnitt 2910 des Versorgungsleitungsrings 2910 bis 2915 trennen oder den ersten Energieeinspeisepunkt 2924 mit dem ersten Leitungsabschnitt 2910 des Versorgungsleitungsrings 2910 bis 2915 verbinden. Dieses Trennen bzw. Verbinden hängt typischerweise von dem elektrischen Strom durch die erste Sicherung 2950 und/oder der elektrischen Spannung des Versorgungsleitungsrings 2910 bis 2915 im Bereich der ersten Sicherung 2950 relativ zu einem Bezugspotenzial und/oder von einem Datenbefehl über den Sicherungsdatenbus 9 ab.

Das Versorgungsnetzwerk 2900 umfasst in dem Beispiel der Figur 29 eine zweite Sicherung 2951 der ersten Energiequelle 2940. Die zweite Sicherung 2951 kann mittels ihres Leistungsschalters 17 den ersten Energieeinspeisepunkt 2924 von dem sechsten Leitungsabschnitt 2915 des Versorgungsleitungsrings 2910 bis 2915 trennen oder den ersten Energieeinspeisepunkt 2924 mit dem sechsten Leitungsabschnitt 2915 des Versorgungsleitungsrings 2910 bis 2915 verbinden. Dieses Trennen bzw. Verbinden hängt typischerweise von dem elektrischen Strom durch die zweite Sicherung 2951 und/oder der elektrischen Spannung des Versorgungsleitungsrings 2910 bis 2915 im Bereich der zweiten Sicherung 2951 relativ zu einem Bezugspotenzial und/oder von einem Datenbefehl über den Sicherungsdatenbus 9 ab.

Das Versorgungsnetzwerk 2900 umfasst in dem Beispiel der Figur 29 eine dritte Sicherung 2952 der zweiten Energiequelle 2941. Die dritte Sicherung 2952 kann mittels ihres Leistungsschalters 17 den zweiten Energieeinspeisepunkt 2925 von dem sechsten Leitungsabschnitt 2915 des Versorgungsleitungsrings 2910 bis 2915 trennen oder den zweiten Energieeinspeisepunkt 2925 mit dem sechsten Leitungsabschnitt 2915 des Versorgungsleitungsrings 2910 bis 2915 verbinden. Dieses Trennen bzw. Verbinden hängt typischerweise von dem elektrischen Strom durch die dritte Sicherung 2952 und/oder der elektrischen Spannung des Versorgungsleitungsrings 2910 bis 2915 im Bereich der dritten Sicherung 2952 relativ zu einem Bezugspotenzial und/oder von einem Datenbefehl über den Sicherungsdatenbus 9 ab.

Das Versorgungsnetzwerk 2900 umfasst in dem Beispiel der Figur 29 eine vierte Sicherung 2953 der zweiten Energiequelle 2941. Die vierte Sicherung 2953 kann mittels ihres Leistungsschalters 17 den zweiten Energieeinspeisepunkt 2925 von dem fünften Leitungsabschnitt 2914 des Versorgungsleitungsrings 2910 bis 2915 trennen oder den zweiten Energieeinspeisepunkt 2925 mit dem fünften Leitungsabschnitt 2914 des Versorgungsleitungsrings 2910 bis 2915 verbinden. Dieses Trennen bzw. Verbinden hängt typischerweise von dem elektrischen Strom durch die vierte Sicherung 2953 und/oder der elektrischen Spannung des Versorgungsleitungsrings 2910 bis 2915 im Bereich der vierten Sicherung 2953 relativ zu einem Bezugspotenzial und/oder von einem Datenbefehl über den Sicherungsdatenbus 9 ab.

Das Versorgungsnetzwerk 2900 umfasst in dem Beispiel der Figur 29 eine dreizehnte Sicherung 2950 der ersten Energiequelle 2940. Die dreizehnte Sicherung 2950 kann mittels ihres Leistungsschalters 17 den ersten Energieeinspeisepunkt 2924 von dem ersten Leitungsabschnitt 2910 des Versorgungsleitungsrings 2910 bis 2915 trennen oder wobei den ersten Energieeinspeisepunkt 2924 mit dem ersten Leitungsabschnitt 2910 des Versorgungsleitungsrings 2910 bis 2915 verbinden. Dieses Trennen bzw. Verbinden hängt typischerweise von dem elektrischen Strom durch die dreizehnte Sicherung 2950 und/oder der elektrischen Spannung des Versorgungsleitungsrings 2910 bis 2915 im Bereich der dreizehnten Sicherung 2950 relativ zu einem Bezugspotenzial und/oder von einem Datenbefehl über den Sicherungsdatenbus 9 ab. Die dreizehnte Sicherung 2950 und die vierzehnte Sicherung 2951 können eine gemeinsame Steuervorrichtung 4 aufweisen.

Das Versorgungsnetzwerk 2900 umfasst in dem Beispiel der Figur 29 eine vierzehnte Sicherung 2951 der ersten Energiequelle 2940. Die vierzehnte Sicherung 2951 kann mittels ihres Leistungsschalters 17 den ersten Energieeinspeisepunkt 2924 von dem sechsten Leitungsabschnitt 2915 des Versorgungsleitungsrings 2910 bis 2915 trennen oder den ersten Energieeinspeisepunkt 2924 mit dem sechsten Leitungsabschnitt 2915 des Versorgungsleitungsrings 2910 bis 2915 verbinden. Dieses Trennen bzw. Verbinden hängt typischer Weise von dem elektrischen Strom durch die vierzehnte Sicherung 2951 und/oder der elektrischen Spannung des Versorgungsleitungsrings 2910 bis 2915 im Bereich der vierzehnten Sicherung 2951 relativ zu einem Bezugspotenzial und/oder von einem Datenbefehl über den Sicherungsdatenbus 9 ab. Die dreizehnte Sicherung 2950 und die vierzehnte Sicherung 2951 können eine gemeinsame Steuervorrichtung 4 aufweisen.

Das Versorgungsnetzwerk 2900 umfasst in dem Beispiel der Figur 29 eine fünfzehnte Sicherung 2952 der zweiten Energiequelle 2941. Die fünfzehnte Sicherung 2952 kann mittels ihres Leistungsschalters 17 den zweiten Energieeinspeisepunkt 2925 von dem sechsten Leitungsabschnitt 2915 des Versorgungsleitungsrings 2910 bis 2915 trennen oder den zweiten Energieeinspeisepunkt 2925 mit dem sechsten Leitungsabschnitt 2915 des Versorgungsleitungsrings 2910 bis 2915 verbinden. Dieses Trennen bzw. Verbinden hängt typischerweise von dem elektrischen Strom durch die fünfzehnte Sicherung und/oder der elektrischen Spannung des Versorgungsleitungsrings 2910 bis 2915 im Bereich der fünfzehnten Sicherung 2952 relativ zu einem Bezugspotenzial und/oder von einem Datenbefehl über den Sicherungsdatenbus 9 ab. Die fünfzehnte Sicherung 2952 und die sechzehnte Sicherung 2953 können eine gemeinsame Steuervorrichtung 4 aufweisen.

Das Versorgungsnetzwerk 2900 umfasst in dem Beispiel der Figur 29 eine sechzehnte Sicherung 2953 der zweiten Energiequelle 2941. Die sechzehnte Sicherung 2953 kann mittels ihres Leistungsschalters 17 den zweiten Energieeinspeisepunkt 2925 von dem fünften Leitungsabschnitt 2914 des Versorgungsleitungsrings 2910 bis 2915 trennen oder wobei den zweiten Energieeinspeisepunkt 2925 mit dem fünften Leitungsabschnitt 2914 des Versorgungsleitungsrings 2910 bis 2915 verbinden. Dieses Trennen bzw. Verbinden hängt typischerweise von dem elektrischen Strom durch die sechzehnte Sicherung 2953 und/oder der elektrischen Spannung des Versorgungsleitungsrings 2910 bis 2915 im Bereich der sechzehnten Sicherung 2953 relativ zu einem Bezugspotenzial und/oder von einem Datenbefehl über den Sicherungsdatenbus 9 ab. Die fünfzehnte Sicherung 2952 und die sechzehnte Sicherung 2953 können eine gemeinsame Steuervorrichtung 4 aufweisen.

Das Versorgungsnetzwerk 2900 umfasst in dem Beispiel der Figur 29 eine fünfte Sicherung 2960 des ersten Verbrauchers 2930. Die fünfte Sicherung 2960 kann mittels ihres Leistungsschalters 17 den ersten Energieentnahmepunkt 2920 von dem ersten Leitungsabschnitt 2910 des Versorgungsleitungsrings 2910 bis 2915 trennen oder den ersten Energieentnahmepunkt 2930 mit dem ersten Leitungsabschnitt 2910 des Versorgungsleitungsrings 2910 bis 2915 verbinden. Dieses Trennen bzw. Verbinden hängt typischerweise von dem elektrischen Strom durch die fünfte Sicherung 2960 und/oder der elektrischen Spannung des Versorgungsleitungsrings (2910 bis 2915) im Bereich der fünften Sicherung 2960 relativ zu einem Bezugspotenzial und/oder von einem Datenbefehl über den Sicherungsdatenbus 9 ab. Die fünfte Sicherung 2960 und die sechste Sicherung 2961 können eine gemeinsame Steuervorrichtung 4 aufweisen.

Das Versorgungsnetzwerk 2900 umfasst in dem Beispiel der Figur 29 eine sechste Sicherung 2961 des ersten Verbrauchers 2930. Die sechste Sicherung 2961 kann mittels ihres Leistungsschalters 17 den ersten Energieentnahmepunkt 2920 von dem zweiten Leitungsabschnitt 2911 des Versorgungsleitungsrings 2910 bis 2915 trennen oder den ersten Energieentnahmepunkt 2930 mit dem zweiten Leitungsabschnitt 2911 des Versorgungsleitungsrings 2910 bis 2915 verbinden. Dieses Trennen bzw. Verbinden hängt typischerweise von dem elektrischen Strom durch die sechste Sicherung 2961 und/oder der elektrischen Spannung des Versorgungsleitungsrings 2910 bis 2915 im Bereich der sechsten Sicherung 2961 relativ zu einem Bezugspotenzial und/oder von einem Datenbefehl über den Sicherungsdatenbus 9 ab. Die fünfte Sicherung 2960 und die sechste Sicherung 2961 können eine gemeinsame Steuervorrichtung 4 aufweisen.

Das Versorgungsnetzwerk 2900 umfasst in dem Beispiel der Figur 29 eine siebte Sicherung 2962 des zweiten Verbrauchers 2931. Die siebte Sicherung 2962 kann mittels ihres Leistungsschalters 17 den zweiten Energieentnahmepunkt 2921 von dem zweiten Leitungsabschnitt 2911 des Versorgungsleitungsrings 2910 bis 2915 trennen oder den zweiten Energieentnahmepunkt 2921 mit dem zweiten Leitungsabschnitt 2911 des Versorgungsleitungsrings 2910 bis 2915 verbinden. Dieses Trennen bzw. Verbinden hängt typischerweise von dem elektrischen Strom durch die siebte Sicherung 2962 und/oder der elektrischen Spannung des Versorgungsleitungsrings 2910 bis 2915 im Bereich der siebten Sicherung 2962 relativ zu einem Bezugspotenzial und/oder von einem Datenbefehl über den Sicherungsdatenbus 9 ab. Die siebte Sicherung 2962 und die achte Sicherung 2963 können eine gemeinsame Steuervorrichtung 4 aufweisen.

Das Versorgungsnetzwerk 2900 umfasst in dem Beispiel der Figur 29 eine achte Sicherung 2963 des zweiten Verbrauchers 2931. Die achte Sicherung 2963 kann mittels ihres Leistungsschalters 17 den zweiten Energieentnahmepunkt 2921 von dem dritten Leitungsabschnitt 2912 des Versorgungsleitungsrings 2910 bis 2915 trennen oder den zweiten Energieentnahmepunkt 2921 mit dem dritten Leitungsabschnitt 2912 des Versorgungsleitungsrings 2910 bis 2915 verbinden. Dieses Trennen bzw. Verbinden hängt typischerweise von dem elektrischen Strom durch die achte Sicherung 2963 und/oder der elektrischen Spannung des Versorgungsleitungsrings 2910 bis 2915 im Bereich der achten Sicherung 2963 relativ zu einem Bezugspotenzial und/oder von einem Datenbefehl über den Sicherungsdatenbus 9 ab. Die siebte Sicherung 2962 und die achte Sicherung 2963 können eine gemeinsame Steuervorrichtung 4 aufweisen.

Das Versorgungsnetzwerk 2900 umfasst in dem Beispiel der Figur 29 eine neunte Sicherung 2964 des dritten Verbrauchers 2932. Die neunte Sicherung 2964 kann mittels ihres Leistungsschalters 17 den dritten Energieentnahmepunkt 2922 von dem dritten Leitungsabschnitt 2912 des Versorgungsleitungsrings 2910 bis 2915 trennen oder den dritten Energieentnahmepunkt 2922 mit dem dritten Leitungsabschnitt 2912 des Versorgungsleitungsrings 2910 bis 2915 verbinden. Dieses Trennen bzw. Verbinden hängt typischerweise von dem elektrischen Strom durch die neunte Sicherung 2964 und/oder der elektrischen Spannung des Versorgungsleitungsrings 2910 bis 2915 im Bereich der neunten Sicherung 2964 relativ zu einem Bezugspotenzial und/oder von einem Datenbefehl über den Sicherungsdatenbus 9 ab. Die neunte Sicherung 2964 und die zehnte Sicherung 2965 können eine gemeinsame Steuervorrichtung 4 aufweisen.

Das Versorgungsnetzwerk 2900 umfasst in dem Beispiel der Figur 29 eine zehnte Sicherung 2965 des dritten Verbrauchers 2932. Die zehnte Sicherung 2965 kann mittels ihres Leistungsschalters 17 den dritten Energieentnahmepunkt 2922 von dem vierten Leitungsabschnitt 2913 des Versorgungsleitungsrings 2910 bis 2915 trennen oder den dritten Energieentnahmepunkt 2922 mit dem vierten Leitungsabschnitt 2913 des Versorgungsleitungsrings 2910 bis 2915 verbinden. Dieses Trennen bzw. Verbinden hängt typischerweise von dem elektrischen Strom durch die zehnte Sicherung 2965 und/oder der elektrischen Spannung des Versorgungsleitungsrings 2910 bis 2915 im Bereich der zehnten Sicherung 2965 relativ zu einem Bezugspotenzial und/oder von einem Datenbefehl über den Sicherungsdatenbus 9 ab. Die neunte Sicherung 2964 und die zehnte Sicherung 2965 können eine gemeinsame Steuervorrichtung 4 aufweisen.

Das Versorgungsnetzwerk 2900 umfasst in dem Beispiel der Figur 29 eine elfte Sicherung 2966 des vierten Verbrauchers 2933. Die elfte Sicherung 2966 kann mittels ihres Leistungsschalters 17 den vierten Energieentnahmepunkt 2923 von dem vierten Leitungsabschnitt 2913 des Versorgungsleitungsrings 2910 bis 2915 trennen oder den vierten Energieentnahmepunkt 2923 mit dem vierten Leitungsabschnitt 2913 des Versorgungsleitungsrings 2910 bis 2915 verbinden. Dieses Trennen bzw. Verbinden hängt typischerweise von dem elektrischen Strom durch die elfte Sicherung 2966 und/oder der elektrischen Spannung des Versorgungsleitungsrings 2910 bis 2915 im Bereich der elften Sicherung 2966 relativ zu einem Bezugspotenzial und/oder von einem Datenbefehl über den Sicherungsdatenbus 9 ab.

Die elfte Sicherung 2966 und die zwölfte Sicherung 2967 können eine gemeinsame Steuervorrichtung 4 aufweisen.

Das Versorgungsnetzwerk 2900 umfasst in dem Beispiel der Figur 29 eine zwölfte Sicherung 2967 des vierten Verbrauchers 2933. Die zwölfte Sicherung 2967 kann mittels ihres Leistungsschalters 17 den vierten Energieentnahmepunkt 2923 von dem fünften Leitungsabschnitt 2914 des Versorgungsleitungsrings 2910 bis 2915 trennen oder den vierten Energieentnahmepunkt 2923 mit dem fünften Leitungsabschnitt 2914 des Versorgungsleitungsrings 2910 bis 2915 verbinden. Dieses Trennen bzw. Verbinden hängt typischerweise von dem elektrischen Strom durch die zwölfte Sicherung 2967 und/oder der elektrischen Spannung des Versorgungsleitungsrings 2910 bis 2915 im Bereich der zwölften Sicherung 2967 relativ zu einem Bezugspotenzial und/oder von einem Datenbefehl über den Sicherungsdatenbus 9 ab. Die elfte Sicherung 2966 und die zwölfte Sicherung 2967 können eine gemeinsame Steuervorrichtung 4 aufweisen.

Das Versorgungsnetzwerk 2900 umfasst in dem Beispiel der Figur 29 eine Log-Tabelle 2970 bzw. Log-Datei für die Fehler und Störungen und ggf. weitere Betriebsparameter. Die Log-Tabelle 2970 bzw. Log-Datei für die Fehler und Störungen und ggf. weitere Betriebsparameter ist bevorzugt eine Log-Tabelle 2970 bzw. eine Log-Datei für die Fehler und Störungen und ggf. weitere Betriebsparameter des übergeordneten Rechnersystems 12.

Das übergeordnete Rechnersystem 12 umfasst bevorzugt einen Zeitgeber 2971 des übergeordneten Rechnersystems 12 zur Synchronisation der anderen Zeitgeber des Versorgungsnetzwerks 2900 und insbesondere zur Synchronisation der Zeitgeber 35 der Steuervorrichtungen 4 der elektronischen Sicherungen im Versorgungsnetzwerk 2900.

Figur 30

Die Figur 30 entspricht der Figur 29 mit dem Unterschied, dass Energiequellen und Verbraucher steckbar sind.

Das Versorgungsnetzwerk 3000 der Figur 30 weist zusätzlich einen ersten Sicherungssteckplatz 3010 für den ersten Verbraucher 2930 mit zwei Sicherungen 2960, 2961 und eine erste Steckverbindung 3020 auf.

Das Versorgungsnetzwerk 3000 der Figur 30 weist zusätzlich einen zweiten Sicherungssteckplatz 3011 für den zweiten Verbraucher 2931 mit zwei Sicherungen 2962, 2963 und eine zweite Steckverbindung 3021 auf.

Das Versorgungsnetzwerk 3000 der Figur 30 weist zusätzlich einen dritten Sicherungssteckplatz 3012 für den dritten Verbraucher 2932 mit zwei Sicherungen 2964, 2965 und eine dritte Steckverbindung 3022 auf.

Das Versorgungsnetzwerk 3000 der Figur 30 weist zusätzlich einen vierten Sicherungssteckplatz 3013 für den vierten Verbraucher 2933 mit zwei Sicherungen 2966, 2967 und eine vierte Steckverbindung 3023 auf.

Das Versorgungsnetzwerk 3000 der Figur 30 weist zusätzlich einen fünften Sicherungssteckplatz 3014 für die erste Energiequelle 2940 mit zwei Sicherungen 2950, 2951 und eine fünfte Steckverbindung 3024 auf.

Das Versorgungsnetzwerk 3000 der Figur 30 weist zusätzlich einen sechsten Sicherungssteckplatz 3015 für die zweite Energiequelle 2941 mit zwei Sicherungen 2952, 2953 und eine sechste Steckverbindung 3025 auf.

Das Versorgungsnetzwerk 3000 der Figur 30 weist zusätzlich eine erste Steckverbindung 3020 mit erstem Stecker und erster Buchse für den Anschluss und die Versorgung des ersten Verbrauchers 2930 auf.

Das Versorgungsnetzwerk 3000 der Figur 30 weist zusätzlich eine zweite Steckverbindung 3021 mit zweitem Stecker und zweiter Buchse für den Anschluss und die Versorgung des zweiten Verbrauchers 2931 auf.

Das Versorgungsnetzwerk 3000 der Figur 30 weist zusätzlich eine dritte Steckverbindung 3022 mit drittem Stecker und dritter Buchse für den Anschluss und die Versorgung des dritten Verbrauchers 2932 auf.

Das Versorgungsnetzwerk 3000 der Figur 30 weist zusätzlich eine vierte Steckverbindung 3023 mit viertem Stecker und vierter Buchse für den Anschluss und die Versorgung des vierten Verbrauchers 2933 auf.

Das Versorgungsnetzwerk 3000 der Figur 30 weist zusätzlich eine fünfte Steckverbindung 3024 mit fünftem Stecker und fünfter Buchse für den Anschluss und die Einspeisung der ersten Energiequelle 2940 auf.

Das Versorgungsnetzwerk 3000 der Figur 30 weist zusätzlich eine sechste Steckverbindung 3025 mit sechstem Stecker und sechster Buchse für den Anschluss und die Einspeisung der zweiten Energiequelle 2941 auf.

Figur 31

Das schematisch und vereinfacht dargestellte Versorgungsnetzwerk 3100 der Figur 31 entspricht im Wesentlichen dem Versorgungsnetzwerk 3000 der Figur 30, wobei nun die Steckverbindungen mit eigenen Sicherungen abgesichert sind.

Eine Versorgungsleitung (2910 bis 2015 und 2920 bis 2923) des Versorgungsnetzwerks 3100 kann vorschlagsgemäß eine Steckverbindung der Steckverbindungen 3020 bis 2023 einen Stecker oder eine Buchse für den Anschluss und die Versorgung eines Verbrauchers der Verbraucher 2930 bis 2033 aufweisen. Eine Versorgungsleitung (2910 bis 2015 und 2924 bis 2925) des Versorgungsnetzwerks 3100 kann eine Steckverbindung der Steckverbindungen 3024 bis 2025 einen Stecker oder eine Buchse für den Anschluss und die Energieeinspeisung einer Energiequelle der Energiequellen 2940 bis 2041 aufweisen. Nun ist vorschlagsgemäß eine elektronische Sicherung der Sicherungen 3110 bis 3113 in der Nähe der Steckverbindung der Steckverbindungen 3020 bis 3023 zur Energieentnahme durch den elektrischen Verbraucher der elektrischen Verbraucher 2930 bis 2933 aus der betreffende Versorgungsleitung (2910 bis 2915 und 2920 bis 2925) eingefügt oder eine elektronische Sicherung der Sicherungen 3110 bis 3113 in der Nähe der Steckverbindung der Steckverbindungen 3020 bis 3023 zur Energieeinspeisung durch die Energiequelle der Energiequellen 2940 bis 2941 in die betreffende Versorgungsleitung (2910 bis 2915 und 2920 bis 2925) eingefügt.

Diese elektronische Sicherung erkennt ein Hot-Plug-Ereignis betreffend diese Steckverbindung der Steckverbindungen (3020 bis 3023) dadurch, dass der Rechnerkern 2 der Steuerungsvorrichtung 4 der elektronischen Sicherung beispielsweise mittels des Analog-zu-Digital-Wandlers 570 der Steuervorrichtung 4 der Sicherung den transienten Zeitverlauf der Spannung des Potenzials eines Knotens des Leistungsschalters 17 dieser Sicherung gegen das Potenzial eines Bezugsknotens 201, insbesondere gegenüber eines Massepotenzials, überwacht. Auch kann der Rechnerkern 2 der Steuervorrichtung 4 der Sicherung beispielsweise mittels des Analog-zu-Digital-Wandlers 570 den transienten Verlauf des Stromes 29 durch den Leistungsschalter 17 dieser elektronischen Sicherung überwachen. Bevorzugt überwacht der Rechnerkern 2 der Steuervorrichtung 4 dieser elektronischen Sicherung diese transienten Verläufe.

Unter einem Hot-Plug-Ereignis versteht das hier vorgelegte Dokument ein Entfernen oder Einstecken einer Energiequelle und/oder eines Verbrauchers im spannungsführenden Zustand einer Seite der Steckverbindung und/oder im stromführenden Zustand der Steckverbindung. Hot Plug beschreibt die Möglichkeit, im Betrieb befindliche und/oder belastete Vorrichtungsteile ohne ein zuvor ausgeführtes Abschaltverfahren für das Vorrichtungsteil und/oder ohne ein zuvor ausgeführtes Konditionierungsverfahren für das Vorrichtungsteil zur Vorbereitung auf den Steckvorgang in das Versorgungsnetzwerk einzufügen oder aus dem Versorgungsnetzwerk zu entnehmen.

Vorzugsweise schaltet der Rechnerkern 2 der Steuervorrichtung 4 dieser elektronischen Sicherung, die ein Hot-Plug-Ereignis an einem ihrer Anschlüsse 18, 19 detektiert, den Leistungsschalter (17) im Falle eines Hot-Plug-Ereignisses aus. Dies verhindert ggf. eine weitere Schädigung des Vorrichtungsteils.

Vorzugsweise meldet der Rechnerkern 2 der Steuervorrichtung 4 dieser elektronischen Sicherung ein solches Hot-Plug-Ereignis über den Datenbus 9 an das übergeordnete Rechnersystem 12. Ggf. bringt das übergeordnete Rechnersystem 12 das gemeldete Hot-Plug-Ereignis auf einem Display oder einem ähnlichen oder funktionsäquivalenten Instrument, beispielsweise einem Terminal 740 zur Anzeige.

Vorzugsweise sind eine oder mehrere elektronische Sicherungen dazu eingerichtet, im Normalbetrieb diesen Normalbetrieb optisch für einen Menschen erkennbar, insbesondere mittels eines Leuchtmittels und/oder einer LED und/oder einer Anzeige und/oder eines Displays eines Datenausgabemittels 740 der Sicherung oder des übergeordneten Rechnersystems 12 und/oder als Dateninformation über den Datenbus 9, zumindest zeitweise und/oder auf Anforderung, insbesondere auf Anforderung des übergeordneten Rechnersystems 12 oder eines Bedienenden 730 mittels des Dateneingabe- und Datenausgabemittels 740 zu signalisieren. Es ist beispielsweise denkbar, dass jede Sicherung eine LED aufweist, die bei ordnungsgemäßem Betrieb grün leuchtet und bei einem Defekt rot leuchtet. Bevorzugt leuchten solche LEDs nur auf Anforderung durch einen Bediener 730, um Energie zu sparen.

Vorzugsweise sind eine oder mehrere elektronische Sicherung dazu eingerichtet, im Falle eines Fehlers und/oder einer Störung und/oder eines Hot-Plug-Ereignisses diesen Fehlers bzw. diese Störung bzw. dieses Hot-Plug-Ereignis optisch für einen Menschen erkennbar, insbesondere mittels eines Leuchtmittels und/oder einer LED und/oder einer Anzeige und/oder eines Displays eines Datenausgabemittels 740 der Sicherung oder des übergeordneten Rechnersystems 12 und/oder als Dateninformation über den Datenbus 9, zumindest zeitweise und/oder auf Anforderung, insbesondere auf Anforderung des übergeordneten Rechnersystems 12 oder eines Bedienenden 730 mittels des Dateneingabe- und Datenausgabemittels 740, zu signalisieren.

Vorzugsweise übermittelt der Rechnerkern 2 der Steuervorrichtung 4 der elektronischen Sicherung im Falle eines Hot-Plug-Ereignisses im Versorgungsnetzwerk 3100 eine Meldung an einen Rechner 710, 750 eines Dienstanbieters und/oder an ein übergeordnetes Rechnersystem 12. Der Rechnerkern 2 der Steuervorrichtung 5 der elektronischen Sicherung kann im Falle eines Hot-Plug-Ereignisses im Versorgungsnetzwerk 3100 eines Fahrzeugs eine Meldung an einen Rechner 710 eines Fahrzeugherstellers oder eines Dienstanbieters unmittelbar oder zeitversetzt übermitteln.

Bevorzugt umfassen Steuervorrichtungen 4 elektronischer Sicherungen des Versorgungsnetzwerks 3100 Uhren oder Zeitgeber 35, insbesondere für die Erstellung von Zeitstempeln für LOG-Tabellen und/oder Log-Dateien. Auch kann das übergeordnete Rechnersystem 12 des Versorgungsnetzwerks eine oder mehrere Uhren oder einen oder mehrere Zeitgeber 1970, insbesondere für die Erstellung von Zeitstempeln für LOG-Tabellen und/oder Log-Dateien, aufweisen. Bevorzugt synchronisiert dann das übergeordnete Rechnersystem 12 vorzugsweise regelmäßig mittels eines Synchronisationssignals, insbesondere über den Datenbus 9, Uhren und/oder Zeitgeber 35, 1970 im Versorgungsnetzwerk 3100.

Vorzugsweise umfasst diese die Synchronisation von Uhren und/oder Zeitgeber 35, 1970 im Versorgungsnetzwerk 3100 ein Rücksetzen auf einen gemeinsamen Startwert dieser Uhren und/oder Zeitgeber 35, 1970.

Bevorzugt umfasst die Synchronisation von Uhren und/oder Zeitgeber 35, 1970 im Versorgungsnetzwerk 3100 eine Korrektur der Frequenz und/oder der Phase der Oszillatoren 30 der Steuervorrichtungen 4 der elektronischen Sicherungen (2950 bis 2953 und 2960 bis 2967 und 3110 bis 3113 und 3120 bis 3121). Bevorzugt synchronisieren sich die Oszillatoren 30 der Steuervorrichtungen 4 der elektronischen Sicherungen (2950 bis 2953 und 2960 bis 2967 und 3110 bis 3113 und 3120 bis 3121) mittels einer jeweiligen PLL der jeweiligen Steuervorrichtung 4 der jeweiligen Sicherung.

Bevorzugt veranlasst ein übergeordnetes Rechnersystem 12 Rechnerkerne 2 von Steuervorrichtungen 4 elektronischer Sicherungen (2950 bis 2953 und 2960 bis 2967 und 3110 bis 3113 und 3120 bis 3121) im Versorgungsnetzwerk mittels eines Befehls über den Datenbus 9 im Broadcasting-Modus an mehrere und/oder alle dieser Sicherungen (2950 bis 2953 und 2960 bis 2967 und 3110 bis 3113 und 3120 bis 3121) dazu, zu gleichen Zeitpunkten bevorzugt gleiche Messungen zu bevorzugt gleichen Zeiten mittels der Messmittel der Steuervorrichtungen 4 der Sicherungen und/oder der Analog-zu-digital-Wandler 570 der Steuervorrichtungen 4 der Sicherungen auszuführen. Hierbei bezieht sich der Begriff "gleiche Zeiten" sich hierbei auf die Gleichheit der Uhrenstände der jeweiligen Uhren und/oder Zeitgeber 35 der verschiedenen Steuervorrichtungen 4 der verschiedenen elektronischen Sicherungen (2950 bis 2953 und 2960 bis 2967 und 3110 bis 3113 und 3120 bis 3121) bezieht.

Das hier vorgelegte Dokument schlägt vor, dass mindestens zwei elektronische Sicherungen (2950 bis 2953 und 2960 bis 2967 und 3110 bis 3113 und 3120 bis 3121) des Versorgungsnetzwerks 3100 ein verteiltes Messverfahren mit synchroner Messung mittels zweier synchronisierten lokaler Uhren 35 durchführen, die sich jeweils innerhalb der jeweiligen Steuervorrichtung 4 der mindestens zwei elektronischen Sicherungen befinden. Das bedeutet, dass der erste Rechnerkern 2 einer ersten Steuervorrichtung 4 einer ersten elektronischen Sicherung und der zweite Rechnerkern 2 einer zweiten Steuervorrichtung 4 einer zweiten elektronischen Sicherung dieser Sicherungen (2950 bis 2953 und 2960 bis 2967 und 3110 bis 3113 und 3120 bis 3121) ein verteiltes Messverfahren mit synchroner Messung vorbestimmter Parameter mittels eines ersten Zeitgebers 35 der Steuervorrichtung 4 der ersten Sicherung und mittels eines zweiten Zeitgebers 35 der Steuervorrichtung 4 der zweiten Sicherung durchführen. Das Versorgungsnetzwerk benutzt dabei die zwei Zeitgeber als zwei synchronisierte lokale Uhren 35. Die dabei erfassten Parameter können beispielsweise der jeweilige Strom 29 durch den jeweiligen Leistungsschalter 17 und die jeweilige Spannung des zweiten Anschlusses 19 der jeweiligen Sicherung gegen ein Bezugspotenzial 201 und die jeweilige Spannung des ersten Anschlusses 18 der jeweiligen Sicherung gegen ein Bezugspotenzial 201 sein.

Vorzugsweise übermitteln die Rechnerkerne 2 der Steuervorrichtungen 4 der Sicherungen, sofern notwendig, die so erfassten Messwerte an ein übergeordnetes Rechnersystem 12 und/oder an einen auswertenden Rechnerkern 2 der Steuervorrichtung 4 einer Sicherung über den Datenbus 9.

Der Rechnerkern 2 einer Steuervorrichtungen 4 einer ersten der elektronischen Sicherungen kann dabei als das übergeordnete Rechnersystem 12 arbeiten. Vorzugsweise sind dabei die erste Sicherung und die zweite Sicherung über einen oder mehrere Versorgungsleitungsabschnitte miteinander verbunden. Das übergeordnete Rechnersystem 12 schließt aus den übermittelten Daten auf einen Parameter des Versorgungsleitungsabschnitts zwischen der ersten elektronischen Sicherung und der zweiten elektronischen Sicherung. Dieser Parameter kann beispielsweise der elektrische Widerstand und/oder die Temperatur des Versorgungsleitungsabschnitts zwischen der ersten elektronischen Sicherung und der zweiten elektronischen Sicherung sein.

Dementsprechend kann das übergeordnete Rechnersystem 12 aus den über den Datenbus 9 übermittelten Daten auf die Temperatur und/oder den elektrischen Widerstand eines oder mehrerer Versorgungsleitungsabschnitte zwischen der ersten elektronischen Sicherung und der zweiten elektronischen Sicherung schließen.

Die Figur 31 zeigt somit ein Versorgungsnetzwerk 3100 mit einer Isolierbarkeit von Leitungsabschnitten 2910 bis 2915 einer und Isolierbarkeit von Verbrauchern 2930 bis 2933 und mit einer Isolierbarkeit von Energiequellen 2940 bis 2941, wobei vorschlagsgemäße Sicherungen diese Isolierbarkeit mittels ihrer Leistungsschalter 17 herstellen.

Das Versorgungsnetzwerk 3100 der Figur 1 umfasst eine siebzehnte Sicherung 3110 des ersten Verbrauchers 2930. Die siebzehnte Sicherung 3110 kann mittels ihres Leistungsschalters 17 den ersten Energieentnahmepunkt 2920 einerseits von dem ersten Verbraucher 2930 bzw. von der ersten Steckverbindung 3020 mit dem ersten Stecker und der ersten Buchse für den Anschluss und die Versorgung des ersten Verbrauchers 2930 andererseits trennen oder den ersten Energieentnahmepunkt 2920 einerseits mit dem ersten Verbraucher 2930 bzw. mit der ersten Steckverbindung 3020 mit dem ersten Stecker und der ersten Buchse für den Anschluss und die Versorgung des ersten Verbrauchers 2930 andererseits verbinden. Dieses Trennen bzw. Verbinden hängt typischerweise von dem elektrischen Strom 29 durch die siebzehnte Sicherung 3110 und/oder der elektrischen Spannung des Versorgungsleitungsrings 2910 bis 2915 im Bereich der siebzehnten Sicherung 3110 bzw. im Bereich der ersten Steckverbindung 3020 relativ zu einem Bezugspotenzial 201 und/oder von einem Datenbefehl über den Sicherungsdatenbus 9 abhängt. Die siebzehnte Sicherung 3110 und die fünfte Sicherung 2960 und die sechste Sicherung 2961 können eine gemeinsame Steuervorrichtung 4 aufweisen;

Das Versorgungsnetzwerk 3100 der Figur 1 umfasst eine achtzehnte Sicherung 3111 des zweiten Verbrauchers 2931. Die achtzehnte Sicherung kann mittels ihres Leistungsschalters 17 den zweiten Energieentnahmepunkt 2921 einerseits von dem zweiten Verbraucher 2931 bzw. von der zweiten Steckverbindung 3021 mit dem zweiten Stecker und der zweiten Buchse für den Anschluss und die Versorgung des zweiten Verbrauchers 2931 andererseits trennen oder den zweiten Energieentnahmepunkt 2921 einerseits mit dem zweiten Verbraucher 2931 bzw. mit der zweiten Steckverbindung 3021 mit dem zweiten Stecker und der zweiten Buchse für den Anschluss und die Versorgung des zweiten Verbrauchers 2931 andererseits verbinden. Dieses Trennen bzw. Verbinden hängt typischerweise von dem elektrischen Strom 29 durch die achtzehnte Sicherung 3111 und/oder der elektrischen Spannung des Versorgungsleitungsrings 2910 bis 2915 im Bereich der achtzehnten Sicherung 3111 bzw. im Bereich der zweiten Steckverbindung 3021 relativ zu einem Bezugspotenzial 201 und/oder von einem Datenbefehl über den Sicherungsdatenbus 9 abhängt. Die achtzehnte Sicherung 3111 und die siebte Sicherung 2962 und die achte Sicherung 2963 können eine gemeinsame Steuervorrichtung 4 aufweisen.

Das Versorgungsnetzwerk 3100 der Figur 1 umfasst eine neunzehnte Sicherung 3112 des dritten Verbrauchers 2932. Die neunzehnte Sicherung 3112 kann mittels ihres Leistungsschalters 17 den dritten Energieentnahmepunkt 2922 einerseits von dem dritten Verbraucher 2932 bzw. von der dritten Steckverbindung 3022 mit dem dritten Stecker und der dritten Buchse für den Anschluss und die Versorgung des dritten Verbrauchers 2932 andererseits trennen oder den dritten Energieentnahmepunkt 2922 einerseits mit dem dritten Verbraucher 2932 bzw. mit der dritten Steckverbindung 3022 mit dem dritten Stecker und der dritten Buchse für den Anschluss und die Versorgung des dritten Verbrauchers 2932 andererseits verbinden. Dieses Trennen bzw. Verbinden hängt typischerweise von dem elektrischen Strom 29 durch die neunzehnte Sicherung 3112 und/oder der elektrischen Spannung des Versorgungsleitungsrings 2910 bis 2915 im Bereich der neunzehnten Sicherung 3112 bzw. im Bereich der dritten Steckverbindung 3022 relativ zu einem Bezugspotenzial 201 und/oder von einem Datenbefehl über den Sicherungsdatenbus 9 ab. Die neunzehnte Sicherung 3112 und die neunte Sicherung 2964 und die zehnte Sicherung 2965 können eine gemeinsame Steuervorrichtung 4 aufweisen.

Das Versorgungsnetzwerk 3100 der Figur 1 umfasst eine zwanzigste Sicherung 3113 des vierten Verbrauchers 2933. Die zwanzigste Sicherung 3113 kann mittels ihres Leistungsschalters 17 den vierten Energieentnahmepunkt 2923 einerseits von dem vierten Verbraucher 2933 bzw. von der vierten Steckverbindung 3023 mit dem vierten Stecker und der vierten Buchse für den Anschluss und die Versorgung des vierten Verbrauchers 2933 andererseits trennen oder den vierten Energieentnahmepunkt 2923 einerseits mit dem vierten Verbraucher 2933 bzw. mit der vierten Steckverbindung 3023 mit dem vierten Stecker und der vierten Buchse für den Anschluss und die Versorgung des vierten Verbrauchers 2933 andererseits verbinden. Dieses Trennen bzw. Verbinden hängt typischerweise von dem elektrischen Strom 29 durch die zwanzigste Sicherung 3113 und/oder der elektrischen Spannung des Versorgungsleitungsrings 2910 bis 2915 im Bereich der zwanzigsten Sicherung 3113 bzw. im Bereich der vierten Steckverbindung 3023 relativ zu einem Bezugspotenzial 201 und/oder von einem Datenbefehl über den Sicherungsdatenbus 9 ab. Die zwanzigste Sicherung 3113 und die elfte Sicherung 2966 und die zwölfte Sicherung 2966 können eine gemeinsame Steuervorrichtung 4 aufweisen;

Das Versorgungsnetzwerk 3100 der Figur 1 umfasst eine einundzwanzigste Sicherung 3120 der ersten Energiequelle 2940. Die einundzwanzigste Sicherung 3120 kann mittels ihres Leistungsschalters 17 den ersten Energieeinspeisepunkt 2924 einerseits von der ersten Energiequelle 2940 bzw. von der fünften Steckverbindung 3024 mit dem fünften Stecker und der fünften Buchse für den Anschluss und die Versorgung der ersten Energiequelle 2940 andererseits trennen oder den fünften Energieentnahmepunkt 2924 einerseits mit der ersten Energiequelle 2940 bzw. mit der fünften Steckverbindung 3024 mit dem fünften Stecker und der fünften Buchse für den Anschluss und die Versorgung der ersten Energiequelle 2940 andererseits verbinden. Dieses Trennen bzw. Verbinden hängt typischerweise von dem elektrischen Strom 29 durch die einundzwanzigste Sicherung 3120 und/oder der elektrischen Spannung des Versorgungsleitungsrings 2910 bis 2915 im Bereich der einundzwanzigsten Sicherung 3120 bzw. im Bereich der fünften Steckverbindung 3024 relativ zu einem Bezugspotenzial 201 und/oder von einem Datenbefehl über den Sicherungsdatenbus 9 ab. Die einundzwanzigste Sicherung 3120 und die dreizehnte Sicherung 2950 und die vierzehnte Sicherung 2951 können eine gemeinsame Steuervorrichtung 4 aufweisen;

Das Versorgungsnetzwerk 3100 der Figur 1 umfasst eine zweiundzwanzigste Sicherung 3121 der zweiten Energiequelle 2941. Die zweiundzwanzigste Sicherung 3121 kann mittels ihres Leistungsschalters 17 den zweiten Energieeinspeisepunkt 2925 einerseits von der zweiten Energiequelle 2941 bzw. von der sechsten Steckverbindung 3025 mit dem sechsten Stecker und der sechsten Buchse für den Anschluss und die Versorgung der zweiten Energiequelle 2941 andererseits trennen oder den sechsten Energieentnahmepunkt 2925 einerseits mit der zweiten Energiequelle 2941 bzw. mit der sechsten Steckverbindung 3025 mit dem sechsten Stecker und der sechsten Buchse für den Anschluss und die Versorgung der zweiten Energiequelle 2941 andererseits verbinden. Dieses Trennen bzw. Verbinden hängt typischerweise von dem elektrischen Strom 29 durch die zweiundzwanzigste Sicherung 3121 und/oder der elektrischen Spannung des Versorgungsleitungsrings 2910 bis 2915 im Bereich der zweiundzwanzigsten Sicherung 3121 bzw. im Bereich der sechsten Steckverbindung 3025 relativ zu einem Bezugspotenzial 201 und/oder von einem Datenbefehl über den Sicherungsdatenbus 9 ab. Die zweiundzwanzigste Sicherung 3121 und die fünfzehnte Sicherung 2952 und die sechzehnte Sicherung 2953 können eine gemeinsame Steuervorrichtung 4 aufweisen;

<u>Figur 32</u>

Figur 32 entspricht in großen Teilen der Figur 11, wobei das Versorgungsnetzwerk 3200 der Figur 32 ein erstes Teilversorgungsnetz 3201 und ein zweites Teilversorgungsnetz 3202 aufweist. In dem Beispiel der Figur 32 soll das erste Teilversorgungsnetz 3201 beispielsweise hohe Spannungswerte größer 50V der Spannung zwischen Versorgungsleitungsabschnitten 3260 bis 3265 des ersten Teilversorgungsnetzes 3201 einerseits und einem Bezugspotenzial 20 und/oder den Versorgungsleitungsabschnitten 3260 bis 3265 des zweiten Teilversorgungsnetzes 3202 andererseits aufweisen. In dem Beispiel der Figur 32 soll das zweite Teilversorgungsnetz 3202 im Gegensatz dazu beispielsweise niedrige Spannungswerte kleiner 50V der Spannung zwischen Versorgungsleitungsabschnitten 3266 bis 3278 des zweiten Teilversorgungsnetzes 3202 einerseits und dem Bezugspotenzial 201 aufweisen.

Das Versorgungsnetzwerk 3200 der Figur 31 umfasst ein erstes Teilversorgungsnetz 3201 des Versorgungsnetzwerks 3200. Das erste Teilversorgungsnetz 3201 weist in dem Beispiel der Figur 32 beispielsweise hohe Spannungswerte größer 50V der Spannung zwischen Versorgungsleitungsabschnitten 3260 bis 3265 des ersten Teilversorgungsnetzes 3201 einerseits und einem Bezugspotenzial 201 oder den Versorgungsleitungsabschnitten 3260 bis 3265 des zweiten Teilversorgungsnetzes 3202 andererseits auf;

Das Versorgungsnetzwerk 3200 der Figur 31 umfasst ein zweites Teilversorgungsnetz 3202 des Versorgungsnetzwerks 3200. Das zweite Teilversorgungsnetz 3202 weist in dem Beispiel der Figur 32 beispielsweise niedrige Spannungswerten kleiner 50V der Spannung zwischen Versorgungsleitungsabschnitten 3266 bis 3278 des zweiten Teilversorgungsnetzes 3202 einerseits und einem Bezugspotenzial 201 auf;

Das Versorgungsnetzwerk 3200 der Figur 31 umfasst eine Betriebsspannung 3206 für die Sicherungen im HV-Versorgungsteilnetz 3201.

Das Versorgungsnetzwerk 3200 der Figur 31 umfasst eine erste Kreuzsicherung 3210 im ersten Versorgungsteilnetz 3201 für Spannungen größer 50V.

Das Versorgungsnetzwerk 3200 der Figur 31 umfasst eine zweite Kreuzsicherung 3211 im ersten Versorgungsteilnetz 3201 für Spannungen größer 50V.

Das Versorgungsnetzwerk 3200 der Figur 31 umfasst eine dritte Kreuzsicherung 3212 im ersten Versorgungsteilnetz 3201 für Spannungen größer 50V.

Das Versorgungsnetzwerk 3200 der Figur 31 umfasst eine vierte Kreuzsicherung 3213 im zweiten Versorgungsteilnetz 3202 für Spannungen kleiner 50V.

Das Versorgungsnetzwerk 3200 der Figur 31 umfasst eine fünfte Kreuzsicherung 3214 im zweiten Versorgungsteilnetz 3202 für Spannungen kleiner 50V.

Das Versorgungsnetzwerk 3200 der Figur 31 umfasst eine sechste Kreuzsicherung 3215 im zweiten Versorgungsteilnetz 3202 für Spannungen kleiner 50V.

Das Versorgungsnetzwerk 3200 der Figur 31 umfasst eine siebte Kreuzsicherung 3216 im zweiten Versorgungsteilnetz 3202 für Spannungen kleiner 50V.

Das Versorgungsnetzwerk 3200 der Figur 31 umfasst eine achte Kreuzsicherung 3217 im zweiten Versorgungsteilnetz 3202 für Spannungen kleiner 50V.

Das Versorgungsnetzwerk 3200 der Figur 31 umfasst eine neunte Kreuzsicherung 3218 im zweiten Versorgungsteilnetz 3202 für Spannungen kleiner 50V.

Das Versorgungsnetzwerk 3200 der Figur 31 umfasst eine erste Energiequelle 3250 im ersten Versorgungsteilnetz 3201 für Spannungen größer 50V.

Das Versorgungsnetzwerk 3200 der Figur 31 umfasst eine zweite Energiequelle 3251 im ersten Versorgungsteilnetz 3201 für Spannungen größer 50V.

Das Versorgungsnetzwerk 3200 der Figur 31 umfasst eine dritte Energiequelle 3252 im zweiten Versorgungsteilnetz 3202 für Spannungen kleiner 50V.

Das Versorgungsnetzwerk 3200 der Figur 31 umfasst eine vierte Energiequelle 3253 im zweiten Versorgungsteilnetz 3202 für Spannungen kleiner 50V.

Das Versorgungsnetzwerk 3200 der Figur 31 umfasst eine fünfte Energiequelle 3254 im zweiten Versorgungsteilnetz 3202 für Spannungen kleiner 50V.

Das Versorgungsnetzwerk 3200 der Figur 31 umfasst eine sechste Energiequelle 3255 im zweiten Versorgungsteilnetz 3202 für Spannungen kleiner 50V.

Das Versorgungsnetzwerk 3200 der Figur 31 umfasst Versorgungsleitungsabschnitte 3260 bis 3265 im ersten Versorgungsteilnetz 3201 für Spannungen größer 50V.

Das Versorgungsnetzwerk 3200 der Figur 31 umfasst Versorgungsleitungsabschnitte 3266 bis 3278 im zweiten Versorgungsteilnetz 3202 für Spannungen kleiner 50V.

Das Versorgungsnetzwerk 3200 der Figur 31 umfasst eine Betriebsspannungsquelle 3280 für den Betrieb der Steuervorrichtungen 4 der elektronischen Sicherungen 405 im ersten HV-Versorgungsteilnetz 3201.

Das Versorgungsnetzwerk 3200 der Figur 31 umfasst einen optischer Datenbus 3290 zur galvanischen Trennung.

Die Figur 32 zeigt somit beispielhaft schematisch ein Versorgungsnetzwerk 3200, wobei das Versorgungsnetzwerk 3200 Versorgungsteilnetze 3202 mit Spannungen kleiner 50V (NV-Netze) und Versorgungsteilnetze 3201 mit Spannungen größer 50V (HV-Netze) aufweist. Das Versorgungsnetz 3200 umfasst einen Datenbus 9 umfasst, der der im Bereich der Spannungs-Domain-Grenzen zwischen Versorgungsteilnetzen 3202 mit Spannungen kleiner 50V einerseits und Versorgungsteilnetzen 3201 mit Spannungen grö-ßer 50V vorzugsweise als optischer Datenbus 3290 ausgeführt ist.

Zumindest sollte das Versorgungsnetz 3200 einen Datenbus 9 umfassen, der der im Bereich der Spannungs-Domain-Grenzen zwischen Versorgungsteilnetzen 3202 mit Spannungen kleiner 50V einerseits und Versorgungsteilnetzen 3201 mit Spannungen größer 50V als Datenbus mit Potenzialtrennung 3290 ausgeführt ist.

Vorzugsweise sind innerhalb einer oder mehrerer Versorgungsleitungen der Versorgungsleitungen (3260, 3262, 3263, 3264) mindestens zwei elektronische Sicherungen (3210, 3211, 3212) kaskadiert, die die Versorgungsleitung (3260, 3262, 3263, 3264) in unterschiedliche Versorgungsleitungsabschnitte (3260, 3262, 3263, 3264) aufteilen.

Figur 33

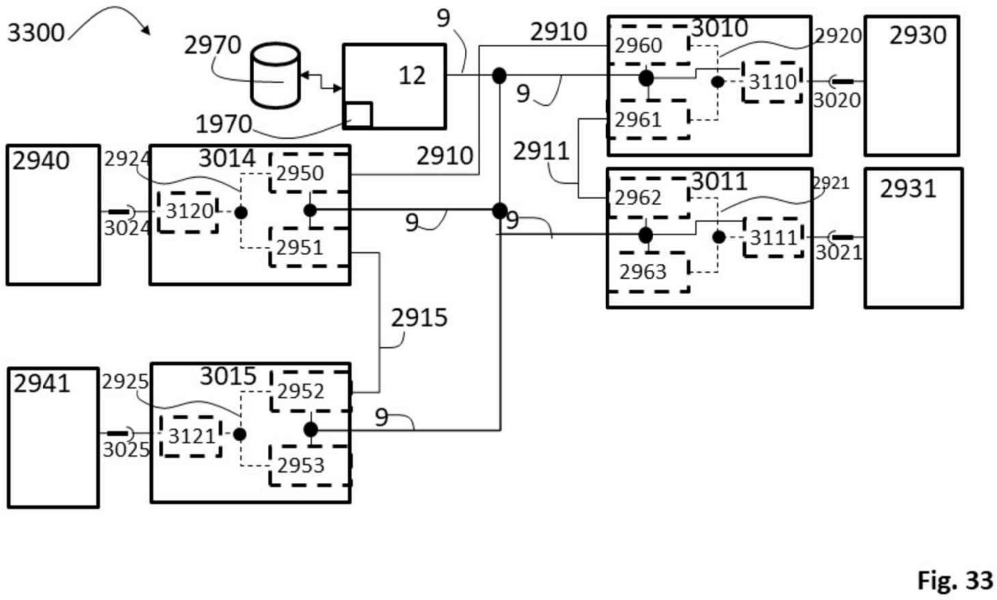

Figur 33 zeigt ein Versorgungsnetzwerk 3300 ähnlich Figur 31 zur Erläuterung der Priorisierung von Verbrauchern und Energiequellen und einer günstigen Topologie des Versorgungsnetzwerks 3300 zur Unterstützung dieser Priorisierbarkeit. Zum Ersten ist der elektrische Anschlusspunkt 2920 eines wichtigeren Verbrauchers 2930 an eine Versorgungsleitung 2910 des Versorgungsnetzwerks 3300 in dem näher zur Energiequelle 2940 liegenden Teil der Versorgungsleitung 2910, 2911 angeordnet, während der elektrische Anschlusspunkt 2921 eines weniger wichtigeren Verbrauchers 2931 an die Versorgungsleitung 2911 in dem weiter von der Energiequelle 2940 liegenden Teil der Versorgungsleitung 2910, 2911 angeordnet ist. Hierdurch kann eine Priorisierung der Energieversorgung mittels Unterbrechung der Versorgungsleitung zwischen einem wichtigen Verbraucher 2930 und einem weniger wichtigen Verbraucher 2931 erfolgen, ohne die Energieversorgung des wichtigen Verbrauchers 2930 zu gefährden. Zu diesem Zweck befindet sich vorzugsweise zwischen dem elektrischen Anschlusspunkt 2920 des wichtigeren Verbrauchers 2930 an die Versorgungsleitung 2910, 2911 und dem elektrischen Anschlusspunkt 2921 des weniger wichtigeren Verbrauchers 2931 an die Versorgungsleitung 2915, 2910, 2911 eine elektronische Sicherung 2961, 2962. Diese jeweilige elektronische Sicherung 2961, 2962 kann dann mit ihrem jeweiligen Leistungsschalter 17 die Energielieferung an den weniger wichtigen Verbraucher 2931 durch eine Unterbrechung der Versorgungsleitung 2915, 2910, 2911 unterbinden. In dem Beispiel der Figur 33 umfass die Kreuzsicherung 3011 noch eine weitere Sicherung 3111, die ebenfalls die Energieversorgung des weniger wichtigen Verbrauchers 2931 mit ihrem Leistungsschalter 17 unterbinden kann.

Der Rechnerkern 2 der Steuervorrichtung 4 einer elektronische Sicherung (2961, 2962) im Versorgungsnetz 2915, 2910, 2911 und/oder die der Rechnerkern 2 der Steuervorrichtung 4 der Sicherung 3111 in der Stichleitung 3021 zum weniger wichtigen Verbraucher 2931 trennen vorzugsweise den weniger wichtigen Verbraucher 2931 und/oder den Versorgungsleitungsabschnitt 2911 des weniger wichtigen Verbrauchers 2931 und/oder die Stichleitung 3021 zur Versorgung des weniger wichtigen Verbrauchers 2931 im Falle eines Fehlers oder einer Störung des weniger wichtigen Verbrauchers 2931 oder im Falle eines Fehlers oder einer Störung des Versorgungsleitungsabschnitts 2911 des weniger wichtigen Verbrauchers 2931 und/oder im Falle eines Fehlers oder einer Störung der Stichleitung 3021 des weniger wichtigen Verbrauchers 2931 vom Versorgungsnetz 2915, 2910, 2911 ab.

Der Vorteil ist, dass dann das Versorgungsnetz den wichtigeren Verbraucher 2930 in dem Fall eines solchen Fehlers oder einer solchen Störung weiter mit elektrischer Energie versorgt.

In Analoger Weise kann das Versorgungsnetzwerk 3300 auch die Energiequellen priorisiert konfigurieren. Zum Zweiten ist daher bevorzugt der elektrische Anschlusspunkt 2924 einer wichtigeren Energiequelle 2940 an eine Versorgungsleitung 2915, 2910, 2911 des Versorgungsnetzwerks 3300 in dem näher zu einem oder mehreren Verbrauchern 2930, 2931 liegenden Teil der Versorgungsleitung 2915, 2910, 2911 angeordnet, während der elektrische Anschlusspunkt 2925 einer weniger wichtigeren Energiequelle 2925 an die Versorgungsleitung 2915, 2910, 2911 in dem weiter von dem einen oder mehreren Verbrauchern 2930, 2931 liegenden Teil der Versorgungsleitung 2915, 2910, 2911 angeordnet ist. Dies stellt die Priorisierbarkeit der Energiequellen sicher. Zwischen dem elektrischen Anschlusspunkt 2924 der wichtigeren Energiequelle 2940 an die Versorgungsleitung 2915, 2910, 2911 und dem elektrischen Anschlusspunkt 2925 der weniger wichtigeren Energiequelle 2941 an die Versorgungsleitung 2915, 2910, 2911 befindet sich bevorzugt eine elektronische Sicherung 2951, 2952. In dem Beispiel der Figur 33 befindet sich eine weitere Sicherung 3121 in der Stichleitung zwischen dem Anschlusspunkt 2925 der weniger wichtigeren Energiequelle 2941 und der weniger wichtigen Energiequelle 2941.

Diese elektronische Sicherung 2951, 2952 kann die weniger wichtige Energiequelle 2941 im Falle eines Fehlers und/oder einer Störung der weniger wichtigen Energiequelle 2941 oder des Versorgungsleitungsabschnitts 2915 der weniger wichtigen Energiequelle 2941 oder der Stichleitung 3025 der weniger wichtigen Energiequelle 2941 von der Versorgungsleitung 2915, 2910, 2911 des Versorgungsnetzes 3300 abtrennen. In einem solchen Fall einer solchen Störung kann das Versorgungsnetz 3300 weiter aus der wichtigeren Energiequelle 2940 elektrischer Energie entnehmen.

Das hier vorgelegte Dokument beschreibt beispielhaft des Weiteren ein Versorgungsnetzwerk 3300, wobei das Versorgungsnetzwerk 3300 zumindest eine Versorgungsleitung 2915, 2910, 2911, einen ersten elektrischen Verbraucher 2930, einen zweiten elektrischen Verbraucher 2931 und eine Energiequelle 2940 umfasst. Der erste elektrische Verbraucher 2930 ist an einem ersten Anschlusspunkt 2920 über eine siebzehnte elektronische Sicherung 3110 an die Versorgungsleitung 2915, 2910, 2911 mittels einer ersten Stichleitung 3020 angeschossen. Der zweite elektrische Verbraucher 2931 ist an einem zweiten Anschlusspunkt 2921 über eine achtzehnte elektronische Sicherung 3111 an die Versorgungsleitung 2915, 2910, 2911 mittels einer zweiten Stichleitung 3021 angeschossen. Der erste Anschlusspunkt 2920 ist von dem zweiten Anschlusspunkt 2921 beabstandet. Der erste Anschlusspunkt 2920 liegt näher an der Energiequelle 2940 als der zweite Anschlusspunkt 2921.

Sofern beide Verbraucher 2930 und 2931 in gleicher Weise empfindlich gegenüber Beschädigungen sind, sollte das Versorgungsnetzwerk 3300 den ersten Verbraucher, da wichtiger, zuletzt abschalten. Der Rechnerkern 2 der Steuervorrichtung 4 der siebzehnten elektronischen Sicherung 3110 zeitlich bezogen auf ein Abschaltereignis schaltet den Leistungsschalter 17 der siebzehnten elektronischen Sicherung 3110 daher dann mit einer zeitlich längeren ersten Verzögerungszeit ab als die Verzögerungszeit, mit der der Rechnerkern 2 der Steuervorrichtung 4 der achtzehnten elektronischen Sicherung 3111 zeitlich bezogen auf ein Abschaltereignis den Leistungsschalter 17 der achtzehnten elektronischen Sicherung 3111 ab.

Sofern beide Verbraucher 2930 und 2931 nicht in gleicher Weise empfindlich gegenüber Beschädigungen sind und der erste Verbraucher 2930 empfindlicher ist, sollte das Versorgungsnetzwerk 3300 den ersten Verbraucher, da wichtiger, zum verbesserten Schutz zuerst abschalten. Der Rechnerkern 2 der Steuervorrichtung 4 der siebzehnten elektronischen Sicherung 3110 zeitlich bezogen auf ein Abschaltereignis schaltet den Leistungsschalter 17 der siebzehnten elektronischen Sicherung 3110 daher dann mit einer zeitlich kürzeren ersten Verzögerungszeit ab als die Verzögerungszeit, mit der der Rechnerkern 2 der Steuervorrichtung 4 der achtzehnten elektronischen Sicherung 3111 zeitlich bezogen auf ein Abschaltereignis den Leistungsschalter 17 der achtzehnten elektronischen Sicherung 3111 ab

Das hier vorgelegte Dokument beschreibt darüber hinaus ein Versorgungsnetzwerk 3300, wobei das Versorgungsnetzwerk 3300 zumindest eine Versorgungsleitung 2915, 2910, 2911, eine erste elektrische Energiequelle 2940, eine zweite elektrische Energiequelle 2941 und einen oder mehrere elektrische Verbraucher 2930, 2931 umfasst. Die erste elektrische Energiequelle 2940 ist an einem ersten Anschlusspunkt 2924 über eine einundzwanzigste Sicherung 3120 an die Versorgungsleitung 2915, 2910, 2911 angeschossen. Die zweite elektrische Energiequelle 2941 ist an einem zweiten Anschlusspunkt 2925 über eine zweiundzwanzigste Sicherung 3121 an die Versorgungsleitung 2915, 2910, 2911 angeschossen. Der erste Anschlusspunkt 2924 ist von dem zweiten Anschlusspunkt 2925 beabstandet. Der erste Anschlusspunkt 2924 liegt näher an dem einen oder den mehreren elektrischen Verbrauchern 2930, 2931 liegt als der zweite Anschlusspunkt 2925. Der Rechnerkern 2 der Steuervorrichtung 4 der einundzwanzigsten elektronischen Sicherung 3120 schaltet zeitlich bezogen auf ein Abschaltereignis den Leistungsschalter 17 der einundzwanzigsten elektronischen Sicherung 3120 mit einer zeitlich längeren Verzögerungszeit ab als die Verzögerungszeit, mit der der Rechnerkern 2 der Steuervorrichtung 4 der zweiundzwanzigsten elektronischen Sicherung 3121 bezogen auf ein Abschaltereignis den Leistungsschalter 17 der zweiundzwanzigsten elektronischen Sicherung 3121 abschaltet.

Figur 34

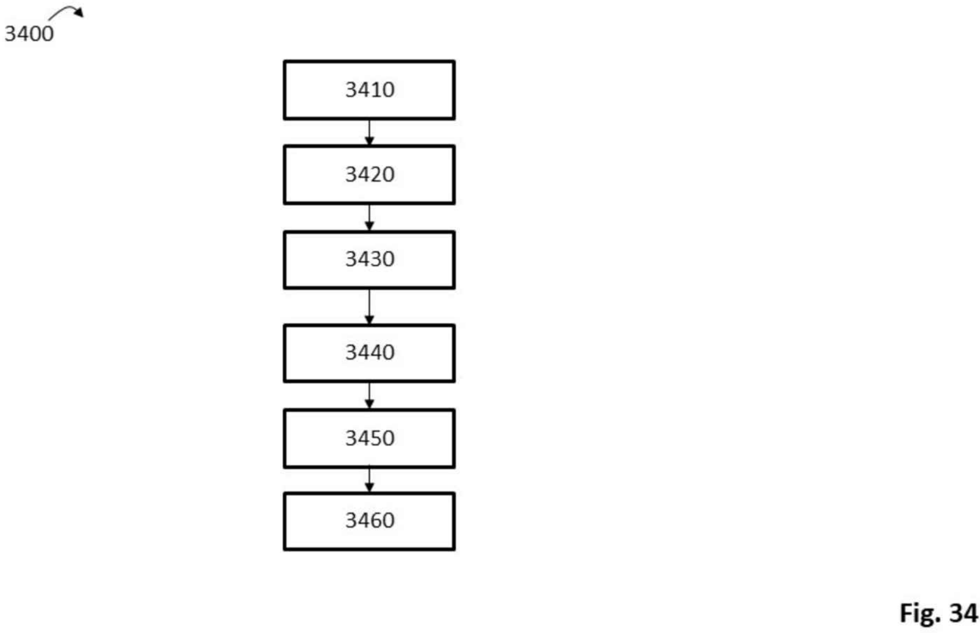

Figur 34 veranschaulicht beispielhaft und vereinfacht ein Verfahren 3400 zum aktiven Power-Management in einem Versorgungsnetzwerk 1100 (siehe Figur 11) mit elektrischen Sicherungen 1110 bis 1118 zur Versorgung elektrischer Verbraucher 1121 bis 1125 in diesem Versorgungsnetzwerk 1100 mit elektrischer Energie aus einer oder mehreren elektrischen Energiequellen 1150 bis 1155. Die in der Figur 11 dargestellten Kreuzsicherungen 1110 bis 1118 umfassen in der Regel vier elektronische Sicherungen. Das hier vorgelegte Dokument referenziert diese Sicherungen trotzdem hier mit den Bezugszeichen 1110 bis 1118 zur Vereinfachung der Darstellung. Das vorgeschlagene Verfahren 3400 umfasst u.a. die folgenden Schritte:

In einem ersten Schritt erfassen 3410 und/oder ermitteln die Rechnerkerne 2 der Steuervorrichtungen 4 der elektronischen Sicherungen die jeweiligen Wert der jeweiligen elektrischen Ströme 29 durch einen oder mehrere ihrer jeweiligen Leistungsschalter 17 einer oder mehrerer jeweiliger elektronischer Sicherungen der Sicherungen 1110 bis 1118 des Versorgungsnetzwerks 1100. Das Erfassen 3410 kann dabei auch die Ermittlung eines jeweiligen Stromwerts eines jeweiligen Hilfsstroms 36 durch einen jeweiligen Shunt-Widerstand 24 der jeweiligen Sicherung bedeuten, wenn der jeweilige Hilfsstrom im Wesentlichen proportional zum jeweiligen Strom 29 durch den jeweiligen Leistungsschalter 17 der jeweiligen Sicherung und/oder wenn der Rechnerkern 2 der Steuervorrichtung 4 der jeweiligen elektronischen Sicherung und/oder ein übergeordnetes Rechnersystem 12 von dem Wert des jeweilige Hilfsstroms mittels eines vorbekannten mathematischen Zusammenhangs auf den jeweiligen Wert des jeweiligen Stroms 29 durch den jeweiligen Leistungsschalter 17 der jeweiligen Sicherung schließen können.

In einem zweiten Schritt erfassen 3420 und/oder ermitteln die jeweiligen Rechnerkerne 2 der Steuervorrichtungen 4 der jeweiligen Sicherungen beispielsweise mittels der jeweiligen Analog-zu-Digital-Wandler 570 der jeweiligen Steuervorrichtungen 4 der jeweiligen Sicherungen die jeweiligen Werte der Spannungsdifferenz zwischen einem oder mehreren Anschlüssen (26, 27, 28) des jeweiligen Leistungsschalters 17 der jeweiligen Sicherung gegen ein Bezugspotenzial (201) eines Bezugspotenzialkontakts.

Vorzugsweise berechnen 3430 in einem dritten Schritt die jeweiligen Rechnerkerne 2 der Steuervorrichtungen 4 der jeweiligen Sicherungen den jeweiligen theoretischen Masseversatz des jeweiligen lokalen Bezugspotenzials 201 an der Steuervorrichtung 4 der jeweiligen Sicherung infolge der jeweiligen lokalen Bestromung der jeweiligen Leistungsschalter 17 der jeweiligen Sicherung. Hierfür nutzen die jeweiligen Rechnerkerne 2 der jeweiligen Steuervorrichtung 4 der jeweiligen Sicherungen vorzugsweise ein Modell mit einer bevorzugt jeweiligen Sicherungsspezifischen Parametrisierung.

In einem fünften Schritt korrigieren 3440 die Rechnerkerne 2 der Steuervorrichtungen 4 der jeweiligen Sicherungen vorzugsweise die jeweiligen Spannungsmesswerte der jeweiligen erfassten Spannungswerte um den berechneten Wert des jeweiligen theoretischen Masseversatzes zu jeweiligen korrigierten Spannungswerten.

Vorzugsweise übertragen die Rechnerkerne 2 der Steuervorrichtungen 4 der Sicherungen ihre jeweiligen korrigierten Spannungswerte an ein übergeordnetes Rechnersystem 12.

Vorzugsweise übertragen die Rechnerkerne 2 der Steuervorrichtungen 4 der Sicherungen ihre jeweiligen Strommesswerte für den jeweiligen Strom 29 durch den jeweiligen Leistungsschalter 17 an ein übergeordnetes Rechnersystem 12.

Vorzugsweise übertragen die Rechnerkerne 2 der Steuervorrichtungen 4 der Sicherungen diese berechneten Werte der jeweiligen theoretischen Masseversätze an ein übergeordnetes Rechnersystem 12.

Vorzugsweise übertragen die Rechnerkerne 2 der Steuervorrichtungen 4 der Sicherungen auch die nicht korrigierten die jeweiligen Spannungsmesswerte der jeweiligen erfassten Spannungswerte an ein übergeordnetes Rechnersystem 12.

Hierdurch kann das übergeordnete Rechnersystem 12 auftretende Fehler im Gesamtsystem erkennen.

Bevorzugt schließen 3450 ein Rechnerkern 2 einer Steuervorrichtung 4 einer Sicherung und/oder das übergeordnete Rechnersystem 12 auf Zustandsparameter von Versorgungsleitungsabschnitten der Versorgungsleitungsabschnitte (3260 bis 3278) des Versorgungsnetzwerks mit Hilfe der so erfassten Parameter wie Stromwerten und Spannungswerten.

Beispielsweise können solche Zustandsparameter eines Versorgungsleitungsabschnitts der Versorgungsleitungsabschnitte 3260 bis 3278, den ein Rechnerkern 2 einer Steuervorrichtung 4 einer elektronischen Sicherung und/oder das übergeordnete Rechnersystem 12 ermitteln, ein Widerstandsbelag eines Versorgungsleitungsabschnitts der Versorgungsleitungsabschnitte 3260 bis 3278 und/oder die Temperatur eines Versorgungsleitungsabschnitts der Versorgungsleitungsabschnitte (3260 bis 3278) sein.

Beispielsweise können ein Rechnerkern 2 einer Steuervorrichtung 4 einer Sicherung und/oder das übergeordnete Rechnersystem 12 eine geschätzte Temperatur eines Versorgungsleitungsabschnitts mit Hilfe eines bekannten Temperaturkoeffizienten des Leitungsmaterials des betreffenden Versorgungsleitungsabschnitts der Versorgungsleitungsabschnitte 3260 bis 3278 und der bekannten Konstruktionsdaten wie z.B. der Länge und des Querschnitts des Versorgungsleitungsabschnitts ermitteln 3460.

Figur 35

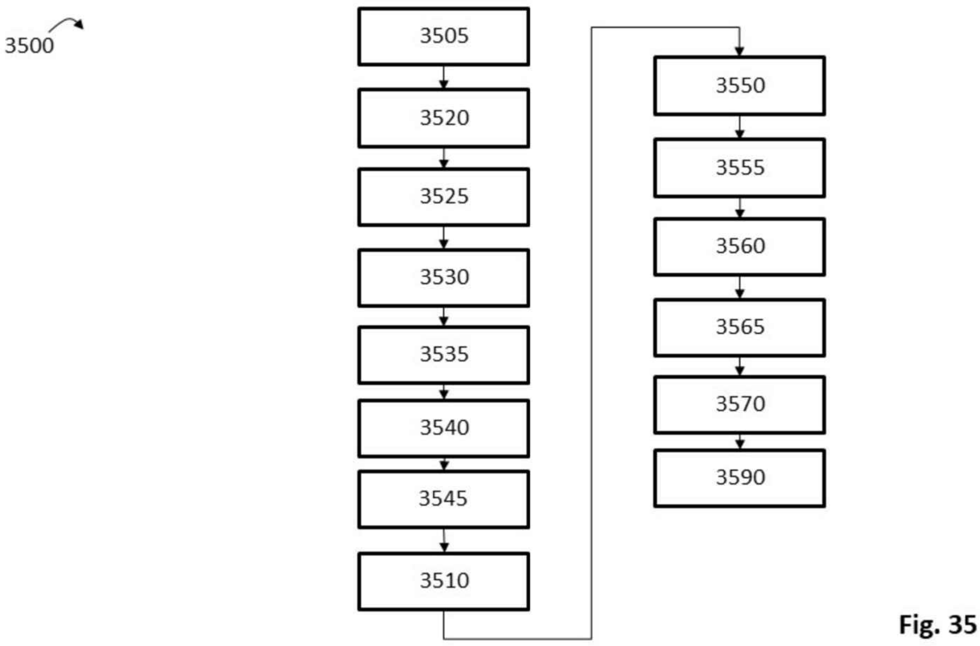

Figur 35 veranschaulicht vereinfacht und schematisch ein Verfahren 3500 zum Betrieb eines Fahrzeugs mit Ausstattungsvarianten, wobei das Aktivieren und Deaktivieren der Ausstattungsvarianten des Fahrzeugs zumindest zum Teil bevorzugt mittels des Versorgungsnetzwerks und mittels der elektronischen Sicherungen und deren Leistungsschalter 17 erfolgt.

Der erste Schritt des vorgestellten Verfahrens umfasst das Bereitstellen 3505 eines Fahrzeugs mit einem Versorgungsnetzwerk 3300 (siehe beispielsweise Figur 33) zur Versorgung elektrischer Verbraucher 2930, 2931 des Fahrzeugs mit elektrischer Energie. Bevorzugt umfasst das Fahrzeug eine oder mehrere Energiequellen 2940, 2941, einen oder mehrere Verbraucher 2930, 2931 und mehrere elektronische Sicherungen 2960 bis 2963 und 2959 bis 2953. Die Versorgungsleitungen 2915, 2910, 2911 verbinden die Verbraucher 2930, 2931mit der einen Energiequelle oder den mehreren Energiequellen 2940, 2941. Vorzugsweise sind die Verbraucher 2930, 2931 und die Energiequellen 2940, 2941 zusammen mit den Versorgungsleitungen 2915, 2910, 2911 in einer Baumstruktur 3300 oder einem Versorgungsnetzwerk miteinander verbunden. Die Baumstruktur umfasst Teilbäume bzw. das Versorgungsnetzwerk umfasst Teilnetzwerke ([2915, 3015, 3025, 2941]; [2940, 3024, 3014, 2910, 3010, 3020, 2930]; [2911, 3011, 2931]). Bevorzugt sind zum Ersten elektronische Sicherungen (2960 bis 2963 und 2959 bis 2953) in Versorgungsleitungen des Versorgungsnetzwerks eingefügt, sodass die Rechnerkerne 2 der Steuervorrichtungen 4 dieser elektronischen Sicherungen (2960 bis 2963 und 2959 bis 2953) mittels ihrer jeweiligen Leistungsschalter 17 jeweilige Teilbäume der Baumstruktur von der restlichen Baumstruktur abtrennen können oder mit dieser restlichen Baumstruktur verbinden können.

Bevorzugt sind zum Zweiten elektronische Sicherungen (2916, 2962, 2951, 2952) in Versorgungsleitungen in das Versorgungsnetzwerk eingefügt sind, sodass die Rechnerkerne 2 der Steuervorrichtungen 4 dieser elektronischen Sicherungen (2960 bis 2963 und 2959 bis 2953) mittels ihrer jeweiligen Leistungsschalter 17 diese jeweiligen Teilnetzwerke ([2915, 3015, 3025, 2941]; [2911, 3011, 3021, 2931]) des Versorgungsnetzwerks 3300 von dem restlichen Versorgungsnetzwerk 3300 abtrennen oder mit diesem restlichen Versorgungsnetzwerk 3300 verbinden können-. In der Folge verfügen diese jeweiligen Teilnetzwerke ([2915, 3015, 3025, 2941]; [2911, 3011, 3021, 2931]) und/oder jeweiligen Teilbäume nach einer jeweiligen Abtrennung im Wesentlichen über keine Energieversorgung und/oder keinen Energieverbrauch mehr.

Mittels Befehlen eines Benutzers 730 über ein Terminal 740 und/oder durch Kommandos eines Servers 710 eines Dienstleistungsanbieters und/oder eines Fahrzeugherstellers oder durch einen anderen Zugriff auf das übergeordnete Rechnersystem 12 und/oder die Rechnerkerne 2 der Steuervorrichtungen 4 von Sicherungen des Versorgungsnetzwerks kann nun eine Programmierung 3510 von bestimmten Ausstattungsvarianten erfolgen.

Hierbei soll sich beispielsweise eine erste Ausstattungsvariante dieser Ausstattungsvarianten des Fahrzeugs sich von einer zweiten Ausstattungsvariante dieser Ausstattungsvarianten des Fahrzeugs unterscheiden.

Beispielsweise kann zumindest der Rechnerkern 2 der Steuervorrichtung 4 einer elektronischen Sicherung dieser elektronischen Sicherungen (2916, 2962, 2951, 2952) einen Teilbaum der Baumstruktur bzw. ein Teilnetzwerk ([2915, 3015, 3025, 2941]; [2911, 3011, 3021, 2931]) des Versorgungsnetzwerks 3300 in der ersten Ausstattungsvariante mittels des Leistungsschalters 17 dieser elektronischen Sicherung von der restlichen Baumstruktur bzw. dem restlichen Versorgungsnetzwerk 3300 abtrennen und in der zweiten Ausstattungsvariante mit der restlichen Baumstruktur bzw. dem restlichen Versorgungsnetzwerk 3300 verbinden. In der Folge versorgt das Versorgungsnetzwerk 3300 diesen Teilbaum bzw. dieses Teilnetzwerk ([2915, 3015, 3025, 2941]; [2911, 3011, 3021, 2931]) des Versorgungsnetzwerks 3300 nur in der zweiten Ausstattungsvariante mit elektrischer Energie der Energiequellen des Versorgungsnetzwerks 3300. Damit können nur in der zweiten Ausstattungsvariante einer oder mehrere elektrische Verbraucher 2931 des betreffenden Teilnetzwerks ([2915, 3015, 3025, 2941]; [2911, 3011, 3021, 2931]) einen elektrischen Energieverbrauch aufweisen, das das Versorgungsnetzwerk 3300 sie nur in dieser zweiten Ausstattungsvariante mit elektrischer Energie über einen geschlossenen Leistungsschalter 17 der betreffenden elektronischen Sicherung versorgt.

Vorzugsweise erfolgt die Programmierung 3510 von bestimmten Ausstattungsvarianten durch Übermittlung von Programmierdaten an die Rechnerkerne 2 der Steuervorrichtungen 4 elektronischer Sicherungen des Versorgungsnetzwerks 3300 über einen Datenbus 9 des Versorgungsnetzwerks 3300.

Vorzugsweise erfolgt diese Kommunikation und/oder Programmierung 3510 mittels einer verschlüsselten Kommunikation über den Steuerdatenbus 9 des Versorgungsnetzwerks 3300 zur Programmierung der Ausstattungsvarianten und/oder zur Kommunikation über den Steuerdatenbus 9. Vorzugsweise erfolgt diese Kommunikation und/oder Programmierung 3510 mittels der verschlüsselten Kommunikation über den Steuerdatenbus 9 des Versorgungsnetzwerks 3300 zur Programmierung der Ausstattungsvarianten und/oder zur Kommunikation über den Steuerdatenbus 9 zur Programmierung der Ausstattungsvarianten nur nach Übertragung eines Passworts an den Rechnerkern 2 der Steuervorrichtung 4 der entsprechenden elektronischen Sicherung.

Vorzugsweise kommuniziert das übergeordnete Rechnersystem 12 und/oder programmiert 3510 das übergeordnete Rechnersystem 12 mittels einer verschlüsselten Kommunikation über den Steuerdatenbus 9 des Versorgungsnetzwerks 3300 zur Programmierung der Ausstattungsvarianten und/oder zur Kommunikation über den Steuerdatenbus 9. Vorzugsweise kommuniziert das übergeordnete Rechnersystem 12 und/oder programmiert 3510 das übergeordnete Rechnersystem 12 mittels der verschlüsselten Kommunikation über den Steuerdatenbus 9 des Versorgungsnetzwerks 3300 zur Programmierung der Ausstattungsvarianten und/oder zur Kommunikation über den Steuerdatenbus 9 zur Programmierung der Ausstattungsvarianten nur nach Übertragung eines Passworts vom übergeordneten Rechnersystem 12 an den Rechnerkern 2 der Steuervorrichtung 4 der entsprechenden elektronischen Sicherung.

Bevorzugt erfolgt somit die Kommunikation zwischen einem Rechnerkern 2 einer Steuervorrichtung 4 einer elektronischen Sicherung und ihrer Umwelt über solche Datenverbindungen über den Datenbus 9 mit einer PQC-Methode kryptografiert. (PQC=post quantum cryptography);

Vorzugsweise kommuniziert ein Server 710 eines Dienstleistungsanbieters und/oder eines Fahrzeugherstellers mit dem übergeordneten Rechnersystem 12 über eine verschlüsselte Datenleitung 720. Bevorzugt nutzen der Server 710 und das übergeordnete Rechnersystem ein PQC-verschlüsseltes Kommunikationsprotokoll. Bevorzugt nutzt das übergeordnete Rechnersystem 12 für die Datenkommunikation über den Datenbus 9 des Versorgungsnetzwerks mit Rechnerkernen 2 von Steuervorrichtungen 4 von Sicherungen des Versorgungsnetzwerks ein PQC verschlüsselte Kommunikationsprotokoll. Vorzugsweise nutzen die Rechnerkerne 2 der Steuervorrichtungen 4 der elektronischen Sicherungen des Versorgungsnetzwerks für die Datenkommunikation über den Datenbus 9 des Versorgungsnetzwerks mit Rechnerkernen 2 von Steuervorrichtungen 4 von Sicherungen des Versorgungsnetzwerks ein PQC verschlüsselte Kommunikationsprotokoll.

Besonders bevorzugt verwenden diese Rechnerkerne 2 und/oder das übergeordnete Rechnersystem 12 und/oder die Server 710, 750 und/oder das Terminal 740 eines oder mehrere der folgenden Verfahren zur PQC-Verschlüsselung:

'BIKE1-L1-CPA', 'BIKE1-L3-CPA', 'BIKE1-L1-FO', 'BIKE1-L3-FO', 'Kyber512', 'Kyber768', 'Kyber1024', 'Kyber512-90s', 'Kyber768-90s', 'Kyber1024-90s', 'LEDAcryptKEM-LT12', 'LEDAcrypt-KEM-LT32', 'LEDAcryptKEM-LT52', 'NewHope-512-CCA', 'NewHope-1024-CCA', 'NTRU-HPS-2048-509', 'NTRU-HPS-2048-677', 'NTRU-HPS-4096-821', 'NTRU-HRSS-701', 'LightSaber-KEM', 'Saber-KEM', 'FireSaber-KEM', 'Baby-Bear', 'BabyBearEphem', 'Mama-Bear', 'MamaBearEphem', 'PapaBear', 'PapaBearEphem', ,FrodoKEM-640-AES', 'FrodoKEM-640-SHAKE', 'FrodoKEM-976-AES', 'FrodoKEM-976-SHAKE', 'FrodoKEM-1344-AES', 'FrodoKEM-1344-SHAKE', 'SIDH-p434', 'SIDH-p503', 'SIDH-p610', ,SIDH-p751', 'SIDH-p434-compressed', 'SIDH-p503-compressed', 'SIDH-p610-compressed', 'SIDH-p751-compressed', 'SIKE-p434', 'SIKE-p503', 'SIKE-p610', 'SIKE-p751', 'SIKE-p434-compressed', 'SIKE-p503-compressed', 'SIKE-p610-compressed', 'SIKE-p751-compressed'.

Besonders bevorzugt verwenden diese Rechnerkerne 2 und/oder das übergeordnete Rechnersystem 12 und/oder die Server 710, 750 und/oder das Terminal 740 eines oder mehrere der folgenden PQC-Signaturverfahren für die Signierung von Datenbotschaften:
'DILITHIUM_2', 'DILITHIUM_3', 'DILITHIUM_4', 'MQDSS-31-48', MQDSS-31-64', SPHINCS+-Haraka-128f-robust', SPHINCS+-Haraka-128f-simple', 'SPHINCS+-Haraka-128s-robust', 'SPHINCS+-Haraka-128s-simple', 'SPHINCS+-Haraka-192f-robust', 'SPHINCS+-Haraka-192f-simple', 'SPHINCS+-Haraka-192s-robust', 'SPHINCS+-Haraka-192s-simple', 'SPHINCS+-Haraka-256f-robust', 'SPHINCS+-Haraka-256f-simple', 'SPHINCS+-Haraka-256s-robust', 'SPHINCS+-Haraka-256s-simple', 'SPHINCS+-SHA256-128f-robust', ,SPHINCS+-SHA256-128f-simple', 'SPHINCS+-SHA256-128s-robust', 'SPHINCS+-SHA256-128s-simple', 'SPHINCS+-SHA256-192f-robust', 'SPHINCS+-SHA256-192f-simple', 'SPHINCS+-SHA256-192s-robust', 'SPHINCS+-SHA256-192s-simple', 'SPHINCS+-SHA256-256f-robust', 'SPHINCS+-SHA256-256f-simple', 'SPHINCS+-SHA256-256s-robust', 'SPHINCS+-SHA256-256ssimple', 'SPHINCS+-SHAKE256-128f-robust', 'SPHINCS+-SHAKE256-128f-simple', 'SPHINCS+-SHAKE256-128s-robust', 'SPHINCS+-SHAKE256-128s-simple', 'SPHINCS+-SHAKE256-192f-robust', 'SPHINCS+-SHAKE256-192fsimple', 'SPHINCS+-SHAKE256-192s-robust', 'SPHINCS+-SHAKE256-192s-simple', 'SPHINCS+-SHAKE256-256f-robust', 'SPHINCS+-SHAKE256-256fsimple', 'SPHINCS+-SHAKE256-256s-robust', 'SPHINCS+-SHAKE256-256s-simple',m'picnic_L1_FS', 'picnic_L1_UR', 'picnic_L3_FS', 'picnic_L3_UR', 'picnic_L5_FS', 'picnic_L5_UR', 'picnic2_L1_FS', 'picnic2_L3_FS', 'picnic2_L5_FS', 'qTesla-p-I', 'qTesla-p-III'.

Die die Aktivierung und/oder die Deaktivierung einer elektronischen Sicherung, also das Einschalten oder Ausschalten des Leistungsschalters 17 der elektronischen Sicherung, erfordert bevorzugt die Übermittlung eines digitalen Passworts von dem Rechnerkern 2 der Steuervorrichtung 4 einer anderen elektronischen Sicherung und/oder vom Rechner 12 eines Steuergeräts, also beispielsweise von dem übergeordneten Rechnersystem 12, und/oder von einem Server 710 eines Dienstleistungsanbieters und/oder Automobilherstellers über einen Datenbus 9 an den Rechnerkern 2 der Steuervorrichtung 4 der elektronischen Sicherung. Bevorzugt verifiziert der Rechnerkern 2 der Steuervorrichtung 4 der elektronischen Sicherung die erhaltenen Passwörter und Kommandos vor ihrer Ausführung. Er prüft dabei bevorzugt auf inhaltliche Korrektheit, beispielsweise, ob die Passwort zu den Kommandos passen und/oder auf Zulässigkeit der Kommandos, beispielsweise ob die richtigen Teilnehmer des Versorgungsnetzwerks auch für das Geben dieser Kommandos zugelassen sind und/oder ob die Teilnehmer des Versorgungsnetzwerks auch die Teilenehmer sind, die sie zu sein vorgeben, und/oder ob die Kommandos in der derzeitigen Nutzungssituation und/oder dem derzeitigen Zustand des Fahrzeugs und/oder des Versorgungsnetzwerks erlaubt und/oder sinnvoll sind. Ist diese Prüfung durch den Rechnerkern 2 der Steuervorrichtung 4 der Sicherung erfolgreich, so führt der Rechnerkern 2 der Steuervorrichtung 4 der Sicherung das Kommando aus.

Es ist Teil des in diesem Dokument vorgestellten Vorschlags, die Versorgungsleitungen des Versorgungsnetzwerks selbst als Leitungen des Datenbusses 9 des Versorgungsnetzwerks zu verwenden. Insbesondere können das Fahrzeug und/oder das Versorgungsnetzwerk und/oder Vorrichtungteile derselben eine Datenkommunikation über die Versorgungsleitungen des Versorgungsnetzwerks als Notlaufkommunikation nutzen, wenn der normale Datenbus 9 gestört ist. Das hier vorgeschlagene Dokument schlägt darüber hinaus vor, eine Versorgungsspannungsleitung 6 zur Versorgung der elektronischen Sicherungen mit elektrischer Energie auch für eine solche Power-Line-Kommunikation als Notlauf des Sicherungsdatenbusses zu nutzen. In dem Fall ist eine solche Versorgungsspannungsleitung 6 ein Teil eines Sicherungsdatenbusses 9. In dem Fall erfolgt die Kommunikation über diesen Datenbus 9 per Power-Line-Kommunikation. Diese Notkommunikation über die Versorgungsspannungsleitung 6 kann eine Kommunikation von mindestens zwei Rechnerkernen 2 mindestens zweier Steuervorrichtungen 4 zweier elektronischer Sicherungen untereinander und/oder zwischen einem Rechnerkern 2 einer Steuervorrichtung 4 einer elektronischen Sicherung einerseits und einem übergeordneten Rechnersystem 12 andererseits über diesen Datenbus 9 sein.

Um Umschalt- und Einschaltströme zu minimieren ist es sinnvoll, wenn nach der Änderung einer Ausstattungsvariante durch Programmierung einer neuen Ausstattungsvariante die Sicherungen, die ihren Schaltzustand für diese Ausstattungsvariantenänderung ändern müssen, also mindestens zwei elektronische Sicherungen, besser alle betroffenen elektronischen Sicherungen zeitversetzt zueinander ihren Schaltzustand wechseln und im Wesentlichen nicht gleichzeitig ihren Schaltzustand wechseln. Beispielsweise kann das übergeordnete Rechnersystem 12 den Rechnerkernen 2 der Steuervorrichtungen 4 dieser betroffenen Sicherungen des Versorgungsnetzwerks signalisieren zu welchem Zeitwert des jeweiligen Zeitgebers 35 der jeweiligen Steuervorrichtung 4 der jeweiligen Sicherung welcher Rechnerkern 2 welcher Steuervorrichtung 4 welcher Sicherung den Schaltzustand welches seiner Leistungsschalter 17 wie ändern soll.

Da das übergeordnete Rechnersystem 12 den Rechnerkernen 2 der Steuervorrichtungen 4 der Sicherungen mitteilen kann zu welchem Zeitpunkt, also Zeitwert ihrer jeweiligen Zeitgeber 35, sie ihren jeweiligen Leistungsschalter 17 in welchen Schaltzustand (geschlossen vs. geöffnet) sie bringen sollen, ist es denkbar, dass das übergeordnete Rechnersystem 12 des Fahrzeugs in vorbestimmten Betriebszuständen eine vordefinierte Sequenz von Ausstattungsvarianten in gewissen zeitlichen Abständen programmiert. Dies bedeutete dann für den einzelnen Rechnerkern 2 einer Steuervorrichtung 4 einer Sicherung, dass das übergeordnete Rechnersystem diesem Rechnerkern 2 der Steuervorrichtung 4 einer Sicherung eine Folge von Schaltzuständen des Leistungsschalters 17 dieser Sicherung vorgibt, wobei das übergeordnete Rechnersystem bevorzugt für jede einzunehmende Ausstattungsvariante einen einzunehmenden Schaltzustand des Leistungsschalters 17 der Sicherung dem Rechnerkern 2 der Steuervorrichtung 4 der Sicherung zusammen mit dem Zeitpunkt, also dem Zeitgeberwert des Zeitgebers 35, vorgibt, zu dem der Rechnerkern 2 der Steuervorrichtung 4 der Sicherung den Leistungsschalter 17 der Sicherung in diesen Zustand bringen soll. Bevorzugt übermittelt das übergeordnete Rechnersystem 12 dem Rechnerkern 2 der Steuervorrichtung 4 der Sicherung 1 nur die Änderungen des Schaltzustands des Leistungsschalters 17 der betreffenden Sicherung und den geplanten Zeitpunkt der Schaltzustandsänderung.

Vorzugsweise überführt nach dem Einschalten des Fahrzeugs das übergeordnete Rechnersystem 12 das Fahrzeug aus dem Park-Zustand in den Fahrzustand durch Programmierung von mindestens zwei Ausstattungsvarianten zu zwei verschiedenen Programmierzeitpunkten in einem von 0s verschiedenen zeitlichen Abstand zwischen den Programmierzeitpunkten. Im Sinne des hier vorgelegten Dokuments sind der Park-Zustand des Versorgungsnetzwerks des Fahrzeugs und der Fahrzustand des Versorgungsnetzwerks des Fahrzeugs Ausstattungsvarianten.

Da die Programmierung einer Sequenz von Ausstattungsvarianten u.U. eine gewisse Zeit erfordert, bestimmt vorzugsweise das übergeordnete Rechnersystem einen Zeitreferenzpunkt, auf den sich die programmierten Schaltzeitpunkte für die Ausstattungsvariantenwechsel beziehen. Hierzu sendet bevorzugt das übergeordnete Rechnersystem 12 den Rechnerkernen 2 der Steuervorrichtungen 4 der betreffenden elektronischen Sicherungen ein Start-Signal vorzugsweise zeitgleich über den Datenbus 9, woraufhin diese die Sequenz der Ausstattungsvarianten für die jeweilige elektronische Sicherung erzeugen und vorzugsweise zeitgerecht einstellen.

Bevorzugt programmiert das übergeordnete Rechnersystem 12 zeitlich vor dem Absetzen des Startsignals zuvor die Werte von Wartezeiten, die die Rechnerkerne 2 Steuervorrichtungen 4 der elektronischen Sicherungen zwischen dem Eintreffen des Startsignals vom übergeordneten Rechnersystem 12 und dem Schließen bzw. Öffnen ihres jeweiligen Leistungsschalters 17 warten sollen in den Speichern der Rechnerkerne 2 der Steuervorrichtungen 4 der Sicherungen und/oder den Speichern der Steuervorrichtungen der Sicherungen.

Vorzugsweise programmieren das übergeordnete Rechnersystem 12 oder ein anderer Rechner 710, 2, diese Werte der Wartezeiten in einen nichtflüchtigen Speicher 14 der Steuervorrichtungen 4 der betreffenden elektronischen Sicherungen ein.

Vorzugsweise erfolgen zumindest Teile dieser Programmierung werksseitig und/oder durch das übergeordnete Rechnersystem 12 und/oder einen anderen Rechner des Fahrzeugs, somit auch durch die Steuervorrichtung (4) einer anderen elektronischen Sicherung, erfolgen:

Das hier vorgelegte Dokument beschreibt u.a. auch ein Verfahren 3500, das zusätzlich vorsieht, das das übergeordnete Rechnersystem 12 und/oder ein Rechnerkern 2 einer Steuervorrichtung 4 einer Sicherung und/oder ein Terminal 740 eines Nutzers 730 (mit Nutzereingabe) und/oder ein anderer Rechner des Fahrzeugs Authentifizierungsdaten an einen Server 710 eines Freischaltcodeanbieters übermitteln 3520.

Vorzugsweise der Server 710 eines Freischaltcodeanbieters oder ein anderer Rechner verifiziert 3525 die an den Server 710 eines Freischaltcodeanbieters übermittelten Authentifizierungsdaten.

Der Server 710 eines Freischaltcodeanbieters und/oder ein Rechner eines Erfüllungsgehilfen des Freischaltcodeanbieters erzeugen 3530 einen Freischaltcodes mit Hilfe von diesen oder anderen Authentifizierungsdaten nach einem feststehenden Verfahren und/oder stellen den erzeugten oder einen bereitgehaltenen Freischaltcode bereit.

Sofern der Freischaltcodeanbieter eine Bezahlung der Freischaltung fordert, erfolgt dann ein Kaufen (3535) eines Freischaltcodes über eine Datenverbindung vom Terminal 740 des Nutzers 730 und/oder vom übergeordneten Rechnersystem 12 und/oder von einem Rechnerkern 2 einer Steuervorrichtung 4 einer Sicherung zu dem Server 710 des Freischaltcodeanbieters.

Vorzugsweise übermitteln das Terminal 740 des Nutzers 730 und/oder das übergeordnete Rechnersystem 12 und/oder von der Rechnerkern 2 der Steuervorrichtung 4 der Sicherung dem Server 710 des Freischaltcodeanbieters die notwendigen Daten zur Durchführung der Abrechnung und die Daten zum Nachweis der Willenserklärung der bezahlenden Person oder Institution für den Vertragsschluss und die Abwicklung des Vertrages.

Sind die Daten für die Vertragsabwicklung korrekt und vollständig und ggf. auch erfolgreich verifiziert, so übermittelt 3540 der Server 710 des Freischaltcodeanbieters den oder die Freischaltcodes an das übergeordnete Rechnersystem 12 des Fahrzeugs und/oder ein oder mehrere Rechnerkerne 2 einer oder mehrerer Steuervorrichtungen 4 einer oder mehrerer Sicherungen des Fahrzeugs und damit an das Fahrzeug. Ggf. protokolliert ein Programm des Terminals 740 des Nutzers 730 diese erfolgreiche Übermittlung eines oder mehrerer Freischaltcodes.

Eine solche Übermittlung kann die Übermittlung (3545) eines oder mehrerer Freischaltcodes für eine oder mehrere Ausstattungsvarianten auf Basis der erhaltenen Freischaltcodes an die Rechnerkerne 2 der Steuervorrichtungen 4 der betroffenen elektronischen Sicherungen durch das übergeordnete Rechnersystem 12 zur Folge haben.

Bevorzugt programmieren 3510 das übergeordnete Rechnersystem 12 und/oder die Rechnerkerne 2 der Steuervorrichtungen 4 der Sicherungen die freigeschalteten Ausstattungsvarianten, wenn die Verifikation dieser Freischaltcodes erfolgreich ist.

Das hier vorgelegte Dokument beschreibt u.a. auch ein Verfahren 3500, das zusätzlich vorsieht, dass die Rechnerkerne 2 der Steuervorrichtungen 4 von Sicherungen der Energie die eine elektronische Sicherung in einem Versorgungsteilzweig ([2915, 3015, 3025, 2941]; [2911, 3011, 3021, 2931]) des Versorgungsbaumes 3300 durchströmt als Messwert der Energiemenge und/oder der zugrundeliegenden Messwerte in der elektronischen Sicherung erfassen 3550 und ermitteln.

Vorzugsweise liest 3555 das übergeordnete Rechnersystem 12 oder ein anderer Rechner des Versorgungsnetzwerks oder des Fahrzeugs Auslesen den Messwert der ermittelten Energiemenge und/oder der zugrundeliegenden Messwerte aus von dem Rechnerkern 2 der Steuervorrichtung der betreffenden elektronischen Sicherung über den Datenbus 9.

Bevorzugt übermittelt 3560 das übergeordnete Rechnersystem 12 den Messwert der ermittelten Energiemenge und/oder die zugrundeliegenden Messwerte über eine Datenübertragungsstrecke 720, die bevorzugt verschlüsselt ist, vom übergeordneten Rechnersystem 12 an einen Rechner 750 eines Dienstleistungsanbieters, beispielsweise einen Energieversorger oder dessen Erfüllungsgehilfen.

Der Dienstleistungsanbieter und/oder einer seiner Erfüllungsgehilfen erstellen 3565 vorzugsweise eine Rechnung auf Basis des übermittelten Messwerts bzw. der übermittelten Messwerte der ermittelten Energiemenge und/oder der zugrundeliegenden Messwerte.

Das hier vorgelegte Dokument schlägt vor die strukturelle und funktionale Integrität des Versorgungsnetzwerks währen und/oder zu Beginn und/oder zu Ende eines Fahrbetriebes des Fahrzeugs zu prüfen.

Hierzu ermittelt 3570 das übergeordnete Rechnersystem 12 die Topologie des Versorgungsnetzwerks unter Nutzung der elektronischen Sicherungen des Versorgungsnetzwerks. Hier kann das übergeordnete Rechnersystem 12 beispielsweise Energiequellen im Versorgungsnetzwerk gezielt zur Einspeisung von Testströmen veranlassen und Verbraucher im Versorgungsnetzwerk gezielt zur Aufnahme dieser Testströme veranlassen. Die Rechnerkerne 2 der Steuervorrichtungen 4 der von diesen Testströmen durchströmten Sicherungen können diese erfassen und die erfassten Strommesswerte an das übergeordnete Rechnersystem 12 signalisieren.

Das übergeordnete Rechnersystem 12 ermittelt auf Basis der von den Rechnerkernen 2 der Steuervorrichtungen 4 der Sicherungen erhaltenen Messwerte eine Topologie des Versorgungsnetzwerkes.

Bevorzugt vergleicht 3575 das übergeordnete Rechnersystem 12 die so ermittelte Topologie des Versorgungsnetzwerks mit der gültigen oder einzustellenden Ausstattungsvariante zur Plausibilisierung der vorliegen Ausstattungsvariante bzw. der Zulässigkeit der ermittelten Topologie des Versorgungsnetzwerks.

Sofern die ermittelte Topologie nicht mit einer zulässigen Topologie übereinstimmt kann das übergeordnete Rechnersystem 12 dies dem Server 710 eines Automobilherstellers und/oder Dienstleistungsanbieters übermitteln. Eine andere mögliche Maßnahme in einem solchen Fall ist, dass das übergeordnete Rechnersystem 12 Versorgungsteilnetzwerke des Versorgungsnetzwerks mittels entsprechender Kommandos an die Rechnerkerne 2 der Steuervorrichtungen 4 entsprechender Sicherungen abschaltet oder sonst wie in ihrer Funktion einschränkt.

Eine weiter Variante des vorgestellten Verfahrens kann das Erfassen von Stromwerten für Ströme 29 durch Leistungsschalter 17 elektronischer Sicherungen durch die Steuervorrichtungen 4 dieser Sicherungen im Versorgungsnetzwerk und das Errechnen oder Bereitstellen von Erwartungswertintervallen für diese Ströme 29 durch diese Leistungsschalter 17 elektronischer Sicherungen im Versorgungsnetzwerk umfassen.

Bevorzugt plausibilisiert das übergeordnete Rechnersystem 12 das Versorgungsnetzwerks mit den Versorgungsleitungen und die Verbraucher und die Energiequellen und die elektronischen Sicherungen durch Vergleich der durch die Steuervorrichtungen 4 der Sicherungen im Versorgungsnetzwerk erfassten Stromwerte mit errechneten bzw. bereitgestellten Erwartungswertintervallen.

Typischerweise schließt das übergeordnete Rechnersystem 12 auf eine Manipulation am Versorgungsnetzwerk und/oder auf eine Manipulation eines elektrischen Verbrauchers im Versorgungsnetzwerk und/oder auf eine Manipulation einer elektrischen Energiequelle im Versorgungsnetzwerk und/oder auf eine Manipulation einer Versorgungsleitung im Versorgungsnetzwerk und/oder auf die Manipulation einer Ausstattungsvariante, wenn die vorbeschriebene Plausibilisierung fehlgeschlagen ist.

Das hier vorgelegte Dokument schlägt darüber hinaus ein Verfahren zur Absenkung des Startstromes (In-Rush-Current) vor. Bevorzugt erfassen die Rechnerkerne 2 der Steuervorrichtungen 4 der Sicherungen mittels der Messmittel dieser Sicherungen die Stromwerte der Start-Ströme im Versorgungsnetzwerk. Bevorzugt sammelt das übergeordnete Rechnersystem 12 diese Stromwerte über den Datenbus 8 von den Rechnerkernen 2 der Steuervorrichtungen 4 der Sicherungen im Versorgungsnetzwerk. Das übergeordnete Rechnersystem 12 veranlasst bevorzugt eine Änderung der Ausstattungsvariante zu einer mit einer Ausstattungsvariante mit erhöhter Stromaufnahme anderer Verbraucher, wenn nach dem Verstreichen einer Wartezeit der Betrag des Startstroms unter einem Schwellwert liegt.

Bevorzugt beginnt das übergeordnete Rechnersystem 12 also mit einer Ausstattungsvariante, in der bevorzugt im Wesentlichen das Versorgungsnetzwerk denjenigen Verbraucher, der den In-Rush-Current verursacht, präferiert mit elektrischer Energie versorgt. Das Versorgungsnetzwerk versorgt Verbraucher mit niedriger Priorität dann vorzugsweise nicht oder in geringerem Umfang zu Beginn mit elektrischer Energie.

Figur 36

Figur 36 soll mögliche Pegel eines Datenprotokolls auf dem Datenbus 9 des Versorgungsnetzwerks 200 darstellen. In dem Beispiel der Figur 36 sei der Datenbus 9 ein bidirektionaler und differenzieller Datenbus 9, der einen ersten Eindrahtdatenbus und einen zweiten Eindrahtdatenbus umfass. Die Information wird bevorzugt mittels der Spannungsdifferenz zwischen dem elektrischen Potenzial des ersten Eindrahtdatenbusses minus des zweiten elektrischen Eindrahtdatenbusses übertragen. Dies hat den Vorteil, dass sich ein ggf. als Common-Mode-Störung auswirkender Massenversatz nicht auf die übertragenen Daten auswirkt. Das übergeordnete Rechnersystem 12 verfügt in seiner bevorzugten Rolle als Busmaster über einen ersten Treiber mit dem er den ersten Eindrahtdatenbus des differentiellen Datenbusses 9 in einen ersten Zustand Z1 oder einen zweiten Zustand Z2 oder einen dritten Zustand Z3 bringen kann. Ein erster Treiber kann als CAN-Treiber bevorzugt zwei von drei erlaubten Zuständen einnehmen: In einem ersten Zustand legt er einen ersten logischen Pegel Z1 auf den ersten Eindrahtdatenbus des differentiellen, bidirektionalen Datenbusses 9. In einem zweiten Zustand legt er einen dritten logischen Pegel Z3 auf den ersten Eindrahtdatenbus des differentiellen, bidirektionalen Datenbusses 9. Der erste Treiber des übergeordneten Rechnersystems 12 arbeitet außerdem im Adressierungszustand des Datenbussystems und der Rechnerkerne 2 der Steuervorrichtungen 4 der elektronischen Sicherungen des Versorgungsnetzwerks 200 bevorzugt als erste Stromsenke für die ersten Adressierungsströme der ersten Adressierungsstromquellen der Datenschnittstellen 10 der Steuervorrichtungen 4 der elektronischen Sicherungen. (In den Figuren 2 und 3 wären diese die elektronischen Sicherungen 214 bis 217 und 225 bis 225 und 235 bis 238 und255 und 256). Bevorzugt nimmt der erste Treiber der Datenschnittstelle 10 der Steuervorrichtung 4 einer elektronischen Sicherung bzw. des übergeordneten Rechnersystem 12 den ersten Zustand Z1 an, wenn der zweite Treiber der betreffenden Datenschnittstelle 10 der betreffenden Steuervorrichtung 4 der betreffenden Sicherung den zweiten Zustand Z2 annimmt. Hierdurch wird das Signal mit einem ersten differentiellen Pegel z1 differentiell auf dem differentiellen und bidirektionalen Datenbus 9 eingeprägt. Bevorzugt nimmt der erste Treiber einer Datenschnittstelle 10 einer Steuervorrichtung 4 einer Sicherung des Versorgungsnetzwerks 200 bzw. der übergeordneten Rechnereinheit 12 den dritten Zustand Z3 an, wenn der zweite Treiber der betreffenden Datenschnittstelle 10 der betreffenden Steuervorrichtung 4 der betreffenden elektronischen Sicherung des Versorgungsnetzwerks 200 den dritten Zustand Z3 annimmt. Hierdurch wird das Signal mit einem dritten differentiellen Pegel z3 differentiell eingeprägt.

Der erste Treiber kann auch als RS485-Treiber bevorzugt zwei von zwei erlaubten Zuständen einnehmen: In einem ersten Zustand legt er einen ersten logischen Pegel Z1 auf den ersten Eindrahtdatenbus. In einem zweiten Zustand legt er einen zweiten logischen Pegel Z2 auf den ersten Eindrahtdatenbus. Der erste Treiber des übergeordneten Rechnersystems 12 arbeitet außerdem im Adressierungszustand des Datenbussystems und der Sicherungen als erste Stromsenke für die ersten Adressierungsströme der Adressierungsstromquellen der Datenschnittstellen 10 der Steuervorrichtungen 4 der Sicherungen des Versorgungsnetzwerks 200 und deren Ruheströme. Bevorzugt nimmt der erste Treiber einer Datenschnittstelle 10 einer Steuervorrichtung 4 einer Sicherung des Versorgungsnetzwerks 200 bzw. des übergeordneten Rechnersystems 12 den ersten Zustand Z1 an, wenn der zweite Treiber der betreffenden Datenschnittstelle 10 den zweiten Zustand Z2 annimmt. Hierdurch wird das Signal mit einem ersten differentiellen Pegel z1 differentiell auf dem differenziellen, bidirektionalen Datenbus 9 eingeprägt. Bevorzugt nimmt der erste Treiber einer Datenschnittstelle 10 bzw. des übergeordneten Rechnersystems 12 den zweiten Zustand Z2 an, wenn der zweite Treiber der betreffenden Datenschnittstelle 10 bzw. des übergeordneten Rechnersystems 12 den ersten Zustand Z1 annimmt. Hierdurch wird das Signal mit einem zweiten differentiellen Pegel z2 differentiell eingeprägt. Außerdem verfügt der erste Treiber typischerweise über eine Teilvorrichtung zur Detektion und Vermeidung einer Buskollision im Falle eines gleichzeitigen Zugriffs auf den ersten Eindrahtdatenbus durch einen ersten Treiber einer anderen Datenbusschnittstelle 10 einer anderen Sicherung bzw. des übergeordneten Rechnersystems 12.

Ein zweiter Treiber kann als CAN-Treiber als Treiber einer Datenschnittstelle 10 bzw. des übergeordneten Rechnersystems 12 bevorzugt zwei von drei erlaubten Zuständen einnehmen: In einem ersten Zustand legt er einen zweiten logischen Pegel Z2 auf den zweiten Eindrahtdatenbus. In einem zweiten Zustand legt er einen dritten logischen Pegel Z3 auf den zweiten Eindrahtdatenbus. Der zweite Treiber des übergeordneten Rechnersystems 12 arbeitet außerdem im Adressierungszustand des Datenbussystems und der Datenschnittstellen 10 der Sicherungen als zweite Stromsenke für die zweiten Adressierungsströme der zweiten Adressierungsstromquellen der Datenschnittstellen der Sicherungen und deren zweite Ruheströme. Bevorzugt nimmt der zweite Treiber einer Datenschnittstelle 10 einer Steuervorrichtung 4 einer Sicherung bzw. des übergeordneten Rechnersystems 12 den zweiten Zustand Z2 an, wenn der erste Treiber der betreffenden Datenschnittstelle 10 der betreffenden Steuervorrichtung 4 der betreffenden Sicherung den ersten Zustand Z1 annimmt. Hierdurch wird das Signal mit einem ersten differentiellen Pegel z1 differentiell eingeprägt. Bevorzugt nimmt der zweite Treiber einer Datenschnittstelle 10 einer Sicherung bzw. des übergeordneten Rechnersystems 12 den dritten Zustand Z3 an, wenn der erste Treiber der betreffenden Datenschnittstelle 10 der betreffenden Steuervorrichtung 4 der betreffenden Sicherung den dritten Zustand Z3 annimmt. Hierdurch wird das Signal mit einem dritten differentiellen Pegel z3 differentiell eingeprägt.

Der zweite Treiber kann auch als RS485-Treiber bevorzugt zwei von zwei erlaubten Zuständen einnehmen: In einem ersten Zustand legt er einen zweiten logischen Pegel Z2 auf den ersten Eindrahtdatenbus. In einem zweiten Zustand legt er einen ersten logischen Pegel Z1 auf den zweiten Eindrahtdatenbus. Der zweite Treiber des übergeordneten Rechnersystems 12 arbeitet außerdem im Adressierungszustand des Datenbussystems und der Datenschnittstellen 10 der Steuervorrichtungen 4 der Sicherungen des Versorgungsnetzwerks 200 als zweite Stromsenke für die zweiten Adressierungsströme der zweiten Adressierungsstromquellen der Datenbusschnittstellen 10 der Steuervorrichtungen 4 der Sicherungen und deren zweite Ruheströme. Bevorzugt nimmt der zweite Treiber einer Datenbusschnittstelle 10 einer Steuervorrichtung 4 einer Sicherung bzw. des übergeordneten Rechnersystems 12 den zweiten Zustand Z2 an, wenn der erste Treiber der betreffenden Datenbusschnittstelle 10 der betreffenden Steuervorrichtung 4 der betreffenden Sicherung den ersten Zustand Z1 annimmt. Hierdurch wird das Signal mit einem ersten differentiellen Pegel z1 differentiell auf dem Datenbus 9 eingeprägt. Bevorzugt nimmt der zweite Treiber einer Datenschnittstelle 10 einer Steuervorrichtung 4 einer Sicherung bzw. des übergeordneten Rechnersystems 12 den ersten Zustand Z1 an, wenn der erste Treiber der betreffenden Datenschnittstelle 10 der betreffenden Steuervorrichtung 4 der betreffenden Sicherung den zweiten Zustand Z2 annimmt. Hierdurch wird das Signal mit einem zweiten differentiellen Pegel z2 differentiell auf dem Datenbus 9 eingeprägt.

Außerdem verfügt der zweite Treiber typischerweise über eine Teilvorrichtung zur Detektion und Vermeidung einer Buskollision im Falle eines gleichzeitigen Zugriffs auf den ersten Eindrahtdatenbus durch einen zweiten Treiber einer anderen Datenbusschnittstelle 10 einer anderen Steuervorrichtung 4 einer anderen Sicherung bzw. des übergeordneten Rechnersystems 12.

Figur 37

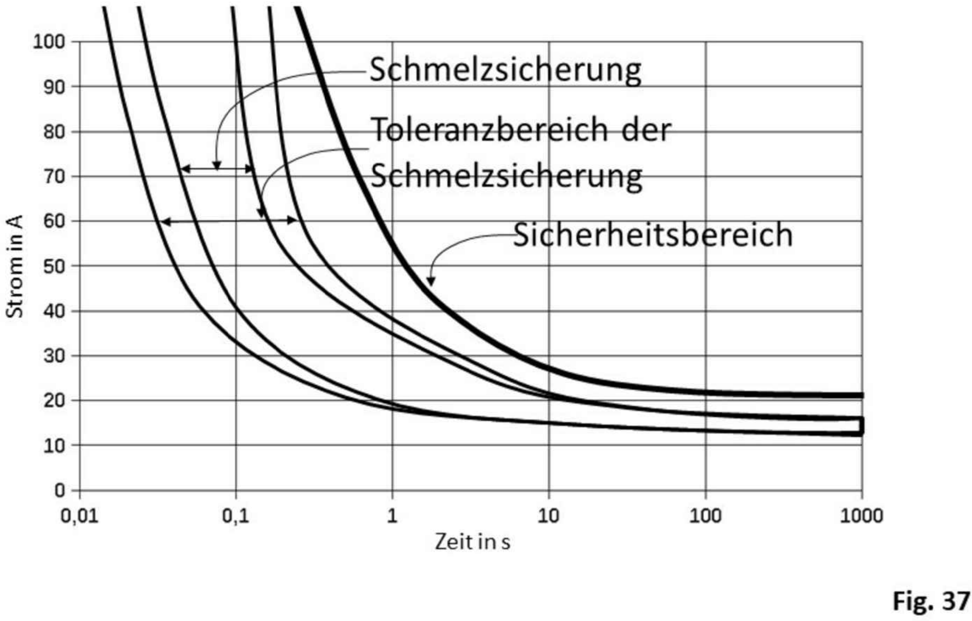

Figur 37 zeigt die heutige Absicherung des Kabels eines Versorgungsleitungsabschnitts.

Figur 38

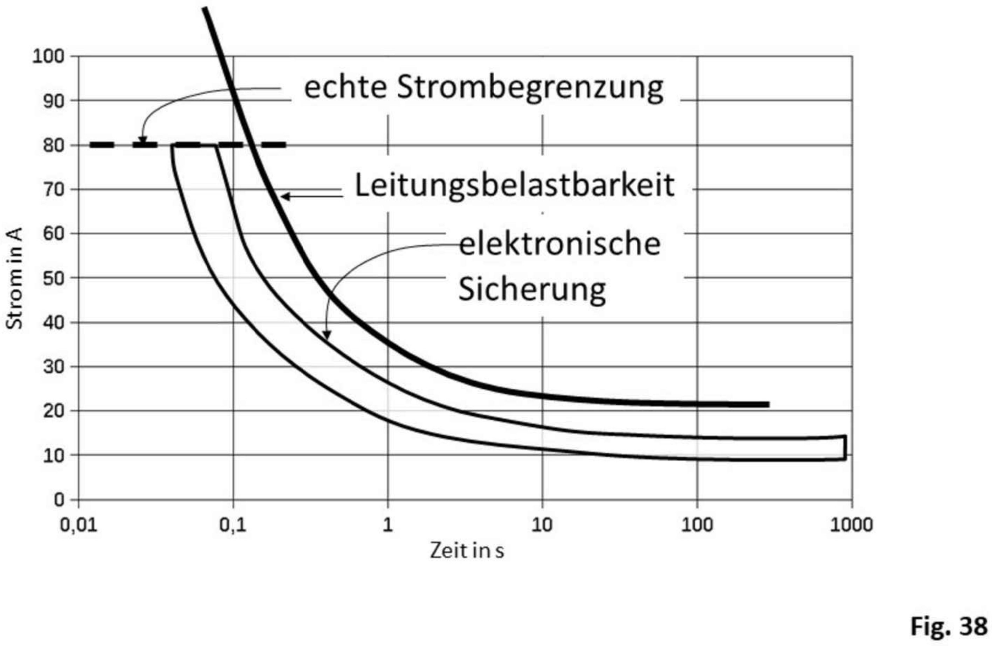

Figur 38 zeigt die Vorteile einer Absicherung eines Versorgungsleitungsabschnitts mit einer elektronischen Sicherung;

Figur 39

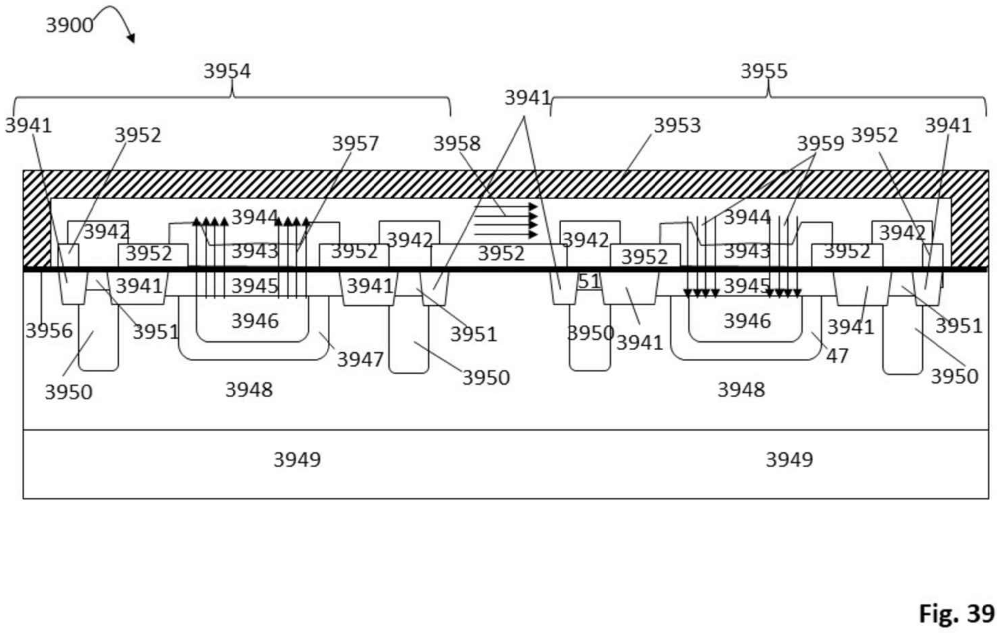

Figur 39 zeigt die Kombination zweier vorschlagsgemäßer SPAD-Dioden im Querschnitt.

Der Halbleiterkristall der Steuervorrichtung 4 der Sicherung 1 weist bevorzugt zumindest eine erste SPAD-Diode 5394 und zumindest eine zweite SPAD-Diode 3955 und zumindest einen optischen Lichtwellenleiter 3944 auf. Der Quantenzufallszahlengenerator 4100, 60 ist bevorzugt ein quantenprozessbasierender Generator für echte Zufallszahlen (QRNG) 60. Der quantenprozessbasierende Generator für echte Zufallszahlen (QRNG) 60 umfasst bevorzugt eine erste SPAD-Diode 3954 als Lichtquelle für ein optisches Quantensignal und eine zweite SPAD-Diode 3955 als Fotodetektor für das optische Quantensignal. Des Weiteren umfasst der quantenprozessbasierende Generator für echte Zufallszahlen (QRNG) 60 bevorzugt zumindest die Verarbeitungsschaltung und den optische Lichtwellenleiter 3944. Bevorzugt koppelt der zumindest eine optische Lichtwellenleiter 3944 die zumindest eine erste SPAD-Diode 3954 mit der zumindest einen zweiten SPAD-Diode 3955 optisch. Eine Betriebsschaltung versorgt die erste SPAD-Diode 3954 in der Art mit elektrischer Energie, dass die erste SPAD-Diode 3954 Licht emittiert. Die Abstrahlung von Licht erfordert dabei, dass die Betriebsspannung eine ausreichende elektrische Vorspannung der ersten SPAD-Diode 354 (4104.1) zur Verfügung stellt. Eine Verarbeitungsschaltung (4102, 4103, 4104) erfasst das Signal der zweiten SPAD-Diode 3955 (4104.3) und bildet daraus die Zufallszahl. Die Verarbeitungsschaltung stellt dann bevorzugt die so gebildete Zufallszahl einem oder mehreren der einen oder mehreren Prozessoren, insbesondere dem Rechnerkern 2 der Steuervorrichtung 4 der Sicherung 1, über einen Datenbus 11 zur Verfügung.

Bevorzugt weist der Halbleiterkristall der Steuervorrichtung 4 der Sicherung 1 eine Oberfläche 3956 auf. Typischerweise weist der Halbleiterkristall ein halbleitendes Material unterhalb seiner Oberfläche 3956 auf. Insbesondere bei der Anwendung konventioneller Halbleiterschaltungsherstellprozesse, wie CMOS-Prozessen, Bipolarprozessen und BiCMOS-Prozessen weist die Oberfläche 3956 des Halbleiterkristalls typischerweise einen Metallisierungsstapel als strukturierten Metallschichten und elektrischen Isolationsschichten auf. Die strukturierten Metallschichten bilden dabei typischerweise die Leiterbahnen, die durch die Isolationsschichten voneinander elektrisch getrennt sind. Somit weist der Metallisierungsstapel eine typischerweise strukturierte und optisch transparente und elektrisch isolierende Schicht 3944 auf. Zumindest ein Teil dieser typischerweise strukturierten, transparenten und elektrisch isolierenden Schicht 3944 der Oberfläche 3956 bildet bevorzugt den optischen Lichtwellenleiter 3944. Die erste SPAD-Diode 3954 strahlt typischerweise aus dem halbleitenden Material des Halbleitersubstrats in diesen optischen Lichtwellenleiter 3944 Licht 3957 ein. D. h. in der Regel strahlt die erste SPAD-Diode 3954 im Gegensatz zum Stand der Technik senkrecht zur Oberfläche 3956 im Wesentlichen nach oben und nicht zur Seite in das Halbleitersubstrat des Halbleiterkristalls hinein, das eine hohe Dämpfung aufweist. Trotzdem ist die Abstrahlung der Photonen 3957 der ersten SPAD-Diode 5394 im Lichtwellenleiter 3944 nicht gerichtet. Insbesondere ist die Ausstrahlung über das Substrat 3948, 3949 sehr gedämpft, da sichtbares Licht eine sehr hohe Absorption besitzt. Hierdurch kann die Vorrichtung mehr Photonen der ersten SPAD-Diode 3954 direkt mit der zweiten SPAD-Diode 5395 koppeln. Der optische Lichtwellenleiter 3944 transportiert diese Photonen 3957, 3958, 3959 der ersten SPAD-Diode 3954 im Lichtwellenleiter 3944 im Vergleich zum Stand der Technik praktisch verlustfrei zur zweiten SPAD-Diode 3955. Der Lichtwellenleiter 4394 bestrahlt mit diesen Photonen 3957, 5398, 3959 der ersten SPAD-Diode 5394 die zweite SPAD-Diode 3955 in der Art, dass das Licht 5399 von innerhalb des Lichtwellenleiters 3944 wieder in das halbleitende Material des Halbleitersubstrats von der Oberfläche 3956 aus eindringt und dort Vorrichtungteile der zweiten SPAD-Diode 3955 trifft. Die zweite SPAD-Diode 3955 erzeugt dann in Abhängigkeit von der Bestrahlung mit diesen Photonen 59 ein Empfangssignal.

Typischerweise versorgt zumindest eine Betriebsschaltung die zumindest eine erste SPAD-Diode 3954 zumindest zeitweise mit elektrischer Energie. Die zumindest eine erste SPAD-Diode 3954 speist dann bei Versorgung mit ausreichender elektrischer Energie Photonen 3957 in den zumindest einen Lichtwellenleiter 3944 ein. Der Lichtwellenleiter 3944 transportiert diese Photonen 3957, 3958, 3959 dann weiter. Der zumindest eine Lichtwellenleiter 3944 strahlt dann die transportierten Photonen 3958 als im Wesentlichen senkrecht sich bewegende Photonen 3959 in die zweite SPAD-Diode 3955 ein. Da dieser Transport der Photonen von der ersten SPAD-Diode 3954 zur zweiten SPAD-Diode 3955 aufgrund der geringen Dämpfung im Lichtwellenleiter 3944 wesentlich weniger Photonen verliert als in der Konstruktion aus dem Stand der Technik, die das stark absorbierende Halbleitersubstrat 3949, 3948 benutzt, ist der Quantenwirkungsgrad massiv höher. Damit steigt die Bit-Rate, mit der die Vorrichtung Zufallszahlen erzeugen kann, an. Daher reicht bei der hier vorgestellten Konstruktion bereits ein Paar aus einer einzigen ersten SPAD-Diode 3954 und einer einzigen zweiten SPAD-Diode 3955 aus. Der Stand der Technik verwendet immer mehrere SPAD-Dioden.

Figur 40

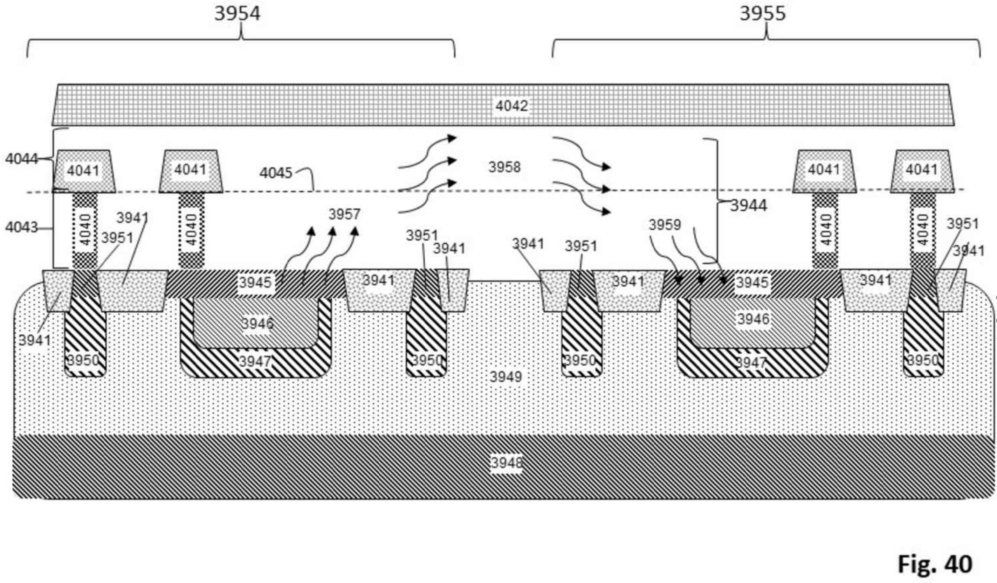

Figur 40 zeigt die Kombination zweier vorschlagsgemäßer SPAD-Dioden im Querschnitt, wobei nun mehrere Isolationslagen den Lichtwellenleiter 3944 ausbilden.

Figur 40 entspricht im Wesentlichen der Figur 39. Im Unterschied zur Figur 39 ist der Halbleiterkristall 3948 und die epitaktische Schicht 3949 nun mit einer ersten optisch transparenten Isolationsschicht, beispielsweise einer Oxidschicht 4043 bedeckt. Die Durchkontaktierungen 4040 sind mit Metall elektrisch leitend gefüllt. Die Metallisierungsebene 1 mit den elektrischen Leitungen der ersten Verdrahtungsebene 4041 kontaktieren diese Durchkontaktierungen 4040. Auf dieser ersten Isolationsschicht 4042 und der ersten Metallisierungslage mit der ersten Verdrahtungsebene 4041 ist eine zweite optisch transparente Isolationsschicht 4044, vorzugsweise ebenfalls in Form einer Oxidschicht, aufgebracht. Auch diese kann durch Durchkontaktierungen, die in der Figur 7 nicht eingezeichnet sind, durchkontaktiert sein, sodass Leitungen der ersten Metallisierungsebene mit Leitungen der zweiten Metallisierungsebene verbunden werden können. Die gestrichelt eingezeichnete Grenzfläche 4045 zwischen der ersten optisch transparente Isolationsschicht 4043 und der zweiten optisch transparente Isolationsschicht 4044 ist im Wesentlichen ebenfalls optisch transparent und reflektiert und/oder absorbiert das Licht der ersten SPAD-Diode 3955 im Wesentlichen bevorzugt nicht. Die erste optisch transparente Isolationsschicht 4043 und die zweite optisch transparente Isolationsschicht 4044 bilden im Wesentlichen den optischen Wellenleiter (Lichtwellenleiter) im Bereich der ersten SPAD-Diode 3954 und der zweiten SPAD-Diode 3955. Im optischen Pfad zwischen der ersten SPAD-Diode 3954 und der zweiten SPAD-Diode 3955 befinden sich vorzugsweise keine Durchkontaktierungen 4040 und keine Metallleitungen 4041, sodass das Licht der ersten SPAD-Diode 3954 ungehindert die zweite SPAD-Diode 3955 erreichen kann. Ein Metalldeckel 4042 verhindert den Austritt von Photonen nach oben und spiegelt diese vorzugsweise wieder in den Lichtwellenleiter 3944 zurück. Die Durchkontaktierungen 4040 und die Metallleitungen der ersten Metallisierungsebene 4041 verhindern in ähnlicher Weise, dass Licht aus dem Lichtwellenleiter in der horizontalen verloren geht.

Figur 41

Figur 41 zeigt schematisch das vereinfachte Blockdiagram eines quantenbasierten Zufallsgenerators 4100 wie er dem Vorschlag dieses Dokuments entspricht.

In der Figur 41 sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 42, 52, 53, 54, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Ein bevorzugt gemeinsamer Takt taktet bevorzugt die digitalen Schaltungen der beispielhaft in der Figur 41 dargestellten Vorrichtung. Der Quantenzufallszahlengenerator 60, 4100 der Figur 41 ist bevorzugt Teil der Steuervorrichtung 4 der Sicherung 1. Der Aufbau beinhaltet eine Entropie Quelle 4101, vorzugsweise einen breitbandigen 40 dB Hochfrequenzverstärkers 4102 oder dergleichen, einem Analog-Digital Wandler 4103, der ggf. auch mit dem Analog-zu-Digital-Wandler 570 identisch oder nur ein Inverter oder dergleichen sein kann. In Experimente hat sich ein Analog-zu-Digital-Wandler 4103 mit einer Auflösung von 14 Bit und einer Abtastrate von 125 MS/s und mit einer Auswertevorrichtung 4104, die im Wesentlichen Teilvorrichtungen der Steuervorrichtung 4 der Sicherung 1 umfasst.

Die Entropie Quelle 4101 des Quantenzufallszahlengenerators 4100, 60 umfasst typischerweise ein Array aus Single-Photon-Avalanche-Dioden (SPAD). Der Quantenzufallszahlengenerator 4100 betreibt die SPADs vorzugsweise im sogenannten Geiger Modus mit einer Versorgungsspannung über der Durchbruchsspannung. Zusätzlich ist für jede SPAD-Diode 4101.1, 4101.3 vorzugsweise ein Quenching-Widerstand 4101.4 in Reihe geschaltet. Der Quenching-Widerstand 4101.4 verhindert eine thermische Zerstörung der jeweiligen SPAD-Diode 4101.1, 4101.3 bei einer ausgelösten Ladungsträgerlawine. Das Stromsignal der zweiten Single Photon Avalanche Dioden 4101.3 wird über einen Shunt-Widerstand 4101.4 für diese zweite SPAD-Diode 4101.3 gemessen. Ein dem Beispiel der Figur 41 bildet der Vorwiderstand zur Begrenzung der Stromstärke (Quenching-Widerstand 4101.4) durch die jeweiligen SPAD-Dioden 4101.1 und 4101.3 den Shunt-Widerstand 4101.4. Der Shunt-Widerstand 4101.4 kann aber unabhängig vom Quenching-Widerstand 4101.4 in die Zuleitung der jeweiligen SPAD-Diode 4101.1, 4101.3 eingefügt sein. in beispielhaftes Array aus SPAD-Dioden umfasst in dem Beispiel der Figur 41 beispielhaft vier aktive erste SPAD-Dioden 4101.1 und zwölf passive zweite SPAD-Dioden 4101.3. Die beispielhaft vier aktiven, ersten SPAD-Dioden 4101.1 und zwölf passiven, zweite SPAD-Dioden 4101.3 sind bevorzugt über einen optischen Wellenleiter 4101.2 gekoppelt. Die aktiven ersten SPAD-Dioden 4101.1 emittieren spontan und zufällig einzelne Lichtpulse. Sie entsprechen der ersten SPAD-Diode 3954 der Figuren 39 und 40. Die aktiven ersten SPAD-Dioden 4101.1, 3954 befinden sich bevorzugt im Inneren des Arrays aus ersten und zweiten SPAD-Dioden 4101.1 und 4101.3. Die vorschlagsgemäße Vorrichtung versorgt die aktiven ersten SPAD-Dioden 4101.1 mit einer erhöhten Versorgungsspannung betreibt daher die aktiven, ersten SPAD-Dioden 4101.1 vorzugsweise weit oberhalb der Durchbruchspannung der ersten SPAD-Dioden 4101.1, 3954. Dies erhöht die Dunkelzählrate, was zu einer höheren Anzahl an spontan emittierten Photonen 3957 führt. Der optische Wellenleiter 4101.2, 3944 leitet einige Photonen 3958 der emittierten Photonen 3957 an die passiven, zweiten SPAD-Dioden 4101.3, 3955 weiter. Der optische Wellenleiter 4101.2, 3944 entspricht dem Lichtwellenleiter 3944 der Figuren 39 und 40. Die passiven, zweiten SPAD-Dioden 4101.3 entsprechen der zweiten SPAD-Diode 3955 der Figuren 39 und 40. Die vorschlagsgemäße Vorrichtung versorgt die passiven, zweiten SPAD-Dioden 4101.3, 3955 mit einer erhöhten Versorgungsspannung. Die vorschlagsgemäße Vorrichtung betreibt die passiven, zweiten SPAD-Dioden 4101.3, 3955 daher nur knapp über der Durchbruchsspannung. Bevorzugt sind die passiven, zweiten SPAD-Dioden 4101.3, 3955 als Ring um die aktiven, ersten SPAD-Dioden 4101.2, 3954 angeordnet. Die passiven, zweiten SPAD-Dioden 4101.3, 3955 detektieren zumindest einen Teil der über den Lichtwellenleiter 4101.2, 3944 ankommenden Photonen 3959. Die passiven, zweiten SPAD-Dioden 4101.3, 3955 erzeugen in Abhängigkeit von den ankommenden Photonen 3959 einen Stromfluss über einen Shunt-Widerstand, der den zweiten SPAD-Dioden 4101.3, 3955 zugeordnet ist. Die Entropiequelle 4101 umfasst bevorzugt die Shunt-Widerstände, Betriebsvorrichtung der SPAD-Dioden, die SPAD-Dioden 4101.1 und 4101.3 und den Lichtwellenleiter 4101.2. Ein Spannungssignal 4105 der Entropie Quelle 4101 verbindet vorzugsweise die Entropie Quelle 4101 mit einem bevorzugten, beispielhaften, breitbandigen 40 dB Hochfrequenzverstärker 4102. Vorzugsweise entspricht das Spannungssignal dem Spannungsabfall über den Quenching-Widerstand 4101.4, der in dem Beispiel der Figur als Shunt-Widerstand 4101.4 fungiert. Der vorgeschlagene, beispielhafte Hochfrequenzverstärker 4102 besitzt bevorzugt und beispielhaft eine Bandbreite von 30 bis 4000 MHz und bevorzugt einen 1-dB-Kompressionspunkt von 20 dBm. Der Spannungshub des Spannungssignals 4105 der Entropie Quelle 4101 bewegt sich typischerweise im Sub-Millivoltbereich. Der beispielhaft vorgeschlagene Hochfrequenzverstärker 4102 verstärkt beispielsweise den Spannungshub dieses Spannungssignals 4105 der Entropie Quelle 4101 auf beispielhafte 50 bis 150 mV.

Ein Verstärkerausgangssignal 4106 des Hochfrequenzverstärkers 4102 verbindet beispielsweise den beispielhaften Hochfrequenzverstärker 4102 mit einer beispielhaften Auswertevorrichtung 4104, die im Wesentlichen Teilvorrichtungen der Steuervorrichtung 4 der Sicherung 1 umfasst. Die Auswertevorrichtung 4104 der Figur 41 ist nur eine von vielen verschiedenen Realisierungsmöglichkeiten der in diesem Dokument vorgestellten technischen Lehre. Die Auswertevorrichtung 404 einen Microcontroller. Bei dem Microcontroller handelt es sich bevorzugt um den Rechnerkern 2 der Sicherung 1. Die Auswerteschaltung 4101 verfügt in den Beispielen der Figuren 41 und 42 über einen beispielhaften 14 Bit Analog-Digital-Wandler (ADC) 4103, 570 mit einer beispielhaften Abtastrate von 125 Mega-Samples/s und einer beispielhaften Bandbreite von 50 MHz. Es hat sich bei Ausarbeitung gezeigt, dass geringere Bitbreiten und geringere Abtastraten möglich sind. Ggf. ist eine analoge Vorverarbeitung vor der Digitalisierung durch den Analog-zu-Digital-Wandler 4103, 570 mittels Schaltungen zur Pulsverbreiterung zweckmäßig. Das verstärkte Spannungssignal des beispielhaften Hochfrequenzverstärkers 4102 ist das Verstärkerausgangssignal 4106 des Hochfrequenzverstärkers 4102. Der Analog-zu-Digital-Wandler 4103, 570 tastet das Verstärkerausgangssignal 4106 des Hochfrequenzverstärkers 4102 mit einer Abtastrate des Analog-zu-Digital-wandlers 4103, 570 ab. Der Analog-zu-Digital-Wandler 4103, 570 gibt beispielsweise die ermittelten Abtastwerte des Verstärkerausgangssignals 4106 des Hochfrequenzverstärkers 4102 digital mit einer Busbreite von beispielsweise 14 Bit beispielsweise an Die Auswertevorrichtung 4104 weiter.

Die als Blockschaltbild der vereinfacht in Figur 41 dargestellten Vorrichtung beinhaltet beispielhaft einen Komparator 4104.2, einen Zeit-zu-Digital-Konverter (TDC=time to digital converter) 4104.3, eine Entropie Extraktions-Vorrichtung 4104.4 und eine Finite State Machine (endlichen Automaten) 4104.8.

Der Komparator 4104.2 vergleicht in dem Beispiel der Figur 41 den beispielhaften digitalen 14 Bit Wert 4107 des Analog-zu-Digital-Wandlers 4103, 570 mit einer Konstanten 4104.1, die einen Schwellwert darstellt, und erzeugt einen zwei Takte langen 1 Bit Ausgangspuls auf seinem Ausgangssignal 4109 des Komparators 4104.2, wenn der Wert des Analog-zu-Digital-Wandlers 4103 größer ist als die Konstante 4104.1. Das Ausgangssignal 4109 des Komparators 4104.2 verbindet den Komparator 4104.2 mit dem Zeit-zu-Digital-Wandler 4104.3. Der Zeit-zu-Digital-Wandler 4104.3 besteht bevorzugt beispielsweise aus einem 32 Bit Zähler, der im Takt der Auswertevorrichtung 4104 hochzählt. Der Oszillator 30 und das Taktsystem der Steuervorrichtung 4 stellen diesen Takt typischerweise bereit. Die Bitbreite dieses Zählers kann je nach Anwendung abweichen. Dieser Takt kann beispielsweise eine Frequenz von 125 MHz haben. Das 1 Bit Ausgangssignal des Komparators 4104.2 setzt vorzugsweise den Zählerstand dieses Zählers zurück. Der Zeit-zu-Digital-Wandler 4104.3 legt den zu diesem Zeitpunkt unmittelbar vor dem Zurücksetzen vorliegenden Zählerstand an den Ausgang 4110 des Zeit-zu-Digital-Wandlers (TDC) 4104.3. Das Zählergebnis hat bei einem beispielhaften 125MHz Takt eine Auflösung von 1/(125 MHz)=8 ns. Der Ausgang 4110 des Zeit-zu-Digital-Wandlers (TDC) 4104.3 gibt das beispielhafte 32 Bit Zählergebnis, auch Rohdaten genannt, des Zeit-zu-Digital-Wandlers 4104.3 an die im Signalpfad nachfolgende Entropie-Extraktion 4104.4 weiter. Die Entropie-Extraktion 4104.4 wandelt die zufälligen Rohdaten RD des Zeit-zu-Digital-Wandlers (TDC) 4104.3 auf dem Signal des Ausgangs 4110 des Zeit-zu-Digital-Wandlers (TDC) 4104.3 in eine 1 Bit Zufallszahl 4111 RN um. Der Ausgang 4111 der Entropie-Extraktion 4104.4 ist mit dem Eingang der Finite State Machine FSM 4104.8 verbunden.

Die Finite State Machine 4104.8 hat typischerweise die Aufgabe, Daten in Form eines seriellen Stroms von Zufallsbits 4111 von der der Entropie-Extraktion 4104.4 entgegenzunehmen, den seriellen Strom von Zufallsdatenbits in Zufallsdatenwörter und diese in den Block RAM 4104.9 der Auswertevorrichtung 4104, der typischerweise der flüchtige Speicher 15 der Steuervorrichtung 4 der Sicherung 1 ist, zu speichern. Bevorzugt kommuniziert die Finite-State-Machine 4104.8 mit dem Microcontroller 4104.11, der identisch mit dem Rechnerkern 2 der Steuervorrichtung 4 einer Sicherung sein kann, über einen internen Datenbus 4119, der mit dem internen Datenbus 11 der Steuervorrichtung 4 der Sicherung 1 identisch sein kann. Nach erfolgreichem Schreibvorgang setzt die Finite State Machine 4104.8 ein Finish Flag 4104.10. Der Microcontroller 4104.11 kann bevorzugt das Finish-Flag 4104.10 über den internen Datenbus 4119 schreiben und/oder lesen. Das Finish-Flag 4104.10 kann ggf. Teil des RAMs 4104.9 oder ein Register des Microcontrollers 4104.11 sein. Der Microcontroller 4104.11 steuert und überwacht vorzugsweise über den internen Datenbus 4119 die Finite-State-Machine 4104.8. Das Finish Flag 4104.10 ist vorzugsweise bei Systemstart nicht gesetzt. Daraufhin kann der Rechnerkern 2, 4104.11 der Steuervorrichtung 4 der Sicherung beispielsweise mittels eines C-Programms auf den Block RAM 4104.9, 15 zugreifen und die Zufallszahl aus dem RAM 4104.9, 15 auslesen. Der Mikrocontroller 404.11 ist bevorzugt identisch mit dem ersten Prozessor 10-1 der Figur 1. Der Rechnerkern 2 der Steuervorrichtung 4 der Sicherung, der hier als Microcontroller 4104.11 arbeitet, kann beispielsweise ein Dual-Core Arm Cortex-A9 MPCore sein. Der Rechnerkern kann auch einige der Funktionen der Teilvorrichtungen der Auswertevorrichtung 4104 mittels eines geeigneten Programms ausführen und so diese Vorrichtungsteile ggf. ersetzen.

Bevorzugt steuert der Microcontroller 4105.11 einen Watchdog 4104.5. Der Watchdog 4104.5 ist hier im Sinne des hier vorgelegten Dokuments nicht nur ein Watchdog-Timer, der einen Zeitgeber umfasst, der mit dem Systemtakt des Quantenzufallszahlengenerators 4100, 60 bzw. des Takts der Steuervorrichtung 4 der Sicherung 1 getaktet ist und der in regelmäßigen zeitlichen Abständen von dem Microcontroller 4104.11 wieder auf einen Startwert zurückgesetzt werden muss, um ein Unterbrechen der Programmausführung des Microcontrollers 4104.11 bei Erreichen und/oder Kreuzen eines Watchdog-Zählerstandschwellwerts durch den Zählerstand des Zeitgebers des Watchdogs 4105.5 zu vermeiden. Der Watchdog 4105.5 führt darüber hinaus weitere Überwachungsaufgaben innerhalb des Quantenzufallszahlengenerators 4100 aus. Beispielsweise überwacht der Watchdog 4104.5 vorzugsweise die Entropie der Zufallsbits 4111. Insbesondere stellt der Watchdog 4104.5 sicher, dass die Zufallsbits 4111 vorzugsweise nicht mehr als k aufeinanderfolgende Zufallsbits des gleichen logischen Wertes aufweisen. Ist das der Fall, so fügt der Watchdog 4104.5 vorzugsweise andere Bits an Stelle der Zufallsbits 4111 in diesen seriellen Bitdatenstrom von der Entropieextraktion 4104.5 zur Finite-State-Machine 4107.8 ein. Hierzu in der folgenden Figur 42 mehr. Bevorzugt fügt der Watchdog 4104.5 in diesem Fall Zufallsbits eines anderen echten Zufallszahlengenerators und/oder eines anderen Quantenzufallszahlengenerators und/oder Pseudozufallsbits eines Pseudozufallszahlengenerators, dessen Startwert durch gültige Zufallsbits eines Quantenzufallszahlengenerators (QRNG) oder eines echten Zufallszahlengenerators (TRNG) bestimmt wird. Bevorzugt ist der Watchdog 4104.5 gleichzeitig auch ein Watchdog 13 der Steuervorrichtung 4 der Sicherung 1. Darüber hinaus überwacht der Watchdog 4104.5 im Sinne des hier vorgelegten Dokuments ggf. weitere Größen, wie z.B. das Übereinstimmen von Spannungswerten innerhalb des Quantenzufallszahlengenerators 4100, 60 und/oder innerhalb der Steuervorrichtung 4 der Sicherung 1 mittels eines oder mehrerer Analog-zu-Digital-Wandler 570, 4113 etc.

Figur 42

Figur 42 zeigt die erweiterte beispielhafte Auswertevorrichtung 4104, die nun eine Überwachung der Zufallszahl 4111 RN umfasst und ein zusätzliches Backup System für den Fehlerfall aufweist, um auch bei einem Ausfall des Quantenzufallszahlengenerators sie Sicherheit (Security) des Versorgungsnetzwerks 200 mittels eines Notlaufverfahrens abzusichern. Zur besseren Übersicht sind die Komponenten Mikrocontroller 4104.11 (Rechnerkern 2), RAM 4104.9, 15 und Finish-Flag 4104.10 weggelassen. Die Leserin/der Leser soll diese Vorrichtungsteile bzw. Funktionen in der Figur 42 weiterhin als vorhanden betrachten. Der Fachmann kann aber leicht die Anbindung an die Finite-State-Machine 4104.8 aus der Figur 41 in die Figur 42 kopieren und kommt dann zu der offenbarten technischen Lehre. Der Watchdog 4104.5, ein linear rückgekoppeltes Schieberegister 4104.6 als Pseudozufallszahlengenerator PRNG und einen SignalMultiplexer 4104.7 erweitern die Vorrichtung der Figur 41 zur Vorrichtung der Figur 42.

In der Figur 42 sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 52, 53, 54, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Der Ausgang 4111 der Entropie Extraktion 4104.4 ist nun verbunden mit dem Watchdog 4104.5 und dem Signal Multiplexer 4104.7 beispielhaft verbunden. Der Watchdog 4104.5 überwacht die Zufallszahl RN am Ausgang 4111 der Entropie-Extraktion 4104.4. Der Watchdog 4104.5 erfasst vorschlagsgemäß zumindest drei definierte Fehlerfälle. Der Watchdog 4104.5 gibt dazu beispielsweise die letzten validen Zufallszahlen als Seed S 4112 an das linear rückgekoppelte Schieberegister 4104.6. Sofern ein Fehler auftritt, setzt der Watchdog 4104.5 Fehlerbits in einem nicht gezeichneten Fehler-Register ER des Microcontrollers 4104.11, 2 (Rechnerkern 2) Welches Fehlerbit der Watchdog 4104.5 im Fehler-Register des Microcontrollers 4104.11, 2 (Rechnerkern 2) setzt, ist vorzugsweise abhängig vom jeweiligen Fehlerfall, den der Watchdog 4104.5 feststellt. Zusätzlich ist der Watchdog 4104.5 über ein oder mehrere, vorzugsweise digitale Ein-Ausgabe-Signalleitungen 4114 mit einem Spannungsmonitor 4113 verbunden. Bevorzugt überwacht der Watchdog-Schaltkreis die Spannungswerte, die der Spannungsmonitor 4113 ermittelt. Es hat sich bewährt, wenn der Spannungsmonitor 4113 nicht nur die Spannungen im Quantenzufallszahlengenerator 4100, 60 ermittelt und überwacht, sondern auch andere Spannungen innerhalb der Steuervorrichtung 4der Sicherung 1. Bei dem Spannungsmonitor 4113 kann es sich um den Analog-zu-Digital-Wandler 570 handeln.

Der Spannungsmonitor 4113 überwacht beispielsweise die Betriebsspannungen der Entropiequelle 4101 und/oder die Spannungen innerhalb der Steuervorrichtung 4 und/oder die Spannungen der Energiereserve 8 und/oder die internen Versorgungsspannungen, die die Spannungsversorgung 5 der Sicherung 1 erzeugt. Ist eine der Betriebsspannung einer der SPAD-Dioden Verschaltungen 4101.1 oder 4101.3 zu niedrig, also spannungswertbetragsmäßig unterhalb eines unteren SPAD-Betriebsspanungsschwellwerts, oder zu hoch, also spannungswertbetragsmäßig oberhalb eines oberen SPAD-Betriebsspanungsschwellwerts, so detektiert der Betriebsspannungsmonitor 4113 diese Spannungsabweichung. Bevorzugt kann der Rechnerkern 2 die Werte des Spannungsmonitors 4113 über den internen Datenbus 11 der Steuervorrichtung 4 der Sicherung auslesen. Im Fall einer solchen Spannungsabweichung signalisiert der Spannungsmonitor 4133 an den Watchdog 4104.5 oder direkt an den Mikrocontroller 4104.11 (Rechnerkern 2) eine solche Abweichung. Im Falle einer Signalisierung an den Watchdog 4104.5 kann beispielsweise der Watchdog 4104.5 ein Interrupt-Signal 4120 für den Mikrocontroller 4104.11 (den Rechnerkern 2) erzeugen. Der Watchdog 4104.5 kann beispielsweise einen solchen Interrupt 4120 des Microcontrollers 4104.11 (Rechnerkern 2) oder einer anderen Teilvorrichtung eines Anwendungssystems / der Sicherung 1 auslösen, wenn die Versorgungsspannung der Entropiequelle 4101 oder des Hochfrequenzverstärkers 4102 oder eines anderen Vorrichtungsteils des Quantenzufallszahlengenerators QRNG 4100 und/oder der Steuervorrichtung 4 und/oder der Sicherung 1 fehlerhaft ist. Hat der Watchdog 4104.5 einen Fehler des Quantenzufallsgenerators 4100 detektiert, so wechselt der Quantenzufallszahlengenerator 4100 in einen Notlaufzustand. Hierzu setzt der Watchdog 4104.5 das Selektionssignal 4116 des Signalmultiplexers 4104.7, sodass der Signalmultiplexers 4104.7 statt des Ausgangs 4111 der Entropie-Extraktion 4104.4 die Pseudozufallszahl PRN des linear rückgekoppelten Schieberegisters 4104.6 in Form eines Stroms von Pseudozufallsbits über eine Pseudozufallssignalleitung 4117 als Ersatz für die zumindest potenziell fehlerhafte Zufallszahl RN des Ausgangs 4111 der Entropie-Extraktion 4104.4 an den Eingang der Finite State Machine 4104.8 legt.

Das linear rückgekoppelte Schieberegister 4104.6 ist mit dem Ausgang Seed S 4112 des Watchdog 4104.5 verbunden. Der Watchdog 4104.5 aktiviert im Fehlerfall das linear rückgekoppelte Schieberegister 4104.6. Das linear rückgekoppelte Schieberegister 4104.6 generiert dann Pseudozufallszahlen PRN als Pseudozufallszahlengenerator PRNG. Der Seed S 4112 weist bevorzugt die letzten beispielsweise 16 gerade noch gültigen Zufallszahlen (z.B. jeweils 1 Bit) auf. Der Watchdog 4104.5 legt bevorzugt diese letzten gültigen Zufallszahlen an den Eingang des linear rückgekoppelten Schieberegisters 4104.6. Der Seed S dient somit als zufälliger PQC sicherer Startwert für das Generatorpolynom der Rückkopplung des linear rückgekoppelten Schieberegisters 4104.6 für die Generierung der Pseudozufallszahl PRN und deren Signalisierung über die Pseudozufallssignalleitung 4117. Das Generatorpolynom sowie der Grad des Generatorpolynoms sind dabei bevorzugt frei wählbar.

Das Signal des Ausgangs 4111 der Entropie-Extraktion 4104.4 mit der 1 Bit Zufallszahl RN der Entropie Extraktion 4104.4 bzw. das Signal der Pseudozufallssignalleitung 4117.mit der Pseudozufallszahl PRN des linear rückgekoppelten Schieberegisters 4104.6 sind mit den Eingängen des Signalmultiplexers 4104.7 verbunden. Der Signalmultiplexer 4104.7 leitet je nach Wert des Selektionssignals 4116 SEL einen der beiden Eingänge an die Finite State Machine 4104.8 weiter. Natürlich ist es denkbar, einen Multiplexer mit mehr als zwei Eingängen und komplexerem Ansteuersignal zu verwenden, wenn die Anwendung dies erfordert. Die Zahl der Eingänge der Signalmultiplexers 4104.7 ist daher typischerweise größer oder gleich zwei.

Auch hier hat die Finite State Machine 4104.8 die Aufgabe die Zufallsdaten RN bzw. die Pseudozufallszahl PRN am Ausgang des Signalmultiplexers 4104.7 entgegenzunehmen und in den Block RAM 4104.9, 15 der Auswertevorrichtung 4104 innerhalb der Steuervorrichtung 4 der Sicherung 1 zu schreiben. Ist der Schreibvorgang erfolgreich, setzt die Finite State Machine 4104.8 wieder das Finish Flag 4104.10. Daraufhin kann der Mikrocontroller 4104.11 (Rechnerkern 2) beispielsweise mittels eines C-Programms, welches auf dem eingebetteten Mikrocontroller 4104.11 vorzugsweise abläuft, auf den Block RAM 4104.9, 15 zugegriffen und die Zufallszahl auslesen und beispielsweise zur Verschlüsselung benutzen.

Figur 43

zeigt das Flussdiagramm 4300 des Entropie Extraktionsverfahrens, das beispielsweise die Entropieextraktion 4104.4 ausführt. Das Verfahren sieht vor, zunächst in einem ersten Schritt 4301 zwei Werte des Ausgangs 4110 des Zeit-zu-Digital-Wandlers 4104.3 zu ermitteln und in einem Schieberegister der Entropie Extraktion 4104.4 zu speichern. Sind zwei Werte im Schieberegister der Entropie Extraktion 4104.4 gespeichert, so vergleicht die der Entropie Extraktion 4104.4 diese beiden Werte in einem zweiten Schritt 4302. Die beiden Werte im Schieberegister der Entropieextraktion 4104.4 umfassen also einen ersten Wert und einen zweiten Wert, die beide der Zeit-zu-Digital-Wandler 4104 mittels zweier verschiedener Messungen des jeweiligen Zeitraums zwischen jeweils zwei Signalpulsen oberhalb des Werts der Konstante 4104.1 ermittelt hat. In einem dritten Schritt 4303 bewertet die Entropie Extraktion 4104.4 die beiden Werte. Ist der erste Wert kleiner als der zweite Wert und die Differenz zwischen Wert 1 und Wert 2 größer als eine Mindestdifferenz $\varepsilon$, so setzt die Entropie-Extraktion 4014.4 den Wert ihres Ausgangs 4111 auf einen ersten logischen Wert. Ist der erste Wert größer als der zweite Wert und die Differenz zwischen dem ersten Wert und dem zweiten Wert 2 größer als die Mindestdifferent $\varepsilon$, so setzt die Entropie-Extraktion 4104.4 ihren Ausgang auf einen zweiten logischen Wert, der vom ersten logischen Wert verschieden ist. Ist die Differenz zwischen dem ersten Wert und dem zweiten Wert kleiner als die Mindestdifferenz $\varepsilon$, so verwirft die Entropieextraktion den ersten Wert und den zweiten Wert. Bevorzugt veranlasst die Entropieextraktion den Watchdog 4104.5 in einem solchen Fall einen Fehlerzähler um eine erste Fehlerzählerschrittweite zu erhöhen. Die erste Fehlerzählerschrittweite kann negativ sein. Umgekehrt kann die Entropieextraktion 4104.4 den Fehlerzähler des Watchdogs 4104.5 um eine zweite Fehlerzählerschrittweite erniedrigen, wenn die Differenz zwischen dem ersten Wert und dem zweiten Wert größer als die Mindestdifferenz $\varepsilon$ ist. Die zweite Fehlerzählerschrittweite kann gleich der ersten Fehlerzählerschrittweite sein. Typischerweise sind die Vorzeichen der ersten Fehlerzählerschrittweite und der zweiten Fehlerzählerschrittweite gleich. Bevorzugt kann der Mikrocontroller 4104.11 (Rechnerkern 2) die Fehlerzählerschrittweiten und den Startwert des Fehlerzählers und einen Fehlerzählerschwellwert setzen. Kreuzt der Zählerstand des Fehlerzählers den Fehlerzählerschwellwert, so signalisiert der Watchdog 4104.5 vorzugsweise mittels eines Interrupts 4120 oder einer anderen Signalisierung an den Mikrocontroller 404.11 (Rechnerkern 2) das Vorliegen eines kritischen Fehlerzustands. Der Mikrocontroller 4104.11 (Rechnerkern 2) startet dann typischerweise ein Selbsttestprogramm, um die verschiedenen Teile des Quantenzufallszahlengenerators 4100 zu testen. Bevorzugt kann der Mikrokontroller 4104.11 (Rechnerkern 2) hierzu beispielsweise den Analog-zu-Digital-Wandler 4103, 570 in einen Zustand versetzen, in dem der Mikrocontroller 4104.11 (Rechnerkern 2) ein Ausgangsregister des Analog-zu-Digital-Wandlers 4103 mit Testwerten beschreiben kann, die die nachfolgende Signalkette dann wie echte Abtastwerte weiterverarbeitet. Da die Testwerte vorbekannt sind, kann der Mikrocontroller 4104.11 (Rechnerkern 2) die korrekte Reaktion des Restsystems, beispielsweise das Hochzählen des Fehlerzählers im Watchdog 4104.5, beobachten und bewerten. Bevorzugt kann der Mikrocontroller 4104.11 (Rechnerkern 2) daher möglichst alle Speicherknoten der Auswerteschaltung 4104 bzw. der Steuerschaltung 4 überwachen und deren logischen Zustand lesen.

Sofern ein Zeitwert am Ausgang 4110 des Zeit-zu-Digital-Wandlers 4104.3 kleiner als ein Mindestwert ist, handelt es sich um einen Wert, der innerhalb der Totzeit der SPAD-Dioden 4101.1, 4101.3 liegt. Die Auswertevorrichtung 4104 verwirft bevorzugt einen solchen Wert und erhöht den Fehlerzähler vorzugsweise um die erste Fehlerschrittweite, die auch negativ sein kann. In dem Fall wartet die Entropieextraktion 4104.4 die Ermittlung des nächsten Zeitwerts durch den Zeit-zu-Digital-Wandler 4104.3 ab. Ist das Zufallsbit auf diese Weise extrahiert, beginnt der Quantenzufallszahlengenerator 4100 das Verfahren von vorne.

Sofern der Fehlerzähler den Fehlerzählerschwellwert kreuzt oder erreicht, kann beispielsweise ein Fehler vorliegen, bei dem der Zeit-zu-Digital-Wandler 41^03 beispielsweise konstante Zahlenwerte aufgrund eines Fehlers liefert.

Diese Vorrichtung ist somit in der Lage, einen Ausfall der Spannungsversorgung 5 der Entropiequelle 4101 oder anderer Teile der Vorrichtung 4, 4100 zu detektieren. Der Mikrocontroller 4104.11 (Rechnerkern 2) kann mittels des Analog-zu-Digital-Wandlers 4103 auch zu Testzwecken Spannungen und Ströme im Quantenzufallszahlengenerator 4100 und/oder innerhalb der Steuervorrichtung 4 der Sicherung und/oder innerhalb der Sicherung 1 erfassen und die so ermittelten Werte mit Erwartungswertbereichen vergleichen, in denen diese Werte liegen müssen. Auch kann der Mikrocontroller 4104.11 (der Rechnerkern 2) digitale Werte innerhalb des Quantenzufallszahlengenerators 4100 und/oder der Steuervorrichtung 4 erfassen. Beispielsweise kann der Microcontroller 4104.11 (der Rechnerkern 2) die Konstante Const 4104.1 für Testzwecke so niedrig setzen, dass der Rauschuntergrund im Wesentlichen den Zeit-zu-Digital-Wandler 4104.3 steuert. Die Werte des Zeit-zu-Digital-Wandlers 4104.3 sollten dann einer erwarteten Statistik in einem Toleranzband genügen. Ist dies nicht der Fall, so liegt ein Fehler vor. Der Microcontroller 4104.11 (Rechnerkern 2) kann diese Statistik erstellen und ggf. auf diesen Fehler schließen, wenn die ermittelten statistischen Werte nicht in einem Erwartungswertintervall liegen.

Der Watchdog 4104.5 kann die Entropie der gelieferten Zufallszahlen 4111 überwachen. Sofern die mittlere Entropie der Bits 4111 über einen Entropiemesszeitraum wesentlich mehr als ein erlaubter Entropieabweichungswert von dem erwarteten Zufallsmittelwert von 50% abweicht, schließt der Watchdog 4104.5 vorzugsweise auf einen Fehler des Quantenzufallszahlengenerators 4100, 60, und inkrementiert vorzugsweise den Fehlerzähler um die besagte Fehlerzählerschrittweite. Vorzugsweise stoppt der Watchdog 4104.5 dann die Verwendung dieser Zufallsbits des Ausgangs 4111 der Entropie Extraktion, um die Versendung von Klartext über den Datenbus durch die Sicherung 1 zu verhindern. Klartext bedeutet im Sinne des hier vorgelegten Dokuments, das die versendeten und/oder gespeicherten Daten in einer Form vorliegen, die es erlaubt, dass ein Dritter sich direkt und/oder durch Anwendung statistischer oder sonstiger Methoden unbefugten Zugang zum Inhalt einer Datenbotschaft und/oder von gespeicherten Daten und/oder Programmcode verschaffen kann. Es ist nämlich denkbar, dass auch bei funktionierenden Teilvorrichtungen zufällig eine virtuelle Dauereins oder eine virtuelle Dauernull erzeugt wird. Der Zufall umfasst nämlich auch die Dauernull und die Dauereins. Es ist somit sinnvoll, wenn die maximale Länge einer Bitsequenz ohne Änderung des logischen Zustands am Ausgang 411 der Entropie Extraktion 4104.4 auf einen durch den Mikrocontroller 4104.11 (Rechnerkern 2) programmierbaren Wert durch den Watchdog 4195.5 begrenzt wird.

Im Wesentlichen kann der vorbeschriebene Quantenzufallszahlengenerator 4100 damit folgende Fehler erkennen und durch einen Notlauf mittels eines Pseudozufallszahlengenerators 4104.6, also beispielsweise mittels eines linear rückgekoppelten Schieberegisters 4104.6, mit niedrigerem Sicherheitsniveau auffangen:

- Störung von Versorgungsspannungen
- Fehlerhafte Signalerzeugung der SPAD-Dioden 4101.1 und 4101.3,
- Störung des Lichtwellenleiters 4101.2 und/oder der Ankoppelungen der SPAD-Dioden 4101.1 und 4101.3 an den Lichtwellenleiter 4101.2,
- Schaltungsausfälle im Digitalteil 4104 des Quantenzufallszahlengenerators 4100
- Fehlerhafte Entropie der gelieferten Zufallszahlen 4111.

Es ist denkbar, statt des linear rückgekoppelten Schieberegisters 4104.6 bzw. des Pseudozufallszahlengenerators 4104.6 einen zweiten kompletten Quantenzufallszahlengenerator 4100 einzusetzen, dessen Ausgang 4111 dessen Entropie Extraktion dann der Multiplexer 4104.7 anstelle des Signals der Pseudozufallssignalleitung 4117 für den Notlauf des Quantenzufallszahlengenerators 4100, 60 verwendet. Für den Fall, dass der Ausgang des Pseudozufallszahlengenerators 4104.6 von einem oder mehreren echten Zufallsbits 4112 als Seed abhängt, handelt es sich, solange die Anzahl der eingefügten Bits begrenzt ist, wieder um eine Quantenzufallszahl. Bevorzugt bestimmt der Watchdog 4105.5 die Anzahl k der erlaubten, maximal aufeinanderfolgenden Quantenbits 4111 aus einer Quantenzufallszahl. Umfasst diese Quantenzufallszahl 4111, die der Watchdog 4104.5 für die Bestimmung von k verwendet, nur Bits mit einem einzigen logischen Wert, so besteht die Möglichkeit, dass ein Fehler vorliegt. Die Zahl k sollte dann nicht maximal sein, um eine Versendung oder Speicherung von Klartext zu vermeiden. Vielmehr sollte der Watchdog 4104.5 dann die Zahl k sehr klein, bevorzugt minimal wählen.

Figur 44

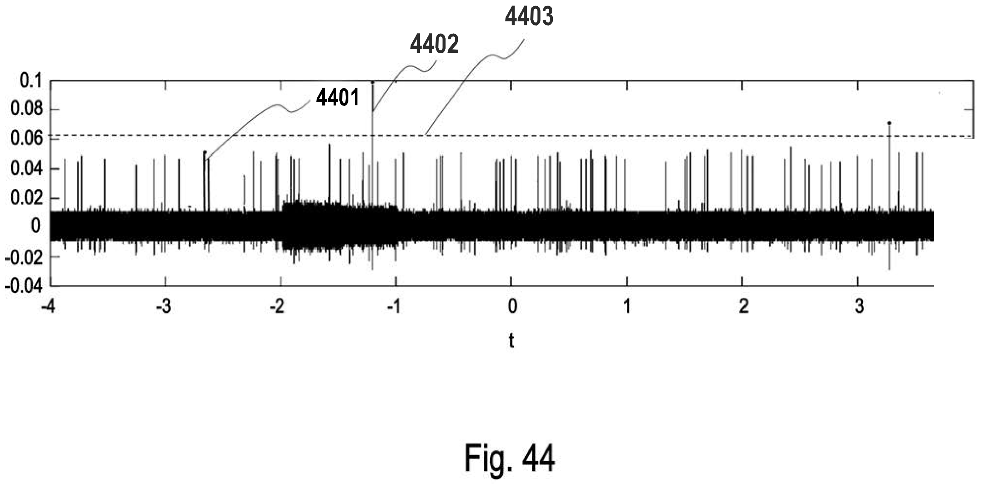

Figur 44 zeigt ein beispielhaftes Oszillogramm des Spannungssignals 4104 der Entropie Quelle 4101. Wie leicht zu erkennen ist, treten erste Spikes 4401 mit einer ersten Höhe und zweite Spikes 4402 mit einer zweiten Höhe auf. Die Streuung der ersten Höhe der ersten Spikes 4401 und die Streuung der zweiten Höhe der zweiten Spikes 4402 ist jeweils so gering, dass eine klare Trennung dieser Ereignisse 4401, 4402 mittels eines beispielhaften Schneidepegels 4403 über die Wahl der Konstanten 4104.1 möglich ist. Der Schneidepegel 4403 entspricht dem Wert den der Mikrocontroller 4104.11 (Rechnerkern 2) mittels der Konstanten 4104.1, die vorzugsweise als Register des Microcontrollers 4104.11 (Rechnerkern 2) ausgeführt ist, einstellt.

Figur 45

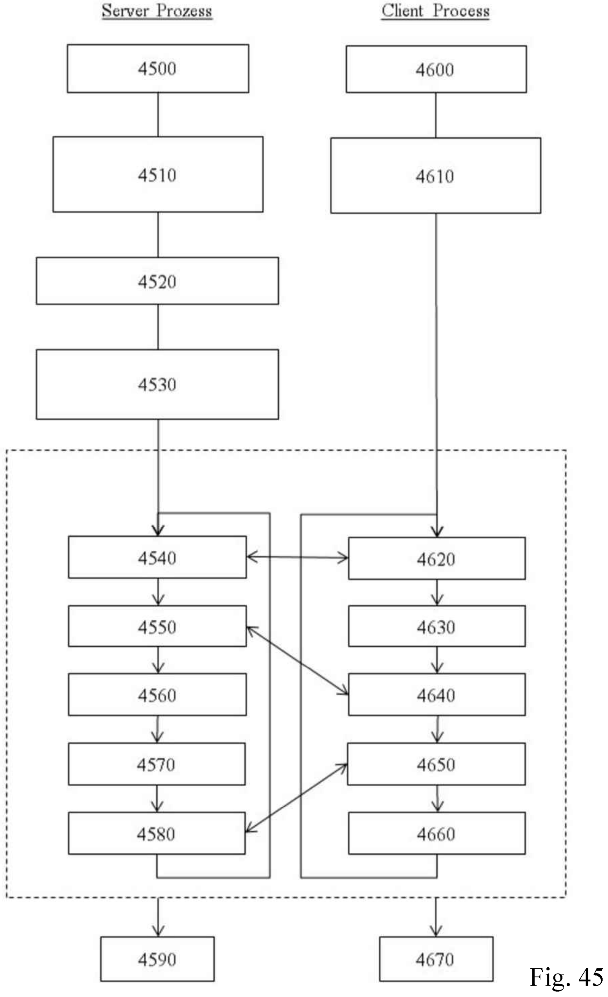

Figur 45 zeigt den schematischen Ablauf einer Server-Client-Kommunikation unter Nutzung eines vorschlaggemäßen Quantenzufallszahlengenerators. Dabei soll eine erste Vorrichtung, wie beispielsweise die elektronische Sicherung 1 der Figur 1, als Server über einen Datenbus 9 mit einer zweiten Vorrichtung, wie beispielsweise eine andere, zweite Sicherung der Figur 1 und/oder ein übergeordnetes Rechnersystem 12, als Client verschlüsselt kommunizieren. Sowohl die erste Vorrichtung als auch die zweite Vorrichtung sollen bevorzugt in einem ersten Beispiel jeweils einen Quantenzufallszahlengenerator 60 umfassen, den der jeweilige Rechner für die Verschlüsselung nutzt. Bevorzugt entspricht der Quantenzufallszahlengenerator 60, 4100 ganz oder teilweise einer Konstruktion entsprechend einer der Figuren 41 bis 42. Ganz besonders bevorzugt umfassen die Quantenzufallszahlengeneratoren der ersten Vorrichtung und der zweiten Vorrichtung jeweils einen Quantenzufallszahlengenerator 4100, 60, der jeweils zumindest eine erste SPAD-Diode 4101.1 und jeweils zumindest eine Lichtwellenleiter 4101.2 bevorzugt in Form des Oxid-Stapels 3944 auf der Halbleiteroberfläche und bevorzugt zumindest eine zweite SPAD-Diode 4101.3 als Empfänger. Dies steigert die Datenrate der erzeugten Zufallsbits und befähigt den Rechner der jeweiligen Vorrichtung sehr schnell die Schlüssel zu erzeugen und zu tauschen. Die jeweiligen Rechner der jeweiligen Vorrichtungen verschlüsseln ihre wechselseitige Kommunikation bevorzugt mittels eines RSA-Verschlüsselungsverfahrens. Das beispielhafte RSA-Verschlüsselungsverfahren ist beispielsweise aus R. L. Rivest, A. Shamir, and L. Adleman, "A Method for Obtaining Digital Signatures and Public-Key Cryptosystems" Communications oft he ACM, Februar 1978, Vol. 21, Nr. 2, Seiten 120 bis 126 bekannt. Die Primzahlen, die der jeweilige Rechner der jeweiligen Vorrichtung zur Erzeugung des öffentlichen und des privaten Schlüssels vorzugsweise verwendet, erzeugt bevorzugt der Quantenzufallszahlengenerator 4100, 60 QRNG zufällig. Die Kommunikation des Rechnerkerns 2 der Steuervorrichtung 4 der Sicherung (Server) mit dem jeweiligen Rechnerkern 2 der Steuervorrichtung 4 der anderen Sicherung 1 (Client) bzw. dem übergeordneten Rechnersystem (Client) umfasst bevorzugt zum Ersten den Prozess "Server Process", welcher auf dem Rechnerkern 2 der Steuervorrichtung 4 der Sicherung (Server), also der ersten Vorrichtung, gestartet wird, und zum Zweiten den Prozess "Client Process", welcher auf dem jeweiligen Rechnerkern 2 der Steuervorrichtung 4 der anderen Sicherung (Client) bzw. dem übergeordneten Rechnersystem 12, also der zweiten Vorrichtung, gestartet wird. Der jeweilige Rechnerkern 2 der Steuervorrichtung 4 der anderen Sicherung (Client) bzw. das übergeordnete Rechnersystem 12 kommunizieren typischerweise mit dem Rechnerkern 2 der Steuervorrichtung 4 der Sicherung (Server) über sogenannte Sockets. Dabei handelt es sich um Kommunikationspunkte, welche das jeweilige Betriebssystem des jeweiligen Rechners bereitstellt. Bevorzugt stammen die benötigten Funktionen, um eine Kommunikation aufzubauen, beispielsweise aus der Standard C-Library socket.h. Das Folgende erläutert beispielhaft die Kommunikation gemäß Figur 45:

Zu Beginn erzeugt sich der Rechnerkern 2 der Steuervorrichtung 4 der Sicherung 1 (Server) einen Socket-Descriptor in Schritt 4500. Ein Socket-Descriptor im Sinne des hier vorgelegten Dokuments ist ein Integer ähnlicher File-Handle, den beispielsweise die Standard C Library-Funktion socket() der socket.h Library erzeugt. Der Rechnerkern 2 der Steuervorrichtung 4 der Sicherung 1 (Server) kann diesen Socket-Descriptor in späteren Funktionsaufrufen, die Sockets verwenden, nutzen.

Der Rechnerkern 2 der Steuervorrichtung 4 der Sicherung 1 (Server) bindet in Schritt 4510 bevorzugt den Socket-Descriptor an einen Port und eine IP-Adresse. Binden im Sinne dieses Dokuments bedeutet, dass der Rechnerkern 2 der Steuervorrichtung 4 der Sicherung 1 (Server) die Standard C-Funktion bind() aus der Standard C-Library socket.h nutzt, um den Port und die IP-Adresse logisch mit dem in Schritt 4500 erzeugten Socket-Descriptor zu verknüpfen. Bei einem Port handelt es sich im Sinne des vorliegenden Dokuments um einen Teil der Netzwerkadresse, der Zuordnung von Datenpaketen zwischen Server- und Client-Programmen ermöglicht. Bei einer IP-Adresse handelt es sich im Sinne des vorliegenden Dokuments um eine Netzwerkadresse, die einen Teilnehmer in einem Netzwerk eindeutig identifizierbar macht.

Der Rechnerkern 2 der Steuervorrichtung 4 der Sicherung 1 (Server) geht im nächsten Schritt 4520 in einen passiven Wartezustand 4520 und wartet auf Verbindungsanfragen eines Rechnerkerns 2 der Steuervorrichtung 4 der anderen Sicherung 1 (Client). Im Sinne des hier vorgelegten Dokuments ruft bevorzugt der Rechnerkern 2 der Steuervorrichtung 4 der Sicherung 1 (Server) hierzu die Standard C-Funktion listen() der socker.h Library auf. Die Funktion zeigt an, dass der Rechnerkern 2 der Steuervorrichtung 4 der Sicherung 1 (Server) bereit ist, dass der Rechnerkern 2 der Steuervorrichtung 4 der Sicherung 1 (Server) Verbindungsanfragen durch Clients annehmen kann. Der Rechnerkern 2 der Steuervorrichtung 4 der Sicherung 1 (Server) erzeugt eine Warteschlange für ankommende Verbindungsanfragen des Rechnerkerns 2 der Steuervorrichtung 4 der anderen Sicherung 1 (Client) in einem der Speicher 15 des Rechnerkerns 2 der Steuervorrichtung 4 der Sicherung 1 (Server) oder eines anderen Vorrichtungsteils der Steuervorrichtung 4 der Sicherung 1 (Server). Stellt der Rechnerkern 2 der Steuervorrichtung 4 der Sicherung 1 (Server) eine Verbindungsanfrage eines Rechnerkerns 2 der Steuervorrichtung 4 der anderen Sicherung 1 (Client) fest, so akzeptiert der Rechnerkern 2 der Steuervorrichtung 4 der Sicherung 1 (Server) diese Verbindungsanfrage des Rechnerkerns 2 der Steuervorrichtung 4 der anderen Sicherung 1 (Clients).

Der Rechnerkern 2 der Steuervorrichtung 4 der Sicherung 1 (Server) stellt dann in einem folgenden Schritt 4530 eine Verbindung zum Rechnerkern 2 der Steuervorrichtung 4 der anderen Sicherung 1 (Client) her 4530. Der Rechnerkern 2 der Steuervorrichtung 4 der Sicherung 1 (Server) stellt eine Verbindungsanfrage des Rechnerkerns 2 der Steuervorrichtung 4 der anderen Sicherung 1 (Client) dadurch fest, dass der Rechnerkern 2 der Steuervorrichtung 4 der Sicherung 1 (Server) die Funktion listen() verlässt. Der Rechnerkern 2 der Steuervorrichtung 4 der Sicherung 1 (Server) akzeptiert die Verbindungsanfrage vorzugsweise durch Aufruf der Standard C-Funktion accept() der socket.h Standard C-Library. Der Rechnerkern 2 der Steuervorrichtung 4 der Sicherung 1 (Server) extrahiert dazu bevorzugt die erste Verbindungsanfrage aus der Warteschlange offener Verbindungsanfragen für den Server und stellt damit dann die Verbindung zum Rechnerkern 2 der Steuervorrichtung 4 der anderen Sicherung 1 (Client) her. Bei Erfolg gibt die Funktion accept() einen Socket-Descriptor des Clients dem Rechnerkern 2 der Steuervorrichtung 4 der Sicherung 1 (Server) zurück. Ein Socket-Descriptor im Sinne dieses Dokuments ist eine Integer ähnlich File-Handle der Standard C-Library socket.h. Damit besteht dann die Verbindung zwischen dem Rechnerkern 2 der Steuervorrichtung 4 der Sicherung 1 (Server) und dem Rechnerkern 2 der Steuervorrichtung 4 der anderen Sicherung 1 (Client).

Besteht eine besagte Verbindung, startet der Rechnerkern 2 der Steuervorrichtung 4 der Sicherung 1 (Server) bevorzugt in einem folgenden Schritt 4540 eine Funktion keyExchangeServer(). Der Rechnerkern 2 der Steuervorrichtung 4 der Sicherung 1 (Server) führt dann diese Funktion keyExchange() in diesem Schritt 4540 aus, um dem Rechnerkern 2 der Steuervorrichtung 4 der anderen Sicherung 1 (Client) seinen öffentlichen Schlüssel zukommen zu lassen. Diese Funktion keyExchangeServer() ist nun jedoch keine Standard C-Funktion. In dieser Funktion erzeugt in diesem Schritt 4540 der Rechnerkern 2 der Steuervorrichtung 4 der Sicherung 1 (Server) mittels eines Quantenzufallszahlengenerators 4100, 60 QRNG Zufallszahlen aus Zufallsbits 4111. Die Zufallszahl hat dabei bevorzugt eine Bitbreite n. Hierbei ist n eine positive ganze Zahl einschließlich Null. Diese Zufallszahlen des Quantenzufallszahlengenerators 4100, 60 der Steuervorrichtung 1 der Sicherung 1 (Server) dienen in dem in diesem Dokument vorgestellten Beispiel als Indices für eine Look-Up-Tabelle der ersten 2n Primzahlen. Diese Look-Up-Table befindet sich bevorzugt in einem der Speicher 15, 14 der Steuervorrichtung 4 der Sicherung 1 (Server). Der Rechnerkern 2 der Steuervorrichtung 4 der Sicherung 1 (Server) liest dann die Primzahl entsprechend diesem Index der Quantenzufallszahl des Quantenzufallszahlgenerators 4100, 60 der Steuervorrichtung 4 der Sicherung 1 (Server) aus dem Speicher 14, 15 des Rechnerkerns 2 der Steuervorrichtung 4 der Sicherung 1 (Server). Mittels dieser Primzahlen erzeugt der Rechnerkern 2 der Steuervorrichtung 4 der Sicherung 1 (Server) sowohl einen öffentlichen Schlüssel als auch den privaten Schlüssel gemäß dem erwähnten RSA-Verschlüsselungsverfahren.

Der Rechnerkern 2 der Steuervorrichtung 4 der Sicherung 1 (Server) übermittelt dann über die Datenschnittstelle 64 des Rechnerkerns 2 der Steuervorrichtung 4 der Sicherung 1 (Server) und den Datenbus 9 und die Datenschnittstellen 10, 610, 550, 551 des Rechnerkerns 2 der Steuervorrichtung 4 der anderen Sicherung 1 (Client) einen öffentlichen Schlüssel an den Rechnerkern 2 der Steuervorrichtung 4 der anderen Sicherung 1 (Client).

Danach wartet der Rechnerkern 2 der Steuervorrichtung 4 der Sicherung 1 (Server) auf eine Nachricht des Rechnerkerns 2 der Steuervorrichtung 4 der anderen Sicherung 1 (Client) über die Datenschnittstelle 10, 610, 550, 551 des Rechnerkerns 2 der Steuervorrichtung 4 der anderen Sicherung 1 (Client) und den Datenbus 9 und die Datenschnittstellen 10, 610, 550, 551 des Rechnerkerns 2 der Steuervorrichtung 4 der Sicherung 1 (Server). Bevorzugt umfasst diese Nachricht des Rechnerkerns 2 der Steuervorrichtung 4 der anderen Sicherung 1 (Client) einen öffentlichen Schlüssel des Rechnerkerns 2 der Steuervorrichtung 4 der anderen Sicherung 1 (Client). Damit übermittelt der Rechnerkern 2 der Steuervorrichtung 4 der anderen Sicherung 1 (Client) typischerweise den privaten Schlüssel des Rechnerkerns 2 der Steuervorrichtung 4 der anderen Sicherung 1 (Client) über die Datenschnittstelle 64 des Rechnerkerns 2 der Steuervorrichtung 4 der anderen Sicherung 1 (Client) und den Datenbus 9 und die Datenschnittstelle 10, 610, 550, 551 des Rechnerkerns 2 der Steuervorrichtung 4 der Sicherung 1 (Server) an den Rechnerkern 2 der Steuervorrichtung 4 der Sicherung 1 (Server). Hat der Rechnerkern 2 der Steuervorrichtung 4 der Sicherung 1 (Server) den öffentlichen Schlüssel des Rechnerkerns 2 der Steuervorrichtung 4 der anderen Sicherung 1 (Client) erhalten, so speichert der Rechnerkern 2 der Steuervorrichtung 4 der Sicherung 1 (Server) diesen öffentlichen Schlüssel in einem Speicher 14, 15 des Rechnerkerns 2 der Steuervorrichtung 4 der Sicherung 1 (Server).

Anschließend versendet der Rechnerkern 2 der Steuervorrichtung 4 der Sicherung 1 (Server) beispielsweise seinen öffentlichen Schlüssel über seine Datenbusschnittstelle 10, 610, 550, 551 und den Datenbus 9 und die Datenbusschnittstelle 10, 610, 550, 551 des Rechnerkerns 2 der Steuervorrichtung 4 der anderen Sicherung 1 (Client) an den Rechnerkern 2 der Steuervorrichtung 4 der anderen Sicherung 1 (Client).

Damit ist der Rechnerkern 2 der Steuervorrichtung 4 der Sicherung 1 (Server) typischerweise für den Austausch verschlüsselter Daten zwischen dem Rechnerkern 2 der Steuervorrichtung 4 der anderen Sicherung 1 (Client) und dem Rechnerkern 2 der Steuervorrichtung 4 der Sicherung 1 (Server) vorbereitet.

Nach dem nun die Schlüssel ausgetauscht sind, führt im Anschluss der Rechnerkern 2 der Steuervorrichtung 4 der Sicherung 1 (Server) vorzugsweise die Funktion recv() 4550 aus und wartet auf eine verschlüsselte Nachricht des Rechnerkerns 2 der Steuervorrichtung 4 der anderen Sicherung 1 (Client). Empfängt der Rechnerkern 2 der Steuervorrichtung 4 der Sicherung 1 (Server) eine Nachricht, so speichert der Rechnerkern 2 der Steuervorrichtung 4 der Sicherung 1 (Server) diese verschlüsselte Nachricht vorzugsweise zunächst in einem temporären Zwischenspeicher 15 des Rechnerkerns 2 der Steuervorrichtung 4 der Sicherung 1 (Server). Im Sinne des hier vorliegenden Dokuments handelt es sich bei der Funktion recv() bevorzugt um eine Standard C-Funktion der Standard C-Library socket.h. Die Funktion recv() liest typischerweise ankommende Daten von einem Socket-Descriptor, in diesem Fall der Socket-Descriptor des Rechnerkerns 2 der Steuervorrichtung 4 der anderen Sicherung 1 (Client) aus dem Schritt 4530 des Verfahrens. Die Funktion recv(), die der Rechnerkern 2 der Steuervorrichtung 4 der Sicherung 1 (Server) typischerweise ausführt, speichert die empfangenen Daten typischerweise in dem temporären Zwischenspeicher 15 des Rechnerkerns 2 der Steuervorrichtung 4 der Sicherung 1 (Server).

Hat der Rechnerkern 2 der Steuervorrichtung 4 der Sicherung 1 (Server) auf diese Weise eine verschlüsselte Nachricht empfangen, so führt bevorzugt der Rechnerkern 2 der Steuervorrichtung 4 der Sicherung 1 (Server) vorzugsweise in einem weiteren Schritt 4560 die Funktion Decrypt() 4560 aus. Diese Funktion Decrypt() ist keine Standard C-Funktion. Die Funktion Decrypt() entschlüsselt in diesem Schritt 4560 im Sinne des hier vorgelegten Dokuments die Nachricht des mittels des in dem Speicher 15 des Rechnerkerns 2 der Steuervorrichtung 4 der Sicherung 1 (Server) zwischengespeicherten privaten Schlüssels des der Rechnerkerns 2 der Steuervorrichtung 4 der Sicherung 1 (Server) aus dem Schritt 4540 gemäß des RSA-Verfahrens. Dadurch entschlüsselt der Rechnerkern 2 der Steuervorrichtung 4 der Sicherung 1 (Server) die empfangene verschlüsselte Nachricht des Clients mittels des in dem Speicher 15 des Rechnerkerns 2 der Steuervorrichtung 4 der Sicherung 1 (Server) zwischengespeicherten privaten Schlüssels aus dem Schritt 4540 gemäß des RSA-Verfahrens. Der Rechnerkern 2 der Steuervorrichtung 4 der Sicherung 1 (Server) speichert vorzugsweise die dann entschlüsselte Nachricht in einen temporären Zwischenspeicher 15 des Rechnerkerns 2 der Steuervorrichtung 4 der Sicherung 1 (Server) ab.

Sofern der Rechnerkern 2 der Steuervorrichtung 4 der Sicherung 1 (Server) in einem vorgegebenen Zeitraum keine Nachricht des Rechnerkerns 2 der Steuervorrichtung 4 der anderen Sicherung 1 (Client) erhält springt der Rechnerkern 2 der Steuervorrichtung 4 der Sicherung 1 (Server) zu dem nun beschriebenen Schritt. Der Rechnerkern 2 der Steuervorrichtung 4 der Sicherung 1 (Server) prüft, ob er eine Nachricht an den Rechnerkern 2 der Steuervorrichtung 4 der anderen Sicherung 1 (Client) versenden soll. Typischerweise ist eine solche Nachricht in einem Speicher 15 des Rechnerkerns 2 der Steuervorrichtung 4 der Sicherung 1 (Server) in einem solchen Fall zu Versendung abgelegt. Ggf. kann der Rechnerkern 2 der Steuervorrichtung 4 der Sicherung 1 (Server) eine solche Nachricht auch von einem anderen Speicher oder System erst vor der Versendung abholen oder übermittelt bekommen. Bevorzugt legt dann der Rechnerkern 2 der Steuervorrichtung 4 der Sicherung 1 (Server) eine solche Nachricht temporär in einem Zwischenspeicher 15 des Rechnerkerns 2 der Steuervorrichtung 4 der Sicherung 1 (Server) ab. Falls eine solche zu versendende Nachricht in einem Speicher 15 oder Zwischenspeicher des Rechnerkerns 2 der Steuervorrichtung 4 der Sicherung 1 (Server) zur Versendung ansteht, führt der Rechnerkern 2 der Steuervorrichtung 4 der Sicherung 1 (Server) vorzugsweise die Funktion Encrypt() in einem weiteren Schritt 4570 aus. Der Rechnerkern 2 der Steuervorrichtung 4 der Sicherung 1 (Server) verschlüsselt in diesem Schritt 4570 in diesem Fall die eigene Nachricht mittels des öffentlichen Schlüssels des Clients aus 4540 gemäß des RSA-Verfahrens. Diese Funktion Encrypt() ist keine Standard C-Funktion. Der Server speichert seine nun verschlüsselte Nachricht in einem temporären Zwischenspeicher 15 des Rechnerkerns 2 der Steuervorrichtung 4 der Sicherung 1 (Server) ab.

Der Rechnerkern 2 der Steuervorrichtung 4 der Sicherung 1 (Server) führt nun die Funktion send() in einem Schritt 4580 aus. In dem Schritt 4580 und sendet der Rechnerkern 2 der Steuervorrichtung 4 der Sicherung 1 (Server) seine im Zwischenspeicher 15 des Rechnerkerns 2 der Steuervorrichtung 4 der Sicherung 1 (Server) gespeicherte, verschlüsselte Nachricht an den Rechnerkern 2 der Steuervorrichtung 4 der anderen Sicherung 1 (Client) über die Datenbusschnittstelle 10, 610, 550, 551 des Rechnerkerns 2 der Steuervorrichtung 4 der Sicherung 1 (Server) und über den Datenbus 9 und über die Datenschnittstelle 10, 610, 550, 551 des Rechnerkerns 2 der Steuervorrichtung 4 der anderen Sicherung 1 (Client). Im Sinne des hier vorliegenden Dokuments handelt es sich bei der Funktion send() um eine Standard C-Funktion der Standard C-Library socket.h. Die Funktion send() sendet Daten über einen Socket-Descriptor, in diesem Fall der Socket-Descriptor des Clients aus dem Schritt 4530. Mit dem Ende der Übertragung ist der typische Zyklus beendet.

Danach startet die verschlüsselte Kommunikation für den Rechnerkern 2 der Steuervorrichtung 4 der Sicherung 1 (Server) erneut wieder bei Schritt 4540.

Wird die Kommunikation durch den Rechnerkern 2 der Steuervorrichtung 4 der Sicherung 1 (Server) oder den Rechnerkern 2 der Steuervorrichtung 4 der anderen Sicherung 1 (Client) beendet, führt der Rechnerkern 2 der Steuervorrichtung 4 der Sicherung 1 (Server) die Funktion close() 4590 aus. Bei der Funktion close() handelt es sich um eine Standard C-Funktion der Standard C-Library socket.h. Durch Ausführen der Funktion close() schließt der Rechnerkern 2 der Steuervorrichtung 4 der Sicherung 1 (Server) die offene Verbindung zu einem Socket, hier dem Socket des Clients, und beendet somit die Kommunikation.

In analoger Weise schließt der Rechnerkern 2 der Steuervorrichtung 4 der anderen Sicherung 1 (Client) einen Client Prozess aus.

Zu Beginn des "Client Process" erzeugt sich der Rechnerkern 2 der Steuervorrichtung 4 der anderen Sicherung 1 (Client) einen Socket-Descriptor in einem Schritt 4600. Ein Socket-Descriptor im Sinne dieses Dokuments ist wieder eine Integer ähnlich File-Handle den beispielsweise die Standard C Library-Funktion socket() der socket.h Library, den der Rechnerkern 2 der Steuervorrichtung 4 der anderen Sicherung 1 (Client) in späteren Funktionsaufrufen, die Sockets nutzen, nutzen kann. der Rechnerkern 2 der Steuervorrichtung 4 der anderen Sicherung 1 (Client) stellt eine Verbindungsanfrage an den Rechnerkern 2 der Steuervorrichtung 4 der Sicherung 1 (Server) unter Benutzung des Port und der IP-Adresse, welche in dem Schritt 4510 festgelegt wurden.

Dazu führt der Rechnerkern 2 der Steuervorrichtung 4 der anderen Sicherung 1 (Client) bevorzugt die Standard C-Funktion connect() der Standard C-Library socket.h aus. Diese Funktion stellt eine Verbindung zwischen dem Server-Socket aus dem Schritt 4510 und dem Client-Socket aus dem Schritt 4600 her.

Wurde die Verbindung seitens des Rechnerkerns 2 der Steuervorrichtung 4 der Sicherung 1 (Server) gemäß Schritt 4530 akzeptiert, so führt der Rechnerkern 2 der Steuervorrichtung 4 der anderen Sicherung 1 (Client) die Funktion KeyExchangeClient() in einem Schritt 4620 aus. Diese Funktion ist keine Standard C-Funktion. Durch Ausführung dieser Funktion erzeugt der Rechnerkern 2 der Steuervorrichtung 4 der anderen Sicherung 1 (Client) mittels des Quantenzufallszahlengenerators 4100, 60 ein oder mehrere QRNG Zufallszahlen aus Zufallsbits 4111. Diese Zufallszahl hat eine Bitbreite n. Hierbei ist n eine positive ganze Zahl einschließlich Null. Diese Zufallszahlen des Quantenzufallszahlengenerators 4100, 60 des Rechnerkerns 2 der Steuervorrichtung 4 der anderen Sicherung 1 (Client) dienen bevorzugt als Indices für eine Look-Up-Tabelle der ersten $2^n$ Primzahlen. Mittels dieser Primzahlen oder anderer Primzahlen erzeugt der Rechnerkern 2 der Steuervorrichtung 4 der anderen Sicherung 1 (Client) sowohl einen öffentlichen als auch privaten Schlüssel gemäß RSA-Verschlüsselung. Der Rechnerkern 2 der Steuervorrichtung 4 der anderen Sicherung 1 (Client) speichert seinen so erzeugten öffentlichen Schlüssel und seinen so erzeugten privaten Schlüssel vorzugsweise in einem Speicher 15 des Rechnerkerns 2 der Steuervorrichtung 4 der anderen Sicherung 1 (Client). Danach versendet der Rechnerkern 2 der Steuervorrichtung 4 der anderen Sicherung 1 (Client) seinen öffentlichen Schlüssel an den Rechnerkern 2 der Steuervorrichtung 4 der Sicherung 1 (Server) über die Datenschnittstelle 10,610, 550 551 des Rechnerkerns 2 der Steuervorrichtung 4 der anderen Sicherung 1 (Client) und über den Datenbus 9 und über die Datenschnittstelle 10, 610, 550, 551 des Rechnerkerns 2 der Steuervorrichtung 4 der Sicherung 1 (Server). Anschließend wartet der Rechnerkern 2 der Steuervorrichtung 4 der anderen Sicherung 1 (Client) auf eine Nachricht des Rechnerkerns 2 der Steuervorrichtung 4 der Sicherung 1 (Server). In dieser Nachricht des ersten Prozessors 10-1 des Rechnerkerns 2 der Steuervorrichtung 4 der Sicherung 1 (Server) befindet sich typischerweise der öffentlichen Schlüssel des Rechnerkerns 2 der Steuervorrichtung 4 der Sicherung 1 (Server).

Im Anschluss führt der Rechnerkern 2 der Steuervorrichtung 4 der anderen Sicherung 1 (Client) die Funktion Encrypt() 4630 aus. Durch dies Ausführung der Funktion Encrypt() im Schritt 4630 verschlüsselt der Rechnerkern 2 der Steuervorrichtung 4 der anderen Sicherung 1 (Client) eine eigene Nachricht mittels des öffentlichen Schlüssels des Rechnerkerns 2 der Steuervorrichtung 4 der Sicherung 1 (Server) aus Schritt 4540 mittels des RSA-Verfahrens. Diese Funktion ist keine Standard C-Funktion. Der Client speichert die verschlüsselte Nachricht in einem temporären Zwischenspeicher 15 ab.

Der Rechnerkern 2 der Steuervorrichtung 4 der anderen Sicherung 1 (Client) führt nun die Funktion send() im Schritt 4640 aus und sendet seine verschlüsselte Nachricht an den Rechnerkern 2 der Steuervorrichtung 4 der Sicherung 1 (Server). Im Sinne des hier vorliegenden Dokuments handelt es sich bei der Funktion send() um eine Standard C-Funktion der Standard C-Library socket.h. Durch ausführen der Funktion send() sendet der Rechnerkern 2 der Steuervorrichtung 4 der anderen Sicherung 1 (Client) Daten über einen Socket-Descriptor, in diesem Fall den Socket-Descriptor des Clients aus 4600.

Im Anschluss führt der Rechnerkern 2 der Steuervorrichtung 4 der anderen Sicherung 1 (Client) die Funktion recv() 4650 aus. Dabei wartet der Rechnerkern 2 der Steuervorrichtung 4 der anderen Sicherung 1 (Client) in dem Schritt 4650 auf eine verschlüsselte Nachricht des Rechnerkerns 2 der Steuervorrichtung 4 der Sicherung 1 (Server). Empfängt der Rechnerkern 2 der Steuervorrichtung 4 der anderen Sicherung 1 (Client) eine Nachricht, so speichert der Rechnerkern 2 der Steuervorrichtung 4 der anderen Sicherung 1 (Client) diese empfangene und typischerweise verschlüsselte Nachricht in einem temporären Zwischenspeicher 15. Im Sinne des hier vorliegenden Dokuments handelt es sich bei der Funktion recv() bevorzugt um eine Standard C-Funktion der Standard C-Library socket.h. Der der Rechnerkern 2 der Steuervorrichtung 4 der anderen Sicherung 1 (Client) liest durch Ausführen der Funktion recv() ankommende Daten von einem Socket-Descriptor, in diesem Fall von dem Socket-Descriptor des Rechnerkerns 2 der Steuervorrichtung 4 der anderen Sicherung 1 (Client) aus dem Schritt 4600. Der Rechnerkern 2 der Steuervorrichtung 4 der anderen Sicherung 1 (Client) speichert die gelesenen Daten vorzugsweise in einen temporären Zwischenspeicher 15 des Rechnerkerns 2 der Steuervorrichtung 4 der anderen Sicherung 1 (Client).

Hat der Rechnerkern 2 der Steuervorrichtung 4 der anderen Sicherung 1 (Client) auf diese Weise eine verschlüsselte Nachricht empfangen, so führt der Rechnerkern 2 der Steuervorrichtung 4 der anderen Sicherung 1 (Client) vorzugsweise die Funktion Decrypt() in einem Schritt 4660 aus. Diese Funktion Decrypt() ist keine Standard C-Funktion. Der Rechnerkern 2 der Steuervorrichtung 4 der anderen Sicherung 1 (Client) entschlüsselt durch Ausführung der Funktion Decrypt() eine durch den Rechnerkern 2 der Steuervorrichtung 4 der anderen Sicherung 1 (Client) empfangene verschlüsselte Nachricht des Rechnerkerns 2 der Steuervorrichtung 4 der Sicherung 1 (Server) mittels des privaten Schlüssels des Rechnerkerns 2 der Steuervorrichtung 4 der anderen Sicherung 1 (Client) aus dem Schritt 4620 mittels des RSA-Verfahrens. Danach speichert der Rechnerkern 2 der Steuervorrichtung 4 der anderen Sicherung 1 (Client) die so entschlüsselte Nachricht in einen temporären Zwischenspeicher 15 des Rechnerkerns 2 der Steuervorrichtung 4 der anderen Sicherung 1 (Client) ab.

Danach startet die Kommunikation zwischen dem Rechnerkern 2 der Steuervorrichtung 4 der Sicherung 1 (Servers) und dem Rechnerkern 2 der Steuervorrichtung 4 der anderen Sicherung 1 (Client) erneut bei Schritt 4620.

Wird die Kommunikation durch den Rechnerkern 2 der Steuervorrichtung 4 der anderen Sicherung 1 (Client) oder den Rechnerkern 2 der Steuervorrichtung 4 der Sicherung 1 (Server) beendet, führt der Rechnerkern 2 der Steuervorrichtung 4 der anderen Sicherung 1 (Client) die Funktion close() im Schritt 4670 aus. Bei der Funktion close() handelt es sich um eine Standard C-Funktion der Standard C-Library socket.h. Dadurch, dass der Rechnerkern 2 der Steuervorrichtung 4 der anderen Sicherung 1 (Client) die Funktion close() ausführt, schließt der Rechnerkern 2 der Steuervorrichtung 4 der anderen Sicherung 1 (Client) die offene Verbindung zu einem Socket und beendet somit die Kommunikation mit dem Rechnerkern 2 der Steuervorrichtung 4 der Sicherung 1 (Server).

Figur 46

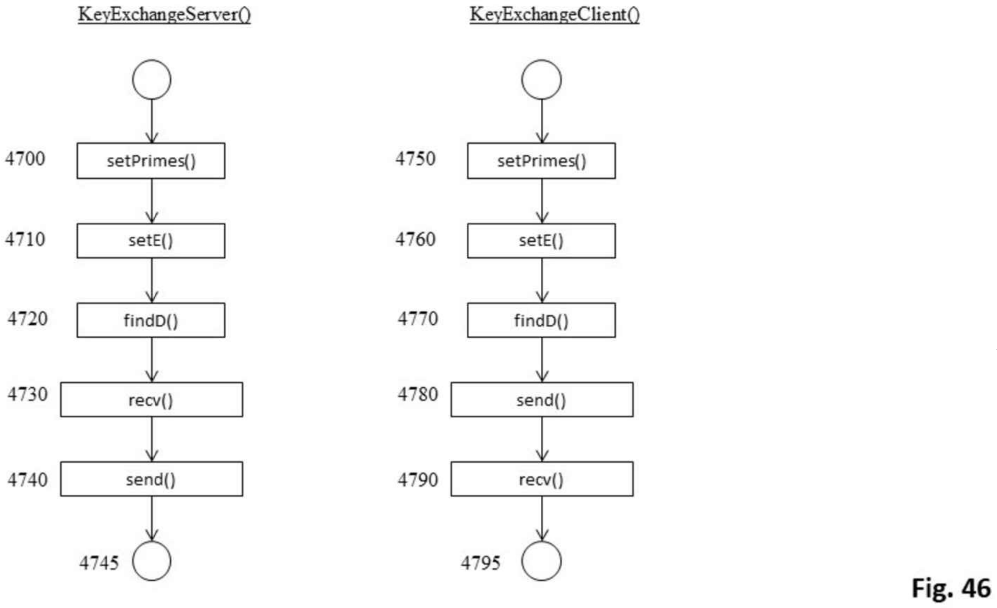

Figur 46 zeigt den schematischen Ablauf der Funktionen KeyExchangeServer() und KeyExchangeClient().

Beim Starten der Funktion KeyExchangeServer() ruft der Rechnerkern 2 der Steuervorrichtung 4 der Sicherung 1 (Server) jeweils zuerst die Funktion setPrimes() im Schritt 4700 auf. Diese Funktion KeyExchangeServer() ist keine Standard C-Funktion. Der Rechnerkern 2 der Steuervorrichtung 4 der Sicherung 1 (Server) erzeugt mittels der Funktion KeyExchangeServer() zwei verschieden Primzahlen p und q, das Produkt n=p*q und die Eulersche Phi-Funktion phi = (p-1)(q-1) im Schritt 3200.

Danach ruft der Rechnerkern 2 der Steuervorrichtung 4 der Sicherung 1 (Server) die Funktion setE() im Schritt 4710 auf. Diese Funktion setE() im Schritt 4710 ist keine Standard C-Funktion. Beim Aufruf der Funktion setE() im Schritt 4710 generiert der Rechnerkern 2 der Steuervorrichtung 4 der Sicherung 1 (Server) eine zu phi teilerfremde Zahl e, wobei die Zahl phi die aus dem Schritt 4700 ist. Teilerfremd in Sinne des vorliegenden Dokuments bedeutet, dass es keine natürliche Zahl außer der Zahl eins gibt, die gleichzeitig die Zahl e und die phi teilt.

Im Anschluss führt der Rechnerkern 2 der Steuervorrichtung 4 der Sicherung 1 (Server) die Funktion findD() im Schritt 4720 aus. Diese Funktion findD() ist keine Standard C-Funktion. Der Rechnerkern 2 der Steuervorrichtung 4 der Sicherung 1 (Server) berechnet mittels der Funktion findD() das multiplikative Inverse zu e, sodass gilt (e*d)mod phi = 1.

Nun ruft der Rechnerkern 2 der Steuervorrichtung 4 der Sicherung 1 (Server) die Funktion recv() im Schritt 4730 auf. Der Rechnerkern 2 der Steuervorrichtung 4 der Sicherung 1 (Server) wartet nun auf eine eintreffende Nachricht des Rechnerkerns 2 der Steuervorrichtung 4 der anderen Sicherung 1 ( Client), die typischerweise den öffentlichen Schlüssel des Clients umfassen sollte. Im Sinne des hier vorliegenden Dokuments handelt es sich bei der Funktion recv() um eine Standard C-Funktion der Standard C-Library socket.h. Durch Aufruf der Funktion recv() liest der Rechnerkern 2 der Steuervorrichtung 4 der Sicherung 1 (Server) die ankommenden Daten von einem Socket-Descriptor, in diesem Fall der Socket-Descriptor des Clients. Der Rechnerkern 2 der Steuervorrichtung 4 der Sicherung 1 (Server) speichert die gelesenen Daten vorzugsweise in einen temporären Zwischenspeicher 15 des Rechnerkerns 2 der Steuervorrichtung 4 der Sicherung 1 (Server).

Nun ruft der Rechnerkern 2 der Steuervorrichtung 4 der Sicherung 1 (Server) die Funktion send() im Schritt 4740 auf. In diesem Schritt 4740 versendet der Rechnerkern 2 der Steuervorrichtung 4 der Sicherung 1 (Server) seinen öffentlichen Schlüssel (d, n) aus den Schritten 4700 und 4720 an den Rechnerkern 2 der Steuervorrichtung 4 der anderen Sicherung 1 (Client). Im Sinne des hier vorliegenden Dokuments handelt es sich bei der Funktion send() um eine Standard C-Funktion der Standard C-Library socket.h. Der Rechnerkern 2 der Steuervorrichtung 4 der Sicherung 1 (Server) sendet mittels der Funktion send() Daten über einen Socket-Descriptor, in diesem Fall der Socket-Descriptor des Clients aus dem Schritt 4530.

Im Anschluss verlässt der Rechnerkern 2 der Steuervorrichtung 4 der Sicherung 1 (Server) die Funktion KeyExchangeServer() im Schritt 4745.

Beim Starten der Funktion KeyExchangeClient() ruft der Rechnerkern 2 der Steuervorrichtung 4 der anderen Sicherung 1 (Client) zuerst die Funktion setPrimes() im Schritt 4750 auf. Diese Funktion ist keine Standard C-Funktion. Der Rechnerkern 2 der Steuervorrichtung 4 der anderen Sicherung 1 (Client) erzeugt mittels der Funktion KeyExchangeClient(), die Primzahl p und die von q verschiedene Primzahl q. Der Rechnerkern 2 der Steuervorrichtung 4 der anderen Sicherung 1 (Client) erzeugt mittels der Funktion KeyExchangeClient() das Produkt n=p*q. Der Rechnerkern 2 der Steuervorrichtung 4 der anderen Sicherung 1 (Client) erzeugt mittels der Funktion KeyExchangeClient() die Eulersche Phi-Funktion phi = (p-1)(q-1).

Danach ruft der Rechnerkern 2 der Steuervorrichtung 4 der anderen Sicherung 1 (Client) die Funktion setE() im Schritt 4760 auf. Diese Funktion ist keine Standard C-Funktion. Der Rechnerkern 2 der Steuervorrichtung 4 der anderen Sicherung 1 (Client) erzeugt mittels der Funktion setE() eine zur Zahl phi aus dem Schritt 4750 teilerfremde ganze Zahl e. Teilerfremd in Sinne des vorliegenden Dokuments bedeutet, dass es keine natürliche Zahl außer der Zahl eins gibt, die gleichzeitig die Zahl e und die phi restfrei teilt.

Im Anschluss ruft der Rechnerkern 2 der Steuervorrichtung 4 der anderen Sicherung 1 (Client) die Funktion findD() 4770 auf. Diese Funktion ist keine Standard C-Funktion. Der Rechnerkern 2 der Steuervorrichtung 4 der anderen Sicherung 1 (Client) berechnet mittels der Funktion findD() das multiplikative Inverse zur Zahl e, sodass gilt (e*d)mod phi = 1.

Nun ruft der Rechnerkern 2 der Steuervorrichtung 4 der anderen Sicherung 1 (Client) die Funktion send() 4780 auf und versendet seinen öffentlichen Schlüssel (d, n) aus den Schritten 4750 und 4770 an den Rechnerkern 2 der Steuervorrichtung 4 der Sicherung 1 (Server). Im Sinne des hier vorliegenden Dokuments handelt es sich bei der Funktion send() um eine Standard C-Funktion der Standard C-Library socket.h. Der Rechnerkern 2 der Steuervorrichtung 4 der anderen Sicherung 1 (Client) sendet mittels der Funktion send() Daten über einen Socket-Descriptor, in diesem Fall der Socket-Descriptor des Clients aus Schritt 4600.

Nun ruft der Rechnerkern 2 der Steuervorrichtung 4 der anderen Sicherung 1 (Client) die Funktion recv() im Schritt 4790 auf. Der Rechnerkern 2 der Steuervorrichtung 4 der anderen Sicherung 1 (Client) wartet nun auf eine eintreffende Nachricht des Rechnerkerns 2 der Steuervorrichtung 4 der Sicherung 1 (Server) mit dem öffentlichen Schlüssel des Rechnerkerns 2 der Steuervorrichtung 4 der Sicherung 1 (Server). Im Sinne des hier vorliegenden Dokuments handelt es sich bei der Funktion recv() um eine Standard C-Funktion der Standard C-Library socket.h. Der Rechnerkern 2 der Steuervorrichtung 4 der anderen Sicherung 1 (Client) liest mittels der Funktion recv() ankommende Daten des Rechnerkerns 2 der Steuervorrichtung 4 der s Sicherung 1 (Server) von einem Socket-Descriptor, in diesem Fall von dem Socket-Descriptor des Clients aus Schritt 4600, und speichert die Daten in einen temporären Zwischenspeicher 15 des Rechnerkerns 2 der Steuervorrichtung 4 der anderen Sicherung 1 (Client).

Im Anschluss verlässt der Rechnerkern 2 der Steuervorrichtung 4 der anderen Sicherung 1 (Client) die Funktion KeyExchangeClient() im Schritt 4795.

Figur 47

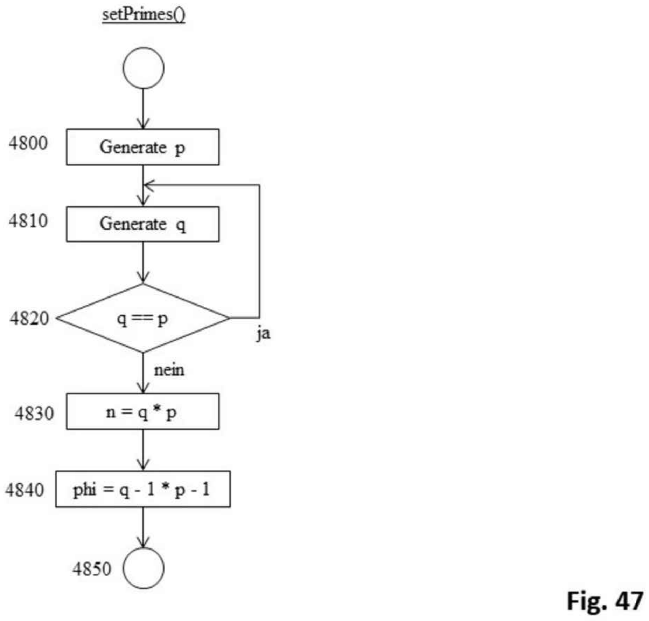

Figur 47 zeigt schematischen Ablauf der Funktion setPrimes().

Der Rechnerkern 2 der Steuervorrichtung 4 der anderen Sicherung 1 (Client) und der Rechnerkern 2 der Steuervorrichtung 4 der Sicherung 1 (Server) rufen diese Funktion zur gegebenen Zeit jeweils auf. Ruft einer dieser Rechner die Funktion setPrimes() auf, so erzeugt sich der aufrufende Rechner, in Fall des vorliegenden Dokuments der Rechnerkern 2 der Steuervorrichtung 4 der Sicherung 1 (Server) oder der Rechnerkern 2 der Steuervorrichtung 4 der anderen Sicherung 1 (Client), eine Zufallszahl mittels eines Quantum Random Number Generators QRNG im Schritt 4800. Diese Zufallszahl hat eine Bitbreite n. Hierbei ist n eine positive ganze Zahl einschließlich Null. Diese Zufallszahlen dienen in der technischen Lehre des hier vorgelegten Dokuments als Indices für eine Look-Up-Tabelle der ersten $2^n$ Primzahlen. Der aufrufende Rechner speichert die Primzahl, die durch die Zufallszahl indiziert wird, wird als Variable p ab.

Danach generiert der aufrufende Rechner eine weitere Zufallszahl im Schritt 4810 mit der bevorzugten Bitbreite n mittels des Quantenzufallszahlengenerators 4100, 60 QRNG. Diese Zufallszahlen dienen dem aufrufenden Rechner bevorzugt wieder als Indices für eine Look-Up-Tabelle der ersten $2^n$ Primzahlen. Die Primzahl, die durch die Zufallszahl indiziert wird, speichert der aufrufende Rechner als Variable q in einem Zwischenspeicher 15 des aufrufenden Rechners, dessen Teil der Rechner bevorzugt ist, ab.

Nun überprüft der aufrufende Rechner im Schritt 4820, ob die logische Aussage q ==p gilt. Gilt diese Aussage wird Schritt 4810 wiederholt.

Im Anschluss berechnet der aufrufende Rechner das Produkt n = p * q im Schritt 4830.

Danach berechnet der aufrufende Rechner die Eulersche Phi-Funktion phi = (q-1) * (p-1) im Schritt 4840.

Im Anschluss verlässt der aufrufende Rechner die Funktion setPrimes() im Schritt 4850.

Figur 48

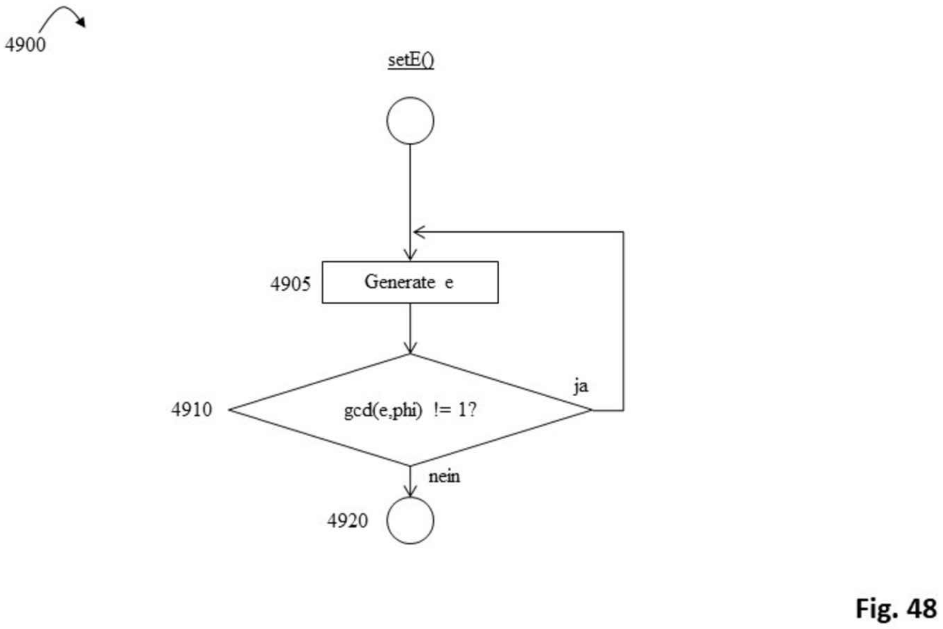

Die Figur 48 zeigt den schematischen Ablauf der Funktion setE() 4900. Beim Aufrufen der Funktion setE() im Schritt 4900 generiert der aufrufende Rechner, in Fall des vorliegenden Dokument der Rechnerkern 2 der Steuervorrichtung 4 der anderen Sicherung 1 (Client) oder der Rechnerkern 2 der Steuervorrichtung 4 der Sicherung 1 (Server), eine zufällige Zahl e für die gilt, dass e teilerfremd zur Zahl phi ist. Teilerfremd in Sinne des vorliegenden Dokuments bedeutet, dass es keine natürliche Zahl außer der Zahl eins gibt, die gleichzeitig die Zahl e und die phi teilt. Der aufrufende Rechner kann die Zahl e sowohl durch eine Zufallszahl des Quantenzufallszahlen-Generators 4100, 60 QRNG als auch durch einen Pseudozufallszahlengenerator PRNG als auch durch Hochintegrieren einer Integer-Zahl beginnend mit 2 erzeugen. Die Erzeugung mittels des Quantenzufallszahlengenerators 4100, 60 QRNG ist aber bevorzugt.

Danach überprüft der aufrufende Rechner im Schritt 4910, ob die logische Aussage gcd(e,phi) != 1 erfüllt ist.

Ist die logische Aussage erfüllt, wiederholt der aufrufende Rechner den Schritt 4900.

Ist die logische Aussage nicht erfüllt, so verlässt der aufrufende Rechner die Funktion setE()und gibt den aktuelle Wert von e als Rückgabewert an den aufrufenden Rechner zurück. Bei der Funktion gcd(a,b) handelt es sich nicht um eine Standard C-Funktion. Der aufrufende Rechner berechnet mittels dieser Funktion gcd(a,b) den größten gemeinsamen Teiler der Übergabeparameter a, b und gibt das Ergebnis an den aufrufenden Rechner zurück.

Figur 49

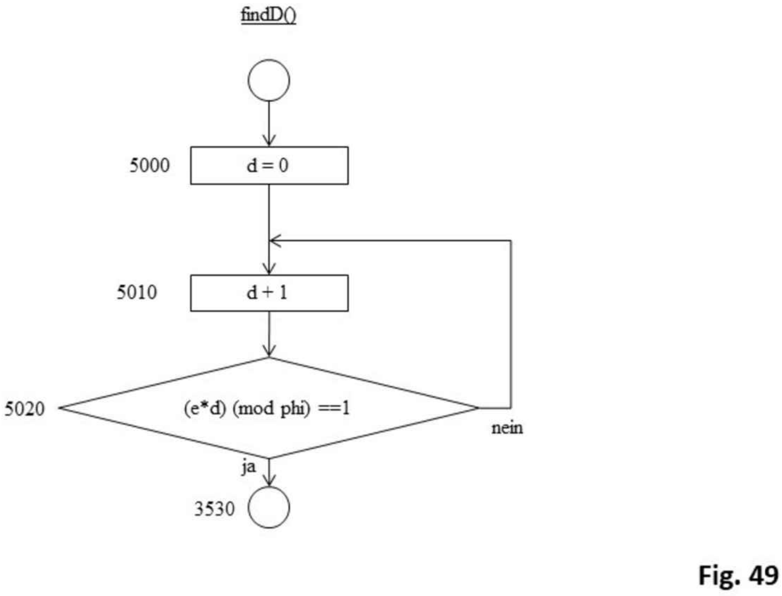

Figur 49 zeigt den schematischen Ablauf der Funktion findD(). Wenn der aufrufende Rechner die Funktion findD() im Schritt 5000 aufruft, so initialisiert der aufrufende Rechner im Schritt 5000 eine Variablen d mit 0.

In dem nachfolgenden Schritt 5010 addiert der aufrufende Rechner zu der Zahl d die Zahl 1 hinzu.

Nun überprüft im Schritt 5020 der aufrufende Rechner, ob die logische Aussage (e*d) (mod phi) == 1 erfüllt ist. Ist die logische Aussage (e*d) (mod phi) == 1 nicht erfüllt, so wiederholt der aufrufende Rechner die Schritte ab Schritt 5010.

Ist die logische Aussage (e*d) (mod phi) == 1 erfüllt, so verlässt in dem Schritt 5030 der aufrufende Rechner die Funktion findD() und der aufrufende Rechner gibt den aktuellen Wert von d als Rückgabewert an den aufrufenden Rechner, in Fall des vorliegenden Dokument den Rechnerkern 2 der Steuervorrichtung 4 der anderen Sicherung 1 (Client) oder den Rechnerkern 2 der Steuervorrichtung 4 der Sicherung 1 (Server).

Figur 50

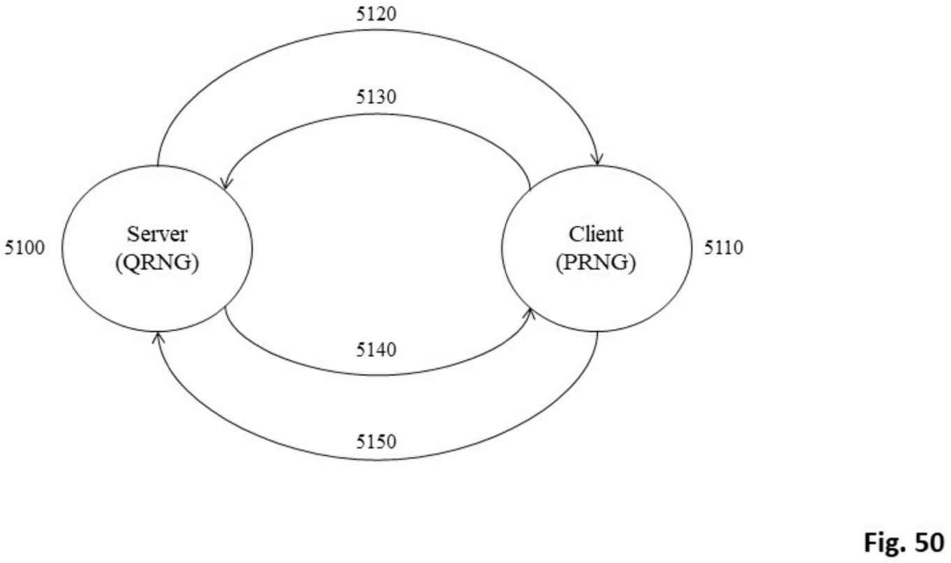

Figur 50 zeigt den schematische Ablauf einer sicheren Übertragung von quantenbasierten Zufallszahlen zwischen einem Rechnerkern 2 der Steuervorrichtung 4 der Sicherung 1 (Server) 5100 und einem Rechnerkern 2 der Steuervorrichtung 4 der anderen Sicherung 1 (Client) 5110.

Im Fall des vorliegenden Dokuments handelt es sich bei dem Server 5100 um einen Rechnerkern 2 der Steuervorrichtung 4 der Sicherung 1 (Server), wobei der Rechnerkern 2 der Steuervorrichtung 4 der Sicherung 1 (Server) 5100 einen Quantenzufallszahlengenerator 4100, 60 QRNG aufweist. Im Fall des vorliegenden Dokuments handelt es sich bei dem Client 5110 um einen weiteren Rechnerkern 2 der Steuervorrichtung 4 der anderen Sicherung 1 (Client), wobei nun dieser Rechnerkern 2 der Steuervorrichtung 4 der anderen Sicherung 1 (Client) 5110 nun ausdrücklich KEINEN Quanten-Zufallszahlen-Generator 4100,60 QRNG aufweist.

Zu Beginn erzeugt sich der Rechnerkern 2 der Steuervorrichtung 4 der Sicherung 1 (Server) 5100 Quantenzufallszahlen QZ1. Die Quantenzufallszahlen QZ1 dienen den Rechnerkern 2 der Steuervorrichtung 4 der Sicherung 1 (Server) 5100 als Grundlage für die Erzeugung eines privaten und eines öffentlichen Schlüssels des Servers 5100 gemäß einem asymmetrischen Verschlüsselungsverfahren.

Bei dem asymmetrischen Verschlüsselungsverfahren kann es sich zum Beispiel um das RSA-Verfahren handeln.

Der Rechnerkern 2 der Steuervorrichtung 4 der Sicherung 1 (Server) 5100 versendet in einem Schritt 5120 den öffentlichen Schlüssel des Servers 5100 über einen nicht abhörsicheren Kanal an den Rechnerkern 2 der Steuervorrichtung 4 der anderen Sicherung 1 (Client) 5110.

Im Anschluss erzeugt sich der Rechnerkern 2 der Steuervorrichtung 4 der anderen Sicherung 1 (Client) 5110 eine Pseudozufallszahl PZ oder eine anders erzeugte Zufallszahl. Der Rechnerkern 2 der Steuervorrichtung 4 der anderen Sicherung 1 (Client) 5110 speichert die Pseudozufallszahl PZ bzw. die anders erzeugte Zufallszahl in einem Speicher 15 des Rechnerkerns 2 der Steuervorrichtung 4 der anderen Sicherung 1 (Client) 5110 ab. Der Rechnerkern 2 der Steuervorrichtung 4 der anderen Sicherung 1 (Client) 5110 erzeugt einen ersten privaten Schlüssel des Clients 5110 und einen ersten öffentlichen Schlüssel des Clients 5110 unter Benutzung dieser Pseudozufallszahl PZ bzw. dieser anders erzeugten Zufallszahl.

Der Rechnerkern 2 der Steuervorrichtung 4 der anderen Sicherung 1 (Client) 5110 verschlüsselt den ersten öffentlichen Schlüssel des Clients 5110 mittels des öffentlichen Schlüssels des Servers 5100.

Danach versendet der Rechnerkern 2 der Steuervorrichtung 4 der anderen Sicherung 1 (Client) 5110 den verschlüsselten ersten öffentlichen Schlüssel des Clients 5110 an den Rechnerkern 2 der Steuervorrichtung 4 der Sicherung 1 (Server) 5100.

Der Rechnerkern 2 der Steuervorrichtung 4 der Sicherung 1 (Server) 5100 entschlüsselt nun diese Nachricht mit seinem ersten privaten Schlüssel. Hierdurch verfügt nun der Rechnerkern 2 der Steuervorrichtung 4 der Sicherung 1 (Client) 3600 über den ersten öffentlichen Schlüssel des Clients 5110 ohne dass dieser Dritten bekannt sein kann.

Im Anschluss Erzeugt der Rechnerkern 2 der Steuervorrichtung 4 der Sicherung 1 (Server) 5100 mittels des Quantenzufallszahlengenerators 4100, 60 eine weitere, zweite Quantenzufallszahl QZ2. Die Bitbreite dieser zweiten Quantenzufallszahl ist bevorzugt gleich der Bitbreite, der Zufallszahl PZ des Clients 5110.

Der Rechnerkern 2 der Steuervorrichtung 4 der Sicherung 1 (Server) 5100 verschlüsselt nun die zweite Quantenzufallszahl QZ2 mit dem ersten öffentlichen Schlüssel des Clients 5110. Beispielsweise kann der erste öffentliche Schlüssel des Clients 5110 die gleiche Länge in Anzahl der Bits wie diese neue Quantenzufallszahl QZ2 haben. In dem Fall kann der Rechnerkern 2 der Steuervorrichtung 4 der Sicherung 1 (Server) 5100 die zweite Quantenzufallszahl QZ2 beispielsweise durch bitweise XOR-Verknüpfung der zweiten Quantenzufallszahl QZ2 mit PZ zu einer verschlüsselten zweiten Quantenzufallszahl QZ2' verschlüsseln. Der Rechnerkern 2 der Steuervorrichtung 4 der Sicherung 1 (Server) 5100 versendet dann bevorzugt die verschlüsselte zweite Quantenzufallszahl QZ2' an den Rechnerkern 2 der Steuervorrichtung 4 der anderen Sicherung 1 (Client) 5110 in einem Schritt 5140.

Der Rechnerkern 2 der Steuervorrichtung 4 der anderen Sicherung 1 (Client) 5110 entschlüsselt die verschlüsselte zweite Quantenzufallszahl QZ2' unter Benutzung seines ersten privaten Schlüssels zur zweiten Quantenzufallszahl QZ2. Hat der Rechnerkern 2 der Steuervorrichtung 4 der anderen Sicherung 1 (Client) 5110 die zweite verschlüsselte Quantenzufallszahl QZ2' durch bitweise XOR-Verknüpfung der Zufallszahl PZ mit der zweiten Quantenzufallszahl QZ2 ermittelt, so kann der Rechnerkern 2 der Steuervorrichtung 4 der anderen Sicherung 1 (Client) 5110 beispielsweise durch bitweise XOR-Verknüpfung der verschlüsselten zweiten Quantenzufallszahl QZ2' mit der ihm bekannten Zufallszahl PZ zur zweiten Quantenzufallszahl QZ2 entschlüsseln.

Bevorzugt nutzt der Rechnerkern 2 der Steuervorrichtung 4 der anderen Sicherung 1 (Client) 5110 die ihm nun vorliegende zweite Quantenzufallszahl QZ2 als Grundlage für die Erzeugung eines zweiten privaten und eines zweiten öffentlichen Schlüssels gemäß einem asymmetrischen Verschlüsselungsverfahren. Bei dem asymmetrischen Verschlüsselungsverfahren kann es sich zum Beispiel um das RSA-Verfahren handeln. Der Rechnerkern 2 der Steuervorrichtung 4 der anderen Sicherung 1 (Client) 5110 verschickt nun seinen zweiten öffentlichen Schlüssel über den nicht abhörsicheren Kanal an den Server 5100. Hierbei verschlüsselt er bevorzugt diesen zweiten öffentlichen Schlüssel des Clients 5110 mit dem öffentlichen Schlüssel des Servers 5100. Der Server 5100 entschlüsselt den verschlüsselten zweiten öffentlichen Schlüssel des Clients 5110 und verwendet dann diesen zweiten öffentlichen Schlüssel des Clients für die Verschlüsselung weiterer Nachrichten an den Rechnerkern 2 der Steuervorrichtung 4 der anderen Sicherung 1 (Client) 5110. Bevorzugt erzeugt und sendet der Rechnerkern 2 der Steuervorrichtung 4 der Sicherung 1 (Server) 5100 nach einer vorbestimmten Zeit oder einer nach dem Versenden einer vorbestimmten Datenmenge an den Rechnerkern 2 der Steuervorrichtung 4 der anderen Sicherung 1 (Client) 5110 einen neuen öffentlichen Schlüssel auf Basis einer neuen Quantenzufallszahl seines Quantenzufallszahlengenerators 4100, 60 QRNG verschlüsselt mit dem zweiten öffentlichen Schlüssel des Clients 5110. Bevorzugt führen dann der Rechnerkern 2 der Steuervorrichtung 4 der Sicherung 1 (Server) 5100 und der Rechnerkern 2 der Steuervorrichtung 4 der anderen Sicherung 1 (Client) 5110 das zuvor beschriebene Verfahren erneut durch, sodass die Schlüssel permanent wechseln. Dies macht es auch einem Quantencomputer unmöglich, die Schlüssel zu brechen.

Hierdurch können die beteiligten Rechner nach Austausch dieser Schlüssel die Kommunikation auf Basis des gewählten asymmetrischen Verschlüsselungsverfahrens durchführen.

Figur 51

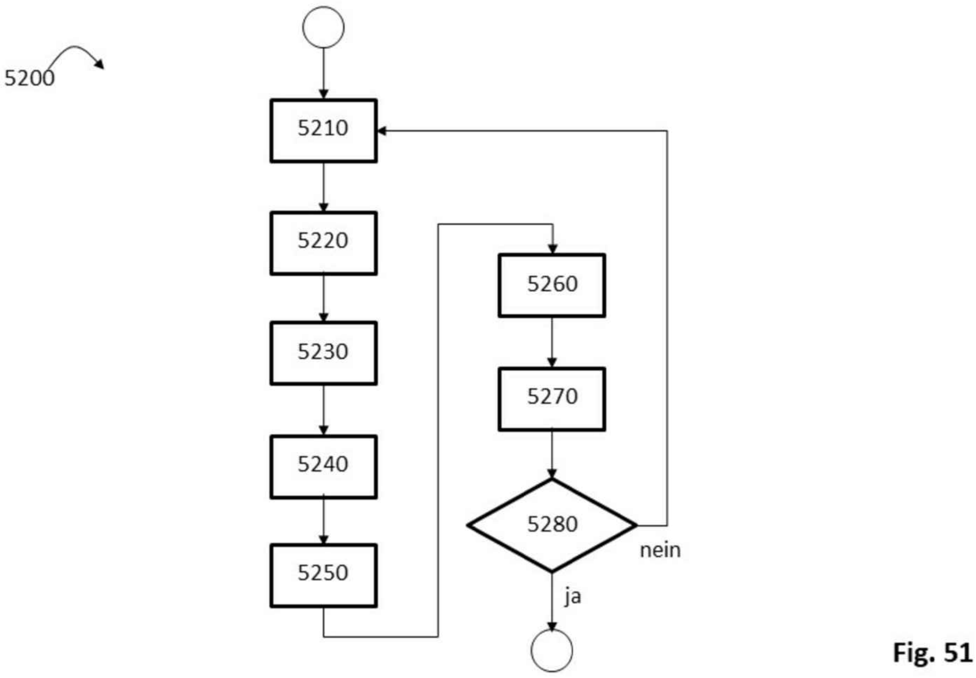

Figur 51 zeigt schematisch das vorschlagsgemäße Verfahren 5200 zur Erzeugung einer Quantenzufallszahl. Das Verfahren 5200 beginnt mit der Erzeugung 5210 eines zufälligen Einzelphotonenstroms (3957, 3958, 3959, 4101.2) mittels einer oder mehrerer erster SPAD-Dioden (4101.1, 3954). Das Verfahren 5200 setzt sich fort mit der Übertragung 5220 des zufälligen Einzelphotonenstroms (3957, 3958, 3959, 4101.2) mittels eines vom Halbleitersubstrat (3949, 3948) verschiedenen Lichtwellenleiters (3944, 4101.2) an eine oder mehrere zweite SPAD-Dioden (4101.3, 3955). Es folgt die Wandlung 5230 des zufälligen Einzelphotonenstroms (3957, 3958, 3959, 4101.2) in ein Detektionssignal in Form eines Spannungssignal 4105 der Entropie Quelle 4101, die bevorzugt die ersten SPAD-Dioden 4101.1 und den Lichtwellenleiter 4101.2 und die zweiten SPAD-Dioden 4101.3 umfasst. Dann folgt das Aufbereiten 5240, insbesondere ein Verstärken und/oder ein Filtern und/oder ein Analog-zu-Digital-Wandeln, des Detektionssignals in ein aufbereitetes Detektionssignal, insbesondere einen digitalen 14 Bit-Wert 4107 des Analog-zu-Digital-Wandlers 4103. Dann erfolgt das Abtrennen 5250 der durch Kopplungen der Emissionen einer ersten SPAD-Diode 4101.1 und einer zweiten SPAD-Diode 4101.3 entstandenen Pulse des aufbereiteten Detektionssignals von den durch spontane Emission entstandenen Pulsen des aufbereiteten Detektionssignals durch Vergleich des aufbereiteten Detektionssignals mit einem Schwellwert 4104.1, insbesondere in einem Komparator 4104.2 und die Erzeugung eines entsprechenden Ausgangssignals 4109, insbesondere des Komparators 4104.2. Sodann folgt die Ermittlung 5260 eines ersten zeitlichen Abstands zwischen dem ersten Puls und dem zweiten Puls eines ersten Pulspaares aus zwei aufeinander folgenden, durch Kopplungen der Emissionen einer ersten SPAD-Diode 4101.1 und einer zweiten SPAD-Diode 4101.3 entstandenen Pulse des aufbereiteten Detektionssignals und die Ermittlung eines zweiten zeitlichen Abstands zwischen einem dritten Puls und einem vierten Puls eines zweiten Pulspaares aus zwei aufeinander folgenden, durch Kopplungen der Emissionen einer ersten SPAD-Diode 4101.1 und einer zweiten SPAD-Diode 4101.3 entstandenen Pulse des aufbereiteten Detektionssignals und, insbesondere zur Ermittlung des ersten Werts des Ausgangs 4110 des Zeit-zu-Digital-Wandlers 4104.3 und des zweiten Werts des Ausgangs 4110 des Zeit-zu-Digital-Wandlers 4104.3. Auf dieser Basis erfolgt dann die Ermittlung 5270 des Bit-Werts eines Zufallsbits durch Vergleich des Werts des ersten zeitlichen Abstands und des Werts des zweiten zeitlichen Abstands. In einer letzten Überprüfung 5280 überprüft der Rechnerkern 2 der Steuervorrichtung 4 der Sicherung 1, ob die Anzahl n der ermittelten Zufallsbits noch kleiner als die gewünschte Zahl m der Zufallsbits der gewünschten Quantenzufallszahl ist. Sofern dies nicht der Fall ist wiederholt der Rechnerkern 2 der Steuervorrichtung 4 der Sicherung 1 die vorstehenden Schritte. Ansonsten beendet der Rechnerkern 2 der Steuervorrichtung 4 der Sicherung 1 den Prozess zur Erzeugung einer Quantenzufallszahl.

Figur 52

Figur 52 zeigt eine allgemeine Vierfachsicherung mit nur einer Steuervorrichtung 4. Die gemeinsame Steuervorrichtung 4 der Mehrfachsicherung 1 verfügt für jede abgesicherte Leitung über eine jeweilige Gate-Ansteuerschaltung (16, 16', 16", 16''') für die Ansteuerung und Überwachung des jeweiligen Leistungsschalters (17, 17', 17", 17'''). Jeder der jeweiligen Leistungsschalter (17, 17', 17", 17''') verfügt über einen jeweiligen ersten Anschluss (18, 18', 18", 18''') und einen jeweiligen zweiten Anschluss (19, 19', 19", 19''') des jeweiligen Leistungsschalters (17, 17', 17", 17'''). Jedem Leistungsschalter (17, 17', 17", 17''') ist wieder analog zur Figur 1 ein jeweiliger Hilfsleistungsschalter (23, 23', 23", 23'''), bevorzugt mit einem jeweiligen Shunt-Widerstand (24, 24', 24", 24'''), zugeordnet und mit dem jeweiligen Leistungsschalter (17, 17', 17", 17''') analog zur Figur 1 zugeordnet. Die elektronische Mehrfachsicherung der Figur 52 umfasst somit einen ersten Sicherungskanal (16, 18, 17, 19, 26, 27, 28, 20, 21, 22, 23, 24, 25) und einen zweiten Sicherungskanal (16', 18', 17', 19', 26', 27', 28', 20', 21', 22', 23', 24', 25') und einen dritten Sicherungskanal (16", 18", 17", 19", 26", 27", 28", 20", 21", 22", 23", 24", 25") und einen vierten Sicherungskanal (16''', 18''', 17''', 19''', 26''', 27''', 28''', 20''', 21''', 22''', 23''', 24''', 25'''). Der Rechnerkern (2) der Steuervorrichtung (4) steuert und überwacht über die jeweilige Gate-Ansteuerschaltung (16, 16', 16", 16''') des jeweiligen Sicherungskanals den jeweiligen Leistungsschalter (17, 17', 17", 17''') des jeweiligen Sicherungskanals. Dieses Steuern und Überwachen mittels einer einzelnen Gate-Ansteuerschaltung (16, 16', 16", 16''') ist bereits in der Beschreibung der Figur 1 beschrieben.

In der Figur 52 sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 53, 54, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Die Funktionen der jeweiligen Steuerleitungen (20, 20', 20", 20''') zur Steuerung des jeweiligen Leistungsschalters (17, 17', 17", 17''') lassen sich dort nachlesen.

Die Funktionen der jeweiligen Überwachungsleitung (20, 20', 20", 20''') zur Erfassung der Spannung zwischen dem jeweiligen zweiten Anschluss (19, 19', 19", 19''') des jeweiligen Leistungsschalters (17, 17', 17", 17''') und der jeweiligen Steuerleitung (20, 20', 20", 20''') des jeweiligen Leistungsschalters (17, 17', 17", 17''') lassen sich dort nachlesen.

Die Funktionen der jeweiligen Überwachungsleitung (22, 22', 22", 22''') zur Erfassung der Spannung zwischen dem jeweiligen ersten Anschluss (18, 18', 18", 18''') des jeweiligen Leistungsschalters (17, 17', 17", 17''') und der jeweiligen Steuerleitung (20, 20', 20", 20''') des jeweiligen Leistungsschalters (17, 17', 17", 17''') lassen sich dort nachlesen.

Die Funktionen der jeweiligen Messleitung (25, 25, 25", 25''') zur Erfassung des Spannungsabfalls über den jeweiligen Shunt-Widerstand (24, 24', 24", 24''') lassen sich dort nachlesen.

Vorzugsweise wird die Mehrfachsicherung der Figur 52 monolithisch oder als Modul mit einem mikroelektronischen Schaltkreis, der vorzugsweise die Steuervorrichtung 4 und bevorzugt auch die Shunt-Widerstände (24, 24', 24", 24''') umfasst und vorzugsweise in einer CMOS-Technologie hergestellt ist, gefertigt. Eine solche Mehrfach Sicherung kann als Kreuzsicherung 1000 oder als Dreifachsicherung 3010 oder als Drehstromsicherung mit Sternpunktsabsicherung über den vierten Sicherungskanal eingesetzt werden, ohne die Hardware ändern zu müssen.

Beispielsweise ist es sinnvoll, die zweiten Anschlüsse (19, 19', 19", 19''') elektrisch zu verbinden und den ersten Sicherungskanal (16, 18, 17, 19, 26, 27, 28, 20, 21, 22, 23, 24, 25) für die Absicherung der Masseableitung einer ersten Halbbrücke für die erste Drehstromphase R (L1) zu verwenden und den zweiten Sicherungskanal (16', 18', 17', 19', 26', 27', 28', 20', 21', 22', 23', 24', 25') für die Absicherung der Masseableitung einer ersten Halbbrücke für die zweite Drehstromphase S (L2) zu verwenden und den dritten Sicherungskanal (16", 18", 17", 19", 26", 27", 28", 20", 21", 22", 23", 24", 25") für die Absicherung der Masseableitung einer ersten Halbbrücke für die dritte Drehstromphase T (L3) zu verwenden. Die zweiten Anschlüsse (19, 19', 19", 19''') bilden dann den Sternpunkt. Der vierte Sicherungskanal (16''', 18''', 17''', 19''', 26''', 27''', 28''', 20''', 21''', 22''', 23''', 24''', 25''') kann dann den Sternpunkt gegen die Bezugsmasse, typischerweise die Erdung, über seinen ersten Anschluss (18''') absichern.

Figur 53

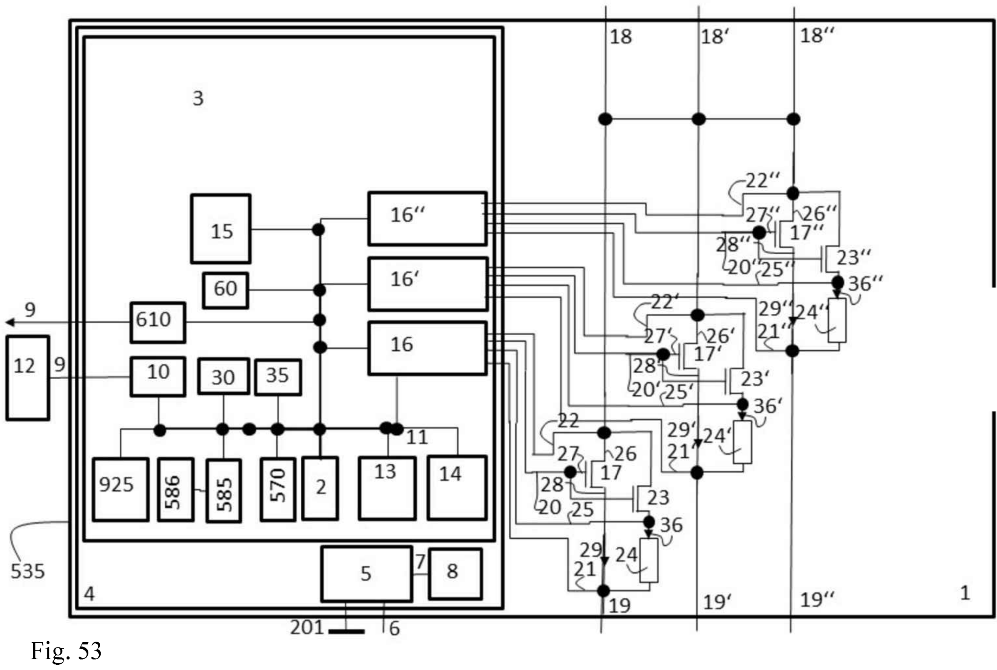

Figur 53 zeigt die allgemeine Vierfachsicherung der Figur 52 als allgemeine Dreifachsicherung, wobei die drei Leistungsschalter 17, 17' und 17" im Stern zusammengeschaltet sind, so dass sie z. B. als Dreifachsicherung 3010' der Figur 31 einsetzbar ist.

In der Figur 53 sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 54, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Figur 54

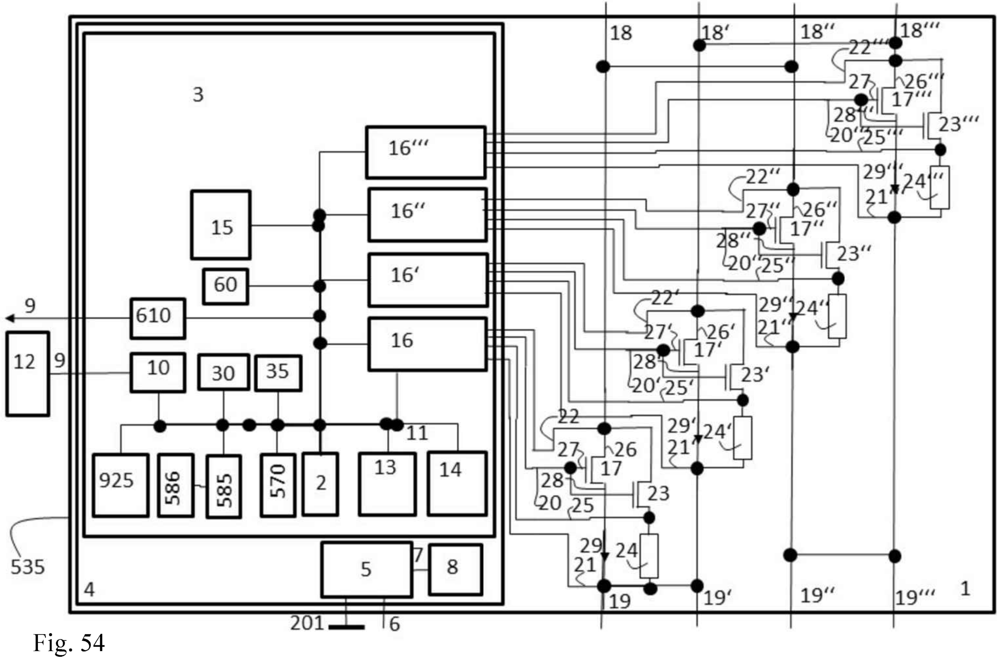

Figur 54 zeigt die allgemeine Vierfachsicherung der Figur 52 wobei die vier Leistungsschalter 17, 17', 17" und 17‴ zur Kreuzsicherung 1000 verschaltet sind.

In der Figur 54 sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 53, 55, 57, 58, 62. Die Kombination der Vorrichtungsteile der hier beschriebenen Figur mit solchen dieser Figuren ist ausdrücklich Teil der Offenbarung des hier vorgelegten Dokuments.

Figur 55a

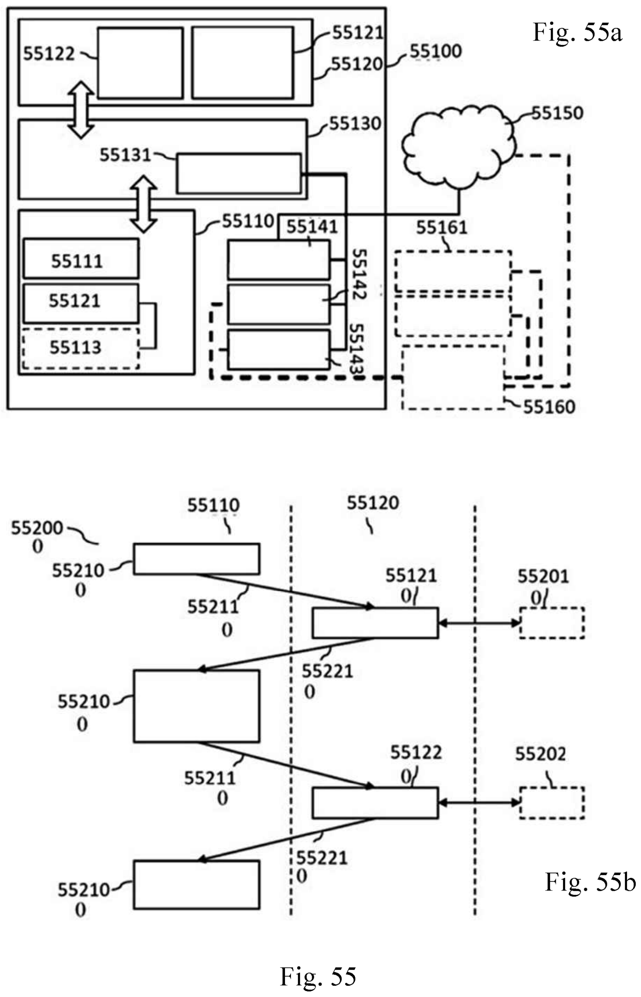

Figur 55a zeigt ein Blockdiagramm eines Systems 55100 zur Bereitstellung von SW-Programmen in einem Versorgungsnetzwerk 200. Das System 55100 umfasst eine erste HW-Plattform 55110 (z.B. ein übergeordnetes Rechnersystem 12 oder einen Server 710 eines Dienstanbieters etc.) auf dem unterschiedliche SW-Programme 55111, 55112, 55113, insbesondere ein SW-Programm 55113 eines externen Anbieters, ausgeführt werden können. Die SW-Programme 55111, 55112, 55113 können unter Verwendung eines Betriebssystems 55130 ausgeführt werden. Des Weiteren können die SW-Programme 55111, 55112, 55113 auf ein oder mehrere HW-Treiber 55131 zugreifen, z.B. um eine Datenkommunikation über eine Kommunikationseinheit 55141, 55142, 55143, 555 zu ermöglichen (z.B. über eine Kommunikationseinheit 55141 für ein zellulares Netz (GSM, UMTS, LTE), über eine Kommunikationseinheit 55142 für WLAN und/oder über eine Kommunikationseinheit 55143 für Bluetooth).

In der Figur 55a sind zur besseren Übersichtlichkeit nicht alle sinnvollen und ggf. üblichen Vorrichtungsbestandteile der Steuervorrichtung 4 eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 53, 54, 57, 58, 62. Die Kombination der Vorrichtungsteile der hier beschriebenen Figur mit solchen dieser Figuren ist ausdrücklich Teil der Offenbarung des hier vorgelegten Dokuments.

Das System 55100 umfasst weiter eine Steuervorrichtung 55120, 4 einer Sicherung 1 mit einem Rechnerkern 2 zur Ausführung von ein oder mehreren sicherheitsrelevanten SW-Modulen 55121, 55122 der auf der ersten HW-Plattform 55110 implementierten SW-Programme 55111, 55112, 55113. Ein sicherheitsrelevantes SW-Modul 55121, 55122 kann z.B. sicherheitsrelevante Daten und/oder sicherheitsrelevanten Progammcode und/oder SW-Modulen 55121, 55122, die den Schaltzustand des Leistungsschalters 17 der Sicherung 1 ändern und/oder SW-Module 55121, 55122, die den Zugriff auf Speicher 14,15 der Steuervorrichtung 55120, 4 der elektronischen Sicherung 1 ermöglichen, und/oder SW-Module 55121, 55122, die den Download und/oder die Ausführung von SW im Speicher 14, 15 der Steuervorrichtung 55120, 4 der Sicherung 1 ermöglichen, und/oder SW-Module 55121, 55122, die das Auslesen von Messwerten und/oder Daten der Speicher der Steuervorrichtung 55120, 4 der Sicherung 1 ermöglichen, und/oder SW-Modulen 55121, 55122 , die die Konfiguration von Parametern und/oder Schwellwerten und ähnlichem in der Steuervorrichtung 55120, 4 der Sicherung 1 ermöglichen, umfassen. Alternativ oder ergänzend kann ein sicherheitsrelevantes SW-Modul 55121, 55122 einen Zugriff auf eine sicherheitsrelevante interne Funktion des Versorgungsnetzwerks 200 und/oder auf eine sicherheitsrelevante interne Funktion der elektronischen Sicherungen 1 des Versorgungsnetzwerks 200 und/oder auf eine zu sicherheitsrelevanten, internen Funktionen des Versorgungsnetzwerks 200 externe Funktion und/oder auf eine zu sicherheitsrelevanten, internen Funktionen der elektronischen Sicherungen 1 des Versorgungsnetzwerks 200 externe Funktion ermöglichen.

Die Steuervorrichtung 55120, 4 der Sicherung 1 kann ein oder mehreren besonderen Sicherheitsmaßnahmen unterliegen. Insbesondere kann durch den Hersteller eines Fahrzeugs eine detaillierte Analyse und Überprüfung der ein oder mehrere SW-Module 55121, 55122 vorgenommen werden, die auf der Steuervorrichtung 55120, 4 der Sicherung 1 installiert werden. Des Weiteren können Maßnahmen vorgesehen sein, die einen unbefugten Zugriff auf SW-Module 55121, 55122 und/oder Daten auf der Steuervorrichtung 55120, 4 der Sicherung 1 verhindern. Die Steuervorrichtung 55120, 4 der Sicherung 1 kann eine Sicherheitsmaßnahme aufweisen, die der Steuervorrichtung 55120, 4 der Sicherung 1 einen besonderen Schutz vor Seitenkanalangriffen liefert. Des Weiteren kann durch eine Sicherheitsmaßnahme ein physisches Auslesen eines Speichers der Steuervorrichtung 55120, 4 der Sicherung 1 unterbunden werden. Mit anderen Worten, die Steuervorrichtung 55120, 4 der Sicherung 1 kann derart durch ein oder mehrere Sicherheitsmaßnahmen geschützt sein, dass die ein oder mehreren Speicher 14, 15 der Steuervorrichtung 55120, 4 der Sicherung 1 nicht (von außen) ausgelesen werden können. Die Steuervorrichtung 55120, 4 der Sicherung 1 kann insbesondere "tamper-resistant" bzw. manipulationssicher ausgebildet sein.

Es wird somit eine vertrauenswürdige Anwendungsumgebung einer Steuervorrichtung 55120, 4 der Sicherung 1 für einen Automobilhersteller und einen Anbieter von Drittsoftware zur Nutzung in einem vorschlaggemäßen Versorgungsnetzwerk bereitgestellt. Die Sicherheits-Hardware-Plattform Steuervorrichtung 55120, 4 der Sicherung 1 stellt eine Abstraktionsschicht zwischen dem Steuergerät Betriebssystem 55130 - typischerweise in dem übergeordneten Rechnersystem 12 -, ein oder mehreren Hoch-Sicherheits-Modulen 55121, 55122 und allen anderen SW-Programmen 55111, 55112, 113 dar. Ein Hoch-Sicherheits-Modul 55121, 55122 ist dabei typischerweise sehr klein, so dass der Programm-Quell-Code eines solchen Moduls 55121, 55122 geprüft werden kann. Darüber hinaus stellt die Sicherheits-Hardware-Plattform 55120 eine starke Isolation für ein Hoch-Sicherheits-Modul 55121, 55122 bereit. Hierdurch wird ein Zugriff auf Rechenoperationen und/oder Daten eines Hoch-Sicherheits-Moduls 55121, 55122 durch ein anderes Hoch-Sicherheits-Modul 55121, 55122 oder durch ein sonstiges SW-Programm 55111, 55112, 55113 verhindert. Die ein oder mehreren Schnittstellen für Hoch-Sicherheits-Module 55121, 55122 können einheitlich und/oder standardisiert sein.

Figur 55a zeigt weiter ein Kommunikationsnetz 15150 (z.B. das Internet 720) mit dem direkt (z.B. über eine Kommunikationseinheit 55141 für ein zellulares Netz) oder indirekt über ein Smartphone 55160, 740 mit ein oder mehreren SW-Applikationen 55161 kommuniziert werden kann.

Figur 55b

Figur 55b veranschaulicht einen beispielhaften Ablauf 55200 eines SW-Programmes 55111, 55112, 55113. Ein SW-Programm 55111, 55112, 55113 kann ein oder mehrere Basis-Module 55210 umfassen, die auf der ersten HW-Plattform 55110, also beispielsweise der übergeordneten Rechnereinheit 12 installiert sein können. Des Weiteren kann ein SW-Programm 55111, 55112, 55113 ein oder mehrere sicherheitsrelevante Module 55121, 55122 umfassen, die vorzugsweise auf der Steuervorrichtung 55120, 4 der Sicherung 1 installiert sind. Bei der Ausführung eines SW-Programms 55111, 55112 55113 kann zunächst ein Basis-Modul 55210 ausgeführt werden, das bei Bedarf ein sicherheitsrelevantes Modul 55121, 555122 aufruft. Bei dem Aufruf können Eingangsdaten 55211 an ein sicherheitsrelevantes Modul 55121, 55122 übergeben werden. Des Weiteren können nach oder während der Ausführung der sicherheitsrelevanten Moduls 55121, 55122 Ausgangsdaten 55221 zurück an ein Basis-Modul 55210 übergeben werden. Durch die Aufteilung eines SW-Programms 55111, 55112, 55113 in ein oder mehrere Basis-Module 55210 und ein oder mehrere sicherheitsrelevante Module 55121, 55122 können komplexe Anwendungen bereitgestellt werden, die jedoch nur relativ kleine sicherheitsrelevante Module 55121, 55122 umfassen, die in effizienter und zuverlässiger Weise überprüft werden können.

Der Zugriff auf eine sicherheitsrelevante Versorgungsnetzwerk-interne Funktion 55201 und/oder auf eine sicherheitsrelevante Versorgungsnetzwerk-externe Funktion 55202 kann bevorzugt ausschließlich durch ein sicherheitsrelevantes Modul 55121, 55122 ermöglicht werden. So kann in effizienter Weise die Sicherheit von Funktionen 55201 des Versorgungsnetzwerks 200 und/oder von Versorgungsnetzwerk-externen Funktionen 55202 sichergestellt werden.

In einem Beispiel für eine automatische Ausstattungsvariantenabrechnung stellt ein externer Anbieter mittels seines Servers 710 eine Bezahl-Applikation 55113 bereit. Diese Applikation 55113 teilt sich beispielsweise in zwei Teile 55121, 55210, einen sicherheits-kritischen Teil 55121 und einen sicherheits-unkritischen Teil 55210. Der sicherheits-kritische Teil 55121 wird auf einer Sicherheits-Hardware-Plattform 55120 beispielsweise der Steuervorrichtung 4 einer Sicherung 1 ausgeführt und der sicherheits-unkritischen Teil 55210 wird innerhalb des üblichen Steuergerät Betriebssystems 55130 bzw. auf der ersten HW-Plattform 55110, beispielsweise dem übergeordneten Rechnersystem 12 selbst ausgeführt. Als sicherheits-kritischer Teil 55121 können z.B. die für den Bezahlvorgang erforderlichen kryptografischen Operationen und/oder die Zugriffe auf die Schaltzustände der Leistungsschalter 17 der elektronischen Sicherungen 1 des Versorgungsnetzwerks angesehen werden. Als sicherheits-unkritischer Teil 55210 können die Nutzerschnittstelle und die Kommunikation z.B. mit dem Internet 55150 angesehen werden. Alle kritischen Operationen (insbesondere eine Verschlüsselung und insbesondere eine Post-Quantum-Verschlüsselung) können auf der Sicherheits-Hardware-Plattform 55120 ausgeführt werden, so dass z.B. alle Daten von und zum Internet 55150, die z.B. auf der ersten HW-Plattform 55110 (z.B. Server 710) bearbeitet werden, verschlüsselt und integritätsgeschützt sind. Bevorzugt umfasst die Sicherheits-Hardware-Plattform einen echten Zufallszahlengenerator 60 und/oder einen Quantenzufallszahlengenerator 60. Bevorzugt nutzt die Sicherheits-Hardware-Plattform 55120, also beispielsweise eine Steuervorrichtung 55120, 4 der Sicherung 1 einen Quantenzufallszahlengenerator 60 für die Verschlüsselung.

Ein Nutzer 730 ändert die Fähigkeiten seines Fahrzeugs durch eine Änderung der Ausstattungsvariante. Hierzu nimmt der Nutzer 730 über ein Terminal 740 des Fahrzeugs z.B. über WLAN, Bluetooth oder Internet, Kontakt mit dem übergeordneten Rechnersystem 12 des Versorgungsnetzwerks 200 des Fahrzeugs auf. Unter Verwendung eines sicherheits-kritischen Teils 55121 der Bezahl-Applikation 55113 wird der Nutzer bzw. das Fahrzeug als diese Ausstattungsvariante nutzend registriert und es kann (mittels eines sicherheits-unkritischen Teils 55210) eine Bestätigung über die Nutzerschnittstelle ausgegeben werden. Bei der Beendigung der Nutzung der Ausstattungsvariante übernimmt wiederum ein sicherheits-kritischer Teil 55121 der Bezahl-Applikation 55113 die Berechnung der Kosten und identifiziert dabei das Fahrzeug mit dem Versorgungsnetzwerk 200 eindeutig mittels kryptografischer Operationen, die bevorzugt PQCfeste Signaturen und Verschlüsselungen verwenden und auf Zufallszahlen des echten Zufallszahlengenerators 60 und/oder des Quantenzufallszahlengenerators 60 zurückgreifen.

Unter Verwendung des in diesem Dokument beschriebenen Systems 55100 kann eine Ausstattungsvarianten-Anwendung 55113 in zwei Teile 55210, 55121 aufgeteilt werden, einen sicherheits-kritischen Teil 55121 und einen sicherheits-unkritischen Teil 55210. Der sicherheits-kritische Teil 55121 wird auf der Sicherheits-HW-Plattform 55120 (Steuervorrichtung 55120, 4 der Sicherung 1) ausgeführt und der sicherheits-unkritische Teil 55210 kann innerhalb des übergeordneten Rechnersystems 12 und/oder zusammen mit einer unkritischen Benutzer-Applikation auf z.B. einem Smartphone 55160 ausgeführt werden.

Als sicherheits-kritischer Teil 55121 können z.B. die für das Ändern der Schaltzustände der Leistungsschalter 17 der Sicherungen 1 und/oder das Ändern der Schaltschwellen für das Schalten der Leistungsschalter 17 und/oder alle anderen Änderungen des Verhaltens der Leistungsschalter 17 der Sicherungen 1 und die für den Abrechnungs-Vorgang erforderlichen kryptografischen Operationen und die Parameter für den Betrieb der Quantenzufallszahlengeneratoren und der anderen Kryptografischen Vorrichtungen und sicherheitsrelevanten Vorrichtungen angesehen werden. Als sicherheits-unkritischer Teil 55210 können die Nutzerschnittstelle und die Kommunikation z.B. mit dem Internet angesehen werden. Da alle kritischen Operationen bereits auf der Sicherheits-HW-Plattform 55120 (Steuervorrichtung 55120, 4 der Sicherung 1) ausgeführt werden, sind z.B. alle Daten von und zum Internet bereits verschlüsselt (vorzugsweise PQC-verschlüsselt) und integritätsgeschützt.

Ein Nutzer 730 installiert sich eine Applikation zur Änderung des Ausstattungsvarianten (die Versorgungsnetzwerk-spezifische Schnittstellen unterstützt) auf einem Smartphone 55160, das hier als Terminal 740 dienen soll. Der Nutzer 730 registriert sich bei einem Server 730 eines Anbieters für die Ausstattungsvarianten, der wiederum eine Registrierung des Nutzers 730 in einem Backend vornimmt. Der Nutzer 730 bucht über die Ausstattungsvarianten Applikation eine verfügbare Ausstattungsvariante des Versorgungsnetzes, was einer Ausstattungsvariante des Fahrzeugs entspricht, und erhält auf seinem Smartphone 55160 (740) ein "Token" mit dem er eine bestimmte Ausstattungsvariante, d.h. eine bestimmte Konfiguration und Topologie des Versorgungsnetzwerks 200 mit bestimmten Eigenschaften der Sicherungen 1 des Versorgungsnetzwerks 200 mit bestimmten Versorgungsteilnetzwerken des Versorgungsnetzwerks und bestimmten Energiequellen und Verbrauchern des Versorgungsnetzwerks mit bestimmten Parameterbereichen dieser Energiequellen und Verbraucher und mit bestimmten Funktionen dieser Energiequellen und Verbraucher beispielsweise in einem bestimmten Zeitraum und beispielsweise in einem bestimmten geografischen Gebiet nutzen kann. Der Nutzer kann dann mit seinem Smartphone 55160 (740) und/oder über ein anderes Terminal 740 des Fahrzeugs die nun versorgten und zugelassenen Vorrichtungsteile des Fahrzeugs und des Versorgungsnetzwerks 200 nutzen und im Rahmen des Lizenzierten parametrisieren.

Der sicherheits-kritische Teil 55121 der Ausstattungsvariantenkonfigurations-Anwendung 55113 verifiziert das "Token", und es wird bei Bestätigung des "Token" die Nutzung der betreffenden Ausstattungsvariante gewährt. Dabei ist es für einen Nutzer 730 unmöglich, ein Token selbst zu erzeugen oder ein altes Token erneut einzuspielen. Des Weiteren ist es aufgrund der in diesem Dokument beschriebenen Struktur irrelevant, ob das Smartphone 55160 oder die Ausstattungsvariantenkonfigurations-Applikation unsicher sind, da nur der sicherheits-kritische Teil 55121 der Ausstattungsvariantenkonfigurations-Anwendung 55113 kritische Komponenten 55201 des Versorgungsnetzwerks 200 und/oder kritische Versorgungsnetzwerk-externe Komponenten 55202 beeinflusst (z.B. Ein/Aus der Leistungsschalter 17 der Sicherungen 1).

Durch eine weitere Anpassung der zugrundeliegenden Hardware (insbesondere der Prozessorumgebung von z.B. der Head Unit) kann eine weitergehende Isolation von SW Programmen 55113 eines externen Anbieters ermöglicht werden. Dabei können Applikationen vollständig von der übrigen Softwareumgebung des übergeordneten Rechnersystems 12 isoliert werden. So kann die Sicherheit weiter erhöht werden.

Figur 56

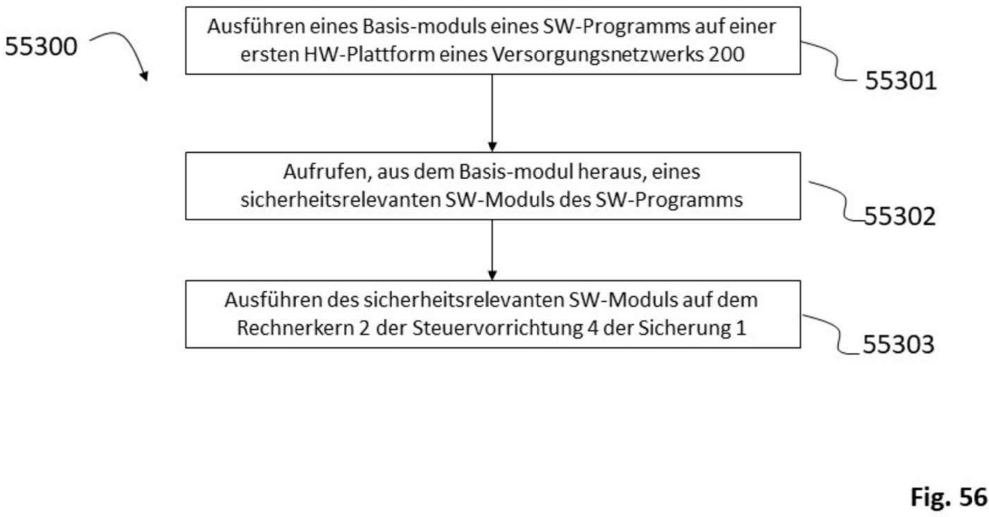

Figur 56 zeigt ein Ablaufdiagramm eines beispielhaften Verfahrens 55300 zur Ausführung eines SW-Programms 55113 in einem Versorgungsnetzwerk 200. Das SW-Programm 55113 kann durch einen externen Anbieter für eine Anwendung bereitgestellt werden. Der externe Anbieter kann dabei auch weder der Hersteller des Fahrzeugs noch ein Zulieferer für eine Komponente des Fahrzeugs sein, dessen teil das Versorgungsnetzwerk ist. Der externe Anbieter kann z.B. ein Dienstleister sein, der mittels des SW-Programms 55113 eine Dienstleistung, wie z.B. eine Abrechnungs-Dienstleistung, eine Ausstattungsvarianten-Dienstleistung, etc., in Zusammenhang mit dem Versorgungsnetzwerk 200 bereitstellen möchte.

Das Verfahren 55300 umfasst das Ausführen 55301 eines Basis-Moduls 55210 des SW-Programms 55113 auf einer ersten HW-Plattform 55110 des Fahrzeugs (z.B. auf dem übergeordneten Rechnersystem 12 des Versorgungnetzwerks 200). Das Basis-Modul 55210 kann z.B. relativ unkritische Funktionen, wie z.B. eine Nutzerschnittstelle und/oder eine Kommunikation mit einem Netzwerk 55150 und/oder mit einem Versorgungsnetzwerk-externen Gerät 55160 (z.B. einem Smartphone oder einem Autoschlüssel oder dergleichen) ermöglichen.

Es kann dann aus dem Basis-Modul 55210 heraus bei Ausführung des SW-Programms 55113 ein sicherheitsrelevantes Modul (55121) des SW-Programms (55113) aufgerufen werden (Schritt 55302). Dabei greift das sicherheitsrelevante Modul 55121 auf sicherheitsrelevante Daten (z.B. auf kryptographische Schlüssel und/oder auf Abrechnungsdaten) und/oder auf eine sicherheitsrelevante Funktion (z.B. auf eine oder mehrere Gate-Ansteuerungen 16 eines oder mehrerer Leistungsschalter 17 einer oder mehrerer Sicherungen 1 im Versorgungsnetzwerk 200 des Fahrzeugs) zu.

Außerdem umfasst das Verfahren 55300 das Ausführen 55303 des sicherheitsrelevanten Moduls 55121 auf einer Steuervorrichtung 55120, 4 des Versorgungsnetzwerks 200. Dabei unterliegt die Steuervorrichtung 55120, 4 der Sicherung 1 ein oder mehreren Sicherheitsmaßnahmen, denen die erste HW-Plattform 55110, also beispielsweise das übergeordnete Rechnersystem 12 und/oder das Terminal 740, nicht unterliegt. Beispielsweise erfolgt für SW-Module 55121, die auf der Steuervorrichtung 55120, 4 der Sicherung 1 ausgeführt werden sollen, eine Überprüfung des SW-Codes durch den Hersteller des Fahrzeugs und/oder den Hersteller des Versorgungsnetzwerks 200 und/oder den Hersteller der Sicherung 1, um ungewünschte Auswirkungen auf eine Fahrzeug-Funktion 55201 und/oder eine Funktion des Versorgungsnetzwerks 200 und/oder eine Funktion der Sicherung 1 zu unterbinden. Alternativ oder ergänzend kann eine Beschränkung von Daten 55201, 55202 erfolgen, die an ein SW-Module 55121 oder von einem SW-Module 55121 übergeben werden können, das auf der Steuervorrichtung 55120, 4 der Sicherung 1 ausgeführt wird. Im Sinne des hier vorgelegten Dokuments kann übrigens das übergeordnete Rechnersystem 12 in einigen Anwendungsfällen auch als Sicherung ohne Leistungsschalter 17 betrachtet werden. Die erste HW-Plattform wäre dann beispielsweise der Server 710 des Dienstleistungsanbieters und/oder das Terminal 740 für Eingaben des Nutzers 730.

In diesem Dokument wird somit eine standardisierte Software- und Hardwareumgebung für SW Programme 55113 von externen Anbietern beschrieben. Dabei ist das beschriebene System 55100 bevorzugt derart ausgelegt, dass keine Spezialkenntnisse bezüglich Embedded-Hardware/-Software benötigt werden und dass alle Softwareschnittstellen eindeutig definiert sind. Durch eine Abstraktion der Hardware muss sich ein externer Anbieter von SW-Programmen 55113 nicht um Hardwareschnittstellen kümmern. Des Weiteren muss ein Fahrzeughersteller bzw. ein Hersteller eines Versorgungsnetzwerks für die Anbindung eines neuen SW-Programms 55113 keine Software- bzw. Hardware-Änderungen vornehmen.

Es wird somit eine sichere und verlässliche Ausführungsumgebung für SW-Programme 55113 von externen Anbietern innerhalb eines Versorgungsnetzwerks 200 bereitgestellt. Dabei können SW-Programme 55113 während der Betriebszeit eines Versorgungsnetzwerks 200 nachgeliefert werden (nach Prüfung und Signatur durch den Automobilhersteller bzw. dem Hersteller des Versorgungsnetzwerks), so dass Funktionserweiterung und/oder Äderungen der Ausstattungsvariante des Fahrzeugs durch eine Änderung der Ausstattungsvariante des Versorgungsnetzwerks 200 ermöglicht werden. Außerdem kann ein Automobilhersteller bzw. der Hersteller des Versorgungsnetzes 200 sicherheitskritische Teile 55121 eines SW-Programms 55111 auf die Sicherheits-HW-Plattform 55120 (Steuervorrichtung 5120, 4 der Sicherung 1) auslagern, um das Sicherheitsniveau eines übergeordneten Rechnersystems 12 des Versorgungsnetzwerks 200 zu erhöhen.

Figur 57

Figur 57 entspricht der Figur 24, wobei zur besseren Übersicht die Teststromquellen und deren Ansteuerungen nicht eingezeichnet sind.

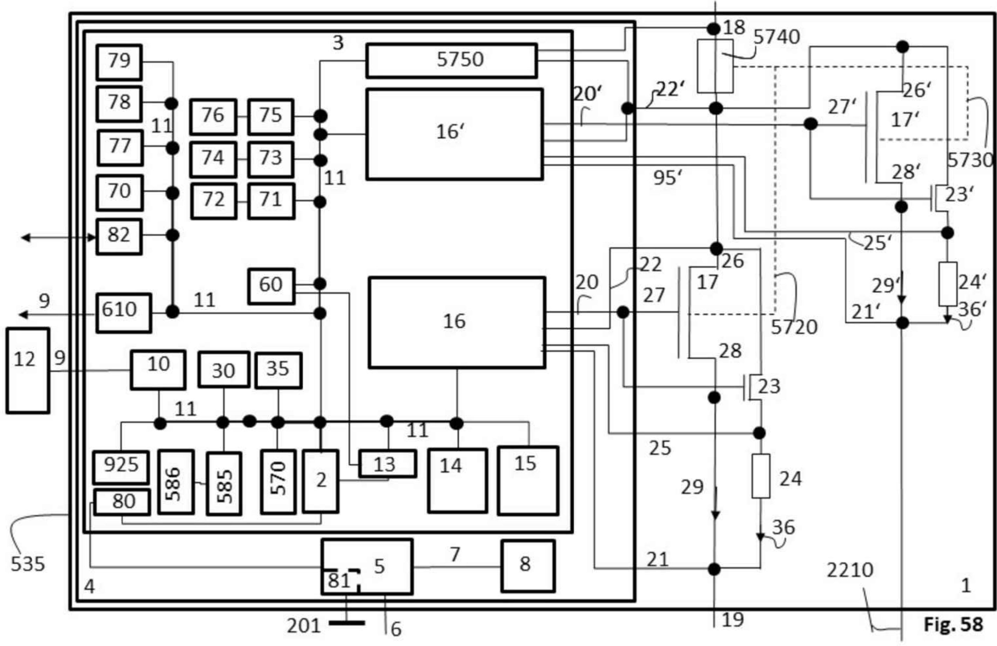

In Figur 57 ist ein Temperaturschalter 5710 in den Strompfad zwischen dem ersten Anschluss 18 der Sicherung 1 und dem zweiten Anschluss der Sicherung 1 eingefügt. Der Temperatuschalter 5710 schaltet im zulässigen Betriebsbereich der Sicherung 1 unabhängig vom Betrag der Ströme 29 und 29' durch den Leistungsschalter 17 und den zweiten Leistungsschalter 17'. Der Temperaturschalter 5710 schaltet sich typischerweise wieder ein, wenn die Temperatur wieder unterschritten wird. Daher ist ein Temperaturschalter aus Sicherheitsaspekten nicht immer die optimale Lösung (Siehe auch Figur 58) Der Temperaturschalter 5710 ist bevorzugt thermisch mit dem ersten Leistungsschalter 17 gekoppelt. Bei einer Übertemperatur des Leistungsschalters 17 und bevorzugt bei einer Übertemperatur der Sicherung 1 und bevorzugt bei einer Übertemperatur innerhalb des Gehäuses 535 der Sicherung 1 öffnet sich der Temperaturschalter 5710. Der Temperaturschalter 5710 ist in vielen Anwendungsfällen zur Erreichung der funktionalen Sicherheit erforderlich. Im Falle eines Durchlegierens des Leistungstransistors 17 ist der Leistungstransistor 17 nicht mehr schaltbar und kann mit einem nicht unwesentlichen Restwiderstand weiterhin leitfähig sein. Ist die Last beispielsweise eine ohmsche Last, die auch bei einer Spannungsverminderung aus welchen Gründen auch immer nicht oder noch nicht abschaltet, so kann eine große Leistung in dem Leistungsschalter 17 umgesetzt werden. Dies kann zu einer Plasmaentwicklung und/oder zu einem Brand führen. Dies ist insbesondere dann möglich, wenn aus welchen Gründen auch immer brandfähige Verschmutzungen in Kontakt mit dem Leistungsschalter und/oder dem dann typischerweise aufgeheizten Sicherungsgehäuse 535 sind.

Der Temperaturschalter 5710 schaltet dann den Strompfad durch den Leistungsschalter 17 und hier auch des zweiten Leistungsschalter 17' aus. Bei einem Fehler des zweiten Leistungsschalters 17' verhält sich der Temperaturschalter 5710 infolge der thermischen Kopplung zwischen dem zweiten Leistungsschalter 17' und dem Temperaturschalter 5710 typischerweise in analoger Weise. Sofern die Energiequelle am ersten Anschluss 19 der Sicherung 1 angeschlossen ist und sofern die Sicherung 1 aus dem Strompfad hinter dem Leistungsschalter 17, beispielsweise aus dem elektrischen Knoten des zweiten Anschlusses 19 der Sicherung 1 sich selbst mit elektrischer Energie versorgt, kann die Steuervorrichtung 4 der elektronischen Sicherung 1 sich für eine gewisse Zeit noch aus der Energiereserve 8 versorgen, bevor sie funktionslos wird.

Bevorzugt weist eine Steuervorrichtung 4 einer solchen Sicherung 1 eine Temperatuschalter / Thermosicherung-Überwachungsvorrichtung 5750 auf, die vorzugsweise die Spannung über den Temperaturschalter 5710 überwacht. Die Temperatuschalter / Thermosicherung-Überwachungsvorrichtung 5750 ist bevorzugt so gestaltet, dass sie die maximale Spannung zwischen dem ersten Anschluss 18 und dem zweiten Anschluss 19 der Sicherung einschließlich notwendiger Sicherheitsspannungsmargen ohne Störung übersteht. Aus diesem Grund ist eine solche Steuerungsvorrichtung 4 bevorzugt als integrierte Schaltung auf einem SOl-Substrat gefertigt.

In dem Beispiel der Figur 57 ist der erste Leistungsschalter 17 über einen ersten Temperaturwirkpfad 5720 mit dem Temperaturschalter 5710 thermisch gekoppelt. In dem Beispiel der Figur 57 ist der zweite Leistungsschalter 17' über einen zweiten Temperaturwirkpfad 5730 mit dem Temperaturschalter 5710 thermisch gekoppelt.

Es ist natürlich denkbar den ersten Leistungsschalter 17 mit einem ersten Temperaturschalter 5710 und den zweiten Leistungsschalter 17' mit einem separaten Temperaturschalter und ggf. mit einer zweiten Temperatuschalter / Thermosicherung-Überwachungsvorrichtung auszustatten.

Es ist natürlich denkbar jeden weiteren Leistungsschalter 17'', 17''' mit einem jeweils weiteren separaten Temperaturschalter und ggf. mit einer jeweiligen weiteren Temperatuschalter / Thermosicherung-Überwachungsvorrichtung auszustatten.

Der Rechnerkern 2 der Steuervorrichtung 4 überwacht und steuert die Temperatuschalter / Thermosicherung-Überwachungsvorrichtungen 5750 über den internen Datenbus 11 der Steuerungsvorrichtung 11.

In der Figur 57 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 53, 54, 55, 58, 62. Die Kombination der Vorrichtungteile der hier beschriebenen Figur mit solchen dieser Figuren ist ausdrücklich Teil der Offenbarung des hier vorgelegten Dokuments.

Figur 58

Figur 58 entspricht der Figur 24, wobei zur besseren Übersicht die Teststromquellen und deren Ansteuerungen nicht eingezeichnet sind.

Anders als in der 57 verwendet die Sicherung 1 statt eines Thermoschalters 5710 eine Thermosicherung 5740. Die Thermosicherung schaltet bei einer Temperaturüberschreitung aus und anschließend auch nach einem Absinken der Temperatur nicht mehr ein. Bevorzugt hat die Steuervorrichtung 4 der elektronischen Sicherung keinen Einfluss auf diesen Abschaltvorgang, sodass kein Einfluss der der funktionalen Sicherheit entgegenstehen könnte auftritt.

In Figur 58 ist die Temperatursicherung 5740 in den Strompfad zwischen dem ersten Anschluss 18 der Sicherung 1 und dem zweiten Anschluss der Sicherung 1 eingefügt. Die Temperatursicherung 5740 schaltet im zulässigen Strombetriebsbereich der Sicherung 1 unabhängig vom Betrag der Ströme 29 und 29' durch den Leistungsschalter 17 und den zweiten Leistungsschalter 17'. Der Temperatursicherung 5740 ist thermisch mit dem ersten Leistungsschalter 17 gekoppelt. Bei einer Übertemperatur des Leistungsschalter 17 und bevorzugt bei einer Übertemperatur der Sicherung 1 und bevorzugt bei einer Übertemperatur innerhalb des Gehäuses 535 der Sicherung 1 öffnet sich die Temperatursicherung 5740. Die Temperatursicherung 4 ist in vielen Anwendungsfällen zur Erreichung der funktionalen Sicherheit erforderlich. Im Falle eines Durchlegierens des Leistungstransistors 17 ist der Leistungstransistor 17 nicht mehr schaltbar und kann mit einem nicht unwesentlichen Restwiderstand weiterhin leitfähig sein. Ist die Last beispielsweise eine ohmsche Last, die auch bei einer Spannungsverminderung aus welchen Gründen auch immer nicht oder noch nicht abschaltet, so kann eine große Leistung in einem solchen Fall in dem Leistungsschalter 17 umgesetzt werden. Dies kann zu einer Plasmaentwicklung und/oder zu einem Brand führen. Dies ist insbesondere dann möglich, wenn aus welchen Gründen auch immer brandfähige Verschmutzungen in Kontakt mit dem Leistungsschalter und/oder dem dann typischerweise aufgeheizten Sicherungsgehäuse 535 sind.

Die Temperatursicherung 5740 schaltet dann den Strompfad durch den Leistungsschalter 17 aus. Sofern die Energiequelle am ersten Anschluss 19 der Sicherung 1 angeschlossen ist und sofern die Sicherung 1 aus dem Strompfad hinter dem Leistungsschalter 17, beispielsweise aus dem elektrischen Knoten des zweiten Anschlusses 19 der Sicherung 1 sich selbst mit elektrischer Energie versorgt, kann die Steuervorrichtung 4 der elektronischen Sicherung 1 sich für eine gewisse Zeit noch aus der Energiereserve 8 versorgen, bevor sie funktionslos wird.

Bevorzugt weist eine Steuervorrichtung 4 einer solchen Sicherung 1 eine Temperatuschalter / Thermosicherung-Überwachungsvorrichtung 5750 auf, die vorzugsweise die Spannung über der Temperaursicherung 5740 überwacht. Die Temperatuschalter / Thermosicherung-Überwachungsvorrichtung 5750 ist bevorzugt so gestaltet, dass sie die maximale Spannung zwischen dem ersten Anschluss 18 und dem zweiten Anschluss 19 der Sicherung einschließlich. notwendiger Sicherheitsspannungsmargen ohne Störung übersteht. Aus diesem Grund ist eine solche Steuerungsvorrichtung 4 bevorzugt als integrierte Schaltung auf einem SOl-Substrat gefertigt.

In dem Beispiel der Figur 58 ist der erste Leistungsschalter 17 über einen ersten Temperaturwirkpfad 5720 mit der Temperatursicherung 5740 thermisch gekoppelt. In dem Beispiel der Figur 58 ist der zweite Leistungsschalter 17' über einen zweiten Temperaturwirkpfad 5730 mit der Temperatursicherung 5740 thermisch gekoppelt.

Es ist natürlich denkbar, den ersten Leistungsschalter 17 mit einer ersten Temperatursicherung 5740 und den zweiten Leistungsschalter 17' mit einer separaten Temperatursicherung und ggf. mit einer zweiten Die Temperatuschalter / Thermosicherung-Überwachungsvorrichtung auszustatten.

Es ist natürlich denkbar jeden weiteren Leistungsschalter 17", 17''' mit einer jeweils weiteren separaten Temperatursicherung und ggf. mit einer jeweiligen weiteren Temperatuschalter / Thermosicherung-Überwachungsvorrichtung auszustatten.

Der Rechnerkern 2 der Steuervorrichtung 4 überwacht und steuert die Temperatuschalter / Thermosicherung-Überwachungsvorrichtungen 5750 über den internen Datenbus 11 der Steuerungsvorrichtung 11.

In der Figur 58 sind zur besseren Übersichtlichkeit nicht alle sinnvollen und ggf. üblichen Vorrichtungsbestandteile eingezeichnet. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 53, 54, 55, 57, 62. Die Kombination der Vorrichtungsteile der hier beschriebenen Figur mit solchen dieser Figuren ist ausdrücklich Teil der Offenbarung des hier vorgelegten Dokuments.

Figur 59

Figur 59 entspricht einer Anwendung der Mehrfachsicherung 1 der Figur 52 zur Absicherung der drei Motorphasen eines beispielhaften Dreiphasenmotors. Die drei Motorspulen 5910, 5920, 5930 sind durch jeweils einen Leistungsschalter der Leistungsschalter 17, 17', 17" abgesichert. Der Sternpunkt ist gegen Masse 201 oder einen Sternpunkt aus der Motoransteuerung 5940 über den vierten Leistungsschalter 17''' abgesichert. Die zweiten Ausgänge 19, 19', 19" und 19''' sind miteinander zu einem virtuellen Sternpunkt verbunden. Die Motorsteuerung 5940 umfasst die Halbbrücken zur Ansteuerung der Motorinduktivitäten 5910, 5920, 5930.

Figur 60

Figur 60 zeigt schematisch vereinfacht den Ablauf eines Verfahren zur Übertragung komprimierter Daten, von der Sicherung 1 zum übergeordneten Rechnersystem 12, wobei im Sinne der hier vorgestellten technischen Lehre im Zusammenhang mit dieser Datenübertragung eine komprimierte Übertragung von der Steuervorrichtung 4 der Sicherung zur einer anderen Steuervorrichtung 4 einer anderen Sicherung von der Offenbarung des hier vorgelegten Dokuments eingeschlossen ist. Man gelangt zu der entsprechenden technischen Lehre, indem man das übergeordnete Rechnersystem 12 durch die Steuervorrichtung 4 einer Sicherung in den entsprechenden texten zur komprimierten Datenkommunikation dieses Dokuments ersetzt. Die komprimierten Daten, die die Steuervorrichtung 4 der Sicherung 1 an das übergeordnete Rechnersystem 12 überträgt, können Messwerte, Signalgrundobjekte, Signalobjekte (wie z.B. vorbestimmte Signalformen etc.), Zustandsdaten von Vorrichtungsteilen der Sicherung 1 und/oder von überwachten Vorrichtungsteilen des Versorgungsnetzwerks 200 etc., Programmdaten und sonstige Daten sein.

Ein erster bevorzugter Schritt des hier vorgestellten Verfahrens 6000 umfasst als einen der ersten Schritte das Schließen 6010 des Leistungsschalter 17 der Sicherung 1 durch eine Steuervorrichtung 4 einer Sicherung 1.

Ein zweiter bevorzugter Schritt 6020 des hier vorgestellten Verfahrens umfasst die Erfassung des zu erfassenden physikalischen Parameters, den die Steuervorrichtung 4 der Sicherung 1 unter Benutzung erster Mittel, die beispielsweise den Analog-zu-Digital-Wandler 570 der Steuervorrichtung 4 und/oder den Shunt-Widerstand 24 und/oder den Hilfsleistungsschalter 23 umfassen können, in diesem zweiten Schritt 6020 erfasst Die zu erfassenden physikalischen Parameter können dabei beispielsweise Spannungen zwischen Schaltungsknoten innerhalb und außerhalb der Sicherung 1 und/oder elektrische Ströme durch Leitungen innerhalb der Sicherung 1 und/oder Temperaturen in und/oder im Umfeld der Sicherung 1 umfassen. Die zu erfassenden Parameter können aber auch abgeleitete Parameter, wie beispielsweise die Leistung, die die Steuervorrichtung 4 als Produkt eines Spannungswerts (Parameter 1) mit einem Stromwert (Parameter 2) bestimmt, sein;

Ein dritter Schritt 6030 kann beispielsweise ein Analysieren und Komprimieren des erfassten zeitlichen Parameterwerteverlauf des erfassten physikalischen Parameter durch die Steuervorrichtung 4 der elektronischen Sicherung 4 umfassen, um die für die Datenübertragung notwendige Datenbuskapazität des Datenbusses 9 zu minimieren und Freiraum für Statusmeldungen und weitere Steuerbefehle des übergeordneten Rechnersystems 12 an die Steuervorrichtung 4 der Sicherung 1 bzw. für Statusmeldungen und weitere Datenübertragungen der Steuervorrichtung 4 der Sicherung 1 an übergeordnete Rechnersystem 12 an die zu schaffen;

Ein vierter Schritt 6040 des hier vorgestellten Verfahren zur Übertragung datenkomprimierter Daten von der Sicherung 1 an das übergeordnete Rechnersystem kann das Übertragen des komprimierten, erfassten zeitlichen Parameterwerteverlaufs des zu meldenden physikalischen Parameters durch die Steuervorrichtung 4 der elektronischen Sicherung 1 an das übergeordnete Rechnersystem 12 umfassen.

Ein fünfter Schritt 6050 des hier vorgestellten Verfahrens zur Übertragung insbesondere der Messdaten kann die Dekompression des über den Datenbus 9 von der Steuervorrichtung 4 der Sicherung 1 empfangenen, komprimierten, erfassten zeitlichen Parameterwerteverlauf durch das übergeordnete Rechnersystem 12 zu einem dekomprimierten, erfassten zeitlichen Parameterwerteverlauf, der letztlich ein rekonstruierter, erfasster zeitlicher Parameterwerteverlauf ist, der der Steuervorrichtung 4 der Sicherung 1 innerhalb des übergeordneten Rechnersystems 12 zugeordnet ist;

Ein sechster Schritt 6060 des hier vorgestellten Verfahrens kann das Vergleichen und/oder Korrelieren des rekonstruierten, erfassten zeitlichen Parameterwerteverlaufs, der der Steuervorrichtung 4 der Sicherung 1 innerhalb des übergeordneten Rechnersystems 12 zugeordnet ist, mit einem oder mehreren anderen rekonstruierten, erfassten zeitlichen Parameterwerteverläufen, die den Steuervorrichtungen 4 anderer Sicherungen 1 innerhalb des übergeordneten Rechnersystems 12 zugeordnet sind, durch das übergeordnete Rechnersystem 12 umfassen. Dabei detektiert das übergeordnete Rechnersystem 12 vorzugsweise Ereignisse, die auf gleiche Ursachen vorzugsweise in zeitlicher Korrelation zurückführbar sind;

Ein **sechster** Schritt 6070 kann das Ergreifen von Maßnahmen in Abhängigkeit von den detektieren Ereignissen durch das übergeordnete Rechnersystem 12 sofern umfassen. Die dabei vom übergeordneten Rechnersystem 12 ergriffenen Maßnahmen können dabei von erkannten Signalobjekten und/oder Signalgrundobjekten abhängen;

Figur 61

Figur 62 ist eine Verfeinerung der Figur 60, bei der die Schritte 6020 der Erfassung des zu erfassenden physikalischen Parameters die Steuervorrichtung 4 der Sicherung 1 und 6030 des Analysierens und des Komprimierens des erfassten zeitlichen Parameterwerteverlaufs des erfassten physikalischen Parameters in weitere beispielhafte Unterschritte verfeinert sind.

Ein erster Unterschritt 6021 des Schritts 6020 der Erfassung des zu erfassenden physikalischen Parameters umfasst die Wandlung der elektrischen analogen Signale, die die Mittel zur Erfassung der physikalischen Parameter (z.B. Temperatursensoren 586 für die Erfassung der Temperatur, Shunt-Widerstände 24 zur Erfassung elektrischer Ströme 36, Potenzialleitungen zur Erfassung elektrischer Potenziale, Analog-zu-Digital-Wandler 570 etc.) erzeugen, durch Abtastung in einem ersten Unterschritt 6021 des zweiten Schritts 6020 (siehe Figur 61) durch die Steuervorrichtung 4 der elektronischen Sicherung 1 in abgetastete zeitliche Parameterwertverläufe, die einen zeitdiskreten Strom von Abtastwerten der Parameterwerte des betreffenden physikalischen Parameters und ggf. zugehörige Zeitstempel dieser Abtastwerte umfassen. Bevorzugt ordnet die Steuervorrichtung 4 der Sicherung 1 vorzugsweise jedem Abtastwert und/oder Abtastwerten in bevorzugt gleichen Zeitabständen kann dabei typischerweise einen Abtastzeitpunkt als Zeitstempel dieses Abtastwertes zu.

Ein erster Unterschritt 6022 des Schritts 6020 der Erfassung des zu erfassenden physikalischen Parameters umfasst das Durchführen einer beispielhaften Wavelet-Transformation oder einer anderen Kompressionsmethode und Wandeln der abgetasteten zeitlichen Parameterwertverläufe in komprimierte zeitliche Parameterwertverläufe durch die Steuervorrichtung 4 der Sicherung in einem zweiten Unterschritt 6022 des zweiten Schritts 6020.

Ein erster Unterschritt 6031 des Schritts 6030 des Analysierens und Komprimierens des erfassten zeitlichen Parameterwerteverlaufs umfasst bevorzugt die Analyse des zeitlichen Parameterwertverlaufs der durch die Steuervorrichtung 4 der elektronischen Sicherung 1 erfassten Parameter und/oder des zeitlichen Verlaufs daraus abgeleiteter Parameter beispielsweise durch Optimalfilter der Steuervorrichtung 4 der elektronischen Sicherung 1 in einem ersten Unterschritt 6031 des dritten Schritts und das bevorzugte Bilden bevorzugt jeweils eines Werts einer Vektorkomponente eines Merkmalsvektors durch bevorzugt jeweils einen Optimalfilter.

Ein zweiter Unterschritt 6032 des Schritts 6030 des Analysierens und Komprimierens des erfassten zeitlichen Parameterwerteverlaufs umfasst bevorzugt die Extraktion eines aktuellen Merkmalsvektors aus den erfassten zeitlichen Parameterwertverläufen und/oder aus den aus diesen abgeleiteten protypischen zeitlichen Verläufen abgeleiteter Parameter durch die Steuervorrichtung 4 der Sicherung und ggf. Zuordnen eines jeweiligen Zeitstempels zu bevorzugt jedem dieser Merkmalsvektoren in einem dritten Unterschritt 6023 des zweiten Schritts 6020 durch die Steuervorrichtung 4 der Sicherung.

Ein dritter Unterschritt 6033 des Schritts 6030 des Analysierens und Komprimierens des erfassten zeitlichen Parameterwerteverlaufs umfasst bevorzugt das Ermitteln eines Abstands des extrahierten aktuellen Merkmalsvektors zu einem prototypischen Merkmalsvektor der prototypischen Merkmalsvektoren der Prototypendatenbank 62115 in einem dritten Unterschritt 6033 des dritten Schritts 6030.

Ein vierte Unterschritt 6034 des Schritts 6030 des Analysierens und Komprimierens des erfassten zeitlichen Parameterwerteverlaufs umfasst bevorzugt das Erkennen eines prototypischen Merkmalsvektors der Prototypendatenbank 62115 als erkannten prototypischen Merkmalsvektor der Prototypendatenbank, wenn der Betrag des ermittelten Abstands für dieses Paar aus diesem aktuellen Merkmalsvektor und diesem prototypischen Merkmalsvektor der Prototypendatenbank 62115 kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank 62115 ist.

Figur 62

Figur 62 zeigt eine beispielhafte Vorrichtung in Form einer beispielhaften elektronischen Sichtung 1. Die Details der Figuren 1, 5, 6, 9, 24, 41, 42, 52, 53, 54, 55, 57 sind nicht eingezeichnet zur besseren Übersicht. Weiter Vorrichtungsbestandteile, die die Leserin bzw. der Leser als möglicherweise in der Figur 1 vorhanden annehmen kann, finden sich beispielsweise in den Figuren 1, 5, 6, 9, 24, 41, 42, 52, 53, 54, 55, 57, 58. Die Steuervorrichtung 4 der Sicherung führt eine Erkennung von Signalobjekten und Signalgrundobjekten bevorzugt durch. Die Datenschnittstelle 10, der Datenbus 9 und das übergeordnete Rechnersystem 12 sind zur Vereinfachung ebenfalls nicht eingetragen. Die Mittel 62100 zur Erfassung physikalischen Parameter der Sicherung 1 erzeugen Signale 62102 der zeitlichen Parameterwertverläufe und/oder die entsprechenden zeitlichen Verlaufen der aus diesen Parameterwertverläufen der physikalischen Parameter abgeleiteten Parameter. Die physikalische Schnittstelle 62101 der Steuervorrichtung 4 erfasst diese und wandelt sie in ein Parametersignal 62103, dass ein Bündel mehrerer Signale sein kann. Das Parametersignal 62103 ist das Eingangssignal der anschließenden Signalobjektklassifikation. Bevorzugt ist das Das Parametersignal 62103 ein digitalisiertes Signal mit zeitlich beabstandeten Abtastwerten. Der Rechnerkern 2 der Steuervorrichtung 4 der elektronischen Sicherung kann beispielsweise Vorrichtungteile der Steuervorrichtung sofern möglich, per Software-Programm emulieren. Die Merkmalsvektorextraktion 62111 verfügt über verschiedene Vorrichtungen, hier beilspielhaft n Optimalfilter (Optimalfilter 62123.1 bis Optimalfilter 62123.m) mit m als ganzer positiver Zahl. Die Ausgänge der hier beispielhaften Optimalfilter 62123.1 bis 62123.m bilden das Zwischenparametersignal 61123. Statt der Optimalfilter 62123.1 bis 62123.m oder ergänzend zu diesen können auch

- Integratoren und/oder
- Differenzierer und/oder
- Filter und/oder
- Logarithmierer und/oder
- FF- und DFFT-Vorrichtungen und/oder
- Korrelatoren und/oder
- Demodulatoren, die ihr Eingangssignal mit einem vorgegebenen Signal multiplizieren und dann filtern, und/oder
- andere signalverarbeitende Teilvorrichtungen und/oder
- deren Kombinationen

je nach Anwendungsfall eingesetzt werden, die dann das m-dimensionale Zwischenparametersignal 62123 erzeugen. Die mit "Optimalfilter" bezeichneten Blöcke in den Zeichnungen sind insofern nur als Platzhalter für solche Signalverarbeitungsblöcke zu verstehen. Auch kann ein solcher mit "Optimalfilter" bezeichneter Signalverarbeitungsblock auch mehr als einen Ausgang haben, der zu dem m-dimensionalen Zwischenparametersignal 62123 also mehrfach mit mehr als einem Signal beiträgt. Eine nachfolgender, beispielhafte Signifikanzsteigerungseinheit 62125 dient dazu, den m-dimensionalen Raum des Zwischenparametersignals 62123 auf einen n-dimensionalen Raum des Signals der Merkmalsvektoren 62138 abzubilden. Dabei ist n eine ganze positive Zahl. In der Regel ist n kleiner als m. Dies dient zum einen dazu, dass die Selektivität der Parameterwerte, aus denen sich jeder Merkmalsvektor des Signals der Merkmalsvektoren 62138 ergibt, maximiert wird. Dies geschieht bevorzugt durch eine lineare Abbildung mit Hilfe eines im Labor mit statistischen Verfahren bestimmten Offset-Werts, der zu den Werten der Zwischenparametersignal hinzuaddiert wird, und einer so genannten LDA Matrix 62126, mit der der jeweilige Vektor der jeweiligen Abtastwerte der Zwischenparametersignale 62123 jeweils zu einem Merkmalsvektor des Signals der Merkmalsvektoren 62138 durch die Steuervorrichtung 4 multipliziert wird. Der Abstandsermittler / Klassifikator 62112 vergleicht bevorzugt jeden sich so ergebenden Merkmalsvektor des Signals der Merkmalsvektoren 62138 mit jedem Signalgrundobjektprototypen der Prototypendatenbank 62115. Die Prototypendatenbank 62115 enthält hierfür für bevorzugt jeden der Signalgrundobjektprototypen der Prototypendatenbank 62115 einen Eintrag mit einem Schwerpunktvektor (z.B. 63141, 63142, 63143, 63144) des jeweiligen Signalgrundobjektprototypen der Prototypendatenbank 62115. Bevorzugt wird ein Abstand des aktuell untersuchten Merkmalsvektors des Signals der Merkmalsvektoren 62138 zu dem geradeuntersuchten Schwerpunktvektor der Prototypendatenbank 63115 durch den Abstandsermittler 62112 berechnet. Der Abstandsermittler 62112 kann aber auch auf andere Weise eine Bewertung der Ähnlichkeit zwischen dem Schwerpunktvektor (z.B. 63141, 63142, 63143, 63144) des jeweiligen Signalgrundobjektprototypen der Prototypendatenbank 62115 und dem aktuell untersuchten Merkmalsvektor des Signals der Merkmalsvektoren 62138 in Form eines Bewertungswerts, den wir hier der Einfachheit halber stets Abstand nennen, berechnen. Der Abstandsermittler 62112 ermittelt auf diese Weise ob ein Schwerpunktvektor (z.B. 63141, 63142, 63143, 63144) der Signalgrundobjektprototypen der Prototypendatenbank 62115 dem aktuelle Merkmalsvektor des Signals der Merkmalsvektoren 62138 ausreichend ähnlich ist, also einen ausreichend geringen Abstand hat und, falls dies der Fall ist, welcher Schwerpunktvektor (z.B. 63141, 63142, 63143, 63144) der Signalgrundobjektprototypen der Prototypendatenbank 62115 dem aktuellen Merkmalsvektor des Signals der Merkmalsvektoren 62138 am ähnlichsten ist, also den geringsten Abstand hat. Ggf. ermittelt der Abstandsermittler 62112 eine Liste von Schwerpunktvektoren (z.B. 63141, 63142, 63143, 63144) der Signalgrundobjektprototypen der Prototypendatenbank 62115, die dem aktuellen Merkmalsvektor des Signals der Merkmalsvektoren 62138 ausreichend ähnlich sind, also einen ausreichend geringen Abstand haben. Bevorzugt werden diese nach Abstand geordnet und mit ihrem zugehörigen Abstand als Hypothesenliste an den Viterbi-Schätzer weitergegeben. Eine beispielhafte Hypothesenliste wurde oben angegeben. Die Weitergabe des Erkennungsergebnisses des Abstandsermittlers (der hier auch als Klassifikator bezeichnet wird) erfolgt im Falle eines einzelnen erkannten Signalgrundobjekts 62121 als Symbol (Z.B. als Prototypendatenbankadresse/-index, die auf den erkannten Signalgrundobjektprototypen der Prototypendatenbank 62115 zeigt.) und im Falle einer Hypothesenliste bevorzugt als Liste von Paaren aus einem Symbol (Index) des erkannten Signalgrundobjekts (Z.B. der Prototypendatenbankadresse / -index, die auf den erkannten Signalgrundobjektprototypen der Prototypendatenbank 62115 zeigt.) und des Abstands zum Schwerpunkt dieses erkannten Signalgrundobjekts. Der Viterbi-Schätzer sucht dann, die Folge aus Signalgrundobjektprototypen, die einer vordefinierten Abfolge von Signalgrundobjektprototypen in seiner Signalobjektsequenzdatenbank 62116 am besten entspricht. Hierbei werden Übereinstimmungen beispielsweise positiv gezählt und Nichtübereinstimmungen negativ gezählt, sodass sich für eine zeitliche Folge von erkannten Signalgrundobjektprototypen ein Bewertungswert für jeden Eintrag der Signalobjektsequenzdatenbank 62116 ergibt. Im Falle von Hypothesenlisten überprüft der Viterbi-Schätzer 62113 bevorzugt alle möglichen Pfade durch die zeitliche Sequenz von Hypothesenlisten. Bevorzugt ermittelt der Viterbi-Schätzer 62113 sein Bewertungsergebnis unter Berücksichtigung der zuvor ermittelten Abstände. Dies kann beispielsweise durch Division der hinzuaddierten Werte durch den Abstand vor der Addition bei der Bildung des Bewertungswerts geschehen. Auf diese Weise ermittelt der Viterbi-Schätzer 62113 die erkannten Signalobjekte 62122, die dann ggf. mit geeigneten Parametern versehen über den Datenbus 9 übertragen werden. Die Steuerungsvorrichtung 4 kann auch die erkannten Signalgrundobjekte 62121 direkt an das übergeordnete Rechnersystem 12 übertragen. Wichtig ist: Es geht bei dieser Vorgehensweise beispielsweise um das Erkennen von physikalisch beispielsweise in Stromsignalen und/oder Spannungssignalen innerhalb der Sicherung 1 auftretenden Ereignissen und Zuständen und das Übertragen dieser Information und um das Erkennen von Strukturen innerhalb des Parametersignals 62103 und deren Übertragung an das übergeordnete Rechnersystem 12. Als Nebeneffekt kann die Steuervorrichtung aus den auftretenden Signalgrundobjekten und aus der Abfolge dieser Signalgrundobjekte und deren Parametrisierungen auf den Zustand der Sicherung und/oder des abgesicherten Versorgungsteilnetzes schließen. Ggf. berücksichtigt die Steuervorrichtung 4 der Sicherung 1 dabei auch die Daten anderer Sensoren und/oder Sicherungen im Versorgungsnetzwerk 200 und/oder im Fahrzeug und ggf. weitere Daten von Servern 710, die im Weitesten Sinne zumindest zeitweilig mit der Steuervorrichtung 4 der Sicherung in einer Datenverbindung über den Datenbus 9 verbunden sind.

Figur 63

Figur 63 dient der Erläuterung der Selektion der Signalgrundobjektprototypen der Prototypendatenbank 62115 durch den Abstandsermittler 62112.

Die Lage der durch den Abstandsermittler / Klassifikator 62112 in dem beispielhaft zweidimensionalen Parameterraum der Figur 63 ermittelten aktueller Merkmalsvektor des Signals der Merkmalsvektoren 62138 kann höchst unterschiedlich sein. So ist es denkbar, dass ein solcher erster beispielhafter Merkmalsvektor 63146 zu weit von den Schwerpunktkoordinaten (63141, 63142, 63143, 63144) des Schwerpunkts irgendeines Signalgrundobjektprototypen der Prototypendatenbank 62115 entfernt liegt. Dieser Abstandsschwellwert kann beispielsweise der besagte minimale halbe Prototypenabstand unter den Signalgrundobjektprototypen der Prototypendatenbank 62115 sein. Auch kann es sein, dass sich die Streubereiche von Signalgrundobjektprototypen der Prototypendatenbank 62115 um ihre jeweiligen Schwerpunkte (63143, 63142) überlappen und ein zweiter beispielhafter ermittelter aktueller Merkmalsvektor 63145 des Signals der Merkmalsvektoren 63138 in einem solchen Überlappungsbereich liegt. In diesem Fall kann eine Hypothesenliste beide Signalgrundobjektprototypen mit unterschiedlichen Wahrscheinlichkeiten als beigefügtem Parameter, da unterschiedlichen Abständen enthalten. Bevorzugt werden diese Wahrscheinlichkeiten durch die Abstände dargestellt. Es wird dann also nicht ein Signalgrundobjekt als das wahrscheinlichste an den Viterbi-Schätzer 62113 übergeben, sondern ein Vektor aus möglicherweise vorliegenden Signalgrundobjekten (Hypothesenliste) an den Viterbi-Schätzer 62113 übergeben. Aus der zeitlichen Abfolge dieser Hypothesenlisten sucht dann der Viterbi-Schätzer 62133 die mögliche Abfolge heraus, die die größte Wahrscheinlichkeit zu einer der vorgegebenen Signalgrundobjektfolgen in seiner Signalobjektdatenbank gegen über allen möglichen Pfaden durch die als möglich erkannten Signalgrundobjekte 62121 der vom Abstandsermittler / Klassifikator 62112 durch den Viterbi-Schätzer 62113 empfangenen Hypothesenlisten. Dabei muss in einem solchen Pfad je Hypothesenliste genau ein erkannter Signalgrundobjektprototyp dieser Hypothesenliste durch diesen Pfad durchlaufen werden.

Im besten Fall liegt der aktuelle Merkmalsvektor 63148 im Streubereich (Schwellwertellipsoid) 63147 um den Schwerpunkt 63141 eines einzigen Signalgrundobjektprototyps 63141 der damit sicher durch den Abstandsermittler 62112 erkannt und als erkanntes Signalgrundobjekt 62121 an den Viterbi-Schätzer 62113 weitergegeben wird.

Es ist denkbar, zur verbesserten Modellierung des Streubereichs eines einzelnen Signalgrundobjektprototyps, diesen durch mehrere hier kreisförmige Signalgrundobjektprototypen mit zugehörigen Streubereichen zu modellieren. Es können also mehrere Signalgrundobjektprototypen der Prototypendatenbank 62115 denselben Signalgrundobjektprototypen im Verständnis einer Signalgrundobjektklasse darstellen.

Der Abstandsermittler 62112 vergleicht bevorzugt jeden sich so ergebenden Merkmalsvektor des Signals der Merkmalsvektoren 63138 mit jedem Signalgrundobjektprototypen der Prototypendatenbank 62115. Die Prototypendatenbank 62115 enthält hierfür für jeden der Signalgrundobjektprototypen der Prototypendatenbank 62115 einen Eintrag mit einem Schwerpunktvektor (z.B. 63141, 63142, 63143, 16344) des jeweiligen Signalgrundobjektprototypen der Prototypendatenbank 62115. Bevorzugt wird ein Abstand des aktuell untersuchten Merkmalsvektors des Signals der Merkmalsvektoren 62138 zu dem geradeuntersuchten Schwerpunktvektor der Prototypendatenbank 62115 durch den Abstandsermittler 62112 berechnet. Der Abstandsermittler 62112 kann aber auch auf andere Weise eine Bewertung der Ähnlichkeit zwischen dem Schwerpunktvektor (z.B. 63141, 63142, 63143, 63144) des jeweiligen Signalgrundobjektprototypen der Prototypendatenbank 62115 und dem aktuell untersuchten Merkmalsvektor des Signals der Merkmalsvektoren 62138 in Form eines Bewertungswerts, den wir hier der Einfachheit halber stets Abstand nennen, berechnen. Der Abstandsermittler 62112 ermittelt auf diese Weise ob ein Schwerpunktvektor (z.B. 63141, 63142, 63143, 63144) der Signalgrundobjektprototypen der Prototypendatenbank 62115 dem aktuellen Merkmalsvektor des Signals der Merkmalsvektoren 62138 ausreichend ähnlich ist, also einen ausreichend geringen Abstand hat und, falls dies der Fall ist, welcher Schwerpunktvektor (z.B. 63141, 63142, 63143, 63144) der Signalgrundobjektprototypen der Prototypendatenbank 62115 dem aktuellen Merkmalsvektor des Signals der Merkmalsvektoren 62138 am ähnlichsten ist, also den geringsten Abstand hat. Ggf. ermittelt der Abstandsermittler 62112 eine Liste von Schwerpunktvektoren (z.B. 63141, 63142, 63143, 144) der Signalgrundobjektprototypen der Prototypendatenbank 62115, die dem aktuellen Merkmalsvektor des Signals der Merkmalsvektoren 62138 ausreichend ähnlich sind, also einen ausreichend geringen Abstand haben.

Figur 64

Figur 64 dient der Erläuterung des HMM-Verfahrens, das durch den Viterbi-Schätzer 62113 angewandt wird, um das Signalobjekt als wahrscheinlichste Folge von Signalgrundobjektprototypen aufgrund einer Folge von erkannten Signalgrundobjektprototypen 62121 als erkanntes Signalobjekt 62122 zu identifizieren. Die Figur 64 ist oben im Text erläutert.

Figur 65

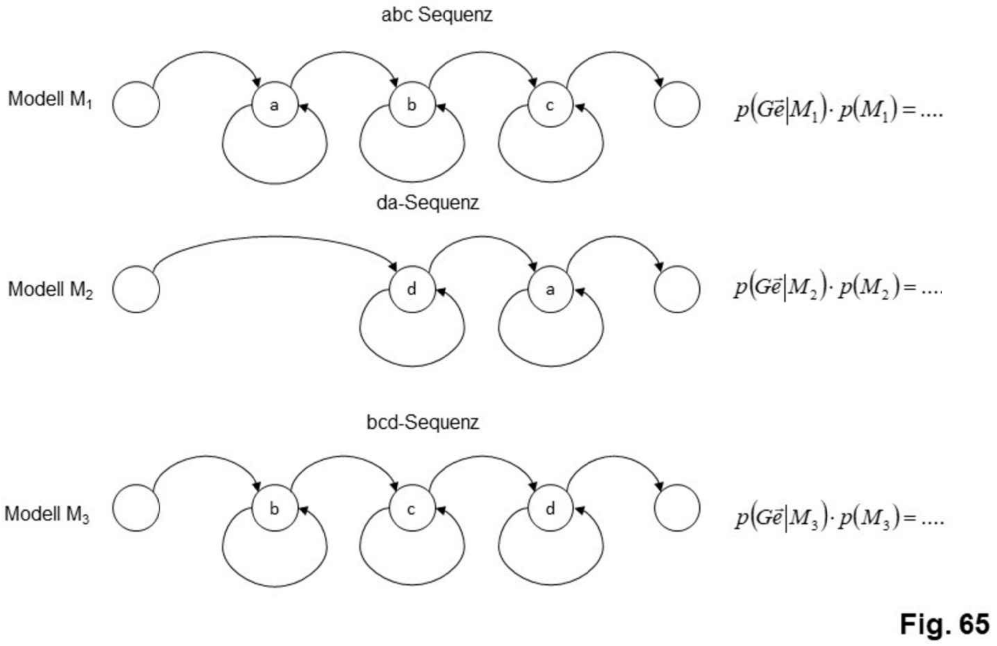

Figur 65 zeigt eine beispielhafte Zustandsabfolge im Viterbi-Schätzer 62113 für die Erkennung eines einzelnen Signalobjekts. Die Figur 65 ist oben im Text erläutert.

Figur 66

Figur 66 zeigt eine beispielhafte, bevorzugte Zustandsabfolge im Viterbi-Schätzer 62113 für die kontinuierliche Erkennung eines von Signalobjekte, wie sie typischerweise für die Erkennung bei Aufgaben des autonomen Fahrens notwendig ist. Die Figur 66 ist oben im Text erläutert.

Figur 67

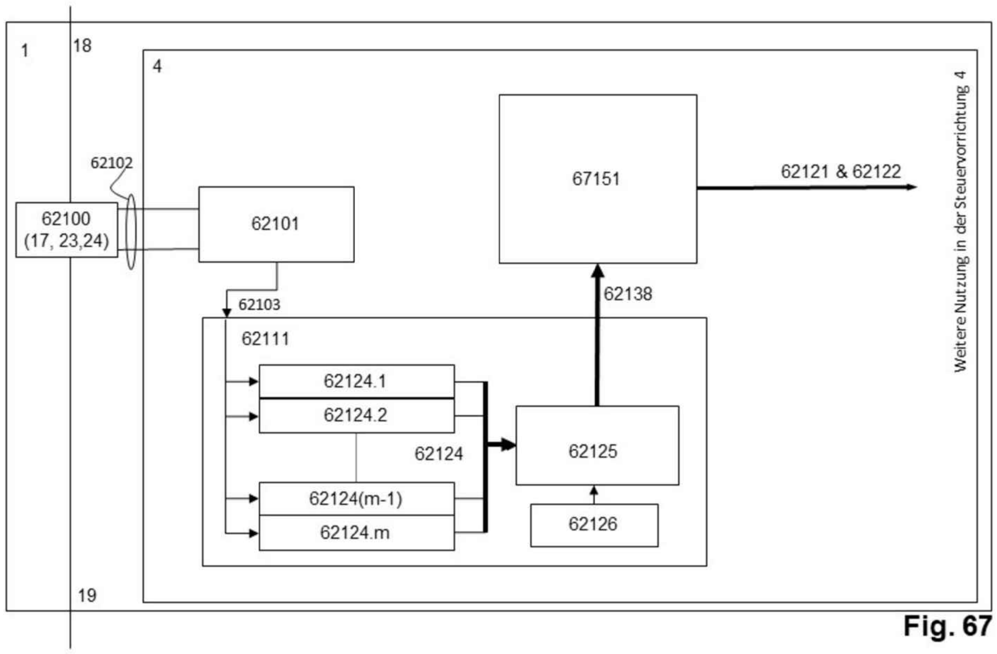

Figur 67 entspricht weitestgehend der Figur 62 mit dem Unterscheid, dass ein neuronales Netzwerkmodell 67151 die Merkmalsvektoren des Signals der Merkmalsvektoren 62138 klassifiziert und analysiert. Bevorzugt führt der Rechnerkern 2 der Steuervorrichtung 4 der Sicherung 1 das neuronale Netzwerkmodell aus. Bevorzugt erfolgt diese Erkennung auch hier abtastfensterweise.

Das neuronale Netzwerkmodell 62151 wird im Labor bevorzugt mit Trainingsdaten aus Merkmalsvektoren realer Ereignisse hinsichtlich des Parameterwerteverlaufs der physikalischen Parameter, die die Steuervorrichtung 4 der Sicherung erfasst, trainiert.

Figur 67 zeigt somit eine alternative Ausgestaltung mit einem Schätzer 62151, der ein neuronales Netzwerkmodell 62151 ausführt. Die Datenschnittstelle 10, 610 und der Datenbus 9 sind zur Vereinfachung nicht eingetragen. Die Mittel 62100 zur Erfassung der physikalisch relevanten Parameter werden durch eine physikalische Schnittstelle 62101 angesteuert und vermessen. Die physikalische Schnittstelle 62101 dient zum Aufbereiten des von diesen Mitteln 62100 erzeugten Messsignalen 62102 zum Parametersignal 62103 für die anschließende Signalobjektklassifikation. Bevorzugt ist das Parametersignal 62103 ein digitalisiertes Signal mit zeitlich beabstandeten Abtastwerten. Die Merkmalsvektorextraktion 62111 verfügt wieder über verschiedene Vorrichtungen, hier beilspielhaft m Optimalfilter (Optimalfilter 1 bis Optimalfilter m) mit m als ganzer positiver Zahl. Die Ausgänge der hier beispielhaften Optimalfilter 62124.1 bis 62124.m bilden das Zwischenparametersignal 62123. Statt der Optimalfilter 62124.1 bis 62124.m oder ergänzend zu diesen können auch Integratoren, Filter, Differenzierer, Logarithmierer und/oder andere signalverarbeitende Teilvorrichtungen und deren Kombinationen je nach Anwendungsfall eingesetzt werden, die dann das m-dimensionale Zwischenparametersignal 62123 erzeugen. Eine nachfolgende, beispielhafte Signifikanzsteigerungseinheit 62126 dient dazu, den m-dimensionalen Raum des Zwischenparametersignals 62123 auf einen n-dimensionalen Raum des Signals der Merkmalsvektoren 62138 abzubilden. Dabei ist n eine ganze positive Zahl. In der Regel ist n kleiner als m. Dies dient zum einen dazu, dass die Selektivität der Parameterwerte, aus denen sich jeder Merkmalsvektor des Signals der Merkmalsvektoren 62138 ergibt, maximiert wird. Dies geschieht bevorzugt durch eine lineare Abbildung mit Hilfe eines im Labor mit statistischen Verfahren bestimmten Offset-Werts, der zu den Werten der Zwischenparametersignal 62123 hinzuaddiert wird, und einer so genannten LDA Matrix 62126, mit der der jeweilige Vektor der jeweiligen Abtastwerte der Zwischenparametersignale 62123 jeweils zu einem Merkmalsvektor des Signals der Merkmalsvektoren 62138 multipliziert wird. Der Schätzer 67151 versucht dann beispielsweise mit Hilfe eines neuronalen Netzwerkmodells 62151, das bevorzugt der Rechnerkern 2 der Steuervorrichtung 4 der Sicherung 1 ausführt, die Signalobjekte in dem Datenstrom der Merkmalsvektoren des Signals der Merkmalsvektoren 62138 zu erkennen. Die Signalgrundobjektprototypen und die Signalobjekte sind dabei über die Vernetzung der Knoten innerhalb des neuronalen Netzwerkmodells und die Parametrisierung des neuronalen Netzwerkmodells innerhalb des neuronalen Netzwerkmodells kodiert. Der Schätzer 67151 gibt dann die erkannten Signalobjekte 62122 und/oder die erkannten Signalgrundobjekte 62121 aus. Bevorzugt verwendet die Steuervorrichtung 4 der Sicherung dann diese erkannten Signalobjekte 62122 und/oder diese erkannten Signalgrundobjekte 62121 zum Ersten für die Kommunikation mit dem übergeordneten Rechnersystem 12 des Versorgungsnetzwerks 200 und/oder zur Ableitung von Maßnahmen, wenn die Indices der erkannten Signalobjekte 62122 und/oder die erkannten Signalgrundobjekte 62121 und typischerweise auch deren Parameter mit Vorgaben und Schellwerten in vorgegebenen Kombinationen übereinstimmen.

Figur 68

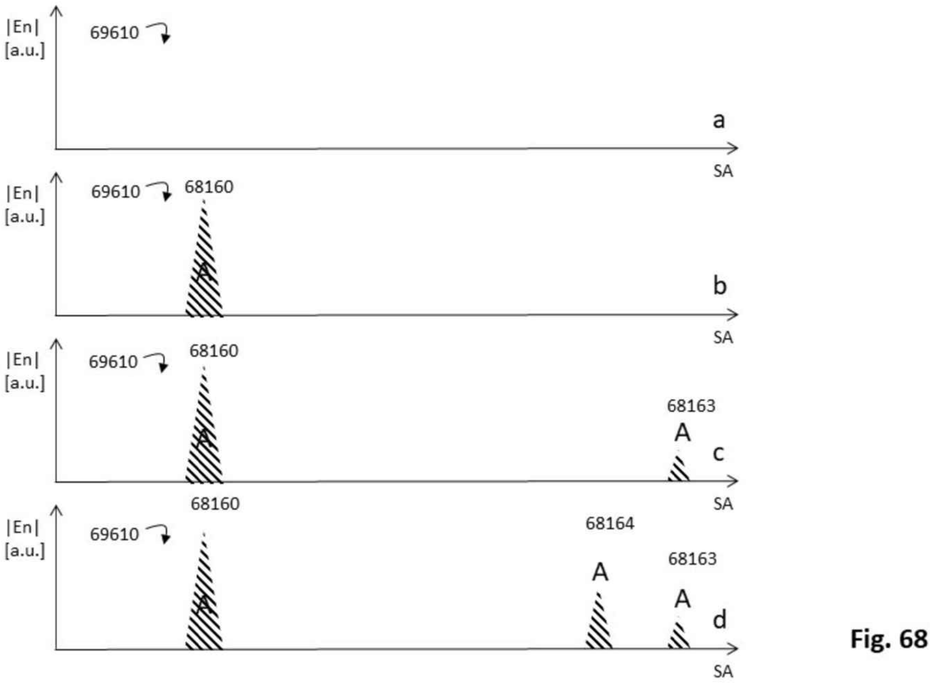

Figur 68 zeigt die beispielhafte Dekompression eines übertragenen beispielhaften Teilsignals des Parametersignals 62103, wobei nur Signalanteile mit einer ersten Eigenschaft in die Rekonstruktion einbezogen werden.

Als erstes wird ein Parametersignal-Modells 69610 erzeugt, dass kein Signal aufweist. (Figur 68a). Das Parametersignal-Modells 69610 ist mit einem Modellparameter (SA) parametrisiert, der mit der Zeit (t) seit dem Beginn des Abtastfensters bevorzugt korreliert ist.

Dann wird dieses Parametersignal-Modells 69610 bevorzugt durch Addition um das mit Datenübertragungspriorität 1 von der Steuervorrichtung 4 der Sicherung 1 an das übergeordnete Rechnersystem 12 übertragene erste beispielhafte Signalobjekt 68160, das eine Dreiecksform beschreibt, geeignet parametrisiert ergänzt. (Figur 68b)

Das mit Datenpriorität 2 übertragene zweite beispielhafte Signalobjekt 68161 in Dreiecksform wird für die Rekonstruktion hier nicht berücksichtigt, da es erste Eigenschaften aufweisen soll, die es ausschließen.

Das mit Datenpriorität 3 übertragene dritte beispielhafte Signalobjekt 68162 in Doppelspitzenform wird für die Rekonstruktion, da es erste Eigenschaften aufweisen soll, die es ausschließen.

Dann wird das bereits ergänzte Parametersignal-Modells 69610 bevorzugt durch Addition um das mit Datenübertragungspriorität 4 von der Steuervorrichtung 4 der Sicherung 1 an das übergeordnete Rechnersystem 12 übertragene vierte beispielhafte Signalobjekt 68163, das eine Dreiecksform beschreibt, geeignet parametrisiert ergänzt. (Figur 68c)

Dann wird das bereits ergänzte Parametersignal-Modells 69610 bevorzugt durch Addition um das mit Datenübertragungspriorität 5 vom von der Steuervorrichtung 4 der Sicherung 1 an das übergeordnete Rechnersystem 12 übertragene fünfte beispielhafte Signalobjekt 68164, das eine Dreiecksform beschreibt, geeignet parametrisiert ergänzt.

(Figur 68d)

Das mit Datenpriorität 6 übertragene sechste beispielhafte Signalobjekt 68165 in Doppelspitzenform mit Chirp Up Charakteristik (B) wird für die Rekonstruktion ebenfalls wg. seiner ersten Eigenschaften hier nicht berücksichtigt.

Das sich ergebende rekonstruierte Parametersignal ist das rekonstruierte Parametersignal 73635. Allerdings wurden alle Signalanteile mit einer ersten Eigenschaft nicht in die Rekonstruktion einbezogen. Das Signal wurde also durch das übergeordnete Rechnersystem 12 selektiv rekonstruiert.

Anschließend wird das so dekomprimierte und rekonstruierte Parametersignal 73635 typischer Weise für die Objekterkennung im übergeordneten Rechnersystem 12 oder an einer anderen Stelle im Fahrzeug verwendet.

Figur 69

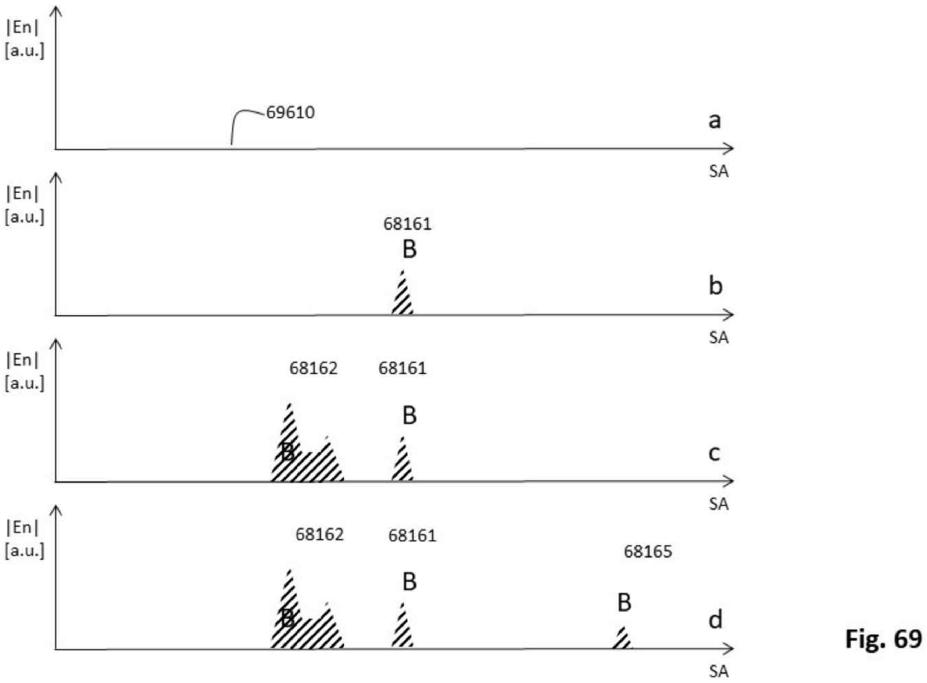

Figur 69 zeigt die beispielhafte Dekompression eines übertragenen beispielhaften Teilsignals des Parametersignals 62103, wobei nur Signalanteile ohne die erste Eigenschaft in die Rekonstruktion einbezogen werden.

Als erstes wird ein Parametersignal-Modells 69610 erzeugt, dass kein Signal aufweist. (Figur 69a). Das Parametersignal-Modells 69610 ist mit einem Modellparameter (SA) parametrisiert, der mit der Zeit (t) seit dem Beginn des Abtastfensters bevorzugt korreliert ist.

Das mit Datenpriorität 1 übertragene erste beispielhafte Signalobjekt 68160 in Dreiecksform ohne die erste Eigenschaft wird für die Rekonstruktion hier nicht berücksichtigt.

Dann wird dieses Parametersignal-Modells 69610 bevorzugt durch Addition um das mit Datenübertragungspriorität 2 vom der Steuervorrichtung 4 der Sicherung 1 an das übergeordnete Rechnersystem 12 übertragene zweite beispielhafte Signalobjekt 62161, das eine Dreiecksform mit erster Eigenschaft beschreibt, geeignet parametrisiert ergänzt. (Figur 68b)

Dann wird dieses Parametersignal-Modells 69610 bevorzugt durch Addition um das mit Datenübertragungspriorität 3 von der Steuervorrichtung 4 der Sicherung 1 an das übergeordnete Rechnersystem 12 übertragene dritte beispielhafte Signalobjekt 68161, das eine Doppelspitzenform mit erster Eigenschaft beschreibt, geeignet parametrisiert ergänzt. (Figur 68c)

Das mit Datenpriorität 4 übertragene vierte beispielhafte Signalobjekt 68162 in Dreiecksform ohne die erste Eigenschaft wird für die Rekonstruktion hier nicht berücksichtigt.

Das mit Datenpriorität 5 übertragene fünfte beispielhafte Signalobjekt 68163 in Dreiecksform ohne die erste Eigenschaft wird für die Rekonstruktion hier nicht berücksichtigt.

Dann wird dieses Parametersignal-Modells 69610 bevorzugt durch Addition um das mit Datenübertragungspriorität 6 von der Steuervorrichtung 4 der Sicherung 1 an das übergeordnete Rechnersystem 12 übertragene sechste beispielhafte Signalobjekt 68165, das eine Dreiecksform mit erster Eigenschaft beschreibt, geeignet parametrisiert ergänzt. (Figur 68d)

Das sich ergebende rekonstruierte Parametersignal ist das rekonstruierte Parametersignal 73635. Allerdings wurden alle Signalanteile ohne eine erste Eigenschaft nicht in die Rekonstruktion einbezogen. Das Signal wurde also durch das übergeordnete Rechnersystem 12 selektiv rekonstruiert.

Anschließend wird das so dekomprimierte und rekonstruierte Parametersignal 73635 typischer Weise für die Objekterkennung im übergeordneten Rechnersystem 12 oder an einer anderen Stelle im Fahrzeug verwendet.

Figur 71 und 72

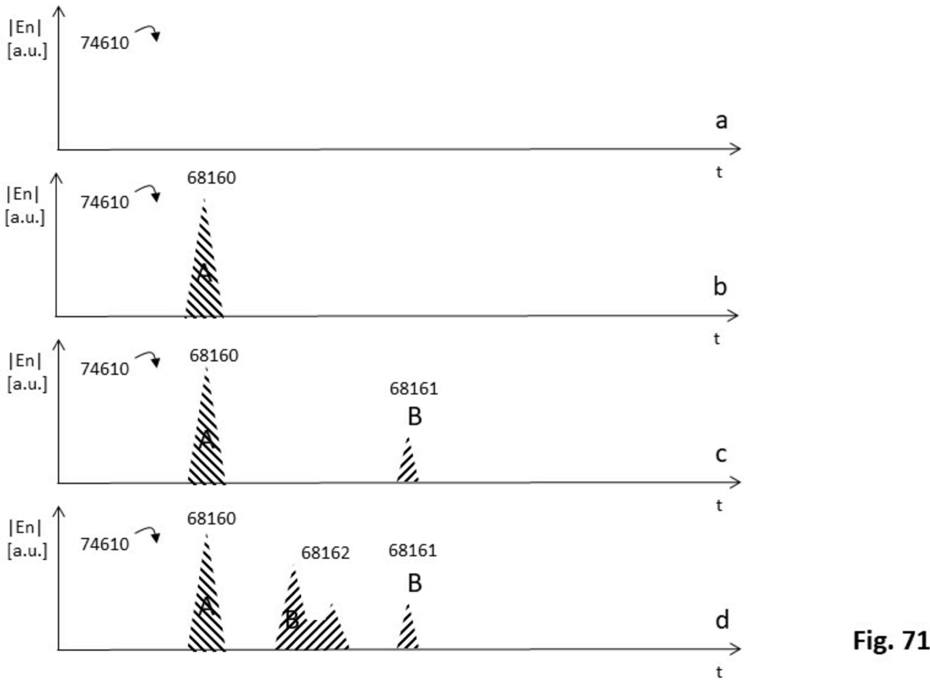

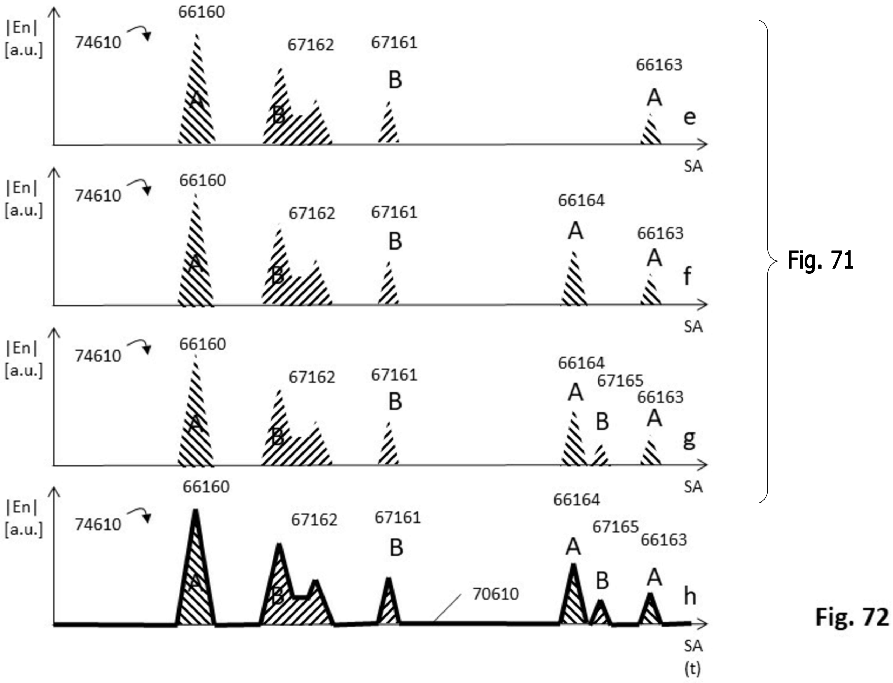

Die Figuren 71 und 72 zeigen die Dekompression des Parametersignals 62103.

Als erstes wird ein Parametersignal-Modellvektor 74610 erzeugt, dass kein Signal aufweist. (Figur 71a). Der Parametersignal-Modellvektor 74610 ist mit einem Modellparameter (SA) parametrisiert, der mit der Zeit (t) seit dem Beginn des Abtastfensters bevorzugt korreliert ist.

Dann wird dieses Parametersignal-Modellvektor 74610 bevorzugt durch Addition um das mit Datenübertragungspriorität 1 vom von der Steuervorrichtung 4 der Sicherung 1 an das übergeordnete Rechnersystem 12 übertragene erste beispielhafte Signalobjekt 68160, das eine Dreiecksform beschreibt, geeignet parametrisiert ergänzt. (Figur 71b)

Dann wird dieses Parametersignal- Modellvektor 74610 bevorzugt durch Addition um das mit Datenübertragungspriorität 2 vom von der Steuervorrichtung 4 der Sicherung 1 an das übergeordnete Rechnersystem 12 übertragene zweite beispielhafte Signalobjekt 68161, das eine Dreiecksform beschreibt, geeignet parametrisiert ergänzt. (Figur 71c)

Dann wird dieses Parametersignal- Modellvektor 74610 bevorzugt durch Addition um das mit Datenübertragungspriorität 3 vom von der Steuervorrichtung 4 der Sicherung 1 an das übergeordnete Rechnersystem 12 übertragene dritte beispielhafte Signalobjekt 68162, das eine Doppelspitzenform beschreibt, geeignet parametrisiert ergänzt.

(Figur 71d)

Dann wird dieses Parametersignal- Modellvektor 74610 bevorzugt durch Addition um das mit Datenübertragungspriorität 4 vom von der Steuervorrichtung 4 der Sicherung 1 an das übergeordnete Rechnersystem 12 übertragene vierte beispielhafte Signalobjekt 68163, das eine Dreiecksform beschreibt, geeignet parametrisiert ergänzt. (Figur 71e)

Dann wird dieses Parametersignal- Modellvektor 74610 bevorzugt durch Addition um das mit Datenübertragungspriorität 5 vom von der Steuervorrichtung 4 der Sicherung 1 an das übergeordnete Rechnersystem 12 übertragene fünfte beispielhafte Signalobjekt 68164, das eine Dreiecksform beschreibt, geeignet parametrisiert ergänzt. (Figur 71f)

Dann wird dieses Parametersignal- Modellvektor 74610 bevorzugt durch Addition um das mit Datenübertragungspriorität 6 vom von der Steuervorrichtung 4 der Sicherung 1 an das übergeordnete Rechnersystem 12 übertragene sechste beispielhafte Signalobjekt 68165, das eine Dreiecksform beschreibt, geeignet parametrisiert ergänzt. (Figur 71g)

Zur Verdeutlichung ist in Figur 72h das rekonstruierte Parametersignal 70610 fett eingezeichnet. Ansonsten stimmt Figur 72h mit der Figur 71g überein.

Anschließend wird das so dekomprimierte und rekonstruierte Parametersignal 70610 typischer Weise für die Objekterkennung im übergeordneten Rechnersystem 12 oder an einer anderen Stelle im Fahrzeug oder in einem anderen Server 710, 750 verwendet.

Figur 73

Figur 73 zeigt ein beispielhaftes, willkürliches Teilsignal des Parametersignals 62103 als Originalsignal (Figur 73a), das rekonstruierte Parametersignal 70610 (Figur 73b) und deren Überlagerung (Figur 73c). Die Abweichungen zwischen dem rekonstruierten Parametersignal 70610 und dem Teilsignal des Parametersignals 62103 sind bei richtigem Vorgehen und geschickter Wahl der Signalgrundobjekte und Signalobjekte nur sehr gering.

Figur 74

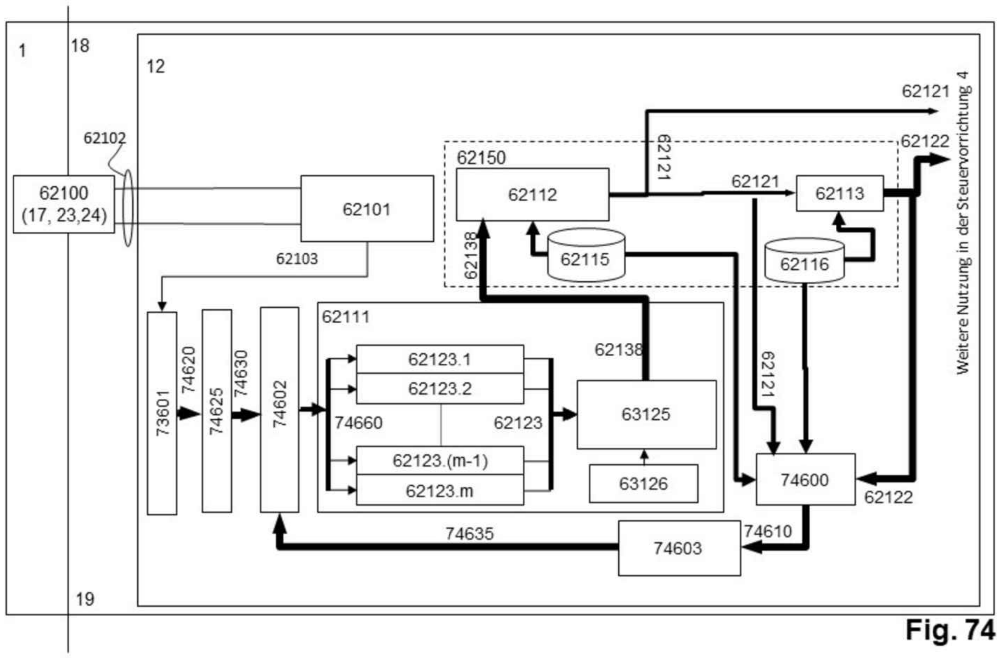

Figur 74 zeigt eine verbesserte Vorrichtung zur verbesserten rekursiven Kompression. Der in den Figuren 71 bis 73 in seiner Funktion erläuterte Rekonstruierer 74600 kann nicht nur im übergeordneten Rechnersystem 12 eingesetzt werden, sondern auch in der Steuervorrichtung 4 der Sicherung 1 selbst vor der Datenübertragung. Hierzu erzeugt der Rekonstruierer 74600 einen rekonstruiertes Parametersignal-Modellvektor 74610 wie in den Figuren 71 bis 73 je nach Zweck dargestellt. Dieses wird von dem zuvor empfangenen Parametersignal 62103 in einem Vektorsubtrahierer 74602 sukzessive abgezogen. Hierzu wird das Parametersignal 62103 bevorzugt in Form digitaler Abtastwerte in einem zweistufigen Speicher 74601, 74625 bevorzugt zeitlich geordnet abgelegt. Dabei korrespondiert ein abgelegter Abtastwert des Parametersignals 62103 bevorzugt mit genau einem Wert des rekonstruierten Parametersignal-Modellvektors 74610, das bevorzugt ebenfalls in einem Rekonstruktionsspeicher 74603 abgelegt ist. Der Rekonstruktionsspeicher 74603 kann Teil des Rekonstruierers 74600 sein. Dieser zusätzliche Rückkopplungszweig (74600, 74610, 74603, 74602, 74601) kann auch für andere Klassifizierer wie beispielsweise die Vorrichtung der Figur 67 verwendet werden.

Besonders vorteilhaft ist die Rekonstruktion eines rekonstruierten Parameter-Signal-Modellvektors 74610 aus den erkannten Signalobjekten 62122 und den Signalgrundobjekten 62121 während der Kompression.

Hierzu speichert die Steuervorrichtung der Sicherung 1 bevorzugt die q Abtastwerte des Parametersignals 62103 eines zeitlichen Abtastfensters, die die Steuervorrichtung 4 in dem zeitlichen Abtastfenster erfasst hat, in einem ersten Abtastwertespeicher 74601. Die Zahl q ist hierbei eine positive ganze Zahl, die die Anzahl der Abtastwerte im ersten Abtastwertespeicher 74601 der Steuervorrichtung 4 der Sicherung 1 angibt. Sobald das Abtastfenster zeitlich zu Ende ist, löscht der Abtastwertespeicher 74601 r älteste Abtastwerte in seinen Speicherzellen. Die Zahl r ist dabei eine ganze positive Zahl. Dann verschiebt bevorzugt der erste Abtastwertespeicher 74601 alle Abtastwerte um die jeweils gleiche Anzahl r an Speicherzellen in dem ersten Abtastspeicher 74601 in der Art, dass der älteste nicht gelöschte Abtastwert in der Speicherzelle des ersten Abtastspeichers 74601 liegt, in der zuvor der älteste, zuvor gelöschte Abtastwert gespeichert war. Hierdurch wird nach dem Ende eines Abtastfensters in einem neuen zeitlichen Abtastfenster der erste Abtastwertespeicher 74601 mit den neuen Abtastwerten des neuen Abtastfensters wieder sukzessive aufgefüllt, während er immer die ältesten Abtastwerte verwirft, um Platz für diese neuen, nachrückenden Abtastwerte zu schaffen.

Die q Abtastwerte im ersten Abtastwertespeicher 74601 bilden einen q-dimensionalen ersten Abtastwertevektor 74620, den der erste Abtastwertespeicher 74601 bevorzugt ausgibt. Da während des Einschreibens der Abtastwerte des Parametersignals 62103 in den ersten Abtastwertespeicher 73607 der Inhalt des ersten Abtastwertevektor s74620 instabil ist, übernimmt am zeitlichen Ende eines jeden Abtastzeitfensters ein zweiter Abtastspeicher 74625 den Abtastwertevektor 74620 von dem ersten Abtastwertespeicher 74601

Die Steuervorrichtung 4 der Sicherung 1 erzeugt den Parameter-Signal-Modellvektor 74610 aus den summierend linear überlagerten Signalverlaufsmodellen der einzelnen erkannten Signalobjekte und/oder Signalgrundobjekten.

Die Steuervorrichtung 4 subtrahiert mittels eines Vektorsubtrahierers 74602 die Werte der Vektorkomponenten des gespeicherten Parametersignal-Modellvektors 74635 von dem zweiten Abtastwertevektor 74630 ab und bildet hierdurch ein Vektorrestsignal 73660. Dies unterdrückt dem mit höherer Wahrscheinlichkeit erkanntem selektieren Signalobjekt ähnliche Signalobjekte besser. Die schwächeren Signalobjekte und Signalgrundobjekte treten in dem Vektorrestsignal 73660 hierdurch außerdem besser hervor. Die Steuervorrichtung 4 kann dann die schwächeren Signalobjekte und Signalgrundobjekte in dem Restsignal 73660 besser erkennen. (Siehe auch Figur 73). Das in der technischen Lehre des hier vorgelegten Dokuments vorgeschlagene Verfahren umfasst somit bevorzugt auch eine Subtraktion des aus den bereits erkannten Signalobjekten und Signalgrundobjekten gespeicherten Parametersignal-Modell 74635 von dem zweiten Abtastwertevektor 74630 im zweiten Abtastwertespeicher 74625 zur Bildung des Vektorrestsignals 73660. Die Steuervorrichtung 4 verwendet das so gebildete Vektorrestsignal 73660 dann wieder für die die Bildung des Signals der Merkmalsvektoren 62138 mittels der Merkmalsextraktion 62111. Mittels der Merkmalsextraktion 62111 und mittels der Abstandsberechnung 62112 bzw. des Klassifikators 62112 und ggf. des Viterbi-Schätzers 62113 ermittelt die Steuervorrichtung dann dasjenige Signalobjekt der Signalobjektsequenzdatenbank 62116 bzw. dasjenige Signalgrundobjekt der Prototypendatenbank 62115 mit der nächst niedrigeren Wahrscheinlichkeit. Da das zuerst erkannte Signalobjekt bzw. Signalgrundobjekt entsprechend seiner Gewichtung aus dem zweiter Abtastwertevektor des zweiten Abtastwertespeichers 74625 entfernt wurde und dadurch im Vektorrestsignal 73660 im Wesentlichen nicht mehr vorhanden ist, kann das zuerst erkannte Signalobjekt bzw. Signalgrundobjekt diese Erkennung nicht mehr beeinflussen. Somit liefert diese Form der Erkennung ein besseres Ergebnis in Form einer Liste erkannter Signalobjekte bzw. Signalgrundobjekte.

Ein Rekonstruierer 74600 rekonstruiert mit Hilfe der erkannten Signalgrundobjekte 62121 und den erkannten Signalobjekte 62122 und mittels der mit ermittelten Signalgrundobjektparameter und der mitermittelten Signalobjektparameter und den Daten aus der Prototypendatenbank 62155 und den Daten aus der Signalobjektsequenzdatenbank 62116 und mittels der zugehörigen Zeitstempel das Parameter- signal so, als wenn es nur aus den erkannten Signalobjekte 62122 mit den mitermittelten Signalobjektparametern und den ermittelten Signalgrundobjektparameter mit den mitermittelten Signalgrundobjektparametern unter Berücksichtigung der zugehörigen Zeitstempel durch Addition der korrespondierenden Vektorwerte zusammengesetzt wäre. Ein Rekonstruierer 74600 rekonstruiert auf diese Weise das den rekonstruierten Parametersignal-Modellvektor mit q Werten an Vektorkomponenten, die zu den q Werten der Vektorkomponenten des zweiten Abtastwertevektors der im zweiten Abtastwertespeicher 74625 korrespondieren, als rekonstruierten Parametersignal-Modellvektor 74610. Der Rekonstruktionsspeicher 74603 speichert den rekonstruierten Parametersignal-Modellvektor 74610 zwischen. Der Rekonstruierer 74600 umfasst bevorzugt den Rekonstruktionsspeicher 74603. Der Rerekonstruktionsspeicher 74603 gibt den in seinen Speicherzellen gespeicherten rekonstruierten Parametersignal-Modellvektor 74610 als gespeicherten Parametersignal-Modellvektor 74635 an den Vektorsubtrahierer 74602 aus, was den Kreis schließt.

Diese Erkennungsmethode ist aber in der Regel langsamer. Daher ist es sinnvoll, erst eine direkte erste Signalobjekterkennung ohne Subtraktion schon während der noch laufenden Messung durchzuführen und dann nach Erfassung aller Abtastwerte eines Abtastfensters eine nochmalige Mustererkennung mit Subtraktion des Parametersignal-Modellvektors 74610 durchzuführen, die zwar länger dauert, dafür aber präziser ist.

Bevorzugt wird diese reduzierende Klassifikation des Parametersignals 62103 und die Zerlegung in prototypische Signalobjekte bzw. Signalgrundobjekte mit Hilfe des Parametersignal-Modellvektors 74610 dann beendet, wenn die Beträge der Abtastwerte des Vektorrestsignals 73660 unter den Beträgen einer vorgegebenen Schwellwertkurve und/oder eines Schwellwerts liegen.

Figur 75

Figur 75 zeigt eine Vorrichtung zur Auswertung der entkomprimierten Sicherungsdaten mehrerer Sicherungen, hie beispielhaft zwei zweier Sicherungen (805, 825). Beispielhaft sollen die zwei elektronischen Sicherungen (805, 825). die komprimierten Sicherungsdaten entsprechend der Figur 74 erzeugen. Die erste beispielhafte Sicherung (825) übermittelt ihre ersten komprimierten Sicherungsdaten (70160) über einen ersten Beispielhaften Datenbus (9) an die erste Datenschnittstelle (556) des übergeordneten Rechnersystems (12). Die zweite beispielhafte Sicherung (825') übermittelt ihre zweiten komprimierten Sicherungsdaten (70160') über einen zweiten beispielhaften Datenbus (9') an die beispielhafte zweite Datenschnittstelle (556') des übergeordneten Rechnersystems (12). Statt zweier Datenbusse (9, 9') kann das Versorgungsnetzwerk (200) auch nur einen Datenbus (9') aufweisen. In dem Fall übermittelt die zweite beispielhafte Sicherung (825') ihre zweiten komprimierten Sicherungsdaten (70160') über den ersten beispielhaften Datenbus (9') an die beispielhafte erste Datenschnittstelle (556) des übergeordneten Rechnersystems (12) und das übergeordnete Rechnersystems (12) trennt die beiden Datenströme im Zeit- statt Raummultiplex dann intern.

Eine erste Dekompressionsvorrichtung 75010 dekomprimiert die von der ersten Sicherung 825 empfangenen, ersten, komprimierten Sicherungsdaten 70160, die zu dekomprimieren sind, beispielsweise mittels des Dekompressionsverfahren der Figur 70 zu einem ersten rekonstruierten Parametersignal 70610 der ersten Sicherung 825.

Eine zweite Dekompressionsvorrichtung 75010' dekomprimiert die von der zweiten Sicherung 805 empfangenen, zweiten, komprimierten Sicherungsdaten 70160', die zu dekomprimieren sind, beispielsweise mittels des Dekompressionsverfahren der Figur 70 zu einem zweiten rekonstruierten Parameter-signal 70610' der zweiten Sicherung 805'.

Sofern das übergeordnete Rechnersystem 12 weitere komprimierte Sicherungsdaten empfängt, die zu dekomprimieren sind, dekomprimiert eine jeweilige weitere Dekompressionsvorrichtung bevorzugt die von der weiteren Sicherung empfangenen, weiteren, komprimierten Sicherungsdaten, die zu dekomprimieren sind, beispielsweise mittels des Dekompressionsverfahren der Figur 70 zu einem jeweiligen weiteren rekonstruierten Parametersignal der jeweiligen weiteren Sicherung. Zur besseren Übersicht zeigt die Figur 75 nur zwei Sicherungen 825 und 805.

Bevorzugt fusioniert eine Kombinationsvorrichtung 75101 das erste rekonstruierte Parametersignal 70610 der ersten Sicherung 825 und das zweite rekonstruierte Parametersignal 70610' der zweiten Sicherung 825 und ggf. weitere rekonstruierte Parametersignale der weiteren Sicherungen zu einem fusionierten Parametersignal 75103. Hierbei interpoliert die Kombinationsvorrichtung 75101 die Werteverläufe der rekonstruierten Parametersignale verschiedenen Abtastzeitpunkte der rekonstruierten Parametersignale und erzeugt dabei ein fusioniertes Parametersignal 75103, bei dem alle Abtastwerte der verschiedenen Teilsignale der rekonstruierten Parametersignale 75103 auf synchrone Abtastzeitpunkte bezogen sind.

Figur 75 zeigt eine beispielhafte Vorrichtung in Form eines beispielhaften übergeordneten Rechnersystems 12. Die Darstellung ist vereinfacht und schematisch. Die Vorrichtungteile des übergeordneten Rechnersystems 12 können zum Teil mittels Software durch einen Rechnerkern des übergeordneten Rechnersystems 12 emuliert werden. Das übergeordnete Rechnersystem 12 führt eine Erkennung von fusionierten Signalobjekten und fusionierten Signalgrundobjekten in dem fusionierten Parametersignal 75103 bevorzugt durch. Die Aufgabe ähnelt also der in Figur 62 für eine elektronische Sicherung 1. Der Unterschied ist, dass das fusionierte Parametersignal 75103 letztlich auf einer Mehrzahl von Parametersignalen 62103 mehrerer Sicherungen fußt. Daher sind die Signalobjekte auch andere. Zur Unterscheidung sind die entsprechenden funktionalen Komponenten in diesem Dokument für die Klassifikation der Ereignisse im Versorgungsnetzwerk mit dem Adjektiv "fusioniert" markiert, so dass ähnliche Bezeichnungen wie in der Figur 62 verwendet werden können.

Auch hier kann typischerweise das fusionierte Parametersignal 75103 ein Bündel mehrerer Signale sein. Das fusionierte Parametersignal 75103 ist das Eingangssignal der anschließenden Signalobjektklassifikation in fusionierte Signalobjekt und/oder fusionierte Signalgrundobjekte. Bevorzugt ist das das fusionierte Parametersignal 75103 ein digitalisiertes Signal mit zeitlich beabstandeten Abtastwerten. Das übergeordnete Rechnersystem 12 kann beispielsweise Vorrichtungteile des übergeordneten Rechnersystems 12 sofern möglich, per Software-Programm emulieren. Die fusionierte Merkmalsvektorextraktion 75111 des übergeordneten Rechnersystems 12 verfügt über verschiedene Vorrichtungen, hier beilspielhaft n Optimalfilter (Optimalfilter 75123.1 bis Optimalfilter 75123.m) des übergeordneten Rechnersystems 12 mit m als ganzer positiver Zahl. Die Ausgänge der hier beispielhaften Optimalfilter 75123.1 bis 75123.m des übergeordneten Rechnersystems 12 bilden das fusionierte Zwischenparametersignal 75123. Statt der Optimalfilter 75123.1 bis 75123.m des übergeordneten Rechnersystems 12 oder ergänzend zu diesen können auch

- Integratoren und/oder
- Differenzierer und/oder
- Filter und/oder
- Logarithmierer und/oder
- FF- und DFFT-Vorrichtungen und/oder
- Korrelatoren und/oder
- Demodulatoren, die ihr Eingangssignal mit einem vorgegebenen Signal multiplizieren und dann filtern, und/oder
- andere signalverarbeitende Teilvorrichtungen und/oder
- deren Kombinationen

je nach Anwendungsfall eingesetzt werden, die dann das m-dimensionale fusionierte Zwischenparametersignal 75123 des übergeordneten Rechnersystems 12 erzeugen. Die mit "Optimalfilter" bezeichneten Blöcke in den Zeichnungen sind insofern nur als Platzhalter für solche Signalverarbeitungsblöcke des übergeordneten Rechnersystems 12 zu verstehen. Auch kann ein solcher mit "Optimalfilter" bezeichneter Signalverarbeitungsblock des übergeordneten Rechnersystems 12 auch mehr als einen Ausgang haben, der zu dem m-dimensionalen fusionierten Zwischenparametersignal 75123 des übergeordneten Rechnersystems 12 also mehrfach mit mehr als einem Signal beiträgt. Eine nachfolgender, beispielhafte fusionierte Signifikanzsteigerungseinheit 75125 des übergeordneten Rechnersystems 12 dient dazu, den m-dimensionalen Raum des fusionierten Zwischenparametersignals 75123 des übergeordneten Rechnersystems 12 auf einen n-dimensionalen Raum des Signals der fusionierten Merkmalsvektoren 75138 des übergeordneten Rechnersystems 12 abzubilden. Dabei ist n eine ganze positive Zahl. In der Regel ist n kleiner als m. Dies dient zum einen dazu, dass die Selektivität der Parameterwerte, aus denen sich jeder fusionierter Merkmalsvektor des fusionierten Signals der fusionierten Merkmalsvektoren 75138 des übergeordneten Rechnersystems 12 ergibt, maximiert wird. Dies geschieht bevorzugt durch eine lineare Abbildung mit Hilfe eines im Labor mit statistischen Verfahren bestimmten Offset-Werts, der zu den Werten der fusionierten Zwischenparametersignale hinzuaddiert wird, und einer so genannten fusionierten LDA Matrix 75126, mit der der jeweilige Vektor der jeweiligen Abtastwerte der fusionierten Zwischenparametersignale 75123 des übergeordneten Rechnersystems 12 jeweils zu einem fusionierten Merkmalsvektor des fusionierten Signals der fusionierten Merkmalsvektoren 75138 durch das übergeordnete Rechnersystem 12 multipliziert wird. Der fusionierte Abstandsermittler / Klassifikator 75112 vergleicht bevorzugt jeden sich so ergebenden fusionierten Merkmalsvektoren des fusionierten Signals der fusionierten Merkmalsvektoren 75138 des übergeordneten Rechnersystems 12 mit jedem fusionierten Signalgrundobjektprototypen der fusionierten Prototypendatenbank 75115 des übergeordneten Rechnersystems 12. Die fusionierte Prototypendatenbank 75115 des übergeordneten Rechnersystems 12 enthält hierfür für bevorzugt jeden der fusionierten Signalgrundobjektprototypen der fusionierten Prototypendatenbank 75115 einen Eintrag mit einem Schwerpunktvektor (z.B. ähnlich 63141, 63142, 63143, 63144) des jeweiligen fusionierten Signalgrundobjektprototypen der fusionierten Prototypendatenbank 75115 des übergeordneten Rechnersystems 12. Bevorzugt wird ein Abstand des aktuell untersuchten fusionierten Merkmalsvektors des fusionierten Signals der fusionierten Merkmalsvektoren 75138 des übergeordneten Rechnersystems 12 zu dem gerade untersuchten Schwerpunktvektor der fusionierten Prototypendatenbank 75115 des übergeordneten Rechnersystems 12 durch den fusionierten Abstandsermittler 75112 des übergeordneten Rechnersystems 12 berechnet. Der fusionierte Abstandsermittler 75112 des übergeordneten Rechnersystems 12 kann aber auch auf andere Weise eine Bewertung der Ähnlichkeit zwischen dem Schwerpunktvektor (z.B. ähnlich 63141, 63142, 63143, 63144) des jeweiligen fusionierten Signalgrundobjektprototypen der fusionierten Prototypendatenbank 75115 des übergeordneten Rechnersystems 12 und dem aktuell untersuchten fusionierten Merkmalsvektor des fusionierten Signals der fusionierten Merkmalsvektoren 75138 des übergeordneten Rechnersystems 12 in Form eines Bewertungswerts, den wir hier der Einfachheit halber stets fusionierten Abstand nennen, berechnen. Der fusionierte Abstandsermittler 75112 ermittelt auf diese Weise ob ein Schwerpunktvektor (z.B. ähnlich 63141, 63142, 63143, 63144) der fusionierten Signalgrundobjektprototypen der fusionierten Prototypendatenbank 75115 dem aktuellen fusionierten Merkmalsvektor des fusionierten Signals der fusionierten Merkmalsvektoren 75138 des übergeordneten Rechnersystems 12 ausreichend ähnlich ist, also einen ausreichend geringen fusionierten Abstand hat und, falls dies der Fall ist, welcher Schwerpunktvektor (z.B. ähnlich 63141, 63142, 63143, 63144) der fusionierten Signalgrundobjektprototypen der fusionierten Prototypendatenbank 75115 des übergeordneten Rechnersystems 12 dem aktuellen fusionierten Merkmalsvektor des fusionierten Signals der fusionierten Merkmalsvektoren 75138 am ähnlichsten ist, also den geringsten fusionierten Abstand hat. Ggf. ermittelt der fusionierte Abstandsermittler 75112 des übergeordneten Rechnersystems 12 eine Liste von Schwerpunktvektoren (z.B. ähnlich 63141, 63142, 63143, 63144) der fusionierten Signalgrundobjektprototypen der fusionierten Prototypendatenbank 75115 des übergeordneten Rechnersystems 12, die dem aktuellen fusionierten Merkmalsvektor des fusionierten Signals der fusionierten Merkmalsvektoren 75138 des übergeordneten Rechnersystems 12 ausreichend ähnlich sind, also einen ausreichend geringen fusionierten Abstand haben. Bevorzugt werden diese nach fusioniertem Abstand geordnet und mit ihrem zugehörigen fusionierten Abstand als fusionierte Hypothesenliste an den fusionierten Viterbi-Schätzer 75113 weitergegeben. Eine beispielhafte Hypothesenliste wurde oben angegeben. Die fusionierte Hypothesenlist ist bevorzugt anlog zur Hypothesenliste aufgebaut. Die Weitergabe des Erkennungsergebnisses des fusionierten Abstandsermittlers (der hier auch als fusionierter Klassifikator bezeichnet wird) 75112 erfolgt im Falle eines einzelnen erkannten fusionierten Signalgrundobjekts 75121 als fusioniertes Symbol (Z.B. als Prototypendatenbankadresse/-index, der fusionierten Prototypendatenbank 75115 die auf den erkannten fusionierten Signalgrundobjektprototypen der fusionierten Prototypendatenbank 75115 zeigt.) und im Falle einer fusionierten Hypothesenliste bevorzugt als Liste von Paaren aus einem Symbol (Index) des erkannten fusionierten Signalgrundobjekts (Z.B. der Prototypendatenbankadresse / -index, die auf den erkannten fusionierten Signalgrundobjektprototypen der fusionierten Prototypendatenbank 75115 zeigt.) und des fusionierten Abstands zum Schwerpunkt dieses erkannten fusionierten Signalgrundobjekts. Der fusionierte Viterbi-Schätzer 75113 des übergeordneten Rechnersystems 12 sucht dann, die Folge aus fusionierten Signalgrundobjektprototypen, die einer vordefinierten Abfolge von fusionierten Signalgrundobjektprototypen in seiner fusionierten Signalobjektsequenzdatenbank 75116 am besten entspricht. Hierbei werden Übereinstimmungen beispielsweise positiv gezählt und Nichtübereinstimmungen negativ gezählt, sodass sich für eine zeitliche Folge von erkannten fusionierten Signalgrundobjektprototypen ein Bewertungswert für jeden Eintrag der fusionierten Signalobjektsequenzdatenbank 75116 des übergeordneten Rechnersystems 12 ergibt. Im Falle von fusionierten Hypothesenlisten überprüft der fusionierte Viterbi-Schätzer 75113 bevorzugt alle möglichen Pfade durch die zeitliche Sequenz von fusionierten Hypothesenlisten. Bevorzugt ermittelt der fusionierte Viterbi-Schätzer 75113 sein Bewertungsergebnis unter Berücksichtigung der zuvor ermittelten fusionierten Abstände. Dies kann beispielsweise durch Division der hinzuaddierten Werte durch den fusionierten Abstand vor der Addition bei der Bildung des fusionierten Bewertungswerts geschehen. Auf diese Weise ermittelt der fusionierte Viterbi-Schätzer 75113 die erkannten fusionierten Signalobjekte 75122, die das übergeordnete Rechnersystem 12 zur Ableitung von Maßnahmen und/oder zur Übertragung an einen Server 710 nutzen kann. Das übergeordnete Rechnersystem 12 kann auch die erkannten fusionierten Signalgrundobjekte 75121 direkt an einen solche Server 710 übertragen. Wichtig ist: Es geht bei dieser Vorgehensweise beispielsweise um das Erkennen von physikalisch beispielsweise in Stromsignalen und/oder Spannungssignalen innerhalb des Versorgungsnetzwerks 200 auftretenden Ereignissen und Zuständen und das Übertragen dieser Information und um das Erkennen von Strukturen innerhalb des fusionierten Parametersignals 75103 und deren Übertragung an einen Server 710 und/oder das Ableiten von Maßnahmen des übergeordneten Rechnersystems 12. Als Hauptzweck kann das übergeordnete Rechnersystem 12 aus den auftretenden fusionierten Signalgrundobjekten und aus der Abfolge dieser fusionierten Signalgrundobjekte und deren Parametrisierungen auf den Zustand einer oder mehrerer Sicherungen und/oder des abgesicherten Versorgungsnetzes und/oder des Fahrzeugs etc. schließen. Ggf. berücksichtigt das übergeordnete Rechnersystem 12 dabei auch die Daten anderer Sensoren und/oder Sicherungen im Versorgungsnetzwerk 200 und/oder im Fahrzeug und ggf. weitere Daten von Servern 710, die im Weitesten Sinne zumindest zeitweilig mit dem übergeordneten Rechnersystem 12 in einer Datenverbindung z.B. über den Datenbus 9 verbunden sind.

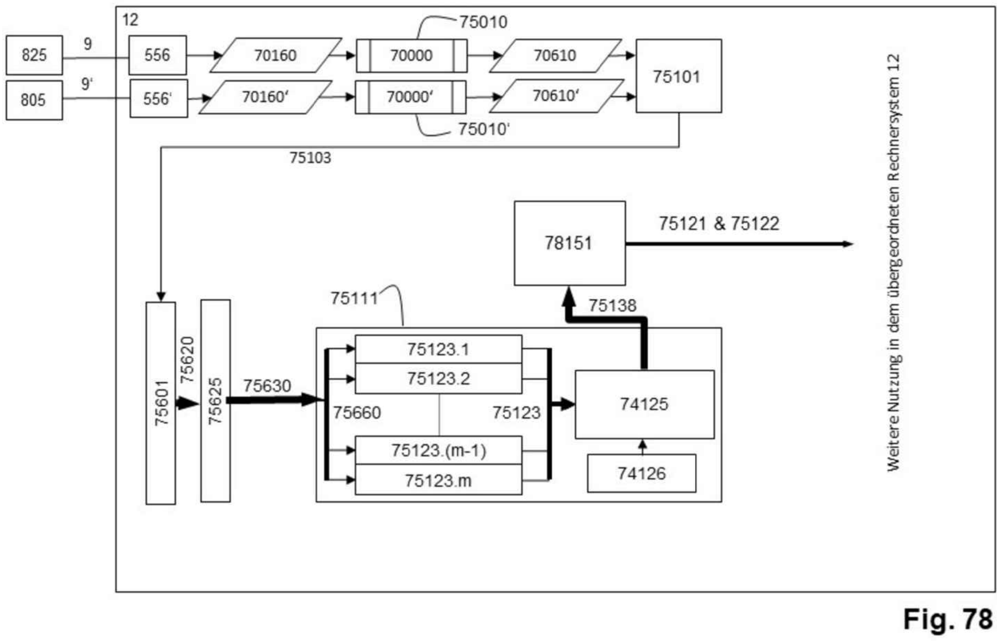

Der in den Figuren 71 bis 73 in seiner Funktion erläuterte Rekonstruierer 74600 wird nun im übergeordneten Rechnersystem 12 als Rekonstruierer 75600 nach der Datenübertragung eingesetzt. Hierzu erzeugt der Rekonstruierer 75600 des übergeordneten Rechnersystems 12 einen rekonstruierten fusionierten Parametersignal-Modellvektor 75610 des übergeordneten Rechnersystems 12 wie in den Figuren 71 bis 73 je nach Zweck als rekonstruierter Parametersignal-Modellvektor 74610 dargestellt. Dieses wird von dem zuvor empfangenen fusionierten Parametersignal 75103 in einem Vektorsubtrahierer 75602 des übergeordneten Rechnersystems 12 sukzessive abgezogen. Hierzu wird das fusionierte Parametersignal 75103 des übergeordneten Rechnersystems 12 bevorzugt in Form digitaler Abtastwerte in einem zweistufigen Speicher 75601, 75625 des übergeordneten Rechnersystems 12 bevorzugt zeitlich geordnet abgelegt. Dabei korrespondiert ein abgelegter Abtastwert des fusionierten Parametersignals 75103 des übergeordneten Rechnersystems 12 bevorzugt mit genau einem Wert des rekonstruierten fusionierten Parametersignal-Modellvektors 75610 des übergeordneten Rechnersystems 12, das bevorzugt ebenfalls in einem Rekonstruktionsspeicher 75603 des übergeordneten Rechnersystems 12 abgelegt ist. Der Rekonstruktionsspeicher 74603 des übergeordneten Rechnersystems 12 kann Teil des Rekonstruierers 74600 des übergeordneten Rechnersystems 12 sein. Dieser zusätzliche Rückkopplungszweig (74600, 74610, 74603, 74602, 74601) des übergeordneten Rechnersystems 12 kann auch für andere Klassifizierer wie beispielsweise die Vorrichtung der Figur 78 verwendet werden. Beispielsweise kann das übergeordnete Rechnersystem 12 ein neuronales Netzwerkmodell 78151 ausführen, dass das fusionierte Parametersignal 75103 in fusionierte Signalgrundobjekte 75121 und/oder fusionierte Signalobjekte 75122 klassifiziert.

Besonders vorteilhaft ist die Rekonstruktion eines rekonstruierten fusionierten Parameter-Signal-Modellvektors 75610 des übergeordneten Rechnersystems 12 aus den erkannten Signalobjekten 75122 und den Signalgrundobjekten 75121 während der Kompression / Klassifikation des fusionierten Parametersignals 75103 des übergeordneten Rechnersystems 12.

Hierzu speichert das übergeordnete Rechnersystem 12 bevorzugt die q Abtastwerte des fusionierten Parametersignals 75103 eines zeitlichen Abtastfensters, die Kombinationsvorrichtung 75101 in dem zeitlichen Abtastfenster aus den rekonstruierten Parametersignalen 70610, 70610' durch Datenfusion erzeugt hat, in einem ersten Abtastwertespeicher 75601 des übergeordneten Rechnersystems 12. Die Zahl q ist hierbei eine positive ganze Zahl, die die Anzahl der Abtastwerte im ersten Abtastwertespeicher 75601 des übergeordneten Rechnersystems 12 angibt. Sobald das Abtastfenster zeitlich zu Ende ist, löscht der Abtastwertespeicher 77601 r älteste Abtastwerte in seinen Speicherzellen. Die Zahl r ist dabei eine ganze positive Zahl. Dann verschiebt bevorzugt der erste Abtastwertespeicher 75601 des übergeordneten Rechnersystems 12 alle Abtastwerte um die jeweils gleiche Anzahl r an Speicherzellen in dem ersten Abtastspeicher 75601 des übergeordneten Rechnersystems 12 in der Art, dass der älteste nicht gelöschte Abtastwert in der Speicherzelle des ersten Abtastspeichers 75601 des übergeordneten Rechnersystems 12 liegt, in der zuvor der älteste, zuvor gelöschte Abtastwert gespeichert war. Hierdurch wird nach dem Ende eines Abtastfensters in einem neuen zeitlichen Abtastfenster der erste Abtastwertespeicher 75601 des übergeordneten Rechnersystems 12 mit den neuen Abtastwerten des neuen Abtastfensters wieder sukzessive aufgefüllt, während er immer die ältesten Abtastwerte verwirft, um Platz für diese neuen, nachrückenden Abtastwerte zu schaffen.

Die q Abtastwerte im ersten Abtastwertespeicher 75601 des übergeordneten Rechnersystems 12 bilden einen q-dimensionalen ersten Abtastwertevektor 75620 des übergeordneten Rechnersystems 12, den der erste Abtastwertespeicher 74601 des übergeordneten Rechnersystems 12 bevorzugt ausgibt. Da während des Einschreibens der Abtastwerte des fusionierten Parametersignals 75103 in den ersten Abtastwertespeicher 75607 des übergeordneten Rechnersystems 12 der Inhalt des ersten Abtastwertevektors 75620 instabil ist, übernimmt am zeitlichen Ende eines jeden Abtastzeitfensters ein zweiter Abtastspeicher 75625 des übergeordneten Rechnersystems 12 den Abtastwertevektor 75620 von dem ersten Abtastwertespeicher 75601 des übergeordneten Rechnersystems 12.

Das übergeordnete Rechnersystem 12 erzeugt den fusionierten Parametersignal-Modellvektor 75610 des übergeordneten Rechnersystems 12 aus den summierend linear überlagerten Signalverlaufsmodellen der einzelnen erkannten Signalobjekte und/oder Signalgrundobjekten.

Dias übergeordnete Rechnersystem 12 subtrahiert mittels eines Vektorsubtrahierers 75602 des übergeordneten Rechnersystems 12 die Werte der Vektorkomponenten des gespeicherten fusionierten Parametersignal-Modellvektors 75635 von dem zweiten Abtastwertevektor 75630 des übergeordneten Rechnersystems 12 ab und bildet hierdurch ein Vektorrestsignal 75660 des übergeordneten Rechnersystems 12. Dies unterdrückt dem mit höherer Wahrscheinlichkeit erkanntem selektieren Signalobjekt ähnliche Signalobjekte besser. Die schwächeren Signalobjekte und Signalgrundobjekte treten in dem Vektorrestsignal 75660 hierdurch außerdem besser hervor. Das übergeordnete Rechnersystem 12 kann dann die schwächeren Signalobjekte und Signalgrundobjekte in dem Vektorrestsignal 75660 des übergeordneten Rechnersystems 12 besser erkennen. (Siehe auch Figur 73). Das in der technischen Lehre des hier vorgelegten Dokuments vorgeschlagene Verfahren umfasst somit bevorzugt auch eine Subtraktion des aus den bereits erkannten Signalobjekten und Signalgrundobjekten gespeicherten fusionierten Parametersignal-Modell 75635 des übergeordneten Rechnersystems 12 von dem zweiten Abtastwertevektor 75630 des übergeordneten Rechnersystems 12 im zweiten Abtastwertespeicher 75625 des übergeordneten Rechnersystems 12 zur Bildung des Vektorrestsignals 75660 des übergeordneten Rechnersystems 12. Das übergeordnete Rechnersystem 12 verwendet das so gebildete Vektorrestsignal 75660 des übergeordneten Rechnersystems 12 dann wieder für die die Bildung des fusionierten Signals der Merkmalsvektoren 75138 des übergeordneten Rechnersystems 12 mittels der Merkmalsextraktion 75111 des übergeordneten Rechnersystems 12. Mittels der Merkmalsextraktion 75111 des übergeordneten Rechnersystems 12 und mittels der Abstandsberechnung 75112 des übergeordneten Rechnersystems 12 bzw. des Klassifikators 75112 des übergeordneten Rechnersystems 12 und ggf. des Viterbi-Schätzers 75113 des übergeordneten Rechnersystems 12 ermittelt das übergeordnete Rechnersystems 12 dann dasjenige Signalobjekt der Signalobjektsequenzdatenbank 75116 des übergeordneten Rechnersystems 12 von Sequenzen fusionierter Signalgrundobjektprototypen bzw. dasjenige Signalgrundobjekt der Prototypendatenbank 75115 fusionierter Signalgrundobjektprototypen des übergeordneten Rechnersystems 12 mit der nächst niedrigeren Wahrscheinlichkeit. Da das zuerst erkannte fusionierte Signalobjekt bzw. fusionierte Signalgrundobjekt entsprechend seiner Gewichtung aus dem zweiter Abtastwertevektor des zweiten Abtastwertespeichers 75625 des übergeordneten Rechnersystems 12 entfernt wurde und dadurch im fusionierten Vektorrestsignal 75660 des übergeordneten Rechnersystems 12 im Wesentlichen nicht mehr vorhanden ist, kann das zuerst erkannte fusionierte Signalobjekt bzw. fusionierte Signalgrundobjekt diese Erkennung nicht mehr beeinflussen. Somit liefert diese Form der Erkennung ein besseres Ergebnis in Form einer Liste erkannter fusionierter Signalobjekte bzw. fusionierter Signalgrundobjekte.

Ein Rekonstruierer 75600 des übergeordneten Rechnersystems 12 rekonstruiert mit Hilfe der erkannten fusionierten Signalgrundobjekte 75121 und den erkannten fusionierten Signalobjekte 75122 und mittels der mit ermittelten Signalgrundobjektparameter und der mitermittelten Signalobjektparameter und den Daten aus der Prototypendatenbank 75155 der fusionierten Signalobjekte und den Daten aus der Signalobjektsequenzdatenbank 75116 der Sequenzen fusionierter Signalobjekte und mittels der zugehörigen Zeitstempel das fusionierte Parametersignal 75103 so, als wenn es nur aus den erkannten fusionierten Signalobjekten 75122 mit den mitermittelten Signalobjektparametern und den ermittelten Signalgrundobjektparameter mit den mitermittelten Signalgrundobjektparametern unter Berücksichtigung der zugehörigen Zeitstempel durch Addition der korrespondierenden Vektorwerte zusammengesetzt wäre. Ein Rekonstruierer 75600 rekonstruiert auf diese Weise das den rekonstruierten fusionierten Parameter-signal-Modellvektor 75610 mit q Werten an Vektorkomponenten, die zu den q Werten der Vektorkomponenten des zweiten Abtastwertevektors des übergeordneten Rechnersystems 12 der im zweiten Abtastwertespeicher 75625 des übergeordneten Rechnersystems 12 korrespondieren, als rekonstruierten fusionierten Parametersignal-Modellvektor 75610. Der Rekonstruktionsspeicher 75603 des übergeordneten Rechnersystems 12 speichert den rekonstruierten fusionierten Parametersignal-Modellvektor 75610 des übergeordneten Rechnersystems 12 zwischen. Der Rekonstruierer 75600 des übergeordneten Rech**nersystems** 12 umfasst bevorzugt den Rekonstruktionsspeicher 75603 des übergeordneten Rechnersystems 12. Der Rerekonstruktionsspeicher 75603 des übergeordneten Rechnersystems 12 gibt den in seinen Speicherzellen gespeicherten rekonstruierten fusionierten Parametersignal-Modellvektor 75610 als gespeicherten fusionierten Parametersignal-Modellvektor 75635 an den Vektorsubtrahierer 75602 des übergeordneten Rechnersystems 12 aus, was den Kreis schließt.

Bevorzugt wird diese reduzierende Klassifikation des fusionierten Parametersignals 75103 und die Zerlegung in prototypische fusionierte Signalobjekte bzw. fusionierte Signalgrundobjekte mit Hilfe des fusionierten Parametersignal-Modellvektors 75610 des übergeordneten Rechnersystems 12 dann beendet, wenn die Beträge der Abtastwerte des fusionierten Vektorrestsignals 75660 des übergeordneten Rechnersystems 12 unter den Beträgen einer vorgegebenen Schwellwertkurve und/oder eines Schwellwerts liegen.

Bevorzugt ergreift das übergeordnete Rechnersystem 12 in Abhängigkeit von den erkannten fusionierten Signalobjekten 75122 und/oder den erkannten fusionierten Signalgrundobjekten 75121 Maßnahmen. Solche Maßnahmen können beispielsweise das Öffnen und/oder Schließen von Leistungsschaltern 17 von Sicherungen im Versorgungsnetzwerk 200 mittels Kommandos von dem übergeordneten Rechnersystem 12 an eine oder mehrere Sicherungen im Versorgungsnetzwerk 200 betreffen. Solche Maßnahmen können beispielsweise eine Umkonfiguration des Versorgungsnetzwerks mittels elektronischer Sicherungen im Versorgungsnetzwerk 200 mittels Kommandos von dem übergeordneten Rechnersystem 12 an eine oder mehrere Sicherungen dieser Sicherungen im Versorgungsnetzwerk 200 betreffen. Solche Maßnahmen können beispielsweise ein Abwerfen von Versorgungsteilnetzen und/oder das Zuschalten von Versorgungsteilnetzen des Versorgungsnetzwerks mittels elektronischer Sicherungen im Versorgungsnetzwerk 200 mittels Kommandos von dem übergeordneten Rechnersystem 12 an eine oder mehrere Sicherungen dieser Sicherungen im Versorgungsnetzwerk 200 betreffen. Solche Maßnahmen können beispielsweise Signalisierungen an andere Rechnersystem und/oder Server 710, 750 und/oder Terminals 740 betreffen. Solche Maßnahmen können beispielsweise Signalisierungen über eine Mensch-Maschine-Schnittstelle eines Terminals 740 oder dergleichen betreffen.

Beispielsweise kann das übergeordnete Rechnersystem 12 hierdurch zeitlich korrelierte Fehlerzustände im Versorgungsnetzwerk 200 erkennen, die in der einzelnen Sicherung nicht erkennbar sind.

Das übergeordnete Rechnersystem kann solche erkannten Signalobjekte einzelner oder mehrerer Sicherungen und/oder solche erkannten Signalgrundobjekte einzelner oder mehrerer Sicherungen und/oder solche erkannten fusionierten Signalobjekte einzelner oder mehrerer Sicherungen und/oder solche erkannten fusionierten Signalgrundobjekte einzelner oder mehrerer und/oder weitere Sensordaten an einen Server 710, beispielsweise eines Automobilherstellers oder eines Dienstanbieters versenden. Bevorzugt komprimiert das übergeordnete Rechnersystem 12 diese Daten vor der Versendung. Bevorzugt verwendet das übergeordnete Rechnersystem hierzu Verfahren, Teilvorrichtungen und Konzepte, wie sie das hier vorgestellte Dokument für die Kommunikation zwischen einer elektronischen Sicherung eines Versorgungsnetzwerks und dem übergeordneten Rechnersystem 12 hier bezüglich Kompression und Verschlüsselung beschreibt. In dem Fall übernimmt das übergeordnete Rechnersystem 12 dann die Funktion der Steuervorrichtung 4 der elektronischen Sicherung und der Server 710 die Funktion des übergeordneten Rechnersystems 12. Bevorzugt weist daher das übergeordnete Rechnersystem 12 einen Quantenzufallszahlengenerator auf der in seiner Konstruktion und in dem in diesem Quantenzufallszahlengenerator durchgeführten Verfahren dem in diesem Dokument beschriebenen Quantenzufallszahlengenerator für die Steuervorrichtung 4 einer Sicherung 1 entspricht.

Figur 76

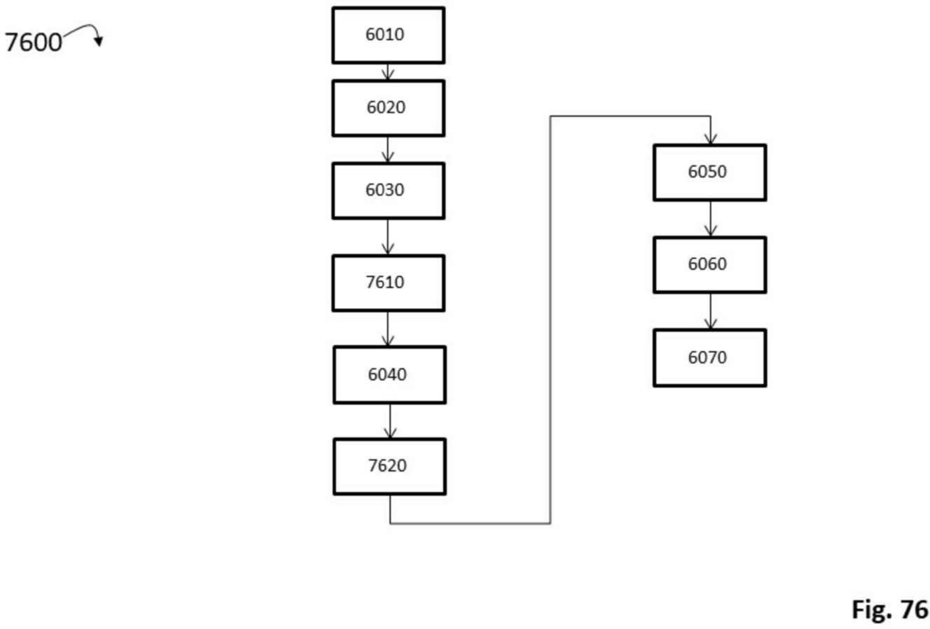

Figur 76 zeigt ein Verfahren 7600 zum Betreiben eines Versorgungsnetzwerks 200 mit Komprimierung und Verschlüsselung der Sicherungsdaten in der elektronischen Sicherung 1 und Entschlüsselung und Dekomprimierung der Sicherungsdaten im übergeordneten Rechnersystem 12. Das Verfahren entspricht dem Verfahren der Figur 60. Zusätzlich zu dem Verfahren der Figur 60 umfasst das Verfahren das Verschlüsseln 7610 des einen oder der mehreren komprimierten, erfassten zeitlichen Parameterwerteverläufe des einen oder der mehreren zu meldenden physikalischen Parameter, insbesondere durch die Steuervorrichtung 4 der elektronischen Sicherung 1, zu einem oder mehreren, verschlüsselten, komprimierten, erfassten zeitlichen Parameterwerteverläufe des einen oder der mehreren zu meldenden physikalischen Parameter. Zusätzlich zu dem Verfahren der Figur 60 umfasst des Weiteren das Entschlüsseln 7620 des einen oder der mehreren verschlüsselten, komprimierten, erfassten zeitlichen Parameterwerteverläufe des einen oder der mehreren zu meldenden physikalischen Parameter, insbesondere durch die Steuervorrichtung 4 der elektronischen Sicherung 1, zu einem oder mehreren, entschlüsselten, komprimierten, erfassten zeitlichen Parameterwerteverläufe des einen oder der mehreren zu meldenden physikalischen Parameter;

Figur 77

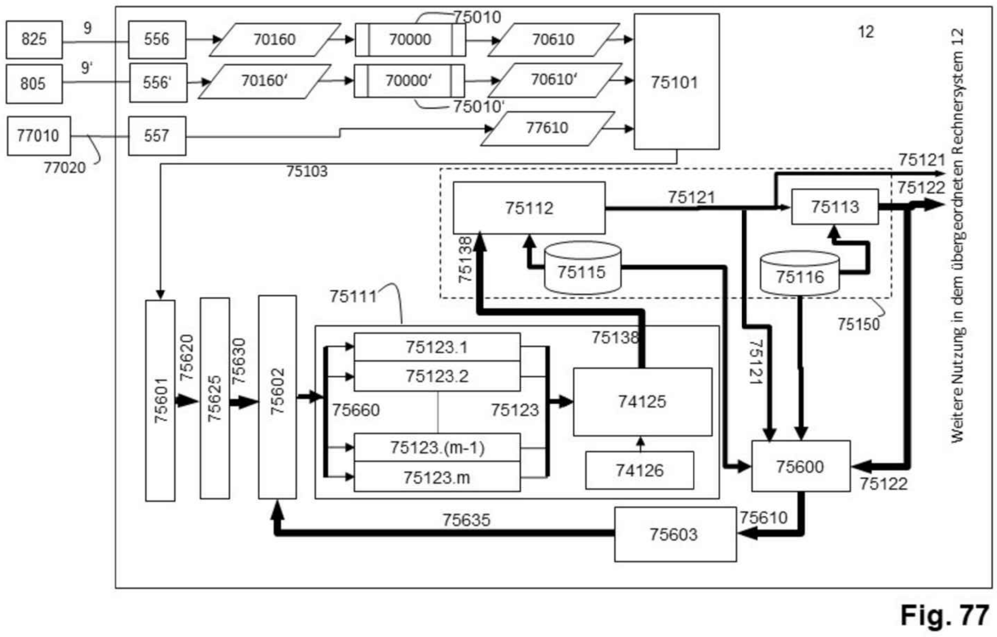

Figur 77 entspricht der Figur 75 mit dem Unterschied, dass der Kombinierer 75101 die rekonstruierten Parametersignale 70610 und 70610' nun nicht nur miteinander, sondern auch mit einem Parameter-signal 77610 eines weiteren Sensors 77010 zum fusionierten Parametersignal 75103 fusioniert.

Der weitere Sensor 77010 überträgt über den Sensordatenbus 77020 Sensordaten in Form eines Parametersignals 77610 eines weiteren Sensors 77010 über eine Sensordatenschnittstelle 557 an das übergeordnete Rechnersystem 12. Der Sensordatenbus 77020 für den beispielhaften Sensor 77010 im Fahrzeug und/oder im Versorgungsnetzwerk 200 kann mit dem Datenbus 9 identisch sein.

Auch hier kann das fusionierte Parametersignal 75103 eine Mehrzahl von Signalen umfassen. Hierdurch kann das übergeordnete Rechnersystem 12 zeitliche Korrelationen zwischen den Werteverläufen anderer physikalischer Parameter des Fahrzeugs und/oder anderen Werteverläufen anderer Parameter des Fahrzeugs und den rekonstruierten Parametersignalen der Sicherungen erfassen und klassifizieren. In Abhängigkeit von den erfassten Korrelationen kann das übergeordnete Rechnersystem 12 entsprechende Maßnahmen, wie das Öffnen und/oder Schließen von Leitungsschaltern von Sicherungen im Versorgungsnetzwerk und/oder das Umkonfigurieren der Topologie des Versorgungsnetzwerks 200 und/oder das Abhängen und/oder zuschalten von Versorgungsteilnetzen mittels elektronischer Sicherungen des Versorgungsnetzwerks 200 per Kommando über den Datenbus 9 an Sicherungen des Versorgungsnetzwerks 200 erfassen. Solche klassifizierten Korrelationen sind bevorzugt fusionierte Signalobjekte und/oder fusionierte Signalgrundobjekte.

Der Kombinierer 75101 fusioniert die rekonstruierten Parametersignale 70610 und 70610' nun nicht nur miteinander, sondern auch mit einem Parametersignal 77610 eines weiteren Sensors 77010 zum fusionierten Parameter-

signal 75103. Diese Fusion der rekonstruierten Parametersignale 70610 und 70610' und des Parametersignals 77610 eines weiteren Sensors 77010 zum fusionierten Parametersignal 75103 stellt die Fusion der so erhaltenen Sicherungsdaten (rekonstruierter Parameterwerteverläufe) mit den Parameterwertverläufen weiterer Sensoren und Sensorsysteme, die Daten direkt oder indirekt über Datenbusses, Datenübertragungsstrecken und/oder den Datenbus 9 an das übergeordnete Rechnersystem 12 übermitteln, dar. Beispielsweise kann eine Sensorfusion so aussehen, dass das übergeordnete Rechnersystem 12 die zeitlichen Verläufe von Wertverläufen von Parametern, die weiteren Sensoren und Sensorsysteme (z.B. 77010) erfassen, mit rekonstruierten Parameterwertverläufen (z.B. 70610, 70601') von Steuervorrichtungen 4 von Sicherungen (z. B. 825, 805) korreliert. Hierzu interpoliert das übergeordnete Rechnersystem 12 auf Basis gültiger Abtastwerte der rekonstruierten Parameterwertverläufe (70610, 70610', 77610) fehlende Abtastwerte zu interpolierten, rekonstruierten Parameterwertverläufen. Des Weiteren interpoliert das übergeordnete Rechnersystem 12 auf Basis gültiger Abtastwerte der Wertverläufe jener Parameter, die die weiteren Sensoren und Sensorsysteme erfassen, interpolierte Wertverläufe jener Parameter, die die weiteren Sensoren und Sensorsysteme erfassen. Bevorzugt korrespondiert dabei zeitlich zu jedem Abtastwert der interpolierten, rekonstruierten Parameterwertverläufe zumindest ein Abtastwert der interpolierten Wertverläufe jener Parameter, die die weiteren Sensoren und Sensorsysteme erfassen. Hierdurch kann das übergeordnete Rechnersystem 12 Korrelationen in Form von auffälligen, typischerweise mehr oder weniger synchronen Ereignissen sowohl in den rekonstruierten Parameterwertverläufen als auch in den Wertverläufen jener Parameter, die die weiteren Sensoren und Sensorsysteme erfassen, suchen. Beispielsweise können mechanische Defekte von mechanischen Vorrichtungen - z.B. Elektromotoren - sich in Beschleunigungswerten - z.B. Vibrationen, Drehmomentschwingungen etc. - bemerkbar machen und gleichzeitig in damit korrespondierenden Schwankungen von Strömen 29, 36 durch die diesen mechanischen Vorrichtungen zugeordneten elektronischen Sicherungen. (Siehe auch Figur 59). Das hier vorgelegte Dokument weist in diesem Zusammenhang auf das Dokument Wolfgang Koch, "Tracking and Sensor Data Fusion: Methodological Framework and Selected Applications (Mathematical Engineering)", Springer 1st ed. 2014 Edition (23. August 2016) ISBN-10: 3662520168, ISBN-13: 978-3662520161 als willkürliches Beispiel aus der unüberschaubaren Menge an Veröffentlichungen zur Sensorfusion hin.

Figur 78

Figur 78 zeigt eine Vorrichtung entsprechend Figur 75, wobei nun das übergeordnete Rechnersystem 12 ein beispielhaftes neuronales Netzwerkmodell 778151 ausführt. Die Eingangssignale des neuronalen Netzwerkmodells 78151 umfassen bevorzugt den aktuellen fusionierten Merkmalsvektor 75138. Das neuronale Netzwerkmodell liefert bevorzugt als Ausgangssignale des neuronalen Netzwerkmodells 78151 eine Folge von fusionierten Signalgrundobjekten 75121 und fusionierte Signalobjekte 75122.

Figur 79

Nach dem erfindungsgemäßen Konzept gemäß dieses Ausführungsbeispiels betrifft die Erfindung ein Versorgungssystem für ein Fahrzeug mit einem bedarfsabhängigen, rekonfigurierbaren Versorgungsnetzwerk. Kriterien für eine Rekonfiguration des Versorgungsnetzwerks können thermische Belastungen in einzelnen Versorgungsteilnetzwerken bzw. deren Versorgungsleitungen und Versorgungsleitungsabschnitten, aber auch die Nichteinhaltung elektrischer Anforderungen sein. Hierzu dienen elektronische Sicherungen, die die elektrischen Parameter an einer Vielzahl von unterschiedlichen Stellen des Versorgungsnetzwerks überwachen und an eine Zentrale melden. Entscheidende Kriterien für eventuelle Rekonfiguration des Versorgungsnetzwerks sind vor allem die Abstimmung der aktuellen Energiebedarfe der elektrischen Verbraucher in Relation zu der Energielieferfähigkeit der Energiequellen. Bei einer eventuelle Rekonfiguration des Versorgungsnetzwerks kann es dazu kommen, dass einzelne Verbraucher "abgeworfen" werden. Hierbei werden vom übergeordneten Steuerungs- bzw. Rechnersystem Prioritäten hinsichtlich der Relevanz der Funktionstüchtigkeit der Verbraucher für allgemein den Fahrbetrieb bzw. für die aktuelle Fahrsituation des Fahrzeugs berücksichtigt.

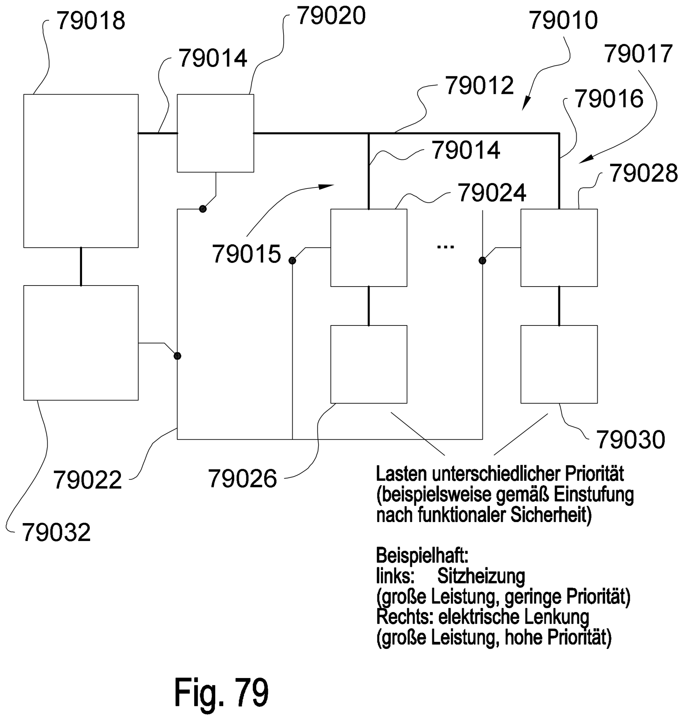

Gemäß dem Ausführungsbeispiel nach Figur 79 weist das Versorgungsnetzwerk 79010 verschiedene Versorgungsleitungen (in Figur 79 ist eine dieser Versorgungsleitungen 79012 gezeigt) auf, von denen mehrere Versorgungsleitungsabschnitte abzweigen. In Figur 79 sind zwei derartige Versorgungsleitungsabschnitte 79014 und 79016 gezeigt, die man auch als Versorgungsteilnetzwerke 79015 und 79017 auffassen kann. Die in diesem Ausführungsbeispiel von der Energiequelle bzw. von einer der Energiequellen 79018 kommende Versorgungsleitung 79012 kann optimal mit einer Verteiler-Substeuereinheit 79020 versehen sein, von der aus sich ein Datenkommunikationsbus 79022 erstreckt.

In dem Versorgungsleitungsabschnitt 79014 befindet sich eine elektronische Sicherung 79024 (oder eine Verteiler-Substeuereinheit für elektronische Sicherung) zur Absicherung eines Verbrauchers 79026 (oder mehrere Verbraucher), bei dem es sich beispielsweise um eine Sitzheizung handelt. In dem Versorgungsleitungsabschnitt 79016 befindet sich ebenfalls eine elektronische Sicherung 79028 (oder eine Verteiler-Substeuereinheit für elektronische Sicherung) zur Absicherung eines weiteren Verbrauchers 79030 (oder mehrerer weiterer Verbraucher), bei dem es sich beispielsweise um die elektrische Lenkung des Fahrzeugs handelt.

Sämtliche elektronische Sicherungen weisen neben ihren elektronischen Leistungsschalten auch Messmittel auf, um die aktuellen Betriebsparameter einer Versorgungsleitung bzw. eines Versorgungsleitungsabschnitts zu ermitteln. Ferner sind sämtliche elektronische Sicherungen über den Datenkommunikationsbus 79022 mit in diesem Ausführungsbeispiel einem Bordnetz-Management als übergeordnetes Steuerungs- bzw. Rechnersystem 79032 verbunden.

Im hier beschriebenen Beispiel handelt es sich bei den beiden Verbrauchern um solche, die durchaus beträchtliche elektrische Leistungen benötigen, aber eindeutig unterschiedliche Prioritäten aufweisen. So ist die Versorgung der elektrischen Lenkung des Fahrzeugs, also des Verbrauchers 79030, wesentlich wichtiger und damit in ihrer Priorität wesentlich höher anzusiedeln als die Versorgung der elektrischen Sitzheizung (Verbraucher 79026) mit elektrischer Energie. Sollte also erkannt werden, dass auf Grund eines hohen Leistungsbedarfs der elektrischen Lenkung die thermische Belastung in der Versorgungsleitung 79012 innerhalb ihres zur Energiequelle 79018 führenden Abschnitts zu hoch wird (die beiden elektrischen Sicherungen 79024 und 79028 melden diesbezüglich insbesondere die aktuell fließenden Ströme und Spannungen), so kann durch das übergeordnete Steuerungs- bzw. Rechnersystem 79032 die elektronische Sicherung 79024 für den elektrischen Verbraucher 79026 (Sitzheizung) ausgeschaltet werden, um die Versorgungsleitung 79012 vor einer thermischen Zerstörung zu bewahren.

Andere potentielle Szenarien können vorsehen, dass durch elektronische Sicherungen zumindest teilweise elektrisch parallel verlaufende Versorgungsleitungsabschnitte eines Versorgungsnetzwerks durch Umschaltung zu ein und demselben elektrischen Verbraucher führen, während sie im Normalfall zu unterschiedlichen Verbrauchern führen. Im Notfall können dann also bei hohen elektrischen Leistungen, die transportiert werden müssen, dafür typischerweise nicht ausgelegte Versorgungsleitungsabschnitte eines Kabelbaums elektrisch parallel geschaltet werden, um den elektrischen Verbraucher, der die hohe elektrische Leistung benötigt, ausreichend und vor thermischer Zerstörung der Versorgungsleitungsabschnitte gesichert versorgen zu können.

Figuren 80 und 81

Nach dem erfindungsgemäßen Konzept gemäß zweier weiterer Ausführungsbeispiele betrifft die Erfindung ein Versorgungssystem für ein Fahrzeug mit einem bedarfsabhängigen, rekonfigurierbaren Versorgungsnetzwerk. Kriterien für eine Rekonfiguration des Versorgungsnetzwerks können thermische Belastungen in einzelnen Versorgungsteilnetzwerken bzw. deren Versorgungsleitungen und Versorgungsleitungsabschnitten, aber auch die Nichteinhaltung elektrischer Anforderungen sein. Hierzu dienen elektronische Sicherungen, die die elektrischen Parameter an einer Vielzahl von unterschiedlichen Stellen des Versorgungsnetzwerks überwachen und an eine Zentrale melden. Entscheidende Kriterien für eventuelle Rekonfiguration des Versorgungsnetzwerks sind vor allem die Abstimmung der aktuellen Energiebedarfe der elektrischen Verbraucher in Relation zu der Energielieferfähigkeit der Energiequellen. Bei einer eventuelle Rekonfiguration des Versorgungsnetzwerks kann es dazu kommen, dass einzelne Verbraucher "abgeworfen" werden. Hierbei werden vom übergeordneten Steuerungs- bzw. Rechnersystem Prioritäten hinsichtlich der Relevanz der Funktionstüchtigkeit der Verbraucher für allgemein den Fahrbetrieb bzw. für die aktuelle Fahrsituation des Fahrzeugs berücksichtigt.

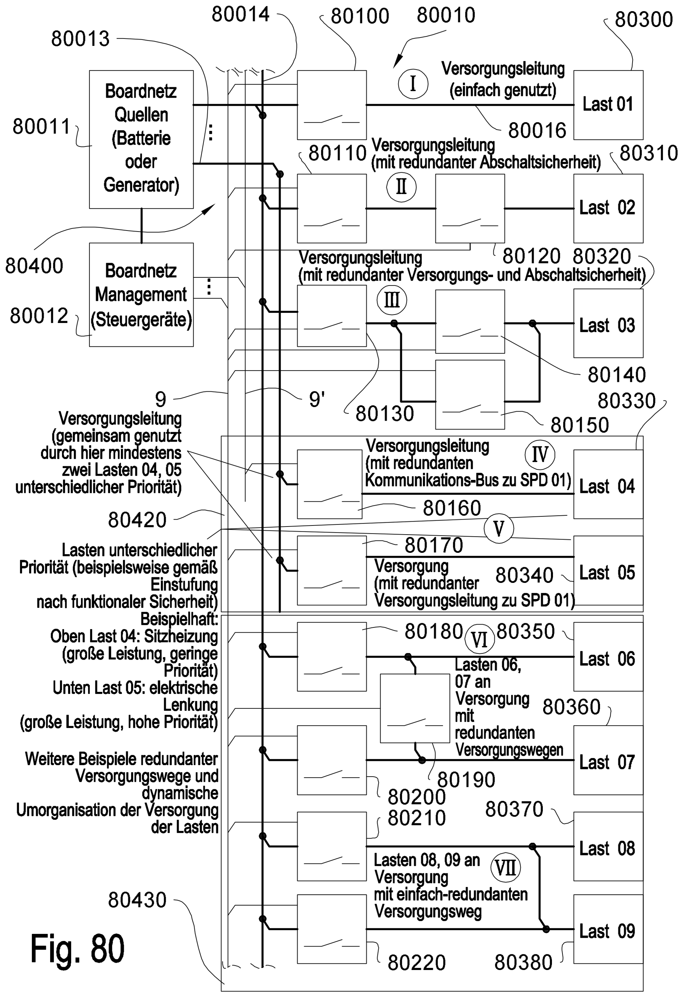

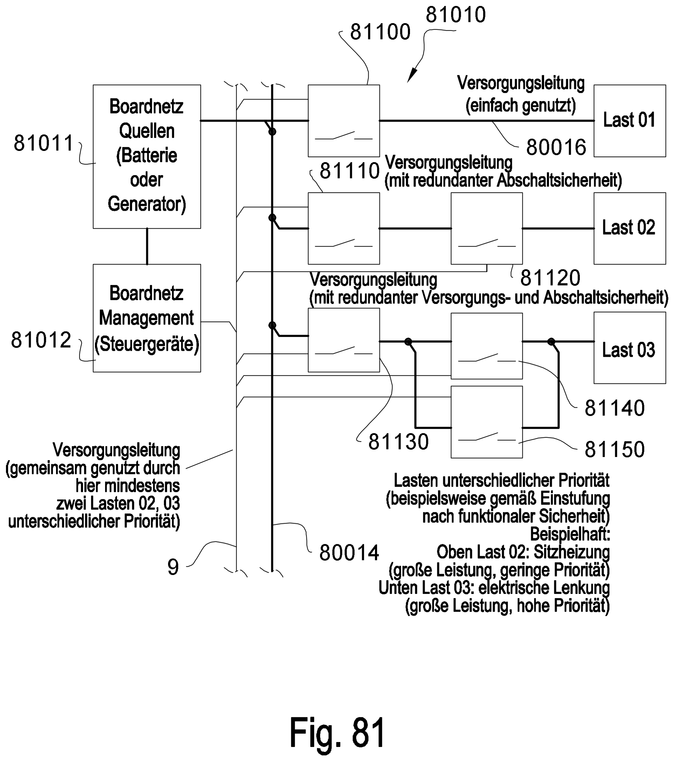

In den Fign. 80 und 81 sind zwei Beispiele für Versorgungssysteme bzw. 81010 gezeigt. Bezogen auf Figur 80 weist das Versorgungssystem ein oder mehrere Energiequellen 80011 und ein übergeordnetes Steuerungs- bzw. Rechnersystem 80012 in diesem Ausführungsbeispiel in Form eines Bordnetz-Managements auf. In diesem Ausführungsbeispiel ist die Energiequelle 80011 Ausgangspunkt von drei Versorgungsteilnetzwerken 80400, 80410 und 80420. In Figur 80 im oberen und unteren Bereich des Versorgungsnetzwerks 80010 zweigen von den beiden Versorgungsleitungen 80013 und 80014 mehrere Versorgungsleitungsabschnitte 80016 ab. Jede dieser Versorgungsleitungsabschnitte 80016 ist mit mindestens einer elektronischen Sicherung 80100 bis 80220 versehen und führt zu einem elektrischen Verbraucher 80300 bis 80380. Die elektronischen Sicherungen 80100 bis 80220 sind über ihre Datenschnittstellen mit einem von mehreren Datenkommunikationsbussen 9, 9' verbunden, die ausgehen von dem übergeordneten Steuerungs- bzw. Rechnersystem 80012. Es ist auch möglich, dass die elektronischen Sicherungen bzw. einige der elektronischen Sicherungen an zwei oder mehr verschiedenen Datenkommunikationsbussen angeschlossen sind. Es entstehen somit mehrere Versorgungsteilnetzwerke 80400, 80410 und 80420, die ein oder zwei Versorgungsleitungen mit deren Versorgungsleitungsabschnitten aufweisen und/oder deren elektrische Sicherungen an einen oder zwei der Datenkommunikationsbusse angeschlossen sind.

In Figur 80 ist bei I ein einfach genutzter Versorgungsleitungsabschnitt 80016 gezeigt. Bei II ist ein Versorgungsleitungsabschnitt mit redundanter Abschaltsicherung gezeigt, in dem die beiden elektronischen Sicherungen 80110 und 80120 in Reihe in den Versorgungsleitungsabschnitt geschaltet sind.

Bei III ist ein Versorgungsleitungsabschnitt mit redundanter Versorgungs- und Abschaltsicherheit gezeigt, in dem wiederum zwei elektronische Sicherungen 80130 und 80140 in den Versorgungsleitungsabschnitt in Serie geschaltet sind und parallel zur elektronischen Sicherung 80140 die elektronische Sicherung 80150 geschaltet ist.

Bei IV ist in Figur 80 ein Versorgungsleitungsabschnitt mit Redundanz des Anschlusses seiner elektronischen Sicherung 80160 an dem Datenkommunikationsbus 9'.

V in Figur 80 zeigt einen Versorgungsleitungsabschnitt mit redundanter Versorgungsleitung 80013 ausgehend von der Energiequelle 80011.

VI zeigt die Situation, in der die elektronische Sicherung 80190 zwischen zwei Versorgungsleitungsabschnitten angeordnet ist, um diese im Bedarfsfalle miteinander zu verbinden (die Verbraucher 80350 und 80360 sind an die Versorgung mit den redundanten Versorgungsleitungen 80013 und 80014 angeschlossen).

VII zeigt die Situation, in der die Verbraucher 80370 und 80380 an die Versorgung mit einfach redundanter Versorgungsleitung 80014 angeschlossen sind.

Figur 80 zeigt also die Variabilität des Einsatzes elektronischer Sicherungen in Versorgungsnetzwerken zur Rekonfiguration der Topologie, d.h. der Verbindung einzelner Versorgungsleitungsabschnitte untereinander und mit verschiedenen Lasten, wobei ausgehend von der Energiequelle mehrere Versorgungsleitungen zu den verschiedenen elektronischen Sicherungen und über diese zu den Verbrauchern führen. Die Versorgungsleitungen können gemeinsam genutzt werden, um verschiedene Verbraucher mit Energie zu versorgen. Verschiedene Verbraucher können aber auch durch verschiedene Versorgungsleitungen mit Energie versorgt werden. Schließlich ist es auch möglich, dass verschiedene Verbraucher über verschiedene elektronische Sicherungen abgesichert sind.

Figur 81 zeigt ein weiteres Beispiel für ein Versorgungssystem 81010 in einem Fahrzeug, bei dem wiederum eine Energiequelle 81011 über in diesem Ausführungsbeispiel eine Versorgungsleitung 81014 Verbraucher mit Energie versorgt, die über von der Versorgungsleitung 81014 abzweigende Versorgungsleitungsabschnitte 81016 angeschlossen sind. In den einzelnen Versorgungsleitungsabschnitten sind ein oder mehrere elektronische Sicherungen 81100 bis 81150 vorgesehen, die über einen gemeinsamen Datenkommunikationsbus 9 mit einem übergeordneten Steuerungs- bzw. Rechnersystem 81012 in Form eines Bordnetz-Managements steuerungstechnisch verbunden sind. Die Topologie entspricht im Wesentlichen derjenigen des oberen Versorgungsteilnetzwerk 80400 der Figur 80.

Von den elektronischen Sicherungen der Versorgungsnetzwerke der Fign. 79 bis 81 können eine oder mehrere dergestalt ausgebildet sein, dass sie mittels ihrer Steuervorrichtung mehrere Leistungsschalter, die in einer elektronischen Sicherung oder auf mehrere elektronische Sicherungen verteilt angeordnet sind, ansteuern. Ferner kann die Steuervorrichtung auch extern sämtlicher elektronischer Sicherungen angeordnet sein. Die zuvor genannten Varianten gelten entsprechend für die Betriebsparameter-Messvorrichtungen der elektronischen Sicherungen.

Merkmale des Vorschlags

Die Merkmale des Vorschlags geben verschiedene Merkmale möglicher Ausprägungen wieder. Die Merkmale weisen Untermerkmale auf. Die Merkmale sind in Merkmalsgruppen organisiert. Eine neue Merkmalsgruppe beginnt mit einer neuen Merkmalsnummer 1. Nacharbeitende können Merkmale und/oder Untermerkmale, soweit sinnvoll, beliebig miteinander kombinieren. Diese Kombinationen sind ausdrücklicher Teil der hier vorgelegten Offenlegung. Die Beanspruchung ergibt sich jeweils aus den Ansprüchen. Die Änderung der Beanspruchung im weiteren Patentierungsverfahren ist jedoch ausdrücklich vorbehalten. Die Beanspruchung ist auf funktionstüchtige Kombinationen als auf sinnhafte Kombinationen begrenzt. Sofern keine Werte und/oder Wertebereiche für Parameter angegeben sind, empfiehlt die hier vorgelegte Schrift die Durchführung eines DoE (Englisch für Design of Experiment), also die Durchführung einer Experimentreihe mit einer geeigneten statistischen Versuchsplanung.

Elektronische Sicherung für ein Fahrzeug mit Notenergieversorgung

1. Steuervorrichtung (4) einer elektronischen Sicherung (1) eines Fahrzeugs,

> wobei die Steuervorrichtung (4) monolithisch ausgeführt ist und
> wobei die Steuervorrichtung (4) einen Leistungsschalter (17) umfasst und
> wobei die Steuervorrichtung (4) einen Oszillator (30) und/oder ein Taktsystem umfasst und
> wobei die Steuervorrichtung (4) eine Spannungsversorgung (5) umfasst und
> wobei die Steuervorrichtung (4) eine extern bereit gestellte Betriebsspannung (6) umfasst und
> wobei die Steuervorrichtung (4) dazu eingerichtet ist, zumindest einen ersten Zustand des Normalbetriebs der Steuervorrichtung (4) bei Verfügbarkeit der extern bereit gestellten Betriebsspannung (6) und einen zweiten Zustand des Notbetriebs der Steuervorrichtung (4) bei Ausfall der extern bereit gestellten Betriebsspannung (6) anzunehmen, und
> wobei die Spanungsversorgung (5) dazu eingerichtet ist, im Normalbetrieb der Steuervorrichtung (4) durch Aufbereitung einer extern bereit gestellten Betriebsspannung (6) der Steuervorrichtung (4) von Vorrichtungsteilen der Steuervorrichtung (4) benötigten interne Versorgungsspannungen der Steuervorrichtung (4) und/oder von anderen Vorrichtungsteilen der elektronischen Sicherung (1) benötigten interne Versorgungsspannungen der elektronischen Sicherung (1) bereitzustellen, und

wobei die Spannungsversorgung (5) dazu eingerichtet ist, im Normalbetrieb der Steuervorrichtung (4) eine externe und/oder interne Energiereserve (8) mit der Energie einer extern bereit gestellten Betriebsspannung (6) der Steuervorrichtung (4) und/oder der extern bereit gestellten Betriebsspannung (6) der Steuervorrichtung (4) zu laden, und

wobei die Spannungsversorgung (5) dazu eingerichtet ist, im Notbetrieb der Steuervorrichtung (4) die Energie für die Bereitstellung dieser internen Versorgungsspannungen und/oder die Energie für die Bereitstellung einiger dieser internen Versorgungsspannungen statt aus der extern bereit gestellten Betriebsspannung (6) der Steuervorrichtung (4) aus der Energiereserve (8) zu entnehmen, und

wobei die Spannungsversorgung (5) dazu eingerichtet ist, den Oszillator (30) und/oder das Taktsystem in dem Notbetrieb der Steuervorrichtung (4) bei Ausfall der Betriebsspannung (6) aus der Energiereserve (8) mit elektrischer Energie zu versorgen, und

wobei die Steuervorrichtung (4) den Zustand des Leistungsschalters (17) in dem Normalbetrieb und in dem Notbetrieb der Steuervorrichtung (4) bei Ausfall der Betriebsspannung (6) einstellt.

2. Steuervorrichtung nach Merkmal 1,

wobei die Steuervorrichtung (4) einen Rechnerkern (2) umfasst und

wobei die Steuervorrichtung (4) einen nicht-flüchtigen Speicher (14) umfasst und

wobei die Spannungsversorgung (5) dazu eingerichtet ist, den Rechnerkern (2) in dem Notbetrieb der Steuervorrichtung (4) bei Ausfall der Betriebsspannung (6) aus der Energiereserve (8) mit elektrischer Energie zu versorgen, und

wobei die Spannungsversorgung (5) dazu eingerichtet ist, den nicht-flüchtigen Speicher (14) in dem Notbetrieb der Steuervorrichtung (4) bei Ausfall der Betriebsspannung (6) aus der Energiereserve (8) mit elektrischer Energie zu versorgen.

3. Steuervorrichtung nach Merkmal 2,

wobei die Steuervorrichtung (4) eine Datenbusschnittstelle (10) umfasst und

wobei die Spannungsversorgung (5) dazu eingerichtet ist, die Datenbusschnittstelle (10) in dem Notbetrieb der Steuervorrichtung (4) bei Ausfall der Betriebsspannung (6) aus der Energiereserve (8) mit elektrischer Energie zu versorgen, und

wobei der Rechnerkern (2) der Steuerungsvorrichtung (4) über die Datenbusschnittstelle (10) und über einen Datenbus (9) mit einem übergeordneten Rechnersystem (12) des Fahrzeugs verbunden ist und

wobei der Rechnerkern (2) dazu eingerichtet ist, in einem Notbetrieb der Steuervorrichtung (4) bei Ausfall der Betriebsspannung (6) dem übergeordneten Rechnersystem (12) diesen Notfallbetrieb und/oder den Ausfall der Betriebsspannung (6) der Steuervorrichtung (4) zu signalisieren.

4. Steuervorrichtung nach Merkmal 2 oder 3,

wobei die Steuervorrichtung (4) einen Watchdog-Timer (13) umfasst und

wobei die Steuervorrichtung (4) dazu eingerichtet ist, den Watchdog-Timer (13) in einem Notbetrieb der Steuervorrichtung (4) bei Ausfall der Betriebsspannung (6) aus der Energiereserve (8) mit elektrischer Energie zu versorgen.

Versorgungsnetzwerk für ein Fahrzeug mit elektronischen Sicherungen und zentralen Energieeinspeise und Entnahmepunkten

1. Versorgungsnetzwerk (200) für ein Fahrzeug zur Versorgung von Vorrichtungsteilen (210 bis 215 und 220 bis 224 und 230 bis 234) des Fahrzeugs mit elektrischer Energie aus Energiequellen (250, 251), insbesondere nach einem oder mehreren der vorhergehenden Merkmale,

- wobei das Versorgungsnetzwerk (200) einen oder mehrere erste Versorgungsleitungsabschnitte (245) aufweist, die dazu eingerichtet sind, jeweils einen oder mehrere erste Vorrichtungsteile (210 bis 213) der Vorrichtungsteile (210 bis 215 und 220 bis 224 und 230 bis 234) des Fahrzeugs mit elektrischer Energie zu versorgen, und
- wobei diese ersten Vorrichtungsteile (210 bis 213) dazu eingerichtet sind, andere, zweite Vorrichtungsteile (220 bis 224 und 230 bis 234) der Vorrichtungteile (210 bis 215 und 220 bis 224 und 230 bis 234) des Fahrzeugs über einen oder mehrere andere, zweite Leitungsabschnitte (240, 241) mit elektrischer Energie zu versorgen, und

- wobei einige oder alle Vorrichtungteile dieser Vorrichtungteile (210 bis 213 und 220 bis 224 und 230 bis 234) zumindest eine jeweilige elektronische Sicherung (214 bis 217 und 225 bis 228 und 235 bis 238), im Folgenden als elektronische Sicherung (214 bis 217 und 225 bis 228 und 235 bis 238) des Vorrichtungsteils bezeichnet, aufweisen und

- wobei die jeweiligen elektronische Sicherung (214 bis 217 und 225 bis 228 und 235 bis 238) des jeweiligen Vorrichtungteils jeweils dazu eingerichtet ist, die Energieentnahme dieses jeweiligen Vorrichtungteils aus dem Versorgungsleitungsabschnitt (245), der dazu eingerichtet ist, diesen jeweiligen Vorrichtungteil mit elektrischer Energie zu versorgen, zu unterbinden oder zuzulassen.

2. Versorgungsnetzwerk nach Merkmal 1,

wobei die Topologie des Versorgungsnetzwerks (200) eine Baumstruktur mit einem Baumausgangspunkt (270) aufweist und
wobei die Leitungsabschnitte (241 bis 245) die Äste des Versorgungsnetzwerks (200) darstellen und
wobei sich am Baumausgangspunkt (270) eine Energiequelle (250) und/oder ein zentraler Energieeinspeisungspunkt befindet und
wobei an Enden von Leitungsabschnitten (240 bis 245) sich Vorrichtungteile (210 bis 213 bzw. 220 bis 224 oder 230 bis 234) befinden, die die elektronische Sicherung (214 bis 217 und 225 bis 228 und 235 bis 238) aufweisen.

3. Versorgungsnetzwerk nach einem der Merkmale 1 oder 2,
wobei in zumindest einem sich ergebenden Energieversorgungspfad (250, 255, 245, 216,212,241,235,230) mehrere elektronisch steuerbare Sicherungen (z.B. 255, 216, 235 etc.) seriell hintereinandergeschaltet sind.

4. Versorgungsnetzwerk (200) nach Merkmal 3,

wobei mindestens zwei Leitungsabschnitte (241, 243) dazu eingerichtet sind, jeweils zumindest jeweils einen Vorrichtungteil (230, 232) des Fahrzeugs zumindest zeitweise mit unterschiedlicher Priorisierung mit elektrischer Energie zu versorgen, und
wobei ein übergeordnetes Rechnersystem (12) des Fahrzeugs dazu eingerichtet ist, insbesondere über einen Datenbus (9), mittels elektronischer Sicherungen (255, 214 bis 217 und 225 bis 228 und 235 bis 238) in dem Versorgungsnetzwerk (200) je nach Betriebszustand des Fahrzeugs und/oder aufgrund von Umwelteinflüssen und/oder aufgrund des Zustands der Umgebung des Fahrzeugs und/oder aufgrund der Fahrzeuginsassen und/oder aufgrund von Fahrzeugparametern, wie Geschwindigkeit oder Beschleunigung oder Ort, einzelne oder mehrere Vorrichtungteile der Vorrichtungteile (210 bis 213 und 220 bis 224 und 230 bis 234) des Versorgungsnetzwerks (200) von der Energieversorgung (250) zu trennen.

5. Versorgungsnetzwerk (200) nach Merkmal 4,

wobei das Versorgungsnetzwerk (200) dazu eingerichtet ist, mindestens einen ersten Vorrichtungteil (212) über einen ersten Versorgungsleitungsabschnitt (245) mit elektrischer Energie mit höherer Priorität zu versorgen, und
wobei das Versorgungsnetzwerk (200) dazu eingerichtet ist, mindestens einen zweiten Vorrichtungteil (231) über einen zweiten Versorgungsleitungsabschnitt (241) mit elektrischer Energie mit niedrigerer Priorität zu versorgen.

6. Versorgungsnetzwerk (200) nach Merkmal 5,

wobei das Fahrzeug ein übergeordnetes Rechnersystem (12) umfasst und
wobei das übergeordnete Rechnersystem (12) des Fahrzeugs dazu eingerichtet ist, über den Datenbus (9), mittels der elektronischen Sicherung (236) des Vorrichtungsteils (231) mit der niedrigeren Priorität oder mittels einer anderen Sicherung in dem Versorgungsnetzwerk (200) den Vorrichtungsteil (231) mit der niedrigeren Priorität innerhalb des Versorgungsnetzwerks (200) von der Energieversorgung (250) zu trennen, wenn anderenfalls die Versorgungssicherheit anderer Vorrichtungsteile des Versorgungsnetzwerks (200) mit höherer Priorität betreffend die Versorgung mit elektrischer Energie gefährdet wäre.

7. Versorgungsnetzwerk (200) nach einem der Merkmale 1 bis 6,

wobei ein oder mehrere, bevorzugt alle Vorrichtungteile (250, 210 bis 213 und 220 bis 224 und 230 bis 234) des Fahrzeugs, die von einem Versorgungsleitungsabschnitt (245, 240. 241) mit Energie versorgt werden und/oder elektrische Energie in einen Versorgungsleitungsabschnitt (245, 240. 241) einspeisen, dazu eingerichtet sind, elektrische Parameter des Stromflusses in dem betreffenden Versorgungsleitungsabschnitt der Versorgungsleitungsabschnitte (245, 240. 241) zu erfassen und/oder

elektrische Parameter des Potenzials des Versorgungsleitungsabschnitts der Versorgungsleitungsabschnitte (245, 240. 241) auf der Zuleitungsseite des Vorrichtungsteils gegen ein Bezugspotenzial (280) zu erfassen.

8. Versorgungsnetzwerk (200) nach Merkmal 7,
wobei die Vorrichtungsteile (250, 210 bis 213 und 220 bis 224 und 230 bis 234) des Fahrzeugs, die von dem betreffenden Versorgungsleitungsabschnitt (245, 240. 241) mit Energie versorgt werden und/oder elektrische Energie in den betreffenden Versorgungsleitungsabschnitt (245, 240. 241) einspeisen, dazu eingerichtet sind, die erfassten Parameter und/oder die aus diesen erfassten Parametern abgeleiteten Werte an Steuervorrichtungen (281 bis 292) anderer Vorrichtungsteile des Fahrzeugs und/oder an Steuervorrichtungen (281 bis 292) anderer elektronischen Sicherungen des Versorgungsnetzwerks (200) und/oder an ein übergeordnetes Rechnersystem (12) über einen Datenbus (9) zu übermitteln.

9. Versorgungsnetzwerk (200) nach Merkmal 8,
wobei der Datenbus (9) einen Sicherungsdatenbus (9) oder einen anderen Datenbus, beispielsweise einen Lin-Datenbus oder einen DSI3-Datenbus oder einen PSI5-Datenbus oder einen CAN-Datenbus oder einen CAN-FD-Datenbus oder einen Ethernet-Datenbus oder einen Flexray-Datenbus oder einen LVDS-Datenbus oder eine sonst wie drahtgebundene oder drahtlose Datenkommunikationsvorrichtung, beispielsweise eine Bluetooth- oder WLAN-Datenkommunikationsvorrichtung, oder dergleichen umfasst oder dergleichen ist.

10. Versorgungsnetzwerk (200) nach einem der Merkmale 1 bis 9,

wobei eine Energiequelle (250) dazu eingerichtet ist, einen Vorrichtungsteil (213) der Vorrichtungsteile (250, 210 bis 213 und 220 bis 224 und 230 bis 234) des Fahrzeugs), im Folgenden als energieversorgender Vorrichtungsteil (213) bezeichnet, über einen Versorgungsleitungsabschnitt (245) mit elektrischer Energie zu versorgen, und wobei der energieversorgende Vorrichtungsteil (213) dazu eingerichtet ist, über einen weiteren Versorgungsleitungsabschnitt (243) einen weiteren Vorrichtungsteil (232) des Fahrzeugs mit elektrischer Energie zu versorgen.

11. Versorgungsnetzwerk (200) nach einem oder mehreren der Merkmale 1 bis 10,
wobei ein erster Versorgungsleitungsabschnitt (241) des Versorgungsnetzwerks (200) und ein zweiter Versorgungsleitungsabschnitt (243) des Versorgungsnetzwerks (200) untereinander oder gegenüber einem Bezugspotenzial (201) zumindest zeitweise eine Spannung von mehr als 40V aufweisen.

12. Versorgungsnetzwerk (200) nach einem oder mehreren der Merkmale 1 bis 11,

wobei das Versorgungsnetzwerk (200) ein erstes Versorgungsteilnetzwerk aufweist, das ein Versorgungsnetzwerk nach einem oder mehreren der Merkmale 1 bis 11 ist, und
wobei das Versorgungsnetzwerk (200) ein zweites Versorgungsteilnetzwerk aufweist, das ein Versorgungsnetzwerk nach einem oder mehreren der Merkmale 1 bis 11 ist, und
wobei das erste Versorgungsteilnetzwerk von dem zweiten Versorgungsteilnetzwerk verschieden ist und wobei die Potenzialdifferenz zwischen dem Potenzial der Versorgungsleitungsabschnitte des ersten Versorgungsteilnetzwerks und einem Bezugspotenzial zumindest zeitweise bei einer Spannung von 0V bis 1500V, typischerweise 800V, liegt und
wobei die Potenzialdifferenz zwischen dem Potenzial der Versorgungsleitungsabschnitte des zweiten Versorgungsteilnetzwerks und einem Bezugspotenzialbei zumindest zeitweise bei einer Spannung von 0V bis 50V, typischerweise 48V, also weniger als 50V, liegt.

13. Vorrichtungsteil für ein Fahrzeug mit einem Versorgungsnetzwerk nach einem der Merkmale 1 bis 12,
wobei der jeweilige Vorrichtungsteil (212) eine Steckmöglichkeit (262) für die jeweilige elektronische Sicherung (216) aufweist.

Versorgungsnetzwerk mit elektronischen Sicherungen mit Teilnetzabwurfmöglichkeit

1. Versorgungsnetzwerk (200) für ein Fahrzeug, insbesondere nach einem oder mehreren der vorhergehenden Merkmale,

wobei das Versorgungsnetzwerk (200) Versorgungsleitungsabschnitte aufweist und

wobei das Versorgungsnetzwerk (200) energieverbrauchende Vorrichtungsteile (250, 210 bis 213 und 220 bis 224 und 230 bis 234) des Versorgungsnetzwerks (200) umfasst und

wobei das Versorgungsnetzwerk (200) energieliefernde Vorrichtungsteile (250, 251) des Fahrzeugs umfasst, die dazu eingerichtet sind, Energie in das Versorgungsnetzwerk (200) einzuspeisen, und

wobei energieverbrauchende Vorrichtungsteile (250, 210 bis 213 und 220 bis 224 und 230 bis 234) des Fahrzeugs dazu eingerichtet sind, über zumindest einen Versorgungsleitungsabschnitt (240 bis 245) mit elektrischer Energie aus dem Versorgungsnetzwerk versorgt zu werden, und

wobei energieverbrauchende Vorrichtungsteile (210 bis 213) dazu eingerichtet sind, über einen weiteren Leitungsabschnitt (240, 241) einen weiteren Vorrichtungsteil (220 bis 223 und 230 bis 233) des Fahrzeugs mit elektrischer Energie versorgen zu können, und

wobei die energieverbrauchenden Vorrichtungsteile (210 bis 213 und 220 bis 223 und 230 bis 233) eine elektronische Sicherung (280 bis 291) aufweisen und

wobei die jeweilige elektronische Sicherung (280 bis 291) eines jeweiligen energieverbrauchenden Vorrichtungsteils (210 bis 213 und 220 bis 223 und 230 bis 233) jeweils dazu eingerichtet ist, die Versorgung dieses jeweiligen energieverbrauchenden Vorrichtungsteils (210 bis 213 und 220 bis 223 und 230 bis 233) und der von diesem jeweiligen energieverbrauchenden Vorrichtungsteil (210 bis 213 und 220 bis 223 und 230 bis 233) mit elektrischer Energie versorgten ggf. vorhandenen weiteren energieverbrauchenden Vorrichtungsteile (220 bis 223 und 230 bis 233) unterbinden zu können.

2. **Versorgungsnetzwerk** (200) eines Fahrzeugs nach Merkmal 1,

wobei energieliefernde Vorrichtungsteile (250 bis 251) eine jeweilige elektronische Sicherung (292 bis 293) aufweisen und

wobei die jeweilige elektronische Sicherung (280 bis 291) eines jeweiligen energieliefernden Vorrichtungsteils (250 bis 251) dazu eingerichtet ist, die Einspeisung elektrischer Energie durch den jeweiligen energieliefernden Vorrichtungsteil (250 bis 251) in das Versorgungsnetzwerk (200) und oder einen jeweiligen Versorgungsleitungsabschnitt (245) unterbinden zu können, und

wobei energieverbrauchende Vorrichtungsteile (210 bis 213), die dazu eingerichtet sind, andere energieverbrauchende Vorrichtungsteile (220 bis 223 und 230 bis 233) mit elektrischer Energie über Teilversorgungsnetze des Versorgungsnetzes (200) mit elektrischer Energie zu versorgen, über eine jeweilige weitere elektronische Sicherung verfügen, um die von ihnen versorgten Teilversorgungsnetze des Versorgungsnetzes (200) ggf. mittels eines jeweiligen Leistungsschalters (17) dieser jeweiligen weitere elektronische Sicherung abwerfen zu können.

Sicherungsbox mit steckbaren elektronischen Sicherungen

1. Sicherungsbox (400) für ein Versorgungsnetzwerk (200) eines Fahrzeugs, insbesondere nach einem oder mehreren der vorhergehenden Merkmale,

wobei die Sicherungsbox (400) elektronische Sicherungen (405) und/oder Steckplätze (410) für elektronische Sicherungen (405) umfasst und

wobei die Sicherungsbox Schmelzsicherungen (415) und/oder Steckplätze (420) für Schmelzsicherungen (415) umfasst und

wobei zumindest eine elektronische Sicherung (405) der elektronischen Sicherungen einen ersten Anschluss (18) und einen zweiten Anschluss (19) aufweist und

wobei diese mindestens eine elektronische Sicherung (405) dazu eingerichtet ist, das Verhalten einer Schmelzsicherung (415) zu emulieren, und

wobei diese elektronische Sicherung (405) dazu eingerichtet ist, den Stromwert des Betrags des diese elektronische Sicherung (405) vom ersten Anschluss (18) zum zweiten Anschluss (19) oder umgekehrt durchfließenden elektrischen Stromes (29) zu erfassen, und

wobei diese elektronische Sicherung (405) dazu eingerichtet ist, mittels eines Polynoms mindestens zweiten Grades einen Zwischenwert aus diesem erfassten Stromwert zu ermitteln und zu einem integrierten Zwischenwert zeitlich zu integrieren, und

wobei die elektronische Sicherung (405) dazu eingerichtet ist, den Stromfluss zwischen dem ersten Anschluss (18) und dem zweiten Anschluss (19) zu unterbinden, wenn der integrierte Zwischenwert einen Maximalwert überschreitet, und

wobei die elektronische Sicherung (405) in einem Sicherungskörper (425) mit Steckverbindern angeordnet ist, der in einem der Steckplätze (410) für elektronische Sicherungen (405) mechanisch passt.

2. Sicherungsbox (400) nach Merkmal 1,

wobei die Sicherungsbox (400) einen Datenbus (9) umfasst.

3. Sicherungsbox (400) nach Merkmal 2,

wobei ein Steckplatz (410) für eine elektronische Sicherung (405) einen ersten Kontakt (430) des Steckplatzes (410) aufweist und

wobei dieser Steckplatz (410) für eine elektronische Sicherung (405) einen zweiten Kontakt (445) des Steckplatzes (410) aufweist und

wobei der erste Kontakt (430) des Steckplatzes (410) dazu eingerichtet ist, eine elektrische Verbindung zwischen diesem ersten Kontakt (410) des Steckplatzes (410) und einem ersten Kontakt (450) eines Steckverbinders eines Sicherungskörpers (425) herzustellen, um den ersten Anschluss (18, 450) der Sicherung (405) des Sicherungskörpers (425) mit dem ersten Kontakt (430) des Steckplatzes (410) elektrisch zu verbinden, und

wobei der zweite Kontakt (445) des Steckplatzes (410) dazu eingerichtet ist, eine elektrische Verbindung zwischen diesem zweiten Kontakt (445) des Steckplatzes (410) und einem zweiten Kontakt (470) des Steckverbinders (410) des Sicherungskörpers (425) herzustellen, um den zweiten Anschluss (19, 470) der Sicherung (405) des Sicherungskörpers (425) mit dem zweiten Kontakt (445) des Steckplatzes (405) elektrisch zu verbinden.

4. Sicherungsbox (400) nach Merkmal 3,

wobei ein Steckplatz (410) für eine elektronische Sicherung (405) einen dritten Kontakt (440) des Steckplatzes (410) aufweist und

wobei der dritte Kontakt (440) des Steckplatzes (405) dazu eingerichtet ist, eine elektrische Verbindung zwischen diesem dritten Kontakt (440) des Steckplatzes (405) und einem dritten Kontakt (465) des Steckverbinders (410) des Sicherungskörpers (425) herzustellen, um eine Datenleitung (9) einer Datenschnittstelle (10) einer Steuerungsschaltung (4) der elektronischen Sicherung (405) des Sicherungskörpers (425) mit dem dritten Kontakt (440) des Steckplatzes (405) elektrisch zu verbinden.

5. Sicherungsbox (400) nach Merkmal 3 und/oder 4,

wobei ein Steckplatz (410) für eine elektronische Sicherung (405) einen vierten Kontakt (435) des Steckplatzes (410) aufweist und

wobei der vierte Kontakt (435) des Steckplatzes (410) dazu eingerichtet ist, eine elektrische Verbindung zwischen diesem vierten Kontakt (435) des Steckplatzes (410) und einem vierten Kontakt (455) des Steckverbinders des Sicherungskörpers (425) herzustellen, um eine Energieversorgung der Steuervorrichtung (4) der elektronischen Sicherung (405) mit dem vierten Kontakt (455) des Steckplatzes (410) elektrisch zu verbinden.

6. Sicherungskörper (425) einer elektronischen Sicherung (405) für eine Sicherungsbox (400) nach einem oder mehreren der Merkmale 1 bis 5,

wobei der Steckverbinder des Sicherungskörpers (425) einen ersten Kontakt (450) für den ersten Anschluss (18) der elektronischen Sicherung (405) aufweist und

wobei der Steckverbinder des Sicherungskörpers (425) einen zweiten Kontakt (470) für den zweiten Anschluss (19) der elektronischen Sicherung (405) aufweist und

wobei der Steckverbinder mechanisch in zumindest einen der Steckplätze (410) für elektronische Sicherungen (405) der Sicherungsbox (400) passt.

7. Sicherungskörper (425) nach Merkmal 6,

wobei der Steckverbinder des Sicherungskörpers (425) einen dritten Kontakt (465) für einen Sicherungsdatenbus (9) aufweist und

wobei der dritte Kontakt (465) elektrisch mit einer Datenleitung (9) einer Datenschnittstelle (10) einer Steuervorrichtung (4) der elektronischen Sicherung (405) des Sicherungskörpers (425) elektrisch verbunden ist.

8. Sicherungskörper (425) nach Merkmal 6 oder 7,
wobei der Steckverbinder des Sicherungskörpers (425) zumindest einen vierten Kontakt (455) für eine Spannungsversorgung (6) der Steuervorrichtung (4) der elektronischen Sicherung (405) aufweist.

9. Schmelzsicherung (415) für eine Sicherungsbox (400) nach einem oder mehreren der Merkmale 1 bis 5,

wobei die Schmelzsicherung (415) einen Sicherungskörper (425) aufweist und
wobei der Sicherungskörper (425) einen Steckverbinder (410) aufweist und
wobei der Steckverbinder (410) des Sicherungskörpers (425) einen ersten Kontakt (455) für den ersten Anschluss (18) der Schmelzsicherung (415) aufweist und
wobei der Steckverbinder (410) des Sicherungskörpers (425) einen zweiten Kontakt (470) für den zweiten Anschluss (19) der Schmelzsicherung (415) aufweist und
wobei der Steckverbinder der Schmelzsicherung (415) dazu eingerichtet ist, mechanisch in zumindest einen der Steckplätze (410) für elektronische Sicherungen (405) zu passen.

10. Schmelzsicherung (415) nach Merkmal 9,
wobei der Steckverbinder der Schmelzsicherung (415) dazu eingerichtet ist, mechanisch in zumindest einen der Steckplätze (420) für Schmelzsicherungen (415) zu passen.

Elektronische Sicherung mit Überwachung des Leistungsschalters

1. Elektronische Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.

2. Elektronischen Sicherung (1), insbesondere nach Merkmal 1,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) einen Hilfsleistungsschalter (23) aufweist und
wobei die elektronische Sicherung (1) einen Shunt-Widerstand (24) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der Hilfsleistungsschalter (23) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei der erste Anschluss (26) des Hilfsleistungsschalters (23) mit dem ersten Anschluss (18) der Sicherung (1) elektrisch verbunden ist und

wobei der Steueranschluss (27) des Hilfsleistungsschalters (23) mit der Steuervorrichtung (4) elektrisch verbunden ist und

wobei der zweite Anschluss (28) des Hilfsleistungsschalters (23) mit einem ersten Anschluss (25) des Shunt-Widerstands (24) verbunden ist und

wobei der zweite Anschluss des Shunt-Widerstands mit dem zweiten Anschluss (19) der Sicherung (1) elektrisch verbunden ist und

wobei die Steuervorrichtung (4) der elektronischen Sicherung (1) dazu eingerichtet ist, die Spannung zwischen dem ersten Anschluss (25) des Shunt-Widerstands (24) und dem zweiten Anschluss (21) des Shunt-Widerstands (24) und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.

3. Elektronische Sicherung (1), insbesondere nach Merkmal 1 oder 2,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die elektronische Sicherung (1) eine elektronische Teststromquelle (505) aufweist und

wobei die elektronische Teststromquelle (505) dazu eingerichtet ist, einen zusätzlichen Teststrom (515) in den Leistungsschalter (17) zwischen dem ersten Anschluss (26) des Leistungsschalters (17) und dem zweiten Anschluss (28) des Leistungsschalters (17) und/oder in den ersten Anschluss (26) des Leistungsschalters (17) in Abhängigkeit von einem ersten Steuersignal (510) der Steuervorrichtung (4) einspeisen zu können, und

wobei die Steuervorrichtung (4) dazu eingerichtet ist, das Steuersignal (510) mit einem ersten Modulationssignal ({505}) und damit den zusätzlichen Teststrom (515) zu modulieren, und

wobei die Steuervorrichtung (4) dazu eingerichtet ist, den zeitlichen Werteverlauf des elektrischen Stroms (29) durch den Leistungsschalter (17) zu erfassen oder zu ermitteln, und

wobei die Steuervorrichtung (4) dazu eingerichtet ist, zu überprüfen, ob der zeitliche Werteverlauf des elektrischen Stromes (29) Signalanteile umfasst, deren Modulation mit der Modulation des Modulationssignals ({505}) korreliert.

4. Elektronische Sicherung (1) nach Merkmal 3,

wobei die Sicherung (1) einen Synchrondemodulator (525) umfasst und

wobei der Synchrondemodulator (525) dazu eingerichtet ist, die Korrelation zwischen dem Werteverlauf des elektrischen Stromes (29) einerseits und dem Modulationssignal ({505}) andererseits zu ermitteln.

5. Elektronische Sicherung (1) nach Merkmal 4,

wobei der der Synchrondemodulator (525) dazu eingerichtet ist, das Modulationssignal ({505}) oder ein daraus abgeleitetes Signal oder ein Signal, das mit dem Modulationssignal ({505}) in einem festen zeitlichen Zusammenhang steht, einerseits mit dem zeitlichen Werteverlauf des elektrischen Stroms (29) oder einem daraus abgeleiteten Signal andererseits zu multiplizieren, und

wobei der Synchrondemodulator (525) dazu eingerichtet ist, das aus der Multiplikation resultierende Signal anschließend zu einem Korrelationssignal ($C_{29m}(t)$) zu filtern, vorzugsweise tiefpasszufiltern.

6. Elektronische Sicherung (1) nach Merkmal 4 oder 5,
wobei der Synchrondemodulator (525) bzw. die Steuervorrichtung (4) ein auf das Modulationssignal ({505}) optimiertes Matched-Filter und/oder ein Optimalfilter und/oder ein Kalman-Filter oder ein anderes Schätzfilter umfasst, das dazu eingerichtet ist, den zeitlichen Werteverlauf des elektrischen Stroms (29) zu einem Korrelationssignal ($C_{29m}(t)$) zu wandeln.

Elektronische Sicherung mit Potenzialüberwachung des Leistungsschalters

1. Elektronische Sicherung (1) eines Fahrzeugs, insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und
> wobei der Leistungsschalter (17) einen ersten Anschluss (26), einen Steueranschluss (27) und einen zweiten Anschluss (28) aufweist und
> wobei der erste Anschluss (26) des Leistungsschalters (17) mit dem ersten Anschluss (18) der Sicherung (1) elektrisch verbunden ist und
> wobei der zweite Anschluss (28) des Leistungsschalters (17) mit dem zweiten Anschluss (19) der Sicherung (1) elektrisch verbunden ist und
> wobei der Steueranschluss (27) des Leistungsschalters (17) mit der Steuervorrichtung (4) elektrisch verbunden ist und
> wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.

2. Elektronische Sicherung (1) nach Merkmal 1,

> wobei die Steuervorrichtung (4) dazu eingerichtet ist die elektrische Spannung zwischen dem ersten Anschluss (18) der Sicherung (1) und dem zweiten Anschluss (19) der Sicherung (1) zu erfassen, und
> wobei die Steuervorrichtung (4) den Leistungsschalter (17) nicht-leitend schaltet, wenn das Vorzeichen der elektrischen Spannung zwischen dem ersten Anschluss (18) der Sicherung (1) und dem zweiten Anschluss (19) der Sicherung (1) nicht einem Vorgabewert entspricht.

3. Elektronische Sicherung (1) nach einem der Merkmale 1 oder 2,

> wobei die Steuervorrichtung (4) dazu eingerichtet ist, die elektrische Spannung zwischen dem ersten Anschluss (18) der Sicherung (1) und dem zweiten Anschluss (19) der Sicherung (1) zu erfassen, und
> wobei die Steuervorrichtung (4) den Leistungsschalter (17) nicht-leitend schaltet, wenn die elektrische Spannung zwischen dem ersten Anschluss (18) der Sicherung (1) und dem zweiten Anschluss (19) der Sicherung (1) einen ersten Vorgabewert unterschreitet, und/oder
> wobei die Steuervorrichtung (4) den Leistungsschalter (17) nicht-leitend schaltet, wenn die elektrische Spannung zwischen dem ersten Anschluss (18) der Sicherung (1) und dem zweiten Anschluss (19) der Sicherung (1) einen zweiten Vorgabewert überschreitet.

4. Elektronische Sicherung (1) nach einem der Merkmale 1 bis 3,

> wobei die Steuervorrichtung (4) dazu eingerichtet ist, die elektrische Spannung zwischen dem ersten Anschluss (26) des Leistungsschalters (17) der Sicherung (1) und dem zweiten Anschluss (28) des Leistungsschalters (17) der Sicherung (1) zu erfassen, und
> wobei die Steuervorrichtung (4) den Leistungsschalter (17) nicht-leitend schaltet, wenn das Vorzeichen der elektrischen Spannung zwischen dem ersten Anschluss (26) des Leistungsschalters (17) der Sicherung (1) und dem zweiten Anschluss (28) des Leistungsschalters (17) der Sicherung (1) nicht einem Vorgabewert entspricht.

5. Elektronische Sicherung (1) nach einem der Merkmale 1 bis 4,

wobei die Steuervorrichtung (4) dazu eingerichtet ist, die elektrische Spannung zwischen dem ersten Anschluss (26) des Leistungsschalters (17) der Sicherung (1) und dem zweiten Anschluss (28) des Leistungsschalters (17) der Sicherung (1) zu erfassen, und
wobei die Steuervorrichtung (4) den Leistungsschalter (17) nicht-leitend schaltet, wenn die elektrische Spannung zwischen dem ersten Anschluss (26) des Leistungsschalters (17) der Sicherung (1) und dem zweiten Anschluss (28) des Leistungsschalters (17) der Sicherung (1) einen dritten Vorgabewert unterschreitet, und/oder
wobei die Steuervorrichtung (4) den Leistungsschalter (17) nicht-leitend schaltet, wenn die elektrische Spannung zwischen dem ersten Anschluss (26) des Leistungsschalters (17) der Sicherung (1) und dem zweiten Anschluss (28) des Leistungsschalters (17) der Sicherung (1) einen vierten Vorgabewert überschreitet.

6. Elektronische Sicherung (1) nach einem der Merkmale 1 bis 5,

wobei die elektronische Sicherung (1) einen Bezugspotenzialanschluss (201) aufweist und
wobei die Steuervorrichtung (4) dazu eingerichtet ist, die elektrische Spannung zwischen dem ersten Anschluss (18) der Sicherung (1) und dem Bezugspotenzialanschluss (201) der Sicherung (1) zu erfassen und den Leistungsschalter (17) nicht-leitend zu schalten, wenn die elektrische Spannung zwischen dem ersten Anschluss (18) der Sicherung (1) und dem Bezugspotenzialanschluss (201) der Sicherung (1) einen fünften Vorgabewert unterschreitet und/oder wenn die elektrische Spannung zwischen dem ersten Anschluss (18) der Sicherung (1) und dem Bezugspotenzialanschluss (201) der Sicherung (1) einen sechsten Vorgabewert überschreitet, und/oder
wobei die Steuervorrichtung (4) dazu eingerichtet ist, die elektrische Spannung zwischen dem zweiten Anschluss (19) der Sicherung (1) und dem Bezugspotenzialanschluss (201) der Sicherung (1) zu erfassen und den Leistungsschalter (17) nicht-leitend zu schalten, wenn die elektrische Spannung zwischen dem zweiten Anschluss (19) der Sicherung (1) und dem Bezugspotenzialanschluss (201) der Sicherung (1) einen siebten Vorgabewert unterschreitet und/oder wenn die elektrische Spannung zwischen dem zweiten Anschluss (19) der Sicherung (1) und dem Bezugspotenzialanschluss (201) der Sicherung (1) einen achten Vorgabewert überschreitet.

7. Elektronische Sicherung (1) nach einem der Merkmale 1 bis 6,

wobei die elektronische Sicherung (1) einen Bezugspotenzialanschluss (201) aufweist und
wobei die Steuervorrichtung (4) dazu eingerichtet ist, die elektrische Spannung zwischen dem ersten Anschluss (26) des Leistungsschalters (17) der Sicherung (1) und dem Bezugspotenzialanschluss (201) der Sicherung (1) zu erfassen und den Leistungsschalter (17) nicht-leitend zu schalten, wenn die elektrische Spannung zwischen dem ersten Anschluss (26) des Leistungsschalters (17) der Sicherung (1) und dem Bezugspotenzialanschluss (201) der Sicherung (1) einen neunten Vorgabewert unterschreitet und/oder wenn die elektrische Spannung zwischen dem ersten Anschluss (26) des Leistungsschalters (17) der Sicherung (1) und dem Bezugspotenzialanschluss (201) der Sicherung (1) einen zehnten Vorgabewert überschreitet, und/oder
wobei die Steuervorrichtung (4) dazu eingerichtet ist, die elektrische Spannung zwischen dem zweiten Anschluss (28) des Leistungsschalters (17) der Sicherung (1) und dem Bezugspotenzialanschluss (201) der Sicherung (1) zu erfassen und den Leistungsschalter (17) nicht-leitend zu schalten, wenn die elektrische Spannung zwischen dem zweiten Anschluss (19) der Sicherung (1) und dem Bezugspotenzialanschluss (201) der Sicherung (1) einen elften Vorgabewert unterschreitet und/oder wenn die elektrische Spannung zwischen dem zweiten Anschluss (28) des Leistungsschalters (17) der Sicherung (1) und dem Bezugspotenzialanschluss (201) der Sicherung (1) einen zwölften Vorgabewert überschreitet.

Optisch gesteuerte elektronische Sicherung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln und

wobei der Leistungsschalter (17) und die Steuervorrichtung (4) in einem Gehäuse (535) untergebracht sind und wobei das Gehäuse (535) ein optisches Fenster (545) aufweist.

2. Elektronische Sicherung (1) nach Merkmal 1,
wobei die Steuervorrichtung (4) eine optische Datenschnittstelle (550) aufweist.

3. Elektronische Sicherung (1) nach Merkmal 2,
wobei das optische Fenster (545) eine Teilvorrichtung einer oder mehrerer optischer Datenschnittstellen (550) der Steuerungsvorrichtung (4) der betreffenden elektronischen Sicherung (1) ist.

4. Elektronische Sicherung (1) nach Merkmal 3,

wobei das optische Fenster (545) dazu eingerichtet ist, den Zutritt und/oder Austritt elektromagnetischer Strahlung für den Transport von Daten zu der Steuervorrichtung (4) zu ermöglichen, und

wobei die der Steuervorrichtung (4) sich innerhalb des Gehäuses (535) befindet und

wobei die optische Datenschnittstelle (550) der Steuervorrichtung (4) dazu eingerichtet ist, durch das optische Fenster (545) mit einer optischen Schnittstelle (555) einer anderen Vorrichtung (12), beispielsweise eines übergeordneten Rechnersystems (12), außerhalb des Gehäuses (535) mittels der elektromagnetischen Strahlung zu kommunizieren.

5. Elektronische Sicherung (1) nach Merkmal 4,
wobei es sich bei der elektromagnetischen Strahlung für den Transport von Daten um LaserStrahlung eines Lasers (560) oder um Strahlung einer LED (560) handelt.

6. Elektronische Sicherung (1) nach einem der Merkmale 1 bis 5,
wobei die elektronische Sicherung (1) einen Laser oder eine LED (560), insbesondere als Sender von Daten der optischen Datenschnittstelle (550), umfasst.

7. Elektronische Sicherung (1) nach Merkmal 6,
wobei die elektronische Sicherung (1) als LED eine siliziumbasierende LED (560) aufweist.

8. Elektronische Sicherung (1) nach Merkmal 7,
wobei die siliziumbasierende LED (560) eine Silizium-Lawinen-LED (560), insbesondere eine als LED betriebene SPAD-Diode (560), ist.

9. Elektronische Sicherung (1) nach Merkmal 7 oder 8,
wobei die elektronische Sicherung (1) eine Ansteuerungsvorrichtung (565) umfasst und wobei die Ansteuerungsvorrichtung (565) aus der Betriebsspannung der elektronischen Sicherung (1) mittels eines Spannungsumsetzers einer Spannungsversorgung (5) eine Betriebsspannung für die siliziumbasierende LED (560) erzeugt.

10. Elektronische Sicherung (1) nach einem der Merkmale 7 bis 9,
wobei die elektronische Sicherung (1) dazu eingerichtet ist, die siliziumbasierende LED (560) zumindest zeitweise als Empfänger zu betreiben.

11. Elektronische Sicherung (1) nach Merkmal 10,

wobei der Rechnerkern (2) der Steuervorrichtung (4) der elektronischen Sicherung (4) dazu eingerichtet ist, mittels eines Trennschalters der Steuervorrichtung der elektronischen Sicherung die siliziumbasierende LED (560) von der elektrischen Versorgung des Spannungsumsetzers der Spannungsversorgung (5) abzutrennen, und

wobei der Rechnerkern (2) dazu eingerichtet ist, mittels eines Analog-zu-Digital-Wandlers (570) der Steuervorichtun (4) der elektronischen Sicherung (1) das Spannungssignal (575) und/oder den Fotostrom der siliziumbasierenden LED (560) zu erfassen.

12. Elektronische Sicherung (1) nach einem der Merkmale 1 bis 11,
wobei der Rechnerkern (2) dazu eingerichtet ist, mittels eines Analog-zu-Digital-Wandlers (570) der elektronischen Sicherung (1) das Spannungssignal (575) und/oder den Fotostrom eines Fotodetektors (560) zu erfassen.
13. Elektronische Sicherung (1) nach Merkmal 11 oder 12,
wobei der Rechnerkern (2) und/oder die Steuervorrichtung (4) dazu eingerichtet sind, den erfassten Wert als Eingangsdatensignal einer optischen Datenschnittstelle (550) zu verwenden.
14. Elektronische Sicherung (1) nach einem der Merkmale 1 bis 13,
wobei die die elektronische Sicherung (1) einen Fotodetektor, beispielsweise eine Fotodiode (560), und eine Auswerteelektronik des Fotodetektors (560) umfasst.
15. Elektronische Sicherung (1) nach einem oder mehreren der Merkmale 4 bis 14,
wobei die Sicherung (1) dazu eingerichtet ist, mittels eines Lichtwellenleiters (580) mit einer oder mehreren anderen elektronischen Sicherungen (1, 214 bis 217, 225 bis 223, 230 bis 235, 225 bis 256) über die jeweilige optische Datenschnittstelle (550, 551) der Steuervorrichtungen (4) dieser elektronischen Sicherungen (1, 214 bis 217, 225 bis 223, 230 bis 235, 225 bis 256) verbunden zu werden.
16. Elektronische Sicherung (1) nach Merkmal 15,
wobei die elektronische Sicherung (1) dazu eingerichtet ist, über ihre optische Schnittstelle (550) und einen Lichtwellenleiter (580) mit einer optischen Schnittstelle (555) eines übergeordneten Steuergeräts (12), beispielsweise eines übergeordneten Rechnersystems (12), und ggf. mit einer oder mehreren weiteren elektronischen Sicherungen (214 bis 217, 225 bis 223, 230 bis 235, 225 bis 256) verbunden zu werden.

Elektronische Sicherung mit Datenanbindung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist.

Elektronische Sicherung mit Temperaturüberwachung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln und

wobei die Steuervorrichtung der elektronischen Sicherung eine oder mehrere Temperatursensorauswertevorrichtungen (585) umfasst und

wobei die elektronische Sicherung einen Temperatursensor (586) umfasst und

wobei die Steuervorrichtung (4) dazu eingerichtet ist, Temperaturmesswerte der einen oder der mehreren Temperatursensorauswertevorrichtungen (585) auszuwerten, die diese mit Hilfe von zur elektronischen Steuervorrichtung (4) externen Temperatursensoren und/oder mit Hilfe von Temperatursensoren (586) der elektronischen Sicherung (1) erfassen und

wobei die Steuervorrichtung (4) dazu eingerichtet ist, den Leistungsschalter (17) zu öffnen, wenn der Temperaturmesswert einen Temperaturgrenzwert, überschreitet und/oder

wobei die Steuervorrichtung (4) dazu eingerichtet ist, einem übergeordneten Rechnersystem (12) eine Temperaturüberschreitung über einen Datenbus (9) zu signalisieren, wenn der Temperaturmesswert einen Temperaturgrenzwert, überschreitet.

Elektronische Sicherung mit optischer Übermittlung von Messwerten

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist.

2. Elektronische Sicherung (1) nach Merkmal 1,

wobei die elektronische Sicherung (1) und/oder die Steuervorrichtung (4) der elektronischen Sicherung (1) Mittel (20, 21, 22, 23, 24, 25, 525, 570) zur Erfassung und zur Detektion eines rückwärtsfließenden Stromes (29) umfassen.

3. Elektronische Sicherung (1) nach Merkmal 1 oder 2,

wobei die Steuervorrichtung (1) einen Rechnerkern (2) umfasst und,
wobei der Rechnerkern (2) der Steuervorrichtung (4) der elektronischen Sicherung (1) dazu eingerichtet ist, die so erfassten Messwerte auszuwerten, und
wobei der Rechnerkern (2) dazu eingerichtet ist, die Messwerte und/oder oder daraus abgeleitete Messwerte an andere Rechnerkerne anderer elektronischen Sicherungen über einen Sicherungsdatenbus (9, 540) oder dergleichen oder an ein übergeordnetes Steuergerät (12), beispielsweise an ein übergeordnetes Rechnersystem (12), weiterzugeben.

4. Elektronische Sicherung (1) nach einem der Merkmale 1 bis 3
wobei die elektronische Sicherung (1) und/oder die Steuervorrichtung (4) der elektronischen Sicherung (1) zwei Datenschnittstellen (10, 610) umfassen, die jeweils optische Datenschnittstellen (550, 551) sein können.

5. System aus mehreren elektronischen Sicherungen nach den Merkmalen 1 bis 4,

wobei das System einen Lichtwellenleiter (580) umfasst und
wobei der Lichtwellenleiter (580) dazu eingerichtet ist, die eine elektronische Sicherung über eine optische Datenschnittstelle (551, 550) dieser elektronischen Sicherung mit einer anderen Vorrichtung (12), beispielsweise mit einem übergeordneten Rechnersystem (12), oder mit einer anderen elektronischen zu verbinden.

Elektronische Sicherung mit Passwort und Authentifizierungsschutz

1. Elektronische Sicherung (1) eines Fahrzeugs, insbesondere nach einem oder mehreren der vorhergehenden Merkmale,

wobei die elektronische Sicherung (1) eine Steuervorrichtung (4) aufweist und
wobei die elektronische Sicherung (1) einen Leistungsschalter (17) aufweist und
wobei die Steuervorrichtung (4) der elektronischen Sicherung (1) eine Datenschnittstelle (10) für einen Sicherungsdatenbus (9) aufweist und
wobei die Steuervorrichtung (4) dazu eingerichtet ist, zu steuern, ob der Leistungsschalter (17) leitend ist, und somit als geschlossener Leistungsschalter arbeitet, oder ob der Leistungsschalter (17) nicht leitet, und somit als offener Leistungsschalter arbeitet, und
wobei die Steuervorrichtung (4) dazu eingerichtet ist, über den Sicherungsdatenbus (9) Datenbotschaften zu empfangen, und
wobei vom Inhalt dieser Datenbotschaften zumindest teilweise und zumindest zeitweise abhängt, ob die Steuervorrichtung (1) den Leistungsschalter (17) schließt oder öffnet.

2. Elektronische Sicherung (1) nach Merkmal 1,

wobei die Steuervorrichtung (4) der elektronischen Sicherung (1) dazu eingerichtet ist, den Schaltzustand des Leistungsschalters (17) aufgrund der Datenbotschaft nur dann zu ändern,
wenn die Datenbotschaft ein Passwort umfasst und
wenn dieses Passwort eine oder mehrere vorbestimmte Eigenschaften hat, insbesondere ein vorbestimmtes Passwort ist.

3. Elektronische Sicherung (1), insbesondere nach den Merkmalen 1 bis 2,

wobei die elektronische Sicherung (1) einen Leistungsschalter (17) umfasst und
wobei die elektronische Sicherung (1) dazu eingerichtet ist, an dem Anschluss (26) ihres Leistungsschalters (17), der auf der Energiequellenseite liegt, die Spannung zwischen diesem Anschluss (26) und einem Bezugsknoten (201) in Form eines Spannungswerts zu erfassen, und
wobei die elektronische Sicherung (1) dazu eingerichtet ist, diesen Spannungswert zu überprüfen, und
wobei die elektronische Sicherung (1) dazu eingerichtet ist, die elektrische Versorgung eines Versorgungsteilnetzwerkes eines Versorgungsnetzwerkes (200) durch Ausschalten ihres Leistungsschalters (17) abzuschalten,
wenn der Betrag des erfassten Spannungswerts einen Spannungsmindestwert unterschreitet.

4. Elektronische Sicherung (1), insbesondere nach den Merkmalen 1 bis 3,

wobei die elektronische Sicherung (1) einen Leistungsschalter (17) umfasst und
wobei die elektronische Sicherung (1) dazu eingerichtet ist, den Stromwert des Stroms (29) durch den Leistungsschalter (17) zu erfassen und/oder zu ermitteln, und
wobei die elektronische Sicherung (1) dazu eingerichtet ist, den ermittelten Stromwert zu überprüfen, und
wobei die elektronische Sicherung (1) dazu eingerichtet ist, die elektrische Versorgung eines Versorgungsteilnetzwerkes eines Versorgungsnetzwerkes (200) durch Ausschalten ihres Leistungsschalters (17) abzuschalten,
wenn der Betrag des erfassten Stromwerts einen vorbestimmten Stromhöchstwert überschreitet.

5. Elektronische Sicherung (1), insbesondere nach den Merkmalen 1 bis 4,

wobei die elektronische Sicherung (1) einen Leistungsschalter (17) umfasst und
wobei die elektronische Sicherung (1) dazu eingerichtet ist, an dem Anschluss (26) ihres Leistungsschalters (17), der auf der Energiequellenseite liegt, die Spannung zwischen diesem Anschluss (26) und einem Bezugsknoten (201) in Form eines Spannungswerts zu erfassen, und
wobei die elektronische Sicherung (1) dazu eingerichtet ist, diesen Spannungswert zu überprüfen, und
wobei die elektronische Sicherung (1) dazu eingerichtet ist, den Stromwert des Stroms (29) durch den Leistungsschalter (17) zu erfassen und/oder zu ermitteln, und
**wobei die** elektronische Sicherung (1) dazu eingerichtet ist, den ermittelten Stromwert zu überprüfen, und
wobei die elektronische Sicherung (1) dazu eingerichtet ist, die elektrische Versorgung eines Versorgungsteilnetzwerkes eines Versorgungsnetzwerkes (200) durch Ausschalten ihres Leistungsschalters (17) abzuschalten,
wenn der Betrag des erfassten Spannungswerts einen Spannungsmindestwert unterschreitet und
wenn gleichzeitig der der Betrag des erfassten Stromwerts einen vorbestimmten Stromhöchstwert überschreitet.

6. Elektronische Sicherung (1) nach Merkmal 5,
wobei die Steuervorrichtung (4) der elektronischen Sicherung (1) dazu eingerichtet ist, zeitlich nach einem Abschalten der elektrischen Versorgung des Versorgungsteilnetzwerkes des Versorgungsnetzwerkes (200) durch Ausschalten ihres Leistungsschalters (17) einen oder mehrere Einschaltversuche des Leistungsschalters (17) durchzuführen.

7. Elektronische Sicherung (1) nach Merkmal 6,
wobei die Steuervorrichtung (4) der elektronischen Sicherung (1) dazu eingerichtet ist, zeitlich nach einem Abschalten der elektrischen Versorgung des Versorgungsteilnetzwerkes des Versorgungsnetzwerkes (200) durch Ausschalten ihres Leistungsschalters (17) bei einem Einschaltversuch des Leistungsschalters (17) einen Einschaltversuchszähler der Steuervorrichtung (4), insbesondere einen Registerwert eines Rechnerkerns (2) der Steuervorrichtung(4) der elektronischen Sicherung (1), um eine Einschaltversuchszählschrittgröße, die auch negativ sein kann und von 0 verschieden ist, zu erhöhen.

8. Elektronische Sicherung (1) nach Merkmal 7,
wobei die Steuerungsvorrichtung (4) der elektronischen Sicherung (1) dazu eingerichtet ist, eine Fehlermeldung an den Rechnerkern (2) der Steuerungsvorrichtung (4) einer anderen elektronischen Sicherung und/oder an eine Steuervorrichtung (4) einer anderen elektronischen Sicherung oder an ein übergeordnetes Rechnersystem (12) zu übermitteln, wenn die Anzahl der erfolglosen Einschaltversuche und/oder der Zählerstand des Einschaltversuchszählers der Steuervorrichtung (4) und/oder des Rechnerkerns (2) eine vorgegebene Anzahl kreuzen oder erreichen.

9. Elektronische Sicherung (1) nach einem der Merkmale 1 bis 8,
wobei die Steuervorrichtung (4) der elektronischen Sicherung (1) und/oder der Rechnerkern (2) der Steuervorrichtung (4) der elektronischen Sicherung (1) dazu eingerichtet sind, über eine Datenschnittstelle (10, 550) der Steuervorrichtung (4) und über eine Sicherungsdatenbus (9, 540) Daten wie Konfigurationsdaten und/oder Schaltbefehle und/oder Diagnosedaten und/oder Messwerte und/oder Vergleichswerteinstellungen und/oder Schwellwerte und/oder Authentifizierungsdaten und/oder Programmcode und/oder Kennwörter und/oder Verschlüsselungsinformationen und/oder Zufallszahlen insbesondere zum Schreiben in einen Speicher der Steuervorrichtung (4) oder des Rechnerkerns (2) und/oder zum Lesen aus einen Speicher der Steuervorrichtung (4) oder aus einen Speicher des Rechnerkerns (2) zu empfangen oder zu senden.

Elektronische Sicherung mit Ein- oder Zweidrahtdatenbus und Autoadressierungsverfahren

1. Elektronischen Sicherung (1) eines Fahrzeugs, insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und
> wobei der Leistungsschalter (17) einen ersten Anschluss (26), einen Steueranschluss (27) und einen zweiten Anschluss (28) aufweist und
> wobei der erste Anschluss (26) des Leistungsschalters (17) mit dem ersten Anschluss (18) der Sicherung (1) elektrisch verbunden ist und
> wobei der zweite Anschluss (28) des Leistungsschalters (17) mit dem zweiten Anschluss (19) der Sicherung (1) elektrisch verbunden ist und
> wobei der Steueranschluss (27) des Leistungsschalters (17) mit der Steuervorrichtung (4) elektrisch verbunden ist und
> wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.
> wobei die Sicherung (1) über eine Datenschnittstelle (10, 610, 551) und einen Datenbus (9) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
> wobei der Datenbus (9) in Teilen oder in Gänze ein Zweidrahtdatenbus ist.

2. Elektronische Sicherung (1) nach Merkmal 1,
wobei der Datenbus (9) ein differenzieller Datenbus ist.
3. Elektronische Sicherung (1) nach Merkmal 2,
wobei der Datenbus (9) ein differenzieller bidirektionaler Datenbus ist.
4. Elektronische Sicherung (1) nach Merkmal 3,
wobei der Datenbus (9) ein CAN-Datenbus oder ein CAN-FD-Datenbus oder ein Flexray-Datenbus oder ein LVDS-Datenbus oder ein PSI5-Datenbus oder ein Datenbus (9) ist, der eine Datenschnittstelle (10) der Steuervorrichtung (4) mit einer physikalischen Schnittstelle (Physical-Interface) eines CAN-Datenbusses und/oder eines CAN-FD-Datenbusses oder eines Flexray-Datenbusses oder eines PSI-5-Datenbusses oder eines LVDS-Datenbusses oder dergleichen erfordert.
5. Elektronischen Sicherung (1), insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und
> wobei der Leistungsschalter (17) einen ersten Anschluss (26), einen Steueranschluss (27) und einen zweiten Anschluss (28) aufweist und
> wobei der erste Anschluss (26) des Leistungsschalters (17) mit dem ersten Anschluss (18) der Sicherung (1) elektrisch verbunden ist und
> wobei der zweite Anschluss (28) des Leistungsschalters (17) mit dem zweiten Anschluss (19) der Sicherung (1) elektrisch verbunden ist und
> wobei der Steueranschluss (27) des Leistungsschalters (17) mit der Steuervorrichtung (4) elektrisch verbunden ist und
> wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.

wobei die Sicherung (1) über eine Datenschnittstelle (10, 610, 551) und einen Datenbus (9) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

wobei der Datenbus (9) in Teilen oder in Gänze ein Eindrahtdatenbus ist.

6. Elektronische Sicherung (1) nach Merkmal 5,

wobei der Datenbus (9) ein LIN-Datenbus oder ein DSI3-Datenbus oder ein UART-Datenbus oder ein SPI-Datenbus ist.

7. Elektronische Sicherung (1) nach einem der Merkmale 1 bis 5,

wobei die Steuervorrichtung (4) der elektronischen Sicherung zwei Datenschnittstellen (610, 10) für den Sicherungsdatenbus (9) umfasst.

8. Elektronische Sicherung (1) nach einem der Merkmale 1 bis 7,

wobei die Steuerungsvorrichtung (4) der elektronischen Sicherung (1) eine oder mehrere Datenschnittstellen (10, 610) umfasst und

wobei Datenschnittstellen (10, 610) der Steuerungsvorrichtung (4) der elektronischen Sicherung (1) dazu eingerichtet sind, ein Autoadressierungsverfahren zur Ermittlung einer Sicherungsadresse der Steuerungsvorrichtung (4) und/oder des Rechnerkerns (2) der Steuerungsvorrichtung (4) durzuführen oder an diesem Autoadressierungsverfahren teilzunehmen.

9. Elektronische Sicherung (1, 825) nach einem der Merkmale 1 bis 7,

wobei die elektronische Sicherung (1, 825) dazu eingerichtet ist, Parameter der an die elektronische Sicherung (1, 825) angeschlossenen Versorgungsteilbäume (815) und/oder einzelner Knoten der angeschlossenen Versorgungsteilbäume (815) und/oder einzelner angeschlossener Versorgungsleitungsabschnitte des Versorgungsbaums der Versorgungsleitungen des Fahrzeugs an eine andere elektronische Sicherung (805) und/oder ein oder mehrere Steuergeräte des Fahrzeugs und/oder ein übergeordnetes Rechnersystem (12) zu übertragen.

10. Elektronische Sicherung (1, 825) nach Merkmal 9,

wobei ein solcher Parameter ein direkt zugänglicher Parameter, wie der Temperaturwert der Temperatur eines Temperatursensors und/oder der Spannungswert einer Spannung eines Knotens (26, 27, 28) innerhalb der Sicherung (1) gegen ein Bezugspotenzial (201) und/oder der Spannungswert einer Spannung eines Knotens des Versorgungsnetzwerks (200) gegen ein Bezugspotenzial (201) und/oder der Stromwert eines elektrischen Stromes (29) in einem Versorgungsleitungsabschnitt des angeschlossenen Versorgungsnetzwerkes (820) ist.

11. Elektronische Sicherung (1, 825) nach Merkmal 9 oder 10,

wobei der Rechnerkern (2) der Steuervorrichtung (4) der elektronischen Sicherung (1) dazu eingerichtet ist, insbesondere durch Anwendung der Kirchhoffschen Gleichungen auf Daten,

- die die Steuervorrichtung (4) der elektronischen Sicherung (mittels Messvorrichtungen dieser elektronischen Sicherung (1, 825) ermittelt hat und/oder
- die die Steuervorrichtung (4) dieser elektronischen Sicherung (1, 825) von den Steuervorrichtungen (4) anderer elektronischer Sicherungen (805) oder von übergeordneten Steuergeräten (12), beispielsweise einem übergeordneten Rechnersystem (12), erhalten hat,

abgeleitete Parameter, wie beispielsweise Leckströme gegen andere elektrische Knoten im Fahrzeug oder elektrische Widerstände von Versorgungsspannungsleitungsabschnitten, zu erfassen und/oder zu ermitteln.

12. Elektronische Sicherung (1, 805) nach Merkmal 10 oder 11,

wobei die Steuervorrichtung (4) der elektronischen Sicherung (1, 825) und/oder der Rechnerkern (2) der Steuervorrichtung (4) der elektronischen Sicherung (1, 825) dazu eingerichtet sind, den Temperaturwert der Temperatur eines nachfolgenden Versorgungsleitungsabschnitts zu schätzen,

- wenn dessen ohmscher Widerstand und dessen Wärmekapazität und dessen thermische Ableitwiderstände und die Umgebungstemperatur im Bereich des Versorgungsleitungsabschnitts näherungsweise, z.B. durch Schätzung der Steuervorrichtung (4) der elektronischen Sicherung (1, 825) der Steuervorrichtung (4) der elektronischen Sicherung (1, 825) und/oder dem Rechnerkern (2) der Steuervorrichtung (4) der elektronischen Sicherung (1, 825) bekannt sind.

Versorgungsnetzwerk mit Messdatenaustausch zwischen elektronischen Sicherungen

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
wobei die elektronische Sicherung (1, 825) dazu eingerichtet ist, Parameter der an die elektronische Sicherung (1, 825) angeschlossenen Versorgungsteilbäume (815) und/oder einzelner Knoten der angeschlossenen Versorgungsteilbäume (815) und/oder einzelner angeschlossener Versorgungsleitungsabschnitte des Versorgungsbaums der Versorgungsleitungen des Fahrzeugs an eine andere elektronische Sicherung (805) und/oder ein oder mehrere Steuergeräte des Fahrzeugs und/oder ein übergeordnetes Rechnersystem (12) zu übertragen.

2. Elektronische Sicherung (1, 825) nach Merkmal 1,
wobei ein solcher Parameter ein direkt zugänglicher Parameter, wie der Temperaturwert der Temperatur eines Temperatursensors und/oder der Spannungswert einer Spannung eines Knotens (26, 27, 28) innerhalb der Sicherung (1) gegen ein Bezugspotenzial (201) und/oder der Spannungswert einer Spannung eines Knotens des Versorgungsnetzwerks (200) gegen ein Bezugspotenzial (201) und/oder der Stromwert eines elektrischen Stromes (29) in einem Versorgungsleitungsabschnitt des angeschlossenen Versorgungsnetzwerkes (820) ist.

3. Elektronische Sicherung (1, 825) nach Merkmal 1 oder 2,

wobei der Rechnerkern (2) der Steuervorrichtung (4) der elektronischen Sicherung (1) dazu eingerichtet ist, insbesondere durch Anwendung der Kirchhoffschen Gleichungen auf Daten,

- die die Steuervorrichtung (4) der elektronischen Sicherung (mittels Messvorrichtungen dieser elektronischen Sicherung (1, 825) ermittelt hat und/oder
- die die Steuervorrichtung (4) dieser elektronischen Sicherung (1, 825) von den Steuervorrichtungen (4) anderer elektronischer Sicherungen (805) oder von übergeordneten Steuergeräten (12), beispielsweise einem übergeordneten Rechnersystem (12), erhalten hat,

abgeleitete Parameter, wie beispielsweise Leckströme gegen andere elektrische Knoten im Fahrzeug oder elektrische Widerstände von Versorgungsspannungsleitungsabschnitten, zu erfassen und/oder zu ermitteln.

4. Elektronische Sicherung (1, 805) nach Merkmal 2 oder 3,
wobei die Steuervorrichtung (4) der elektronischen Sicherung (1, 825) und/oder der Rechnerkern (2) der Steuervorrichtung (4) der elektronischen Sicherung (1, 825) dazu eingerichtet sind, den Temperaturwert der Temperatur eines nachfolgenden Versorgungsleitungsabschnitts zu schätzen,

- wenn dessen ohmscher Widerstand und dessen Wärmekapazität und dessen thermische Ableitwiderstände und die Umgebungstemperatur im Bereich des Versorgungsleitungsabschnitts näherungsweise, z.B. durch Schätzung der Steuervorrichtung (4) der elektronischen Sicherung (1, 825) der Steuervorrichtung (4) der elektronischen Sicherung (1, 825) und/oder dem Rechnerkern (2) der Steuervorrichtung (4) der elektronischen Sicherung (1, 825) bekannt sind.

Elektronische Sicherung mit Leistungssteuerung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist, und
wobei die Steuervorrichtung (4) der elektronischen Sicherung (1, 825) dazu eingerichtet ist, mittels einer Spannungsmessvorrichtung (16) den Spannungswert der Spannung eines Knotens (22, 25, 21) am Leistungsschalters (17) der elektronischen Sicherung (1, 825) und/oder eines damit in Zusammenhang stehenden Knotens (25) gegenüber einem Bezugspotenzial (201) zu ermitteln, und
wobei die Steuervorrichtung (4) der elektronischen Sicherung (1, 825) dazu eingerichtet ist, den Stromwert des Stroms (29) durch den Leistungsschalter (17) der elektronischen Sicherung (1, 825) zu ermitteln, und
wobei die Steuervorrichtung (4) der elektronischen Sicherung oder ein übergeordnetes Rechnersystem (12) dazu eingerichtet sind, aus dem Stromwert und dem Spannungswert einen Leistungswert der in den Verbraucher oder in einen nachfolgenden Versorgungsbaum (815, 820) oder der in einen nachfolgenden Versorgungsleitungsabschnitt fließenden elektrischen Leistung zu ermitteln, und
wobei die Steuervorrichtung(4) der elektronischen Sicherung (825) und/oder das übergeordnete Rechnersystem (12) im Zusammenwirken mit der Steuervorrichtung (4) dazu eingerichtet sind, den Leistungsschalter (17) der elektronischen Sicherung (825) zu öffnen, wenn der Betrag dieses Leistungswerts der eingespeiste Leistung einen Leistungseinspeisungsschwellwert überschreitet.

2. Elektronischen Sicherung (1), insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist, und

wobei die Steuervorrichtung (4) der elektronischen Sicherung (1, 825) dazu eingerichtet ist, mittels einer Spannungsmessvorrichtung den Spannungswert der Spannung eines Knotens (22, 25, 21) am Leistungsschalter (17) der elektronischen Sicherung (1, 805) oder eines damit in Zusammenhang stehenden Knotens gegenüber einem Bezugspotenzial (201) zu ermitteln, und

wobei die Steuervorrichtung (4) der elektronischen Sicherung (1, 825) dazu eingerichtet ist, den Stromwert des Stroms (29) durch den Leistungsschalter (17) der elektronischen Sicherung (1, 825) zu ermitteln, und

wobei die Steuervorrichtung (4) der elektronischen Sicherung (1, 825) oder ein übergeordnetes Rechnersystem (12) dazu eingerichtet sind, aus dem Stromwert und dem Spannungswert den Leistungswert der aus der Energiequelle oder aus einem vorausgehenden Versorgungsbaum oder aus einen vorausgehenden Versorgungsleitungsabschnitt fließenden elektrische Leistung zu ermitteln, und

wobei die Steuervorrichtung(4) der elektronischen Sicherung (825) und/oder das übergeordnete Rechnersystem (12) im Zusammenwirken mit der Steuervorrichtung (4) dazu eingerichtet sind, den Leistungsschalter (17) der elektronischen Sicherung (825) zu öffnen, wenn der Betrag dieser entnommenen Leistung einen Leistungsentnahmeschwellwert überschreitet.

3. Elektronische Sicherung (1, 805) nach Merkmal 1 oder 2,

wobei die Steuervorrichtung (4) der elektronischen Sicherung (1, 805) dazu eingerichtet ist, diesen Leistungswert über den Sicherungsdatenbus (9) an die Steuervorrichtung (4) einer anderen elektronischen Sicherung (825) und/oder das übergeordnete Rechnersystem (12) zu übermitteln.

4. Elektronische Sicherung (1) nach Merkmal 3,

wobei es sich bei dem übergeordneten Rechnersystem (12) um einen Server (750) eines Energieanbieters oder eines dessen Erfüllungsgehilfen und/oder um den Server (710) eines Dienstleistungsanbieters oder eines Automobil-herstellers handelt.

<u>Elektronische Sicherung mit Zeitgeber</u>

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17)

zwischen dem ersten Anschluss (26) des Leistungsschalters (17) und dem zweiten Anschluss (28) des Leistungsschalters (28) zu ermitteln.

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

wobei die Steuervorrichtung (4) der elektronischen Sicherung (1, 825) eine Uhr oder einen Zeitgeber (35), insbesondere für die Erzeugung von Zeitstempeln einer Log-Tabelle, aufweist.

2. Elektronische Sicherung (1, 825) nach Merkmal 1,

**wobei die** Uhr bzw. der Zeitgeber (35) der Steuervorrichtung (4) der elektronischen Sicherung (1, 825) eine Synchronisationsmöglichkeit mit den Uhren und Zeitgebern (35) der Steuervorrichtungen (4) anderer elektronischer Sicherungen (805, 810) und/oder mit den Uhren und Zeitgebern (1970) eines übergeordneten Rechnersystems (12) aufweist.

3. Elektronische Sicherung (1, 825) nach Merkmal 1 oder 2,

wobei die Steuervorrichtung (4) der elektronischen Sicherung (1) dazu eingerichtet ist, den Leistungsschalter (17) der Sicherung (1) nach Empfang eines Abschaltsignals über einen Sicherungsdatenbus (9) erst nach Ablauf einer Abschaltverzögerungszeit abzuschalten.

4. Elektronische Sicherung (1, 825) nach Merkmal 3,

wobei die Abschaltverzögerungszeit

- von dem Betrag des Stromwerts des elektrischen Stroms (29) durch den Leistungsschalter (17) und/oder
- von dem der Betrag der Leistungseinspeisung in das nachfolgende Versorgungsteilnetzwerk und/oder in den nachfolgenden Versorgungsleitungsabschnitt oder in einen nachfolgenden Verbraucher und/oder
- von dem Betrag der Leistungsentnahme aus dem vorausgehenden Versorgungsteilnetzwerk und/oder in dem vorausgehenden Versorgungsleitungsabschnitt oder aus einer vorausgehenden Energiequelle abhängt.

5. Elektronische Sicherung (1, 825) nach Merkmal 4,

wobei die Abschaltverzögerungszeit von dem Betrag des Stromwerts des elektrischen Stroms (29) durch den Leistungsschalter (17) mit zunehmendem Betrag des Werts des elektrischen Stroms (29) durch den Leistungsschalter (17) parabelförmig fallend abhängt.

Elektronische Sicherung mit Leistungsabgabe und Leistungsentnahmesteuerung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

wobei die Steuervorrichtung (4) der elektronischen Sicherung (1) dazu eingerichtet ist, den Leistungsschalter (17) der Sicherung (1), insbesondere unverzüglich, abzuschalten,

- wenn der Betrag des Werts des elektrischen Stromes (29) durch den Leistungsschalter (17) der elektronischen Sicherung (1, 825) einen Stromschwellwert überschreitet und/oder
- wenn der Betrag der Leistungseinspeisung in das nachfolgende Versorgungsteilnetzwerk und/oder in den nachfolgenden Versorgungsleitungsabschnitt und/oder in einen nachfolgenden Verbraucher einen Leistungseinspeisungsschwellwert überschreitet und/oder
- wenn der Betrag der Leistungsentnahme aus dem vorausgehenden Versorgungsteilnetzwerk und/oder aus dem vorausgehenden Versorgungsleitungsabschnitt oder aus einer vorausgehenden Energiequelle einen Leistungsentnahmeschwellwert überschreitet.

2. Elektronischen Sicherung (1), insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln.
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
wobei die Steuervorrichtung (4) der elektronischen Sicherung (1, 825) dazu eingerichtet ist, im Zusammenwirken mit dem Leistungsschalter (17) das Verhalten einer Schmelzsicherung zu emulieren.

3. Elektronische Sicherung (1, 825) nach Merkmal 2,

wobei die Steuervorrichtung (4) der elektronischen Sicherung (1, 825) dazu eingerichtet ist, den Betrag des Stromwerts des elektrischen Stromes (29) durch den Leistungsschalter (17) zu erfassen und/oder zu ermitteln, und
wobei die Steuervorrichtung (4) der elektronischen Sicherung (1, 825) dazu eingerichtet ist, den erfassten Betrag des Stromwerts des elektrischen Stromes (29) durch den Leistungsschalter (17) zu quadrieren, und
wobei die Steuervorrichtung (4) der elektronischen Sicherung (1, 825) dazu eingerichtet ist, den erfassten und quadrierten Betrag des Stromwerts des elektrischen Stromes (29) durch den Leistungsschalter (17) über die Zeit zu integrieren, und
wobei die Steuervorrichtung (4) der elektronischen Sicherung (1, 825) dazu eingerichtet ist, den erfassten und quadrierten und über die Zeit integrierten Betrag des Stromwerts des elektrischen Stromes (29) zu filtern, insbesondere tiefpasszufiltern und
**wobei die** Steuervorrichtung (4) der elektronischen Sicherung (1, 825) dazu eingerichtet ist, den erfassten und quadrierten und gefilterten Betrag des Stromwerts des elektrischen Stromes (29) mit einem Schwellwert zu vergleichen, und
wobei die Steuervorrichtung (4) dazu eingerichtet ist, den Schaltzustand des Leistungsschalters (17) der elektronischen Sicherung (1, 825) zumindest zeitweise in Abhängigkeit von dem Ergebnis dieses Vergleiches einzustellen.

4. Elektronische Sicherung (1, 825) nach Merkmal 2 und/oder 3,

wobei die Steuervorrichtung (4) der elektronischen Sicherung (1, 825) dazu eingerichtet ist, den Betrag des Stromwerts des elektrischen Stromes (29) durch den Leistungsschalter (17) zu erfassen und/oder zu ermitteln und

wobei die Steuervorrichtung (4) der elektronischen Sicherung (1, 825) dazu eingerichtet ist, den erfassten Betrag des Stromwerts des elektrischen Stromes (29) durch den Leistungsschalter (17) mittels eines Polynoms mit einer Ordnung des Polynoms größer als eins in einen abgebildeten Wert umzuwandeln, und

wobei die Steuervorrichtung (4) der elektronischen Sicherung (1, 825) dazu eingerichtet ist, diesen abgebildeten Wert des elektrischen Stromes (29) durch den Leistungsschalter (17) über die Zeit zu integrieren, und

wobei die Steuervorrichtung (4) der elektronischen Sicherung (1, 825) dazu eingerichtet ist, den abgebildeten und über die Zeit integrierten Wert des elektrischen Stromes (29) zu filtern, insbesondere tiefpasszufiltern, und

wobei die Steuervorrichtung (4) der elektronischen Sicherung (1, 825) dazu eingerichtet ist, den abgebildeten und gefilterten Wert des elektrischen Stromes (29) mit einem Schwellwert zu vergleichen, und

wobei die Steuervorrichtung (4) der elektronischen Sicherung (1, 825) dazu eingerichtet ist, der Schaltzustand des Leistungsschalters (17) der elektronischen Sicherung (1, 825) zumindest zeitweise in Abhängigkeit von dem Ergebnis dieses Vergleiches einzustellen.

Elektronische Sicherung mit Energiesenke für rückgespeiste Energie

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

**wobei die** elektronische Sicherung (1, 825) und/oder die Steuervorrichtung (4) der elektronischen Sicherung (1, 825) und/oder der Rechnerkern (2) der Steuervorrichtung (4) der Sicherung (1, 825) und/oder die Sicherung (1) im Zusammenwirken mit einem übergeordneten Rechnersystem (12) dazu eingerichtet sind, den Transport elektrischer Energie von einer oder mehreren Energiequellen (250) zum Verbraucher (835, 830) zumindest zeitweise zuzulassen, und

wobei die elektronische Sicherung (1, 825) und/oder die Steuervorrichtung (4) der elektronischen Sicherung (1, 825) und/oder der Rechnerkern (2) der Steuervorrichtung (4) der Sicherung (1, 825) und/oder die Sicherung (1) im Zusammenwirken mit einem übergeordneten Rechnersystem (12) dazu eingerichtet sind, den Transport elektrischer Energie vom Verbraucher (835, 830) zu einer oder mehreren oder allen Energiequellen (250) zu unterbinden.

2. Elektronische Sicherung (1, 825) nach Merkmal 1,

wobei elektronische Sicherung (1, 825) Mittel (24, 23) zur Erfassung der Richtung des elektrischen Stroms (29) durch den Leistungsschalter (17) umfasst und

wobei die Steuervorrichtung (4) der elektronischen Sicherung (1, 825) dazu eingerichtet ist die Richtung des fließenden elektrischen Stromes (29) mit Hilfe dieser Mittel 24, 23) zu erfassen.

3. Elektronische Sicherung (1, 805) nach Merkmal 2,

wobei die elektronische Sicherung (1, 825) und/oder die Steuervorrichtung (4) der elektronischen Sicherung (1, 825) und/oder der Rechnerkern (2) der Steuervorrichtung (4) der Sicherung (1, 825) und/oder die Sicherung (1) im Zusammenwirken mit einem übergeordneten Rechnersystem (12) dazu eingerichtet sind, den Leistungsschalter (17) der Sicherung (1, 825) zu öffnen, wenn der elektrische Strom (29) vom Verbraucher (830) zu einer oder mehreren Energiequellen (250) durch den Leistungsschalter (17) der elektronischen Sicherung (1, 825) fließt.

4. Elektronische Sicherung (1, 825) nach Merkmal 3,

wobei die Steuervorrichtung (4) der elektronischen Sicherung (1, 825) und/oder die Sicherung (1, 825) einen dritten Leistungsschalter (615) umfassen, der vom Leistungsschalter (17) der elektronischen Sicherung (1, 825) verschieden ist, und

wobei die elektronische Sicherung (1, 825) und/oder die Steuervorrichtung (4) der elektronischen Sicherung (1, 825) und/oder der Rechnerkern (2) der Steuervorrichtung (4) der Sicherung (1, 825) und/oder die Sicherung (1) im Zusammenwirken mit einem übergeordneten Rechnersystem (12) dazu eingerichtet sind, diesen dritten Leistungsschalter (615) zu schließen, wenn der elektrische Strom (29) vom Verbraucher (835) zu einer oder mehreren Energiequellen (250) durch den Leistungsschalter (17) der elektronischen Sicherung (1, 825) fließt, und

dass dieser dritte Leistungsschalter (615) dazu eingerichtet ist, den elektrischen Strom (29) vom Verbraucher (835) in eine Stromsenke, insbesondere eine Bezugspotenzialleitung (201), abzuleiten, wenn der dritte Leistungsschalter (615) geschlossen ist.

Elektronische Sicherung mit Schaltbarkeitsdetektion

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
**wobei der** erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
wobei die elektronische Sicherung (1) Mittel zur Detektion der Schaltbarkeit des Leistungsschalters (17) der elektronischen Sicherung (1) umfasst.

2. Elektronische Sicherung (1) nach Merkmal 1,

wobei die Steuervorrichtung (4) der elektronischen Sicherung (1) und/oder die elektronische Sicherung (1) eine erste Teststromquelle (505) umfassen und

wobei die Steuervorrichtung (4) der elektronischen Sicherung (1) und/oder die elektronische Sicherung (1) eine zweite Teststromquelle (905) umfassen und

wobei die Steuerungsvorrichtung (4) der elektronischen Sicherung (1) dazu eingerichtet ist, die erste Teststromquelle (505) und die zweite Teststromquelle (905) zu steuern, und

wobei die erste Teststromquelle (505) dazu eingerichtet ist, auf Veranlassung durch die Steuervorrichtung (4) einen Teststrom (515) in den ersten Anschluss (26) des Leistungsschalters (17) einzuspeisen, und

wobei die zweite Teststromquelle (905) dazu eingerichtet ist, dann den Teststrom (915) aus dem zweiten Anschluss (28) des Leistungsschalters (17) zu entnehmen, und

wobei die zweite Teststromquelle (905) Mittel umfasst, um den Stromwert des entnommenen Teststroms (915) zu erfassen, und

wobei die Steuerungsvorrichtung (4) dazu eingerichtet ist, auf einen Fehler des Leistungsschalters (17) der elektronischen Sicherung (1) zu schließen, wenn die zweite Stromquelle (905) entgegen der jeweiligen Erwartung keinen Stromwert des Teststroms (915) und/oder zeitlichen Verlauf des Stromwerts des Teststroms (915) entsprechend einem Erwartungswertintervall für den Stromwert dieses Teststroms (915) und/oder dem erwarteten zeitlichen Verlauf des Erwartungswertintervalls für den zeitlichen Verlauf des Stromwerts des Teststroms (915) entspricht.

3. Elektronische Sicherung (1) nach Merkmal 2,

wobei die Steuervorrichtung (4) der elektronischen Sicherung (1) dazu eingerichtet ist - insbesondere zu Testzwecken -, ein oder mehrmals den Schaltzustand des Leistungsschalters (17) zu ändern und den Schaltzustand des Leistungsschalters (17) zu prüfen.

Elektronische Sicherung mit Mustererkennung und Lichtbogenerkennung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist.

wobei der Rechnerkern (2) der Steuervorrichtung (4) der elektronischen Sicherung (1) dazu eingerichtet ist, Messwerte - insbesondere physikalischer Parameter und/oder Ströme und/oder Spannungen innerhalb der Sicherung (1) - mittels Messmitteln der elektronischen Sicherung (1) zu ermitteln, und

wobei der Rechnerkern (2) der Steuervorrichtung (4) dazu eingerichtet ist, ein neuronales Netzwerkmodell auszuführen, und

wobei der Rechnerkern (2) der Steuervorrichtung (4) dazu eingerichtet ist, die ermittelten Messwerte als Eingangswerte dieses neuronalen Netzwerkmodells zu verwenden, und

wobei der Schaltzustand des Leistungsschalters (17) der elektronischen Sicherung (1) und/oder zumindest eine Datenbotschaft und/oder der Inhalt einer Datenbotschaft des Rechnerkerns (2) der Steuervorrichtung (4) der elektronischen Sicherung (1) von einem Ausgangssignal des neuronalen Netzwerkmodells abhängt und wobei die Datenbotschaft (9) eine Datenbotschaft (9) über den Datenbus (9)

- an ein übergeordnetes Rechnersystem (12) und/oder
- an einen Rechnerkern (2) einer anderen Steuervorrichtung (4) einer anderen elektronischen Sicherung (805) ist.

2. Elektronische Sicherung (1) nach Merkmal 1,
wobei das neuronale Netzwerkmodell mit geeigneten Trainingsdaten aus der Entwicklungszeit der elektronischen Sicherung (1) trainiert ist.
3. Elektronische Sicherung (1, 825) nach Merkmal 1 oder 2,
wobei die Steuervorrichtung (4) der elektronischen Sicherung (1, 825) dazu eingerichtet ist mittels eines Ausgangssignals des neuronalen Netzwerkmodells einen Ausfall eines oder mehrerer Verbraucher (835) oder einen Ausfall einer oder mehrerer Energiequellen (250) oder einen anderen Defekt des Systems der Gesamtvorrichtung des Versorgungsnetzwerks 200 erkennt.

Elektronische Sicherung mit Power-Line-Kommunikation über den Leistungsschalter

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
wobei die Steuervorrichtung (4) der elektronischen Sicherung (1, 825) dazu eingerichtet ist, mit einem anderen Rechnersystem (12) und/oder der Steuervorrichtung (4) einer anderen elektronischen Sicherung (805) über eine Versorgungsspannungsleitung (6, 241, 242, 245) Daten auszutauschen.

2. Elektronische Sicherung (1, 825) nach Merkmal 1,
wobei die Steuervorrichtung (4) der elektronischen Sicherung (1) dazu eingerichtet ist, den Leistungsschalter (17) der elektronischen Sicherung (1, 825) als Sendetransistor für die Datenkommunikation über das Versorgungsnetzwerk (200) zu verwenden.
3. Elektronische Sicherung (1, 825) nach Merkmal 2,
wobei die Steuervorrichtung (4) der elektronischen Sicherung (1) dazu eingerichtet ist, zur Übertragung eines Bits mit einem ersten logischen Wert über das Versorgungsnetzwerk (200) den Leistungsschalter (17) der elektronischen Sicherung (1, 825) zu öffnen.
4. Elektronische Sicherung (1, 825) nach Merkmal 2 oder 3,
wobei die Steuervorrichtung (4) der elektronischen Sicherung (1) dazu eingerichtet ist, zur Übertragung eines Bits mit einem zweiten logischen Wert, der vom ersten logischen Wert verschieden ist, über das Versorgungsnetzwerk (200) den Leistungsschalter (17) der elektronischen Sicherung (1, 825) zu schließen.

5. Elektronische Sicherung (1, 825) nach einem der Merkmale 2 bis 4,

wobei die Sicherung eine zweite Energiereserve umfasst und
wobei die zweite Energiereserve dazu eingerichtet ist, an dem zweiten Anschluss (19) der Sicherung für die Dauer der Übertragung eines Bits eines ersten logischen Werts über das Versorgungsnetzwerk (200) einen Strom in den zweiten Anschluss (19) der Sicherung (1) einzuspeisen, der anstelle des Stromes (29) durch den Leistungsschalter (17) nachfolgende Versorgungsteilnetze und/oder Verbraucher des Versorgungsnetzes (200) mit elektrischer Energie versorgt.

6. Elektronische Sicherung (1, 825) nach einem der Merkmale 2 bis 5,

wobei die Steuervorrichtung (4) der Sicherung (1) dazu eingerichtet ist, Stromwerte des Stromes (29) durch den Leistungsschalter (17) zu erfassen und/oder zu ermitteln und
wobei die Steuervorrichtung (4) der Sicherung (1) dazu eingerichtet ist, aus dem zeitlichen Verlauf der Stromwerte des Stromes (29) durch den Leistungsschalter (17) Daten zu extrahieren, die die Steuervorrichtung (4) einer anderen Sicherung (1) insbesondere mittels des Leistungsschalters (17) über das Versorgungsnetzwerk (200) sendet.

Elektronische Sicherung mit Schnellabschaltung des Leistungsschalters

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
wobei die elektronische Sicherung (1, 825) Mittel zur Erfassung des zeitlichen Verlaufs des elektrischen Stroms (29) durch den Leistungsschalter (17) der elektronischen Sicherung (1) umfasst und
wobei diese Mittel dazu eingerichtet sind, zumindest zeitweise den zeitlichen Verlauf des elektrischen Stroms (29) durch den Leistungsschalter (17) der elektronischen Sicherung (1,825) zu erfassen und
wobei diese Mittel einen Analog-zu-Digital-Wandler (570) der Steuervorrichtung (4) der elektronischen Sicherung (1, 825) und/oder einen Speicher des Rechnerkerns (2) der Steuervorrichtung (4) der elektronischen Sicherung (1,825) umfassen können.

2. Elektronische Sicherung (1, 825), insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die elektronische Sicherung (1, 825) Mittel zur Erfassung des zeitlichen Verlaufs der Spannung zwischen einem Anschluss (26, 27, 28) des Leistungsschalters (17) der elektronischen Sicherung (1, 825) und einem Bezugspotenzial (201) umfasst und

wobei diese Mittel dazu eingerichtet sind, zumindest zeitweise den zeitlichen Verlauf der Spannung zwischen einem Anschluss (26, 27, 28) des Leistungsschalters (17) der elektronischen Sicherung (1, 825) und einem Bezugspotenzial (201) zu erfassen.

3. Elektronischen Sicherung (1), insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die elektronische Sicherung (1, 825) Mittel zur Erfassung des zeitlichen Verlaufs der Spannung zwischen einem Anschluss (26, 27, 25) des Hilfsleistungsschalters (23) der elektronischen Sicherung (1, 825) und einem Bezugspotenzial (201) umfasst und

wobei diese Mittel dazu eingerichtet sind, zumindest zeitweise den zeitlichen Verlauf der Spannung zwischen einem Anschluss (26, 27, 25) des Hilfsleistungsschalters (23) der elektronischen Sicherung (1, 825) und einem Bezugspotenzial (201) zu erfassen.

4. Elektronischen Sicherung (1), insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die elektronische Sicherung (1, 825) Mittel zur Erfassung des zeitlichen Verlaufs der Spannung zwischen einem ersten Anschluss (25) eines Shunt-Widerstands (24) der elektronischen Sicherung (1, 825) und einem zweiten Anschluss (21) des Shunt-Widerstands (24) der elektronischen Sicherung (1, 825) umfasst und

wobei diese Mittel dazu eingerichtet sind, zumindest zeitweise den zeitlichen Verlauf der Spannung zwischen einem ersten Anschluss (25) eines Shunt-Widerstands (24) der elektronischen Sicherung (1, 825) und einem zweiten Anschluss (21) des Shunt-Widerstands (24) der elektronischen Sicherung (1, 825) zu erfassen.

5. Elektronischen Sicherung (1), insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Steuervorrichtung (4) der elektronischen Sicherung (1) dazu eingerichtet ist, eine Spektralanalyse der Daten der zeitlichen Verläufe, beispielsweise durch Fourier- oder Laplace-Transformation oder Wavelet-Transformation, durchzuführen und so Werte des Spektrums zu ermitteln und

wobei die Steuervorrichtung (4) der elektronischen Sicherung (1) dazu eingerichtet ist, bei wesentlichen Abweichungen der Werte dieses Spektrums von Erwartungswertintervallen auf die Notwenigkeit einer präventiven Wartung zu schließen und/oder eine Signalisierung an ein übergeordnetes Rechnersystem (12) vorzunehmen.

6. Elektronischen Sicherung (1), insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des

**208**

Leistungsschalters (28) zu ermitteln, und

wobei die elektronische Sicherung (1, 925) Mittel zur Erfassung des Werts des elektrischen Stroms (29) durch den Leistungsschalter (17) der elektronischen Sicherung (1, 825) und zur Erfassung einer Spannung an einem Anschluss (26, 27, 28) des Leistungsschalters (17) der elektronischen Sicherung (1, 825) gegen ein Bezugspotenzial (201) umfasst und

wobei die Steuervorrichtung (4) der elektronischen Sicherung (1, 825) dazu eingerichtet ist,

- bei einem Spannungsabfall in den gemessenen Spannungswerten und
- bei einem gleichzeitigen Stromanstieg

den Leistungsschalter (17) der elektronischen Sicherung (1, 825) auszuschalten, wenn a) der gemessene Spannungswert einen Spannungsschwellwert unterschreitet und wenn gleichzeitig der gemessene Strommesswert einen Stromschwellwert überschreitet und/oder

wenn b) der der Betrag der zeitlichen Änderungsgeschwindigkeit des gemessenen Spannungswertabfalls zwischen einem Anschluss (26, 27, 28) des Leistungsschalters 17 der Sicherung (1, 825) und einem Bezugspotenzial (201) eine Spannungsabfalländerungsgeschwindigkeitsschwelle überschreitet und gleichzeitig der Betrag der Änderungsgeschwindigkeit der Änderung des Betrags des elektrischen Stromes 29 durch den Leistungsschalter 17 eine Stromanstiegsgeschwindigkeitsschwelle überschreitet.

7. Elektronische Sicherung (1, 825) nach Merkmal 6,

wobei die Steuervorrichtung (4) der elektronischen Sicherung (1, 825) dazu eingerichtet ist, unter solchen Abschaltbedingungen schneller als innerhalb von 1μs den Leistungsschalter (17) der elektronischen Sicherung (1,825) auszuschalten.

Notlaufsteuerung einer ersten elektronischen Sicherung durch eine zweite elektronische Sicherung

1. Elektronischen Sicherung (1) eines Fahrzeugs, insbesondere nach einem oder mehreren der vorhergehenden Merkmale,

wobei die elektronische Sicherung (1) einen ersten Anschluss (18) aufweist und

wobei die elektronische Sicherung (1) einen zweiten Anschluss (19) aufweist und

wobei die elektronische Sicherung (1) einen Leistungsschalter (17) aufweist und

wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die elektronische Sicherung (1, 825) eine Notlaufsteuerung (925) umfasst und

wobei die Notlaufsteuerung (925) dazu eingerichtet ist, Daten über einen Datenbus (540, 9) zu senden und über diesen Datenbus (9, 540) zu empfangen, und

wobei die elektronischen Sicherung (1, 825) dazu eingerichtet ist, dass Steuervorrichtung (4) der elektronischen Sicherung (1, 825) eine weitere Steuervorrichtung (4) einer anderen elektronischen Sicherung (805) ist und/oder unter bestimmten Bedingungen sein kann, und

wobei die weitere Steuervorrichtung (4) der anderen elektronischen Sicherung (805) dazu eingerichtet ist, mittels einer Datenkommunikation über den Datenbus (9, 540) und mittels der Notlaufsteuerung (925) der elektronischen Sicherung (825) die elektronische Sicherung (825) zu steuern.

2. Elektronische Sicherung (1, 825) nach Merkmal 1,
wobei die Notlaufsteuerung (925) der Sicherung (825) dazu eingerichtet ist, die Datenkommunikation zwischen der Steuervorrichtung (4) der Sicherung (825) und der Notlaufsteuerung (925) der anderen Sicherung (805) zu überwachen, und

3. Elektronische Sicherung (1, 825) nach Merkmal 1 oder 2,
wobei die Notlaufsteuerung (925) der Sicherung (1, 825) dazu eingerichtet ist, im Falle eines Ausfalls der Datenkommunikation der Sicherung (1, 825) einfache Funktionen der Steuervorrichtung (4) der Sicherung (1, 825) zu emulieren und bevorzugt eine zumindest grundlegende Absicherung der angeschlossenen Versorgungsleitung (19, 815, 820) sicherzustellen, indem sie in diesem Fall die Steuerung des Leistungsschalters (17) der Sicherung (1, 825) übernimmt.

Elektronische Sicherung mit Übermittlung spezieller Daten

1. Elektronischen Sicherung (1) eines Fahrzeugs, insbesondere nach einem oder mehreren der vorhergehenden Merkmale,

  wobei die elektronische Sicherung (1) einen ersten Anschluss (18) aufweist und
  wobei die elektronische Sicherung (1) einen zweiten Anschluss (19) aufweist und
  wobei die elektronische Sicherung (1) einen Leistungsschalter (17) aufweist und
  wobei die elektronische Sicherung (1) eine Steuervorrichtung (4) aufweist und
  wobei der Leistungsschalter (17) einen ersten Anschluss (26), einen Steueranschluss (27) und einen zweiten Anschluss (28) aufweist und
  wobei der erste Anschluss (26) des Leistungsschalters (17) mit dem ersten Anschluss (18) der Sicherung (1) elektrisch verbunden ist und
  wobei der zweite Anschluss (28) des Leistungsschalters (17) mit dem zweiten Anschluss (19) der Sicherung (1) elektrisch verbunden ist und
  wobei der Steueranschluss (27) des Leistungsschalters (17) mit der Steuervorrichtung (4) elektrisch verbunden ist und
  wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
  wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
  wobei der Rechnerkern (2) der Steuervorrichtung (4) der elektronischen Sicherung (1,825) dazu eingerichtet ist, über einen Sicherungsdatenbus (9, 540) ein Signal an das übergeordnete Rechnersystem (12) zusenden, das signalisiert,

  - dass a) die entsprechende elektronische Sicherung (1, 825) noch vorhanden ist und/oder
  - dass b) die entsprechende elektronische Sicherung (1, 825) betriebsbereit ist und/oder
  - welche Sicherungsidentifikationsinformation die Sicherung (1,825) aufweist und/oder
  - welche gültige Sicherungsadresse die Sicherung (1,825) aufweist und/oder
  - ob die Sicherung (1,825) eine gültige Sicherungsadresse der Sicherung (1,825) aufweist und/oder
  - welche Schwellwerte die Sicherung (1,825) verwendet und/oder
  - welchen Strommesswert für den Strom (29) durch den Leistungstransistor (17) die Steuervorrichtung (4) der Sicherung (1, 825) ermittelt hat und/oder
  - welchen Strommesswert für den Strom (36) durch den Shunt-Widerstand (24) die Steuervorrichtung (4) der Sicherung (1, 825) ermittelt hat und/oder
  - welche Spannungswerte welcher Spannungen bezogen auf das Bezugspotenzial (201) und/oder andere Knoten innerhalb der Sicherung (1, 825) die Steuervorrichtung (4) der Sicherung (1, 825) ermittelt hat und/oder
  - welche Leistungsabgabe über den zweiten Anschluss (19) die Steuervorrichtung (4) der Sicherung (1, 825) ermittelt hat und/oder
  - welchen Temperaturwert die Steuervorrichtung (4) der Sicherung (1, 825) ermittelt hat und/oder

- welchen Zeitstempelwert ein ebenfalls übermittelter Wert die Steuervorrichtung (4) der Sicherung (1, 825) gespeichert hat und/oder
- welche sonstigen Betriebsparameter die elektronische Sicherung (1, 825) aufweist.

Elektronische Sicherung mit Quantenzufallszahlengenerator

1. Elektronische Sicherung (1, 825) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und
wobei der Steueranschluss (27) des Leistungsschalters (17) mit der Steuervorrichtung (4) elektrisch verbunden ist und
wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln und
wobei die Elektronische Sicherung (1, 825) einen Quantenzufallszahlengenerator (60, 4100) umfasst und
wobei der Quantenzufallszahlengenerator (60, 4100) folgende Vorrichtungteile umfasst:

eine erste SPAD-Diode (4104.1)
eine zweite SPAD-Diode (4104.3),
einen Lichtwellenleiter (4104.2), der die erste SPAD-Diode (4104.1) und die zweite SPAD-Diode (4104.3) optisch miteinander koppelt,
einen Verstärker (4103) und/oder Filter,
einen Analog-zu-Digital-Wandler (4103),
einen Komparator (4104.2),
einen Zeit-zu-Digital-Wandler (4104.3),
eine Entropie-Extraktionsvorrichtung (4104.4), die Ausgangswerte des Zeit-zu-Digital-Wandlers (4103) in erste und zweite Werte wandelt und daraus Zufallsbits (4111) erzeugt.

2. Elektronische Sicherung (1, 825) nach Merkmal 1,
wobei die elektronische Sicherung (1, 825) einen Watchdog (4104.5) umfasst, der dazu eingerichtet ist, Vorrichtungsteile des Quantenzufallszahlengenerators (60, 4100) zu überwachen.
3. Elektronische Sicherung (1, 825) nach Merkmal 1 oder 2,
wobei die elektronische Sicherung (1, 825) einen Spannungsmonitor (4113) aufweist, der dazu eingerichtet ist, analoge Werte analoger Signale zu erfassen und zu überwachen.
4. Elektronische Sicherung (1, 825) nach einem der Merkmale 1 bis 3,
wobei die Vorrichtung einen Pseudozufallszahlengenerator (4104.6), insbesondere in Form eines linear rückgekoppelten Schieberegisters (4104.6), umfasst.
5. Elektronische Sicherung (1, 825) nach einem der Merkmale 1 bis 4,
wobei die elektronische Sicherung (1, 825) einen Signalmultiplexer (4104.7) aufweist, der im Falle eines Fehlers von dem Signal des Ausgangs (4111) der Entropie-Extraktionsvorrichtung (4104.4) auf ein Signal eines Ersatz-Zufallszahlengenerators (60) oder ein Signal (4117) eines Ersatzpseudozufallszahlengenerators (4104.6) umschaltet.
6. Elektronische Sicherung (1, 825) nach einem der Merkmale 1 bis 5,
wobei der Startwert des Pseudozufallszahlengenerators (4104.6) im Fehlerfall von zuvor korrekt erzeugten Zufallsbits (4111) des Quantenzufallszahlengenerators (4100, 60) abhängt.

7. Elektronische Sicherung (1, 825), insbesondere nach einem oder mehreren der vorhergehenden Merkmale, die dazu eingerichtet ist, das folgende Verfahren zur Erzeugung eines Zufallsbits (4111) auszuführen:

Erzeugen einer Pulsfolge (4106) mit zufälligen zeitlichen Abständen mittels zumindest zweier SPAD-Dioden (3954, 3955, 4101.1, 4101.3),
wobei die Pulsfolge (4106) Pulse einer ersten Höhenkasse (4401) und einer zweiten Höhenklasse (4402) umfasst;
Trennen der Pulse der ersten Höhenklasse (4401) von den Pulsen der zweiten Höhenklasse (4402) mittels eines Schneidepegels (4403, 4104.1);
Erfassen (4301) ersten Werts (4110) des zeitlichen Abstands zwischen einem ersten Puls der zweiten Höhenklasse (4402) und einem zweiten Puls der zweiten Höhenklasse (4402), der vom ersten Puls verschieden ist;
Erfassen (4301) zweiten Werts (4110) des zeitlichen Abstands zwischen einem dritten Puls der zweiten Höhenklasse (4402), der vom ersten Puls verschieden ist, und einem vierten Puls der zweiten Höhenklasse (4402), der vom ersten Puls und vom zweiten Puls und vom dritten Puls verschieden ist.
Vergleichen (4302) des ersten Werts mit dem zweiten Wert und
Ausgeben (4303) eines ersten logischen Werts als ein Zufallsbit (4111), wenn der erste Wert größer als der zweite Wert ist, und
Ausgeben (4303) eines zweiten logischen Werts, der vom ersten logischen Wert verschieden ist, als das Zufallsbit (4111), wenn der erste Wert kleiner als der zweite Wert ist.

8. Übergeordnetes Rechnersystem (12) eines Versorgungsnetzwerks (200) mit elektronischen Sicherungen, insbesondere nach einem oder mehreren der vorhergehenden Merkmale, das dazu eingerichtet ist, das folgende Verfahren zur Erzeugung eines Zufallsbits (4111) auszuführen:

Erzeugen einer Pulsfolge (4106) mit zufälligen zeitlichen Abständen mittels zumindest zweier SPAD-Dioden (3954, 3955, 4101.1, 4101.3),
wobei die Pulsfolge (4106) Pulse einer ersten Höhenkasse (4401) und einer zweiten Höhenklasse (4402) umfasst;
Trennen der Pulse der ersten Höhenklasse (4401) von den Pulsen der zweiten Höhenklasse (4402) mittels eines Schneidepegels (4403, 4104.1);
Erfassen (4301) ersten Werts (4110) des zeitlichen Abstands zwischen einem ersten Puls der zweiten Höhenklasse (4402) und einem zweiten Puls der zweiten Höhenklasse (4402), der vom ersten Puls verschieden ist;
Erfassen (4301) zweiten Werts (4110) des zeitlichen Abstands zwischen einem dritten Puls der zweiten Höhenklasse (4402), der vom ersten Puls verschieden ist, und einem vierten Puls der zweiten Höhenklasse (4402), der vom ersten Puls und vom zweiten Puls und vom dritten Puls verschieden ist.
Vergleichen (4302) des ersten Werts mit dem zweiten Wert und
Ausgeben (4303) eines ersten logischen Werts als ein Zufallsbit (4111), wenn der erste Wert größer als der zweite Wert ist, und
Ausgeben (4303) eines zweiten logischen Werts, der vom ersten logischen Wert verschieden ist, als das Zufallsbit (4111), wenn der erste Wert kleiner als der zweite Wert ist.

Elektronische Sicherung mit Schlüsselerzeugung und Schlüsselaustausch

1. Elektronische Sicherung (1) eines Fahrzeugs, insbesondere nach einem oder mehreren der vorhergehenden Merkmale,

wobei die elektronische Sicherung (1) einen ersten Anschluss (18) aufweist und
wobei die elektronische Sicherung (1) einen zweiten Anschluss (19) aufweist und
wobei die elektronische Sicherung (1) einen Leistungsschalter (17) aufweist und
wobei die elektronische Sicherung (1) eine Steuervorrichtung (4) aufweist und
wobei der Leistungsschalter (17) einen ersten Anschluss (26), einen Steueranschluss (27) und einen zweiten Anschluss (28) aufweist und
wobei der erste Anschluss (26) des Leistungsschalters (17) mit dem ersten Anschluss (18) der Sicherung (1) elektrisch verbunden ist und
wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

wobei die Sicherung (1) und/oder die Steuervorrichtung (4) der Sicherung (1) einen Zufallszahlengenerator (60) umfasst.

2. Elektronische Sicherung (1, 825) nach Merkmal 1,
wobei der Zufallszahlengenerator (60) ein echter Zufallszahlengenerator (TRNG) ist.
3. Elektronische Sicherung (1, 825) nach Merkmal 2,
wobei der Zufallszahlengenerator (60) ein Quantenzufallszahlengenerator (QRNG) ist.
4. Elektronische Sicherung (1, 825) nach Merkmal 3,

wobei der Quantenzufallszahlengenerator (QRNG) (60) eine erste SPAD-Diode (3954, 4101.1) umfasst, die selbst wieder mehrere erste SPAD-Dioden (3954, 4101.1) umfassen kann, und

wobei der Quantenzufallszahlengenerator (QRNG) (60) eine zweite SPAD-Diode (3955, 4101.3) umfasst, die selbst wieder mehrere zweite SPAD-Dioden (3955, 4101.3) umfassen kann, und

wobei der Quantenzufallszahlengenerator (QRNG) (60) einen Lichtwellenleiter (3944, 4101.2) umfasst und

wobei die Spannungsversorgung (5) der Steuervorrichtung (4) der Sicherung (1, 825) dazu eingerichtet ist, die erste SPAD-Diode (3954, 4101.1) in Sperrrichtung mit einer Diodenvorspannung vorzuspannen, und

wobei die Spannungsversorgung (5) der Steuervorrichtung (4) der Sicherung (1, 825) dazu eingerichtet ist, die zweite SPAD-Diode (3955, 4101.3) in Sperrrichtung mit einer Diodenvorspannung vorzuspannen, und

wobei die erste SPAD-Diode (3954, 4101.1) die Eigenschaft aufweist, bei Vorspannung mit der Diodenvorspannung in Sperrrichtung zufällige Lichtpulse in den Lichtwellenleiter (3944, 4101.2) einzuspeisen, und

wobei der Lichtwellenleiter dazu eingerichtet ist, die zweite SPAD-Diode (3955, 4104.3) mit Licht dieser Lichtpulse zu bestrahlen, und

wobei die zweite SPAD-Diode (5955, 4104.3) die Eigenschaft aufweist, bei Vorspannung mit der Diodenvorspannung in Sperrrichtung einen Diodenstrom der zweiten SPAD-Diode in Form von Signalen der Strompulse (4105) zu erzeugen, die zum Ersten zufällige Strompulse einer ersten Strompulshöhe umfassen und die zum zweiten Strompulse einer zweiten Strompulshöhe umfassen, die auf dem Empfang von Photonen der Lichtpulse der zweiten SPAD-Diode (3955, 4101.3) beruhen, und

wobei die zweite Strompulshöhe betragsmäßig höher ist als die erste Strompulshöhe und

wobei weitere Vorrichtungteile (4102, 4103, 4104.2, 4104.1) des Quantenzufallszahlengenerator (QRNG) (60) dazu eingerichtet sind, die Signale der Strompulse (4105) mit der zweiten Strompulshöhe von den Signalen der Strompulse (4105) mit der ersten Strompulshöhe abzutrennen und ein bereinigtes Pulssignal (4109) erzeugen und

wobei weitere Vorrichtungsteile des Quantenzufallszahlengenerator (QRNG) (60) den Zeitabstand zwischen Pulspaaren von zwei aufeinanderfolgenden Pulsen des bereinigten Pulssignals erfassen und daraus jeweils Zeitabstandswerte erzeugen und

wobei weitere Vorrichtungsteile des Quantenzufallszahlengenerator (QRNG) (60) zwei unterschiedliche Zeitabstandswerte zweier unterschiedlicher Pulspaare, einen ersten Zeitabstandswert und einen zweiten Zeitabstandswert, miteinander vergleichen und ein Zufallsbit mit einem ersten logischen Wert erzeugen, wenn der erste Zeitabstandswert kleiner als der zweite Zeitabstandswert ist, und das Zufallsbit mit einem zweiten logischen Wert erzeugen, wenn der erste Zeitabstandswert größer als der zweite Zeitabstandswert ist, und

wobei weitere Vorrichtungsteile des Quantenzufallszahlengenerator (QRNG) (60) aus einer Mehrzahl dieser Zufallsbits eine Zufallszahl erzeugen.

4. Elektronische Sicherung (1, 825) nach Merkmal 3,
wobei Vorrichtungsteile des Quantenzufallszahlengenerator (QRNG) (60) dazu eingerichtet sind, Zeitabstandswerte, die kleiner als ein minimaler Zeitabstandswert sind, zu verwerfen und nicht weiterzuverwenden.
5. Elektronische Sicherung (1, 825) nach Merkmal 3 oder 4,

wobei die erste SPAD-Diode und die zweite SPAD-Diode in einem gemeinsamen Silizium-Kristall als Teil einer mikroelektronischen Schaltung in einer CMOS-Technologie gefertigt sind und

wobei der Lichtwellenleiter im Metallisierungsstapel mikroelektronischen Schaltung aus optisch transparenten Isolationsschichten auf der Oberfläche des Silizium-Kristalls gefertigt ist.

6. Elektronische Sicherung (1, 825) nach einem der Merkmale 1 bis 5,

wobei die Steuervorrichtung (4) der Sicherung (1,825) und/oder der Rechnerkern (2) der Steuervorrichtung (4) der Sicherung (1,825) dazu eingerichtet sind, unter Verwendung einer Zufallszahl des Zufallszahlengenerators (60) Daten für die Datenkommunikation über den Datenbus (9) zu verschlüsseln.

7. Elektronische Sicherung (1, 825) nach Merkmal 6,

wobei die Steuervorrichtung (4) der Sicherung (1,825) und/oder der Rechnerkern (2) der Steuervorrichtung (4) der Sicherung (1,825) dazu eingerichtet sind, unter Verwendung einer Zufallszahl des Zufallszahlengenerators (60) ein Schlüsselpaar aus einem privaten Schlüssel und einem öffentlichen Schlüssel zu erzeugen.

8. Elektronische Sicherung (1, 825) nach Merkmal 7,

wobei die Steuervorrichtung (4) der Sicherung (1,825) und/oder der Rechnerkern (2) der Steuervorrichtung (4) der Sicherung (1,825) dazu eingerichtet sind, den öffentlichen Schlüssel an eine Steuervorrichtung (4) einer anderen Sicherung (805) und/oder an einen Rechnerkern (2) einer Steuervorrichtung (4) einer anderen Sicherung (805) und/oder an ein übergeordnetes Rechnersystem (12) zu versenden.

9. Elektronische Sicherung (1, 825) nach Merkmal 8,

wobei die Steuervorrichtung (4) der Sicherung (1,825) und/oder der Rechnerkern (2) der Steuervorrichtung (4) der Sicherung (1,825) dazu eingerichtet sind, Datenbotschaften einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12), die die Steuervorrichtung (4) der Sicherung (1,825) und/oder der Rechnerkern (2) der Steuervorrichtung (4) der Sicherung (1,825) über den Datenbus (9) empfangen, mit Hilfe des privaten Schlüssels zu entschlüsseln.

10. Elektronische Sicherung (1, 825) nach einem der Merkmale 1 bis 9,

wobei die Steuervorrichtung (4) der Sicherung (1,825) und/oder der Rechnerkern (2) der Steuervorrichtung (4) der Sicherung (1,825) dazu eingerichtet sind, einen öffentlichen Schlüssel einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12) zu empfangen.

9. Elektronische Sicherung (1, 825) nach einem der Merkmale 1 bis 8,

wobei die Steuervorrichtung (4) der Sicherung (1,825) und/oder der Rechnerkern (2) der Steuervorrichtung (4) der Sicherung (1,825) dazu eingerichtet sind, mittels eines Diffie-Hellman-Schlüsselaustauschverfahrens öffentliche Schlüssel mit einer anderen Sicherung (805) und/oder mit einem Rechnerkern (2) einer Steuervorrichtung (4) einer anderen Sicherung (805) und/oder mit einem übergeordneten Rechnersystem (12) auszutauschen.

10. Elektronische Sicherung (1, 825) nach Merkmal 9,

wobei die Steuervorrichtung (4) der Sicherung (1,825) und/oder der Rechnerkern (2) der Steuervorrichtung (4) der Sicherung (1,825) dazu eingerichtet sind, Datenbotschaften einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12), die die Steuervorrichtung (4) der Sicherung (1,825) und/oder der Rechnerkern (2) der Steuervorrichtung (4) der Sicherung (1,825) über den Datenbus (9) empfangen, mit Hilfe des privaten Schlüssels des Diffie-Hellman-Schlüsselaustauschverfahrens zu entschlüsseln.

11. Elektronische Sicherung (1, 825) nach einem der Merkmale 8 bis 10,

wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eines empfangenen öffentlichen Schlüssels zu verschlüsselten Datenbotschaften zu verschlüsseln.

12. Elektronische Sicherung (1, 825) nach Merkmal 11,

wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eine PQC-Verschlüsselungsverfahrens und/oder mittels eines RSA-Verfahrens zu verschlüsselten Datenbotschaften zu verschlüsseln.

13. Elektronische Sicherung (1, 825) nach Merkmal 12,

wobei die Steuervorrichtung (4) der Sicherung (1, 825) und/oder der Rechnerkern (2) der Steuervorrichtung (4) der Sicherung (1, 825) dazu eingerichtet sind, solche verschlüsselte Datenbotschaften an eine Steuervorrichtung (4) einer anderen Sicherung (805) und/oder einen Rechnerkern (2) einer Steuervorrichtung (4) einer anderen Sicherung (805) und/oder eine übergeordnetes Rechnersystem (12) über den Datenbus (9) zu senden.

Elektronische Sicherung mit PQC Verschlüsselung

1. Elektronische Sicherung (1) eines Fahrzeugs, insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und
> wobei der Leistungsschalter (17) einen ersten Anschluss (26), einen Steueranschluss (27) und einen zweiten Anschluss (28) aufweist und
> wobei der erste Anschluss (26) des Leistungsschalters (17) mit dem ersten Anschluss (18) der Sicherung (1) elektrisch verbunden ist und
> wobei der zweite Anschluss (28) des Leistungsschalters (17) mit dem zweiten Anschluss (19) der Sicherung (1) elektrisch verbunden ist und
> wobei der Steueranschluss (27) des Leistungsschalters (17) mit der Steuervorrichtung (4) elektrisch verbunden ist und
> wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
> wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
> wobei die Steuervorrichtung (4) der Sicherung (1,825) und/oder der Rechnerkern (2) der Steuervorrichtung (4) der Sicherung (1,825) dazu eingerichtet sind, unter Verwendung einer Zufallszahl Daten für die Datenkommunikation über den Datenbus (9) zu verschlüsseln.

2. Elektronische Sicherung (1, 825) nach Merkmal 1,
wobei die Steuervorrichtung (4) der Sicherung (1,825) und/oder der Rechnerkern (2) der Steuervorrichtung (4) der Sicherung (1,825) dazu eingerichtet sind, unter Verwendung der Zufallszahl ein Schlüsselpaar aus einem privaten Schlüssel und einem öffentlichen Schlüssel zu erzeugen.

3. Elektronische Sicherung (1, 825) nach Merkmal 2,
wobei die Steuervorrichtung (4) der Sicherung (1,825) und/oder der Rechnerkern (2) der Steuervorrichtung (4) der Sicherung (1,825) dazu eingerichtet sind, den öffentlichen Schlüssel an eine Steuervorrichtung (4) einer anderen Sicherung (805) und/oder an einen Rechnerkern (2) einer Steuervorrichtung (4) einer anderen Sicherung (805) und/oder an ein übergeordnetes Rechnersystem (12) zu versenden.

4. Elektronische Sicherung (1, 825) nach Merkmal 3,
wobei die Steuervorrichtung (4) der Sicherung (1,825) und/oder der Rechnerkern (2) der Steuervorrichtung (4) der Sicherung (1,825) dazu eingerichtet sind, Datenbotschaften einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12), die die Steuervorrichtung (4) der Sicherung (1,825) und/oder der Rechnerkern (2) der Steuervorrichtung (4) der Sicherung (1,825) über den Datenbus (9) empfangen, mit Hilfe des privaten Schlüssels zu entschlüsseln.

5. Elektronische Sicherung (1, 825) nach einem der Merkmale 1 bis 4,
wobei die Steuervorrichtung (4) der Sicherung (1,825) und/oder der Rechnerkern (2) der Steuervorrichtung (4) der Sicherung (1,825) dazu eingerichtet sind, einen öffentlichen Schlüssel einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12) zu empfangen.

6. Elektronische Sicherung (1, 825) nach einem der Merkmale 1 bis 5,
wobei die Steuervorrichtung (4) der Sicherung (1,825) und/oder der Rechnerkern (2) der Steuervorrichtung (4) der Sicherung (1,825) dazu eingerichtet sind, mittels eines Diffie-Hellman-Schlüsselaustauschverfahrens öffentliche Schlüssel mit einer anderen Sicherung (805) und/oder mit einem Rechnerkern (2) einer Steuervorrichtung (4) einer anderen Sicherung (805) und/oder mit einem übergeordneten Rechnersystem (12) auszutauschen.

7. Elektronische Sicherung (1, 825) nach Merkmal 6,

wobei die Steuervorrichtung (4) der Sicherung (1,825) und/oder der Rechnerkern (2) der Steuervorrichtung (4) der Sicherung (1,825) dazu eingerichtet sind, Datenbotschaften einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12), die die Steuervorrichtung (4) der Sicherung (1,825) und/oder der Rechnerkern (2) der Steuervorrichtung (4) der Sicherung (1,825) über den Datenbus (9) empfangen, mit Hilfe des privaten Schlüssels des Diffie-Hellman-Schlüsselaustauschverfahrens zu entschlüsseln.

8. Elektronische Sicherung (1, 825) nach einem der Merkmale 5 bis 7,

wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eines empfangenen öffentlichen Schlüssels zu verschlüsselten Datenbotschaften zu verschlüsseln.

9. Elektronische Sicherung (1, 825) nach Merkmal 8,

wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eine PQC-Verschlüsselungsverfahrens und/oder mittels eines RSA-Verfahrens zu verschlüsselten Datenbotschaften zu verschlüsseln.

10. Elektronische Sicherung (1, 825) nach Merkmal 9,

wobei die Steuervorrichtung (4) der Sicherung (1, 825) und/oder der Rechnerkern (2) der Steuervorrichtung (4) der Sicherung (1, 825) dazu eingerichtet sind, solche verschlüsselte Datenbotschaften an eine Steuervorrichtung (4) einer anderen Sicherung (805) und/oder einen Rechnerkern (2) einer Steuervorrichtung (4) einer anderen Sicherung (805) und/oder eine übergeordnetes Rechnersystem (12) über den Datenbus (9) zu senden.

Elektronische Sicherung, die einen öffentlichen Schlüssel empfängt

1. Elektronische Sicherung (1) eines Fahrzeugs, insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und
> wobei der Leistungsschalter (17) einen ersten Anschluss (26), einen Steueranschluss (27) und einen zweiten Anschluss (28) aufweist und
> wobei der erste Anschluss (26) des Leistungsschalters (17) mit dem ersten Anschluss (18) der Sicherung (1) elektrisch verbunden ist und
> wobei der zweite Anschluss (28) des Leistungsschalters (17) mit dem zweiten Anschluss (19) der Sicherung (1) elektrisch verbunden ist und
> wobei der Steueranschluss (27) des Leistungsschalters (17) mit der Steuervorrichtung (4) elektrisch verbunden ist und
> wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und
> wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und
> wobei die Steuervorrichtung (4) der Sicherung (1,825) und/oder der Rechnerkern (2) der Steuervorrichtung (4) der Sicherung (1,825) dazu eingerichtet sind, einen öffentlichen Schlüssel einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12) zu empfangen.

2. Elektronischen Sicherung (1), insbesondere nach einem oder mehreren der vorhergehenden Merkmale,

> wobei die elektronische Sicherung (1) einen ersten Anschluss (18) aufweist und
> wobei die elektronische Sicherung (1) einen zweiten Anschluss (19) aufweist und
> wobei die elektronische Sicherung (1) einen Leistungsschalter (17) aufweist und
> wobei die elektronische Sicherung (1) eine Steuervorrichtung (4) aufweist und

wobei der Leistungsschalter (17) einen ersten Anschluss (26), einen Steueranschluss (27) und einen zweiten Anschluss (28) aufweist und

wobei der erste Anschluss (26) des Leistungsschalters (17) mit dem ersten Anschluss (18) der Sicherung (1) elektrisch verbunden ist und

wobei der zweite Anschluss (28) des Leistungsschalters (17) mit dem zweiten Anschluss (19) der Sicherung (1) elektrisch verbunden ist und

wobei der Steueranschluss (27) des Leistungsschalters (17) mit der Steuervorrichtung (4) elektrisch verbunden ist und

wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln, und

wobei die Sicherung (1) über eine Datenschnittstelle (10, 610, 551) mit einem übergeordneten Rechnersystem (12) und ggf. mit einer oder mehreren weiteren elektronischen Sicherungen (1, 214 bis 217, 225 bis 223, 230 bis 235, 225 bis 256) verbunden ist und

wobei die Steuervorrichtung (4) der Sicherung (1,825) und/oder der Rechnerkern (2) der Steuervorrichtung (4) der Sicherung (1,825) dazu eingerichtet sind, mittels eines Diffie-Hellman-Schlüsselaustauschverfahrens öffentliche Schlüssel mit einer anderen Sicherung (805) und/oder mit einem Rechnerkern (2) einer Steuervorrichtung (4) einer anderen Sicherung (805) und/oder mit einem übergeordneten Rechnersystem (12) auszutauschen.

3. Elektronische Sicherung (1, 825) nach Merkmal 2,
wobei die Steuervorrichtung (4) der Sicherung (1,825) und/oder der Rechnerkern (2) der Steuervorrichtung (4) der Sicherung (1,825) dazu eingerichtet sind, Datenbotschaften einer Steuervorrichtung (4) einer anderen Sicherung (805) und/oder eines Rechnerkerns (2) einer Steuervorrichtung (4) einer anderen Sicherung (805) und/oder eines übergeordnetes Rechnersystems (12), die die Steuervorrichtung (4) der Sicherung (1,825) und/oder der Rechnerkern (2) der Steuervorrichtung (4) der Sicherung (1,825) über den Datenbus (9) empfangen, mit Hilfe des privaten Schlüssels des Diffie-Hellman-Schlüsselaustauschverfahrens zu entschlüsseln.

3. Elektronische Sicherung (1, 825) nach einem der Merkmale 1 bis 3,
wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eines empfangenen öffentlichen Schlüssels zu verschlüsselten Datenbotschaften zu verschlüsseln.

4. Elektronische Sicherung (1, 825) nach Merkmal 3,
wobei die Steuervorrichtung (4) der Sicherung (1,825) und/oder der Rechnerkern (2) der Steuervorrichtung (4) der Sicherung (1,825) dazu eingerichtet sind, Datenbotschaften mittels eine PQC-Verschlüsselungsverfahrens und/oder mittels eines RSA-Verfahrens zu verschlüsselten Datenbotschaften zu verschlüsseln.

5. Elektronische Sicherung (1, 825) nach Merkmal 4,
wobei die Steuervorrichtung (4) der Sicherung (1, 825) und/oder der Rechnerkern (2) der Steuervorrichtung (4) der Sicherung (1, 825) dazu eingerichtet sind, solche verschlüsselte Datenbotschaften an eine Steuervorrichtung (4) einer anderen Sicherung (805) und/oder einen Rechnerkern (2) einer Steuervorrichtung (4) einer anderen Sicherung (805) und/oder eine übergeordnetes Rechnersystem (12) über den Datenbus (9) zu senden.

<u>Kreuzungssicherung und zugehöriges Versorgungsnetzwerk</u>

1. Energieseitige Kreuzungssicherung (1000) eines Fahrzeugs, insbesondere nach einem oder mehreren der vorhergehenden Merkmale,

wobei die Kreuzungssicherung (1000) einen energiequellenseitigen ersten Versorgungsleitungsabschnitt (1005) einer ersten Versorgungsleitung umfasst und

wobei die Kreuzungssicherung (1000) einen verbraucherseitigen zweiten Versorgungsleitungsabschnitt (1010) einer ersten Versorgungsleitung umfasst und

wobei die Kreuzungssicherung (1000) einen energiequellenseitigen ersten Versorgungsleitungsabschnitt (1015) einer zweiten Versorgungsleitung umfasst und

wobei die Kreuzungssicherung (1000) einen verbraucherseitigen zweiten Versorgungsleitungsabschnitt (1020) einer zweiten Versorgungsleitung umfasst und

wobei die Kreuzungssicherung (1000) einen ersten elektrischen Knoten (1025) umfasst und

wobei die Kreuzungssicherung (1000) einen zweiten elektrischen Knoten (1030) umfasst und

wobei die Kreuzungssicherung (1000) eine erste elektronische Sicherung (1035) umfasst und

wobei die Kreuzungssicherung (1000) eine zweite elektronische Sicherung (1040) umfasst und

wobei die Kreuzungssicherung (1000) eine dritte elektronische Sicherung (1045) umfasst und

wobei die Kreuzungssicherung (1000) eine vierte elektronische Sicherung (1050) umfasst und

wobei die erste elektronische Sicherung (1035) dazu eingerichtet ist, je nach Schaltzustand des Leistungsschalters (17) der ersten elektronischen Sicherung (1035) den energiequellenseitigen ersten Versorgungsleitungsabschnitt (1005) der ersten Versorgungsleitung mit dem ersten Knoten (1025) zu verbinden oder den energiequellenseitigen ersten Versorgungsleitungsabschnitt (1005) der ersten Versorgungsleitung von dem ersten Knoten (1025) zu trennen, und

wobei die zweite elektronische Sicherung (1040) dazu eingerichtet ist, je nach Schaltzustand des Leistungsschalters (17) der zweiten elektronischen Sicherung (1040) den energiequellenseitigen ersten Versorgungsleitungsabschnitt (1015) der zweiten Versorgungsleitung mit dem ersten Knoten (1025) zu verbinden oder den energiequellenseitigen ersten Versorgungsleitungsabschnitt (1015) der zweiten Versorgungsleitung von dem ersten Knoten (1025) zu trennen, und

wobei die zweite elektronische Sicherung (1040) dazu eingerichtet ist, den energiequellenseitigen ersten Versorgungsleitungsabschnitt (1015) der zweiten Versorgungsleitung nicht mit dem ersten Knoten (1025) zu verbinden, wenn die erste elektronische Sicherung (1035) den energiequellenseitigen ersten Versorgungsleitungsabschnitt (1005) der ersten Versorgungsleitung mit dem ersten Knoten (1025) verbindet, und

wobei die erste elektronische Sicherung (1035) dazu eingerichtet ist, den energiequellenseitigen ersten Versorgungsleitungsabschnitt (1005) der ersten Versorgungsleitung nicht mit dem ersten Knoten (1025) zu verbinden, wenn die zweite elektronische Sicherung (1040) den energiequellenseitigen ersten Versorgungsleitungsabschnitt (1015) der zweiten Versorgungsleitung mit dem ersten Knoten (1025) verbindet, und

wobei die dritte elektronische Sicherung (1045) dazu eingerichtet ist, je nach Schaltzustand des Leistungsschalters (17) der dritten elektronischen Sicherung (1045) den energiequellenseitigen ersten Versorgungsleitungsabschnitt (1005) der ersten Versorgungsleitung mit dem zweiten Knoten (1030) zu verbinden oder den energiequellenseitigen ersten Versorgungsleitungsabschnitt (1005) der ersten Versorgungsleitung von dem zweiten Knoten (1030) zu trennen, und

wobei die vierte elektronische Sicherung (1050) dazu eingerichtet ist, je nach Schaltzustand des Leistungsschalters (17) der vierten elektronischen Sicherung (1050) den energiequellenseitigen ersten Versorgungsleitungsabschnitt (1015) der zweiten Versorgungsleitung mit dem zweiten Knoten (1030) zu verbinden, oder den energiequellenseitigen ersten Versorgungsleitungsabschnitt (1030) der zweiten Versorgungsleitung von dem zweiten Knoten (1030) zu trennen, und

wobei die vierte elektronische Sicherung (1050) dazu eingerichtet ist, den energiequellenseitigen ersten Versorgungsleitungsabschnitt (1015) der zweiten Versorgungsleitung nicht mit dem zweiten Knoten (1030) zu verbinden, wenn die dritte elektronische Sicherung (1045) den energiequellenseitigen ersten Versorgungsleitungsabschnitt (1005) der ersten Versorgungsleitung mit dem zweiten Knoten verbindet, und

wobei die dritte elektronische Sicherung (1045) dazu eingerichtet ist, den energiequellenseitigen ersten Versorgungsleitungsabschnitt der ersten Versorgungsleitung nicht mit dem zweiten Knoten (1030) zu verbinden, wenn die vierte elektronische Sicherung (1050) den energiequellenseitigen ersten Versorgungsleitungsabschnitt (1015) der zweiten Versorgungsleitung mit dem zweiten Knoten (1030) verbindet, und

wobei der verbraucherseitige zweite Versorgungsleitungsabschnitt (1055) der ersten Versorgungsleitung mit dem ersten Knoten (1025) verbunden ist und

wobei der verbraucherseitige zweite Versorgungsleitungsabschnitt (1060) der zweiten Versorgungsleitung mit dem zweiten Knoten (1030) verbunden ist.

2. Verbraucherseitige Kreuzungssicherung (1000) eines Fahrzeugs, insbesondere nach einem oder mehreren der vorhergehenden Merkmale,

wobei die Kreuzungssicherung (1000) einen energiequellenseitigen ersten Versorgungsleitungsabschnitt (1005) einer ersten Versorgungsleitung umfasst und

wobei die Kreuzungssicherung (1000) einen verbraucherseitigen zweiten Versorgungsleitungsabschnitt (1015) einer ersten Versorgungsleitung umfasst und

wobei die Kreuzungssicherung (1000) einen energiequellenseitigen ersten Versorgungsleitungsabschnitt (1055) einer zweiten Versorgungsleitung umfasst und

wobei die Kreuzungssicherung (1000) einen verbraucherseitigen zweiten Versorgungsleitungsabschnitt (1060) einer zweiten Versorgungsleitung umfasst und

wobei die Kreuzungssicherung (1000) einen dritten elektrischen Knoten (1065) umfasst und

wobei die Kreuzungssicherung (1000) einen vierten elektrischen Knoten (1070) umfasst und

wobei die Kreuzungssicherung (1000) eine erste elektronische Sicherung (1035) umfasst und

wobei die Kreuzungssicherung (1000) eine zweite elektronische Sicherung (1040) umfasst und

wobei die Kreuzungssicherung (1000) eine dritte elektronische Sicherung (1045) umfasst und

wobei die Kreuzungssicherung (1000) eine vierte elektronische Sicherung (1050) umfasst und

wobei die erste elektronische Sicherung (1035) dazu eingerichtet ist, je nach Schaltzustand des Leistungsschalters (17) der ersten elektronischen Sicherung (1035) den verbraucherseitigen zweiten Versorgungsleitungsabschnitt (1055) der ersten Versorgungsleitung mit dem dritten Knoten (1065) zu verbinden oder den verbraucherseitigen zweiten Versorgungsleitungsabschnitt (1055) der ersten Versorgungsleitung von dem dritten Knoten (1065) zu trennen, und

wobei die zweite elektronische Sicherung (1040) dazu eingerichtet ist, je nach Schaltzustand des Leistungsschalters (17) der zweiten elektronischen Sicherung (1040) den verbraucherseitigen zweiten Versorgungsleitungsabschnitt (1055) der ersten Versorgungsleitung mit dem vierten Knoten (1070) zu verbinden oder den verbraucherseitigen zweiten Versorgungsleitungsabschnitt (1055) der ersten Versorgungsleitung (1055) von dem vierten Knoten (1070) zu trennen, und

wobei die zweite elektronische Sicherung (1040) dazu eingerichtet ist, den verbraucherseitigen zweiten Versorgungsleitungsabschnitt (1055) der ersten Versorgungsleitung nicht mit vierten Knoten (1070) zu verbinden, wenn die erste elektronische Sicherung (1035) den verbraucherseitigen zweiten Versorgungsleitungsabschnitt (1055) der ersten Versorgungsleitung mit dem dritten Knoten (1065) verbindet, und

wobei die erste elektronische Sicherung (1035) dazu eingerichtet ist, den verbraucherseitigen zweiten Versorgungsleitungsabschnitt (1055) der ersten Versorgungsleitung nicht mit dem dritten Knoten (1055) zu verbinden, wenn die zweite elektronische Sicherung (1040) den verbraucherseitigen zweiten Versorgungsleitungsabschnitt der ersten Versorgungsleitung (1055) mit dem vierten Knoten (1070) verbindet, und

wobei die dritte elektronische Sicherung (1045) dazu eingerichtet ist, je nach Schaltzustand des Leistungsschalters (17) der dritten elektronischen Sicherung (1045) den verbraucherseitigen zweiten Versorgungsleitungsabschnitt (1060) der zweiten Versorgungsleitung mit dem dritten Knoten (1065) zu verbinden oder den verbraucherseitigen zweiten Versorgungsleitungsabschnitt (1060) der zweiten Versorgungsleitung von dem dritten Knoten (1065) zu trennen, und

wobei die vierte elektronische Sicherung (1050) dazu eingerichtet ist, je nach Schaltzustand des Leistungsschalters (17) der vierten elektronischen Sicherung (1050) den verbraucherseitigen zweiten Versorgungsleitungsabschnitt der zweiten Versorgungsleitung (1060) mit dem vierten Knoten (1070) zu verbinden oder den verbraucherseitigen zweiten Versorgungsleitungsabschnitt (1060) der zweiten Versorgungsleitung von dem vierten Knoten (1070) zu trennen, und

wobei die vierte elektronische Sicherung (1050) dazu eingerichtet ist, den verbraucherseitigen zweiten Versorgungsleitungsabschnitt (1060) der zweiten Versorgungsleitung nicht mit dem vierten Knoten (1070) zu verbinden, wenn die dritte elektronische Sicherung (1045) den verbraucherseitigen zweiten Versorgungsleitungsabschnitt (1060) der zweiten Versorgungsleitung mit dem dritten Knoten (1065) verbindet, und

wobei die dritte elektronische Sicherung (1045) dazu eingerichtet ist, den verbraucherseitigen zweiten Versorgungsleitungsabschnitt (1060) der zweiten Versorgungsleitung nicht mit dem dritten Knoten (1065) zu verbinden, wenn die vierte elektronische Sicherung (1050) den verbraucherseitigen zweiten Versorgungsleitungsabschnitt (1060) der zweiten Versorgungsleitung mit dem vierten Knoten (1070) verbindet, und

wobei der energiequellenseitige erste Versorgungsleitungsabschnitt (1005) der ersten Versorgungsleitung mit dem dritten Knoten (1065) verbunden ist und

wobei der energiequellenseitige erste Versorgungsleitungsabschnitt (1015) der zweiten Versorgungsleitung mit dem vierten Knoten (1070) verbunden ist.

3. Kreuzungssicherung (1000) nach Merkmal 1 oder 2

wobei der Schaltzustand der Leistungsschalter (17) der elektronischen Sicherungen (1035, 1040, 1045, 1050) der Kreuzungssicherung (1000)
von einem ermittelten Energiebedarf von einem oder mehreren Verbrauchern (830, 835) und/oder
von einer ermittelten Energielieferfähigkeit von einer oder mehrerer Energiequellen (250, 251) abhängt.

4. Kreuzungssicherung (1000) nach Merkmal 3,

wobei die Steuervorrichtungen (4) der elektronischen Sicherungen (1035, 1040, 1045, 1050) der Kreuzungssicherung (1000) über einen Sicherungsdatenbus (9) mit einem übergeordneten Rechnersystem (12) und/oder untereinander verbunden sind und

wobei das übergeordnete Rechnersystem (12) dazu eingerichtet ist, den Energiebedarf von einem oder mehreren Verbrauchern (835, 830) zu ermitteln, die über die Versorgungsleitungen (1005, 1010. 1015, 1020, 1055, 1060) der Kreuzungssicherung (1000) mit elektrischer Energie versorgt werden können, und/oder

wobei das übergeordnete Rechnersystem (12) dazu eingerichtet ist, die Energielieferfähigkeit von einer oder mehreren Energiequellen (250, 251) zu ermitteln,

die über die Versorgungsleitungen (1005, 1010. 1015, 1020, 1055, 1060) der Kreuzungssicherung (1000) elektrische Energie liefern können, und

wobei das übergeordnete Rechnersystem (12) dazu eingerichtet ist, den Steuervorrichtungen (4) der Sicherungen (1035, 1040, 1045, 1050) der Kreuzungssicherung (1000) Konfigurationsbefehle über den Sicherungsdatenbus (9) zu übermitteln, die von dem ermittelten Energiebedarf dieser Verbraucher (830, 831) abhängen und/oder die von der ermittelten Energielieferfähigkeit dieser Energiequellen (250, 251) abhängen, und

wobei diese Konfigurationsbefehle das Öffnen und Schließen von Leistungsschaltern (17) der elektronischen Sicherungen (1035, 1040, 1045, 1050) der Kreuzungssicherung (1000) bewirken.

5. Versorgungsnetzwerk (1100), insbesondere nach einem oder mehreren der vorhergehenden Merkmale,

mit einem übergeordneten Rechnersystem (12) und
mit einer Vielzahl von Versorgungsleitungen und
mit einer Mehrzahl von Kreuzungssicherungen (1110 bis 1118),
wobei die Kreuzungssicherungen (1110 bis 1118) in Versorgungsleitungen des Versorgungsnetzwerks (1100) eingefügt sind und
wobei das übergeordnete Rechnersystem (12) mittels eines Sicherungsdatenbus (9) mit Steuervorrichtungen (4) der elektronischen Sicherungen der Kreuzsicherungen (1110 bis 1118) verbunden ist und
wobei die elektronischen Sicherungen der Kreuzsicherungen (1110 bis 1118) Steuervorrichtungen (4) aufweisen und
wobei elektronischen Sicherungen (4) einer jeweiligen Kreuzsicherung (1110 bis 1118) auch eine gemeinsame Steuervorrichtung (4) gemeinsam aufweisen können und
wobei das übergeordnete Rechnersystem (12) dazu eingerichtet ist, den Energiebedarf von elektrischen Energieverbrauchern (1121 bis 1124) in dem Versorgungsnetzwerk (1100) zu ermitteln, und/oder
wobei das übergeordnete Rechnersystem (12) dazu eingerichtet ist, die Energielieferfähigkeit von elektrischen Energiequellen (1150 bis 1155) in dem Versorgungsnetzwerk (1100) zu ermitteln, und/oder
wobei das übergeordnete Rechnersystem (12) dazu eingerichtet ist, den aktuellen Sicherheitsbedarf insbesondere aufgrund der aktuellen Fahrsituation und/oder des aktuellen Betriebszustands des Fahrzeugs und/oder Eigenschaften der Umgebung des Fahrzeugs zu ermitteln und
wobei das Rechnersystem (12) dazu eingerichtet ist, mittels Konfigurationsbefehlen über den Sicherungsdatenbus (9) an die Kreuzungssicherungen (1110 bis 1118) die elektrisch wirksame Topologie des Versorgungsnetzes der Versorgungsleitungen dynamisch entsprechend dem ermittelten Energiebedarf und/oder entsprechend der ermittelten Energielieferfähigkeit und/oder entsprechend den aktuellen Sicherheitsbedarf insbesondere aufgrund der aktuellen Fahrsituation und/oder des aktuellen Betriebszustands des Fahrzeugs und/oder Eigenschaften der Umgebung des Fahrzeugs anzupassen.

Flag gesteuerte elektronische Sicherung für einen Energieverbraucher

1. Verfahren (1200) zum Betreiben eines Versorgungsnetzwerkes eines Fahrzeugs, insbesondere nach einem oder mehreren der vorhergehenden Merkmale,mit den Schritten Bereitstellen (1210) eines Versorgungsnetzwerks (250, 251, 210 bis 213, 245) mit einem Vorrichtungsteil des Fahrzeugs, im Folgenden als energieversorgender Vorrichtungsteil (210) bezeichnet,

wobei der energieversorgende Versorgungsteil (210) eine Steuervorrichtung (280, 4) umfasst und
wobei der energieversorgende Versorgungsteil (210) einen Speicher in einem ersten logischen Zustand umfasst;
Versorgen (1220) des energieversorgenden Vorrichtungsteils (210) mit elektrischer Energie aus einer Energiequelle (251, 250) des Fahrzeugs;
Verbinden (1230) eines ersten Anschlusses eines weiteren Leitungsabschnitts (240) mit dem energieversorgenden Vorrichtungsteil (210) des Fahrzeugs;
Verbinden (1240) eines zweiten Anschlusses des weiteren Leitungsabschnitts (240) mit einem weiteren Vorrichtungsteil (220, 221) des Fahrzeugs;

Signalisierung (1250) eines Einschaltsignals an die Steuervorrichtung (280, 4) des energieversorgenden Vorrichtungsteils (210);
Ändern (1260) des logischen Zustands des Speichers in einen zweiten logischen Zustand in Abhängigkeit von dem logischen Zustand des Speichers;
Versorgen (1270) des Weiteren Vorrichtungsteils (220 bis 221) des Fahrzeugs mit elektrischer Energie über den weiteren Leitungsabschnitt (240) in Abhängigkeit von dem logischen Zustand des Speichers.

2. Verfahren nach Merkmal 1,
wobei die Signalisierung (1250) des Einschaltsignals über einen Sicherungsdatenbus (9) erfolgt.
3. Verfahren nach Merkmal 1 oder 2,

wobei der energieversorgende Vorrichtungsteil (210) eine elektronische Sicherung (215) des energieversorgenden Vorrichtungsteils (250, 251) aufweist und
wobei das Versorgen (1270) des Weiteren Vorrichtungsteils (220, 221) des Fahrzeugs mit elektrischer Energie über den weiteren Leitungsabschnitt (240) mittels des Einschaltens der elektronischen Sicherung (215) des energieversorgenden Vorrichtungsteils (210) in Abhängigkeit von dem logischen Zustand des Speichers erfolgt.

Flag gesteuerte elektronische Sicherung für eine Energiequelle

1. Verfahren zum Betreiben eines Versorgungsnetzwerkes (200) eines Fahrzeugs, insbesondere nach einem oder mehreren der vorhergehenden Merkmale, mit den Schritten

Bereitstellen (1210) eines Versorgungsnetzwerks (200) mit einem Vorrichtungsteil (210) des Fahrzeugs, im Folgenden als energieversorgender Vorrichtungsteil (210) bezeichnet, und
Versorgen (1220) des energieversorgenden Vorrichtungsteils (210) mit elektrischer Energie aus einer Energiequelle (250, 251) des Fahrzeugs;
Verbinden (1230) eines ersten Anschlusses eines weiteren Leitungsabschnitts (240) mit dem energieversorgenden Vorrichtungsteil (210) des Fahrzeugs;
Verbinden (1240) eines zweiten Anschlusses eines weiteren Leitungsabschnitts (240) mit einem weiteren Vorrichtungsteil (220 bis 221) des Fahrzeugs,
wobei der weitere Versorgungsteil (220 bis 221) eine Steuervorrichtung (280, 4) umfasst und
wobei der weitere Versorgungsteil (220 bis 221) einen Speicher in einem ersten logischen Zustand umfasst;
Signalisierung (1250) eines Einschaltsignal an die Steuervorrichtung (280, 4) des Weiteren Vorrichtungsteils (220 bis 221);
Ändern (1260) des logischen Zustands des Speichers in einen zweiten logischen Zustand in Abhängigkeit von dem logischen Zustand des Speichers;
Versorgen (1270) des Weiteren Vorrichtungsteils (220 bis 221) des Fahrzeugs mit elektrischer Energie über den weiteren Leitungsabschnitt (240) in Abhängigkeit von dem logischen Zustand des Speichers.

2. Verfahren nach Merkmal 1,
wobei die Signalisierung des Einschaltsignals über einen Sicherungsdatenbus (9) erfolgt.
3. Verfahren nach Merkmal 1 oder 2,

wobei der weitere Vorrichtungsteil eine elektronische Sicherung (225) des Weiteren Vorrichtungsteils (220) aufweist und
wobei das Versorgen des Weiteren Vorrichtungsteils (220) des Fahrzeugs mit elektrischer Energie über den weiteren Leitungsabschnitt (240) mittels des Einschaltens der elektronischen Sicherung (225) des Weiteren Vorrichtungsteils (220) in Abhängigkeit von dem logischen Zustand des Speichers erfolgt.

Authentifizierte Änderung der Topologie eines Versorgungsnetzwerks und zugehörige Rechnungsstellung

1. Verfahren (1300) zum Betreiben eines Fahrzeugs, insbesondere nach einem oder mehreren der vorhergehenden Merkmale,

Bereitstellen (1305) des Fahrzeugs,

- wobei das Fahrzeug u.a. Vorrichtungsteile (210) umfasst und
- wobei das Fahrzeug zumindest einen Kabelbaum mit Leitungsabschnitten (240, 241, 245) umfasst und
- wobei das Fahrzeug zumindest eine Energiequelle (250, 251) umfasst und
- wobei das Fahrzeug zumindest einen Steuerrechner (12), beispielsweise ein übergeordnetes Rechnersystem (12), umfasst und
- wobei das Fahrzeug zumindest zwei elektronische Sicherungen (214, 225) umfasst und
- wobei die Vorrichtungsteile (220) elektrische Verbraucher sind und
- wobei die zumindest eine oder mehrere Energiequellen (250, 251) dazu eingerichtet sind, zumindest zwei der Vorrichtungsteile (210, 220) mit elektrischer Energie über den Kabelbaum mit Leitungsabschnitten (240, 241, 245) zu versorgen, und
- wobei die elektronischen Sicherungen (214, 225) in den Kabelbaum mit Leitungsabschnitten (240, 241, 245) eingefügt sind und
- wobei jeder der elektrischen Sicherungen (214, 225) zumindest ein, als Zahl 1, elektrischer Verbraucher (210, 225) zugeordnet ist, der im Folgenden als der jeweiligen elektronischen Sicherung zugeordneter elektrischer Verbraucher bezeichnet wird, und
- wobei eine Sicherung der Sicherungen (214, 215) dazu eingerichtet ist, die Energieversorgung des dieser Sicherung zugeordneten elektrischen Verbrauchers in Abhängigkeit von einem Steuersignal des Steuerrechners ermöglichen oder unterbinden zu können;

Unterbinden (1310) der Energieversorgung eines zugeordneten elektrischen Verbrauchers mittels der entsprechenden Sicherung, der dieser Verbraucher zugeordnet ist;

Herstellen (1315) einer verschlüsselten Datenverbindung (720) zwischen dem Steuerrechner (12) des Fahrzeugs, beispielsweise einem übergeordneten Rechnersystem (12), und einem Rechner (710) eines Dienstanbieters, insbesondere einem Rechnersystem des Automobilherstellers des Fahrzeugs;

Authentifizierung (1320) des Fahrzeugs durch den Steuerrechner (12) des Fahrzeugs, beispielsweise durch ein übergeordnetes Rechnersystem (12), beim Rechner (710) des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können;

Authentifizierung (1325) des Rechners (710) des Dienstanbieters beim Steuerrechner (12) des Fahrzeugs, beispielsweise bei einem übergeordneten Rechnersystem (12);

Ggf. Authentifizierung (1330) der anfordernden Person (730) durch den Steuerrechner (12) des Fahrzeugs, beispielsweise durch das übergeordnete Rechnersystem (12), beim Rechner (710) des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen können;

Erzeugen (1335) oder Bereitstellen eines Freischaltcodes durch den Rechner (710) des Dienstanbieters;

Übermitteln (1340) des Freischaltcodes durch den Rechner des Dienstanbieters (710) an den Steuerrechner (12) des Fahrzeugs, insbesondere an das übergeordnete Rechnersystem (12);

Verifikation (1345) der Zulässigkeit und/oder syntaktischen Korrektheit und/oder der situativen Zulässigkeit des Freischaltcodes durch den Steuerrechner (12) des Fahrzeugs, insbesondere durch das übergeordnete Rechnersystem (12);

Ermöglichen (1350) der Energieversorgung eines zugeordneten elektrischen Verbrauchers (220) mittels der entsprechenden Sicherung (225), wenn der Freischaltcode zulässig und/oder syntaktisch korrekt und/oder der situativ zulässig ist;

Übermittlung (1355) von Abrechnungsdaten an einen oder den Rechner (710) eines oder des Dienstanbieters, insbesondere an ein oder das Rechnersystem des Automobilherstellers, wobei eine Speicherinformation im Rechner (710) des Dienstanbieters markiert, dass die Rechnung nicht bezahlt ist;

Erstellung (1360) einer Rechnung in Abhängigkeit von den übermittelten Abrechnungsdaten durch einen oder den Rechner (710) eines oder des Dienstanbieters, insbesondere an ein oder das Rechnersystem des Automobilherstellers;

Übermittlung (1365) der Rechnung an einem oder den Rechner (710) eines oder des Dienstanbieters, insbesondere an ein oder das Rechnersystem (740) der bestellenden Person (730), oder an die bestellende Person (730);

Begleichung (1370) der Rechnung durch einen oder den Rechner (710) eines oder des Dienstanbieters und/oder die anfordernde Person (730);

Markierung (1375) der Speicherinformation im Rechner des Dienstanbieters (740), dass die Rechnung bezahlt ist.

Spektrum basierende Steuerung einer elektronischen Sicherung

1. Verfahren (1600) zur Erkennung von nicht verlöschenden Lichtbögen (1510) im Kabelbaum (1515) mit Leitungsabschnitten (485,1505) eines Fahrzeugs, insbesondere nach einem oder mehreren der vorhergehenden Merkmale,

wobei im Kabelbaum (1510) zumindest zeitweise Spannungen von mehr als 40V, beispielsweise 48V und/oder 800V zwischen den Leitungsabschnitten (485, 1505) auftreten und

wobei in Leitungsabschnitte (245, 246,485,1505) des Kabelbaums (1515) elektronische Sicherungen (810, 825, 805) eingefügt sind, die dazu eingerichtet sind, den Stromdurchfluss in einzelnen oder mehreren Leitungsabschnitten (245, 246,485,1505) des Kabelbaums (1515) unterbrechen zu können,

wobei der Kabelbaum (1515) in abzusichernde Leitungsabschnitte (485, 1505) unterteilt ist und

wobei einem Leitungsabschnitt (1515) dieser Leitungsabschnitte (485, 1515) - im Folgenden als abzusichernder Leitungsabschnitt (1505) bezeichnet - zumindest eine elektronische Sicherung der elektronischen Sicherungen (825) zugeordnet ist, die dazu eingerichtet ist, den Stromfluss in diesem, ihr zugeordneten Leitungsabschnitt (1505) der Leitungsabschnitte (485, 1505) unterbrechen zu können und

wobei ein Steuergerät (12) des Fahrzeugs, beispielsweise das übergeordnete Rechnersystem (12), dazu eingerichtet ist, diese Sicherung (825) der elektronischen Sicherungen (810, 825, 805) zu steuern,

mit den Schritten

Erfassen (1605) eines Zeitabschnitts des zeitlichen Verlaufs des elektrischen Stroms (1525) durch den abzusichernden Leitungsabschnitt (1505) und Erzeugen eines zugehörigen Werteverlaufs (1610) des erfassten Stromwerts des elektrischen Stroms (1525) durch den abzusichernden Leitungsabschnitt (1505) dieses Zeitabschnitts insbesondere mittels einer Strommessvorrichtung (1520), die in den Leitungsabschnitt (1505) eingefügt ist, wobei insbesondere die Strommessvorrichtung (1520) die dem abzusichernden Leitungsabschnitt (1505) zugeordnete Sicherung (825) oder eine Teilvorrichtung der dem abzusichernden Leitungsabschnitt (1505) zugeordneten Sicherung (825) sein kann, und wobei insbesondere dieses Erfassen (1605) und/oder das Erzeugen des zugehörigen Werteverlaufs (1610) dieses Zeitabschnitts mittels einer Steuervorrichtung (4) der elektronischen Sicherung oder mittels einer übergeordnete Steuervorrichtung (12) oder mittels eines übergeordneten Rechnersystems (12), die über einen Datenbus (9) mit der Steuervorrichtung (4) der Sicherung (825) kommunizieren, erfolgt;

Durchführen (1615) einer Spektralanalyse des erfassten Werteverlaufs (1610) dieses Zeitabschnitts in Abhängigkeit von dem erzeugten zeitlichen Werteverlauf (1610) des zeitlichen Verlaufs des elektrischen Stromes (1525) durch den abzusichernden Leitungsabschnitt (1505) und Erzeugen eines Spektralanalyseergebnisses (1620), insbesondere mittels der Steuervorrichtung (4) der elektronischen Sicherung (825) oder mittels einer übergeordneten Steuervorrichtung (12) oder mittels eines übergeordneten Rechnersystems (12), die über einen Datenbus (9) mit der Steuervorrichtung (4) der Sicherung (825) kommunizieren;

Verwenden (1625) der Werte des Spektralanalyseergebnisses (1620) des erfassten Werteverlaufs (1610) dieses Zeitabschnitts und/oder daraus abgeleiteter Werte als aktuellem Anspruchsvektor (1630);

Abbilden (1635) des aktuellen Anspruchsvektors (1630) der Werte des Spektralanalyseergebnisses (1620) des erfassten Werteverlaufs (1610) dieses Zeitabschnitts auf vordefinierte Anspruchsvektoren (1640) spektraler Basisstrukturen aus einer gespeicherten Menge von vordefinierten Anspruchsvektoren spektraler Basisstrukturen (1650) in einer Basisstrukturdatenbank (1645), insbesondere mittels Skalar-Produktbildung zwischen diesen Anspruchsvektoren (1640), zur Erzeugung eines spektralen Parametersatzes (1655) mit zumindest einem, vorzugsweise je einem Ähnlichkeitswert für die Ähnlichkeit zwischen jeweils einem vordefinierten Anspruchsvektor (1640) genau einer spektralen Basisstruktur der gespeicherten Menge vordefinierter Anspruchsvektoren spektraler Basisstrukturen (1625) der Basisstrukturdatenbank (1635) einerseits und dem aktuellen Anspruchsvektor andererseits für vordefinierte, insbesondere alle, Anspruchsvektoren spektraler Basisstrukturen aus der gespeicherten Menge von vordefinierten Anspruchsvektoren spektraler Basisstrukturen (1625) in der Basisstrukturdatenbank (1635), wobei dieses Abbilden und Erzeugen bevorzugt mittels der Steuervorrichtung (4) der elektronischen Sicherung (825) oder mittels einer übergeordneten Steuervorrichtung (12) oder mittels eines übergeordneten Rechnersystems (12), die über einen Datenbus (9) mit der Steuervorrichtung (4) der Sicherung (825) kommunizieren, geschieht;

Bewertung (1660) des spektralen Parametersatzes (1655) zur Erzeugung eines Bewertungsergebnisses (1665), wobei insbesondere diese Bewertung (1660) durch Anwendung eines neuronalen Netzwerkmodells erfolgt und wobei dieser Bewertung (1660) insbesondere mittels der Steuervorrichtung (4) der elektronischen Sicherung (825) oder mittels einer übergeordneten Steuervorrichtung (12) oder mittels eines übergeordneten Rechnersystems (12), die über einen Datenbus (9) mit der Steuervorrichtung (4) der Sicherung (825) kommunizieren, erfolgt, wobei insbesondere die Steuervorrichtung (4) der elektronischen Sicherung (825) und/oder die übergeordneten Steuervorrichtung (12) und/oder das übergeordnete Rechnersystem (12) das neuronale Netzwerkmodell ausführen und wobei insbesondere der spektrale Parametersatz (1655) Eingangswerte des neuronalen Netzwerkmodells umfasst und wobei das Bewertungsergebnis (1665) der Bewertung (1660) von Ausgangswerten des neuronalen Netzwerkmodells abhängt;

Unterbrechen (1670) des Stromflusses (1525) durch den abzusichernden Leitungsabschnitt (1505) mittels der elektronischen Sicherung (825), wenn das Bewertungsergebnis (1665) des spektralen Parametersatzes (1640) dem Vorhandensein eines Kurzschlusses oder einer Plasmaentladung (1510), insbesondere eines Lichtbogens, entspricht oder dieses nahelegt, wobei das Unterbrechen mittels der Steuervorrichtung (4) der elektronischen Sicherung (825) und ggf. auch mittels einer übergeordneten Steuervorrichtung (12) und/oder ggf. mittels eines übergeordneten Rechnersystems (12) erfolgt, die über einen Datenbus (9) mit der Steuervorrichtung (4) der Sicherung (825) kommunizieren, und wobei insbesondere die Steuervorrichtung (4) der elektronischen Sicherung (825) und/oder eine übergeordneten Steuervorrichtung (12) und/oder ein übergeordnetes Rechnersystem (12), die über einen Datenbus (9) mit der Steuervorrichtung (4) der Sicherung (825) kommunizieren, den Leistungsschalter (17) der elektronischen Sicherung (825) öffnen.

Reduktion der Energieentnahme in einem Versorgungsnetzwerk eines Fahrzeugs durch Lastabwurf

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245) aufweist und
wobei das Versorgungsnetzwerk (1700) energieverbrauchende Vorrichtungsteile (210, 211,) des Versorgungsnetzwerks (1700) umfasst und
wobei das Versorgungsnetzwerk (1700) energieliefernde Vorrichtungsteile (250) umfasst, die dazu eingerichtet sind, Energie in das Versorgungsnetzwerk (1700) einzuspeisen, und
wobei energieverbrauchende Vorrichtungsteile (210, 211) des Versorgungsnetzwerks (1700) dazu eingerichtet sind, über zumindest einen Leitungsabschnitt (245) elektrischer Energie aus dem Versorgungsnetzwerk (1700) zu entnehmen, und
wobei energieverbrauchende Vorrichtungsteile (210) der energieverbrauchenden Vorrichtungsteile (210, 211) des Versorgungsnetzwerks (1700) dazu eingerichtet sind, über einen weiteren Leitungsabschnitt (240) einen weiteren Vorrichtungsteil (220) des Fahrzeugs mit elektrischer Energie versorgen zu können, und
wobei die energieverbrauchenden Vorrichtungsteile (210) eine elektronische Sicherung (214) aufweisen und
wobei die elektronische Sicherung (255) eines Vorrichtungsteils (250) dazu eingerichtet ist, die Versorgung dieses energieverbrauchenden Vorrichtungsteils (210) und der von diesem Vorrichtungsteil (210) mit elektrischer Energie versorgten weiteren Vorrichtungsteile (220, 221) unterbinden zu können,
mit den Schritten
Überwachen des Gesamtenergiebedarfs von Vorrichtungsteilen (210, 211, 220, 221, 222, 223) der Vorrichtungsteile des Fahrzeugs
mittels des Erfassens (1805) des Gesamtenergiebedarfs dieser Vorrichtungsteile (210, 211, 220, 221, 222, 223) und
mittels des Vergleichs (1810) des ermittelten Gesamtenergiebedarfs dieser Vorrichtungsteile (210, 211, 220, 221, 222, 223) des Fahrzeugs mit einem oberen Energieverbrauchsschwellwert;
Unterbinden (1820) der Versorgung eines ersten energieverbrauchenden Vorrichtungsteils (210) mit elektrischer Energie und/oder der von diesem ersten Vorrichtungsteil (210) mit elektrischer Energie versorgten weiteren Vorrichtungsteile (220. 221),
wenn der ermittelte Gesamtenergiebedarf aller Vorrichtungsteile (210, 211, 220, 221, 222, 223) über dem oberen Energieverbrauchsschwellwert liegt oder liegen könnte oder wenn der Betriebszustand des Fahrzeugs und/oder die Fahrsituation dies erwarten lässt,
wobei dieses Unterbinden (1820) mittels der elektronischen Sicherung (255) dieses Vorrichtungsteils (250), insbesondere mittels eines Leistungsschalters (17) der Sicherung (255), erfolgt;
Vergleich (1830) des ermittelten Gesamtenergiebedarfs dieser Vorrichtungsteile (210, 211, 220, 221, 222, 223) des Fahrzeugs mit einem unteren Energieverbrauchsschwellwert;

Ermöglichen (1840) der Versorgung des ersten energieverbrauchenden Vorrichtungsteils (210) mit elektrischer Energie und/oder der von diesem ersten Vorrichtungsteil (210) mit elektrischer Energie versorgten weiteren Vorrichtungsteile (220. 221),
wenn der ermittelte Gesamtenergiebedarf aller Vorrichtungsteile (210, 211, 220, 221, 222, 223) unter dem unteren Energieverbrauchsschwellwert liegt,
wobei dieses Ermöglichen (1840) mittels der elektronischen Sicherung (255) dieses Vorrichtungsteils (250), insbesondere mittels eines Leistungsschalters (17) der Sicherung (255), erfolgt.

2. Verfahren nach Merkmal 1,
wobei die Energieversorgung der Vorrichtungsteile (220, 221) des Fahrzeugs, deren Energieversorgung unterbunden wird, eine geringere Priorität hat, als die Energieversorgung der Vorrichtungsteile (222, 223) des Fahrzeugs, deren Energieversorgung nicht unterbunden wird.

Prioritätsgesteuerte Energieversorgung in einem Versorgungsnetzwerks eines Fahrzeugs

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245) aufweist und
wobei das Versorgungsnetzwerk (1700) energieverbrauchende Vorrichtungsteile (210, 211,) des Versorgungsnetzwerks (1700) umfasst und
wobei das Versorgungsnetzwerk (1700) energieliefernde Vorrichtungsteile (250) umfasst, die dazu eingerichtet sind, Energie in das Versorgungsnetzwerk (1700) einzuspeisen, und
wobei energieverbrauchende Vorrichtungsteile (210, 211) des Versorgungsnetzwerks (1700) dazu eingerichtet sind, über zumindest einen Leitungsabschnitt (245) elektrischer Energie aus dem Versorgungsnetzwerk (1700) zu entnehmen, und
wobei energieverbrauchende Vorrichtungsteile (210) der energieverbrauchenden Vorrichtungsteile (210, 211) des Versorgungsnetzwerks (1700) dazu eingerichtet sind, über einen weiteren Leitungsabschnitt (240) einen weiteren Vorrichtungsteil (220) des Fahrzeugs mit elektrischer Energie versorgen zu können, und
wobei die energieverbrauchenden Vorrichtungsteile (210) eine elektronische Sicherung (214) aufweisen und
wobei die elektronische Sicherung (255) eines Vorrichtungsteils (250) dazu eingerichtet ist, die Versorgung dieses energieverbrauchenden Vorrichtungsteils (210) und der von diesem Vorrichtungsteil (210) mit elektrischer Energie versorgten weiteren Vorrichtungsteile (220, 221) unterbinden zu können,
mit den Schritten
Überwachen des Gesamtenergiebedarfs von Vorrichtungsteilen (210, 211, 220, 221, 222, 223) der Vorrichtungsteile des Fahrzeugs
mittels des Erfassens (1805) des Gesamtenergiebedarfs dieser Vorrichtungsteile (210, 211, 220, 221, 222, 223) und
mittels des Vergleichs (1810) des ermittelten Gesamtenergiebedarfs dieser Vorrichtungsteile (210, 211, 220, 221, 222, 223) des Fahrzeugs mit einem oberen Energieverbrauchsschwellwert;
Unterbinden (1820) der Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile, wenn der Gesamtenergiebedarf aller Vorrichtungsteile über einem Energietransportschwellwert für diesen Leitungsabschnitt liegt oder liegen könnte oder der Betriebszustand und/oder die Fahrsituation dies erwarten lässt,
wobei dieses Unterbinden mittels der elektronischen Sicherung dieses Vorrichtungsteils erfolgt.

2. Verfahren nach Merkmal 1,
wobei die Energieversorgung der Vorrichtungsteile des Fahrzeugs, deren Energieversorgung unterbunden wird, eine geringere Priorität hat als die Energieversorgung der Vorrichtungsteile des Fahrzeugs, deren Energieversorgung nicht unterbunden wird.

Lasterhöhung in einem Versorgungsnetzwerk eines Fahrzeugs mit elektronischen Sicherungen

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245) aufweist und

wobei das Versorgungsnetzwerk (1700) energieverbrauchende Vorrichtungsteile (210, 211,) des Versorgungsnetzwerks (1700) umfasst und

wobei das Versorgungsnetzwerk (1700) energieliefernde Vorrichtungsteile (250) umfasst, die dazu eingerichtet sind, Energie in das Versorgungsnetzwerk (1700) einzuspeisen, und

wobei energieverbrauchende Vorrichtungsteile (210, 211) des Versorgungsnetzwerks (1700) dazu eingerichtet sind, über zumindest einen Leitungsabschnitt (245) elektrischer Energie aus dem Versorgungsnetzwerk (1700) zu entnehmen, und

wobei energieverbrauchende Vorrichtungsteile (210) der energieverbrauchenden Vorrichtungsteile (210, 211) des Versorgungsnetzwerks (1700) dazu eingerichtet sind, über einen weiteren Leitungsabschnitt (240) einen weiteren Vorrichtungsteil (220) des Fahrzeugs mit elektrischer Energie versorgen zu können, und

wobei die energieverbrauchenden Vorrichtungsteile (210) eine elektronische Sicherung (214) aufweisen und

wobei die elektronische Sicherung (255) eines Vorrichtungsteils (250) dazu eingerichtet ist, die Versorgung dieses energieverbrauchenden Vorrichtungsteils (210) und der von diesem Vorrichtungsteil (210) mit elektrischer Energie versorgten weiteren Vorrichtungsteile (220, 221) unterbinden zu können,

mit den Schritten

Überwachen des Gesamtenergiebedarfs von Vorrichtungsteilen (210, 211, 220, 221, 222, 223) der Vorrichtungsteile des Fahrzeugs

mittels des Erfassens (1805) des Gesamtenergiebedarfs dieser Vorrichtungsteile (210, 211, 220, 221, 222, 223) und

mittels des Vergleichs (1810) des ermittelten Gesamtenergiebedarfs dieser Vorrichtungsteile (210, 211, 220, 221, 222, 223) des Fahrzeugs mit einem oberen Energieverbrauchsschwellwert;

Ermöglichen (1820) der Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile, wenn der Gesamtenergiebedarf aller Vorrichtungsteile unter einem unteren Energietransportschwellwert für diesen Leitungsabschnitt liegt oder liegen könnte oder der Betriebszustand und/oder die Fahrsituation dies erwarten lässt,

wobei dieses Ermöglichen mittels der elektronischen Sicherung dieses Vorrichtungsteils erfolgt.

2. Verfahren nach Merkmal 1,
wobei die Energieversorgung der Vorrichtungsteile des Fahrzeugs, deren Energieversorgung ermöglicht wird, eine höhere Priorität hat als die Energieversorgung der Vorrichtungsteile des Fahrzeugs, deren Energieversorgung nicht ermöglicht wird.

Reduktion der Energieentnahme in einem Versorgungsnetzwerk eines Fahrzeugs durch Lastabwurf

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245, 240, 241) aufweist und

wobei das Versorgungsnetzwerk (1700) energieverbrauchende Vorrichtungsteile (210,211) des Versorgungsnetzwerks (1700) umfasst, und

wobei das Versorgungsnetzwerk (1700) energieliefernde Vorrichtungsteile (250) des Fahrzeugs umfasst, die dazu eingerichtet sind, Energie in das Versorgungsnetzwerk (1700) einzuspeisen, und

wobei das Versorgungsnetzwerk (1700) dazu eingerichtet ist, energieverbrauchende Vorrichtungsteile (210, 211) des Fahrzeugs über zumindest einen Leitungsabschnitt (245) mit elektrischer Energie aus dem Versorgungsnetzwerk (1700) zu versorgen, und

wobei energieverbrauchende Vorrichtungsteile (210, 211) dazu eingerichtet sind, über einen weiteren Leitungsabschnitt (240, 241) einen weiteren Vorrichtungsteil (220, 221, 222, 223) des Fahrzeugs mit elektrischer Energie versorgen zu können, und

wobei die energieverbrauchenden Vorrichtungsteile (210, 211) eine elektronische Sicherung (214, 215) aufweisen und

wobei die elektronische Sicherung (255) eines Vorrichtungsteils (250) dazu eingerichtet sind, die Versorgung dieses energieverbrauchenden Vorrichtungsteils (210, 211) und der von diesem Vorrichtungsteil (210, 211) mit elektrischer Energie versorgten weiteren Vorrichtungsteile (220, 221, 222, 223) unterbinden zu können, mit den Schritten

Überwachen des Gesamtenergiebedarfs von Vorrichtungsteilen (210, 211, 220, 221, 222, 223) der Vorrichtungsteile des Fahrzeugs

mittels des Erfassens (1805) des Gesamtenergiebedarfs dieser Vorrichtungsteile (210, 211, 220, 221, 222, 223) und

mittels des Vergleichens (1810) des ermittelten Gesamtenergiebedarfs dieser Vorrichtungsteile (210, 211, 220, 221, 222, 223) des Fahrzeugs mit einem Energieverbrauchsschwellwert;

Unterbinden (1820) der Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile, wenn der Gesamtenergiebedarf aller Vorrichtungsteile über einem Energietransportschwellwert für diesen Leitungsabschnitt liegt oder liegen könnte oder der Betriebszustand und/oder die Fahrsituation dies erwarten lässt,

wobei dieses Unterbinden mittels der elektronischen Sicherung dieses Vorrichtungsteils erfolgt.

2. Verfahren nach Merkmal 1,

wobei die Energieversorgung der Vorrichtungsteile des Fahrzeugs, deren Energieversorgung unterbunden wird, eine geringere Priorität hat als die Energieversorgung der Vorrichtungsteile des Fahrzeugs, deren Energieversorgung nicht unterbunden wird.

Prioritätsgesteuerte Belastung eines Versorgungsnetzwerks eines Fahrzeugs

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245, 240, 241) aufweist und

wobei das Versorgungsnetzwerk (1700) energieverbrauchende Vorrichtungsteile (210,211) des Versorgungsnetzwerks (1700) umfasst und

wobei das Versorgungsnetzwerk (1700) energieliefernde Vorrichtungsteile (250) des Fahrzeugs umfasst, die dazu eingerichtet sind, Energie in das Versorgungsnetzwerk (1700) einzuspeisen, und

wobei das Versorgungsnetzwerk (1700) dazu eingerichtet ist, energieverbrauchende Vorrichtungsteile (210, 211) des Fahrzeugs über zumindest einen Leitungsabschnitt (245) mit elektrischer Energie aus dem Versorgungsnetzwerk (1700) zu versorgen, und

wobei energieverbrauchende Vorrichtungsteile (210, 211) dazu eingerichtet ist, über einen weiteren Leitungsabschnitt (240, 241) einen weiteren Vorrichtungsteil (220, 221, 222, 223) des Fahrzeugs mit elektrischer Energie versorgen zu können, und

wobei die energieverbrauchenden Vorrichtungsteile (210, 211) eine elektronische Sicherung (214, 215) aufweisen und

wobei die elektronische Sicherung (255) eines Vorrichtungsteils (250) dazu eingerichtet ist, die Versorgung dieses energieverbrauchenden Vorrichtungsteils (210, 211) und der von diesem Vorrichtungsteil (210, 211) mit elektrischer Energie versorgten weiteren Vorrichtungsteile (220, 221, 222, 223) unterbinden zu können, mit den Schritten

Überwachen des Gesamtenergiebedarfs von Vorrichtungsteilen (210, 211, 220, 221, 222, 223) der Vorrichtungsteile des Fahrzeugs

mittels des Erfassens (1805) des Gesamtenergiebedarfs dieser Vorrichtungsteile (210, 211, 220, 221, 222, 223) und

mittels des Vergleichs (1810) des ermittelten Gesamtenergiebedarfs dieser Vorrichtungsteile (210, 211, 220, 221, 222, 223) des Fahrzeugs mit einem unteren Energieverbrauchsschwellwert;

Ermöglichen (1820) der Versorgung eines energieverbrauchenden Vorrichtungsteils dieser Vorrichtungsteile mit elektrischer Energie und der von diesem Vorrichtungsteil mit elektrischer Energie versorgten weiteren Vorrichtungsteile, wenn der Gesamtenergiebedarf aller Vorrichtungsteile unter einem unteren Energietransportschwellwert für diesen Leitungsabschnitt liegt oder liegen könnte oder der Betriebszustand und/oder die Fahrsituation dies erwarten lässt,

wobei dieses Ermöglichen mittels der elektronischen Sicherung dieses Vorrichtungsteils erfolgt.

EP 4 683 149 A2

Batterie mit Batteriezelle, die über elektronische Sicherungen abgesichert sind

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245) aufweist und
wobei das Versorgungsnetzwerk (1700) energieverbrauchende Vorrichtungsteile (210, 211) des Versorgungsnetzwerks (1700) umfasst und
wobei das Versorgungsnetzwerk (1700) energieliefernde Vorrichtungsteile (250) des Fahrzeugs umfasst, die dazu eingerichtet sind, Energie in das Versorgungsnetzwerk (1700) einzuspeisen, und
wobei das Versorgungsnetzwerk (1700) dazu eingerichtet ist, energieverbrauchende Vorrichtungsteile (210, 211) des Versorgungsnetzwerks (1700) des Fahrzeugs über zumindest einen Leitungsabschnitt (245) mit elektrischer Energie aus dem Versorgungsnetzwerk (1700) zu versorgen, und
wobei energieverbrauchende Vorrichtungsteile (210) über einen weiteren Leitungsabschnitt (240) einen weiteren Vorrichtungsteil (220) des Fahrzeugs mit elektrischer Energie versorgen können und
wobei die energieverbrauchenden Vorrichtungsteile (210) eine elektronische Sicherung (214) aufweisen und
wobei die elektronische Sicherung (255) eines Vorrichtungsteils (250) die Versorgung dieses energieverbrauchenden Vorrichtungsteils (210) und der von diesem Vorrichtungsteil (210) mit elektrischer Energie versorgten weiteren Vorrichtungsteile (220, 221) unterbinden kann.
mit den Schritten
Überwachen des Gesamtenergiebedarfs von Vorrichtungsteilen (210, 211, 220, 221, 222, 223) der Vorrichtungsteile des Fahrzeugs mittels
Erfassen (1805) des Gesamtenergiebedarfs dieser Vorrichtungsteile (210, 211, 220, 221, 222, 223);
Vergleich (1810) des ermittelten Gesamtenergiebedarfs dieser Vorrichtungsteile (210, 211, 220, 221, 222, 223) des Fahrzeugs mit einem oberen Energieverbrauchsschwellwert;
Erhöhung (1820) der Energieerzeugung einer Energiequelle 250 zur Versorgung eines ersten energieverbrauchenden Vorrichtungsteils (210) mit elektrischer Energie und/oder der von diesem ersten Vorrichtungsteil (210) mit elektrischer Energie versorgten weiteren Vorrichtungsteile (220: 221),
wenn der ermittelte Gesamtenergiebedarf aller Vorrichtungsteile (210, 211, 220, 221, 222, 223) über dem oberen Energieverbrauchsschwellwert liegt oder liegen könnte oder der Betriebszustand und/oder die Fahrsituation dies erwarten lässt,
wobei dieses Erhöhen (1820) mittels der elektronischen Sicherung (255) dieses Vorrichtungsteils (250), insbesondere durch Schließen des Leistungsschalters (17) dieser Sicherung (255) dieses Vorrichtungsteils (250), und/oder durch Änderung von Betriebsparametern dieses Vorrichtungsteils (250) erfolgt.

2. Verfahren nach Merkmal 1,
wobei die Energieversorgung der Vorrichtungsteile des Fahrzeugs, deren Energieversorgung verschlechtert wird, eine niedrigere Priorität hat als die Energieversorgung der Vorrichtungsteile des Fahrzeugs, deren Energieversorgung nicht verschlechtert wird.

Batteriezellenmodul mit Abschaltung und Überbrückung durch elektronische Sicherungen

1. Verfahren (1800) zum Betreiben eines Versorgungsnetzwerks (1700) eines Fahrzeugs, insbesondere nach einem oder mehreren der vorhergehenden Merkmale,

wobei das Versorgungsnetzwerk (1700) Leitungsabschnitte (245) aufweist und
wobei das Versorgungsnetzwerk (1700) energieverbrauchende Vorrichtungsteile (210, 211,) des Versorgungsnetzwerks (1700) umfasst und
wobei das Versorgungsnetzwerk (1700) energieliefernde Vorrichtungsteile (250) des Fahrzeugs umfasst, die dazu eingerichtet sind, Energie in das Versorgungsnetzwerk (1700) einzuspeisen, und
wobei das Versorgungsnetzwerk (1700) dazu eingerichtet ist, energieverbrauchende Vorrichtungsteile (210, 211) des Versorgungsnetzwerks (1700) des Fahrzeugs über zumindest einen Leitungsabschnitt (245) mit elektrischer Energie aus dem Versorgungsnetzwerk (1700) zu versorgen, und
wobei energieverbrauchende Vorrichtungsteile (210) dazu eingerichtet sind, über einen weiteren Leitungsabschnitt (240) einen weiteren Vorrichtungsteil (220) des Fahrzeugs mit elektrischer Energie versorgen zu können, und

wobei die energieverbrauchenden Vorrichtungsteile (210) eine elektronische Sicherung (214) aufweisen und wobei die elektronische Sicherung (255) eines Vorrichtungsteils (250) dazu eingerichtet ist, die Versorgung dieses energieverbrauchenden Vorrichtungsteils (210) und der von diesem Vorrichtungsteil (210) mit elektrischer Energie versorgten weiteren Vorrichtungsteile (220, 221) unterbinden und/der ermöglichen zu können, mit den Schritten

Überwachen des Gesamtenergiebedarfs von Vorrichtungsteilen (210, 211, 220, 221, 222, 223) der Vorrichtungsteile des Fahrzeugs

mittels des Erfassens (1805) des Gesamtenergiebedarfs dieser Vorrichtungsteile (210, 211, 220, 221, 222, 223) und

mittels des Vergleichs (1810) des ermittelten Gesamtenergiebedarfs dieser Vorrichtungsteile (210, 211, 220, 221, 222, 223) des Fahrzeugs mit einem unteren Energieverbrauchsschwellwert;

Erniedrigung (1840) der Energieerzeugung einer Energiequelle (250) zur Versorgung eines ersten energieverbrauchenden Vorrichtungsteils (210) mit elektrischer Energie und/oder der von diesem ersten Vorrichtungsteil (210) mit elektrischer Energie versorgten weiteren Vorrichtungsteile (220: 221),

wenn der ermittelte Gesamtenergiebedarf aller Vorrichtungsteile (210, 211, 220, 221, 222, 223) unter dem unteren Energieverbrauchsschwellwert liegt oder liegen könnte oder der Betriebszustand und/oder die Fahrsituation dies erwarten lässt, und

wobei dieses Erniedrigen (1840) mittels der elektronischen Sicherung (255) dieses Vorrichtungsteils (250), insbesondere durch Öffnen des Leistungsschalters (17) dieser Sicherung (255) dieses Vorrichtungsteils (250), und/oder durch Änderung von Betriebsparametern dieses Vorrichtungsteils (250) erfolgt.

2. Verfahren nach Merkmal 1,

wobei die Energieversorgung der Vorrichtungsteile des Fahrzeugs, deren Energieversorgung verschlechtert wird, eine niedrigere Priorität hat als die Energieversorgung der Vorrichtungsteile des Fahrzeugs, deren Energieversorgung nicht verschlechtert wird.

Verteiltes Messverfahren in einem Versorgungsnetzwerk mit elektronischen Sicherungen

1. Verteiltes Messverfahren (2000) zur Erfassung des Zustands eines Kabelbaums (1515) eines Fahrzeugs, insbesondere nach einem oder mehreren der vorhergehenden Merkmale, mit den Schritten

Ggf. Synchronisation (2005) eines ersten Zeitgebers (1950) einer ersten elektronischen Sicherung (825) mit einem Zeitnormal, insbesondere einem Zeitgeber (1970) eines übergeordneten Rechnersystems (12);

Ggf. Synchronisation (2010) eines zweiten Zeitgebers (1955) einer zweiten elektronischen Sicherung (805) mit dem Zeitnormal, insbesondere dem Zeitgeber (1970) eines übergeordneten Rechnersystems (12);

Initiierung (2015) der folgenden beiden Erfassungsvorgänge zu gleichen Zeitwerten des ersten Zeitgebers (1950) der ersten elektronischen Sicherung (825) und des zweiten Zeitgebers (1955) der zweiten elektronischen Sicherung (805);

Erfassen (2020) des ersten Stromwerts des Stromflusses (1525) in einen ersten abzusichernden Leitungsabschnitt (1505) des Kabelbaums (1515) hinein, insbesondere durch die erste elektronische Sicherung (825) und/oder eine erste Strommessvorrichtung (1520) der ersten elektronische Sicherung (825);

Erfassen (2025) des zweiten Stromwerts des Stromflusses (1910) in einen zweiten, nachfolgenden, abzusichernden Leitungsabschnitt (1905) des Kabelbaums (1515) hinein, insbesondere durch die zweite elektronische Sicherung (805) und/oder eine zweite Strommessvorrichtung (1935) der zweiten elektronische Sicherung (805);

Ermitteln (2030) eines ersten Zeitstempelwerts, insbesondere durch die erste elektronischen Sicherung (825) und/oder eine erste Steuervorrichtung (4) der ersten elektronischen Sicherung (825) und insbesondere mit Hilfe des ersten Zeitgebers (1950) der ersten elektronischen Sicherung (825), für jeden ersten Strommesswert oder für eine Gruppe von ersten Strommesswerten des Stromflusses (1525);

Ermitteln (2035) eines zweiten Zeitstempelwerts, insbesondere durch die zweite elektronischen Sicherung (805) und/oder eine zweite Steuervorrichtung (4) der zweiten elektronischen Sicherung (805) und insbesondere mit Hilfe des zweiten Zeitgebers (1955) der zweiten elektronischen Sicherung (805), für jeden zweiten Strommesswert oder für eine Gruppe von zweiten Strommesswerten des Stromflusses (1910);

Übertragung (2040) zumindest eines zweiten Strommesswerts zusammen mit dem zweiten Zeitstempelwert von der zweiten Sicherung (805) an ein übergeordnetes Rechnersystem (12) oder an die Steuervorrichtung (4) der ersten elektronischen Sicherung (825) und im Falle der Übertragung des zweiten Messwerts an ein übergeordnetes Rechnersystem (12) Übertragung (2025) des ersten Stromesswerts zusammen mit dem ersten Zeitstempelwert von der ersten Sicherung (825) an das übergeordnete Rechnersystem (12);

Vergleich (2045) des ersten Stromesswerts mit dem zweiten Stromesswert und

Schließen (2050) auf einen Energieverlust in Leitungsabschnitten (1525) zwischen zwei elektronischen Sicherungen (825, 805), insbesondere, wenn der die Differenz zwischen dem ersten Strommesswert und dem zweiten Strommesswert außerhalb eines erlaubten Differenzwertintervalls legt und/oder wenn ein Quotient aus dem ersten Stromesswert und dem zweiten Strommesswert außerhalb eines erlaubten Quotienten-Intervalls liegt.

2. Verfahren nach Merkmal 1 mit dem Schritt

Ergreifen (2055) von Gegenmaßnahmen, insbesondere durch das übergeordnete Rechnersystem (12) bzw. durch den Rechnerkern (2) der auswertenden Steuervorrichtung (4) der auswertenden elektronischen Sicherung (825), wenn die Strommesswerte oder das Verhältnis der Stromesswerte zueinander oder eine Differenz von solchen Stromesswerten oder daraus abgeleiteter Größen nicht einem oder mehreren Erwartungswerten entsprechen und/oder nicht in einem Erwartungswertintervall liegen.

3. Verfahren nach Merkmal 1 oder 2,

wobei die Datenkommunikation über

- einen Sicherungsdatenbus (9) oder
- einen Fuse-Datenbus (9) oder
- einen Lin-Datenbus (9) oder
- einen DSI3- Datenbus (9) oder
- einen PSI5-Datenbus (9) oder
- einen CAN-Datenbus (9) oder
- einen CAN-FD-Datenbus (9) oder
- einen Ethernet-Datenbus oder
- einen Flexray-Datenbus (9) oder
- einen LVDS-Datenbus (9) oder
- einen Ethernet-Datenbus (9) oder
- eine sonst wie drahtgebundene oder drahtlose Datenübertragungsstrecke, beispielsweise über eine Bluetooth- oder eine WLAN-Datenverbindung oder eine optische Datenverbindung (540),
- oder eine sonstige drahtgebundene oder drahtlose Schnittstelle (610, 10, 551, 550) abläuft.

4. Verfahren nach einem der Merkmale 1 bis 3,

mit den Schritten

Erfassen von Veränderungen der Strommesswerte der Ströme (1525, 1910, 1920, 1930) und/oder von Veränderungen der Spektren des zeitlichen Spannungsverlaufs der Spannungen zwischen abzusichernden Leitungsabschnitten (1505, 1905, 1915, 1920) des Kabelbaums (1515) einerseits und einem Bezugspotenzial andererseits einer und/oder von Veränderungen der Spektren des Stromverlaufs der Strommesswerte der Ströme (1525, 1910, 1920, 1930) oder des Energietransports über die zusichernden Leitungsabschnitte (1505, 1905, 1915, 1920) des Kabelbaums (1515);

Bewerten dieser Veränderungen durch Vergleich mit erwarteten Verläufen und/oder erwarteten Werten.

5. Verfahren nach Merkmal 4,

mit den Schritten

Herstellen (2060) einer Datenverbindung (1990) zu einem Server (1985) einer Werkstatt und/oder eines Automobilherstellers und/oder eines Dienstleistungsanbieters;

Übermittlung (2065) von Fahrzeugdaten und/oder Betriebsdaten und/oder Messwerten und/oder Schadensdaten, wenn der Vergleich der erfassten Veränderungen mit den erwarteten Verläufen und/oder erwarteten Werten eine Abweichung über ein vorgegebenes Maß hinaus ergab.

6. Verfahren nach Merkmal 5,

mit dem Schritt

Übermittlung (2065) der Fahrzeugdaten und/oder Betriebsdaten und/oder Messwerten und/oder Schadensdaten an einen Server (1985) oder ein Terminal der Werkstatt oder eines sonstigen Nutzers dieser Daten.

7. Verfahren nach Merkmal 5 oder 6,

mit den Schritten
Prognose (2070) der Ausfallwahrscheinlichkeit eines Vorrichtungsteils des Fahrzeugs mittels der Fahrzeugdaten und/oder Betriebsdaten und/oder Messwerten und/oder Schadensdaten;
Übermittlung (2075) des Prognoseergebnisses an einen Server (1985) und/oder ein Terminal der Werkstatt und/oder ein Terminal (740) und/oder einen Rechner eines Fahrzeughalters (730) und/oder ein Terminal (740) und/oder einen Rechner eines Fahrzeugführers (730) oder ein Terminal und/oder einen Server (710) eines Automobilherstellers und/oder ein Terminal und/oder Server eines Logistikunternehmens und/oder ein Terminal und/oder einen Server eines sonstigen Nutzers dieser Daten.

8. Verfahren nach Merkmal 7,

mit dem Schritt
Bereitstellen (2080) eines Ersatzteils für das Vorrichtungsteil des Fahrzeugs bei einem Prognoseergebnis, das einen Ausfall des Vorrichtungsteils erwarten lässt.

9. Verfahren nach einem der Merkmale 1 bis 8 ,

mit dem Schritt
Schließen (2085) auf die Temperatur eines Leitungsabschnitts (1915, 1925, 1505, 1905) und/oder eine Übertemperatur eines Leitungsabschnitts (1915, 1925, 1505, 1905) mittels der erfassten Stromwerte des Stromflusses (1920, 1925, 1525, 1910) in mehreren abzusichernden Leitungsabschnitten (1915, 1925, 1505, 1905) des Kabelbaums (1515).

Batterie mit elektronischen Sicherungen

1. Batterie (2100) mit Diagnosefunktion für ein Fahrzeug, insbesondere nach einem oder mehreren der vorhergehenden Merkmale,

wobei die Batterie (2100) ein oder mehr Batteriezellenmodule (2105, 2155) umfasst und
wobei die Batterie (2100) eine oder mehrere elektronische Scherungen (825, 805) umfasst und
wobei zumindest ein Anschluss (2197) der Batterie (2100) mit dem ersten Anschluss (26) des Leistungsschalters (17) einer elektronischen Sicherung (825) verbunden ist und
wobei die Batterie (2100) einen Versorgungsbaum und/oder ein Versorgungsnetzwerk mit einem oder mehr Versorgungszweigen (2198, 2196, 2120, 2135, 2140, 2190, 2160,2175, 2180, 2196) umfasst und
wobei mehrere elektronische Sicherungen (825, 805) in Serie in einen Versorgungszweig 2198, 2196, 2120, 2135, 2140, 2190, 2160,2175, 2180, 2196) des Versorgungsbaums bzw. des Versorgungsnetzwerks geschaltet sind
wobei ein Versorgungsbaum bzw. ein Versorgungsnetzwerk auch nur einen Versorgungszweig mit einer Mehrzahl von elektronischen Sicherungen, die in den Versorgungszweig eingefügt sind, umfassen kann und
wobei ein oder mehr Batteriezellenmodule (2105, 2155) der Batterie (2100) elektrisch in Serie geschaltet sind und
wobei eine oder mehrere elektronische Sicherungen (805) zwischen Batteriezellenmodule (2105, 2155) der Batterie (2100) geschaltet sind.

2. Batterie (2100) nach Merkmal 1,
wobei genau eine elektronische Sicherung (805) zwischen zwei Batteriezellenmodule (2105, 2155) geschaltet ist, die miteinander in Serie verschaltet sind.
3. Batterie (2100) nach Merkmal 2,

wobei je Batteriezellenmodul (2105, 2155) jeweils eine elektronische Sicherung (825, 805) vorhanden ist und
wobei jedem Batteriezellenmodul (2105, 2155) oder jeweils einer oder mehreren Gruppen, insbesondere in Serie verschalteter, Batteriezellenmodule (2105, 2155) je eine elektronische Sicherung (825, 805) zugeordnet ist.

4. Batterie (2100) nach einem oder mehreren der Merkmale 1 bis 3,

wobei eine oder mehrere oder alle dieser elektronischen Sicherungen (825, 805) einen ersten Leistungsschalter (17) aufweisen, der dazu eingerichtet ist, den Stromfluss (2121, 2161) durch ein oder mehrere Batteriezellenmodule (2105, 2155) und/oder die betreffende Gruppe an Batteriezellenmodulen zu verhindern, also die elektrische Verbindung (2140, 2190, 2160, 2175) zwischen eines ersten Batteriezellenmoduls (2105) und einem zweiten Batteriezellenmodul (2155) oder einer ersten Gruppe von Batteriezellenmodulen und einer zweiten Gruppe von Batteriezellenmodulen, die miteinander in Serie geschaltet sind, aufzutrennen, wenn der erste Leistungsschalter (17) geöffnet ist und/oder

wobei eine oder mehrere oder alle dieser elektronischen Sicherungen (825, 805) einen ersten Leistungsschalter (17) aufweisen, der dazu eingerichtet ist, den Stromfluss (2121, 2161) durch ein oder mehrere Batteriezellenmodule (2105, 2155) und/oder die betreffende Gruppe von Batteriezellenmodulen zu ermöglichen, also die elektrische Verbindung (2140, 2190, 2160, 2175) zwischen einem ersten Batteriezellenmodul (2105) und einem zweiten Batteriezellenmodul (2155) oder einer ersten Gruppe von Batteriezellenmodulen und einer zweiten Gruppe von Batteriezellenmodulen, die miteinander in Serie geschaltet sind, herzustellen, wenn der erste Leistungsschalter (17) geschlossen ist.

5. Batterie (2200) nach Merkmal 4,
wobei eine oder mehrere oder alle dieser elektronischen Sicherungen (825) der Batterie (2200) einen zweiten Leistungsschalter (17') aufweisen, der dazu eingerichtet ist, das Batteriezellenmodul (2105) und/oder die Gruppe von Batteriezellenmodulen bei einem geschlossenen zweiten Leistungsschalter (17') zu überbrücken.

6. Batterie (2200) nach Merkmal 5,

wobei eine Steuerungsvorrichtung (4) der elektronischen Sicherung (825) dazu eingerichtet ist, vor dem Schließen des zweiten Leistungsschalters (17') den Schaltzustand des ersten Leistungsschalters (17) zu erfassen, und

wobei eine Steuerungsvorrichtung (4) der elektronischen Sicherung (825) dazu eingerichtet ist, zu erfassen, ob der erste Leitungsschalter (17) geöffnet ist, und

wobei eine Steuerungsvorrichtung (4) der elektronischen Sicherung (825) dazu eingerichtet ist, nur dann den zweiten Leistungsschalter (17) zu schließen, wenn der erste Leitungsschalter (17) geöffnet ist.

7. Batterie (2200) nach Merkmal 6,

wobei die Steuerungsvorrichtungen (4) dazu eingerichtet ist, die Einspeisung eines Teststromes (515) in den ersten Leistungsschalter (17) vor (26) dem ersten Leistungsschalter (17) zu veranlassen und die Entnahme dieses Teststromes (915) hinter (28) dem ersten Leistungsschalter (17) zu veranlassen und

wobei die Steuerungsvorrichtung (4) dazu eingerichtet ist, zu bewerten, ob diese Einspeisung und Entnahme erfolgreich waren.

Batteriezellenmodul mit Batteriezellenmodul und elektronischen Sicherungen

1. Batteriezellenmodul (2300), insbesondere eines Fahrzeugs, insbesondere nach einem oder mehreren der vorhergehenden Merkmale,

wobei das Batteriezellenmodul (2300) zumindest eine Batteriezelle (2145) und/oder eine Zusammenschaltung von Batteriezellen umfasst und

wobei das Batteriezellenmodul (2300) einen ersten Leistungsschalter (17) umfasst und

wobei das Batteriezellenmodul (2300) einen zweiten Leistungsschalter (17') umfasst und

wobei das Batteriezellenmodul (2300) einen ersten elektrischen Knoten (2120) umfasst und

wobei das Batteriezellenmodul (2300) einen zweiten elektrischen Knoten (2135) umfasst und

wobei das Batteriezellenmodul (2300) einen dritten elektrischen Knoten (2140) umfasst und

wobei die Batteriezelle (2300) einen ersten Batteriezellenanschluss (2305) umfasst und

wobei die Batteriezelle (2300) einen zweiten Batteriezellenanschluss (2310) umfasst und

wobei der erste Batteriezellenanschluss (2305) mit dem zweiten Knoten (2135) verbunden ist und

wobei der zweite Batteriezellenanschluss (2310) mit dem dritten Knoten (2140) verbunden ist und

wobei der erste Leistungsschalter (17) einen ersten Anschluss (26) und einen zweiten Anschluss (28) und einen Steueranschluss (27) umfasst und

wobei der zweite Leistungsschalter (17') einen ersten Anschluss (26') und einen zweiten Anschluss (28') und einen Steueranschluss (27') umfasst und

wobei die Batteriezelle (2105) und/oder die Zusammenschaltung von Batteriezellen einen ersten Anschluss (2125) und einen zweiten Anschluss (2130) umfasst und

wobei der erste Leistungsschalter (17) mit seinem ersten Anschluss (26) des ersten Leistungsschalters (17) mit dem ersten Knoten (2120) verbunden ist und

wobei der erste Leistungsschalter (17) mit seinem zweiten Anschluss (28) des ersten Leistungsschalters (17) mit dem zweiten Knoten (2135) verbunden ist und

wobei der zweite Leistungsschalter (17') mit seinem ersten Anschluss (26') des zweiten Leistungsschalters (17') mit dem ersten Knoten (2120) verbunden ist und

wobei der zweite Leistungsschalter (17') mit seinem zweiten Anschluss (28') des zweiten Leistungsschalters (17') mit dem dritten Knoten (2140) verbunden ist und

wobei ein erster Anschluss (2305) der Batteriezelle (2145) bzw. der Gruppe von Batteriezellen mit dem zweiten Knoten (2135) verbunden ist und

wobei ein zweiter Anschluss (2310) der Batteriezelle (2145) bzw. der Gruppe von Batteriezellen mit dem dritten Knoten (2140) verbunden ist,

gekennzeichnet dadurch

dass das Batteriezellenmodul (2105) eine Steuervorrichtung (4) umfasst oder mit einer solchen Steuervorrichtung (4) verbunden ist und

dass die Steuervorrichtung (4) dazu eingerichtet ist, den Steueranschluss (27) des ersten Leistungsschalters (17) zu steuern, und

dass die Steuervorrichtung (4) dazu eingerichtet ist, den Steueranschluss (27') des zweiten Leistungsschalters (17') zu steuern, und

dass die Steuervorrichtung (4) dazu eingerichtet ist, den Steueranschluss (27) des ersten Leistungsschalters (17) gegenüber dem Steueranschluss (27') des zweiten Leistungsschalters (17') so gegeneinander zu verriegeln, dass ausgeschlossen ist, dass der erste Leistungsschalter (17) leitend ist, wenn der zweite Leistungsschalter (17') leitend ist.


2. Batteriezellenmodul (2300) nach Merkmal 1,

wobei die Steuervorrichtung (4) Mittel (16, 525, 520, 920, 530, 21, 22, 28, 26, 27, 915, 515, 510, 910, 905 und 16', 525', 520', 920', 530', 21', 22', 28', 26', 27', 915', 515', 510', 910', 905') zum Erfassen des Schaltzustands der Leistungsschalter (17, 17') umfasst und

wobei die Steuervorrichtung (4) dazu eingerichtet ist, mittels dieser Mittel (16, 525, 520, 920, 530, 21, 22, 28, 26, 27, 915, 515, 510, 910, 905 und 16', 525', 520', 920', 530', 21', 22', 28', 26', 27', 915', 515', 510', 910', 905') den Schaltzustand zumindest eines der Leistungsschalter (17, 17'), insbesondere als "An" oder "Aus", zu erfassen.


3. Batteriezellenmodul (2300) nach Merkmal 2,
wobei die Steuervorrichtung (4) zum Überbrücken des Batteriezellenmoduls (2105) dazu eingerichtet ist,

- zuerst den ersten Leistungsschalter (17) zu öffnen und somit einen Stromfluss (2121) durch die Batteriezelle (2145) zu unterbinden und
- dann insbesondere mittels der Mittel (16, 525, 520, 920, 530, 21, 22, 28, 26, 27, 915, 515, 510, 910, 905) zum Erfassen des Schaltzustands des ersten Leistungsschalters (17) zu überprüfen, ob der erste Leistungsschalter (17) geöffnet ist, und
- dann, wenn der zweite Leistungsschalter geöffnet ist, den zweiten Leistungsschalter (17') zuschließen und
- dann der Mittel (16', 525', 520', 920', 530', 21', 22', 28', 26', 27', 915', 515', 510', 910', 905') zum Erfassen des Schaltzustands des zweiten Leistungsschalters (17') zu überprüfen, ob der zweite Leistungsschalter (17') geschlossen ist.


4. Batteriezellenmodul (2200), insbesondere nach einem oder mehreren der vorhergehenden Merkmale,

wobei das Batteriezellenmodul (2200) selbst wieder zumindest ein erstes Batteriezellenmodul (2105) nach einem der Merkmale 1 bis 3 umfasst und

wobei das Batteriezellenmodul (2200) selbst wieder zumindest ein zweites Batteriezellenmodul (2155) nach einem der Merkmale 1 bis 3 umfasst und

wobei der zweite Anschluss (2130) des ersten Batteriezellenmoduls (2105) mit dem ersten Anschluss (2165) des zweiten Batteriezellenmoduls (2155) verbunden ist.

5. Batteriezellenmodul (2600) nach einem der Merkmale 1 bis 4,
wobei der Leistungsschalter (17) und die Steuervorrichtung (4) der Sicherung (825) und die Sicherung (825) mit dem eigentlichen Batteriezellenmodul (2105) in einem Gehäuse (2605) untergebracht sind.

6. Batteriezellenmodul (2600) nach einem der Merkmale 1 bis 5,
wobei die Steuervorrichtung (4) der Sicherung (825) eine optische Datenschnittstelle (550, 551) aufweist.

7. Batteriezellenmodul (2300) nach Merkmal 5 und 6,

wobei das Gehäuse (2605) ein optisches Fenster (545) aufweist, das den Zutritt elektromagnetischer Strahlung (540) für den optischen Transport von Daten von optische Datenschnittstelle (550, 551) der Steuervorrichtung (4) weg und zu der optischen Datenschnittstelle (550, 551) der Steuervorrichtung (4) hin erlaubt und
über die optische Schnittstelle (550, 551) der Steuervorrichtung (4) innerhalb des Gehäuses (2605) mit einer optischen Schnittstelle (555) einer anderen Vorrichtung, beispielsweise ein übergeordnetes Rechnersystem (12) außerhalb des Gehäuses (2665) kommunizieren kann.

8. Batteriezellenmodul (2600) nach einem oder mehreren der Merkmale 4 bis 7

wobei das Gehäuse (2605) ein optisches Fenster (545) und/oder einen optischen Steckverbinder (2640) aufweist, die den Austritt elektromagnetischer Strahlung (540) für den Transport von Daten von der optischen Datenschnittstelle (550, 551) der Steuervorrichtung (4) zu einer Vorrichtung (555, 12) außerhalb des Gehäuses (2605) und/oder von einer Vorrichtung (555, 12) außerhalb des Gehäuses (2605) zu der optischen Datenschnittstelle (550, 551) der Steuervorrichtung (4) erlaubt, und
sodass insbesondere die optische Schnittstelle (510) der Steuervorrichtung (4) innerhalb des Gehäuses (2605) die Steuervorrichtung (4) mit einer optischen Schnittstelle (555) einer anderen Vorrichtung (12), insbesondere eines übergeordneten Rechnersystems (12), außerhalb des Gehäuses (2605) kommunizieren kann.

9. Batteriezellenmodul (2600) nach Merkmal 7 und/oder 8,
wobei es sich bei der elektromagnetischen Strahlung (540) um Laser-Strahlung oder um Strahlung einer LED handelt.

Batteriezellenmodul mit elektronischer Sicherung

1. Batteriezellenmodul (2700), insbesondere eines Fahrzeugs, insbesondere nach einem oder mehreren der vorhergehenden Merkmale,
wobei das Batteriezellenmodul oder eine Gruppe von Batteriezellenmodulen, die das Batteriezellenmodul umfasst, dazu eingerichtet sind, eine Steuervorrichtung (4) einer elektronischen Sicherung (825) und die ggf. sonstigen Teile dieser elektronischen Sicherung (825) mit elektrischer Energie für den Betrieb der elektronischen Sicherung zu versorgen.

2. Batteriezellenmodul (2700) nach Merkmal 1,
wobei der Anzapfpunkt für die Versorgung der Steuervorrichtung (4) der elektronischen Sicherung (825) mit elektrischer Energie zwischen dem Leistungsschalter (17) der elektronischen Sicherung (825) und dem ersten Anschluss (2135) der ersten Batteriezelle (2145), des ersten Batteriezellenmoduls (2105) bzw. der Gruppe von Batteriezellen liegt, sodass die Steuervorrichtung (4) mit elektrischer Energie der Batteriezelle (1245) versorgt wird, wenn der Leistungsschalter (17) der elektronischen Sicherung (17) geöffnet ist.

3. Batteriezellenmodul (2800) nach Merkmal 1 oder 2,
wobei dem Leistungsschalter (17) der elektronischen Sicherung (825) zwischen dem Anzapfpunkt für die Versorgung der Steuervorrichtung (4) der elektronischen Sicherung (825) mit elektrischer Energie und dem ersten Anschluss (2135) der ersten Batteriezelle (2145), des ersten Batteriezellenmoduls (2105) bzw. der Gruppe von Batteriezellen liegt, sodass die Steuervorrichtung (4) nicht mehr mit elektrischer Energie der Batteriezelle (1245) versorgt wird, wenn der Leistungsschalter (17) der elektronischen Sicherung (17) geöffnet ist.

4. Batteriezellenmodul (2200, 2300, 2600, 2700, 2800), insbesondere nach einem oder mehreren der Merkmale 1 bis 3,

wobei das Batteriezellenmodul (2700) eine elektronische Sicherung (825) umfasst und
wobei die elektronische Sicherung (2700) dazu eingerichtet ist, Spannungswerte und/oder Stromwerte zu erfassen, und
wobei die elektronische Sicherung (825) dazu eingerichtet ist, dabei eine Sicherungsfunktion auszuführen, und
wobei die elektronische Sicherung (825) dazu eingerichtet ist, den Stromfluss (2121) zu unterbrechen, wenn eine Auftrennbedingung erfüllt ist.

5. Batteriezellenmodul (2200, 2300, 2600, 2700, 2800) nach Merkmal 4,
wobei die elektronische Sicherung (825) dazu eingerichtet ist, den Stromfluss (2121) zu unterbrechen und die Batteriezelle (1245) oder die Gruppe von Batteriezellen zu überbrücken, wenn eine Auftrennbedingung erfüllt ist und wenn gleichzeitig eine Überbrückungsbedingung erfüllt ist.
6. Batteriezellenmodul (2200, 2300, 2600, 2700, 2800), insbesondere nach einem oder mehreren der Merkmale 1 bis 5,
wobei ein oder mehrere elektronische Sicherungen (825, 805) jeweils zwei Datenschnittstellen (10, 610. 550, 551) umfassen, die optisch sein können.

Batterie mit elektronischer Sicherung

1. Batterie (2200), insbesondere eines Fahrzeugs, insbesondere nach einem oder mehreren der vorhergehenden Merkmale,

wobei die Batterie (2200) eine oder mehrere Batteriezellen (2145, 2185) umfasst und
wobei die Batterie (2200) eine elektronische Sicherung (825, 805) pro Batteriezelle (2145, 2185) oder pro Gruppe von Batteriezellen umfasst.

2. Batterie (2200) nach Merkmal 1,
wobei ein oder mehrere elektronische Sicherungen (825, 805) der Batterie (2200) dazu eingerichtet sind, ein oder mehrere Messwerte und/oder daraus abgeleitete Werte und/oder Zustandswerte und/oder Zustandsinformationen der elektronischen Sicherungen (825, 805) an ein übergeordnetes Steuergerät (12), also beispielsweise ein übergeordnetes Rechnersystem (12), insbesondere über einen Sicherungsdatenbus (9), zu übermitteln.
3. Batterie (2200) nach Merkmal 2,
wobei eine oder mehrere Steuervorrichtungen (4) einer oder mehrerer elektronischer Sicherungen (825, 805) eine oder mehrere Temperatursensorauswertevorrichtungen (585) umfassen.
4. Batterie (2200) nach Merkmal 2 oder 3,
wobei eine oder mehrere Steuervorrichtungen (4) einer oder mehrerer elektronischer Sicherungen (825, 805) eine oder mehrere Temperatursensoren (586) umfassen.
5. Batterie (2200) nach einem oder mehreren der Merkmale 1 bis 4,

wobei die Batterie (2200) einen Sicherungsdatenbus (9) innerhalb der Batterie (2200) aufweist und
wobei Steuervorrichtungen (4) elektronischer Sicherungen (825, 805) über ihre jeweiligen Datenschnittstellen (10, 551, 550, 610) an diesen Sicherungsdatenbus angeschlossen sind oder mittels jeweils zweier solcher Datenschnittstellen (10, 551, 550, 610) in den Sicherungsdatenbus (9) eingefügt sind.

6. Batterie (2200) nach Merkmal 5,

wobei elektronische Sicherungen Datenschnittstellen (10, 551, 550, 610) zwei optische Datenschnittstellen (551, 550) aufweisen und
wobei zumindest ein Teil des Sicherungsdatenbusses (9) einen optischen Datenbus (540), insbesondere in Form einer optischen Datenverbindung (540) umfasst.

7. Batterie (2200) nach Merkmal 6,
wobei der optische Datenbus (540) einen oder mehrere Lichtwellenleiter (580) umfasst, die vorzugsweise elektrisch isolierend sind.
8. Batterie (2200) nach Merkmal 6 oder 7,
wobei der optische Datenbus (540) einen optischen Datenbusring (9') umfasst.

Ideale Diode

1. Ideale Diode (1) zur Verwendung in einem Fahrzeug, insbesondere nach einem oder mehreren der vorhergehenden Merkmale,

mit einem ersten Diodenanschluss (18) und einem zweiten Diodenanschluss (19) und
mit einem Leistungsschalter (17) und
mit einer Steuervorrichtung (4) und
wobei der Leistungsschalter (17) einen ersten Anschluss (26) und einen zweiten Anschluss (28) und einen Steueranschluss (27) umfasst und
wobei der erste Anschluss (26) des Leistungsschalters (17) der ersten Diodenanschluss (18) ist und
wobei der zweite Anschluss (28) des Leistungsschalters (17) der zweiten Diodenanschluss (19) ist und
wobei zum Ersten die Steuervorrichtung (4) der idealen Diode (1) dazu eingerichtet ist, Strommesswerte des elektrischen Stroms (29) durch den Leistungsschalter (17) in Richtung von einer Energiequelle (250) auf einen Verbraucher (220 bis 223) aber auch in umgekehrter Stromrichtung des elektrischen Stroms (29) zu erfassen, und
wobei die Steuervorrichtung (4) dazu eingerichtet ist, den Spannungsmesswerte des Spannungsabfalls über den Leistungsschalter (17), insbesondere zwischen dem ersten Anschluss (26) und dem zweiten Anschluss (28) und/oder zwischen dem ersten Anschluss (26) und dem Steueranschluss (27) und/oder zwischen dem Steueranschluss (27) und dem zweiten Anschluss (28), zu erfassen, und/oder
wobei zum Zweiten die Steuervorrichtung (4) dazu eingerichtet ist, das Vorzeichen des elektrischen Stromes (29) durch den Leistungsschalter (17) zu erfassen, und
wobei die Steuervorrichtung (4) dazu eingerichtet ist, bei einer Umkehrung des elektrischen Stromes (29) durch den Leistungsschalter (17) und/oder bei einer Umkehrung der Richtung des Energiestromes durch den Leistungsschalter (17) diesen Leistungsschalter (17) auszuschalten.

2. Ideale Diode (1) nach Merkmal 1,

wobei die Konstruktion und/oder der Betrieb der idealen Diode eine Vorzugsfließrichtung des elektrischen Stromes (29) vorsehen und
wobei die ideale Diode (1) Mittel zur Erfassung und zur Detektion eines im Vergleich zur Vorzugsfließrichtung rückwärts entgegen der Vorzugsfließrichtung fließenden Stromes (29) umfasst.

3. Ideale Diode (1) nach Merkmal 1 oder 2,

wobei die Steuervorrichtung (4) einen Rechnerkern (2) umfasst und,
wobei der Rechnerkern (2) der Steuervorrichtung (4) der idealen Diode dazu eingerichtet ist, die so erfassten Messwerte, insbesondere Strommesswerte und/oder Spannungsmesswerte und/oder Leistungsmesswerte und/oder Vorzeichen des Strommesswerts des elektrischen Stromes (29), auszuwerten, und
wobei der Rechnerkern dazu eingerichtet ist, die Messwerte, insbesondere Strommesswerte und/oder Spannungsmesswerte und/oder Leistungsmesswerte und/oder Vorzeichen des Strommesswerts des elektrischen Stromes (29), und/oder oder daraus abgeleitete Messwerte an andere Rechnerkerne anderer idealer Dioden und/oder an andere Rechnerkerne anderer elektronischer Sicherungen über einen Sicherungsdatenbus (9) und/oder dergleichen und/oder an ein übergeordnetes Steuergerät (12), also beispielsweise ein übergeordnetes Rechnersystem (12), weiterzugeben.

Elektronische Sicherung mit Datenschnittstelle und Verbraucherabwurf

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder in einem Netzwerk miteinander verbunden sind und

wobei die Baumstruktur oder das Netzwerk Teilbäume bzw. Teilnetzwerke (z.B. 240, 220, 221) umfassen und wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können,

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann.

2. Versorgungsnetzwerk (200) nach Merkmal 1,

wobei die Zusammenschaltung der Datenbusse sternförmig oder linear in einer Kette oder einem geschlossenen Ring erfolgt ist und

wobei die Datenbusse Abzweigungen aufweisen können.

3. Versorgungsnetzwerk (200) nach Merkmal 1 oder 2,

wobei ein oder mehrere elektronische Sicherungen (1, 214 bis 217, 225 bis 228, 235 bis 238, 250, 251) jeweils zwei Datenschnittstellen (214 bis 217, 225 bis 228, 235 bis 238, 250, 251, 610, 10) je elektronischer Sicherung (1, 214 bis 217, 225 bis 228, 235 bis 238, 250, 251) aufweisen, die optisch sein können.

4. Versorgungsnetzwerk (200) nach einem oder mehreren der Merkmale 1 bis 3,

wobei zwei oder mehr elektronische Sicherungen (214 bis 217, 225 bis 228, 235 bis 238, 250, 251) durch einen optischen Datenbus (540) datentechnisch verbunden sind, in den diese elektronischen Sicherungen (214 bis 217, 225 bis 228, 235 bis 238, 250, 251) jeweils eingefügt sind.

5. Versorgungsnetzwerk (200) nach einem oder mehreren der Merkmale 1 bis 4,

wobei zwei oder mehr elektronischen Sicherungen (214 bis 217, 225 bis 228, 235 bis 238, 250, 251) durch einen elektronischen Eindrahtdatenbus (9) und/oder einen elektronischen Zweidrahtdatenbus (9) und/oder einen anderen Datenbus (9) datentechnisch verbunden sind.

6. Versorgungsnetzwerk (200) nach Merkmal 5,

wobei die elektronischen Sicherungen (214 bis 217, 225 bis 228, 235 bis 238, 250, 251) in den Datenbus (9) eingefügt sind.

7. Versorgungsnetzwerk (2900) nach einem oder mehreren der Merkmale 1 bis 6,

wobei ein oder mehrere Versorgungszweige des Versorgungsnetzwerks (2900) zur Versorgung von elektrischen Verbrauchern (2930 bis 2933) mit elektrischer Energie als Ring einer Versorgungsleitung (2910 bis 2915), insbesondere wenn eine Karosserie als Rückleitermasseleitung dient, und/oder als zwei Ringe von zwei Versorgungsleitungen ausgeführt sind und/oder

wobei ein oder mehrere Versorgungszweige des Versorgungsnetzwerks zur Energielieferung von elektrischer Energie aus elektrischen Energiequellen (2940, 2941) als Ring einer Versorgungsleitung (2910 bis 2915), insbesondere wenn eine Karosserie als Rückleitermasseleitung dient, und/oder als zwei Ringe von zwei Versorgungsleitungen ausgeführt sind.

8. Versorgungsnetzwerk (2900) nach Merkmal 7,

wobei für Verbraucher der Verbraucher (2930 bis 2933) jeweils zwei Sicherungen (2960 bis 2967) in die Versorgungsleitung (2910 bis 2915) am jeweiligen Energieentnahmepunkt (2920 bis 2923) für diesen Verbraucher der Verbraucher (2930 bis 2933) in die Versorgungsleitung (2910 bis 2915) eingefügt sind und/oder wobei für Energiequellen (2940, 2941) zwei Sicherungen (2950 bis 2953) in die Versorgungsleitung (2910 bis 2915) am Energieeinspeisepunkt (2924 bis 2925) der elektrischen Energie für diese Energiequellen (2940, 2941) in die Versorgungsleitung (2910 bis 2915) eingefügt sind.

9. Versorgungsnetzwerk (2900) nach Merkmal 8,

wobei genau diejenigen zwei elektronischen Sicherungen der Sicherungen (2950 bis 2953 und 2960 bis 2967), die einem fehlerhaften Leitungsabschnitt der Leitungsabschnitte (2910 bis 2915) zugeordnet sind, dazu eingerichtet sind, bei einem Fehler an dem Leitungsabschnitt ihre Leistungsschalter (17) öffnen, sodass genau diese beiden elektronischen Sicherungen der Sicherungen (2950 bis 2953 und 2960 bis 2967) diesen fehlerhaften Leitungsabschnitt der Leitungsabschnitte (2910 bis 2915) hierdurch isolieren.

10. Versorgungsnetzwerk (2900) nach Merkmal 8 oder 9,

wobei die zwei diesem fehlerhaften Verbraucher zugeordneten elektronischen Sicherungen der Sicherungen (2960 bis 2967) dazu eingerichtet sind, bei einem Fehler an einem Verbraucher der Verbraucher (2930 bis 2933) ihre Leistungsschalter (17) zu öffnen, sodass diese beiden elektronischen Sicherungen den fehlerhaften Verbraucher hierdurch isolieren, und/oder

wobei die zwei dieser fehlerhaften Energiequelle zugeordneten elektronischen Sicherungen der Sicherungen (2950 bis 2953) dazu eingerichtet sind, bei einem Fehler an einer Energiequelle der Energiequellen (2940, 2941) ihre Leistungsschalter zu öffnen, sodass diese beiden elektronischen Sicherungen die fehlerhafte Energiequelle hierdurch isolieren,

wobei dies insbesondere dann der Fall ist, wenn die vorstehenden Fehler die Energieversorgung anderer Verbraucher der Verbraucher (2930 bis 2933) und/oder hoch priorisierter Verbraucher der Verbraucher (2930 bis 2933) die Energieabgabe anderer Energiequelle der Energiequellen (2940, 2941) und/oder hoch priorisierter Energiequellen der Energiequellen (2940, 2941) beeinträchtigen und/oder beeinträchtigen könnten.

Versorgungsnetzwerk mit elektronischen Sicherungen und Autoadressierung der Sicherungen

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können, bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können, und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann, und

wobei die Steuervorrichtung (4) einer elektronischen Sicherung der Sicherungen (2950 bis 2953 und 2960 bis 2967) dazu eingerichtet ist, über eine Datenschnittstelle (10, 610, 550, 551) über einen Datenbus (9) Daten wie Konfigurationsdaten (Schreiben/Lesen/ Programmieren), Schaltbefehle (Schreiben/Lesen/ Programmieren), Diagnosedaten (Schreiben/Lesen), Messwerte (Lesen), Vergleichswerteinstellungen (Schreiben/Lesen/ Programmieren), Progammcode (Schreiben / Lesen / Programmieren) zu empfangen und/oder zu senden zu empfangen und/oder zu senden.

2. Versorgungsnetzwerk (2900) nach Merkmal 1,
wobei der Datenbus (9) in Teilen oder ganz ein Zweidrahtdatenbus ist.

3. Versorgungsnetzwerk (2900) nach Merkmal 2,
wobei der Datenbus (9) ein differenzieller Datenbus ist.

4. Versorgungsnetzwerk (2900) nach Merkmal 3,
wobei der Datenbus (9) ein differenzieller bidirektionaler Datenbus (9) ist.

5. Versorgungsnetzwerk (2900) nach einem der Merkmale 1 bis 4,
wobei der Datenbus (9) ein CAN-Datenbus oder ein Datenbus (9) mit einem Physical-interface eines CAN-Datenbusses, eines CAN-FD-Datenbusses oder eines Flexray-Datenbusses oder eines LVDS-Datenbusses oder dergleichen ist.

6. Versorgungsnetzwerk (2900) nach einem der Merkmale 1 bis 5,

wobei elektronische Sicherungen (2950 bis 2953 und 2960 bis 2967) des Versorgungsnetzwerks (2900) zwei Datenschnittstellen (10, 610, 550, 551) für den Datenbus (9) umfassen und

wobei diese in den Datenbus (9) eingefügt sind und

wobei diese eine lineare Kette von Sicherungen (2950 bis 2953 und 2960 bis 2967) entlang zumindest eines Teils des Datenbusses (9) bilden.

7. Versorgungsnetzwerk (2900) nach Merkmal 6,

wobei ein übergeordnetes Rechnersystem (12), das insbesondere am Anfang dieses Teils des Datenbusses (9) angeschlossen ist, dazu eingerichtet ist, mittels Autoadressierung im Zusammenwirken mit den Steuervorrichtungen (4) der elektronischen Sicherungen für jede der Steuervorrichtungen (4) der elektronischen Sicherungen (2950 bis 2953 und 2960 bis 2967) eine Sicherungsadresse zur Ansteuerung der Rechnerkerne (2) der Steuervorrichtungen (4) zu ermitteln und ggf. an die Rechnerkerne (2) der Steuervorrichtungen (4) der elektronischen Sicherungen (2950 bis 2953 und 2960 bis 2967) zu übermitteln.

Versorgungsnetzwerk mit elektronischen Sicherungen und separatem Verbraucherabwurf

1. Versorgungsnetzwerk (2900) eines Fahrzeugs, insbesondere nach einem oder mehreren der vorhergehenden Merkmale,

wobei das Versorgungsnetz (2900) eine Versorgungsleitung (2910 bis 2915) umfasst und

wobei das Versorgungsnetz (2900) in Teilen ringförmig ist und

wobei Verbraucher (2920 bis 2923) an verschiedenen Energieentnahmepunkten (2920 bis 2923) des ringförmigen Versorgungsnetzes (2900) angeschlossen sind, sodass sie dort elektrische Energie aus der Versorgungsleitung (2910 bis 2915) des Versorgungsnetzes (2900) entnehmen können, und/oder

wobei Energiequellen (2940 bis 2941) an verschiedenen Einspeisepunkten (2924 bis 2925) des ringförmigen Versorgungsnetzes (2900) angeschlossen sind, sodass sie dort elektrische Energie in die Versorgungsleitung (2910 bis 2915) des Versorgungsnetzes (2900) einspeisen können, und

wobei in die Versorgungsleitung (2910 bis 2915) des ringförmigen Versorgungsnetzes (2900) links oder rechts der jeweiligen Entnahmepunkte elektrischer Energie bzw. links oder rechts der jeweiligen Einspeisepunkte elektrischer Energie zumindest auf einer Seite jeweils jeweilige elektronische Sicherungen der Sicherungen (2950 bis 2953 und 2960 bis 2967), insbesondere jeweils genau eine jeweilige elektronische Sicherungen der Sicherungen (2950 bis 2953 und 2960 bis 2967), eingefügt sind und

wobei die jeweilige elektronische Sicherung der Sicherungen (2950 bis 2953 und 2960 bis 2967) mit ihrem jeweiligen Leistungsschalter (17) in die Versorgungsleitung (2910 bis 2915) des Versorgungsleitungsabschnitts

zwischen zwei jeweilige Entnahmepunkte der Entnahmepunkte (2920 bis 2923) für elektrische Verbraucherenergie der zugehörigen Verbraucher der Verbraucher (2930 bis 2933) eingefügt ist oder

zwischen zwei jeweilige Einspeisepunkte der Einspeisepunkte (2924 bis 2924) für elektrische Energie der zugehörigen Energiequellen der Energiequellen (2940 bis 2941) eingefügt ist oder

zwischen einem jeweiligen Einspeisepunkt der Einspeisepunkte (2924 bis 2924) für elektrische Energie der zugehörigen Energiequelle der Energiequellen (2940 bis 2941) und einem jeweiligen Entnahmepunkt der Entnahmepunkte (2920 bis 2923) für elektrische Verbraucherenergie des zugehörigen Verbrauchers der Verbraucher (2930 bis 2933) eingefügt ist.

2. Versorgungsnetzwerk (2900) nach Merkmal 1,

wobei die Versorgungsleitung des ringförmigen Versorgungsnetzes (2900) links und rechts der jeweiligen Entnahmepunkte (2920 bis 2923) elektrischer Energie auf jeder Seite jedes Entnahmepunkts der Entnahmepunkte (2920 bis 2923) jeweils durch eine jeweilige elektronische Sicherung der Sicherungen (2960 bis 2967) unterbrochen ist und/oder

wobei die Versorgungsleitung des ringförmigen Versorgungsnetzes (2900) links und rechts der jeweiligen Einspeisepunkte (2924 bis 2925) elektrischer Energie auf jeder Seite jedes Einspeisepunkts der Einspeisepunkte (2924 bis 2925) jeweils durch eine jeweilige elektronische Sicherung der Sicherungen (2950 bis 2953) unterbrochen ist.

3. Versorgungsnetzwerk (2900) nach Merkmal 2,

wobei die beiden elektronischen Sicherungen, die einem Einspeisepunkt der Einspeisepunkte (2924 bis 2925) oder einem Entnahmepunkt der Entnahmepunkte (2920 bis 2923) oder einem Versorgungsleitungsabschnitt der Versorgungsabschnitte (2910 bis 2915) am nächsten liegen, dazu eingerichtet sind, diesen Einspeisepunkt oder diesen Entnahmepunkt oder diesen Versorgungsleitungsabschnitt durch Öffnen ihrer Leistungsschalter (17) zu isolieren, wenn ein Fehler eines Verbrauchers der Verbraucher (2930 bis 2933) an diesem Entnahmepunkt in diesem Versorgungsleitungsabschnitt der Versorgungsabschnitte (2910 bis 2915) und/oder wenn ein Fehler einer Energiequelle der Energiequellen (2940 bis 2941) an diesem Einspeisepunkt in diesem Versorgungsleitungsabschnitt der Versorgungsabschnitte (2910 bis 2915) auftritt.

4. Versorgungsnetzwerk (2900) nach Merkmal 3,

wobei ein übergeordnetes Rechnersystem (12) dazu eingerichtet ist, den Status der elektronischen Sicherungen (2960 bis 2967 und 2950 bis 2953) durch Ansprache der Rechnerkerne (2) der Steuervorrichtungen (4) der elektronischen Sicherungen (2960 bis 2967 und 2950 bis 2953) über den Datenbus (9) zu ermitteln, und
wobei das übergeordnete Rechnersystem (12) dazu eingerichtet ist, bei Vorliegen einer Störung oder eines Fehlers die Position der Störung bzw. des Fehlers im Versorgungsnetzwerk (2900) zu ermitteln, und
wobei das übergeordnete Rechnersystem (9) dazu eingerichtet ist, die Störung bzw. den Fehler an der ermittelten Position mittels eines Eingriffs in das Versorgungsnetzwerk (2900) einzugrenzen, in dem das übergeordnete Rechnersystem (12) die beiden elektronischen Sicherungen der Sicherungen (2960 bis 2967 und 2950 bis 2953) des Versorgungsnetzwerks (2900), die der Position der Störung am nächsten sind, veranlasst, ihre Leistungsschalter (17) zu öffnen.

5. Versorgungsnetzwerk (2900) nach Merkmal 4,

wobei der Eingriff durch das übergeordnete Rechnersystem (12) schneller als das doppelte der längsten Zeitkonstante der Energieentnahmen der Verbraucher (2920 bis 2923) ist, die zum Zeitpunkt des Eingriffs aus dem Versorgungsnetzwerk (2900) Energie beziehen, und/oder
wobei der Eingriff durch das übergeordnete Rechnersystem (12) schneller als das doppelte der längsten Zeitkonstante der Energieeinspeisungen der Energiequellen (2940 bis 2941) ist, die in das Versorgungsnetzwerk (2900) Energie einspeisen.

6. Versorgungsnetzwerk (2900) nach Merkmal 4 oder 5,

wobei eine elektronische Sicherung der Sicherungen (2950 bis 2953 und 2960 bis 2967) dazu eingerichtet ist, die Störungen und/oder Fehler in Form einer Log-Tabelle (2970), die auch nur wenige Bits umfassen kann, oder einer Log-Datei (2970) aufzuzeichnen, und/oder
wobei ein übergeordnetes Rechnersystem (12) dazu eingerichtet ist, die Störungen und/oder die Fehler im Versorgungsnetzwerk (2900) und/oder die Störungen und/oder die Fehler der Sicherungen (2950 bis 2953 und 2960 bis 2967) in Form einer Log-Tabelle (2970), die auch nur wenige Bits umfassen kann, oder einer Log-Datei (2970) aufzuzeichnen.

7. Versorgungsnetzwerk (2900) nach Merkmal 6,

wobei die Steuereinrichtung (4) der elektronischen Sicherung dazu eingerichtet ist, die Einträge der Log-Tabelle (2970) bzw. der Log-Datei (2970) mit einem Zeitstempeln einer Zeitgebereinheit (35) der Steuervorrichtung (4) der elektronischen Sicherung zu versehen, und/oder)
wobei das übergeordnetes Rechnersystem (12) dazu eingerichtet ist, die Einträge der Log-Tabelle (2970) bzw. der Log-Datei (2970) mit einem Zeitstempeln einer Zeitgebereinheit (1970) des übergeordneten Rechnersystems (12) zu versehen.

8. Versorgungsnetzwerk (2900) nach Merkmal 7,

wobei die Steuervorrichtung (4) der elektronischen Sicherung dazu eingerichtet ist, in der Log-Tabelle (2970) bzw. der Log-Datei (2970) auch mit einem Zeitstempel aufzuzeichnen, ab wann die Störung nicht mehr bestand, und/oder
wobei das übergeordnetes Rechnersystem (12) dazu eingerichtet ist, in der Log-Tabelle (2970) bzw. der Log-Datei (2970) auch mit einem Zeitstempel aufzuzeichnen, ab wann die Störung nicht mehr bestand.

9. Versorgungsnetzwerk (2900), insbesondere nach einem der Merkmale 7 oder 8,

wobei ein übergeordnetes Rechnersystem (12) dazu eingerichtet ist, regelmäßig oder bei einer Störung oder einem Fehler die Log-Tabelle (2970) bzw. die Log-Datei (2970) einer Sicherung der Sicherungen (2950 bis 2953 und 2960 bis 2963) über den Datenbus (9) aus dieser elektronischen Sicherung auszulesen.

10. Versorgungsnetzwerk (2900) nach Merkmal 9,

wobei das übergeordnete Rechnersystem (12) dazu eingerichtet ist, mit Hilfe einer oder mehrerer seiner Log-Tabellen (2970) bzw. einer oder mehrerer seiner Log-Dateien (2970) und/oder mit Hilfe einer oder mehrerer Log-Tabellen (2970) bzw. einer oder mehrerer Log-Dateien (2970) einer oder mehrerer elektronischer Sicherungen der Sicherungen (2950 bis 2953 und 2960 bis 2967) potenziell betroffene Sensoren und Messsysteme, die durch das Versorgungsnetzwerk (2900) mit elektrischer Energie versorgt werden, zu identifizieren und die im relevanten Zeitraum von diesen akquirierte Messwerte als potenziell fehlerhaft zu markieren oder zu verwerfen.

Elektronische Sicherung mit Hot-Plug-Erkennung

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können, bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können, und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann.

wobei eine Versorgungsleitung (2910 bis 2015 und 2920 bis 2923) des Versorgungsnetzwerks (3100) eine Steckverbindung der Steckverbindungen (3020 bis 2023), einen Stecker oder eine Buchse, für den Anschluss und die Versorgung eines Verbrauchers der Verbraucher (2930 bis 2033) aufweist und/oder

wobei eine Versorgungsleitung (2910 bis 2015 und 2924 bis 2925) des Versorgungsnetzwerks (3100) eine Steckverbindung der Steckverbindungen (3024 bis 2025), einen Stecker oder eine Buchse für den Anschluss und die Energieeinspeisung einer Energiequelle der Energiequellen (2940 bis 2041) aufweist und

wobei eine elektronische Sicherung der Sicherungen (3110 bis 3113) in der Nähe der Steckverbindung der Steckverbindungen (3020 bis 3023) zur Energieentnahme durch den elektrischen Verbraucher der elektrischen Verbraucher (2930 bis 2933) aus der betreffende Versorgungsleitung (2910 bis 2915 und 2920 bis 2925) eingefügt ist und/oder

wobei eine elektronische Sicherung der Sicherungen (3110 bis 3113) in der Nähe der Steckverbindung der Steckverbindungen (3020 bis 3023) zur Energieeinspeisung durch die Energiequelle der Energiequellen (2940 bis 2941) in die betreffende Versorgungsleitung (2910 bis 2915 und 2920 bis 2925) eingefügt ist und

wobei diese elektronische Sicherung dazu eingerichtet ist, ein Hot-Plug-Ereignis betreffend diese Steckverbindung der Steckverbindungen (3020 bis 3023) dadurch zu erkennen,

dass die elektronische Sicherung den transienten Zeitverlauf der Spannung des Potenzials eines Knotens des Leistungsschalters (17) dieser Sicherung gegen das Potenzial eines Bezugsknotens, insbesondere gegenüber eines Massepotenzials, überwacht und/oder

dass diese elektronische Sicherung den transienten Verlauf des Stromes durch den Leistungsschalter (17) dieser elektronischen Sicherung überwacht und

dass die Steuervorrichtung (4) dieser elektronischen Sicherung einen oder mehrere dieser transienten Verläufe überwacht.

2. Versorgungsnetzwerk (3100) nach Merkmal 1,
wobei diese elektronische Sicherung dazu eingerichtet ist, den Leistungsschalter (17) im Falle eines Hot-Plug-Ereignisses auszuschalten.

3. Versorgungsnetzwerk (3100) nach Merkmal 1 oder 2,
wobei diese elektronische Sicherung dazu eingerichtet ist, ein Hot-Plug-Ereignis über den Datenbus (9) an ein übergeordnetes Rechnersystem (12) zu melden.

3. Versorgungsnetzwerk (3100), insbesondere nach Merkmal 2,

wobei eine elektronische Sicherung dazu eingerichtet ist, im Normalbetrieb diesen Normalbetrieb optisch für einen Menschen erkennbar, insbesondere mittels eines Leuchtmittels und/oder einer LED und/oder einer Anzeige und/oder eines Displays eines Datenausgabemittels (740) der Sicherung oder des übergeordneten Rechnersystems (12) und/oder als Dateninformation über den Datenbus (9), zumindest zeitweise und/oder auf Anforderung, insbesondere auf Anforderung des übergeordneten Rechnersystems (12) oder eines Bedienenden (730) mittels des Dateneingabe- und Datenausgabemittels (740), zu signalisieren und/oder

wobei eine elektronische Sicherung dazu eingerichtet ist, im Falle eines Fehlers und/oder einer Störung und/oder eines Hot-Plug-Ereignisses diesen Fehlers bzw. diese Störung bzw. dieses Hot-Plug-Ereignis optisch für einen Menschen erkennbar, insbesondere mittels eines Leuchtmittels und/oder einer LED und/oder einer Anzeige und/oder eines Displays eines Datenausgabemittels (740) der Sicherung oder des übergeordneten Rechnersystems (12) und/oder als Dateninformation über den Datenbus (9), zumindest zeitweise und/oder auf Anforderung, insbesondere auf Anforderung des übergeordneten Rechnersystems (12) oder eines Bedienenden (730) mittels des Dateneingabe- und Datenausgabemittels (740), zu signalisieren.

4. Versorgungsnetzwerk nach Merkmal 2 oder 3,

wobei die elektronische Sicherung dazu eingerichtet ist, im Falle eines Hot-Plug-Ereignisses im Versorgungsnetzwerk (3100) eine Meldung an einen Rechner (710, 750) eines Dienstanbieters zu übermitteln und/oder
wobei die elektronische Sicherung dazu eingerichtet ist, im Falle eines Hot-Plug-Ereignisses im Versorgungsnetzwerk (3100) eines Fahrzeugs eine Meldung an einen Rechner (710) eines Fahrzeugherstellers oder eines Dienstanbieters unmittelbar oder zeitversetzt zu übermitteln.

Versorgungsnetzwerk mit Synchronisation der Zeitgeber der elektronischen Sicherungen

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B. 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können, und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei Steuervorrichtungen (4) elektronischer Sicherungen des Versorgungsnetzwerks (3100) Uhren oder Zeitgeber (35), insbesondere für die Erstellung von Zeitstempeln für LOG-Tabellen und/oder Log-Dateien, aufweisen und/oder

wobei ein übergeordnetes Rechnersystem (12) des Versorgungsnetzwerks eine oder mehrere Uhren oder einen oder mehrere Zeitgeber (1970), insbesondere für die Erstellung von Zeitstempeln für LOG-Tabellen und/oder Log-Dateien, aufweist und/oder

wobei das übergeordnete Rechnersystem (12) dazu eingerichtet ist, regelmäßig mittels eines Synchronisationssignals, insbesondere über den Datenbus (9), Uhren und/oder Zeitgeber (35, 1970) im Versorgungsnetzwerk (3100) zu synchronisieren.

2. Versorgungsnetzwerk (3100) nach Merkmal 1,

wobei die Synchronisation von Uhren und/oder Zeitgeber (35, 1970) im Versorgungsnetzwerk (3100) ein Rücksetzen auf einen gemeinsamen Startwert dieser Uhren und/oder Zeitgeber (35, 1970) umfasst und/oder wobei die Synchronisation von Uhren und/oder Zeitgeber (35, 1970) im Versorgungsnetzwerk (3100) eine Korrektur der Frequenz und/oder der Phase der Oszillatoren (30) der elektronischen Sicherungen (2950 bis 2953 und 2960 bis 2967 und 3110 bis 3113 und 3120 bis 3121), insbesondere mittels einer PLL, umfasst.

3. Versorgungsnetzwerk (3100) nach Merkmal 1 oder 2,
wobei ein übergeordnetes Rechnersystem (12) Steuervorrichtungen (4) elektronischer Sicherungen (2950 bis 2953 und 2960 bis 2967 und 3110 bis 3113 und 3120 bis 3121) mittels eines Befehls über den Datenbus (9) im Broadcasting-Modus an mehrere und/oder alle dieser Sicherungen (2950 bis 2953 und 2960 bis 2967 und 3110 bis 3113 und 3120 bis 3121) dazu veranlasst, zu gleichen Zeitpunkten bevorzugt gleiche Messungen auszuführen, wobei "gleiche Zeitpunkte" sich hierbei auf die Gleichheit der Uhrenstände der jeweiligen Uhren und/oder der Zeitgeberstände der Zeitgeber (35) der verschiedenen Steuervorrichtungen (4) der verschiedenen elektronischen Sicherungen (2950 bis 2953 und 2960 bis 2967 und 3110 bis 3113 und 3120 bis 3121) bezieht.
4. Versorgungsnetzwerk (3100) nach Merkmal 3,
wobei mindestens zwei elektronische Sicherungen (2950 bis 2953 und 2960 bis 2967 und 3110 bis 3113 und 3120 bis 3121) des Versorgungsnetzwerks (3100), eine erste Steuervorrichtung (4) einer ersten elektronischen Sicherung und eine zweite Steuervorrichtung (4) einer zweiten elektronischen Sicherung dieser Sicherungen (2950 bis 2953 und 2960 bis 2967 und 3110 bis 3113 und 3120 bis 3121), dazu eingerichtet sind, ein verteiltes Messverfahren mit synchronen Messungen mittels zweier synchronisierten lokaler Uhren (35) und/oder Zeitgeber (35) durchzuführen, wobei die zwei lokalen Uhren (35) und/oder Zeitgeber (35) sich jeweils innerhalb der jeweiligen Steuervorrichtung (4) der mindestens zwei elektronischen Sicherungen befinden.
5. Versorgungsnetzwerk (3100) nach Merkmal 4,

wobei zumindest die Steuervorrichtungen (4) dazu eingerichtet ist, sofern notwendig, die so erfassten Messwerte an ein übergeordnetes Rechnersystem (12) über den Datenbus (9) zu übermitteln, und wobei eine erste der Steuervorrichtungen (4) einer ersten der elektronischen Sicherungen das übergeordnete Rechnersystem (12) sein kann und wobei die erste Sicherung und die zweite Sicherung über einen oder mehrere Versorgungsleitungsabschnitte miteinander verbunden sind und wobei das übergeordnete Rechnersystem (12) dazu eingerichtet ist, aus den übermittelten Daten auf einen Parameter des Versorgungsleitungsabschnitts zwischen der ersten elektronischen Sicherung und der zweiten elektronischen Sicherung zu schließen.

6. Versorgungsnetzwerk (3100) nach Merkmal 5,
wobei das übergeordnete Rechnersystem (12) dazu eingerichtet ist, aus den über den Datenbus (9) übermittelten Daten auf die Temperatur und/oder den elektrischen Widerstand eines oder mehrerer Versorgungsleitungsabschnitte zwischen der ersten elektronischen Sicherung und der zweiten elektronischen Sicherung zu schließen.

Versorgungsnetzwerk mit Energieverfügbarkeitsgesteuerter Topologieanpassung

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können, und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei das Versorgungsnetzwerk (1100) ein übergeordnetes Rechnersystem (12) umfasst und

wobei das übergeordnete Rechnersystem (12) dazu eingerichtet ist, den Energiebedarf von Verbrauchern (1121 bis 1125) im Versorgungsnetzwerk (1100) zu ermitteln, und

wobei das übergeordnete Rechnersystem (12) dazu eingerichtet ist, die Energielieferfähigkeit von Energiequellen (1150 bis 1155) im Versorgungsnetzwerk (1100) zu ermitteln, und

wobei das übergeordnete Rechnersystem (12) dazu eingerichtet ist, das Versorgungsnetz (1100) mittels Umschaltung elektronischer Sicherungen (1110 bis 1118) über den Datenbus (9) in Abhängigkeit von dem ermittelten Energiebedarf und/oder der ermittelten Energielieferfähigkeit und/oder dem Sicherheitsbedarf, insbesondere basierend auf Daten des Fahrzeugzustands und/oder des Fahrzeugumfelds und/oder des Zustands der Insassen und/oder anderen Faktoren, die dem übergeordneten Rechnersystem (12) zur Verfügung stehen, umzukonfigurieren.

Versorgungsnetzwerk mit Topologiesteuerung über authentifizierte Kommandos

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei das Versorgungsnetzwerk (1100) ein übergeordnetes Rechnersystem (12) umfasst und

wobei das übergeordnete Rechnersystem (12) dazu eingerichtet ist, Teilversorgungsnetze des Versorgungsnetzes (1100) mittels elektronischer Sicherungen (1110 bis 1118), die in Versorgungszweige des Versorgungsnetzes (1100) eingefügt sind, mittels Datenbotschaften über den Datenbus (9), insbesondere zu Wartungszwecken, abzuschalten.

2. Versorgungsnetzwerk (1100) nach Merkmal 1,
wobei zumindest eine der Datenbotschaften einen Sicherheitscode umfasst, der die Abschaltung erst ermöglicht.
3. Versorgungsnetzwerk (1100) nach Merkmal 2,
wobei ein Servers (710) eines Dienstleistungsanbieter oder des Automobilherstellers oder eines Erfüllungsgehilfen des Automobilherstellers dazu eingerichtet ist, den Sicherheitscode oder Daten zur Erzeugung des Sicherheitscodes durch das übergeordnete Rechnersystem (12) oder Steuervorrichtungen (4) der elektronischen Sicherungen (1110 bis 1118) an das übergeordnete Rechnersystem (12) oder eine Steuervorrichtung (4) der elektronischen Sicherung (1110 bis 1118) zu übermitteln.
4. Versorgungswerk (1100) nach einem der Merkmale 1 bis 3
wobei der Datenbus (9) direkt oder indirekt z.B. über Gateways oder dergleichen mit einem Terminal (740) für eine Eingabe zur Umkonfiguration des Versorgungsnetzwerks (1100) mittels der elektronischen Sicherungen versehen ist.
5. Versorgungsnetzwerk (1100) nach Merkmal 3 und 4,

wobei das Terminal (740) dazu eingerichtet ist, auch der Übermittlung von Authentifizierungsdaten, an einen Server (710) des Automobilherstellers oder eines Erfüllungsgehilfen des Automobilherstellers zu dienen,
wobei die die Authentifizierungsdaten insbesondere Authentifizierungsdaten der bedienenden Person (730) und/oder Authentifizierungsdaten der Organisation, für die die Person (730) tätig ist, und/oder Authentifizierungsdaten des Fahrzeugs oder und/oder Authentifizierungsdaten des Autoschlüssels des Fahrzeugs und/oder der ähnliche Authentifizierungsdaten umfassen können und
wobei das Terminal (740) dazu eingerichtet ist, den Sicherheitscode von dem Server (710) des Automobilherstellers oder eines Erfüllungsgehilfen des Automobilherstellers in Abhängigkeit von den Authentifizierungsdaten zu erhalten.

KI gesteuerte Topologieanpassung eines Versorgungsnetzwerks

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B: 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei eine Steuervorrichtung (4) einer abtrennenden elektronischen Sicherung des Versorgungsnetzwerks (1100) dazu eingerichtet ist, mittels eines Leistungsschalters (17) der elektronischen Sicherung ein Teilversorgungsnetz des Versorgungsnetzes (1100) stromlos und/oder spannungslos zu schalten oder schalten zu können und damit isolieren zu können.

2. Versorgungsnetzwerk (1100) nach Merkmal 1,
wobei in dem so isolierbaren Teilversorgungsnetz zumindest eine elektronische Sicherung vorgesehen ist, die dazu eingerichtet ist, ein durch das Öffnen ihres Leistungsschalters (17) dieser elektronischen Sicherung isolierte Teilversorgungsnetz durch Schließen des weiteren Leistungsschalters (17') dieser elektronischen Sicherung mit einer Bezugsspannungsleitung, insbesondere einer Masseleitung, kurzschließt und so entlädt oder auf ein definiertes Potenzial bringt.

3. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B: 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

mit einem übergeordneten Rechnersystem (12),

wobei das übergeordnete Rechnersystem (12) im Falle eines Systemnotlaufszenarios die Stromaufnahme eines Verbrauchers der Verbraucher (1121 bis 1125) des Versorgungsnetzwerks (1100) an die schwächste Versorgungsleitung im Pfad zwischen einer oder mehreren Energiequellen der Energiequellen (1150 bis 1155) des Versorgungsnetzwerks (1100) einerseits und diesem Verbraucher der Verbraucher (1121 bis 1125) andererseits durch Umkonfiguration oder Betriebsparameteränderung dieses Verbrauchers mittels eines oder des Datenbusses (9) anpasst und/oder

wobei das übergeordnete Rechnersystem (9) im Falle eines Systemnotlaufszenarios die Stromlieferfähigkeit einer Energiequelle der Energiequellen (1150 bis 1155) des Versorgungsnetzwerks (1100) an die schwächste Versorgungsleitung im Pfad zwischen dieser Energiequelle der Energiequellen (1150 bis 1155) des Versorgungsnetzwerks (1100) einerseits und Verbrauchern der Verbraucher (1121 bis 1125) des Versorgungsnetzwerks (1100) durch Umkonfiguration oder Betriebsparameteränderung dieser Energiequelle der Energiequellen (1150 bis 1155) des Versorgungsnetzwerks (1100) anpasst.

4. Versorgungsnetzwerk (1100) nach Merkmal 3,

wobei das übergeordnete Rechnersystem (12) eine Konfigurationsänderung des Versorgungsnetzes (1100) durch entsprechende Befehle über einen oder mehrere Datenbusse (9) an elektronische Sicherungen (1110 bis 1118) des Versorgungsnetzes (1100) initiiert und

wobei zum Ersten das übergeordnete Rechnersystem (12) ermittelt, wieviel ein Verbraucher der Verbraucher (1121 bis 1125) des Versorgungsnetzwerks (1100), der von der Konfigurationsänderung des Versorgungsnetzes (1100) betroffen ist, an Energie verbrauchen darf, um das Versorgungsnetz (1100) an keiner Stelle zu überlasten und

wobei das übergeordnete Rechnersystem (12) diesem betreffenden Verbraucher der Verbraucher (1121 bis 1125) des Versorgungsnetzwerks (1100) mitteilt, wieviel Energie dieser Verbraucher der Verbraucher (1121 bis 1125) des Versorgungsnetzwerks (1100) aus dem Versorgungsnetz (1100) aufnehmen darf und/oder

wobei zum Zweiten das übergeordnete Rechnersystem (12) ermittelt, wieviel eine Energiequelle der Energiequelle der Energiequellen (1150 bis 1155) des Versorgungsnetzwerks (1100), die von der Konfigurationsänderung des Versorgungsnetzes (1100) betroffen ist, an Energie liefern darf, um das Versorgungsnetz (1100) an keiner Stelle zu überlasten und

wobei das übergeordnete Rechnersystem (12) dieser betreffenden Energiequelle der Energiequellen (1150 bis 1155) des Versorgungsnetzwerks (1100) mitteilt, wieviel Energie diese Energiequelle der Energiequellen (1150 bis 1155) des Versorgungsnetzwerks (1100) liefern darf.

5. Versorgungsnetzwerk (1100) nach Merkmal 4,

wobei ein Verbraucher der Verbraucher (1121 bis 1125) des Versorgungsnetzwerks (1100) einen ersten Zustand, in dem er mehr Energie aufnimmt, und einen zweiten Zustand, in dem er weniger Energie als im ersten Zustand aufnimmt, und einen dritten Zustand in dem er keine Energie aufnimmt, aufweist und/oder

wobei eine Energiequelle der Energiequellen (1150 bis 1155) des Versorgungsnetzwerks (1100) einen ersten Zustand, in dem sie mehr Energie liefert, und einen zweiten Zustand, in dem sie weniger Energie als im ersten Zustand liefert, und einen dritten Zustand in dem sie keine Energie liefert, aufweist.

6. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B. 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei ein oder mehrere Rechnerkerne (2) von Steuervorrichtungen (4) elektronischer Sicherungen der elektronischen Sicherungen (1110 bis 1118) im Versorgungsnetzwerk (1100) dazu eingerichtet sind, Messwerte mittels Messmitteln dieser elektronischen Sicherungen (1100 bis 1118) zu ermitteln, und
wobei die Rechnerkerne (2) dieser Steuervorrichtungen (4) dieser elektronischen Sicherungen der elektronischen Sicherungen (1110 bis 1118) im Versorgungsnetzwerk (1100) dazu eingerichtet sind, diese Messwerte über einen Datenbus (9) an ein übergeordnetes Rechnersystem (12) zu übertragen, und
wobei das übergeordnete Rechnersystem (12) dazu eingerichtet ist, ein neuronales Netzwerkmodell auszuführen, und
wobei das übergeordnete Rechnersystem (12) dazu eingerichtet ist, die ermittelten Messwerte und/oder davon abhängige Werte als Eingangswerte des neuronalen Netzwerkmodells zu verwenden, und
wobei zumindest der Schaltzustand eines Leistungsschalters (17) einer elektronischen Sicherung (1110 bis 1118) im Versorgungsnetzwerk (1100) und/oder zumindest eine Datenbotschaft des übergeordneten Rechnersystems (12) an ein anderes Rechnersystem (710, 750, 740) oder eine Signalisierung des übergeordneten Rechnersystems (12) an einen Nutzer (730) von einem Ausgangssignal und/oder Ausgangswert des neuronalen Netzwerkmodells abhängt.

7. Versorgungsnetzwerk (1100) nach Merkmal 6,
wobei das neuronale Netzwerkmodell vor der Verwendung in dem übergeordneten Rechnersystem (2) der Sicherung mit geeigneten Trainingsdaten aus der Entwicklungszeit eines oder mehrerer modellhafter Labor-Versorgungsnetzwerke trainiert und parametrisiert worden ist.

8. Versorgungsnetzwerk (1100) nach Merkmal 7,
wobei das übergeordnete Rechnersystem (12) dazu eingerichtet ist, mittels eines Ausgangssignals und/oder eines Ausgangswerts des neuronalen Netzwerkmodells einen möglicherweise drohenden oder bereits eingetretenen möglicherweise drohenden oder bereits eingetretenen Ausfall eines oder mehrerer Verbraucher der Verbraucher (1121 bis 1125) und/oder einen möglicherweise drohenden oder bereits eingetretenen möglicherweise drohenden oder bereits eingetretenen Ausfall eines oder mehrerer Energiequellen (1150 bis 1155) und/oder einen möglicherweise drohenden oder bereits eingetretenen möglicherweise drohenden oder bereits eingetretenen Ausfall einer oder mehrerer Versorgungsleitungen und/oder Versorgungsleitungsabschnitte (1160 bis 1183) und/oder einen möglicherweise drohenden oder bereits eingetretenen möglicherweise drohenden oder bereits eingetretenen Ausfall einer oder mehrerer elektronischer Sicherungen (1110 bis 1118) oder einen anderen möglicherweise drohenden oder bereits eingetretenen Defekt des Versorgungsnetzwerks (1100) und/oder eines oder mehrerer der Vorrichtungsteile des Versorgungsnetzwerks (1100) zu erkennen.

Spektral gesteuerte Topologieanpassung eines Versorgungsnetzwerkes

1. Versorgungsnetzwerk (200) für die Versorgung elektrischer Verbraucher (210 bis 213 und 220 bis 223 und 230 bis 233) eines Fahrzeugs mit elektrischer Energie (Figur 7)

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B: 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei eine oder mehrere elektronische Sicherungen der elektronischen Sicherungen (1110 bis 1118) des Versorgungsnetzwerks (1100) Mittel zur Erfassung des jeweiligen zeitlichen Verlaufs des jeweiligen elektrischen Stroms (29) durch den jeweiligen Leistungsschalter (17) der jeweiligen elektronischen Sicherung der elektronischen Sicherungen (1110 bis 1118) umfassen und
wobei diese Mittel dazu eingerichtet sind, zumindest zeitweise den zeitlichen Verlauf des jeweiligen elektrischen Stroms (29) durch den jeweiligen Leistungsschalter (17) der betreffenden elektronischen Sicherung der elektronischen Sicherungen (1110 bis 1118) zu erfassen.

2. Versorgungsnetzwerk (200) für die Versorgung elektrischer Verbraucher (210 bis 213 und 220 bis 223 und 230 bis 233) mit elektrischer Energie (Figur 7)

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B: 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei zumindest eine elektronische Sicherung der elektronischen Sicherungen (1110 bis 1118) des Versorgungsnetzwerks (1100) Mittel zur Erfassung des zeitlichen Verlaufs der Spannung zwischen einem Anschluss (26, 27, 28) des jeweiligen Leistungsschalters (17) der jeweiligen elektronischen Sicherung der elektronischen Sicherungen (1110 bis 1118) einerseits und einem Bezugspotenzial andererseits umfasst und

wobei diese Mittel dazu eingerichtet sind, zumindest zeitweise den zeitlichen Verlauf der Spannung zwischen dem Anschluss (26, 27, 28) des jeweiligen Leistungsschalters (17) der jeweiligen elektronischen Sicherung der elektronischen Sicherungen (1110 bis 1118) und dem Bezugspotenzial zu erfassen und/oder

wobei zumindest diese elektronische Sicherung der elektronischen Sicherungen (1110 bis 1118) des Versorgungsnetzwerks (1100) Mittel zur Erfassung des zeitlichen Verlaufs der Spannung zwischen einem Anschluss (26, 27, 28) des jeweiligen Leistungsschalters (17) der jeweiligen elektronischen Sicherung der elektronischen Sicherungen (1110 bis 1118) einerseits und einem weiteren Anschluss (26, 27, 28) des jeweiligen Leistungsschalters (17) der jeweiligen elektronischen Sicherung der elektronischen Sicherungen (1110 bis 1118) andererseits umfasst und/oder

wobei diese Mittel dazu eingerichtet sind, zumindest zeitweise den zeitlichen Verlauf der Spannung zwischen dem Anschluss (26, 27, 28) des jeweiligen Leistungsschalters (17) der jeweiligen elektronischen Sicherung der elektronischen Sicherungen (1110 bis 1118) und dem weiteren Anschluss (26, 27, 28) des jeweiligen Leistungsschalters (17) der jeweiligen elektronischen Sicherung der elektronischen Sicherungen (1110 bis 1118) zu erfassen.

2. Versorgungsnetzwerk (1100) nach Merkmal 1 und/oder 2,
wobei Steuervorrichtungen (4) elektronischer Sicherungen (1110 bis 1118) dazu eingerichtet sind, die Daten der erfassten Verläufe über einen Datenbus (9) an ein übergeordnetes Rechnersystem (12) zu übertragen.

3. Versorgungsnetzwerk (1100, 1700) nach Merkmal 2,

wobei das übergeordnete Rechnersystem (12) dazu eingerichtet ist, Spektralanalysen der Daten der Verläufe, beispielsweise durch Fourier- oder Laplace-Transformation oder Wavelet-Transformation, durchzuführen und Werte der Spektren zu ermitteln und

wobei das übergeordnete Rechnersystem (12) dazu eingerichtet ist, bei wesentlichen Abweichungen der Werte der Spektren von Erwartungswertintervallen für die Werte der Spektren auf die Notwendigkeit einer präventiven Wartung zu schließen oder eine Signalisierung an ein anderes Rechnersystem (750, 710) oder eine Anzeige (740) vorzunehmen.

4. Versorgungsnetzwerk (1100) nach Merkmal 2 und/oder 3,

wobei das übergeordnete Rechnersystem (12) dazu eingerichtet ist, Spektralanalysen der Daten der Verläufe, beispielsweise durch Fourier- oder Laplace-Transformation oder Wavelet-Transformation, durchzuführen und Werte der Spektren zu ermitteln und

wobei das übergeordnete Rechnersystem (2) dazu eingerichtet ist, die Systemverfügbarkeit von Vorrichtungsteilen des Versorgungsnetzwerks und/oder des Versorgungsnetzwerks (1100) selbst mittels ermittelter Spektren zu bewerten und ggf. das Bewertungsergebnis an andere Rechnersysteme (710, 750, 740, 4) zu signalisieren und/oder Parameter des Fahrzeugs in Abhängigkeit von dieser Bewertung ändert.

5. Versorgungsnetzwerk (1100) nach Merkmal 4,

wobei das übergeordnete Rechnersystem (12) dazu eingerichtet ist, einen Verbraucher der Verbraucher (1121 bis 1125) des Versorgungsnetzwerks (1100) als "wahrscheinlich verfügbar" zu bewerten, wenn die Charakteristik von Strom- oder Spannungsspektren von Messwerten einer elektronischen Sicherung der Sicherungen (1110 bis 1118) des Versorgungsnetzwerks (1100), die diesem Verbraucher der Verbraucher (1121 bis 1125) des Versorgungsnetzwerks (1100) zugeordnet ist, mit den Erwartungswerten innerhalb erlaubter Bandbreiten übereinstimmt und/oder

wobei das übergeordnete Rechnersystem (12) dazu eingerichtet ist, eine Energiequelle der Energiequellen (1150 bis 1155) des Versorgungsnetzwerks (1100) als "wahrscheinlich verfügbar" bewertet, wenn die Charakteristik von Strom- oder Spannungsspektren von Messwerten einer elektronischen Sicherung der Sicherungen (1110 bis 1118) des Versorgungsnetzwerks (1100), die dieser Energiequelle der Energiequellen (1150 bis 1155) des Versorgungsnetzwerks (1100) zugeordnet ist, mit den Erwartungswerten innerhalb erlaubter Bandbreiten übereinstimmt.

Priorisierte Topologieanpassung eines Versorgungsnetzes vor einem zu erwartenden Unfall eines Fahrzeugs

1. Versorgungsnetzwerk (200) für die Versorgung elektrischer Verbraucher (210 bis 213 und 220 bis 223 und 230 bis 233) eines Fahrzeugs mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei ein übergeordnetes Rechnersystem (12) dazu eingerichtet ist, mittels elektronischer Sicherungen der Sicherungen (1110 bis 1118) des Versorgungsnetzwerks (1100)in dem Versorgungsnetzwerk (1100) nicht benötigte und/oder gefährliche und/oder gefährdete Versorgungsteilnetze des Versorgungsnetzwerks (1100) mittels entsprechender Befehle an Steuervorrichtungen (4) elektronischer Sicherungen der Sicherungen (1110 bis 1118) des Versorgungsnetzwerks (1100), die sie über den Datenbus (9) sendet, abzuschalten,

wenn ein Steuergerät des Fahrzeugs und/oder das übergeordnete Rechnersystem (12) zu dem Schluss gekommen sind, dass ein Unfall des Fahrzeugs wahrscheinlich ist.

2. Versorgungsnetzwerk (1100) nach Merkmal 1,

wobei ein übergeordnetes Rechnersystem (12) oder ein Steuergerät dazu eingerichtet sind, die Wahrscheinlichkeit eines Unfalls des Fahrzeugs zu berechnen und darauf zu schließen, dass ein Unfall des Fahrzeugs wahrscheinlich ist, wenn die berechnete Wahrscheinlichkeit über einem Schwellwert für einen solchen Unfall liegt.

3. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B: 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei ein übergeordnetes Rechnersystem (12) dazu eingerichtet ist, eine zukünftige Stromaufnahme eines oder mehrerer Verbraucher der Verbraucher (1121 bis 1125 des Versorgungsnetzwerks (1100) vorauszuberechnen, und

wobei das übergeordnete Rechnersystem (12) dazu eingerichtet ist, über einen Datenbus (9) ein oder mehrere Leistungsschalter (17) einer oder mehrerer elektronischer Sicherungen der Sicherungen (1110 bis 1118) des Versorgungsnetzwerks (1100) in einem oder mehreren Teilbäumen des Versorgungsnetzwerks (1100) zu öffnen, wenn aus welchen Gründen auch immer, das übergeordnete Rechnersystem (12) eine zukünftig erhöhte Stromaufnahme eines Verbrauchers der Verbraucher (1121 bis 1125 des Versorgungsnetzwerks (1100) erwartet und/oder

wobei ein übergeordnetes Rechnersystem (12) dazu eingerichtet ist, eine zukünftige Stromeinspeisung eines oder mehrerer Energiequellen der Energiequellen (1150 bis 1155) des Versorgungsnetzwerks (1100) vorauszuberechnen und/oder

wobei das übergeordnete Rechnersystem (12) dazu eingerichtet ist, über einen Datenbus (9) ein oder mehrere Leistungsschalter (17) ein oder mehrerer elektronischer Sicherungen der Sicherungen (1110 bis 1118) des Versorgungsnetzwerks (1100) in einem oder mehreren Teilbäume des Versorgungsnetzwerks (1100) zu öffnen, wenn aus welchen Gründen auch immer, das übergeordnete Rechnersystem (2) eine zukünftig erhöhte, möglicherweise kritische Stromeinspeisung oder Spannungseinspeisung einer Energiequelle der Energiequellen (1150 bis 1155) des Versorgungsnetzwerks (1100) des Versorgungsnetzwerks (1100) erwartet.

4. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und
mit mehreren Verbrauchern (210 bis 213 und 220 bis 223 und 230 bis 233) und
mit mehreren elektronischen Sicherungen (214 bis 217, 225 bis 228, 235 bis 238, 250, 251) und
wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und
wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und
wobei die Baumstruktur oder das Netzwerk Teilbäume bzw. Teilnetzwerke (z.B: 240, 220, 221) umfassen und
wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und
wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und
wobei elektronische Sicherungen der Sicherungen (1110 bis 1118) des Versorgungsnetzwerks (1100) dazu eingerichtet sind, die Spannung zwischen einem ersten Anschluss (26) ihrer Leistungsschalter (17), der bevorzugt energiequellenseitig liegt, und einem Bezugspotenzial (201) mittels geeigneter Messmittel dieser Sicherungen der Sicherungen (1110 bis 1118) des Versorgungsnetzwerks (1100) zu erfassen, und
wobei die Steuervorrichtungen (4) dieser elektronischen Sicherungen der Sicherungen (1110 bis 1118) des Versorgungsnetzwerks (1100) dazu eingerichtet sind, die gemessenen Spannungswerte mit vorgegebenen Schwellwerten zu vergleichen, und
wobei die Steuervorrichtungen (4) dieser elektronischen Sicherungen der Sicherungen (1110 bis 1118) des Versorgungsnetzwerks (1100) dazu eingerichtet sind, bei Unterschreitung dieser Schwellwerte den Leistungsschalter der elektronischen Sicherung zu öffnen,
wobei zum Ersten die vorgegebenen Schwellwerte die Abschaltung weniger wichtiger elektrischer Verbraucher der Verbraucher (1121 bis 1125) des Versorgungsnetzwerks (1100) vor der Abschaltung wichtiger und/oder wichtigerer elektrischer Verbraucher der Verbraucher (1121 bis 1125) des Versorgungsnetzwerks (1100), insbesondere vor der Abschaltung sicherheitsrelevanter elektrischer Verbraucher der Verbraucher (1121 bis 1125) des Versorgungsnetzwerks (1100), priorisieren und/oder
wobei zum Zweiten die vorgegebenen Schwellwerte die Abschaltung weniger wichtiger elektrischer Energiequellen der Energiequellen (1150 bis 1155) des Versorgungsnetzwerks (1100) vor der Abschaltung wichtiger und/oder wichtigerer elektrischer Energiequellen der Energiequellen (1150 bis 1155) des Versorgungsnetzwerks (1100), insbesondere vor der Abschaltung sicherheitsrelevanter elektrischer Energiequellen der Energiequellen (1150 bis 1155) des Versorgungsnetzwerks (1100), priorisieren.

5. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B: 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei das Versorgungsnetzwerk (3200) Versorgungsteilnetze (3202) mit Spannungen kleiner 50V (NV-Netze) und Versorgungsteilnetze (3201) mit Spannungen größer 50V (HV-Netze) aufweist und

wobei das Versorgungsnetz (3200) einen Datenbus (9) umfasst, der der im Bereich der Spannungs-Domain-Grenzen zwischen Versorgungsteilnetzen (3202) mit Spannungen kleiner 50V einerseits und Versorgungsteilnetzen (3201) mit Spannungen größer 50V als optischer Datenbus (3290) ausgeführt ist.

6. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei das Versorgungsnetzwerk (3200) Versorgungsteilnetze (3202) mit Spannungen kleiner 50V (NV-Netze) und Versorgungsteilnetze (3201) mit Spannungen größer 50V (HV-Netze) aufweist und

wobei das Versorgungsnetz (3200) einen Datenbus (9) umfasst, der der im Bereich der Spannungs-Domain-Grenzen zwischen Versorgungsteilnetzen (3202) mit Spannungen kleiner 50V einerseits und Versorgungsteilnetzen (3201) mit Spannungen größer 50V als Datenbus mit Potenzialtrennung (3290) ausgeführt ist.

7. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und

wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei innerhalb einer Versorgungsleitung (3260, 3262, 3263, 3264) mindestens zwei elektronische Sicherungen (3210, 3211, 3212) kaskadiert sind, die die Versorgungsleitung (3260, 3262, 3263, 3264) in unterschiedliche Versorgungsleitungsabschnitte (3260, 3262, 3263, 3264) aufteilen.

8. Versorgungsnetzwerk (3300) nach Merkmal 7,

wobei zum Ersten der elektrische Anschlusspunkt (2920) eines wichtigeren Verbrauchers (2930) an eine Versorgungsleitung (2910) des Versorgungsnetzwerks (3300) in dem näher zur Energiequelle (2940) liegenden Teil der Versorgungsleitung (2910, 2911) angeordnet ist, während der elektrische Anschlusspunkt (2921) eines weniger wichtigeren Verbrauchers (2931) an die Versorgungsleitung (2911) in dem weiter von der Energiequelle (2940) liegenden Teil der Versorgungsleitung (2910, 2911) angeordnet ist und

wobei sich zwischen dem elektrischen Anschlusspunkt (2920) des wichtigeren Verbrauchers (2930) an die Versorgungsleitung (2910, 2911) und dem elektrischen Anschlusspunkt (2921) des weniger wichtigeren Verbrauchers (2931) an die Versorgungsleitung (2915, 2910, 2911) eine elektronische Sicherung (2961, 2962) befindet und

wobei diese elektronische Sicherung (2961, 2962) dazu eingerichtet ist, den weniger wichtigen Verbraucher (2931) und/oder den Versorgungsleitungsabschnitt (2911) des weniger wichtigen Verbrauchers (2931) im Falle eines Fehlers oder einer Störung des weniger wichtigen Verbrauchers (2931) oder im Falle eines Fehlers oder einer Störung des Versorgungsleitungsabschnitts (2911) des weniger wichtigen Verbrauchers (2931) vom Versorgungsnetz (2915, 2910, 2911) abzutrennen und

wobei das Versorgungsnetz dazu eingerichtet ist, den wichtigeren Verbraucher (2930) in dem Fall weiter mit elektrischer Energie zu versorgen. und/oder

wobei zum Zweiten der elektrische Anschlusspunkt (2924) einer wichtigeren Energiequelle (2940) an eine Versorgungsleitung (2915, 2910, 2911) des Versorgungsnetzwerks (3300) in dem näher zu einem oder mehreren Verbrauchern (2930, 2931) liegenden Teil der Versorgungsleitung (2915, 2910, 2911) angeordnet ist, während der elektrische Anschlusspunkt (2925) einer weniger wichtigeren Energiequelle (2925) an die Versorgungsleitung (2915, 2910, 2911) in dem weiter von dem einen oder mehreren Verbrauchern (2930, 2931) liegenden Teil der Versorgungsleitung (2915, 2910, 2911) angeordnet ist und

wobei sich zwischen dem elektrischen Anschlusspunkt (2924) der wichtigeren Energiequelle (2940) an die Versorgungsleitung (2915, 2910, 2911) und dem elektrischen Anschlusspunkt (2925) der weniger wichtigeren Energiequelle (2941) an die Versorgungsleitung (2915, 2910, 2911) eine elektronische Sicherung (2951, 2952) befindet und

wobei diese elektronische Sicherung (2951, 2952) dazu eingerichtet ist, die weniger wichtige Energiequelle (2941) im Falle eines Fehlers und/oder einer Störung der weniger wichtigen Energiequelle (2941) oder des Versorgungsleitungsabschnitts (2915) der weniger wichtigen Energiequelle (2941) vom Versorgungsnetz (3300) abzutrennen, und

wobei das Versorgungsnetz (3300) dazu eingerichtet ist, aus der wichtigeren Energiequelle (2940) in dem Fall weiter elektrischer Energie zu entnehmen.

9. Versorgungsnetzwerk (200) für die Versorgung elektrischer Verbraucher (210 bis 213 und 220 bis 223 und 230 bis 233) mit elektrischer Energie, insbesondere nach einem oder mehreren der vorhergehenden Merkmale,

mit einer oder mehreren Energiequellen (250, 251) und

mit mehreren Verbrauchern (210 bis 213 und 220 bis 223 und 230 bis 233) und

mit mehreren elektronischen Sicherungen (214 bis 217, 225 bis 228, 235 bis 238, 250, 251) und

wobei die Verbraucher (210 bis 213 und 220 bis 223 und 230 bis 233) mittels Versorgungsleitungen (245, 240, 241, 242, 243) mit der einen oder mehreren Energiequellen (250, 251) verbunden sind und

wobei die Verbraucher (210 bis 213 und 220 bis 223 und 230 bis 233) und die eine oder mehreren Energiequellen (250, 251) zusammen mit den Versorgungsleitungen (245, 240 bis 243) in einer Baumstruktur oder einem Netzwerk miteinander verbunden sind und

wobei die Baumstruktur oder das Netzwerk Teilbäume bzw. Teilnetzwerke (z.B. 240, 220, 221) umfassen und wobei Sicherungen (214 bis 217, 225 bis 228, 235 bis 238, 250, 251) in Versorgungsleitungen eingefügt sind, sodass diese Teilbäume der Baumstruktur von der restlichen Baumstruktur abtrennen können oder mit dieser restlichen Baumstruktur verbinden können bzw. wobei Sicherungen (214 bis 217, 225 bis 228, 235 bis 238, 250, 251) in Versorgungsleitungen eingefügt sind, sodass diese Teilnetzwerke des Netzwerks von dem restlichen Netzwerk abtrennen können oder mit diesem restlichen Netzwerk verbinden können und

wobei ein oder mehrere elektronische Sicherungen (214 bis 217, 225 bis 228, 235 bis 238, 250, 251) jeweils zumindest eine Datenschnittstelle (280 bis 293) je elektronischer Sicherung (214 bis 217, 225 bis 228, 235 bis 238, 250, 251) aufweisen, die optisch sein kann und

wobei das Versorgungsnetzwerk (3300) zumindest eine Versorgungsleitung (2915, 2910, 2911) umfasst und wobei das Versorgungsnetzwerk (3300) einen ersten elektrischen Verbraucher (2930) umfasst und wobei das Versorgungsnetzwerk (3300) einen zweiten elektrischen Verbraucher (2931) umfasst und wobei das Versorgungsnetzwerk (3300) eine Energiequelle (2940) umfasst und

wobei der erste elektrische Verbraucher (2930) an einem ersten Anschlusspunkt (2920) über eine erste elektronische Sicherung (3110) an die Versorgungsleitung (2915, 2910, 2911) angeschossen ist und

wobei der zweite elektrische Verbraucher (2931) an einem zweiten Anschlusspunkt (2921) über eine zweite elektronische Sicherung (3111) an die Versorgungsleitung (2915, 2910, 2911) angeschossen ist und

wobei der erste Anschlusspunkt (2920) von dem zweiten Anschlusspunkt (2921) beabstandet ist und

wobei der erste Anschlusspunkt (2920) näher an der Energiequelle (2940) liegt als der zweite Anschlusspunkt (2921) und

wobei die Steuervorrichtung (4) der ersten elektronischen Sicherung (3110) dazu eingerichtet ist, zeitlich bezogen auf ein Abschaltereignis den Leistungsschalter (17) der ersten elektronischen Sicherung (3110) mit einer zeitlich kürzeren ersten Verzögerungszeit abschaltet als die Verzögerungszeit, mit der die Steuervorrichtung (4) der zweiten elektronischen Sicherung (3111) zeitlich bezogen auf ein Abschaltereignis den Leistungsschalter (17) der zweiten elektronischen Sicherung (3111) abzuschalten.

Zeitkonstanten gesteuerter Lastabwurf priorisierter Lasten eines Versorgungsnetzwerks

1. Versorgungsnetzwerk (3300) eines Fahrzeugs, insbesondere nach einem oder mehreren der vorhergehenden Merkmale,

wobei das Versorgungsnetzwerk zumindest eine Versorgungsleitung (2915, 2910, 2911) umfasst und wobei das Versorgungsnetzwerk (3300) eine erste elektrische Energiequelle (2940) umfasst und wobei das Versorgungsnetzwerk (3300) eine zweite elektrische Energiequelle (2941) umfasst und wobei das Versorgungsnetzwerk (3300) einen oder mehrere elektrische Verbraucher (2930, 2931) umfasst und wobei die erste elektrische Energiequelle (2940) an einem ersten Anschlusspunkt (2924) an die Versorgungsleitung angeschossen ist und

wobei die zweite elektrische Energiequelle (2941) an einem zweiten Anschlusspunkt (2925) an die Versorgungsleitung (2915, 2910, 2911) angeschossen ist und

wobei der erste Anschlusspunkt (2924) von dem zweiten Anschlusspunkt (2925) beabstandet ist und

wobei der erste Anschlusspunkt (2924) näher an dem einen oder den mehreren elektrischen Verbrauchern (2930, 2931) liegt als der zweite Anschlusspunkt (2925) und

wobei die Steuervorrichtung (4) der ersten elektronischen Sicherung (3110) dazu eingerichtet ist, zeitlich bezogen auf ein Abschaltereignis den Leistungsschalter (17) der ersten elektronischen Sicherung (3110) mit einer zeitlich längeren Verzögerungszeit abzuschalten als die Verzögerungszeit, mit der die Steuervorrichtung (4) der zweiten elektronischen Sicherung (3111) eingerichtet ist, bezogen auf ein Abschaltereignis den Leistungsschalter (17) der zweiten elektronischen Sicherung (3111) abzuschalten.

2. Versorgungsnetzwerk (3300), insbesondere nach einem oder mehreren der vorhergehenden Merkmale,

wobei das Versorgungsnetzwerk zumindest eine Versorgungsleitung (2915, 2910, 2911) umfasst und wobei das Versorgungsnetzwerk (3300) eine erste elektrische Energiequelle (2940) umfasst und wobei das Versorgungsnetzwerk (3300) eine zweite elektrische Energiequelle (2941) umfasst und wobei das Versorgungsnetzwerk (3300) einen oder mehrere elektrische Verbraucher (2930, 2931) umfasst und

wobei die erste elektrische Energiequelle (2940) an einem ersten Anschlusspunkt (2924) an die Versorgungsleitung angeschossen ist und

wobei die zweite elektrische Energiequelle (2941) an einem zweiten Anschlusspunkt (2925) an die Versorgungsleitung (2915, 2910, 2911) angeschossen ist und

wobei der erste Anschlusspunkt (2924) von dem zweiten Anschlusspunkt (2925) beabstandet ist und

wobei der erste Anschlusspunkt (2924) näher an dem einen oder den mehreren elektrischen Verbrauchern (2930, 2931) liegt als der zweite Anschlusspunkt (2925) und

wobei die Steuervorrichtung (4) der ersten elektronischen Sicherung (3110) dazu eingerichtet ist, zeitlich bezogen auf ein Abschaltereignis den Leistungsschalter (17) der ersten elektronischen Sicherung (3110) mit einer zeitlich kürzeren Verzögerungszeit abzuschalten als die Verzögerungszeit, mit der die Steuervorrichtung (4) der zweiten elektronischen Sicherung (3111) eingerichtet ist, bezogen auf ein Abschaltereignis den Leistungsschalter (17) der zweiten elektronischen Sicherung (3111) abzuschalten.

Massversatzkompensation in einem Versorgungsnetzwerk zur Korrektur von Spannungsmesswerten

1. Verfahren (3400) zum aktiven Power-Management in einem Versorgungsnetzwerk (1100) eines Fahrzeugs mit elektrischen Sicherungen (1110 bis 1118) zur Versorgung elektrischer Verbraucher (1121 bis 1125) in diesem Versorgungsnetzwerk (1100) mit elektrischer Energie einer oder mehrerer elektrischer Energiequellen (1150 bis 1155), insbesondere nach einem oder mehreren der vorhergehenden Merkmalen, mit den Schritten

- Erfassen (3410) des Werts der elektrischen Ströme (29) durch einen oder mehrere Leistungsschalter (17) einer oder mehrerer elektronischer Sicherungen der Sicherungen (1110 bis 1118) des Versorgungsnetzwerks (1100) und/oder
- Erfassen (3420) des Werts der Spannungsdifferenz zwischen einem Anschluss (26, 27, 28) dieses Leistungsschalters (17) gegen ein Bezugspotenzial (201) eines Bezugspotenzialkontakts und
- Berechnen (3430) des theoretischen Masseversatzes infolge der Bestromung der Leistungsschalter durch den jeweiligen Rechnerkern der jeweiligen Steuervorrichtung der jeweiligen Sicherung mittels Modellbildung und
- Korrektur (3440) der entsprechenden Spannungsmesswerte um den theoretischen Masseversatz.

2. Verfahren (3400) nach Merkmal 1, mit dem Schritt
Schließen (3450) auf Zustandsparameter von Versorgungsleitungsabschnitten der Versorgungsleitungsabschnitte (3260 bis 3278) mit Hilfe der so erfassten Parameter wie Stromwerten und Spannungswerten.

3. Verfahren (3400) nach Merkmal 2, mit dem Schritt
wobei ein Zustandsparameter ein Widerstandsbelag eines Versorgungsleitungsabschnitts der Versorgungsleitungsabschnitte (3260 bis 3278) ist.

4. Verfahren (3400) nach Merkmal 2 oder 3,
wobei ein Zustandsparameter die Temperatur eines Versorgungsleitungsabschnitts der Versorgungsleitungsabschnitte (3260 bis 3278) ist.

5. Verfahren nach einem der Merkmale 2 bis 4, mit dem Schritt
Ermitteln (3460) der Temperatur mit Hilfe eines bekannten Temperaturkoeffizienten des Leitungsmaterials des Versorgungsleitungsabschnitts der Versorgungsleitungsabschnitte (3260 bis 3278) und der bekannten Konstruktionsdaten.

Einstellung von Ausstattungsvarianten eines Versorgungsnetzwerks

1. Verfahren (3500) zum Betrieb eines Fahrzeugs, insbesondere nach einem oder mehreren der vorhergehenden Merkmale, mit den Schritten

Bereitstellen (3505) des Fahrzeugs mit einem Versorgungsnetzwerk (3300) zur Versorgung elektrischer Verbraucher (2930, 2931) des Fahrzeugs mit elektrischer Energie

wobei das Fahrzeug eine oder mehrere Energiequellen (2940, 2941), einen oder mehrere Verbraucher (2930, 2931) und mehrere elektronische Sicherungen (2960 bis 2963 und 2959 bis 2953) aufweist und

wobei die Verbraucher (2930, 2931) mittels Versorgungsleitungen (2915, 2910, 2911) mit der einen Energiequelle oder den mehreren Energiequellen (2940, 2941) verbunden sind und

wobei die Verbraucher (2930, 2931) und die Energiequellen (2940, 2941) zusammen mit den Versorgungsleitungen (2915, 2910, 2911) in einer Baumstruktur (3300) oder einem Netzwerk miteinander verbunden sind und wobei die Baumstruktur Teilbäume umfasst bzw. das Netzwerk Teilnetzwerke ([2915, 3015, 3025, 2941]; [2940, 3024, 3014, 2910, 3010, 3020, 2930]; [2911, 3011, 2931]) umfasst und

wobei zum Ersten elektronische Sicherungen (2960 bis 2963 und 2959 bis 2953) in Versorgungsleitungen eingefügt sind, sodass diese Teilbäume der Baumstruktur von der restlichen Baumstruktur abtrennen können oder mit dieser restlichen Baumstruktur verbinden können, und/oder

wobei zum Zweiten elektronische Sicherungen (2916, 2962, 2951, 2952) in Versorgungsleitungen eingefügt sind, sodass diese Teilnetzwerke ([2915, 3015, 3025, 2941]; [2911, 3011, 3021, 2931]) des Netzwerks (3300) von dem restlichen Netzwerk (3300) abtrennen oder mit diesem restlichen Netzwerk (3300) verbinden können, sodass diese Teilnetzwerke ([2915, 3015, 3025, 2941]; [2911, 3011, 3021, 2931]) und/oder Teilbäume nach einer Abtrennung im Wesentlichen über keine Energieversorgung und/oder keinen Energieverbrauch mehr verfügen; Programmierung (3510) von bestimmten Ausstattungsvarianten,

wobei eine erste Ausstattungsvariante dieser Ausstattungsvarianten des Fahrzeugs sich von einer zweiten Ausstattungsvariante dieser Ausstattungsvarianten des Fahrzeugs dadurch unterscheidet,

dass zumindest eine elektronische Sicherung dieser elektronischen Sicherungen (2916, 2962, 2951, 2952) einen Teilbaum der Baumstruktur bzw. ein Teilnetzwerk ([2915, 3015, 3025, 2941]; [2911, 3011, 3021, 2931]) des Netzwerks (3300) in der ersten Ausstattungsvariante von der restlichen Baumstruktur bzw. dem restlichen Netzwerk (3300) abtrennt und in der zweiten Ausstattungsvariante mit der restlichen Baumstruktur bzw. dem restlichen Netzwerk (3300) verbindet,

so dass die Energiequelle dazu eingerichtet ist, dass sie diesen Teilbaum bzw. dieses Teilnetzwerk ([2915, 3015, 3025, 2941]; [2911, 3011, 3021, 2931]) nur in der zweiten Ausstattungsvariante mit elektrischer Energie der Energiequelle vollständig versorgen zu können, bzw. dass dieser Teilbaum bzw. dieses Teilnetzwerk ([2915, 3015, 3025, 2941]; [2911, 3011, 3021, 2931]) nur in der zweiten Ausstattungsvariante einen elektrischen Energieverbrauch eines oder mehrerer elektrischer Verbraucher (2931) des betreffenden Teilnetzwerks ([2915, 3015, 3025, 2941]; [2911, 3011, 3021, 2931]) aufweisen kann.

2. Verfahren (3500) nach Merkmal 1, mit dem Schritt,
Programmierung (3510) von bestimmten Ausstattungsvarianten durch Übermittlung von Programmierdaten an Steuervorrichtungen (4) elektronischer Sicherungen über einen Datenbus (9).

3. Verfahren (3500) nach Merkmal 2, mit dem Schritt,
verschlüsselte Kommunikation über den Steuerdatenbus (9) zur Programmierung der Ausstattungsvarianten und/oder Kommunikation über den Steuerdatenbus (9) zur Programmierung der Ausstattungsvarianten nur nach Übertragung eines Passworts an die Steuervorrichtung (4) der entsprechenden elektronischen Sicherung.

4. Verfahren (3500) nach Merkmal 3,
wobei die Kommunikation zwischen der Steuervorrichtung (4) der elektronischen Sicherung und ihrer Umwelt über solche Datenverbindungen (9) mit einer PQC-Methode kryptografiert erfolgt. (PQC=post quantum cryptography);

5. Verfahren (3500) nach einem der Merkmale 1 bis 4, dadurch gekennzeichnet,
dass die die Aktivierung und/oder die Deaktivierung einer elektronischen Sicherung, also das Einschalten oder Ausschalten des Leistungsschalters (17) der elektronischen Sicherung, die Übermittlung zumindest eines digitalen Passworts von dem Rechnerkern (2) der Steuervorrichtung (4) einer anderen elektronischen Sicherung und/oder vom Rechner (12) eines Steuergeräts, also beispielsweise von dem übergeordneten Rechnersystem (12), und/oder von einem Server (710) eines Dienstleistungsanbieters und/oder Automobilherstellers über einen Datenbus (9) an die Steuervorrichtung (4) der elektronischen Sicherung erfordert.

6. Verfahren (3500) nach einem der Merkmale 1 bis 5,

wobei eine Versorgungsspannungsleitung (6) und/oder ein Versorgungsleitungsabschnitt des Versorgungsnetzwerks ein Teil des Datenbusses (9) ist und

wobei die Kommunikation über diesen Datenbus (9) zumindest abschnittsweise per Power-Line-Kommunikation erfolgt und

wobei diese Kommunikation der mindestens zwei Steuervorrichtungen (4) zweier elektronischer Sicherungen untereinander und/oder

zwischen einer Steuervorrichtung (4) einer elektronischen Sicherung einerseits und einem übergeordneten Rechnersystem (12) andererseits über diesen Datenbus (9) erfolgt.

7. Verfahren (3500) nach einem der Merkmale 1 bis 6,
wobei nach der Änderung der Ausstattungsvariante durch Programmierung einer neuen Ausstattungsvariante mindestens zwei elektronische Sicherungen, besser alle durch die Änderung der Ausstattungsvariante betroffen

elektronischen Sicherungen zeitversetzt zueinander ihren Schaltzustand wechseln und im Wesentlichen nicht gleichzeitig ihren Schaltzustand wechseln.

8. Verfahren nach einem der Merkmale 1 bis 7,

wobei ein übergeordnetes Rechnersystem (12) des Fahrzeugs in vorbestimmten Betriebszuständen eine vordefinierte Sequenz von Ausstattungsvarianten in gewissen zeitlichen Abständen programmiert.

9. Verfahren nach Merkmal 8,

wobei nach dem Einschalten des Fahrzeugs das übergeordnete Rechnersystem (12) das Fahrzeug aus dem Park-Zustand in den Fahrzustand durch Programmierung von mindestens zwei Ausstattungsvarianten zu zwei verschiedenen Programmierzeitpunkten in einem von 0s verschiedenen zeitlichen Abstand zwischen den Programmierzeitpunkten überführt.

10. Verfahren nach Merkmal 9,

wobei das übergeordnete Rechnersystem (12) den Steuervorrichtungen (4) elektronischer Sicherungen ein Start-Signal sendet, woraufhin diese die Sequenz der Ausstattungsvarianten für die jeweilige elektronische Sicherung erzeugen und einstellen.

11. Verfahren nach Merkmal 10,

wobei das übergeordnete Rechnersystem (12) vor dem Absetzen des Startsignals zuvor die Werte von Wartezeiten, die die Steuervorrichtungen (4) der elektronischen Sicherungen zwischen dem Eintreffen des Startsignals vom übergeordneten Rechnersystem (12) und dem Schließen bzw. Öffnen ihres jeweiligen Leistungsschalters (17) warten sollen, programmiert und/oder an die Steuervorrichtungen (4) der betreffenden Sicherungen übermittelt.

12. Verfahren nach Merkmal 10 oder 11,

wobei Werte der Wartezeiten in einen nichtflüchtigen Speicher (14) der Steuervorrichtungen (4) elektronischer Sicherungen einprogrammiert sind,

wobei diese Programmierung werksseitig und/oder durch einen anderen Rechner (710) und/oder durch das übergeordnete Rechnersystem (12) und/oder einen anderen Rechner des Fahrzeugs, somit ggf. auch durch die Steuervorrichtung (4) einer anderen elektronischen Sicherung, erfolgen.

13. Verfahren (3500) nach einem der Merkmale 1 bis 12, mit den zusätzlichen Schritten

Übermitteln (3520) von Authentifizierungsdaten an einen Server (710) eines Freischaltcodeanbieters;
Verifikation (3525) der übermittelten Authentifizierungsdaten;
Erzeugen (3530) eines Freischaltcodes mit Hilfe von diesen oder anderen Authentifizierungsdaten nach einem feststehenden Verfahren und/oder Bereitstellen des erzeugten oder eines bereitgehaltenen Freischaltcodes;
ggf. Kaufen (3535) eines Freischaltcodes über eine Datenverbindung zu dem Server 710 des Freischaltcodeanbieters;
Übermitteln (3540) des Freischaltcodes an das Fahrzeug und/oder
Übermitteln (3545) eines Freischaltcodes für eine Ausstattungsvariante auf Basis des erhaltenen Freischaltcodes an die Steuervorrichtung (4) der elektronischen Sicherung und
Programmierung (3510) der freigeschalteten Ausstattungsvariante.

14. Verfahren nach Merkmal 13, mit dem zusätzlichen Schritt

Erfassen (3550) und ermitteln der Energie die eine elektronische Sicherung in einem Versorgungsteilzweig ([2915, 3015, 3025, 2941]; [2911, 3011, 3021, 2931]) des Versorgungsbaumes (3300) durchströmt als Messwert der Energiemenge und/oder der zugrundeliegenden Messwerte in der elektronischen Sicherung;
Auslesen (3555) des Messwerts der ermittelten Energiemenge und/oder der zugrundeliegenden Messwerte aus der elektronischen Sicherung;
Übermittlung (3560) des Messwerts der ermittelten Energiemenge und/oder der zugrundeliegenden Messwerte über eine Datenübertragungsstrecke (720), die bevorzugt verschlüsselt ist, vom übergeordneten Rechnersystem (12) an einen Rechner (750) eines Dienstleistungsanbieters, beispielsweise einen Energieversorger oder dessen Erfüllungsgehilfen;
Erstellung (3565) einer Rechnung auf Basis des übermittelten Messwerts der ermittelten Energiemenge und/oder der zugrundeliegenden Messwerte.

15. Verfahren nach einem der Merkmale 1 bis 14, mit den zusätzlichen Schritten

Ermitteln (3570) der Topologie des Versorgungsnetzwerks unter Nutzung elektronischer Sicherungen des Versorgungsnetzwerks;

Vergleich (3575) der ermittelten Topologie des Versorgungsnetzwerks mit der gültigen oder einzustellenden Ausstattungsvariante zur Plausibilisierung der Ausstattungsvariante bzw. der Zulässigkeit der Ermittelten Topologie des Versorgungsnetzwerks.

16. Verfahren nach Merkmal 15, mit dem zusätzlichen Schritt

Erfassen von Stromwerten für Ströme durch Leistungsschalter elektronischer Sicherungen im Versorgungsnetzwerk;
Errechnen oder Bereitstellen von Erwartungswertintervallen für Ströme durch Leistungsschalter elektronischer Sicherungen im Versorgungsnetzwerk;
Plausibilisieren des Versorgungsnetzwerks mit den Versorgungsleitungen und den Verbraucher und den Energiequellen und den elektronischen Sicherungen durch Vergleich der erfassten Stromwerte mit den der errechneten bzw. bereitgestellten Erwartungswertintervallen.

17. Verfahren nach Merkmal 15 oder 16, mit dem zusätzlichen Schritt
Schließen auf eine Manipulation am Versorgungsnetzwerk und/oder Schließen auf eine Manipulation eines elektrischen Verbrauchers im Versorgungsnetzwerk und/oder Schließen auf eine Manipulation einer elektrischen Energiequelle im Versorgungsnetzwerk und/oder Schließen auf eine Manipulation einer Versorgungsleitung im Versorgungsnetzwerk und/oder Schließen auf die Manipulation einer Ausstattungsvariante, wenn die Plausibilisierung fehlgeschlagen ist.

18. Verfahren zur Absenkung des Startstromes (In-Rush-Current), insbesondere nach einem oder mehreren der vorhergehenden Merkmale,

Erfassung des Start-Stromes mittels Strommessmitteln;
Änderung der Ausstattungsvariante zu einer mit einer Ausstattungsvariante mit erhöhter Stromaufnahme anderer Verbraucher, wenn nach dem Verstreichen einer Wartezeit der Betrag des Startstroms unter einem Schwellwert liegt.

Steuervorrichtung für eine Sicherung mit Notenergieversorgung

1. Steuervorrichtung (4) für die Sicherung (1) eines Fahrzeugs für den Betrieb einer elektronischen Sicherung (1), insbesondere nach einem oder mehreren der vorhergehenden Merkmale,

- wobei diese System Basis Chip Funktionalität alle Funktionen bereitstellt, um einen Rechnerkern (2) in der Steuervorrichtung (4) der elektronischen Sicherung (1) und die Datenschnittstelle (10) der Steuervorrichtung (4) der Sicherung (1) sicher betreiben zu können, und
- die System Basis Chip Funktionalität umfasst

  - einen Boost-Konverter (5) für

    ∘ die Spannungsversorgung der sicherheitsrelevanten Vorrichtungsteile der Steuervorrichtung (4) und
    ∘ das Laden einer internen oder externen Energiereserve (8)

  - wobei im Normalbetrieb der Boost-Konverter (5) eine extern bereit gestellten Betriebsspannung (6) einer oder mehrerer externer Energiequellen aufbereitet und

- wobei im Falle des Ausfalls der extern bereit gestellten Betriebsspannung (6) die Steuervorrichtung (4) und/oder die Sicherung (1) in einen Notlaufbetrieb wechseln und die Energiereserve (8) die Energieversorgung der Steuervorrichtung (4) der Sicherung (1) übernimmt und
- wobei im Notlaufbetrieb der Boost-Konverter (5) oder eine funktionsäquivalente zweite Spannungsregelvorrichtung eine Notenergieversorgung (7) der sicherheitsrelevanten Vorrichtungsteile der Steuervorrichtung (4) der Sicherung (1) zur Verfügung stellen und die hierfür notwendige Energie aus der Energiereserve (8) entnehmen.

Steuerung elektronischer Sicherungen in einem Verbrauchernetzwerk mittels verschlüsselter Kommandos

1. Elektronische Sicherung (1) eines Fahrzeugs, insbesondere nach einem oder mehreren der vorhergehenden Merkmale,

> wobei die elektronische Sicherung (1) eine Steuervorrichtung (4) umfasst und
> wobei die elektronische Sicherung (1) einen Leistungsschalter (17) umfasst und
> wobei die Steuervorrichtung (4) einen Rechnerkern (2) umfasst und
> wobei die Steuervorrichtung (4) einen nichtflüchtigen Speicher (14) umfasst und
> wobei die Steuervorrichtung (4) einen internen Datenbus (11) umfasst und
> wobei der Rechnerkern (2) dazu eingerichtet ist, über den internen Datenbus (11) auf den nicht flüchtigen Speicher (14) zumindest lesend zugreifen zu können, und
> wobei in dem nichtflüchtigen Speicher Befehle eines Programmes und/oder Programmdaten abgelegt sind und
> wobei der Rechnerkern dazu eingerichtet ist, das Programm mit den Programmdaten im nichtflüchtigen Speicher (14) auszuführen, und
> wobei die Befehle des Programms und/oder die Programmdaten verschlüsselt sind und
> wobei der Rechnerkern (2) dazu eingerichtet ist, die verschlüsselten Befehle des Programms und/oder die verschlüsselten Programmdaten vor der Programmausführung der Befehle des Programms aus dem nicht-flüchtigen Speicher (14) zu lesen, und
> wobei der Rechnerkern (2) dazu eingerichtet ist, die gelesenen verschlüsselten Befehle des Programms und/oder die gelesenen verschlüsselten Programmdaten vor der Programmausführung der Befehle des Programms zu entschlüsselten Befehlen des Programms und/oder zu entschlüsselten Programmdaten zu entschlüsseln, und
> wobei der Rechnerkern (2) dazu eingerichtet ist, die entschlüsselten Befehle des Programms und/oder die entschlüsselten Programmdaten vor der Programmausführung in einem Speicher (14,15) der Steuervorrichtung (4) abzulegen, und
> wobei der Rechnerkern (2) dazu eingerichtet ist, die entschlüsselten Befehle des Programms aus dem Speicher (14, 15) der Steuervorrichtung (4) auszuführen und/oder die entschlüsselten Programmdaten aus dem Speicher (14, 15) der Steuervorrichtung (4) während der Ausführung von Programmbefehlen zu verwenden.

2. Elektronische Sicherung (1) nach Merkmal 1,
wobei der Rechnerkern (2) dazu eingerichtet ist, die Verschlüsselung mit Hilfe eines Zufallszahlengenerators (60) (RNG) und/oder eines Pseudozufallszahlengenerators (60) (PRNG) und/oder eines echten Zufallszahlengenerators (TRNG) und/oder eines Quantenzufallszahlengenerators (QRNG) vorzunehmen.
3. Elektronische Sicherung (1) nach Merkmal 1 oder 2,

> wobei die Steuerungsvorrichtung (4) eine Datenbusschnittstelle (10, 610, 550, 551) umfasst und
> wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den nichtflüchtigen Speicher (14) zugreifen kann und
> wobei der externe Rechner Daten, die auch die Befehle des Programmes und/oder die Programmdaten umfassen können, aus dem nichtflüchtigen Speicher (14) lesen kann.

4. Elektronische Sicherung (1) nach Merkmal 3,
wobei die Steuervorrichtung (4) dazu eingerichtet ist, dass der externe Rechner auf vorbestimmte Bereiche des nicht-flüchtigen Speichers (14) nur lesend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.
5. Elektronische Sicherung (1) nach einem der Merkmale 1 bis 4,

> wobei die Steuerungsvorrichtung (4) eine Datenbusschnittstelle (10, 610, 550, 551) umfasst und
> wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den flüchtigen Speicher (15) zugreifen kann und

wobei der externe Rechner Daten, die auch die Befehle des Programmes und/oder die Programmdaten umfassen können, aus dem flüchtigen Speicher (15) lesen kann.

6. Elektronische Sicherung (1) nach Merkmal 5,

wobei die Steuervorrichtung (4) dazu eingerichtet ist, dass der externe Rechner auf vorbestimmte Bereiche des flüchtigen Speichers (15) nur lesend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.

7. Elektronische Sicherung (1) nach einem der Merkmale 1 bis 6,

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den nichtflüchtigen Speicher (14) zugreifen kann und

wobei der externe Rechner Daten, die auch die Befehle des Programmes und/oder die Programmdaten umfassen können, in den nichtflüchtigen Speicher (14) schreiben kann.

8. Elektronische Sicherung (1) nach Merkmal 7,

wobei die Steuervorrichtung (4) dazu eingerichtet ist, dass der externe Rechner auf vorbestimmte Bereiche des nicht-flüchtigen Speichers (14) nur schreibend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.

9. Elektronische Sicherung (1) nach einem der Merkmale 1 bis 8,

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den flüchtigen Speicher (15) zugreifen kann und

wobei der externe Rechner Daten, die auch die Befehle des Programmes und/oder die Programmdaten umfassen können, in den flüchtigen Speicher (15) schreiben kann.

10. Elektronische Sicherung (1) nach Merkmal 9,

wobei die Steuervorrichtung (4) dazu eingerichtet ist, dass der externe Rechner auf vorbestimmte Bereiche des flüchtigen Speichers (15) nur schreibend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.

Zugriffssteuerung für den Zugriff eines externen Rechners auf die Steuerungsvorrichtung einer elektronischen Sicherung

1. Elektronische Sicherung (1) eines Fahrzeugs, insbesondere nach einem oder mehreren der vorhergehenden Merkmale,

wobei die elektronische Sicherung (1) eine Steuervorrichtung (4), insbesondere nach Merkmal 1, umfasst und

wobei die elektronische Sicherung (1) einen Leistungsschalter (17) umfasst und

wobei die Steuervorrichtung (4) einen Rechnerkern (2) umfasst und

wobei die Steuervorrichtung (4) einen nichtflüchtigen Speicher (14) umfasst und

wobei die Steuervorrichtung (4) einen internen Datenbus (11) umfasst und

wobei der Rechnerkern (2) dazu eingerichtet ist, über den internen Datenbus (11) auf den nicht flüchtigen Speicher (14) zumindest lesend zugreifen zu können, und

wobei in dem nichtflüchtigen Speicher Befehle eines Programmes und/oder Programmdaten abgelegt sind und

wobei der Rechnerkern dazu eingerichtet ist, das Programm mit den Programmdaten im nicht-1 flüchtigen Speicher (14) auszuführen und

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den nichtflüchtigen Speicher (14) zugreifen kann und

wobei der externe Rechner Daten, die auch die Befehle des Programmes und/oder die Programmdaten umfassen können, aus dem nichtflüchtigen Speicher (14) lesen kann und

wobei die Steuervorrichtung (4) dazu eingerichtet ist, dass der externe Rechner auf vorbestimmte Bereiche des nicht-flüchtigen Speichers (14) nur lesend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.

2. Elektronische Sicherung (1), insbesondere nach einem oder mehreren der vorhergehenden Merkmale,

wobei die elektronische Sicherung (1) eine Steuervorrichtung (4), insbesondere nach Merkmal 1, umfasst und

wobei die elektronische Sicherung (1) einen Leistungsschalter (17) umfasst und

wobei die Steuervorrichtung (4) einen Rechnerkern (2) umfasst und

wobei die Steuervorrichtung (4) einen nichtflüchtigen Speicher (14) umfasst und

wobei die Steuervorrichtung (4) einen internen Datenbus (11) umfasst und

wobei der Rechnerkern (2) dazu eingerichtet ist, über den internen Datenbus (11) auf den nicht flüchtigen Speicher (14) zumindest schreibend zugreifen zu können, und

wobei in dem nichtflüchtigen Speicher Befehle eines Programmes und/oder Programmdaten abgelegt sind und

wobei der Rechnerkern dazu eingerichtet ist, das Programm mit den Programmdaten im nichtflüchtigen Speicher (14) auszuführen und

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den nichtflüchtigen Speicher (14) zugreifen kann und

wobei der externe Rechner Daten, die auch die Befehle des Programmes und/oder die Programmdaten umfassen können, in den nichtflüchtigen Speicher (14) schreiben kann und

wobei die Steuervorrichtung (4) dazu eingerichtet ist, dass der externe Rechner auf vorbestimmte Bereiche des nicht-flüchtigen Speichers (14) nur schreibend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des nicht-flüchtigen Speichers (14) authentifiziert hat und wenn eine Verifikation dieser Authentifizierung durch den Rechnerkern (2) und/oder einen anderen Teil der Steuervorrichtung (4) erfolgreich war.

3. Elektronische Sicherung (1) eines Fahrzeugs, insbesondere nach einem oder mehreren der vorhergehenden Merkmale,

wobei die elektronische Sicherung (1) eine Steuervorrichtung (4), insbesondere nach Merkmal 1, umfasst und

wobei die elektronische Sicherung (1) einen Leistungsschalter (17) umfasst und

wobei die Steuervorrichtung (4) einen Rechnerkern (2) umfasst und

wobei die Steuervorrichtung (4) einen flüchtigen Speicher (15) umfasst und

wobei die Steuervorrichtung (4) einen internen Datenbus (11) umfasst und

wobei der Rechnerkern (2) dazu eingerichtet ist, über den internen Datenbus (11) auf den flüchtigen Speicher (15) zumindest lesend zugreifen zu können, und

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den flüchtigen Speicher (15) zugreifen kann und

wobei der externe Rechner Daten, die auch die Befehle des Programmes und/oder die Programmdaten umfassen können, aus dem flüchtigen Speicher (15) lesen kann und

wobei die Steuervorrichtung (4) dazu eingerichtet ist, dass der externe Rechner auf vorbestimmte Bereiche des flüchtigen Speichers (15) nur lesend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des flüchtigen Speichers (15) authentifiziert hat und wenn eine Verifikation dieser Authentifizierung durch den Rechnerkern (2) und/oder einen anderen Teil der Steuervorrichtung (4) erfolgreich war.

4. Elektronische Sicherung (1) eines Fahrzeugs, insbesondere nach einem oder mehreren der vorhergehenden Merkmale

wobei die elektronische Sicherung (1) eine Steuervorrichtung (4), insbesondere nach Merkmal 1, umfasst und

wobei die elektronische Sicherung (1) einen Leistungsschalter (17) umfasst und

wobei die Steuervorrichtung (4) einen Rechnerkern (2) umfasst und

wobei die Steuervorrichtung (4) einen flüchtigen Speicher (15) umfasst und

wobei die Steuervorrichtung (4) einen internen Datenbus (11) umfasst und

wobei der Rechnerkern (2) dazu eingerichtet ist, über den internen Datenbus (11) auf den flüchtigen Speicher (15) zumindest schreibend zugreifen zu können, und

wobei in dem nicht-flüchtigen Speicher Befehle eines Programmes und/oder Programmdaten abgelegt sind und

wobei der Rechnerkern dazu eingerichtet ist, das Programm mit den Programmdaten im flüchtigen Speicher (15) auszuführen und

wobei die Steuerungsvorrichtung (4) eine Datenbusschnittstelle (10, 610, 550, 551) umfasst und

wobei ein externer Rechner, beispielsweise ein übergeordnetes Rechnersystem (12) und/oder der Server (710) eines Dienstleistungsanbieters, über die Datenbusschnittstelle (10, 610, 550, 551) auf den flüchtigen Speicher (15) zugreifen kann und

wobei der externe Rechner Daten, die auch die Befehle des Programmes und/oder die Programmdaten umfassen können, in den flüchtigen Speicher (15) schreiben kann und

wobei die Steuervorrichtung (4) dazu eingerichtet ist, dass der externe Rechner auf vorbestimmte Bereiche des flüchtigen Speichers (15) nur schreibend zugreifen kann, wenn der externe Rechner zuvor an den Rechnerkern (2) der Steuervorrichtung (4) und/oder an einen anderen Teil der Steuervorrichtung (4) ein korrektes Passwort übermittelt hat oder wenn der externe Rechner zuvor sich auf eine andere Weise beim Rechnerkern (2) und/oder bei einen anderen Teil der Steuervorrichtung (4) als zugriffsberechtigt hinsichtlich eines Zugriffs auf diese vorbestimmte Bereiche des flüchtigen Speichers (15) authentifiziert hat und wenn eine Verifikation dieser Authentifizierung durch den Rechnerkern (2) und/oder einen anderen Teil der Steuervorrichtung (4) erfolgreich war.

5. Elektronische Sicherung (1) nach einem oder mehreren der Merkmale 1 bis 4,

wobei die Steuervorrichtung (4) einen nichtflüchtigen Speicher (14) umfasst und

wobei die Steuervorrichtung (4) einen internen Datenbus (11) umfasst und

wobei der Rechnerkern (2) dazu eingerichtet ist, über den internen Datenbus (11) auf den nicht flüchtigen Speicher (14) zumindest lesend zugreifen zu können, und

wobei in dem nichtflüchtigen Speicher (14) Befehle eines Programmes und/oder Programmdaten abgelegt sind und

wobei der Rechnerkern (2) dazu eingerichtet ist, das Programm mit den Programmdaten im nichtflüchtigen Speicher (14) auszuführen, und

wobei die Befehle des Programms und/oder die Programmdaten verschlüsselt sind und

wobei der Rechnerkern (2) dazu eingerichtet ist, die verschlüsselten Befehle des Programms und/oder die verschlüsselten Programmdaten vor der Programmausführung der Befehle des Programms aus dem nicht-flüchtigen Speicher (14) zu lesen, und

wobei der Rechnerkern (2) dazu eingerichtet ist, die gelesenen verschlüsselten Befehle des Programms und/oder die gelesenen verschlüsselten Programmdaten vor der Programmausführung der Befehle des Programms zu entschlüsselten Befehlen des Programms und/oder zu entschlüsselten Programmdaten zu entschlüsseln, und

wobei der Rechnerkern (2) dazu eingerichtet ist, die entschlüsselten Befehle des Programms und/oder die entschlüsselten Programmdaten vor der Programmausführung in einem Speicher (14,15) der Steuervorrichtung (4) abzulegen, und

wobei der Rechnerkern (2) dazu eingerichtet ist, die entschlüsselten Befehle des Programms aus dem Speicher (14, 15) der Steuervorrichtung (4) auszuführen und/oder die entschlüsselten Programmdaten aus dem Speicher (14, 15) der Steuervorrichtung (4) während der Ausführung von Programmbefehlen zu verwenden.

6. Elektronische Sicherung (1) nach Merkmal 5,
wobei der Rechnerkern (2) dazu eingerichtet ist, die Verschlüsselung mit Hilfe eines Zufallszahlengenerators (60) (RNG) und/oder eines Pseudozufallszahlengenerators (60) (PRNG) und/oder eines echten Zufallszahlengenerators (TRNG) und/oder eines Quantenzufallszahlengenerators (QRNG) vorzunehmen.

7. System (55100) zur Bereitstellung einer Anwendung mittels eines SW-Programms (55113) in einer Steuervorrichtung (55120, 4) einer elektronischen Sicherung (1) in einem Versorgungsnetzwerk (200), insbesondere nach einem oder mehreren der vorhergehenden Merkmale,
wobei das System (55100) eine erste HW-Plattform (55110, 12, 710) und die Steuervorrichtung (55120, 4) einer elektronischen Sicherung (1) umfasst;

- die Steuervorrichtung (55120, 4) einer elektronischen Sicherung (1) (120) ein oder mehreren Sicherheitsmaßnahmen unterliegt, denen die erste HW-Plattform (55110, 12, 710) nicht unterliegt;
- das SW-Programm (55113) zumindest ein Basis-Modul (55210) und zumindest ein sicherheitsrelevantes Modul (55121) umfasst;
- das sicherheitsrelevante Modul (55121) auf sicherheitsrelevante Daten und/oder auf eine sicherheitsrelevante Funktion (55201, 55202) der Sicherung (1) zugreift;
- das Basis-Modul (210) auf der ersten HW-Plattform (55110, 12, 710) ausgeführt wird; und
- das sicherheitsrelevante Modul (55121) auf der Steuervorrichtung (55120, 4) einer elektronischen Sicherung (1) ausgeführt wird.

8. System (100) nach Merkmal 7,
das ein oder mehreren Sicherheitsmaßnahmen umfasst,

- eine Überprüfung von SW-Code eines SW-Moduls (55121), das auf der Steuervorrichtung (55120, 4) der elektronischen Sicherung (1) ausgeführt wird; und/oder
- eine Beschränkung von Daten (55211, 55221), die an ein oder von einem SW-Modul (55121) übergeben werden können, das auf der Steuervorrichtung (55120, 4) der elektronischen Sicherung (1) ausgeführt wird.

9. System (100) nach Merkmal 7 oder 8,

wobei die erste HW-Plattform (55110) derart ausgelegt ist, dass ein auf der ersten HW-Plattform (55110) ausgeführtes SW-Modul (55210) keinen Zugriff auf eine sicherheitsrelevante Funktion (55201) des Versorgungsnetzwerks (200) hat und
wobei die Steuervorrichtung (55120, 3) der Sicherung (1) derart ausgelegt ist, dass ein auf der Steuervorrichtung (55120, 3) der Sicherung (1) ausgeführtes SW-Modul (55121) einen Zugriff auf eine sicherheitsrelevante Funktion (55201) des Versorgungsnetzwerks (200) hat.

10. System (100) nach einem der Merkmale 7 bis 9,
wobei das Basis-Modul (55210) eingerichtet ist, bei einer Ausführung des SW-Programms (55113) das sicherheitsrelevante Modul (55121) aufzurufen und eine Ausführung des sicherheitsrelevanten Moduls (55121) auf der Steuervorrichtung (55120, 4) der Sicherung (1) zu veranlassen.

11. System (55100) nach Merkmal 10,

wobei bei der Ausführung des SW-Programms (55113) Daten (55211) von dem Basis-Modul (55210) an das sicherheitsrelevante Modul (55121) übergeben werden und/oder
Daten (55221) von dem sicherheitsrelevanten Modul (55121) an das Basis-Modul (55210) übergeben werden.

12. System (100) nach einem der Merkmale 7 bis 11,

wobei die erste HW-Plattform (55110) und die Steuervorrichtung (55120, 3) der Sicherung (1) separate Rechner umfassen und/oder

die Steuervorrichtung (55120, 3) der Sicherung (1) einen nichtflüchtigen (14) und/oder flüchtigen Speicher (15) umfasst, der von der ersten HW-Plattform (110) getrennt ist.

13. System (100) nach einem der Merkmale 7 bis 12,
wobei die erste HW-Plattform (110) Teil eines übergeordneten Rechnersystems (12) des Versorgungsnetzwerks (200) ist, der mit der Steuervorrichtung (55120, 3) der Sicherung (1) über eine Datenschnittstelle (10, 610, 550, 551) und einen Datenbus (9) des Versorgungsnetzwerks (200)verbunden ist, und/oder Teil eines Servers (710) ist, der mit der Steuervorrichtung (55120, 3) der Sicherung (1) über eine Datenschnittstelle (10, 610, 550, 551) und einen Datenbus (9) des Versorgungsnetzwerks (200)verbunden ist.
14. System (100) nach einem der Merkmale 7 bis 13,

wobei das zumindest eine sicherheitsrelevante Modul (55121) 20%, 10% oder weniger eines SW-Codes des SW-Programms (55113) umfasst; und/oder

das zumindest eine Basis-Modul (55210) 80%, 90% oder mehr des SW-Codes des SW-Programms (55113) umfasst.

15. System (100) nach einem der Merkmale 7 bis 14,
wobei das sicherheitsrelevante Modul (55121) eine standardisierte Schnittstelle aufweist, über die Daten (55211, 55221) an das sicherheitsrelevante Modul (55121) oder von dem sicherheitsrelevanten Modul (5121) übergeben werden können.

16. Verfahren (55300) zur Ausführung eines SW-Programms (55113) in einem Versorgungsnetzwerk (200) mit elektronischen Sicherungen (1) in einem Fahrzeug, insbesondere nach einem oder mehreren der vorhergehenden Merkmale,
wobei das Verfahren (55300) umfasst,

- Ausführen (55301) eines Basis-Moduls (55210) des SW-Programms (55113) auf einer ersten HW-Plattform (55110) des Versorgungsnetzwerks (200);
- Aufrufen (55302), aus dem Basis-Modul (55210), eines sicherheitsrelevanten Moduls (55121) des SW-Programms (55113); wobei das sicherheitsrelevante Modul (55121) auf sicherheitsrelevante Daten und/oder auf eine sicherheitsrelevante Funktion (55201, 55202) zugreift und
- Ausführen (55303) des sicherheitsrelevanten Moduls (55121) auf einer Steuervorrichtung (55120, 3) der Sicherung (1) des Versorgungsnetzwerks (200);
- wobei die Steuervorrichtung (55120, 3) der Sicherung (1) ein oder mehreren Sicherheitsmaßnahmen unterliegt, denen die erste HW-Plattform (110) nicht unterliegt.

Elektronische Sicherung mit thermischer Absicherung

1. Elektronische Sicherung (1) eines Fahrzeugs, insbesondere nach einem oder mehreren der vorhergehenden Merkmale,

wobei die elektronische Sicherung (1) eine Steuervorrichtung (4) umfasst und

wobei die elektronische Sicherung (1) einen ersten Leistungsschalter (17) mit einem ersten Anschluss (26) und einem zweiten Anschluss (28) und einem Steueranschluss (27) umfasst und

wobei die elektronische Sicherung (1) einen zweiten Leistungsschalter (17') mit einem ersten Anschluss (26') und einem zweiten Anschluss (28') und einem Steueranschluss (27') umfasst und

wobei die elektronische Sicherung (1) einen dritten Leistungsschalter (17") mit einem ersten Anschluss (26") und einem zweiten Anschluss (28") und einem Steueranschluss (27") umfasst und

wobei sich der erste Leistungsschalter (17) und der zweite Leistungsschalter (17") und der dritte Leistungsschalter (17") und die Steuervorrichtung (4) in einem Gehäuse befinden und

wobei die Sicherung einen ersten Anschluss (18) aufweist, der mit dem ersten Anschluss (26) des ersten Leistungsschalters (17) verbunden ist und

wobei die Sicherung einen ersten zweiten Anschluss (19) aufweist, der mit dem zweiten Anschluss (28) des ersten Leistungsschalters (17) verbunden ist und

wobei die Sicherung einen zweiten ersten Anschluss (18') aufweist, der mit dem ersten Anschluss (26') des zweiten Leistungsschalters (17') verbunden ist und

wobei die Sicherung einen zweiten Anschluss (19') aufweist, der mit dem zweiten Anschluss (28') des zweiten Leistungsschalters (17') verbunden ist und

wobei die Sicherung einen dritten ersten Anschluss (18") aufweist, der mit dem ersten Anschluss (26") des dritten Leistungsschalters (17") verbunden ist und

wobei die Sicherung einen dritten zweiten Anschluss (19") aufweist, der mit dem zweiten Anschluss (28") des dritten Leistungsschalters (17") verbunden ist und

wobei die Steuervorrichtung (4) den Steueranschluss (27) des ersten Leistungsschalters (17) und den Steueranschluss (27') des zweiten Leistungsschalters (17') und den Steueranschluss (27") des dritten Leistungsschalters (17") steuert.

2. Elektronische Sicherung (1), insbesondere nach einem oder mehreren der vorhergehenden Merkmale,

wobei die elektronische Sicherung (1) eine Steuervorrichtung (4) umfasst und

wobei die elektronische Sicherung (1) einen ersten Leistungsschalter (17) mit einem ersten Anschluss (26) und einem zweiten Anschluss (28) und einem Steueranschluss (27) umfasst und

wobei die elektronische Sicherung (1) einen zweiten Leistungsschalter (17') mit einem ersten Anschluss (26') und einem zweiten Anschluss (28') und einem Steueranschluss (27') umfasst und

wobei die elektronische Sicherung (1) einen dritten Leistungsschalter (17") mit einem ersten Anschluss (26") und einem zweiten Anschluss (28") und einem Steueranschluss (27") umfasst und

wobei sich der erste Leistungsschalter (17) und der zweite Leistungsschalter (17") und der dritte Leistungsschalter (17") und die Steuervorrichtung (4) in einem Gehäuse befinden und

wobei die Sicherung einen ersten Anschluss (18) aufweist,

- der mit dem ersten Anschluss (26) des ersten Leistungsschalters (17) verbunden ist und
- der mit dem ersten Anschluss (26') des zweiten Leistungsschalters (17') verbunden ist und
- der mit dem ersten Anschluss (26') des dritten Leistungsschalters (17") verbunden ist, und

wobei die Sicherung einen ersten zweiten Anschluss (19) aufweist, der mit dem zweiten Anschluss (28) des ersten Leistungsschalters (17) verbunden ist und

wobei die Sicherung einen zweiten Anschluss (19') aufweist, der mit dem zweiten Anschluss (28') des zweiten Leistungsschalters (17') verbunden ist und

wobei die Sicherung einen dritten zweiten Anschluss (19") aufweist, der mit dem zweiten Anschluss (28") des dritten Leistungsschalters (17") verbunden ist und

wobei die Steuervorrichtung (4) den Steueranschluss (27) des ersten Leistungsschalters (17) und den Steueranschluss (27') des zweiten Leistungsschalters (17') und den Steueranschluss (27") des dritten Leistungsschalters (17") steuert.

3. Elektronische Sicherung (1) eines Fahrzeugs, insbesondere nach einem oder mehreren der vorhergehenden Merkmale,

wobei die elektronische Sicherung (1) eine Steuervorrichtung (4) umfasst und

wobei die elektronische Sicherung (1) einen ersten Leistungsschalter (17) mit einem ersten Anschluss (26) und einem zweiten Anschluss (28) und einem Steueranschluss (27) umfasst und

wobei die elektronische Sicherung (1) einen zweiten Leistungsschalter (17') mit einem ersten Anschluss (26') und einem zweiten Anschluss (28') und einem Steueranschluss (27') umfasst und

wobei die elektronische Sicherung (1) einen dritten Leistungsschalter (17") mit einem ersten Anschluss (26") und einem zweiten Anschluss (28") und einem Steueranschluss (27") umfasst und

wobei die elektronische Sicherung (1) einen vierten Leistungsschalter (17‴) mit einem ersten Anschluss (26‴) und einem zweiten Anschluss (28‴) und einem Steueranschluss (27‴) umfasst und

wobei sich der erste Leistungsschalter (17) und der zweite Leistungsschalter (17") und der dritte Leistungsschalter (17") und der vierte Leistungsschalter (17‴) und die Steuervorrichtung (4) in einem Gehäuse befinden und

wobei die Sicherung einen ersten Anschluss (18) aufweist, der mit dem ersten Anschluss (26) des ersten Leistungsschalters (17) verbunden ist und

wobei die Sicherung einen ersten zweiten Anschluss (19) aufweist, der mit dem zweiten Anschluss (28) des ersten Leistungsschalters (17) verbunden ist und

wobei die Sicherung einen zweiten ersten Anschluss (18') aufweist, der mit dem ersten Anschluss (26') des zweiten Leistungsschalters (17') verbunden ist und

wobei die Sicherung einen zweiten Anschluss (19') aufweist, der mit dem zweiten Anschluss (28') des zweiten Leistungsschalters (17') verbunden ist und

wobei die Sicherung einen dritten ersten Anschluss (18") aufweist, der mit dem ersten Anschluss (26") des dritten Leistungsschalters (17") verbunden ist und

wobei die Sicherung einen dritten zweiten Anschluss (19") aufweist, der mit dem zweiten Anschluss (28") des dritten Leistungsschalters (17") verbunden ist und

wobei die Sicherung einen vierten ersten Anschluss (18‴) aufweist, der mit dem ersten Anschluss (26‴) des vierten Leistungsschalters (17‴) verbunden ist und

wobei die Sicherung einen vierten zweiten Anschluss (19‴) aufweist, der mit dem zweiten Anschluss (28‴) des vierten Leistungsschalters (17‴) verbunden ist und

wobei die Steuervorrichtung (4) den Steueranschluss (27) des ersten Leistungsschalters (17) und den Steueranschluss (27') des zweiten Leistungsschalters (17') und den Steueranschluss (27") des dritten Leistungsschalters (17") und den Steueranschluss (27‴) des vierten Leistungsschalters (17‴) steuert.

4. Elektronische Sicherung (1) eines Fahrzeugs, insbesondere nach einem oder mehreren der vorhergehenden Merkmale,

wobei die elektronische Sicherung (1) eine Steuervorrichtung (4) umfasst und

wobei die elektronische Sicherung (1) einen ersten Leistungsschalter (17) mit einem ersten Anschluss (26) und einem zweiten Anschluss (28) und einem Steueranschluss (27) umfasst und

wobei die elektronische Sicherung (1) einen zweiten Leistungsschalter (17') mit einem ersten Anschluss (26') und einem zweiten Anschluss (28') und einem Steueranschluss (27') umfasst und

wobei die elektronische Sicherung (1) einen dritten Leistungsschalter (17") mit einem ersten Anschluss (26") und einem zweiten Anschluss (28") und einem Steueranschluss (27") umfasst und

wobei die elektronische Sicherung (1) einen vierten Leistungsschalter (17‴) mit einem ersten Anschluss (26‴) und einem zweiten Anschluss (28‴) und einem Steueranschluss (27‴) umfasst und

wobei sich der erste Leistungsschalter (17) und der zweite Leistungsschalter (17") und der dritte Leistungsschalter (17") und der vierte Leistungsschalter (17‴) und die Steuervorrichtung (4) in einem Gehäuse befinden und

wobei die Sicherung einen ersten Anschluss (18) aufweist,

- der mit dem ersten Anschluss (26) des ersten Leistungsschalters (17) verbunden ist und
- der mit dem ersten Anschluss (26") des dritten Leistungsschalters (17") verbunden ist, und

wobei die Sicherung einen ersten zweiten Anschluss (19) aufweist,

- der mit dem zweiten Anschluss (28) des ersten Leistungsschalters (17) verbunden ist und
- der mit dem zweiten Anschluss (28') des zweiten Leistungsschalters (17') verbunden ist, und

wobei die Sicherung einen zweiten ersten Anschluss (18') aufweist,

- der mit dem ersten Anschluss (26') des zweiten Leistungsschalters (17') verbunden ist und
- der mit dem ersten Anschluss (26‴) des vierten Leistungsschalters (17‴) verbunden ist, und

wobei die Sicherung einen dritten zweiten Anschluss (19") aufweist,

- der mit dem zweiten Anschluss (28") des dritten Leistungsschalters (17") verbunden ist und
- der mit dem zweiten Anschluss (28‴) des vierten Leistungsschalters (17‴) verbunden ist, und

wobei die Steuervorrichtung (4) den Steueranschluss (27) des ersten Leistungsschalters (17) und den Steueranschluss (27') des zweiten Leistungsschalters (17') und den Steueranschluss (27") des dritten Leistungsschalters (17") und den Steueranschluss (27‴) des vierten Leistungsschalters (17‴) steuert.

Elektronische Sicherung mit KI-basierender Kompression von Sicherungsdaten

1. Verfahren zur Übertragung von Sicherungsdaten einer elektronischen Sicherung (1), von der Sicherung (1) zu einem übergeordneten Rechnersystem (12), insbesondere in einem Fahrzeug, insbesondere nach einem oder mehreren der vorhergehenden Merkmale,

- aufweisend oder umfassend die Schritte:
- Schritt 1: Erfassen der Parameterwertverläufe eines oder mehrerer physikalischer Parameter innerhalb der elektronischen Sicherung (1) innerhalb eines zeitlichen Abtastfensters (Hamming-Windows, zeitlichen Abtastfensters, Zeitfensters) und Bilden zumindest eines Signals (62102) dieser der Parameterwertverläufe des einen oder der mehreren physikalischen Parameter;
- Schritt 2: Bilden eines Signals der Merkmalsvektoren (62138) aus dem Signal (62102) dieser der Parameterwertverläufe des einen oder der mehreren physikalischen Parameter und/oder aus einem daraus abgeleiteten Parametersignal (62103) und/oder aus einem daraus abgeleiteten modifizierten Vektorrestsignal (73660) mit Merkmalsvektoren für dieses zeitliche Abtastfenster;
- Schritt 3: Auswertung eines Merkmalsvektors des Signals der Merkmalsvektoren (62138)

  • durch Bildung zumindest eines binären, digitalen oder analogen Abstandswerts zwischen dem aktuellen Merkmalsvektor des Signals der Merkmalsvektoren (62138) und einem oder mehreren prototypischen Merkmalsvektoren einer Prototypendatenbank (62115) und Zuordnen eines prototypischen Merkmalsvektors der Prototypendatenbank (62115) als erkanntes Signalgrundobjekt, wenn der Betrag des Abstandswerts einen oder mehrere vorbestimmte Abstandswerte betragsmäßig unterschreitet, und/oder
  • durch Zuordnen eines prototypischen Signalgrundobjekts als erkanntes Signalgrundobjekt, insbesondere mittels eines Schätzers (73151) und/oder insbesondere mittels eines neuronalen Netzwerkmodells und/oder insbesondere mittels eines Petri-Netz-Modells, wobei insbesondere das Eingangssignal des Schätzers (73151) den Merkmalsvektor des Signals der Merkmalsvektoren (62138) umfasst, und insbesondere Zuordnen eines prototypischen Merkmalsvektors einer zur Parametrisierung (Training) des Schätzers (73151) verwendeten Prototypendatenbank (62115) als erkanntes Signalgrundobjekt und/oder insbesondere Zuordnen eines prototypischen Merkmalsvektors einer Prototypendatenbank (62115) des Schätzers (73151) als erkanntes Signalgrundobjekt.

2. Verfahren nach Merkmal 1,

- mit den zusätzlichen Schritten:

  • Übertragen zumindest des Symbols eines erkannten Signalgrundobjekts 62121 und ggf. zugehöriger Parameter, im Folgenden als komprimierte Sicherungsdaten bezeichnet, an ein übergeordnetes Rechnersystem (12) und/oder eine Steuervorrichtung (4) einer anderen elektronischen Sicherung (1);
  • Rekonstruktion eines rekonstruierten Parametersignal-Modellvektors (74610) und/oder eines rekonstruierten Parametersignals (70610) aus erkannten Signalgrundobjekten (62121) insbesondere durch das übergeordnete Rechnersystem (12) und/oder insbesondere durch die Steuervorrichtung (4) der anderen elektronischen Sicherung.

3. Verfahren nach Merkmal 1 oder 2,

- aufweisend oder umfassend die Schritte:
- Extrahieren einer Folge von erkannten Signalgrundobjekten (62121) aus dem Parametersignal (62103) der Sicherung (1), insbesondere durch einmaliges oder wiederholtes Ausführen der Schritte 2 und 3 des Merkmals 1;
- Ermitteln einer prototypischen zeitlichen Abfolge prototypischer Signalgrundobjekte entsprechend einem Datensatz einer Signalobjektsequenzdatenbank (62116), im Folgenden das erkannte Signalobjekt, und des Indexes dieses Datensatzes und/oder eines Symbols für diesen Datensatz in Abhängigkeit von der ermittelten Folge von erkannten Signalgrundobjekten (62121) aus dem Parametersignal (62103) der Sicherung 1.

4. Verfahren nach Merkmal 3,

- mit den zusätzlichen Schritten:

- Übertragen zumindest des Symbols und/oder des Indexes des erkannten Signalobjekts und ggf. zugehöriger Parameter, im Folgenden ebenfalls als komprimierte Sicherungsdaten bezeichnet, an ein übergeordnetes Rechnersystem (12) und/oder eine Steuervorrichtung (4) einer anderen elektronischen Sicherung (1);
- Rekonstruktion eines oder mehrerer rekonstruierter Parametersignal-Modellvektoren (74610) und/oder eines rekonstruierten Parametersignals (70610) aus erkannten Signalobjekten (62121).

5. Verfahren nach einem der Merkmale 1 bis 4,

- mit den zusätzlichen Schritten:
- Subtraktion des rekonstruierten Parametersignal-Modellvektors (70610) von dem Parametersignal (62103) zur Bildung eines Vektorrestsignals (73660);
- Verwendung des Vektorrestsignals (73660) für die Bildung eines oder mehrerer Merkmalsvektoren des Signals der Merkmalsvektoren (62138).

6. Verfahren nach Merkmal 1,

- mit dem zusätzlichen Schritt:
- Beenden der Erkennung der Signalobjekte und/oder Signalgrundobjekte in dem Vektorrestsignal (73660), wenn die Beträge der Abtastwerte des Vektorrestsignals (73660) für dieses Abtastfenster unter den Beträgen einer vorgegebenen Schwellwertkurve und/oder unter zumindest einem vorgegebenen Betrag liegen.

7. Dekompressionsverfahren zur Dekompression komprimierter Sicherungsdaten, insbesondere durch ein übergeordnetes Rechnersystem (12) oder eine Steuervorrichtung (4) einer anderen Sicherung, insbesondere nach einem oder mehreren der vorhergehenden Merkmale,

- wobei komprimierter Sicherungsdaten die mittels eines Verfahrens nach einem oder mehreren der Merkmale 1 bis 6 komprimiert wurden,
- mit den Schritten:
- Empfangen der zu dekomprimierenden Sicherungsdaten zumindest eines Abtastfensters dieser Sicherung (1), insbesondere durch das übergeordnete Rechnersystem (12) oder die Steuervorrichtung (4) einer anderen Sicherung;
- Bereitstellen eines rekonstruierten Parametersignal-Modellvektors (74610) für ein rekonstruiertes Abtastfenster dieser Sicherung (1), insbesondere durch das übergeordnete Rechnersystem (12) oder die Steuervorrichtung (4) einer anderen Sicherung,

  • wobei der rekonstruierte Parametersignal-Modellvektor (74610) das rekonstruierten Parametersignal (70610) als Wert des rekonstruierten Parametersignal-Modellvektors (74610) umfasst und
  • wobei der der rekonstruierte Parametersignal-Modellvektor (74610) als rekonstruiertes Parametersignal (70610) bei der Bereitstellung kein Signal als Wert des rekonstruierten Parametersignal-Modellvektors (74610) aufweist (Figur 71a) und
  • wobei der rekonstruierte Parametersignal-Modellvektor (74610) der Rekonstruktion des rekonstruierten Parametersignals (70610) für dieses Abtastfenster dieser Sicherung (1) dient;

- Ergänzung dieses rekonstruierten Parametersignal-Modellvektors (74610) dieses Abtastfensters dieser Sicherung (1) durch Addition der Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) einer anderen Sicherung;
- Bilden eines rekonstruierten Parametersignals (70610) aus dem Inhalt des rekonstruierten Parametersignal-Modellvektors (74610), insbesondere durch das übergeordnete Rechnersystem (12) oder die Steuervorrichtung (4) einer anderen Sicherung;
- Verwenden des rekonstruierten Parametersignals (70610), insbesondere durch das übergeordnete Rechnersystem (12) oder die Steuervorrichtung (4) einer anderen Sicherung.

8. Dekompressionsverfahren nach Merkmal 7,

- wobei das Ergänzen des Parametersignal-Modellvektors (74610) dieses Abtastfensters dieser Sicherung (1) durch Addition der Parameterwerteverläufe eines oder mehrerer prototypischer Signalobjekte (68160) einer Prototypendatenbank, die in den komprimierten Sicherungsdaten enthalten sind, die folgenden Schritte umfasst:

- Extraktion des Symbols / Index zumindest eines Signalobjekts aus den dekomprimierenden Sicherungsdaten, insbesondere durch das übergeordnete Rechnersystem (12) oder die Steuervorrichtung (4) einer anderen Sicherung;
- Ermittlung der Parameterwerteverläufe eines oder mehrerer prototypischer Signalobjekte (68160) einer Prototypendatenbank, die dem extrahierten Symbol / dem extrahierten Index des zumindest einen Signalobjekts entsprechen, insbesondere durch das übergeordnete Rechnersystem (12) oder die Steuervorrichtung (4) einer anderen Sicherung;
- Ergänzung des Parametersignal-Modellvektors (74610) dieses Abtastfensters dieser Sicherung (1) durch Addition der ermittelten Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) einer anderen Sicherung.

9. Dekompressionsverfahren nach Merkmal 7 oder 8,

- mit dem Schritt:
- Kombination des rekonstruierten Parametersignal-Modellvektors (74610) dieses Abtastfensters dieser Sicherung (1) durch Addition der ermittelten Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) einer zweiten Sicherung, die von der ersten Sicherung (1) verschieden ist, zu einem kombinierten rekonstruierten Parametersignal-Modellvektors.

10. Dekompressionsverfahren nach Merkmal 9,

- mit dem Schritt:
- Bilden eines kombinierten rekonstruierten Parametersignals aus dem Inhalt des kombinierten rekonstruierten Parametersignal-Modellvektors, insbesondere durch das übergeordnete Rechnersystem (12) oder die Steuervorrichtung (4) einer anderen Sicherung;
- Verwenden des kombinierten rekonstruierten Parametersignals, insbesondere durch das übergeordnete Rechnersystem (12) oder die Steuervorrichtung (4) einer anderen Sicherung.

11. Sicherung (1), insbesondere nach einem oder mehreren der vorhergehenden Merkmale,

- die zur Durchführung eines Verfahrens gemäß einem oder mehreren der Merkmale 1 bis 6 eingerichtet ist.

12. Übergeordnetes Rechnersystem (12), insbesondere nach einem oder mehreren der vorhergehenden Merkmale,

- das zur Durchführung eines Verfahrens gemäß einem oder mehreren der Merkmale 7 bis 10 eingerichtet ist oder
- zu einem Einsatz zusammen mit einem mit einer Sicherung (1) nach Merkmal 11 eingerichtet ist und dazu eingerichtet ist, von dieser Sicherung (1) Sicherungsdaten über einen Datenbus (1) zu erhalten,
- wobei es sich bei den Sicherungsdaten um komprimierte Sicherungsdaten handelt, die mittels eines Verfahrens nach einem oder mehreren der Merkmale 1 bis 6 komprimiert wurden.

13. Versorgungsnetzwerk (200), insbesondere nach einem oder mehreren der vorhergehenden Merkmale,

- mit mindestens einem übergeordneten Rechnersystem (12) nach Merkmal 12 und
- mit mindestens einer Sicherung nach Merkmal 11,
- wobei das übergeordnete Rechnersystem zur Durchführung eines Verfahrens gemäß einem oder mehreren der Merkmale 7 bis 10 eingerichtet ist.

14. Versorgungsnetzwerk (200), insbesondere nach einem oder mehreren der vorhergehenden Merkmale,

- mit mindestens einem übergeordneten Rechnersystem (12) nach Merkmal 12 und
- mit mindestens zwei elektronischen Sicherungen, einer ersten elektronischen Sicherung und einer zweiten elektronischen Sicherung, nach Merkmal 11,
- wobei die erste elektronische Sicherung und die zweite elektronische Sicherung und das übergeordnete Rechnersystem (12) dazu eingerichtet sind, dass die Datenübertragung zwischen der ersten elektronischen Sicherung und der zweiten elektronischen Sicherung und dem übergeordneten Rechnersystem (12) zumindest teilweise entsprechend einem Verfahren gemäß einem oder mehreren der Merkmale 1 bis 10 abläuft.

15. Versorgungsnetzwerk (200) nach Merkmal 14,

- wobei die erste elektronische Sicherung dazu eingerichtet ist, mittels eines Verfahrens gemäß einem oder mehreren der Merkmale 1 bis 6 Sicherungsdaten der ersten elektronischen Sicherung und/oder einem oder mehrere Merkmalsvektoren der ersten elektronischen Sicherung und /oder ein Parametersignal (62103) der ersten elektronischen Sicherung zu komprimierten Sicherungsdaten der erste elektronischen Sicherung zu komprimieren und die komprimierten Sicherungsdaten der ersten elektronischen Sicherung an das übergeordnete Rechnersystem (12) zu übertragen, und
- wobei das übergeordnete Rechnersystem (12) dazu eingerichtet ist, mittels eines Verfahrens gemäß einem oder mehreren der Merkmale 7 bis 10 von der ersten elektronischen Sicherung komprimierte Sicherungsdaten zu empfangen und zu einem rekonstruierten Parametersignal (70610) der ersten Sicherung und/oder zu einem oder mehreren rekonstruierten Merkmalsvektoren der ersten Sicherung und/oder zu rekonstruierten Sicherungsdaten der ersten Sicherung zu rekonstruieren und
- wobei die zweite elektronische Sicherung dazu eingerichtet ist, mittels eines Verfahrens gemäß einem oder mehreren der Merkmale 1 bis 6 Sicherungsdaten der zweiten elektronischen Sicherung und /oder ein Parametersignal (62103) der zweiten elektronischen Sicherung und/oder einen oder mehrere Merkmalsvektoren der zweiten elektronischen Sicherung zu komprimierten Sicherungsdaten der zweiten elektronischen Sicherung zu komprimieren und die komprimierten Sicherungsdaten der zweiten elektronischen Sicherung an das übergeordnete Rechnersystem (12) zu übertragen, und
- wobei das übergeordnete Rechnersystem (12) dazu eingerichtet ist, mittels eines Verfahrens gemäß einem oder mehreren der Merkmale 7 bis 10 von der zweiten elektronischen Sicherung komprimierte Sicherungsdaten der zweiten elektronischen Sicherung zu empfangen und zu einem rekonstruierten Parametersignal (70610) der zweiten elektronischen Sicherung und/oder zu einem oder mehreren rekonstruierten Merkmalsvektoren der zweiten elektronischen Sicherung und/oder zu rekonstruierten Sicherungsdaten der zweiten elektronischen Sicherung zu rekonstruieren.

16. Versorgungsnetzwerk (200) nach Merkmal 15,

- wobei das übergeordnete Rechnersystem (12) dazu eingerichtet ist,

  • zum Ersten mit Hilfe eines des rekonstruierten Parametersignals (70610) der ersten elektronischen Sicherung und/oder des einem oder der mehreren rekonstruierten Merkmalsvektoren der ersten elektronischen Sicherung und/oder der zu rekonstruierten Sicherungsdaten der ersten elektronischen Sicherung und
  • zum Zweiten mit Hilfe eines des rekonstruierten Parametersignals (70610) der zweiten elektronischen Sicherung und/oder des einem oder der mehreren rekonstruierten Merkmalsvektoren der zweiten elektronischen Sicherung und/oder der zu rekonstruierten Sicherungsdaten der zweiten elektronischen Sicherung

- einen Zustand des Versorgungsnetzwerks (200) im Rahmen einer Zustandsermittlung zu ermitteln, und
- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen, und/oder
- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder
- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

17. Versorgungsnetzwerk (200) nach einem der Merkmale 14 bis 16,

- wobei das übergeordnete Rechnersystem (12) dazu eingerichtet ist, mit Hilfe von rekonstruierten Parametersignalen einer elektronischen Sicherung und/oder von kombinierten rekonstruierten Parametersignalen mehrerer elektronischer Sicherungen und/oder von rekonstruierten Merkmalsvektoren einer elektronischen Sicherung und/oder von kombinierten rekonstruierten Merkmalsvektoren mehrerer elektronischer Sicherungen einen Zustand des Versorgungsnetzwerks (200) im Rahmen einer Zustandsermittlung zu ermitteln, und
- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen, und/oder

- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder
- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

18. Versorgungsnetzwerk (200) nach einem oder mehreren der Merkmale 13 bis 17,

- mit mindestens einem übergeordneten Rechnersystem (12) nach Merkmal 12 und
- mit mindestens einer ersten elektronischen Sicherung nach Merkmal 11,
- wobei die erste elektronische Sicherung dazu eingerichtet ist, dass die Datenübertragung zwischen der ersten elektronischen Sicherung und dem übergeordneten Rechnersystem (12) zumindest teilweise entsprechend einem Verfahren gemäß einem oder mehreren der Merkmale 1 bis 10 abläuft, und
- wobei das übergeordnete Rechnersystem (12) dazu eingerichtet ist, ein oder mehrere Sensorsignale eines oder mehrerer Sensoren im Versorgungsnetzwerk (200) und/oder im Fahrzeug zu empfangen oder zu erfassen, und
- wobei das übergeordnete Rechnersystem (12) dazu eingerichtet ist,

  • zum Ersten mit Hilfe eines des rekonstruierten Parametersignals (70610) der ersten elektronischen Sicherung und/oder des einem oder der mehreren rekonstruierten Merkmalsvektoren der ersten elektronischen Sicherung und/oder der zu rekonstruierten Sicherungsdaten der ersten elektronischen Sicherung und
  • zum Dritten mit Hilfe eines des Sensorsignals

- einen Zustand des Versorgungsnetzwerks (200) im Rahmen einer Zustandsermittlung zu ermitteln, und/oder
- wobei das übergeordnete Rechnersystem (12) dazu eingerichtet ist, einen Zustand des Fahrzeugs im Rahmen einer Zustandsermittlung zu ermitteln.

19. Verfahren nach Merkmal 18,

- mit mindestens einer zweiten elektronischen Sicherung nach Merkmal 11,
- wobei das übergeordnete Rechnersystem (12) dazu eingerichtet ist,

  • zum Zweiten mit Hilfe eines des rekonstruierten Parametersignals (70610) der zweiten elektronischen Sicherung und/oder des einem oder der mehreren rekonstruierten Merkmalsvektoren der zweiten elektronischen Sicherung und/oder der zu rekonstruierten Sicherungsdaten der zweiten elektronischen Sicherung

- den Zustand des Versorgungsnetzwerks (200) im Rahmen einer Zustandsermittlung zu ermitteln, und/oder
- den Zustand des Fahrzeugs im Rahmen einer Zustandsermittlung zu ermitteln.

20. Verfahren nach Merkmal 18 oder 19,

- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen und/oder
- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder
- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

Versorgungsnetzwerk mit Übertragung komprimierter Sicherungsdaten an ein übergeordnetes Rechnersystem

1. Verfahren zum Betreiben eines Versorgungsnetzwerks (200), insbesondere nach einem oder mehreren der vorhergehenden Merkmale,

- wobei das Versorgungsnetzwerk (200) eine elektronische Sicherung (1) mit einer Steuervorrichtung (4) und einem Leistungsschalter (17) umfasst und

- wobei das Versorgungsnetzwerk (200) ein übergeordnetes Rechnersystem (12) umfasst und
- mit den Schritten:
- Erfassen (6200) des zeitlichen Werteverlaufs eines oder mehrerer zu erfassendem physikalischem Parameter, insbesondere durch die die Steuervorrichtung (4) der Sicherung (1), in Form eines oder mehrerer erfasster zeitlicher Parameterwerteverläufe;
- Analysieren und Komprimieren (6030) des einen oder der mehreren erfassten zeitlichen Parameterwerteverläufe des einen oder der mehreren erfassten physikalischen Parameter, insbesondere durch die Steuervorrichtung (4) der elektronischen Sicherung (1);
- Übertragen (6040) des einen oder der mehreren komprimierten, erfassten zeitlichen Parameterwerteverläufe des einen oder der mehreren zu meldenden physikalischen Parameter durch die Steuervorrichtung (4) der elektronischen Sicherung (1) an das übergeordnete Rechnersystem (12);
- Dekomprimieren (6050) des einen oder der mehreren empfangenen, komprimierten, erfassten zeitlichen Parameterwerteverläufe, insbesondere durch das übergeordnete Rechnersystem (12), zu einem oder mehreren dekomprimierten, rekonstruierten, erfassten zeitlichen Parameterwerteverläufen, die insbesondere der Steuervorrichtung (4) der Sicherung (1) innerhalb des übergeordneten Rechnersystems (12) zugeordnet sind.

2. Verfahren zum Betreiben eines Versorgungsnetzwerks (200) nach Merkmal 1,

- mit dem zusätzlichen Schritt:
- Vergleichen und/oder Korrelieren (6060) des einen oder der mehreren rekonstruierten, erfassten zeitlichen Parameterwerteverläufe, die insbesondere der Steuervorrichtung (4) der Sicherung (1) innerhalb des übergeordneten Rechnersystems (12) zugeordnet sind, mit einem oder mehreren anderen rekonstruierten, erfassten zeitlichen Parameterwerteverläufen, die insbesondere den Steuervorrichtungen (4) anderer Sicherungen (1) innerhalb des übergeordneten Rechnersystems (12) zugeordnet sind, insbesondere durch das übergeordnete Rechnersystem.

3. Verfahren zum Betreiben eines Versorgungsnetzwerks (200) nach Merkmal 2,

- mit dem zusätzlichen Schritt:
- Detektieren von Ereignissen, die auf gleiche Ursachen insbesondere in zeitlicher Korrelation zurückführbar sind, insbesondere durch das übergeordnete Rechnersystem (12).

4. Verfahren zum Betreiben eines Versorgungsnetzwerks (200) nach Merkmal 3,

- mit dem zusätzlichen Schritt:
- Ergreifen (6070) von Maßnahmen in Abhängigkeit von den detektieren Ereignissen durch das übergeordnete Rechnersystem 12 sofern notwendig.

5. Verfahren zum Betreiben eines Versorgungsnetzwerks (200) nach einem oder mehreren der Merkmale 1 bis 4,

- mit dem zusätzlichen Schritt:

- Schließen (6010) eines Leistungsschalters (17) der Sicherung (1), insbesondere durch eine Steuervorrichtung (4) einer Sicherung (1).

6. Verfahren zum Betreiben eines Versorgungsnetzwerks (200) nach einem oder mehreren der Merkmale 1 bis 5,

- wobei die Erfassung (6200) des zu erfassenden physikalischen Parameters, den die Steuervorrichtung (4) der Sicherung (1) unter Benutzung erster Mittel, die beispielsweise den Analog-zu-Digital-Wandler (570) der Steuervorrichtung (4) und/oder den Shunt-Widerstand (24) und/oder den Hilfsleistungsschalter (23) umfassen können, in einem zweiten Schritt 6020 erfasst.

7. Verfahren zum Betreiben eines Versorgungsnetzwerks (200) nach einem oder mehreren der Merkmale 1 bis 5,

- wobei die Erfassen (6200) des zeitlichen Werteverlaufs eines oder mehrerer zu erfassender physikalischer Parameter als zu erfassende physikalische Parameter eine oder mehrere der Parameter eine oder mehrere elektrische Spannungen zwischen Schaltungsknoten, insbesondere innerhalb und außerhalb der elektronischen Sicherung (1), und/oder ein oder mehrere elektrische Ströme durch Leitungen, insbesondere innerhalb der Sicherung (1) und/oder Temperaturen, insbesondere in und/oder im Umfeld der Sicherung (1), umfasst.

8. Verfahren zum Betreiben eines Versorgungsnetzwerks (200) nach einem oder mehreren der Merkmale 1 bis 6 und Merkmal 6,

- wobei das Erfassen (6200) des zeitlichen Werteverlaufs eines oder mehrerer zu erfassender physikalischer Parameter eine Wandlung (6021) der elektrischen analogen Signale, die die Mittel zur Erfassung der physikalischen Parameter erzeugen, durch Abtastung, insbesondere durch die Steuervorrichtung (4) der elektronischen Sicherung (1), in einem oder mehrere abgetastete zeitliche Parameterwertverläufe umfasst.

9. Verfahren zum Betreiben eines Versorgungsnetzwerks (200) nach Merkmal 8,

- wobei der eine oder die mehreren, abgetasteten zeitlichen Parameterwertverläufe einen zeitdiskreten Strom von Abtastwerten der Parameterwerte des betreffenden physikalischen Parameters und ggf. zugehörige Zeitstempel dieser Abtastwerte umfassen.

10. Verfahren zum Betreiben eines Versorgungsnetzwerks (200) nach Merkmal 9,

- wobei einem Abtastwert ein Abtastzeitpunkt als Zeitstempel dieses Abtastwertes, insbesondere durch die Steuervorrichtung (4) der Sicherung (1), zugeordnet ist und/oder
- wobei jedem Abtastwert ein jeweiliger Abtastzeitpunkt als jeweiliger Zeitstempel dieses jeweiligen Abtastwertes, insbesondere durch die Steuervorrichtung (4) der Sicherung (1), zugeordnet ist und/oder
- wobei Abtastwerten in gleichen Zeitabständen einen Abtastzeitpunkt als Zeitstempel dieser Abtastwerte, insbesondere durch die Steuervorrichtung (4) der Sicherung (1), zugeordnet ist.

11. Verfahren zum Betreiben eines Versorgungsnetzwerks (200) nach Merkmal 10,

- wobei das Erfassen (6200) des zeitlichen Werteverlaufs eines oder mehrerer zu erfassender physikalischer Parameter das Durchführen (6022) einer Wavelet-Transformation und/oder einer Fourier-Transformation oder eine Z-Transformation und/oder einer Laplace-Transformation oder eine andere Transformation und/oder einer anderen Kompressionsmethode umfasst.

12. Verfahren zum Betreiben eines Versorgungsnetzwerks (200) nach Merkmal 10 oder 11,

- wobei das Erfassen (6200) des zeitlichen Werteverlaufs eines oder mehrerer zu erfassender physikalischer Parameter das Wandeln (6022) der abgetasteten zeitlichen Parameterwertverläufe in komprimierte zeitliche Parameterwertverläufe, insbesondere durch die Steuervorrichtung (4) der Sicherung (1) umfasst.

13. Verfahren zum Betreiben eines Versorgungsnetzwerks (200) nach einem oder mehreren der Merkmale 1 bis 12,

- wobei das Analysieren und Komprimieren (6030) des einen oder der mehreren erfassten zeitlichen Parameterwerteverläufe des einen oder der mehreren erfassten physikalischen Parameter das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter umfasst.

14. Verfahren zum Betreiben eines Versorgungsnetzwerks (200) nach Merkmal 13,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden eines Werts einer Vektorkomponente eines Merkmalsvektors durch einen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

15. Verfahren zum Betreiben eines Versorgungsnetzwerks (200) nach Merkmal 13 oder 14,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden **jeweils** eines Werts einer Vektorkomponente eines Merkmalsvektors durch einen **jeweiligen** Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

16. Verfahren zum Betreiben eines Versorgungsnetzwerks (200) nach einem oder mehreren der Merkmale 1 bis 15,

- wobei das Analysieren und Komprimieren (6030) des einen oder der mehreren erfassten zeitlichen Parameterwerteverläufe des einen oder der mehreren erfassten physikalischen Parameter die Extraktion (6032) eines aktuellen Merkmalsvektors aus den erfassten zeitlichen Parameterwertverläufen und/oder aus den aus diesen abgeleiteten protypischen zeitlichen Verläufen abgeleiteter Parameter, insbesondere durch die Steuervorrichtung (4) der Sicherung (1) umfasst

17. Verfahren zum Betreiben eines Versorgungsnetzwerks (200) nach Merkmal 16,

- wobei das Analysieren und Komprimieren (6030) des einen oder der mehreren erfassten zeitlichen Parameterwerteverläufe des einen oder der mehreren erfassten physikalischen Parameter das Zuordnen (6032) eines jeweiligen Zeitstempels zu bevorzugt jedem Merkmalsvektor dieser Merkmalsvektoren, insbesondere durch die Steuervorrichtung (4) der Sicherung (1), umfasst.

18. Verfahren zum Betreiben eines Versorgungsnetzwerks (200) nach einem oder mehreren der Merkmale 1 bis 17,

- wobei das Analysieren und Komprimieren (6030) des einen oder der mehreren erfassten zeitlichen Parameterwerteverläufe des einen oder der mehreren erfassten physikalischen Parameter das Ermitteln (6033) eines Abstands des extrahierten aktuellen Merkmalsvektors zu einem prototypischen Merkmalsvektor der prototypischen Merkmalsvektoren einer Prototypendatenbank (62115) umfasst.

19. Verfahren zum Betreiben eines Versorgungsnetzwerks (200) nach einem oder mehreren der Merkmale 1 bis 18,

- wobei das Analysieren und Komprimieren (6030) des einen oder der mehreren erfassten zeitlichen Parameterwerteverläufe des einen oder der mehreren erfassten physikalischen Parameter das Erkennen (6034) eines prototypischen Merkmalsvektors einer oder der Prototypendatenbank (62115) als erkannten prototypischen Merkmalsvektor der Prototypendatenbank (62115), wenn der Betrag des ermittelten Abstands für dieses Paar aus diesem aktuellen Merkmalsvektor und diesem prototypischen Merkmalsvektor der Prototypendatenbank (62115) kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank (62115) ist.

Elektronische Sicherung und übergeordnetes Rechnersystem mit Kompression und Dekompression der Sicherungsmesswertsignale während der Datenübertragung

1. Verfahren (7600) zum Betreiben eines Versorgungsnetzwerks (200), insbesondere nach einem oder mehreren der vorhergehenden Merkmale,

- mit einer Komprimierung und Verschlüsselung der ersten Sicherungsdaten einer ersten elektronischen Sicherung (1) in der ersten elektronischen Sicherung (1) und
- mit einer Übertragung der komprimierten und verschlüsselten ersten Sicherungsdaten an ein übergeordnetes Rechnersystem (12) und
- mit einer Entschlüsselung und einer Dekomprimierung der komprimierten und verschlüsselten ersten Sicherungsdaten zu empfangenen ersten Sicherungsdaten der ersten Sicherung (1) im übergeordneten Rechnersystem (12).

2. Verfahren nach Merkmal 1,

- mit einer Ergreifung von Maßnahmen in Abhängigkeit von den empfangenen ersten Sicherungsdaten der ersten Sicherung (1) im übergeordneten Rechnersystem (12) durch das übergeordnete Rechnersystem (12).

3. Verfahren (7600) zum Betreiben eines Versorgungsnetzwerks (200), insbesondere nach einem oder mehreren der vorhergehenden Merkmale,

- mit einer Komprimierung und Verschlüsselung von ersten Sicherungsdaten einer ersten elektronischen Sicherung (825) in der ersten elektronischen Sicherung (825) und
- mit einer Komprimierung und Verschlüsselung von zweiten Sicherungsdaten einer zweiten elektronischen Sicherung (805) in der zweiten elektronischen Sicherung (805) und
- mit einer Übertragung der komprimierten und verschlüsselten ersten Sicherungsdaten der ersten Sicherung (825) an ein übergeordnetes Rechnersystem (12) und
- mit einer Übertragung der komprimierten und verschlüsselten zweiten Sicherungsdaten der zweiten Sicherung (805) an das übergeordnete Rechnersystem (12) und
- mit einer Entschlüsselung und einer Dekomprimierung der komprimierten und verschlüsselten ersten Sicherungsdaten der ersten Sicherung zu empfangenen ersten Sicherungsdaten der ersten Sicherung (825) im übergeordneten Rechnersystem (12) und
- mit einer Entschlüsselung und einer Dekomprimierung der komprimierten und verschlüsselten zweiten Sicherungsdaten der zweiten Sicherung (805) zu empfangenen zweiten Sicherungsdaten der zweiten Sicherung (805) im übergeordneten Rechnersystem (12) und
- mit einer Ergreifung von Maßnahmen in Abhängigkeit von den empfangenen ersten Sicherungsdaten der ersten Sicherung (825) und in Abhängigkeit von den empfangenen zweiten Sicherungsdaten der zweiten Sicherung (805) im übergeordneten Rechnersystem (12) durch das übergeordnete Rechnersystem (12).

Versorgungsnetzwerk mit verschlüsselter und komprimierter Datenkommunikation zwischen Sicherungen und übergeordnetem Rechnersystem

4. Verfahren (7600) zum Betreiben eines Versorgungsnetzwerks (200), insbesondere nach einem oder mehreren der vorhergehenden Merkmale,

- wobei das Versorgungsnetzwerk (200) eine elektronische Sicherung (1) mit einer Steuervorrichtung (4) und einem Leistungsschalter (17) umfasst und
- wobei das Versorgungsnetzwerk (200) ein übergeordnetes Rechnersystem (12) umfasst und
- mit den Schritten:
- Erfassen (6200) des zeitlichen Werteverlaufs eines oder mehrerer zu erfassendem physikalischem Parameter, insbesondere durch die die Steuervorrichtung (4) der Sicherung (1), in Form eines oder mehrerer erfasster zeitlicher Parameterwerteverläufe;
- Analysieren und Komprimieren (6030) des einen oder der mehreren erfassten zeitlichen Parameterwerteverläufe des einen oder der mehreren erfassten physikalischen Parameter, insbesondere durch die Steuervorrichtung (4) der elektronischen Sicherung (1);
- Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter;
- Übertragen (6040) des einen oder der mehreren verschlüsselten, komprimierten, erfassten zeitlichen Parameterwerteverläufe des einen oder der mehreren zu meldenden physikalischen Parameter durch die Steuervorrichtung (4) der elektronischen Sicherung (1) an das übergeordnete Rechnersystem (12);
- Entschlüsseln (7620) des einen oder der mehreren empfangenen, verschlüsselten, komprimierten, erfassten zeitlichen Parameterwerteverläufe des einen oder der mehreren zu meldenden physikalischen Parameter, insbesondere durch das übergeordnete Rechnersystem (12), zu einem oder mehreren, entschlüsselten, komprimierten, erfassten zeitlichen Parameterwerteverläufen des einen oder der mehreren zu meldenden physikalischen Parameter;
- Dekomprimieren (6050) des einen oder der mehreren entschlüsselten, empfangenen, komprimierten, erfassten zeitlichen Parameterwerteverläufe, insbesondere durch das übergeordnete Rechnersystem (12), zu einem oder mehreren dekomprimierten, rekonstruierten, erfassten zeitlichen Parameterwerteverläufen, die insbesondere der Steuervorrichtung (4) der Sicherung (1) innerhalb des übergeordneten Rechnersystems (12) zugeordnet sind.

5. Verfahren zum Betreiben eines Versorgungsnetzwerks (200) nach Merkmal 1,

- mit dem zusätzlichen Schritt:

- Vergleichen und/oder Korrelieren (6060) des einen oder der mehreren rekonstruierten, erfassten zeitlichen Parameterwerteverläufe, die insbesondere der Steuervorrichtung (4) der Sicherung (1) innerhalb des übergeordneten Rechnersystems (12) zugeordnet sind, mit einem oder mehreren anderen rekonstruierten, erfassten zeitlichen Parameterwerteverläufen, die insbesondere den Steuervorrichtungen (4) anderer Sicherungen (1) innerhalb des übergeordneten Rechnersystems (12) zugeordnet sind, insbesondere durch das übergeordnete Rechnersystem.

6. Verfahren zum Betreiben eines Versorgungsnetzwerks (200) nach Merkmal 2,

- mit dem zusätzlichen Schritt:

- Detektieren von Ereignissen, die auf gleiche Ursachen insbesondere in zeitlicher Korrelation zurückführbar sind insbesondere durch das übergeordnete Rechnersystem (12).

7. Verfahren zum Betreiben eines Versorgungsnetzwerks (200) nach Merkmal 3,

- mit den zusätzlichen Schritten:
- Bewerten (6070) der detektieren Ereignissen durch das übergeordnete Rechnersystem 12 und
- Ergreifen (6070) von Maßnahmen in Abhängigkeit von den detektieren Ereignissen durch das übergeordnete Rechnersystem 12 sofern notwendig.

8. Verfahren zum Betreiben eines Versorgungsnetzwerks (200) nach einem oder mehreren der Merkmale 1 bis 4,

- mit dem zusätzlichen Schritt:

- Schließen (6010) eines Leistungsschalters (17) der Sicherung (1), insbesondere durch eine Steuervorrichtung (4) einer Sicherung (1).

9. Verfahren zum Betreiben eines Versorgungsnetzwerks (200) nach einem oder mehreren der Merkmale 1 bis 5,

- wobei die Erfassung (6200) des zu erfassenden physikalischen Parameters, den die Steuervorrichtung (4) der Sicherung (1) unter Benutzung erster Mittel, die beispielsweise den Analog-zu-Digital-Wandler (570) der Steuervorrichtung (4) und/oder den Shunt-Widerstand (24) und/oder den Hilfsleistungsschalter (23) umfassen können, in einem zweiten Schritt 6020 erfasst.

10. Verfahren zum Betreiben eines Versorgungsnetzwerks (200) nach einem oder mehreren der Merkmale 1 bis 5,

- wobei die Erfassen (6200) des zeitlichen Werteverlaufs eines oder mehrerer zu erfassender physikalischer Parameter als zu erfassende physikalische Parameter eine oder mehrere der Parameter eine oder mehrere elektrische Spannungen zwischen Schaltungsknoten, insbesondere innerhalb und außerhalb der elektronischen Sicherung (1), und/oder ein oder mehrere elektrische Ströme durch Leitungen, insbesondere innerhalb der Sicherung (1) und/oder Temperaturen, insbesondere in und/oder im Umfeld der Sicherung (1), umfasst.

11. Verfahren zum Betreiben eines Versorgungsnetzwerks (200) nach einem oder mehreren der Merkmale 1 bis 6 und Merkmal 6,

- wobei das Erfassen (6200) des zeitlichen Werteverlaufs eines oder mehrerer zu erfassender physikalischer Parameter eine Wandlung (6021) der elektrischen analogen Signale, die die Mittel zur Erfassung der physikalischen Parameter erzeugen, durch Abtastung, insbesondere durch die Steuervorrichtung (4) der elektronischen Sicherung (1), in einem oder mehrere abgetastete zeitliche Parameterwertverläufe umfasst.

12. Verfahren zum Betreiben eines Versorgungsnetzwerks (200) nach Merkmal 8,

- wobei der eine oder die mehreren, abgetasteten zeitlichen Parameterwertverläufe einen zeitdiskreten Strom von Abtastwerten der Parameterwerte des betreffenden physikalischen Parameters und ggf. zugehörige Zeitstempel dieser Abtastwerte umfassen.

13. Verfahren zum Betreiben eines Versorgungsnetzwerks (200) nach Merkmal 9,

- wobei einem Abtastwert ein Abtastzeitpunkt als Zeitstempel dieses Abtastwertes, insbesondere durch die Steuervorrichtung (4) der Sicherung (1), zugeordnet ist und/oder
- wobei jedem Abtastwert ein jeweiliger Abtastzeitpunkt als jeweiliger Zeitstempel dieses jeweiligen Abtastwertes, insbesondere durch die Steuervorrichtung (4) der Sicherung (1), zugeordnet ist und/oder
- wobei Abtastwerten in gleichen Zeitabständen einen Abtastzeitpunkt als Zeitstempel dieser Abtastwerte, insbesondere durch die Steuervorrichtung (4) der Sicherung (1), zugeordnet ist.

14. Verfahren zum Betreiben eines Versorgungsnetzwerks (200) nach Merkmal 10,

- wobei das Erfassen (6200) des zeitlichen Werteverlaufs eines oder mehrerer zu erfassender physikalischer Parameter das Durchführen (6022) einer Wavelet-Transformation und/oder einer Fourier-Transformation oder einer Z-Transformation und/oder einer Laplace-Transformation oder einer anderen Transformation und/oder einer anderen Kompressionsmethode umfasst.

15. Verfahren zum Betreiben eines Versorgungsnetzwerks (200) nach Merkmal 10 oder 11,

- wobei das Erfassen (6200) des zeitlichen Werteverlaufs eines oder mehrerer zu erfassender physikalischer Parameter das Wandeln (6022) der abgetasteten zeitlichen Parameterwertverläufe in komprimierte zeitliche Parameterwertverläufe, insbesondere durch die Steuervorrichtung (4) der Sicherung (1) umfasst.

16. Verfahren zum Betreiben eines Versorgungsnetzwerks (200) nach einem oder mehreren der Merkmale 1 bis 12,

- wobei das Analysieren und Komprimieren (6030) des einen oder der mehreren erfassten zeitlichen Parameterwerteverläufe des einen oder der mehreren erfassten physikalischen Parameter das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter umfasst.

17. Verfahren zum Betreiben eines Versorgungsnetzwerks (200) nach Merkmal 13,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden eines Werts einer Vektorkomponente eines Merkmalsvektors durch einen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

18. Verfahren zum Betreiben eines Versorgungsnetzwerks (200) nach Merkmal 13 oder 14,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden jeweils eines Werts einer Vektorkomponente eines Merkmalsvektor durch einen jeweiligen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

19. Verfahren zum Betreiben eines Versorgungsnetzwerks (200) nach einem oder mehreren der Merkmale 1 bis 15,

- wobei das Analysieren und Komprimieren (6030) des einen oder der mehreren erfassten zeitlichen Parameterwerteverläufe des einen oder der mehreren erfassten physikalischen Parameter die Extraktion (6032) eines aktuellen Merkmalsvektors aus den erfassten zeitlichen Parameterwertverläufen und/oder aus den aus diesen abgeleiteten protypischen zeitlichen Verläufen abgeleiteter Parameter, insbesondere durch die Steuervorrichtung (4) der elektronischen Sicherung (1) umfasst 20. Verfahren zum Betreiben eines Versorgungsnetzwerks (200) nach Merkmal 16,

- wobei das Analysieren und Komprimieren (6030) des einen oder der mehreren erfassten zeitlichen Parameterwerteverläufe des einen oder der mehreren erfassten physikalischen Parameter das Zuordnen (6032) eines jeweiligen Zeitstempels zu bevorzugt jedem Merkmalsvektor dieser Merkmalsvektoren, insbesondere durch die Steuervorrichtung (4) der elektronischen Sicherung (1), umfasst.

21. Verfahren zum Betreiben eines Versorgungsnetzwerks (200) nach einem oder mehreren der Merkmale 1 bis 17,

- wobei das Analysieren und Komprimieren (6030) des einen oder der mehreren erfassten zeitlichen Parameterwerteverläufe des einen oder der mehreren erfassten physikalischen Parameter das Ermitteln (6033) eines Abstands des extrahierten aktuellen Merkmalsvektors zu einem prototypischen Merkmalsvektor der prototypischen Merkmalsvektoren einer Prototypendatenbank (62115) umfasst.

22. Verfahren zum Betreiben eines Versorgungsnetzwerks (200) nach einem oder mehreren der Merkmale 1 bis 18,

- wobei das Analysieren und Komprimieren (6030) des einen oder der mehreren erfassten zeitlichen Parameterwerteverläufe des einen oder der mehreren erfassten physikalischen Parameter das Erkennen (6034) eines prototypischen Merkmalsvektors einer oder der Prototypendatenbank (62115) als erkannten prototypischen Merkmalsvektor der Prototypendatenbank (62115), wenn der Betrag des ermittelten Abstands für dieses Paar aus diesem aktuellen Merkmalsvektor und diesem prototypischen Merkmalsvektor der Prototypendatenbank (62115) kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank (62115) ist.

23. Verfahren zum Betreiben eines Versorgungsnetzwerks (200) nach einem oder mehreren der Merkmale 1 bis 19,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter unter Zuhilfenahme einer Zufallszahl oder Pseudozufallszahl, insbesondere durch die Steuervorrichtung (4) der elektronischen Sicherung (1), erfolgt.

24. Verfahren zum Betreiben eines Versorgungsnetzwerks (200) nach Merkmal 20,

- wobei die Zufallszahl eine echte Zufallszahl ist.

25. Verfahren zum Betreiben eines Versorgungsnetzwerks (200) nach Merkmal 21,

- wobei die Zufallszahl eine Quantenzufallszahl eines Quantenzufallszahlengenerators (60) ist.

26. Verfahren zum Betreiben eines Versorgungsnetzwerks (200) nach einem oder mehreren der Merkmale 1 bis 22,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter mittels eines PQC-Verschlüsselungsverfahrens, insbesondere durch die Steuervorrichtung (4) der elektronischen Sicherung (1), erfolgt.

Elektronische Sicherung mit verschlüsselter und komprimierter Datenkommunikation und deren Anwendung und Weiterbildungen

27. Verfahren zur Übertragung von Sicherungsdaten einer elektronischen Sicherung (1), von der Sicherung (1) zu einem übergeordneten Rechnersystem (12), insbesondere in einem Fahrzeug, insbesondere nach einem oder mehreren der vorhergehenden Merkmale,

- aufweisend oder umfassend die Schritte:
- Schritt 1: Erfassen der Parameterwertverläufe eines oder mehrerer physikalischer Parameter innerhalb der elektronischen Sicherung (1) innerhalb eines zeitlichen Abtastfensters (Hamming-Windows, zeitlichen Abtastfensters, Zeitfensters) und Bilden zumindest eines Signals (62102) dieser der Parameterwertverläufe des einen oder der mehreren physikalischen Parameter;
- Schritt 2: Bilden eines Signals der Merkmalsvektoren (62138) aus dem Signal (62102) dieser der Parameterwertverläufe des einen oder der mehreren physikalischen Parameter und/oder aus einem daraus abgeleiteten Parametersignal (62103) und/oder aus einem daraus abgeleiteten modifizierten Vektorrestsignal (73660) mit Merkmalsvektoren für dieses zeitliche Abtastfenster;
- Schritt 3: Auswertung eines Merkmalsvektors des Signals der Merkmalsvektoren (62138)

  • durch Bildung zumindest eines binären, digitalen oder analogen Abstandswerts zwischen dem aktuellen Merkmalsvektor des Signals der Merkmalsvektoren (62138) und einem oder mehreren prototypischen Merkmalsvektoren einer Prototypendatenbank (62115) und Zuordnen eines prototypischen Merkmalsvektors der Prototypendatenbank (62115) als erkanntes Signalgrundobjekt, wenn der Betrag des Abstandswerts einen oder mehrere vorbestimmte Abstandswerte betragsmäßig unterschreitet, und/oder
  • durch Zuordnen eines prototypischen Signalgrundobjekts als erkanntes Signalgrundobjekt, insbesondere mittels eines Schätzers (73151) und/oder insbesondere mittels eines neuronalen Netzwerkmodells und/oder insbesondere mittels eines Petri-Netz-Modells, wobei insbesondere das Eingangssignal des Schätzers (73151) den Merkmalsvektor des Signals der Merkmalsvektoren (62138) umfasst, und insbesondere Zuordnen eines prototypischen Merkmalsvektors einer zur Parametrisierung (Training) des Schätzers (73151) verwendeten Prototypendatenbank (62115) als erkanntes Signalgrundobjekt und/oder insbesondere Zuordnen eines prototypischen Merkmalsvektors einer Prototypendatenbank (62115) des Schätzers (73151) als erkanntes Signalgrundobjekt.

28. Verfahren nach Merkmal 1,

- mit den zusätzlichen Schritten:

  • Übertragen zumindest des Symbols eines erkannten Signalgrundobjekts 62121 und ggf. zugehöriger Parameter, im Folgenden als komprimierte Sicherungsdaten bezeichnet, an ein übergeordnetes Rechnersystem (12) und/oder eine Steuervorrichtung (4) einer anderen elektronischen Sicherung (1);
  • Rekonstruktion eines rekonstruierten Parametersignal-Modellvektors (74610) und/oder eines rekonstruierten Parametersignals (70610) aus erkannten Signalgrundobjekten (62121) insbesondere durch das übergeordnete Rechnersystem (12) und/oder insbesondere durch die Steuervorrichtung (4) der anderen elektronischen Sicherung.

29. Verfahren nach Merkmal 1 oder 2,

- aufweisend oder umfassend die Schritte:
- Extrahieren einer Folge von erkannten Signalgrundobjekten (62121) aus dem Parametersignal (62103) der Sicherung (1), insbesondere durch einmaliges oder wiederholtes Ausführen der Schritte 2 und 3 des Merkmals 1,
- Ermitteln einer prototypischen zeitlichen Abfolge prototypischer Signalgrundobjekte entsprechend einem Datensatz einer Signalobjektsequenzdatenbank (62116), im Folgenden das erkannte Signalobjekt, und des Indexes dieses Datensatzes und/oder eines Symbols für diesen Datensatz in Abhängigkeit von der ermittelten Folge von erkannten Signalgrundobjekten (62121) aus dem Parametersignal (62103) der Sicherung 1.

30. Verfahren nach Merkmal 3,

- mit den zusätzlichen Schritten:
- Übertragen zumindest des Symbols und/oder des Indexes des erkannten Signalobjekts und ggf. zugehöriger Parameter, im Folgenden ebenfalls als komprimierte Sicherungsdaten bezeichnet, an ein übergeordnetes Rechnersystem (12) und/oder eine Steuervorrichtung (4) einer anderen elektronischen Sicherung (1);
- Rekonstruktion eines oder mehrerer rekonstruierter Parametersignal-Modellvektoren (74610) und/oder eines rekonstruierten Parametersignals (70610) aus erkannten Signalobjekten (62121).

31. Verfahren nach einem der Merkmale 1 bis 4,

- mit den zusätzlichen Schritten:
- Subtraktion des rekonstruierten Parametersignal-Modellvektors (70610) von dem Parametersignal (62103) zur Bildung eines Vektorrestsignals (73660);
- Verwendung des Vektorrestsignals (73660) für die Bildung eines oder mehrerer Merkmalsvektoren des Signals der Merkmalsvektoren (62138).

32. Verfahren nach Merkmal 1,

- mit dem zusätzlichen Schritt:
- Beenden der Erkennung der Signalobjekte und/oder Signalgrundobjekte in dem Vektorrestsignal (73660), wenn die Beträge der Abtastwerte des Vektorrestsignals (73660) für dieses Abtastfenster unter den Beträgen einer vorgegebenen Schwellwertkurve und/oder unter zumindest einem vorgegebenen Betrag liegen.

33. Dekompressionsverfahren zur Dekompression komprimierter Sicherungsdaten, insbesondere durch ein übergeordnetes Rechnersystem (12) oder eine Steuervorrichtung (4) einer anderen Sicherung, insbesondere nach einem oder mehreren der vorhergehenden Merkmale,

- wobei komprimierter Sicherungsdaten die mittels eines Verfahrens nach einem oder mehreren der Merkmale 1 bis 6 komprimiert wurden,
- mit den Schritten:
- Empfangen der zu dekomprimierenden Sicherungsdaten zumindest eines Abtastfensters dieser Sicherung (1), insbesondere durch das übergeordnete Rechnersystem (12) oder die Steuervorrichtung (4) einer anderen Sicherung;
- Bereitstellen eines rekonstruierten Parametersignal-Modellvektors (74610) für ein rekonstruiertes Abtastfenster dieser Sicherung (1), insbesondere durch das übergeordnete Rechnersystem (12) oder die Steuervorrichtung (4) einer anderen Sicherung,

  • wobei der rekonstruierte Parametersignal-Modellvektor (74610) das rekonstruierten Parametersignal (70610) als Wert des rekonstruierten Parametersignal-Modellvektors (74610) umfasst und
  • wobei der der rekonstruierte Parametersignal-Modellvektor (74610) als rekonstruiertes Parametersignal (70610) bei der Bereitstellung kein Signal als Wert des rekonstruierten Parametersignal-Modellvektors (74610) aufweist (Figur 71a) und
  • wobei der rekonstruierte Parametersignal-Modellvektor (74610) der Rekonstruktion des rekonstruierten Parametersignals (70610) für dieses Abtastfenster dieser Sicherung (1) dient;

- Ergänzung dieses rekonstruierten Parametersignal-Modellvektors (74610) dieses Abtastfensters dieser Sicherung (1) durch Addition der Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) einer anderen Sicherung;
- Bilden eines rekonstruierten Parametersignals (70610) aus dem Inhalt des rekonstruierten Parametersignal-Modellvektors (74610), insbesondere durch das übergeordnete Rechnersystem (12) oder die Steuervorrichtung (4) einer anderen Sicherung;
- Verwenden des rekonstruierten Parametersignals (70610), insbesondere durch das übergeordnete Rechnersystem (12) oder die Steuervorrichtung (4) einer anderen Sicherung.

34. Dekompressionsverfahren nach Merkmal 7,

- wobei das Ergänzen des Parametersignal-Modellvektors (74610) dieses Abtastfensters dieser Sicherung (1) durch Addition der Parameterwerteverläufe eines oder mehrerer prototypischer Signalobjekte (68160) einer Prototypendatenbank, die in den komprimierten Sicherungsdaten enthalten sind, die folgenden Schritte umfasst:

  • Extraktion des Symbols / Index zumindest eines Signalobjekts aus den dekomprimierenden Sicherungsdaten, insbesondere durch das übergeordnete Rechnersystem (12) oder die Steuervorrichtung (4) einer anderen Sicherung;
  • Ermittlung der Parameterwerteverläufe eines oder mehrerer prototypischer Signalobjekte (68160) einer Prototypendatenbank, die dem extrahierten Symbol / dem extrahierten Index des zumindest einen Signalobjekts entsprechen, insbesondere durch das übergeordnete Rechnersystem (12) oder die Steuervorrichtung (4) einer anderen Sicherung;

- Ergänzung des Parametersignal-Modellvektors (74610) dieses Abtastfensters dieser Sicherung (1) durch Addition der ermittelten Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) einer anderen Sicherung.

35. Dekompressionsverfahren nach Merkmal 7 oder 8,

- mit dem Schritt:

- Kombination des rekonstruierten Parametersignal-Modellvektors (74610) dieses Abtastfensters dieser Sicherung (1) durch Addition der ermittelten Parameterwerteverläufe eines oder mehrerer prototypischer Signalobjekte (68160) einer Prototypendatenbank, die in den komprimierten Sicherungsdaten enthalten sind, insbesondere durch das übergeordnete Rechnersystem (12) oder die Steuervorrichtung (4) **einer zweiten** Sicherung, die von der ersten Sicherung (1) verschieden ist, zu einem kombinierten rekonstruierten Parametersignal-Modellvektors.

36. Dekompressionsverfahren nach Merkmal 9,

- mit dem Schritt:
- Bilden eines kombinierten rekonstruierten Parametersignals aus dem Inhalt des kombinierten rekonstruierten Parametersignal-Modellvektors, insbesondere durch das übergeordnete Rechnersystem (12) oder die Steuervorrichtung (4) einer anderen Sicherung;
- Verwenden des kombinierten rekonstruierten Parametersignals, insbesondere durch das übergeordnete Rechnersystem (12) oder die Steuervorrichtung (4) einer anderen Sicherung.

37. Sicherung (1), insbesondere nach einem oder mehreren der vorhergehenden Merkmale,

- die zur Durchführung eines Verfahrens gemäß einem oder mehreren der Merkmale 1 bis 6 eingerichtet ist.

38. Übergeordnetes Rechnersystem (12), insbesondere nach einem oder mehreren der vorhergehenden Merkmale,

- das zur Durchführung eines Verfahrens gemäß einem oder mehreren der Mekrmale 7 bis 10 eingerichtet ist oder
- zu einem Einsatz zusammen mit einem mit einer Sicherung (1) nach Merkmal 11 eingerichtet ist und dazu eingerichtet ist, von dieser Sicherung (1) Sicherungsdaten über einen Datenbus (1) zu erhalten,
- wobei es sich bei den Sicherungsdaten um komprimierte Sicherungsdaten handelt, die mittels eines Verfahrens nach einem oder mehreren der Merkmale 1 bis 6 komprimiert wurden.

39. Versorgungsnetzwerk (200), insbesondere nach einem oder mehreren der vorhergehenden Merkmale,

- mit mindestens einem übergeordneten Rechnersystem (12) nach Merkmal 12 und
- mit mindestens einer Sicherung nach Merkmal 11,
- wobei das übergeordnete Rechnersystem zur Durchführung eines Verfahrens gemäß einem oder mehreren der Merkmale 7 bis 10 eingerichtet ist.

40. Versorgungsnetzwerk (200),

- mit mindestens einem übergeordneten Rechnersystem (12) nach Merkmal 12 und
- mit mindestens zwei elektronischen Sicherungen, einer ersten elektronischen Sicherung und einer zweiten elektronischen Sicherung, nach Merkmal 11,
- wobei die erste elektronische Sicherung und die zweite elektronische Sicherung und das übergeordnete Rechnersystem (12) dazu eingerichtet sind, dass die Datenübertragung zwischen der ersten elektronischen Sicherung und der zweiten elektronischen Sicherung und dem übergeordneten Rechnersystem (12) zumindest teilweise entsprechend einem Verfahren gemäß einem oder mehreren der

Merkmale 1 bis 10 abläuft.

41. Versorgungsnetzwerk (200) nach Merkmal 14,

- wobei die erste elektronische Sicherung dazu eingerichtet ist, mittels eines Verfahrens gemäß einem oder mehreren der Merkmale 1 bis 6 Sicherungsdaten der ersten elektronischen Sicherung und/oder einem oder mehrere Merkmalsvektoren der ersten elektronischen Sicherung und /oder ein Parametersignal (62103) der ersten elektronischen Sicherung zu komprimierten Sicherungsdaten der erste elektronischen Sicherung zu komprimieren und die komprimierten Sicherungsdaten der ersten elektronischen Sicherung an das übergeordnete Rechnersystem (12) zu übertragen, und

- wobei das übergeordnete Rechnersystem (12) dazu eingerichtet ist, mittels eines Verfahrens gemäß einem oder mehreren der Merkmale 7 bis 10 von der ersten elektronischen Sicherung komprimierte Sicherungsdaten zu empfangen und zu einem rekonstruierten Parametersignal (70610) der ersten Sicherung und/oder zu einem oder mehreren rekonstruierten Merkmalsvektoren der ersten Sicherung und/oder zu rekonstruierten Sicherungsdaten der ersten Sicherung zu rekonstruieren und

- wobei die zweite elektronische Sicherung dazu eingerichtet ist, mittels eines Verfahrens gemäß einem oder mehreren der Merkmale 1 bis 6 Sicherungsdaten der zweiten elektronischen Sicherung und /oder ein Parametersignal (62103) der zweiten elektronischen Sicherung und/oder einen oder mehrere Merkmalsvektoren der zweiten elektronischen Sicherung zu komprimierten Sicherungsdaten der zweiten elektronischen Sicherung zu komprimieren und die komprimierten Sicherungsdaten der zweiten elektronischen Sicherung an das übergeordnete Rechnersystem (12) zu übertragen, und

- wobei das übergeordnete Rechnersystem (12) dazu eingerichtet ist, mittels eines Verfahrens gemäß einem oder mehreren der Merkmale 7 bis 10 von der zweiten elektronischen Sicherung komprimierte Sicherungsdaten der zweiten elektronischen Sicherung zu empfangen und zu einem rekonstruierten Parametersignal (70610) der zweiten elektronischen Sicherung und/oder zu einem oder mehreren rekonstruierten Merkmalsvektoren der zweiten elektronischen Sicherung und/oder zu rekonstruierten Sicherungsdaten der zweiten elektronischen Sicherung zu rekonstruieren.

42. Versorgungsnetzwerk (200) nach Merkmal 15,

- wobei das übergeordnete Rechnersystem (12) dazu eingerichtet ist,

• zum Ersten mit Hilfe eines des rekonstruierten Parametersignals (70610) der ersten elektronischen Sicherung und/oder des einem oder der mehreren rekonstruierten Merkmalsvektoren der ersten elektronischen Sicherung und/oder der zu rekonstruierten Sicherungsdaten der ersten elektronischen Sicherung und

• zum Zweiten mit Hilfe eines des rekonstruierten Parametersignals (70610) der zweiten elektronischen Sicherung und/oder des einem oder der mehreren rekonstruierten Merkmalsvektoren der zweiten elektronischen Sicherung und/oder der zu rekonstruierten Sicherungsdaten der zweiten elektronischen Sicherung

- einen Zustand des Versorgungsnetzwerks (200) im Rahmen einer Zustandsermittlung zu ermitteln, und

- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen, und/oder

- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder

- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

43. Versorgungsnetzwerk (200) nach einem der Merkmale 14 bis 16,

- wobei das übergeordnete Rechnersystem (12) dazu eingerichtet ist, mit Hilfe von rekonstruierten Parametersignalen einer elektronischen Sicherung und/oder von kombinierten rekonstruierten Parametersignalen mehrerer elektronischer Sicherungen und/oder von rekonstruierten Merkmalsvektoren einer elektronischen Sicherung und/oder von kombinierten rekonstruierten Merkmalsvektoren mehrerer elektronischer Sicherungen einen Zustand des Versorgungsnetzwerks (200) im Rahmen einer Zustandsermittlung zu ermitteln, und

- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen, und/oder

- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder

- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

44. Versorgungsnetzwerk (200) nach einem oder mehreren der Merkmale 13 bis 17,

- mit mindestens einem übergeordneten Rechnersystem (12) nach Merkmal 12 und
- mit mindestens einer ersten elektronischen Sicherung nach Merkmal 11,
- wobei die erste elektronische Sicherung dazu eingerichtet ist, dass die Datenübertragung zwischen der ersten elektronischen Sicherung und dem übergeordneten Rechnersystem (12) zumindest teilweise entsprechend einem Verfahren gemäß einem oder mehreren der Merkmale 1 bis 10 abläuft, und
- wobei das übergeordnete Rechnersystem (12) dazu eingerichtet ist, ein oder mehrere Sensorsignale eines oder mehrerer Sensoren im Versorgungsnetzwerk (200) und/oder im Fahrzeug zu empfangen oder zu erfassen, und
- wobei das übergeordnete Rechnersystem (12) dazu eingerichtet ist,

  • zum Ersten mit Hilfe eines des rekonstruierten Parametersignals (70610) der ersten elektronischen Sicherung und/oder des einem oder der mehreren rekonstruierten Merkmalsvektoren der ersten elektronischen Sicherung und/oder der zu rekonstruierten Sicherungsdaten der ersten elektronischen Sicherung und
  • zum Dritten mit Hilfe eines des Sensorsignals

- einen Zustand des Versorgungsnetzwerks (200) im Rahmen einer Zustandsermittlung zu ermitteln, und/oder
- wobei das übergeordnete Rechnersystem (12) dazu eingerichtet ist, einen Zustand des Fahrzeugs im Rahmen einer Zustandsermittlung zu ermitteln.

45. Verfahren nach Merkmal 18,

- mit mindestens einer zweiten elektronischen Sicherung nach Merkmal 11,
- wobei das übergeordnete Rechnersystem (12) dazu eingerichtet ist,

  • zum Zweiten mit Hilfe eines des rekonstruierten Parametersignals (70610) der zweiten elektronischen Sicherung und/oder des einem oder der mehreren rekonstruierten Merkmalsvektoren der zweiten elektronischen Sicherung und/oder der zu rekonstruierten Sicherungsdaten der zweiten elektronischen Sicherung

- den Zustand des Versorgungsnetzwerks (200) im Rahmen einer Zustandsermittlung zu ermitteln, und/oder
- den Zustand des Fahrzeugs im Rahmen einer Zustandsermittlung zu ermitteln.

46. Verfahren nach Merkmal 18 oder 19,

- wobei insbesondere das übergeordnete Rechnersystem (12) dazu eingerichtet ist, im Zuge der Zustandsermittlung auf Kurzschlüsse (1515) zwischen Versorgungsleitungen (1915, 1505) untereinander zu schließen und/oder
- wobei insbesondere das übergeordnete Rechnersystem (12) dazu eingerichtet ist, im Zuge der Zustandsermittlung auf Kurzschlüsse zwischen Versorgungsleitungen und einer Bezugspotenzialleitung (201) und/oder der Fahrzeugkarosserie zu schließen, und/oder
- wobei insbesondere das übergeordnete Rechnersystem (12) dazu eingerichtet ist, im Zuge der Zustandsermittlung auf Leistungsverluste in überwachten Leitungsanschnitten (1915, 1505) zu schließen.

47. Verfahren zum Betreiben eines Versorgungsnetzwerks (200), insbesondere nach einem oder mehreren der vorhergehenden Merkmale,

- wobei das Versorgungsnetzwerk (200) eine elektronische Sicherung (1) mit einer Steuervorrichtung (4) und einem Leistungsschalter (17) umfasst und
- wobei das Versorgungsnetzwerk (200) ein übergeordnetes Rechnersystem (12) umfasst und
- mit den Schritten:
- Erfassen (6200) des zeitlichen Werteverlaufs eines oder mehrerer zu erfassendem physikalischem Parameter, insbesondere durch die die Steuervorrichtung (4) der Sicherung (1), in Form eines oder mehrerer erfasster zeitlicher Parameterwerteverläufe;
- Analysieren und Komprimieren (6030) des einen oder der mehreren erfassten zeitlichen Parameterwerteverläufe des einen oder der mehreren erfassten physikalischen Parameter, insbesondere durch die Steuervorrichtung (4) der elektronischen Sicherung (1);

- Übertragen (6040) des einen oder der mehreren komprimierten, erfassten zeitlichen Parameterwerteverläufe des einen oder der mehreren zu meldenden physikalischen Parameter durch die Steuervorrichtung (4) der elektronischen Sicherung (1) an das übergeordnete Rechnersystem (12);
- Dekomprimieren (6050) des einen oder der mehreren empfangenen, komprimierten, erfassten zeitlichen Parameterwerteverläufe, insbesondere durch das übergeordnete Rechnersystem (12), zu einem oder mehreren dekomprimierten, rekonstruierten, erfassten zeitlichen Parameterwerteverläufen, die insbesondere der Steuervorrichtung (4) der Sicherung (1) innerhalb des übergeordneten Rechnersystems (12) zugeordnet sind.

48. Verfahren zum Betreiben eines Versorgungsnetzwerks (200) nach Merkmal 1,

- mit dem zusätzlichen Schritt:
- Vergleichen und/oder Korrelieren (6060) des einen oder der mehreren rekonstruierten, erfassten zeitlichen Parameterwerteverläufe, die insbesondere der Steuervorrichtung (4) der Sicherung (1) innerhalb des übergeordneten Rechnersystems (12) zugeordnet sind, mit einem oder mehreren anderen rekonstruierten, erfassten zeitlichen Parameterwerteverläufen, die insbesondere den Steuervorrichtungen (4) anderer Sicherungen (1) innerhalb des übergeordneten Rechnersystems (12) zugeordnet sind, insbesondere durch das übergeordnete Rechnersystem.

49. Verfahren zum Betreiben eines Versorgungsnetzwerks (200) nach Merkmal 2,

- mit dem zusätzlichen Schritt:
- Detektieren von Ereignissen, die auf gleiche Ursachen insbesondere in zeitlicher Korrelation zurückführbar sind, insbesondere durch das übergeordnete Rechnersystem (12).

50. Verfahren zum Betreiben eines Versorgungsnetzwerks (200) nach Merkmal 3,

- mit dem zusätzlichen Schritt:
- Ergreifen (6070) von Maßnahmen in Abhängigkeit von den detektieren Ereignissen durch das übergeordnete Rechnersystem 12 sofern notwendig.

51. Verfahren zum Betreiben eines Versorgungsnetzwerks (200) nach einem oder mehreren der Merkmale 1 bis 4,

- mit dem zusätzlichen Schritt:

- Schließen (6010) eines Leistungsschalters (17) der Sicherung (1), insbesondere durch eine Steuervorrichtung (4) einer Sicherung (1).

52. Verfahren zum Betreiben eines Versorgungsnetzwerks (200) nach einem oder mehreren der Merkmale 1 bis 5,

- wobei die Erfassung (6200) des zu erfassenden physikalischen Parameters, den die Steuervorrichtung (4) der Sicherung (1) unter Benutzung erster Mittel, die beispielsweise den Analog-zu-Digital-Wandler (570) der Steuervorrichtung (4) und/oder den Shunt-Widerstand (24) und/oder den Hilfsleistungsschalter (23) umfassen können, in einem zweiten Schritt 6020 erfasst.

53. Verfahren zum Betreiben eines Versorgungsnetzwerks (200) nach einem oder mehreren der Merkmale 1 bis 5,

- wobei die Erfassen (6200) des zeitlichen Werteverlaufs eines oder mehrerer zu erfassender physikalischer Parameter als zu erfassende physikalische Parameter eine oder mehrere der Parameter eine oder mehrere elektrische Spannungen zwischen Schaltungsknoten, insbesondere innerhalb und außerhalb der elektronischen Sicherung (1), und/oder ein oder mehrere elektrische Ströme durch Leitungen, insbesondere innerhalb der Sicherung (1) und/oder Temperaturen, insbesondere in und/oder im Umfeld der Sicherung (1), umfasst.

54. Verfahren zum Betreiben eines Versorgungsnetzwerks (200) nach einem oder mehreren der Merkmale 1 bis 6 und Merkmal 6,

- wobei das Erfassen (6200) des zeitlichen Werteverlaufs eines oder mehrerer zu erfassender physikalischer Parameter eine Wandlung (6021) der elektrischen analogen Signale, die die Mittel zur Erfassung der physikalischen Parameter erzeugen, durch Abtastung, insbesondere durch die Steuervorrichtung (4) der elektronischen Sicherung (1), in einem oder mehrere abgetastete zeitliche Parameterwertverläufe umfasst.

55. Verfahren zum Betreiben eines Versorgungsnetzwerks (200) nach Merkmal 8,

- wobei der eine oder die mehreren, abgetasteten zeitlichen Parameterwertverläufe einen zeitdiskreten Strom von Abtastwerten der Parameterwerte des betreffenden physikalischen Parameters und ggf. zugehörige Zeitstempel dieser Abtastwerte umfassen.

56. Verfahren zum Betreiben eines Versorgungsnetzwerks (200) nach Merkmal 9,

- wobei einem Abtastwert ein Abtastzeitpunkt als Zeitstempel dieses Abtastwertes, insbesondere durch die Steuervorrichtung (4) der Sicherung (1), zugeordnet ist und/oder
- wobei jedem Abtastwert ein jeweiliger Abtastzeitpunkt als jeweiliger Zeitstempel dieses jeweiligen Abtastwertes, insbesondere durch die Steuervorrichtung (4) der Sicherung (1), zugeordnet ist und/oder
- wobei Abtastwerten in gleichen Zeitabständen einen Abtastzeitpunkt als Zeitstempel dieser Abtastwerte, insbesondere durch die Steuervorrichtung (4) der Sicherung (1), zugeordnet ist.

57. Verfahren zum Betreiben eines Versorgungsnetzwerks (200) nach Merkmal 10,

- wobei das Erfassen (6200) des zeitlichen Werteverlaufs eines oder mehrerer zu erfassender physikalischer Parameter das Durchführen (6022) einer Wavelet-Transformation und/oder einer Fourier-Transformation oder eine Z-Transformation und/oder einer Laplace-Transformation oder eine andere Transformation und/oder einer anderen Kompressionsmethode umfasst.

58. Verfahren zum Betreiben eines Versorgungsnetzwerks (200) nach Merkmal 10 oder 11,

- wobei das Erfassen (6200) des zeitlichen Werteverlaufs eines oder mehrerer zu erfassender physikalischer Parameter das Wandeln (6022) der abgetasteten zeitlichen Parameterwertverläufe in komprimierte zeitliche Parameterwertverläufe, insbesondere durch die Steuervorrichtung (4) der Sicherung (1) umfasst.

59. Verfahren zum Betreiben eines Versorgungsnetzwerks (200) nach einem oder mehreren der Merkmale 1 bis 12,

- wobei das Analysieren und Komprimieren (6030) des einen oder der mehreren erfassten zeitlichen Parameterwerteverläufe des einen oder der mehreren erfassten physikalischen Parameter das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter umfasst.

60. Verfahren zum Betreiben eines Versorgungsnetzwerks (200) nach Merkmal 13,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden eines Werts einer Vektorkomponente eines Merkmalsvektors durch einen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

61. Verfahren zum Betreiben eines Versorgungsnetzwerks (200) nach Merkmal 13 oder 14,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden jeweils eines Werts einer Vektorkomponente eines Merkmalsvektors durch einen jeweiligen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

62. Verfahren zum Betreiben eines Versorgungsnetzwerks (200) nach einem oder mehreren der Merkmale 1 bis 15,

- wobei das Analysieren und Komprimieren (6030) des einen oder der mehreren erfassten zeitlichen Parameterwerteverläufe des einen oder der mehreren erfassten physikalischen Parameter die Extraktion (6032) eines aktuellen Merkmalsvektors aus den erfassten zeitlichen Parameterwertverläufen und/oder aus den aus diesen abgeleiteten protypischen zeitlichen Verläufen abgeleiteter Parameter, insbesondere durch die Steuervorrichtung (4) der Sicherung (1) umfasst

63. Verfahren zum Betreiben eines Versorgungsnetzwerks (200) nach Merkmal 16,

- wobei das Analysieren und Komprimieren (6030) des einen oder der mehreren erfassten zeitlichen Parameterwerteverläufe des einen oder der mehreren erfassten physikalischen Parameter das Zuordnen (6032) eines jeweiligen Zeitstempels zu bevorzugt jedem Merkmalsvektor dieser Merkmalsvektoren, insbesondere durch die Steuervorrichtung (4) der Sicherung (1), umfasst.

64. Verfahren zum Betreiben eines Versorgungsnetzwerks (200) nach einem oder mehreren der Merkmale 1 bis 17,

- wobei das Analysieren und Komprimieren (6030) des einen oder der mehreren erfassten zeitlichen Parameterwerteverläufe des einen oder der mehreren erfassten physikalischen Parameter das Ermitteln (6033) eines Abstands des extrahierten aktuellen Merkmalsvektors zu einem prototypischen Merkmalsvektor der prototypischen Merkmalsvektoren einer Prototypendatenbank (62115) umfasst.

65. Verfahren zum Betreiben eines Versorgungsnetzwerks (200) nach einem oder mehreren der Merkmale 1 bis 18,

- wobei das Analysieren und Komprimieren (6030) des einen oder der mehreren erfassten zeitlichen Parameterwerteverläufe des einen oder der mehreren erfassten physikalischen Parameter das Erkennen (6034) eines prototypischen Merkmalsvektors einer oder der Prototypendatenbank (62115) als erkannten prototypischen Merkmalsvektor der Prototypendatenbank (62115), wenn der Betrag des ermittelten Abstands für dieses Paar aus diesem aktuellen Merkmalsvektor und diesem prototypischen Merkmalsvektor der Prototypendatenbank (62115) kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank (62115) ist.

66. Verfahren (7600) zum Betreiben eines Versorgungsnetzwerks (200), insbesondere nach einem oder mehreren der vorhergehenden Merkmale,

- mit einer Komprimierung und Verschlüsselung der ersten Sicherungsdaten einer ersten elektronischen Sicherung (1) in der ersten elektronischen Sicherung (1) und
- mit einer Übertragung der komprimierten und verschlüsselten ersten Sicherungsdaten an ein übergeordnetes Rechnersystem (12) und
- mit einer Entschlüsselung und einer Dekomprimierung der komprimierten und verschlüsselten ersten Sicherungsdaten zu empfangenen ersten Sicherungsdaten der ersten Sicherung (1) im übergeordneten Rechnersystem (12).

67. Verfahren nach Merkmal 1,

- mit einer Ergreifung von Maßnahmen in Abhängigkeit von den empfangenen ersten Sicherungsdaten der ersten Sicherung (1) im übergeordneten Rechnersystem (12) durch das übergeordnete Rechnersystem (12).

68. Verfahren (7600) zum Betreiben eines Versorgungsnetzwerks (200), insbesondere nach einem oder mehreren der vorhergehenden Merkmale,

- mit einer Komprimierung und Verschlüsselung von ersten Sicherungsdaten einer ersten elektronischen Sicherung (825) in der ersten elektronischen Sicherung (825) und
- mit einer Komprimierung und Verschlüsselung von zweiten Sicherungsdaten einer zweiten elektronischen Sicherung (805) in der zweiten elektronischen Sicherung (805) und
- mit einer Übertragung der komprimierten und verschlüsselten ersten Sicherungsdaten der ersten Sicherung (825) an ein übergeordnetes Rechnersystem (12) und
- mit einer Übertragung der komprimierten und verschlüsselten zweiten Sicherungsdaten der zweiten Sicherung (805) an das übergeordnete Rechnersystem (12) und
- mit einer Entschlüsselung und einer Dekomprimierung der komprimierten und verschlüsselten ersten Sicherungsdaten der ersten Sicherung zu empfangenen ersten Sicherungsdaten der ersten Sicherung (825) im übergeordneten Rechnersystem (12) und

- mit einer Entschlüsselung und einer Dekomprimierung der komprimierten und verschlüsselten zweiten Sicherungsdaten der zweiten Sicherung (805) zu empfangenen zweiten Sicherungsdaten der zweiten Sicherung (805) im übergeordneten Rechnersystem (12) und
- mit einer Ergreifung von Maßnahmen in Abhängigkeit von den empfangenen ersten Sicherungsdaten der ersten Sicherung (825) und in Abhängigkeit von den empfangenen zweiten Sicherungsdaten der zweiten Sicherung (805) im übergeordneten Rechnersystem (12) durch das übergeordnete Rechnersystem (12).

<u>Versorgungsnetzwerkbetrieb</u>

1. Verfahren (7600) zum Betreiben eines Versorgungsnetzwerks (200),

- wobei das Versorgungsnetzwerk (200) eine elektronische Sicherung (1) mit einer Steuervorrichtung (4) und einem Leistungsschalter (17) umfasst und
- wobei das Versorgungsnetzwerk (200) ein übergeordnetes Rechnersystem (12) umfasst und
- mit den Schritten:
- Erfassen (6200) des zeitlichen Werteverlaufs eines oder mehrerer zu erfassendem physikalischem Parameter, insbesondere durch die die Steuervorrichtung (4) der Sicherung (1), in Form eines oder mehrerer erfasster zeitlicher Parameterwerteverläufe;
- Analysieren und Komprimieren (6030) des einen oder der mehreren erfassten zeitlichen Parameterwerteverläufe des einen oder der mehreren erfassten physikalischen Parameter, insbesondere durch die Steuervorrichtung (4) der elektronischen Sicherung (1);
- Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter;
- Übertragen (6040) des einen oder der mehreren verschlüsselten, komprimierten, erfassten zeitlichen Parameterwerteverläufe des einen oder der mehreren zu meldenden physikalischen Parameter durch die Steuervorrichtung (4) der elektronischen Sicherung (1) an das übergeordnete Rechnersystem (12);
- Entschlüsseln (7620) des einen oder der mehreren verschlüsselten, komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, entschlüsselten, komprimierten, erfassten zeitlichen Parameterwerteverläufe des einen oder der mehreren zu meldenden physikalischen Parameter;
- Dekomprimieren (6050) des einen oder der mehreren entschlüsselten, empfangenen, komprimierten, erfassten zeitlichen Parameterwerteverläufe, insbesondere durch das übergeordnete Rechnersystem (12), zu einem oder mehreren dekomprimierten, rekonstruierten, erfassten zeitlichen Parameterwerteverläufen, die insbesondere der Steuervorrichtung (4) der Sicherung (1) innerhalb des übergeordneten Rechnersystems (12) zugeordnet sind.

2. Verfahren zum Betreiben eines Versorgungsnetzwerks (200) nach Merkmal 1,

- mit dem zusätzlichen Schritt:
- Vergleichen und/oder Korrelieren (6060) des einen oder der mehreren rekonstruierten, erfassten zeitlichen Parameterwerteverläufe, die insbesondere der Steuervorrichtung (4) der Sicherung (1) innerhalb des übergeordneten Rechnersystems (12) zugeordnet sind, mit einem oder mehreren anderen rekonstruierten, erfassten zeitlichen Parameterwerteverläufen, die insbesondere den Steuervorrichtungen (4) anderer Sicherungen (1) innerhalb des übergeordneten Rechnersystems (12) zugeordnet sind, insbesondere durch das übergeordnete Rechnersystem.

3. Verfahren zum Betreiben eines Versorgungsnetzwerks (200) nach Merkmal 2,

- mit dem zusätzlichen Schritt:

- Detektieren von Ereignissen, die auf gleiche Ursachen insbesondere in zeitlicher Korrelation zurückführbar sind insbesondere durch das übergeordnete Rechnersystem (12).

4. Verfahren zum Betreiben eines Versorgungsnetzwerks (200) nach Merkmal 3,

- mit den zusätzlichen Schritten:
- Bewerten (6070) der detektieren Ereignissen durch das übergeordnete Rechnersystem 12 und
- Ergreifen (6070) von Maßnahmen in Abhängigkeit von den detektieren Ereignissen durch das übergeordnete Rechnersystem 12 sofern notwendig.

5. Verfahren zum Betreiben eines Versorgungsnetzwerks (200) nach einem oder mehreren der Merkmale 1 bis 4,

- mit dem zusätzlichen Schritt:

- Schließen (6010) eines Leistungsschalters (17) der Sicherung (1), insbesondere durch eine Steuervorrichtung (4) einer Sicherung (1).

6. Verfahren zum Betreiben eines Versorgungsnetzwerks (200) nach einem oder mehreren der Merkmale 1 bis 5,

- wobei die Erfassung (6200) des zu erfassenden physikalischen Parameters, den die Steuervorrichtung (4) der Sicherung (1) unter Benutzung erster Mittel, die beispielsweise den Analog-zu-Digital-Wandler (570) der Steuervorrichtung (4) und/oder den Shunt-Widerstand (24) und/oder den Hilfsleistungsschalter (23) umfassen können, in einem zweiten Schritt 6020 erfasst.

7. Verfahren zum Betreiben eines Versorgungsnetzwerks (200) nach einem oder mehreren der Merkmale 1 bis 5,

- wobei die Erfassen (6200) des zeitlichen Werteverlaufs eines oder mehrerer zu erfassender physikalischer Parameter als zu erfassende physikalische Parameter eine oder mehrere der Parameter eine oder mehrere elektrische Spannungen zwischen Schaltungsknoten, insbesondere innerhalb und außerhalb der elektronischen Sicherung (1), und/oder ein oder mehrere elektrische Ströme durch Leitungen, insbesondere innerhalb der Sicherung (1) und/oder Temperaturen, insbesondere in und/oder im Umfeld der Sicherung (1), umfasst.

8. Verfahren zum Betreiben eines Versorgungsnetzwerks (200) nach einem oder mehreren der Merkmale 1 bis 6 und Merkmal 6,

- wobei das Erfassen (6200) des zeitlichen Werteverlaufs eines oder mehrerer zu erfassender physikalischer Parameter eine Wandlung (6021) der elektrischen analogen Signale, die die Mittel zur Erfassung der physikalischen Parameter erzeugen, durch Abtastung, insbesondere durch die Steuervorrichtung (4) der elektronischen Sicherung (1), in einem oder mehrere abgetastete zeitliche Parameterwertverläufe umfasst.

9. Verfahren zum Betreiben eines Versorgungsnetzwerks (200) nach Merkmal 8,

- wobei der eine oder die mehreren, abgetasteten zeitlichen Parameterwertverläufe einen zeitdiskreten Strom von Abtastwerten der Parameterwerte des betreffenden physikalischen Parameters und ggf. zugehörige Zeitstempel dieser Abtastwerte umfassen.

10. Verfahren zum Betreiben eines Versorgungsnetzwerks (200) nach Merkmal 9,

- wobei einem Abtastwert ein Abtastzeitpunkt als Zeitstempel dieses Abtastwertes, insbesondere durch die Steuervorrichtung (4) der Sicherung (1), zugeordnet ist und/oder
- wobei jedem Abtastwert ein jeweiliger Abtastzeitpunkt als jeweiliger Zeitstempel dieses jeweiligen Abtastwertes, insbesondere durch die Steuervorrichtung (4) der Sicherung (1), zugeordnet ist und/oder
- wobei Abtastwerten in gleichen Zeitabständen einen Abtastzeitpunkt als Zeitstempel dieser Abtastwerte, insbesondere durch die Steuervorrichtung (4) der Sicherung (1), zugeordnet ist.

11. Verfahren zum Betreiben eines Versorgungsnetzwerks (200) nach Merkmal 10,

- wobei das Erfassen (6200) des zeitlichen Werteverlaufs eines oder mehrerer zu erfassender physikalischer Parameter das Durchführen (6022) einer WaveletTransformation und/oder einer Fourier-Transformation oder einer Z-Transformation und/oder einer Laplace-Transformation oder einer anderen Transformation und/oder einer anderen Kompressionsmethode umfasst.

12. Verfahren zum Betreiben eines Versorgungsnetzwerks (200) nach Merkmal 10 oder 11,

- wobei das Erfassen (6200) des zeitlichen Werteverlaufs eines oder mehrerer zu erfassender physikalischer Parameter das Wandeln (6022) der abgetasteten zeitlichen Parameterwertverläufe in komprimierte zeitliche Parameterwertverläufe, insbesondere durch die Steuervorrichtung (4) der Sicherung (1) umfasst.

13. Verfahren zum Betreiben eines Versorgungsnetzwerks (200) nach einem oder mehreren der Merkmale 1 bis 12,

- wobei das Analysieren und Komprimieren (6030) des einen oder der mehreren erfassten zeitlichen Parameterwerteverläufe des einen oder der mehreren erfassten physikalischen Parameter das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter umfasst.

14. Verfahren zum Betreiben eines Versorgungsnetzwerks (200) nach Merkmal 13,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden eines Werts einer Vektorkomponente eines Merkmalsvektors durch einen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

15. Verfahren zum Betreiben eines Versorgungsnetzwerks (200) nach Merkmal 13 oder 14,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden jeweils eines Werts einer Vektorkomponente eines Merkmalsvektors durch einen jeweiligen Optimalfilter aus dem zeitlichen Parameterwertverlauf der, insbesondere durch die Steuervorrichtung (4) der elektronischen Sicherung (1), erfassten Parameter und/oder des zeitlichen Verlaufs daraus abgeleiteter Parameter umfasst.

16. Verfahren zum Betreiben eines Versorgungsnetzwerks (200) nach einem oder mehreren der Merkmale 1 bis 15,

- wobei das Analysieren und Komprimieren (6030) des einen oder der mehreren erfassten zeitlichen Parameterwerteverläufe des einen oder der mehreren erfassten physikalischen Parameter die Extraktion (6032) eines aktuellen Merkmalsvektors aus den erfassten zeitlichen Parameterwertverläufen und/oder aus den aus diesen abgeleiteten protypischen zeitlichen Verläufen abgeleiteter Parameter, insbesondere durch die Steuervorrichtung (4) der elektronischen Sicherung (1) umfasst

17. Verfahren zum Betreiben eines Versorgungsnetzwerks (200) nach Merkmal 16,

- wobei das Analysieren und Komprimieren (6030) des einen oder der mehreren erfassten zeitlichen Parameterwerteverläufe des einen oder der mehreren erfassten physikalischen Parameter das Zuordnen (6032) eines jeweiligen Zeitstempels zu bevorzugt jedem Merkmalsvektor dieser Merkmalsvektoren, insbesondere durch die Steuervorrichtung (4) der elektronischen Sicherung (1), umfasst.

18. Verfahren zum Betreiben eines Versorgungsnetzwerks (200) nach einem oder mehreren der Merkmale 1 bis 17,

- wobei das Analysieren und Komprimieren (6030) des einen oder der mehreren erfassten zeitlichen Parameterwerteverläufe des einen oder der mehreren erfassten physikalischen Parameter das Ermitteln (6033) eines Abstands des extrahierten aktuellen Merkmalsvektors zu einem prototypischen Merkmalsvektor der prototypischen Merkmalsvektoren einer Prototypendatenbank (62115) umfasst.

19. Verfahren zum Betreiben eines Versorgungsnetzwerks (200) nach einem oder mehreren der Merkmale 1 bis 18,

- wobei das Analysieren und Komprimieren (6030) des einen oder der mehreren erfassten zeitlichen Parameterwerteverläufe des einen oder der mehreren erfassten physikalischen Parameter das Erkennen (6034) eines prototypischen Merkmalsvektors einer oder der Prototypendatenbank (62115) als erkannten prototypischen Merkmalsvektor der Prototypendatenbank (62115), wenn der Betrag des ermittelten Abstands für dieses Paar aus diesem aktuellen Merkmalsvektor und diesem prototypischen Merkmalsvektor der Prototypendatenbank (62115) kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank (62115) ist.

20. Verfahren zum Betreiben eines Versorgungsnetzwerks (200) nach einem oder mehreren der Merkmale 1 bis 19,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter unter Zuhilfenahme einer Zufallszahl oder Pseudozufallszahl, insbesondere durch die Steuervorrichtung (4) der elektronischen Sicherung (1), erfolgt.

21. Verfahren zum Betreiben eines Versorgungsnetzwerks (200) nach Merkmal 20,

- wobei die Zufallszahl eine echte Zufallszahl ist.

22. Verfahren zum Betreiben eines Versorgungsnetzwerks (200) nach Merkmal 21,

- wobei die Zufallszahl eine Quantenzufallszahl eines Quantenzufallszahlengenerators (60) ist.

23. Verfahren zum Betreiben eines Versorgungsnetzwerks (200) nach einem oder mehreren der Merkmale 1 bis 22,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter mittels eines PQC-Verschlüsselungsverfahrens, insbesondere durch die Steuervorrichtung (4) der elektronischen Sicherung (1), erfolgt.

Elektronische Sicherung mit verschlüsselter und komprimierter Datenkommunikation und deren Anwendung und Weiterbildungen

1. Verfahren (7600) zum Betreiben eines Versorgungsnetzwerks (200), insbesondere nach einem oder mehreren der vorhergehenden Merkmale, insbesondere nach einem oder mehreren der vorhergehenden Merkmale,

- wobei das Versorgungsnetzwerk (200) eine elektronische Sicherung (1) mit einer Steuervorrichtung (4) und einem Leistungsschalter (17) umfasst und
- wobei das Versorgungsnetzwerk (200) einen weiteren Sensor (77010) umfasst und
- wobei das Versorgungsnetzwerk (200) ein übergeordnetes Rechnersystem (12) umfasst und
- mit den Schritten:
- Erfassen (6200) der zeitlichen Werteverläufe eines oder mehrerer zu erfassendem physikalischem Parameter, insbesondere durch die die Steuervorrichtung (4) der Sicherung (1) und durch einen oder mehrere weitere Sensoren (77010), in Form eines oder mehrerer erfasster zeitlicher Parameterwerteverläufe;
- Analysieren und Komprimieren (6030) des einen oder der mehreren erfassten zeitlichen Parameterwerteverläufe des einen oder der mehreren erfassten physikalischen Parameter, insbesondere durch die Steuervorrichtung (4) der elektronischen Sicherung (1) und/oder eine Steuervorrichtung des weiteren Sensors (77010);
- Ggf. Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1) und/oder die Steuervorrichtung des weiteren Sensors (77010), zu einem oder mehreren, verschlüsselten, komprimierten, erfassten zeitlichen Parameterwerteverläufen der mehreren zu meldenden physikalischen Parameter;
- Übertragen (6040) der mehreren verschlüsselten, komprimierten, erfassten zeitlichen Parameterwerteverläufe des einen oder der mehreren zu meldenden physikalischen Parameter durch die Steuervorrichtung (4) der elektronischen Sicherung (1) und/oder die Steuervorrichtung des weiteren Sensors (77010) an das übergeordnete Rechnersystem (12);
- Ggf. Entschlüsseln (7620) der mehreren verschlüsselten, komprimierten, erfassten zeitlichen Parameterwerteverläufe des einen oder der mehreren zu meldenden physikalischen Parameter, insbesondere durch das übergeordnete Rechnersystem (12), zu einem oder mehreren, entschlüsselten, komprimierten, erfassten zeitlichen Parameterwerteverläufe des einen oder der mehreren zu meldenden physikalischen Parameter, wenn zuvor eine Verschlüsselung (7610) erfolgt ist;
- Dekomprimieren (6050) der mehreren entschlüsselten, empfangenen, komprimierten, erfassten zeitlichen Parameterwerteverläufe, insbesondere durch das übergeordnete Rechnersystem (12), zu mehreren dekomprimierten, rekonstruierten, erfassten zeitlichen Parameterwerteverläufen in Form rekonstruierter Parametersignale (70610, 70610', 77610), die insbesondere der Steuervorrichtung (4) der Sicherung (1) innerhalb des übergeordneten Rechnersystems 12 und/oder der Steuervorrichtung des weiteren Sensors (77010) zugeordnet sind.

2. Verfahren zum Betreiben eines Versorgungsnetzwerks (200) nach Merkmal 1,
Fusionieren der rekonstruierten Parametersignale (70610, 70610', 77610) zum fusionierten Parametersignal (75103), insbesondere durch einen Kombinierer (75101) und/oder insbesondere durch das übergeordnete Rechnersystem (12).
3. Verfahren zum Betreiben eines Versorgungsnetzwerks (200) nach Merkmal 2,

wobei Fusionieren der rekonstruierten Parametersignale (70610, 70610', 77610) zum fusionierten Parametersignal (75103), insbesondere durch das übergeordnete Rechnersystem (12),
das Interpolieren der rekonstruierten Parameterwertverläufe (70610, 70610', 77610) bei fehlenden Abtastwerten und/oder ungleichen Abtastzeitpunkten zu interpolierten, rekonstruierten Parameterwertverläufen mit vollständigen rekonstruierten Abtastwerten zu gleichen Abtastzeitpunkten, insbesondere durch das übergeordnete Rechnersystem (12), umfasst.

4. Verfahren zum Betreiben eines Versorgungsnetzwerks (200) nach Merkmal 3,
wobei zeitlich zu jedem Abtastwert der interpolierten, rekonstruierten Parameterwertverläufe zumindest ein Abtastwert der rekonstruierten Parameterwertverläufe jener Parameter, die die weiteren Sensoren und Sensorsysteme erfassen, korrespondiert.
5. Verfahren zum Betreiben eines Versorgungsnetzwerks (200) nach Merkmal 3 oder 4, mit dem Schritt
Korrelieren der interpolierten, rekonstruierten Parameterwertverläufe und/oder der rekonstruierten Parameterwertverläufe untereinander, insbesondere durch das übergeordnete Rechnersystem (12).
6. Verfahren zum Betreiben eines Versorgungsnetzwerks (200) nach Merkmal 5, mit dem Schritt
Erfassen von auffälligen, typischerweise mehr oder weniger synchronen Ereignissen in verschiedenen rekonstruierten Parameterwertverläufen auf Basis von Korrelationen der interpolierten, rekonstruierten Parameterwertverläufe und/oder der rekonstruierten Parameterwertverläufe untereinander, insbesondere durch das übergeordnete Rechnersystem (12).
7. Verfahren zum Betreiben eines Versorgungsnetzwerks (200) nach Merkmal 6, mit dem Schritt
Schließen auf mechanische Defekte von mechanischen Vorrichtungen, insbesondere durch das übergeordnete Rechnersystem (12).
8. Verfahren zum Betreiben eines Versorgungsnetzwerks (200) nach einem der Merkmale 1 bis 7,

- mit dem zusätzlichen Schritt:
- Vergleichen und/oder Korrelieren (6060) des einen oder der mehreren rekonstruierten, erfassten zeitlichen Parameterwerteverläufe, die insbesondere der Steuervorrichtung (4) der Sicherung (1) und/oder einem weiteren Sensor (77010) innerhalb des übergeordneten Rechnersystems (12) zugeordnet sind, mit einem oder mehreren anderen rekonstruierten, erfassten zeitlichen Parameterwerteverläufen, die insbesondere den Steuervorrichtungen (4) anderer Sicherungen (1) und/oder anderen Sensoren innerhalb des übergeordneten Rechnersystems (12) zugeordnet sind, insbesondere durch das übergeordnete Rechnersystem (12).

9. Verfahren zum Betreiben eines Versorgungsnetzwerks (200) nach Merkmal 8,

- mit dem zusätzlichen Schritt:

- Detektieren von Ereignissen, die auf gleiche Ursachen insbesondere in zeitlicher Korrelation zurückführbar sind, insbesondere durch das übergeordnete Rechnersystem (12).

10. Verfahren zum Betreiben eines Versorgungsnetzwerks (200) nach Merkmal 9,

- mit dem zusätzlichen Schritt:

- Ergreifen (6070) von Maßnahmen in Abhängigkeit von den detektieren Ereignissen durch das übergeordnete Rechnersystem 12 sofern notwendig.

11. Verfahren zum Betreiben eines Versorgungsnetzwerks (200) nach einem oder mehreren der Merkmale 1 bis 10,

- mit dem zusätzlichen Schritt:

- Schließen (6010) eines Leistungsschalters (17) der Sicherung (1), insbesondere durch eine Steuervorrichtung (4) einer Sicherung (1).

12. Verfahren zum Betreiben eines Versorgungsnetzwerks (200) nach einem oder mehreren der Merkmale 1 bis 11,

- wobei die Erfassung (6200) des zu erfassenden physikalischen Parameters, den die Steuervorrichtung (4) der Sicherung (1) unter Benutzung erster Mittel, die beispielsweise den Analog-zu-Digital-Wandler (570) der Steuervorrichtung (4) und/oder den Shunt-Widerstand (24) und/oder den Hilfsleistungsschalter (23) umfassen können, in einem zweiten Schritt (6020) erfasst.

13. Verfahren zum Betreiben eines Versorgungsnetzwerks (200) nach einem oder mehreren der Merkmale 1 bis 12,

- wobei die Erfassen (6200) des zeitlichen Werteverlaufs eines oder mehrerer zu erfassender physikalischer Parameter als zu erfassende physikalische Parameter eine oder mehrere der Parameter eine oder mehrere elektrische Spannungen zwischen Schaltungsknoten, insbesondere innerhalb und außerhalb der elektronischen Sicherung (1), und/oder ein oder mehrere elektrische Ströme durch Leitungen, insbesondere innerhalb der Sicherung (1) und/oder Temperaturen, insbesondere in und/oder im Umfeld der Sicherung (1), umfasst.

14. Verfahren zum Betreiben eines Versorgungsnetzwerks (200) nach einem oder mehreren der Merkmale 1 bis 13 und Merkmal 12,

- wobei das Erfassen (6200) des zeitlichen Werteverlaufs eines oder mehrerer zu erfassender physikalischer Parameter eine Wandlung (6021) der elektrischen analogen Signale, die die Mittel zur Erfassung der physikalischen Parameter erzeugen, durch Abtastung, insbesondere durch die Steuervorrichtung (4) der elektronischen Sicherung (1) bzw. die Steuervorrichtung des weiteren Sensors (77010), in einem oder mehrere abgetastete zeitliche Parameterwertverläufe umfasst.

15. Verfahren zum Betreiben eines Versorgungsnetzwerks (200) nach Merkmal 14,

- wobei der eine oder die mehreren, abgetasteten zeitlichen Parameterwertverläufe einen zeitdiskreten Strom von Abtastwerten der Parameterwerte des betreffenden physikalischen Parameters und ggf. zugehörige Zeitstempel dieser Abtastwerte umfassen.

16. Verfahren zum Betreiben eines Versorgungsnetzwerks (200) nach Merkmal 15,

- wobei einem Abtastwert ein Abtastzeitpunkt als Zeitstempel dieses Abtastwertes, insbesondere durch die Steuervorrichtung (4) der Sicherung (1) bzw. die Steuervorrichtung des weiteren Sensors (77010), zugeordnet ist und/oder
- wobei jedem Abtastwert ein jeweiliger Abtastzeitpunkt als jeweiliger Zeitstempel dieses jeweiligen Abtastwertes, insbesondere durch die Steuervorrichtung (4) der Sicherung (1) bzw. die Steuervorrichtung des weiteren Sensors (77010), zugeordnet ist und/oder
- wobei Abtastwerten in gleichen Zeitabständen einen Abtastzeitpunkt als Zeitstempel dieser Abtastwerte, insbesondere durch die Steuervorrichtung (4) der Sicherung (1) bzw. die Steuervorrichtung des weiteren Sensors (77010), zugeordnet ist.

17. Verfahren zum Betreiben eines Versorgungsnetzwerks (200) nach Merkmal 16,

- wobei das Erfassen (6200) des zeitlichen Werteverlaufs eines oder mehrerer zu erfassender physikalischer Parameter das Durchführen (6022) einer Wavelet-Transformation und/oder einer Fourier-Transformation oder einer Z-Transformation und/oder einer Laplace-Transformation oder einer anderen Transformation und/oder einer anderen Kompressionsmethode, insbesondere durch die Steuervorrichtung (4) der Sicherung (1) bzw. die Steuervorrichtung des weiteren Sensors (77010), umfasst.

18. Verfahren zum Betreiben eines Versorgungsnetzwerks (200) nach Merkmal 16 oder 17,

- wobei das Erfassen (6200) des zeitlichen Werteverlaufs eines oder mehrerer zu erfassender physikalischer Parameter das Wandeln (6022) der abgetasteten zeitlichen Parameterwertverläufe in komprimierte zeitliche Parameterwertverläufe, insbesondere durch die Steuervorrichtung (4) der Sicherung (1) bzw. die Steuervorrichtung des weiteren Sensors (77010), umfasst.

19. Verfahren zum Betreiben eines Versorgungsnetzwerks (200) nach einem oder mehreren der Merkmale 1 bis 18,

- wobei das Analysieren und Komprimieren (6030) des einen oder der mehreren erfassten zeitlichen Parameterwerteverläufe des einen oder der mehreren erfassten physikalischen Parameter das Analysieren (6031) des zeitlichen Parameterwertverlaufs der, insbesondere durch die Steuervorrichtung (4) der Sicherung (1) bzw. die Steuervorrichtung des weiteren Sensors (77010), erfassten Parameter und/oder des zeitlichen Verlaufs daraus abgeleiteter Parameter umfasst.

20. Verfahren zum Betreiben eines Versorgungsnetzwerks (200) nach Merkmal 19,

- wobei das Analysieren (6031) des zeitlichen Parameterwertverlaufs der, insbesondere durch die Steuervorrichtung (4) der Sicherung (1) bzw. die Steuervorrichtung des weiteren Sensors (77010), erfassten Parameter und/oder des zeitlichen Verlaufs daraus abgeleiteter Parameter das Bilden eines Werts einer Vektorkomponente eines Anspruchsvektors durch einen Optimalfilter aus dem zeitlichen Parameterwertverlauf der, insbesondere durch die Steuervorrichtung (4) der Sicherung (1) bzw. die Steuervorrichtung des weiteren Sensors (77010), erfassten Parameter und/oder des zeitlichen Verlaufs daraus abgeleiteter Parameter umfasst.

21. Verfahren zum Betreiben eines Versorgungsnetzwerks (200) nach Merkmal 19 oder 20,

- wobei das Analysieren (6031) des zeitlichen Parameterwertverlaufs der, insbesondere durch die Steuervorrichtung (4) der elektronischen Sicherung (1), erfassten Parameter und/oder des zeitlichen Verlaufs daraus abgeleiteter Parameter das Bilden jeweils eines Werts einer Vektorkomponente eines Anspruchsvektors durch einen jeweiligen Optimalfilter aus dem zeitlichen Parameterwertverlauf der, insbesondere durch die Steuervorrichtung (4) der Sicherung (1) bzw. die Steuervorrichtung des weiteren Sensors (77010), erfassten Parameter und/oder des zeitlichen Verlaufs daraus abgeleiteter Parameter umfasst.

22. Verfahren zum Betreiben eines Versorgungsnetzwerks (200) nach einem oder mehreren der Merkmale 1 bis 21,

- wobei das Analysieren und Komprimieren (6030) des einen oder der mehreren erfassten zeitlichen Parameterwerteverläufe des einen oder der mehreren erfassten physikalischen Parameter die Extraktion (6032) eines aktuellen Anspruchsvektors aus den erfassten zeitlichen Parameterwertverläufen und/oder aus den aus diesen abgeleiteten protypischen zeitlichen Verläufen abgeleiteter Parameter, insbesondere durch die Steuervorrichtung (4) der Sicherung (1) bzw. die Steuervorrichtung des weiteren Sensors (77010), umfasst

23. Verfahren zum Betreiben eines Versorgungsnetzwerks (200) nach Merkmal 22,

- wobei das Analysieren und Komprimieren (6030) des einen oder der mehreren erfassten zeitlichen Parameterwerteverläufe des einen oder der mehreren erfassten physikalischen Parameter das Zuordnen (6032) eines jeweiligen Zeitstempels zu bevorzugt jedem Anspruchsvektor dieser Anspruchsvektoren, insbesondere durch die Steuervorrichtung (4) der Sicherung (1) bzw. die Steuervorrichtung des weiteren Sensors (77010), umfasst.

24. Verfahren zum Betreiben eines Versorgungsnetzwerks (200) nach einem oder mehreren der Merkmale 1 bis 23,

- wobei das Analysieren und Komprimieren (6030) des einen oder der mehreren erfassten zeitlichen Parameterwerteverläufe des einen oder der mehreren erfassten physikalischen Parameter das Ermitteln (6033) eines Abstands des extrahierten aktuellen Anspruchsvektors zu einem prototypischen Anspruchsvektor der prototypischen Anspruchsvektoren einer Prototypendatenbank (62115) umfasst.

25. Verfahren zum Betreiben eines Versorgungsnetzwerks (200) nach einem oder mehreren der Merkmale 1 bis 24,

- wobei das Analysieren und Komprimieren (6030) des einen oder der mehreren erfassten zeitlichen Parameterwerteverläufe des einen oder der mehreren erfassten physikalischen Parameter das Erkennen (6034) eines prototypischen Anspruchsvektors einer oder der Prototypendatenbank (62115) als erkannten prototypischen Anspruchsvektor der Prototypendatenbank (62115), wenn der Betrag des ermittelten Abstands für dieses Paar aus diesem aktuellen Anspruchsvektor und diesem prototypischen Anspruchsvektor der Prototypendatenbank (62115) kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Anspruchsvektor einerseits und jedem anderen prototypischen Anspruchsvektor der Prototypendatenbank (62115) ist.

26. Verfahren zum Betreiben eines Versorgungsnetzwerks (200) nach einem oder mehreren der Merkmale 1 bis 25,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter unter Zuhilfenahme einer Zufallszahl oder Pseudozufallszahl, insbesondere durch die Steuervorrichtung (4) der Sicherung (1) bzw. die Steuervorrichtung des weiteren Sensors (77010), erfolgt.

27. Verfahren zum Betreiben eines Versorgungsnetzwerks (200) nach Merkmal 26,

- wobei die Zufallszahl eine echte Zufallszahl ist.

28. Verfahren zum Betreiben eines Versorgungsnetzwerks (200) nach Merkmal 27,

- wobei die Zufallszahl eine Quantenzufallszahl eines Quantenzufallszahlengenerators (60) ist.

29. Verfahren zum Betreiben eines Versorgungsnetzwerks (200) nach einem oder mehreren der Merkmale 1 bis 28,

- wobei das Verschlüsseln (7610) des einen oder der mehreren komprimierten, erfassten zeitlichen Parameterwerteverläufe des einen oder der mehreren zu meldenden physikalischen Parameter, insbesondere durch die Steuervorrichtung (4) der Sicherung (1) bzw. die Steuervorrichtung des weiteren Sensors (77010), zu einem oder mehreren, verschlüsselten, komprimierten, erfassten zeitlichen Parameterwerteverläufe des einen oder der mehreren zu meldenden physikalischen Parameter mittels eines PQC-Verschlüsselungsverfahrens, insbesondere durch die Steuervorrichtung (4) der Sicherung (1) bzw. die Steuervorrichtung des weiteren Sensors (77010), erfolgt.

Nachfolgend werden weitere Ausführungsbeispiele der Erfindung beschrieben.

1. Elektrische Sicherungsvorrichtung für ein Fahrzeug, mit

- mindestens einem Eingangsanschluss und mehreren Ausgangsanschlüssen oder mit mehreren Eingangsanschlüssen und mindestens einem Ausgangsanschluss, wobei zwischen zumindest einigen und vorzugsweise sämtlichen Eingangsanschlüssen und Ausgangsanschlüssen elektrische Verbindungen existieren,
- mehreren elektronischen Sicherungen (1) mit jeweils mindestens einem elektronischen Leistungsschalter (17), der einen steuerbaren Leitungspfad aufweist,
- wobei jede elektronische Sicherung (1) eine einen Rechnerkern, wie z. B. eine CPU aufweisende Steuervorrichtung (4) zur Ansteuerung des mindestens einen Leistungsschalters (17) zwecks Ein- und Ausschaltens desselben und eine Datenschnittstelle (550) zur Kommunikationsverbindung mit einem Datenkommunikationsbus (9) eines übergeordneten Steuerungs- bzw. Rechnersystems (12) aufweist,
- wobei jede elektronische Sicherung (1) ferner eine Messvorrichtung (24) zur Erfassung eines Betriebsparameters des Leistungsschalters (17) und/oder einer elektrischen Verbindung, in der der Leistungsschalter (17) angeordnet ist, aufweist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,

- wobei die Steuervorrichtung (4) jeder elektronischen Sicherung (1) in Abhängigkeit von der Größe und/oder in Abhängigkeit von dem Grad der Veränderung des Betriebsparameters über der Zeit und/oder in Abhängigkeit von dem Grad einer höheren mathematischen zeitlichen Ableitung des Betriebsparameters als der ersten Ableitung den mindestens einen Leistungsschalter (17) aus dem Einschalt-Zustand in den Ausschalt-Zustand überführt,

- wobei die Steuervorrichtung (4) jeder elektronischen Sicherung (1) über ihre Datenschnittstelle (550) den Schaltzustand des mindestens einen Leistungsschalters (17) und/oder die aktuelle Größe des Betriebsparameters oder einen diese Größe repräsentierenden Wert an das übergeordnete Steuerungs- bzw. Rechnersystem (12) meldet,

- wobei die Leitungspfade der Leistungsschalter (17) der elektronischen Sicherungen (1) für die jeweiligen elektrischen Verbindungen zwischen den Eingangsanschlüssen und den Ausgangsanschlüssen und direkt oder indirekt zwischen einen Eingangsanschluss und jeweils einen anderen Ausgangsanschluss oder direkt oder indirekt zwischen einen Ausgangsanschluss und jeweils einen anderen Eingangsanschluss geschaltet sind und

- wobei die Datenschnittstellen (550) der Steuervorrichtungen (4) der elektronischen Sicherungen (1) Ansteuerdaten zum Ein- und Ausschalten der Leistungsschalter (17) empfangen und auf diese Weise die elektrischen Verbindungen zwischen jedem Eingangsanschluss und jedem Ausgangsanschluss und/oder die Unterbrechungen der elektrischen Verbindungen zwischen jedem Eingangsanschluss und jedem Ausgangsanschluss konfigurierbar sind.

2. Elektrische Sicherungsvorrichtung für ein Fahrzeug, mit

- mindestens einem Eingangsanschluss und mehreren Ausgangsanschlüssen oder mit mehreren Eingangsanschlüssen und mindestens einem Ausgangsanschluss, wobei zwischen zumindest einigen und vorzugsweise sämtlichen Eingangsanschlüssen und Ausgangsanschlüssen elektrische Verbindungen existieren,

- mehreren elektronischen Sicherungen (1) mit jeweils mindestens einem elektronischen Leistungsschalter (17), der einen steuerbaren Leitungspfad aufweist,

- mindestens einer einen Rechnerkern, wie z.B. eine CPU aufweisenden Steuervorrichtung (4) zur Ansteuerung der mindestens einen Leistungsschalter (17) der elektronischen Sicherungen (1) oder mehreren jeweils einen Rechnerkern, wie z.B. eine CPU aufweisenden Steuervorrichtungen (4) zur Ansteuerung jeweils mindestens eines Leistungsschalters (17) einer oder mehrerer elektronischer Sicherungen (1) zwecks Ein- und Ausschaltens des jeweiligen Leistungsschalters (17),

- wobei die mindestens eine Steuervorrichtung (4) eine Datenschnittstelle (550) oder jede Steuervorrichtung (4) eine Datenschnittstelle (550) zur Kommunikationsverbindung mit einem Datenkommunikationsbus (9) eines übergeordneten Steuerungs- bzw. Rechnersystems (12) aufweist,

- mindestens einer Messvorrichtung (24) zur Erfassung mindestens eines Betriebsparameters der Leistungsschalter (17) und/oder der elektrischen Verbindungen, in denen die Leistungsschalter (17) jeweils angeordnet sind, oder mehreren Messvorrichtung (24) zur Erfassung mindestens eines Betriebsparameters eines oder mehrerer Leistungsschalter (17) und/oder der elektrischen Verbindungen, in denen die Leistungsschalter (17) jeweils angeordnet sind, wobei der Betriebsparameter die Größe eines Stroms und/oder einer Spannung und/oder einer elektrischen Leistung und/oder einer elektrischen Energie und/oder einer Temperatur und/oder einer Verformung der elektrischen Verbindung repräsentiert,

- wobei die mindestens eine oder jede Steuervorrichtung (4) in Abhängigkeit von der Größe und/oder in Abhängigkeit von dem Grad der Veränderung des Betriebsparameters über der Zeit und/oder in Abhängigkeit von dem Grad einer höheren mathematischen zeitlichen Ableitung des Betriebsparameters als der ersten Ableitung den mindestens einen Leistungsschalter (17) aus dem Einschalt-Zustand in den Ausschalt-Zustand überführt,

- wobei die mindestens eine oder jede Steuervorrichtung (4) über ihre jeweilige Datenschnittstelle (550) den Schaltzustand des mindestens einen Leistungsschalters (17) und/oder die aktuelle Größe des Betriebsparameters oder einen diese Größe repräsentierenden Wert an das übergeordnete Steuerungs- bzw. Rechnersystem (12) meldet,

- wobei die Leitungspfade der Leistungsschalter (17) der elektronischen Sicherungen (1) für die jeweiligen elektrischen Verbindungen zwischen den Eingangsanschlüssen und den Ausgangsanschlüssen und direkt oder indirekt zwischen einen Eingangsanschluss und jeweils einen anderen Ausgangsanschluss oder direkt oder indirekt zwischen einen Ausgangsanschluss und jeweils einen anderen Eingangsanschluss geschaltet sind und

- wobei die Datenschnittstelle (550) der mindestens einen Steuervorrichtung (4) oder die Datenschnittstelle (550) jeder Steuervorrichtung (4) Ansteuerdaten zum Ein- und Ausschalten der Leistungsschalter (17) empfangen und auf diese Weise die elektrischen Verbindungen zwischen jedem Eingangsanschluss und jedem Ausgangsanschluss und/oder die Unterbrechungen der elektrischen Verbindungen zwischen jedem Eingangsanschluss und jedem Ausgangsanschluss konfigurierbar sind.

3. Elektrische Sicherungsvorrichtung nach Punkt 1 oder 2, dadurch gekennzeichnet, dass durch Ansteuerung der mindestens einen oder jeder Steuervorrichtung (4) über deren Datenschnittstellen (550) jeder Eingangsanschluss mit mehr als einem Ausgangsanschluss oder jeder Ausgangsanschluss mit mehr als einem Eingangsanschluss verbindbar und/oder jeder Eingangsanschluss von mehr als einem Ausgangsanschluss oder jeder Ausgangsanschluss von mehr als einem Eingangsanschluss trennbar ist.

4. Energieseitige Kreuzungssicherung (1000) eines Fahrzeugs, mit

- einem energiequellenseitigen ersten Versorgungsleitungsabschnitt (1005) einer ersten Versorgungsleitung,
- einem verbraucherseitigen zweiten Versorgungsleitungsabschnitt (1010) einer ersten Versorgungsleitung,
- einem energiequellenseitigen ersten Versorgungsleitungsabschnitt (1015) einer zweiten Versorgungsleitung,
- einem verbraucherseitigen zweiten Versorgungsleitungsabschnitt (1020) einer zweiten Versorgungsleitung,
- einem ersten elektrischen Knoten (1025),
- einem zweiten elektrischen Knoten (1030),
- einer ersten elektronischen Sicherung (1035),
- einer zweiten elektronischen Sicherung (1040),
- einer dritten elektronischen Sicherung (1045),
- einer vierten elektronische Sicherung (1050),
- wobei jede elektronische Sicherung mindestens einen steuerbaren Leistungsschalter (17) aufweist,
- mindestens einer einen Rechnerkern, wie z.B. eine CPU aufweisenden Steuervorrichtung (4) zur Ansteuerung der mindestens einen Leistungsschalter (17) der elektronischen Sicherungen (1) oder mehreren jeweils einen Rechnerkern, wie z.B. eine CPU aufweisenden Steuervorrichtungen (4) zur Ansteuerung jeweils mindestens eines Leistungsschalters (17) einer oder mehrerer elektronischer Sicherungen (1) zwecks Ein- und Ausschaltens des jeweiligen Leistungsschalters (17),
- wobei die mindestens eine Steuervorrichtung (4) eine Datenschnittstelle (550) oder jede Steuervorrichtung (4) eine Datenschnittstelle (550) zur Kommunikationsverbindung mit einem Datenkommunikationsbus (9) eines übergeordneten Steuerungs- bzw. Rechnersystems (12) aufweist,
- mindestens einer Messvorrichtung (24) zur Erfassung mindestens eines Betriebsparameters der Leistungsschalter (17) und/oder der elektrischen Verbindungen, in denen die Leistungsschalter (17) jeweils angeordnet sind, oder mehreren Messvorrichtung (24) zur Erfassung mindestens eines Betriebsparameters eines oder mehrerer Leistungsschalter (17) und/oder der elektrischen Verbindungen, in denen die Leistungsschalter (17) jeweils angeordnet sind, wobei der Betriebsparameter die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- wobei die mindestens eine oder jede Steuervorrichtung (4) in Abhängigkeit von der Größe und/oder in Abhängigkeit von dem Grad der Veränderung des Betriebsparameters über der Zeit und/oder in Abhängigkeit von dem Grad einer höheren mathematischen zeitlichen Ableitung des Betriebsparameters als der ersten Ableitung den mindestens einen Leistungsschalter (17) aus dem Einschalt-Zustand in den Ausschalt-Zustand überführt,
- wobei die mindestens eine oder jede Steuervorrichtung (4) über ihre jeweilige Datenschnittstelle (550) den Schaltzustand des mindestens einen Leistungsschalters (17) und/oder die aktuelle Größe des Betriebsparameters oder einen diese Größe repräsentierenden Wert an das übergeordnete Steuerungs- bzw. Rechnersystem (12) meldet,
- wobei die erste elektronische Sicherung (1035) dazu eingerichtet ist, je nach Schaltzustand des Leistungsschalters (17) der ersten elektronischen Sicherung (1035) den energiequellenseitigen ersten Versorgungsleitungsabschnitt (1005) der ersten Versorgungsleitung mit dem ersten Knoten (1025) zu verbinden oder den energiequellenseitigen ersten Versorgungsleitungsabschnitt (1005) der ersten Versorgungsleitung von dem ersten Knoten (1025) zu trennen,
- wobei die zweite elektronische Sicherung (1040) dazu eingerichtet ist, je nach Schaltzustand des Leistungsschalters (17) der zweiten elektronischen Sicherung (1040) den energiequellenseitigen ersten Versorgungsleitungsabschnitt (1015) der zweiten Versorgungsleitung mit dem ersten Knoten (1025) zu verbinden oder den energiequellenseitigen ersten Versorgungsleitungsabschnitt (1015) der zweiten Versorgungsleitung von dem ersten Knoten (1025) zu trennen,

- wobei die zweite elektronische Sicherung (1040) dazu eingerichtet ist, den energiequellenseitigen ersten Versorgungsleitungsabschnitt (1015) der zweiten Versorgungsleitung nicht mit dem ersten Knoten (1025) zu verbinden, wenn die erste elektronische Sicherung (1035) den energiequellenseitigen ersten Versorgungsleitungsabschnitt (1005) der ersten Versorgungsleitung mit dem ersten Knoten (1025) verbindet,
- wobei die erste elektronische Sicherung (1035) dazu eingerichtet ist, den energiequellenseitigen ersten Versorgungsleitungsabschnitt (1005) der ersten Versorgungsleitung nicht mit dem ersten Knoten (1025) zu verbinden, wenn die zweite elektronische Sicherung (1040) den energiequellenseitigen ersten Versorgungsleitungsabschnitt (1015) der zweiten Versorgungsleitung mit dem ersten Knoten (1025) verbindet,
- wobei die dritte elektronische Sicherung (1045) dazu eingerichtet ist, je nach Schaltzustand des Leistungsschalters (17) der dritten elektronischen Sicherung (1045) den energiequellenseitigen ersten Versorgungsleitungsabschnitt (1005) der ersten Versorgungsleitung mit dem zweiten Knoten (1030) zu verbinden oder den energiequellenseitigen ersten Versorgungsleitungsabschnitt (1005) der ersten Versorgungsleitung von dem zweiten Knoten (1030) zu trennen,
- wobei die vierte elektronische Sicherung (1050) dazu eingerichtet ist, je nach Schaltzustand des Leistungsschalters (17) der vierten elektronischen Sicherung (1050) den energiequellenseitigen ersten Versorgungsleitungsabschnitt (1015) der zweiten Versorgungsleitung mit dem zweiten Knoten (1030) zu verbinden, oder den energiequellenseitigen ersten Versorgungsleitungsabschnitt (1030) der zweiten Versorgungsleitung von dem zweiten Knoten (1030) zu trennen,
- wobei die vierte elektronische Sicherung (1050) dazu eingerichtet ist, den energiequellenseitigen ersten Versorgungsleitungsabschnitt (1015) der zweiten Versorgungsleitung nicht mit dem zweiten Knoten (1030) zu verbinden, wenn die dritte elektronische Sicherung (1045) den energiequellenseitigen ersten Versorgungsleitungsabschnitt (1005) der ersten Versorgungsleitung mit dem zweiten Knoten verbindet,
- wobei die dritte elektronische Sicherung (1045) dazu eingerichtet ist, den energiequellenseitigen ersten Versorgungsleitungsabschnitt der ersten Versorgungsleitung nicht mit dem zweiten Knoten (1030) zu verbinden, wenn die vierte elektronische Sicherung (1050) den energiequellenseitigen ersten Versorgungsleitungsabschnitt (1015) der zweiten Versorgungsleitung mit dem zweiten Knoten (1030) verbindet,
- wobei der verbraucherseitige zweite Versorgungsleitungsabschnitt (1055) der ersten Versorgungsleitung mit dem ersten Knoten (1025) verbunden ist und
- wobei der verbraucherseitige zweite Versorgungsleitungsabschnitt (1060) der zweiten Versorgungsleitung mit dem zweiten Knoten (1030) verbunden ist.


5. Verbraucherseitige Kreuzungssicherung (1000) eines Fahrzeugs, mit

- einem energiequellenseitigen ersten Versorgungsleitungsabschnitt (1005) einer ersten Versorgungsleitung,
- einemverbraucherseitigen zweiten Versorgungsleitungsabschnitt (1015) einer ersten Versorgungsleitung,
- einem energiequellenseitigen ersten Versorgungsleitungsabschnitt (1055) einer zweiten Versorgungsleitung,
- einem verbraucherseitigen zweiten Versorgungsleitungsabschnitt (1060) einer zweiten Versorgungsleitung,
- einem dritten elektrischen Knoten (1065),
- einem vierten elektrischen Knoten (1070),
- einer ersten elektronischen Sicherung (1035),
- einer zweiten elektronischen Sicherung (1040),
- einer dritten elektronischen Sicherung (1045),
- einer vierten elektronischen Sicherung (1050),
- wobei jede elektronische Sicherung einen steuerbaren Leistungsschalter (17) aufweist,
- mindestens einer einen Rechnerkern, wie z.B. eine CPU aufweisenden Steuervorrichtung (4) zur Ansteuerung der mindestens einen Leistungsschalter (17) der elektronischen Sicherungen (1) oder mehreren jeweils einen Rechnerkern, wie z.B. eine CPU aufweisenden Steuervorrichtungen (4) zur Ansteuerung jeweils mindestens eines Leistungsschalters (17) einer oder mehrerer elektronischer Sicherungen (1) zwecks Ein- und Ausschaltens des jeweiligen Leistungsschalters (17),
- wobei die mindestens eine Steuervorrichtung (4) eine Datenschnittstelle (550) oder jede Steuervorrichtung (4) eine Datenschnittstelle (550) zur Kommunikationsverbindung mit einem Datenkommunikationsbus (9) eines übergeordneten Steuerungs- bzw. Rechnersystems (12) aufweist,
- mindestens einer Messvorrichtung (24) zur Erfassung mindestens eines Betriebsparameters der Leistungsschalter (17) und/oder der elektrischen Verbindungen, in denen die Leistungsschalter (17) jeweils angeordnet sind, oder mehreren Messvorrichtung (24) zur Erfassung mindestens eines Betriebsparameters eines oder mehrerer Leistungsschalter (17) und/oder der elektrischen Verbindungen, in denen die Leistungsschalter (17) jeweils angeordnet sind, wobei der Betriebsparameter die Größe eines Stroms und/oder einer Spannung und/oder einer elektrischen Leistung und/oder einer elektrischen Energie und/oder einer Temperatur und/oder einer Verformung der elektrischen Verbindung repräsentiert,

- wobei die mindestens eine oder jede Steuervorrichtung (4) in Abhängigkeit von der Größe und/oder in Abhängigkeit von dem Grad der Veränderung des Betriebsparameters über der Zeit und/oder in Abhängigkeit von dem Grad einer höheren mathematischen zeitlichen Ableitung des Betriebsparameters als der ersten Ableitung den mindestens einen Leistungsschalter (17) aus dem Einschalt-Zustand in den Ausschalt-Zustand überführt,

- wobei die mindestens eine oder jede Steuervorrichtung (4) über ihre jeweilige Datenschnittstelle (550) den Schaltzustand des mindestens einen Leistungsschalters (17) und/oder die aktuelle Größe des Betriebsparameters oder einen diese Größe repräsentierenden Wert an das übergeordnete Steuerungs- bzw. Rechnersystem (12) meldet,

- wobei die erste elektronische Sicherung (1035) dazu eingerichtet ist, je nach Schaltzustand des Leistungsschalters (17) der ersten elektronischen Sicherung (1035) den verbraucherseitigen zweiten Versorgungsleitungsabschnitt (1055) der ersten Versorgungsleitung mit dem dritten Knoten (1065) zu verbinden oder den verbraucherseitigen zweiten Versorgungsleitungsabschnitt (1055) der ersten Versorgungsleitung von dem dritten Knoten (1065) zu trennen,

- wobei die zweite elektronische Sicherung (1040) dazu eingerichtet ist, je nach Schaltzustand des Leistungsschalters (17) der zweiten elektronischen Sicherung (1040) den verbraucherseitigen zweiten Versorgungsleitungsabschnitt (1055) der ersten Versorgungsleitung mit dem vierten Knoten (1070) zu verbinden oder den verbraucherseitigen zweiten Versorgungsleitungsabschnitt (1055) der ersten Versorgungsleitung (1055) von dem vierten Knoten (1070) zu trennen,

- wobei die zweite elektronische Sicherung (1040) dazu eingerichtet ist, den verbraucherseitigen zweiten Versorgungsleitungsabschnitt (1055) der ersten Versorgungsleitung nicht mit vierten Knoten (1070) zu verbinden, wenn die erste elektronische Sicherung (1035) den verbraucherseitigen zweiten Versorgungsleitungsabschnitt (1055) der ersten Versorgungsleitung mit dem dritten Knoten (1065) verbindet,

- wobei die erste elektronische Sicherung (1035) dazu eingerichtet ist, den verbraucherseitigen zweiten Versorgungsleitungsabschnitt (1055) der ersten Versorgungsleitung nicht mit dem dritten Knoten (1055) zu verbinden, wenn die zweite elektronische Sicherung (1040) den verbraucherseitigen zweiten Versorgungsleitungsabschnitt der ersten Versorgungsleitung (1055) mit dem vierten Knoten (1070) verbindet,

- wobei die dritte elektronische Sicherung (1045) dazu eingerichtet ist, je nach Schaltzustand des Leistungsschalters (17) der dritten elektronischen Sicherung (1045) den verbraucherseitigen zweiten Versorgungsleitungsabschnitt (1060) der zweiten Versorgungsleitung mit dem dritten Knoten (1065) zu verbinden oder den verbraucherseitigen zweiten Versorgungsleitungsabschnitt (1060) der zweiten Versorgungsleitung von dem dritten Knoten (1065) zu trennen,

- wobei die vierte elektronische Sicherung (1050) dazu eingerichtet ist, je nach Schaltzustand des Leistungsschalters (17) der vierten elektronischen Sicherung (1050) den verbraucherseitigen zweiten Versorgungsleitungsabschnitt der zweiten Versorgungsleitung (1060) mit dem vierten Knoten (1070) zu verbinden oder den verbraucherseitigen zweiten Versorgungsleitungsabschnitt (1060) der zweiten Versorgungsleitung von dem vierten Knoten (1070) zu trennen,

- wobei die vierte elektronische Sicherung (1050) dazu eingerichtet ist, den verbraucherseitigen zweiten Versorgungsleitungsabschnitt (1060) der zweiten Versorgungsleitung nicht mit dem vierten Knoten (1070) zu verbinden, wenn die dritte elektronische Sicherung (1045) den verbraucherseitigen zweiten Versorgungsleitungsabschnitt (1060) der zweiten Versorgungsleitung mit dem dritten Knoten (1065) verbindet,

- wobei die dritte elektronische Sicherung (1045) dazu eingerichtet ist, den verbraucherseitigen zweiten Versorgungsleitungsabschnitt (1060) der zweiten Versorgungsleitung nicht mit dem dritten Knoten (1065) zu verbinden, wenn die vierte elektronische Sicherung (1050) den verbraucherseitigen zweiten Versorgungsleitungsabschnitt (1060) der zweiten Versorgungsleitung mit dem vierten Knoten (1070) verbindet,

- wobei der energiequellenseitige erste Versorgungsleitungsabschnitt (1005) der ersten Versorgungsleitung mit dem dritten Knoten (1065) verbunden ist und

- wobei der energiequellenseitige erste Versorgungsleitungsabschnitt (1015) der zweiten Versorgungsleitung mit dem vierten Knoten (1070) verbunden ist.

6. Kreuzungssicherung (1000) nach Punkt 4 oder 5, dadurch gekennzeichnet, dass

- der Schaltzustand der Leistungsschalter (17) der elektronischen Sicherungen (1035, 1040, 1045, 1050) der Kreuzungssicherung (1000)

    - von einem ermittelten Bedarf an elektrischer Energie oder elektrischer Leistung von einem oder mehreren Verbrauchern (830, 835) und/oder
    - von einer ermittelten Lieferfähigkeit von elektrischer Energie oder elektrischer Leistung von einer oder mehrerer Energiequellen (250, 251)

abhängt.

7. Kreuzungssicherung (1000) nach Punkt 6, dadurch gekennzeichnet, dass

- die mindestens eine Steuervorrichtung (4) oder jede Steuervorrichtung (4) über einen Sicherungsdatenbus (9) mit einem übergeordneten Rechnersystem (12) und/oder untereinander verbunden sind,
- das übergeordnete Rechnersystem (12) dazu eingerichtet ist, den Bedarf an elektrischer Energie oder elektrischer Leistung von einem oder mehreren Verbrauchern (835, 830) zu ermitteln, die über die Versorgungsleitungen (1005, 1010. 1015, 1020, 1055, 1060) der Kreuzungssicherung (1000) mit elektrischer Energie versorgt werden können,
- das übergeordnete Rechnersystem (12) dazu eingerichtet ist, die Lieferfähigkeit von elektrischer Energie oder elektrischer Leistung von einer oder mehreren Energiequellen (250, 251) zu ermitteln,
- die über die Versorgungsleitungen (1005, 1010. 1015, 1020, 1055, 1060) der Kreuzungssicherung (1000) elektrische Energie liefern können,
- das übergeordnete Rechnersystem (12) dazu eingerichtet ist, der mindestens einen Steuervorrichtung (4) oder jeder Steuervorrichtung (4) Konfigurationsbefehle über den Sicherungsdatenbus (9) zu übermitteln, die von dem ermittelten Bedarf an elektrischer Energie oder elektrischer Leistung dieser Verbraucher (830, 831) abhängen und/oder die von der ermittelten Lieferfähigkeit von elektrischer Energie oder elektrischer Leistung dieser Energiequellen (250, 251) abhängen, und
- diese Konfigurationsbefehle das Öffnen und Schließen von Leistungsschaltern (17) der elektronischen Sicherungen (1035, 1040, 1045, 1050) der Kreuzungssicherung (1000) bewirken.

8. Versorgungsnetzwerk (1100) mit

- einem übergeordneten Rechnersystem (12) und
- einer Vielzahl von Versorgungsleitungen und
- einer Mehrzahl von Kreuzungssicherungen (1110 bis 1118),
- wobei die Kreuzungssicherungen (1110 bis 1118) in Versorgungsleitungen des Versorgungsnetzwerks (1100) eingefügt sind und
- wobei das übergeordnete Rechnersystem (12) mittels eines Sicherungsdatenbusses (9) mit mindestens einer oder mit mehreren Steuervorrichtungen (4) für die elektronischen Sicherungen der Kreuzungssicherungen (1110 bis 1118) verbunden ist und
- wobei die elektronischen Sicherungen der Kreuzungssicherungen (1110 bis 1118) Steuervorrichtungen (4) aufweisen und
- wobei elektronischen Sicherungen (4) einer jeweiligen Kreuzungssicherung (1110 bis 1118) auch eine gemeinsame Steuervorrichtung (4) gemeinsam aufweisen können und
- wobei das übergeordnete Rechnersystem (12) dazu eingerichtet ist, den Bedarf an elektrischer Energie oder elektrischer Leistung von elektrischen Energieverbrauchern (1121 bis 1124) in dem Versorgungsnetzwerk (1100) zu ermitteln, und/oder
- wobei das übergeordnete Rechnersystem (12) dazu eingerichtet ist, die Lieferfähigkeit von elektrischer Energie oder elektrischer Leistung von elektrischen Energiequellen (1150 bis 1155) in dem Versorgungsnetzwerk (1100) zu ermitteln, und/oder
- wobei das übergeordnete Rechnersystem (12) dazu eingerichtet ist, den aktuellen Sicherheitsbedarf insbesondere aufgrund der aktuellen Fahrsituation und/oder des aktuellen Betriebszustands des Fahrzeugs und/oder Eigenschaften der Umgebung des Fahrzeugs zu ermitteln und
- wobei das Rechnersystem (12) dazu eingerichtet ist, mittels Konfigurationsbefehlen über den Sicherungsdatenbus (9) an die Kreuzungssicherungen (1110 bis 1118) die elektrisch wirksame Topologie des Versorgungsnetzes der Versorgungsleitungen dynamisch entsprechend dem ermittelten Bedarf an elektrischer Energie oder elektrischer Leistung und/oder entsprechend der ermittelten Lieferfähigkeit von elektrischer Energie oder elektrischer Leistung und/oder entsprechend den aktuellen Sicherheitsbedarf insbesondere aufgrund der aktuellen Fahrsituation und/oder des aktuellen Betriebszustands des Fahrzeugs und/oder Eigenschaften der Umgebung des Fahrzeugs anzupassen.

9. Elektronische Sicherung für ein Fahrzeug mit

- mindestens einem elektronischen Leistungsschalter (17) zur Anordnung in einer direkt oder indirekt zu einem elektrischen Verbraucher des Fahrzeugs führenden Versorgungsleitung eines Versorgungsleitungsnetzwerks des Fahrzeugs,

- einer einen Rechnerkern wie z.B. eine CPU aufweisenden Steuervorrichtung (4) zur Ansteuerung des mindestens einen Leistungsschalters (17) zwecks wahlweisen Ein- und Ausschaltens des mindestens einen Leistungsschalters (17),
- mindestens einer Messvorrichtung (24) zur Erfassung eines Betriebsparameters des Leistungsschalters (17) und/oder einer elektrischen Verbindung, in der der Leistungsschalter (17) angeordnet ist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- wobei die Steuervorrichtung (4) in Abhängigkeit von der Größe des Betriebsparameters und/oder in Abhängigkeit von dem Grad der Veränderung des Betriebsparameters über der Zeit oder in Abhängigkeit von dem Grad einer höheren mathematischen zeitlichen Ableitung des Betriebsparameters als der ersten Ableitung den mindestens einen Leistungsschalter (17) zur Überführung aus seinem Einschaltzustand in seinen Ausschaltzustand ansteuert und
- mindestens einer mit der Steuervorrichtung (4) gekoppelten Datenschnittstelle (550) für eine nicht-elektrische Datenkommunikation mit einem übergeordneten Steuerungs- bzw. Rechnersystem (12) zur Übertragung von Messdaten an das übergeordnete Steuerungs- bzw. Rechnersystem (12) und/oder zum Empfang von Steuerdaten für die Steuervorrichtung (4) zur Ansteuerung des mindestens einen Leistungsschalters (17).

10. Elektronische Sicherung nach Punkt 9, dadurch gekennzeichnet, dass die mindestens eine Datenschnittstelle (550) eine Datenschnittstelle für das optische oder induktive Empfangen und/oder Senden von Daten und/oder das Empfangen und/oder Senden von Daten mittels elektromagnetischer Strahlung und/oder Partikelstrahlung ist.

11. Elektronische Sicherung nach Punkt 9, dadurch gekennzeichnet, dass die Datenschnittstelle (550) eine optische Datenschnittstelle ist, die für Infrarot- und/oder UV-Strahlung, für Einzelphotonen, insbesondere eines QKD-Systems, für andere Bosonen und/oder Photonen und/oder Neutronen und/oder Fermionen und/oder für ionisierende Strahlung transparent ist, und mindestens eine Laserdiode oder mindestens eine LED aufweist und/oder mindestens eine Fotodiode oder mindestens einen Fototransistor aufweist.

12. Elektronische Sicherung nach Punkt 11, dadurch gekennzeichnet, dass die Laserdiode oder LED ein Konversionsmittel aufweist, wobei das Konversionsmittel von dem Material eines PN-Übergangs der Laserdiode oder LED verschieden ist und wobei das Konversionsmittel

- einen elektrischen Stromfluss durch die Laserdiode oder LED in eine elektromagnetische Strahlung umsetzt und/oder
- ein elektrisches Feld, das über die Laserdiode oder LED abfällt, in eine elektromagnetische Strahlung umsetzt und/oder
- eine von der Laserdiode oder LED abgestrahlte elektromagnetische Strahlung mit einer ersten Wellenlänge in eine elektromagnetische Strahlung einer zweiten Wellenlänge umsetzt, die länger als die erste Wellenlänge ist.

13. Elektronische Sicherung nach Punkt 11 oder 12, dadurch gekennzeichnet, dass die Datenschnittstelle (550) eine siliziumbasierte LED, insbesondere eine siliziumbasierte Laserdiode und/oder eine Silizium-Lawinen-Diode z.B. in Form einer SPAD-Diode aufweist.

14. Elektronische Sicherung nach Punkt 12 oder 13, dadurch gekennzeichnet, dass die siliziumbasierte LED und/oder die siliziumbasierte Laserdiode und/oder die Silizium-Lawinen-Diode und/oder die SPAD-Diode Farbzentren als Konversionsmittel aufweist, die durch einen Stromfluss oder ein elektrisches Feld zur Emission von elektromagnetischer Strahlung angeregt werden, wobei es sich bei den Farbzentren z.B. um Punktdefekte im Silizium-Substratmaterial der siliziumbasierten LED und/oder der siliziumbasierten Laserdiode und/oder der Silizium-Lawinen-Diode und/oder der SPAD-Diode handeln kann.

15. Elektronische Sicherung nach einem der Punkte 9 bis 14, gekennzeichnet durch Betriebsanschlüsse für die Aufnahme elektrischer Energie von extern der elektronischen Sicherung und einen von der Steuervorrichtung (4) oder dem übergeordneten Steuerungs- bzw. Rechnersystem (12) steuerbaren Trennschalter zur Trennung der mindestens einen Datenschnittstelle (550) von der Versorgung mit elektrischer Energie zum Betrieb der mindestens einen Datenschnittstelle (550).

16. Elektronische Sicherung nach Punkt 15, gekennzeichnet durch eine Notenergiequelle, die über die Betriebsspannungsanschlüsse und gegebenenfalls einen Spannungsumsetzer mit elektrischer Energie versorgbar ist und bei Ausfall der Lieferung von elektrischer Energie über die Betriebsspannungsanschlüsse die für den Betrieb der elektronischen Sicherung erforderlichen Betriebsspannung liefert.

17. Elektronische Sicherung nach einem der Punkte 9 bis 16, dadurch gekennzeichnet, dass die mindestens eine Datenschnittstelle (550) in Datenkommunikation mit mindestens einer Datenschnittstelle (550) einer anderen elektronischen Sicherung oder mit jeweils mindestens einer der Datenschnittstellen (550) mehrerer anderer elektronischer Sicherungen bringbar ist.

18. Elektronische Sicherung nach einem der Punkte 9 bis 17, dadurch gekennzeichnet, dass zur Datenkommunikation mit einer oder mehrerer anderer elektronischen Sicherungen und/oder mit dem übergeordneten Steuerungs- und bzw. Rechnersystem (12) ein elektrisch oder optisch oder induktiv oder elektromagnetisch oder partikelstrahlungsbasiert arbeitender Datenkommunikationsbus vorgesehen ist.

19. Elektronische Sicherung nach Punkt 18, dadurch gekennzeichnet, dass der Datenkommunikationsbus ein elektrisch oder elektromagnetisch arbeitender Datenkommunikationsbus ist, der Datenschnittstellen (550) zur optischen und/oder induktiven und/oder elektromagnetischen und/oder partikelstrahlungsbasierten Kommunikation mit den Datenschnittstellen (550) ein oder mehrerer elektronischer Sicherungen aufweist, wobei der elektrische oder elektromagnetische Datenkommunikationsbus mindestens zwei Datenkommunikationsbusabschnitte aufweist, die zur galvanischen Trennung mittels optischen und/oder induktiv und/oder elektromagnetisch und/oder partikelstrahlungsbasiert arbeitenden Datenschnittstellen (550) in Kommunikationsverbindung miteinander stehen.

20. Elektronische Sicherung nach Punkt 19, dadurch gekennzeichnet, dass an den einen Datenkommunikationsbusabschnitt Teilnehmer angeschlossen sind, die mit einer ersten Versorgungsspannung betreibbar sind, und dass an den anderen Datenkommunikationsbusabschnitt Teilnehmer angeschlossen sind, die mit einer zweiten Versorgungsspannung betreibbar sind, wobei die Versorgungsspannungen um mindestens einen Faktor im Bereich von 5 bis 10 oder im Bereich von 10 bis 50 oder im Bereich von 50 bis 100 oder im Bereich von 100 bis 500 verschieden sind.

21. Elektronische Sicherung (1) für ein Fahrzeug, mit

- einem Gehäuse (535),
- einem ersten Gehäuseanschluss (18) und einem zweiten Gehäuseanschluss (19),
- einem elektronischen Leistungsschalter (17), der einen ersten Anschluss (26), einen zweiten Anschluss (28) und einen Steueranschluss (27) aufweist,
- einer Steuervorrichtung (4), die mit dem Steueranschluss (27) des Leistungsschalters (17) verbunden ist,
- wobei der erste Gehäuseanschluss (18) mit dem ersten Anschluss (26) des Leistungsschalters (17) und der zweite Gehäuseanschluss (19) mit dem zweiten Anschluss (28) des Leistungsschalters (17) verbunden ist,
- wobei die Steuervorrichtung (4) dazu eingerichtet ist, elektrische Spannungen zwischen dem ersten und dem zweiten Anschluss (26, 28) des Leistungsschalters (17) und/oder Werte von zu den Spannungen funktionsäquivalenten physikalischen Parametern zu erfassen und daraus einen Wert für einen elektrischen Strom (29) durch den Leistungsschalter (17) zwischen dessen ersten und zweiten Anschluss (26, 28) zu ermitteln,
- wobei der Leistungsschalter (17) und die Steuervorrichtung (4) in dem Gehäuse (535) untergebracht sind und
- wobei das Gehäuse (535) ein für elektromagnetische Strahlung oder elektromagnetische Felder transparentes Fenster (545) und/oder ein für Partikelstrahlung transparentes Fenster (545) aufweist.

22. Elektronische Sicherung (1) nach Punkt 21, dadurch gekennzeichnet, dass die Steuervorrichtung (4) eine optisch und/oder induktiv und/oder elektromagnetisch arbeitende Datenschnittstelle (550) und/oder eine auf Basis von Partikelstrahlung arbeitende Datenschnittstelle (550) aufweist.

23. Elektronische Sicherung (1) nach Punkt 22, dadurch gekennzeichnet, dass das für elektromagnetische Strahlung und/oder für elektromagnetische Felder transparente Fenster (545) einer oder mehrerer der optisch und/oder induktiv und/oder elektromagnetisch arbeitenden Datenschnittstellen (550) und/oder einer oder mehrerer der optisch und/oder induktiv und/oder elektromagnetisch arbeitenden Datenschnittstellen (550) der Steuervorrichtung (4) zugeordnet sind und/oder dass das Partikelstrahlung transparente Fenster (545) einer oder mehrerer der auf Basis von Partikelstrahlung arbeitenden Datenschnittstellen (550) der Steuervorrichtung (4) zugeordnet sind.

24. Elektronische Sicherung (1) nach Punkt 23, dadurch gekennzeichnet, dass das für elektromagnetische Strahlung und/oder elektromagnetische Felder und/oder Partikelstrahlung transparente Fenster (545) dazu eingerichtet sind, den Zutritt und/oder den Austritt der Strahlung und/oder der Felder und/oder der Partikel für den Transport von Daten und/oder Signalen zur Steuervorrichtung (4) zu ermöglichen, und wobei die optisch und/oder induktiv und/oder elektromagnetisch und/oder auf Basis von Partikeln arbeitende Datenschnittstelle (550) der Steuervorrichtung (4) dazu eingerichtet ist, durch das für elektromagnetische Strahlung und/oder elektromagnetische Felder und/oder Partikelstrahlung transparente Fenster (545) mit einer optisch und/oder induktiv und/oder elektromagnetisch und/oder auf Basis von Partikelstrahlung arbeitenden Datenschnittstelle (555) einer anderen Vorrichtung (12), beispielsweise eines übergeordneten Steuerungs- bzw. Rechnersystems (12) außerhalb des Gehäuses (535) mittels elektromagnetischer Strahlung und/oder elektromagnetischer Felder und/oder Partikelstrahlung zu kommunizieren.

25. Elektronische Sicherung (1) nach Punkt 23, dadurch gekennzeichnet, dass es sich bei der elektromagnetischen Strahlung für den Transport von Daten um Laser-Strahlung eines Lasers (560) oder um Strahlung einer LED (560) handelt und/oder dass es sich bei der Partikelstrahlung für den Transport von Daten um Photonen und/oder Einzelphotonen einer Laser-Strahlung eines Lasers (560) oder um Photonen und/oder Einzelphotonen einer Strahlung einer LED (560) handelt.

26. Elektronische Sicherung (1) nach einem der Punkte 21 bis 25, dadurch gekennzeichnet, dass ein Laser oder eine LED (560), insbesondere als Sender von Daten der optisch und/oder induktiv und/oder elektromagnetisch und/oder auf Basis der Partikelstrahlung arbeitenden Datenschnittstelle (550) vorgesehen ist.

27. Elektronische Sicherung nach Punkt 26, dadurch gekennzeichnet, dass die Laserdiode oder LED (560) ein Konversionsmittel aufweist, wobei das Konversionsmittel von dem Material eines PN-Übergangs der Laserdiode oder LED (560) verschieden ist und wobei das Konversionsmittel

- einen elektrischen Stromfluss durch die Laserdiode oder LED (560) in eine elektromagnetische Strahlung umsetzt und/oder
  ein elektrisches Feld, das über die Laserdiode oder LED (560) abfällt, in eine elektromagnetische Strahlung umsetzt und/oder
- eine von der Laserdiode oder LED (560) abgestrahlte elektromagnetische Strahlung mit einer ersten Wellenlänge in eine elektromagnetische Strahlung umsetzt, die länger als die erste Wellenlänge ist.

28. Elektronische Sicherung (1) nach Punkt 26 oder 27, dadurch gekennzeichnet, dass als LED eine siliziumbasierte LED (560) und/oder dass als Laser ein siliziumbasierter Laser (560) vorgesehen ist.

29. Elektronische Sicherung nach Punkt 27 oder 28, dadurch gekennzeichnet, dass die siliziumbasierte LED und/oder die siliziumbasierte Laserdiode (560) Farbzentren als Konversionsmittel aufweist, die durch einen Stromfluss oder ein elektrisches Feld zur Emission von elektromagnetischer Strahlung mit einer zweiten Wellenlänge angeregt werden, wobei es sich bei den Farbzentren z.B. um Punktdefekte im Silizium-Substratmaterial der siliziumbasierten LED und/oder der siliziumbasierten Laserdiode handeln kann.

30. Elektronische Sicherung (1) nach Punkt 28 oder 29, dadurch gekennzeichnet, dass die siliziumbasierte LED (560) eine Silizium-Lawinen-LED (560), insbesondere eine als LED betriebene SPAD-Diode (560) ist.

31. Elektronische Sicherung (1) nach einem der Punkte 28 bis 30, gekennzeichnet durch eine Ansteuerungsvorrichtung (565), die aus einer Betriebsspannung für die elektronische Sicherung mittels eines Spannungsumsetzers eine Betriebsspannung für die siliziumbasierte LED (560) und/oder die siliziumbasierte Laserdiode erzeugt.

32. Elektronische Sicherung (1) nach einem der Punkte 28 bis 31, dadurch gekennzeichnet, dass die siliziumbasierte LED (560) und/oder die siliziumbasierten Laserdiode zumindest zeitweise als Empfänger betreibbar ist.

33. Elektronische Sicherung (1) nach Punkt 32, dadurch gekennzeichnet, dass ein Rechnerkern (2) der Steuervorrichtung (4) dazu eingerichtet ist, mittels eines Trennschalters die siliziumbasierte LED (560) und/oder die siliziumbasierte Laserdiode (560) von dem Spannungsumsetzer abzutrennen, wobei der Rechnerkern (2) dazu eingerichtet ist, mittels eines Analog-zu-Digital-Wandlers (570) der Steuervorrichtung (4) das Spannungssignal (575) und/oder den Fotostrom der siliziumbasierten LED (560) und/oder der siliziumbasierten Laserdiode (560) zu erfassen.

34. Elektronische Sicherung (1) nach einen der Punkte 21 bis 33, dadurch gekennzeichnet, dass der Rechnerkern (2) ferner dazu eingerichtet ist, mittels eines Analog-zu-Digital-Wandlers (570) das Spannungssignal (575) und/oder den Fotostrom eines Fotodetektors zu erfassen.

35. Elektronische Sicherung (1) nach Punkt 33 oder 34, dadurch gekennzeichnet, dass der Rechnerkern (2) und/oder die Steuervorrichtung (4) dazu eingerichtet ist bzw. sind, den erfassten Wert als Eingangsdatensignal einer optisch und/oder induktiv und/oder elektromagnetisch und/oder auf Basis von Partikelstrahlung arbeitenden Datenschnittstelle zu verwenden.

36. Elektronische Sicherung (1) nach einem der Punkte 21 bis 25, dadurch gekennzeichnet, dass der Fotodetektor eine Fotodiode oder einen Fototransistor aufweist und dass eine Auswerteelektronik für den Fotodetektor vorgesehen ist.

37. Elektronische Sicherung (1) nach einem der Punkte 24 bis 36, gekennzeichnet durch die Kopplung der mindestens einen optisch und/oder induktiv und/oder elektromagnetisch und/oder auf Basis von Partikelstrahlung arbeitenden Datenschnittstelle (550) mit einem Lichtwellenleiter (580) zur Kopplung mit einer oder mehreren anderen elektronischen Sicherungen über die optisch und/oder induktiv und/oder elektromagnetisch und/oder auf Basis von Partikelstrahlung arbeitenden Datenschnittstellen ihrer Steuervorrichtungen (4).

38. Elektronische Sicherung (1) nach Punkt 27, gekennzeichnet durch die Kopplung der mindestens einen optisch und/oder induktiv arbeitenden Datenschnittstelle (550) über einen Lichtwellenleiter (580) mit einer optisch und/oder induktiv und/oder elektromagnetisch und/oder auf Basis von Partikelstrahlung arbeitenden Datenschnittstelle (555) eines übergeordneten Steuerungs- bzw. Rechnersystems (12) und gegebenenfalls mit einer oder mehreren weiteren elektronischen Sicherungen.

39. Versorgungssystem für ein Fahrzeug zur Versorgung elektrischer Verbraucher des Fahrzeugs mit elektrischer Energie aus mindestens einer Energiequelle des Fahrzeugs, mit

- mindestens einer Energiequelle (1150 bis 1155, 3250 bis 3255),
- einem Versorgungsnetzwerk aus Versorgungsleitungen, mit dem die mindestens eine Energiequelle (1150 bis 1155, 3250 bis 3255) verbunden ist,
- wobei die Versorgungsleitungen ausgehend von der mindestens einen Energiequelle (1150 bis 1155, 3250 bis 3255) zu elektrischen Verbrauchern des Fahrzeugs führen,
- wobei die Versorgungsleitungen voneinander abzweigende, einzelne Versorgungsteilnetzwerke bildende Versorgungsleitungsabschnitte aufweisen, die zu elektrischen Verbrauchern des Fahrzeugs führen und gegebenenfalls von derartigen Verbrauchern zu weiteren elektrischen Verbrauchern und/oder mindestens einer weiteren Energiequelle (1150 bis 1155, 3250 bis 3255) des Fahrzeugs führen und/oder Verbraucher und/oder mindestens eine weitere Energiequelle (1150 bis 1155, 3250 bis 3255) aufweisen,
- mehrere elektronische Sicherungen (1) mit jeweils mindestens einem ansteuerbaren elektronischen Leistungsschalter (17), die in einzelnen der Versorgungsleitungsabschnitte bzw. zwischen diesen angeordnet sind,
- mindestens einer einen Rechnerkern, wie z.B. eine CPU aufweisenden Steuervorrichtung (4) zur Ansteuerung der mindestens einen Leistungsschalter (17) der elektronischen Sicherungen (1) oder mehreren jeweils einen Rechnerkern, wie z.B. eine CPU aufweisenden Steuervorrichtungen (4) zur Ansteuerung jeweils mindestens eines Leistungsschalters (17) einer oder mehrerer elektronischer Sicherungen (1) zwecks Ein- und Ausschaltens des jeweiligen Leistungsschalters (17),
- wobei die mindestens eine Steuervorrichtung (4) eine Datenschnittstelle (550) oder jede Steuervorrichtung (4) eine Datenschnittstelle (550) zur Kommunikationsverbindung mit einem Datenkommunikationsbus (9) eines übergeordneten Steuerungs- bzw. Rechnersystems (12) aufweist,
- mindestens einer Messvorrichtung (24) zur Erfassung mindestens eines Betriebsparameters der Leistungsschalter (17) und/oder der elektrischen Verbindungen, in denen die Leistungsschalter (17) jeweils angeordnet sind, oder mehreren Messvorrichtung (24) zur Erfassung mindestens eines Betriebsparameters eines oder mehrerer Leistungsschalter (17) und/oder der elektrischen Verbindungen, in denen die Leistungsschalter (17) jeweils angeordnet sind, wobei der Betriebsparameter die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- wobei die mindestens eine oder jede Steuervorrichtung (4) in Abhängigkeit von der Größe und/oder in Abhängigkeit von dem Grad der Veränderung des Betriebsparameters über der Zeit und/oder in Abhängigkeit von dem Grad einer höheren mathematischen zeitlichen Ableitung des Betriebsparameters als der ersten Ableitung den mindestens einen Leistungsschalter (17) aus dem Einschalt-Zustand in den Ausschalt-Zustand überführt,
- wobei die mindestens eine oder jede Steuervorrichtung (4) über ihre jeweilige Datenschnittstelle (550) den Schaltzustand des mindestens einen Leistungsschalters (17) und/oder die aktuelle Größe des Betriebsparameters oder einen diese Größe repräsentierenden Wert an das übergeordnete Steuerungs- bzw. Rechnersystem (12) meldet,

- wobei die mindestens eine Steuervorrichtung (4) oder jede Steuervorrichtung (4) an das Steuerungs- bzw. Rechnersystem (12) Daten

  - über physikalische Betriebsparameter, wie z.B. Stromflüsse durch ihre jeweiligen Leistungsschalter (17), und/oder
  - Spannungen gegenüber einem Bezugspotential oder anderen Versorgungsleitungsabschnitten und/oder
  - Temperatur und/oder
  - ein dynamisches Verhalten der Betriebsparameter und/oder
  - auf Grund dieser Daten zu erwartende thermische und/oder elektrische und/oder sonstige Belastungen in den Versorgungsleitungen

  übermitteln und von dem Steuerungs- bzw. Rechnersystem (12) Steuerdaten für ihre jeweiligen Leistungsschalter (17) erhalten und
- wobei der Datenkommunikationsbus (9) der eine drahtgebundene und/oder drahtlose Datenübertragungsstrecke umfassen kann
- wobei durch das übergeordnete Steuerungs- bzw. Rechnersystem (12) über den Datenkommunikationsbus (9) an die mindestens eine Steuervorrichtung (4) oder an jede Steuervorrichtung (4) Steuerdaten zur Überführung des jeweiligen mindestens einen Leistungsschalters (17) aus dessen Einschaltzustand in den Ausschaltzustand zwecks Abschaltens von Verbrauchern und/oder von Energiequellen (1150 bis 1155, 3250 bis 3255) und/oder von Versorgungsteilnetzwerken und/oder zur Überführung des jeweils mindestens einen Leistungsschalters (17) aus dessen Ausschaltzustand in dessen Einschaltzustand zwecks Zuschaltens von Verbrauchern und/oder Energiequellen (1150 bis 1155, 3250 bis 3255) und/oder von Versorgungsteilnetzwerken übermittelbar sind.

40. Versorgungssystem nach Punkt 39, dadurch gekennzeichnet, dass durch das übergeordnete Steuerungs- bzw. Rechnersystem (12) über den Datenkommunikationsbus (9) an die mindestens Steuervorrichtung (4) oder an jede Steuervorrichtung (4) Steuerdaten zum Ein- und Ausschalten der jeweiligen Leistungsschalter (17) zwecks Rekonfiguration von Stromflüssen in dem Versorgungsnetzwerk oder in Versorgungsteilnetzwerken in Abhängigkeit von von elektronischen Sicherungen an das übergeordnete Steuerungs- bzw. Rechnersystem (12) übermittelten Daten aktuell detektierter Strom- und/oder Spannungs- und/oder thermischer Lasten und/oder anderer physikalischer Parameter, wie beispielsweise thermische Belastungen, in den Versorgungsleitungsabschnitten von Teilen des Versorgungsnetzwerks und/oder in Abhängigkeit von in Teilen des Versorgungsnetzwerks aktuell benötigen erhöhten Stromflüssen und/oder in Abhängigkeit von in Teilen des Versorgungsnetzwerks aktuell vorliegenden Spannungswerten und/oder in Abhängigkeit von in Teilen des Versorgungsnetzwerks aktuell vorliegenden Werten anderer physikalischer Parameter und/oder in Abhängigkeit von der von der mindestens einen Energiequelle (1150 bis 1155, 3250 bis 3255) aktuell bereitstellbaren Energie und/oder (Energieliefer-) Leistung und/oder in Abhängigkeit von der von der mindestens einen Energiequelle (1150 bis 1155, 3250 bis 3255) aktuell bereitstellbaren elektrischen Spannung und/oder in Abhängigkeit von der von der mindestens einen Energiequelle (1150 bis 1155, 3250 bis 3255) aktuell bereitstellbaren elektrischen Stromstärke übermittelbar sind.

41. Versorgungssystem nach Punkt 39 oder 40, dadurch gekennzeichnet, dass die mindestens eine Energiequelle (1150 bis 1155, 3250 bis 3255) und die Verbraucher ebenfalls mit dem Datenkommunikationsbus (9) verbunden sind und Daten bezüglich der Größe der aktuell bereitstellbaren Energie oder (Energieliefer-)Leistung und Daten bezüglich ihres jeweils aktuellen Energiebedarfs liefern und dass dann, wenn die Summe der aktuellen Energiebedarfe der Verbraucher die aktuell bereitstellbare Energie oder (Energieliefer-)Leistung der mindestens einen Energiequelle (1150 bis 1155, 3250 bis 3255) übersteigt, einzelne Verbraucher oder einzelne Versorgungsteilnetzwerke durch Ausschalten von elektronischen Sicherungen ausschaltbar oder abtrennbar sind.

42. Versorgungssystem nach Punkt 41, dadurch gekennzeichnet, dass mehrere Energiequellen (1150 bis 1155, 3250 bis 3255) vorgesehen sind, die mittels elektronischer Sicherungen mit dem Versorgungsnetzwerk verbunden sind oder mit dem Versorgungsnetzwerk verbunden sind und elektronische Sicherungen aufweisen, und dass dann, wenn die Summe der von den Energiequellen (1150 bis 1155, 3250 bis 3255) aktuell bereitstellbaren Energie- oder (Energieliefer-)Leistung die Summe der aktuellen Energiebedarfe der Verbraucher übersteigt, einzelne Energiequellen (1150 bis 1155, 3250 bis 3255) durch Ausschalten von elektronischen Sicherungen ausschaltbar bzw. deaktivierbar und/oder vom Versorgungsnetz abtrennbar sind.

43. Versorgungssystem nach einem der Punkte 39 bis 42 dadurch gekennzeichnet, dass die mindestens eine Energiequelle (1150 bis 1155, 3250 bis 3255) und die Verbraucher ebenfalls mit dem Datenkommunikationsbus (9) verbunden sind und Daten bezüglich der Größe der aktuell bereitstellbaren Energie oder (Energieliefer-)Leistung und Daten bezüglich ihres jeweils aktuellen Energiebedarfs liefern und dass dann, wenn die Summe der aktuellen Energietransportbedarfe in einem Leitungsabschnitt des Versorgungsnetzwerks die aktuell bereitstellbare, insbesondere durch die maximale zulässige Stromtragfähigkeit und/oder die maximale zulässige Spannungsfestigkeit des oder eines Versorgungsleitungsabschnitts definierte Energietransportfähigkeit dieses Leitungsabschnitts des Versorgungsnetzwerks übersteigt, einzelne Verbraucher oder einzelne Versorgungsteilnetzwerke durch Ausschalten von elektronischen Sicherungen ausschaltbar oder abtrennbar sind.

44. Versorgungssystem nach Punkt 43, dadurch gekennzeichnet, dass mehrere Energiequellen (1150 bis 1155, 3250 bis 3255) vorgesehen sind, die mittels elektronischer Sicherungen mit dem Versorgungsnetzwerk verbunden sind oder mit dem Versorgungsnetzwerk verbunden sind und elektrische Sicherungen aufweisen, und dass dann, wenn die Summe der aktuellen Energietransportbedarfe in einem Leitungsabschnitt des Versorgungsnetzwerks die aktuell bereitstellbare , insbesondere durch die maximale zulässige Stromtragfähigkeit und/oder die maximale zulässige Spannungsfestigkeit des oder eines Versorgungsleitungsabschnitts definierte Energietransportfähigkeit dieses Leitungsabschnitts des Versorgungsnetzwerks übersteigt, einzelne Energiequellen (1150 bis 1155, 3250 bis 3255) durch Ausschalten von elektronischen Sicherungen ausschaltbar bzw. deaktivierbar und/oder vom Versorgungsnetz abtrennbar sind.

45. Versorgungssystem nach einem der Punkte 39 bis 42, dadurch gekennzeichnet, dass im übergeordneten Steuerungs- bzw. Rechnersystem (12) eine Prognose erstellbar ist über den Gesamtenergieverbrauch für die Realisierung eines beispielsweise durch den Fahrer des Fahrzeugs vorgebbaren Szenario wie z.B. für eine mit dem Fahrzeug zurückzulegende Wegstrecke gegebenenfalls unter Berücksichtigung des Höhenprofils der Wegstrecke und/oder von Umweltparametern wie z.B. der Temperatur der Umgebung, durch die die Wegstrecke führt, der Tages- bzw. Nachzeiten beim Befahren der Wegstrecke, und dass das Steuerungs- bzw. Rechnersystem (12) die durch die Ansteuerung der elektronischen Sicherungen (1) erfolgende Rekonfiguration des Versorgungsnetzwerks unter Berücksichtigung der zu Beginn des Szenarios gegebenen Gesamtenergie sämtlicher Energiequellen und der während des Szenarios von potentiell zusätzlichen, durch Rekuperation in zumindest einigen der Verbraucher erzeugbaren Energie nach Größe und Zeitpunkt sowie Zeitverlauf der Energieerzeugung steuert und dabei gegebenenfalls einzelne Versorgungsteilnetze und/oder Verbraucher und/oder Energiequellen (1150 bis 1155, 3250 bis 3255) abtrennt und/oder zuschaltet.

46. Elektronische Sicherung für ein Fahrzeug, mit

- einem ersten Gehäuseanschluss (18) und einem zweiten Gehäuseanschluss (19),
- einem elektronischen Leistungsschalter (17), der einen zwischen den ersten Gehäuseanschluss (18) und den zweiten Gehäuseanschluss (19) geschalteten Leitungspfad und einen Steueranschluss aufweist,
- einer einen Rechnerkern wie z.B. eine CPU aufweisenden Steuervorrichtung (4), die zum Ein- und Ausschalten des Leistungsschalters (17) mit dessen Steueranschluss verbunden ist und die eine Datenschnittstelle (550) zur Verbindung mit einem Datenkommunikationsbus (9) eines übergeordneten Steuerungs- bzw. Rechnersystem (12) aufweist,
- einer Messvorrichtung (24) zur Erfassung eines Betriebsparameters des Leistungsschalters (17) und/oder einer elektrischen Verbindung, in der der Leistungsschalter (17) angeordnet ist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- einem Temperatursensor zur Ermittlung der Temperatur der elektronischen Sicherung oder zur Ermittlung der Temperatur einer Komponente, Baugruppe, Einheit oder eines Bauteils, die bzw. das extern der elektronischen Sicherung angeordnet und insbesondere durch die elektronische Sicherung abgesichert ist,
- wobei die Steuervorrichtung (4) ein den Messwert des Temperatursensors repräsentierendes Auswertesignal empfängt und dieses Auswertesignal mit einem einen Temperaturgrenzwert repräsentierenden Referenzsignal vergleicht und
- wobei die Steuervorrichtung (4) über die Datenschnittstelle (550) an das übergeordnete Steuerungs- bzw. Rechnersystem (12) die Überschreitung des Referenzsignals durch das Auswertesignal meldet.

47. Elektronische Sicherung für ein Fahrzeug, mit

- einem ersten Gehäuseanschluss (18) und einem zweiten Gehäuseanschluss (19),

- einem elektronischen Leistungsschalter (17), der einen zwischen den ersten Gehäuseanschluss (18) und den zweiten Gehäuseanschluss (19) geschalteten Leitungspfad und einen Steueranschluss aufweist,
- einer einen Rechnerkern wie z.B. eine CPU aufweisenden Steuervorrichtung (4), die zum Ein- und Ausschalten des Leistungsschalters (17) mit dessen Steueranschluss verbunden ist und die eine Datenschnittstelle (550) zur Verbindung mit einem Datenkommunikationsbus (9) eines übergeordneten Steuerungs- bzw. Rechnersystem (12) aufweist,
- einer Messvorrichtung (24) zur Erfassung eines Betriebsparameters des Leistungsschalters (17) und/oder einer elektrischen Verbindung, in der der Leistungsschalter (17) angeordnet ist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- einem Temperatursensor zur Ermittlung der Temperatur der elektronischen Sicherung oder zur Ermittlung der Temperatur einer Komponente, Baugruppe, Einheit oder eines Bauteils, die bzw. das extern der elektronischen Sicherung angeordnet und insbesondere durch die elektronische Sicherung abgesichert ist,
- wobei die Steuervorrichtung (4) ein den Messwert des Temperatursensors repräsentierendes Auswertesignal empfängt und dieses Auswertesignal mit einem einen Temperaturgrenzwert repräsentierenden Referenzsignal vergleicht und
- wobei die Steuervorrichtung (4) bei eingeschaltetem Leistungsschalter (17) dann, wenn das Auswertesignal das Referenzsignal übersteigt, den Leistungsschalter (17) ausschaltet und/oder einen in Reihe mit dem Leitungspfad des Leistungsschalters (17) liegenden Sicherheitsschalter ausschaltet.

48. Elektronische Sicherung nach Punkt 46 oder 47, dadurch gekennzeichnet, dass die Steuervorrichtung (4) über die Datenschnittstelle (550) an das übergeordnete Steuerungs- bzw. Rechnersystem (12) die Überschreitung des Referenzsignals durch das Auswertesignal meldet.

49. Elektronische Sicherung für ein Fahrzeug, mit

- einem ersten Gehäuseanschluss (18) und einem zweiten Gehäuseanschluss (19),
- einem elektronischen Leistungsschalter (17), der einen zwischen den ersten Gehäuseanschluss (18) und den zweiten Gehäuseanschluss (19) geschalteten Leitungspfad und einen Steueranschluss aufweist,
- einer einen Rechnerkern wie z.B. eine CPU aufweisenden Steuervorrichtung (4), die zum Ein- und Ausschalten des Leistungsschalters (17) mit dessen Steueranschluss verbunden ist und die eine Datenschnittstelle (550) zur Verbindung mit einem Datenkommunikationsbus (9) eines übergeordneten Steuerungs- bzw. Rechnersystem (12) aufweist,
- einer Messvorrichtung (24) zur Erfassung eines die Größe eines Stroms durch den Leitungspfad des mindestens einen Leistungsschalters (17) repräsentierenden Messwerts und
- einem temperaturgesteuerten Unterbrechungselement (5710, 5740), das in Reihe mit dem Leitungspfad des Leistungsschalters (17) liegt und bei Überschreitung eines Temperaturgrenzwerts reversibel oder irreversibel öffnet.

50. Elektronische Sicherung nach Punkt 49, dadurch gekennzeichnet, dass das temperaturgesteuerte Unterbrechungselement eine irreversibel Thermoschmelzsicherung (5740) oder ein Thermoschalter (5710) ist, der bei Überschreitung des Temperaturgrenzwerts öffnet und bei anschließender Unterschreitung des Temperaturgrenzwerts wieder schließt.

51. Elektronische Sicherung nach Punkt 49 oder 50, dadurch gekennzeichnet, dass die Steuervorrichtung (4) den Schaltzustand des temperaturgesteuerten Unterbrechungselements (5710, 5740) durch z. B. Erfassung der über dem Unterbrechungselement (5710, 5740) abfallenden Spannung ermittelt.

52. Elektronische Sicherung nach Punkt 49 oder 50, dadurch gekennzeichnet, dass die Steuervorrichtung (4) über den Datenkommunikationsbus (9) an das übergeordnete Steuerungs- bzw. Rechnersystem (12) ein Öffnen des temperaturgesteuerten Unterbrechungselements (5710, 5740) meldet, wenn der Parameter kleiner als ein vorgegebener erster Schwellwert ist, ohne dass die Steuervorrichtung (4) den Leistungsschalter (17) zur Überführung von dessen Einschaltzustand in dessen Ausschaltzustand angesteuert hat, oder wenn der von der Steuervorrichtung (4) erfasste Spannungsabfall übe dem Unterbrechungselement (5710, 5740) einen vorgebbaren zweiten Schwellwert überschreitet.

53. Elektronischen Sicherung (1) eines Fahrzeugs, mit

- einem ersten Gehäuseanschluss (18),
- einem zweiten Gehäuseanschluss (19),
- einem Leistungsschalter (17),
- einer Steuervorrichtung (4),
- wobei der Leistungsschalter (17) einen ersten Anschluss (26), einen Steueranschluss (27) und einen zweiten Anschluss (28) aufweist,
- wobei der erste Anschluss (26) des Leistungsschalters (17) mit dem ersten Anschluss (18) der Sicherung (1) elektrisch verbunden ist,
- wobei der zweite Anschluss (28) des Leistungsschalters (17) mit dem zweiten Anschluss (19) der Sicherung (1) elektrisch verbunden ist,
- wobei der Steueranschluss (27) des Leistungsschalters (17) mit der Steuervorrichtung (4) elektrisch verbunden ist,
- wobei die Steuervorrichtung (4) der elektronischen Sicherung (1) dazu eingerichtet ist, Spannungen zwischen den Anschlüssen (26, 27, 28) des Leistungsschalters und/oder funktionsäquivalenter Werte physikalischer Parameter zu erfassen und daraus einen Wert für einen elektrischen Strom (29) durch den Leistungsschalter (17) zwischen dem ersten Anschluss (26) des Leistungsschalters (17) und dem zweiten Anschluss (28) des Leistungsschalters (28) zu ermitteln,
- wobei die Steuervorrichtung der elektronischen Sicherung eine oder mehrere Temperatursensorauswertevorrichtungen (585) umfasst,
- wobei die elektronische Sicherung einen Temperatursensor (586) umfasst,
- wobei die Steuervorrichtung (4) dazu eingerichtet ist, Temperaturmesswerte der einen oder der mehreren Temperatursensorauswertevorrichtungen (585) auszuwerten, die diese mit Hilfe von zur elektronischen Steuervorrichtung (4) externen Temperatursensoren und/oder mit Hilfe von Temperatursensoren (586) der elektronischen Sicherung (1) erfassen,
- wobei die Steuervorrichtung (4) dazu eingerichtet ist, den Leistungsschalter (17) zu öffnen, wenn der Temperaturmesswert einen Temperaturgrenzwert, überschreitet, und
- wobei die Steuervorrichtung (4) dazu eingerichtet ist, einem übergeordneten Rechnersystem (12) eine Temperaturüberschreitung über einen Datenbus (9) zu signalisieren, wenn der Temperaturmesswert einen Temperaturgrenzwert, überschreitet.

54. Elektronische Sicherung (1) mit

- einem Gehäuse,
- einem ersten Gehäuseanschluss (18) und einem zweiten Gehäuseanschluss (19),
- einem Leistungsschalter (17) mit einem ersten Anschluss (26) des Leistungsschalters (17) und mit einem zweiten Anschluss (28) des Leistungsschalters (17),
- wobei der Leistungsschalter (17) mit seinem ersten Anschluss (26) mit dem ersten Gehäuseanschluss (18) der elektronischen Sicherung (1) elektrisch verbunden ist,
- wobei der Leistungsschalter (17) mit seinem zweiten Anschluss (28) mit dem zweiten Gehäuseanschluss (19) der elektronischen Sicherung (1) elektrisch verbunden ist,
- wobei eine thermische Absicherung (5710, 5740) in dem Strompfad zwischen dem ersten Gehäuseanschluss (18) und dem zweiten Gehäuseanschluss (19) in Reihe mit dem Leistungsschalter (17) angeordnet ist und
- wobei die thermische Absicherung (5710, 5740) den besagten Strompfad unterbricht, wenn die Temperatur des Leistungsschalters (17) und/oder die Temperatur innerhalb des Gehäuses (535) der Sicherung (1) und/oder die Temperatur des Gehäuses (535) der Sicherung (1) eine Abschalttemperatur überschreitet.

55. Elektronische Sicherung (1) nach Punkt 54, dadurch gekennzeichnet, dass die Absicherung eine Temperatursicherung (5740) ist.

56. Elektronische Sicherung (1) nach Punkt 54, dadurch gekennzeichnet, dass die Absicherung ein Temperaturschalter (5710) ist.

57. Elektronische Sicherung (1) nach einem der Punkte 54 bis 56, dadurch gekennzeichnet, dass die Sicherung einen Temperaturwirkpfad (5720) zwischen dem Leistungsschalter (17) und der Absicherung (5710, 5740) aufweist, sodass die Temperatur des Leistungsschalters (17) einen Schaltzustand der Absicherung (5710, 5740) ändern kann, sodass eine Übertemperatur zum Abschalten durch die Absicherung (5710, 5740) führt.

58. Elektronische Sicherung (1) nach einem der Punkte 54 bis 57, dadurch gekennzeichnet, dass die Sicherung (1) eine Steuervorrichtung (4) umfasst und wobei die Steuervorrichtung (4) den Schaltzustand der Absicherung (5710, 5740) erfasst.

59. Elektronische Sicherung (1) nach Punkt 58, dadurch gekennzeichnet, dass die Steuervorrichtung (4) einen erfassten Zustand der Absicherung (5710, 5740) und/oder aus diesen Daten abgeleitete Daten, insbesondere Alarmierungen, an ein übergeordnetes Rechnersystem (12) und/oder den Server (710) eines Dienstleistungsanbieters und/oder den Server /710) eines Automobilherstellers oder dergleichen oder an ein Terminal (740) eines Nutzers (730) und/oder an ein Terminal (740) der Feuerwehr oder einen Server (710) die Feuerwehr oder ähnlicher Rettungskräfte über einen Datenbus eines Fahrzeug-Versorgungsnetzwerks (200), das die elektronische Sicherung (1) aufweist, signalisiert, wobei gegebenenfalls diese Signalisierung von eventuell vorhandenen anderen Rechnern im Signalisierungspfad modifiziert werden kann.

60. Elektronische Sicherung (1) nach Punkt 59, dadurch gekennzeichnet, dass

- ein Rechnerkern (2) der Steuervorrichtung (4) einer Sicherung (1) im Versorgungsnetzwerk (200) und/oder ein übergeordnetes Rechnersystem (12) im Versorgungsnetzwerk (200) und/oder ein anderer Rechner in dem besagten Fahrzeug mittels eines Positionserfassungssystems, beispielsweise mittels eines GPS-Sensors, und/oder einer anderen im Versorgungsnetzwerk vorhandenen Information die Position des Versorgungsnetzwerks bzw. des Fahrzeugs ermitteln können und
- dieser Rechnerkern (2) der Steuervorrichtung (4) jener Sicherung (1) im Versorgungsnetzwerk (200) und/oder das übergeordnete Rechnersystem (12) im Versorgungsnetzwerk (200) und/oder der erwähnte andere Rechner in dem besagten Fahrzeug diese Positionsinformation an das übergeordnete Rechnersystem (12) und/oder den Server (710) eines Dienstleistungsanbieters und/oder den Server /710) des Automobilherstellers oder dergleichen oder an das Terminal (740) des Nutzers (730) und/oder an das Terminal (740) der Feuerwehr oder den Server (710) die Feuerwehr oder ähnlicher Rettungskräfte entsprechend Anspruch 6 signalisiert.

61. Elektronische Sicherung für ein Fahrzeug mit

- mindestens einem elektronischen Leistungsschalter (17) zur Anordnung in einer direkt oder indirekt zu einem elektrischen Verbraucher des Fahrzeugs führenden Versorgungsleitung eines Versorgungsleitungsnetzwerks des Fahrzeugs oder als Teil eines Verbrauchers und/oder einer Energiequelle des Fahrzeugs,
- wobei der Leistungsschalter (17) in der Versorgungsleitung zwischen einem energiequellenseitigen Anschluss (18) und einem verbraucherseitigen Anschluss (19) geschaltet ist,
- einer einen Rechnerkern wie z.B. eine CPU aufweisenden Steuervorrichtung (4) zur Ansteuerung des mindestens einen Leistungsschalters (17) zwecks wahlweisen Ein- und Ausschaltens des mindestens einen Leistungsschalters (17),
- mindestens einer Messvorrichtung (24) zur Erfassung eines Betriebsparameters des Leistungsschalters (17) und/oder einer elektrischen Verbindung, in der der Leistungsschalter (17) angeordnet ist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,
- wobei die Steuervorrichtung (4) in Abhängigkeit von der Größe des Betriebsparameters und/oder in Abhängigkeit von dem Grad der Veränderung des Betriebsparameters über der Zeit oder in Abhängigkeit von dem Grad einer höheren mathematischen zeitlichen Ableitung des Betriebsparameters als der ersten Ableitung den mindestens einen Leistungsschalter (17) zur Überführung aus seinem Einschaltzustand in seinen Ausschaltzustand ansteuert,
- mindestens einer mit der Steuervorrichtung (4) gekoppelten Datenschnittstelle (550) zur Datenkommunikation mit einem übergeordneten Steuerungs- bzw. Rechnersystem (12) zur Übertragung von Messdaten an das übergeordnete Steuerungs- bzw. Rechnersystem (12) und/oder zum Empfang von Steuerdaten für die Steuervorrichtung (4) zur Ansteuerung des mindestens einen Leistungsschalters (17),
- einem elektronischen Bypass-Schalter (17'), der parallel zu dem mindestens einen Leistungsschalter (17) zwischen dem ausgangsseitigen Anschluss (19) und dem energiequellenseitigen Anschluss (18) liegt, und von der Steuervorrichtung (4) zum Ein- und Ausschalten ansteuerbar ist,
- wobei die Steuervorrichtung (4) den Bypass-Schalter (17') ausgeschaltet hält, so lange der mindestens eine Leistungsschalter (17) oder zumindest einer der Leistungsschalter (17) eingeschaltet ist, und
- wobei der Bypass-Schalter (17') durch die Steuervorrichtung (4) einschaltbar ist, wenn der mindestens eine Leistungsschalter (17) ausgeschaltet ist oder sämtliche Leistungsschalter (17) ausgeschaltet sind und/oder
- einem elektronischen Stromableitschalter (615), der zwischen einer Stromsenke (201), wie z.B. Masse, und dem verbraucherseitigen Anschluss (19) angeordnet und von der Steuervorrichtung (4) zum Ein- und Ausschalten ansteuerbar ist,

- wobei die Steuervorrichtung (4) den Stromableitschalter (615) bei eingeschaltetem Leistungsschalter (17) ausschaltet und den Stromableitschalter (615) einschaltet und den Leistungsschalter (17) ausschaltet, wenn durch die Messvorrichtung (24) ein von dem verbraucherseitigen Anschluss (19) zu dem eingangsseitigen Anschluss (18) fließender Strom erfasst und/oder eine Spannung über dem Leistungsschalter (17) mit einem Potential an dem ausgangsseitigen Anschluss (19), das höher ist als das Potential am eingangsseitigen Anschluss (18), erfasst wird.

62. Elektronische Sicherung nach Punkt 61, dadurch gekennzeichnet, dass der Steuervorrichtung (4) über ihre Datenschnittstelle (550) Ansteuerdaten zum Ein- und Ausschalten des Bypass-Schalters (17') zuleitbar sind.

Bezugszeichenliste

| | |
|---|---|
| 1 | elektronische Sicherung; |
| 2 | Rechnerkern, insbesondere Mikro-Controller; |
| 3 | Steuersystem; |
| 4 | Steuervorrichtung; |
| 5 | Spannungsversorgung / Boost-Konverter; |
| 6 | Betriebsspannung; |
| 7 | Notenergieversorgung; |
| 8 | Energiereserve; |
| 9 | externer Datenbus; |
| 9' | externer Datenbusring; |
| 10 | Datenbusschnittstelle. Die Datenbusschnittstelle kann ein Datenbus-Transceiver zu einem drahtgebundenen Datenbus oder eine drahtlose Datenschnittstelle, insbesondere eine optische Datenschnittstelle zu einer optischen Datenverbindung, sein. |
| 11 | interner Datenbus |
| 12 | übergeordnetes Rechnersystem, insbesondere des Fahrzeugs. Das übergeordnete Rechnersystem kann mit einer Steuervorrichtung (4) einer Sicherung der Sicherungen eines Versorgungsnetzwerks identisch sein; |
| 13 | Watch-Dog, insbesondere Watchdog-Zeitgeber (Englisch: Watchdog-Timer). Es kann sich um den Watchdog 4104.5 des Quantenzufallszahlengenerators 60, 4100 handeln; |
| 14 | nicht flüchtiger Speicher. Der nichtflüchtige Speicher kann z.B. einen Flash-Speicher oder ein EEPROM oder ein Rom oder dergleichen umfassen. |
| 15 | flüchtiger Schreib-Lese-Speicher. Bei dem Schreiblesespeicher kann es sich beispielsweise um ein RAM oder ein SRAM oder ein DRAM oder ein FRAM oder ein MRAM oder dergleichen handeln; |
| 16 | Gate-Ansteuerschaltung für die Ansteuerung und Überwachung des Leistungsschalters (17); |
| 16' | Gate-Ansteuerschaltung für die Ansteuerung und Überwachung des zweiten Leistungsschalters (17'); |
| 16" | Gate-Ansteuerschaltung für die Ansteuerung und Überwachung des dritten Leistungsschalters (17"); |
| 16‴ | Gate-Ansteuerschaltung für die Ansteuerung und Überwachung des vierten Leistungsschalters (17‴); |
| 17 | Leistungsschalter, auch als Leistungsschalter bezeichnet; |
| 17' | zweiter Leistungsschalter; |
| 17" | dritter Leistungsschalter; |
| 17‴ | vierter Leistungsschalter; |
| 18 | erster Anschluss des Leistungsschalters (17); |
| 18' | erster Anschluss des zweiten Leistungsschalters (17'); |
| 18" | erster Anschluss des dritten Leistungsschalters (17"); |
| 18‴ | erster Anschluss des vierten Leistungsschalters (17‴); |
| 19 | zweiter Anschluss des Leistungsschalters (17); |
| 19' | zweiter Anschluss des zweiten Leistungsschalters (17'); |
| 19" | zweiter Anschluss des dritten Leistungsschalters (17"); |
| 19‴ | zweiter Anschluss des vierten Leistungsschalters (17‴); |
| 20 | Steuerleitung zur Steuerung des Leistungsschalters (17); |

| 20' | Steuerleitung zur Steuerung des zweiten Leistungsschalters (17'); |
|---|---|
| 20" | Steuerleitung zur Steuerung des dritten Leistungsschalters (17"); |
| 20‴ | Steuerleitung zur Steuerung des vierten Leistungsschalters (17‴); |
| 21 | Überwachungsleitung zur Erfassung der Spannung zwischen dem zweiten Anschluss (19) des Leistungsschalters (17) und der Steuerleitung (20) des Leistungsschalters (17); |
| 21' | Überwachungsleitung zur Erfassung der Spannung zwischen dem zweiten Anschluss (19') des zweiten Leistungsschalters (17') und der Steuerleitung (20') des zweiten Leistungsschalters (17'); |
| 21" | Überwachungsleitung zur Erfassung der Spannung zwischen dem zweiten Anschluss (19") des dritten Leistungsschalters (17") und der Steuerleitung (20") des dritten Leistungsschalters (17"); |
| 21‴ | Überwachungsleitung zur Erfassung der Spannung zwischen dem zweiten Anschluss (19‴) des vierten Leistungsschalters (17‴) und der Steuerleitung (20‴) des vierten Leistungsschalters (17‴); |
| 22 | Überwachungsleitung zur Erfassung der Spannung zwischen dem ersten Anschluss (18) des Leistungsschalters (17) und der Steuerleitung (20) des zweiten Leistungsschalters (17); |
| 22' | Überwachungsleitung zur Erfassung der Spannung zwischen dem ersten Anschluss (18') des zweiten Leistungsschalters (17') und der Steuerleitung (20') des zweiten Leistungsschalters (17'); |
| 22" | Überwachungsleitung zur Erfassung der Spannung zwischen dem ersten Anschluss (18") des dritten Leistungsschalters (17") und der Steuerleitung (20") des dritten Leistungsschalters (17‴); |
| 22‴ | Überwachungsleitung zur Erfassung der Spannung zwischen dem ersten Anschluss (18‴) des vierten Leistungsschalters (17‴) und der Steuerleitung (20‴) des vierten Leistungsschalters (17‴); |
| 23 | Hilfsleistungsschalter zur Erfassung eines Stromes, der dem Strom (29) durch den Leistungsschalter (17) proportional ist oder auf andere Weise entspricht; |
| 23' | zweiter Hilfsleistungsschalter zur Erfassung eines Stromes, der dem Strom (29') durch den zweiten Leistungsschalter (17') proportional ist oder auf andere Weise entspricht; |
| 23" | dritter Hilfsleistungsschalter zur Erfassung eines Stromes, der dem Strom (29") durch den dritten Leistungsschalter (17") proportional ist oder auf andere Weise entspricht; |
| 23‴ | vierter Hilfsleistungsschalter zur Erfassung eines Stromes, der dem Strom (29‴) durch den vierten Leistungsschalter (17‴) proportional ist oder auf andere Weise entspricht; |
| 24 | Shunt-Widerstand zur Erfassung des Stromes durch den Hilfsleistungsschalter 23; |
| 24' | zweiter Shunt-Widerstand zur Erfassung des Stromes durch den zweiten Hilfsleistungsschalter 23' des zweiten Leistungsschalters 17'; |
| 24" | dritter Shunt-Widerstand zur Erfassung des Stromes durch den dritten Hilfsleistungsschalter 23" des dritten Leistungsschalters 17"; |
| 24‴ | vierter Shunt-Widerstand zur Erfassung des Stromes durch den vierten Hilfsleistungsschalter 23‴ des vierten Leistungsschalters 17‴; |
| 25 | Messleitung zur Erfassung des Spannungsabfalls über den Shunt-Widerstand 24; |
| 25' | zweite Messleitung zur Erfassung des Spannungsabfalls über den zweiten Shunt-Widerstand 24'; |
| 25" | dritte Messleitung zur Erfassung des Spannungsabfalls über den dritten Shunt-Widerstand 24"; |
| 25‴ | vierte Messleitung zur Erfassung des Spannungsabfalls über den vierten Shunt-Widerstand 24‴; |
| 26 | erster Anschuss des Leistungsschalters 17; |
| 26' | erster Anschuss des zweiten Leistungsschalters 17'; |
| 26" | erster Anschuss des dritten Leistungsschalters 17"; |
| 26‴ | erster Anschuss des vierten Leistungsschalters 17‴; |
| 27 | Steueranschluss des Leistungsschalters 17; |
| 27' | Steueranschluss des zweiten Leistungsschalters 17'; |
| 27" | Steueranschluss des zweiten Leistungsschalters 17"; |
| 27‴ | Steueranschluss des zweiten Leistungsschalters 17‴; |
| 28 | zweiter Anschluss des Leistungsschalters 17; |
| 28' | zweiter Anschluss des zweiten Leistungsschalters 17'; |
| 28" | zweiter Anschluss des dritten Leistungsschalters 17"; |
| 28‴ | zweiter Anschluss des vierten Leistungsschalters 17‴; |
| 29 | Strom durch den Leistungsschalter 17; |
| 29' | Strom durch den zweiten Leistungsschalter 17'; |
| 29" | Strom durch den dritten Leistungsschalter 17"; |
| 29‴ | Strom durch den vierten Leistungsschalter 17‴; |
| 30 | Oszillator und Takterzeugung, die die Steuervorrichtung (4) der betreffenden Sicherung mit einem Takt versorgt; |
| 35 | Zeitgeber und/oder Uhr der Steuervorrichtung (4); |
| 36 | elektrischer Strom durch den Shunt-Widerstand (24); |

| | |
|---|---|
| 36' | elektrischer Strom durch den zweiten Shunt-Widerstand 24' zur Erfassung des Stromes durch den zweiten Hilfsleistungsschalter 23' des zweiten Leistungsschalters 17'; |
| 36''' | elektrischer Strom durch den dritten Shunt-Widerstand 24" zur Erfassung des Stromes durch den dritten Hilfsleistungsschalter 23" des dritten Leistungsschalters 17"; |
| 36'''' | elektrischer Strom durch den vierten Shunt-Widerstand 24''' zur Erfassung des Stromes durch den vierten Hilfsleistungsschalter 23''' des vierten Leistungsschalters 17'''; |
| 40 | Temperatorsensor; |
| 50 | System aus elektronischer Sicherung (1), Datenbus (9) und übergeordnetem Rechnersystem (12) |
| 60 | Quantenzufallszahlengenerator (QRNG=quantum random number generator) oder echter Zufallszahlengenerator (TRNG=true random nuber generator) oder Zufallszahlengenerator (RNG=random number generator) oder Pseudozufallszahlengenerator (PRNG= pseudo random number generator) |
| 70 | ein oder mehrere Kryptografie-Beschleuniger 7, beispielsweise einen DES-Beschleuniger und/oder einen AES-Beschleuniger 7; |
| 71 | ein oder mehrere Hersteller-Speicher-Firewalls 8; |
| 72 | Herstellerspeicher; |
| 73 | Zulieferer -Speicher-Firewalls; |
| 74 | Zulieferer -Herstellerspeicher |
| 75 | Halbleiterhersteller -Speicher-Firewalls; |
| 76 | Halbeiterhersteller -Herstellerspeicher |
| 77 | ein oder mehrere CRC-Module (Cyclic Redundancy Check); |
| 78 | ein oder mehrere Zeitgeber-Module; |
| 79 | eine oder mehrere Sicherheitsüberwachungsschaltungen und Sicherheitssteuerungsschaltungen; |
| 80 | ein oder mehrere Rücksetzschaltungen; |
| 81 | ein oder mehrere Masseschaltungen; |
| 82 | ein oder mehrere Eingangs-/Ausgangsschaltungen; |
| 200 | Versorgungsnetzwerk; |
| 201 | Bezugspotenzialknoten. Der Bezugspotenzialknoten ist typischerweise die Masse des Fahrzeugs. In den Figuren ist der Bezugspotenzialknoten zur besseren Übersichtlichkeit nicht immer eingezeichnet und auch nicht immer mit dem Bezugszeichen bezeichnet. Das Schaltsymbol für die Masse bezeichnet den Bezugspotenzialknoten in den Figuren, wenn eingezeichnet. |
| 210 | erster Vorrichtungsteil des Versorgungsnetzwerks (200); |
| 211 | zweiter Vorrichtungsteil des Versorgungsnetzwerks (200); |
| 212 | dritter Vorrichtungsteil des Versorgungsnetzwerks (200); |
| 213 | vierter Vorrichtungsteil des Versorgungsnetzwerks (200); |
| 214 | erste Sicherung des ersten Vorrichtungsteils (210) des Versorgungsnetzwerks (200) die den dritten Leitungsabschnitt (245) mit dem ersten Leitungsabschnitt (240) elektrisch verbinden kann oder den dritten Leitungsabschnitt (245) von dem ersten Leitungsabschnitt (240) lokal trennen kann; |
| 215 | zweite Sicherung des zweiten Vorrichtungsteils (211) des Versorgungsnetzwerks (200) die den dritten Leitungsabschnitt (245) mit dem ersten Leitungsabschnitt (240) elektrisch verbinden kann oder den dritten Leitungsabschnitt (245) von dem ersten Leitungsabschnitt (240) lokal trennen kann; |
| 216 | dritte Sicherung des dritten Vorrichtungsteils (212) des Versorgungsnetzwerks (200) die den dritten Leitungsabschnitt (245) mit dem zweiten Leitungsabschnitt (241) elektrisch verbinden kann oder den dritten Leitungsabschnitt (245) von dem ersten Leitungsabschnitt (240) lokal trennen kann; |
| 217 | vierte Sicherung des vierten Vorrichtungsteils (213) des Versorgungsnetzwerks (200) die den dritten Leitungsabschnitt (245) mit dem zweiten Leitungsabschnitt (241) elektrisch verbinden kann oder den dritten Leitungsabschnitt (245) von dem ersten Leitungsabschnitt (240) lokal trennen kann; |
| 220 | fünfter Vorrichtungsteil des Versorgungsnetzwerks (200); |
| 221 | sechster Vorrichtungsteil des Versorgungsnetzwerks (200); |
| 222 | siebter Vorrichtungsteil des Versorgungsnetzwerks (200); |
| 223 | achter Vorrichtungsteil des Versorgungsnetzwerks (200); |
| 225 | fünfte Sicherung, die den fünften Vorrichtungsteil (220) des Versorgungsnetzwerks (200) vom ersten Leitungsabschnitt (240) trennen kann oder den fünften Vorrichtungsteil (220) des Versorgungsnetzwerks (200) mit dem ersten Leitungsabschnitt (240) verbinden kann; |
| 226 | sechste Sicherung, die den sechsten Vorrichtungsteil (221) des Versorgungsnetzwerks (200) vom ersten Leitungsabschnitt (240) trennen kann oder den sechsten Vorrichtungsteil (222) des Versorgungsnetzwerks (200) mit dem ersten Leitungsabschnitt (240) verbinden kann; |
| 227 | siebte Sicherung, die den siebten Vorrichtungsteil (222) des Versorgungsnetzwerks (200) vom ersten Leitungsabschnitt (240) trennen kann oder den siebten Vorrichtungsteil (223) des Versorgungs- |

netzwerks (200) mit dem ersten Leitungsabschnitt (240) verbinden kann;

228 achte Sicherung, die den achten Vorrichtungsteil (223) des Versorgungsnetzwerks (200) vom ersten Leitungsabschnitt (240) trennen kann oder den achten Vorrichtungsteil (224) des Versorgungsnetzwerks (200) mit dem ersten Leitungsabschnitt (240) verbinden kann;

230 neunter Vorrichtungsteil des Versorgungsnetzwerks (200);

231 zehnter Vorrichtungsteil des Versorgungsnetzwerks (200);

232 elfter Vorrichtungsteil des Versorgungsnetzwerks (200);

233 zwölfter Vorrichtungsteil des Versorgungsnetzwerks (200);

235 neunte Sicherung, die den neunten Vorrichtungsteil (230) des Versorgungsnetzwerks (200) vom zweiten Leitungsabschnitt (241) trennen kann oder den neunten Vorrichtungsteil (230) des Versorgungsnetzwerks (200) mit dem zweiten Leitungsabschnitt (241) verbinden kann;

236 zehnte Sicherung, die den zehnten Vorrichtungsteil (231) des Versorgungsnetzwerks (200) vom zweiten Leitungsabschnitt (241) trennen kann oder den zehnten Vorrichtungsteil (231) des Versorgungsnetzwerks (200) mit dem zweiten Leitungsabschnitt (241) verbinden kann;

237 elfte Sicherung, die den elften Vorrichtungsteil (232) des Versorgungsnetzwerks (200) vom zweiten Leitungsabschnitt (241) trennen kann oder den elften Vorrichtungsteil (232) des Versorgungsnetzwerks (200) mit dem zweiten Leitungsabschnitt (241) verbinden kann;

238 zwölfte Sicherung, die den zwölften Vorrichtungsteil (233) des Versorgungsnetzwerks (200) vom zweiten Leitungsabschnitt (241) trennen kann oder den zwölften Vorrichtungsteil (233) des Versorgungsnetzwerks (200) mit dem zweiten Leitungsabschnitt (241) verbinden kann;

240 erster Leitungsabschnitt;

241 zweiter Leitungsabschnitt;

242 fünfter Leitungsabschnitt;

243 sechster Leitungsabschnitt;

245 dritter Leitungsabschnitt

246 vierter Leitungsabschnitt

250 erste Energiequelle;

251 zweite Energiequelle;

255 dreizehnte Sicherung, die die erste Energiequelle (255) des Versorgungsnetzwerks (200) vom dritten Leitungsabschnitt (245) trennen kann oder die erste Energiequelle (255) des Versorgungsnetzwerks (200) mit dem dritten Leitungsabschnitt (245) verbinden kann;

256 vierzehnte Sicherung, die die zweite Energiequelle (256) des Versorgungsnetzwerks (200) vom dritten Leitungsabschnitt (245) trennen kann oder die zweite Energiequelle (256) des Versorgungsnetzwerks (200) mit dem dritten Leitungsabschnitt (245) bzw. vierten Leitungsabschnitt (246) verbinden kann;

262 Steckmöglichkeit (262) für eine elektronische Sicherung (216) eines Vorrichtungsteils (212)

270 Baumausgangspunkt der Baumstruktur des Versorgungsnetzwerkes (200);

280 erste Steuervorrichtung 4 der ersten Sicherung (214);

281 zweite Steuervorrichtung 4 der zweiten Sicherung (215);

282 dritte Steuervorrichtung 4 der dritten Sicherung (216);

283 vierte Steuervorrichtung 4 der vierten Sicherung (217);

284 fünfte Steuervorrichtung 4 der fünften Sicherung (220);

285 sechste Steuervorrichtung 4 der sechsten Sicherung (221);

286 siebte Steuervorrichtung 4 der siebten Sicherung (222);

287 achte Steuervorrichtung 4 der achten Sicherung (223);

288 neunte Steuervorrichtung 4 der neunten Sicherung (230);

289 zehnte Steuervorrichtung 4 der zehnten Sicherung (231);

290 elfte Steuervorrichtung 4 der elften Sicherung (232);

291 zwölfte Steuervorrichtung 4 der zwölften Sicherung (233);

292 dreizehnte Steuervorrichtung 4 der dreizehnten Sicherung (255);

293 vierzehnte Steuervorrichtung 4 der vierzehnten Sicherung (256);

400 Sicherungsbox;

405 elektronische Sicherung

410 Steckplatz für eine elektronische Sicherung (405) Der Steckplatz weist einen ersten Kontakt für den ersten Anschluss (18) des Leistungsschalters (17) der elektronischen Sicherung (405) auf. Der Steckplatz weist einen zweiten Kontakt für den Betriebsspannungsanschluss (6) der elektronischen Sicherung (405) auf. Der Steckplatz weist einen dritten Kontakt für den Bezugspotenzialanschluss (201) der elektronischen Sicherung (405) auf. Der Steckplatz weist einen vierten Kontakt für den externen Datenbus (9) der elektronischen Sicherung (405) auf. Der Steckplatz weist einen fünften Kontakt für den zweiten Anschluss (19) des Leistungsschalters (17) der elektronischen Sicherung (405) auf.

| | |
|---|---|
| 415 | Schmelzsicherung; |
| 420 | Steckplatz für eine Schmelzsicherung (415); |
| 425 | Sicherungskörper der elektronischen Sicherung (415); |
| 430 | erster Kontakt (430) des Steckplatzes (410) für eine elektronische Sicherung (405), wobei der erste Kontakt dem Anschluss des ersten Anschlusses (18) einer elektronischen Sicherung (405) dient; |
| 435 | vierter Kontakt (435) des Steckplatzes (410) für eine elektronische Sicherung (405), wobei der vierte Kontakt dem Anschluss einer Versorgungsspannungsleitung zur Energieversorgung der Steuervorrichtung (4) der elektronischen Sicherung (405) dient; |
| 440 | dritter Kontakt (440) des Steckplatzes (410) für eine elektronische Sicherung (405), wobei der dritte Kontakt dem Anschluss der Datenleitung (9) einer Datenschnittstelle (10) der Steuerungsschaltung (4) der elektronischen Sicherung (405) dient; |
| 445 | vierter Kontakt (445) des Steckplatzes (410) für eine elektronische Sicherung (405), wobei der zweite Kontakt dem Anschluss des zweiten Anschlusses (19) einer elektronischen Sicherung (405) dient; |
| 450 | erster Kontakt des Steckverbinders des Sicherungskörpers (425) der elektronischen Sicherung (405), wobei der erste Kontakt dem Anschluss des ersten Anschlusses (18) einer elektronischen Sicherung (405) dient; |
| 455 | vierten Kontakt (455) des Steckverbinders des Sicherungskörpers (425), wobei der vierte Kontakt dem Anschluss einer Versorgungsspannungsleitung (6) dient, um eine Energieversorgung der Steuervorrichtung (4) der elektronischen Sicherung (405) mit diesem vierten Kontakt (455) des Steckplatzes (410) elektrisch zu verbinden |
| 460 | fünfter Kontakt (460) des Steckverbinders des Sicherungskörpers (425), wobei der fünfte Kontakt dem Anschluss einer Bezugspotenzialleitung (201) dient, um eine Energieversorgung der Steuervorrichtung (4) der elektronischen Sicherung (405) mit diesem fünften Kontakt (460) des Steckplatzes (410) elektrisch zu verbinden und ein Referenzpotenzial zur Verfügung zu stellen; |
| 470 | zweiten Kontakt (470) des Steckverbinders (410) des Sicherungskörpers (425), wobei der zweite Kontakt dem Anschluss des zweiten Anschlusses (19) einer elektronischen Sicherung (405) dient; |
| 475 | fünfter Kontakt (475) des Steckplatzes (410) für eine elektronische Sicherung (405), wobei der fünfte Kontakt dem Anschluss einer Bezugspotenzialleitung zur Energieversorgung der Steuervorrichtung (4) der elektronischen Sicherung (405) und als Potenzialreferenzpunkt dient; |
| 475 | Steuerrechner, der über den Sicherungsbus (9) die Sicherungsbox (400) und/oder die elektronischen Sicherungen (405) steuert und/oder Messwerte und/oder Daten aus den Sicherungen (405) ausliest; |
| 480 | Betriebsspannungsquelle für den Betrieb der Steuervorrichtungen (4) der elektronischen Sicherungen (405); |
| 485 | Ausgang der Sicherungsbox (400) zur Versorgung eines Verbrauchers; |
| 505 | erste Teststromquelle, die mittels des ersten Steuersignals (510) mit einem ersten Modulationssignal {505} eines ersten Signalgenerators (520) versehen wird. Hierbei sollen die geschweiften Klammern signalisieren, dass es sich um bei {505} das erste Modulationssignal handelt, mit dem der erste Strom (515) der ersten Teststromquelle moduliert ist. |
| {505} | erstes Modulationssignal, mit dem der erste Strom (515) der ersten Teststromquelle (505) moduliert ist |
| 505' | dritte Teststromquelle, die mittels des zweiten Steuersignals (510') mit einem zweiten Modulationssignal {505'} eines zweiten Signalgenerators (520') versehen wird. Hierbei sollen die geschweiften Klammern signalisieren, dass es sich bei {505'} um das zweite Modulationssignal, handelt mit dem der Strom (515) der dritten Teststromquelle moduliert ist. Bevorzugt ist das zweite Modulationssignal {505'} orthogonal zum ersten Modulationssignal {505} bezüglich des Skalarprodukts |

$$\langle\{505\}|\{505'\}\rangle = \int_0^T \{505\} \times \{505'\} dt$$

, wobei T die Periode des ersten Modulationssignals {505} oder des zweiten Modulationssignals {505'} ist. Bevorzugt ist die Periode T des ersten Modulationssignals {505} gleich der Periode T des zweiten Modulationssignals {505'}. Dies ermöglicht die Trennung der beiden Modulationssignale ({505}, {505'}). Bevorzugt gilt also beispielsweise

$$\langle\{505\}|\{505'\}\rangle = \int_0^T \{505\} \times \{505'\} dt = 0$$

, was Orthogonalität bedeutet.

| | |
|---|---|
| {505'} | zweites Modulationssignal handelt, mit dem der zweite Strom (515') der dritten Teststromquelle (505) moduliert ist |

| | |
|---|---|
| 510 | erstes Steuersignal der ersten elektronischen Teststromquelle (505); |
| 510' | drittes Steuersignal der dritten elektronischen Teststromquelle (505'); |
| 515 | erster zusätzlicher Strom, den die erste Teststromquelle (510) in den Leistungsschalter (17) einspeist; |
| 515' | zweiter zusätzlicher Strom, den die Teststromquelle (510) in den Leistungsschalter (17) einspeist; |
| 520 | erster Signalgenerator des ersten Modulationssignals {505}; |
| 520' | zweiter Signalgenerator des zweiten Modulationssignals {505'}; |
| 525 | erster Korrelator. Der erste Korrelator umfasst bevorzugt einen oder mehrere Eingangsverstärker, die die Spannungen zwischen den ersten Messkontakten (21, 25,27, 28, 22) erfassen, filtern und aufbereiten. Bevorzugt umfasst der erste Korrelator beispielsweise einen ersten Synchrondemodulator, der eine der messbaren Spannungen auf erste Anteile des ersten Modulationssignals {505} des ersten Stroms (515) der ersten Teststromquelle (505) untersucht. Bevorzugt nutzt dabei der erste Synchrondemodulator des ersten Korrelators eine Korrelation in Form eines Skalarprodukts, beispielsweise gemäß der Form $A = \langle \{505\} | V_{xy}(t) \rangle = \int_0^T \{505\} \times V_{xy}(t) dt$ Hierbei stehen A für den Wert des ersten Anteils und $V_{xy}$ für eine Spannung zwischen den ersten Messkontakten (21, 25, 27, 28, 22). Bevorzugt verwendet der erste Korrelator eine Spannung $V_{xy}$ zwischen dem zweiten Anschluss (28) des ersten Leistungsschalters (17) und dem ersten Steueranschluss (27) des ersten Leistungsschalters (17); |
| 525' | zweiter Korrelator. Der zweiter Korrelator umfasst bevorzugt einen oder mehrere Eingangsverstärker, die die Spannungen zwischen den zweiten Messkontakten (21', 25',27', 28', 22') erfassen, filtern und aufbereiten. Bevorzugt umfasst der zweite Korrelator beispielsweise einen zweiten Synchrondemodulator, der eine der messbaren Spannungen auf zweite Anteile des zweiten Modulationssignals {505'} des zweiten Stroms (515') der dritten Teststromquelle (505') untersucht. Bevorzugt nutzt dabei der zweite Synchrondemodulator des zweiten Korrelators eine Korrelation in Form eines Skalarprodukts, beispielsweise gemäß der Form |

$$A' = \langle \{505'\} | V'_{xy}(t) \rangle = \int_0^T \{505'\} \times V_{xy}(t') dt$$

| | |
|---|---|
| | Hierbei stehen A' für den Wert des zweiten Anteils und $V'_{xy}$ für eine Spannung zwischen den zweiten Messkontakten (21', 25', 27', 28', 22). Bevorzugt verwendet der zweite Korrelator eine Spannung $V_{xy}$ zwischen dem zweiten Anschluss (28') des zweiten Leistungsschalters (17') und dem zweiten Steueranschluss (27') des zweiten Leistungsschalters (17'); |
| 530 | erste Gate-Ansteuerung des Steuerkontakts (27) des ersten Leistungsschalters (17) und erste Steuersignalerzeugung für das Steuersignal der Steuerleitung (20) des ersten Leistungsschalters (17) zur Steuerung des ersten Leistungsschalters (17); |
| 530' | zweite Gate-Ansteuerung des Steuerkontakts (27') des zweiten Leistungsschalters (17') und zweite Steuersignalerzeugung für das Steuersignal der Steuerleitung (20') des zweiten Leistungsschalters (17') zur Steuerung des zweiten Leistungsschalters (17'); |
| 535 | Gehäuse der Sicherung (1); |
| 540 | optische Datenverbindung; |
| 545 | optisches Fenster; |
| 550 | optische Datenschnittstelle; |
| 551 | weitere optische Datenschnittstelle; |
| 555 | optische Datenschnittstelle beispielsweise des übergeordneten Systems, insbesondere des übergeordneten Rechnersystems (12); |
| 556 | erste Datenschnittstelle beispielsweise des übergeordneten Systems, insbesondere des übergeordneten Rechnersystems (12) |
| 556' | zweite Datenschnittstelle beispielsweise des übergeordneten Systems, insbesondere des übergeordneten Rechnersystems (12) |
| 557 | Sensordatenschnittstelle beispielsweise des übergeordneten Systems, insbesondere des übergeordneten Rechnersystems (12) beispielsweise für Sensordaten eines weiteren Sensors 77010, die dieser Sensor 77010 über einen Sensordatenbus 77020 an das übergeordnete Rechnersystem 12 überträgt; |
| 560 | Laser oder eine LED, insbesondere eine siliziumbasierende LED, insbesondere eine Silizium-Lawinen-LED, insbesondere eine als LED betriebene SPAD-Diode; |
| 561 | zweiter Laser oder zweite LED, insbesondere eine siliziumbasierende LED, insbesondere eine Sili- |

| | |
|---|---|
| | zium-Lawinen-LED, insbesondere eine als LED betriebene SPAD-Diode; |
| 565 | Ansteuerungsvorrichtung |
| 570 | Analog-zu-Digital-Wandler; |
| 575 | Spannungssignal (575) der Silizium-LED (560); |
| 576 | Spannungssignal (576) der zweiten Silizium-LED (560); |
| 580 | Lichtwellenleiter; |
| 585 | Temperatursensorauswertevorrichtungen; |
| 586 | Temperatursensor; |
| 610 | zweite Datenbusschnittstelle; |
| 615 | Schalter zum Ableiten zur Energiequelle fließender Ströme des Verbrauchers in eine Stromsenke; |
| 710 | Rechner (Server) eines Dienstanbieters, insbesondere ein Rechnersystem eines Automobilherstellers und somit ggf. auch einer Werkstatt; |
| 720 | vorzugsweise verschlüsselte Datenverbindung zwischen dem Steuerrechner des Fahrzeugs - z. B. einem übergeordneten Rechnersystem 12 -und einem Rechner 710 eines Dienstanbieters, insbesondere einem Rechnersystem des Automobilherstellers des Fahrzeugs; |
| 730 | anfordernde / bedienende Person; |
| 740 | Dateneingabemittel und Datenausgabemittel, insbesondere ein Terminal oder ein PC oder ein Laptop oder ein Tablett oder ein Smartphone etc.; |
| 750 | Rechner (750) eines weiteren Dienstanbieters oder weiterer Rechner des Dienstanbieters, der den Rechner (710) kontrolliert; |
| 805 | weitere Sicherung; |
| 810 | zweite weitere Sicherung; |
| 815 | erster angeschlossener Verteilungsbaum; |
| 820 | zweiter angeschlossener Verteilungsbaum; |
| 825 | elektronische Sicherung; |
| 830 | Verbraucher |
| 835 | weiter Verbraucher; |
| 905 | zweite Teststromquelle, die mittels des Steuersignals (910) mit einem Modulationssignal eines zweiten Signalgenerators (920) versehen wird. |
| 905' | zweite Teststromquelle, die mittels des Steuersignals (910') mit einem Modulationssignal eines zweiten Signalgenerators (920') versehen wird. |
| 910 | zweites Steuersignal der zweiten elektronischen Teststromquelle (905); |
| 910' | viertes Steuersignal der vierten elektronischen Teststromquelle (905'); |
| 915 | zusätzlicher Strom, den die zweite Teststromquelle (910) aus dem Leistungsschalter (17) entnimmt; |
| 915' | zusätzlicher Strom, den die zweite Teststromquelle (910') aus dem zweiten Leistungsschalter (17') entnimmt; |
| 920 | zweiter Signalgenerator des Modulationssignals; |
| 920' | vierter Signalgenerator des Modulationssignals; |
| 925 | Notlaufsteuerung; |
| 1000 | Kreuzsicherung; |
| 1005 | erster Versorgungsleitungsabschnitt einer ersten Versorgungsleitung; |
| 1010 | zweiter Versorgungsleitungsabschnitt einer ersten Versorgungsleitung; |
| 1015 | erster Versorgungsleitungsabschnitt einer zweiten Versorgungsleitung; |
| 1020 | zweiter Versorgungsleitungsabschnitt einer zweiten Versorgungsleitung; |
| 1025 | erster elektrischer Knoten; |
| 1030 | zweiter elektrischer Knoten; |
| 1035 | erste elektronische Sicherung; |
| 1040 | zweite elektronische Sicherung; |
| 1045 | dritte elektronische Sicherung; |
| 1050 | vierte elektronische Sicherung; |
| 1055 | zweiter Versorgungsleitungsabschnitt ersten Versorgungsleitung; |
| 1060 | zweiter Versorgungsleitungsabschnitt zweiten Versorgungsleitung; |
| 1065 | dritter Knoten; |
| 1070 | vierter Knoten; |
| 1110 | erste Kreuzsicherung |
| 1111 | zweite Kreuzsicherung |
| 1112 | dritte Kreuzsicherung |
| 1113 | vierte Kreuzsicherung |

| 1114 | fünfte Kreuzsicherung |
|---|---|
| 1115 | sechste Kreuzsicherung |
| 1116 | siebte Kreuzsicherung |
| 1117 | achte Kreuzsicherung |
| 1118 | neunte Kreuzsicherung |
| 1150 | erste Energiequelle; |
| 1151 | zweite Energiequelle; |
| 1152 | dritte Energiequelle; |
| 1153 | vierte Energiequelle; |
| 1154 | fünfte Energiequelle; |
| 1155 | sechste Energiequelle; |
| 1160 bis | 1183 Versorgungsleitungsabschnitt; |
| 1200 | Verfahren zum Betreiben einer Sicherung; |
| 1210 | Bereitstellen eines Versorgungsnetzwerks (250, 251, 210 bis 213, 245) mit einem energieversorgenden Vorrichtungsteil des Fahrzeugs; |
| 1220 | Versorgen des energieversorgenden Vorrichtungsteils (210) mit elektrischer Energie aus einer Energiequelle (251, 250) des Fahrzeugs; |
| 1230 | Verbinden (1230) eines ersten Anschlusses eines weiteren Leitungsabschnitts (240) mit dem energieversorgenden Vorrichtungsteil (210) des Fahrzeugs; |
| 1240 | Verbinden (1240) eines zweiten Anschlusses des weiteren Leitungsabschnitts (240) mit einem weiteren Vorrichtungsteil (220, 221) des Fahrzeugs; |
| 1250 | Signalisierung eines Einschaltsignals an die Steuervorrichtung (280, 4) des energieversorgenden Vorrichtungsteils (210); |
| 1260 | Ändern des logischen Zustands des Speichers in einen zweiten logischen Zustand in Abhängigkeit von dem logischen Zustand des Speichers; |
| 1270 | Versorgen des Weiteren Vorrichtungsteils (220 bis 221) des Fahrzeugs mit elektrischer Energie über den weiteren Leitungsabschnitt (240) in Abhängigkeit von dem logischen Zustand des Speichers; |
| 1280 | Bereitstellen (1280) eines Versorgungsnetzwerks (200) mit einem Vorrichtungsteil (210) des Fahrzeugs, im Folgenden als energieversorgender Vorrichtungsteil (210) bezeichnet; |
| 1300 | Verfahren zum Betreiben eines Fahrzeugs, zur Bezahlung der Zulässigkeit der Einstellung einer Konfiguration elektronischer Sicherungen; |
| 1305 | Bereitstellen des Fahrzeugs; |
| 1310 | Unterbinden (1310) der Energieversorgung eines zugeordneten elektrischen Verbrauchers mittels der entsprechenden Sicherung, der dieser Verbraucher zugeordnet ist; |
| 1315 | Herstellen (1315) einer verschlüsselten Datenverbindung (720) zwischen dem Steuerrechner (12) des Fahrzeugs, also einem übergeordneten Rechnersystem (12), und einem Rechner (710) eines Dienstanbieters, insbesondere einem Rechnersystem des Automobilherstellers des Fahrzeugs; |
| 1320 | Authentifizierung (1320) des Fahrzeugs durch den Steuerrechner des Fahrzeugs, also einem übergeordneten Rechnersystem (12), beim Rechner (710) des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können; |
| 1325 | Authentifizierung (1325) des Rechners (710) des Dienstanbieters beim Steuerrechner des Fahrzeugs, also einem übergeordneten Rechnersystem (12); |
| 1330 | . Authentifizierung (1330) der anfordernden Person (730) durch den Steuerrechner des Fahrzeugs, also einem übergeordneten Rechnersystem (12), beim Rechner (710) des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen können. |
| 1335 | Erzeugen (1335) oder Bereitstellen eines Freischaltcodes durch den Rechner (710) des Dienstanbieters; |
| 1340 | Übermitteln (1340) des Freischaltcodes durch den Rechner des Dienstanbieters (710) an den Steuerrechner des Fahrzeugs, also an ein übergeordnetes Rechnersystem (12); |
| 1345 | Verifikation (1345) der Zulässigkeit und/oder syntaktischen Korrektheit und/oder der situativen Zulässigkeit des Freischaltcodes durch den Steuerrechner des Fahrzeugs, also durch das übergeordnete Rechnersystem (12); |
| 1350 | Ermöglichen (1350) der Energieversorgung eines zugeordneten elektrischen Verbrauchers (220) |

mittels der entsprechenden Sicherung (225), wenn der Freischaltcode zulässig und/oder syntaktisch korrekt und/oder der situativ zulässig ist;

1355     Übermittlung (1355) von Abrechnungsdaten an einen oder den Rechner (710) eines oder des Dienstanbieters, insbesondere an ein oder das Rechnersystem des Automobilherstellers, wobei eine Speicherinformation im Rechner (710) des Dienstanbieters markiert, dass die Rechnung nicht bezahlt ist;

1360     Erstellung (1360) einer Rechnung in Abhängigkeit von den übermittelten Abrechnungsdaten durch einen oder den Rechner (710) eines oder des Dienstanbieters, insbesondere an ein oder das Rechnersystem des Automobilherstellers;

1365     Übermittlung (1365) der Rechnung an einem oder den Rechner (710) eines oder des Dienstanbieters, insbesondere an ein oder das Rechnersystem (740) der bestellenden Person (730), oder an die bestellende Person (730);

1370     Begleichung (1370) der Rechnung durch einen oder den Rechner (710) eines oder des Dienstanbieters und/oder die anfordernde Person (730);

1375     Markierung (1375) der Speicherinformation im Rechner des Dienstanbieters (740), dass die Rechnung bezahlt ist;

1400     Verfahren (1400) zum Betreiben eines Fahrzeugs Freischaltung von Energiequellen im Fahrzeug;

1405     Bereitstellen des Fahrzeugs;

1410     Unterbinden (1410) der Energielieferung einer zugeordneten elektrischen Energiequelle (250, 251) mittels der entsprechenden zugeordneten Sicherung (255, 260);

1415     Herstellen (1415) einer verschlüsselten Verbindung (720) zwischen dem Steuerrechner des Fahrzeugs, also dem übergeordneten Rechnersystem (12), und einem Rechner (710) eines Dienstanbieters, insbesondere einem Rechnersystem (710) des Automobilherstellers;

1420     Authentifizierung (1420) des Fahrzeugs durch den Steuerrechner des Fahrzeugs, also durch das übergeordnete Rechnersystem (12), beim Rechner (710) des Dienstanbieters, wobei die Authentifizierungsdaten des Fahrzeugs beispielsweise die Daten des Fahrzeugs und/oder des Autoschlüssels und/oder einer SIM-Karte im Fahrzeug und/oder einer fahrzeugspezifischen Passworteingabe oder Passworterzeugung und/oder biometrische Nutzerdaten eines Fahrzeughalters etc. umfassen können;

1425     Authentifizierung (1430) des Rechners des Dienstanbieters beim Steuerrechner des Fahrzeugs, also beim übergeordneten Rechnersystem (12);

1430     Authentifizierung (1430) der anfordernden Person (730) durch den Steuerrechner des Fahrzeugs, also durch das übergeordnete Rechnersystem (12), beim Rechner (710) des Dienstanbieters, wobei die Authentifizierungsdaten beispielsweise die Daten des Fahrzeugs und/oder des personalisierten Autoschlüssels, einer personalisierten SIM-Karte, einer personalisierten Passworteingabe, biometrische Nutzerdaten etc. umfassen können;

1435     Erzeugen (1435) oder Bereitstellen eines Freischaltcodes durch den Rechner (710) des Dienstanbieters;

1440     Übermitteln (1440) des Freischaltcodes durch den Rechner (710) des Dienstanbieters an den Steuerrechner des Fahrzeugs, also an das übergeordnete Rechnersystem (12);

1445     Verifikation (1445) der Zulässigkeit und/oder syntaktischen Korrektheit und/oder der situativen Zulässigkeit des Freischaltcodes durch den Steuerrechner (12) des Fahrzeugs, also durch das übergeordnete Rechnersystem (12);

1450     Ermöglichen (1450) der Energielieferung einer zugeordneten elektrischen Energiequelle (250, 251) mittels der entsprechenden, zugeordneten Sicherung (255, 260);

1455     Übermittlung (1455) von Abrechnungsdaten an einen oder den Rechner (710) eines oder des Dienstanbieters, insbesondere an ein oder das Rechnersystem des Automobilherstellers, wobei eine Speicherinformation im Rechner (710) des Dienstanbieters markiert, dass die Rechnung nicht bezahlt ist;

1460     Erstellung (1460) einer Rechnung in Abhängigkeit von den übermittelten Abrechnungsdaten durch einem oder den Rechner (710) eines oder des Dienstanbieters, insbesondere an ein oder das Rechnersystem des Automobilherstellers;

1465     Übermittlung (1465) der Rechnung, insbesondere durch einen oder den Rechner (710) eines oder des Dienstanbieters an einem oder den Rechner (750) eines oder des Dienstanbieters, insbesondere an ein oder das Rechnersystem der bestellenden Person, oder an die bestellende Person (730);

1470     Begleichung (1470) der Rechnung durch einem oder den Rechner (750) eines oder des Dienstanbieters und/oder die anfordernde Person (730);

1475     Markierung (1475) der Speicherinformation im Rechner (710) des Dienstanbieters, dass die Rechnung bezahlt ist;

1505 abzusichernder Leitungsabschnitt;

1510 Lichtbogen;

1515 Kabelbaum;

1520 Strommessvorrichtung (1520), die in den abzusichernden Leitungsabschnitt (1505) eingefügt ist;

1525 elektrischer Strom (1525) durch den abzusichernden Leitungsabschnitt (1505);

1600 Verfahren (1600) zu Erkennung von nicht verlöschenden Lichtbögen (1510) im Kabelbaum (1515) mit Leitungsabschnitten (485,1505) eines Fahrzeugs;

1605 Erfassen (1605) eines Zeitabschnitts des zeitlichen Verlaufs des elektrischen Stroms (1525) durch den abzusichernden Leitungsabschnitt (1505) und Erzeugung eines zugehörigen Werteverlaufs (1610) des erfassten Stromwerts des elektrischen Stroms (1525) durch den abzusichernden Leitungsabschnitt (1505) dieses Zeitabschnitts insbesondere mittels einer Strommessvorrichtung (1520), die in den Leitungsabschnitt (1505) eingefügt ist;

1610 Werteverlauf (1610) des erfassten Stromwerts des elektrischen Stroms (1525) durch den abzusichernden Leitungsabschnitt (1505) dieses Zeitabschnitts

1615 Durchführen (1615) einer Spektralanalyse des erfassten Werteverlaufs (1610) dieses Zeitabschnitts in Abhängigkeit von dem erzeugten zeitlichen Werteverlauf (1610) des zeitlichen Verlaufs des elektrischen Stromes (1525) durch den abzusichernden Leitungsabschnitt (1505) und Erzeugen eines Spektralanalyseergebnisses (1620), insbesondere mittels der Steuervorrichtung (4) der elektronischen Sicherung (825) oder mittels eines übergeordneten Rechnersystems (12) oder mittels einer übergeordneten Steuervorrichtung (12), die über einen Datenbus (9) mit der Steuervorrichtung (4) der Sicherung (825) kommuniziert und die die Rolle eines übergeordneten Rechnersystems (12) einnimmt;

1620 Spektralanalyseergebnis. Bevorzugt ist das Spektralanalyseergebnis ein Vektor mit Zahlenwerten. Jeder der Zahlenwerte dieses Vektors umfasst im Wesentlichen einen Amplitudenwert des Ergebnisses der Fourier-Transformation und/oder der Laplace-Transformation und/oder der Wavelet-Transformation und/oder einer anderen Integraltransformation und/oder der Z-Transformation des erfassten zeitlichen Werteverlaufs (1610) dieses Zeitabschnitts des zeitlichen Verlaufs des elektrischen Stromes (1525) durch den abzusichernden Leitungsabschnitt (1505) für einen Transformationsparameterwert der betreffenden Transformation, beispielsweise einer Frequenz oder einer Streckung bei Wavelets etc. Besonders bevorzugt sind die Fourier-Transformation und die Laplace-Transformation. In diesem Falle ist das Spektralanalyseergebnis ein Vektor mit Zahlenwerten, wobei jeder der Zahlenwerte dieses Vektors im Wesentlichen einen Amplitudenwert für eine Frequenz oder einen Frequenzbereich angibt;

1625 Verwenden (1625) der Werte des Spektralanalyseergebnisses (1620) des erfassten Werteverlaufs (1610) dieses Zeitabschnitts und/oder daraus abgeleiteter Werte als aktuellem Merkmalsvektor (1630);

1630 aktueller Merkmalsvektor;

1635 Abbilden (1635) des aktuellen Merkmalsvektors (1630) der Werte des Spektralanalyseergebnisses (1620) des erfassten Werteverlaufs (1610) dieses Zeitabschnitts auf vordefinierte Merkmalsvektoren (1640) spektraler Basisstrukturen aus einer gespeicherten Menge (1650) von vordefinierten Merkmalsvektoren (1640) spektraler Basisstrukturen in einer Basisstrukturdatenbank (1645). Bevorzugt erfolgt diese Abbildung mittels Skalar-Produktbildung zwischen diesen Merkmalsvektoren (1640). Die Abbildung dient der Erzeugung eines spektralen Parametersatzes (1655). Ein solcher, spektraler Parametersatz (1655) ist ein Vektor und umfasst typischerweise zumindest einen, vorzugsweise jeweils einen Ähnlichkeitswert für eine Paarung, möglichst jedoch für alle jeweils möglichen Paarungen aus jeweils einem Datensatz der Basisstrukturdatenbank (1645) je Paarung einerseits und dem aktuellen Merkmalsvektor (1640) je Paarung andererseits. Der Datensatz (1640) der Basisstrukturdatenbank (1645) ist ein prototypischer Merkmalsvektor (1640) beispielsweise für ein Ereignis des Normalbetriebs oder beispielsweise für einen prototypischen Lichtbogen (1510). Die Basisstrukturdatenbank (1645) umfasst also bevorzugt mehrere solcher prototypischen Merkmalsvektoren (1640) verschiedener prototypischen Lichtbögen (1510), die vorzugsweise zuvor im Labor gemessen wurden. Der Ähnlichkeitswert für eine solche Paarung kann dann beispielsweise die Steuervorrichtung (4) der Sicherung (825) mittels eines Skalarprodukts aus dem für die Ähnlichkeit zwischen jeweils einem vordefinierten Merkmalsvektor (1640) des Datensatzes der Basisstrukturdatenbank (1645) einerseits und dem aktuellen Merkmalsvektor (1630) andererseits berechnen. Dieser Ähnlichkeitswert ist also bevorzugt der Ähnlichkeitswert genau einer spektralen Basisstruktur aus der gespeicherten Menge (1650) vordefinierter Merkmalsvektoren (1640) spektraler Basisstrukturen der Basisstrukturdatenbank (1645) einerseits und dem aktuellen Merkmalsvektor (1630) andererseits. Bevorzugt umfasst das hier beschriebene Abbilden die Berechnung der Ähnlichkeitswerte für einen vordefinierten Merkmalsvektor (1640), besser alle vordefinierten Merkmalsvektoren spektraler Basisstrukturen (1640) in der Basisstrukturdatenbank (1645). Die Steuervorrichtung (4) der elektronischen Sicherung (825) und/oder eine übergeordnete Steuervorrichtung (12), die über einen Datenbus (9) mit der Steuervorrichtung (4) der Sicherung (825) kommuniziert und die die Rolle eines übergeordneten Rechnersystems (12) einnimmt, führen bevorzugt dieses Abbilden und Erzeugen durch. Die so berechneten Ähnlichkeitswerte bilden dann einen neuen Vektor, wobei jeder Wert dieses neuen Vektors mit einem vordefinierten Merkmalsvektor (1640) der vordefinierten Merkmalsvektoren (1640) spektraler Basisstrukturen der Basisstrukturdatenbank (1645) korrespondiert und den Anteil dieses vordefinierten Merkmalsvektors der vordefinierten Merkmalsvektoren spektraler Basisstrukturen (1640) der Basisstrukturdatenbank (1645) im aktuellen Merkmalsvektor (1630) wiedergibt;

1640    vordefinierter Merkmalsvektor (1640) einer spektralen Basisstruktur innerhalb einer gespeicherten Menge (1650) von vordefinierten Merkmalsvektoren (1640) spektraler Basisstrukturen in einer Basisstrukturdatenbank (1645). Jede dieser vordefinierten Merkmalsvektoren (1640) einer spektralen Basisstruktur entspricht dabei einem prototypischen Ereignis. Solche Ereignisse können auch "kein Ereignis" bedeuten oder zulässige Ereignisse des Normalbetriebs sein, aber eben auch unzulässige Ereignisse sein. Vorzugsweise erzeugen Trainingsprogramme die prototypischen Merkmalsvektoren im Labor durch Provokation des Ereignisses erzeugt, indem die Trainingsprogramme die dann auftretenden aktuellen Merkmalsvektoren aufzeichnen und ggf. nach Nachverarbeitung als prototypische Vektoren speichern. Eine Nachverarbeitung kann beispielsweise ein Clustern einer Mehrzahl von Merkmalsvektoren zur einem solchen prototypischen Merkmalsvektor sein;

1645    Basisstrukturdatenbank (1645). Die Basisstrukturdatenbank (1645) umfasst bevorzugt eine gespeicherte Menge (1650) einer Einzahl oder Mehrzahl vordefinierter Merkmalsvektoren (1640) spektraler Basisstrukturen;

1650    gespeicherten Menge (1650) von vordefinierten Merkmalsvektoren (1640) spektraler Basisstrukturen in einer Basisstrukturdatenbank (1645);

1655    spektraler Parametersatzes (1655) mit zumindest einem, vorzugsweise je einem Ähnlichkeitswert für die Ähnlichkeit zwischen jeweils einem vordefinierten Merkmalsvektor (1640) genau einer spektralen Basisstruktur der gespeicherten Menge vordefinierter Merkmalsvektoren spektraler Basisstrukturen (1625) der Basisstrukturdatenbank (1635) einerseits und dem aktuellen Merkmalsvektor andererseits für vordefinierte, insbesondere alle, Merkmalsvektoren spektraler Basisstrukturen aus der gespeicherten Menge von vordefinierten Merkmalsvektoren spektraler Basisstrukturen (1625) in der Basisstrukturdatenbank (1635). Vorzugsweise bilden die Steuervorrichtung (4) oder ein übergeordnetes Rechnersystem (12) oder die übergeordnete Steuervorrichtung (12) diese Ähnlichkeitswerte durch jeweiliges Abbilden (1635) des aktuellen Merkmalsvektors (1630) der Werte des Spektralanalyseergebnisses (1620) des erfassten Werteverlaufs (1610) dieses Zeitabschnitts auf vordefinierte Merkmalsvektoren (1640) spektraler Basisstrukturen aus einer gespeicherten Menge von vordefinierten Merkmalsvektoren spektraler Basisstrukturen (1650) in einer Basisstrukturdatenbank (1645). Dieses Abbilden kann insbesondere mittels Skalar-Produktbildung zwischen diesen Merkmalsvektoren (1640) erfolgen. Durch die Berechnung der Ähnlichkeitswerte entsteht ein spektraler Parametersatz (1655) mit zumindest einem, vorzugsweise je einem Ähnlichkeitswert für die Ähnlichkeit zwischen jeweils einem vordefinierten Merkmalsvektor (1640) genau einer spektralen Basisstruktur der gespeicherten Menge vordefinierter Merkmalsvektoren spektraler Basisstrukturen (1625) der Basisstrukturdatenbank (1635) einerseits und dem aktuellen Merkmalsvektor andererseits für vordefinierte, insbesondere alle, Merkmalsvektoren spektraler Basisstrukturen aus der gespeicherten Menge von vordefinierten Merkmalsvektoren spektraler Basisstrukturen (1625) in der Basisstrukturdatenbank (1635);

1660    Bewertung (1660) des spektralen Parametersatzes (1655) zur Erzeugung eines Bewertungsergebnisses (1665).

1665    Bewertungsergebnis (1665). Beispielweise können die Steuervorrichtung (4) der Sicherung (825) und/oder das übergeordnete Rechnersystems (12) und/oder die übergeordnete Steuervorrichtung (12) diese Bewertung (1660) durch Anwendung und Ausführung eines neuronalen Netzwerkmodells durchführen. Dabei kann die Steuervorrichtung (4) der elektronischen Sicherung (825) mit der übergeordneten Steuervorrichtung (12) und/oder dem über- geordneten Rechnersystem (12) beispielsweise über den Datenbus (9) kommunizieren. Bevorzugt bilden Ähnlichkeitswerte des spektralen Parametersatzes (1655) oder daraus abgeleitete Werte die Eingangswerte des neuronalen Netzwerkmodells. Das Bewertungsergebnis (1665) der Bewertung (1660) hängt dann von Ausgangswerten des neuronalen Netzwerkmodells ab, das die Steuervorrichtung (4) der Sicherung (825) und/oder das übergeordnete Rechnersystem (12) und/oder die übergeordnete Steuervorrichtung (12) typischerweise berechnen;

1670 Unterbrechen (1670) des Stromflusses (1525) durch den abzusichernden Leitungsabschnitt (1505) mittels der elektronischen Sicherung (825), wenn das Bewertungsergebnis (1665) des spektralen Parametersatzes (1640) dem Vorhandensein eines Kurzschlusses oder einer Plasmaentladung (1510), insbesondere eines Lichtbogens, entspricht oder dieses nahelegt. Dies ist insbesondere dann der Fall, wenn ein Bewertungsergebnis innerhalb eines Erwartungsintervalls für einen solchen Fall liegt. Das Erwartungsintervall kann auch nur einseitig begrenzt sein. Bevorzugt unterbrechen die Steuervorrichtung (4) der elektronischen Sicherung (825) und/oder auch die übergeordnete Steuervorrichtung (12) und/oder das übergeordnete Rechnersystem (12) den Stromfluss (1525). Ggf. erfolgt hierzu eine Kommunikation über den Datenbus (9) zwischen der Steuervorrichtung (4) der Sicherung (825) und der übergeordneten Steuervorrichtung (12) und/oder dem übergeordneten Rechnersystem (12). Bevorzugt öffnen die Steuervorrichtung (4) der elektronischen Sicherung (825) oder eine übergeordnete Steuervorrichtung (12) bzw. ein übergeordnetes Rechnersystem (12), die über einen Datenbus (9) mit der Steuervorrichtung (4) der Sicherung (825) kommunizieren, den Leistungsschalter (17) der elektronischen Sicherung (825) in einem solchen Fehlerfall;

1800 Verfahren (1800) zum energieabhängigen Konfigurieren eines Versorgungsnetzwerks (1700) (Figur 17, 18);

1805 Erfassen (1805) des Gesamtenergiebedarfs dieser Vorrichtungsteile (210, 211, 220, 221, 222, 223);

1810 Vergleich (1810) des ermittelten Gesamtenergiebedarfs dieser Vorrichtungsteile (210, 211, 220, 221, 222, 223) des Fahrzeugs mit einem oberen Energieverbrauchsschwellwert;

1820 Unterbinden (1820) der Versorgung eines niedriger priorisierten energieverbrauchenden Vorrichtungsteils (210) mit elektrischer Energie und/oder der von diesem niedriger priorisierten Vorrichtungsteil (210) mit elektrischer Energie versorgten weiteren Vorrichtungsteile (220. 221), wenn der ermittelte Gesamtenergiebedarf aller Vorrichtungsteile (210, 211, 220, 221, 222, 223) über dem oberen Energieverbrauchsschwellwert liegt oder liegen könnte oder der Betriebszustand und/oder die Fahrsituation dies erwarten lässt. Dabei erfolgt dieses Unterbinden (1820) mittels der elektronischen Sicherung (255) dieses Vorrichtungsteils (250);

1830 Vergleich (1830) des ermittelten Gesamtenergiebedarfs dieser Vorrichtungsteile (210, 211, 220, 221, 222, 223) des Fahrzeugs mit einem unteren Energieverbrauchsschwellwert;

1840 Ermöglichen (1840) der Versorgung dieses niedriger priorisierten energieverbrauchenden Vorrichtungsteils (210) mit elektrischer Energie und/oder der von diesem niedriger priorisierten Vorrichtungsteil (210) mit elektrischer Energie versorgten weiteren Vorrichtungsteile (220. 221), wenn der ermittelte Gesamtenergiebedarf aller Vorrichtungsteile (210, 211, 220, 221, 222, 223) unter dem unteren Energieverbrauchsschwellwert liegt, wobei dieses Ermöglichen (1840) mittels der elektronischen Sicherung (255) dieses Vorrichtungsteils (250) erfolgt.

1900 Versorgungsnetzwerk (200);

1905 zweiter, nachfolgender, abzusichernder Leitungsabschnitt (1905) des Kabelbaums (1515);

1910 zweiter Stromfluss (1910) in einen zweiten, nachfolgenden, abzusichernden Leitungsabschnitt (1905) des Kabelbaums (1515);

1915 dritter abzusichernder Leitungsabschnitt;

1920 dritter Stromfluss (1920) in einen dritten, vorausgehenden, abzusichernden Leitungsabschnitt (1915) des Kabelbaums (1515);

1925 vierter abzusichernder Leitungsabschnitt;

1930 vierter Stromfluss (1930) in einen vierten, nachfolgenden, abzusichernden Leitungsabschnitt (1925) des Kabelbaums (1515);

1935 zweite Strommessvorrichtung;

1940 dritte Strommessvorrichtung;

1945 vierte Strommessvorrichtung;

1950 erster Zeitgeber (35) der ersten elektronischen Sicherung (825);

1955 zweiter Zeitgeber (35) der zweiten elektronischen Sicherung (805),

1960 dritter Zeitgeber (35) der dritten elektronischen Sicherung (1975),

1965 vierter Zeitgeber (35) der vierten elektronischen Sicherung (1980),

1970 Zeitgeber des übergeordneten Rechnersystems (12);

1975 dritte elektronische Sicherung;

1980 vierte elektronische Sicherung;

1985 Server (1985, 710) oder Terminal einer Werkstatt und/oder eines Automobilherstellers und/oder eines Dienstleistungsanbieters und/oder oder eines sonstigen Nutzers der von dem Versorgungsnetzwerk oder einem übergeordneten Rechnersystem (12) ermittelten Daten;

1990 Datenverbindung (1990, 740) zu einem Server (1985, 710) einer Werkstatt und/oder eines Automobilherstellers und/oder eines Dienstleistungsanbieters

2000 Verteiltes Messverfahren (2000) zur Erfassung des Zustands eines Kabelbaums (1515) eines Fahrzeugs;

2005 Synchronisation (2005) eines ersten Zeitgebers (1950) einer ersten elektronischen Sicherung (825) mit einem Zeitnormal, insbesondere einem Zeitgeber (1970) eines übergeordneten Rechnersystems (12);

2010 Synchronisation (2010) eines zweiten Zeitgebers (1955) einer zweiten elektronischen Sicherung (805) mit dem Zeitnormal, insbesondere dem Zeitgeber (1970) eines übergeordneten Rechnersystems (12);

2015 Initiierung (2015) der folgenden beiden Erfassungsvorgänge zu gleichen Zeitwerten des ersten Zeitgebers (1950) der ersten elektronischen Sicherung (825) und des zweiten Zeitgebers (1955) der zweiten elektronischen Sicherung (805)

2020 Erfassen (2020) des ersten Stromwerts des Stromflusses (1525) in einen ersten abzusichernden Leitungsabschnitt (1505) des Kabelbaums (1515) hinein, insbesondere durch eine erste elektronische Sicherung (825) und/oder eine erste Strommessvorrichtung (1520), wobei die erste Steuervorrichtung (4) der ersten elektronischen Sicherung (825) über einen ersten Zeitgeber (1950) verfügt;

2025 Erfassen (2025) des zweiten Stromwerts des Stromflusses (1910) in einen zweiten nachfolgenden abzusichernden Leitungsabschnitt (1905) des Kabelbaums (1515) hinein, insbesondere durch eine zweite elektronische Sicherung (805) und/oder eine zweite Strommessvorrichtung (1935), wobei die zweite Steuervorrichtung (4) der zweiten elektronischen Sicherung (805) über einen zweiten Zeitgeber (1955) verfügt;

2030 Ermitteln (2030) eines ersten Zeitstempelwerts, insbesondere durch die erste Steuervorrichtung (4) der ersten elektronischen Sicherung (825) und insbesondere mit Hilfe des ersten Zeitgebers (1950) der ersten elektronischen Sicherung (825), für jeden Messwert oder für eine Gruppe von Messwerten der Stromwerte des Stromflusses (1525);

2035 Ermitteln (2035) eines zweiten Zeitstempelwerts, insbesondere durch die zweite Steuervorrichtung (4) der zweiten elektronischen Sicherung (805) und insbesondere mit Hilfe des ersten Zeitgebers (1955) der ersten elektronischen Sicherung (805), für jeden Messwert oder für eine Gruppe von Messwerten der Stromwerte des Stromflusses (1910);

2040 Übertragung (2040) zumindest eines zweiten Messwerts zusammen mit dem zweiten Zeitstempelwert von der zweiten Sicherung (805) an ein übergeordnetes Rechnersystem (12) oder an die Steuervorrichtung (4) der ersten elektronischen Sicherung (825) und im Falle der Übertragung des zweiten Messwerts an ein übergeordnetes Rechnersystem (12) Übertragung (2025) des ersten Messwerts zusammen mit dem ersten Zeitstempelwert von der ersten Sicherung (825) an das übergeordnete Rechnersystem (12);

2045 Vergleich (2045) des ersten Messwerts mit dem zweiten Messwert;

2050 Schließen (2050) auf einen Energieverlust in Leitungsabschnitten (1525) zwischen zwei elektronischen Sicherungen (825, 805), insbesondere, wenn der die Differenz zwischen dem ersten Messwert und dem zweiten Messwert außerhalb eines erlaubten Differenzwertintervalls legt und/oder wenn ein Quotient aus dem ersten Messwert und dem zweiten Messwert außerhalb eines erlaubten Quotienten-Intervalls liegt.

2055 Ergreifen (2055) von Gegenmaßnahmen, insbesondere durch das übergeordnete Rechnersystem (12) bzw. den Rechnerkern (2) der auswertenden Steuervorrichtung (4) der auswertenden elektronischen Sicherung (825), wenn die Messwerte oder das Verhältnis der Messwerte zueinander oder eine Differenz von solchen Messwerten oder daraus abgeleiteter Größen nicht einem oder mehreren Erwartungswerten entsprechen und/oder nicht in einem Erwartungswertintervall liegen

2060 Herstellen (2060) einer Datenverbindung zu einem Server (710) einer Werkstatt und/oder eines Automobilherstellers und/oder eines Dienstleistungsanbieters;

2065 Übermittlung (2065) der Fahrzeugdaten und/oder Betriebsdaten und/oder Messwerten und/oder Schadensdaten an einen Server (1985) oder ein Terminal der Werkstatt oder eines sonstigen Nutzers dieser Daten;

2070 Prognose (2070) der Ausfallwahrscheinlichkeit eines Vorrichtungsteils des Fahrzeugs mittels der Fahrzeugdaten und/oder Betriebsdaten und/oder Messwerten und/oder Schadensdaten;

2075 Übermittlung (2075) des Prognoseergebnisses an einen Server (1985) und/oder ein Terminal der Werkstatt und/oder ein Terminal (740) und/oder einen Rechner eines Fahrzeughalters (730) und/oder ein Terminal (740) und/oder einen Rechner eines Fahrzeugführers (730) oder ein Terminal und/oder einen Server (710) eines Automobilherstellers und/oder ein Terminal und/oder Server eines Logistikunternehmens und/oder ein Terminal und/oder einen Server eines sonstigen Nutzers dieser Daten;

| 2080 | Bereitstellen (2080) eines Ersatzteils für das Vorrichtungsteil des Fahrzeugs bei einem Prognoseergebnis, das einen Ausfall des Vorrichtungsteils erwarten lässt; |
| 2085 | Schließen (2085) auf die Temperatur eines Leitungsabschnitts (1915, 1925, 1505, 1905) und/oder eine Übertemperatur eines Leitungsabschnitts (1915, 1925, 1505, 1905) mittels der erfassten Stromwerte des Stromflusses (1920, 1925, 1525, 1910) in mehreren abzusichernden Leitungsabschnitten (1915, 1925, 1505, 1905) des Kabelbaums (1515). |
| 2100 | Batterie (2100) mit Diagnosefunktion für ein Fahrzeug; |
| 2105 | erstes Batteriezellenmodul (2105); |
| 2120 | Verbindung zwischen dem ersten Anschluss (2125) und dem ersten Anschluss (18) des Leistungsschalters (17) der ersten Sicherung (825) der Batterie (2100, 2200); |
| 2121 | elektrischer Strom in der Verbindung (2120) zwischen dem ersten Anschluss (2125) und dem ersten Anschluss (18) des Leistungsschalters (17) der ersten Sicherung (825) der Batterie (2100, 2200); |
| 2125 | erster Anschluss (2125) des ersten Batteriezellenmoduls (2105); |
| 2130 | zweiter Anschluss (2130) des ersten Batteriezellenmoduls (2105); |
| 2135 | erster Anschluss der ersten elektrochemischen Zelle, der ersten Batteriezelle (2145), des ersten Batteriezellenmoduls (2105); |
| 2140 | zweiter Anschluss der ersten elektrochemischen Zelle, der ersten Batteriezelle (2145), des ersten Batteriezellenmoduls (2105); |
| 2145 | erste elektrochemische Zelle, die erste Batteriezelle, des ersten Batteriezellenmoduls (2105); |
| 2155 | zweites Batteriezellenmodul (2155); |
| 2160 | Verbindung zwischen dem ersten Anschluss (2165) und dem ersten Anschluss (18) des Leistungsschalters (17) der zweiten Sicherung (805) der Batterie (2100, 2200); |
| 2161 | elektrischer Strom in der Verbindung (2160) zwischen dem ersten Anschluss (2165) und dem ersten Anschluss (18) des Leistungsschalters (17) der zweiten Sicherung (805) der Batterie (2100, 2200) |
| 2165 | erster Anschluss (2165) des zweiten Batteriezellenmoduls (2155); |
| 2170 | zweiter Anschluss (2170) des zweiten Batteriezellenmoduls (2155); |
| 2175 | erster Anschluss der zweiten elektrochemischen Zelle, der zweiten Batteriezelle (2184), des zweiten Batteriezellenmoduls (2155); |
| 2180 | zweiter Anschluss der zweiten elektrochemischen Zelle, der zweiten Batteriezelle (2185), des zweiten Batteriezellenmoduls (2155); |
| 2185 | zweite elektrochemische Zelle, die zweite Batteriezelle, des zweiten Batteriezellenmoduls (2155); |
| 2190 | Verbindung zwischen dem zweiten Anschluss (2130) des ersten Batteriezellenmoduls (2105) und dem ersten Anschluss (2165) des zweiten Batteriezellenmoduls (2155); |
| 2196 | Verbindung des zweiten Anschlusses (2195) der Batterie (2100, 2200) mit dem zweiten Anschluss (2170) des zweiten Batteriezellenmoduls (2155); |
| 2197 | erster Anschluss (2197) der Batterie (2100); |
| 2198 | Verbindung des ersten Anschlusses (2197) der Batterie (2100, 2200) mit dem ersten Anschluss (2125) des ersten Batteriezellenmoduls (2105); |
| 2199 | Batteriegehäuse; |
| 2200 | Batterie (2200), bei der eine elektronische Sicherung (825) der Batterie (2200) einen zweiten Leistungsschalter (17') aufweist, der dazu geeignet ist, das der Sicherung zugeordnete Batteriezellenmodul (2105) bei einem geschlossenen zweiten Leistungsschalter (17') zu überbrücken. |
| 2220 | Gehäuse der Batterie bzw. des Batteriezellenmoduls; |
| 2225 | Anschluss der Batterie (2200) des Batteriezellenmoduls für die Betriebsspannung (6) der elektronischen Sicherungen (825, 805); |
| 2230 | Anschluss der Batterie (2200) des Batteriezellenmoduls für den Bezugspotenzialknoten (201) der elektronischen Sicherungen (825, 805); |
| 2235 | Anschluss der Batterie (2200) des Batteriezellenmoduls für den externen Datenbus (9) der elektronischen Sicherungen (825, 805); |
| 2300 | Batteriezellenmodul mit einer Batteriezelle (2145) |
| 2305 | erster Batteriezellenanschluss (2305); |
| 2310 | zweiter Batteriezellenanschluss (2310); |
| 2320 | Anschluss des Batteriezellenmoduls (2105) für die Betriebsspannung (6) der elektronischen Siche- |

rung (825);

2325    Anschluss des Batteriezellenmoduls (2105) für den Bezugspotenzialknoten (201) der elektronischen Sicherung (825);

2330    Anschluss des Batteriezellenmoduls (2105) für den externen Datenbus (9) der elektronischen Sicherung (825);

2500    Batteriezellenmodul mit mehreren Batteriezellen (2145, 2185). Das Batteriezellenmodul entspricht im Sinne des hier vorgelegten Dokuments dem Batteriezellenmodul (2105);

2505    Steckverbinder. Der beispielhafte Steckverbinder weist einen ersten Kontakt (6) für den Betriebsspannungsanschluss (6) der elektronischen Sicherungen (825, 805) auf. Der Steckverbinder weist einen zweiten Kontakt (201) für den Bezugspotenzialanschluss (201) der elektronischen Sicherungen (805, 815) auf. Der Steckverbinder weist einen dritten Kontakt (9) für den externen Datenbus (9) der elektronischen Sicherungen (805, 815) auf;

2600    gehäustes Batteriezellenmodul;

2605    gemeinsames Gehäuse des Batteriezellenmoduls (2600) für eine elektronische Sicherung (825) und ein inneres Batteriezellenmodul (2105);

2610    erster Anschluss des Batteriezellenmoduls (2600), der typischerweise mit dem ersten Anschluss (2125) des inneren Batteriezellenmoduls (2105) innerhalb des Gehäuses (2605) des Batteriezellenmoduls (2600) verbunden ist;

2615    zweiter Anschluss des Batteriezellenmoduls (2600), der typischerweise mit dem zweiten Anschluss (2130) des inneren Batteriezellenmoduls (2105) innerhalb des Gehäuses (2605) des Batteriezellenmoduls (2600) verbunden ist;

2620    Anschluss des Batteriezellenmoduls (2600) für die Betriebsspannung (6) der elektronischen Sicherung (825) des inneren Batteriezellenmoduls (2105);

2625    Anschluss des Batteriezellenmoduls (2600) für den Bezugspotenzialknoten (201) der elektronischen Sicherung (825) des inneren Batteriezellenmoduls (2105);

2630    Anschluss des Batteriezellenmoduls (2600) für den externen Datenbus (9) der elektronischen Sicherung (825) des inneren Batteriezellenmoduls (2105);

2635    beispielhafter optischer Lichtwellenleiter innerhalb des Gehäuses (2605);

2640    Optisches Stecksystem für die steckbare optische Verbindung zwischen dem externen Lichtwellenleiter (580) außerhalb des Gehäuses (2605) und dem optischen Lichtwellenleiter (2635) innerhalb des Gehäuses (2605);

2700    Batterie (2700), bei der eine elektronische Sicherung (825) der Batterie (2200) einen zweiten Leistungsschalter (17') aufweist, der dazu geeignet ist, das der Sicherung zugeordnete Batteriezellenmodul (2105) bei einem geschlossenen zweiten Leistungsschalter (17') zu überbrücken und bei der die Steuervorrichtung aus der Batteriezelle (2145) versorgt wird, auch wenn der Leistungsschalter (17) geöffnet ist.

2800    Batterie (2800), bei der eine elektronische Sicherung (825) der Batterie (2200) einen zweiten Leistungsschalter (17') aufweist, der dazu geeignet ist, das der Sicherung zugeordnete Batteriezellenmodul (2105) bei einem geschlossenen zweiten Leistungsschalter (17') zu überbrücken und bei der die Steuervorrichtung (4) aus der Batteriezelle (2145) weiter versorgt wird, auch wenn der Leistungsschalter (17) geöffnet ist.

2900    Versorgungsnetzwerk (2900), wobei ein oder mehrere Versorgungszweige des Versorgungsnetzwerks (2900) zur Versorgung von elektrischen Verbrauchern (2930 bis 2933) ) mit elektrischer Energie als Ring einer Versorgungsleitung (2910 bis 2915), insbesondere wenn z.B. eine Karosserie als Rückleitermasseleitung dient, und/oder als zwei Ringe von zwei Versorgungsleitungen ausgeführt sind und/oder wobei ein oder mehrere Versorgungszweige des Versorgungsnetzwerks zur Energielieferung von elektrischer Energie aus elektrischen Energiequellen (2940 bis 2941) als Ring einer Versorgungsleitung (2910 bis 2915), wenn z.B. eine Karosserie als Rückleitermasseleitung dient, und/oder als zwei Ringe von zwei Versorgungsleitungen ausgeführt sind.

2910    erster Leitungsabschnitt (2910) des Versorgungsleitungsrings, wobei der erste Leitungsabschnitt den Energieeinspeisepunkt (2924) der ersten Energiequelle (2940) mit dem ersten Energieentnahmepunkt (2920) des ersten Verbrauchers (2930) im Beispiel der Figur 29 elektrisch verbindet, wobei die Rückleitung beispielsweise die Fahrzeugkarosserie sein kann;

2911    zweiter Leitungsabschnitt (2911) des Versorgungsleitungsrings, wobei der zweite Leitungsabschnitt den ersten Energieentnahmepunkt (2920) des ersten Verbrauchers (2930) mit dem zweiten Energieentnahmepunkt (2921) des zweiten Verbrauchers (2931) im Beispiel der Figur 29 elektrisch verbindet, wobei die Rückleitung beispielsweise die Fahrzeugkarosserie sein kann;

2912    dritter Leitungsabschnitt (2912) des Versorgungsleitungsrings, wobei der dritte Leitungsabschnitt den zweiten Energieentnahmepunkt (2921) des zweiten Verbrauchers (2931) mit dem dritten Energieentnahmepunkt (2922) des dritten Verbrauchers (2932) im Beispiel der Figur 29 elektrisch verbindet, wobei die Rückleitung beispielsweise die Fahrzeugkarosserie sein kann;

2913 vierter Leitungsabschnitt (2913) des Versorgungsleitungsrings, wobei der vierte Leitungsabschnitt den dritten Energieentnahmepunkt (2922) des dritten Verbrauchers (2932) mit dem dritten Energieentnahmepunkt (2922) des dritten Verbrauchers (2933) im Beispiel der Figur 29 elektrisch verbindet, wobei die Rückleitung beispielsweise die Fahrzeugkarosserie sein kann;

2914 fünfter Leitungsabschnitt (2914) des Versorgungsleitungsrings, wobei der fünfte Leitungsabschnitt den vierten Energieentnahmepunkt (2923) des vierten Verbrauchers (2933) mit dem zweiten Energieeinspeisepunkt (2925) der zweiten Energiequelle (2941) im Beispiel der Figur 29 elektrisch verbindet, wobei die Rückleitung beispielsweise die Fahrzeugkarosserie sein kann;

2915 sechster Leitungsabschnitt (2915) des Versorgungsleitungsrings, wobei der sechste Leitungsabschnitt den zweiten Energieeinspeisepunkt (2925) der zweiten Energiequelle (2941) mit dem ersten Energieeinspeisepunkt (2924) der ersten Energiequelle (2940) im Beispiel der Figur 29 elektrisch verbindet, wobei die Rückleitung beispielsweise die Fahrzeugkarosserie sein kann;

2920 erster Energieentnahmepunkt zur Versorgung des ersten Verbrauchers (2930) mit elektrischer Energie aus dem Versorgungsleitungsring (2910 bis 2915), wobei die Rückleitung beispielsweise die Fahrzeugkarosserie sein kann;

2921 zweiter Energieentnahmepunkt zur Versorgung des zweiten Verbrauchers (2931) mit elektrischer Energie aus dem Versorgungsleitungsring (2910 bis 2915), wobei die Rückleitung beispielsweise die Fahrzeugkarosserie sein kann;

2922 dritter Energieentnahmepunkt zur Versorgung des dritten Verbrauchers (2932) mit elektrischer Energie aus dem Versorgungsleitungsring (2910 bis 2915), wobei die Rückleitung beispielsweise die Fahrzeugkarosserie sein kann;

2923 vierter Energieentnahmepunkt zur Versorgung des vierten Verbrauchers (2933) mit elektrischer Energie aus dem Versorgungsleitungsring (2910 bis 2915), wobei die Rückleitung beispielsweise die Fahrzeugkarosserie sein kann;

2924 erster Energieeinspeisepunkt zur Einspeisung der Energie der ersten Energiequelle (2940) in den Versorgungsleitungsring (2910 bis 2915), wobei die Rückleitung beispielsweise die Fahrzeugkarosserie sein kann;

2925 zweiter Energieeinspeisepunkt zur Einspeisung der Energie der zweiten Energiequelle (2941) in den Versorgungsleitungsring (2910 bis 2915), wobei die Rückleitung beispielsweise die Fahrzeugkarosserie sein kann;

2930 erster Verbraucher der beispielhaften Figur 29;

2931 zweiter Verbraucher der beispielhaften Figur 29;

2932 dritter Verbraucher der beispielhaften Figur 29;

2933 vierter Verbraucher der beispielhaften Figur 29;

2940 erste Energiequelle der beispielhaften Figur 29;

2941 zweite Energiequelle der beispielhaften Figur 29;

2950 erste Sicherung der ersten Energiequelle (2940), wobei die erste Sicherung den ersten Energieeinspeisepunkt (2924) von dem ersten Leitungsabschnitt (2910) des Versorgungsleitungsrings (2910 bis 2915) trennen kann oder wobei die erste Sicherung den ersten Energieeinspeisepunkt (2924) mit dem ersten Leitungsabschnitt (2910) des Versorgungsleitungsrings (2910 bis 2915) verbinden kann und wobei dieses Trennen bzw. Verbinden von dem elektrischen Strom durch die erste Sicherung und/oder der elektrischen Spannung des Versorgungsleitungsrings (2910 bis 2915) im Bereich der ersten Sicherung relativ zu einem Bezugspotenzial und/oder von einem Datenbefehl über den Sicherungsdatenbus (9) abhängt;

2951 zweite Sicherung der ersten Energiequelle (2940), wobei die zweite Sicherung den ersten Energieeinspeisepunkt (2924) von dem sechsten Leitungsabschnitt (2915) des Versorgungsleitungsrings (2910 bis 2915) trennen kann oder wobei die zweite Sicherung den ersten Energieeinspeisepunkt (2924) mit dem sechsten Leitungsabschnitt (2915) des Versorgungsleitungsrings (2910 bis 2915) verbinden kann und wobei dieses Trennen bzw. Verbinden von dem elektrischen Strom durch die zweite Sicherung und/oder der elektrischen Spannung des Versorgungsleitungsrings (2910 bis 2915) im Bereich der zweiten Sicherung relativ zu einem Bezugspotenzial und/oder von einem Datenbefehl über den Sicherungsdatenbus (9) abhängt;

2952 dritte Sicherung der zweiten Energiequelle (2941), wobei die dritte Sicherung den zweiten Energieeinspeisepunkt (2925) von dem sechsten Leitungsabschnitt (2915) des Versorgungsleitungsrings (2910 bis 2915) trennen kann oder wobei die dritte Sicherung den zweiten Energieeinspeisepunkt (2925) mit dem sechsten Leitungsabschnitt (2915) des Versorgungsleitungsrings (2910 bis 2915) verbinden kann und wobei dieses Trennen bzw. Verbinden von dem elektrischen Strom durch die dritte Sicherung und/oder der elektrischen Spannung des Versorgungsleitungsrings (2910 bis 2915) im Bereich der dritten Sicherung relativ zu einem Bezugspotenzial und/oder von einem Datenbefehl über den Sicherungsdatenbus (9) abhängt;

2953      vierte Sicherung der zweiten Energiequelle (2941), wobei die vierte Sicherung den zweiten Energieeinspeisepunkt (2925) von dem fünften Leitungsabschnitt (2914) des Versorgungsleitungsrings (2910 bis 2915) trennen kann oder wobei die vierte Sicherung den zweiten Energieeinspeisepunkt (2925) mit dem fünften Leitungsabschnitt (2914) des Versorgungsleitungsrings (2910 bis 2915) verbinden kann und wobei dieses Trennen bzw. Verbinden von dem elektrischen Strom durch die vierte Sicherung und/oder der elektrischen Spannung des Versorgungsleitungsrings (2910 bis 2915) im Bereich der vierten Sicherung relativ zu einem Bezugspotenzial und/oder von einem Datenbefehl über den Sicherungsdatenbus (9) abhängt;

2950      dreizehnte Sicherung der ersten Energiequelle (2940), wobei die dreizehnte Sicherung den ersten Energieeinspeisepunkt (2924) von dem ersten Leitungsabschnitt (2910) des Versorgungsleitungsrings (2910 bis 2915) trennen kann oder wobei die dreizehnte Sicherung den ersten Energieeinspeisepunkt (2924) mit dem ersten Leitungsabschnitt (2910) des Versorgungsleitungsrings (2910 bis 2915) verbinden kann und wobei dieses Trennen bzw. Verbinden von dem elektrischen Strom durch die dreizehnte Sicherung und/oder der elektrischen Spannung des Versorgungsleitungsrings (2910 bis 2915) im Bereich der dreizehnten Sicherung relativ zu einem Bezugspotenzial und/oder von einem Datenbefehl über den Sicherungsdatenbus (9) abhängt. Die dreizehnte Sicherung (2950) und die vierzehnte Sicherung (2951) können eine gemeinsame Steuervorrichtung (4) aufweisen;

2951      vierzehnte Sicherung der ersten Energiequelle (2940), wobei die vierzehnte Sicherung den ersten Energieeinspeisepunkt (2924) von dem sechsten Leitungsabschnitt (2915) des Versorgungsleitungsrings (2910 bis 2915) trennen kann oder wobei die vierzehnte Sicherung den ersten Energieeinspeisepunkt (2924) mit dem sechsten Leitungsabschnitt (2915) des Versorgungsleitungsrings (2910 bis 2915) verbinden kann und wobei dieses Trennen bzw. Verbinden von dem elektrischen Strom durch die vierzehnte Sicherung und/oder der elektrischen Spannung des Versorgungsleitungsrings (2910 bis 2915) im Bereich der vierzehnten Sicherung relativ zu einem Bezugspotenzial und/oder von einem Datenbefehl über den Sicherungsdatenbus (9) abhängt. Die dreizehnte Sicherung (2950) und die vierzehnte Sicherung (2951) können eine gemeinsame Steuervorrichtung (4) aufweisen;

2952      fünfzehnte Sicherung der zweiten Energiequelle (2941), wobei die fünfzehnte Sicherung den zweiten Energieeinspeisepunkt (2925) von dem sechsten Leitungsabschnitt (2915) des Versorgungsleitungsrings (2910 bis 2915) trennen kann oder wobei die fünfzehnte Sicherung den zweiten Energieeinspeisepunkt (2925) mit dem sechsten Leitungsabschnitt (2915) des Versorgungsleitungsrings (2910 bis 2915) verbinden kann und wobei dieses Trennen bzw. Verbinden von dem elektrischen Strom durch die fünfzehnte Sicherung und/oder der elektrischen Spannung des Versorgungsleitungsrings (2910 bis 2915) im Bereich der fünfzehnten Sicherung relativ zu einem Bezugspotenzial und/oder von einem Datenbefehl über den Sicherungsdatenbus (9) abhängt. Die fünfzehnte Sicherung (2952) und die sechzehnte Sicherung (2953) können eine gemeinsame Steuervorrichtung (4) aufweisen;

2953      sechzehnte Sicherung der zweiten Energiequelle (2941), wobei die sechzehnte Sicherung den zweiten Energieeinspeisepunkt (2925) von dem fünften Leitungsabschnitt (2914) des Versorgungsleitungsrings (2910 bis 2915) trennen kann oder wobei die sechzehnte Sicherung den zweiten Energieeinspeisepunkt (2925) mit dem fünften Leitungsabschnitt (2914) des Versorgungsleitungsrings (2910 bis 2915) verbinden kann und wobei dieses Trennen bzw. Verbinden von dem elektrischen Strom durch die sechzehnte Sicherung und/oder der elektrischen Spannung des Versorgungsleitungsrings (2910 bis 2915) im Bereich der sechzehnten Sicherung relativ zu einem Bezugspotenzial und/oder von einem Datenbefehl über den Sicherungsdatenbus (9) abhängt. Die fünfzehnte Sicherung (2952) und die sechzehnte Sicherung (2953) können eine gemeinsame Steuervorrichtung (4) aufweisen;

2960      fünfte Sicherung des ersten Verbrauchers (2930), wobei die fünfte Sicherung den ersten Energieentnahmepunkt (2920) von dem ersten Leitungsabschnitt (2910) des Versorgungsleitungsrings (2910 bis 2915) trennen kann oder wobei die fünfte Sicherung den ersten Energieentnahmepunkt (2930) mit dem ersten Leitungsabschnitt (2910) des Versorgungsleitungsrings (2910 bis 2915) verbinden kann und wobei dieses Trennen bzw. Verbinden von dem elektrischen Strom durch die fünfte Sicherung und/oder der elektrischen Spannung des Versorgungsleitungsrings (2910 bis 2915) im Bereich der fünften Sicherung relativ zu einem Bezugspotenzial und/oder von einem Datenbefehl über den Sicherungsdatenbus (9) abhängt. Die fünfte Sicherung (2960) und die sechste Sicherung (2961) können eine gemeinsame Steuervorrichtung (4) aufweisen;

2961      sechste Sicherung des ersten Verbrauchers (2930), wobei die sechste Sicherung den ersten Energieentnahmepunkt (2920) von dem zweiten Leitungsabschnitt (2911) des Versorgungsleitungsrings (2910 bis 2915) trennen kann oder wobei die sechste Sicherung den ersten Energieentnahmepunkt (2930) mit dem zweiten Leitungsabschnitt (2911) des Versorgungsleitungsrings (2910 bis 2915) verbinden kann und wobei dieses Trennen bzw. Verbinden von dem elektrischen Strom durch die sechste Sicherung und/oder der elektrischen Spannung des Versorgungsleitungsrings (2910 bis 2915) im Bereich der sechsten Sicherung relativ zu einem Bezugspotenzial und/oder von einem Datenbefehl über den Sicherungsdatenbus (9) abhängt. Die fünfte Sicherung (2960) und die sechste Sicherung (2961) können eine gemeinsame Steuervorrichtung (4) aufweisen;

2962      siebte Sicherung des zweiten Verbrauchers (2931), wobei die siebte Sicherung den zweiten Energieentnahmepunkt (2921) von dem zweiten Leitungsabschnitt (2911) des Versorgungsleitungsrings (2910 bis 2915) trennen kann oder wobei die siebte Sicherung den zweiten Energieentnahmepunkt (2921) mit dem zweiten Leitungsabschnitt (2911) des Versorgungsleitungsrings (2910 bis 2915) verbinden kann und wobei dieses Trennen bzw. Verbinden von dem elektrischen Strom durch die siebte Sicherung und/oder der elektrischen Spannung des Versorgungsleitungsrings (2910 bis 2915) im Bereich der siebten Sicherung relativ zu einem Bezugspotenzial und/oder von einem Datenbefehl über den Sicherungsdatenbus (9) abhängt. Die siebte Sicherung (2962) und die achte Sicherung (2963) können eine gemeinsame Steuervorrichtung (4) aufweisen;

2963      achte Sicherung des zweiten Verbrauchers (2931), wobei die achte Sicherung den zweiten Energieentnahmepunkt (2921) von dem dritten Leitungsabschnitt (2912) des Versorgungsleitungsrings (2910 bis 2915) trennen kann oder wobei die achte Sicherung den zweiten Energieentnahmepunkt (2921) mit dem dritten Leitungsabschnitt (2912) des Versorgungsleitungsrings (2910 bis 2915) verbinden kann und wobei dieses Trennen bzw. Verbinden von dem elektrischen Strom durch die achte Sicherung und/oder der elektrischen Spannung des Versorgungsleitungsrings (2910 bis 2915) im Bereich der achten Sicherung relativ zu einem Bezugspotenzial und/oder von einem Datenbefehl über den Sicherungsdatenbus (9) abhängt. Die siebte Sicherung (2962) und die achte Sicherung (2963) können eine gemeinsame Steuervorrichtung (4) aufweisen;

2964      neunte Sicherung des dritten Verbrauchers (2932), wobei die neunte Sicherung den dritten Energieentnahmepunkt (2922) von dem dritten Leitungsabschnitt (2912) des Versorgungsleitungsrings (2910 bis 2915) trennen kann oder wobei die neunte Sicherung den dritten Energieentnahmepunkt (2922) mit dem dritten Leitungsabschnitt (2912) des Versorgungsleitungsrings (2910 bis 2915) verbinden kann und wobei dieses Trennen bzw. Verbinden von dem elektrischen Strom durch die neunte Sicherung und/oder der elektrischen Spannung des Versorgungsleitungsrings (2910 bis 2915) im Bereich der neunten Sicherung relativ zu einem Bezugspotenzial und/oder von einem Datenbefehl über den Sicherungsdatenbus (9) abhängt. Die neunte Sicherung (2964) und die zehnte Sicherung (2965) können eine gemeinsame Steuervorrichtung (4) aufweisen;

2965      zehnte Sicherung des dritten Verbrauchers (2932), wobei die zehnte Sicherung den dritten Energieentnahmepunkt (2922) von dem vierten Leitungsabschnitt (2913) des Versorgungsleitungsrings (2910 bis 2915) trennen kann oder wobei die zehnte Sicherung den dritten Energieentnahmepunkt (2922) mit dem vierten Leitungsabschnitt (2913) des Versorgungsleitungsrings (2910 bis 2915) verbinden kann und wobei dieses Trennen bzw. Verbinden von dem elektrischen Strom durch die zehnte Sicherung und/oder der elektrischen Spannung des Versorgungsleitungsrings (2910 bis 2915) im Bereich der zehnten Sicherung relativ zu einem Bezugspotenzial und/oder von einem Datenbefehl über den Sicherungsdatenbus (9) abhängt. Die neunte Sicherung (2964) und die zehnte Sicherung (2965) können eine gemeinsame Steuervorrichtung (4) aufweisen;

2966      elfte Sicherung des vierten Verbrauchers (2933), wobei die elfte Sicherung den vierten Energieentnahmepunkt (2923) von dem vierten Leitungsabschnitt (2913) des Versorgungsleitungsrings (2910 bis 2915) trennen kann oder wobei die elfte Sicherung den vierten Energieentnahmepunkt (2923) mit dem vierten Leitungsabschnitt (2913) des Versorgungsleitungsrings (2910 bis 2915) verbinden kann und wobei dieses Trennen bzw. Verbinden von dem elektrischen Strom durch die elfte Sicherung und/oder der elektrischen Spannung des Versorgungsleitungsrings (2910 bis 2915) im Bereich der elften Sicherung relativ zu einem Bezugspotenzial und/oder von einem Datenbefehl über den Sicherungsdatenbus (9) abhängt. Die elfte Sicherung (2966) und die zwölfte Sicherung (2967) können eine gemeinsame Steuervorrichtung (4) aufweisen;

2967      zwölfte Sicherung des vierten Verbrauchers (2933), wobei die zwölfte Sicherung den vierten Energieentnahmepunkt (2923) von dem fünften Leitungsabschnitt (2914) des Versorgungsleitungsrings (2910 bis 2915) trennen kann oder wobei die zwölfte Sicherung den vierten Energieentnahmepunkt (2923) mit dem fünften Leitungsabschnitt (2914) des Versorgungsleitungsrings (2910 bis 2915) verbinden kann und wobei dieses Trennen bzw. Verbinden von dem elektrischen Strom durch die zwölfte Sicherung und/oder der elektrischen Spannung des Versorgungsleitungsrings (2910 bis 2915) im Bereich der zwölften Sicherung relativ zu einem Bezugspotenzial und/oder von einem Datenbefehl über den Sicherungsdatenbus (9) abhängt. Die elfte Sicherung (2966) und die zwölfte Sicherung (2967) können eine gemeinsame Steuervorrichtung (4) aufweisen;

| | |
|---|---|
| 2970 | Log-Tabelle bzw. Log-Datei für die Fehler und Störungen und ggf. weitere Betriebsparameter; |
| 2971 | Zeitgeber des übergeordneten Rechnersystems (12); |
| 3010 | erster Sicherungssteckplatz für den ersten Verbraucher (2930) mit zwei Sicherungen (2960, 2961) und erster Steckverbindung (3020); |
| 3010' | erste Dreifachsicherung und/oder erster Sicherungssteckplatz für den ersten Verbraucher (2930) mit zwei Sicherungen (2960, 2961) und erster Steckverbindung (3020); |
| 3011 | zweiter Sicherungssteckplatz für den zweiten Verbraucher (2931) mit zwei Sicherungen (2962, 2963) und zweiter Steckverbindung (3021); |
| 3011' | zweite Dreifachsicherung und/oder zweiter Sicherungssteckplatz für den zweiten Verbraucher (2931) mit zwei Sicherungen (2962, 2963) und zweiter Steckverbindung (3021); |
| 3012 | dritter Sicherungssteckplatz für den dritten Verbraucher (2932) mit zwei Sicherungen (2964, 2965) und dritter Steckverbindung (3022); |
| 3012' | dritte Dreifachsicherung und/oder dritter Sicherungssteckplatz für den dritten Verbraucher (2932) mit zwei Sicherungen (2964, 2965) und dritter Steckverbindung (3022); |
| 3013 | vierter Sicherungssteckplatz für den vierten Verbraucher (2933) mit zwei Sicherungen (2966, 2967) und vierter Steckverbindung (3023); |
| 3013' | vierte Dreifachsicherung und/oder vierter Sicherungssteckplatz für den vierten Verbraucher (2933) mit zwei Sicherungen (2966, 2967) und vierter Steckverbindung (3023); |
| 3014 | fünfter Sicherungssteckplatz für die erste Energiequelle (2940) mit zwei Sicherungen (2950, 2951) und fünfter Steckverbindung (3024); |
| 3014' | fünfte Dreifachsicherung und/oder fünfter Sicherungssteckplatz für die erste Energiequelle (2940) mit zwei Sicherungen (2950, 2951) und fünfter Steckverbindung (3024); |
| 3015 | sechster Sicherungssteckplatz für die zweite Energiequelle (2941) mit zwei Sicherungen (2952, 2953) und sechster Steckverbindung (3025); |
| 3015' | sechste Dreifachsicherung und/oder sechster Sicherungssteckplatz für die zweite Energiequelle (2941) mit zwei Sicherungen (2952, 2953) und sechster Steckverbindung (3025); |
| 3020 | erste Steckverbindung mit erstem Stecker und erster Buchse für den Anschluss und die Versorgung des ersten Verbrauchers (2930); |
| 3021 | zweite Steckverbindung mit zweitem Stecker und zweiter Buchse für den Anschluss und die Versorgung des zweiten Verbrauchers (2931); |
| 3022 | dritte Steckverbindung mit drittem Stecker und dritter Buchse für den Anschluss und die Versorgung des dritten Verbrauchers (2932); |
| 3023 | vierte Steckverbindung mit viertem Stecker und vierter Buchse für den Anschluss und die Versorgung des vierten Verbrauchers (2933); |
| 3024 | fünfte Steckverbindung mit fünftem Stecker und fünfter Buchse für den Anschluss und die Einspeisung der ersten Energiequelle (2940); |
| 3025 | sechste Steckverbindung mit sechstem Stecker und sechster Buchse für den Anschluss und die Einspeisung der zweiten Energiequelle (2941); |
| 3100 | Versorgungsnetzwerk mit Isolierbarkeit von Leitungsabschnitten (2910 bis 2915) und Isolierbarkeit von Verbrauchern (2930 bis 2933) und Isolierbarkeit von Energiequellen (2940 bis 2941); |
| 3110 | siebzehnte Sicherung des ersten Verbrauchers (2930), wobei die siebzehnte Sicherung den ersten Energieentnahmepunkt (2920) einerseits von dem ersten Verbraucher (2930) bzw. von der ersten Steckverbindung (3020) mit dem ersten Stecker und der ersten Buchse für den Anschluss und die Versorgung des ersten Verbrauchers (2930) andererseits trennen kann oder wobei die siebzehnte Sicherung den ersten Energieentnahmepunkt (2920) einerseits mit dem ersten Verbraucher (2930) bzw. mit der ersten Steckverbindung (3020) mit dem ersten Stecker und der ersten Buchse für den Anschluss und die Versorgung des ersten Verbrauchers (2930) andererseits verbinden kann und wobei dieses Trennen bzw. Verbinden von dem elektrischen Strom durch die siebzehnte Sicherung und/oder der elektrischen Spannung des Versorgungsleitungsrings (2910 bis 2915) im Bereich der siebzehnten Sicherung bzw. im Bereich der ersten Steckverbindung (3020) relativ zu einem Bezugs- |

potenzial und/oder von einem Datenbefehl über den Sicherungsdatenbus (9) abhängt. Die siebzehnte Sicherung und die fünfte Sicherung (2960) und die sechste Sicherung (2961) können eine gemeinsame Steuervorrichtung (4) aufweisen;

3111 achtzehnte Sicherung des zweiten Verbrauchers (2931), wobei die achtzehnte Sicherung den zweiten Energieentnahmepunkt (2921) einerseits von dem zweiten Verbraucher (2931) bzw. von der zweiten Steckverbindung (3021) mit dem zweiten Stecker und der zweiten Buchse für den Anschluss und die Versorgung des zweiten Verbrauchers (2931) andererseits trennen kann oder wobei die achtzehnte Sicherung den zweiten Energieentnahmepunkt (2921) einerseits mit dem zweiten Verbraucher (2931) bzw. mit der zweiten Steckverbindung (3021) mit dem zweiten Stecker und der zweiten Buchse für den Anschluss und die Versorgung des zweiten Verbrauchers (2931) andererseits verbinden kann und wobei dieses Trennen bzw. Verbinden von dem elektrischen Strom durch die achtzehnte Sicherung und/oder der elektrischen Spannung des Versorgungsleitungsrings (2910 bis 2915) im Bereich der achtzehnten Sicherung bzw. im Bereich der zweiten Steckverbindung (3021) relativ zu einem Bezugspotenzial und/oder von einem Datenbefehl über den Sicherungsdatenbus (9) abhängt. Die achtzehnte Sicherung und die siebte Sicherung (2962) und die achte Sicherung (2963) können eine gemeinsame Steuervorrichtung (4) aufweisen;

3112 neunzehnte Sicherung des dritten Verbrauchers (2932), wobei die neunzehnte Sicherung den dritten Energieentnahmepunkt (2922) einerseits von dem dritten Verbraucher (2932) bzw. von der dritten Steckverbindung (3022) mit dem dritten Stecker und der dritten Buchse für den Anschluss und die Versorgung des dritten Verbrauchers (2932) andererseits trennen kann oder wobei die neunzehnte Sicherung den dritten Energieentnahmepunkt (2922) einerseits mit dem dritten Verbraucher (2932) bzw. mit der dritten Steckverbindung (3022) mit dem dritten Stecker und der dritten Buchse für den Anschluss und die Versorgung des dritten Verbrauchers (2932) andererseits verbinden kann und wobei dieses Trennen bzw. Verbinden von dem elektrischen Strom durch die neunzehnte Sicherung und/oder der elektrischen Spannung des Versorgungsleitungsrings (2910 bis 2915) im Bereich der neunzehnten Sicherung bzw. im Bereich der dritten Steckverbindung (3022) relativ zu einem Bezugspotenzial und/oder von einem Datenbefehl über den Sicherungsdatenbus (9) abhängt. Die neunzehnte Sicherung und die neunte Sicherung (2964) und die zehnte Sicherung (2965) können eine gemeinsame Steuervorrichtung (4) aufweisen;

3113 zwanzigste Sicherung des vierten Verbrauchers (2933), wobei die zwanzigste Sicherung den vierten Energieentnahmepunkt (2923) einerseits von dem vierten Verbraucher (2933) bzw. von der vierten Steckverbindung (3023) mit dem vierten Stecker und der vierten Buchse für den Anschluss und die Versorgung des vierten Verbrauchers (2933) andererseits trennen kann oder wobei die zwanzigste Sicherung den vierten Energieentnahmepunkt (2923) einerseits mit dem vierten Verbraucher (2933) bzw. mit der vierten Steckverbindung (3023) mit dem vierten Stecker und der vierten Buchse für den Anschluss und die Versorgung des vierten Verbrauchers (2933) andererseits verbinden kann und wobei dieses Trennen bzw. Verbinden von dem elektrischen Strom durch die zwanzigste Sicherung und/oder der elektrischen Spannung des Versorgungsleitungsrings (2910 bis 2915) im Bereich der zwanzigsten Sicherung bzw. im Bereich der vierten Steckverbindung (3023) relativ zu einem Bezugspotenzial und/oder von einem Datenbefehl über den Sicherungsdatenbus (9) abhängt. Die zwanzigste Sicherung und die elfte Sicherung (2966) und die zwölfte Sicherung (2966) können eine gemeinsame Steuervorrichtung (4) aufweisen;

3120 einundzwanzigste Sicherung der ersten Energiequelle (2940), wobei die einundzwanzigste Sicherung den ersten Energieeinspeisepunkt (2924) einerseits von der ersten Energiequelle (2940) bzw. von der fünften Steckverbindung (3024) mit dem fünften Stecker und der fünften Buchse für den Anschluss und die Versorgung der ersten Energiequelle (2940) andererseits trennen kann oder wobei die einundzwanzigste Sicherung den fünften Energieentnahmepunkt (2924) einerseits mit der ersten Energiequelle (2940) bzw. mit der fünften Steckverbindung (3024) mit dem fünften Stecker und der fünften Buchse für den Anschluss und die Versorgung der ersten Energiequelle (2940) andererseits verbinden kann und wobei dieses Trennen bzw. Verbinden von dem elektrischen Strom durch die einundzwanzigste Sicherung und/oder der elektrischen Spannung des Versorgungsleitungsrings (2910 bis 2915) im Bereich der einundzwanzigsten Sicherung bzw. im Bereich der fünften Steckverbindung (3024) relativ zu einem Bezugspotenzial und/oder von einem Datenbefehl über den Sicherungsdatenbus (9) abhängt. Die einundzwanzigste Sicherung und die dreizehnte Sicherung (2950) und die vierzehnte Sicherung (2951) können eine gemeinsame Steuervorrichtung (4) aufweisen;

3121 zweiundzwanzigste Sicherung der zweiten Energiequelle (2941), wobei die zweiundzwanzigste Sicherung den zweiten Energieeinspeisepunkt (2925) einerseits von der zweiten Energiequelle (2941) bzw. von der sechsten Steckverbindung (3025) mit dem sechsten Stecker und der sechsten Buchse für den Anschluss und die Versorgung der zweiten Energiequelle (2941) andererseits trennen kann oder wobei die zweiundzwanzigste Sicherung den sechsten Energieentnahmepunkt (2925) einerseits mit der zweiten Energiequelle (2941) bzw. mit der sechsten Steckverbindung (3025) mit dem sechsten Stecker und der sechsten Buchse für den Anschluss und die Versorgung der zweiten Energiequelle (2941) andererseits verbinden kann und wobei dieses Trennen bzw. Verbinden von dem elektrischen Strom durch die zweiundzwanzigste Sicherung und/oder der elektrischen Spannung des Versorgungsleitungsrings (2910 bis 2915) im Bereich der zweiundzwanzigsten Sicherung bzw. im Bereich der sechsten Steckverbindung (3025) relativ zu einem Bezugspotenzial und/oder von einem Datenbefehl über den Sicherungsdatenbus (9) abhängt. Die zweiundzwanzigste Sicherung und die fünfzehnte Sicherung (2952) und die sechzehnte Sicherung (2953) können eine gemeinsame Steuervorrichtung (4) aufweisen;

3200    Versorgungsnetz, das ein erstes Teilversorgungsnetz (3201) und ein zweites Teilversorgungsnetz (3202) aufweist. Wobei das erste Teilversorgungsnetz (3201) beispielsweise hohe Spannungswerte größer 50V der Spannung zwischen Versorgungsleitungsabschnitten (3260 bis 3265) des ersten Teilversorgungsnetzes (3201) einerseits und einem Bezugspotenzial (201) oder den Versorgungsleitungsabschnitten (3260 bis 3265) des zweiten Teilversorgungsnetzes (3202) andererseits aufweist. Das zweite Teilversorgungsnetz (3202) weist beispielsweise niedrige Spannungswerten kleiner 50V der Spannung zwischen Versorgungsleitungsabschnitten (3266 bis 3278) des zweiten Teilversorgungsnetzes (3202) einerseits und einem Bezugspotenzial (201) auf;

3201    erstes Teilversorgungsnetz des Versorgungsnetzwerks (3200). Das erste Teilversorgungsnetz (3201) weist beispielsweise hohe Spannungswerte größer 50V der Spannung zwischen Versorgungsleitungsabschnitten (3260 bis 3265) des ersten Teilversorgungsnetzes (3201) einerseits und einem Bezugspotenzial (201) oder den Versorgungsleitungsabschnitten (3260 bis 3265) des zweiten Teilversorgungsnetzes (3202) andererseits auf;

3202    zweites Teilversorgungsnetz des Versorgungsnetzwerks (3200). Das zweite Teilversorgungsnetz (3202) weist beispielsweise niedrige Spannungswerten kleiner 50V der Spannung zwischen Versorgungsleitungsabschnitten (3266 bis 3278) des zweiten Teilversorgungsnetzes (3202) einerseits und einem Bezugspotenzial (201) auf;

3206    Betriebsspannung für die Sicherungen im HV- Versorgungsteilnetz (3201);

3210    erste Kreuzsicherung im ersten Versorgungsteilnetz (3201) für Spannungen größer 50V;

3211    zweite Kreuzsicherung im ersten Versorgungsteilnetz (3201) für Spannungen größer 50V

3212    dritte Kreuzsicherung im ersten Versorgungsteilnetz (3201) für Spannungen größer 50V

3213    vierte Kreuzsicherung im zweiten Versorgungsteilnetz (3202) für Spannungen kleiner 50V;

3214    fünfte Kreuzsicherung im zweiten Versorgungsteilnetz (3202) für Spannungen kleiner 50V;

3215    sechste Kreuzsicherung im zweiten Versorgungsteilnetz (3202) für Spannungen kleiner 50V;

3216    siebte Kreuzsicherung im zweiten Versorgungsteilnetz (3202) für Spannungen kleiner 50V;

3217    achte Kreuzsicherung im zweiten Versorgungsteilnetz (3202) für Spannungen kleiner 50V;

3218    neunte Kreuzsicherung im zweiten Versorgungsteilnetz (3202) für Spannungen kleiner 50V;

3250    erste Energiequelle im ersten Versorgungsteilnetz (3201) für Spannungen größer 50V;

3251    zweite Energiequelle im ersten Versorgungsteilnetz (3201) für Spannungen größer 50V;

3252    dritte Energiequelle im zweiten Versorgungsteilnetz (3202) für Spannungen kleiner 50V;

3253    vierte Energiequelle im zweiten Versorgungsteilnetz (3202) für Spannungen kleiner 50V;

3254    fünfte Energiequelle im zweiten Versorgungsteilnetz (3202) für Spannungen kleiner 50V;

3255    sechste Energiequelle im zweiten Versorgungsteilnetz (3202) für Spannungen kleiner 50V;

3260 bis 3265    Versorgungsleitungsabschnitt im ersten Versorgungsteilnetz (3201) für Spannungen größer 50V;

3266 bis 3278    Versorgungsleitungsabschnitt im zweiten Versorgungsteilnetz (3202) für Spannungen kleiner 50V;

3280    Betriebsspannungsquelle für den Betrieb der Steuervorrichtungen (4) der elektronischen Sicherungen (405) im ersten HV-Versorgungsteilnetz (3201);

3290    optischer Datenbus zur galvanischen Trennung;

3300    Versorgungsnetzwerk (3300) ähnlich Figur 31 zur Erläuterung der Priorisierung von Verbrauchern und Energiequellen und einer günstigen Topologie des Versorgungsnetzwerks zur Unterstützung dieser Priorisierbarkeit;

3400    Verfahren (3400) zum aktiven Power-Management in einem Versorgungsnetzwerk (1100) mit elektrischen Sicherungen (1110 bis 1118) zur Versorgung elektrischer Verbraucher (1121 bis 1125) in diesem Versorgungsnetzwerk (1100) mit elektrischer Energie einer oder mehrerer elektrischer Energiequellen (1150 bis 1155);

3410    Erfassen (3410) des Werts der elektrischen Ströme (29) durch einen oder mehrere Leistungsschalter (17) einer oder mehrerer elektronischer Sicherungen der Sicherungen (1110 bis 1118) des Versorgungsnetzwerks (1100);

3420 Erfassen (3420) des Werts der Spannungsdifferenz zwischen einem Anschluss (26, 27, 28) dieses Leistungsschalters (17) gegen ein Bezugspotenzial (201) eines Bezugspotenzialkontakts;

3430 Berechnen (3430) des theoretischen Masseversatzes infolge der Bestromung der Leistungsschalter durch den jeweiligen Rechnerkern der jeweiligen Steuervorrichtung der jeweiligen Sicherung mittels Modellbildung;

3440 Korrektur (3440) der entsprechenden Spannungsmesswerte um den theoretischen Masseversatz;

3450 Schließen (3450) auf Zustandsparameter von Versorgungsleitungsabschnitten der Versorgungsleitungsabschnitte (3260 bis 3278) mit Hilfe der so erfassten Parameter wie Stromwerten und Spannungswerten;

3460 Ermitteln (3460) der Temperatur mit Hilfe eines bekannten Temperaturkoeffizienten des Leitungsmaterials des Versorgungsleitungsabschnitts der Versorgungsleitungsabschnitte (3260 bis 3278) und der bekannten Konstruktionsdaten;

3500 Verfahren (3500) zum Betrieb eines Fahrzeugs mit Konfigurationsvarianten, die die Sicherungen einstellen.

3505 Bereitstellen (3505) eines Fahrzeugs mit einem Versorgungsnetzwerk (3300) zur Versorgung elektrischer Verbraucher (2930, 2931) des Fahrzeugs mit elektrischer Energie. Dabei weist das Fahrzeug eine oder mehrere Energiequellen (2940, 2941), einen oder mehrere Verbraucher (2930, 2931) und mehrere elektronische Sicherungen (2960 bis 2963 und 2959 bis 2953) auf. Die Verbraucher (2930, 2931) sind bevorzugt mittels Versorgungsleitungen (2915, 2910, 2911) mit der einen Energiequelle oder den mehreren Energiequellen (2940, 2941) verbunden. Die Verbraucher (2930, 2931) und die Energiequellen (2940, 2941) sind bevorzugt zusammen mit den Versorgungsleitungen (2915, 2910, 2911) in einer Baumstruktur (3300) oder einem Netzwerk miteinander verbunden. Die Baumstruktur Teilbäume bzw. das Netzwerk umfassen bevorzugt Teilnetzwerke ([2915, 3015, 3025, 2941]; [2940, 3024, 3014, 2910, 3010, 3020, 2930]; [2911, 3011, 2931]). Zum Ersten sind bevorzugt elektronische Sicherungen (2960 bis 2963 und 2959 bis 2953) in Versorgungsleitungen eingefügt, sodass diese Teilbäume der Baumstruktur von der restlichen Baumstruktur abtrennen können oder mit dieser restlichen Baumstruktur verbinden können und/oder zum Zweiten sind elektronische Sicherungen (2916, 2962, 2951, 2952) in Versorgungsleitungen eingefügt, sodass diese Teilnetzwerke ([2915, 3015, 3025, 2941]; [2911, 3011, 3021, 2931]) des Netzwerks (3300) von dem restlichen Netzwerk (3300) abtrennen oder mit diesem restlichen Netzwerk (3300) verbinden können. Diese Teilnetzwerke ([2915, 3015, 3025, 2941]; [2911, 3011, 3021, 2931]) und/oder Teilbäume verfügen dann typischerweise nach einer Abtrennung im Wesentlichen über keine Energieversorgung und/oder keinen Energieverbrauch mehr;

3510 Programmierung (3510) von bestimmten Ausstattungsvarianten. Dabei unterscheidet sich eine erste Ausstattungsvariante dieser Ausstattungsvarianten des Fahrzeugs sich von einer zweiten Ausstattungsvariante dieser Ausstattungsvarianten des Fahrzeugs bevorzugt dadurch, dass zumindest eine elektronische Sicherung dieser elektronischen Sicherungen (2916, 2962, 2951, 2952) einen Teilbaum der Baumstruktur bzw. ein Teilnetzwerk ([2915, 3015, 3025, 2941]; [2911, 3011, 3021, 2931]) des Netzwerks (3300) in der ersten Ausstattungsvariante von der restlichen Baumstruktur bzw. dem restlichen Netzwerk (3300) abtrennt und in der zweiten Ausstattungsvariante mit der restlichen Baumstruktur bzw. dem restlichen Netzwerk (3300) verbindet, sodass die Energiequelle diesen Teilbaum bzw. dieses Teilnetzwerk ([2915, 3015, 3025, 2941]; [2911, 3011, 3021, 2931]) nur in der zweiten Ausstattungsvariante mit elektrischer Energie der Energiequelle vollständig versorgen kann bzw. dieser Teilbaum bzw. dieses Teilnetzwerk ([2915, 3015, 3025, 2941]; [2911, 3011, 3021, 2931]) nur in der zweiten Ausstattungsvariante einen elektrischen Energieverbrauch eines oder mehrerer elektrischer Verbraucher (29319 des betreffenden Teilnetzwerks ([2915, 3015, 3025, 2941]; [2911, 3011, 3021, 2931]) aufweisen kann. Ggf. Programmierung (3510) von bestimmten Ausstattungsvarianten durch Übermittlung von Programmierdaten an Steuervorrichtungen (4) elektronischer Sicherungen über einen Datenbus (9);

3515 verschlüsselte Kommunikation (3515) über den Steuerdatenbus (9) zur Programmierung der Ausstattungsvarianten und/oder Kommunikation über den Steuerdatenbus (9) zur Programmierung der Ausstattungsvarianten nur nach Übertragung eines Passworts an die Steuervorrichtung (4) der entsprechenden elektronischen Sicherung;

3520 Übermitteln (3520) von Authentifizierungsdaten an einen Server (710) eines Freischaltcodeanbieters;

3525 Verifikation (3525) der übermittelten Authentifizierungsdaten;

3530 Erzeugen (3530) eines Freischaltcodes mit Hilfe von diesen oder anderen Authentifizierungsdaten nach einem feststehenden Verfahren und Bereitstellen des Freischaltcodes;

3535 ggf. Kaufen (3535) eines Freischaltcodes über eine Datenverbindung zu dem Server des Freischaltcodeanbieters;

3540 Übermitteln (3540) des Freischaltcodes an ein übergeordnetes Rechnersystem (12) des Fahrzeugs;

3545 Übermitteln (3545) eines Freischaltcodes für eine Ausstattungsvariante auf Basis des erhaltenen Freischaltcodes von dem übergeordneten Rechnersystem (12) an die Steuervorrichtung (4) der elektronischen Sicherung und Programmierung (3510) der freigeschalteten Ausstattungsvariante.

3550 Erfassen (3550) und ermitteln der Energie die eine elektronische Sicherung in einem Versorgungsteilzweig ([2915, 3015, 3025, 2941]; [2911, 3011, 3021, 2931]) des Versorgungsbaumes (3300) durchströmt als Messwert der Energiemenge und/oder der zugrundeliegenden Messwerte in der elektronischen Sicherung;

3555 Auslesen (3555) des Messwerts der ermittelten Energiemenge und/oder der zugrundeliegenden Messwerte aus der elektronischen Sicherung;

3560 Übermittlung (3560) des Messwerts der ermittelten Energiemenge und/oder der zugrundeliegenden Messwerte über eine Datenübertragungsstrecke (720), die bevorzugt verschlüsselt ist, vom übergeordneten Rechnersystem (12) an einen Rechner (750) eines Dienstleistungsanbieters, beispielsweise einen Energieversorger oder dessen Erfüllungsgehilfen;

3665 Erstellung (3565) einer Rechnung auf Basis des übermittelten Messwerts der ermittelten Energiemenge und/oder der zugrundeliegenden Messwerte;

3570 Ermitteln (3570) der Topologie des Versorgungsnetzwerks unter Nutzung elektronischer Sicherungen des Versorgungsnetzwerks;

3575 Vergleich (3575) der ermittelten Topologie des Versorgungsnetzwerks mit der gültigen oder einzustellenden Ausstattungsvariante zur Plausibilisierung der Ausstattungsvariante bzw. der Zulässigkeit der Ermittelten Topologie des Versorgungsnetzwerks.

3900 Beispielhafte SPAD-Diode 30 für den Einsatz als Sensorelement eines Einzelphotonendetektors;

3941 Isolation, beispielsweise Shallow-Trench-Isolation STI 3941 der beispielhaften SPAD-Diode 3954, 3955 oder LOCOS-Isolation;

3942 Anodenkontakt 3942 der beispielhaften SPAD-Diode 3954, 3955;

3943 Kathodenkontakt 3943 der beispielhaften SPAD-Diode 3954, 3955. Der Kathodenkontakt 3943 der beispielhaften SPAD-Diode 3954, 3955 ist bevorzugt aus Indium-Zinn-Oxid (ITO) oder einem anderen transparenten und elektrisch leitendem Material gefertigt;

3944 Lichtwellenleiter 3944 für den Transport der Photonen der ersten SPAD-Diode 3954 zur zweiten SPAD-Diode 3955. Der Lichtwellenleiter 3944 ist aus einem Abdeckoxid 3944 oder optisch transparente Isolierschicht 3944 der beispielhaften SPAD-Diode 3954, 3955 gefertigt;

3945 hoch dotiertes erstes Anschlussgebiet 3945 eines ersten Leitungstyps, auch als n+ S/D Implantation bezeichnet. In einer CMOS-Technologie mit einem p-dotiertem Wafer-Material kann es sich beispielsweise um ein n+-dotiertes Gebiet im halbleitenden Substratmaterial der SPAD-Diode 3954, 3955 handeln;

3946 erste dotierte Wanne 3946 eines zweiten Leitungstyps. In einer CMOS-Technologie mit einem p-dotiertem Wafer-Material kann es sich beispielsweise um ein p- --dotiertes Gebiet im halbleitenden Substratmaterial der SPAD-Diode 3944, 3955 handeln;

3947 zweite dotierte Wanne 3947 eines zweiten Leitungstyps. In einer CMOS-Technologie mit einem p-dotiertem Wafer-Material kann es sich beispielsweise um ein p--dotiertes Gebiet im halbleitenden Substratmaterial der SPAD-Diode 3954, 3955 handeln;

3948 epitaktische Schicht 3948 eines zweiten Leitungstyps. In einer CMOS-Technologie mit einem p-dotiertem Wafer-Material kann es sich beispielsweise um eine p-dotierte epitaktische Schicht im halbleitenden Substratmaterial der SPAD-Diode 3954, 3955 handeln;

3949 Basismaterial 3949 des halbleitenden einkristallinen Wafers, der einen zweiten Leitungstyp aufweist. In einer CMOS-Technologie mit einem p-dotiertem Wafer-Material handelt es sich beispielsweise um einen p-dotierten einkristallinen Halbleiter-Wafer;

3950 zweite dotierte Wanne eines zweiten Leitungstyps unterhalb des Anodenkontakts. In einer CMOS-Technologie mit einem p-dotiertem Wafer-Material kann es sich beispielsweise um ein p--dotiertes Gebiet im halbleitenden Substratmaterial der SPAD-Diode 3954, 3955 handeln;

3951 hoch dotiertes zweites Anschlussgebiet eines zweiten Leitungstyps, auch als p+ S/D Implantation bezeichnet. In einer CMOS-Technologie mit einem p-dotiertem Wafer-Material kann es sich beispielsweise um ein p+-dotiertes Gebiet im halbleitenden Substratmaterial der SPAD-Diode 3954, 3955 handeln;

3952 Isolation, beispielsweise ein optisch transparentes Oxid, insbesondere Siliziumdioxid, oder dergleichen;

| | |
|---|---|
| 3953 | Metallabdeckung des Lichtwellenleiters 3944; |
| 3954 | Erste SPAD-Diode. Die erste SPAD-Diode 3955 dient zumindest zeitweise als Lichtquelle für die Bestrahlung der zweiten SPAD-Diode 3955 mit Photonen der ersten SPAD-Diode 3954; |
| 3955 | Zweite SPAD-Diode 3955. Die zweite SPAD-Diode 3955 dient beispielsweise zumindest zeitweise als Fotodetektor für das Licht der ersten SPAD-Diode 3954. |
| 3956 | Oberfläche 3956 des Wafers im Sinne der hier vorgelegten Schrift; |
| 3957 | vertikal nach oben in senkrechter Richtung zur Oberfläche 3956 emittiertes Licht 3957 der ersten SPAD-Diode 3954; |
| 3958 | horizontal im Lichtwellenleiter 3944 transportiertes Licht 3958, das ein Teil des vertikal von der ersten SPAD-Diode 3954 in den Lichtwellenleiter 3944 eingestrahlten Lichts 3957 ist; |
| 3959 | vertikal nach unten in senkrechter Richtung zur Oberfläche 3956 aus dem Lichtwellenleiter 3944 in die zweite SPAD-Diode 3955 eingestrahltes Licht 3959 der ersten SPAD-Diode 3954, das von der ersten SPAD-Diode 3954 als senkrechtes Licht 3957 in den Lichtwellenleiter 3944 hinein emittiert wurde und dann vom Lichtwellenleiter 3944 horizontal zur zweiten SPAD-Diode 3955 transportiert wurde. |
| 4040 | Kontakt; |
| 4041 | Metall 1 Leitungen; |
| 4042 | Metall 2 Leitungen / Metall 2 Deckel; |
| 4043 | erste Isolationsschicht; |
| 4044 | zweite Isolationsschicht; |
| 4100 | Quantenzufallszahlengenerator QRNG; |
| 4101 | Entropie-Quelle; |
| 4101.1 | ein oder mehrere erste SPAD-Dioden; |
| 4101.2 | Lichtwellenleiter; |
| 4101.3 | ein oder mehrere zweite SPAD-Dioden; |
| 4102 | Hochfrequenzverstärker; |
| 4103 | Analog-Digital-Converter (ADC); |
| 4104 | Auswertevorrichtung, die im Wesentlichen Teilvorrichtungen der Steuervorrichtung 4 der Sicherung 1 umfasst; |
| 4104.1 | Konstante; |
| 4104.2 | Komparator; |
| 4104.3 | Zeit-zu-Digital-Konverter (Time-to-Digital-Converter, TDC); |
| 4104.4 | Entropie-Extraktions-Vorrichtung 4104.4 |
| 4104.5 | Watchdog des Quantenzufallszahlengenerators 4100, 60 bzw. der Steuervorrichtung 4 der Sicherung 1; |
| 4104.6 | Pseudozufallszahlengenerator, insbesondere linear rückgekoppeltes Schieberegister LFSR. Die Rückkopplung des LFSR ist bevorzugt ein einfach primitives Polynom, um Pseudozufallsbittfolgen zu erzeugen. Andere Realisierungen eines Pseudozufallszahlengenerators wie z.B. das Ausgeben vorerzeugter und gespeicherter Zufallsbits, die mit einem oder mehreren echten Zufallsbits z.B. mittels einer XOR-Verknüpfung verschränkt werden, sind möglich. Wichtig ist, dass der Seed eines solchen PRNGs möglichst von einer Quantenzufallszahl oder einer Zufallszahl eines echten Zufallszahlengenerators (TRNG) abhängt.; |
| 4104.7 | Signal-Multiplexer; |
| 4104.8 | Finite State Machine (endlichen Automaten); |
| 4104.9 | RAM Das RAM kann mit dem flüchtigen Speicher 15 identisch sein; |
| 4104.10 | Finish Flag; |
| 4104.11 | Microcontroller. Der Microcontroller kann mit dem Rechnerkern 2 identisch sein; |
| 4105 | Spannungs- / Stromsignal der Entropie Quelle 4101, Signale der Strompulse; |
| 4106 | Verstärkerausgangssignal 4106 des Hochfrequenzverstärkers 4102; |
| 4107 | digitaler 14 Bit Wert 4107 des Analog-zu-Digital-Wandlers 4103. Andere Bitbreiten sind denkbar. Der Analog-zu-Digital-Wandler kann mit dem Analog-zu-Digital-Wandler 570 identisch sein; |
| 4108 | Signal der Konstanten 4104.1; |
| 4109 | Ausgangssignal 4109 des Komparators 4104.2, bereinigtes Pulssignal; |
| 4110 | Ausgang 4110 des Zeit-zu-Digital-Wandlers 4104.3; |
| 4111 | Ausgang der Entropie Extraktion 4104.4; |
| 4112 | Seed S; |
| 4113 | Spannungsmonitor; |

| | |
|---|---|
| 4114 | Signalleitungen; |
| 4116 | Selektionssignal; |
| 4117 | Pseudozufallssignalleitung; |
| 4118 | Zufallsdatenwörter; |
| 4119 | interner Datenbus des Quantenzufallszahlengenerators 60, 4100. Bevorzugt handelt es sich um den internen Datenbus 11 der Steuervorrichtung 4; |
| 4120 | Interrupt Signal des Watchdogs 4104.5 des Quantenzufallszahlengenerators 4100 bzw. der Steuervorrichtung 4 der Sicherung 1; |
| 4300 | Flussdiagramm 4300 des Entropie Extraktionsverfahrens; |
| 4301 | erster Schritt 4301 mit Ermittlung des ersten Werts des Ausgangs 410 des Zeit-zu-Digital-Wandlers 4104.3 und des zweiten Werts des Ausgangs 4110 des Zeit-zu-Digital-Wandlers 4104.3 und Speicherung in einem Schieberegister der Entropie Extraktion 4104.4; |
| 4302 | zweiter Schritt des Vergleichens des ersten Werts mit dem zweiten Wert; |
| 4303 | dritter Schritt der Bewertung des ersten Werts und des zweiten Werts und der Erzeugung des Zufallsbits; |
| 4401 | erste Spikes; |
| 4402 | zweite Spikes; |
| 4403 | Schneidepegel; |
| 4500 | Erzeugung eines Socket-Descriptors; |
| 4510 | Binden des Socket-Descriptors an einen Port und eine IP-Adresse; |
| 4520 | passiver Wartezustand und Warten auf Verbindungsanfragen eines Microcontrollers 2 eines Clients; |
| 4530 | Herstellen einer Verbindung vom Rechnerkern 2 der Steuervorrichtung 4 der Sicherung 1 (Server) zum Rechnerkern 2 der Steuervorrichtung 4 einer anderen Sicherung 1 (Client) oder zum übergeordneten Rechnersystem 12 (Client) durch den Rechnerkern 2der Steuervorrichtung 4 der Sicherung 1(Server) (oder umgekehrt); |
| 4540 | Erzeugen einer Quantenzufallszahl 4111 und Erzeugung eines öffentlichen und eines privaten Schlüssels mittels eines RSA-Verfahrens durch den Rechnerkern 2 der Steuervorrichtung 4 der Sicherung 1 (Server) mittels eines Quantenzufallszahlengenerators 60 QRNG und eines RSA-Verfahrens. |
| 4550 | Warten auf eine verschlüsselte Nachricht des Rechnerkerns 2 der Steuervorrichtung 4 der anderen Sicherung (Client) oder auf eine verschlüsselte Nachricht des übergeordneten Rechnersystems 12 (Client) durch den Rechnerkern 2 der Steuervorrichtung 4 der Sicherung 1 (Server); |
| 4560 | Entschlüsseln der Nachricht des mittels des in einem Speicher des Rechnerkerns 2 der Steuervorrichtung 4 der Sicherung 1 zwischengespeicherten privaten Schlüssels aus dem Schritt 3540 gemäß des RSA-Verfahrens; |
| 4570 | Verschlüsselung der Nachricht des Rechnerkerns 2 der Steuervorrichtung 4 der Sicherung 1 (Server) mittels des öffentlichen Schlüssels des Rechnerkerns 2 der Steuervorrichtung 4 der anderen Sicherung 1 (Client) aus Schritt 4540 oder mittels des öffentlichen Schlüssels des übergeordneten Rechnersystems 12 (Client) aus Schritt 4540 gemäß des RSA-Verfahrens durch den Rechnerkern 2 der Steuervorrichtung 4 der Sicherung 1 (Server); |
| 4580 | Senden der im Zwischenspeicher des Rechnerkerns 2 der Steuervorrichtung 4 der Sicherung 1 (Server) gespeicherten, verschlüsselten Nachricht an den Rechnerkern 2 der Steuervorrichtung 4 der anderen Sicherung 1 (Client) oder an das übergeordnete Rechnersystem 12 (Client) über die Datenbusschnittstelle 10,610, 550, 551 des Rechnerkerns 2 der Steuervorrichtung 4 der Sicherung 1 (Server) und über den Datenbus 9 und über die Datenschnittstelle 10. 610, 550, 551 des Rechnerkerns 2 der Steuervorrichtung 4 der anderen Sicherung 1 (Client) oder über die Datenbusschnittstelle 555 des übergeordneten Rechnersystems 12 (Client); |
| 4590 | Ausführen der Funktion close() und Schließen der offenen Verbindung zu einem Socket, hier dem Socket des Clients, und Beenden der Kommunikation mit dem Rechnerkern 2 der Steuervorrichtung 4 der anderen Sicherung 1 (Client) und/oder mit dem übergeordneten Rechnersystem 12 (Client) durch den Rechnerkern 2 der Steuervorrichtung 4 der Sicherung 1 (Server); |
| 4600 | Erzeugen eines Socket-Descriptors durch den Rechnerkern 2 der Steuervorrichtung 4 der anderen Sicherung 1 (Client) und/oder durch das übergeordnete Rechnersystem 12 (Client) und stellen einer Verbindungsanfrage an den Rechnerkern 2 der Steuervorrichtung 4 der Sicherung 1 unter Benutzung des Ports und der IP-Adresse, welche in dem Schritt 4510 festgelegt wurden, durch den Rechnerkern 2 der Steuervorrichtung 4 der anderen Sicherung (Client) bzw. das übergeordnete Rechnersystem 12 (Client); |
| 4610 | Herstellen einer Verbindung zwischen dem Server-Socket aus dem Schritt 4510 und dem Client-So- |

cket aus dem Schritt 4600;

4620    Erzeugen einer Quantenzufallszahl 4111 und Erzeugung eines öffentlichen und eines privaten Schlüssels mittels eines RSA-Verfahrens durch den Rechnerkern 2 der Steuervorrichtung 4 der anderen Sicherung 1(Client) bzw. durch das übergeordnete Rechnersystem 12 (Client) mittels eines Quantenzufallszahlengenerators 60 QRNG und eines RSA-Verfahrens;

4630    Verschlüsseln der eigenen Nachricht des Clients mittels des öffentlichen Schlüssels Rechnerkerns 2 der Steuervorrichtung 4 der Sicherung 1 (Server) aus Schritt 4540 mittels des RSA-Verfahrens durch den Rechnerkern 2 der Steuervorrichtung 4 der anderen Sicherung 1 (Client) bzw. durch das übergeordnete Rechnersystem 12 (Client);

4640    Senden der verschlüsselten Nachricht des Clients an den Rechnerkern 2 der Steuervorrichtung 4 der Sicherung 1 (Server) durch den Rechnerkern 2 der Steuervorrichtung 4 der anderen Sicherung (Client) bzw. durch das übergeordnete Rechnersystem 12 (Client);

4650    Warten auf eine verschlüsselte Nachricht des Rechnerkerns 2 der Steuervorrichtung 4 der Sicherung 1 (Server) durch den Rechnerkern 2 der Steuervorrichtung 4 der anderen Sicherung 1 (Client) bzw. durch das übergeordnete Rechnersystem 12 (Client) und Empfangen einer Nachricht des Rechnerkerns 2 der Steuervorrichtung 4 der Sicherung 1 (Server) durch den Rechnerkern 2 der Steuervorrichtung 4 der anderen Sicherung 1 (Client) bzw. durch das übergeordnete Rechnersystem 12 (Client) und Speichern der so empfangenen und typischerweise verschlüsselten Nachricht Rechnerkerns 2 der Steuervorrichtung 4 der Sicherung 1 (Server) in einem temporären Zwischenspeicher des Rechnerkerns 2 der Steuervorrichtung 4 der anderen Sicherung (Client) bzw. des übergeordneten Rechnersystems 12 (Client) durch den Rechnerkern 2 der Steuervorrichtung 4 der anderen Sicherung 1 (Client) bzw. durch das übergeordnete Rechnersystem 12 (Client) und Lesen der ankommende Daten des Rechnerkerns 2 der Steuervorrichtung 4 der Sicherung 1 (Server) durch den Rechnerkern 2 der Steuervorrichtung 4 der anderen Sicherung (Client) bzw. durch das übergeordnete Rechnersystem 12 (Client) mittels Ausführen der Funktion recv() von einem Socket-Descriptor, in diesem Fall von dem Socket-Descriptor des Rechnerkerns 2 der Steuervorrichtung 4 der anderen Sicherung 1 (Client) bzw. des übergeordneten Rechnersystems 12 (Client) aus dem Schritt 4600 und speichern die gelesenen Daten vorzugsweise in einen temporären Zwischenspeicher des Rechnerkerns 2 der Steuervorrichtung 4 der anderen Sicherung 1 (Client) bzw. des übergeordneten Rechnersystems 12 (Client) durch den Rechnerkern 2 der Steuervorrichtung 4 der anderen Sicherung 1 (Client) bzw. durch das übergeordnete Rechnersystem 12 (Client);

4660    Entschlüsseln einer durch Rechnerkern 2 der Steuervorrichtung 4 der anderen Sicherung 1 (Client) bzw. durch das übergeordnete Rechnersystem 12 (Client) empfangenen, verschlüsselten Nachricht des Rechnerkerns 2 der Steuervorrichtung 4 der Sicherung 1 (Server) durch den Rechnerkern 2 der Steuervorrichtung 4 der anderen Sicherung 1 (Client) bzw. durch das übergeordnete Rechnersystem 12 (Client) mittels der Ausführung der Funktion Decrypt() durch den Rechnerkern 2 der Steuervorrichtung 4 der anderen Sicherung 1 (Client) bzw. durch das übergeordnete Rechnersystem 12 (Client) unter Verwendung des privaten Schlüssels des Rechnerkerns 2 der Steuervorrichtung 4 der anderen Sicherung 1 (Clients) bzw. des privaten Schlüssels des übergeordneten Rechnersystems 12 (Client) aus dem Schritt 4620 mittels des RSA-Verfahrens und anschließendes Speichern der so entschlüsselten Nachricht in einen temporären Zwischenspeicher des Rechnerkerns 2 der Steuervorrichtung 4 der anderen Sicherung 1 (Client) bzw. durch das übergeordnete Rechnersystem 12 (Client) durch den Rechnerkern 2 der Steuervorrichtung 4 der anderen Sicherung 1 (Client) bzw. durch das übergeordnete Rechnersystem 12 (Client);

4670    Schließen der offenen Verbindung zu dem Socket durch den Rechnerkern 2 der Steuervorrichtung 4 der anderen Sicherung 1 (Client) bzw. durch das übergeordnete Rechnersystem 12 (Client) und Beenden der Kommunikation mit dem Rechnerkern 2 der Steuervorrichtung 4 der Sicherung 1 (Server) durch den Rechnerkern 2 der Steuervorrichtung 4 der anderen Sicherung 1 (Client) bzw. durch das übergeordnete Rechnersystem 12 (Client);

4700    Erzeugung zweier verschiedener Primzahlen p und q und des Produkts n=p*q und des Ergebnisses der Eulerschen Phi-Funktion phi = (p-1)(q-1) durch den Rechnerkern 2 der Steuervorrichtung 4 der Sicherung 1 (Server) mittels der Funktion KeyExchangeServer();

4710    Erzeugung einer zu phi teilerfremden Zahl e mittels Aufruf der Funktion setE() durch den Rechnerkern 2 der Steuervorrichtung 4 der Sicherung 1 (Server), wobei die Zahl phi diejenige aus dem Schritt 3200 ist und wobei teilerfremd in Sinne des vorliegenden Dokuments bedeutet, dass es keine natürliche Zahl außer der Zahl eins gibt, die gleichzeitig die Zahl e und die Zahl phi gleichzeitig ganzzahlig teilt;

4720    Berechnung des multiplikativen Inversen zur Zahl e mittels des Rechnerkerns 2 der Steuervorrichtung 4 der Sicherung 1 (Server) unter Verwendung der Funktion findD(), sodass gilt (e*d)mod phi = 1;

4730 Warten auf eine eintreffende Nachricht des Rechnerkerns 2 der Steuervorrichtung 4 der anderen Sicherung 1 (Client) bzw. des übergeordneten Rechnersystems 12 (Client), die typischerweise den öffentlichen Schlüssel des Clients bzw. des übergeordneten Rechnersystems 12 (Client) umfassen sollte, durch den Rechnerkern 2 der Steuervorrichtung 4 der Sicherung 1 (Server) und Lesen der ankommenden Daten von einem Socket-Descriptor, in diesem Fall der Socket-Descriptor des Client durch den Rechnerkern 2 der Steuervorrichtung 4 der Sicherung 1 (Server) und Speichern die gelesenen Daten vorzugsweise in einen temporären Zwischenspeicher des Rechnerkerns 2 der Steuervorrichtung 4 der Sicherung 1 (Server);

4740 Versenden des öffentlichen Schlüssels (d, n) des Rechnerkerns 2 der Steuervorrichtung 4 der Sicherung 1 (Server) aus den Schritten 4700 und 4720 d durch den Rechnerkern 2 der Steuervorrichtung 4 der Sicherung 1 (Server) an den Rechnerkern 2 der Steuervorrichtung 4 der anderen Sicherung 1 (Client) bzw. an das übergeordnete Rechnersystem 12 (Client) über einen Socket-Descriptor, in diesem Fall der Socket-Descriptor des Clients aus dem Schritt 4530;

4745 Verlassen der Funktion KeyExchangeServer() durch den Rechnerkern 2 der Steuervorrichtung 4 der Sicherung 1 (Server);

4750 Erzeugen der Primzahl p und Erzeugen der von q verschiedenen Primzahl q und Erzeugen des Produkts n=p*q und Erzeugen der Eulerschen Phi-Funktion phi = (p-1)(q-1) jeweils durch den Rechnerkern 2 der Steuervorrichtung 4 der anderen Sicherung 1 (Client) bzw. durch das übergeordnete Rechnersystem 12 (Client) mittels der Funktion KeyExchangeClient();

4760 Erzeugen eine zur Zahl phi aus dem Schritt 4750 teilerfremden ganzen Zahl e durch den Rechnerkern 2 der Steuervorrichtung 4 der anderen Sicherung 1 (Client) bzw. durch das übergeordnete Rechnersystem 12 (Client) mittels der Funktion setE(), wobei teilerfremd in Sinne des vorliegenden Dokuments bedeutet, dass es keine natürliche Zahl außer der Zahl eins gibt, die gleichzeitig die Zahl e und die phi restfrei teilt;

4770 Berechnen des multiplikativen Inversen zur Zahl e durch den Rechnerkern 2 der Steuervorrichtung 4 der anderen Sicherung 1 (Client) bzw. durch das übergeordnete Rechnersystem 12 (Client) mittels der Funktion findD(), sodass gilt (e*d)mod phi = 1;

4780 Versenden des öffentlichen Schlüssels (d, n) des Rechnerkerns 2 der Steuervorrichtung 4 der Sicherung 1 (Clients) bzw. des übergeordneten Rechnersystems 12 (Client) aus den Schritten 4750 und 4770 an den Rechnerkern 2 der Steuervorrichtung 4 der Sicherung 1 (Server) durch den Rechnerkern 2 der Steuervorrichtung 4 der anderen Sicherung 1 (Client) bzw. durch das übergeordnete Rechnersystem 12 (Client), wobei der Rechnerkern 2 der Steuervorrichtung 4 der anderen Sicherung 1 (Client) bzw. das übergeordnete Rechnersystem 12 (Client) mittels der Funktion send() Daten über einen Socket-Descriptor, in diesem Fall der Socket-Descriptor des Clients aus Schritt 4600, sendet;

4790 Warten auf eine eintreffende Nachricht des Rechnerkerns 2 der Steuervorrichtung 4 der Sicherung 1 (Server), die mit dem öffentlichen Schlüssel des Rechnerkerns 2 der Steuervorrichtung 4 der Sicherung 1 (Server) verschlüsselt ist, durch den Rechnerkern 2 der Steuervorrichtung 4 der anderen Sicherung 1 (Client) bzw. durch das übergeordnete Rechnersystem 12 (Client) und lesen ankommender Daten des Rechnerkerns 2 der Steuervorrichtung 4 der Sicherung 1 (Server) von einem Socket-Descriptor, in diesem Fall von dem Socket-Descriptor des Clients aus Schritt 4600, durch den e durch den Rechnerkern 2 der Steuervorrichtung 4 der anderen Sicherung 1 (Client) bzw. durch das übergeordnete Rechnersystem 12 (Client) mittels der Funktion recv() und speichern dieser Daten in einen temporären Zwischenspeicher des Rechnerkerns 2 der Steuervorrichtung 4 der anderen Sicherung 1 (Client) bzw. des übergeordneten Rechnersystems 12 (Client) durch den Rechnerkern 2 der Steuervorrichtung 4 der anderen Sicherung 1 (Client) bzw. durch das übergeordnete Rechnersystem 12 (Client);

4795 Verlassen der Funktion KeyExchangeClient() durch den Rechnerkern 2 der Steuervorrichtung 4 der anderen Sicherung 1 (Client) bzw. durch das übergeordnete Rechnersystem 12 (Client);

4800 Erzeugen einer Zufallszahl mittels eines Quantum Random Number Generators 28 QRNG durch den aufrufenden Rechnerkern 2 der aufrufenden Steuervorrichtung der aufrufenden Sicherung 1 bzw. durch das aufrufende übergeordnete Rechnersystem 12 und Ermitteln einer Primzahl in Abhängigkeit von dieser Zufallszahl durch den aufrufenden ersten Prozessor 10-1 und Abspeichern dieser Primzahl als Variable p in dem Speicher des Rechners, der Teil des aufrufenden Rechnerkerns 2 der aufrufenden Steuervorrichtung der aufrufenden Sicherung 1 bzw. des aufrufenden übergeordneten Rechnersystems 12 ist;

4810     Erzeugen einer zweiten Zufallszahl mittels eines Quantenzufallszahlengenerators 60 durch den aufrufenden Rechnerkern 2 der aufrufenden Steuervorrichtung der aufrufenden Sicherung 1 bzw. durch das aufrufende übergeordnete Rechnersystem 12 und Ermitteln einer Primzahl in Abhängigkeit von dieser Zufallszahl durch den aufrufenden Rechnerkern 2 der aufrufenden Steuervorrichtung der aufrufenden Sicherung 1 bzw. durch das aufrufende übergeordnete Rechnersystem 12 und Abspeichern dieser Primzahl als Variable q in dem Speicher des Rechners, der Teil des aufrufenden Rechnerkerns 2 der aufrufenden Steuervorrichtung der aufrufenden Sicherung 1 bzw. des aufrufenden übergeordneten Rechnersystems 12 ist;

4820     Überprüfung, ob die logische Aussage q==p gilt, durch den aufrufenden Rechnerkern 2 der aufrufenden Steuervorrichtung der aufrufenden Sicherung 1 bzw. durch das aufrufende übergeordnete Rechnersystem 12 und Wiederholen der Schritte ab dem Schritt 4810 durch den aufrufenden Rechnerkern 2 der aufrufenden Steuervorrichtung der aufrufenden Sicherung 1 bzw. durch das aufrufende übergeordnete Rechnersystem 12, wenn diese Aussage gilt;

4830     Berechnen des Produkts n= p * q durch den aufrufenden Rechnerkern 2 der aufrufenden Steuervorrichtung der aufrufenden Sicherung 1 bzw. durch das aufrufende übergeordnete Rechnersystem 12;

4840     Berechnen der Eulerschen Phi-Funktion phi = (q-1) * (p-1) durch den aufrufenden Rechnerkern 2 der aufrufenden Steuervorrichtung der aufrufenden Sicherung 1 bzw. durch das aufrufende übergeordnete Rechnersystem 12;

4850     Verlassen der Funktion setPrimes() durch den aufrufenden Rechnerkern 2 der aufrufenden Steuervorrichtung der aufrufenden Sicherung 1 bzw. durch das aufrufende übergeordnete Rechnersystem 12;

4900     Ablauf der Funktion SetE(), Beim Aufrufen der Funktion setE() im Schritt 3400 generiert der aufrufende Rechner, in Fall des vorliegenden Dokuments der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client), eine zufällige Zahl e für die gilt, dass e teilerfremd zur Zahl phi ist. Teilerfremd in Sinne des vorliegenden Dokuments bedeutet, dass es keine natürliche Zahl außer der Zahl eins gibt, die gleichzeitig die Zahl e und die phi teilt. Der aufrufende Rechner, in Fall des vorliegenden Dokuments der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client), kann die Zahl e sowohl durch eine Zufallszahl des Quantenzufallszahlengenerators 60 QRNG als auch durch einen Pseudozufallszahlengenerator PRNG als auch durch einen echten Zufallszahlengenerator TRNG oder einen Zufallszahlengenerator RNG als auch durch Hochintegrieren einer Integer-Zahl beginnend mit 2 erzeugen. Die Erzeugung mittels des Quantenzufallszahlengenerators 60 QRNG ist aber bevorzugt;

4910     Überprüfen, ob die logische Aussage gcd(e,phi) != 1 erfüllt ist, durch den aufrufenden Rechner, in Fall des vorliegenden Dokuments der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client), und wiederholen des Schritts 4905 durch den aufrufenden Rechner, wenn die logische Aussage erfüllt ist. Der aufrufende Rechner berechnet mittels dieser Funktion gcd(a,b) den größten gemeinsamen Teiler der Übergabeparameter a, b und gibt das Ergebnis an den aufrufenden Rechner zurück;

4920     Verlassen der Funktion setE() und Rückgabe des aktuellen Werts von e als Rückgabewert an den aufrufenden Rechner durch den aufrufenden Rechner, wenn die logische Aussage gcd(e,phi) != 1 nicht erfüllt ist. Der aufrufende Rechner ist hier der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client), je nachdem;

5000     Initialisieren einer Variablen d mit 0 durch den aufrufenden Rechner, hier, in Fall des vorliegenden Dokuments der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client);

5010     Addieren der Zahl 1 zu der Zahl d durch den aufrufenden Rechner;

5020     Überprüfen, ob die logische Aussage (e*d) (mod phi) == 1 erfüllt ist, durch den aufrufenden Rechner und Wiederholen der Schritte ab Schritt 3510, wenn die logische Aussage (e*d) (mod phi) == 1 nicht erfüllt ist;

5030     Verlassen der Funktion findD() durch den aufrufenden Rechner, wenn die logische Aussage (e*d) (mod phi) == 1 erfüllt ist, und Rückgeben des aktuellen Werts von d als Rückgabewert an den aufrufenden Rechner, , in Fall des vorliegenden Dokuments der Rechnerkern 2 der Steuervorrichtung der Sicherung 1 (Server) oder der Rechnerkern 2 der Steuervorrichtung der anderen Sicherung 1 (Client) oder das übergeordnete Rechnersystem 12 (Client);

5100    Server;

5110    Client;

5120    Versenden des auf einer ersten Quantenzufallszahl des Quantenzufallszahlgenerators 60 QRNG des Rechnerkerns 2 der Steuervorrichtung 4 der Sicherung 1 (Server) 5100 basierenden öffentlichen Schlüssels des Servers 5100 über einen nicht abhörsicheren Kanal an den Rechnerkern 2 der Steuervorrichtung 4 der anderen Sicherung 1 (Client) 5110 durch den Rechnerkern 2 der Steuervorrichtung 4 der Sicherung 1 (Server) 5100;

5130    Erzeugen einer Pseudozufallszahl PZ oder einer anders erzeugten Zufallszahl durch den Rechnerkern 2 der Steuervorrichtung 4 der anderen Sicherung (Client) 5110 und Speichern der Pseudozufallszahl PZ bzw. der anders erzeugten Zufallszahl in einem Speicher des Rechnerkerns 2 der Steuervorrichtung 4 der anderen Sicherung 1 (Client) 5110 durch den Rechnerkern 2 der Steuervorrichtung 4 der anderen Sicherung (Client) 5110 und Erzeugen eines ersten privaten Schlüssels des Clients 5110 und eines ersten öffentlichen Schlüssels des Clients 5110 unter Benutzung dieser Pseudozufallszahl PZ bzw. dieser anders erzeugten Zufallszahl durch Rechnerkern 2 der Steuervorrichtung 4 der anderen Sicherung 1(Client) 5110 und Verschlüsselung dieses ersten öffentlichen Schlüssel des Clients 5110 mittels des öffentlichen Schlüssels des Servers 5100 durch den Rechnerkern 2 der Steuervorrichtung 4 der anderen Sicherung (Client) 5110 und Versenden des verschlüsselten ersten öffentlichen Schlüssels des Clients 5110 an den Rechnerkern 2 der Steuervorrichtung 4 der Sicherung (Server) 5100 durch den Rechnerkern 2 der Steuervorrichtung 4 der anderen Sicherung 1 (Client) 5110;

5140    Entschlüsseln der Nachricht des Rechnerkerns 2 der Steuervorrichtung 4 der anderen Sicherung 1 (Client) 5110 mit dem ersten privaten Schlüssel des Rechnerkerns 2 der Steuervorrichtung 2 der anderen Sicherung 1 (Client) 5110, sodass der Rechnerkern 2 der Steuervorrichtung 4 der Sicherung 1 (Server) 5100 über den ersten öffentlichen Schlüssel des Clients 5110 verfügt, ohne dass dieser Dritten bekannt sein kann, und Erzeugen einer weiteren, zweiten Quantenzufallszahl QZ2 durch den Rechnerkern 2 der Steuervorrichtung 4 der Sicherung 1 (Server) 5100 mittels des Quantenzufallszahlengenerators 60 QRNG, wobei die Bitbreite dieser zweiten Quantenzufallszahl ist bevorzugt gleich der Bitbreite, der Zufallszahl PZ des Clients 5110 ist, und Verschlüsseln der zweiten Quantenzufallszahl QZ2 mit dem ersten öffentlichen Schlüssel des Rechnerkerns 2 der Steuervorrichtung 4 der anderen Sicherung (Client) 5110 zu einer verschlüsselten zweiten Quantenzufallszahl QZ2' durch den Rechnerkern 2 der Steuervorrichtung 4 der Sicherung (Server) 5100, wobei beispielsweise der erste öffentliche Schlüssel des Clients 5110 die Zufallszahl PZ des Clients sein kann und wobei in dem Fall der Rechnerkern 2 der Steuervorrichtung 4 der Sicherung 1 (Server) 5100 die zweite Quantenzufallszahl QZ2 beispielsweise durch bitweise XOR-Verknüpfung der zweiten Quantenzufallszahl QZ2 mit PZ zu einer verschlüsselten zweiten Quantenzufallszahl QZ2' verschlüsseln kann, und Versendung der verschlüsselten zweite Quantenzufallszahl QZ2' an den Rechnerkern 2 der Steuervorrichtung 4 der anderen Sicherung 1 (5110) durch den Rechnerkern 2 der Steuervorrichtung 4 der Sicherung 1 (Server) 5100;

5150    Entschlüsselung der verschlüsselten zweiten Quantenzufallszahl QZ2' unter Benutzung des ersten privaten Schlüssels des Rechnerkerns 2 der Steuervorrichtung 4 der Sicherung (Server) 5100 zur zweiten Quantenzufallszahl QZ2 durch den Rechnerkern 2 der Steuervorrichtung 4 der anderen Sicherung 1 (Client) 5110. Hat der Rechnerkern 2 der Steuervorrichtung 4 der Sicherung (Server) die zweite verschlüsselte Quantenzufallszahl QZ2' durch bitweise XOR-Verknüpfung der Zufallszahl PZ mit der zweiten Quantenzufallszahl QZ2 ermittelt, so kann der Rechnerkern 2 der Steuervorrichtung 4 der anderen Sicherung 1 (Client) 5110 beispielsweise durch bitweise XOR-Verknüpfung der verschlüsselten zweiten Quantenzufallszahl QZ2' mit der ihm bekannten Zufallszahl PZ zur zweiten Quantenzufallszahl QZ2 entschlüsseln. Bevorzugt nutzt der Rechnerkern 2 der Steuervorrichtung 4 der anderen Sicherung (Client) 5110 die ihm nun vorliegende zweite Quantenzufallszahl QZ2 als Grundlage für die Erzeugung eines zweiten privaten und eines zweiten öffentlichen Schlüssels gemäß einem asymmetrischen Verschlüsselungsverfahren. Bei dem asymmetrischen Verschlüsselungsverfahren kann es sich zum Beispiel um das RSA-Verfahren handeln. Der Rechnerkern 2 der Steuervorrichtung 4 der anderen Sicherung 1 (Client) 3610 verschickt nun seinen zweiten öffentlichen Schlüssel über den nicht abhörsicheren Kanal an den Server 5100. Hierbei verschlüsselt er bevorzugt diesen zweiten öffentlichen Schlüssel des Clients 5110 mit dem öffentlichen Schlüssel des Servers 5100. Der Server 5100 entschlüsselt den verschlüsselten zweiten öffentlichen Schlüssel des Clients 5110 und verwendet dann diesen zweiten öffentlichen Schlüssel des Clients für die Verschlüsselung weiterer Nachrichten an den Rechnerkern 2 der Steuervorrichtung 4 der anderen Sicherung 1 (Client) 5110. Bevorzugt erzeugt und sendet der Rechnerkern 2 der Steuervorrichtung 4 der Sicherung 1 (Server) 5100 nach einer vorbestimmten Zeit oder einer nach dem Versenden einer vorbestimmten Datenmenge an den Rechnerkern 2 der Steuerungsvorrichtung 4 der anderen Sicherung 1 (Client) 5110 einen neuen öffentlichen Schlüssel auf Basis einer neuen Quantenzufallszahl seines Quantenzufallszahlengenerators 60 QRNG verschlüsselt mit dem zweiten öffentlichen Schlüssel des Clients 5110. Bevorzugt führen dann der Rechnerkern 2 der Steuervorrichtung 4 der Sicherung (Server) 5100 und der Rechnerkern 2 der Steuervorrichtung 4 der anderen Sicherung 1(Client) 5110 das zuvor beschriebene Verfahren erneut durch, sodass die Schlüssel permanent wechseln. Dies macht es auch einem Quantencomputer unmöglich, die Schlüssel zu brechen. Damit ist das Versorgungsnetzwerk gegen Angriffe von außen geschützt;

5200      Verfahren zur Erzeugung einer Quantenzufallszahl QZ mit m Zufallsbits;

5210      Erzeugung eines zufälligen Einzelphotonenstroms (57, 58, 59, 401.2) mittels einer oder mehrerer erster SPAD-Dioden (401.1, 54);

5220      Übertragung des zufälligen Einzelphotonenstroms (57, 58, 59, 401.2) mittels eines vom Halbleitersubstrat (49, 48) verschiedenen Lichtwellenleiters (44, 401.2) an eine oder mehrere zweite SPAD- Dioden (401.3, 55);

5230      Wandlung des zufälligen Einzelphotonenstroms (57, 58, 59, 401.2) in ein Detektionssignal in Form eines Spannungssignal 405 der Entropie Quelle 401, die bevorzugt die ersten SPAD-Dioden 401.1 und den Lichtwellenleiter 401.2 und die zweiten SPAD-Dioden 401.3 umfasst;

5240      Aufbereiten, insbesondere Verstärken und/oder Filtern und/oder Analog-zu-Digital-Wandeln, des Detektionssignals in ein aufbereitetes Detektionssignal, insbesondere einen digitalen 14 Bit-Wert 407 des Analog-zu-Digital-Wandlers 403;

5250      Abtrennen der durch Kopplungen der Emissionen einer ersten SPAD-Diode 401.1 und einer zweiten SPAD-Diode 401.3 entstandenen Pulse des aufbereiteten Detektionssignals von den durch spontane Emission entstandenen Pulsen des aufbereiteten Detektionssignals durch Vergleich des aufbereiteten Detektionssignals mit einem Schwellwert, insbesondere in einem Komparator 404.2 und Erzeugung eines entsprechenden Ausgangssignals 409, insbesondere des Komparators 404.2;

5260      Ermittlung eines ersten zeitlichen Abstands zwischen dem ersten Puls und dem zweiten Puls eines ersten Pulspaares aus zwei aufeinander folgenden, durch Kopplungen der Emissionen einer ersten SPAD-Diode 401.1 und einer zweiten SPAD-Diode 401.3 entstandenen Pulse des aufbereiteten Detektionssignals und Ermittlung eines zweiten zeitlichen Abstands zwischen einem dritten Puls und einem vierten Puls eines zweiten Pulspaares aus zwei aufeinander folgenden, durch Kopplungen der Emissionen einer ersten SPAD-Diode 401.1 und einer zweiten SPAD-Diode 401.3 entstandenen Pulse des aufbereiteten Detektionssignalsund, insbesondere zur Ermittlung des ersten Werts des Ausgangs 410 des Zeit-zu-Digital-Wandlers 404.3 und des zweiten Werts des Ausgangs 410 des Zeit-zu-Digital-Wandlers 404.3;

5710      Temperaturschalter;

5720      Temperaturwirkpfad zwischen dem ersten Leistungsschalter 17 und dem Temperaturschalter 5710 bzw. der Temperatursicherung 5740;

5730      Temperaturwirkpfad zwischen dem zweiten Leistungsschalter 17' und dem Temperaturschalter 5710 bzw. der Temperatursicherung 5740;

5740      Temperatursicherung;

5750      Temperatuschalter / Thermosicherung-Überwachungsvorrichtung;

5910      erste Motorspule des Motors;

5920      zweite Motorspule des Motors;

5930      dritte Motorspule des Motors;

5940      Motoransteuerung;

6000      Verfahren zur Übertragung komprimierter Daten von der Sicherung 1 zum übergeordneten Rechnersystem 12, wobei im Sinne der hier vorgestellten technischen Lehre im Zusammenhang mit dieser Datenübertragung eine komprimierte Übertragung von der Steuervorrichtung 4 der Sicherung zur einer anderen Steuervorrichtung 4 einer anderen Sicherung von der Offenbarung des hier vorgelegten Dokuments eingeschlossen ist. Man gelangt zu der entsprechenden technischen Lehre, indem man das übergeordnete Rechnersystem 12 durch die Steuervorrichtung 4 einer Sicherung in den entsprechenden texten zur komprimierten Datenkommunikation dieses Dokuments ersetzt.

6010      Schließen des Leistungsschalter 17 der Sicherung 1 durch eine Steuervorrichtung 4 einer Sicherung 1 in einem ersten Schritt;

6020      Erfassung des zu erfassenden physikalischen Parameters, den die Steuervorrichtung 4 der Sicherung 1 unter Benutzung erster Mittel, die beispielsweise den Analog-zu-Digital-Wandler 570 der Steuervorrichtung 4 und/oder den Shunt-Widerstand 24 und/oder den Hilfsleistungsschalter 23 umfassen können, in einem zweiten Schritt 6020 erfasst Die zu erfassenden physikalischen Parameter können dabei beispielsweise Spannungen zwischen Schaltungsknoten innerhalb und außerhalb der Sicherung 1 und/oder elektrische Ströme durch Leitungen innerhalb der Sicherung 1 und/oder Temperaturen in und/oder im Umfeld der Sicherung 1 umfassen;

6021 Wandlung der elektrischen analogen Signale, die die Mittel zur Erfassung der physikalischen Parameter (z.B. Temperatursensoren 586 für die Erfassung der Temperatur, Shunt-Widerstände 24 zur Erfassung elektrischer Ströme 36, Potenzialleitungen zur Erfassung elektrischer Potenziale, Analog-zu-Digital-Wandler 570 etc.) erzeugen, durch Abtastung in einem ersten Unterschritt 6021 des zweiten Schritts 6020 (siehe Figur 61) durch die Steuervorrichtung 4 der elektronischen Sicherung 1 in abgetastete zeitliche Parameterwertverläufe, die einen zeitdiskreten Strom von Abtastwerten der Parameterwerte des betreffenden physikalischen Parameters und ggf. zugehörige Zeitstempel dieser Abtastwerte umfassen. Bevorzugt ordnet die Steuervorrichtung 4 der Sicherung 1 vorzugsweise jedem Abtastwert und/oder Abtastwerten in bevorzugt gleichen Zeitabständen kann dabei typischerweise einen Abtastzeitpunkt als Zeitstempel dieses Abtastwertes zu.

6022 Durchführen einer beispielhaften Wavelet-Transformation oder einer anderen Kompressionsmethode und Wandeln der abgetasteten zeitlichen Parameterwertverläufe in komprimierte zeitliche Parameterwertverläufe durch die Steuervorrichtung 4 der Sicherung in einem zweiten Unterschritt 6022 des zweiten Schritts 6020.

6030 Analysieren und Komprimieren des erfassten zeitlichen Parameterwerteverlauf des erfassten physikalischen Parameters durch die Steuervorrichtung 4 der elektronischen Sicherung 4 in einem dritten Schritt 6030, um die für die Datenübertragung notwendige Datenbuskapazität des Datenbusses 9 zu minimieren und Freiraum für Statusmeldungen und weitere Steuerbefehle des übergeordneten Rechnersystems 12 an die Steuervorrichtung 4 der Sicherung 1 bzw. für Statusmeldungen und weitere Datenübertragungen der Steuervorrichtung 4 der Sicherung 1 an übergeordnete Rechnersystem 12 an die zu schaffen;

6031 Analyse des zeitlichen Parameterwertverlaufs der durch die Steuervorrichtung 4 der elektronischen Sicherung 1 erfassten Parameter und/oder des zeitlichen Verlaufs daraus abgeleiteter Parameter beispielsweise durch Optimalfilter der Steuervorrichtung 4 der elektronischen Sicherung 1 in einem ersten Unterschritt 6031 des dritten Schritts und bevorzugtes Bilden bevorzugt jeweils eines Werts einer Vektorkomponente eines Merkmalsvektors durch bevorzugt jeweils einen Optimalfilter;

6032 Extraktion eines aktuellen Merkmalsvektors aus den erfassten zeitlichen Parameterwertverläufen und/oder aus den aus diesen abgeleiteten protypischen zeitlichen Verläufen abgelei- teter Parameter durch die Steuervorrichtung 4 der Sicherung und ggf. Zuordnen eines jeweiligen Zeitstempels zu bevorzugt jedem dieser Merkmalsvektoren in einem dritten Unterschritt 6023 des zweiten Schritts 6020 durch die Steuervorrichtung 4 der Sicherung;

6033 Ermitteln eines Abstands des extrahierten aktuellen Merkmalsvektors zu einem prototypischen Merkmalsvektor der prototypischen Merkmalsvektoren der Prototypendatenbank 62115 in einem dritten Unterschritt 6033 des dritten Schritts 6030;

6034 Erkennen eines prototypischen Merkmalsvektors der Prototypendatenbank 62115 als erkannten prototypischen Merkmalsvektor der Prototypendatenbank, wenn der Betrag des ermittelten Abstands für dieses Paar aus diesem aktuellen Merkmalsvektor und diesem prototypischen Merkmalsvektor der Prototypendatenbank 62115 kleiner als ein Abstandsschwellwert ist und wenn gleichzeitig der Betrag dieses ermittelten Abstands kleiner oder gleich zu jedem anderen Betrag jedes anderen Abstands zwischen dem aktuellen Merkmalsvektor einerseits und jedem anderen prototypischen Merkmalsvektor der Prototypendatenbank 62115 ist;

6040 Übertragen des komprimierten, erfassten zeitlichen Parameterwerteverlaufs des zu meldenden physikalischen Parameters durch die Steuervorrichtung 4 der elektronischen Sicherung 1 in einem vierten Schritt 6040 an das übergeordnete Rechnersystem 12;

6050 Dekompression des über den Datenbus 9 von der Steuervorrichtung 4 der Sicherung 1 empfangenen, komprimierten, erfassten zeitlichen Parameterwerteverlauf durch das übergeordnete Rechnersystem 12 In einem fünften Schritt 6050 zu einem dekomprimierten, erfassten zeitlichen Parameterwerteverlauf, der letztlich ein rekonstruierter, erfasster zeitlicher Parameterwerteverlauf ist, der der Steuervorrichtung 4 der Sicherung 1 innerhalb des übergeordneten Rechnersystems 12 zugeordnet ist;

6060 Vergleichen und/oder Korrelieren des rekonstruierten, erfassten zeitlichen Parameterwerteverlaufs, der der Steuervorrichtung 4 der Sicherung 1 innerhalb des übergeordneten Rechnersystems 12 zugeordnet ist, mit einem oder mehreren anderen rekonstruierten, erfassten zeitlichen Parameterwerteverläufen, die den Steuervorrichtungen 4 anderer Sicherungen 1 innerhalb des übergeordneten Rechnersystems 12 zugeordnet sind, durch das übergeordnete Rechnersystem 12 in einem sechsten Schritt 6060. Dabei detektiert das übergeordnete Rechnersystem 12 vorzugsweise Ereignisse, die auf gleiche Ursachen vorzugsweise in zeitlicher Korrelation zurückführbar sind;

| | |
|---|---|
| 6070 | Ergreifen von Maßnahmen in Abhängigkeit von den detektieren Ereignissen durch das übergeordnete Rechnersystem 12 sofern notwendig in einem siebten Schritt 6070; |
| 7600 | Verfahren (7600) zum Betreiben eines Versorgungsnetzwerks (200) mit Komprimierung und Verschlüsselung der Sicherungsdaten in der elektronischen Sicherung 1 und Entschlüsselung und Dekomprimierung der Sicherungsdaten im übergeordneten Rechnersystem 12. |
| 7610 | Verschlüsseln des einen oder der mehreren komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, verschlüsselten, komprimierten, erfassten zeitlichen Parameterwerteverläufe des einen oder der mehreren zu meldenden physikalischen Parameter; |
| 7620 | Entschlüsseln des einen oder der mehreren verschlüsselten, komprimierten, erfassten zeitlichen Parameterwerteverläufe des einen oder der mehreren zu meldenden physikalischen Parameter, insbesondere durch die Steuervorrichtung (4) der elektronischen Sicherung (1), zu einem oder mehreren, entschlüsselten, komprimierten, erfassten zeitlichen Parameterwerteverläufe des einen oder der mehreren zu meldenden physikalischen Parameter; |
| 55100 | Systems 55100 zur Bereitstellung von SW-Programmen in einem Versorgungsnetzwerk 200; |
| 55110 | erste HW-Plattform (z.B. ein übergeordnetes Rechnersystem 12 oder einen Server 710 eines Dienstanbieters oder ein Terminal 740 für Eingaben eines Nutzers 730 etc.); |
| 55111 | auf der ersten HW-Plattform 55110 implementiertes SW-Programm; |
| 55112 | auf der ersten HW-Plattform 55110 implementiertes SW-Programm; |
| 55113 | auf der ersten HW-Plattform 55110 implementiertes SW-Programm, z.B. eine Bezahl-Applikation 55113 oder ein Ausstattungsvariantenkonfigurationsprogramm 55113; |
| 55120 | Steuervorrichtung 4 einer Sicherung 1; |
| 55121 | sicherheitsrelevantes SW-Modul und sicherheits-kritischer Teil eines SW-Programms 55111. Ein sicherheitsrelevantes SW-Modul 55121, 55122 kann z.B. sicherheitsrelevante Daten und/oder sicherheitsrelevanten Progammcode und/oder SW-Modulen 55121, 55122, die den Schaltzustand des Leistungsschalters 17 der Sicherung 1 ändern und/oder SW-Module 55121, 55122, die den Zugriff auf Speicher 14,15 der Steuervorrichtung 55120, 4 der elektronischen Sicherung 1 ermöglichen, und/oder SW-Module 55121, 55122, die den Download und/oder die Ausführung von SW im Speicher 14, 15 der Steuervorrichtung 55120, 4 der Sicherung 1 ermöglichen, und/oder SW-Module 55121, 55122, die das Auslesen von Messwerten und/oder Daten der Speicher der Steuervorrichtung 55120, 4 der Sicherung 1 ermöglichen, und/oder SW-Modulen 55121, 55122 , die die Konfiguration von Parametern und/oder Schwellwerten und ähnlichem in der Steuervorrichtung 55120, 4 der Sicherung 1 ermöglichen, umfassen. Beispielsweise kann es sich um den sicherheits-kritischen Teil 55121 einer Bezahl-Applikation 55113 handeln; |
| 55122 | sicherheitsrelevantes SW-Modul; |
| 55130 | Betriebssystem; |
| 55131 | HW-Treiber, z.B. um eine Datenkommunikation über eine Kommunikationseinheit 55141, 55142, 55143 zu ermöglichen; |
| 55141 | Kommunikationseinheit für ein zellulares Netz (GSM, UMTS, LTE); |
| 55142 | Kommunikationseinheit für WLAN; |
| 55143 | Kommunikationseinheit für Bluetooth; |
| 55150 | Kommunikationsnetz (z.B. das Internet 720) mit dem direkt (z.B. über eine Kommunikationseinheit 55141 für ein zellulares Netz) oder indirekt über ein Smartphone 55160 mit ein oder mehreren SW-Applikationen 55161 kommuniziert werden kann. |
| 55160 | Smartphone 55160 oder anderes Terminal 740 für eingaben des Nutzers 730 und/oder beispielsweise zur Eingabe von Passwörtern und/oder Authentifizierungsdaten des Nutzers 730 und/oder biometrischen Daten wie Fingerabdruckdaten eines Fingerabdrucksensorsystems und/oder Gesichtserkennungsdaten eines kamerabasierenden Gesichtserkennungssystems und/oder Stimmerkennungsdaten eines Sprach- und/oder Stimmerkennungssystems des Smartphones; |
| 55200 | beispelhafter Ablauf 55200 eines SW-Programmes 55111, 55112, 55113; |
| 55201 | sicherheitsrelevante Versorgungsnetzwerk-interne Funktion/ sicherheitskritische Komponente des Versorgungsnetzwerks; |
| 55202 | sicherheitsrelevante Versorgungsnetzwerk-externe Funktion / sicherheitskritische Komponente au- |

ßerhalb des Versorgungsnetzwerks

| | |
|---|---|
| 55210 | Basis-Modul, z.B. sicherheits-unkritischer Teil 55210 des auf der ersten HW-Plattform 55110 implementiertes SW-Programms 55113; |
| 55211 | Eingangsdaten; |
| 55221 | Ausgangsdaten; |
| 55300 | Verfahrens zur Ausführung eines SW-Programms 55113 in einem Versorgungsnetzwerk 200; |
| 55301 | Ausführen eines Basis-Moduls 55210 des SW-Programms 55113 auf einer ersten HW-Plattform 55110 des Fahrzeugs (z.B. auf dem übergeordneten Rechnersystem 12 des Versorgungnetzwerks 200); |
| 55302 | Aufrufen eines sicherheitsrelevanten Moduls 55121 des SW-Programms 55113 aus dem Basis-Modul 55210 heraus bei Ausführung des SW-Programms 55113; |
| 55303 | Ausführen des sicherheitsrelevanten Moduls 55121 auf einer Steuervorrichtung 55120, 4 des Versorgungsnetzwerks 200; |
| 62100 | Mittel 62100 zur Erfassung physikalischen Parameter der Sicherung 1. Diese Mittel können beispielsweise Shunt-Widerstände 24, Hilfsleistungsschalter 23, der Leistungsschalter 17 der Sicherung 1 und/oder die Gate-Ansteuerschaltung 16 der Steuervorrichtung 4 der Sicherung und/oder der Analog-zu-Digital-Wandler 570 der Steuervorrichtung 4 der Sicherung 1 und/oder einen Temperatursensor 586 ggf. zusammen mit einer Temperatursensorauswertevorrichtung 585 umfassen. Die erfassten physikalischen Parameter können beispielsweise die Spannungswerte elektrische Spannungen zwischen Konten der Sicherung 1 und/oder der Steuerschaltung 4 der Sicherung 1 (z.B. 20, 21, 22, 25, 26, 27, 28, 18, 19, 201, 6) und/oder Stromwerte elektrischer Ströme (z.B. 29, 36) und/oder andere physikalische Parameter, wie z.B. eine Temperatur, umfassen; |
| 62101 | physikalische Schnittstelle 62101 der Steuervorrichtung 4. Die physikalische Schnittstelle 62101 der Steuervorrichtung 4 steuert Mittel 62100 zur Erfassung der physikalischen Parameter der Sicherung 1 an. Die physikalische Schnittstelle 62101 kann beispielsweise den Analog-zu-Digital-Wandler 570 der Steuervorrichtung 4 und/oder die Gate-Ansteuerschaltung 16 der Steuervorrichtung 4 für die Ansteuerung und Überwachung des Leistungsschalters 17 umfassen. Die physikalische Schnittstelle erfasst typischerweise die zeitlichen Parameterwertverläufe und/oder die entsprechenden zeitlichen Verlaufen der aus diesen Parameterwertverläufen der physikalischen Parameter abgeleiteten Parameter und stellt sie in Form eines Parametersignals 62103 zur Aufbereitung durch die anschließende Merkmalsvektorextraktion zur Signalobjektklassifikation bereit; |
| 60102 | Signale der zeitlichen Parameterwertverläufe und/oder die entsprechenden zeitlichen Verlaufen der aus diesen Parameterwertverläufen der physikalischen Parameter abgeleiteten Parameter. Auch wenn in den Merkmalen bzw. Ansprüchen ggf. von Signal die Rede ist, kann ein solches Signal sich aus mehreren Signalen, insbesondere analogen Spannungssignalen und/oder analogen Stromsignalen etc. zusammensetzen. Spannungssignale können dabei insbesondere beispielsweise Signale von Spannungen zwischen den Knoten 6, 7, 20, 21, 22, 25, 26, 27, 28, 201 und dergleichen etc. umfassen. Stromsignale können dabei beispielsweise Stromwerte für elektrische Ströme 36, 29 umfassen. Weitere Signale für physikalische Parameter können beispielsweise Temperatursignale eines Temperatursensors 586 etc. umfassen; |
| 62103 | Parametersignal. Das Parametersignal kann mehrere Leitungen (z.B. 22, 27, 25, 21 etc.) umfassen; |
| 62104.1 | erster Optimalfilter der Steuervorrichtung 4 der Sicherung 1; |
| 62104.2 | zweiter Optimalfilter der Steuervorrichtung 4 der Sicherung 1; |
| 62104.(m-1) | (m-1)-ter Optimalfilter der Steuervorrichtung 4 der Sicherung 1; |
| 62104.m | m-ter Optimalfilter der Steuervorrichtung 4 der Sicherung 1; |
| 62111 | Merkmalsvektorextraktion; |
| 62112 | Abstandsermittler oder Klassifikator; |
| 62113 | Viterbi-Schätzer. |
| 62115 | Prototypendatenbank; |
| 62116 | Signalobjektsequenzdatenbank; |
| 62121 | ermittelte Signalgrundobjektfolge aus der zeitlichen Folge der erkannten Signalgrundobjekte; |
| 62122 | wahrscheinlich erkannte Signalobjekte mit Signalobjektparametern; |
| 62123 | Zwischenparametersignalbündel umfassend die m Zwischenparametersignale 62123.1 bis 62123.m; |
| 62123.1 | erstes Zwischenparametersignal des ersten Optimalfilters 62104.1; |
| 62123.2 | zweites Zwischenparametersignal des zweiten Optimalfilters 62104.2; |
| 62123.(m-1) | (m-1)-tes Zwischenparametersignal des (m-1)-ten Optimalfilters 62104.(m-1); |
| 62123.m | m-tes Zwischenparametersignal des m-ten Optimalfilters 62104.m; |

| | |
|---|---|
| 62125 | Signifikanzsteigerungseinheit; |
| 62126 | LDA-Matrix; |
| 62138 | Signal des aktuellen Merkmalsvektors; |
| 62150 | Schätzer mit einem HMM-Modell; |
| 63141 | Schwerpunktkoordinate eines ersten beispielhaften prototypischen Signalgrundobjekts der Prototypendatenbank 62115; |
| 63142 | Schwerpunktkoordinate eines zweiten beispielhaften prototypischen Signalgrundobjekts der Prototypendatenbank 62115; |
| 63143 | Schwerpunktkoordinate eines dritten beispielhaften prototypischen Signalgrundobjekts der Prototypendatenbank 62115; |
| 63144 | Schwerpunktkoordinate eines vierten beispielhaften prototypischen Signalgrundobjekts der Prototypendatenbank 62115; |
| 63145 | beispielhafter aktueller Merkmalsvektor des Signals der Merkmalsvektoren 62138 in dem Überlappungsbereich der Streubereiche der beiden beispielhaften Signalgrundobjekte der Prototypendatenbank 62115 mit den Schwerpunktkoordinaten 63142 und 63143; |
| 63146 | beispielhafter Merkmalsvektor, der zu weit von den beispielhaften Schwerpunktkoordinaten (63141, 63142, 63143, 63144) des Schwerpunkts irgendeines beispielhaften Signalgrundobjektprototypen der Prototypendatenbank 62115 entfernt liegt; |
| 63147 | Streubereich (Schwellwertellipsoid) 63147 um den Schwerpunkt 63141 eines einzigen beispielhaften Signalgrundobjektprototyps 63141; |
| 63148 | beispielhafter aktueller Merkmalsvektor, der im Streubereich (Schwellwertellipsoid) 63147 um den Schwerpunkt 63141 eines einzigen beispielhaften Signalgrundobjektprototyps 63141) liegt und der damit sicher durch den Abstandsermittler (112) erkannt und als erkanntes Signalgrundobjekt (121) an den Viterbi-Schätzer (113) weitergegeben werden kann. |
| 67151 | Schätzer mit einem neuronalen Netzwerkmodell; |
| 68160 | erstes beispielhaftes Signalobjekt in Dreiecksform und Datenübertragungspriorität 1; |
| 68161 | zweites beispielhaftes Signalobjekt in Dreiecksform und Datenübertragungspriorität 2; |
| 68162 | drittes beispielhaftes Signalobjekt in Doppelspitzenform und Datenübertragungspriorität 3; |
| 68163 | viertes beispielhaftes Signalobjekt in Dreiecksform und Datenübertragungspriorität 4; |
| 68164 | fünftes beispielhaftes Signalobjekt in Dreiecksform und Datenübertragungspriorität 5; |
| 68165 | sechstes beispielhaftes Signalobjekt in Dreiecksform und Datenübertragungspriorität 6; |
| 68166 | mit Hilfe von Signalobjekten übertragenes und dekomprimiertes Parametersignal; |
| 70000 | Dekompressionsverfahren; |
| 70010 | Empfangen neuer zu dekomprimierenden Daten 70160 im übergeordneten Rechnersystem 12, die vom Steuerrechner 4 der Sicherung 1 stammen. Mit dem Empfang neuer zu dekomprimierenden Daten 70160 startet das übergeordnete Rechnersystem 12 das hier vorgestellte beispielhafte Dekompressionsverfahren 70000; |
| 70020 | Bereitstellen eines rekonstruierten Parametersignal-Modells 69610 für ein Abtastfenster; |
| 70030 | Ermittlung des nächsten zu rekonstruierenden Objekts in den empfangenen Daten des Steuervorrichtung 4 der Sicherung 1 durch das übergeordnete Rechnersystem 12; |
| 70040 | Prüfung, ob das nächste zu rekonstruierende Objekt ein Signalobjekt ist durch das übergeordnete Rechnersystem 12, sofern nicht von vornherein feststeht, ob die Steuerungsvorrichtung 4 der Sicherung nur Signalgrundobjekte oder nur Signalobjekte an das übergeordnete Rechnersystem 12 überträgt. In dem Fall würde dieser Prüfschritt entfallen. |
| 70050 | Ermittlung der Folge von Signalgrundobjekten, die dem Index der Signalobjektsequenzdatenbank 62116 der Steuervorrichtung 4 der Sicherung 1 entspricht, durch das übergeordnete Rechnersystem 12; |
| 70060 | Folge (Sequenz) 70060 von Signalgrundobjekten; |
| 70070 | Ermittlung des nächsten Signalgrundobjekts der Sequenz 70060 von Signalgrundobjekten, das das übergeordnete Rechnersystem 12 rekonstruieren soll, durch das übergeordnete Rechnersystem 12; |
| 70080 | Prüfschritt 70080, ob der relevante Datensatz 70090, 70100 der Prototypendatenbank 70115 des übergeordneten Rechnersystems 12 einen prototypischen Merkmalsvektor 70090 umfasst und keine oder prototypische Parameterwertverläufe 70100 für die Parameterwertverläufe der physikalischen Parameter und/oder der aus diesen abgeleiteten Parameter. |
| 70090 | Datensatz der Prototypendatenbank 70115 des übergeordneten Rechnersystems 12. Bevorzugt umfasst dieser Datensatz 70090 der Prototypendatenbank 70115 des übergeordneten Rechnersystems 12, den das zu rekonstruierende Signalgrundobjekt markiert, einen prototypischen Merkmalsvektor 70090. |

| | |
|---|---|
| 70100 | Datensatzes 70100 der Prototypendatenbank 70115 des übergeordneten Rechnersystems 12. Bevorzugt umfasst dieser Datensatz 70100 der Prototypendatenbank 70115 des übergeordneten Rechnersystems 12, den das zu rekonstruierende Signalgrundobjekt markiert, prototypische Parameterwertverläufe 70100 für die Parameterwertverläufe der physikalischen Parameter und/oder der aus diesen abgeleiteten Parameter. |
| 70110 | Signalrekonstruktionsverfahren 70110, das vorzugsweise eine Signalkonstruktionsvorrichtung des übergeordneten Rechnersystems 12 ausführt oder das das Rechnersystem 12 ausführt, das den prototypischen Merkmalsvektor 70100 in prototypische Parameterwertverläufe 70100 für die Parameterwertverläufe der physikalischen Parameter und/oder der aus diesen abgeleiteten Parameter wandelt; |
| 70120 | Parametrisieren der prototypische Parameterwertverläufe 70100 für die Parameterwertverläufe der physikalischen Parameter und/oder der aus diesen abgeleiteten Parameter zu parametrisierten Parameterwertverläufen 70130 für die Parameterwertverläufe der physikalischen Parameter und/oder der aus diesen abgeleiteten Parameter durch das übergeordnete Rechnersystem 12; |
| 70115 | Prototypendatenbank des übergeordneten Rechnersystems 12; |
| 70116 | Signalobjektsequenzdatenbank des übergeordneten Rechnersystems 12; |
| 70125 | Addieren der parametrisierten Parameterwertverläufen 70130 für die Parameterwertverläufe der physikalischen Parameter und/oder der aus diesen abgeleiteten Parameter zu dem Parametersignal-Modell 69610 hinzu. Bevorzugt führt das übergeordnete Rechnersystem 12 diese Addition durch. Hierdurch füllt sich das Parametersignal-Modell 69610 mit jeder Addition um ein weiteres Signalgrundobjekt; |
| 70130 | parametrisierte Parameterwertverläufe 70130 für die Parameterwertverläufe der physikalischen Parameter und/oder der aus diesen abgeleiteten Parameter; |
| 70140 | Prüfung, ob das übergeordnete Rechnersystem 12 alle Signalgrundobjekte der Sequenz 70060 von Signalgrundobjekten bereits bearbeitet hat; |
| 70150 | Prüfschritt 70150, in dem beispielsweise das übergeordnete Rechnersystem 12 prüft, ob es alle Signalobjekte der zu dekomprimierenden Daten 70160 bereits für das rekonstruierte Parametersignal-Modell 69610 für dieses Abtastfenster berücksichtig hat. Das übergeordnete Rechnersystem 12 führt diese Prüfung bevorzugt durch, wenn das übergeordnete Rechnersystem 12 alle Signalgrundobjekte der Sequenz 70060 von Signalgrundobjekten bereits bearbeitet hat. |
| 70160 | zu dekomprimierenden Daten 70160, die typischerweise die Signalobjekte und/oder die Signalgrundobjekte und ggf. deren zugehörigen Parameter umfassen und die sich im übergeordneten Rechnersystem 12 zur Dekompression befinden und die vom Steuerrechner 4 der Sicherung 1 stammen. (In Figur 75: erste komprimierte Sicherungsdaten der ersten Sicherung 825). |
| 70160' | zweite zu dekomprimierenden Daten 70160', die typischerweise die Signalobjekte und/oder die Signalgrundobjekte und ggf. deren zugehörigen Parameter umfassen und die sich im übergeordneten Rechnersystem 12 zur Dekompression befinden und die vom Steuerrechner 4 der weiteren Sicherung 805 stammen. (In Figur 75: zweite komprimierte Sicherungsdaten der zweiten Sicherung 805). |
| 70170 | Ende des Dekompressionsverfahrens für ein Abtastfenster. Dieses Ende ist erreicht, wenn das übergeordnete Rechnersystem 12 alle Signalobjekte der zu dekomprimierenden Daten 70160 bereits für das rekonstruierte Parametersignal-Modell 69610 für dieses Abtastfenster berücksichtig hat. Das rekonstruierten Parametersignal-Modell 69610 für dieses Abtastfenster ist dann fertiggestellt; |
| 70610 | rekonstruiertes Parametersignal. Bei geeigneter Wahl der Signalgrundobjekte und/oder der Signalobjekte entspricht das rekonstruierte Parametersignal im Wesentlichen den zu übertragenden Signalanteilen des Parametersignals 62103 der elektronischen Sicherung 1; |
| 70610' | weiteres rekonstruiertes Parametersignal. Bei geeigneter Wahl der Signalgrundobjekte und/oder der Signalobjekte entspricht das rekonstruierte Parametersignal im Wesentlichen den zu übertragenden Signalanteilen des Parametersignals 62103 der elektronischen Sicherung 1; |
| 74600 | Rekonstruierer; |
| 74601 | erster Abtastwertespeicher für q Abtastwerte des Parametersignals 62103. Der erste Abtastwertespeicher umfasst bevorzugt die Daten des Parameterwertverlaufs der von der Sicherung 1 erfassten physikalischen Parameter und/oder des Verlaufs der Werte daraus abgeleiteter Parameter. Der erste Abtastwertespeicher umfasst daher bevorzugt die Abtastwerte des Parametersignals 62103. Der erste Abtastwertespeicher gibt die Abtastwerte in seinen Speicherzellen als den ersten Abtastwertevektor 74620 aus; |
| 74602 | Vektorsubtrahierer für die Subtraktion des durch den Rekonstruierer 74600 berechneten rekonstruierten Abtastwertvektors des Parametersignals 62103, die den rekonstruierte Parametersignal-Modellvektor 74610 bilden, von dem im zweiten Abtastspeicher 74625 gespeicherten zweiten Ab- |

tastwertvektor 74630 des Parametersignals 62103, um das Vektorrestsignal 73660 zu bilden, das als alternatives Eingangssignal für die Merkmalsvektorextraktion 62111 an Stelle des Parametersignals 62103 dient;

| | |
|---|---|
| 74603 | Rekonstruktionsspeicher für den rekonstruierten Parametersignal-Modellvektor 74610. Der Rekonstruktionsspeicher wird in der Regel als Teil des Rekonstruierers 74600 ausgeführt. |
| 74610 | rekonstruierter Parametersignal-Modellvektor; |
| 74620 | erster Abtastwertevektor der im ersten Abtastwertespeicher 74602 gespeicherten q Abtastwerte des Parametersignals 62103, wobei q die Dimension des ersten Abtastwertevektors angibt; |
| 74625 | zweiter Abtastwertespeicher für q Abtastwerte des Parametersignals 62103. Der zweite Abtastwertespeicher übernimmt die Werte der Vektorkomponenten des ersten Abtastwertevektors 74620 typischerweise immer am Ende eines Abtastfensters in seine Speicherzellen. Der zweite Abtastwertespeicher gibt die Abtastwerte in seinen Speicherzellen als den zweiten Abtastwertevektor 74630 aus; |
| 74630 | zweiter Abtastwertevektor der im zweiten Abtastwertespeicher 74625 gespeicherten q Abtastwerte des Parametersignals 62103, wobei q die Dimension des zweiten Abtastwertevektors angibt; |
| 74635 | gespeicherter Parametersignal-Modellvektor 74635; |
| 74660 | Vektorrestsignal. Das Vektorrestsignal stellt den Kompressionsfehler dar. Je mehr Signalobjekte die Steuervorrichtung 4 als wahrscheinlich erkannte Signalobjekte 62122 mit Signalobjektparametern erkennt, desto geringer wird der Kompressionsfehler. Die Kompression wird in der Regel abgebrochen, wenn die Beträge aller Abtastwerte des Vektorrestsignals 73660 unterhalb einer Schwellwertkurve und/oder unterhalb eines Schwellwert liegen und/oder wenn eine Maximalzahl an Signalobjekten und/oder Signalgrundobjekten erkannt ist; |
| 75101 | Kombinationsvorrichtung. Die Kombinationsvorrichtung interpoliert die Werteverläufe der rekonstruierten Parametersignale verschiedenen Abtastzeitpunkte der rekonstruierten Parametersignale und erzeugt dabei ein fusioniertes Parametersignal 75103, bei dem alle Abtastwerte der verschiedenen Teilsignale der rekonstruierten Parametersignale 75103 auf synchrone Abtastzeitpunkte bezogen sind. Beispielsweise kann eine Sensorfusion in der Kombinationsvorrichtung so aussehen, dass das übergeordnete Rechnersystem 12 die zeitlichen Verläufe von Wertverläufen von Parametern, die weiteren Sensoren und Sensorsysteme erfassen, mit rekonstruierten Parameterwertverläufen rekonstruierter Parametersignale 70610, 70610' von Steuervorrichtungen 4 von Sicherungen korreliert. Hierzu interpoliert das übergeordnete Rechnersystem 12 auf Basis gültiger Abtastwerte der rekonstruierten Parameterwertverläufe rekonstruierter Parametersignale 70610, 70610' fehlende Abtastwerte zu interpolierten, rekonstruierten Parameterwertverläufen eines fusionierten Parametersignals 75103. Des Weiteren interpoliert das übergeordnete Rechnersystem 12 auf Basis gültiger Abtastwerte der Wertverläufe jener Parameter, die die weiteren Sensoren und Sensorsysteme erfassen, interpolierte Wertverläufe jener Parameter, die die weiteren Sensoren und Sensorsysteme erfassen. Bevorzugt korrespondiert dabei zeitlich zu jedem Abtastwert der interpolierten, rekonstruierten Parameterwertverläufe zumindest ein Abtastwert der interpolierten Wertverläufe jener Parameter, die die weiteren Sensoren und Sensorsysteme erfassen. Hierdurch kann das übergeordnete Rechnersystem 12 Korrelationen in Form von auffälligen, typischerweise mehr oder weniger synchronen Ereignissen sowohl in den rekonstruierten Parameterwertverläufen als auch in den Wertverläufen jener Parameter, die die weiteren Sensoren und Sensorsysteme erfassen, suchen. Beispielsweise können mechanische Defekte von mechanischen Vorrichtungen - z.B. Elektromotoren - sich in Beschleunigungswerten - z.B. Vibrationen, Drehmomentschwingungen etc. - bemerkbar machen und gleichzeitig in damit korrespondierenden Schwankungen von Strömen 29, 36 durch die diesen mechanischen Vorrichtungen zugeordneten elektronischen Sicherungen. (Siehe auch Figur 59). Das hier vorgelegte Dokument weist in diesem Zusammenhang auf das Dokument Wolfgang Koch, "Tracking and Sensor Data Fusion: Methodological Framework and Selected Applications (Mathematical Engineering)", Springer 1st ed. 2014 Edition (23. August 2016) ISBN-10: 3662520168, ISBN-13: 978-3662520161 als willkürliches Beispiel aus der unüberschaubaren Menge an Veröffentlichungen zur Sensorfusion hin; |
| 75103 | fusioniertes Parametersignal, das die Kombinationsvorrichtung 75101 aus dem ersten rekonstruierten Parametersignal 70610 der ersten Sicherung 825 und dem zweiten rekonstruierten Parametersignal 70610' der zweiten Sicherung 825 und ggf. aus weiteren rekonstruierten Parametersignale der weiteren Sicherungen zu dem fusionierten Parametersignal 75103 fusioniert hat. |
| 75104.1 | erster Optimalfilter des übergeordneten Rechnersystems 12; |
| 75104.2 | zweiter Optimalfilter des übergeordneten Rechnersystems 12; |
| 75104.(m-1) | (m-1)-ter Optimalfilter des übergeordneten Rechnersystems 12; |

| | |
|---|---|
| 75104.m | m-ter Optimalfilter des übergeordneten Rechnersystems 12; |
| 75111 | Merkmalsvektorextraktion des übergeordneten Rechnersystems 12; |
| 76112 | Abstandsermittler oder Klassifikator des übergeordneten Rechnersystems 12; |
| 75113 | Viterbi-Schätzer des übergeordneten Rechnersystems 12. |
| 75115 | fusionierte Prototypendatenbank des übergeordneten Rechnersystems 12 prototypischer fusionierter Signalgrundobjekte des übergeordneten Rechnersystems 12; |
| 75116 | fusionierte Signalobjektsequenzdatenbank des übergeordneten Rechnersystems 12 prototypischer Sequenzen prototypischer fusionierter Signalgrundobjekte des übergeordneten Rechnersystems 12; |
| 75121 | ermittelte fusionierte Signalgrundobjektfolge aus der zeitlichen Folge der erkannten fusionierten Signalgrundobjekte des übergeordneten Rechnersystems 12; |
| 75122 | wahrscheinlich erkannte fusionierte Signalobjekte des übergeordneten Rechnersystems 12 mit Signalobjektparametern; |
| 75123 | Zwischenparametersignalbündel des übergeordneten Rechnersystems 12umfassend die m Zwischenparametersignale 75123.1 bis 75123.m des übergeordneten Rechnersystems 12; |
| 75123.1 | erstes fusioniertes Zwischenparametersignal des übergeordneten Rechnersystems 12des ersten Optimalfilters 75104.1 des übergeordneten Rechnersystems 12; |
| 75123.2 | zweites fusioniertes Zwischenparametersignal des übergeordneten Rechnersystems 12 des zweiten Optimalfilters 62104.2 des übergeordneten Rechnersystems 12; |
| 75123.(m-1) | (m-1)-tes fusioniertes Zwischenparametersignal des übergeordneten Rechnersystems 12 des (m-1)-ten Optimalfilters 62104.(m-1) des übergeordneten Rechnersystems 12; |
| 75123.m | m-tes fusioniertes Zwischenparametersignal des übergeordneten Rechnersystems 12 des m-ten Optimalfilters 62104.m des übergeordneten Rechnersystems 12; |
| 75125 | fusionierte Signifikanzsteigerungseinheit des übergeordneten Rechnersystems 12; |
| 75126 | fusionierte LDA-Matrix des übergeordneten Rechnersystems 12; |
| 75138 | fusioniertes Signal des aktuellen fusionierten Merkmalsvektors des übergeordneten Rechnersystems 12; |
| 75150 | fusionierter Schätzer mit einem HMM-Modell des übergeordneten Rechnersystems 12; |
| 75600 | Rekonstruierer des übergeordneten Rechnersystems 12; |
| 75601 | erster Abtastwertespeicher des übergeordneten Rechnersystems 12 für q Abtastwerte des fusionierten Parametersignals 75103. Der erste Abtastwertespeicher umfasst daher bevorzugt die Abtastwerte des fusionierten Parametersignals 75103. Der erste Abtastwertespeicher gibt die Abtastwerte in seinen Speicherzellen als den ersten Abtastwertevektor 75620 des übergeordneten Rechnersystems 12 aus; |
| 75602 | Vektorsubtrahierer des übergeordneten Rechnersystems 12 für die subtraktion des durch den Rekonstruierer 75600 des übergeordneten Rechnersystems 12 berechneten rekonstruierten Abtastwertvektors des fusionierten Parametersignals 75103, die den rekonstruierten fusionierten Parametersignal-Modellvektor 75610 bilden, von dem im zweiten Abtastspeicher 75625 des übergeordneten Rechnersystems 12 gespeicherten zweiten Abtastwertvektor 75630 des fusionierten Parametersignals 75103, um das Vektorneusignal 75660 des übergeordneten Rechnersystems 12 zu bilden, das als alternatives Eingangssignal für die Merkmalsvektorextraktion 75111 des übergeordneten Rechnersystems 12 an Stelle des fusionierten Parametersignals 75103 dient; |
| 75603 | Rekonstruktionsspeicher des übergeordneten Rechnersystems 12 für den rekonstruierte fusionierte Parametersignal-Modellvektor 75610. Der Rekonstruktionsspeicher des übergeordneten Rechnersystems 12 wird in der Regel als Teil des Rekonstruierers 75600 des übergeordneten Rechnersystems 12 ausgeführt. |
| 75610 | rekonstruierter fusionierter Parametersignal-Modellvektor; |
| 75620 | erster Abtastwertevektor des übergeordneten Rechnersystems 12 der im ersten Abtastwertespeicher 75602 des übergeordneten Rechnersystems 12 gespeicherten q Abtastwerte des fusionierten Parametersignals 75103, wobei q die Dimension des ersten Abtastwertevektors des übergeordneten Rechnersystems 12 angibt; |
| 75625 | zweiter Abtastwertespeicher des übergeordneten Rechnersystems 12 für q Abtastwerte des Parametersignals 75103. Der zweite Abtastwertespeicher des übergeordneten Rechnersystems 12 übernimmt die Werte der Vektorkomponenten des ersten Abtastwertevektors |
| 75620 | des übergeordneten Rechnersystems 12 typischerweise immer dann, wenn die Fusionierung der rekonstruierten Parametersignale für dieses Abtastfenster abgeschlossen ist, in seine Speicherzellen. Der zweite Abtastwertespeicher des übergeordneten Rechnersystems 12 gibt die Abtastwerte in seinen Speicherzellen als den zweiten Abtastwertevektor 75630 des übergeordneten Rechnersys- |

tems 12 aus;

75630 zweiter Abtastwertevektor des übergeordneten Rechnersystems 12 der im zweiten Abtastwertespeicher 75625 des übergeordneten Rechnersystems 12 gespeicherten q Abtastwerte des fusionierten Parametersignals 75103, wobei q die Dimension des zweiten Abtastwertevektors des übergeordneten Rechnersystems 12 angibt;

75635 gespeicherter Parametersignal-Modellvektor 75635 des übergeordneten Rechnersystems 12;

75660 Vektorrestsignal des übergeordneten Rechnersystems 12. Das Vektorrestsignal des übergeordneten Rechnersystems 12 stellt den Kompressionsfehler dar. Je mehr Signalobjekte das übergeordnete Rechnersystem 12 als wahrscheinlich erkannte Signalobjekte 75122 mit Signalobjektparametern erkennt, desto geringer wird der Kompressionsfehler. Das übergeordnete Rechnersystems 12 bricht die Kompression wird in der Regel ab, wenn die Beträge aller Abtastwerte des Vektorrestsignals 75660 des übergeordneten Rechnersystems 12 unterhalb einer Schwellwertkurve und/oder unterhalb eines Schwellwert liegen und/oder wenn eine Maximalzahl an Signalobjekten und/oder Signalgrundobjekten durch das übergeordnete Rechnersystems 12 erkannt ist;

77010 beispielhafter Sensor im Fahrzeug und/oder im Versorgungsnetzwerk 200;

77020 Sensordatenbus für den beispielhaften Sensor 77010 im Fahrzeug und/oder im Versorgungsnetzwerk 200. Der Sensordatenbus kann mit dem Datenbus 9 identisch sein;

77610 Parametersignal 77610 eines weiteren Sensors 77010;

78151 neuronales Netzwerkmodell, dass das übergeordnete Rechnersystem ausführt, um das fusionierte Parametersignal 75103 in fusionierte Signalgrundobjekte 75121 und/oder fusionierte Signalobjekte 75122 zu klassifizieren;

ADRD Adressinformationen innerhalb der Dateninformationen DATA eines Bit-Strom-Pakets BP auf dem Datenbus 9;

BP Bit-Strom-Paket (englisch Frame), auch mit Datenpaket bezeichnet;

CHKD Prüfinformationen innerhalb der Dateninformationen DATA eines Bit-Strom-Pakets BP. Bevorzugt handelt es sich um eine CRC-Checksumme und/oder Parity-Bits etc.;

CLK Takt innerhalb des übergeordneten Rechnersystems 12;

$CLKA_j$ Abtastsignal innerhalb der j-ten Datenschnittstelle 10 der Steuervorrichtung 4 der j-ten Sicherung - wobei j einer ganzen positiven Zahl sein soll;

DATA Dateninformationen innerhalb eines Bit-Strom-Paketes BP;

ILD Konfigurationsinformationen;

INFO Nutzinformationen innerhalb der Dateninformationen DATA eines Bit-Strom-Pakets BP. Bevorzugt handelt es sich um Konfigurationsdaten für die jeweilige Sicherung. Beispielsweise kann es sich um Parameter zur Einstellung von Schaltschwellen und/oder Verzögerungszeiten oder zur Einstellung des Schaltzustands des Leistungsschalters 17 der elektronischen Sicherung und/oder Programmdaten für den Rechnerkern 2 der Steuervorrichtung 4 der Sicherung oder ähnliches handeln.;

START Startsignal;

SYNC Synchronisationsinformation;

$t_B$ Länge eines Einzelbits innerhalb eines Bit-Strom-Pakets BP;

Z1 erster logischer Zustand, in dem sich der erste Eindrahtdatenbus des Datenbusses 9 oder der zweite Eindrahtdatenbus des Datenbusses 9 befinden kann, wenn der Datenbus 9 ein differenzieller, bidirektionaler Datenbus 9 ist. Dieser wird in dieser Offenlegung auch mit High bezeichnet.

z1 erster differentieller Zustand in dem sich ein serieller, bidirektionaler, differentieller Datenbus 9 befinden kann. Dieser wird in dieser Offenlegung auch mit High bezeichnet.

Z2 zweiter logischer Zustand, in dem sich der erste Eindrahtdatenbus des Datenbusses 9 oder der zweite Eindrahtdatenbus des Datenbusses 9 befinden kann, wenn der Datenbus 9 ein differenzieller, bidirektionaler Datenbus 9 ist. Dieser wird in dieser Offenlegung auch mit Low bezeichnet.

z2 zweiter differentieller Zustand in dem sich ein serieller, bidirektionaler, differentieller Datenbus 9 befinden kann. Dieser wird in dieser Offenlegung auch mit Low bezeichnet.

Z3 dritter logischer Zustand, in dem sich der erste Eindrahtdatenbus des Datenbusses 9 oder der zweite Eindrahtdatenbus des Datenbusses 9 befinden kann, wenn der Datenbus 9 ein differentieller, bidirektionaler Datenbus 9 ist. Dieser wird in dieser Offenlegung auch mit "Idle" bezeichnet. Bevorzugt aber nicht notwendigerweise hat der entsprechende physikalische Pegel des ersten Eindrahtdatenbusses des Datenbusses 9 oder des zweiten Eindrahtdatenbusses des Datenbusses 9 einen Wert um einen gemeinsamen Mittelwert.

z3 dritter differentieller Zustand in dem sich der serielle, bidirektionale, differentielle Datenbus 9 befinden kann. Dieser wird in dieser Offenlegung auch mit "Idle" bezeichnet. Bevorzugt aber nicht notwendigerweise hat der entsprechende differentielle physikalische Pegel einen Wert um Null

Schlussbemerkungen

Die obige Beschreibung erhebt keinen Anspruch auf Vollständigkeit und beschränkt diese Offenbarung nicht auf die gezeigten Beispiele. Diejenigen, die über gewöhnliche Fachkenntnisse auf dem Gebiet verfügen, können andere mitoffenbarte Variationen der konkret in diesem Dokument beschriebenen stichprobenartigen Einzelbeispiele anhand der Zeichnungen, der Offenbarung und der Ansprüche sich erschließen, verstehen und ausführen. Die unbestimmten Artikel "ein" oder "eine" und dessen Flexionen schließen eine Vielzahl nicht aus, während die Erwähnung einer bestimmten Anzahl von Elementen nicht die Möglichkeit ausschließt, dass mehr oder weniger Elemente vorhanden sind. Eine einzige Einheit kann die Funktionen mehrerer in der Offenbarung genannter Elemente erfüllen, und umgekehrt können mehrere Elemente die Funktion einer Einheit erfüllen. Zahlreiche Alternativen, Äquivalente, Variationen und Kombinationen sind möglich, ohne dass der Anwendungsbereich der vorliegenden Offenbarung verlassen wird.

Soweit nichts anders angegeben ist, können diejenigen, die über gewöhnliche Fachkenntnisse auf dem Gebiet verfügen, sämtliche Merkmale der vorliegenden Erfindung frei miteinander kombinieren, sofern solche Kombinationen sinnvoll sind. Dies betrifft die gesamte hier vorgelegte Schrift. Diejenigen, die über gewöhnliche Fachkenntnisse auf dem Gebiet verfügen, können auch die in der Figurenbeschreibung beschriebenen Merkmale, soweit nichts anderes angegeben ist, als Merkmale der Erfindung frei mit den übrigen Merkmalen kombinieren. Eine Beschränkung einzelner Merkmale der Ausführungsbeispiele auf die Kombination mit anderen Merkmalen der Ausführungsbeispiele ist dabei ausdrücklich nicht vorgesehen. Außerdem können gegenständliche Merkmale der Vorrichtung umformuliert auch als Verfahrensmerkmale Verwendung finden und Verfahrensmerkmale umformuliert als gegenständliche Merkmale der Vorrichtung. Eine solche Umformulierung ist somit automatisch mit offenbart.

In der vorausgehenden detaillierten Beschreibung wird auf die beigefügten Figuren verwiesen. Diejenigen, die über gewöhnliche Fachkenntnisse auf dem Gebiet verfügen, sollen die Beispiele in der Beschreibung und den Figuren als illustrativ betrachten und sind nicht als einschränkend für das beschriebene spezifische Beispiel oder Element betrachten. Diejenigen, die über gewöhnliche Fachkenntnisse auf dem Gebiet verfügen, können aus der vorausgehenden Beschreibung und/oder den Figuren und/oder den Ansprüchen durch Abänderung, Kombination oder Variation bestimmter Elemente mehrere Beispiele ableiten. Darüber hinaus kann eine fachkundigen Person Beispiele oder Elemente, die das hier vorgelegte Dokument nicht wörtlich beschreibt, aus der Beschreibung und/oder den Zeichnungen und/oder den Ansprüchen ableiten.

Diejenigen, die über gewöhnliche Fachkenntnisse auf dem Gebiet verfügen, können Merkmale, die an unterschiedlichen Stellen in diesem Dokument und insbesondere der Merkmalslist offenbart sind, können miteinander kombinieren, sofern diese Kombination sinnvoll ist. Die in der Merkmalsliste verwendeten Bezüge sind beispielhaft und schränken die Offenbarung der möglichen Merkmale und Untermerkmalskombinationen ausdrücklich nicht ein. Die geltende Beanspruchung ergibt sich aus den Ansprüchen. Diejenigen, die über gewöhnliche Fachkenntnisse auf dem Gebiet verfügen, sollen für die Interpretation der Ansprüche die relevanten Textpassagen heranziehen. Auch wenn an den entsprechenden Stellen in diesem Text zu Verfahren und Verfahrensschritten keine Vorrichtung offenbart sein sollte, die diesen Verfahrensschritt durchführt, so ist in dieser Schrift hiermit eine Vorrichtung und/oder ein Vorrichtungteil offenbart, der diesen Verfahrensschritt ausführen kann. Diejenigen, die über gewöhnliche Fachkenntnisse auf dem Gebiet verfügen, können dieser Vorrichtungteil mit anderen Vorrichtungen und/oder Vorrichtungsteilen kombinieren, wenn dies sinnvoll ist. Den Funktionen der in dieser Schrift offenbarten Vorrichtungen und Vorrichtungsteilen entsprechen Verfahrensschritte, die diese Vorrichtungsteile durchführen. Diejenigen, die über gewöhnliche Fachkenntnisse auf dem Gebiet verfügen, können diese Verfahrensschritte untereinander und mit Verfahrensschritten zu Verfahren kombinieren. Solche Verfahren sind ausdrücklicher Teil der Offenbarung.

**Patentansprüche**

1. Elektronische Sicherung für ein Fahrzeug mit

   - mindestens einem elektronischen Leistungsschalter (17) zur Anordnung in einer direkt oder indirekt zu einem elektrischen Verbraucher des Fahrzeugs führenden Versorgungsleitung eines Versorgungsleitungsnetzwerks des Fahrzeugs oder als Teil eines Verbrauchers und/oder einer Energiequelle des Fahrzeugs,
   - wobei der Leistungsschalter (17) in der Versorgungsleitung zwischen einem energiequellenseitigen Anschluss (18) und einem verbraucherseitigen Anschluss (19) geschaltet ist,
   - einer einen Rechnerkern wie z.B. eine CPU aufweisenden Steuervorrichtung (4) zur Ansteuerung des mindestens einen Leistungsschalters (17) zwecks wahlweisen Ein- und Ausschaltens des mindestens einen Leistungsschalters (17),
   - mindestens einer Messvorrichtung (24) zur Erfassung eines Betriebsparameters des Leistungsschalters (17) und/oder einer elektrischen Verbindung, in der der Leistungsschalter (17) angeordnet ist, der die Größe eines Stroms und/oder einer Spannung und/oder einer elektrischen Leistung und/oder einer elektrischen Energie und/oder einer Temperatur und/oder einer Verformung der elektrischen Verbindung repräsentiert,

- wobei die Steuervorrichtung (4) in Abhängigkeit von der Größe des Betriebsparameters und/oder in Abhängigkeit von dem Grad der Veränderung des Betriebsparameters über der Zeit oder in Abhängigkeit von dem Grad einer höheren mathematischen zeitlichen Ableitung des Betriebsparameters als der ersten Ableitung den mindestens einen Leistungsschalter (17) zur Überführung aus seinem Einschaltzustand in seinen Ausschaltzustand ansteuert,

- mindestens einer mit der Steuervorrichtung (4) gekoppelten Datenschnittstelle (550) zur Datenkommunikation mit einem übergeordneten Steuerungs- bzw. Rechnersystem (12) zur Übertragung von Messdaten an das übergeordnete Steuerungs- bzw. Rechnersystem (12) und/oder zum Empfang von Steuerdaten für die Steuervorrichtung (4) zur Ansteuerung des mindestens einen Leistungsschalters (17) und

- einem elektronischen Stromableitschalter (615), der zwischen einer Stromsenke (201), wie z.B. Masse, und dem verbraucherseitigen Anschluss (19) angeordnet und von der Steuervorrichtung (4) zum Ein- und Ausschalten ansteuerbar ist,

- wobei die Steuervorrichtung (4) den Stromableitschalter (615) bei eingeschaltetem Leistungsschalter (17) ausschaltet und den Stromableitschalter (615) einschaltet und den Leistungsschalter (17) ausschaltet, wenn durch die Messvorrichtung (24) ein von dem verbraucherseitigen Anschluss (19) zu dem eingangsseitigen Anschluss (18) fließender Strom erfasst und/oder eine Spannung über dem Leistungsschalter (17) mit einem Potential an dem ausgangsseitigen Anschluss (19), das höher ist als das Potential am eingangsseitigen Anschluss (18), erfasst wird.

**2.** Elektronische Sicherung nach Anspruch 1, ferner **gekennzeichnet durch**

- einen elektronischen Bypass-Schalter (17'), der parallel zu dem mindestens einen Leistungsschalter (17) zwischen dem ausgangsseitigen Anschluss (19) und dem energiequellenseitigen Anschluss (18) liegt, und von der Steuervorrichtung (4) zum Ein- und Ausschalten ansteuerbar ist,

- wobei die Steuervorrichtung (4) den Bypass-Schalter (17') ausgeschaltet hält, so lange der mindestens eine Leistungsschalter (17) oder zumindest einer der Leistungsschalter (17) eingeschaltet ist, und

- wobei der Bypass-Schalter (17') durch die Steuervorrichtung (4) einschaltbar ist, wenn der mindestens eine Leistungsschalter (17) ausgeschaltet ist oder sämtliche Leistungsschalter (17) ausgeschaltet sind.

**3.** Elektronische Sicherung nach Anspruch 2, **dadurch gekennzeichnet, dass** der Steuervorrichtung (4) über ihre Datenschnittstelle (550) Ansteuerdaten zum Ein- und Ausschalten des Bypass-Schalters (17') zuleitbar sind.

Fig. 1

EP 4 683 149 A2

Fig. 2

350

EP 4 683 149 A2

Fig. 3

Fig. 4

EP 4 683 149 A2

Fig. 5

Fig. 6

EP 4 683 149 A2

354

Fig. 7

EP 4 683 149 A2

355

Fig. 8

EP 4 683 149 A2

Fig. 9

Fig. 10

Fig. 11

EP 4 683 149 A2

1200

```
┌──────────┐
│   1210   │
└────┬─────┘
     │
     ▼
┌──────────┐
│   1220   │
└────┬─────┘
     │
     ▼
┌──────────┐
│   1230   │
└────┬─────┘
     │
     ▼
┌──────────┐
│   1240   │
└────┬─────┘
     │
     ▼
┌──────────┐
│   1250   │
└────┬─────┘
     │
     ▼
┌──────────┐
│   1260   │
└────┬─────┘
     │
     ▼
┌──────────┐
│   1270   │
└──────────┘
```

Fig. 12

EP 4 683 149 A2

1300

1305 → 1310 → 1315 → 1320 → 1325 → 1330 → 1335 → 1340 → 1345 → 1350 → 1355 → 1360 → 1365 → 1370 → 1375

**Fig. 13**

EP 4 683 149 A2

1400

```
┌──────┐        ┌──────┐        ┌──────┐
│ 1405 │        │ 1440 │        │ 1475 │
└──┬───┘        └──┬───┘        └──────┘
   │               │
┌──▼───┐        ┌──▼───┐
│ 1410 │        │ 1445 │
└──┬───┘        └──┬───┘
   │               │
┌──▼───┐        ┌──▼───┐
│ 1415 │        │ 1450 │
└──┬───┘        └──┬───┘
   │               │
┌──▼───┐        ┌──▼───┐
│ 1420 │        │ 1455 │
└──┬───┘        └──┬───┘
   │               │
┌──▼───┐        ┌──▼───┐
│ 1425 │        │ 1460 │
└──┬───┘        └──┬───┘
   │               │
┌──▼───┐        ┌──▼───┐
│ 1430 │        │ 1465 │
└──┬───┘        └──┬───┘
   │               │
┌──▼───┐        ┌──▼───┐
│ 1435 │        │ 1470 │
└──────┘        └──────┘
```

**Fig. 14**

Fig. 15

Fig. 16

Fig. 17

EP 4 683 149 A2

1800

**Fig. 18**

Fig. 19

Fig. 20

Fig. 21

EP 4 683 149 A2

Fig. 22

Fig. 23

Fig. 24

Fig. 25

Fig. 26

Fig. 27

Fig. 28

Fig. 29

EP 4 683 149 A2

Fig. 30

EP 4 683 149 A2

Fig. 31

3100

2930 2931 2932 2933

2920 2921 2922 2923
3020 3021 3022 3023

3010' 3011' 3012' 3013'
3110 3111 3112 3113

2960 2961 2962 2963 2964 2965 2966 2967

2910 2911 2912 2913

9 9 9 9 9

12

9

2970

1970

2910 2914 2915

3014' 3015'
2950 2951 2952 2953
3120 3121

2924 2925
3024 3025

2940 2941

Fig. 32

Fig. 33

3400

```
┌─────────────┐
│    3410     │
└─────────────┘
       │
       ▼
┌─────────────┐
│    3420     │
└─────────────┘
       │
       ▼
┌─────────────┐
│    3430     │
└─────────────┘
       │
       ▼
┌─────────────┐
│    3440     │
└─────────────┘
       │
       ▼
┌─────────────┐
│    3450     │
└─────────────┘
       │
       ▼
┌─────────────┐
│    3460     │
└─────────────┘
```

**Fig. 34**

Fig. 35

Fig. 36

Schmelzsicherung

Toleranzbereich der
Schmelzsicherung

Sicherheitsbereich

Strom in A

100
90
80
70
60
50
40
30
20
10
0

0,01   0,1   1   10   100   1000

Zeit in s

Fig. 37

Fig. 38

Fig. 39

EP 4 683 149 A2

Fig. 40

Fig. 41

Fig. 42

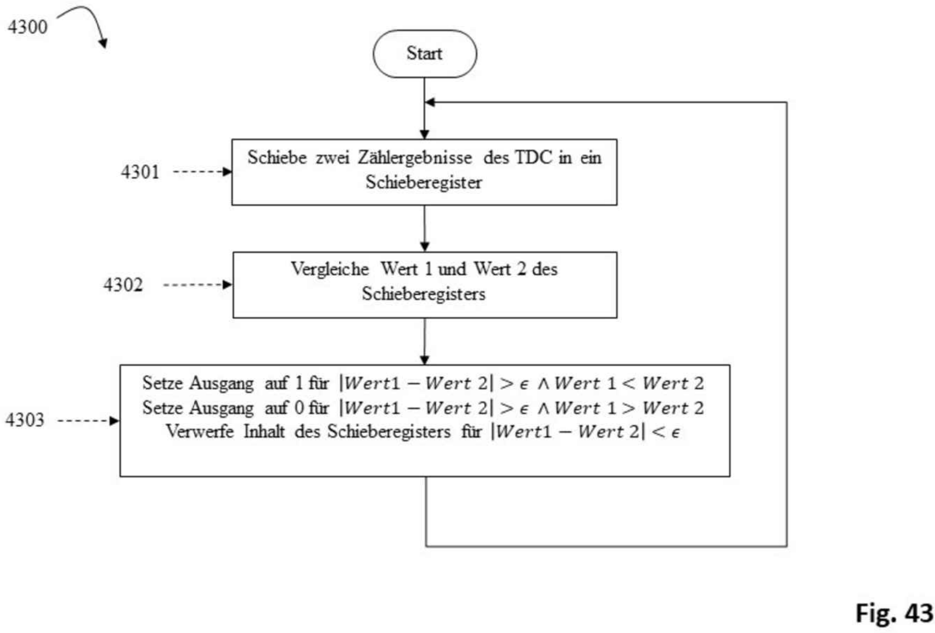

Fig. 43

4300

Start

4301 - - - - - → Schiebe zwei Zählergebnisse des TDC in ein Schieberegister

4302 - - - - - → Vergleiche Wert 1 und Wert 2 des Schieberegisters

4303 - - - - - → Setze Ausgang auf 1 für $|Wert1 - Wert\,2| > \epsilon \wedge Wert\,1 < Wert\,2$
Setze Ausgang auf 0 für $|Wert1 - Wert\,2| > \epsilon \wedge Wert\,1 > Wert\,2$
Verwerfe Inhalt des Schieberegisters für $|Wert1 - Wert\,2| < \epsilon$

Fig. 44

Server Prozess

Client Process

```
                    ┌────────────┐              ┌────────────┐
                    │    4500    │              │    4600    │
                    └────────────┘              └────────────┘
                    ┌────────────┐              ┌────────────┐
                    │    4510    │              │    4610    │
                    └────────────┘              └────────────┘
                    ┌────────────┐
                    │    4520    │
                    └────────────┘
                    ┌────────────┐
                    │    4530    │
                    └────────────┘

                    ┌────────────┐              ┌────────────┐
                    │    4540    │◄────────────►│    4620    │
                    └────────────┘              └────────────┘
                    ┌────────────┐              ┌────────────┐
                    │    4550    │              │    4630    │
                    └────────────┘              └────────────┘
                    ┌────────────┐              ┌────────────┐
                    │    4560    │              │    4640    │
                    └────────────┘              └────────────┘
                    ┌────────────┐              ┌────────────┐
                    │    4570    │              │    4650    │
                    └────────────┘              └────────────┘
                    ┌────────────┐              ┌────────────┐
                    │    4580    │              │    4660    │
                    └────────────┘              └────────────┘

                    ┌────────────┐              ┌────────────┐
                    │    4590    │              │    4670    │
                    └────────────┘              └────────────┘
```

Fig. 45

Fig. 46

KeyExchangeServer()

- 4700 setPrimes()
- 4710 setE()
- 4720 findD()
- 4730 recv()
- 4740 send()
- 4745

KeyExchangeClient()

- 4750 setPrimes()
- 4760 setE()
- 4770 findD()
- 4780 send()
- 4790 recv()
- 4795

setPrimes()

4800 | Generate p |

4810 | Generate q |

4820 ◇ q == p

ja

nein

4830 | n = q * p |

4840 | phi = q - 1 * p - 1 |

4850

**Fig. 47**

4900

setE()

4905 Generate e

4910 gcd(e,phi) != 1?

ja

nein

4920

**Fig. 48**

findD()

5000    d = 0

5010    d + 1

5020    (e*d) (mod phi) ==1

nein

ja

3530

**Fig. 49**

Fig. 50

Client
(PRNG)

5110

5120

5130

5140

5150

Server
(QRNG)

5100

Fig. 51

EP 4 683 149 A2

Fig. 52

EP 4 683 149 A2

Fig. 53

EP 4 683 149 A2

Fig. 54

Fig. 55a

Fig. 55b

Fig. 55

55300

| Ausführen eines Basis-moduls eines SW-Programms auf einer ersten HW-Plattform eines Versorgungsnetzwerks 200 |
55301

| Aufrufen, aus dem Basis-modul heraus, eines sicherheitsrelevanten SW-Moduls des SW-Programms |
55302

| Ausführen des sicherheitsrelevanten SW-Moduls auf dem Rechnerkern 2 der Steuervorrichtung 4 der Sicherung 1 |
55303

Fig. 56

EP 4 683 149 A2

405

EP 4 683 149 A2

Fig. 57

Fig. 58

Fig. 59

EP 4 683 149 A2

407

EP 4 683 149 A2

6000

```
┌──────────┐
│   6010   │
└──────────┘
     ↓
┌──────────┐
│   6020   │
└──────────┘
     ↓
┌──────────┐
│   6030   │
└──────────┘
     ↓
┌──────────┐
│   6040   │
└──────────┘
     ↓
┌──────────┐
│   6050   │
└──────────┘
     ↓
┌──────────┐
│   6060   │
└──────────┘
     ↓
┌──────────┐
│   6070   │
└──────────┘
```

**Fig. 60**

EP 4 683 149 A2

**Fig. 61**

Fig. 62

EP 4 683 149 A2

Weitere Nutzung in der Steuervorrichtung 4

**Fig. 63**

Parameterwert 1

Parameterwert 2

63145

63142

63143

63146

63147

63148

63141

63144

411

Fig. 64

Fig. 65

EP 4 683 149 A2

Fig. 66

Fig. 67

Fig. 68

Fig. 69

Fig. 70

Fig. 71

EP 4 683 149 A2

Fig. 71

Fig. 72

EP 4 683 149 A2

Fig. 73

Fig. 74

Fig. 75

Fig. 76

```
         6010
          ↑
         6020
          ↑
         6030
          ↑
         7610
          ↑
         6040
          ↑
         7620 ──┐
                │
         6050 ←─┘
          ↑
         6060
          ↑
         6070
```

7600 →

Fig. 77

EP 4 683 149 A2

Fig. 78

Lasten unterschiedlicher Priorität
(beispielsweise gemäß Einstufung
nach funktionaler Sicherheit)

Beispielhaft:
links:    Sitzheizung
(große Leistung, geringe Priorität)
Rechts: elektrische Lenkung
(große Leistung, hohe Priorität)

Fig. 79

**Fig. 80**

Fig. 81

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102021130107
- DE 102022110713
- DE 102022125574
- DE 102022125617
- DE 102022125768
- DE 102022128524
- DE 102022129487
- DE 2022100724 W
- EP 1490772 B1

**In der Beschreibung aufgeführte Nicht-Patentliteratur**

- **WOLFGANG KOCH**. Tracking and Sensor Data Fusion: Methodological Framework and Selected Applications (Mathematical Engineering). Springer, 23 August 2016
- Machine Learning: Algorithms and Applications. **BUCH MOHSSEN MOHAMMED**. CRC Press. 30 June 2020
- **BUCH ALAN J. IZENMAN**. Modern Multivariate Statistical Techniques: Regression, Classification, and Manifold Learning (Springer Texts in Statistics). Springer, 28 August 2008
- **R. L. RIVEST** ; **A. SHAMIR** ; **L. ADLEMAN**. A Method for Obtaining Digital Signatures and Public-Key Cryptosystems. *Communications oft he ACM*, February 1978, vol. 21 (2), 120-126
- **WOLFGANG KOCH**. Tracking and Sensor Data Fusion: Methodological Framework and Selected Applications (Mathematical Engineering. Springer, 23 August 2016